(19) Europäisches Patentamt
European Patent Office
Office européen des brevets

(11) EP 4 099 420 B1

(12) **EUROPEAN PATENT SPECIFICATION**

(45) Date of publication and mention of the grant of the patent:
**29.01.2025 Bulletin 2025/05**

(21) Application number: **22176430.1**

(22) Date of filing: **31.05.2022**

(51) International Patent Classification (IPC):
***H10K 85/30*** *(2023.01)* *H10K 50/11* *(2023.01)*
*H10K 101/10* *(2023.01)*

(52) Cooperative Patent Classification (CPC):
**H10K 85/346; H10K 85/342;** H10K 50/11;
H10K 2101/10

(54) **COMPOSITION, LAYER INCLUDING THE COMPOSITION, LIGHT-EMITTING DEVICE INCLUDING THE COMPOSITION, AND ELECTRONIC APPARATUS INCLUDING THE LIGHT-EMITTING DEVICE**

ZUSAMMENSETZUNG, SCHICHT MIT DIESER ZUSAMMENSETZUNG, LICHTEMITTIERENDE VORRICHTUNG MIT DIESER ZUSAMMENSETZUNG UND ELEKTRONISCHES GERÄT MIT DIESER LICHTEMITTIERENDEN VORRICHTUNG

COMPOSITION, COUCHE COMPRENANT LA COMPOSITION, DISPOSITIF ÉLECTROLUMINESCENT COMPRENANT LA COMPOSITION, ET APPAREIL ÉLECTRONIQUE COMPRENANT LE DISPOSITIF ÉLECTROLUMINESCENT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **03.06.2021 KR 20210072366**

(43) Date of publication of application:
**07.12.2022 Bulletin 2022/49**

(73) Proprietor: **SAMSUNG ELECTRONICS CO., LTD.**
**Yeongtong-gu**
**Suwon-si, Gyeonggi-do 16677 (KR)**

(72) Inventors:
- **LEE, Sunghun**
  **16678 Suwon-si (KR)**
- **KWAK, Seungyeon**
  **16678 Suwon-si (KR)**
- **KIM, Sungmin**
  **16678 Suwon-si (KR)**
- **KIM, Hyungjun**
  **16678 Suwon-si (KR)**
- **SIM, Myungsun**
  **16678 Suwon-si (KR)**
- **YI, Jeoungin**
  **16678 Suwon-si (KR)**
- **CHOI, Byoungki**
  **16678 Suwon-si (KR)**
- **HWANG, Kyuyoung**
  **16678 Suwon-si (KR)**

(74) Representative: **Elkington and Fife LLP**
**Prospect House**
**8 Pembroke Road**
**Sevenoaks, Kent TN13 1XR (GB)**

(56) References cited:
**US-A1- 2010 140 602** **US-A1- 2010 314 613**
**US-A1- 2011 108 818** **US-A1- 2011 227 478**

- **KIM YOUNG-HOON ET AL: "Molecular-Scale Strategies to Achieve High Efficiency and Low Efficiency Roll-off in Simplified Solution-Processed Organic Light-Emitting Diodes", ADVANCED FUNCTIONAL MATERIALS, vol. 30, no. 46, 9 September 2020 (2020-09-09), DE, pages 2005292, XP055974687, ISSN: 1616-301X, Retrieved from the Internet <URL:https://onlinelibrary.wiley. com/doi/full-xml/10.1002/adfm.202005292> DOI: 10.1002/adfm.202005292**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 4 099 420 B1

## Description

FIELD OF THE INVENTION

The present application relates to compositions, layers including the compositions, light-emitting devices including the compositions, and electronic apparatuses including the light-emitting devices.

BACKGROUND OF THE INVENTION

From among light-emitting devices, organic light-emitting devices (OLEDs) are self-emissive devices, which have improved characteristics in terms of viewing angles, response time, luminance, driving voltage, and response speed. In addition, OLEDs can produce full-color images.

In an example, an organic light-emitting device includes an anode, a cathode, and an organic layer that is arranged between the anode and the cathode, and where the organic layer includes an emission layer. A hole transport region may be arranged between the anode and the emission layer, and an electron transport region may be arranged between the emission layer and the cathode. Holes provided from the anode may move toward the emission layer through the hole transport region, and electrons provided from the cathode may move toward the emission layer through the electron transport region. The holes and the electrons may recombine in the emission layer to produce excitons. These excitons may then transition from an excited state to a ground state to generate light.

SUMMARY OF THE INVENTION

Provided are compositions that provide excellent luminescence efficiency or the like, layers including the compositions, light-emitting devices including the compositions, and electronic apparatuses including the light-emitting devices.

Additional aspects will be set forth in part in the detailed description, which follows and, in part, will be apparent from the detailed description, or may be learned by practice of the presented exemplary embodiments.

The composition of the invention is defined in claim 1.

According to another aspect, a layer includes the composition.

According to still another aspect, a light-emitting device includes a first electrode; a second electrode; and an organic layer arranged between the first electrode and the second electrode, wherein the organic layer includes an emission layer, and wherein the organic layer includes the composition.

For example, the emission layer of the organic layer in the light-emitting device may include the composition.

According to yet another aspect, an electronic apparatus includes the light-emitting device.

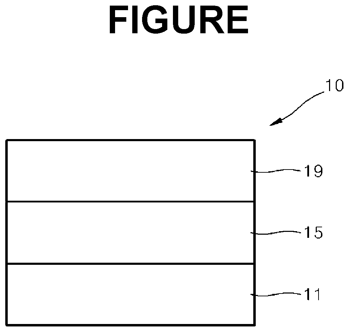

BRIEF DESCRIPTION OF THE DRAWING

The above and other aspects, features, and advantages of certain exemplary embodiments will be more apparent from the following detailed description taken in conjunction with the FIGURE, which is a schematic cross-sectional view showing a light-emitting device according to one or more embodiments.

DETAILED DESCRIPTION OF THE EMBODIMENTS

Reference will now be made in detail to embodiments, examples of which are illustrated in the accompanying drawings, wherein like reference numerals refer to like elements throughout the specification. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

The terminology used herein is for the purpose of describing one or more exemplary embodiments only and is not intended to be limiting. As used herein, the singular forms "a," "an," and "the" are intended to include the plural forms as well, unless the context clearly indicates otherwise. The term "or" means "and/or." It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

It will be understood that, although the terms first, second, third etc. may be used herein to describe various

elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

It will be understood that when an element is referred to as being "on" another element, it can be directly in contact with the other element or intervening elements may be present therebetween. In contrast, when an element is referred to as being "directly on" another element, there are no intervening elements present.

Unless otherwise defined, all terms (including technical and scientific terms) used herein have the same meaning as commonly understood by one of ordinary skill in the art to which this general inventive concept belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within $\pm$ 30%, 20%, 10%, 5% of the stated value.

Hereinafter, a work function or a highest occupied molecular orbital (HOMO) energy level is expressed as an absolute value from a vacuum level. In addition, when the work function or the HOMO energy level is referred to be "deep," "high" or "large," the work function or the HOMO energy level has a large absolute value based on "0 electron Volts (eV)" of the vacuum level, while when the work function or the HOMO energy level is referred to be "shallow," "low," or "small," the work function or HOMO energy level has a small absolute value based on "0 eV" of the vacuum level.

An aspect provides a composition including a first compound and a second compound.

The first compound is an organometallic compound including platinum (Pt) and a tetradentate ligand bound thereto, and the second compound is an organometallic compound including iridium (Ir).

The first compound may include one Pt, and may not include any other metal than Pt.

The first compound may not include any other ligand than the tetradentate ligand bound to Pt.

The tetradentate ligand bound to Pt in the first compound may have excellent electrical properties and structural rigidity. In addition, the first compound including Pt and the tetradentate ligand bound thereto may have a planar structure, and in this regard, may have a relatively small dipole moment. Accordingly, a layer or a light-emitting device (e.g., an organic light-emitting device) employing the composition including the first compound may have excellent luminescence efficiency and a long lifespan.

The second compound may include one Ir, and may not include any other metal than Ir.

Each of the first compound and the second compound may be electrically neutral.

$\mu$(Pt) is about 0.5 debye to about 5.0 debye, and $\mu$(Pt) is less than $\mu$(Ir). Here, $\mu$(Pt) is a dipole moment of the first compound, and $\mu$(Ir) is a dipole moment of the second compound.

As used herein, the terms "dipole moment of the first compound" and "dipole moment of the second compound" refer to "total permanent dipole moment in the molecule of the first compound" and "total permanent dipole moment in the molecule of the second compound", respectively.

Each of $\mu$(Pt) and $\mu$(Ir) may be calculated based on density functional theory (DFT). Any various programs may be used for the quantum mechanical calculation based on the DFT, and for example, a Gaussian 16 program may be used. For example, each of $\mu$(Pt) and $\mu$(Ir) may be calculated using a density functional theory (DFT) method of a Gaussian program that is structurally optimized at a level of B3LYP/LanL2DZ for the metal (for example, platinum, iridium etc.) included in each of the first compound and the second compound and at a level of B3LYP/6-31 G(D,P) for the organic ligand (for example, the tetradentate ligand, the bidentate ligand etc.) included in each of the first compound and the second compound.

For example, each of $\mu$(Pt) and $\mu$(Ir) may be calculated according to methods described in Evaluation Example 1.

Without wishing to be bound to theory, the composition including the first compound and the second compound in which $\mu$(Pt) is about 0.5 debye to about 5.0 debye and $\mu$(Pt) is less than $\mu$(Ir) may have the following advantages:

1) in the composition, aggregation between molecules of the first compound, aggregation between molecules of the second compound, and/or aggregation between molecules of the first compound and molecules of the second compound are substantially minimized, so that the contents (e.g., weights) of the first compound and the second compound in the composition may be relatively increased without concern about aggregation between the molecules. Accordingly, a layer and a light-emitting device (e.g., an organic light-emitting device) employing the composition may have excellent luminescence efficiency and long lifespan characteristics; and

2) when an emission layer of a light-emitting device includes the composition, hole flux in the light-emitting layer is increased by the composition, so that an exciton recombination zone in the emission layer may be spaced apart from each of the interface between the emission layer and a hole transport region and the interface between the emission layer and an electron transport region, thereby improving lifespan characteristics.

In one or more embodiments, μ(Pt) may be about 1.5 debye to about 5.0 debye. In one or more embodiments, μ (Pt) may be about 0.5 debye to about 3.0 debye, about 1.0 debye to about 3.0 debye, about 1.5 debye to about 3.0 debye, about 1.7 debye to about 3.0 debye, or about 1.7 debye to about 2.7 debye.

In one or more embodiments, μ(Pt) may be about 2.0 debye to about 5.0 debye, about 3.0 debye to about 5.0 debye, or about 4.0 debye to about 5.0 debye.

In one or more embodiments, μ(Ir) may be about 4.0 debye to about 9.0 debye, about 4.5 debye to about 7.5 debye, or about 5.0 debye to about 7.0 debye.

In one or more embodiments, μ(Ir) - μ(Pt) may be about 0.3 debye to about 4.0 debye.

In one or more embodiments, μ(Ir) - μ(Pt) may be about 2.0 debye to about 4.0 debye, or about 2.0 debye to about 3.0 debye.

In one or more embodiments, μ(Ir) - μ(Pt) may be about 0.3 debye to about 1.0 debye.

The first compound emits a first light having a first spectrum, and λP(Pt) is an emission peak wavelength (nm) of the first spectrum.

The second compound emits a second light having a second spectrum, and λP(Ir) is an emission peak wavelength (nm) of the second spectrum.

λP(Pt) is evaluated from a photoluminescence spectrum measured for a first film, and λP(Ir) is evaluated from a photoluminescence spectrum measured for a second film.

The term "first film" as used herein refers to a film including the first compound, and the term "second film" as used herein refers to a film including the second compound. The first film and the second film may be manufactured using any various methods, such as a vacuum deposition method, a coating and heating method, and the like. The first film and the second film may each independently further include a compound, for example, a host described herein, other than or in addition to the first compound and the second compound. As used herein, the term "emission peak wavelength" (also refered to as "peak emission wavelenth" or "emission peak wavelength maximum") refers to a wavelength in the emission peak at which the emission intensity is maximum.

For example, the evaluation method of λP(Pt) and λP(Ir) may be as described in Evaluation Example 2.

The absolute value of a difference between λP(Pt) and λP(Ir) is 0 nanometers (nm) to 30 nm, preferably 0 nm to about 20 nm, or 0 nm to about 10 nm.

In one or more embodiments, λP(Pt) may be substantially the same as λP(Ir), or λP(Pt) may be equal to λP(Ir).

In one or more embodiments, λP(Pt) may be less than λP(Ir).

In one or more embodiments, λP(Pt) may be greater than λP(Ir).

In one or more embodiments, each of λP(Pt) and λP(Ir) may be about 510 nm to about 570 nm.

In one or more embodiments, each of λP(Pt) and λP(Ir) may be about 510 nm to about 540 nm.

In one or more embodiments, λP(Pt) may be about 510 nm to about 530 nm, and λP(Ir) may be about 520 nm to about 540 nm.

In one or more embodiments, each of λP(Pt) and λP(Ir) may be about 540 nm to about 570 nm.

In one or more embodiments, λP(Pt) may be about 540 nm to about 560 nm, and λP(Ir) may be about 550 nm to about 570 nm.

In one or more embodiments, each of the first light and the second light may be green light.

In one or more embodiments, the first light may be green light, and the second light may be yellowish-green light.

In one or more embodiments, each of the first light and the second light may be yellowish-green light.

In one or more embodiments, the first light may be yellowish-green light, and the second light may be yellow light.

In one or more embodiments, each of the first light and the second light may be yellow light.

In one or more embodiments, the first compound may be an organic compound including a) a chemical bond (e.g., a covalent bond) between a carbon atom of the tetradentate ligand and Pt, and b) a chemical bond (e.g., a covalent bond) between an oxygen atom of the tetradentate ligand and Pt. The first compound may further include a chemical bond (e.g., a coordinate bond) between a nitrogen atom of the tetradentate ligand and Pt.

In one or more embodiments, the first compound may be an organic compound including a) a chemical bond

(e.g., a covalent bond) between a carbon atom of the tetradentate ligand and Pt, and b) a chemical bond (e.g., a covalent bond) between a sulfur atom of the tetradentate ligand and Pt. The first compound may further include a chemical bond (e.g., a coordinate bond) between a nitrogen atom of the tetradentate ligand and Pt.

In one or more embodiments, the second compound may include a first ligand, a second ligand, and a third ligand,

a) the first ligand, the second ligand, and the third ligand may be identical to each other, b) the first ligand and the second ligand may be identical to each other, and the second ligand and the third ligand may be different from each other, or c) the first ligand, the second ligand, and the third ligand may be different from each other, and
each of the first ligand, the second ligand, and the third ligand may include:

a bidentate ligand bound to Ir of the second compound via two nitrogen atoms;
a bidentate ligand bound to Ir of the second compound via a nitrogen atom and a carbon atom; or
a bidentate ligand bound to Ir of the second compound via two carbon atoms.

For example, each of the first ligand, the second ligand, and the third ligand may be a bidentate ligand bound to iridium of the second compound via a nitrogen atom and a carbon atom.

In one or more embodiments, the first compound may be an organometallic compound represented by Formula 1, and the second compound may be an organometallic compound represented by Formula 2:

Formula 1

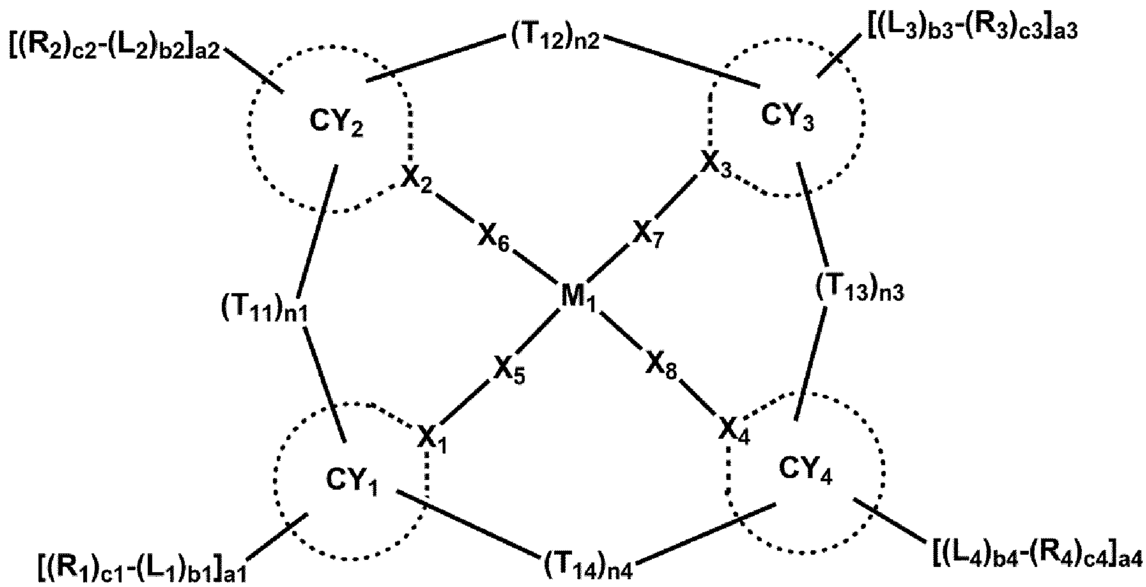

Formula 2 $M_2(L_{11})_{n11}(L_{12})_{n12}(L_{13})_{n13}$

wherein $M_1$ in Formula 1 may be Pt, and $M_2$ in Formula 2 may be Ir.

In Formula 2, $L_{11}$ may be a ligand represented by Formula 2-1, $L_{12}$ may be a ligand represented by Formula 2-2, and $L_{13}$ may be a ligand represented by Formula 2-1 or 2-2:

Formula 2-1

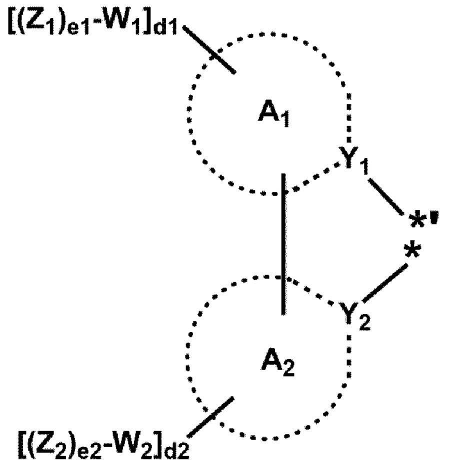

Formula 2-2

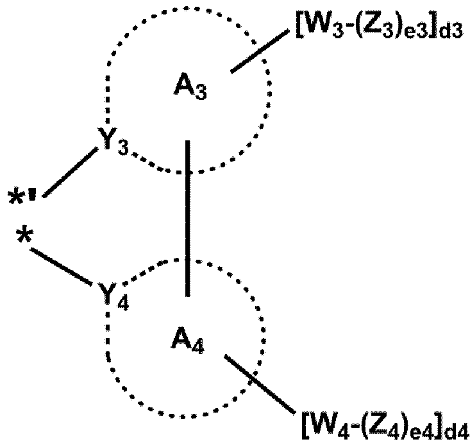

wherein Formulae 2-1 and 2-2 may be as described herein.

In Formula 2, $L_{11}$ and $L_{12}$ may be different from each other.

In Formula 2, n11 to n13 each indicates the number of $L_{11}$(s) to the number of $L_{13}$(s), respectively, and may each independently be 0, 1, 2, or 3, wherein a sum of n11 + n12 + n13 may be 3.

In one or more embodiments, in Formula 2, n11 may be 1, 2, or 3, and n12 and n13 may each independently be 0, 1, or 2.

In one or more embodiments, in Formula 2, n12 may be 1, 2, or 3, and n11 and n13 may each independently be 0, 1, or 2.

In one or more embodiments, n11 may be 1, n12 may be 2, and n13 may be 0.

In one or more embodiments, n11 may be 2, n12 may be 1, and n13 may be 0.

In one or more embodiments, n11 may be 3, and n12 and n13 may each be 0.

In one or more embodiments, n12 may be 3, and n11 and n13 may each be 0.

The second compound represented by Formula 2 may be a heteroleptic complex or a homoleptic complex.

For example, the second compound may be a heteroleptic complex.

In Formulae 1, 2-1, and 2-2, $X_1$ to $X_4$ and $Y_1$ to $Y_4$ may each independently be C or N.

In one or more embodiments, at least one of $X_1$ to $X_4$ in Formula 1 may be C.

In one or more embodiments, $X_1$ in Formula 1 may be C.

In one or more embodiments, in Formula 1, i) $X_1$ and $X_3$ may each be C, and $X_2$ and $X_4$ may each be N, or ii) $X_1$ and $X_4$ may each be C, and $X_2$ and $X_3$ may each be N.

In one or more embodiments, in Formulae 2-1 and 2-2, $Y_1$ and $Y_3$ may each be N, and $Y_2$ and $Y_4$ may each be C.

In Formula 1, $X_5$ to $X_8$ may each independently be a chemical bond, O, S, N(R'), C(R')(R"), or C(=O), wherein at least one of $X_5$ to $X_8$ may not be a chemical bond. R' and R" may each be as described herein.

In one or more embodiments, $X_5$ in Formula 1 may not be a chemical bond.

In one or more embodiments, $X_5$ in Formula 1 may be O or S.

In one or more embodiments, in Formula 1, $X_5$ may be O or S, and $X_6$ to $X_8$ may each be a chemical bond.

In Formula 1, two bonds of a bond between $X_5$ or $X_1$ and $M_1$, a bond between $X_6$ or $X_2$ and $M_1$, a bond between $X_7$ or $X_3$ and $M_1$, and a bond between $X_8$ or $X_4$ and $M_1$ may each be a coordinate bond, and the other two bonds may each be a covalent bond.

For example, in Formula 1, a bond between $X_2$ and M may be a coordinate bond.

In one or more embodiments, in Formula 1, a bond between $X_5$ or $X_1$ and M and a bond between $X_3$ and M may each be a covalent bond, and a bond between $X_2$ and M and a bond between $X_4$ and M may each be a coordinate bond.

In one or more embodiments, the first compound and the second compound may each be electrically neutral.

In Formulae 1, 2-1, and 2-2, ring $CY_1$ to ring $CY_4$ and ring $A_1$ to ring $A_4$ may each independently be a $C_5$-$C_{30}$ carbocyclic group or a $C_1$-$C_{30}$ heterocyclic group.

For example, each of ring $CY_1$, ring $CY_3$, and ring $CY_4$ may not be a benzimidazole group.

For example, in Formulae 1, 2-1, and 2-2, ring $CY_1$ to ring $CY_4$ and ring $A_1$ to $A_4$ may each independently be i) a first ring, ii) a second ring, iii) a condensed ring in which two or more first rings are condensed with each other, iv) a condensed ring in which two or more second rings are condensed with each other, or v) a condensed ring in which one or more first rings and one or more second rings are condensed with each other,

wherein the first ring may be a cyclopentane group, a cyclopentene group, a furan group, a thiophene group, a pyrrole group, a silole group, a borole group, a phosphole group, a germole group, a selenophene group, an oxazole group, an oxadiazole group, an oxatriazole group, a thiazole group, a thiadiazole group, a thiatriazole group, a pyrazole group, an imidazole group, a triazole group, a tetrazole group, or an azasilole group, and

the second ring may be an adamantane group, a norbornane group, a norbornene group, a piperidine group, a cyclohexane group, a cyclohexene group, a benzene group, a pyridine group, a pyrimidine group, a pyrazine group, a pyridazine group, or a triazine group.

In one or more embodiments, in Formulae 1, 2-1, and 2-2, ring $CY_1$ to ring $CY_4$ and ring $A_1$ to ring $A_4$ may each independently be a cyclopentane group, a cyclohexane group, a cyclohexene group, a benzene group, a naphthalene group, an anthracene group, a phenanthrene group, a triphenylene group, a pyrene group, a chrysene group, a 1 ,2,3,4-tetrahydronaphthalene group, a cyclopentadiene group, a pyrrole group, a furan group, a thiophene group, a silole group, a borole group, a phosphole group, a germole group, a selenophene group, an indene group, an indole group, a benzofuran group, a benzothiophene group, a benzosilole group, a benzoborole group, a benzophosphole group, a benzogermole group, a benzoselenophene group, a fluorene group, a carbazole group, a dibenzofuran group, a dibenzothiophene group, a dibenzosilole group, a dibenzoborole group, a dibenzophosphole group, a dibenzogermole group, a dibenzoselenophene group, a benzofluorene group, a benzocarbazole group, a naphthobenzofuran group, a naphthobenzothiophene group, a naphthobenzosilole group, a naphthobenzoborole group, a naphthobenzophosphole group, a naphthobenzogermole group, a naphthobenzoselenophene group, a dibenzofluorene group, a dibenzocarbazole group, a dinaphthofuran group, a dinaphthothiophene group, a dinaphthosilole group, a dinaphthoborole group, a dinaphthophosphole group, a dinaphthogermole group, a dinaphthoselenophene group, an indenophenanthrene group, an indolophenanthrene group, a phenanthrobenzofuran group, a phenanthrobenzothiophene group, a phenanthrobenzosilole group, a phenanthrobenzoborole group, a phenanthrobenzophosphole group, a phenanthrobenzogermole group, a phenanthrobenzoselenophene group, a dibenzothiophene 5-oxide group, a 9H-fluorene-9-one group, a dibenzothiophene 5,5-dioxide group, an azaindene group, an azaindole group, an azabenzofuran group, an azabenzothiophene group, an azabenzosilole group, an azabenzoborole group, an azabenzophosphole group, an azabenzogermole group, an azabenzoselenophene group, an azafluorene group, an azacarbazole group, an azadibenzofuran group, an azadibenzothiophene group, an azadibenzosilole group, an azadibenzoborole group, an azadibenzophosphole group, an azadibenzogermole group, an azadibenzoselenophene group, an azabenzofluorene group, an azabenzocarbazole group, an azanaphthobenzofuran group, an azanaphthobenzothiophene group, an azanaphthobenzosilole group, an azanaphthobenzoborole group, an azanaphthobenzophosphole group, an azanaphthobenzogermole group, an azanaphthobenzoselenophene group, an azadibenzofluorene group, an azadibenzocarbazole group, an azadinaphthofuran group, an azadinaphthothiophene group, an azadinaphthosilole group, an azadinaphthoborole group, an azadinaphthophosphole group, an azadinaphthogermole group, an azadinaphthoselenophene group, an azaindenophenanthrene group, an azaindolophenanthrene group, an azaphenanthrobenzofuran group, an azaphenanthrobenzothiophene group, an azaphenanthrobenzosilole group, an azaphenanthrobenzoborole group, an azaphenanthrobenzophosphole group, an azaphenanthrobenzogermole group, an azaphenanthrobenzoselenophene group, an azadibenzothiophene 5-oxide group, an aza9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a benzoquinoline group, a benzoisoquinoline group, a benzoquinoxaline group, a benzoquinazoline group, a phenanthroline group, a phenanthridine group, a pyrrole group, a pyrazole group, imidazole group, a triazole group, an oxazole group, an isoxazole group, thiazole group, an isothiazole group, an oxadiazole group, a thiadiazole group, an azasilole group, an azaborole group, an azaphosphole group, an azagermole group, an azaselenophene group, a benzopyrrole group, a benzopyrazole group, a benzimidazole group, a benzoxazole group, a benzisoxazole group, a benzothiazole group, a benzisothiazole group, a benzoxadiazole group, a benzothiadiazole group, a pyridinopyrrole group, a pyridinopyrazole group, a pyridinoimidazole group, a pyridinooxazole group, a pyridinoisoxazole group, a pyridinothiazole group, a pyridinoisothiazole group, a pyridinooxadiazole group, a pyridinothiadiazole group, a pyrimidinopyrrole group, a pyrimidinopyrazole group, a pyrimidinoimidazole group, a pyrimidinoxazole group, a pyrimidinoisoxazole group, a pyrimidinothiazole group, a pyrimidinoisothiazole group, a pyrimidinooxadiazole group, a pyrimidinothiadiazole group, a naphthopyrrole group, a naphthopyrazole group, a naphthoimidazole group, a naphthoxazole group, a naphthoisoxazole group, a naphthothiazole group, a naphthoisothiazole group, a naphthoxadiazole group, a naphthothiadiazole group, a phenanthrenopyrrole group, a phenanthrenopyrazole group, a phenanthrenoimidazole group, a phenanthrenoxazole group, a phenanthrenoisoxazole group, a phenanthrenothiazole group, a phenanthrenoisothiazole group, a phenanthrenoxadiazole group, a phenanthrenothiadiazole group, a 5,6,7,8-tetrahydroisoquinoline group, a 5,6,7,8-tetrahydroquinoline group, an adamantane group, a norbornane group, a norbornene group, a benzene group condensed with a cyclohexane group, a benzene group condensed with a norbornane group, a pyridine group condensed with a cyclohexane group, or a pyridine group condensed with a norbornane group.

In one or more embodiments, ring $CY_1$ and ring $CY_3$ in Formula 1 may each independently be:

a benzene group, a naphthalene group, a phenanthrene group, a dibenzofuran group, a dibenzothiophene group, a dibenzoselenophene group, a carbazole group, a fluorene group, or a dibenzosilole group; or
a benzene group, a naphthalene group, a phenanthrene group, a dibenzofuran group, a dibenzothiophene group, a dibenzoselenophene group, a carbazole group, a fluorene group, or a dibenzosilole group, each condensed with at least one of a cyclohexane group, a cyclohexene group, a norbornane group, a piperidine group, or a combination thereof.

In one or more embodiments, ring $CY_2$ in Formula 1 may be:

an imidazole group, a benzimidazole group, a pyridine group, a pyrimidine group, a pyridazine group, a pyrazine group, a triazine group, a quinoline group, an isoquinoline group, a quinoxaline group, or a quinazoline group; or
an imidazole group, a benzimidazole group, a pyridine group, a pyrimidine group, a pyridazine group, a pyrazine group, a triazine group, a quinoline group, an isoquinoline group, a quinoxaline group, or a quinazoline group, each condensed with at least one of a cyclohexane group, a cyclohexene group, a norbornane group, a benzene group, a pyridine group, a pyrimidine group, or a combination thereof.

In one or more embodiments, ring $CY_4$ in Formula 1 may be:

a pyridine group, a pyrimidine group, a pyridazine group, a pyrazine group, a triazine group, a quinoline group, an isoquinoline group, a quinoxaline group, a quinazoline group, an azadibenzofuran group, an azadibenzothiophene group, an azadibenzoselenophene group, an azacarbazole group, an azafluorene group, or an azadibenzosilole group; or
a pyridine group, a pyrimidine group, a pyridazine group, a pyrazine group, a triazine group, a quinoline group, an isoquinoline group, a quinoxaline group, a quinazoline group, an azadibenzofuran group, an azadibenzothiophene group, an azadibenzoselenophene group, an azacarbazole group, an azafluorene group, or an azadibenzosilole group, each condensed with at least one of a cyclohexane group, a cyclohexene group, a norbornane group, a benzene group, a pyridine group, a pyrimidine group, or a combination thereof.

In Formulae 2-1 and 2-2, ring $A_1$ and ring $A_3$ may be different from each other.
In one or more embodiments, a $Y_1$-containing monocyclic group in ring $A_1$, a $Y_2$-containing monocyclic group in ring $A_2$, and $Y_4$-containing monocyclic group in ring $A_4$ may each be a 6-membered ring.
In one or more embodiments, a $Y_3$-containing monocyclic group in ring $A_3$ may be a 6-membered ring.
In one or more embodiments, a $Y_3$-containing monocyclic group in ring $A_3$ may be a 5-membered ring.
In one or more embodiments, a $Y_1$-containing monocyclic group in ring $A_1$ may be a 6-membered ring, and a $Y_3$-containing monocyclic group in ring $A_3$ may be a 5-membered ring.
In one or more embodiments, in Formulae 2-1 and 2-2, ring $A_1$ and ring $A_3$ may each independently be i) one of Group A, ii) a polycyclic group in which two or more of Group A are condensed with each other, or iii) a polycyclic group in which at least one of Group A and at least one of Group B are condensed with each other,

wherein Group A may include a pyridine group, a pyrimidine group, a pyridazine group, a pyrazine group, or a triazine group, and
wherein Group B may include a cyclohexane group, a cyclohexene group, a norbornane group, a benzene group, a furan group, a thiophene group, a selenophene group, a pyrrole group, a cyclopentadiene group, or silole group.

In one or more embodiments, in Formula 2-2, ring $A_3$ may be i) one of Group C, ii) a polycyclic group in which two or more of Group C are condensed with each other, or iii) a polycyclic group in which at least one of Group C and at least one of Group D are condensed with each other,

wherein Group C may include a pyrrole group, a pyrazole group, an imidazole group, a triazole group, an oxazole group, an isoxazole group, a thiazole group, or an isothiazole group, and
wherein Group D may include a cyclohexane group, a cyclohexene group, a norbornane group, a benzene group, a furan group, a thiophene group, a selenophene group, a cyclopentadiene group, a silole group, a pyridine group, a pyrimidine group, a pyridazine group, a pyrazine group, or a triazine group.

In one or more embodiments, ring $A_1$ in Formula 2-1 may be:

a pyridine group, a pyrimidine group, a pyridazine group, or a pyrazine group; or
a pyridine group, a pyrimidine group, a pyridazine group, or a pyrazine group, each condensed with at least one of a cyclohexane group, a norbornane group, a benzene group, or a combination thereof.

In one or more embodiments, ring $A_3$ in Formula 2-2 may be:

a pyridine group, a pyrimidine group, a pyridazine group, or a pyrazine group;
a pyridine group, a pyrimidine group, a pyridazine group, or a pyrazine group, each condensed with at least one of a cyclohexane group, a norbornane group, a benzene group, or a combination thereof; or
an imidazole group, a benzimidazole group, a naphthoimidazole group, a phenanthrenoimidazole group, a pyridoimidazole group, an oxazole group, a benzoxazole group, a naphthooxazole group, a phenanthrenoxazole group, a pyridooxazole group, a thiazole group, a benzothiazole group, a naphthothiazole group, a phenanthrenothiazole group, or a pyridothiazole group.

In one or more embodiments, in Formulae 2-1 and 2-2, ring $A_2$ and ring $A_4$ may be different from each other.
In one or more embodiments, in Formulae 2-1 and 2-2, ring $A_2$ and ring $A_4$ may each independently be i) one of Group E, ii) a polycyclic group in which two or more of Group E are condensed with each other, or iii) a polycyclic group in which at least one of Group E and at least one of Group F are condensed with each other,

wherein Group E may include a benzene group, a pyridine group, a pyrimidine group, a pyridazine group, a pyrazine group, or a triazine group, and
wherein Group F may include a furan group, a thiophene group, a selenophene group, a pyrrole group, a cyclopentadiene group, a silole group, a pyrazole group, an imidazole group, an oxazole group, a thiazole group, an isoxazole group, or an isothiazole group.

In one or more embodiments, in Formula 2-1, ring $A_2$ may be a polycyclic group in which two or more of Group E and at least one of Group F are condensed with each other.
In one or more embodiments, in Formula 2-2, ring $A_4$ may be a polycyclic group in which two or more of Group E and at least one of Group F may be condensed with each other.
In one or more embodiments, ring $A_2$ in Formula 2-1 may be:

a benzene group, a naphthalene group, a phenanthrene group, a dibenzofuran group, a dibenzothiophene group, a dibenzoselenophene group, a carbazole group, a fluorene group, or a dibenzosilole group; or
a benzene group, a naphthalene group, a phenanthrene group, a dibenzofuran group, a dibenzothiophene group, a dibenzoselenophene group, a carbazole group, a fluorene group, or a dibenzosilole group, each condensed with at least one of a cyclohexane group, a norbornane group, a benzene group, or a combination thereof.

In one or more embodiments, ring $A_4$ in Formula 2-2 may be:

a benzene group, a naphthalene group, a phenanthrene group, a dibenzofuran group, a dibenzothiophene group, a dibenzoselenophene group, a carbazole group, a fluorene group, a dibenzosilole group, an azadibenzofuran group, an azadibenzothiophene group, an azadibenzoselenophene group, an azacarbazole group, an azafluorene group, or a dibenzosilole group; or
a benzene group, a naphthalene group, a phenanthrene group, a dibenzofuran group, a dibenzothiophene group, a dibenzoselenophene group, a carbazole group, a fluorene group, a dibenzosilole group, an azadibenzofuran group, an azadibenzothiophene group, an azadibenzoselenophene group, an azacarbazole group, an azafluorene group, or a dibenzosilole group, each condensed with at least one of a benzene group, a pyridine group, a pyrimidine group, a pyridazine group, a pyrazine group, a cyclohexane group, a norbornane group, a furan group, a thiophene group, a selenophene group, a pyrrole group, a cyclopentadiene group, a silole group, a pyrazole group, an imidazole group, an oxazole group, a thiazole group, an isoxazole group, an isothiazole group, or a combination thereof.

In Formula 1, $T_{11}$ to $T_{14}$ may each independently be a single bond, a double bond, *-N($R_{5a}$)-*', *-B($R_{5a}$)-*', *-P($R_{5a}$)-*', *-C($R_{5a}$)($R_{5b}$)-*', *-Si($R_{5a}$)($R_{5b}$)-*', *-Ge($R_{5a}$)($R_{5b}$)-*', *-S-*', *-Se-*', *-O-*', *-C(=O)-*', *-S(=O)-*', *-S(=O)$_2$-*', *-C($R_{5a}$)=*', *=C($R_{5a}$)-*', *-C($R_{5a}$)=C($R_{5b}$)-*', *-C(=S)-*', *-C=C-*', a $C_5$-$C_{30}$ carbocyclic group that is unsubstituted or substituted with at least one $R_{10a}$, or a $C_1$-$C_{30}$ heterocyclic group that is unsubstituted or substituted with at least one $R_{10a}$.
For example, in Formula 1, each of $T_{11}$ and $T_{12}$ may be a single bond, and $T_{13}$ may be a single bond, *-N($R_{5a}$)-*', *-B($R_{5a}$)-*', *-P($R_{5a}$)-*', *-C($R_{5a}$)($R_{5b}$)-*', *-Si($R_{5a}$)($R_{5b}$)-*', *-Ge($R_{5a}$)($R_{5b}$)-*', *-S-*', or *-O-*'.
In Formula 1, n1 to n4 each indicate the number of $T_{11}$ to the number of $T_{14}$, and may each independently be 0 or 1,

wherein three or more of n1 to n4 may each independently be 1. That is, the organometallic compound represented by Formula 1 may have a tetradentate ligand.

In Formula 1, when n1 is 0, $T_{11}$ does not exist (that is, ring $CY_1$ and ring $CY_2$ are not linked to each other), when n2 is 0, $T_{12}$ does not exist (that is, ring $CY_2$ and ring $CY_3$ are not linked to each other), when n3 is 0, $T_{13}$ does not exist (that is, ring $CY_3$ and ring $CY_4$ are not linked to each other), and when n4 is 0, $T_{14}$ does not exist (that is, ring $CY_4$ and ring $CY_1$ are not linked to each other).

In one or more embodiments, in Formula 1, n1 to n3 may each be 1, and n4 may be 0.

In one or more embodiments, in Formulae 1, 2-1, and 2-2, $L_1$ to $L_4$ and $W_1$ to $W_4$ may each independently be a single bond, a $C_1$-$C_{20}$ alkylene group that is unsubstituted or substituted with at least one $R_{10a}$, a $C_5$-$C_{30}$ carbocyclic group that is unsubstituted or substituted with at least one $R_{10a}$, or a $C_1$-$C_{30}$ heterocyclic group that is unsubstituted or substituted with at least one $R_{10a}$.

In one or more embodiments, in Formulae 1, 2-1, and 2-2, $L_1$ to $L_4$ and $W_1$ to $W_4$ may each independently be:

a single bond; or

a $C_1$-$C_{20}$ alkylene group, a cyclopentene group, a cyclohexane group, a cyclohexene group, a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an iso-oxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, a 5,6,7,8-tetrahydroquinoline group, an adamantane group, a norbornane group, or a norbornene group, each unsubstituted or substituted with at least one $R_{10a}$.

In one or more embodiments, in Formulae 1, 2-1, and 2-2, $L_1$ to $L_4$ and $W_1$ to $W_4$ may each independently be:

a single bond; or

a benzene group, a naphthalene group, a pyridine group, a fluorene group, a carbazole group, a dibenzofuran group, or a dibenzothiophene group, each unsubstituted or substituted with at least one $R_{10a}$.

In one or more embodiments, in Formulae 1, 2-1, and 2-2, $L_1$ to $L_4$ and $W_1$ to $W_4$ may each independently be:

a single bond; or

a $C_1$-$C_{20}$ alkylene group, a benzene group, a naphthalene group, a dibenzofuran group, or a dibenzothiophene group, each unsubstituted or substituted with deuterium, - F, a cyano group, a $C_1$-$C_{20}$ alkyl group, a deuterated $C_1$-$C_{20}$ alkyl group, a fluorinated $C_1$-$C_{20}$ alkyl group, a $C_3$-$C_{10}$ cycloalkyl group, a deuterated $C_3$-$C_{10}$ cycloalkyl group, a fluorinated $C_3$-$C_{10}$ cycloalkyl group, a ($C_1$-$C_{20}$ alkyl)$C_3$-$C_{10}$ cycloalkyl group, a phenyl group, a deuterated phenyl group, a fluorinated phenyl group, a ($C_1$-$C_{20}$ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, or a combination thereof.

In Formula 1, b1 to b4 indicate the number of $L_1$(s) to the number of $L_4$(s), respectively, and may each independently be an integer from 1 to 10. When b1 is 2 or more, two or more of $L_1$(s) may be identical to or different from each other, when b2 is 2 or more, two or more of $L_2$(s) may be identical to or different from each other, when b3 is 2 or more, two or more of $L_3$(s) may be identical to or different from each other, and when b4 is 2 or more, two or more of $L_4$(s) may be identical to or different from each other. For example, b1 to b4 may each independently be 1, 2, or 3.

In Formulae 1, 2-1, and 2-2, $R_1$ to $R_4$, $R_{5a}$, $R_{5b}$, R', R", and $Z_1$ to $Z_4$ may each independently be hydrogen,

deuterium, -F, -Cl, -Br, -I, $-SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, a substituted or unsubstituted monovalent non-aromatic condensed heteropolycyclic group, $-N(Q_1)(Q_2)$, $-Si(Q_3)(Q_4)(Q_5)$, $-Ge(Q_3)(Q_4)(Q_5)$, $-B(Q_6)(Q_7)$, $-P(=O)(Q_8)(Q_9)$, or $-P(Q_8)(Q_9)$. $Q_1$ to $Q_9$ may each be as described herein.

In Formulae 1, 2-1, and 2-2, $R_1$ to $R_4$, $R_{5a}$, $R_{5b}$, R, R", and $Z_1$ to $Z_4$ may each independently be:

hydrogen, deuterium, -F, -Cl, -Br, -I, -SFs, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_2$-$C_{20}$ alkenyl group, a $C_1$-$C_{20}$ alkoxy group, or a $C_1$-$C_{20}$ alkylthio group;

a $C_1$-$C_{20}$ alkyl group, a $C_2$-$C_{20}$ alkenyl group, a $C_1$-$C_{20}$ alkoxy group, or a $C_1$-$C_{20}$ alkylthio group, each substituted with at least one of deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a cyclopentyl group, a cyclohexyl group, a cycloheptyl group, a cyclooctyl group, an adamantanyl group, a norbornanyl group(i.e., a bicyclo[2.2.1]heptyl group), a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornanyl group, a ($C_1$-$C_{20}$ alkyl) norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl) cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, a naphthyl group, a pyridinyl group, a pyrimidinyl group, or a combination thereof;

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a phenyl group, a ($C_1$-$C_{20}$ alkyl) phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, or an azadibenzothiophenyl group, each unsubstituted or substituted with at least one of deuterium, -F, -Cl, -Br, -I, - SFs, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a deuterated $C_1$-$C_{20}$ alkyl group, a fluorinated alkyl group, a $C_1$-$C_{20}$ alkoxy group, a $C_1$-$C_{20}$ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2] octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl) cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.2]octyl group, a phenyl group, a ($C_1$-$C_{20}$ alkyl)phenyl group, a deuterated phenyl group, a fluorinated

phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, or a combination thereof; or

$-N(Q_1)(Q_2)$, $-Si(Q_3)(Q_4)(Q_5)$, $-Ge(Q_3)(Q_4)(Q_5)$, $-B(Q_6)(Q_7)$, $-P(=O)(Q_8)(Q_9)$, or - $P(Q_3)(Q_9)$, and

$Q_1$ to $Q_9$ may each independently be:

deuterium, -F, $-CH_3$, $-CD_3$, $-CD_2H$, $-CDH_2$, $-CH_2CH_3$, $-CH_2CD_3$, $-CH_2CD_2H$, - $CH_2CDH_2$, $-CHDCH_3$, $-CHDCD_2H$, $-CHDCDH_2$, $-CHDCD_3$, $-CD_2CD_3$, $-CD_2CD_2H$, - $CD_2CDH_2$, $-CF_3$, $-CF_2H$, $-CFH_2$, $-CH_2CF_3$, $-CH_2CF_2H$, $-CH_2CFH_2$, $-CHFCH_3$, $-CHFCF_2H$, $-CHFCFH_2$, $-CHFCF_3$, $-CF_2CF_3$, $-CF_2CF_2H$, or $-CF_2CFH_2$; or

an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with at least one of deuterium, -F, a $C_1$-$C_{10}$ alkyl group, a phenyl group, or a combination thereof.

In one or more embodiments, in Formulae 1, 2-1, and 2-2, $R_1$ to $R_4$, $R_{5a}$, $R_{5b}$, R, R", and $Z_1$ to $Z_4$ may each independently be:

hydrogen, deuterium, -F, or a cyano group;

a $C_1$-$C_{20}$ alkyl group unsubstituted or substituted with at least one of deuterium, - F, a cyano group, a $C_3$-$C_{10}$ cycloalkyl group, a deuterated $C_3$-$C_{10}$ cycloalkyl group, a fluorinated $C_3$-$C_{10}$ cycloalkyl group, a ($C_1$-$C_{20}$ alkyl)$C_3$-$C_{10}$ cycloalkyl group, a $C_1$-$C_{10}$ heterocycloalkyl group, a deuterated $C_1$-$C_{10}$ heterocycloalkyl group, a fluorinated $C_1$-$C_{10}$ heterocycloalkyl group, a ($C_1$-$C_{20}$ alkyl)$C_1$-$C_{10}$ heterocycloalkyl group, a phenyl group, a deuterated a phenyl group, a fluorinated a phenyl group, a ($C_1$-$C_{20}$ alkyl)phenyl group, a biphenyl group, a deuterated biphenyl group, a fluorinated biphenyl group, a ($C_1$-$C_{20}$ alkyl)biphenyl group, a dibenzofuranyl group, a deuterated dibenzofuranyl group, a fluorinated dibenzofuranyl group, a ($C_1$-$C_{20}$ alkyl)dibenzofuranyl group, a dibenzothiophenyl group, a deuterated dibenzothiophenyl group, a fluorinated dibenzothiophenyl group, a ($C_1$-$C_{20}$ alkyl)dibenzothiophenyl group, or a combination thereof;

a $C_3$-$C_{10}$ cycloalkyl group, a $C_1$-$C_{10}$ heterocycloalkyl group, a phenyl group, a biphenyl group, a naphthyl group, a pyridinyl group, a fluorenyl group, a carbazolyl group, a dibenzofuranyl, or a dibenzothiophenyl group, each unsubstituted or substituted with at least one of deuterium, -F, a cyano group, a $C_1$-$C_{20}$ alkyl group, a deuterated $C_1$-$C_{20}$ alkyl group, fluorinated $C_1$-$C_{20}$ alkyl group, a $C_1$-$C_{20}$ alkoxy group, a deuterated $C_1$-$C_{20}$ alkoxy group, a fluorinated $C_1$-$C_{20}$ alkoxy group, a $C_1$-$C_{20}$ alkylthio group, a $C_3$-$C_{10}$ cycloalkyl group, a deuterated $C_3$-$C_{10}$ cycloalkyl group, a fluorinated $C_3$-$C_{10}$ cycloalkyl group, a ($C_1$-$C_{20}$ alkyl)$C_3$-$C_{10}$ cycloalkyl group, a $C_1$-$C_{10}$ heterocycloalkyl group, a deuterated $C_1$-$C_{10}$ heterocycloalkyl group, a fluorinated $C_1$-$C_{10}$ heterocycloalkyl group, a ($C_1$-$C_{20}$ alkyl) $C_1$-$C_{10}$ heterocycloalkyl group, a phenyl group, a deuterated phenyl group, a fluorinated a phenyl group, a ($C_1$-$C_{20}$ alkyl)phenyl group, a biphenyl group, a deuterated biphenyl group, a fluorinated biphenyl group, a ($C_1$-$C_{20}$ alkyl) biphenyl group, a dibenzofuranyl group, a deuterated dibenzofuranyl group, a fluorinated dibenzofuranyl group, a ($C_1$-$C_{20}$ alkyl)dibenzofuranyl group, a dibenzothiophenyl group, a deuterated dibenzothiophenyl group, a fluorinated dibenzothiophenyl group, a ($C_1$-$C_{20}$ alkyl)dibenzothiophenyl group, or a combination thereof; or

$-Si(Q_3)(Q_4)(Q_5)$ or $-Ge(Q_3)(Q_4)(Q_5)$.

In one or more embodiments, in Formula 2-1, each of e1 and d1 may not be 0, and at least one of a plurality of $Z_1$(s) may be a deuterated $C_1$-$C_{20}$ alkyl group, - $Si(Q_3)(Q_4)(Q_5)$, or $-Ge(Q_3)(Q_4)(Q_5)$. $Q_3$ to $Q_5$ may each be as described herein.

In one or more embodiments, $Q_3$ to $Q_5$ may each independently be:

a $C_1$-$C_{60}$ alkyl group unsubstituted or substituted with at least one of deuterium, a $C_1$-$C_{60}$ alkyl group, a $C_6$-$C_{60}$ aryl group, or a combination thereof; or

a $C_6$-$C_{60}$ aryl group unsubstituted or substituted with at least one of deuterium, a $C_1$-$C_{60}$ alkyl group, a $C_6$-$C_{60}$ aryl group, or a combination thereof.

In one or more embodiments, $Q_3$ to $Q_5$ may each independently be:

$-CH_3$, $-CD_3$, $-CD_2H$, $-CDH_2$, $-CH_2CH_3$, $-CH_2CD_3$, $-CH_2CD_2H$, $-CH_2CDH_2$, - $CHDCH_3$, $-CHDCD_2H$, $-CHDCDH_2$, $-CHDCD_3$, $-CD_2CD_3$, $-CD_2CD_2H$, or $-CD_2CDH_2$; or

an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with at least one of deuterium, a $C_1$-$C_{10}$ alkyl group, a phenyl group, or a combination thereof.

In one or more embodiments, $Q_3$ to Qs may be identical to each other.

In one or more embodiments, two or more of $Q_3$ to $Q_5$ may be different from each other.

In one or more embodiments, the second compound may satisfy at least one of Condition (1) to Condition (8):

Condition (1)
Each of e1 and d1 in Formula 2-1 is not 0, and at least one $Z_1$ includes deuterium;

Condition (2)
Each of e2 and d2 in Formula 2-1 is not 0, and at least one $Z_2$ includes deuterium;

Condition (3)
Each of e3 and d3 in Formula 2-2 is not 0, and at least one $Z_3$ includes deuterium;

Condition (4)
Each of e4 and d4 in Formula 2-2 is not 0, and at least one $Z_4$ includes deuterium;

Condition (5)
Each of e1 and d1 in Formula 2-1 is not 0, and at least one $Z_1$ includes a fluoro group;

Condition (6)
Each of e2 and d2 in Formula 2-1 is not 0, and at least one $Z_2$ includes a fluoro group;

Condition (7)
Each of e3 and d3 in Formula 2-2 is not 0, and at least one $Z_3$ includes a fluoro group; and

Condition (8)
Each of e4 and d4 in Formula 2-2 is not 0, and at least one $Z_4$ includes a fluoro group.

In one or more embodiments, in Formulae 1, 2-1, and 2-2, $R_1$ to $R_4$, $R_{5a}$, $R_{5b}$, R, R", and $Z_1$ to $Z_4$ may each independently be hydrogen, deuterium, -F, $-CH_3$, $-CD_3$, $-CD_2H$, $-CDH_2$, $-CF_3$, $-CF_2H$, $-CFH_2$, a $C_2$-$C_{10}$ alkenyl group, a $C_1$-$C_{10}$ alkoxy group, a $C_1$-$C_{10}$ alkylthio group, a group represented by one of Formulae 9-1 to 9-39, a group represented by one of Formulae 9-1 to 9-39 in which at least one hydrogen is substituted with deuterium, a group represented by one of Formulae 9-1 to 9-39 in which at least one hydrogen is substituted with -F, a group represented by one of Formulae 9-201 to 9-227, a group represented by one of Formulae 9-201 to 9-227 in which at least one hydrogen is substituted with deuterium, a group represented by one of Formulae 9-201 to 9-227 in which at least one hydrogen is substituted with -F, a group represented by one of Formulae 10-1 to 10-129, a group represented by one of Formulae 10-1 to 10-129 in which at least one hydrogen is substituted with deuterium, a group represented by one of Formulae 10-1 to 10-129 in which at least one hydrogen is substituted with -F, a group represented by one of Formulae 10-201 to 10-350, a group represented by one of Formulae 10-201 to 10-350 in which at least one hydrogen is substituted with deuterium, a group represented by one of Formulae 10-201 to 10-350 in which at least one hydrogen is substituted with -F, $-Si(Q_3)(Q_4)(Q_5)$, or $-Ge(Q_3)(Q_4)(Q_5)$ ($Q_3$ to $Q_5$ may each be as described herein):

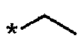
9-1

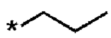
9-2

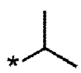
9-3

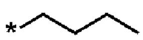
9-4

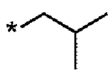
9-5

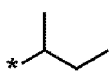
9-6

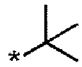
9-7

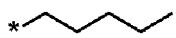
9-8

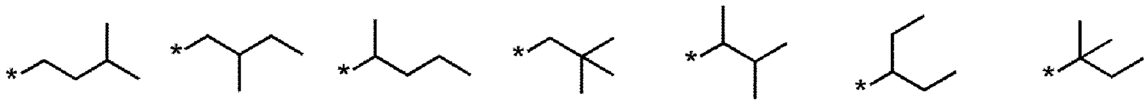

9-9 9-10 9-11 9-12 9-13 9-14 9-15

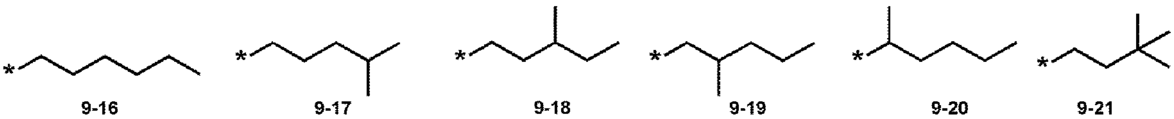

9-16 9-17 9-18 9-19 9-20 9-21

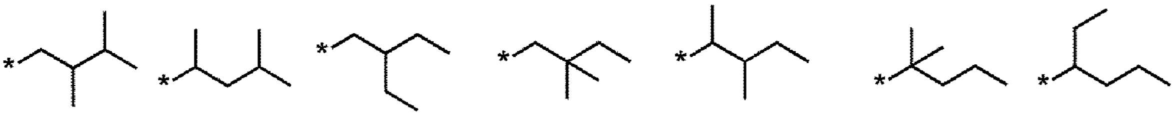

9-22 9-23 9-24 9-25 9-26 9-27 9-28

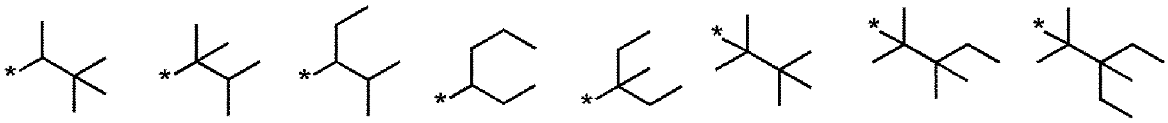

9-29 9-30 9-31 9-32 9-33 9-34 9-35 9-36

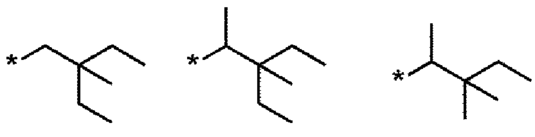

9-37 9-38 9-39

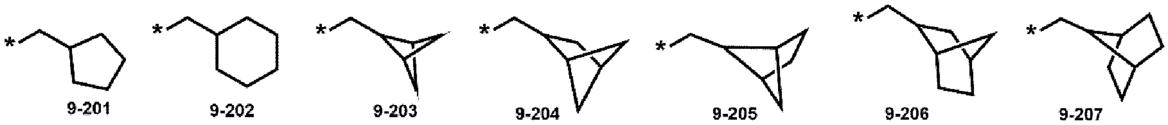

9-201 9-202 9-203 9-204 9-205 9-206 9-207

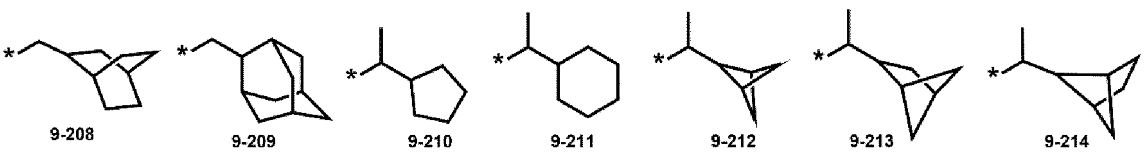

9-208 9-209 9-210 9-211 9-212 9-213 9-214

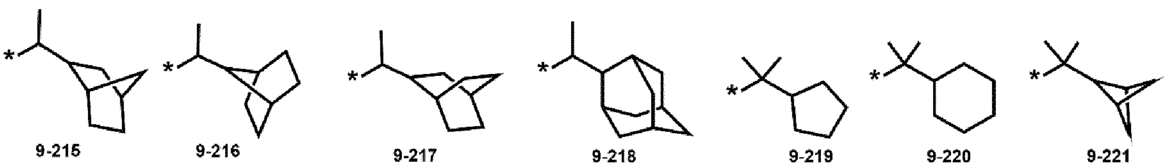

9-215 9-216 9-217 9-218 9-219 9-220 9-221

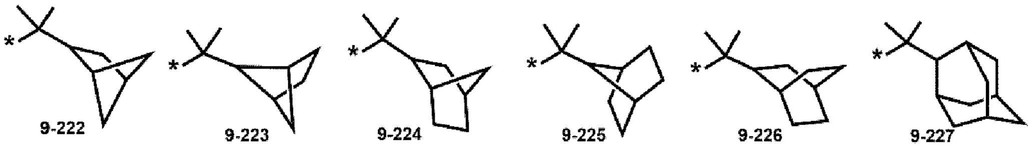

9-222 9-223 9-224 9-225 9-226 9-227

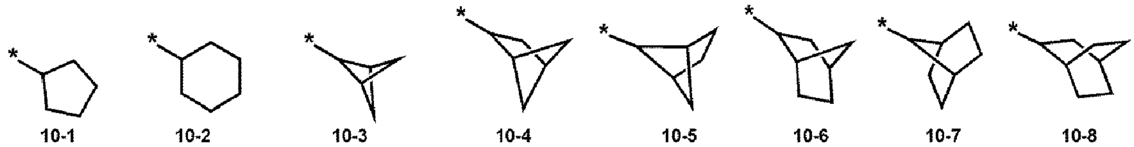

10-1 10-2 10-3 10-4 10-5 10-6 10-7 10-8

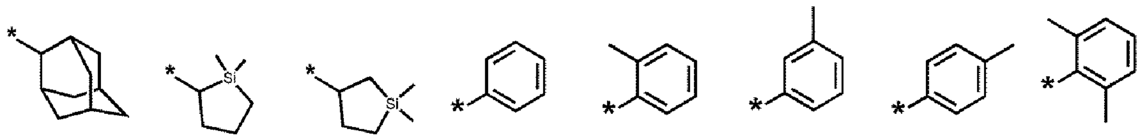

10-9 10-10 10-11 10-12 10-13 10-14 10-15 10-16

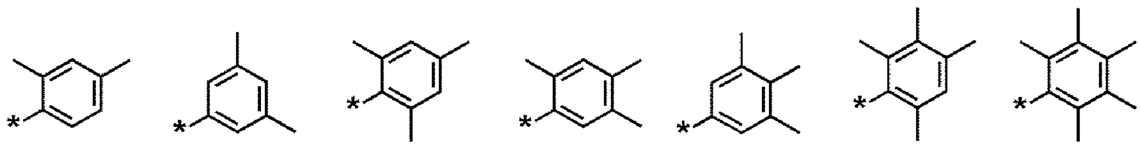

10-17 10-18 10-19 10-20 10-21 10-22 10-23

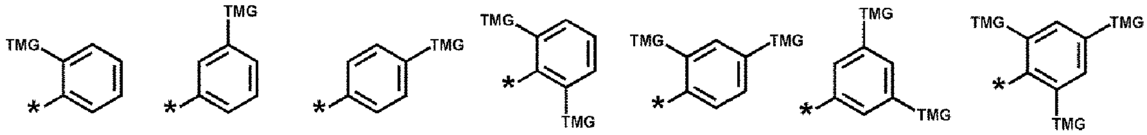

10-24 10-25 10-26 10-27 10-28 10-29 10-30

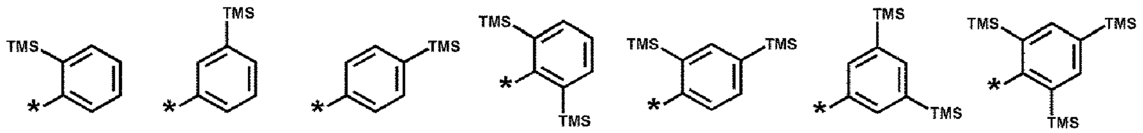

10-31 10-32 10-33 10-34 10-35 10-36 10-37

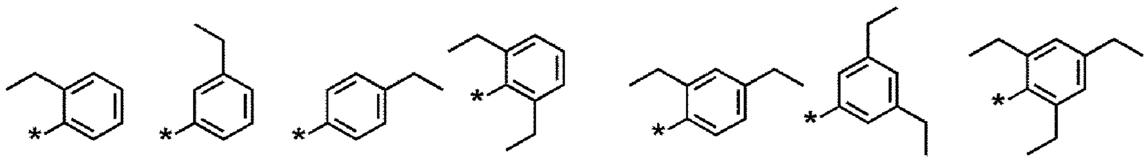

10-38 10-39 10-40 10-41 10-42 10-43 10-44

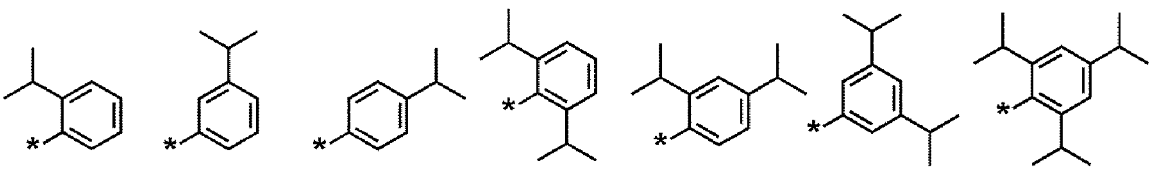

10-45 10-46 10-47 10-48 10-49 10-50 10-51

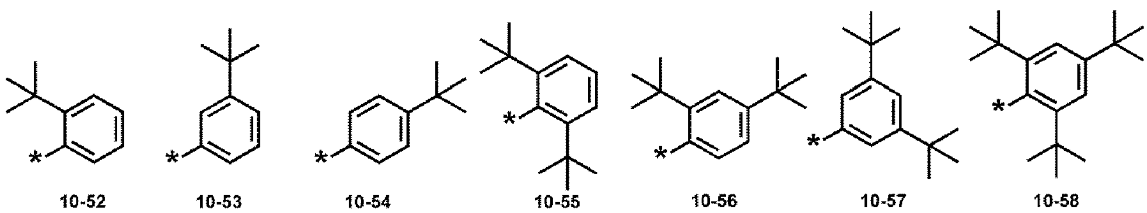

10-52 10-53 10-54 10-55 10-56 10-57 10-58

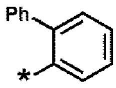 10-59 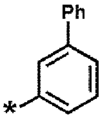 10-60 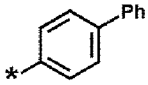 10-61 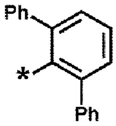 10-62 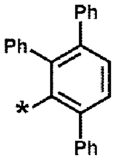 10-63 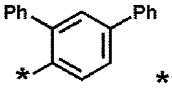 10-64 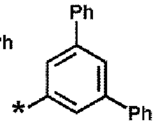 10-65 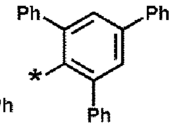 10-66

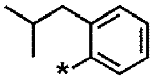 10-67 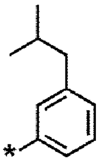 10-68 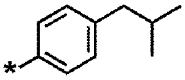 10-69 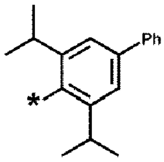 10-70 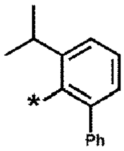 10-71 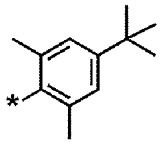 10-72

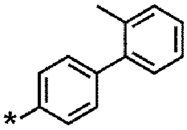 10-73 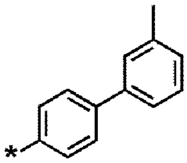 10-74 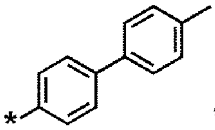 10-75 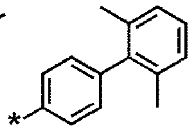 10-76 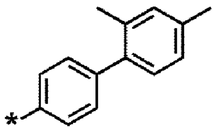 10-77

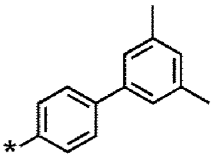 10-78 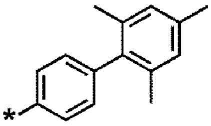 10-79 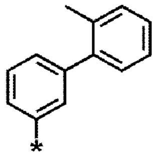 10-80 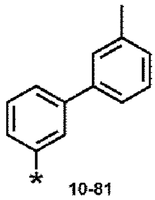 10-81 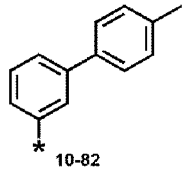 10-82

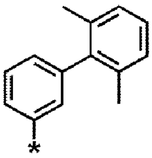 10-83 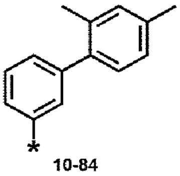 10-84 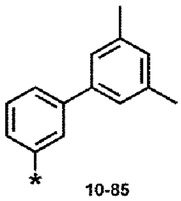 10-85 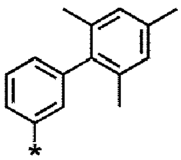 10-86 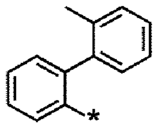 10-87 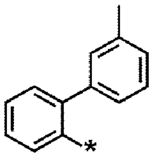 10-88

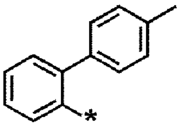 10-89 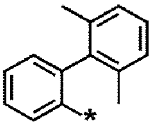 10-90 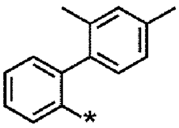 10-91 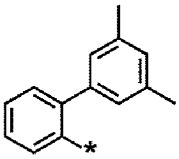 10-92 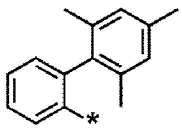 10-93 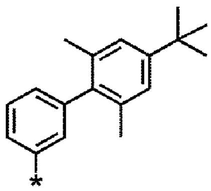 10-94

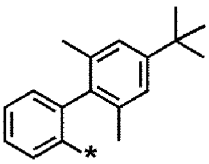 10-95 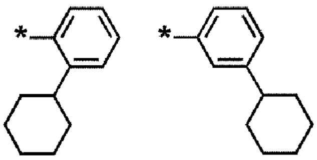 10-96 10-97 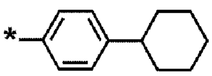 10-98 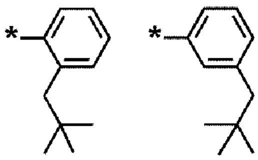 10-99 10-100

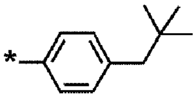
10-101

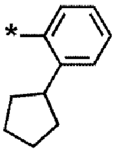
10-102

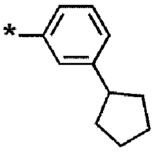
10-103

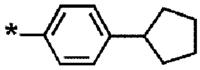
10-104

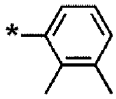
10-105

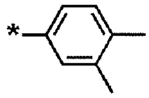
10-106

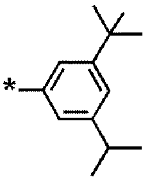
10-107

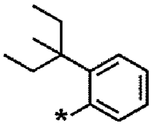
10-108

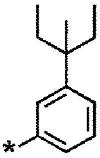
10-109

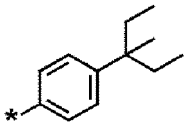
10-110

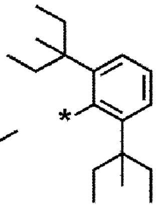
10-111

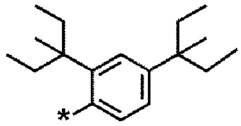
10-112

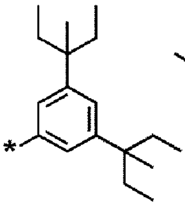
10-113

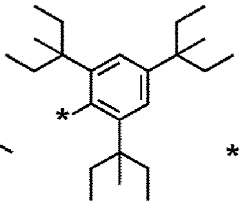
10-114

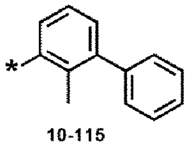
10-115

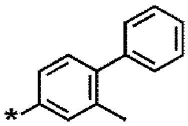
10-116

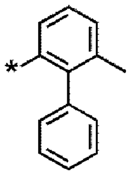
10-117

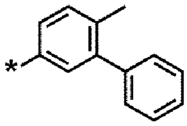
10-118

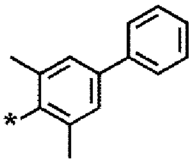
10-119

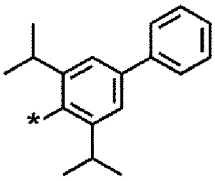
10-120

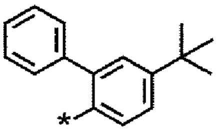
10-121

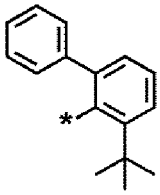
10-122

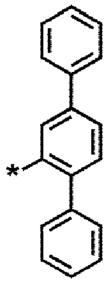
10-123

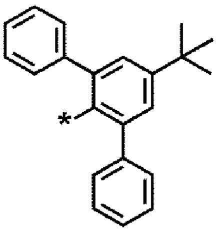
10-124

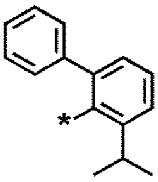
10-125

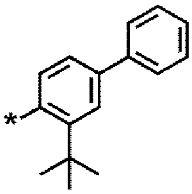
10-126

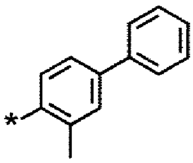
10-127

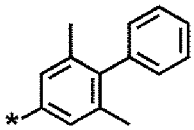
10-128

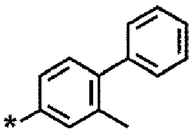
10-129

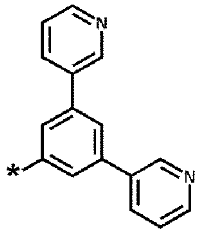
10-201

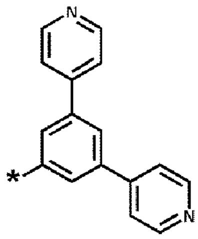
10-202

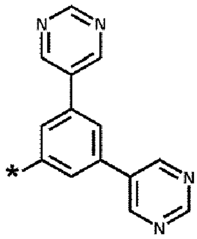
10-203

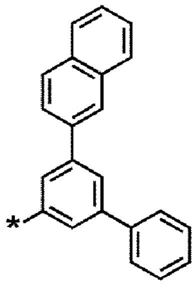
10-204

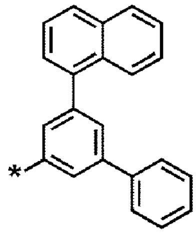
10-205

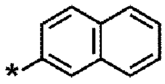
10-206

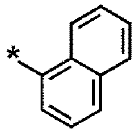
10-207

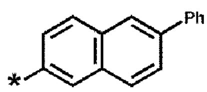
10-208

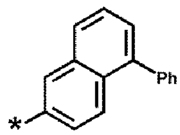
10-209

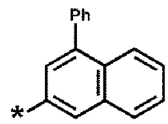
10-210

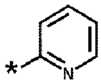
10-211

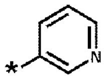
10-212

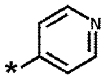
10-213

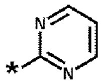
10-214

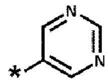
10-215

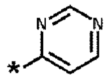
10-216

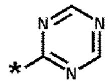
10-217

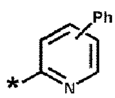
10-218

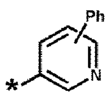
10-219

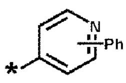
10-220

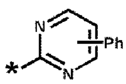
10-221

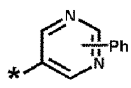
10-222

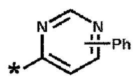
10-223

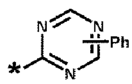
10-224

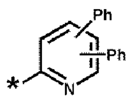
10-225

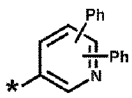
10-226

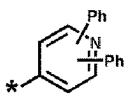
10-227

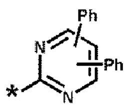
10-228

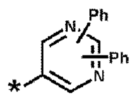
10-229

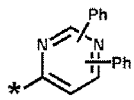
10-230

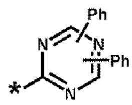
10-231

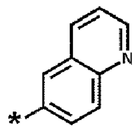
10-232

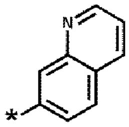
10-233

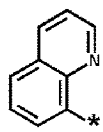
10-234

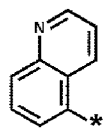
10-235

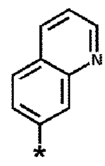
10-236

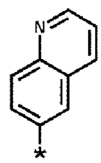
10-237

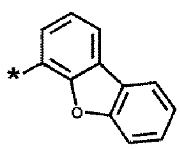
10-238

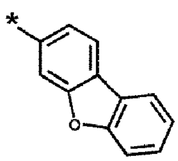
10-239

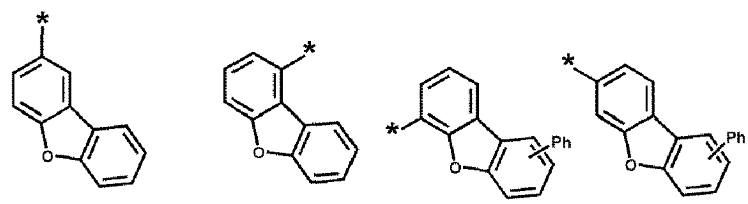
10-240

10-241

10-242

10-243

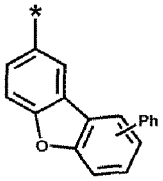
10-244

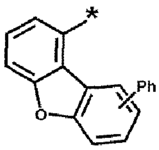
10-245

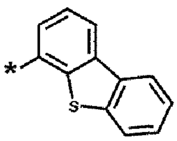
10-246

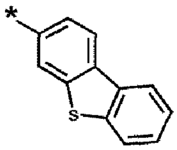
10-247

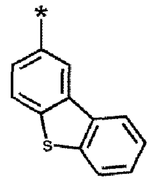
10-248

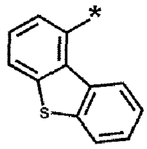
10-249

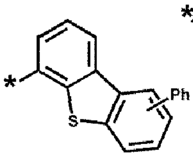
10-250

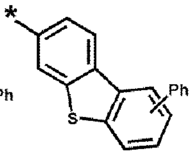
10-251

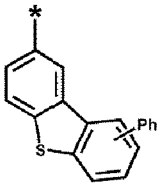
10-252

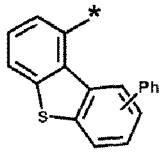
10-253

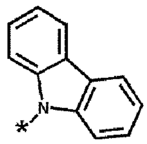
10-254

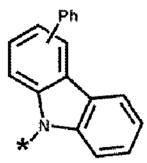
10-255

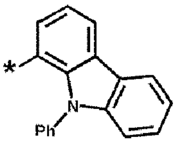
10-256

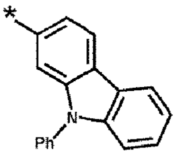
10-257

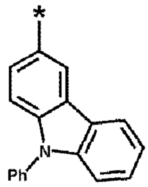
10-258

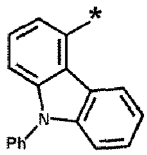
10-259

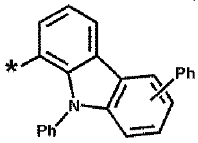
10-260

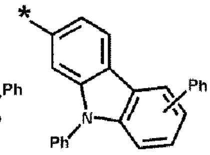
10-261

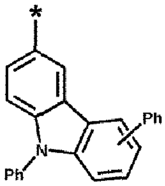
10-262

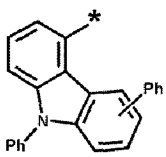
10-263

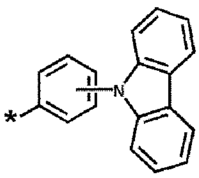
10-264

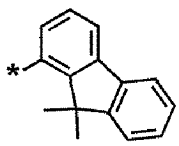
10-265

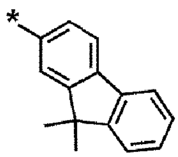
10-266

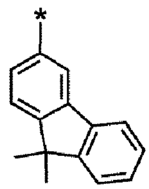
10-267

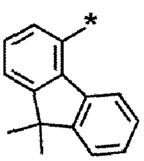
10-268

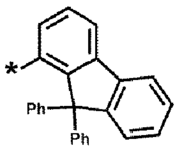
10-269

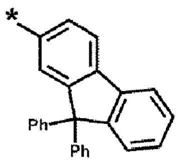
10-270

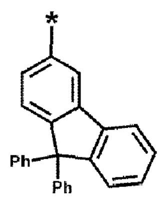
10-271

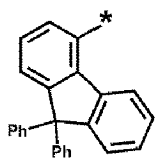
10-272

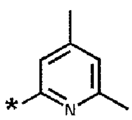
10-273

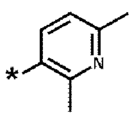
10-274

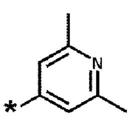
10-275

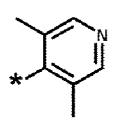
10-276

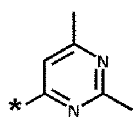
10-277

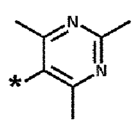
10-278

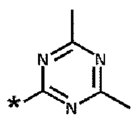
10-279

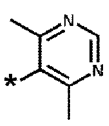
10-280

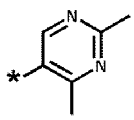
10-281

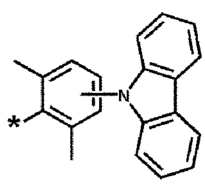
10-282

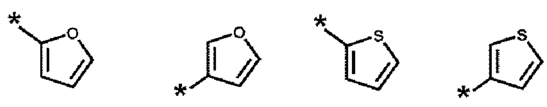
10-283

10-284

10-285

10-286

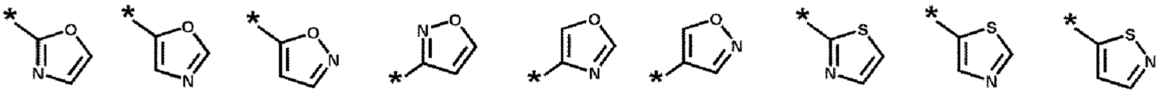
10-287 10-288 10-289 10-290 10-291 10-292 10-293 10-294 10-295

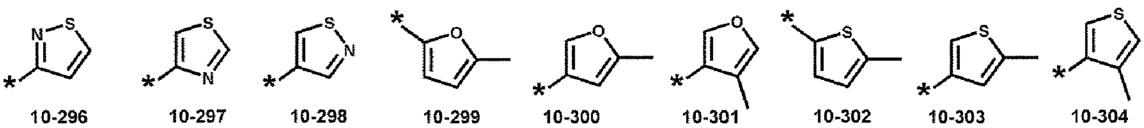
10-296 10-297 10-298 10-299 10-300 10-301 10-302 10-303 10-304

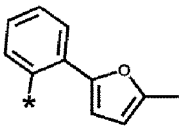
10-305
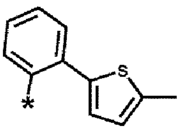
10-306
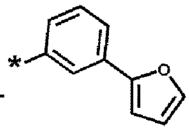
10-307
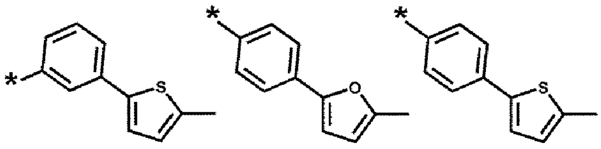
10-308 10-309 10-310

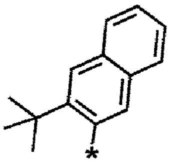
10-311
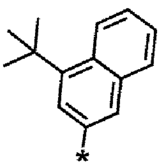
10-312
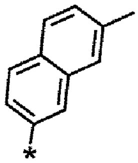
10-313
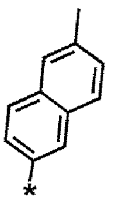
10-314
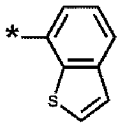
10-315
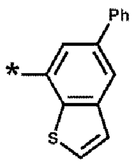
10-316
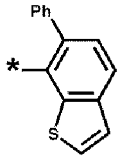
10-317

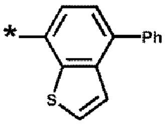
10-318
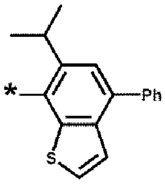
10-319
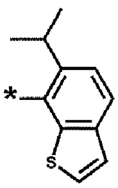
10-320
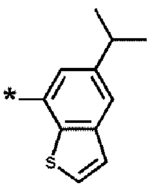
10-321
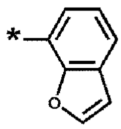
10-322
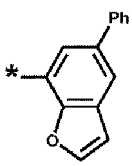
10-323
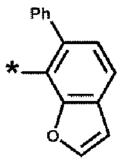
10-324

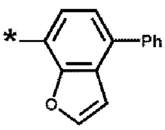
10-325
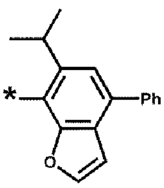
10-326
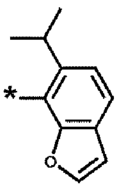
10-327
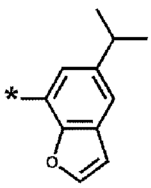
10-328
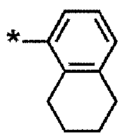
10-329
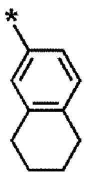
10-330
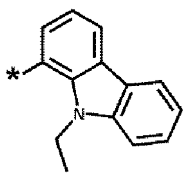
10-331

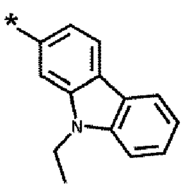
10-332
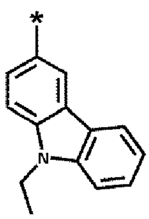
10-333
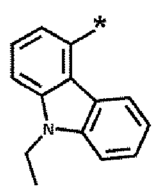
10-334
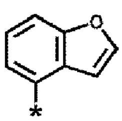
10-335
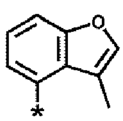
10-336
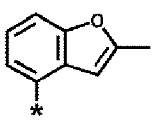
10-337

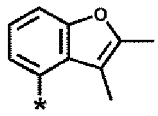
10-338
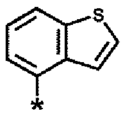
10-339
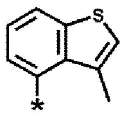
10-340
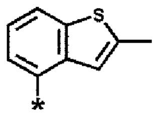
10-341
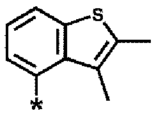
10-342
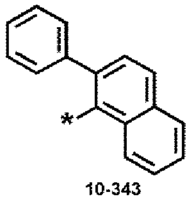
10-343

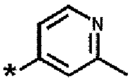
10-344
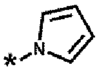
10-345
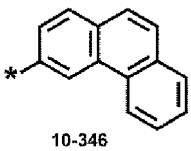
10-346
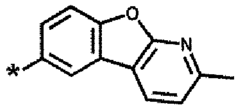
10-347
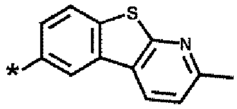
10-348

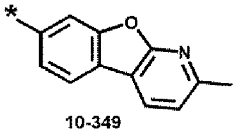
10-349
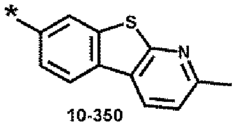
10-350

In Formulae 9-1 to 9-39, 9-201 to 9-237, 10-1 to 10-129, and 10-201 to 10-350, * indicates a binding site to a neighboring atom, "Ph" is a phenyl group, "TMS" is a trimethylsilyl group, and "TMG" is a trimethylgermyl group.

The "group represented by one of Formulae 9-1 to 9-39 in which at least one hydrogen is substituted with deuterium" and the "group represented by one of Formulae 9-201 to 9-237 in which at least one hydrogen is substituted with deuterium" may each be, for example, a group represented by one of Formulae 9-501 to 9-514 or 9-601 to 9-636:

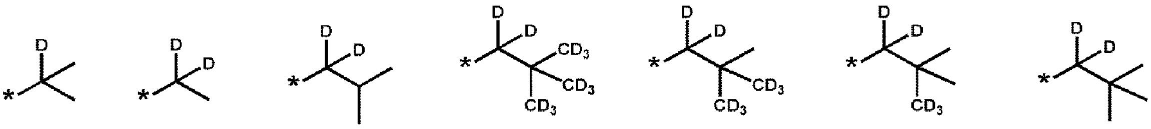
9-501 9-502 9-503 9-504 9-505 9-506 9-507

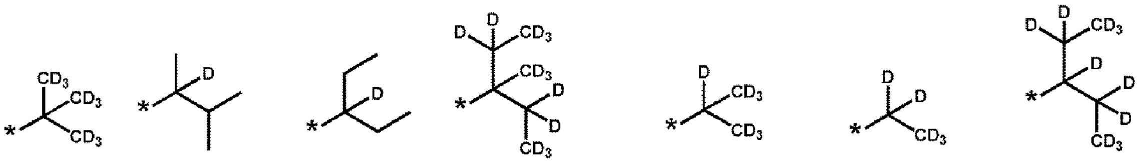
9-508 9-509 9-510 9-511 9-512 9-513 9-514

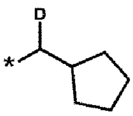
9-601
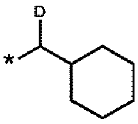
9-602
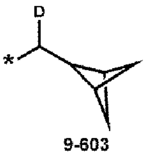
9-603
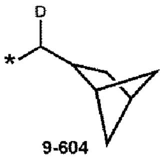
9-604
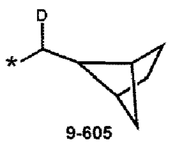
9-605
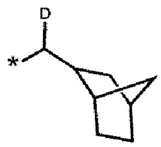
9-606
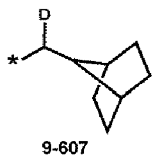
9-607

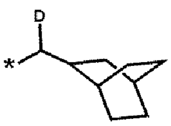
9-608
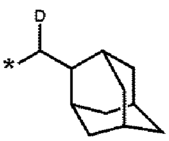
9-609
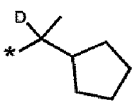
9-610
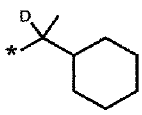
9-611
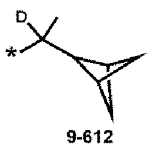
9-612
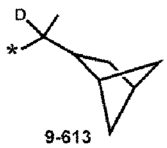
9-613

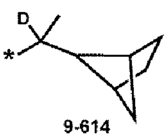
9-614
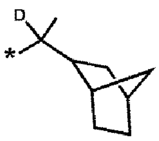
9-615
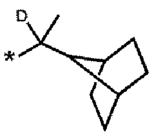
9-616
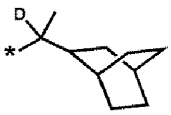
9-617
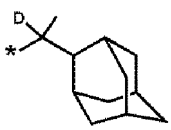
9-618
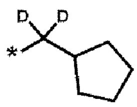
9-619

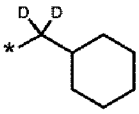 9-620
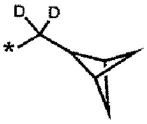 9-621
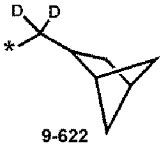 9-622
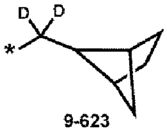 9-623
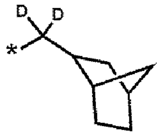 9-624
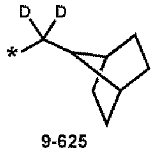 9-625

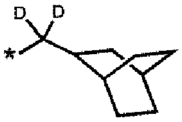 9-626
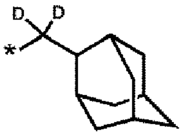 9-627
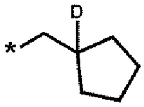 9-628
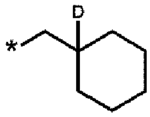 9-629
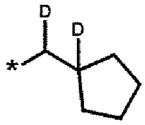 9-630
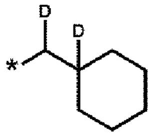 9-631

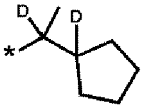 9-632
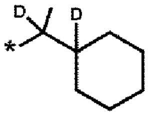 9-633
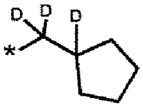 9-634
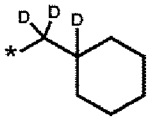 9-635
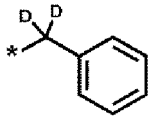 9-636

The "group represented by one of Formulae 9-1 to 9-39 in which at least one hydrogen is substituted with -F" and the "group represented by one of Formulae 9-201 to 9-237 in which at least one hydrogen is substituted with -F" may each be, for example, a group represented by one of Formulae 9-701 to 9-710:

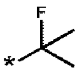 9-701
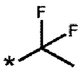 9-702
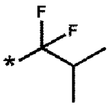 9-703
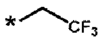 9-704
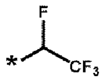 9-705
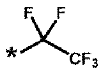 9-706
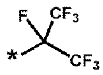 9-707

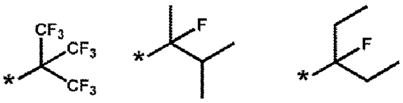
9-708 9-709 9-710

The "group represented by one of Formulae 10-1 to 10-129 in which at least one hydrogen is substituted with deuterium" and "the group represented by one of Formulae 10-201 to 10-350 in which at least one hydrogen is substituted with deuterium" may be, for example, a group represented by one of Formulae 10-501 to 10-553:

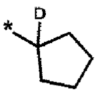 10-501
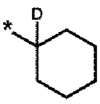 10-502
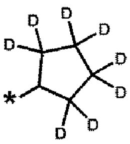 10-503
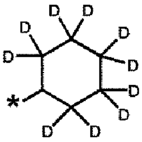 10-504
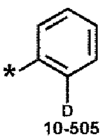 10-505
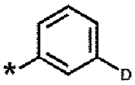 10-506
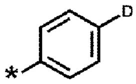 10-507
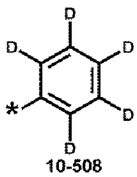 10-508

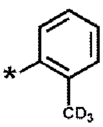 10-509
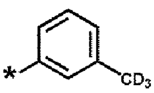 10-510
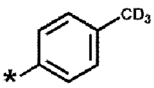 10-511
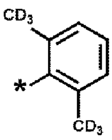 10-512
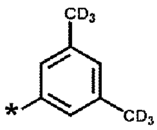 10-513
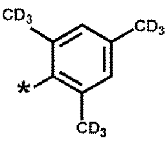 10-514
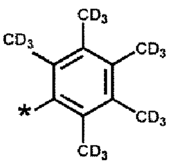 10-515

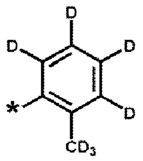
10-516

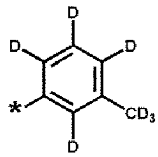
10-517

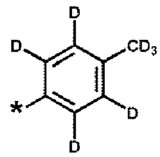
10-518

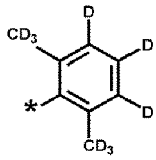
10-519

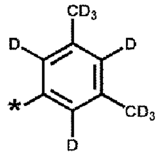
10-520

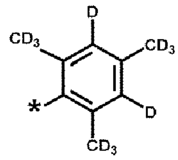
10-521

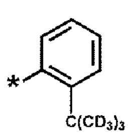
10-522

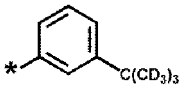
10-523

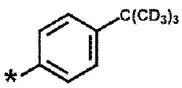
10-524

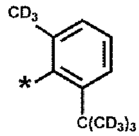
10-525

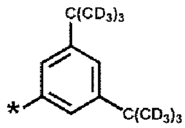
10-526

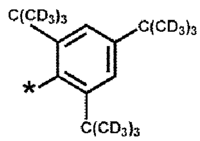
10-527

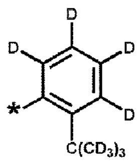
10-528

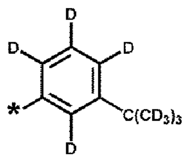
10-529

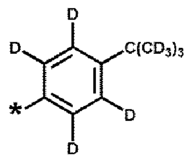
10-530

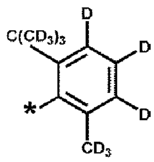
10-531

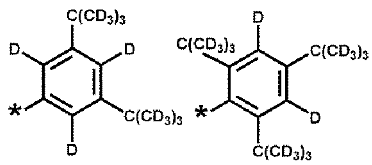
10-532

10-533

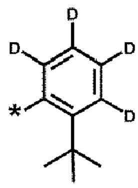
10-534

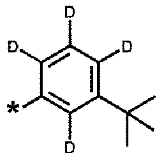
10-535

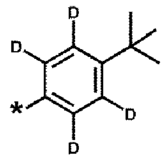
10-536

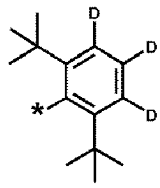
10-537

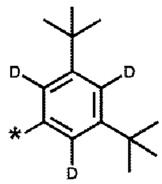
10-538

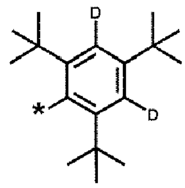
10-540

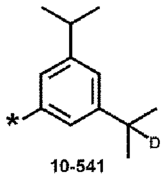
10-541

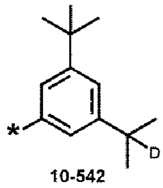
10-542

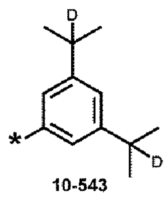
10-543

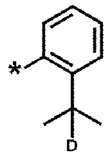
10-544

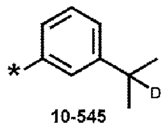
10-545

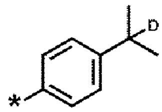
10-546

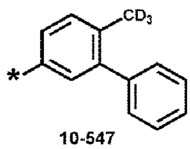
10-547

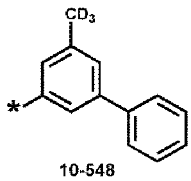
10-548

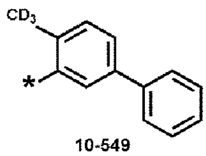
10-549

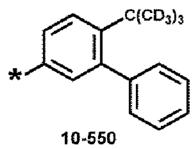
10-550

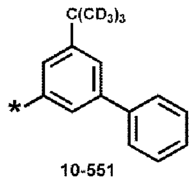
10-551

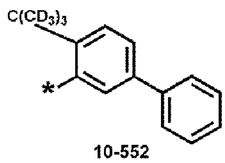
10-552

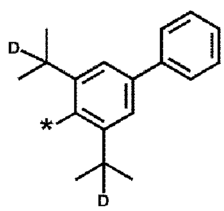
10-553

The "group represented by one of Formulae 10-1 to 10-129 in which at least one hydrogen is substituted with -F" and "the group represented by one of Formulae 10-201 to 10-350 in which at least one hydrogen is substituted with -F" may be, for example, a group represented by one of Formulae 10-601 to 10-617:

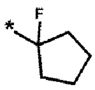 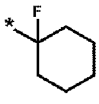 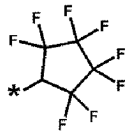 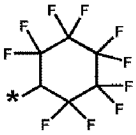 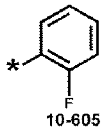 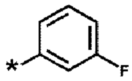 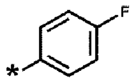 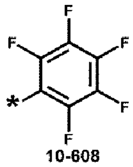

10-601 10-602 10-603 10-604 10-605 10-606 10-607 10-608

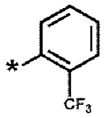 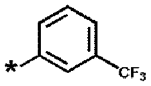 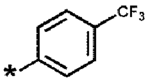 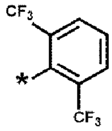 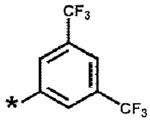 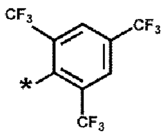 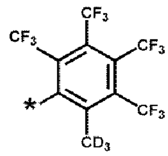

10-609 10-610 10-611 10-612 10-613 10-614 10-615

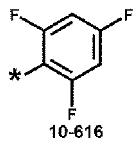 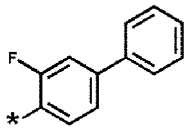

10-616 10-617

In Formulae 1, 2-1, and 2-2, c1 to c4 indicate the number of $R_1$(s) to the number of $R_4$(s), respectively; a1 to a4 indicate the number of a group(s) represented by *-[$(L_1)_{b1}$-$(R_1)_{c1}$], the number of a group(s) represented by *-[$(L_2)_{b2}$-$(R_2)_{c2}$], the number of a group(s) represented by *-[$(L_3)_{b3}$-$(R_3)_{c3}$], and the number of a group(s) represented by *-[$(L_4)_{b4}$-$(R_4)_{c4}$], respectively; e1 to e4 indicate the number of $Z_1$(s) to the number of $Z_4$(s), respectively; and d1 to d4 indicate the number of a group(s) represented by *-[$W_1$-$(Z_1)_{e1}$], the number of a group(s) represented by *-[$W_2$-$(Z_2)_{e2}$], the number of a group(s) represented by *-[$W_3$-$(Z_3)_{e3}$], and the number of a group(s) represented by *-[$W_4$-$(Z_4)_{e4}$], respectively, and may each independently be an integer from 0 to 20. When c1 is 2 or more, two or more of $R_1$(s) may be identical to or different from each other, when c2 is 2 or more, two or more of $R_2$(s) may be identical to or different from each other, when c3 is 2 or more, two or more of $R_3$(s) may be identical to or different from each other, when c4 is 2 or more, two or more of $R_4$(s) may be identical to or different from each other, when a1 is 2 or more, two or more of groups represented by *-[$(L_1)_{b1}$-$(R_1)_{c1}$] may be identical to or different from each other, when a2 is 2 or more, two or more of groups represented by *-[$(L_2)_{b2}$-$(R_2)_{c2}$] may be identical to or different from each other, when a3 is 2 or more, two or more of groups represented by *-[$(L_3)_{b3}$-$(R_3)_{c3}$] may be identical to or different from each other, when a4 is 2 or more, two or more of groups represented by *-[$(L_4)_{b4}$-$(R_1)_{c4}$] may be identical to or different from each other, when e1 is 2 or more, two or more of $Z_1$(s) may be identical to or different from each other, when e2 is 2 or more, two or more of $Z_2$(s) may be identical to or different from each other, when e3 is 2 or more, two or more of $Z_3$(s) may be identical to or different from each other, when e4 is 2 or more, two or more of $Z_4$(s) may be identical to or different from each other, when d1 is 2 or more, two or more of groups represented by *-[$W_1$-$(Z_1)_{e1}$] may be identical to or different from each other, when d2 is 2 or more, two or more of groups represented by*-[$W_2$-$(Z_2)_{e2}$] may be identical to or different from each other, when d3 is 2 or more, two or more of groups represented by *-[$W_3$-$(Z_3)_{e3}$] may be identical to or different from each other, and when d4 is 2 or more, two or more of groups represented by *-[$W_4$-$(Z_4)_{e1}$] may be identical to or different from each other. For example, in Formulae 1, 2-1, and 2-2, c1 to c4, a1 to a4, e1 to e4, and d1 to d4 may each independently be 0, 1, 2, or 3.

In one or more embodiments, the second compound may not be tris[2-phenylpyridine]iridium.

In one or more embodiments, in Formula 2-1, a case where $Y_1$ is N, ring $A_1$ is a pyridine group, $Y_2$ is C, ring $A_2$ is a benzene group, and each of d1 and d2 is 0 may be excluded.

In Formulae 1, 2-1, and 2-2, two or more substituents in at least one case of i) two or more of a plurality of $R_1$(s), ii) two or more of a plurality of $R_2$(s), iii) two or more of a plurality of $R_3$(s), iv) two or more of a plurality of $R_4$(s), v) $R_{5a}$ and $R_{5b}$, vi) two or more of a plurality of $Z_1$(s), vii) two or more of a plurality of $Z_2$(s), viii) two or more of a plurality of $Z_3$(s), ix) two or more of a plurality of $Z_4$(s), x) two or more of $R_1$ to $R_4$, $R_{5a}$, and $R_{5b}$, and xi) two or more of $Z_1$ to $Z_4$ may optionally be linked to each other to form a $C_5$-$C_{30}$ carbocyclic group that is unsubstituted or substituted with at least one $R_{10a}$ or a $C_1$-$C_{30}$ heterocyclic group that is unsubstituted or substituted with at least one $R_{10a}$.

$R_{10a}$ may be as described in connection with $R_1$.

The signs * and *' as used herein each indicate a binding site to a neighboring atom, unless otherwise stated.

In one or more embodiments, in Formula 1, n1 may not be 0, n4 may be 0, and a group represented by

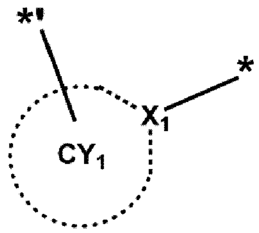

may be a group represented by one of Formulae CY1(1) to CY1(23):

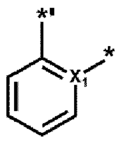
CY1(1)
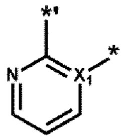
CY1(2)
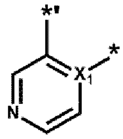
CY1(3)
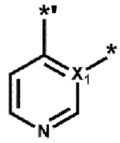
CY1(4)
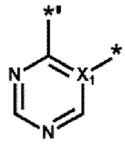
CY1(5)
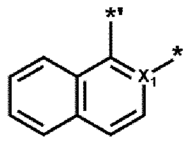
CY1(6)
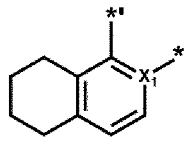
CY1(7)

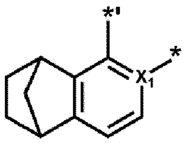
CY1(8)
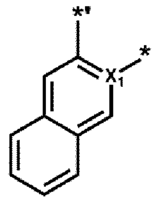
CY1(9)
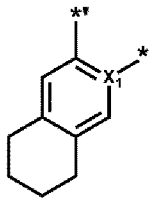
CY1(10)
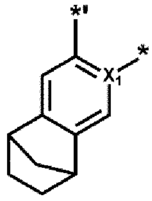
CY1(11)
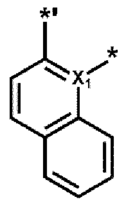
CY1(12)
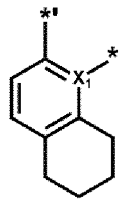
CY1(13)
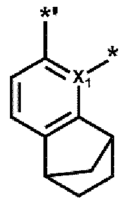
CY1(14)

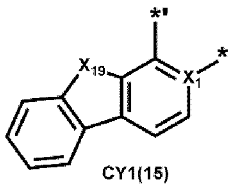
CY1(15)
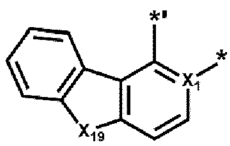
CY1(16)
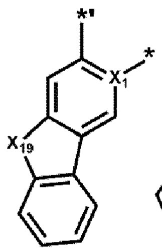
CY1(17)
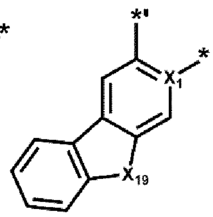
CY1(18)
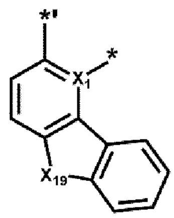
CY1(19)
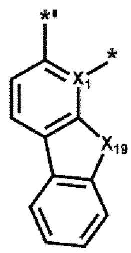
CY1(20)

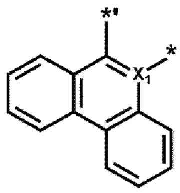
CY1(21)
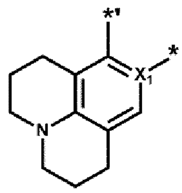
CY1(22)
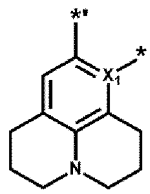
CY1(23)

wherein, in Formulae CY1(1) to CY1(23),

$X_1$ may be as described herein,
$X_{19}$ may be O, S, Se, $N(R_{19a})$, $C(R_{19a})(R_{19b})$, or $Si(R_{19a})(R_{19b})$,
$R_{19a}$ and $R_{19b}$ may each be as described in connection with $R_1$,
* indicates a binding site to $X_5$ or $M_1$ in Formula 1, and
*' indicates a binding site to $T_{11}$ in Formula 1.

In one or more embodiments, in Formula 1, n1 may be 1, n4 may be 0, and a group represented by

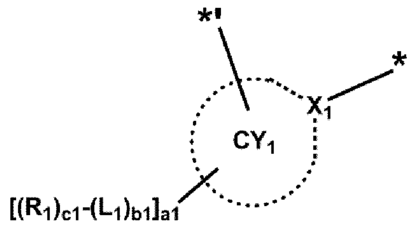

may be a group represented by one of Formulae CY1-1 to CY1-18:

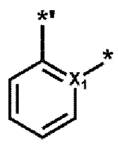
CY1-1

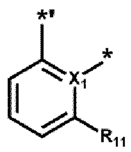
CY1-2

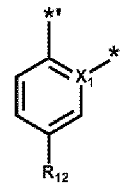
CY1-3

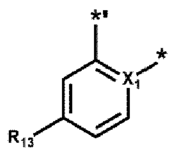
CY1-4

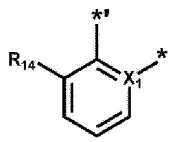
CY1-5

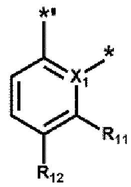
CY1-6

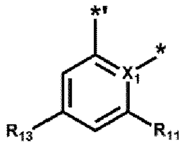
CY1-7

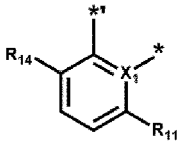
CY1-8

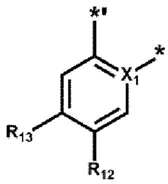
CY1-9

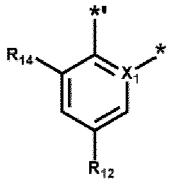
CY1-10

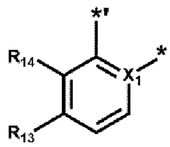
CY1-11

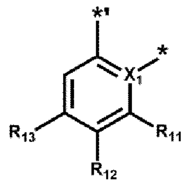
CY1-12

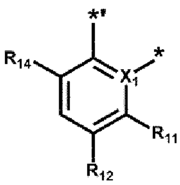
CY1-13

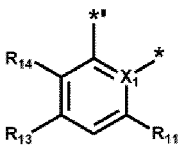
CY1-14

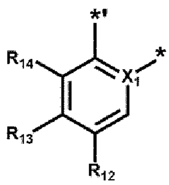
CY1-15

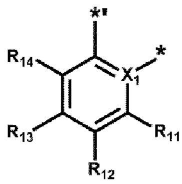
CY1-16

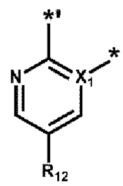
CY1-17

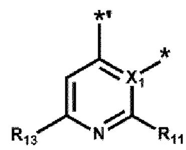
CY1-18

wherein, in Formulae CY1-1 to CY1-18,

$X_1$ may be as described herein,
$R_{11}$ to $R_{14}$ may each be as described in connection with $R_1$, and each of $R_{11}$ to $R_{14}$ may not be hydrogen,
* indicates a binding site to $X_5$ or $M_1$ in Formula 1, and
*' indicates a binding site to $T_{11}$ in Formula 1.

In one or more embodiments, in Formula 1, n1 and n2 may each be 1, and ring $CY_2$ may be a group represented by Formula CY2A or CY2B:

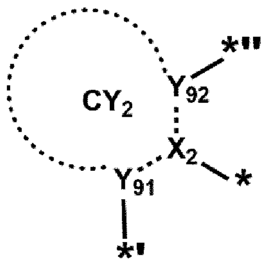
CY2A

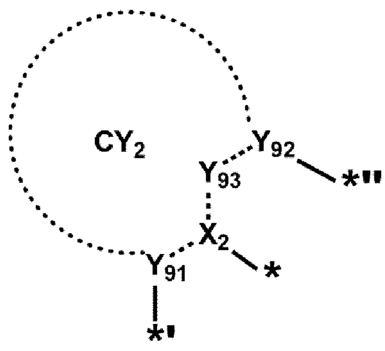
CY2B

wherein, in Formulae CY2A and CY2B,

$X_2$ and $CY_2$ may each be as described herein,
$Y_{91}$ to $Y_{93}$ may each independently be O, S, N, C, or Si,
in Formulae CY2A and CY2B, a bond between $X_2$ and $Y_{91}$, a bond between $X_2$ and $Y_{92}$, a bond between $X_2$ and $Y_{93}$, and a bond between $Y_{22}$ and $Y_{93}$ may each be a chemical bond,
*' indicates a binding site to $T_{11}$ in Formula 1,
* indicates a binding site to $X_6$ or $M_1$ in Formula 1, and
*" indicates a binding site to $T_{12}$ in Formula 1.

In one or more embodiments, in Formula 1, each of n1 and n2 may not be 0, and a group represented by

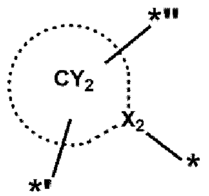

may be a group represented by one of Formulae CY2(1) to CY2(21):

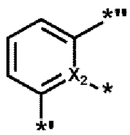
CY2(1)

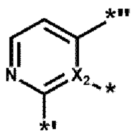
CY2(2)

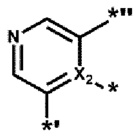
CY2(3)

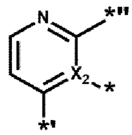
CY2(4)

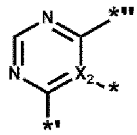
CY2(5)

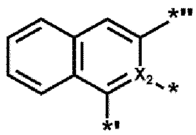
CY2(6)

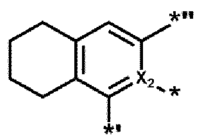
CY2(7)

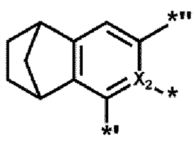
CY2(8)

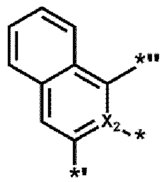
CY2(9)

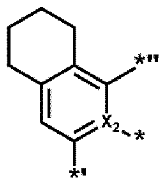
CY2(10)

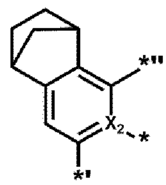
CY2(11)

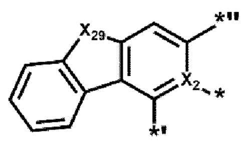
CY2(12)

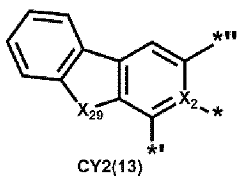
CY2(13)

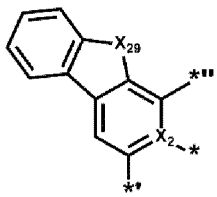
CY2(14)

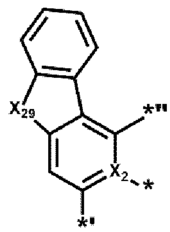
CY2(15)

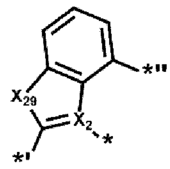
CY2(16)

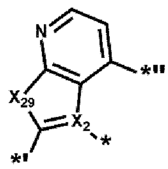
CY2(17)

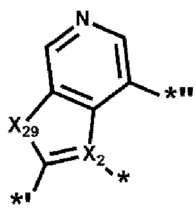
CY2(18)

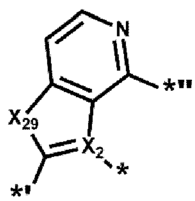
CY2(19)

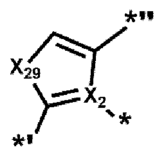
CY2(20)

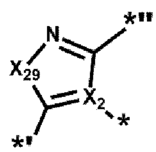
CY2(21)

wherein, in Formulae CY2(1) to CY2(21),

$X_2$ may be as described herein,
$X_{29}$ may be O, S, N-[$(L_2)_{b2}$-$(R_2)_{c2}$], C($R_{29a}$)($R_{29b}$), or Si($R_{29a}$)($R_{29b}$),
$L_2$, b2, $R_2$, and c2 may each be as described herein,
$R_{29a}$ and $R_{29b}$ may each be as described in connection with $R_2$,
*' indicates a binding site to $T_{11}$ in Formula 1,
* indicates a binding site to $X_6$ or $M_1$ in Formula 1, and
*" indicates a binding site to $T_{12}$ in Formula 1.

In one or more embodiments, in Formula 1, each of n1 and n2 may be 1, and a group represented by

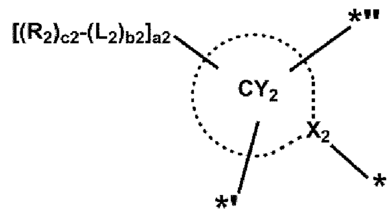

may be a group represented by one of Formulae CY2-1 to CY2-16:

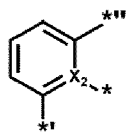
CY2-1
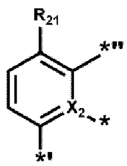
CY2-2
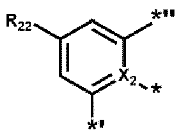
CY2-3
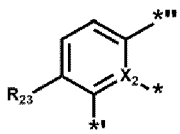
CY2-4
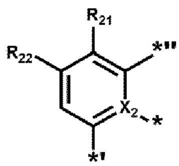
CY2-5
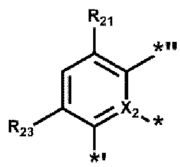
CY2-6

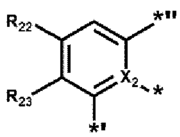
CY2-7
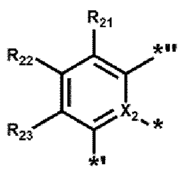
CY2-8
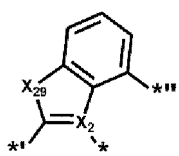
CY2-9
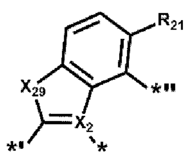
CY2-10
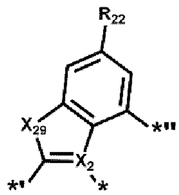
CY2-11
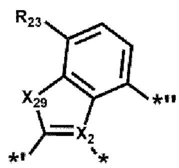
CY2-12

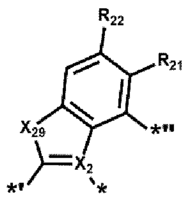
CY2-13
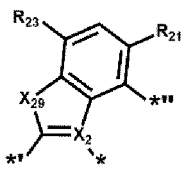
CY2-14
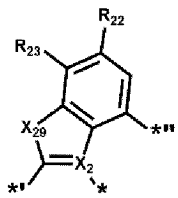
CY2-15
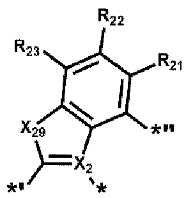
CY2-16

wherein, in Formulae CY2-1 to CY2-16,

$X_2$ may be as described herein,
$X_{29}$ may be O, S, N-[$(L_2)_{b2}$-$(R_2)_{c2}$], C($R_{29a}$)($R_{29b}$), or Si($R_{29a}$)($R_{29b}$),
$L_2$, b2, $R_2$, and c2 may each be as described herein,
$R_{21}$ to $R_{23}$, $R_{29a}$, and $R_{29b}$ may each be as described in connection with $R_2$, wherein each of $R_{21}$ to $R_{23}$ may not be hydrogen,
*' indicates a binding site to $T_{11}$ in Formula 1,
* indicates a binding site to $X_6$ or $M_1$ in Formula 1, and
*" indicates a binding site to $T_{12}$ in Formula 1.

In one or more embodiments, in Formula 1,

each of n1 and n2 may be 1,
a group represented by

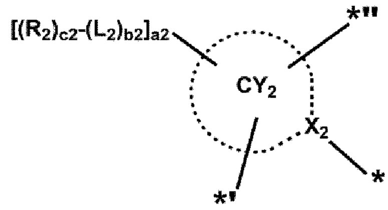

may be represented by one of Formulae CY2-9 to CY2-16,
$X_{29}$ in Formulae CY2-9 to CY2-16 may be N-[$(L_2)_{b2}$-$(R_2)_{c2}$],
$L_2$ may be a benzene group unsubstituted or substituted with at least one $R_{10a}$,
b2 may be 1 or 2,
c2 may be 1 or 2,
when c2 is 1, $R_2$ may be a phenyl group unsubstituted or substituted with at least one of deuterium, a $C_1$-$C_{20}$ alkyl group, a phenyl group, a deuterated phenyl group, a ($C_1$-$C_{20}$alkyl)phenyl group, or a combination thereof; and when c2 is 2, a) one of two $R_2$(s) may be a phenyl group unsubstituted or substituted with at least one of deuterium, a $C_1$-$C_{20}$ alkyl group, a phenyl group, a deuterated phenyl group, a ($C_1$-$C_{20}$alkyl)phenyl group, or a combination thereof, b) and the other $R_2$ may be a $C_4$-$C_{20}$ alkyl group unsubstituted or substituted with at least one $C_3$-$C_{10}$ cycloalkyl group, or a deuterated $C_1$-$C_{20}$ alkyl group.

In one or more embodiments, in Formula 1, each of n2 and n3 may not be 0, and a group represented by

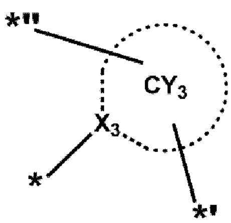

may be a group represented by one of Formulae CY3(1) to CY3(15):

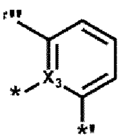
CY3(1)
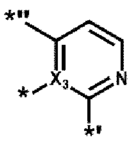
CY3(2)
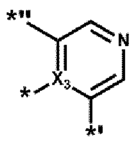
CY3(3)
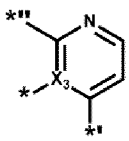
CY3(4)
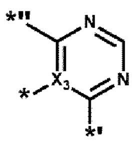
CY3(5)
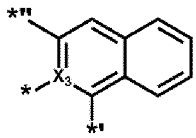
CY3(6)
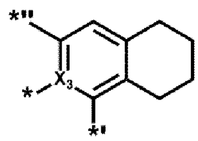
CY3(7)

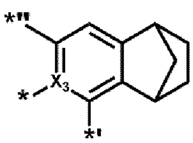
CY3(8)
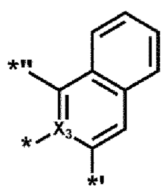
CY3(9)
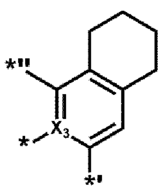
CY3(10)
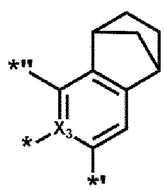
CY3(11)
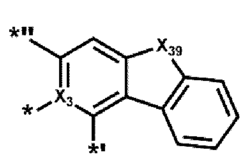
CY3(12)

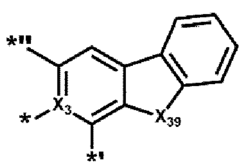
CY3(13)
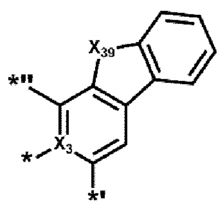
CY3(14)
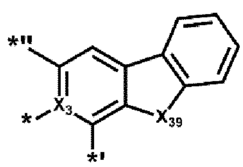
CY3(15)

wherein, in Formulae CY3(1) to CY3(15),

$X_3$ may be as described herein,
$X_{39}$ may be O, S, $N(Z_{39a})$, $C(R_{39a})(R_{39b})$, or $Si(R_{39a})(R_{39b})$,
$R_{39a}$ and $R_{39b}$ may each be as described in connection with $R_3$,
*" indicates a binding site to $T_{12}$ in Formula 1,
* indicates a binding site to $X_7$ or $M_1$ in Formula 1, and
*' indicates a binding site to $T_{13}$ in Formula 1.

In one or more embodiments, in Formula 1, each of n2 and n3 may be 1, and a group represented by

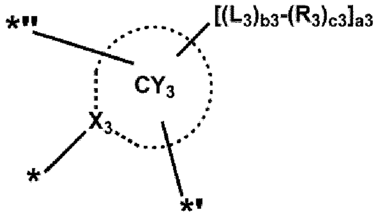

may be a group represented by one of Formulae CY3-1 to CY3-13:

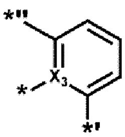
CY3-1

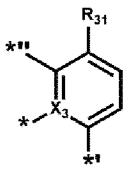
CY3-2

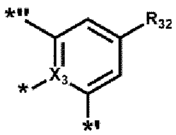
CY3-3

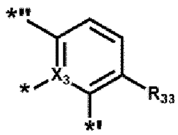
CY3-4

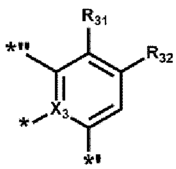
CY3-5

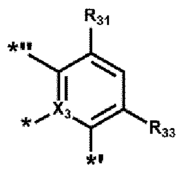
CY3-6

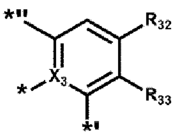
CY3-7

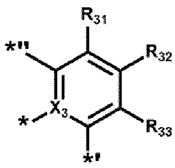
CY3-8

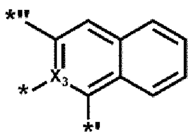
CY3-8

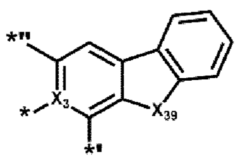
CY3-9

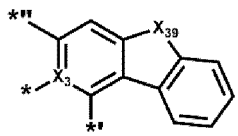
CY3-10

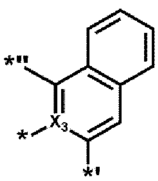
CY3-11

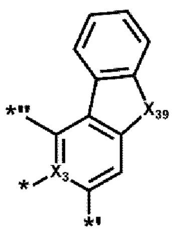
CY3-12

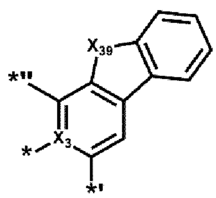
CY3-13

wherein, in Formulae CY3-1 to CY3-13,

$X_3$ may be as described herein,
$X_{39}$ may be O, S, $N-[(L_3)_{b3}-(R_3)_{c3}]$, $C(R_{39a})(R_{39b})$, or $Si(R_{39a})(R_{39b})$,
$L_3$, b3, $R_3$, and c3 may each be as described herein,
$R_{31}$ to $R_{33}$, $R_{39a}$, and $R_{39b}$ may each be as described in connection with $R_3$, wherein each of $R_{31}$ to $R_{33}$ may not be hydrogen,
*" indicates a binding site to $T_{12}$ in Formula 1,
* indicates a binding site to $X_7$ or $M_1$ in Formula 1, and
*' indicates a binding site to $T_{13}$ in Formula 1.

In one or more embodiments, in Formula 1, n3 may not be 0, n4 may be 0, and a group represented by

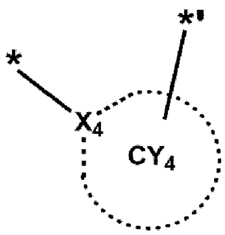

may be a group represented by one of Formulae CY4(1) to CY4(20):

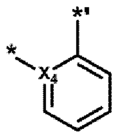
CY4(1)
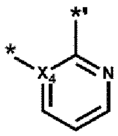
CY4(2)
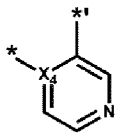
CY4(3)
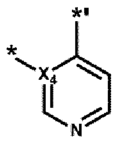
CY4(4)
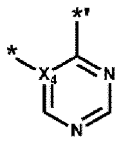
CY4(5)
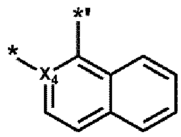
CY4(6)
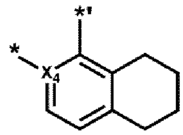
CY4(7)

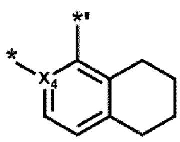
CY4(8)
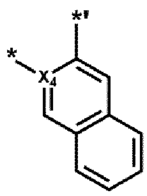
CY4(9)
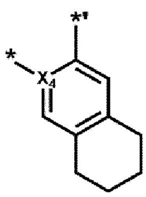
CY4(10)
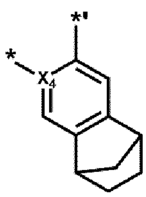
CY4(11)
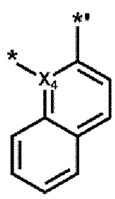
CY4(12)
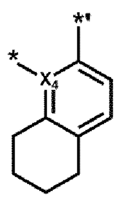
CY4(13)
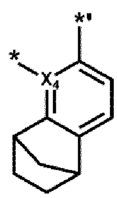
CY4(14)

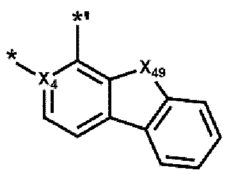
CY4(15)
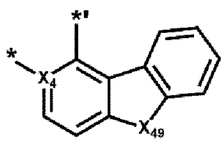
CY4(16)
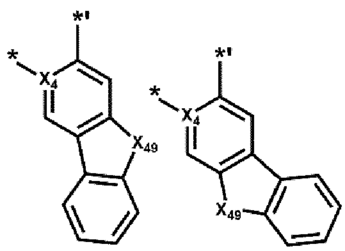
CY4(17) CY4(18)
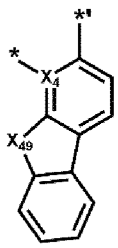
CY4(19)
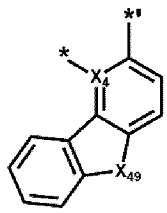
CY4(20)

wherein, in Formulae CY4(1) to CY4(20),

$X_4$ may be as described herein,
$X_{49}$ may be O, S, $N(R_{49a})$, $C(R_{49a})(R_{49b})$, or $Si(R_{49a})(R_{49b})$,
$R_{49a}$ and $R_{49b}$ may each be as described in connection with $R_4$,
*' indicates a binding site to $T_{13}$ in Formula 1, and
* indicates a binding site to $X_8$ or $M_1$ in Formula 1.

In one or more embodiments, in Formula 1, n3 may be 1, n4 may be 0, and a group represented by

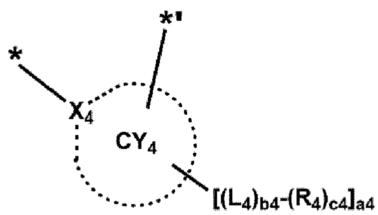

may be a group represented by one of Formulae CY4-1 to CY4-16:

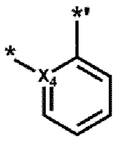
CY4-1

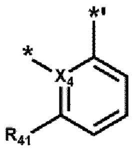
CY4-2

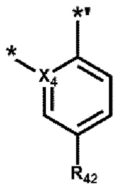
CY4-3

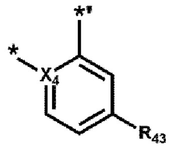
CY4-4

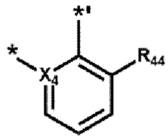
CY4-5

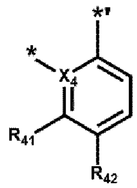
CY4-6

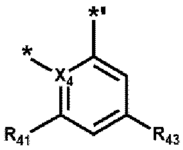
CY4-7

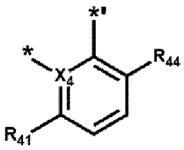
CY4-8

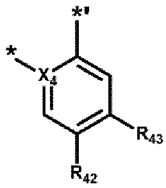
CY4-9

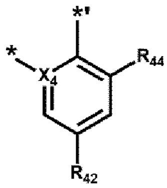
CY4-10

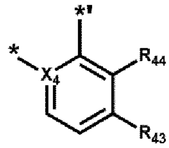
CY4-11

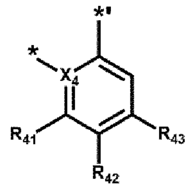
CY4-12

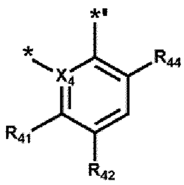
CY4-13

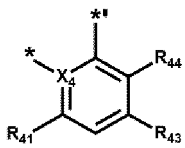
CY4-14

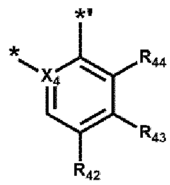
CY4-15

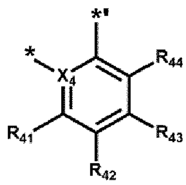
CY4-16

wherein, in Formulae CY4-1 to CY4-16,

$X_4$ may be as described herein,
$R_{41}$ to $R_{44}$ may each be as described in connection with $R_4$, and each of $R_{41}$ to $R_{44}$ may not be hydrogen,
*' indicates a binding site to $T_{13}$ in Formula 1, and
* indicates a binding site to $X_8$ or $M_1$ in Formula 1.

In one or more embodiments, the first compound may be a compound represented by one of Formulae 1-1 to 1-3:

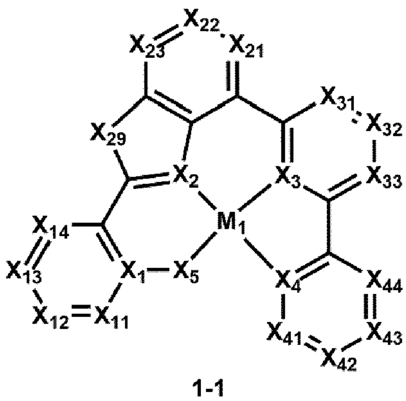
1-1

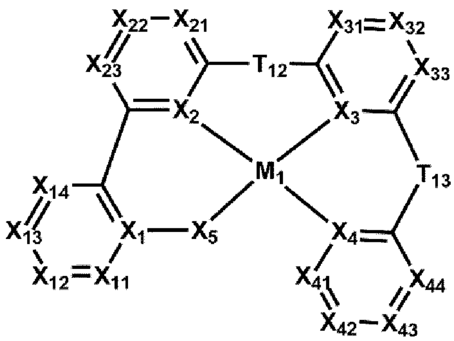
1-2

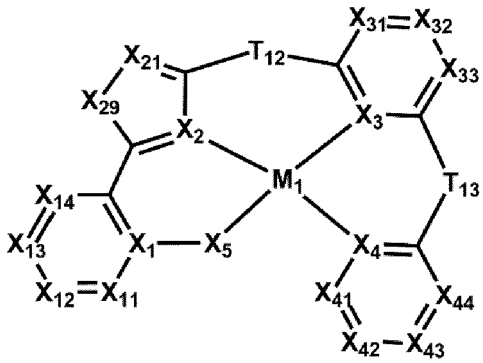

1-3

wherein, in Formulae 1-1 to 1-3,

$M_1$, $X_1$ to Xs, $T_{12}$, and $T_{13}$ may each be as described herein,
$X_{11}$ may be N or $C(R_{11})$, $X_{12}$ may be N or $C(R_{12})$, $X_{13}$ may be N or $C(R_{13})$, and $X_{14}$ may be N or $C(R_{14})$,
$R_{11}$ to $R_{14}$ may each be as described in connection with $R_1$,
two or more of $R_{11}$ to $R_{14}$ may optionally be linked to each other to form a $C_5$-$C_{30}$ carbocyclic group unsubstituted or substituted with at least one $R_{10a}$ or a $C_1$-$C_{30}$ heterocyclic group unsubstituted or substituted with at least one $R_{10a}$,
$X_{21}$ may be N or $C(R_{21})$, $X_{22}$ may be N or $C(R_{22})$, and $X_{23}$ may be N or $C(R_{23})$,
$X_{29}$ may be O, S, N-$[(L_2)_{b2}$-$(R_2)_{c2}]$, $C(R_{29a})(R_{29b})$, or $Si(R_{29a})(R_{29b})$,
$L_2$, b2, $R_2$, and c2 may each be as described herein,
$R_{21}$ to $R_{23}$, $R_{29a}$, and $R_{29b}$ may each be as described in connection with $R_2$,
two or more of $R_{21}$ to $R_{23}$ may optionally be linked to each other to form a $C_5$-$C_{30}$ carbocyclic group unsubstituted or substituted with at least one $R_{10a}$ or a $C_1$-$C_{30}$ heterocyclic group unsubstituted or substituted with at least one $R_{10a}$,
$X_{31}$ may be N or $C(R_{31})$, $X_{32}$ may be N or $C(R_{32})$, and $X_{33}$ may be N or $C(R_{33})$,
$R_{31}$ to $R_{33}$ may each be as described in connection with $R_3$,
two or more of $R_{31}$ to $R_{33}$ may optionally be linked to each other to form a $C_5$-$C_{30}$ carbocyclic group unsubstituted or substituted with at least one $R_{10a}$ or a $C_1$-$C_{30}$ heterocyclic group unsubstituted or substituted with at least one $R_{10a}$,
$X_{41}$ may be N or $C(R_{41})$, $X_{42}$ may be N or $C(R_{42})$, $X_{43}$ may be N or $C(R_{43})$, and $X_{44}$ may be N or $C(R_{44})$,
$R_{41}$ to $R_{44}$ may each be as described in connection with $R_4$, and
two or more of $R_{41}$ to $R_{44}$ may optionally be linked to each other to form a $C_5$-$C_{30}$ carbocyclic group unsubstituted or substituted with at least one $R_{10a}$, or a $C_1$-$C_{30}$ heterocyclic group unsubstituted or substituted with at least one $R_{10a}$.

In one or more embodiments,

$Y_1$ in Formula 2-1 may be N, and
a group represented by

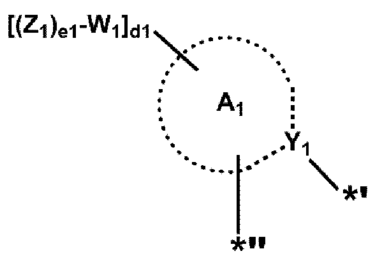

in Formula 2-1 may be a group represented by one of FormulaeA1-1 to $A_1$ -3:

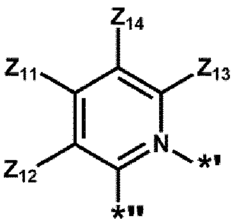
A1-1

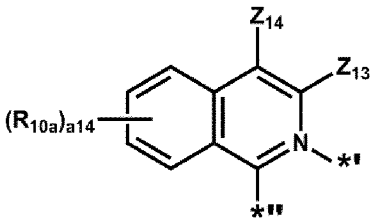
A1-2

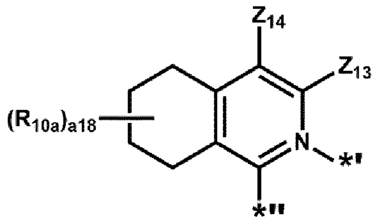
A1-3

wherein, in Formulae A1-1 to A1-3,

$Z_{11}$ to $Z_{14}$ may each be as described in connection with $Z_1$,
$R_{10a}$ may be as described in connection with $R_{10a}$,
a14 may be an integer from 0 to 4,
a18 may be an integer from 0 to 8,
*' indicates a binding site to $M_2$ in Formula 2, and
*" indicates a binding site to ring $A_2$.

For example, in Formulae A1-1 to A1-3, $Z_{14}$ may be a deuterated $C_1$-$C_{20}$ alkyl group, -Si($Q_3$)($Q_4$)($Q_5$), or -Ge($Q_3$)($Q_4$)($Q_5$).

In one or more embodiments,

$Y_3$ in Formula 2-2 may be N, and
a group represented by

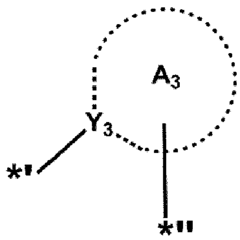

in Formula 2-2 may be a group represented by one of Formulae NR1 to NR48:

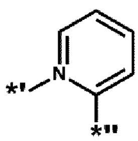
NR1

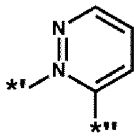
NR2

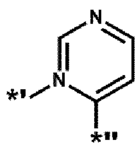
NR3

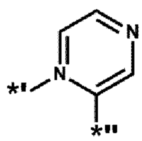
NR4

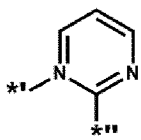
NR5

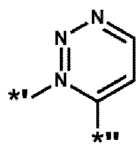
NR6

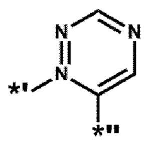
NR7

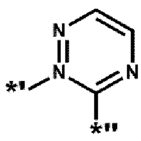
NR8

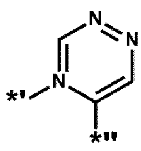
NR9

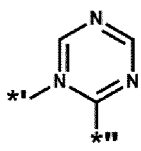
RN10

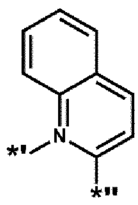
NR11

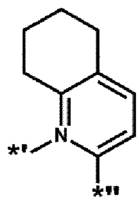
NR12

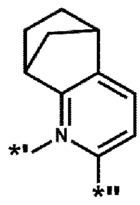
NR13

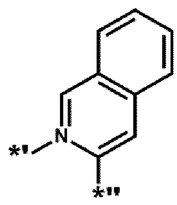
NR14

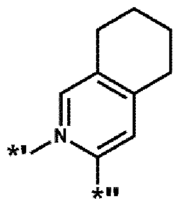

NR15

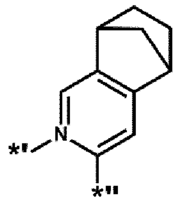

NR16

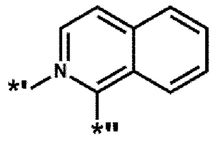

NR17

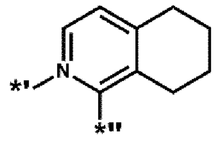

NR18

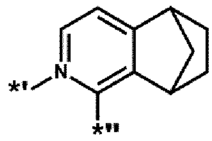

NR19

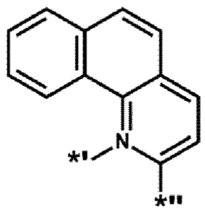

NR20

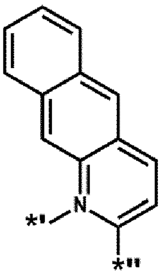

NR21

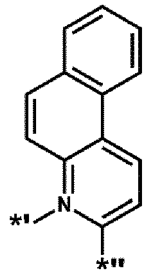

NR22

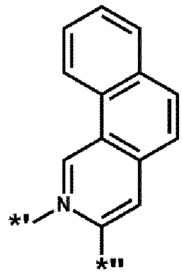

NR23

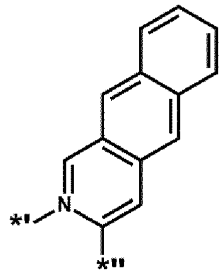

NR24

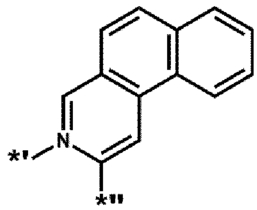

NR25

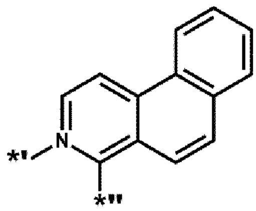

NR26

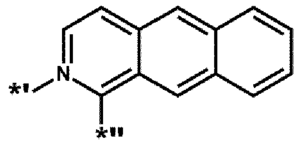

NR27

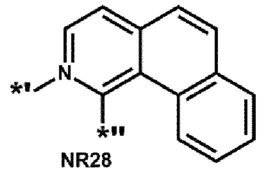

NR28

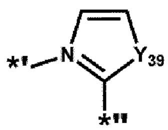

NR29

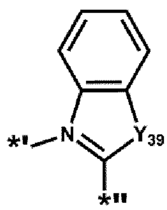

NR30

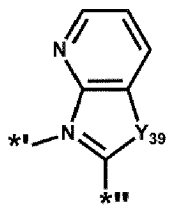

NR31

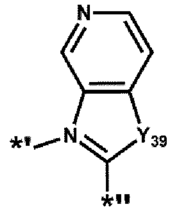

NR32

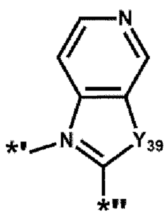

NR33

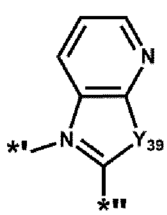

NR34

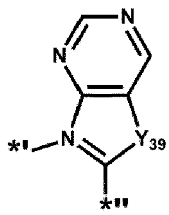

NR35

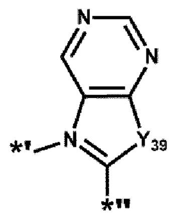

NR36

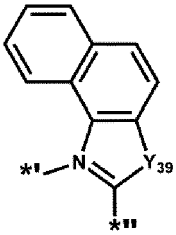

NR37

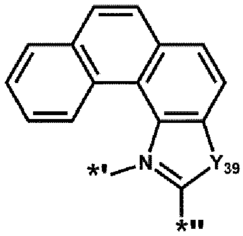

NR38

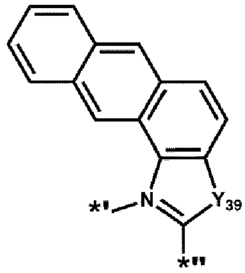

NR39

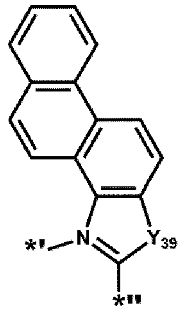

NR40

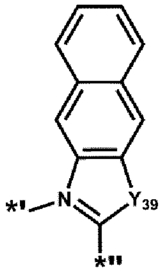

NR41

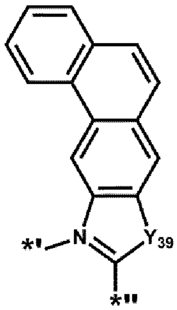

NR42

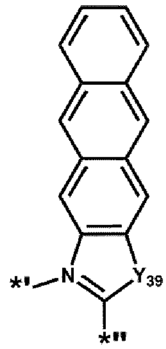

NR43

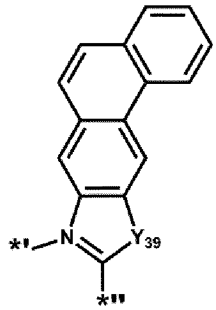

NR44

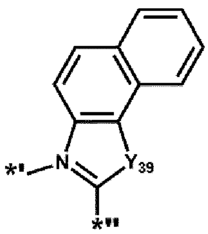

NR45

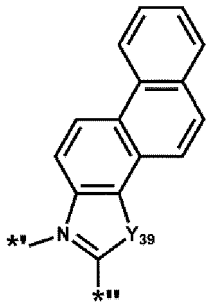

NR46

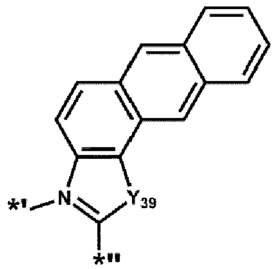

NR47

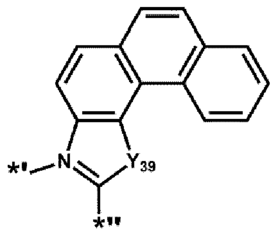

NR48

wherein, in Formulae NR1 to NR48,
$Y_{39}$ may be O, S, Se, N-[$W_3$-$(Z_3)_{e3}$], $C(Z_{39a})(Z_{39b})$, or $Si(Z_{39a})(Z_{39b})$,
$W_3$, $Z_3$, and e3 may each be as described herein, and $Z_{39a}$ and $Z_{39b}$ may each be as described in connection with $Z_3$,
*' indicates a binding site to $M_2$ in Formula 2, and
*" indicates a binding site to ring $A_4$.

In one or more embodiments,

in Formulae 2-1 and 2-2, each of $Y_2$ and $Y_4$ may be C, and
a group represented by

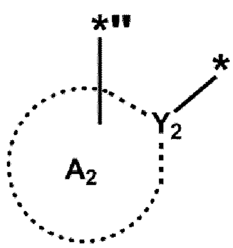

in Formula 2-1 and a group represented by

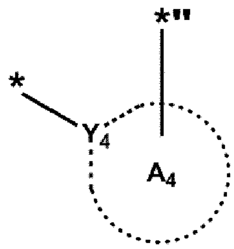

in Formula 2-2 may each independently be a group represented by one of Formulae CR1 to CR29:

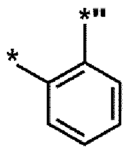
CR1

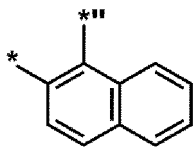
CR2

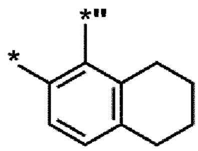
CR3

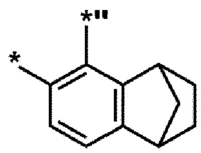
CR4

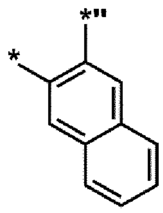
CR5

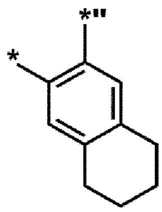
CR6

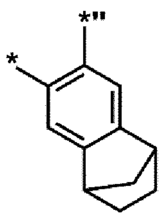
CR7

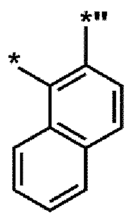
CR8

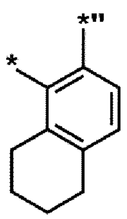
CR9

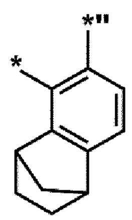
CR10

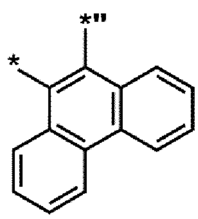
CR11

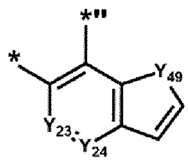
CR12

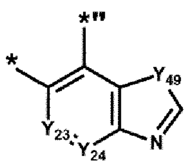
CR13

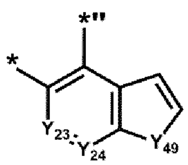
CR14

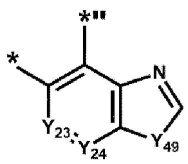
CR15

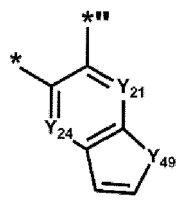
CR16

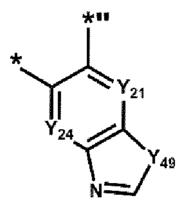
CR17

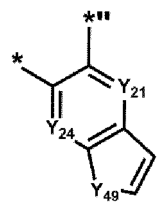
CR18

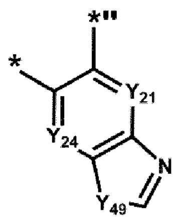
CR19

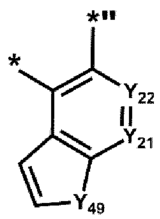
CR20

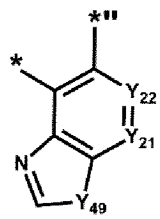
CR21

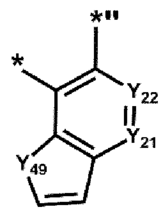
CR22

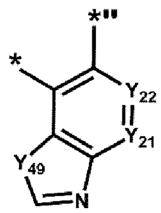
CR23

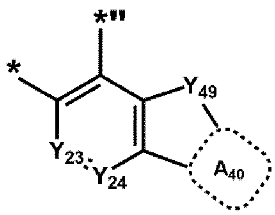

CR24

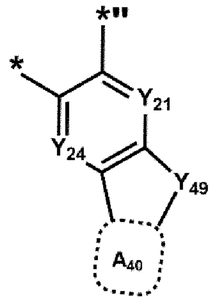

CR25

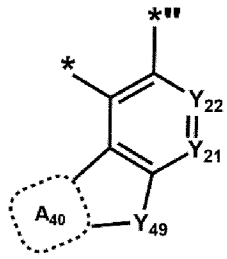

CR26

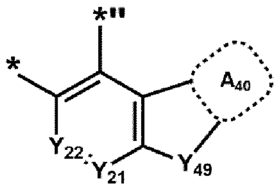

CR27

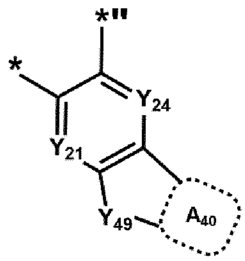

CR28

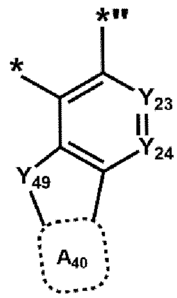

CR29

wherein, in CR1 to CR29,

$Y_{49}$ may be O, S, Se, N-[$W_2$-$(Z_2)_{e2}$], N-[$W_4$-$(Z_4)_{e4}$], C($Z_{29a}$)($Z_{29b}$), C($Z_{49a}$)($Z_{49b}$), Si(Z29a)(Z29b), or Si(Z49a)(Z49b),

$W_2$, $W_4$, $Z_2$, $Z_4$, e2, and e4 may each be as described herein, $Z_{29a}$ and $Z_{29b}$ may each be as described in connection with $Z_2$, and $Z_{49a}$ and $Z_{49b}$ may each be as described in connection with $Z_4$,

$Y_{21}$ to $Y_{24}$ may each independently be N or C,

ring $A_{40}$ may be a $C_5$-$C_{30}$ carbocyclic group or a $C_1$-$C_{30}$ heterocyclic group (for example, a benzene group, a naphthalene group, a phenanthrene group, a pyridine group, a pyrimidine group, a pyrazine group, a pyridazine group, a quinoline group, an isoquinoline group, a benzoquinoline group, a benzoisoquinoline group, a quinoxaline group, a benzoquinoxaline group, a quinazoline group, or a benzoquinazoline group),

* indicates a binding site to $M_2$ in Formula 2, and

*" indicates a binding site to ring $A_1$ or ring $A_3$ in Formula 1.

In one or more embodiments,
a group represented by

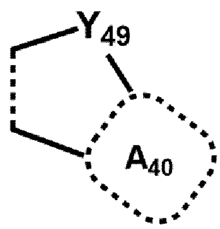

in Formulae CR24 to CR29 may be a group represented by one of Formulae CR(1) to CR(13):

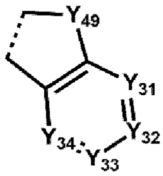

CR(1)

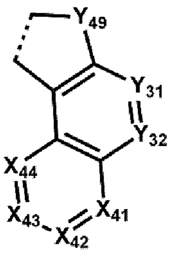

CY(2)

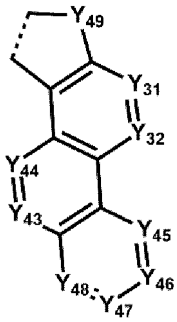

CR(3)

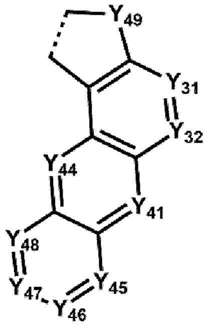

CR(4)

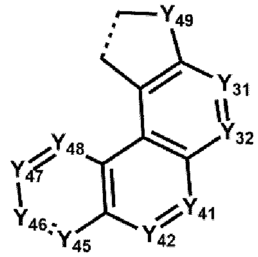

CR(5)

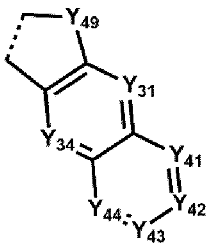

CR(6)

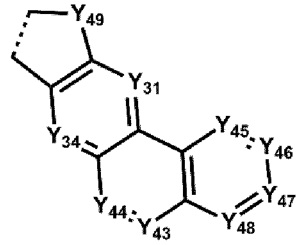

CR(7)

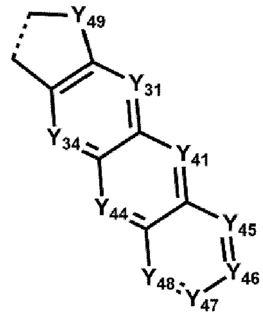

CR(8)

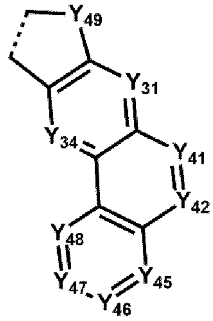

CR(9)

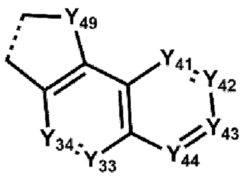

CR(10)

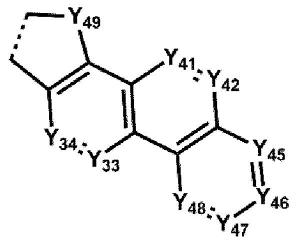

CR(11)

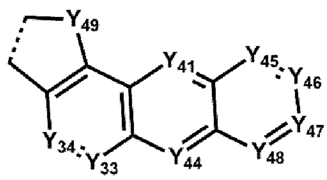

CR(12)

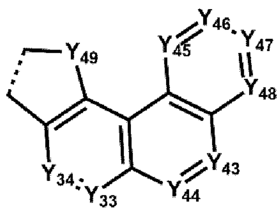

CR(13)

wherein, in Formulae CR(1) to CR(13),

$Y_{49}$ may be as described herein, and
$Y_{31}$ to $Y_{34}$ and $Y_{41}$ to $Y_{48}$ may each independently be C or N.

In one or more embodiments, the first compound may include at least one deuterium.

In one or more embodiments, the second compound may include at least one deuterium.

For example, the first compound may be a compound of Group 1-1 to Group 1-4:

Group 1-1

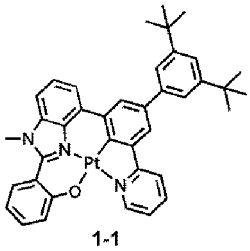
1-1

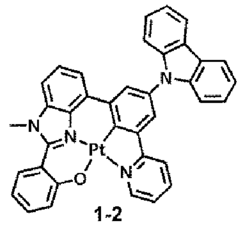
1-2

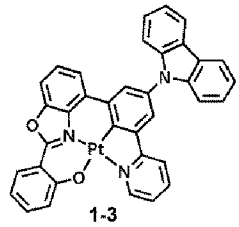
1-3

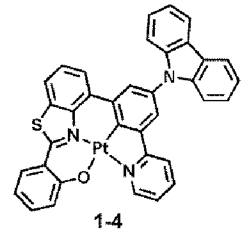
1-4

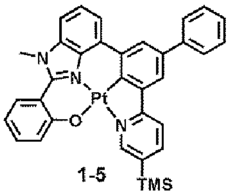
1-5

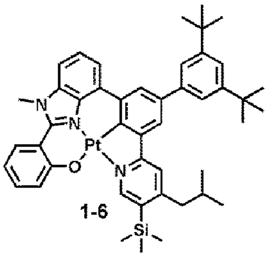
1-6

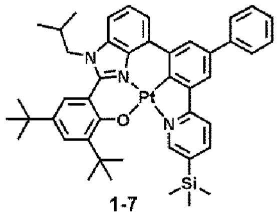
1-7

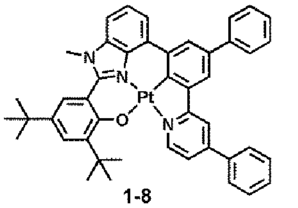
1-8

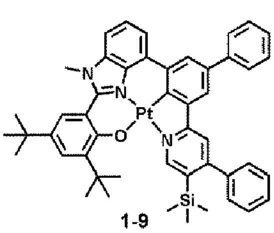
1-9

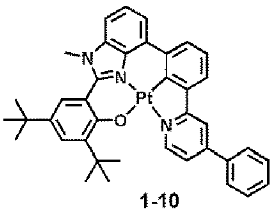
1-10

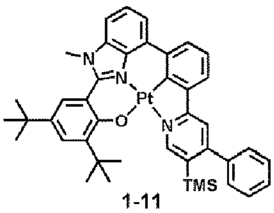
1-11

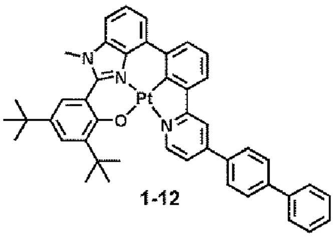
1-12

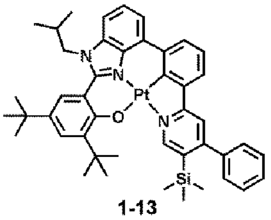
1-13

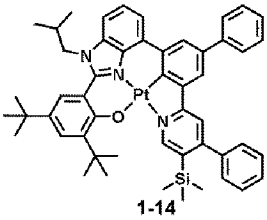
1-14

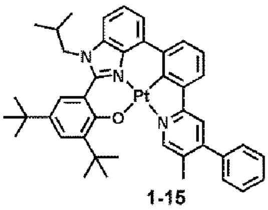
1-15

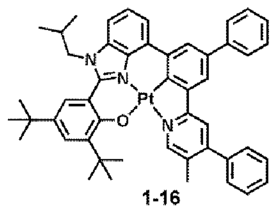
1-16

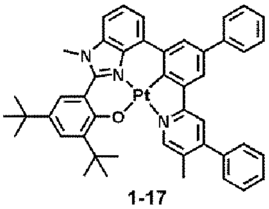
1-17

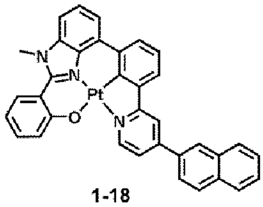
1-18

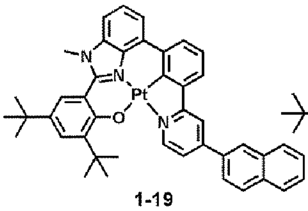
1-19

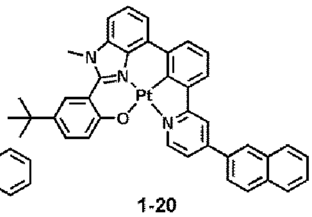
1-20

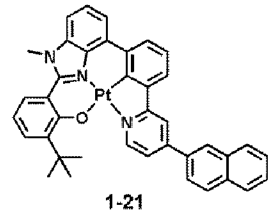
1-21

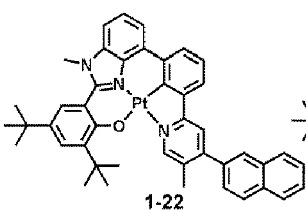
1-22

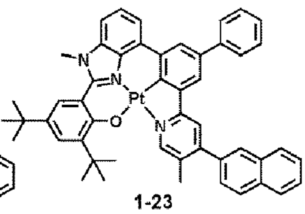
1-23

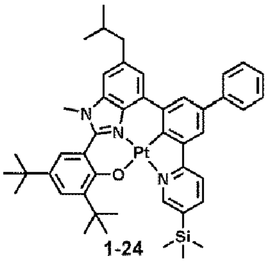
1-24

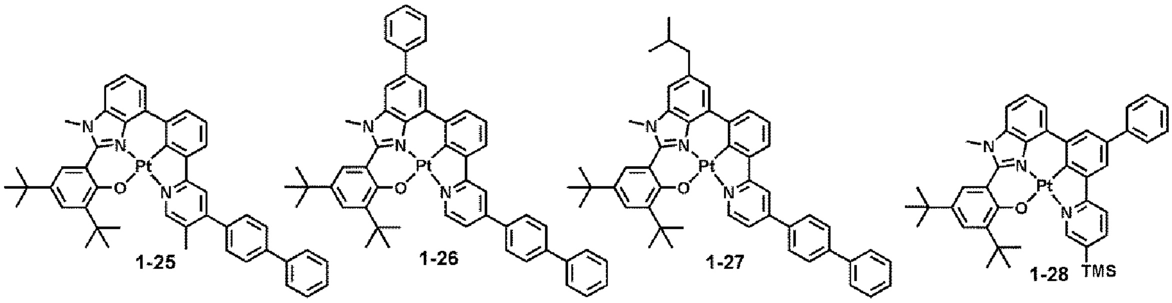

1-25 1-26 1-27 1-28

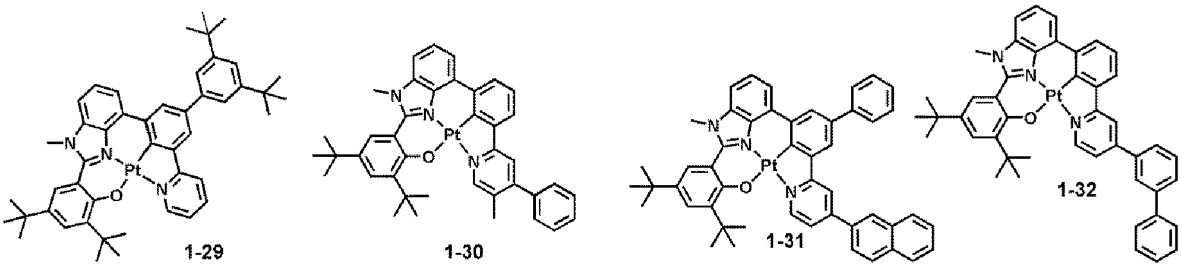

1-29 1-30 1-31 1-32

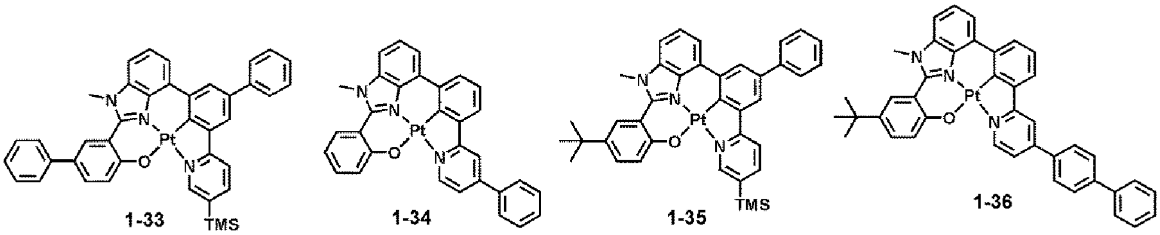

1-33 1-34 1-35 1-36

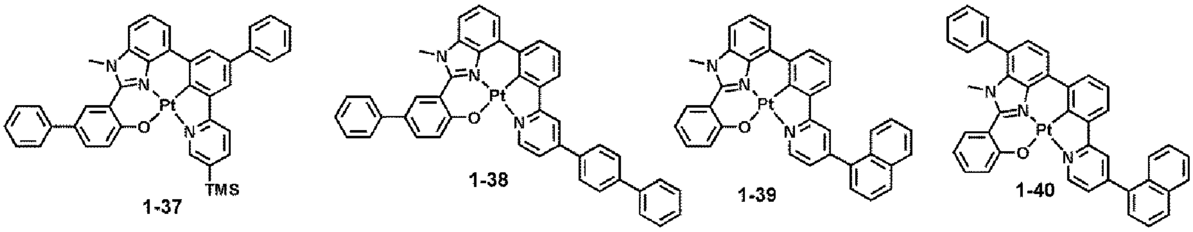

1-37 1-38 1-39 1-40

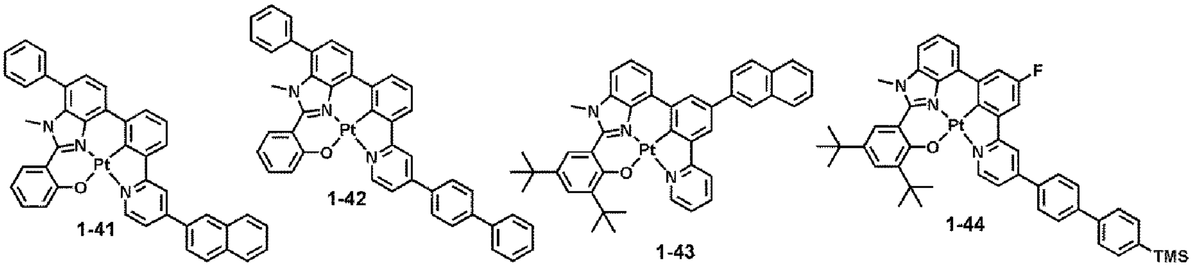

1-41 1-42 1-43 1-44

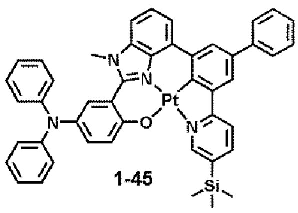
1-45

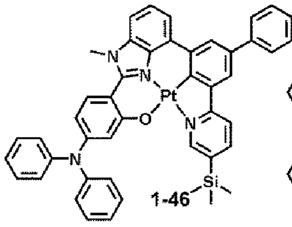
1-46

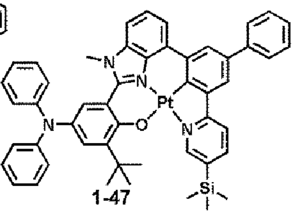
1-47

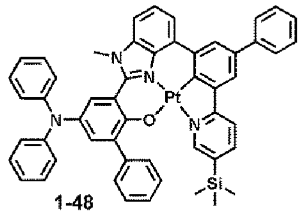
1-48

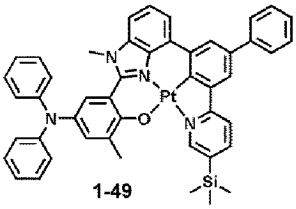
1-49

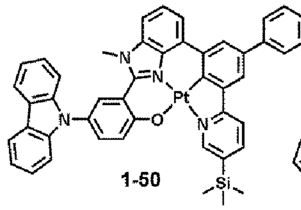
1-50

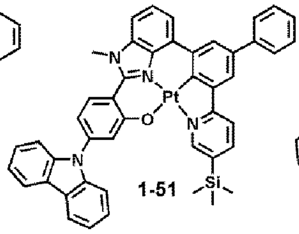
1-51

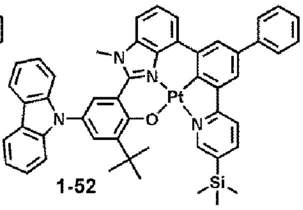
1-52

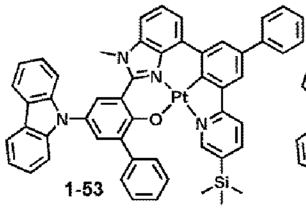
1-53

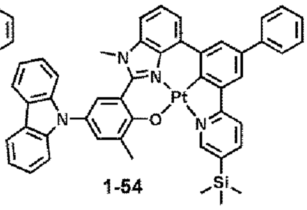
1-54

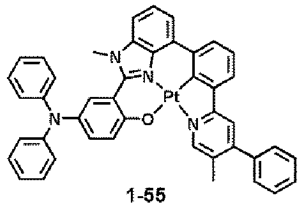
1-55

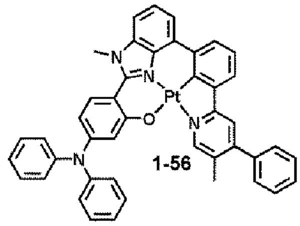
1-56

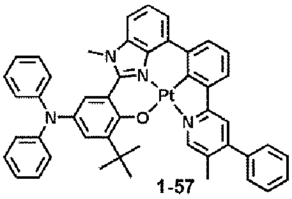
1-57

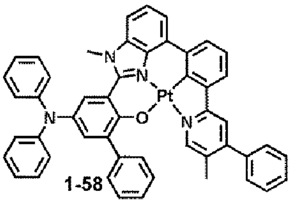
1-58

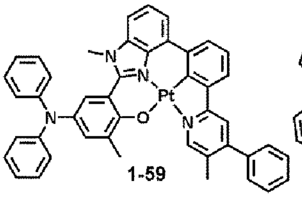
1-59

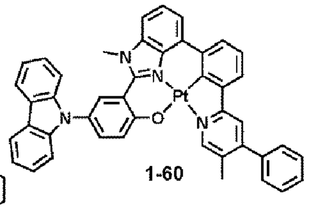
1-60

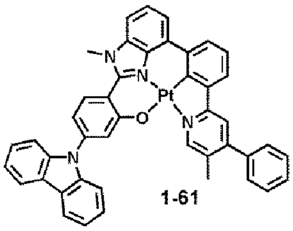
1-61

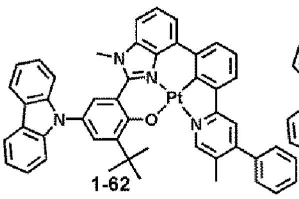
1-62

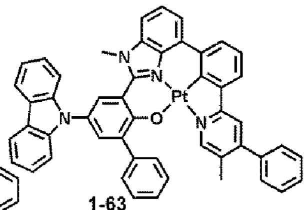
1-63

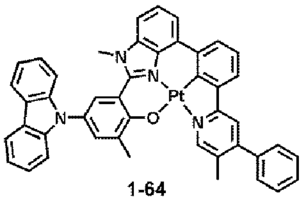
1-64

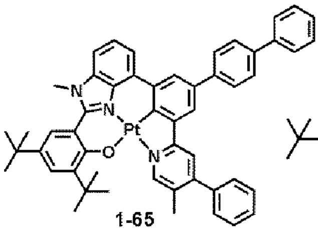
1-65

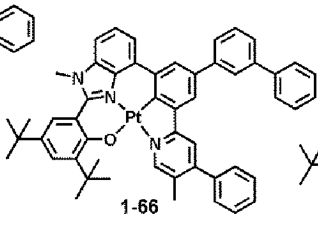
1-66

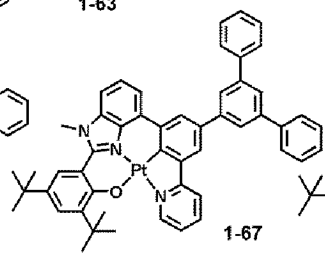
1-67

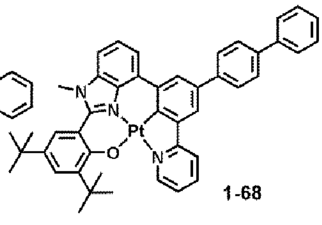
1-68

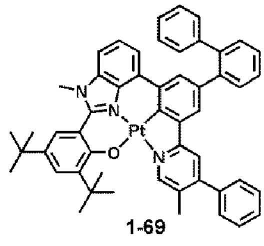
1-69

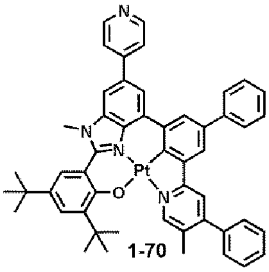
1-70

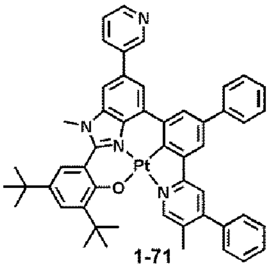
1-71

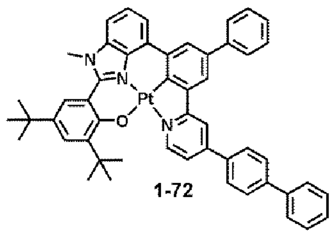
1-72

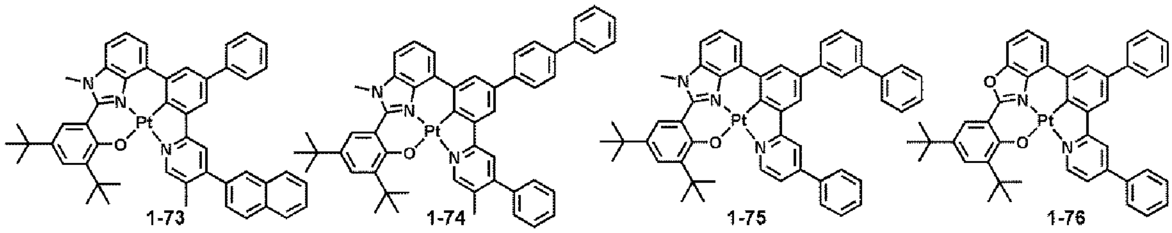
1-73 1-74 1-75 1-76

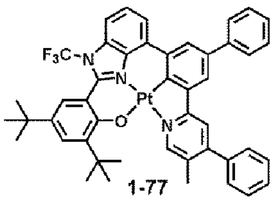
1-77

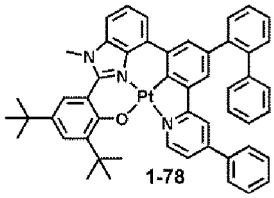
1-78

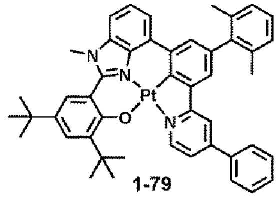
1-79

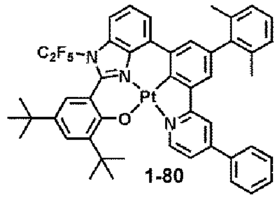
1-80

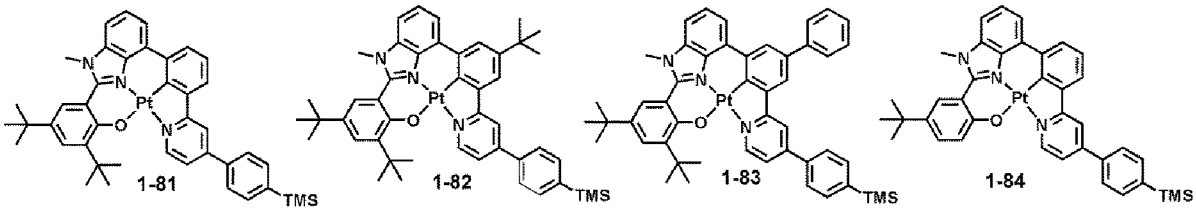
1-81 1-82 1-83 1-84

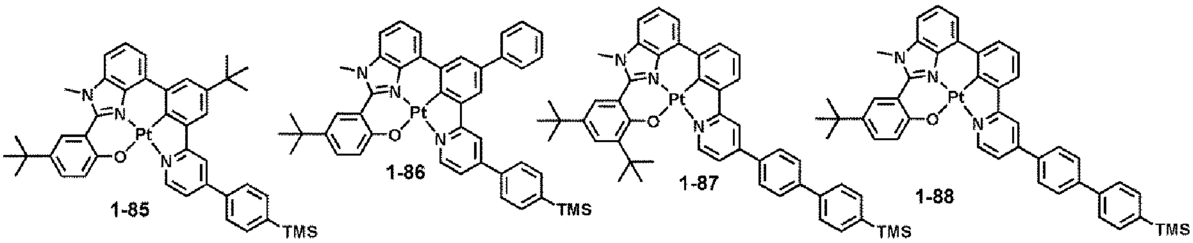
1-85 1-86 1-87 1-88

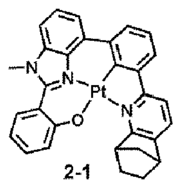
2-1

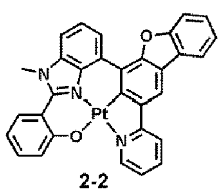
2-2

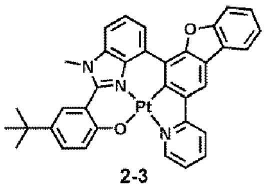
2-3

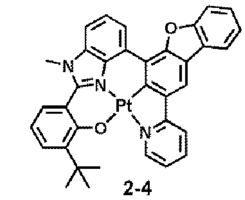
2-4

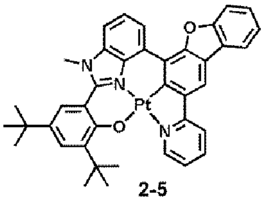
2-5

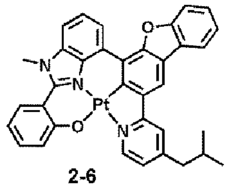
2-6

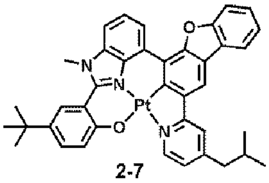
2-7

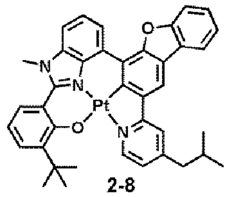
2-8

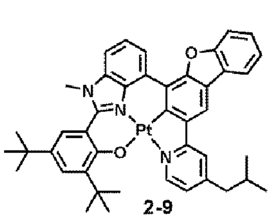
2-9

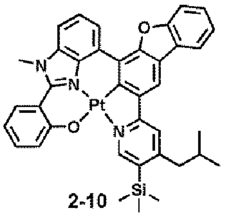
2-10

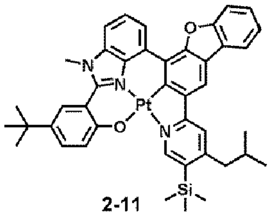
2-11

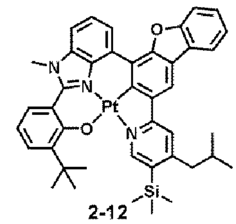
2-12

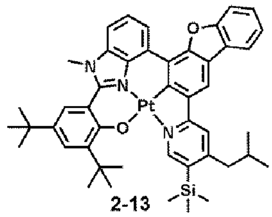
2-13

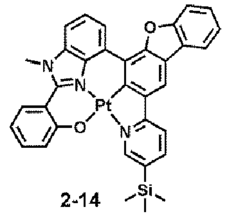
2-14

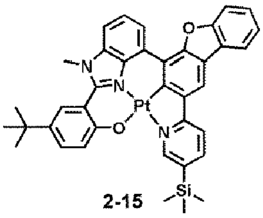
2-15

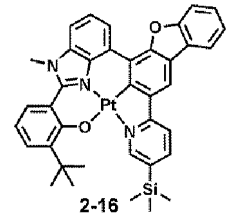
2-16

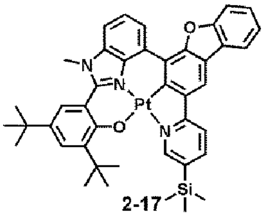
2-17

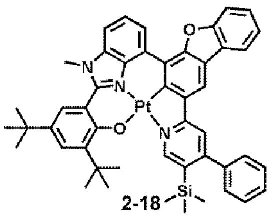
2-18

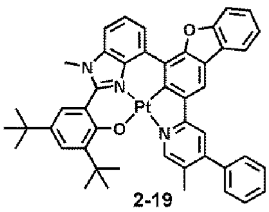
2-19

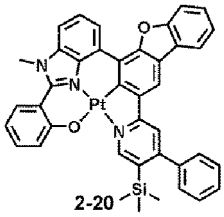
2-20

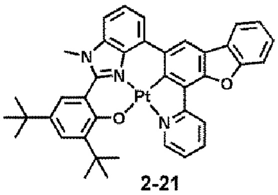
2-21

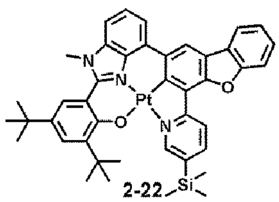
2-22

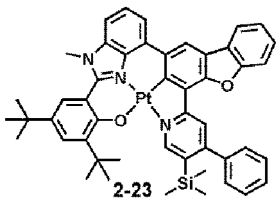
2-23

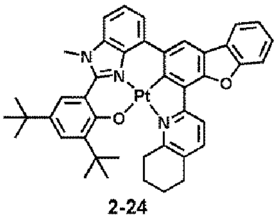
2-24

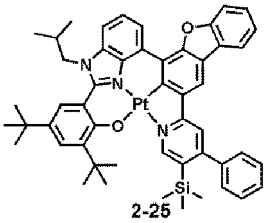
2-25

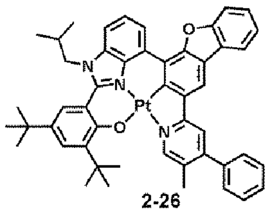
2-26

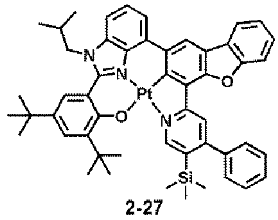
2-27

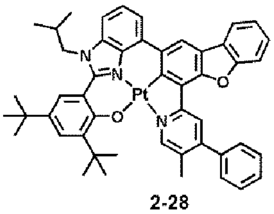
2-28

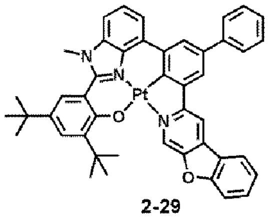
2-29

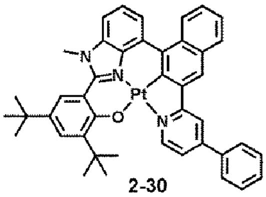
2-30

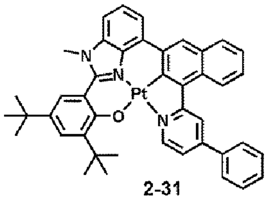
2-31

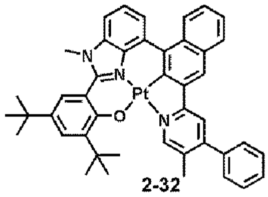
2-32

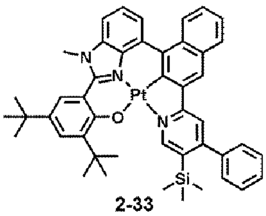
2-33

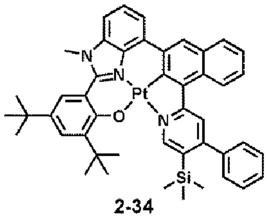
2-34

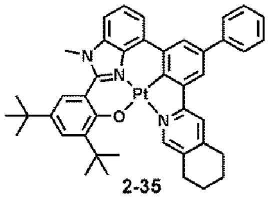
2-35

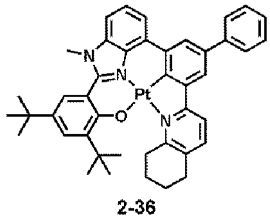
2-36

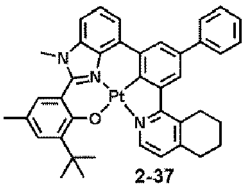
2-37

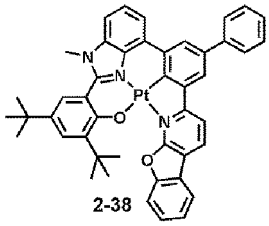
2-38

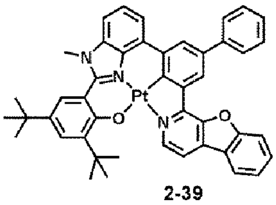
2-39

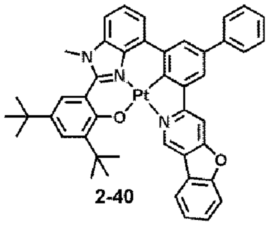
2-40

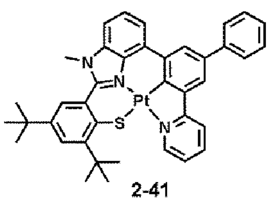
2-41

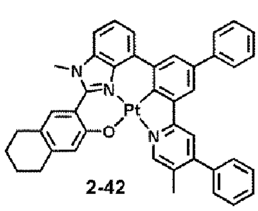
2-42

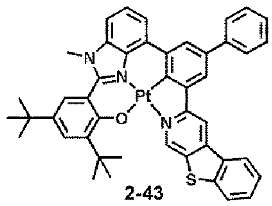
2-43

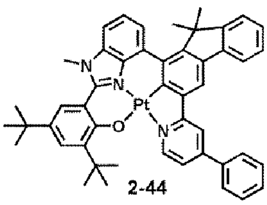
2-44

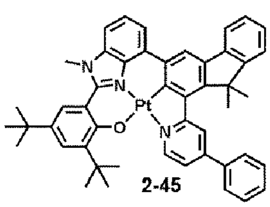
2-45

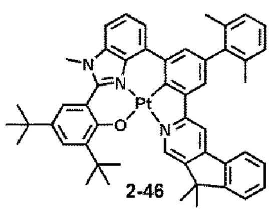
2-46

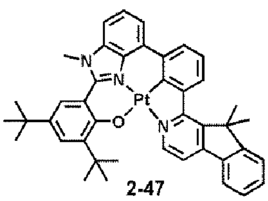
2-47

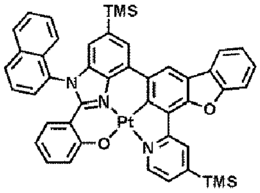
3-1

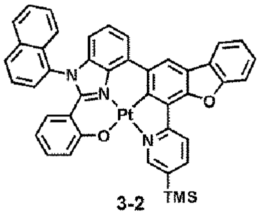
3-2

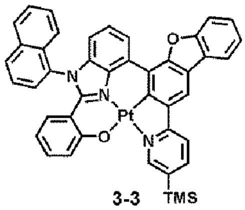
3-3

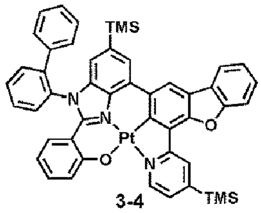
3-4

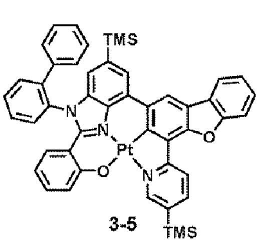
3-5

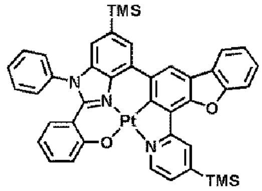
3-6

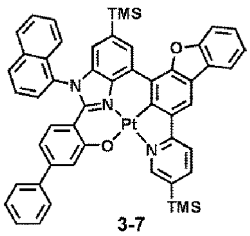
3-7

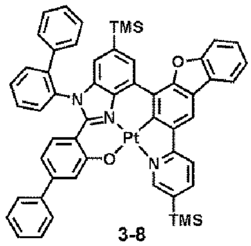
3-8

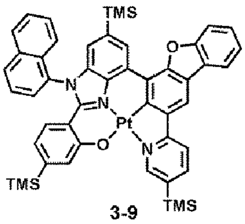
3-9

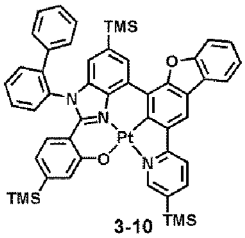
3-10

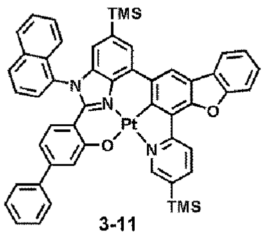
3-11

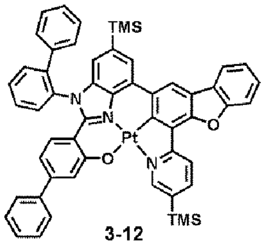
3-12

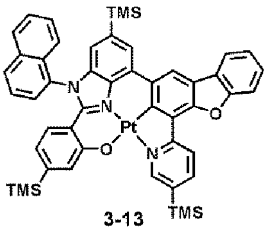
3-13

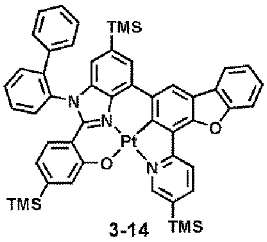
3-14

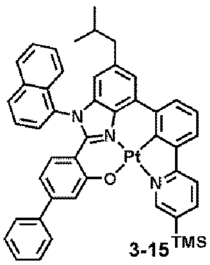
3-15

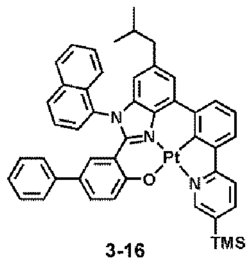
3-16

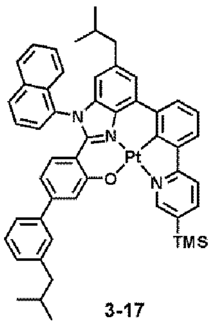
3-17

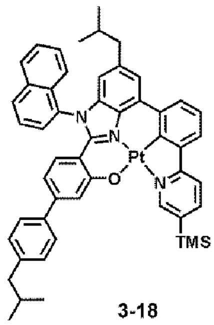
3-18

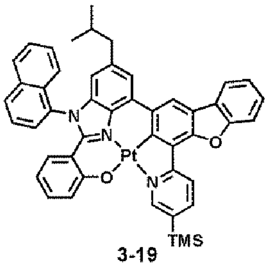
3-19

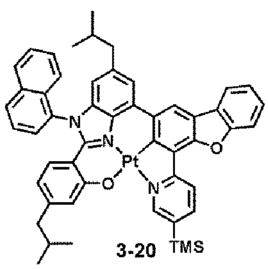
3-20

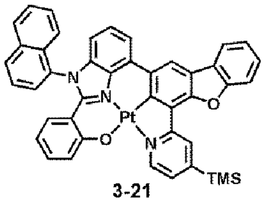
3-21

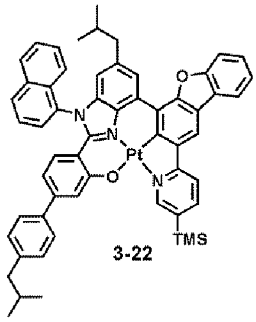
3-22

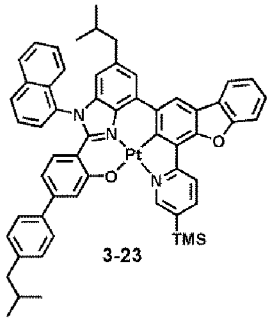
3-23

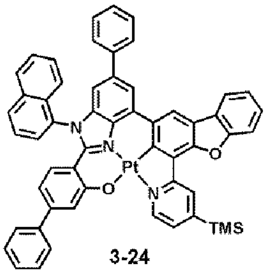
3-24

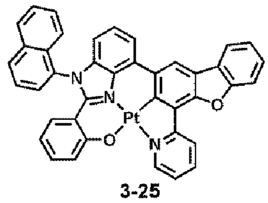
3-25

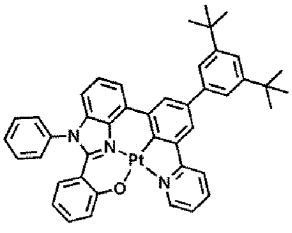
3-26

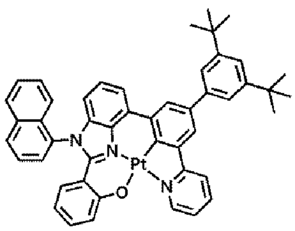
3-27

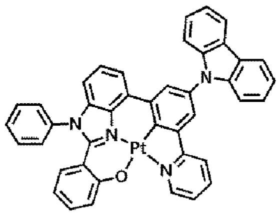
3-28

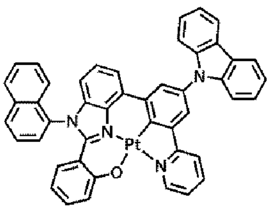
3-29

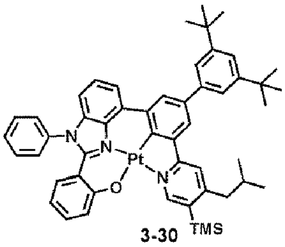
3-30

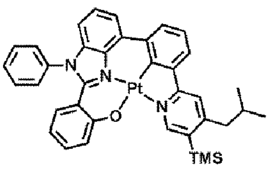
3-31

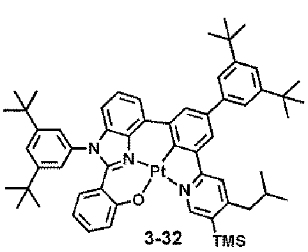
3-32

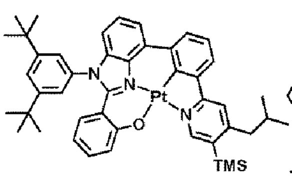
3-33

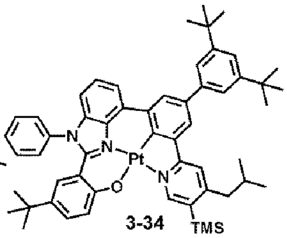
3-34

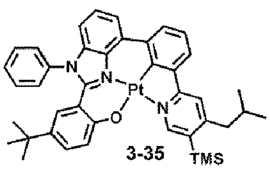
3-35

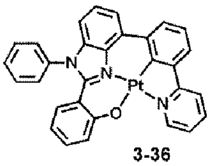
3-36

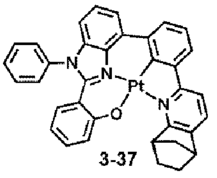
3-37

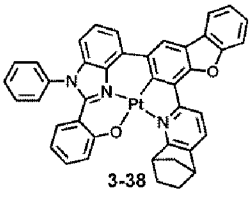
3-38

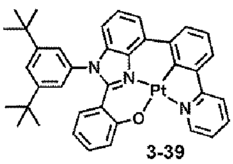
3-39

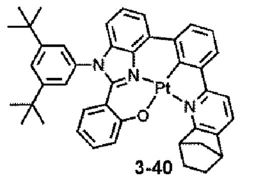
3-40

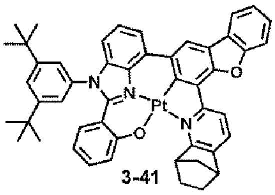
3-41

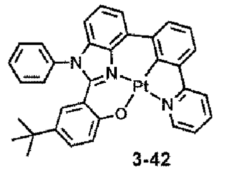
3-42

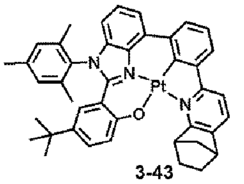
3-43

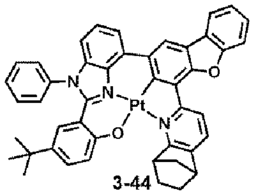
3-44

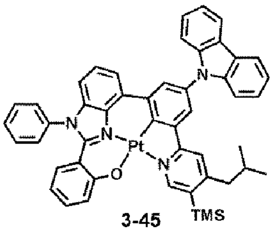
3-45

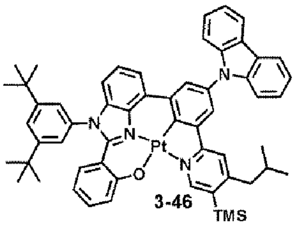
3-46

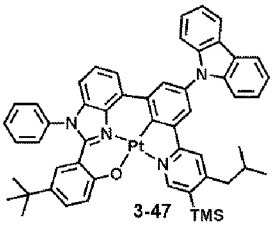
3-47

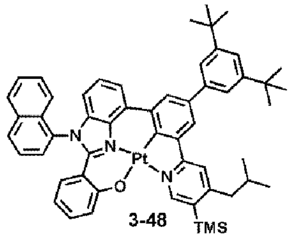
3-48

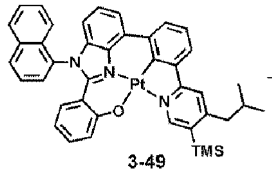
3-49

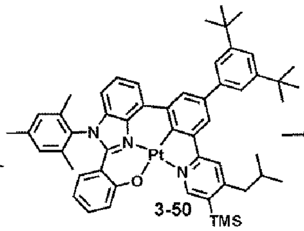
3-50

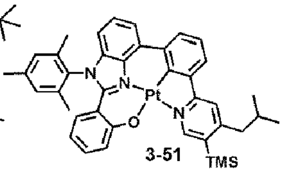
3-51

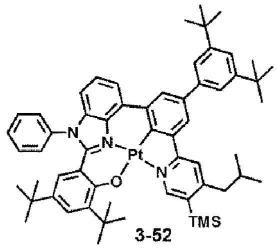
3-52

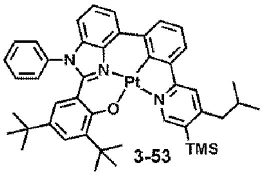
3-53

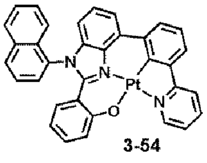
3-54

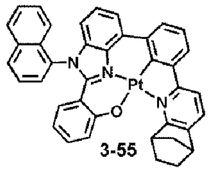
3-55

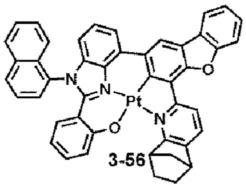
3-56

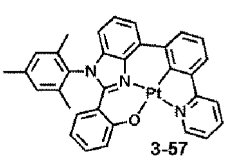
3-57

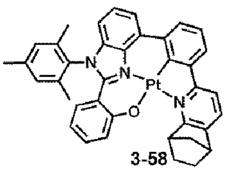
3-58

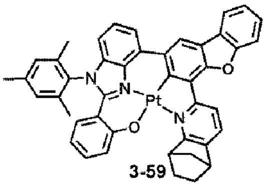
3-59

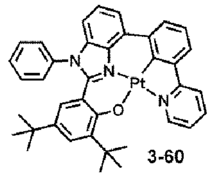
3-60

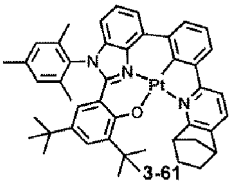
3-61

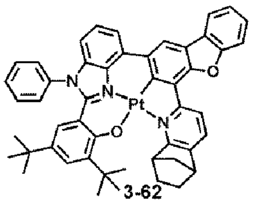
3-62

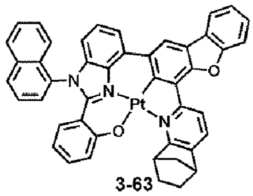
3-63

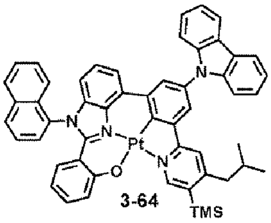
3-64

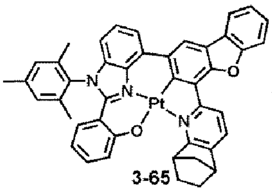
3-65

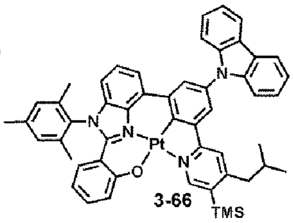
3-66

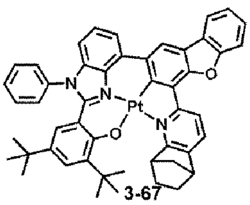
3-67

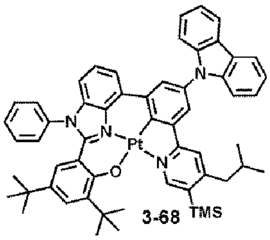
3-68

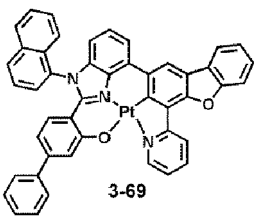
3-69

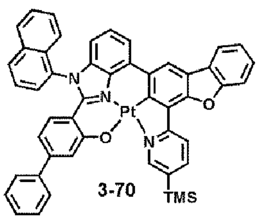
3-70

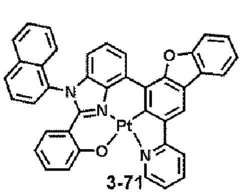
3-71

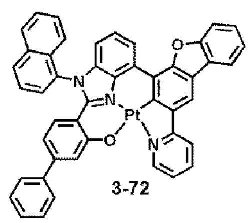
3-72

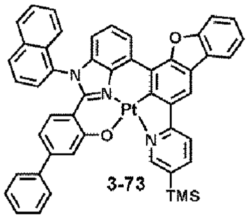
3-73

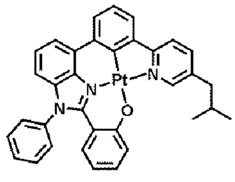
3-74

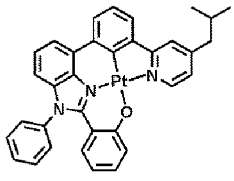
3-75

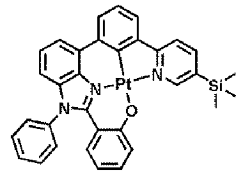
3-76

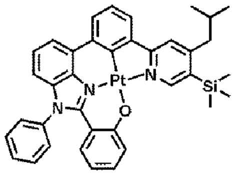
3-77

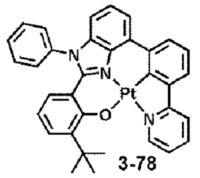
3-78

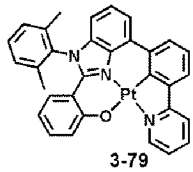
3-79

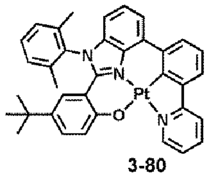
3-80

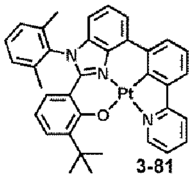
3-81

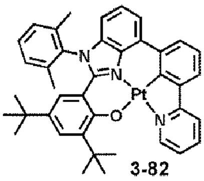
3-82

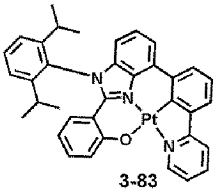
3-83

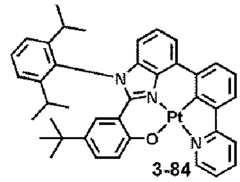
3-84

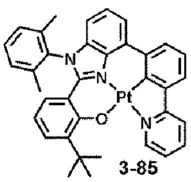
3-85

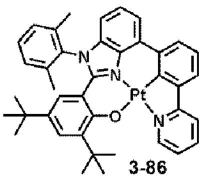
3-86

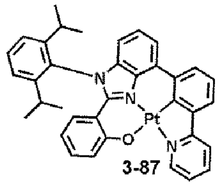
3-87

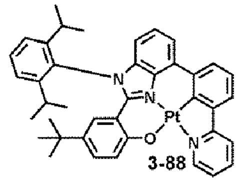
3-88

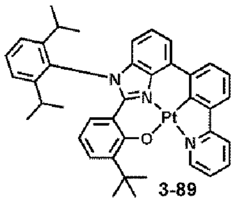
3-89

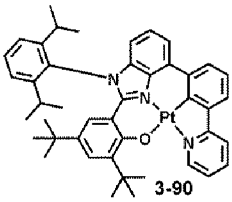
3-90

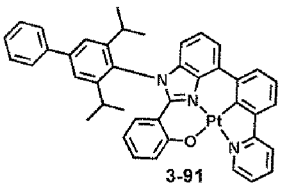
3-91

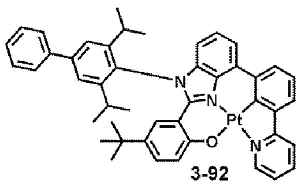
3-92

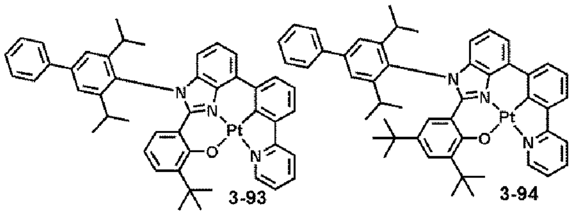
3-93

3-94

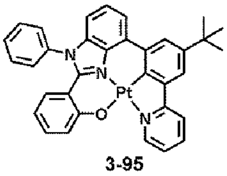
3-95

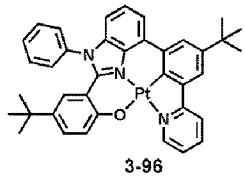
3-96

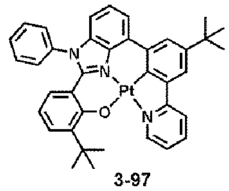
3-97

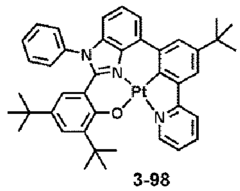
3-98

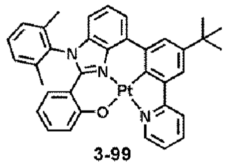
3-99

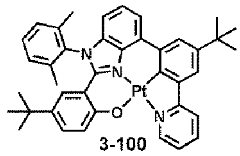
3-100

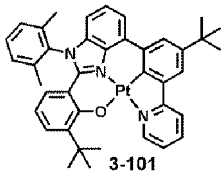
3-101

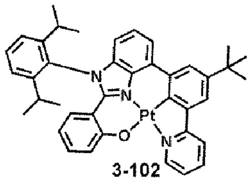
3-102

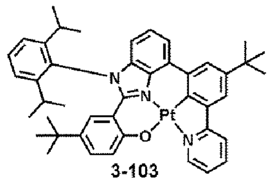
3-103

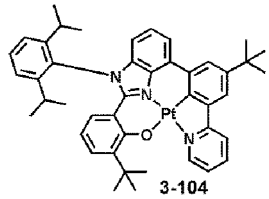
3-104

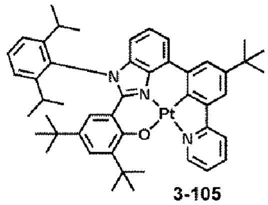
3-105

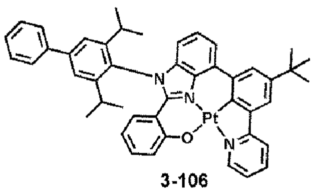
3-106

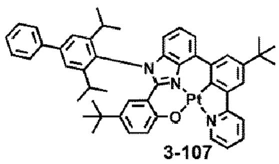
3-107

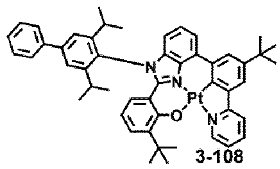
3-108

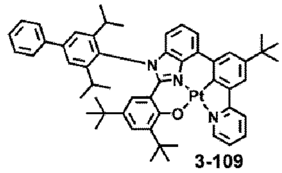
3-109

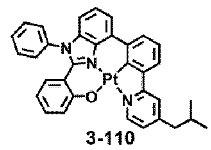
3-110

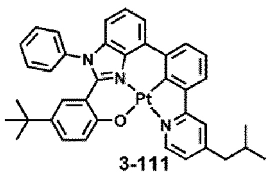
3-111

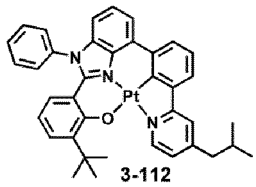
3-112

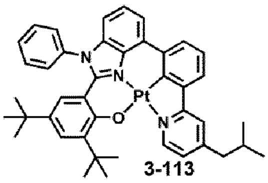
3-113

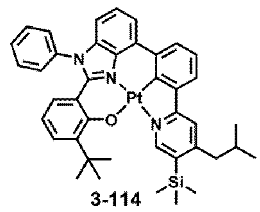
3-114

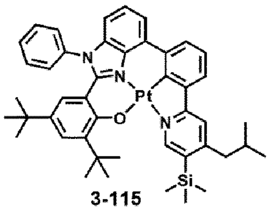
3-115

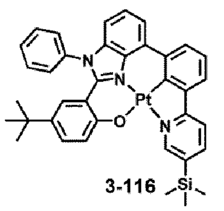
3-116

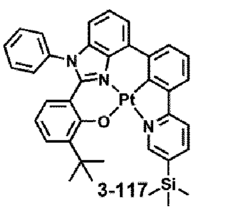
3-117

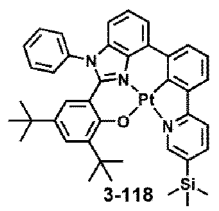
3-118

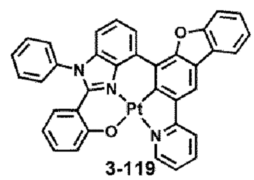
3-119

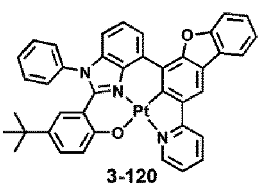
3-120

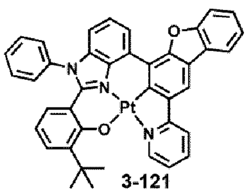
3-121

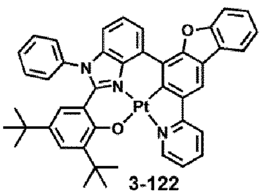
3-122

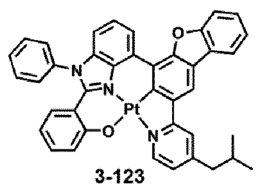
3-123

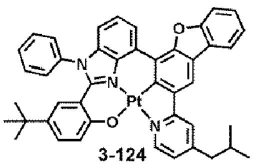
3-124
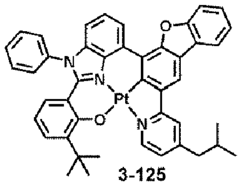
3-125
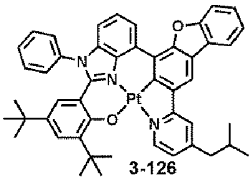
3-126
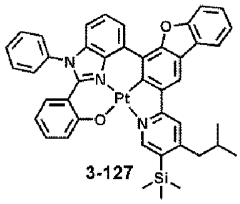
3-127

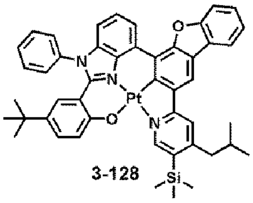
3-128
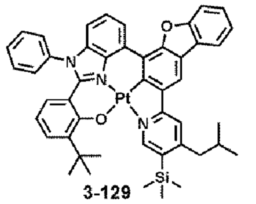
3-129
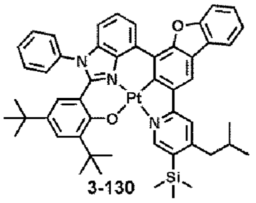
3-130
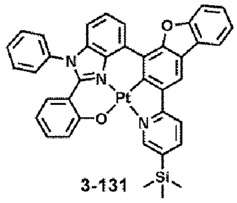
3-131

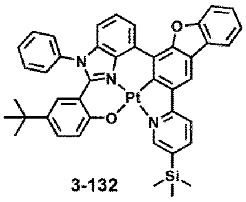
3-132
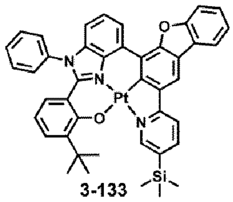
3-133
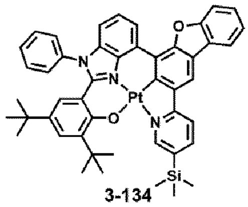
3-134
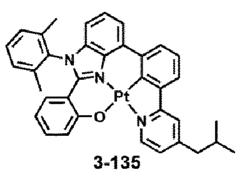
3-135

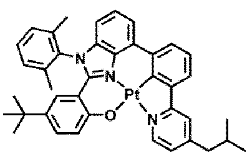
3-136
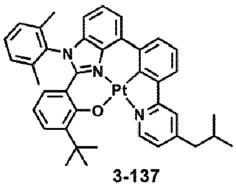
3-137
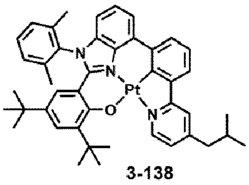
3-138
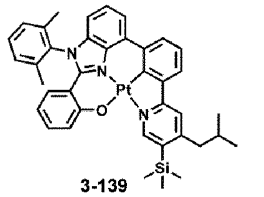
3-139

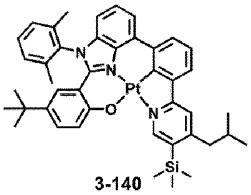
3-140
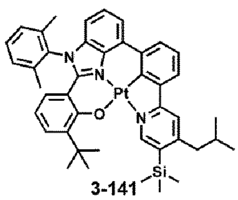
3-141
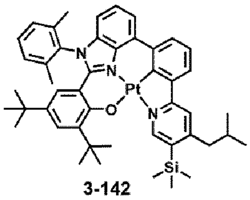
3-142
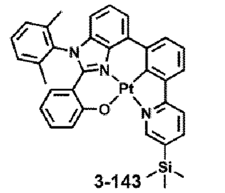
3-143

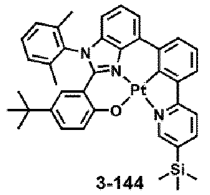
3-144
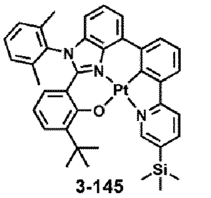
3-145
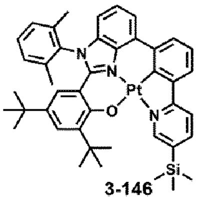
3-146
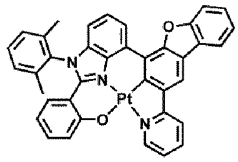
3-147

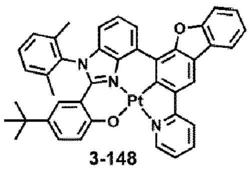
3-148
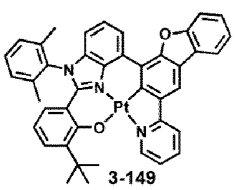
3-149
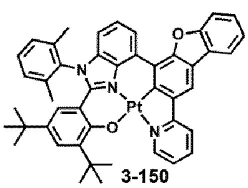
3-150
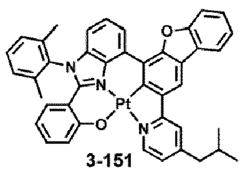
3-151

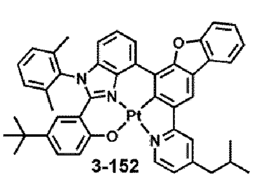
3-152
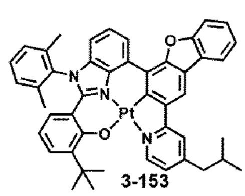
3-153
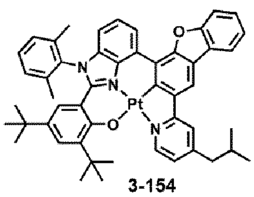
3-154
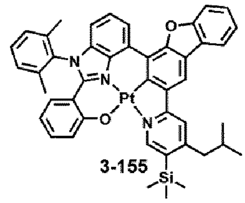
3-155

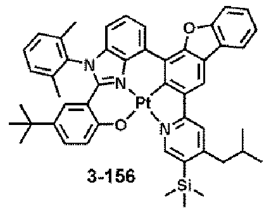
3-156
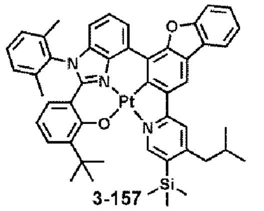
3-157
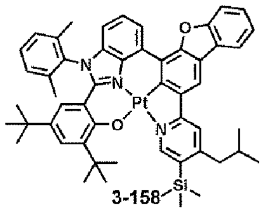
3-158
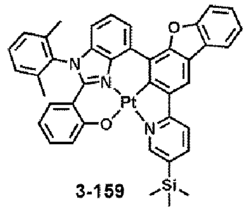
3-159

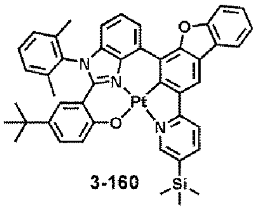
3-160
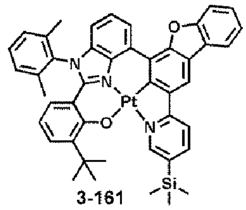
3-161
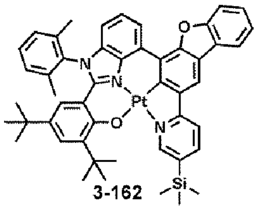
3-162
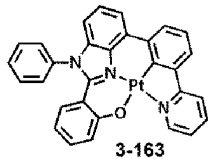
3-163

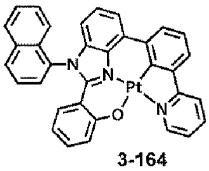
3-164
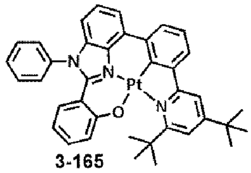
3-165
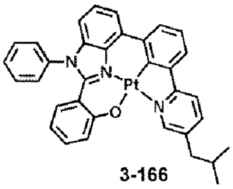
3-166
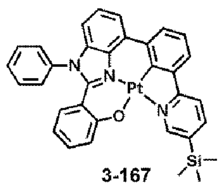
3-167

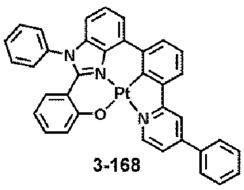
3-168
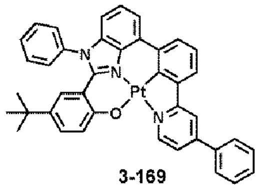
3-169
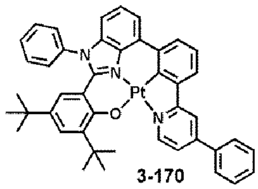
3-170
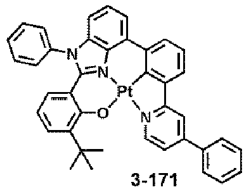
3-171

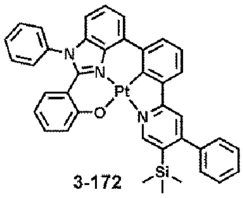
3-172
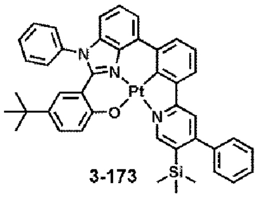
3-173
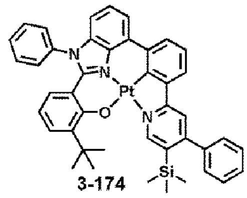
3-174
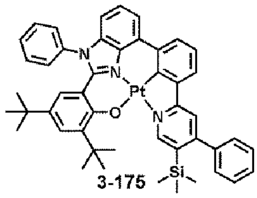
3-175

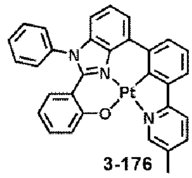
3-176
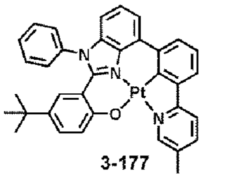
3-177
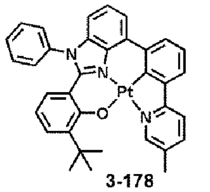
3-178
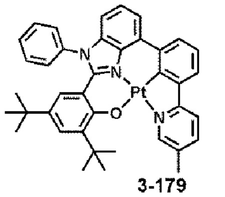
3-179

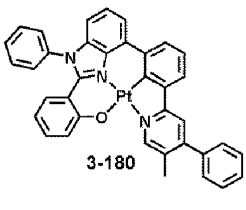
3-180
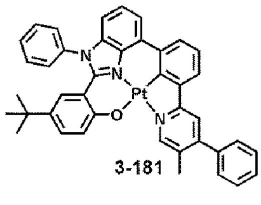
3-181
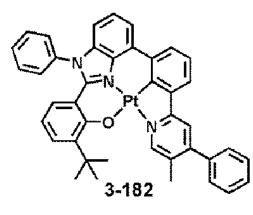
3-182
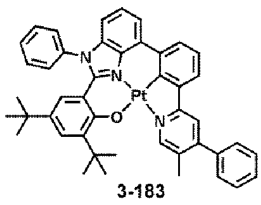
3-183

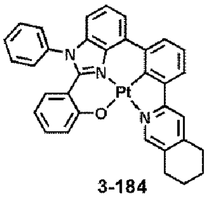
3-184
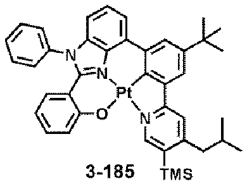
3-185
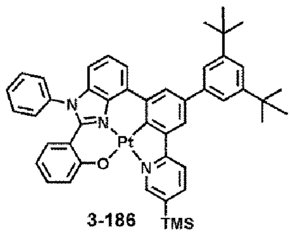
3-186
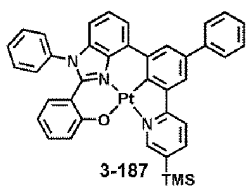
3-187

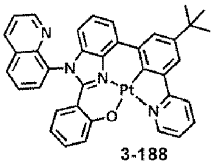
3-188

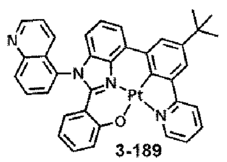
3-189

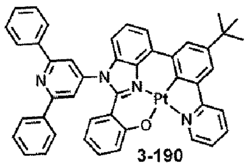
3-190

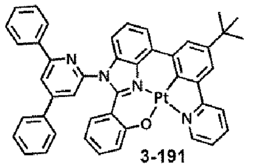
3-191

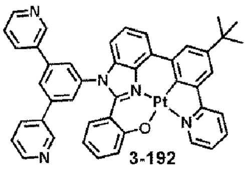
3-192

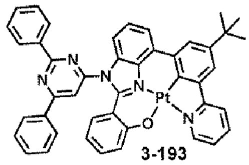
3-193

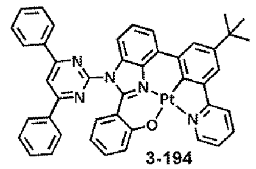
3-194

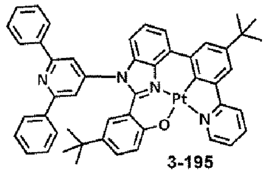
3-195

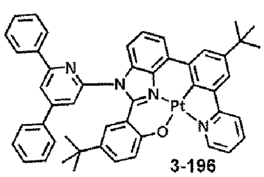
3-196

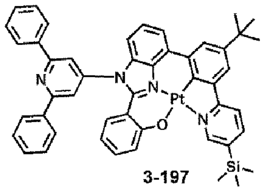
3-197

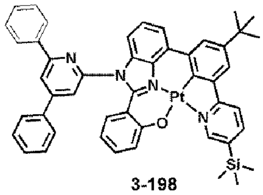
3-198

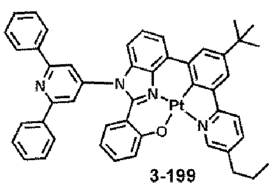
3-199

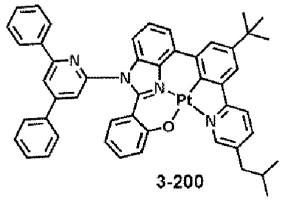
3-200

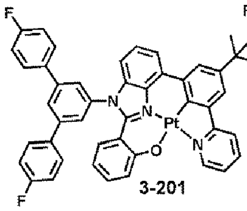
3-201

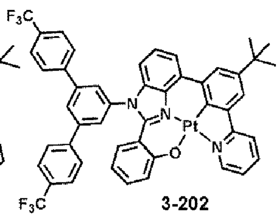
3-202

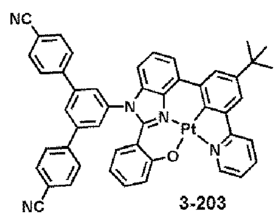
3-203

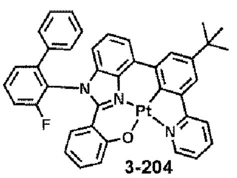
3-204

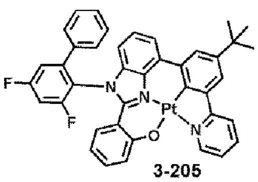
3-205

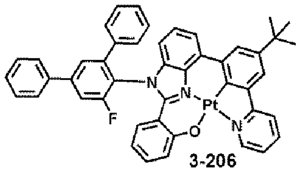
3-206

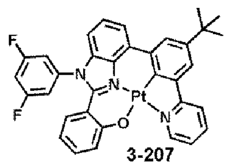
3-207

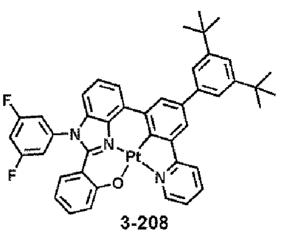
3-208

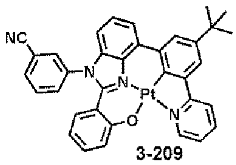
3-209

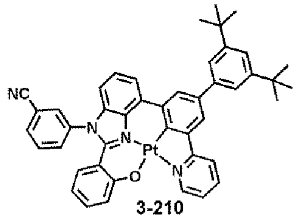
3-210

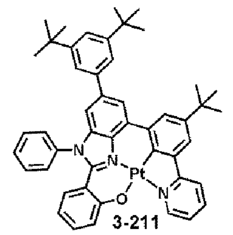
3-211

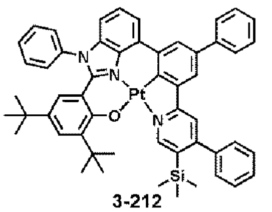
3-212

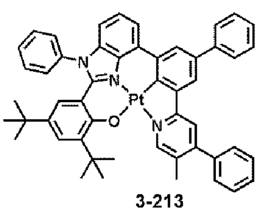
3-213

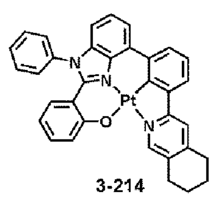
3-214

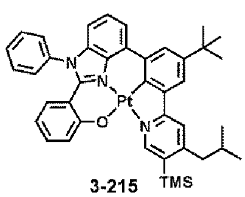
3-215

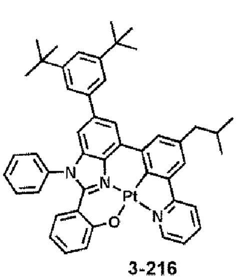
3-216

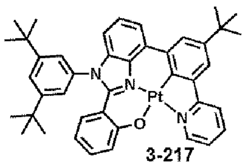
3-217

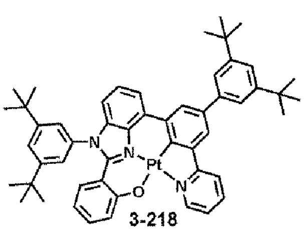
3-218

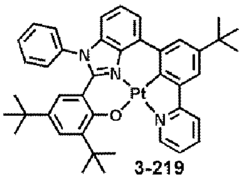
3-219

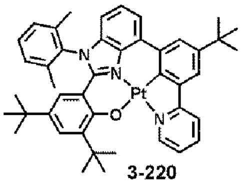
3-220

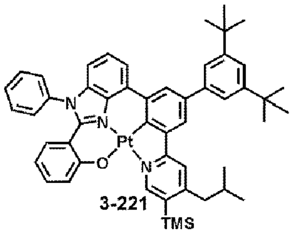
3-221

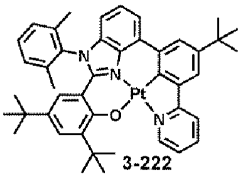
3-222

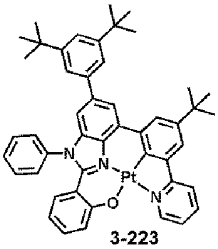
3-223

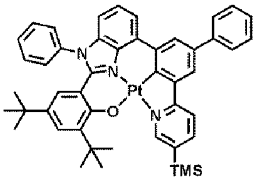
3-224

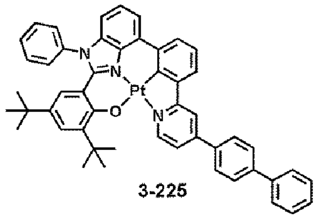
3-225

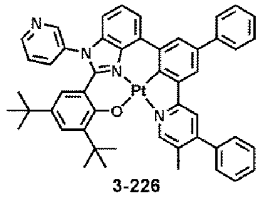
3-226

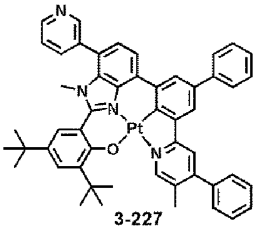
3-227

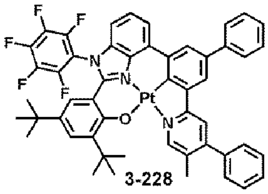
3-228

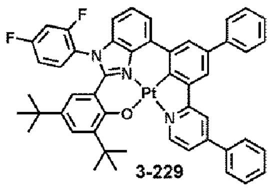
3-229

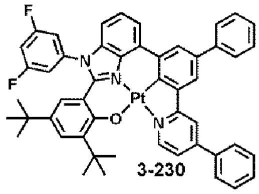
3-230

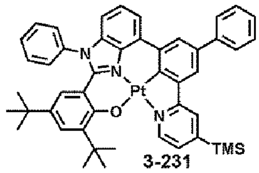
3-231

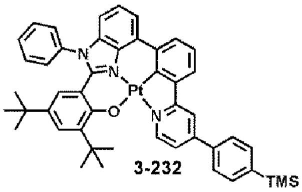
3-232

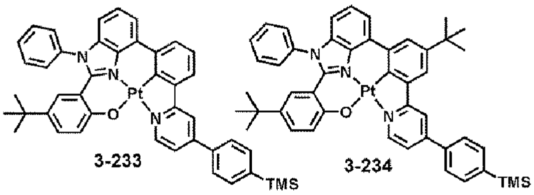
3-233

3-234

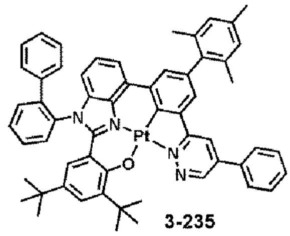
3-235

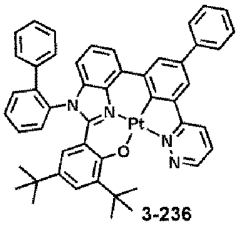
3-236

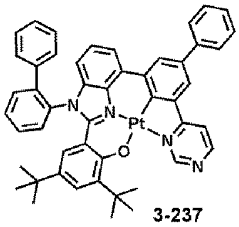
3-237

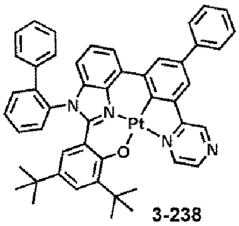
3-238

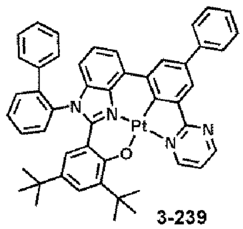
3-239

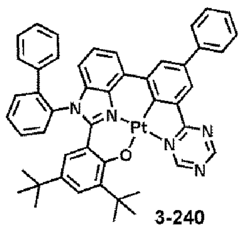
3-240

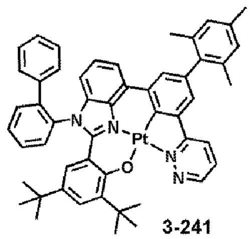
3-241

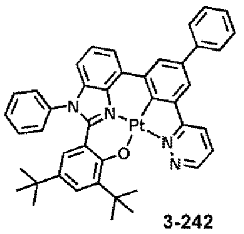
3-242

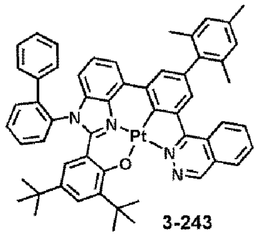
3-243

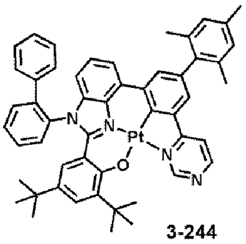
3-244

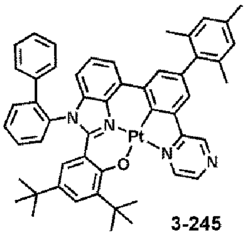
3-245

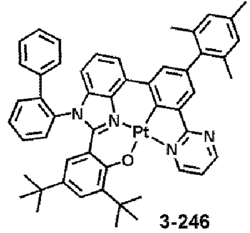
3-246

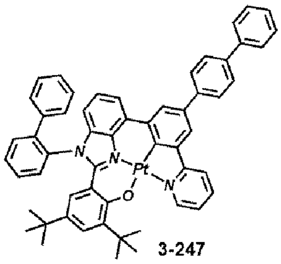
3-247

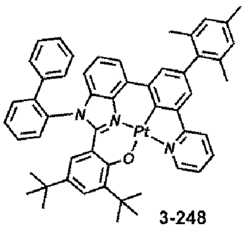
3-248

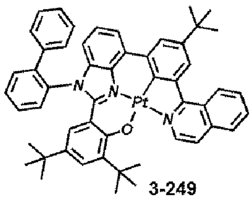
3-249

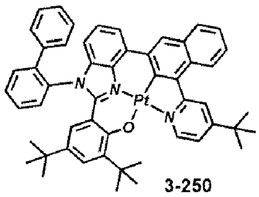
3-250

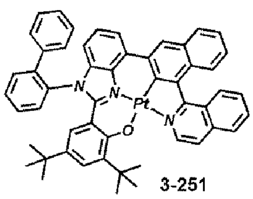
3-251

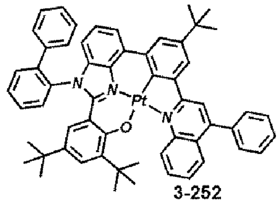
3-252

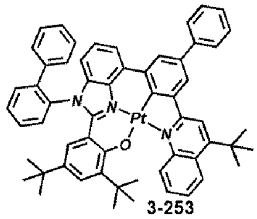
3-253

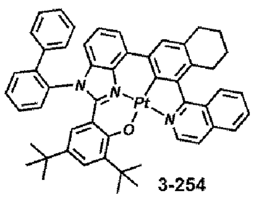
3-254

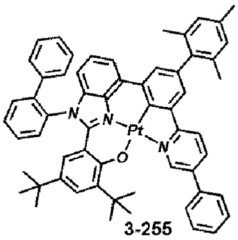
3-255

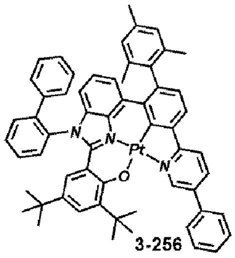
3-256

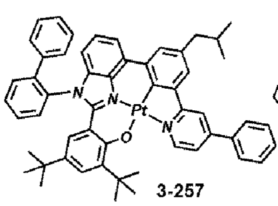
3-257

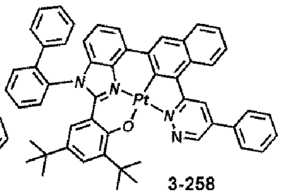
3-258

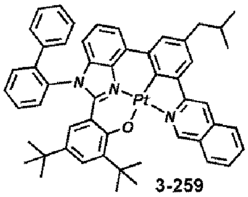
3-259

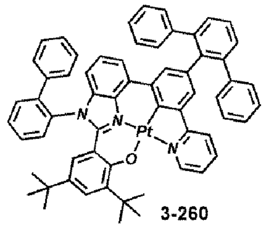
3-260

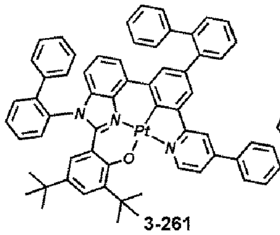
3-261

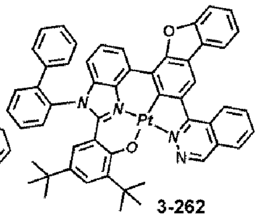
3-262

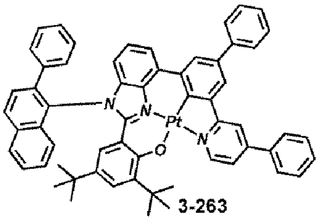
3-263

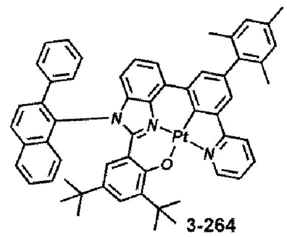
3-264

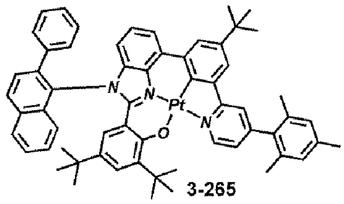
3-265

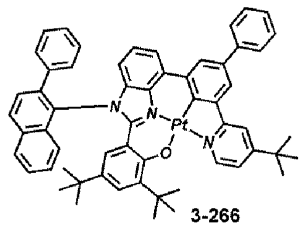
3-266

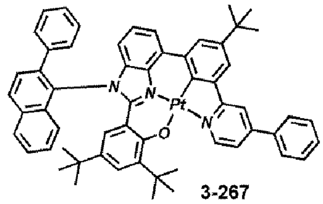
3-267

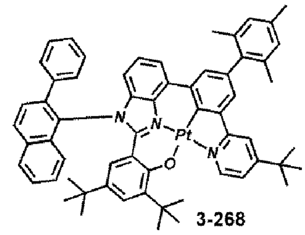
3-268

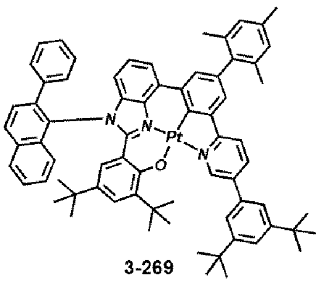
3-269

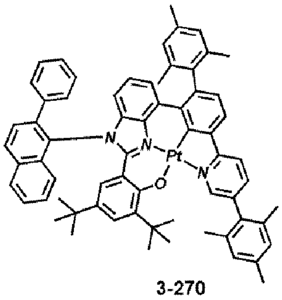
3-270

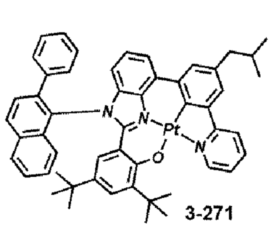
3-271

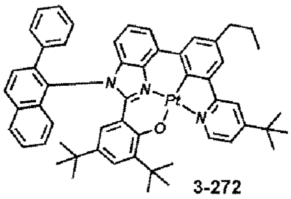
3-272

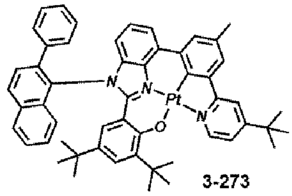
3-273

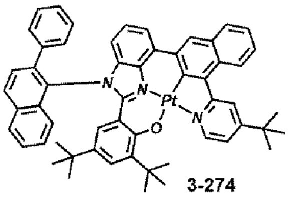
3-274

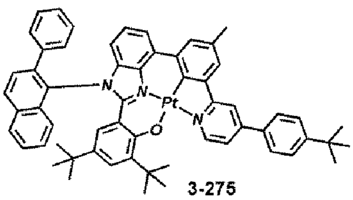
3-275

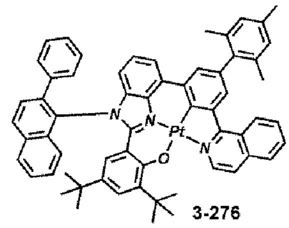
3-276

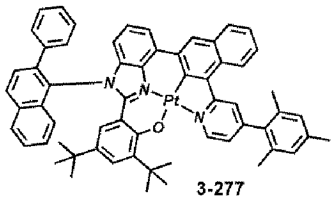
3-277

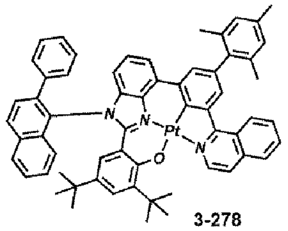
3-278

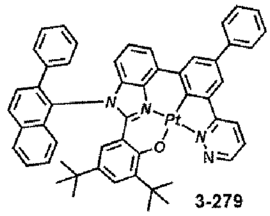
3-279

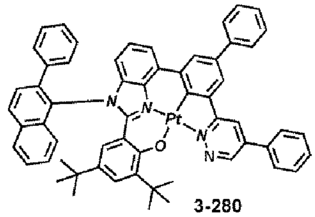
3-280

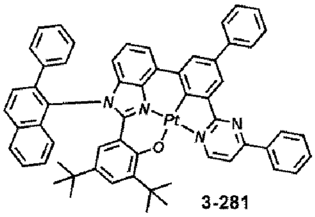
3-281

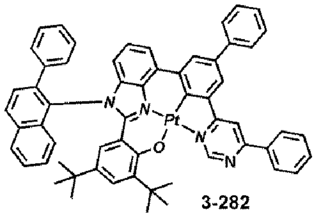
3-282

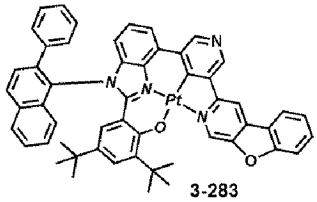
3-283

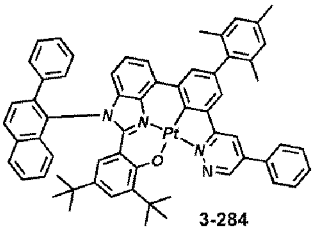
3-284

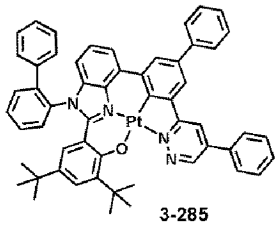
3-285

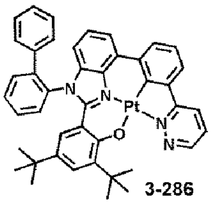
3-286

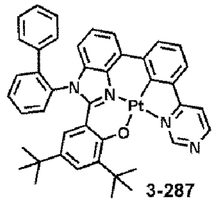
3-287

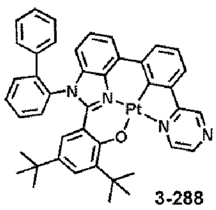
3-288

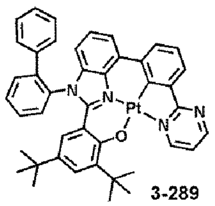
3-289

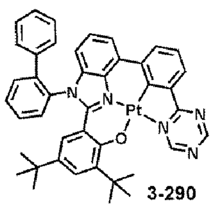
3-290

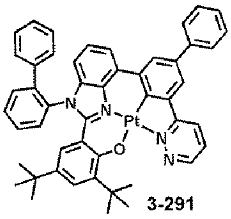
3-291

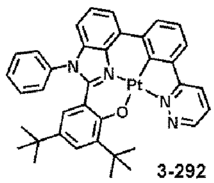
3-292

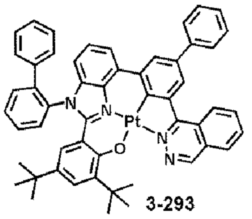
3-293

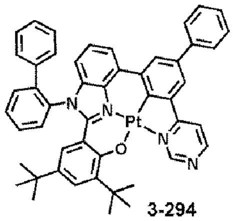
3-294

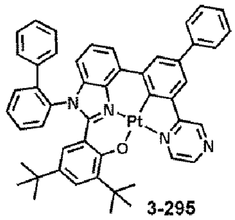
3-295

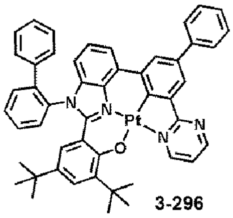
3-296

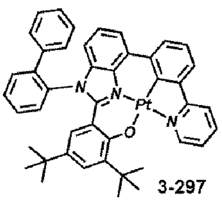
3-297

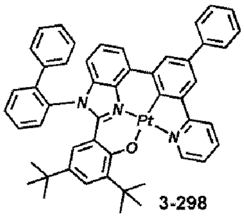
3-298

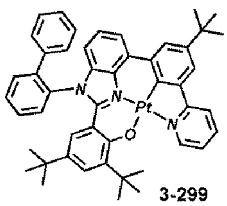
3-299

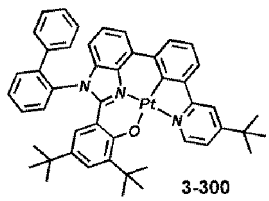
3-300

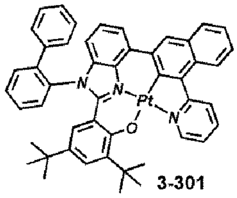
3-301

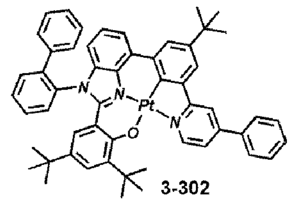
3-302

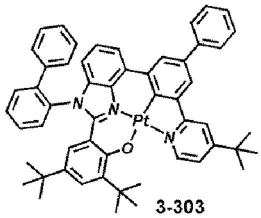
3-303

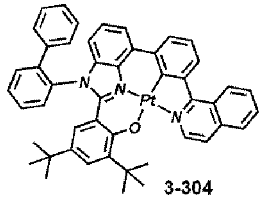
3-304

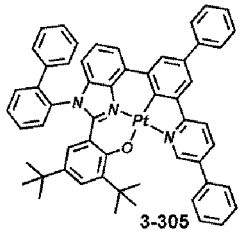
3-305

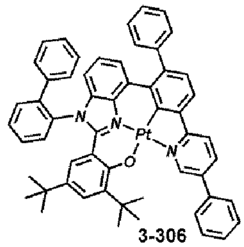
3-306

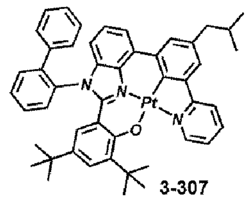
3-307

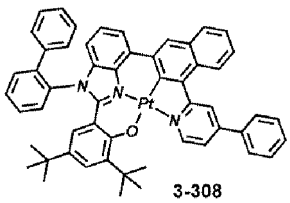
3-308

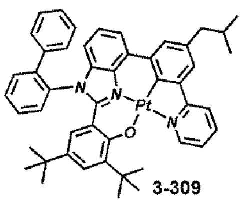
3-309

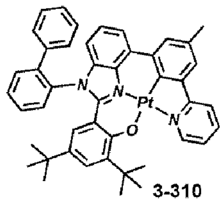
3-310

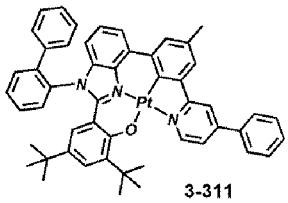
3-311

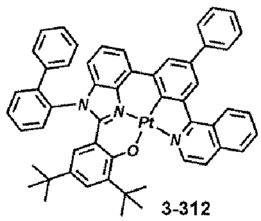
3-312

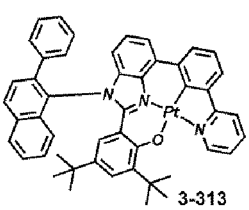
3-313

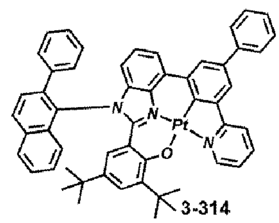
3-314

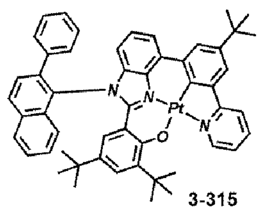
3-315

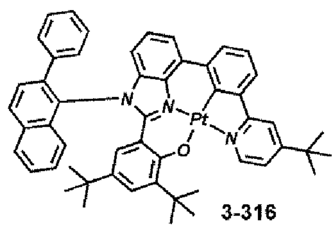
3-316

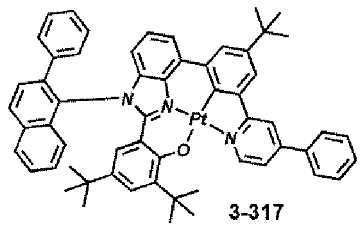
3-317

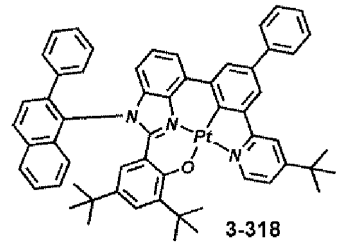
3-318

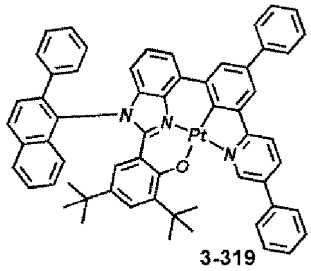
3-319

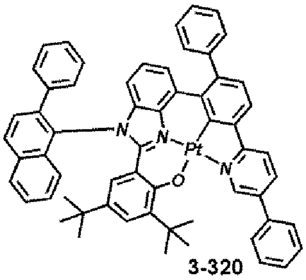
3-320

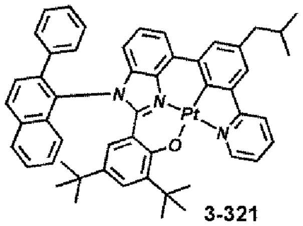
3-321

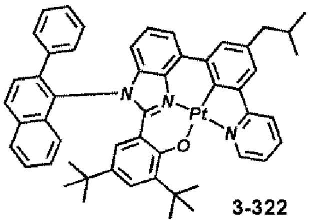
3-322

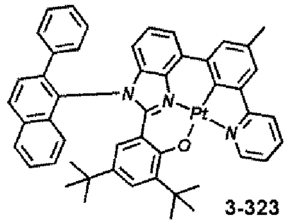
3-323

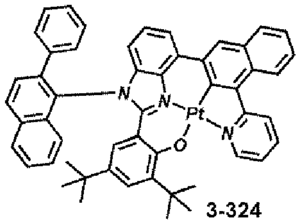
3-324

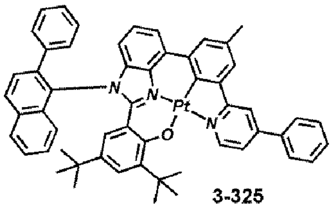
3-325

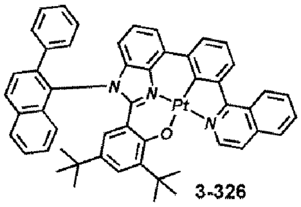
3-326

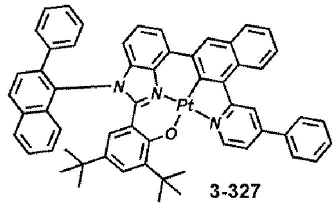
3-327

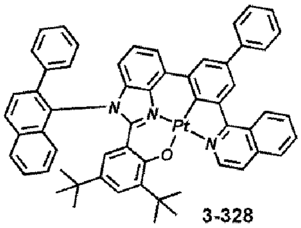
3-328

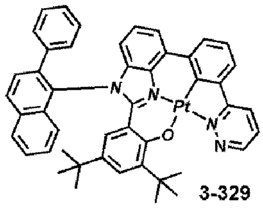
3-329

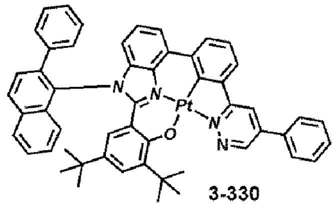
3-330

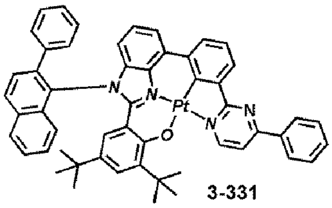
3-331

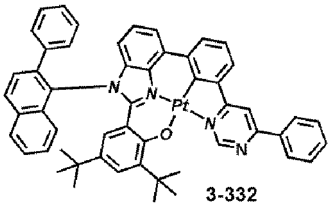
3-332

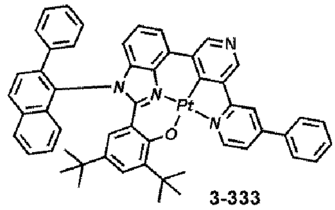
3-333

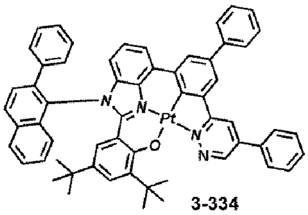
3-334

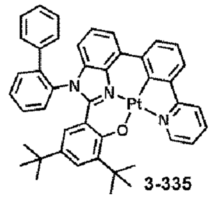
3-335

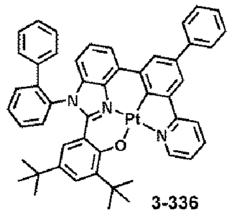
3-336

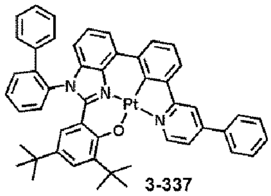
3-337

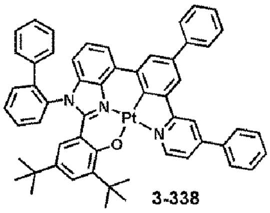
3-338

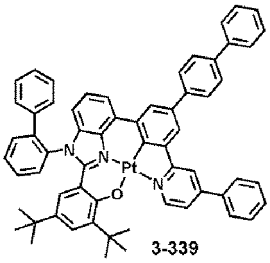
3-339

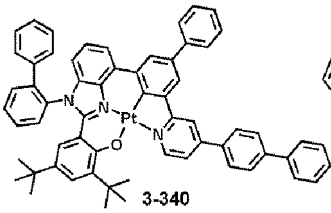
3-340

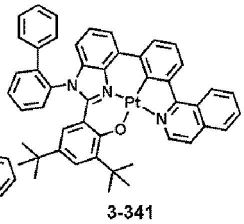
3-341

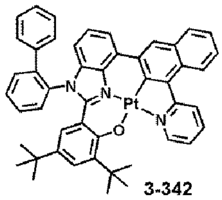
3-342

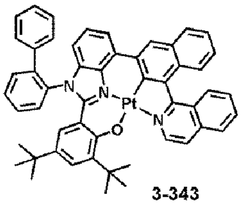
3-343

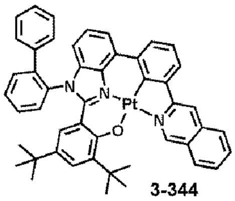
3-344

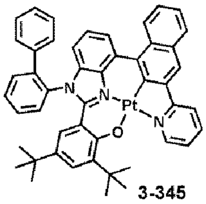
3-345

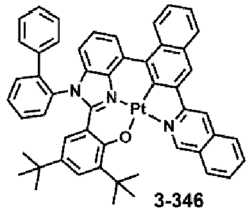
3-346

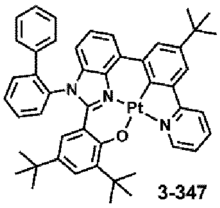
3-347

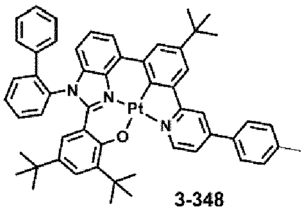
3-348

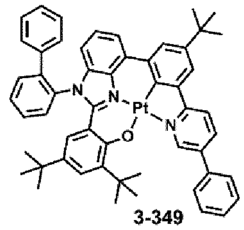
3-349

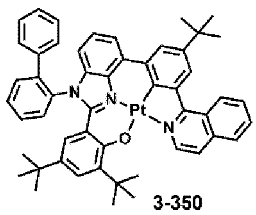
3-350

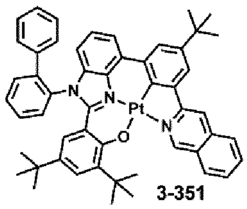
3-351

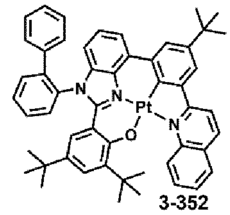
3-352

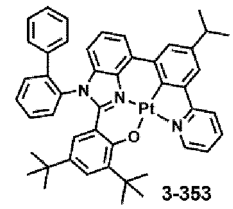
3-353

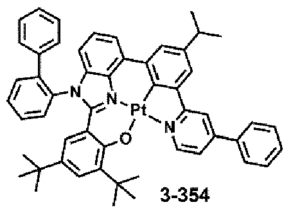
3-354

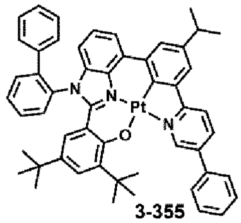
3-355

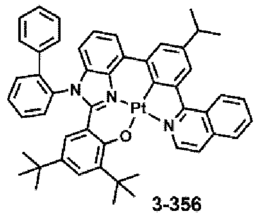
3-356

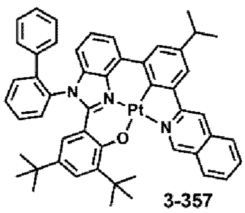
3-357

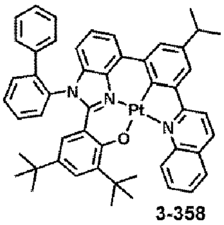
3-358

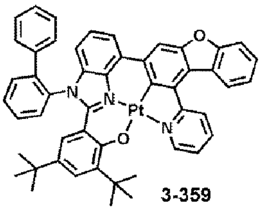
3-359

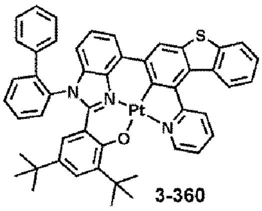
3-360

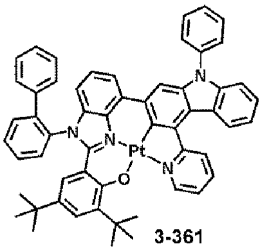
3-361

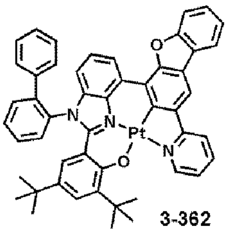
3-362

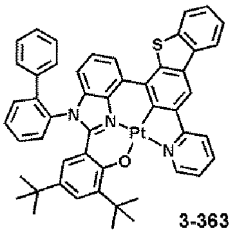
3-363

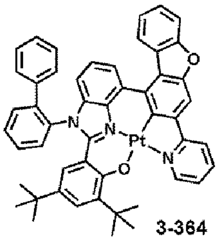
3-364

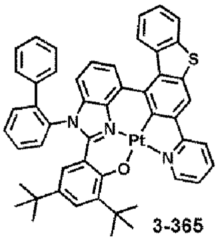
3-365

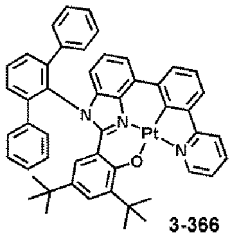
3-366

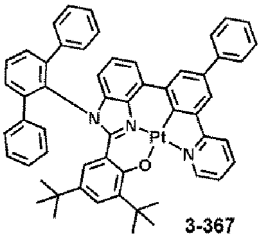
3-367

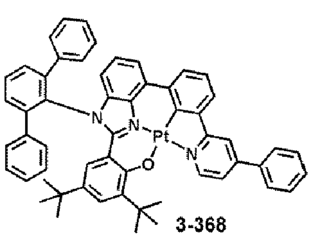
3-368

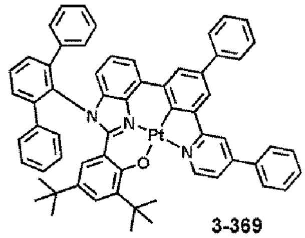
3-369

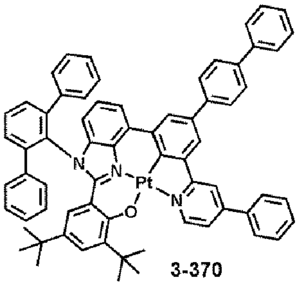
3-370

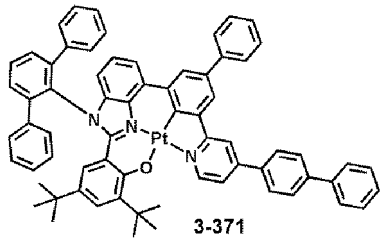
3-371

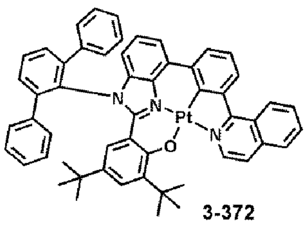
3-372

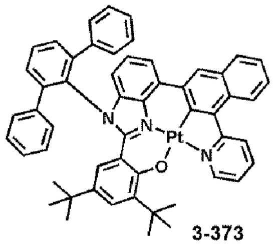
3-373

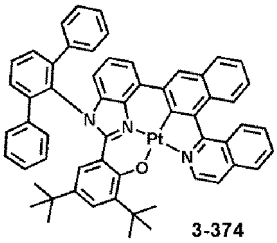
3-374

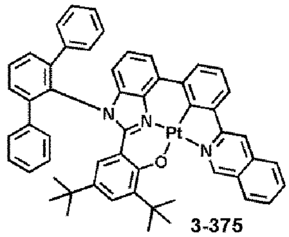
3-375

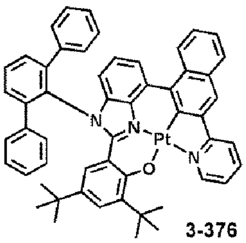
3-376

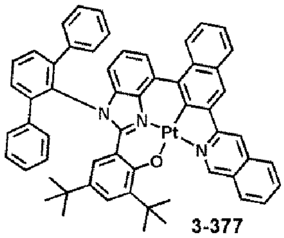
3-377

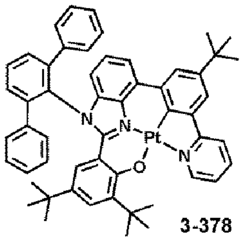
3-378

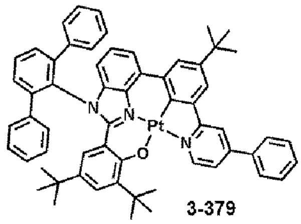
3-379

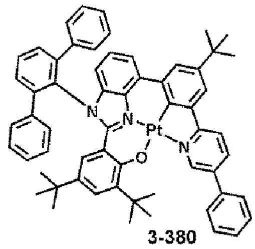
3-380

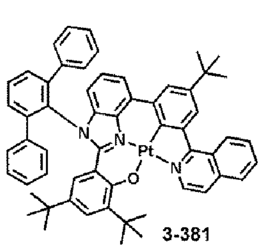
3-381

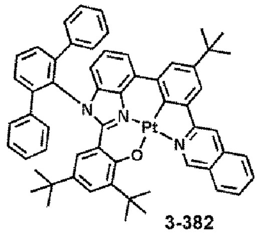
3-382

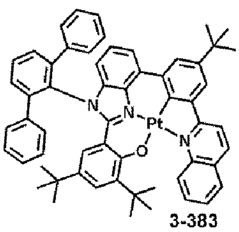
3-383

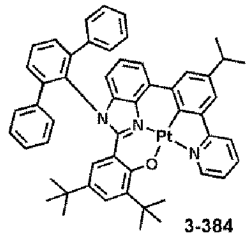
3-384

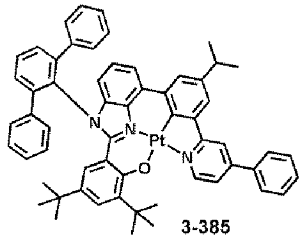
3-385

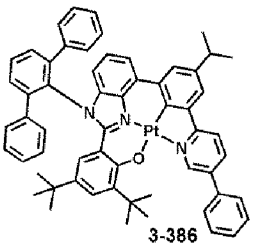
3-386

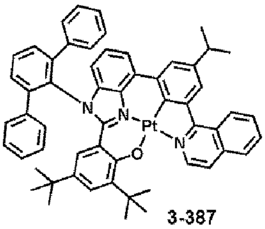
3-387

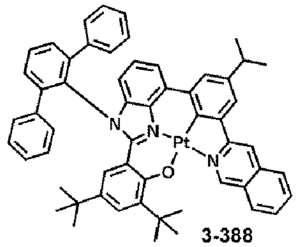
3-388

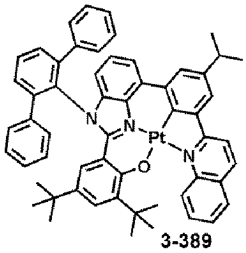
3-389

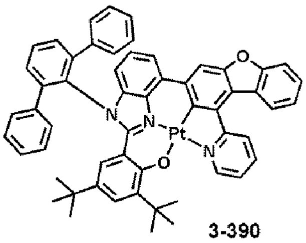
3-390

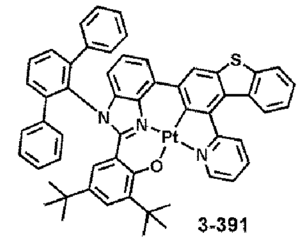
3-391

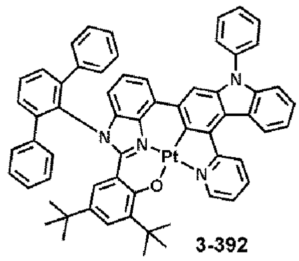
3-392

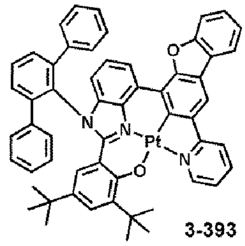
3-393

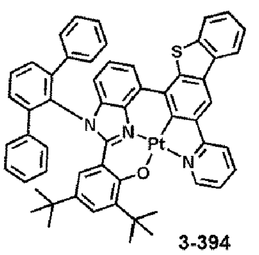
3-394

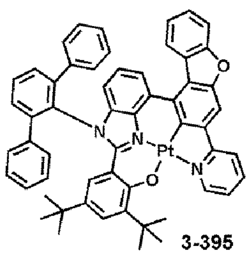
3-395

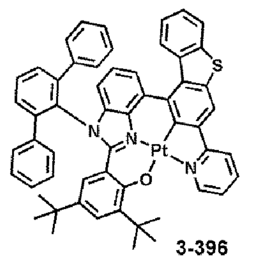
3-396

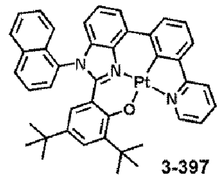
3-397

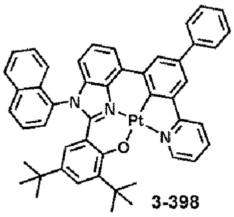
3-398

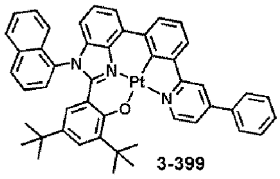
3-399

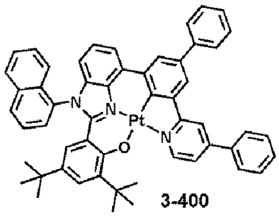
3-400

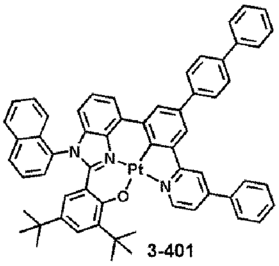
3-401

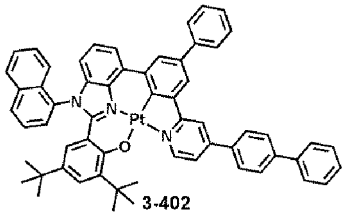
3-402

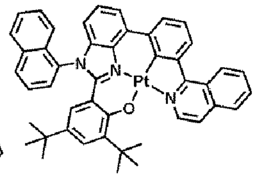
3-403

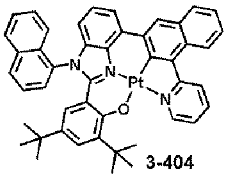
3-404

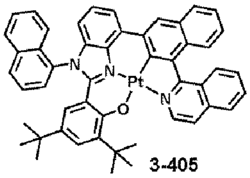
3-405

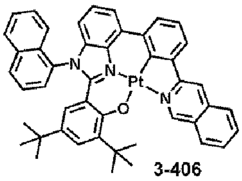
3-406

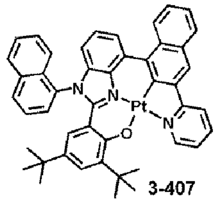
3-407

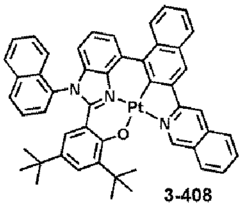
3-408

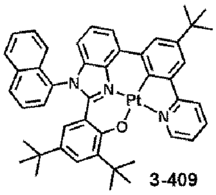
3-409

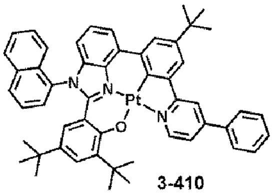
3-410

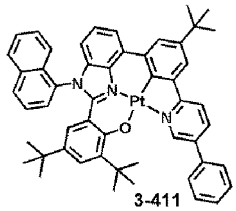
3-411

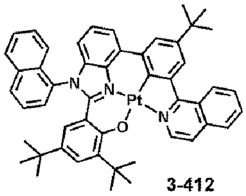
3-412

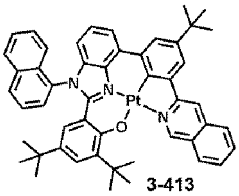
3-413

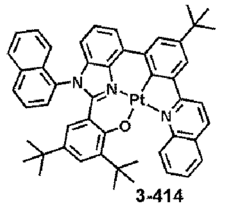
3-414

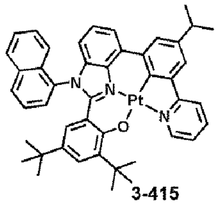
3-415

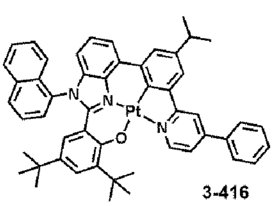
3-416

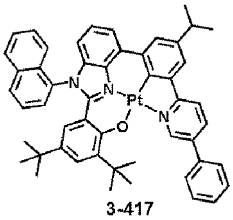
3-417

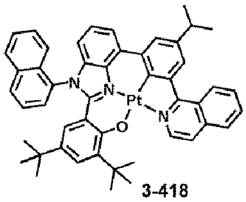
3-418

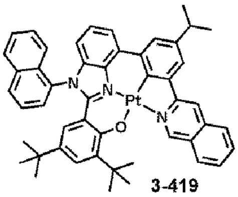
3-419

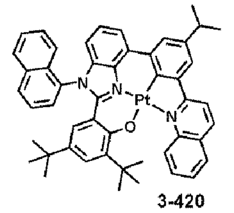
3-420

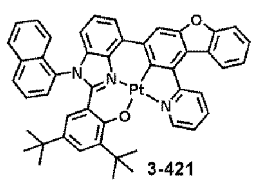
3-421
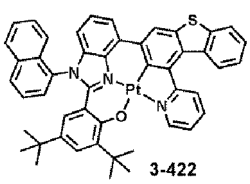
3-422
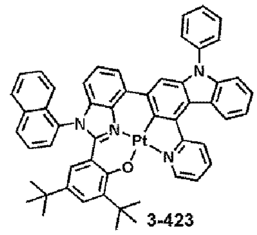
3-423
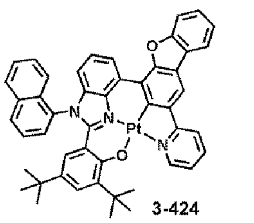
3-424

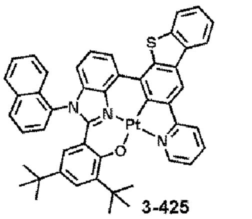
3-425
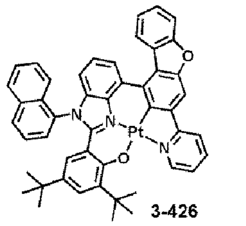
3-426
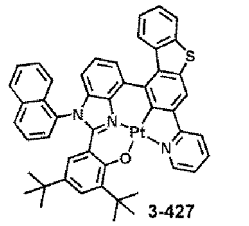
3-427
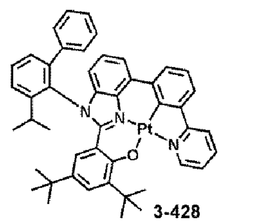
3-428

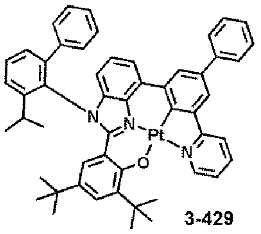
3-429
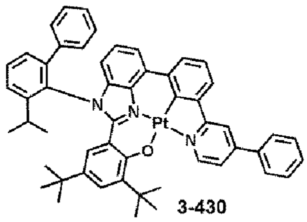
3-430
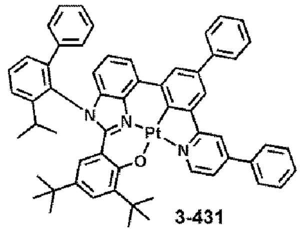
3-431

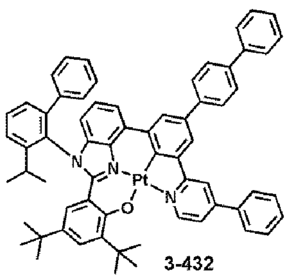
3-432
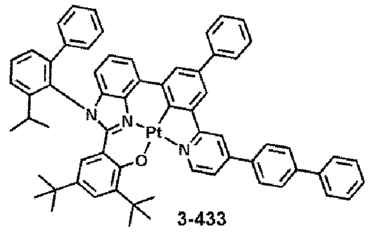
3-433
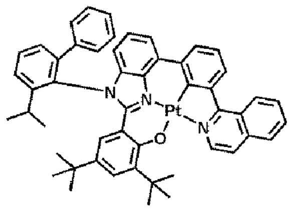
3-434

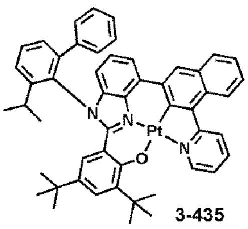
3-435
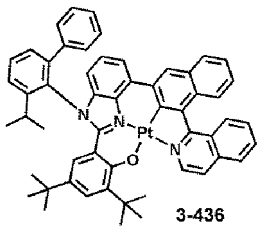
3-436
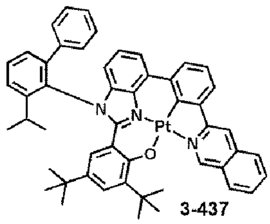
3-437
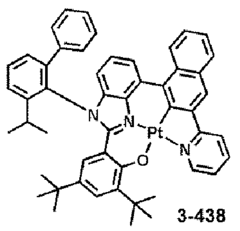
3-438

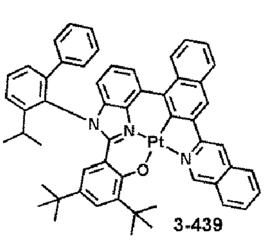
3-439
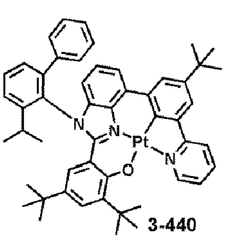
3-440
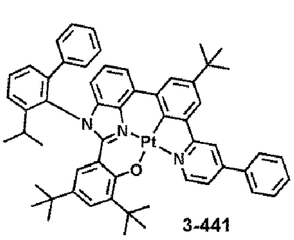
3-441
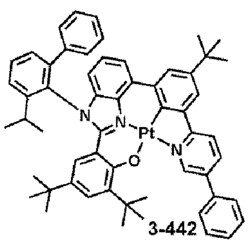
3-442

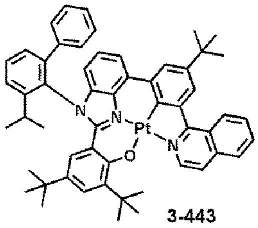
3-443
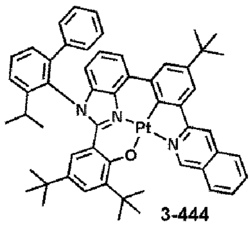
3-444
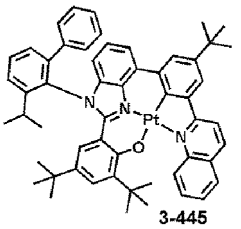
3-445
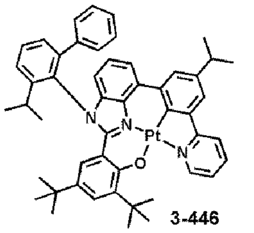
3-446

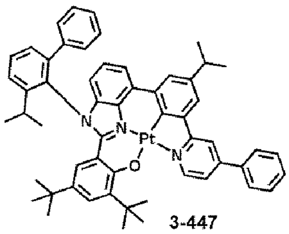
3-447

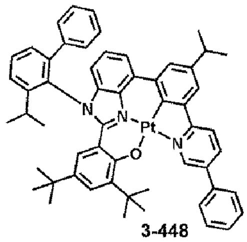
3-448

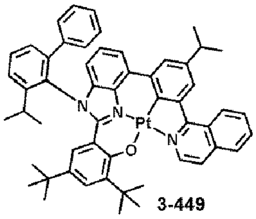
3-449

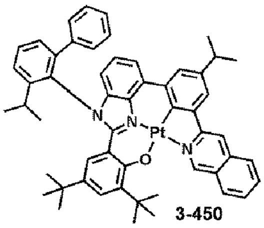
3-450

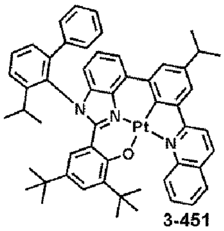
3-451

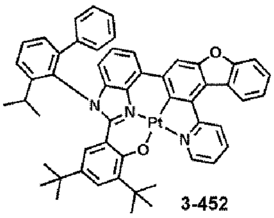
3-452

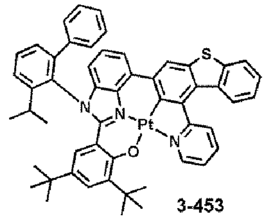
3-453

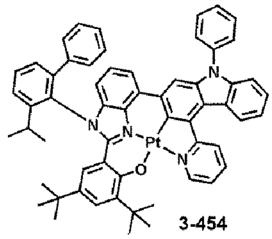
3-454

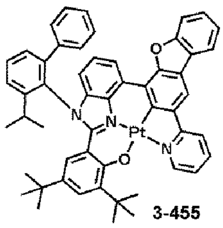
3-455

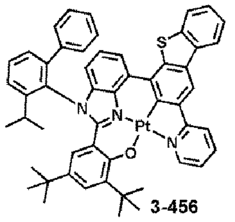
3-456

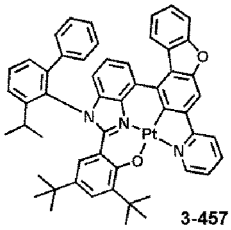
3-457

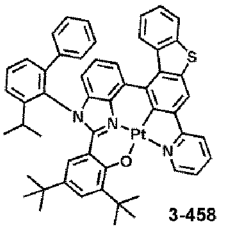
3-458

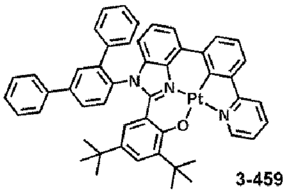
3-459

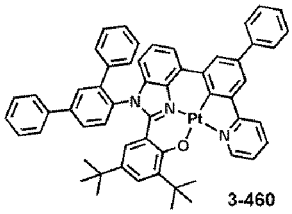
3-460

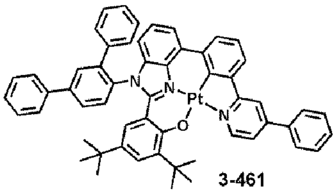
3-461

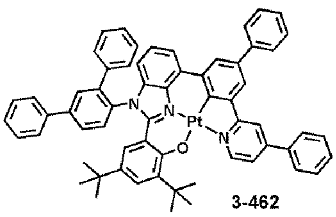
3-462

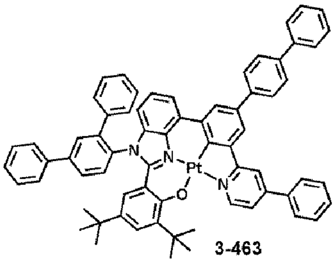
3-463

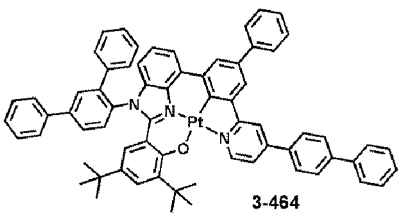
3-464

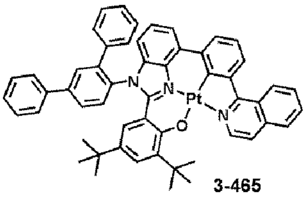
3-465

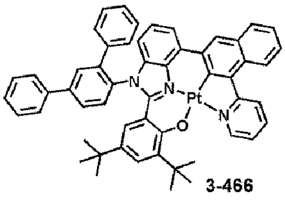
3-466

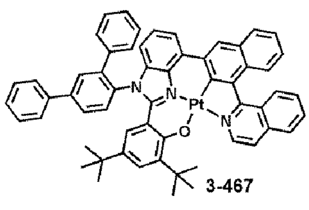
3-467

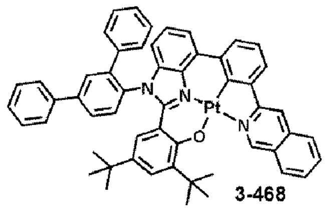
3-468

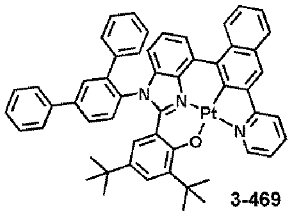
3-469

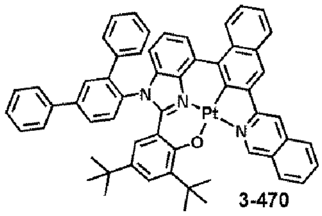
3-470

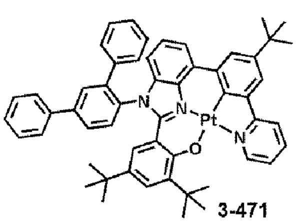
3-471

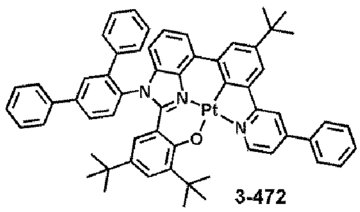
3-472

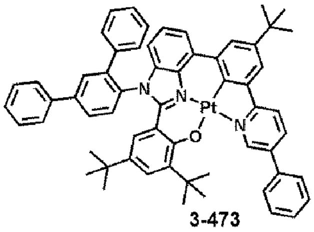
3-473

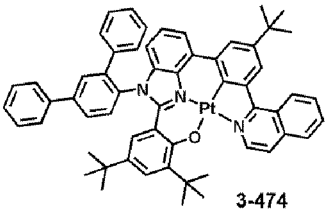
3-474

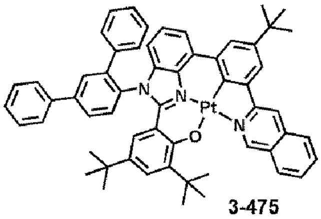
3-475

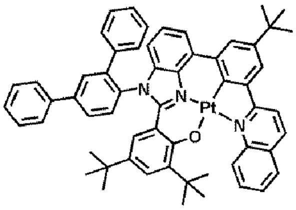
3-476

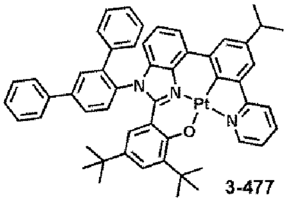
3-477

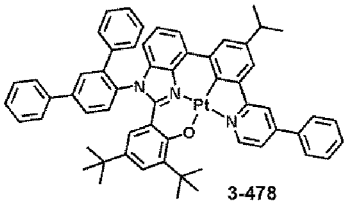
3-478

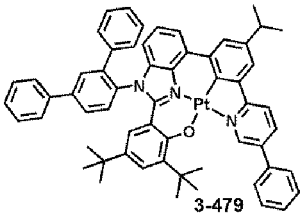
3-479

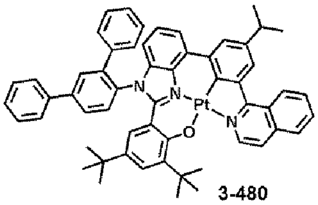
3-480

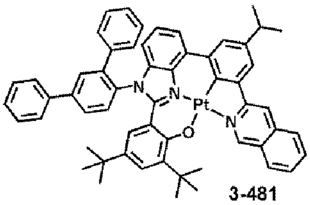
3-481

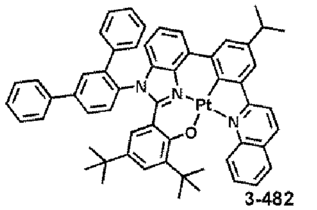
3-482

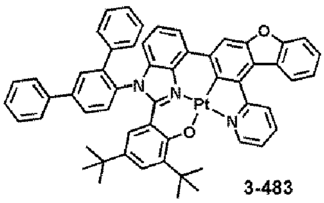
3-483

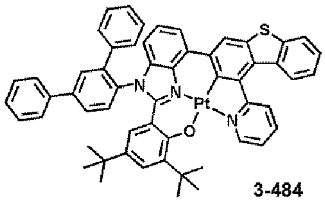
3-484

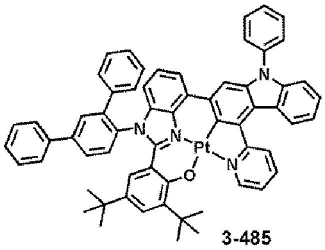
3-485

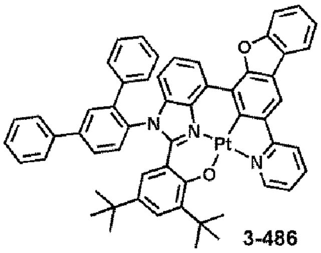
3-486

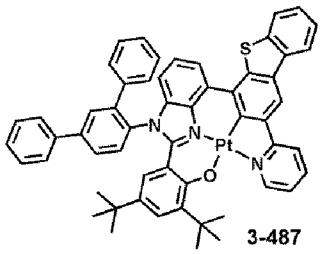
3-487

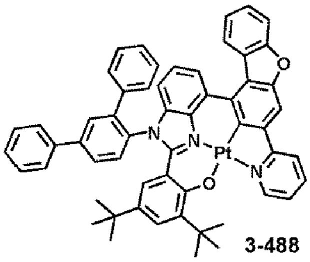
3-488

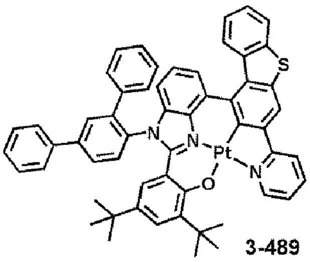
3-489

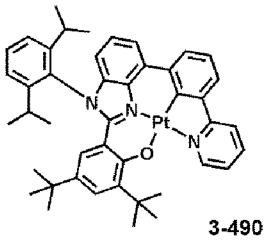
3-490

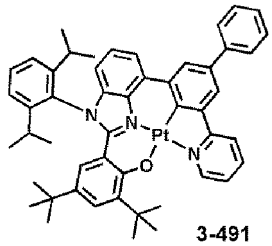
3-491

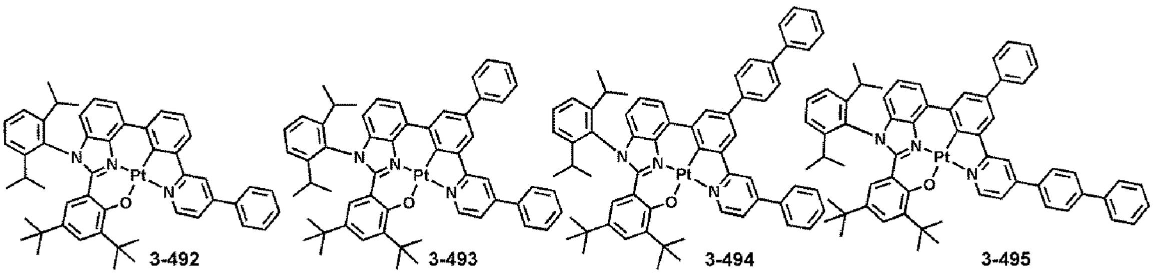
3-492

3-493

3-494

3-495

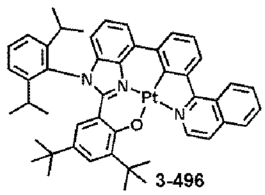
3-496

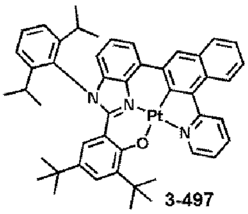
3-497

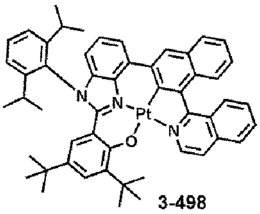
3-498

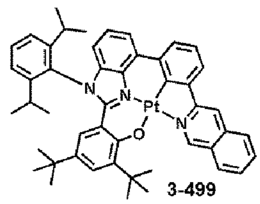
3-499

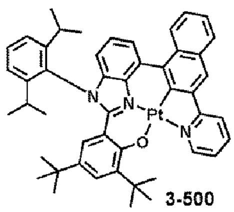
3-500

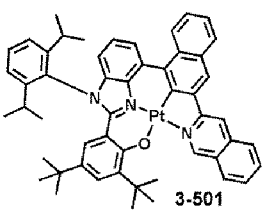
3-501

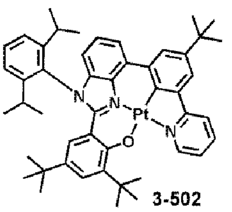
3-502

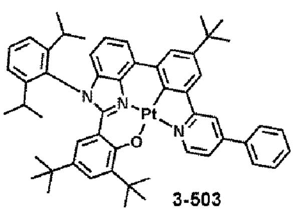
3-503

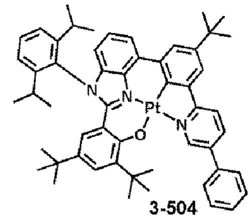
3-504

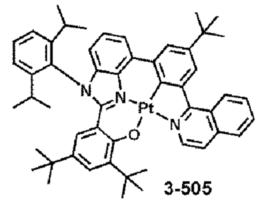
3-505

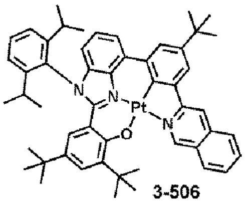
3-506

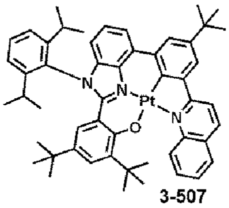
3-507

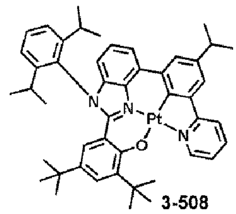
3-508

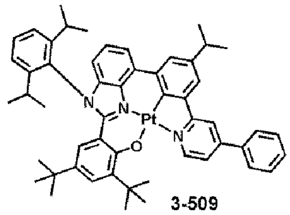
3-509

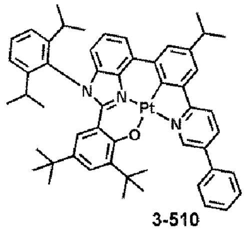
3-510

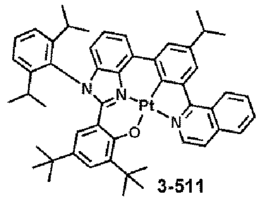
3-511

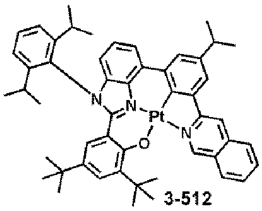
3-512

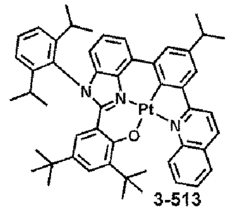
3-513

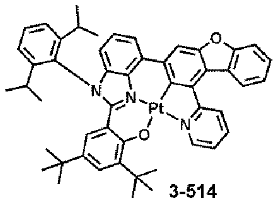
3-514

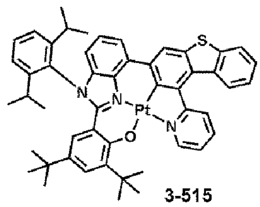
3-515

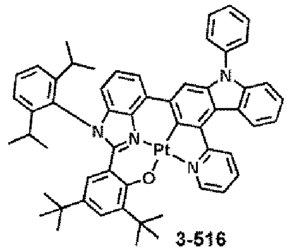
3-516

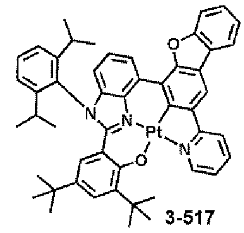
3-517

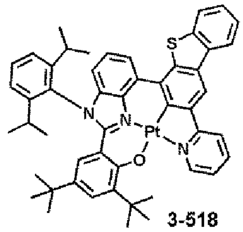
3-518

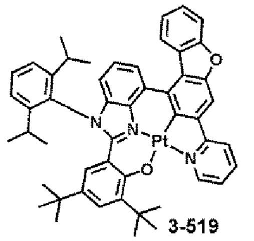
3-519

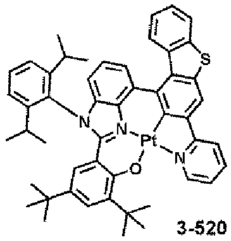
3-520

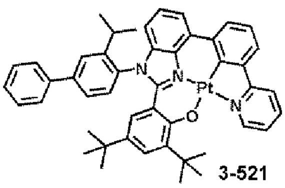
3-521

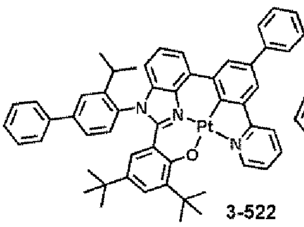
3-522

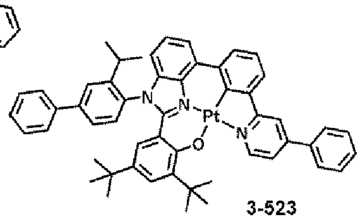
3-523

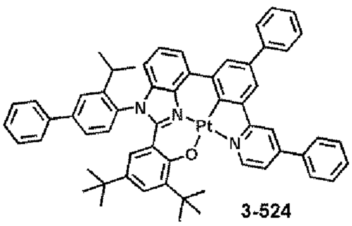
3-524

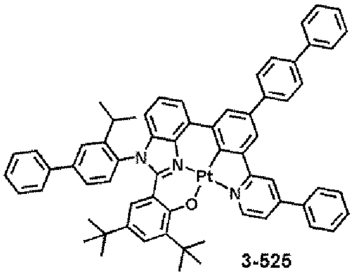
3-525

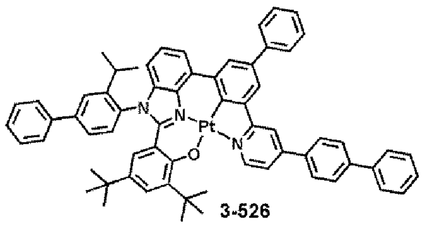
3-526

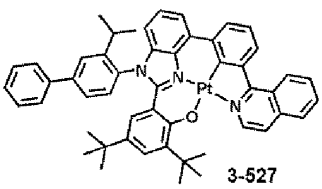
3-527

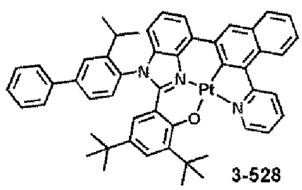
3-528

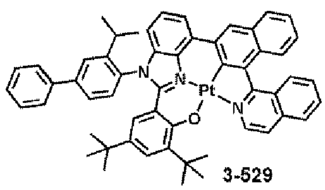
3-529

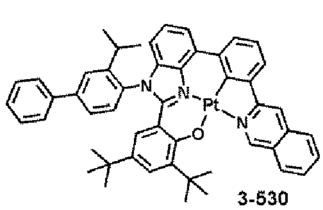
3-530

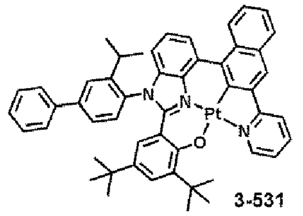
3-531

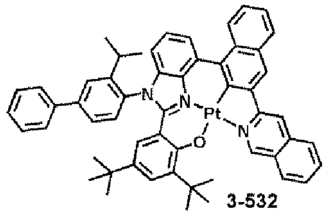
3-532

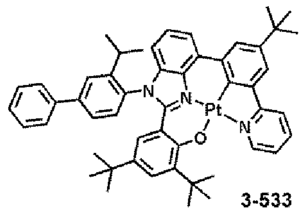
3-533

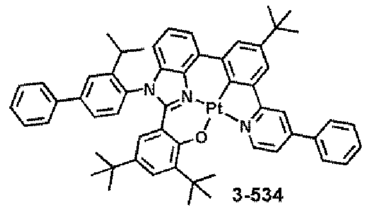
3-534

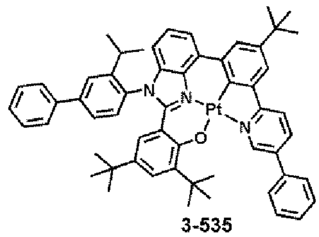
3-535

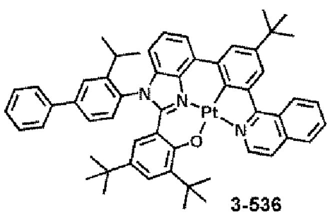
3-536

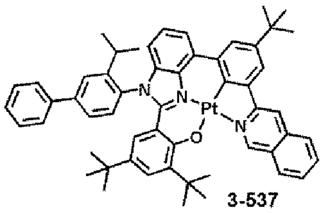
3-537

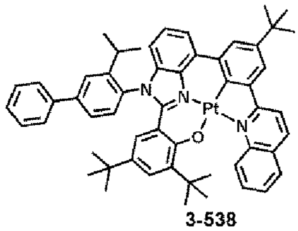
3-538

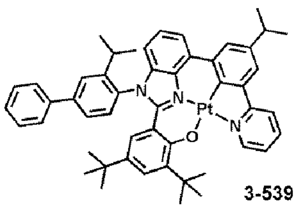
3-539

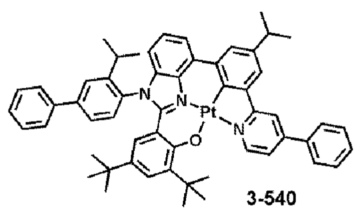
3-540

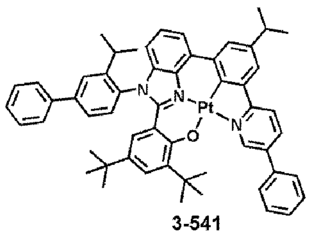
3-541

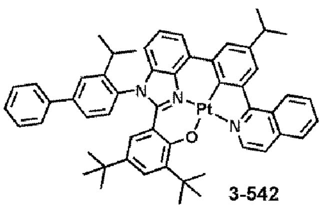
3-542

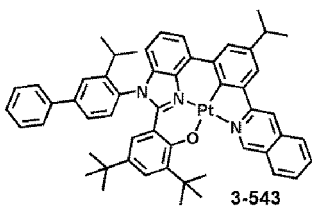
3-543

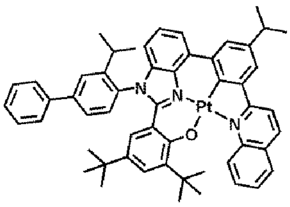
3-544

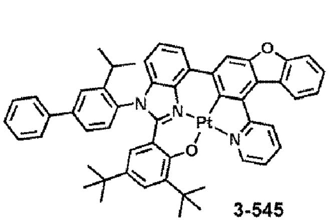
3-545

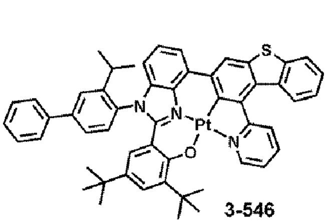
3-546

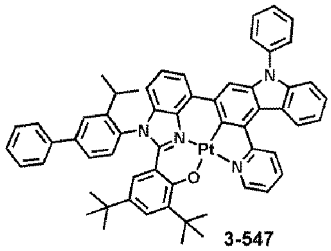
3-547

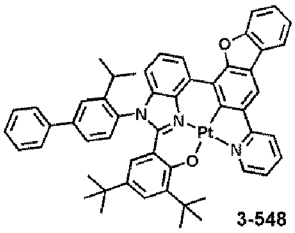
3-548

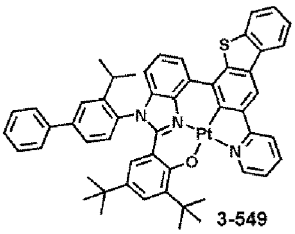
3-549

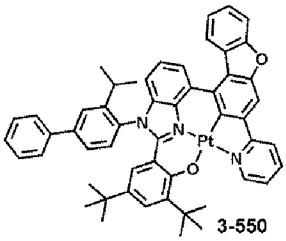
3-550

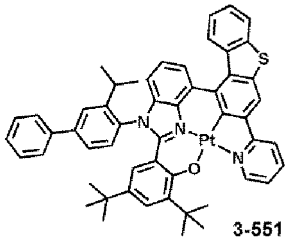
3-551

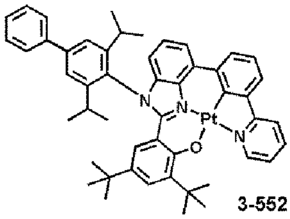
3-552

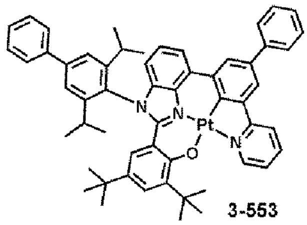
3-553

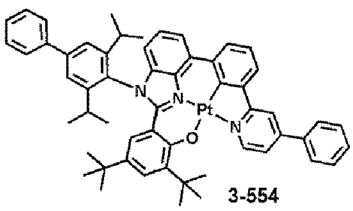
3-554

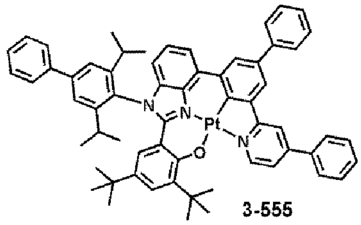
3-555

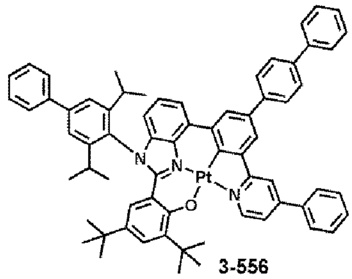
3-556

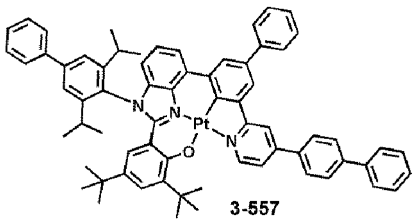
3-557

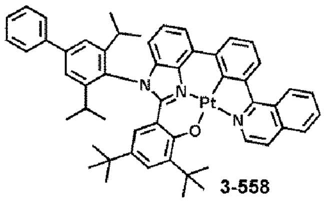
3-558

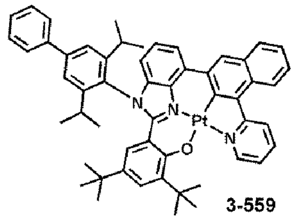
3-559

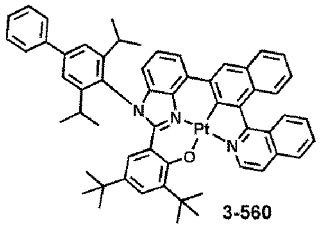
3-560

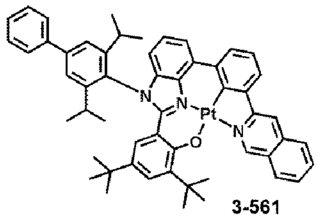
3-561

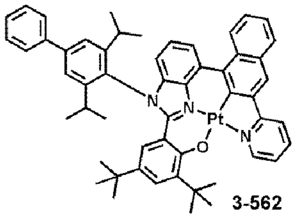
3-562

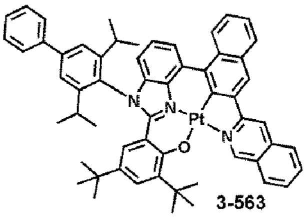
3-563

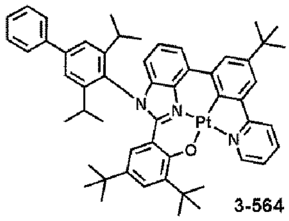
3-564

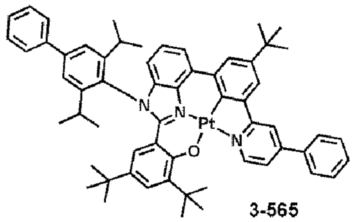
3-565

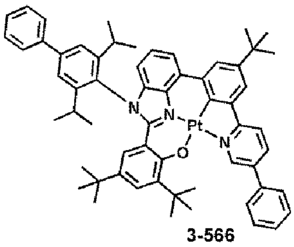
3-566

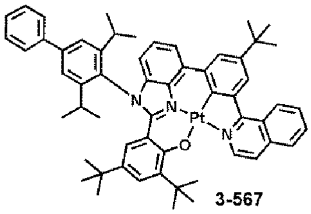
3-567

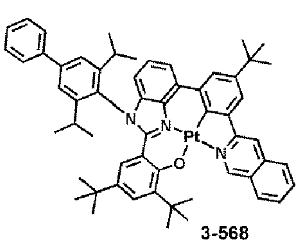
3-568

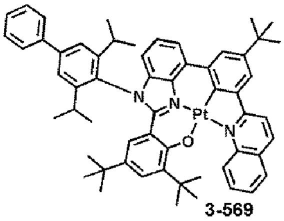
3-569

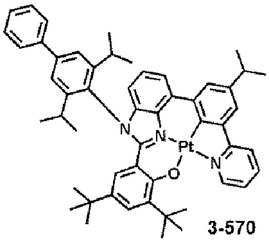
3-570

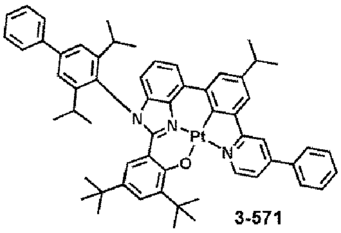
3-571

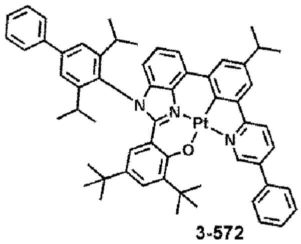
3-572

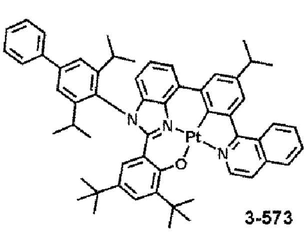
3-573

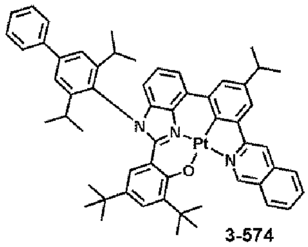
3-574

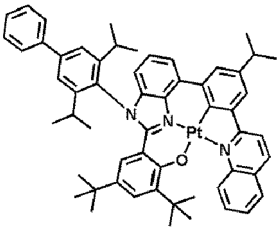
3-575

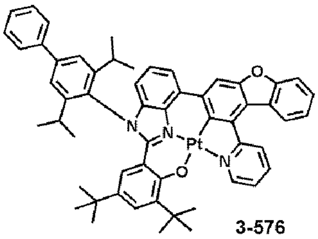
3-576

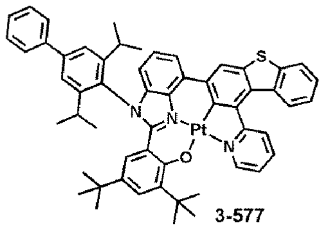
3-577

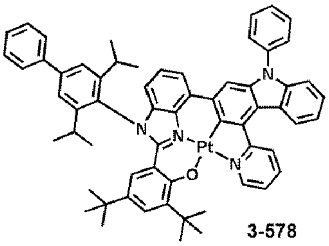
3-578

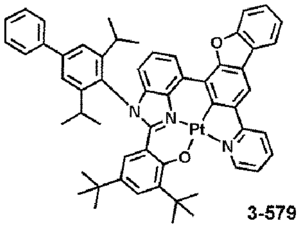
3-579

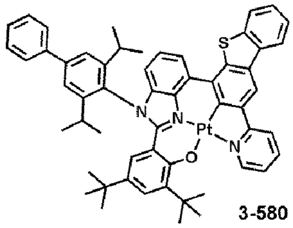
3-580

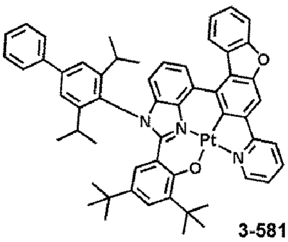
3-581

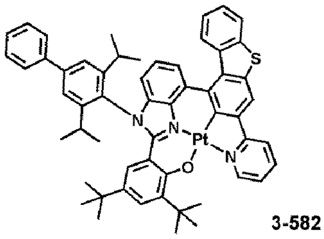
3-582

Group 1-2

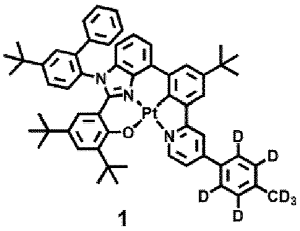
1

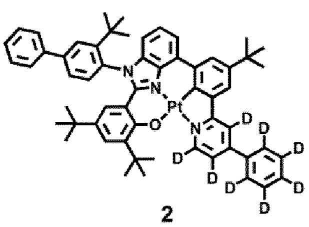
2

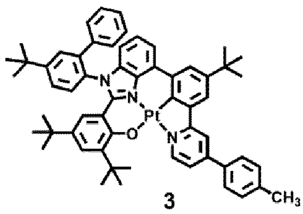
3

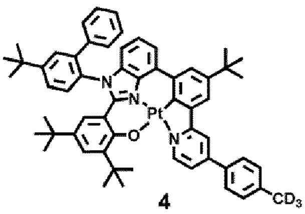
4

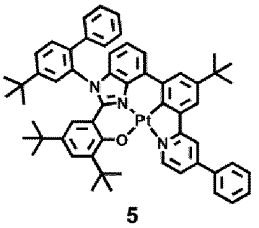
5

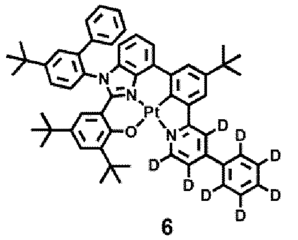
6

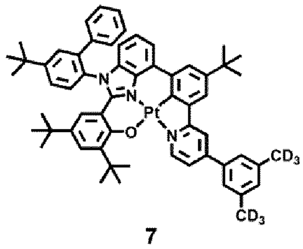
7

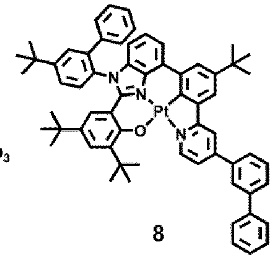
8

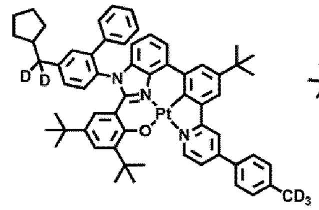
9

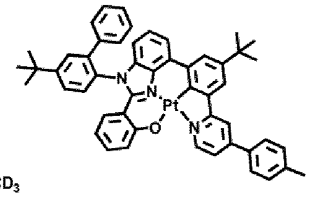
10

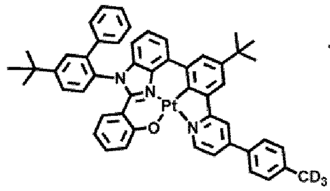
11

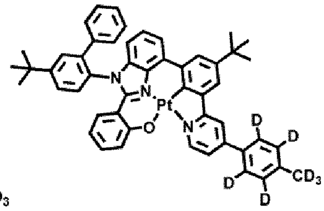
12

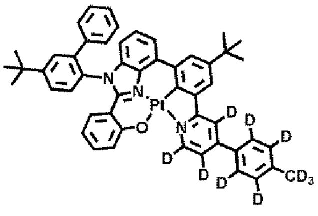
13

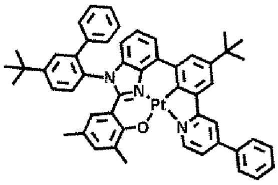
14

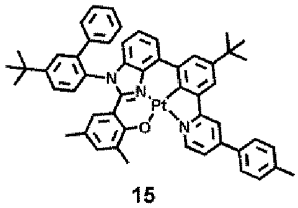
15

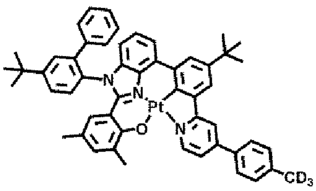
16

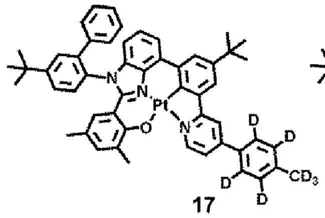
17

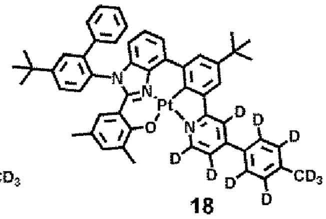
18

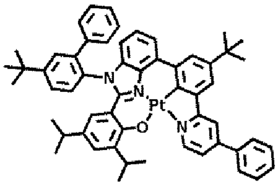
19

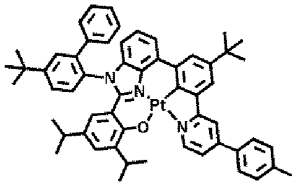
20

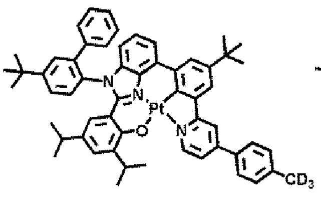
21

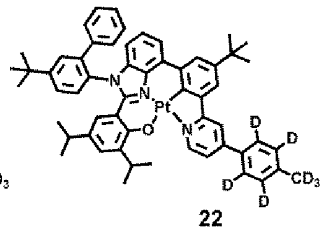
22

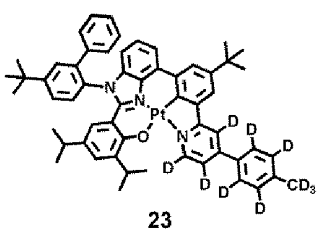
23

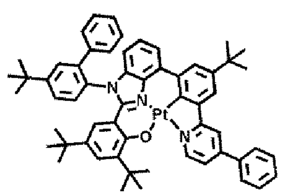
24

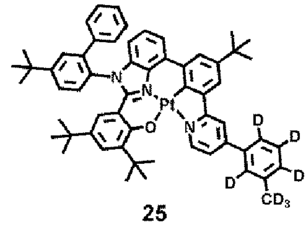

25

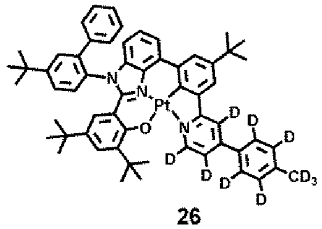

26

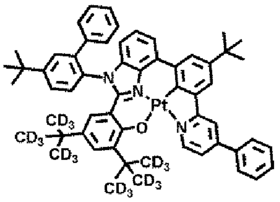

27

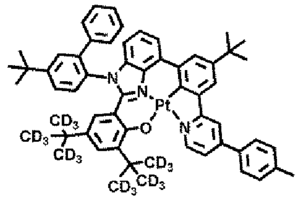

28

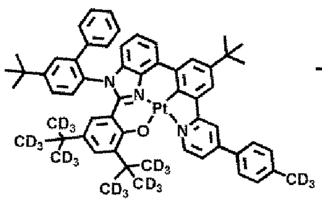

29

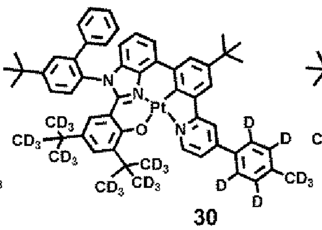

30

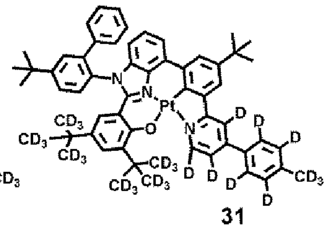

31

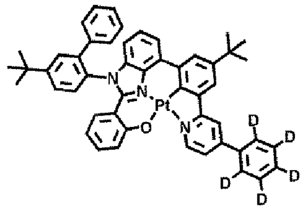

32

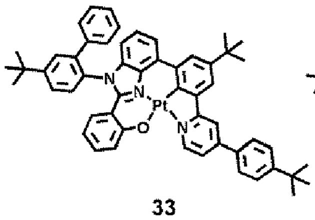

33

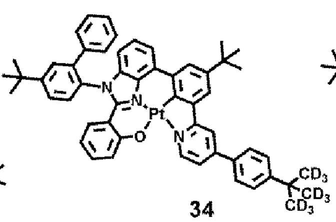

34

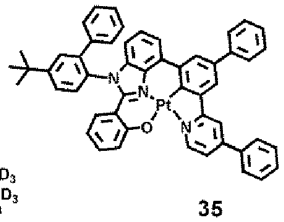

35

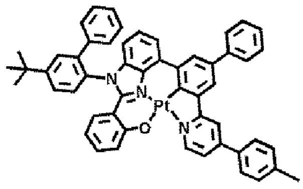

36

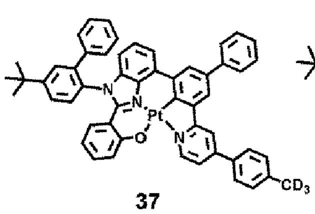

37

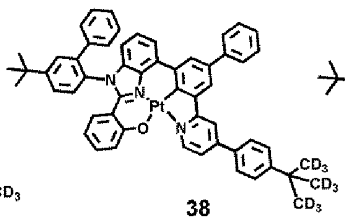

38

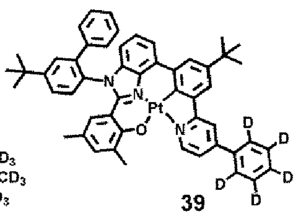

39

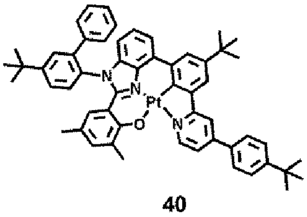

40

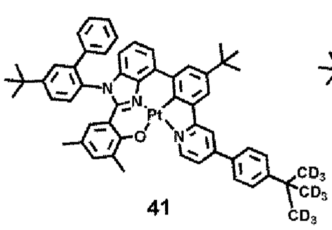

41

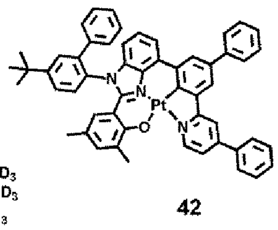

42

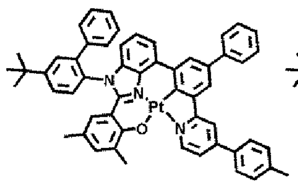

43

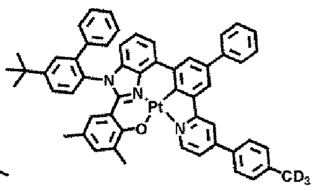

44

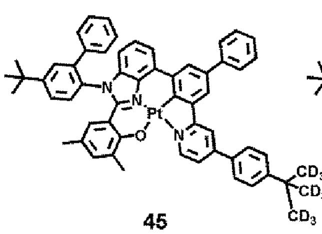

45

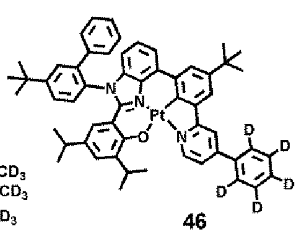

46

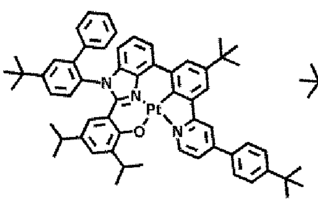

47

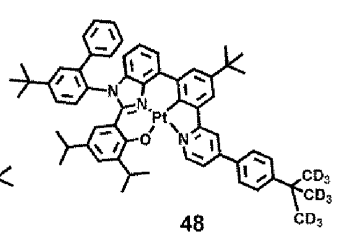

48

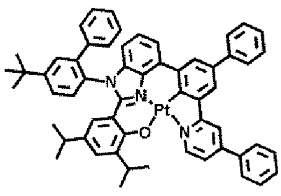
**49**

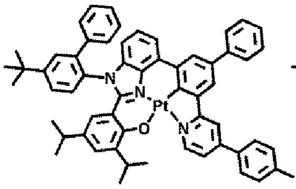
**50**

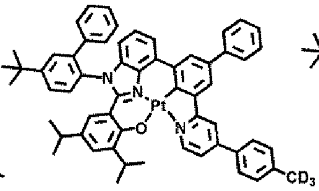
**51**

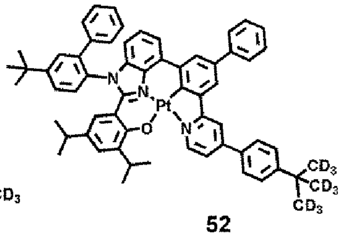
**52**

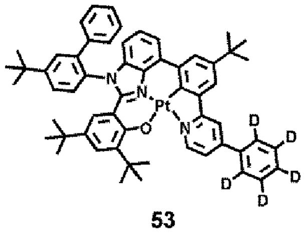
**53**

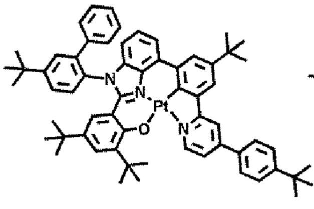
**54**

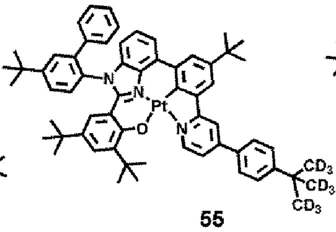
**55**

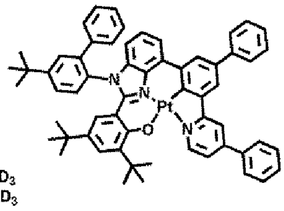
**56**

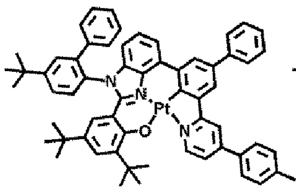
**57**

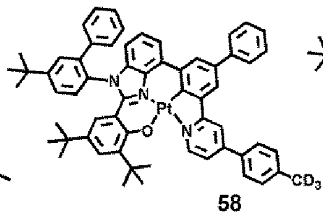
**58**

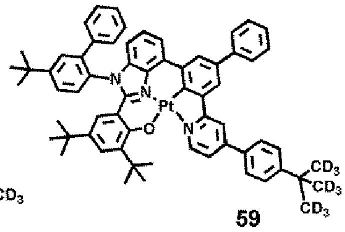
**59**

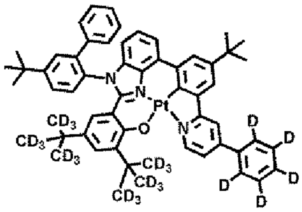
**60**

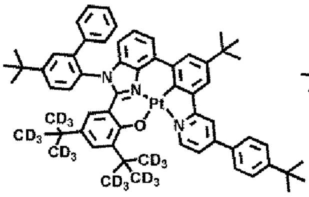
**61**

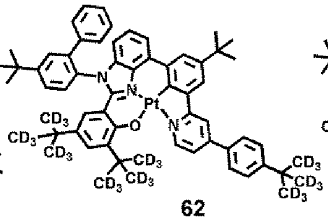
**62**

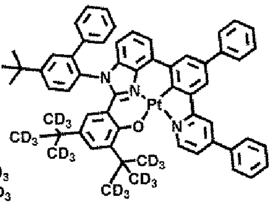
**63**

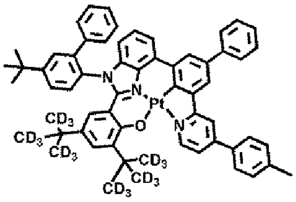
**64**

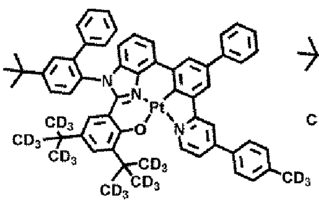
**65**

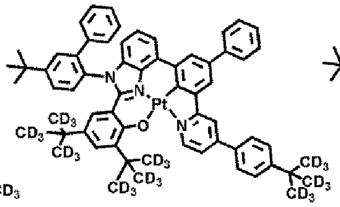
**66**

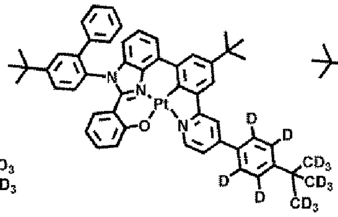
**67**

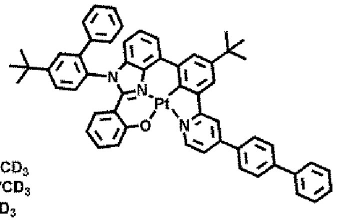
**68**

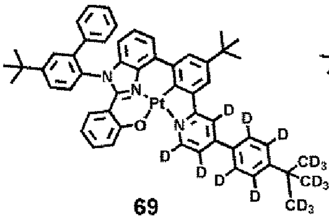
**69**

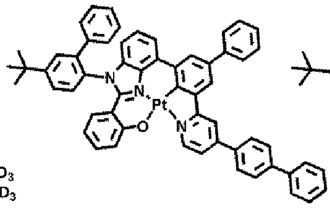
**70**

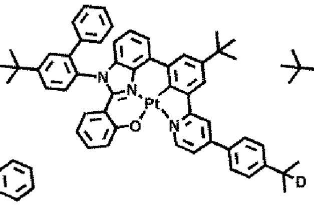
**71**

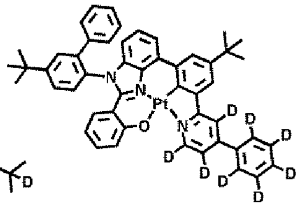
**72**

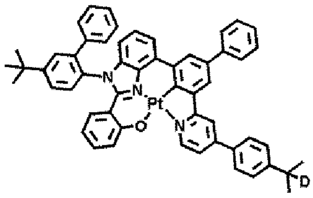
73
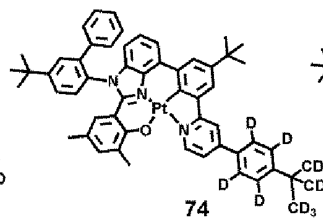
74
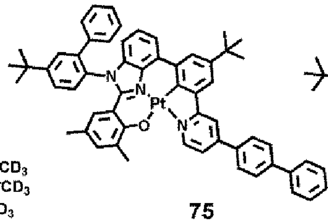
75
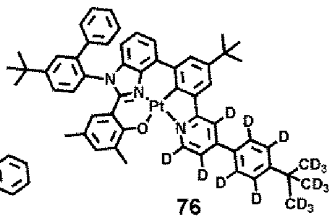
76

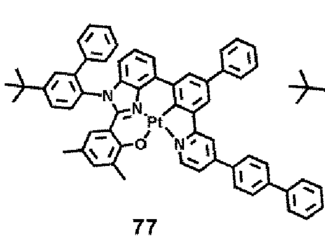
77
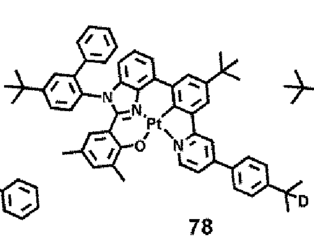
78
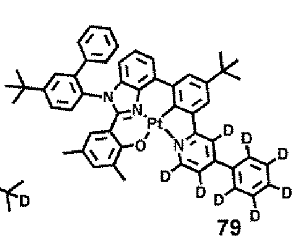
79
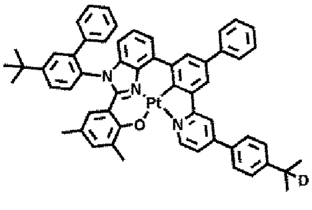
80

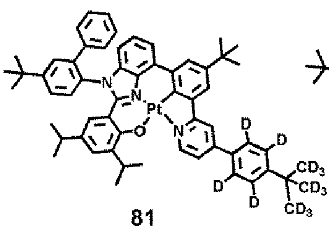
81
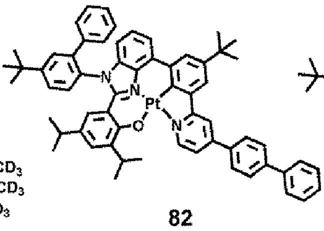
82
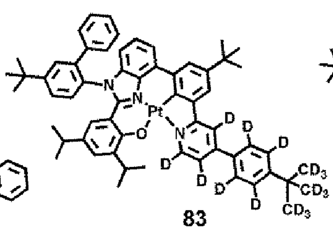
83
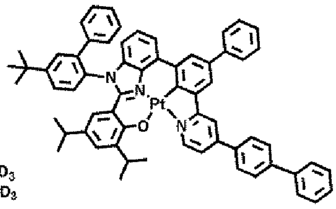
84

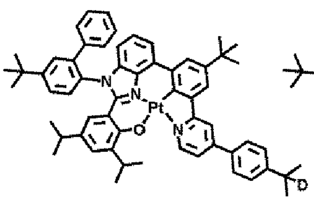
85
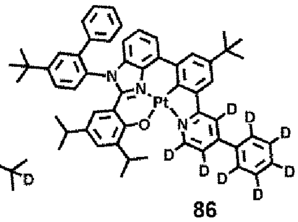
86
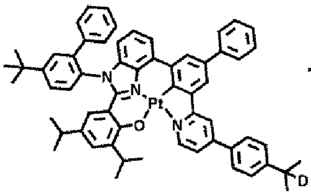
87
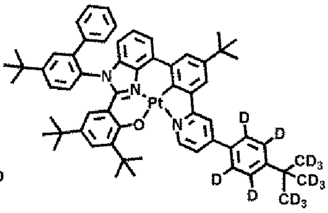
88

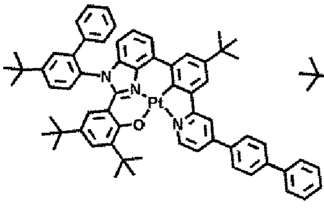
89
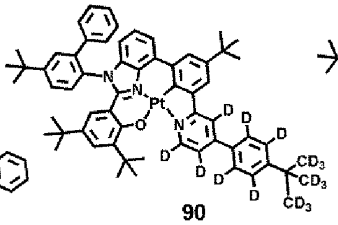
90
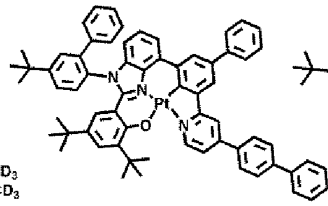
91
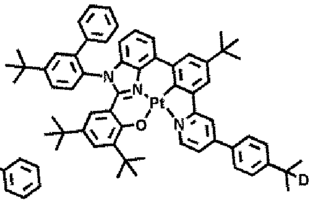
92

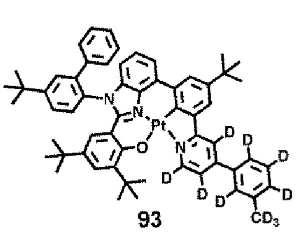
93
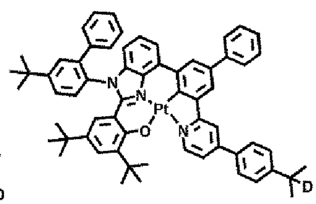
94
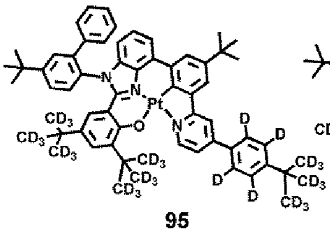
95
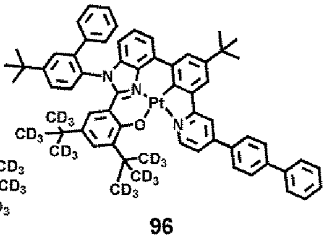
96

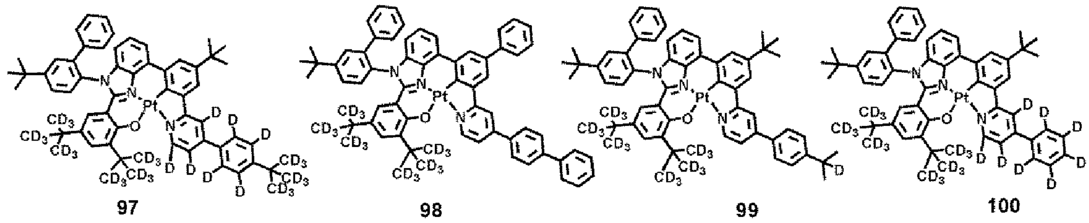

97 98 99 100

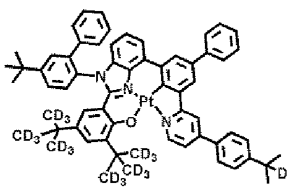

101

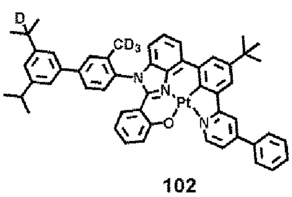

102

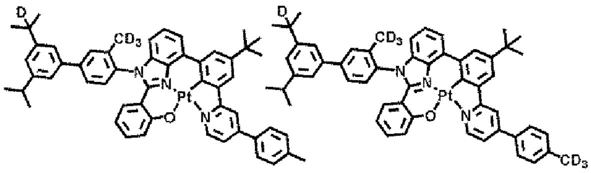

103 104

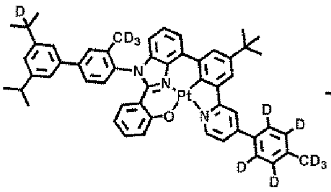

105

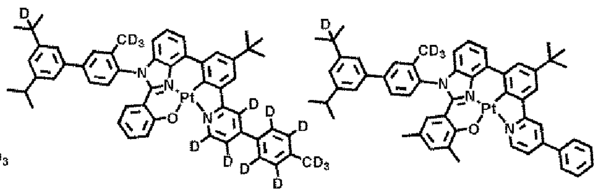

106 107

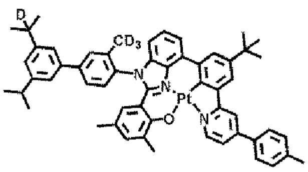

108

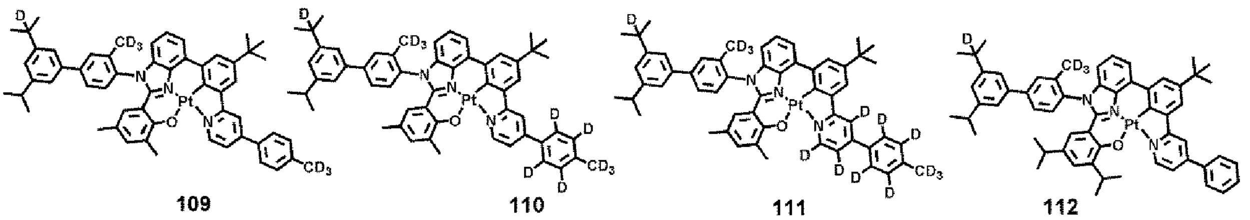

109 110 111 112

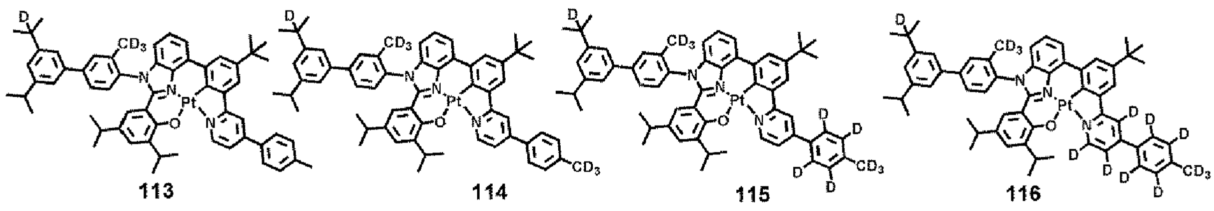

113 114 115 116

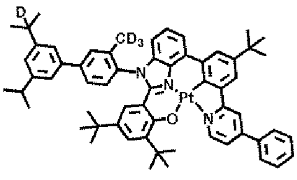

117

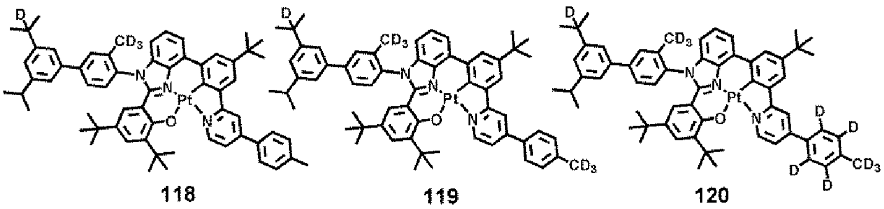

118 119 120

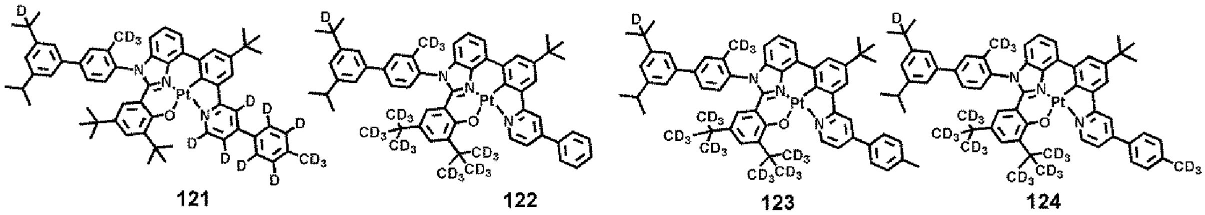

121 122 123 124

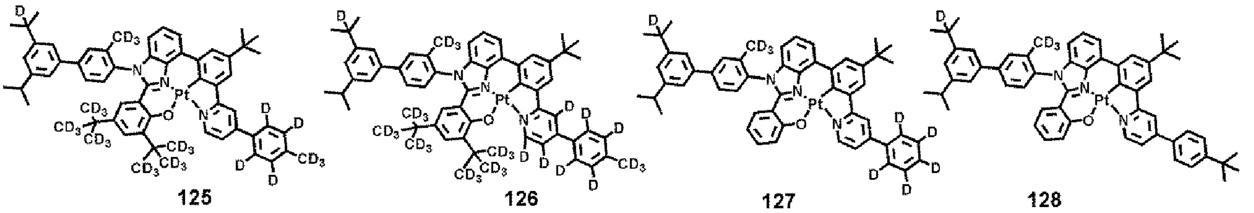

125 126 127 128

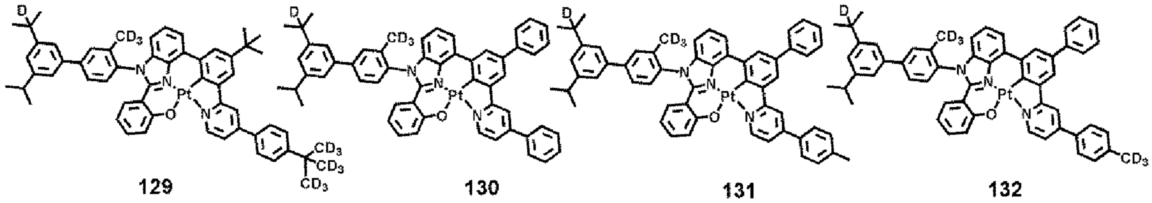

129 130 131 132

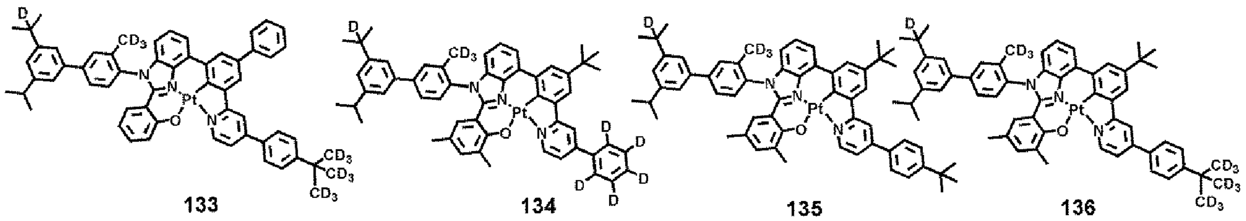

133 134 135 136

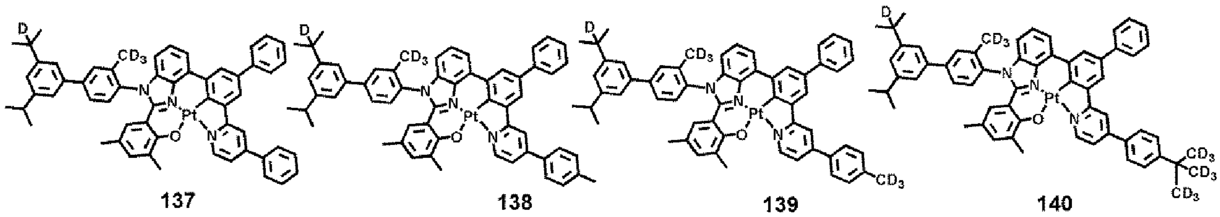

137 138 139 140

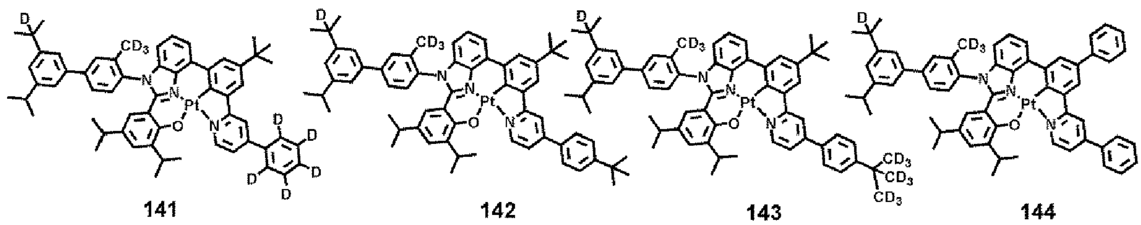

141 142 143 144

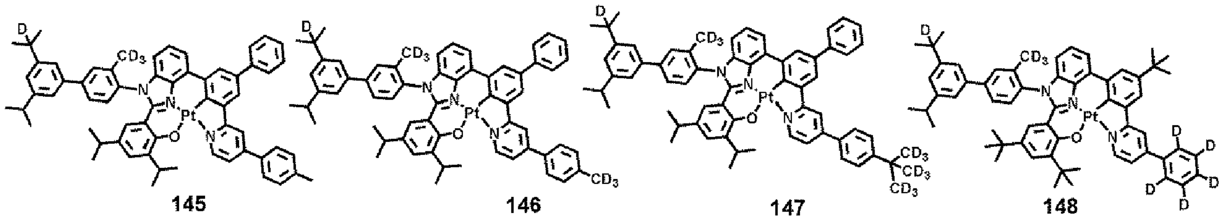

145 146 147 148

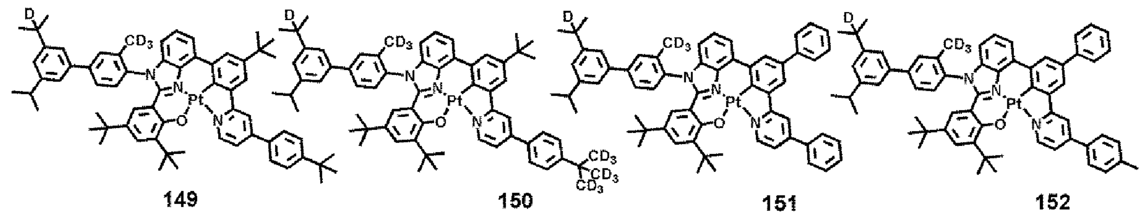

149 150 151 152

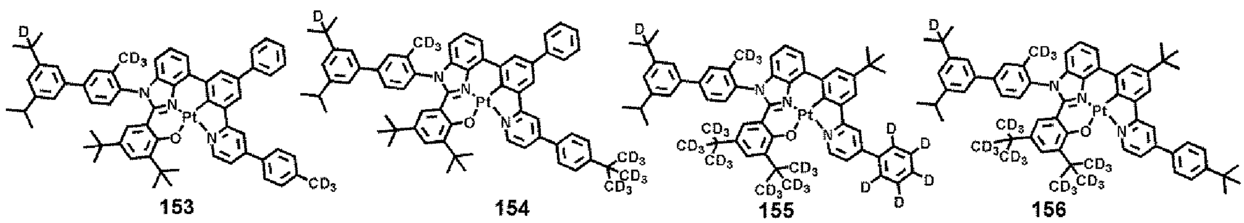

153 154 155 156

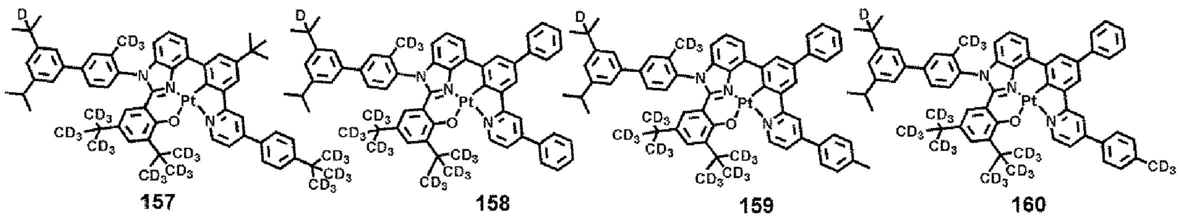

157 158 159 160

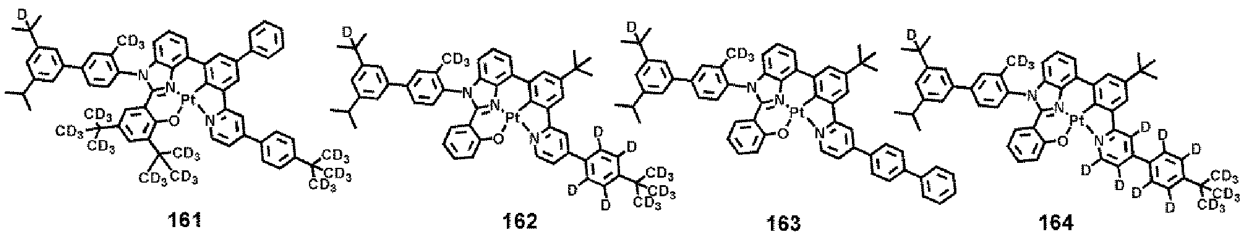

161 162 163 164

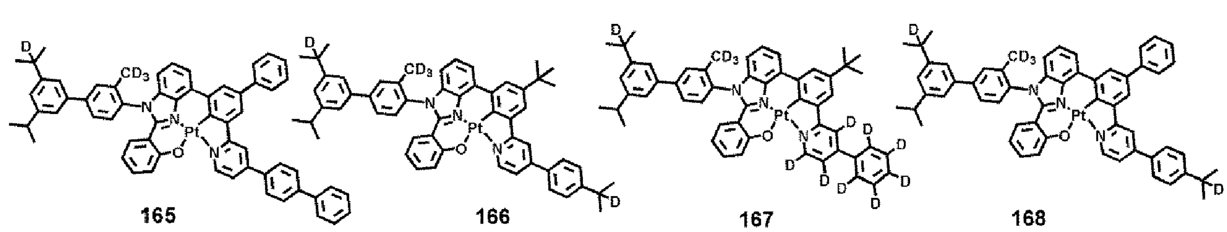

165 166 167 168

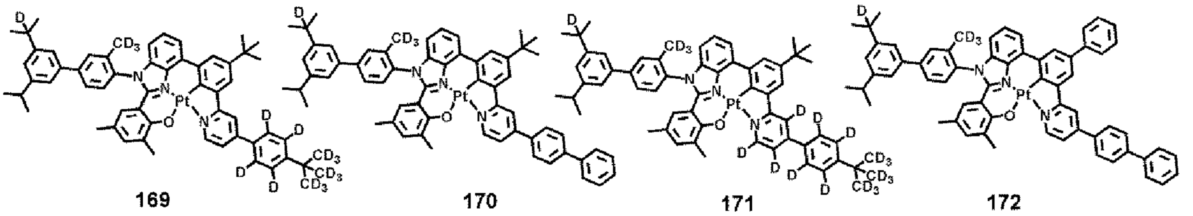

169 170 171 172

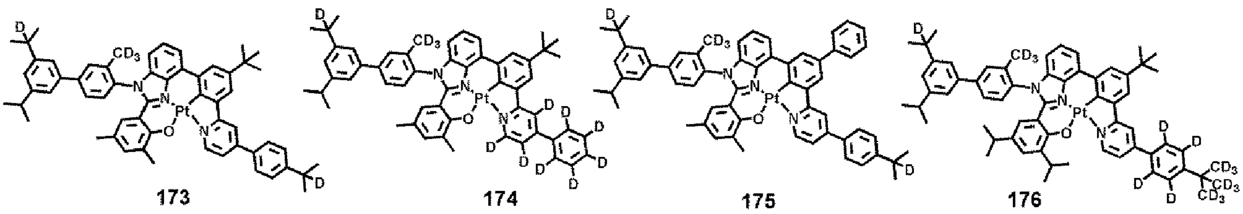

173 174 175 176

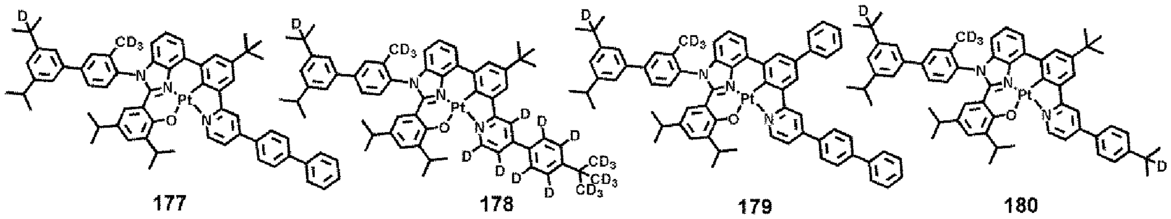

177 178 179 180

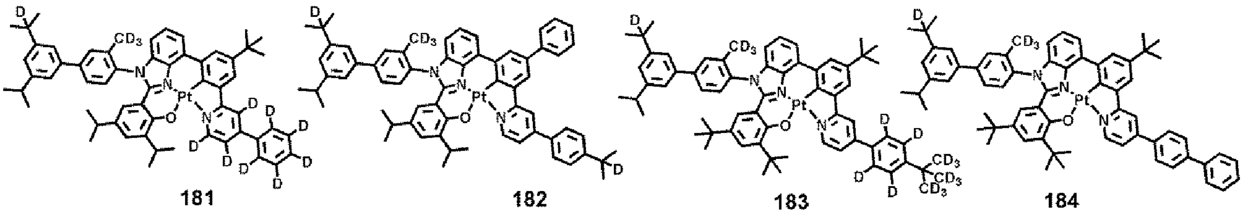

181 182 183 184

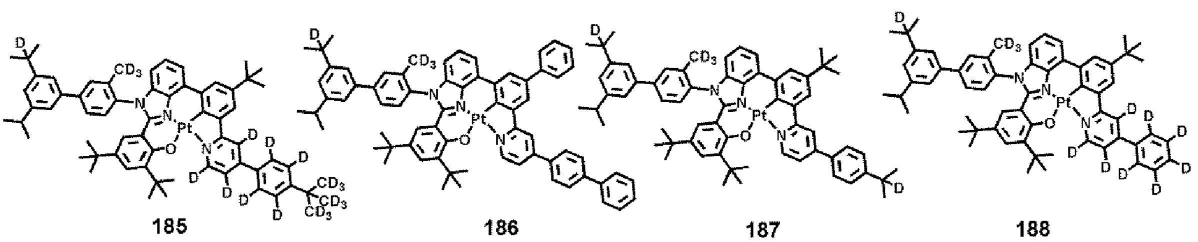

185 186 187 188

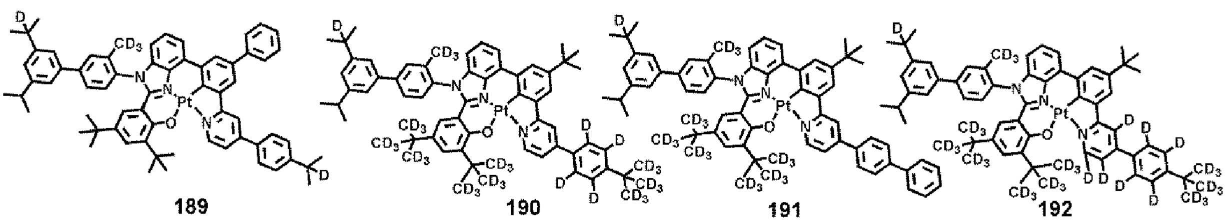

189 190 191 192

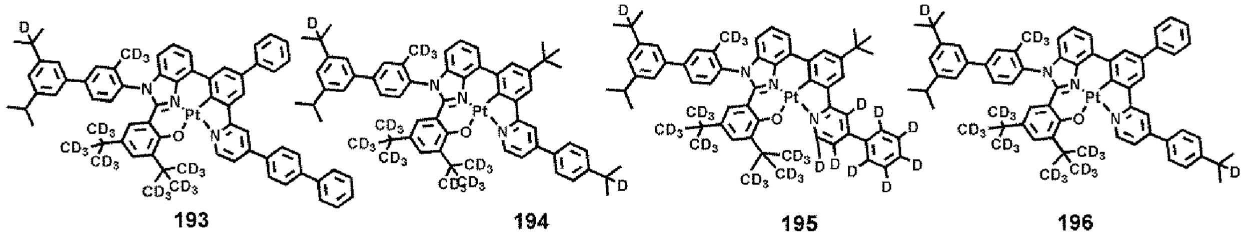

193 194 195 196

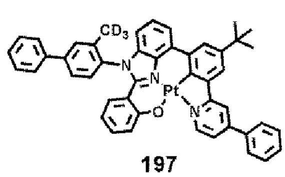

197

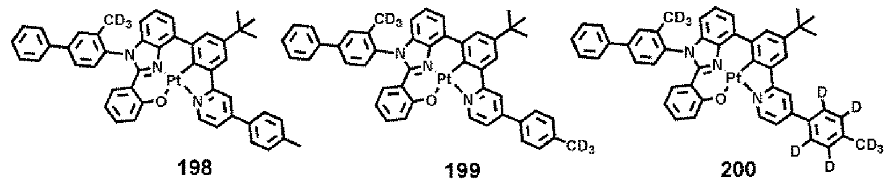

198 199 200

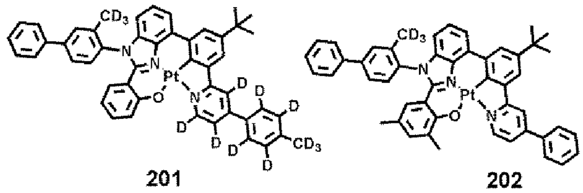

201 202

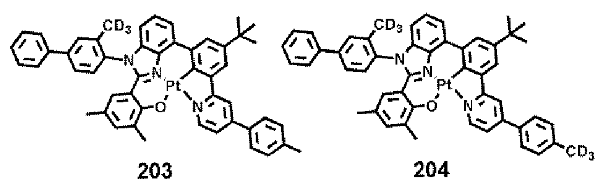

203 204

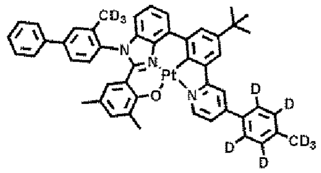

205

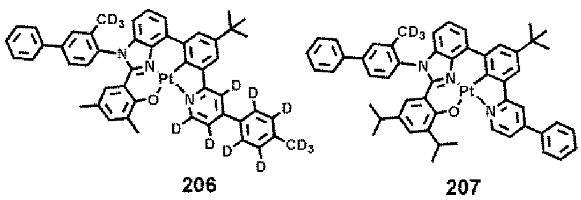

206 207

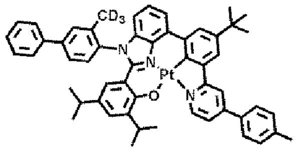

208

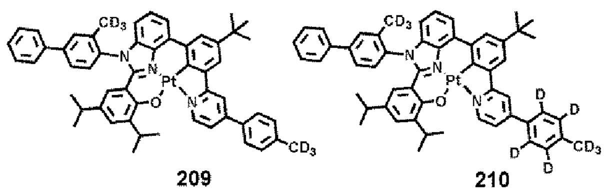

209 210

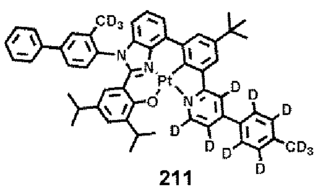

211

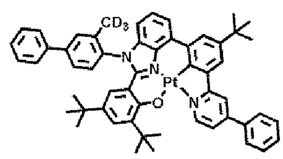

212

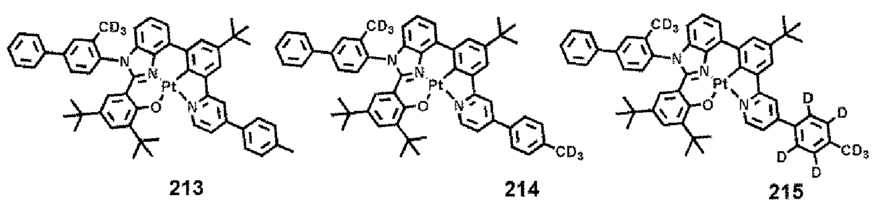

213 214 215

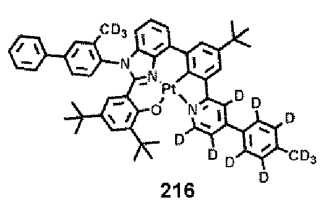

216

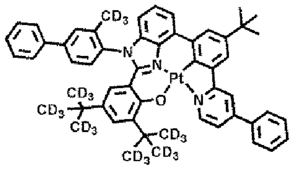

217

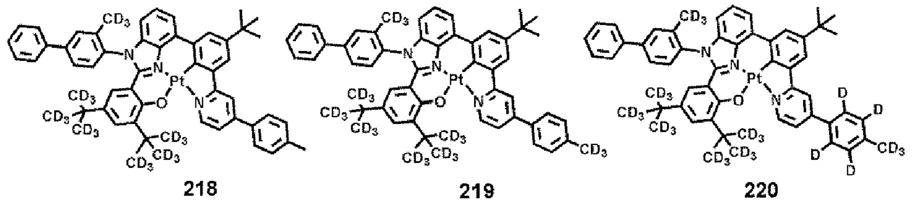

218 219 220

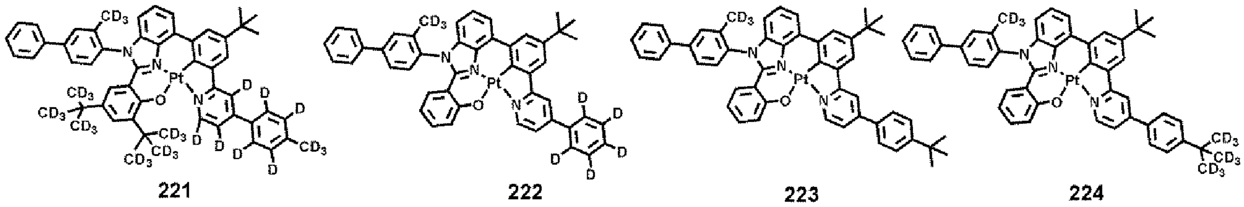

221 222 223 224

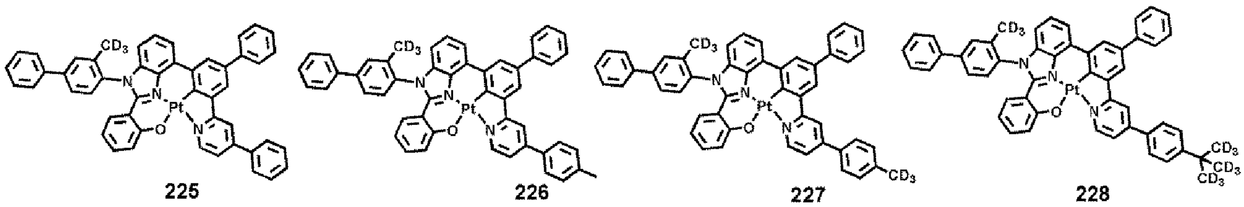

225 226 227 228

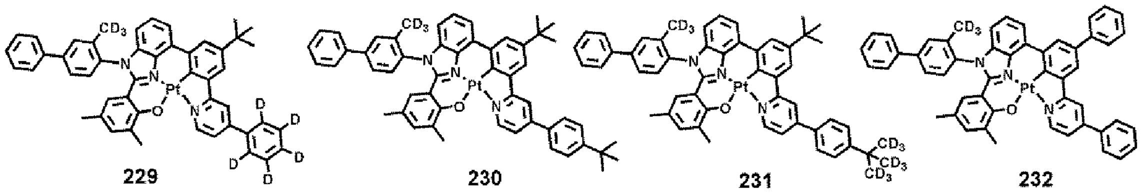

229 230 231 232

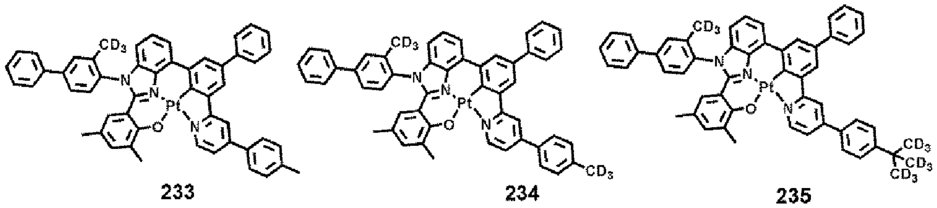

233 234 235

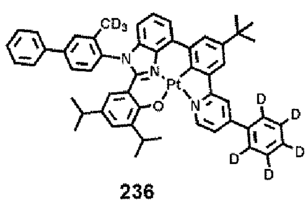

236

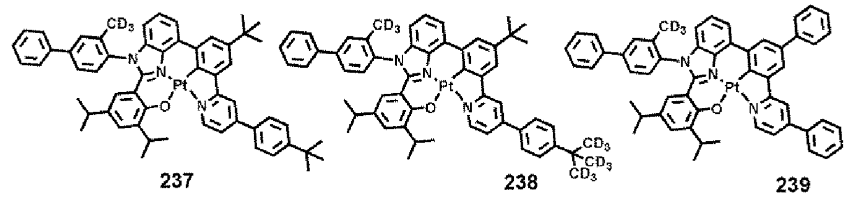

237 238 239

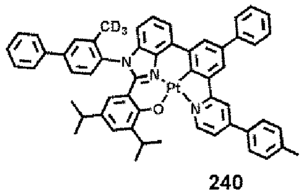

240

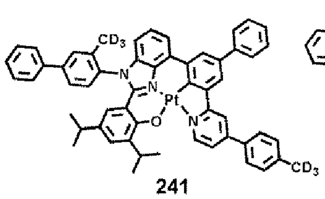
241

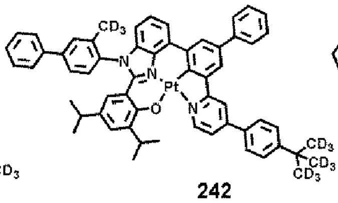
242

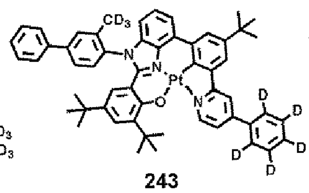
243

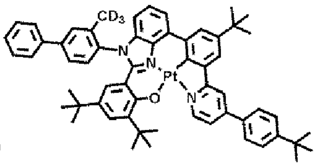
244

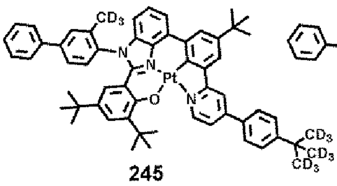
245

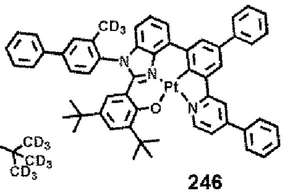
246

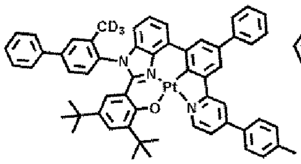
247

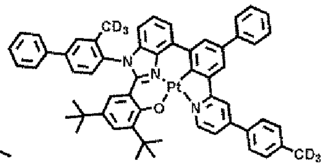
248

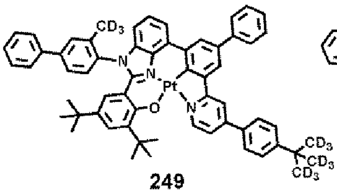
249

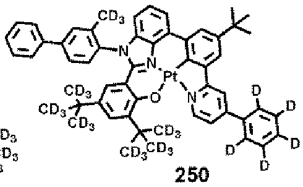
250

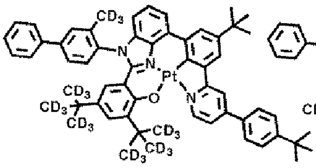
251

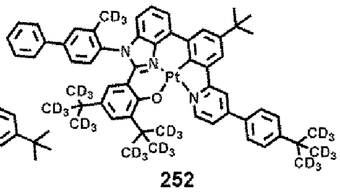
252

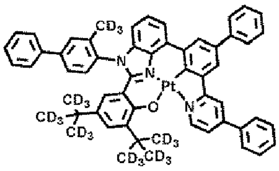
253

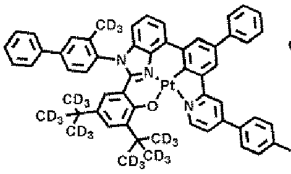
254

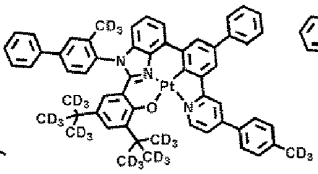
255

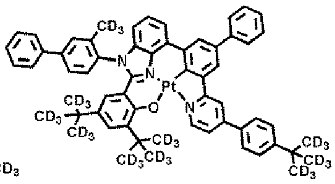
256

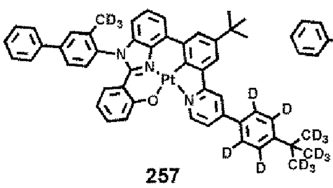
257

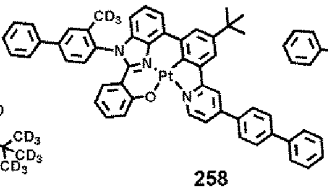
258

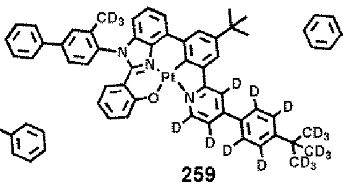
259

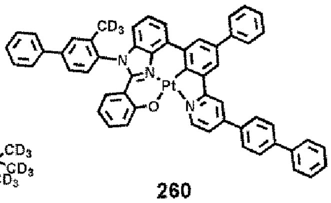
260

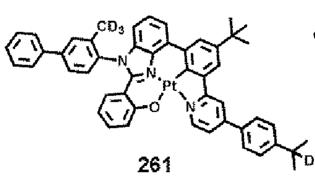
261

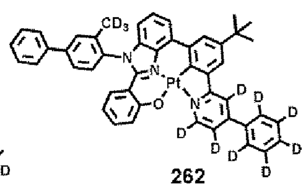
262

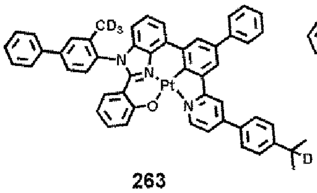
263

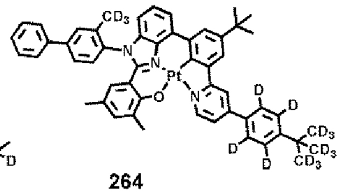
264

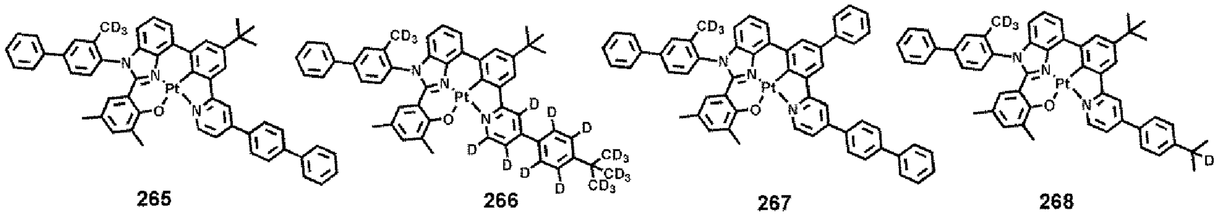

265 266 267 268

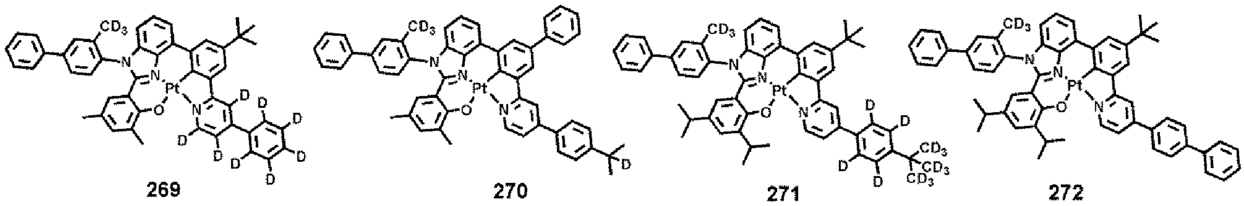

269 270 271 272

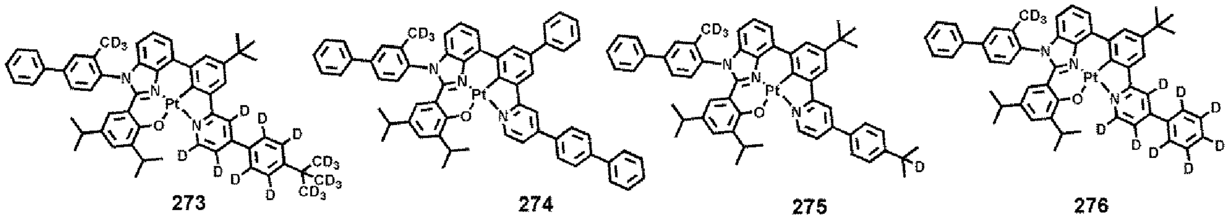

273 274 275 276

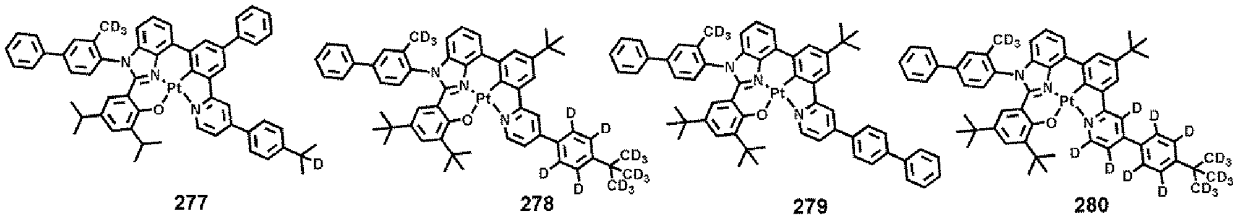

277 278 279 280

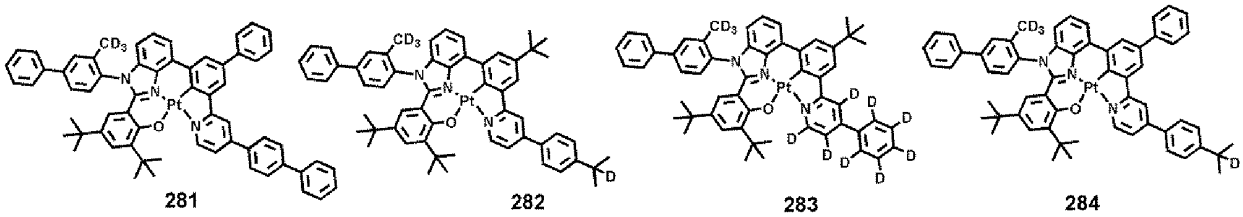

281 282 283 284

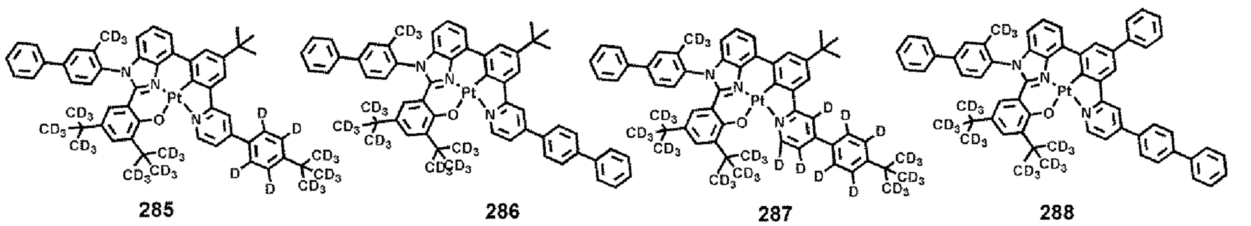

285 286 287 288

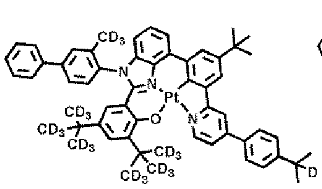
289

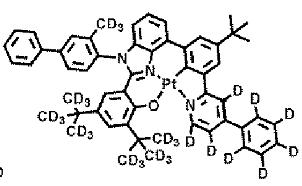
290

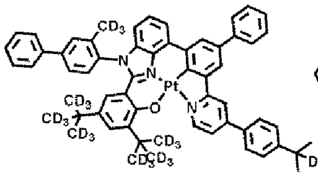
291

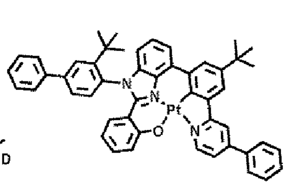
292

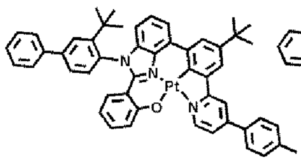
293

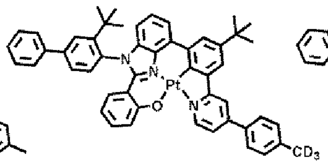
294

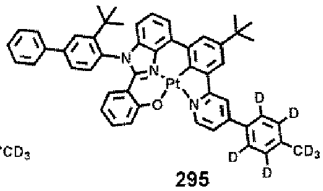
295

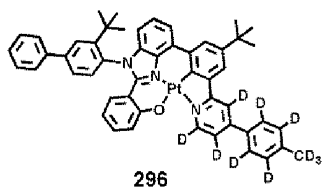
296

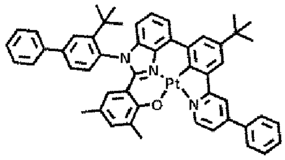
297

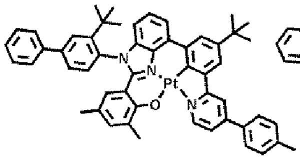
298

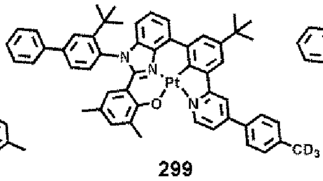
299

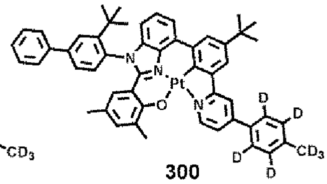
300

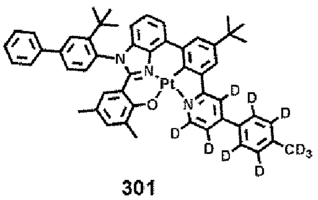
301

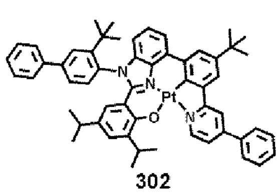
302

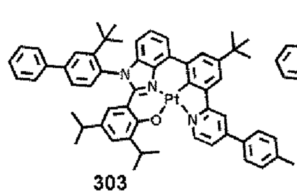
303

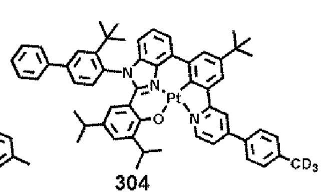
304

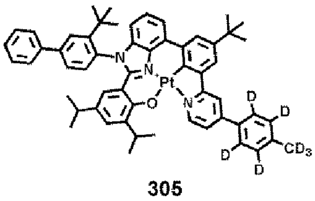
305

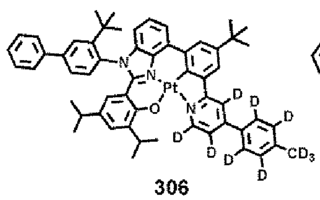
306

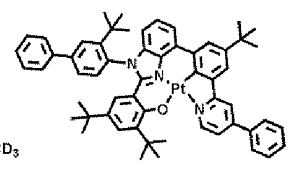
307

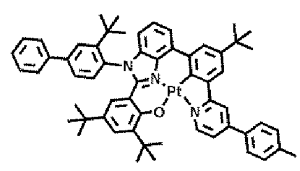
308

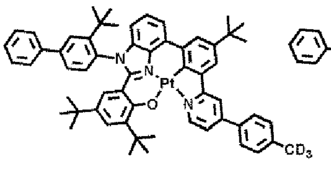
309

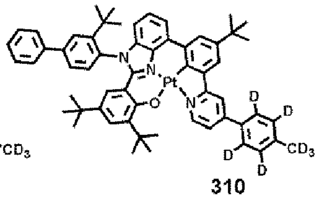
310

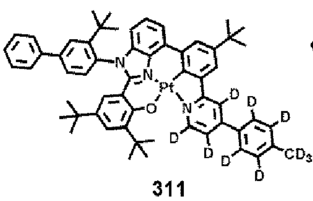
311

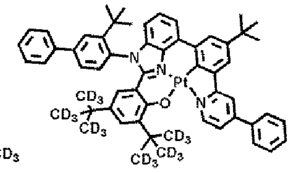
312

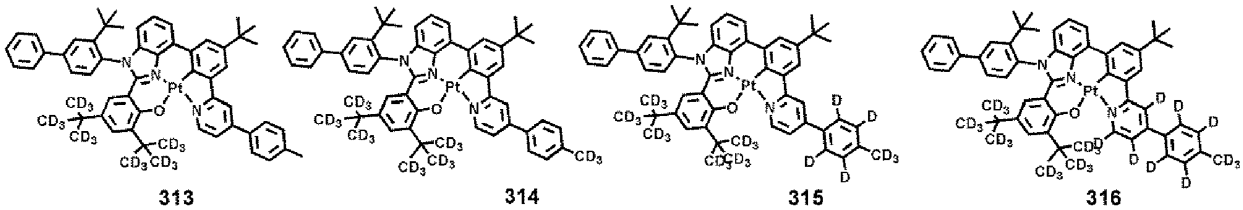

313 314 315 316

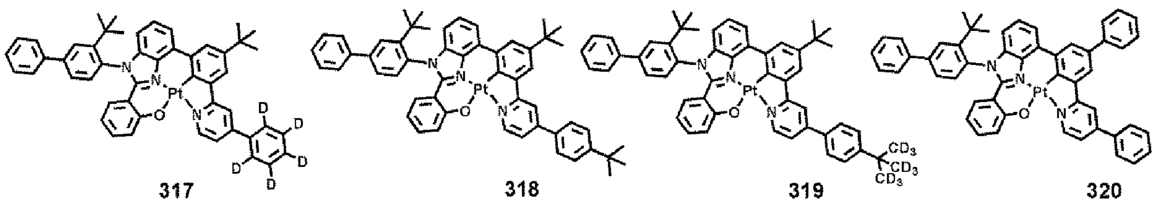

317 318 319 320

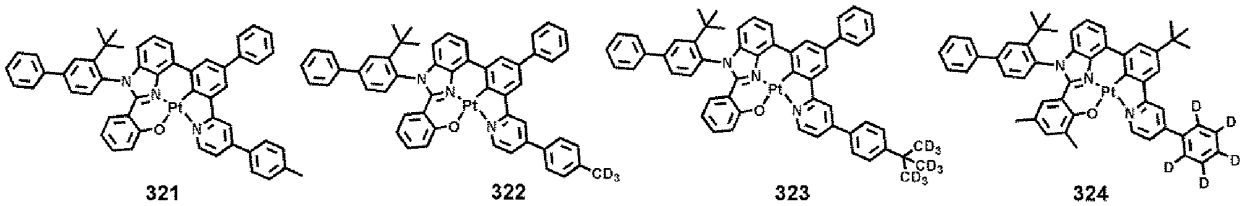

321 322 323 324

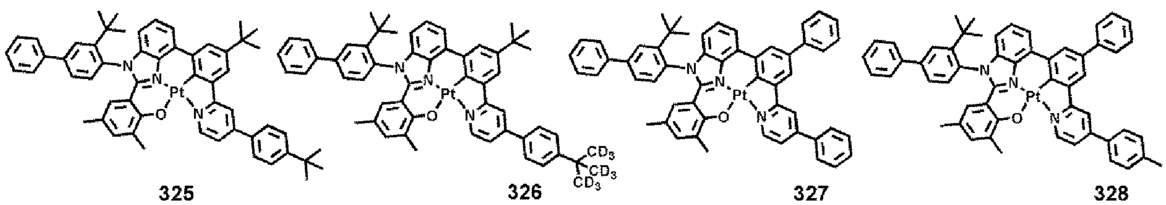

325 326 327 328

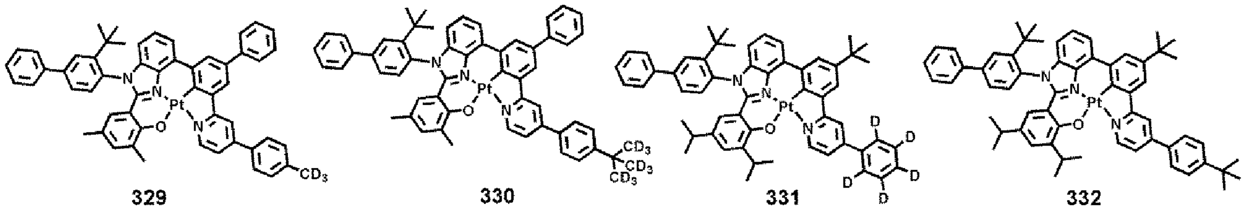

329 330 331 332

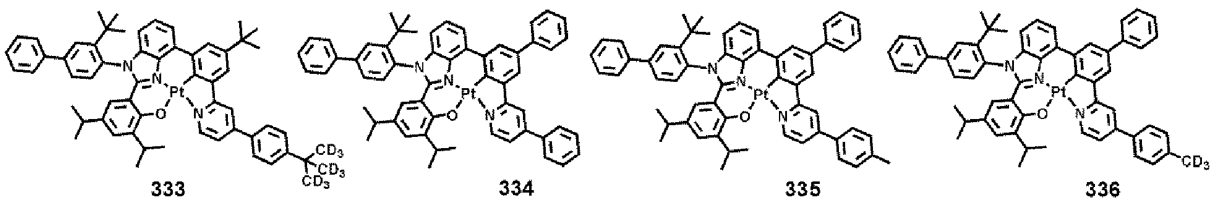

333 334 335 336

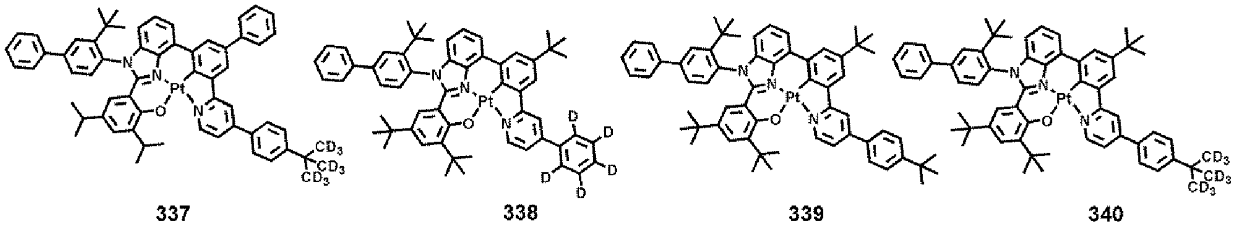

337 338 339 340

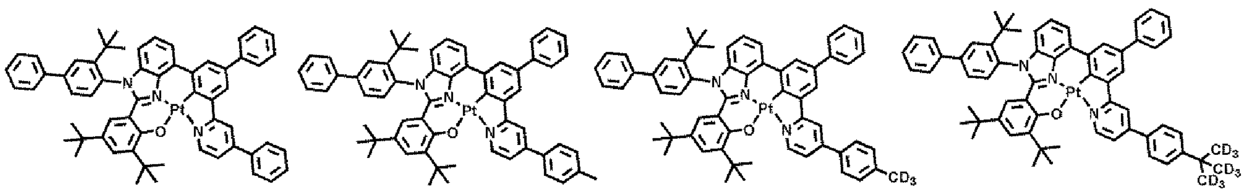

341 342 343 344

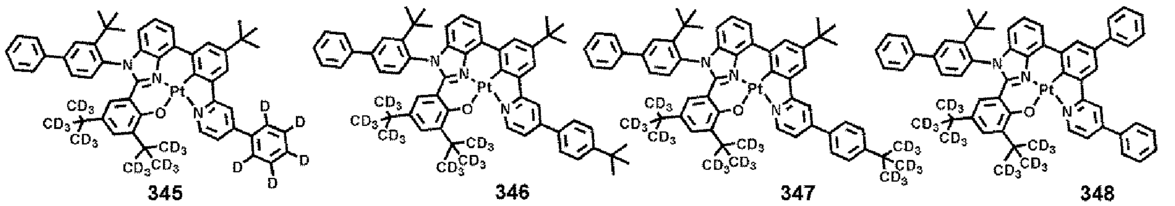

345 346 347 348

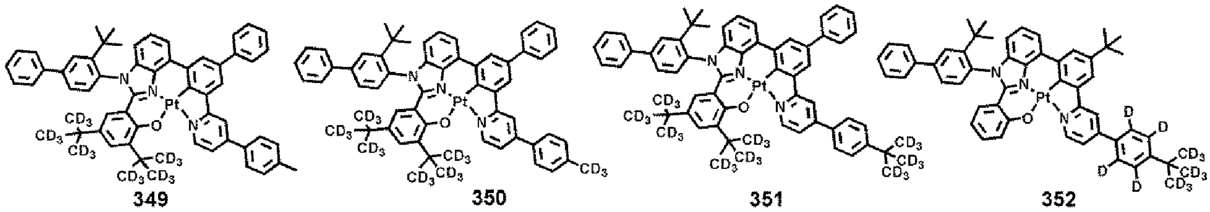

349 350 351 352

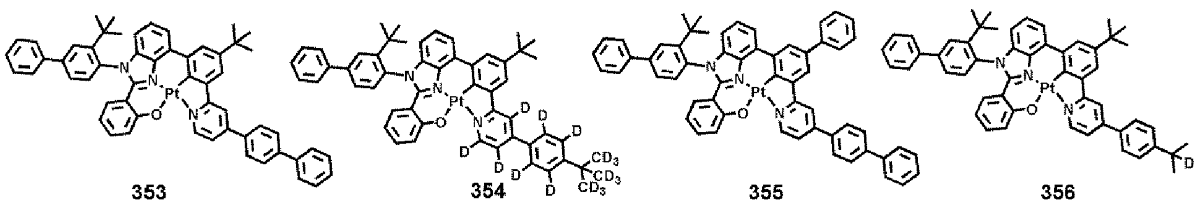

353 354 355 356

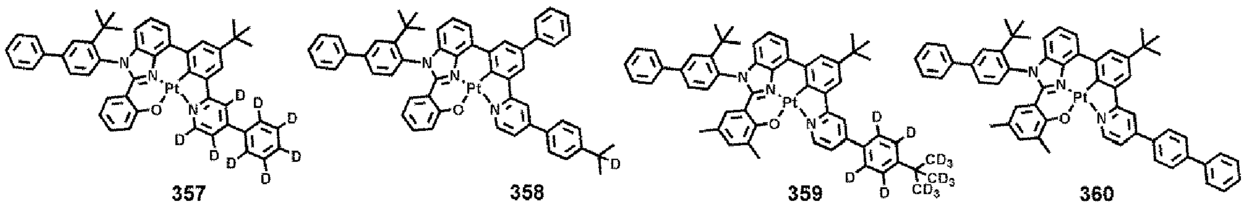

357 358 359 360

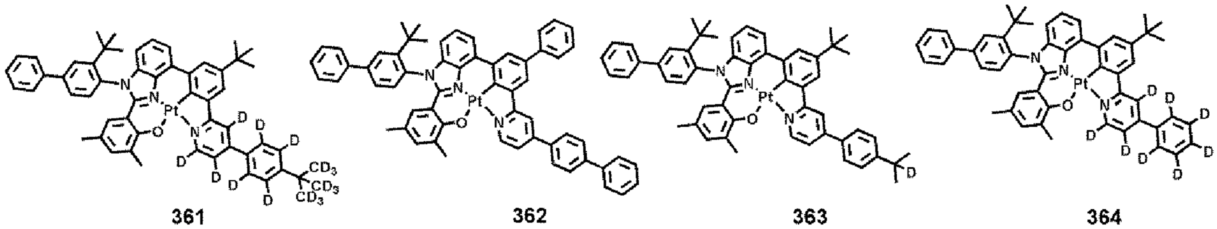

361 362 363 364

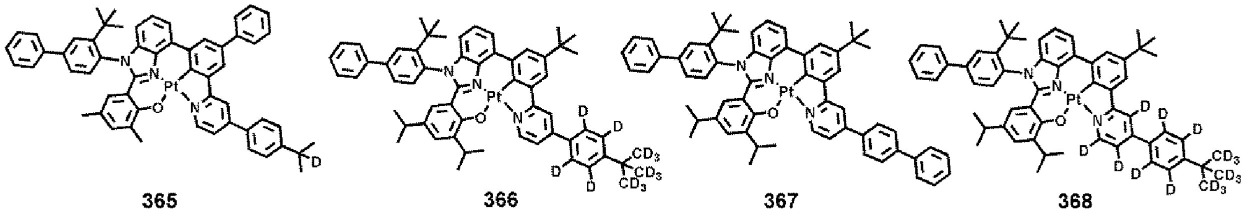

365 366 367 368

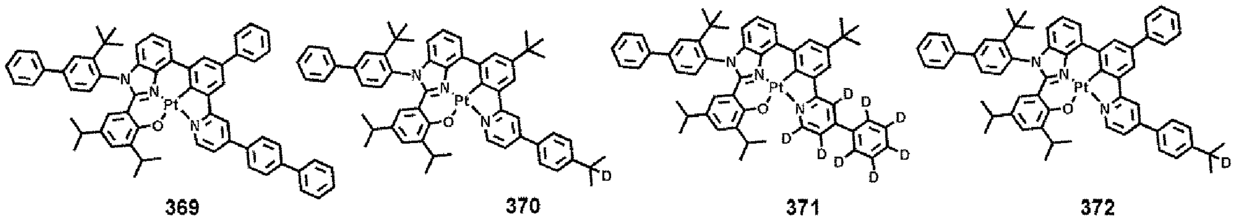

369 370 371 372

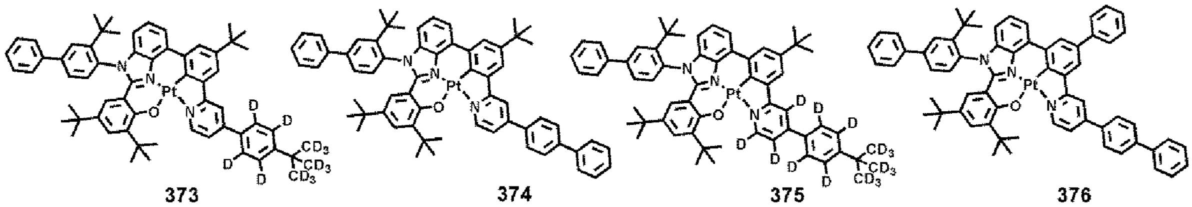

373 374 375 376

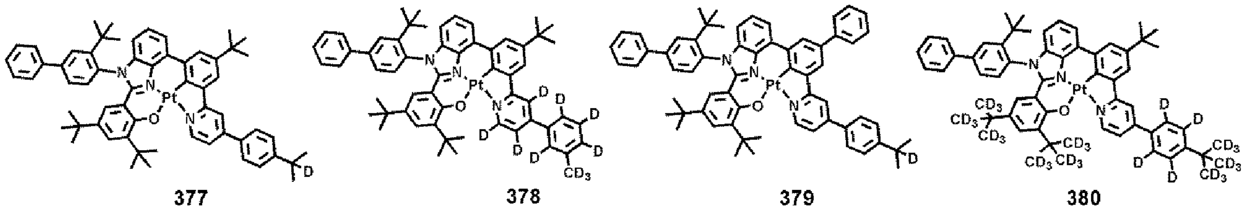

377 378 379 380

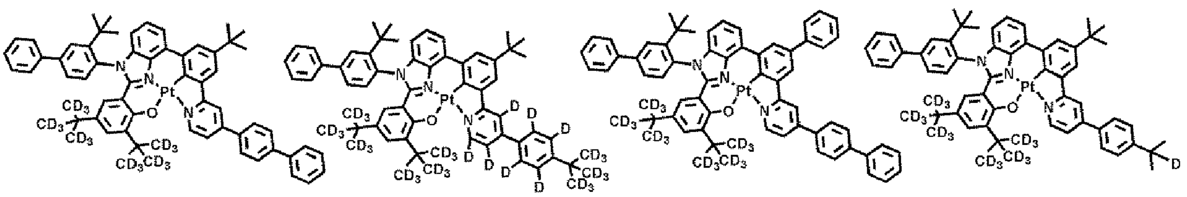

381 382 383 384

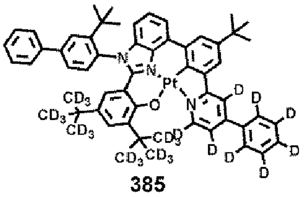
385

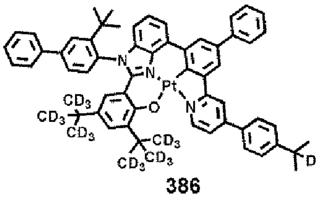
386

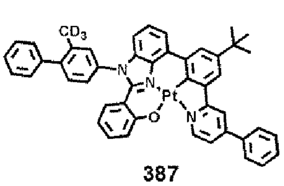
387

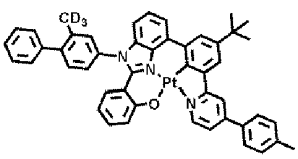
388

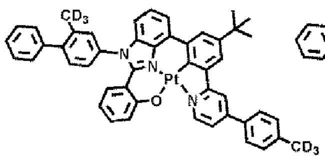
389

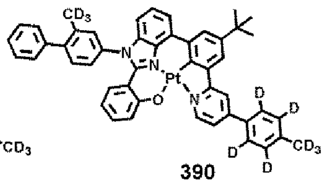
390

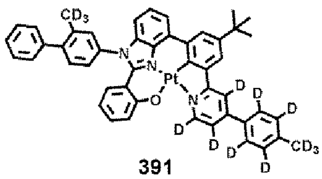
391

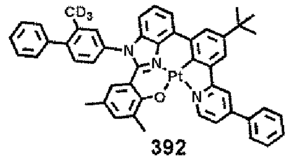
392

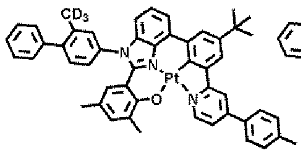
393

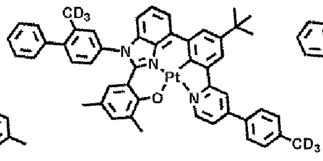
394

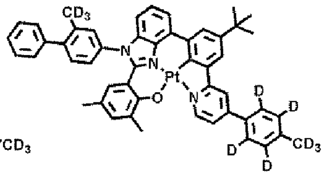
395

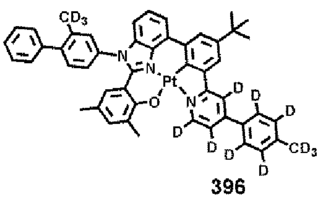
396

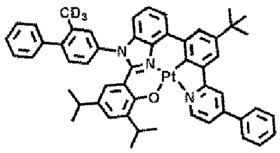
397

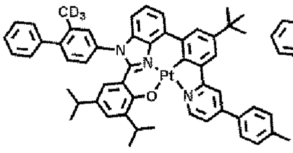
398

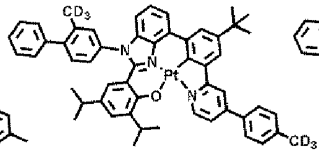
399

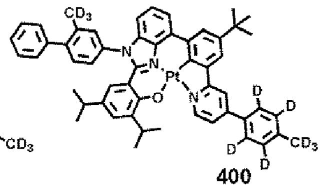
400

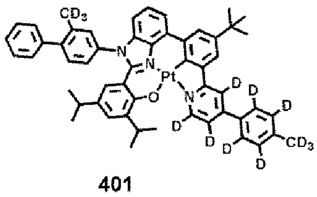
401

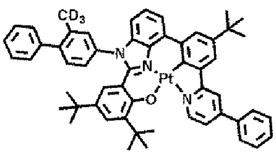
402

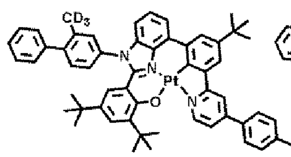
403

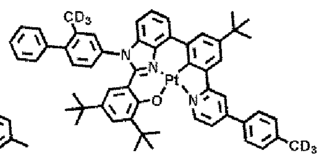
404

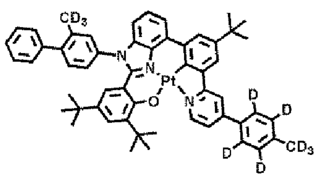
405

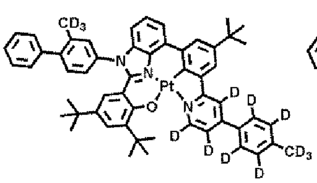
406

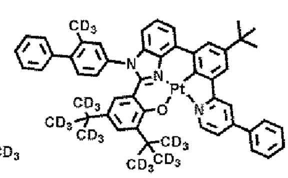
407

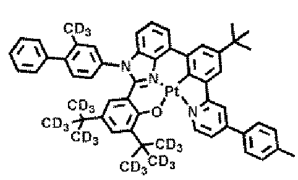
408

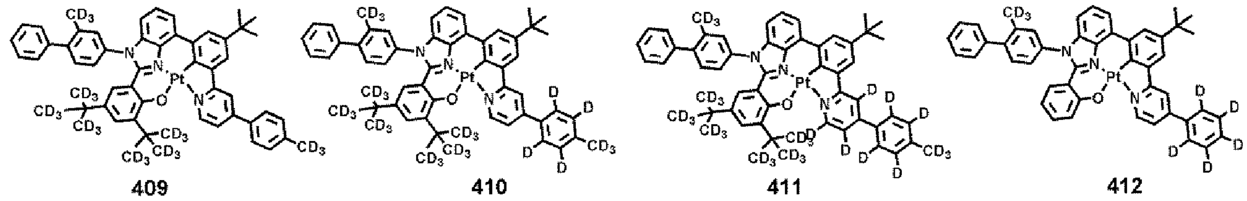

409 410 411 412

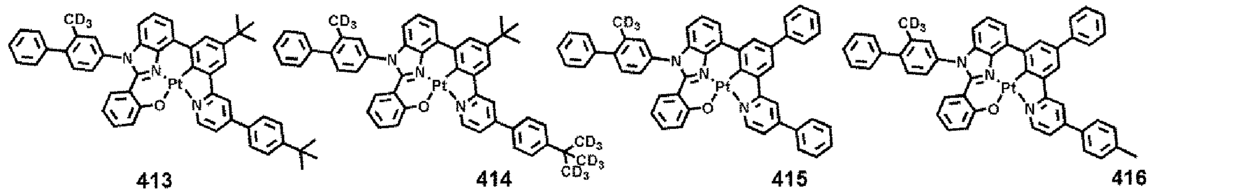

413 414 415 416

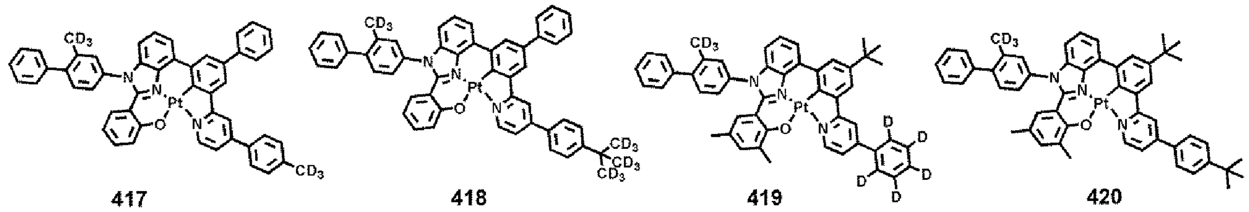

417 418 419 420

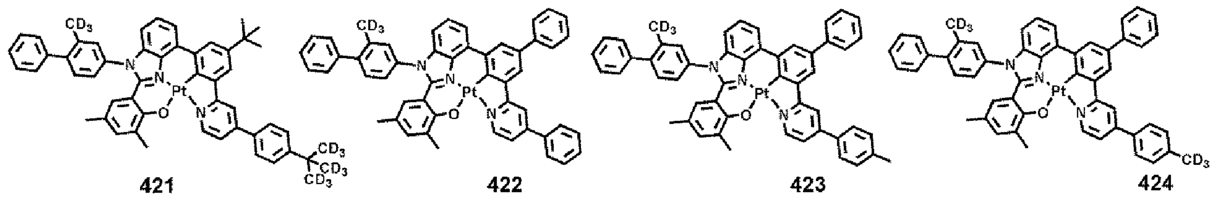

421 422 423 424

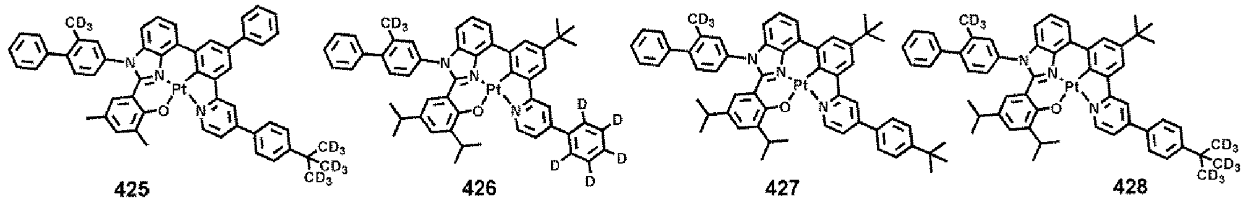

425 426 427 428

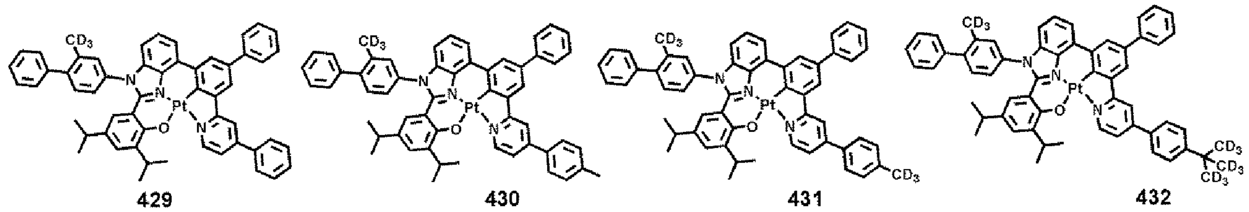

429 430 431 432

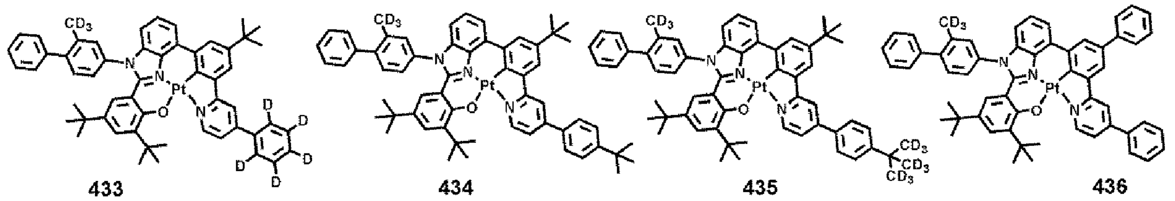

433 434 435 436

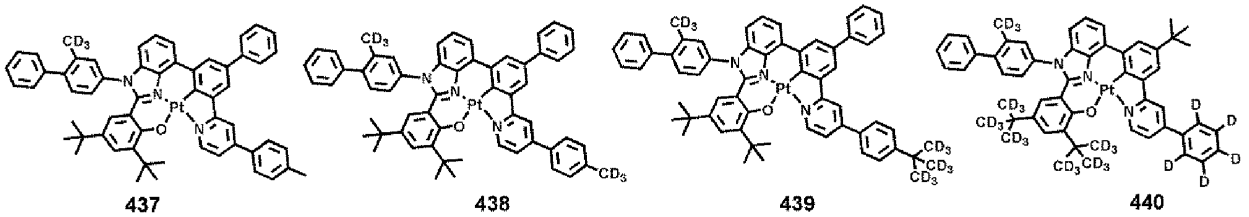

437 438 439 440

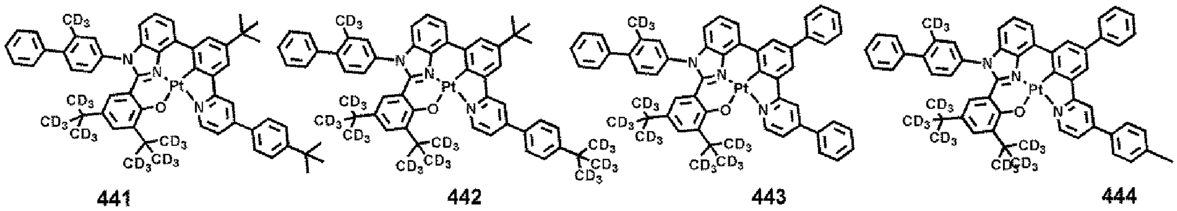

441 442 443 444

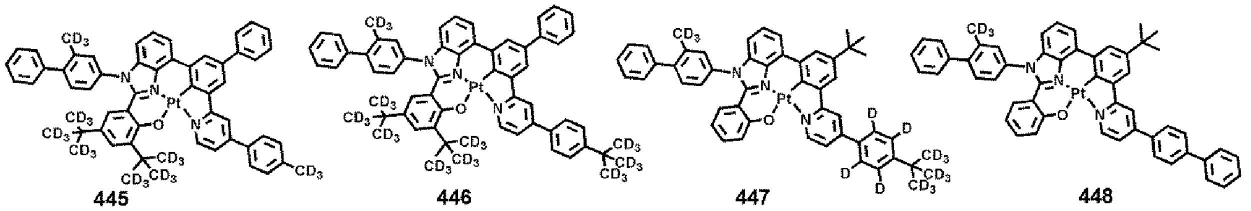

445 446 447 448

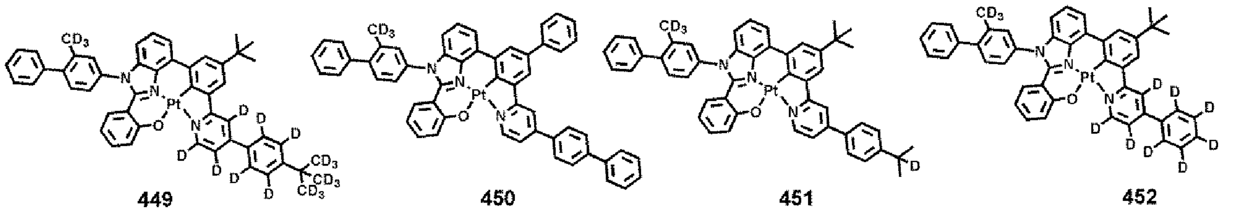

449 450 451 452

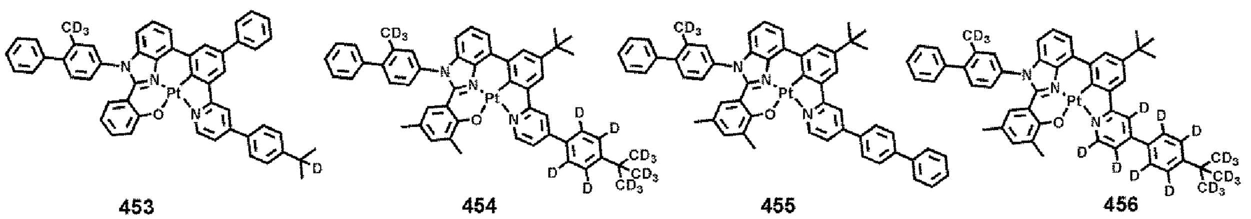

453 454 455 456

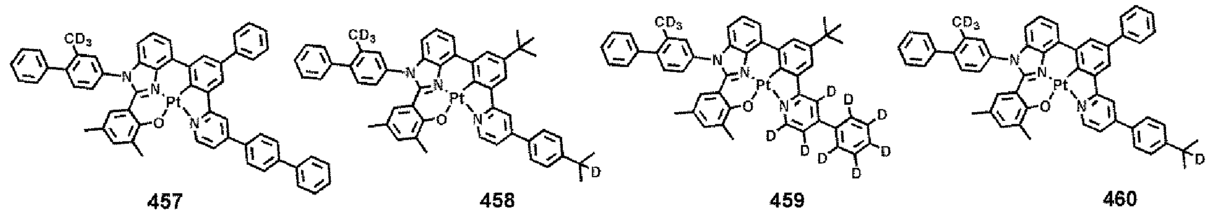

457 458 459 460

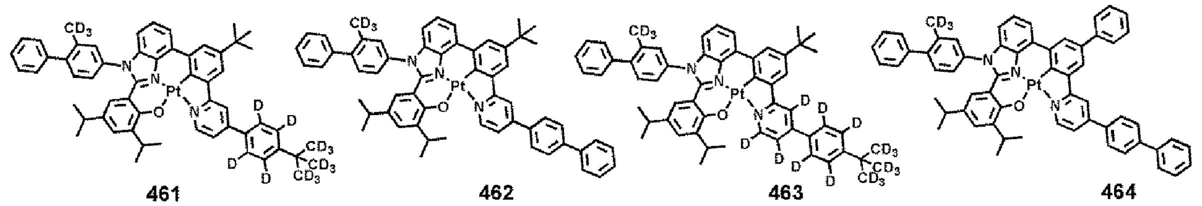

461 462 463 464

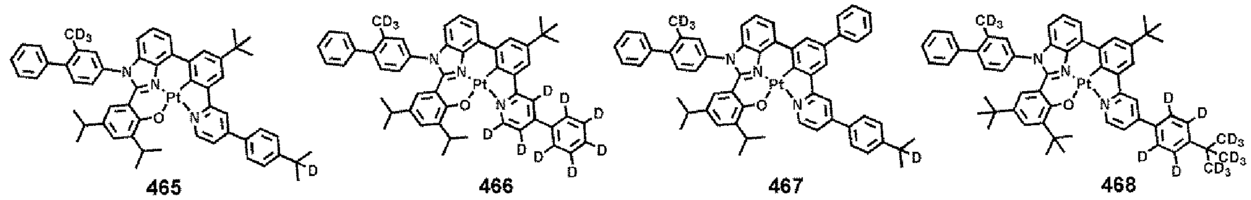

465 466 467 468

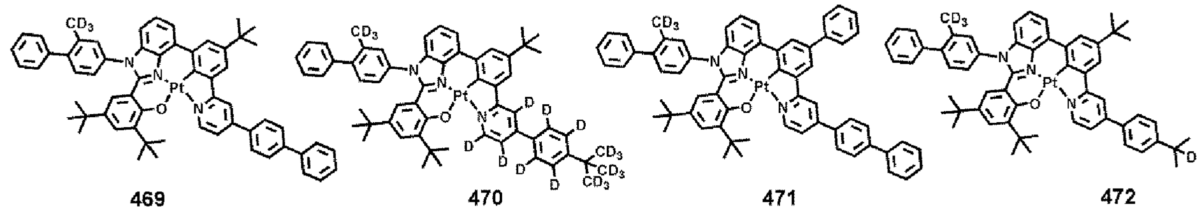

469 470 471 472

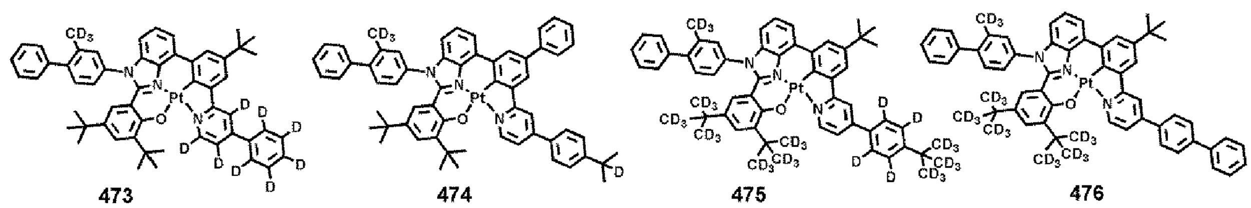

473 474 475 476

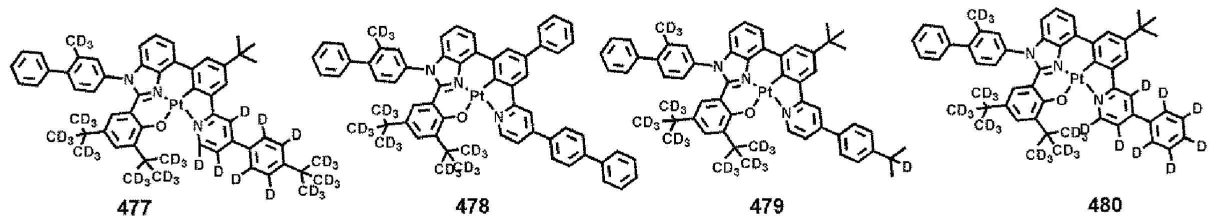

477 478 479 480

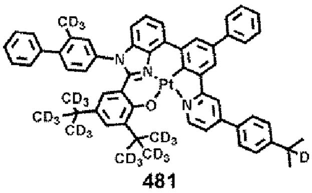
481

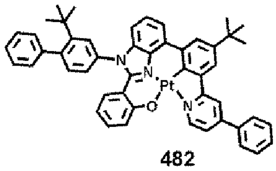
482

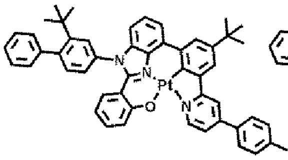
483

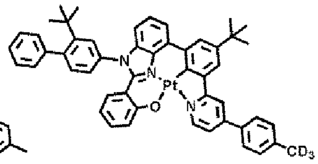
484

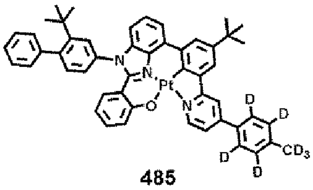
485

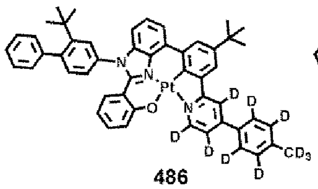
486

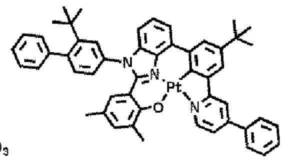
487

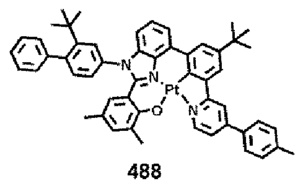
488

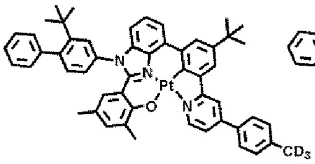
489

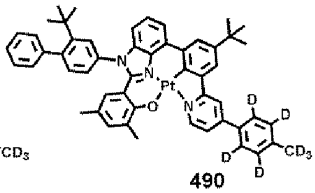
490

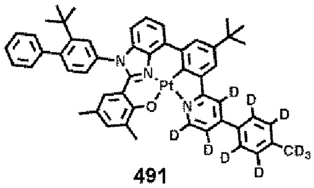
491

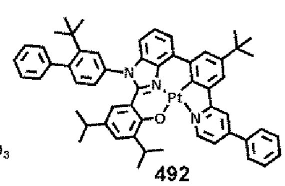
492

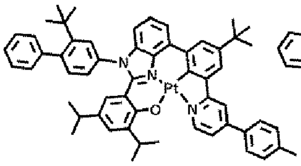
493

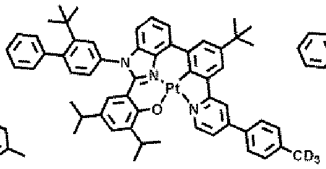
494

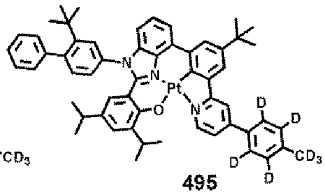
495

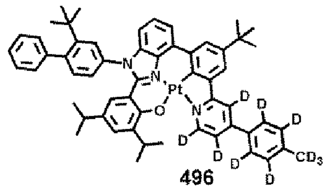
496

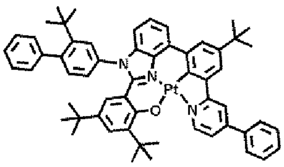
497

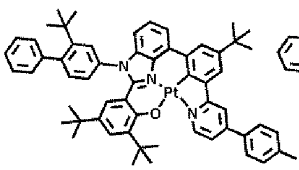
498

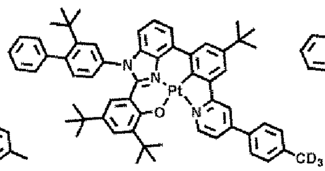
499

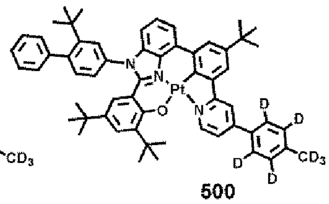
500

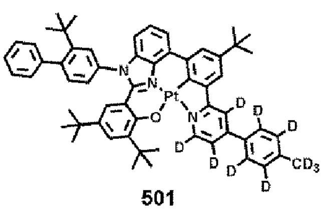
501

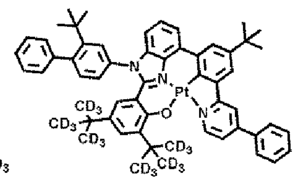
502

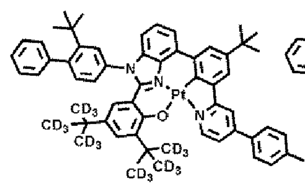
503

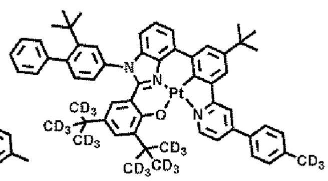
504

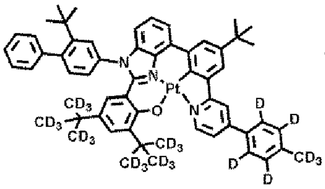

505

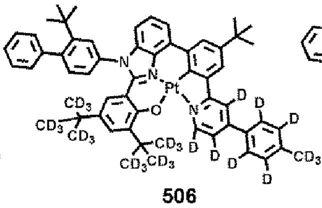

506

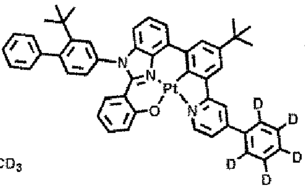

507

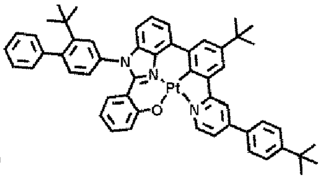

508

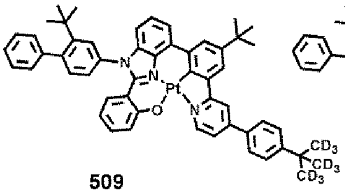

509

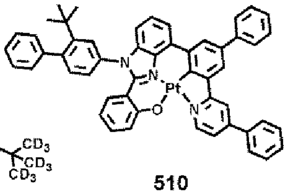

510

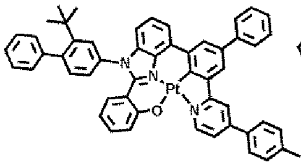

511

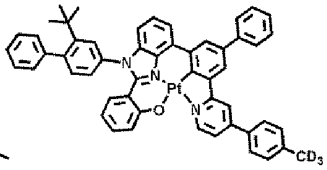

512

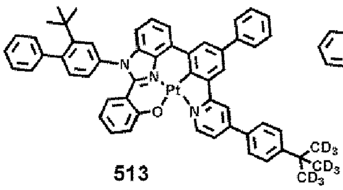

513

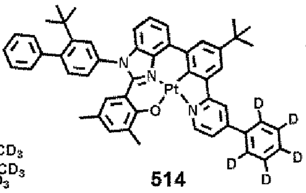

514

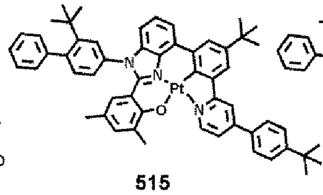

515

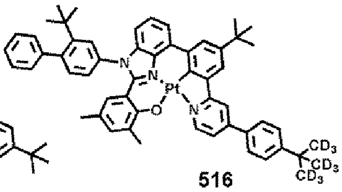

516

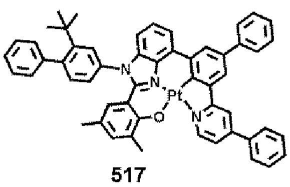

517

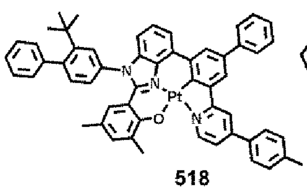

518

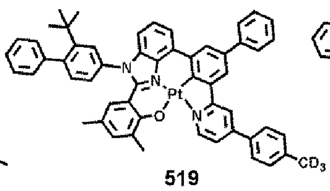

519

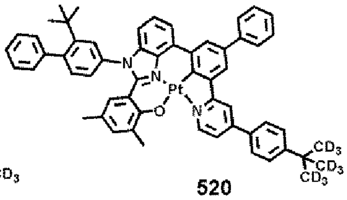

520

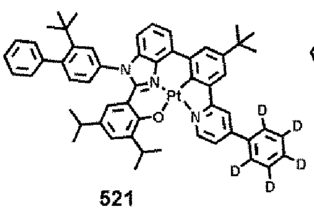

521

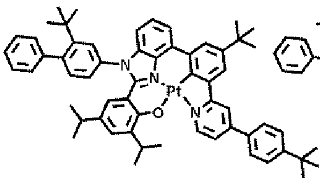

522

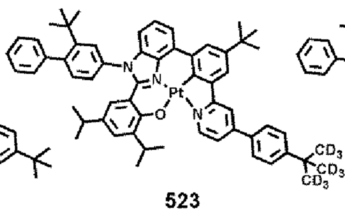

523

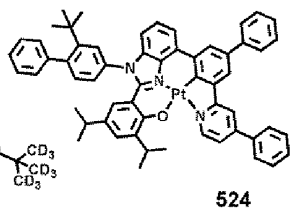

524

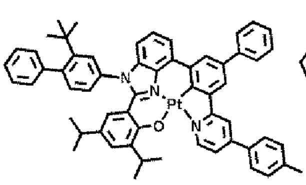

525

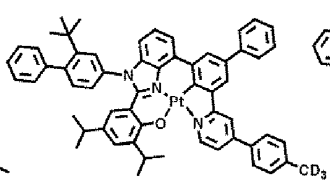

526

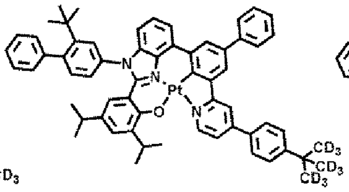

527

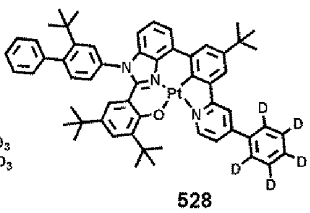

528

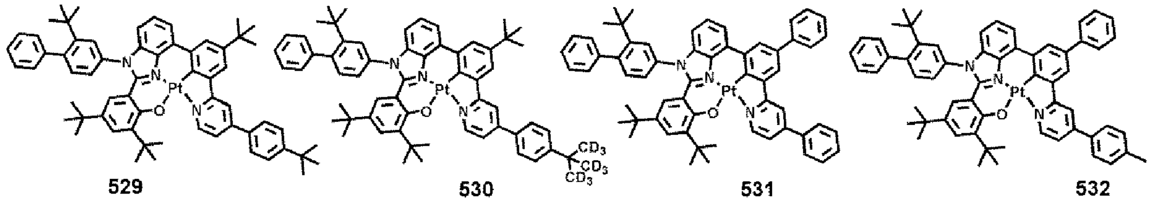

529 530 531 532

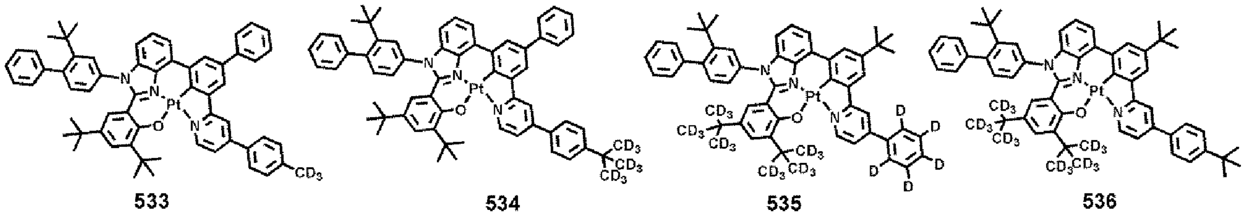

533 534 535 536

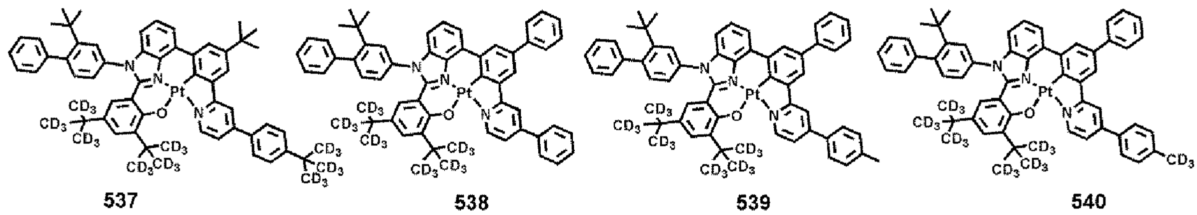

537 538 539 540

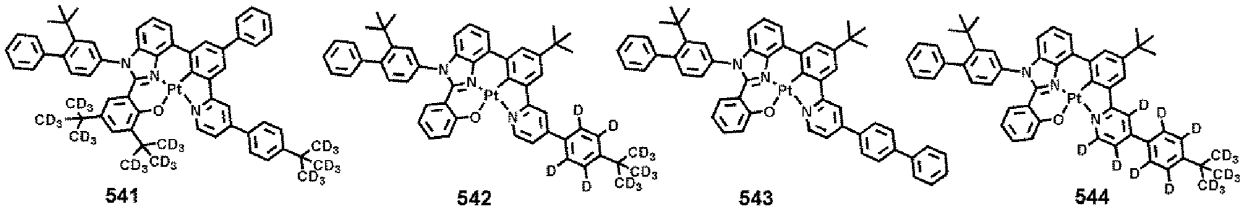

541 542 543 544

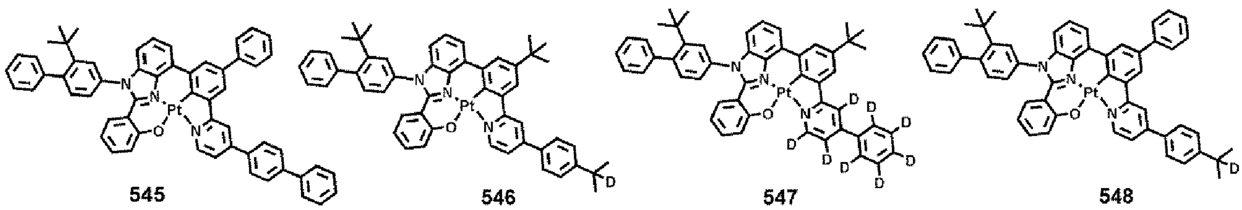

545 546 547 548

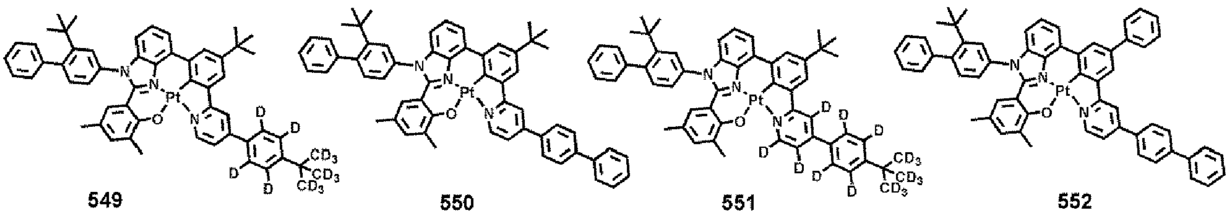

549 550 551 552

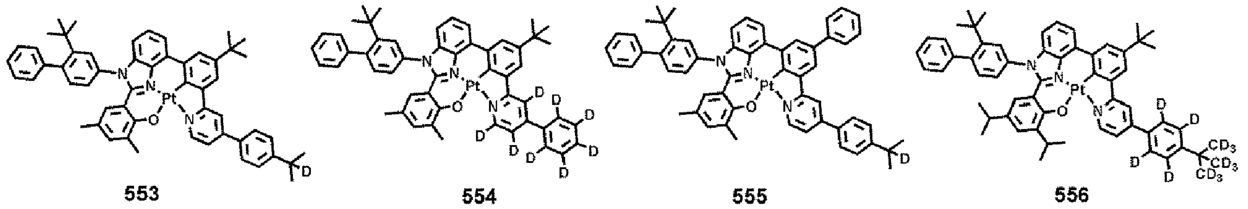

553 554 555 556

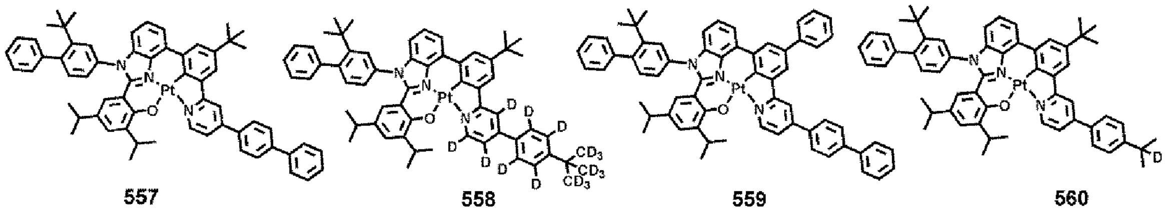

557 558 559 560

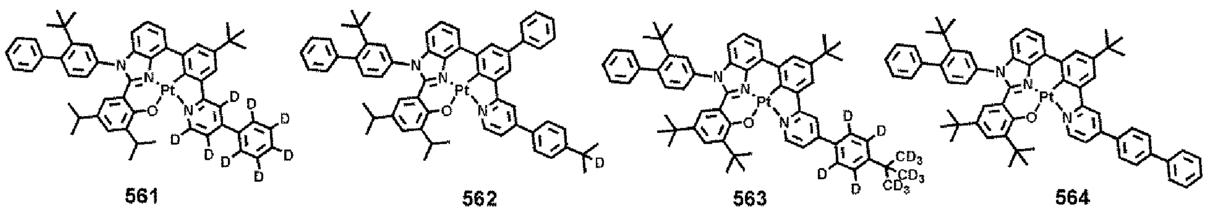

561 562 563 564

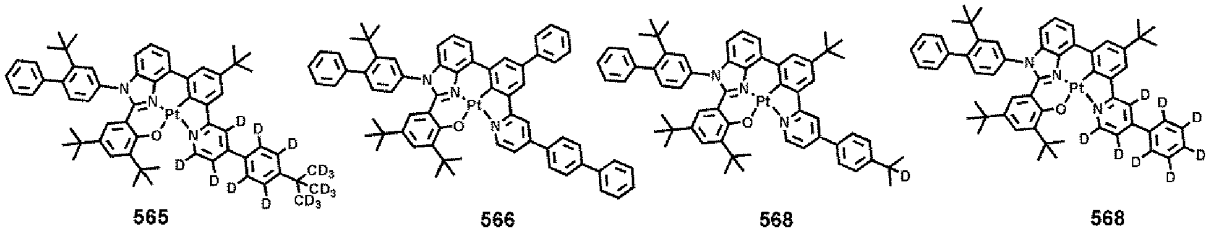

565 566 568 568

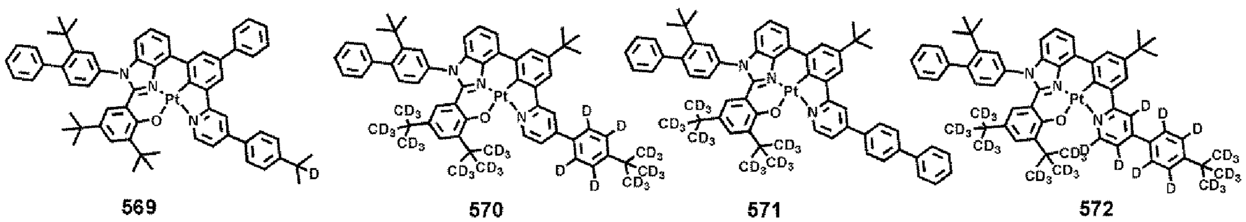

569 570 571 572

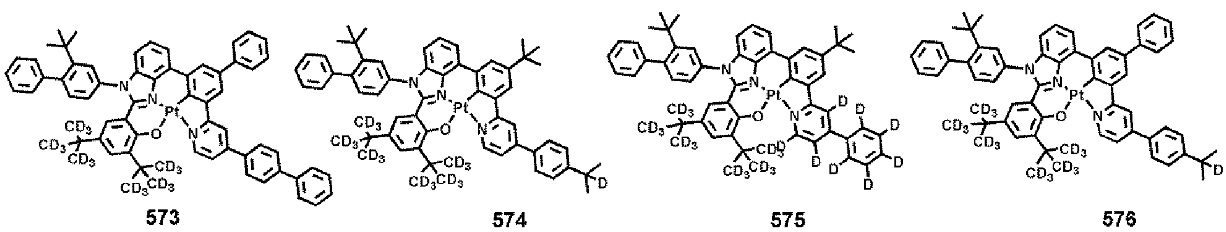

573 574 575 576

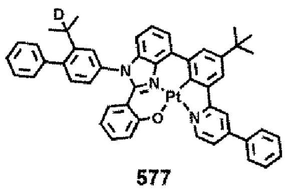
577

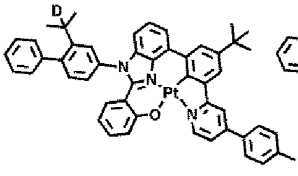
578

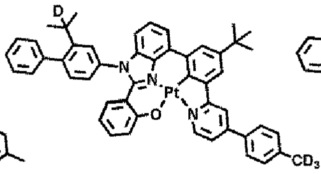
579

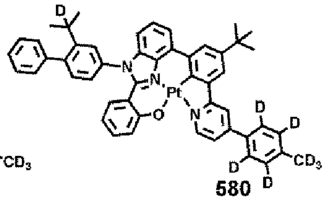
580

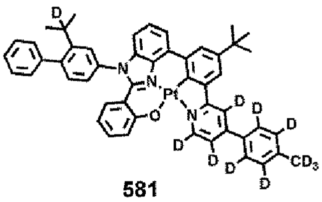
581

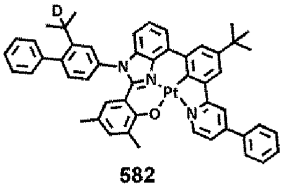
582

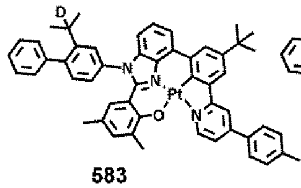
583

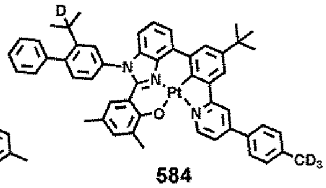
584

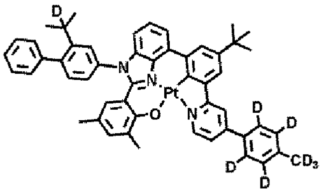
585

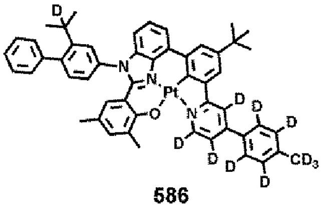
586

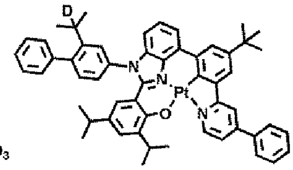
587

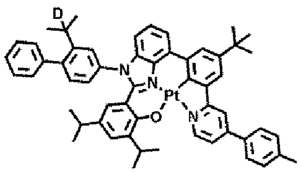
588

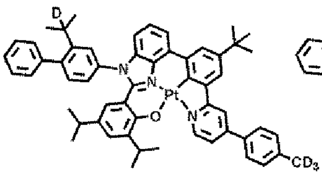
589

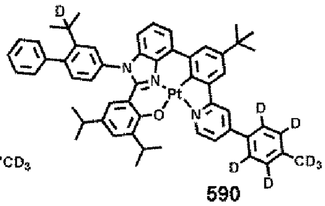
590

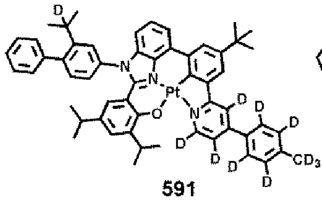
591

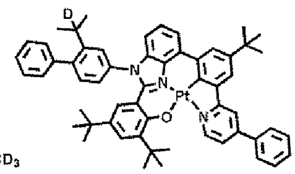
592

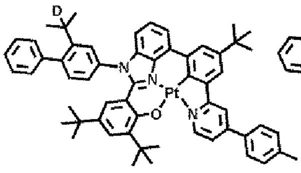
593

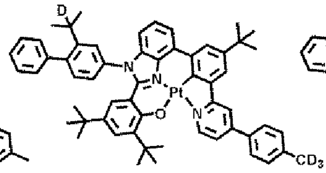
594

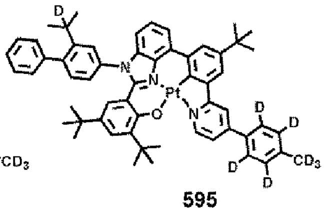
595

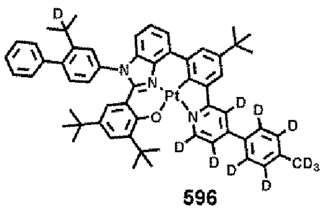
596

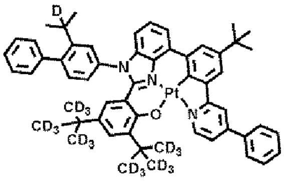
597

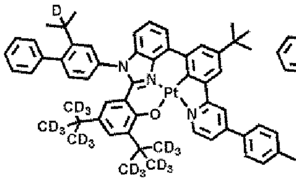
598

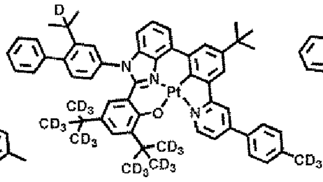
599

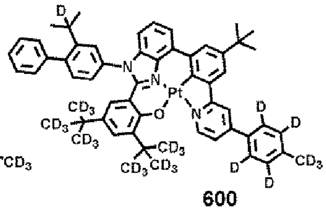
600

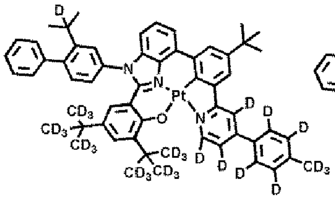

601

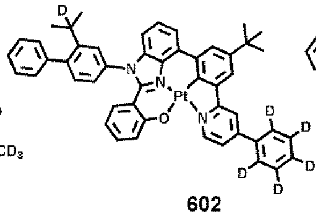

602

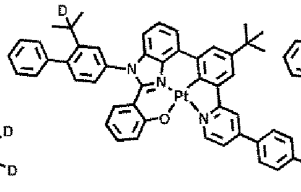

603

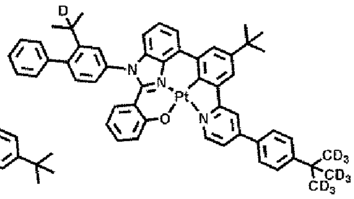

604

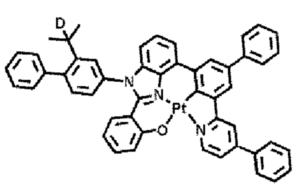

605

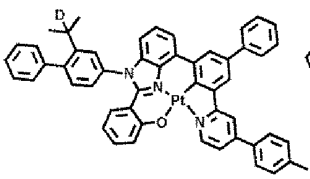

606

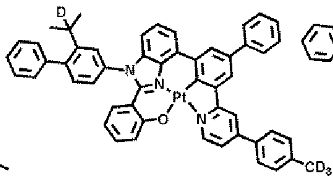

607

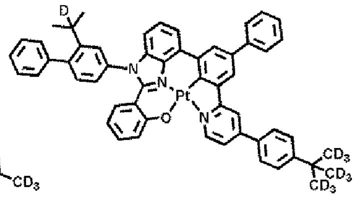

608

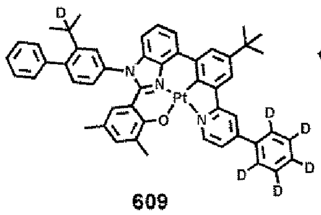

609

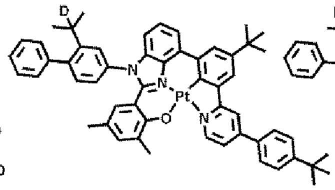

610

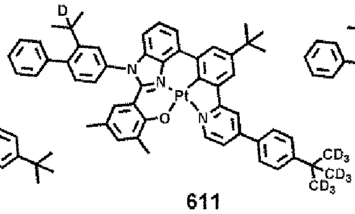

611

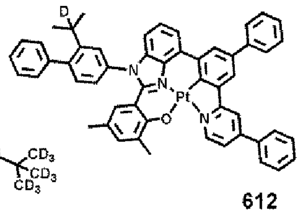

612

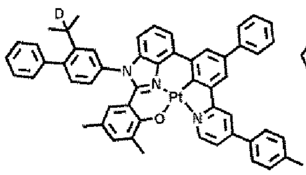

613

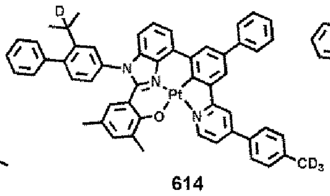

614

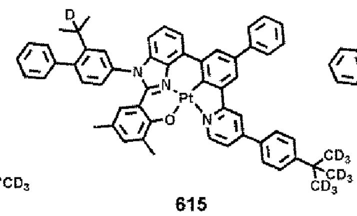

615

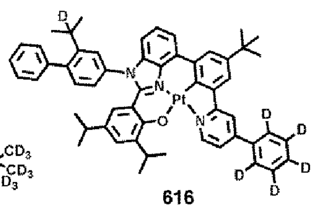

616

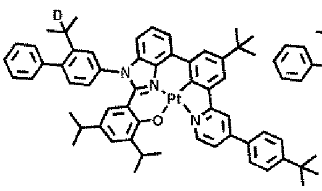

617

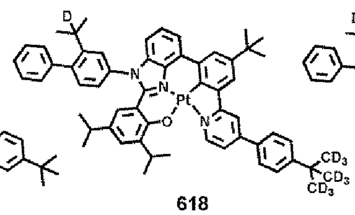

618

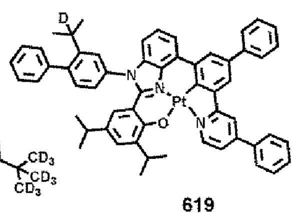

619

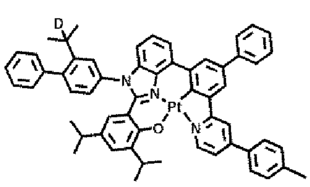

620

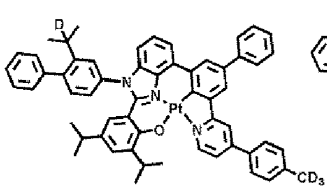

621

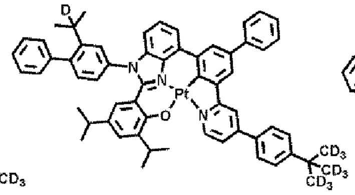

622

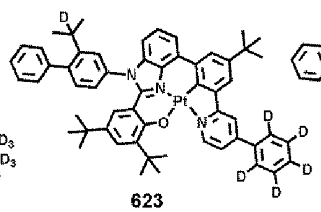

623

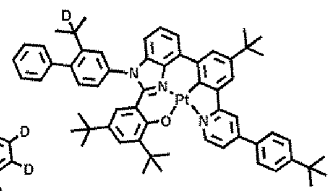

624

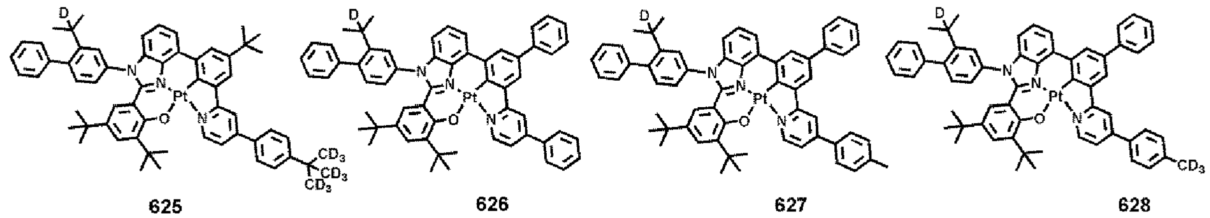

625 626 627 628

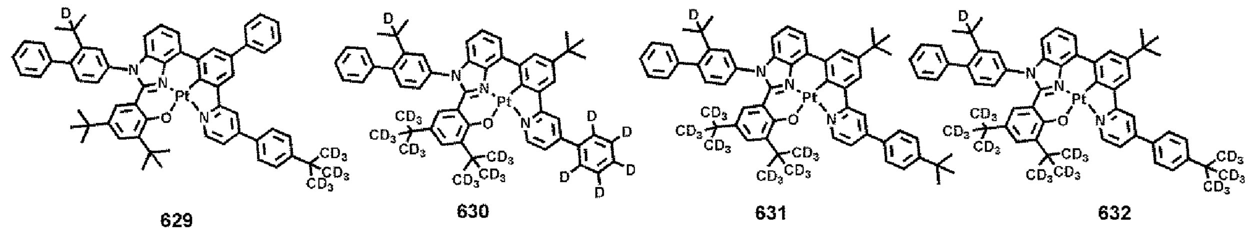

629 630 631 632

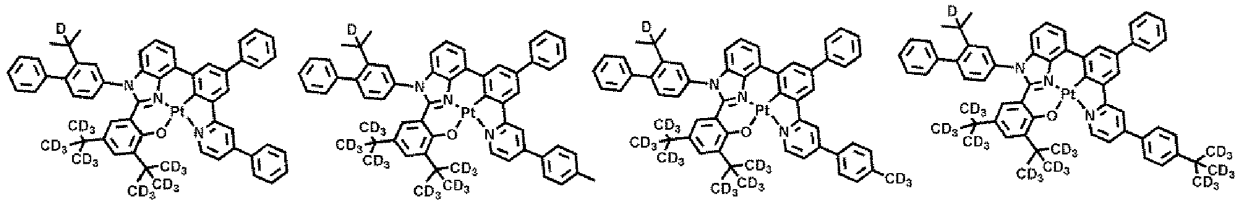

633 634 635 636

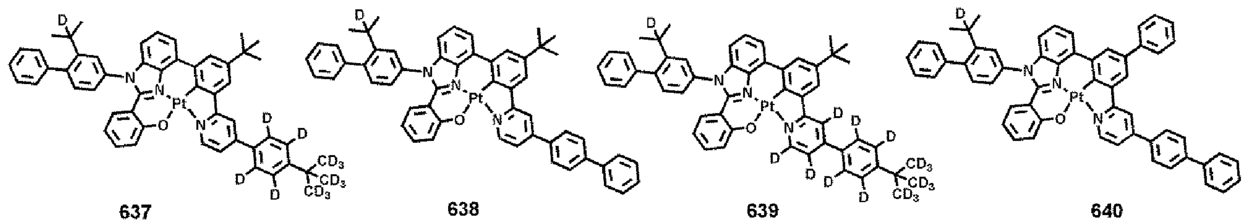

637 638 639 640

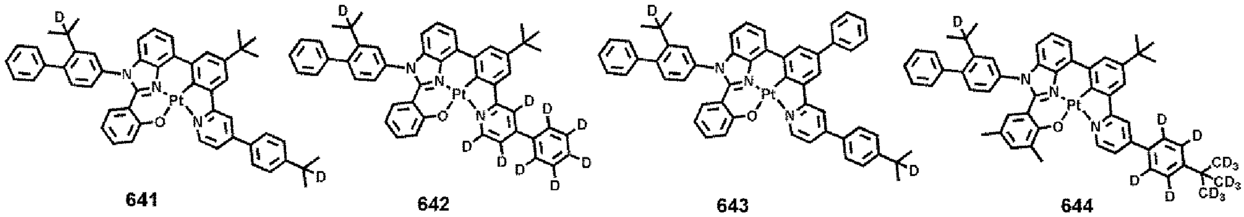

641 642 643 644

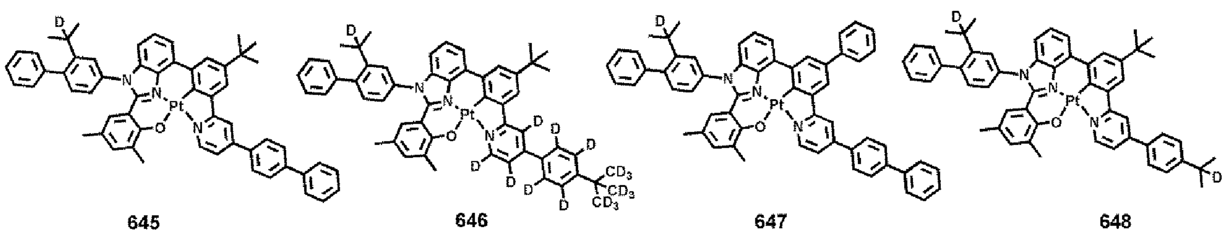

645 646 647 648

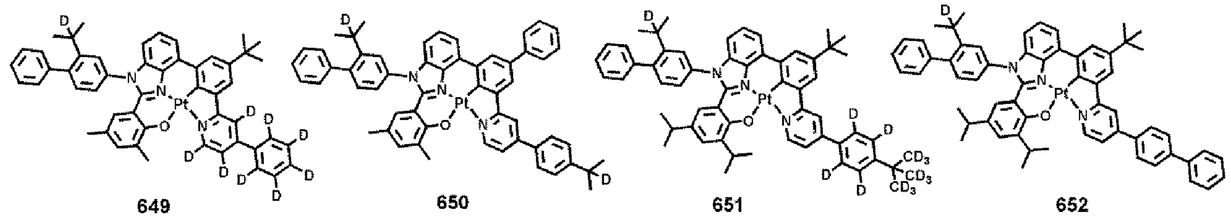

649 650 651 652

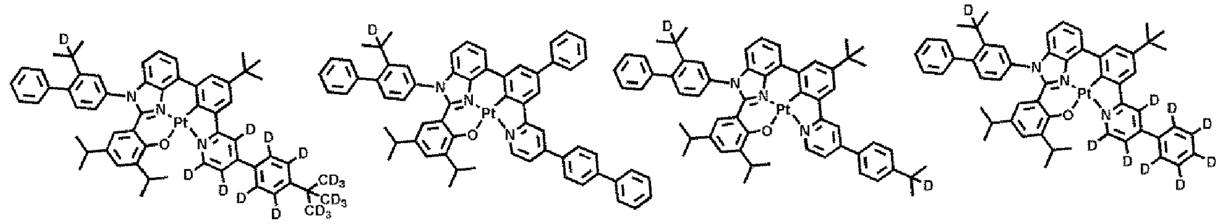

653 654 655 656

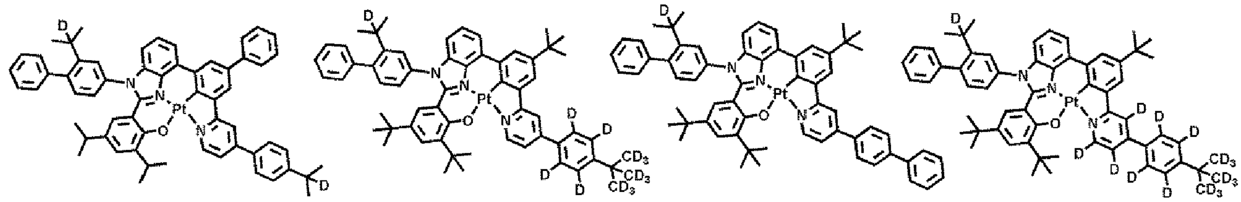

657 658 659 660

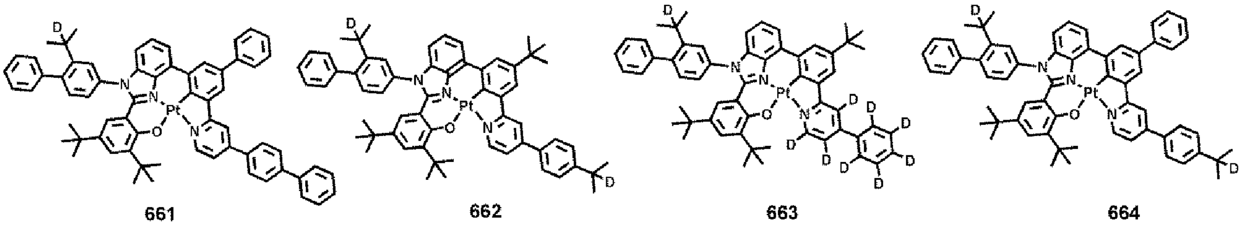

661 662 663 664

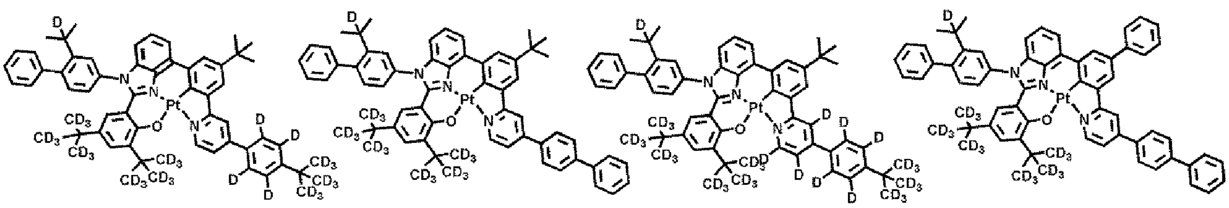

665 666 667 668

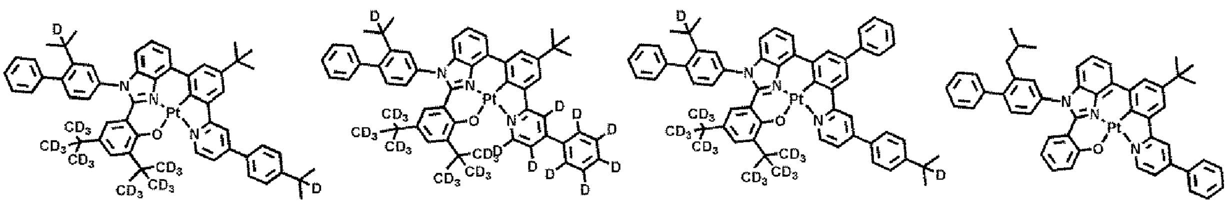

669 670 671 672

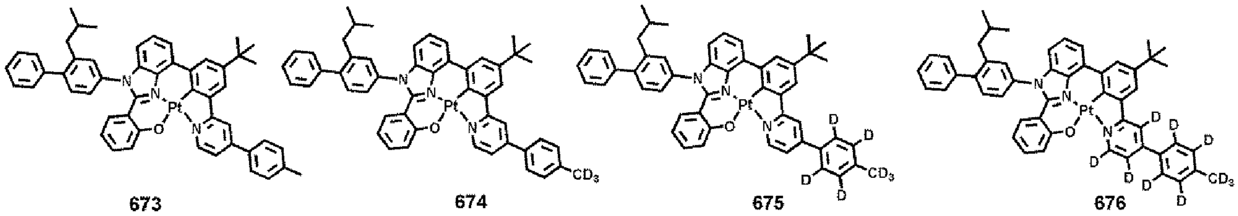

673 674 675 676

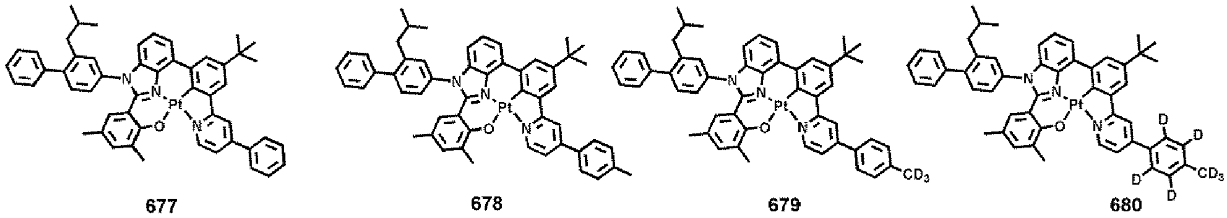

677 678 679 680

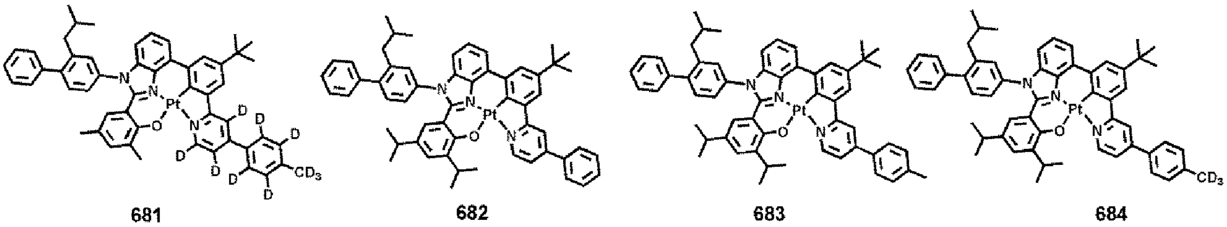

681 682 683 684

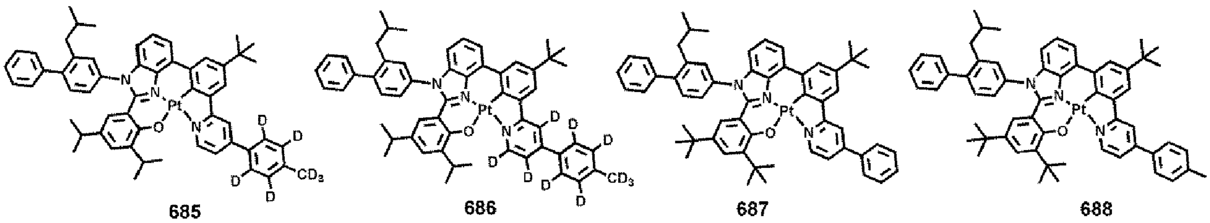

685 686 687 688

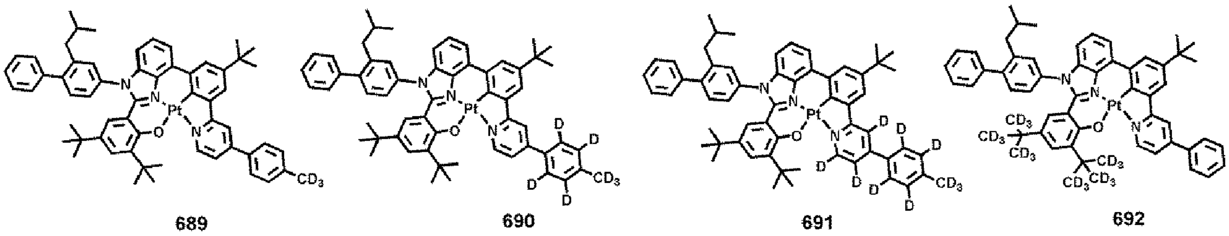

689 690 691 692

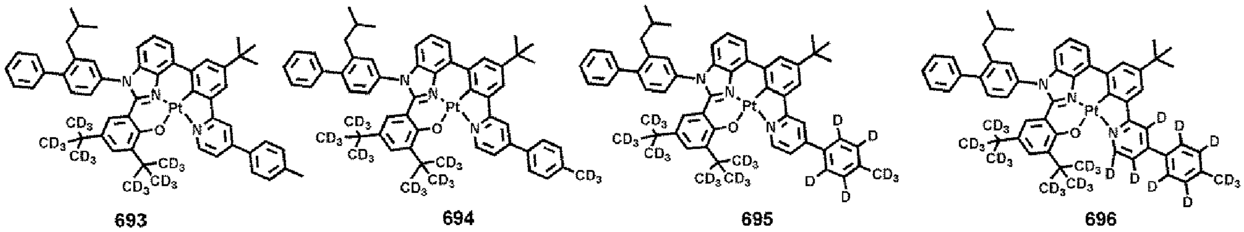

693 694 695 696

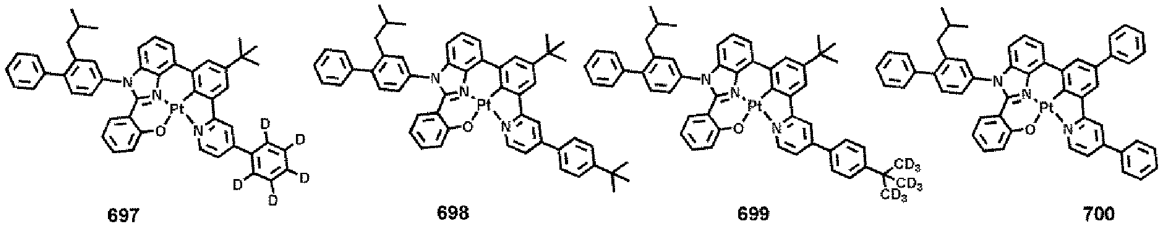

697 698 699 700

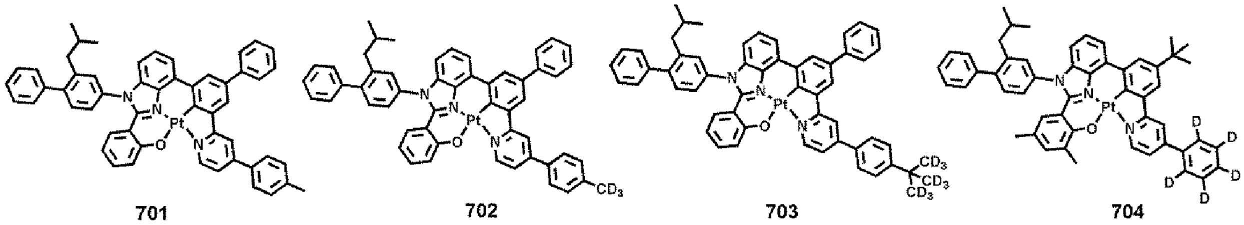

701 702 703 704

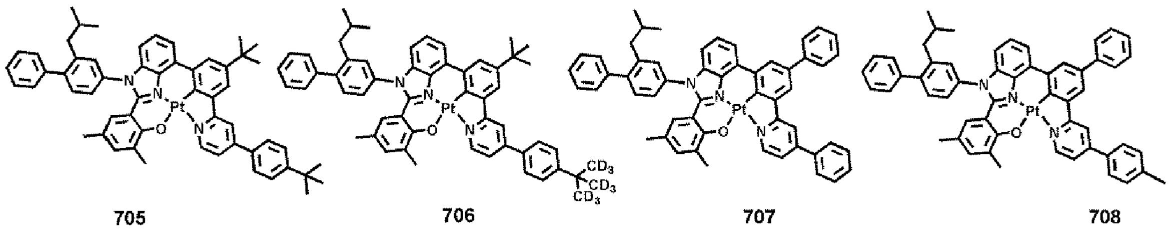

705 706 707 708

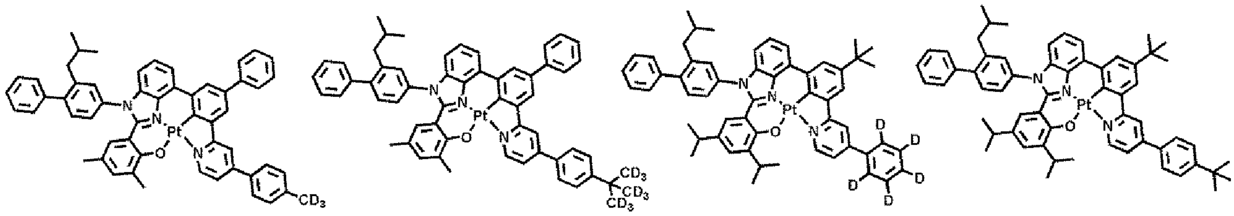

709 710 711 712

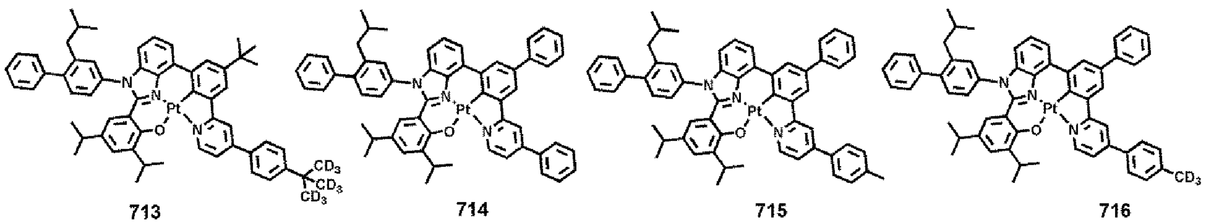

713 714 715 716

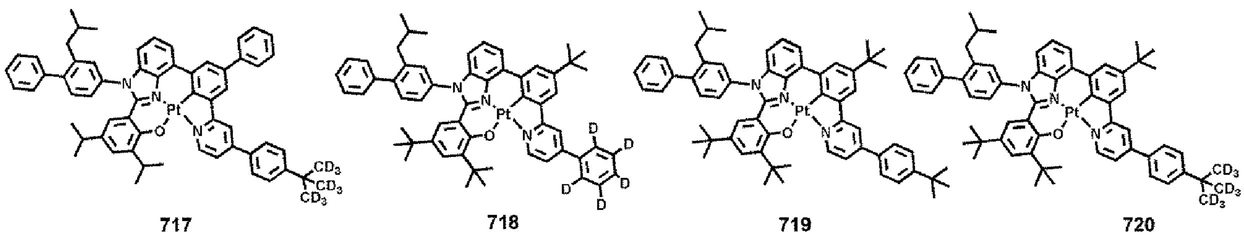

717 718 719 720

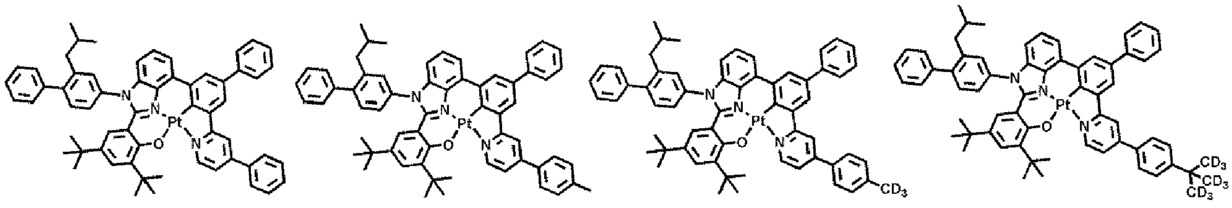

721 722 723 724

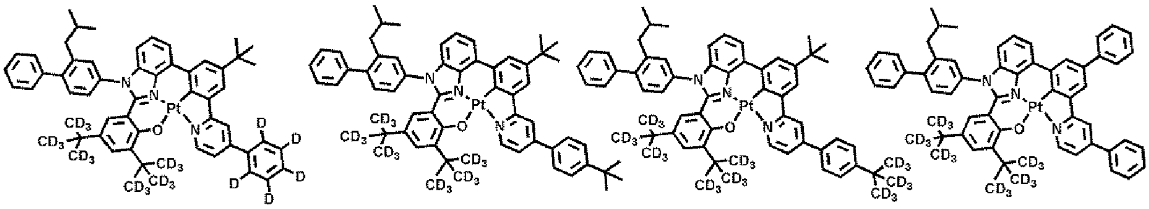

725 726 727 728

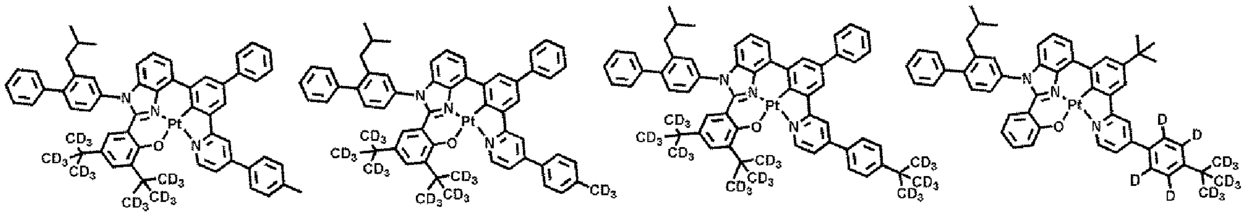

729 730 731 732

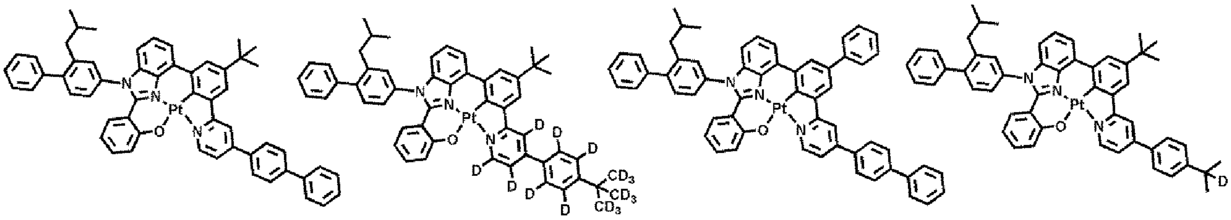

733 734 735 736

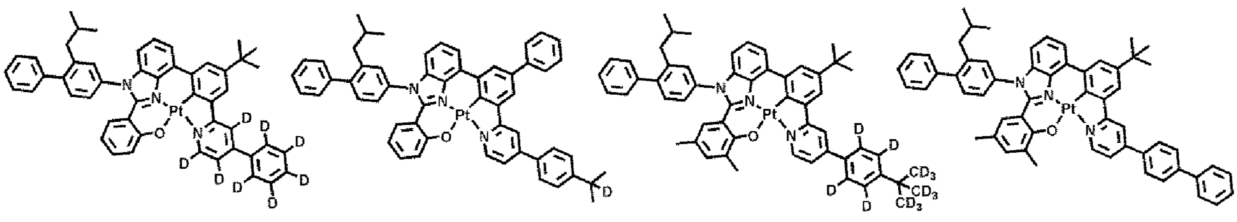

737 738 738 740

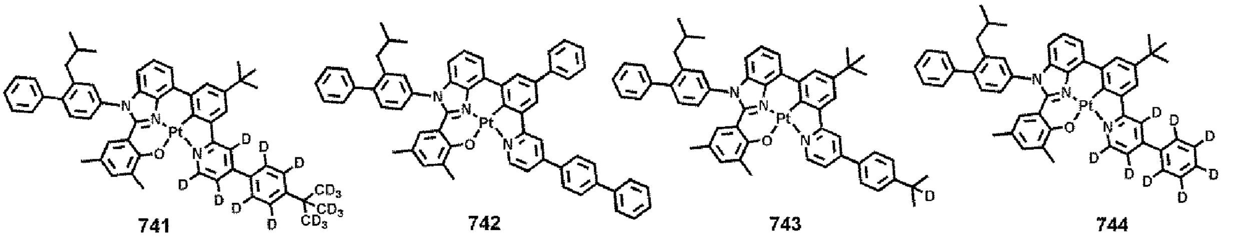

741 742 743 744

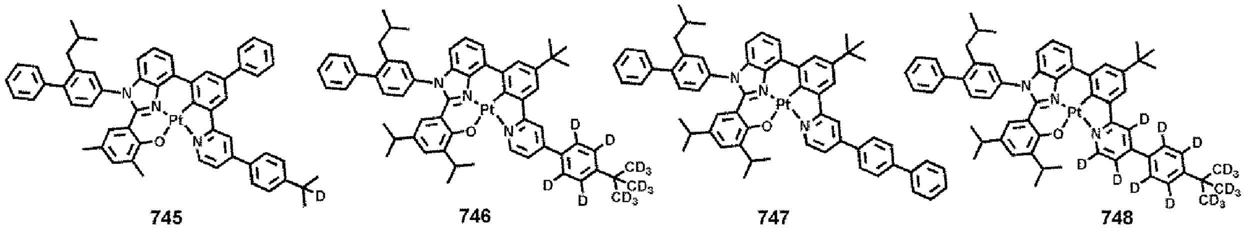

745 746 747 748

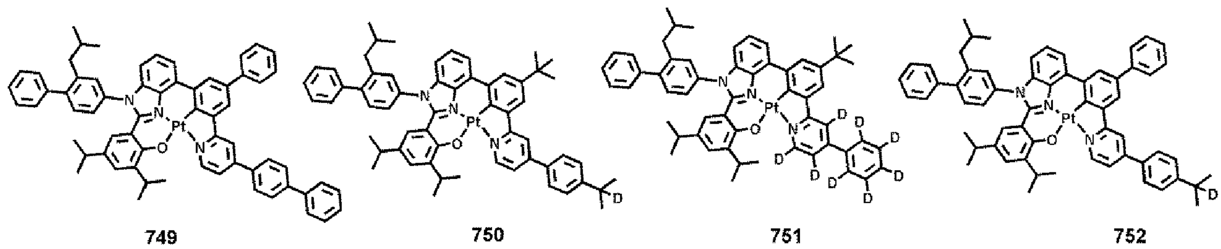

749 750 751 752

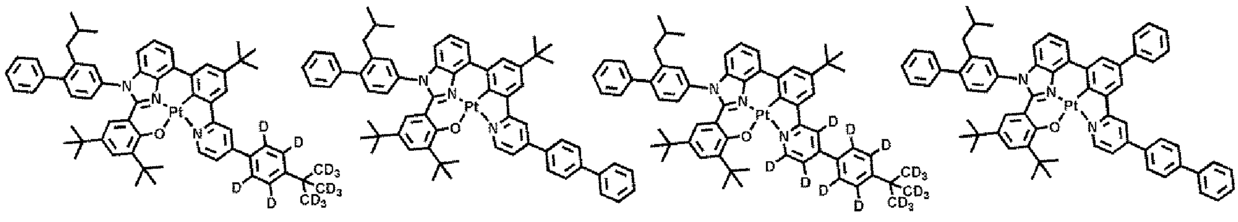

753 754 755 756

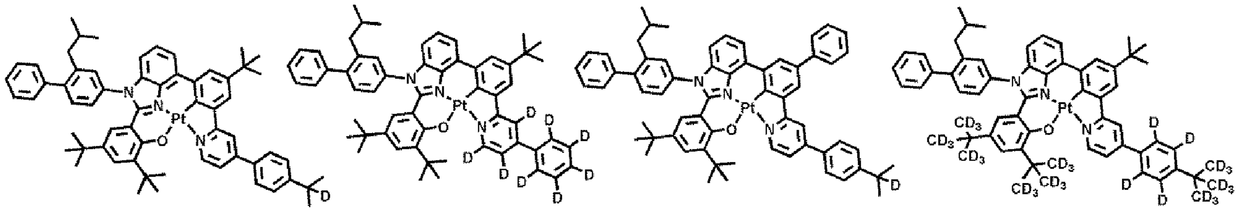

757 758 759 760

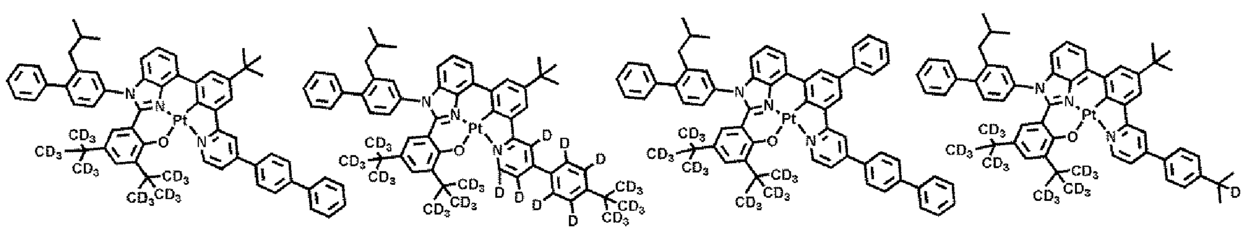

761 762 763 764

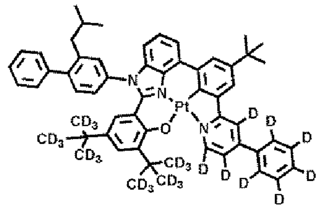

765

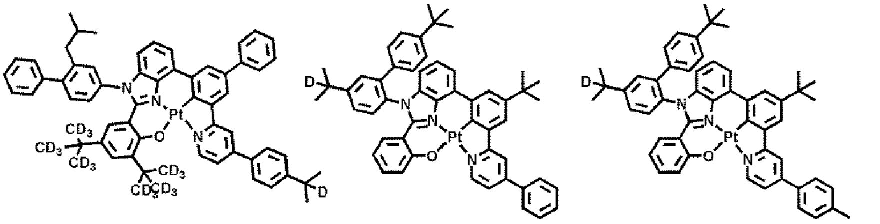

766 767 768

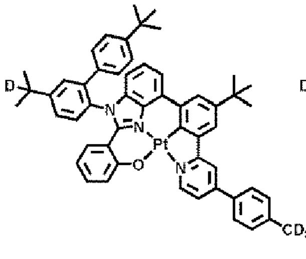
769

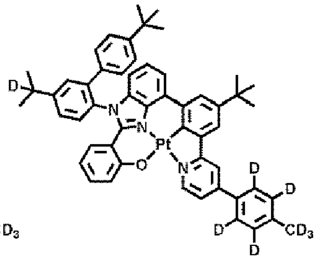
770

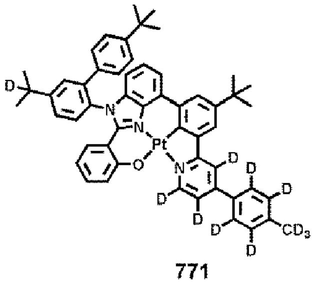
771

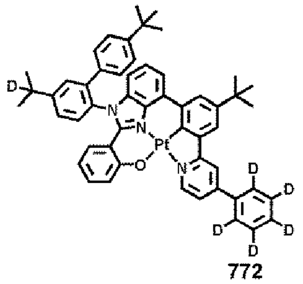
772

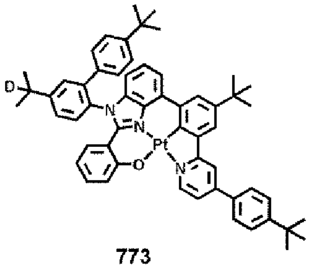
773

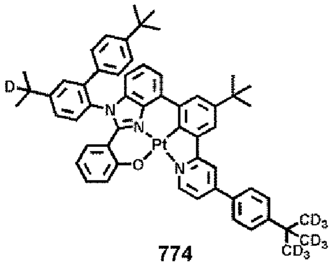
774

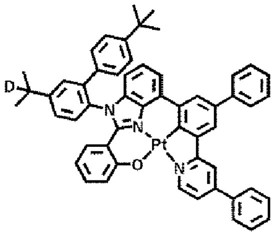
775

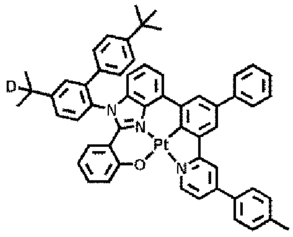
776

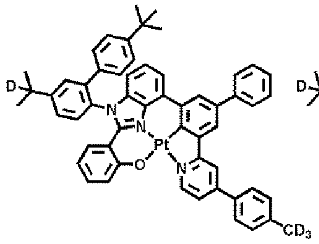
777

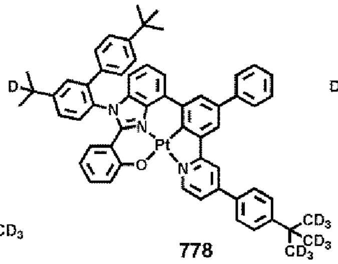
778

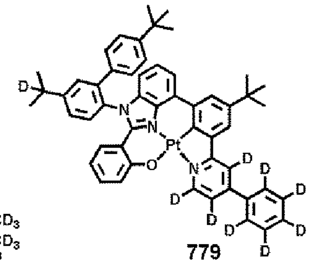
779

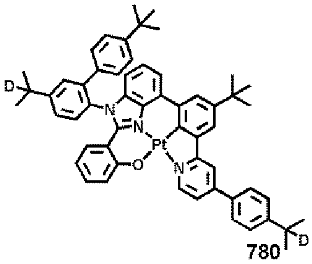
780

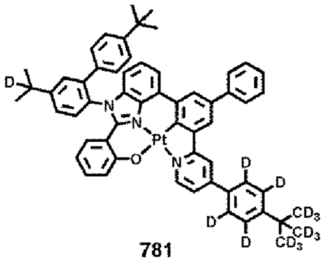
781

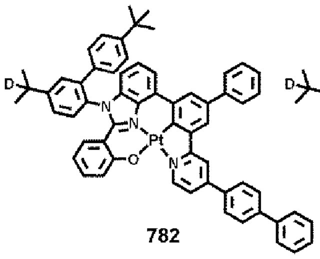
782

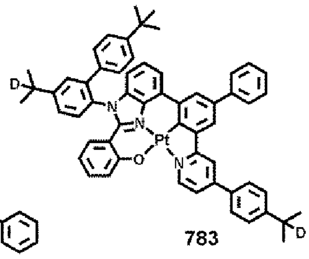
783

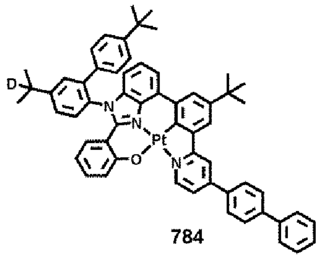
784

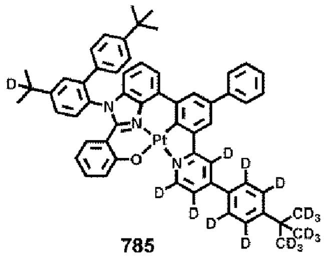
785

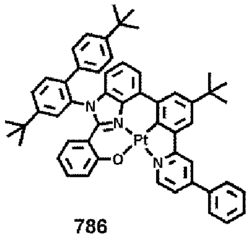
786

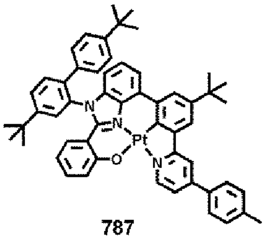
787

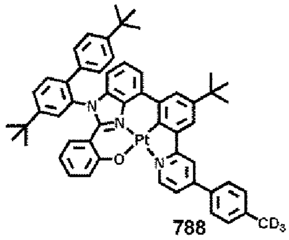
788

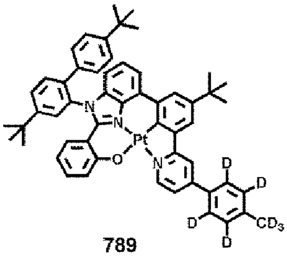
789

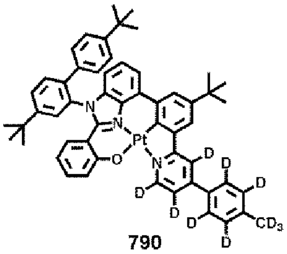
790

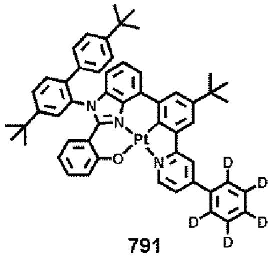
791

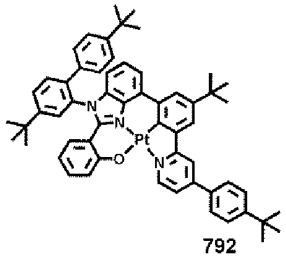
792

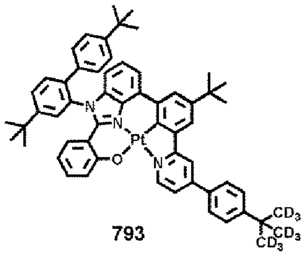
793

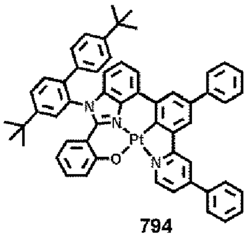
794

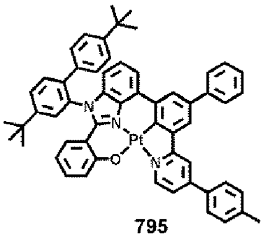
795

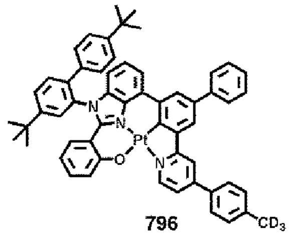
796

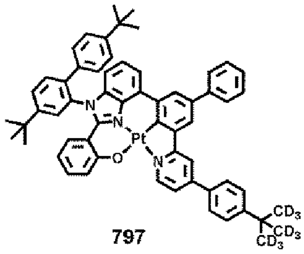
797

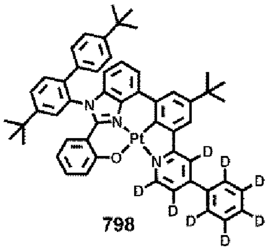
798

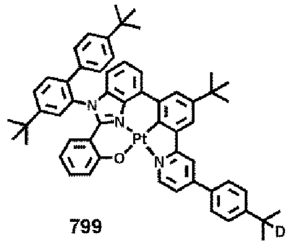
799

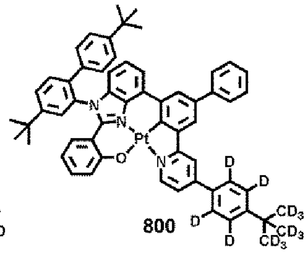
800

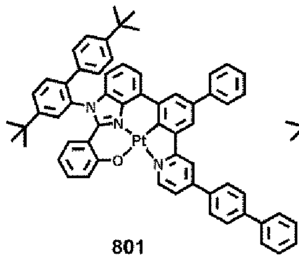
801

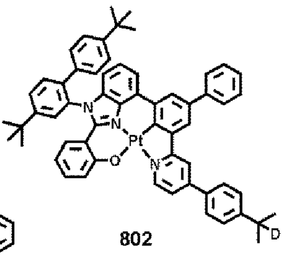
802

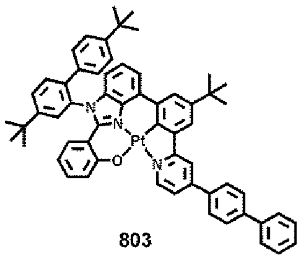
803

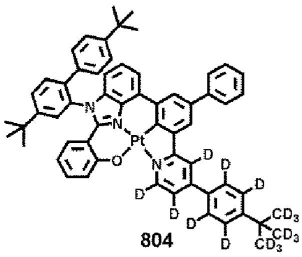
804

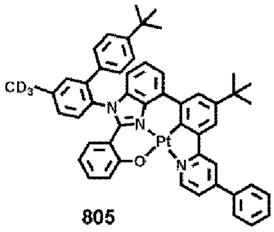
805

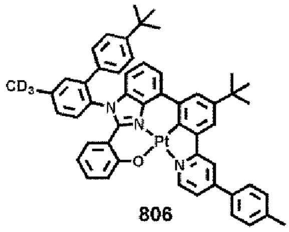
806

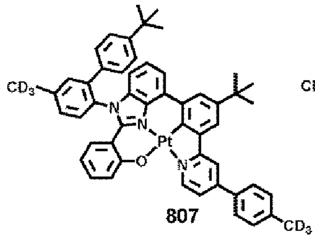
807

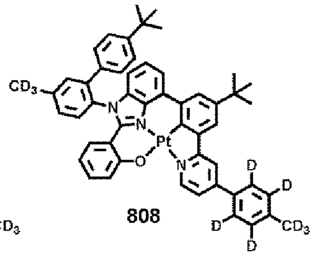
808

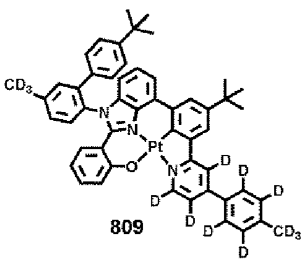
809

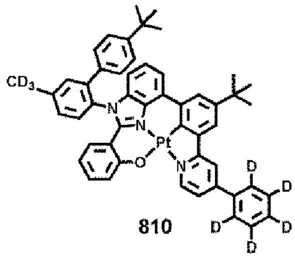
810

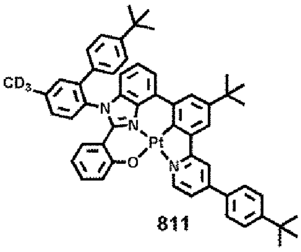
811

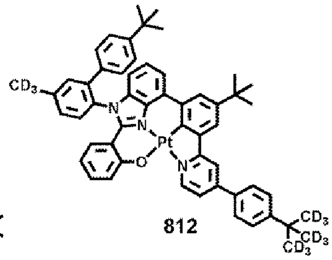
812

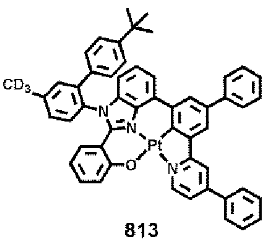
813

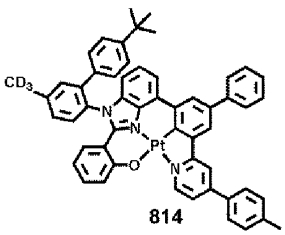
814

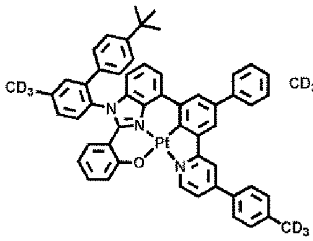
815

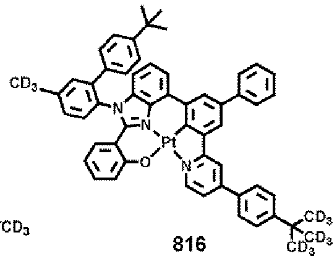
816

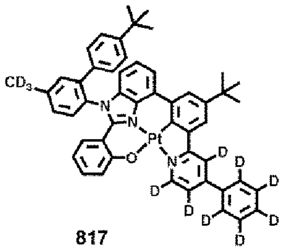

817

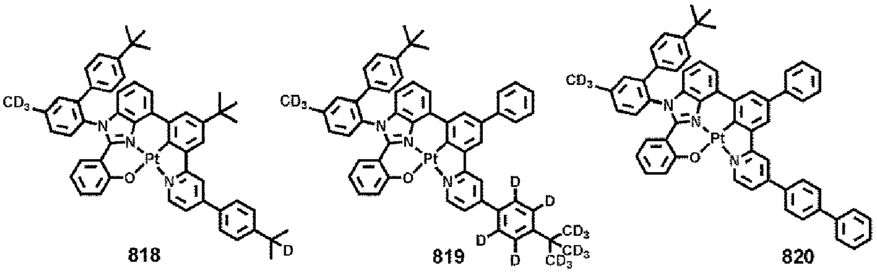

818

819

820

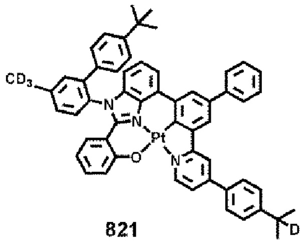

821

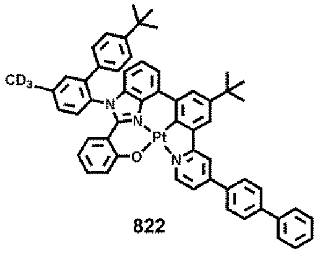

822

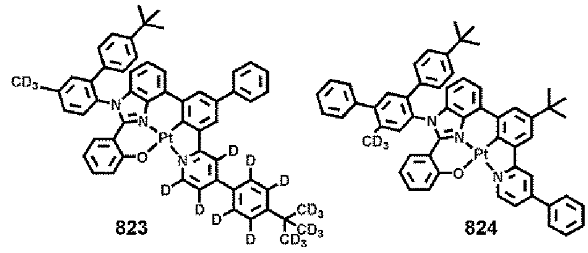

823

824

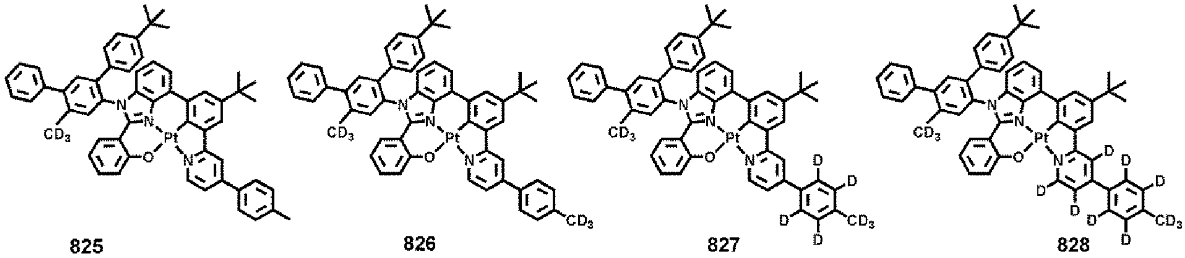

825

826

827

828

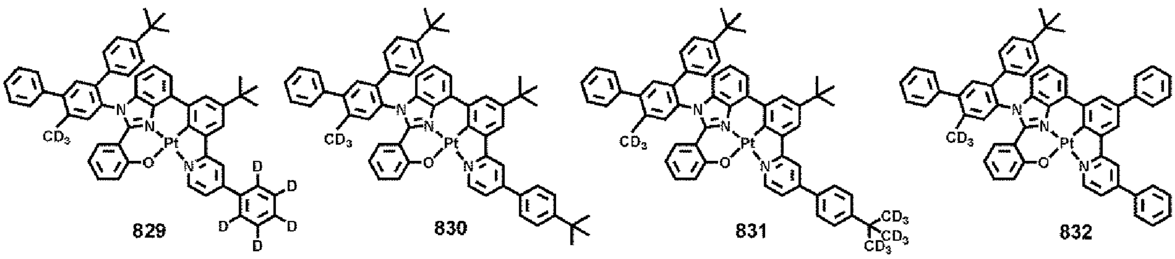

829

830

831

832

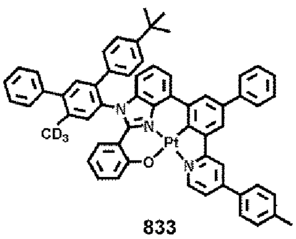

833

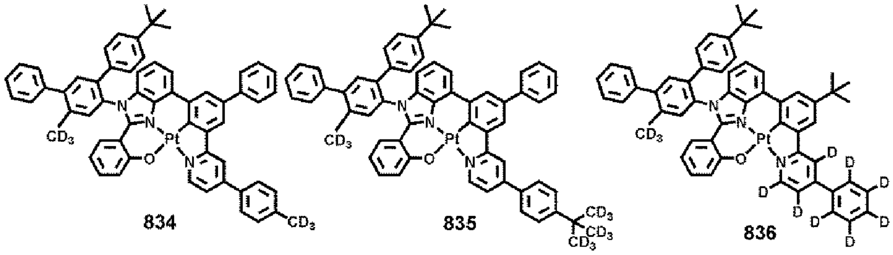

834

835

836

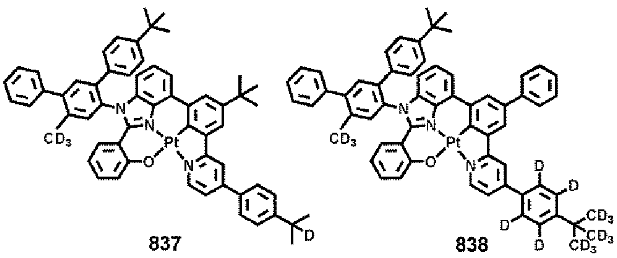

837

838

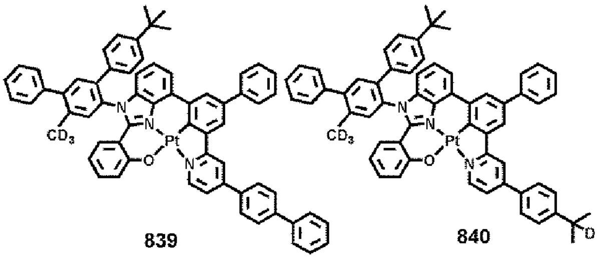

839

840

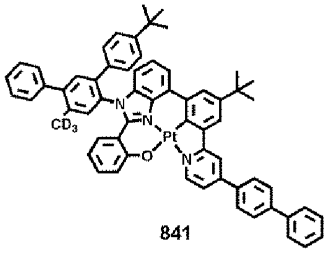
841

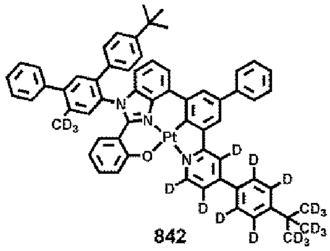
842

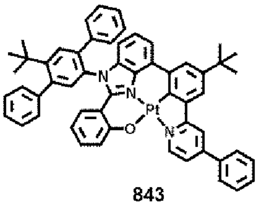
843

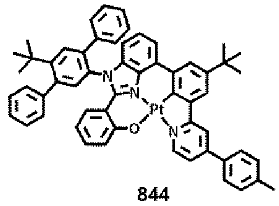
844

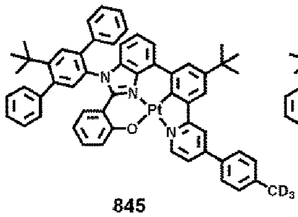
845

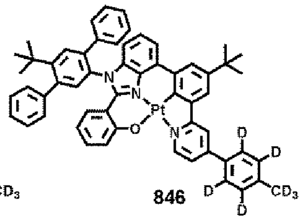
846

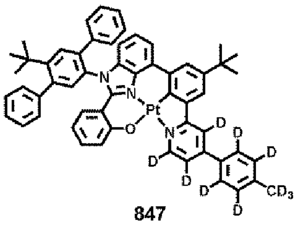
847

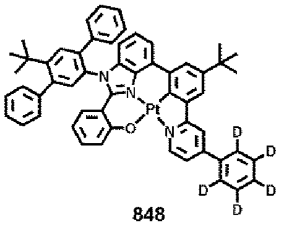
848

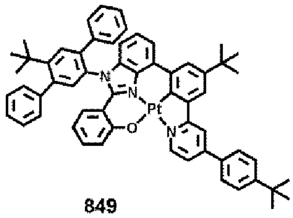
849

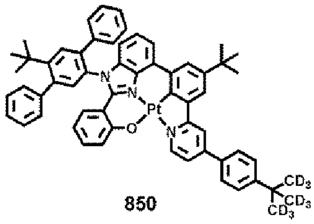
850

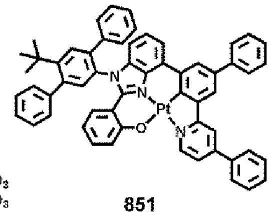
851

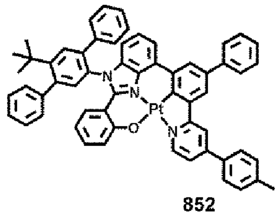
852

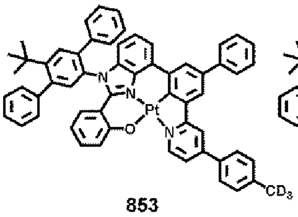
853

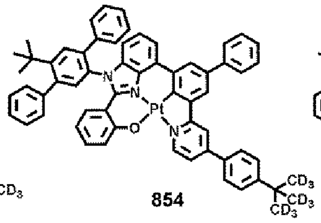
854

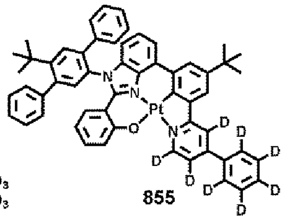
855

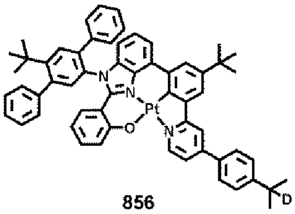
856

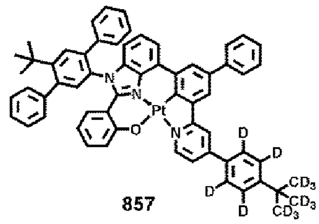
857

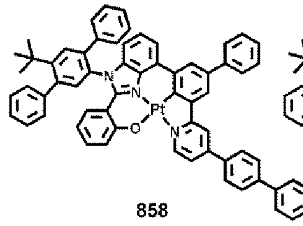
858

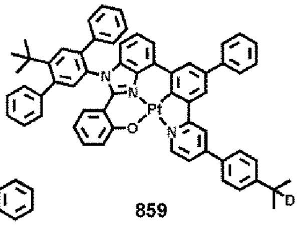
859

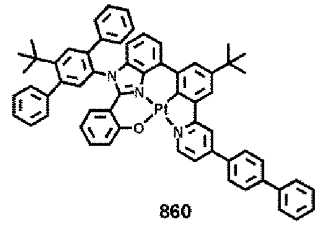
860

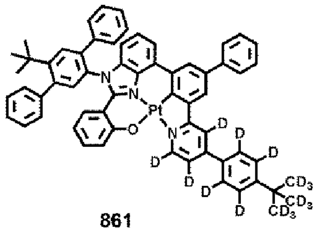
861

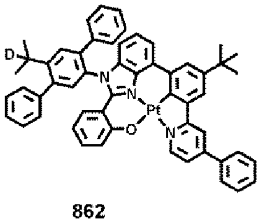
862

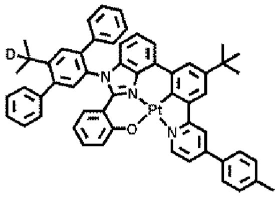
863

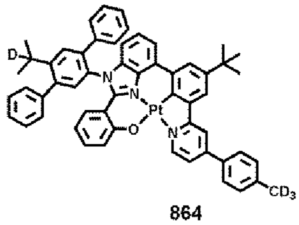
864

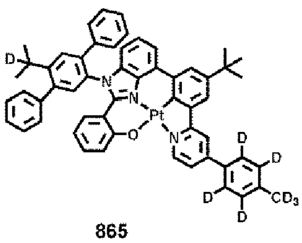
865

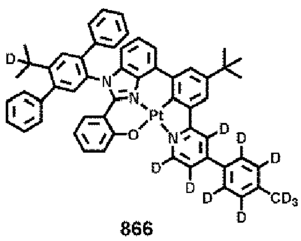
866

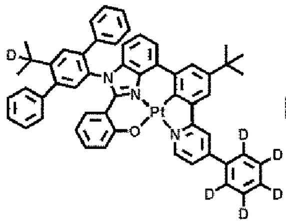
867

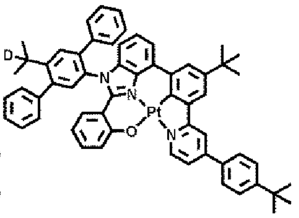
868

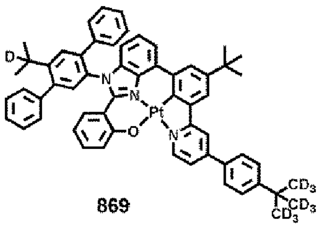
869

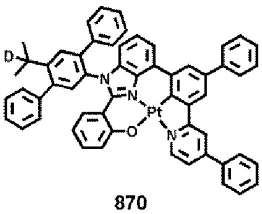
870

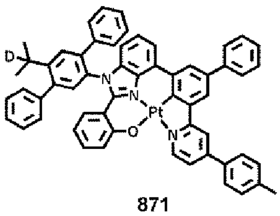
871

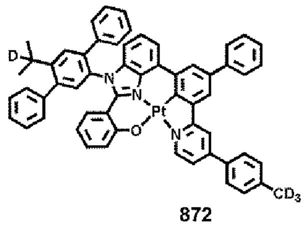
872

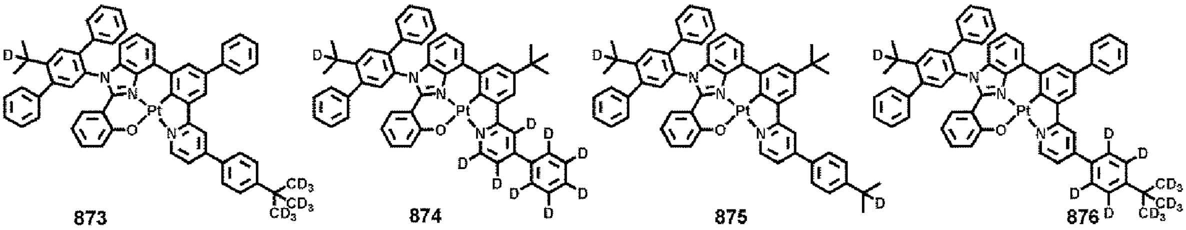
873 874 875 876

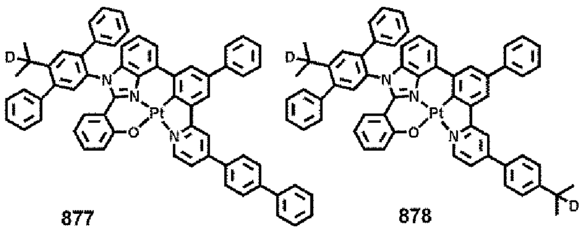
877 878

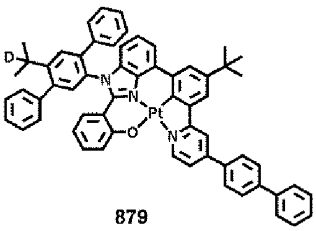
879

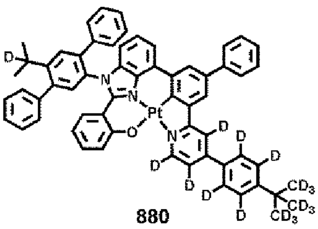
880

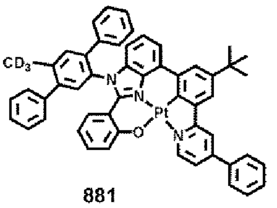
881

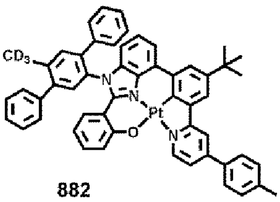
882

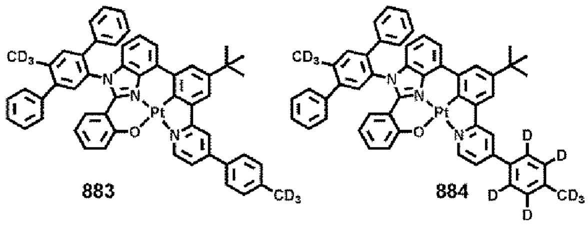
883 884

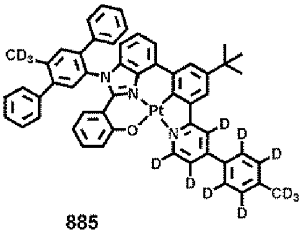
885

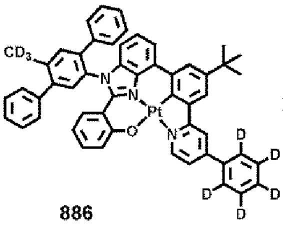
886

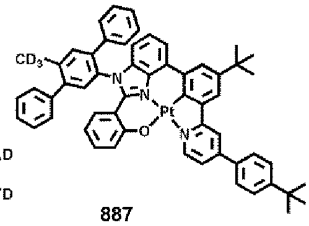
887

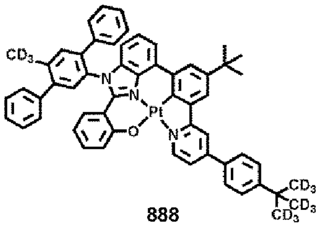
888

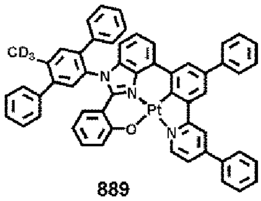
889

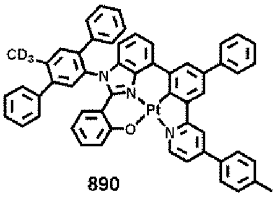
890

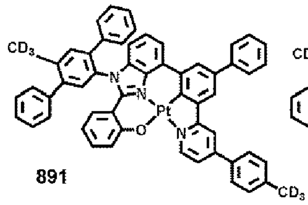
891

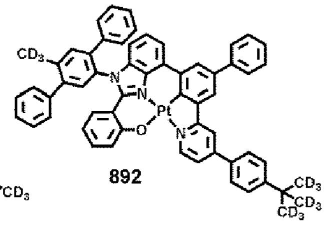
892

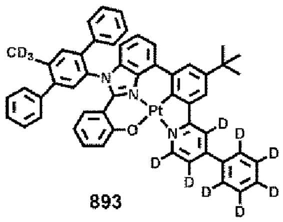
893

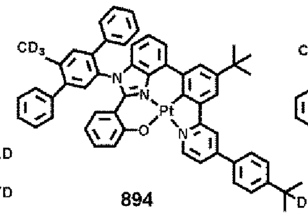
894

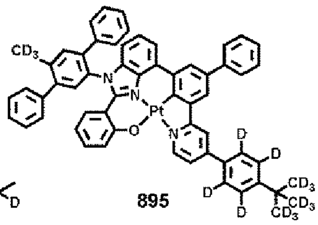
895

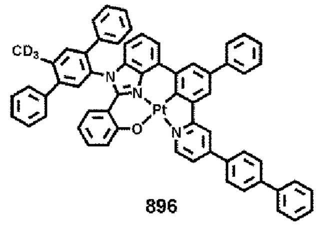
896

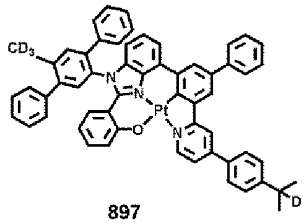
897

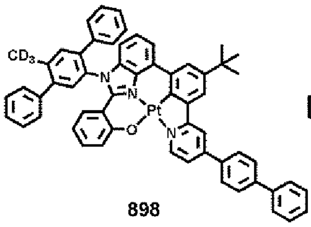
898

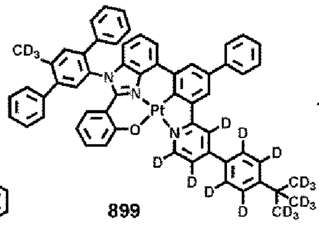
899

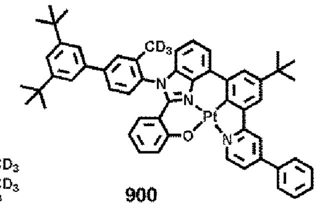
900

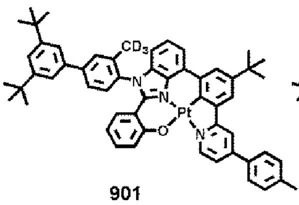
901

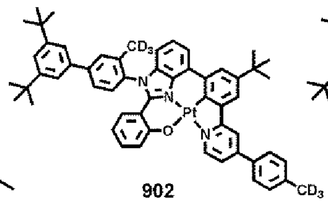
902

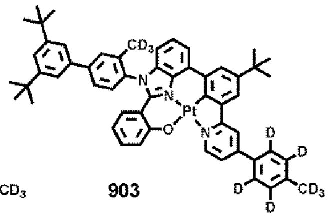
903

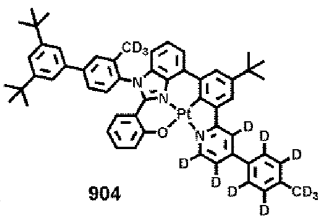
904

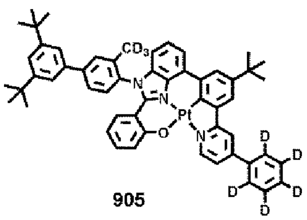
905

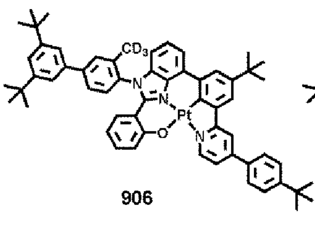
906

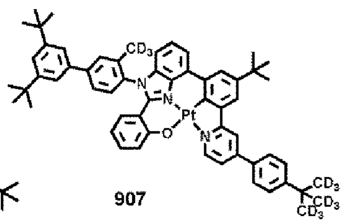
907

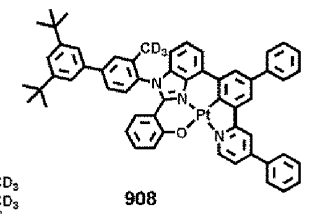
908

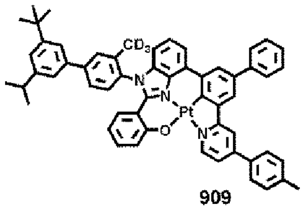
909

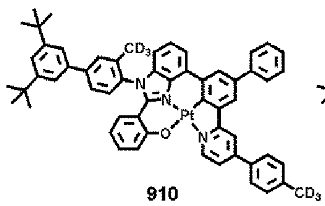
910

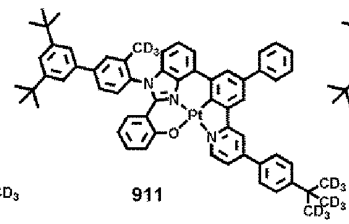
911

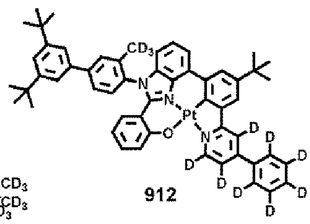
912

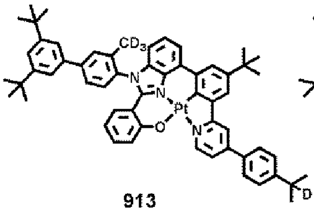
913
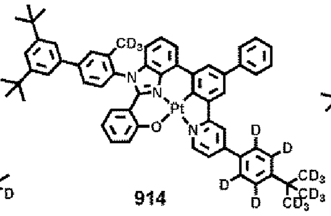
914
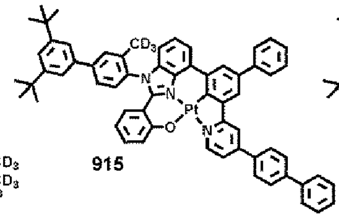
915
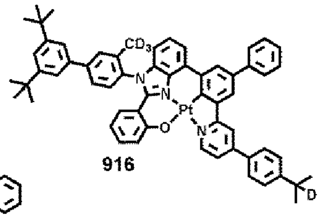
916

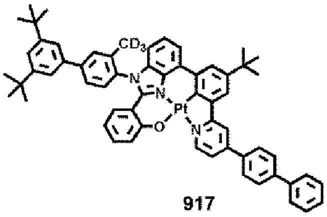
917
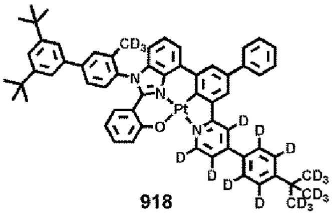
918
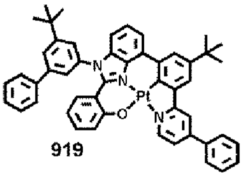
919
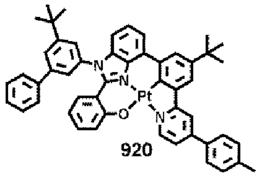
920

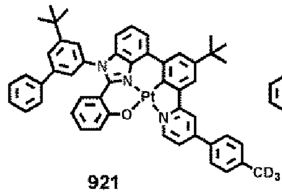
921
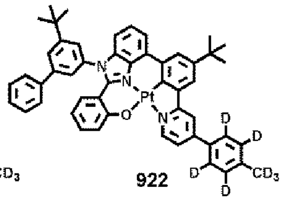
922
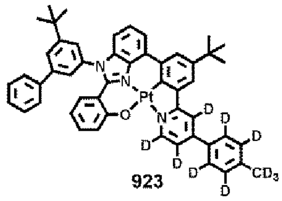
923
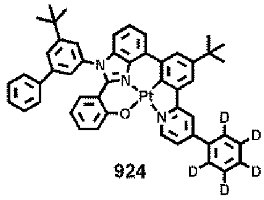
924

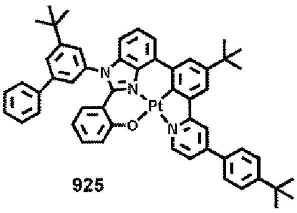
925
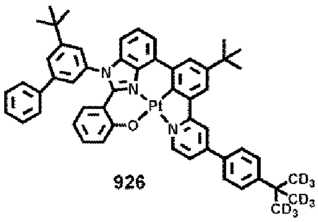
926
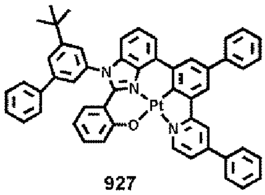
927
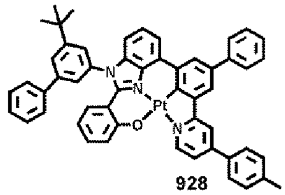
928

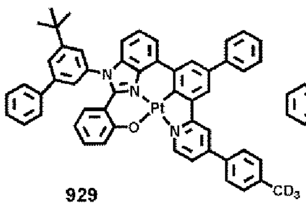
929
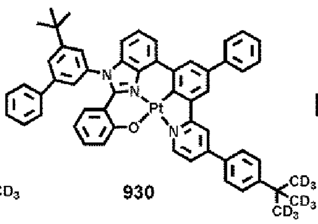
930
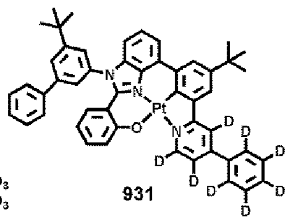
931
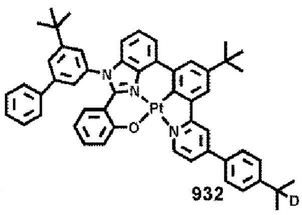
932

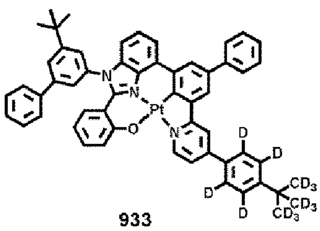
933
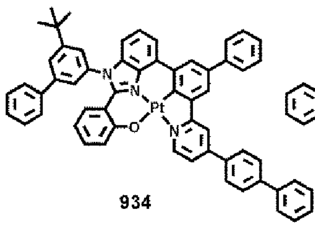
934
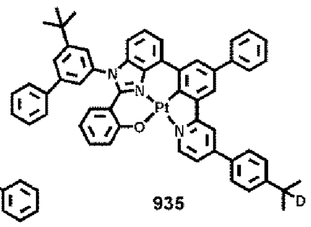
935
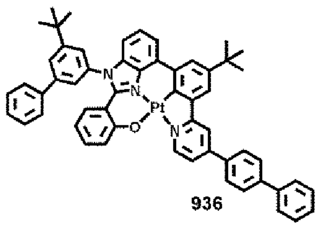
936

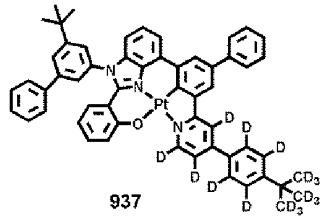
937

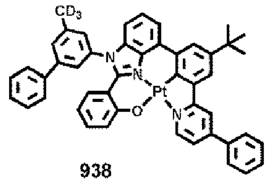
938

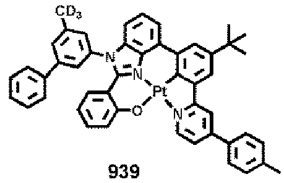
939

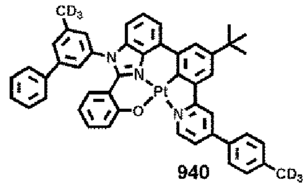
940

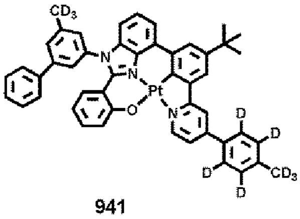
941

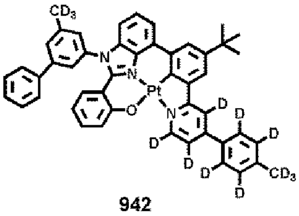
942

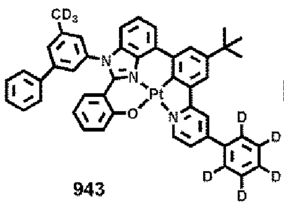
943

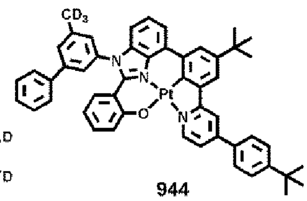
944

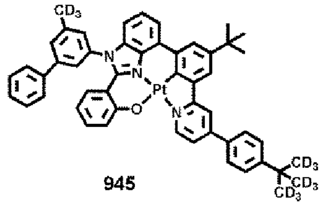
945

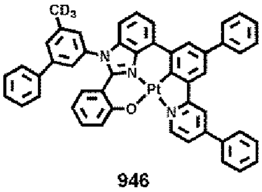
946

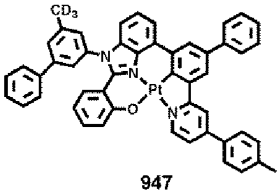
947

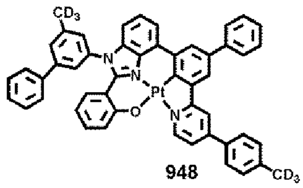
948

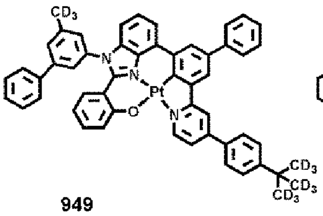
949

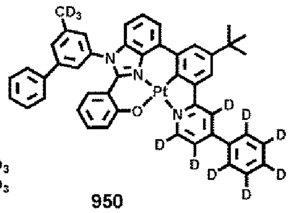
950

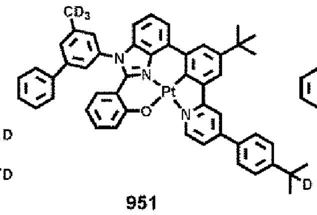
951

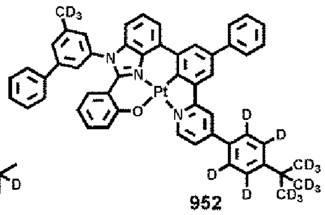
952

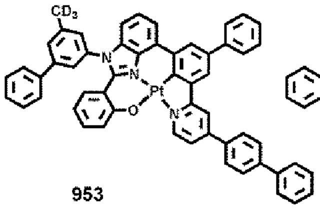
953

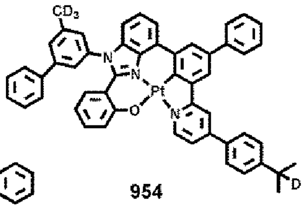
954

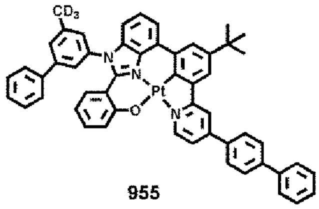
955

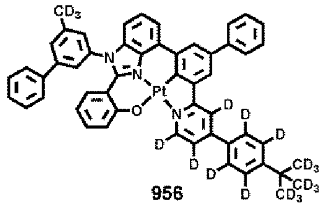
956

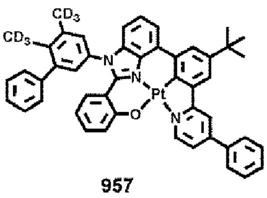
957

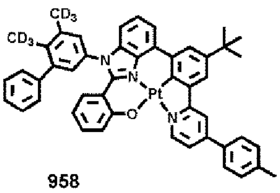
958

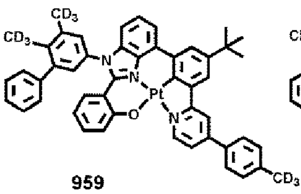
959

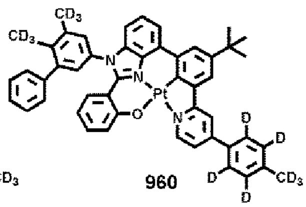
960

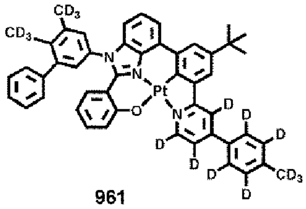
961
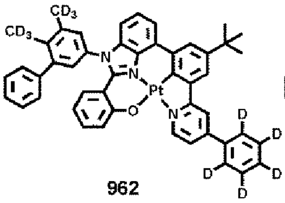
962
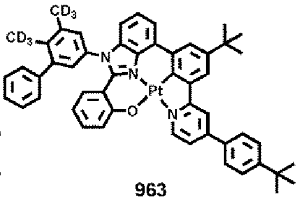
963
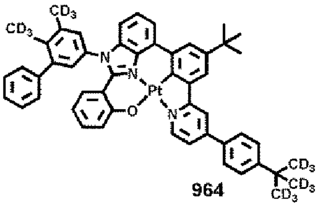
964

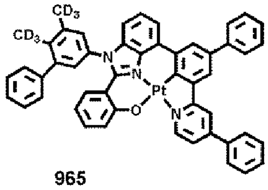
965
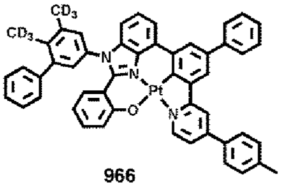
966
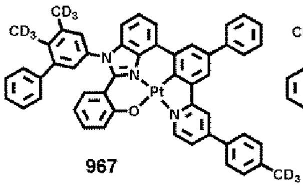
967
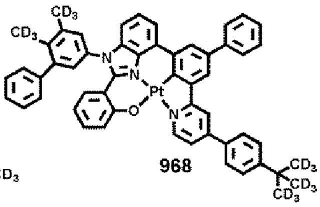
968

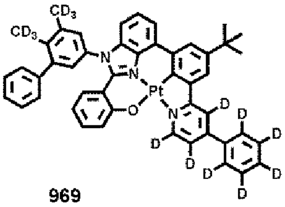
969
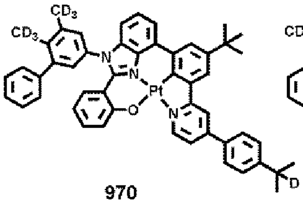
970
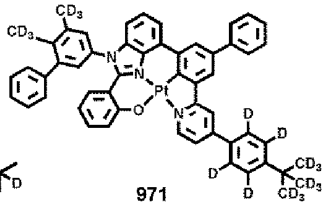
971
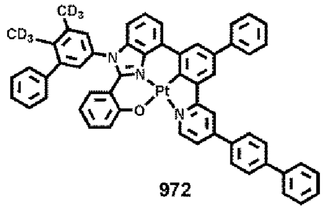
972

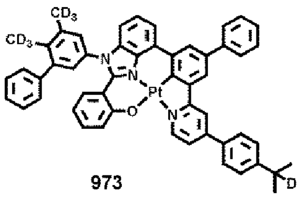
973
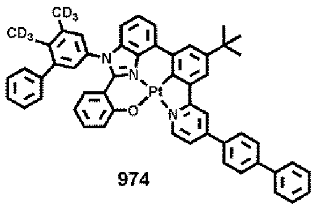
974
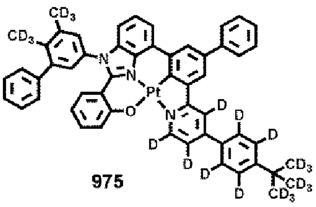
975
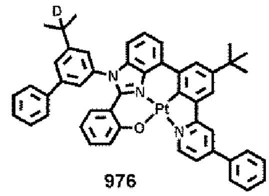
976

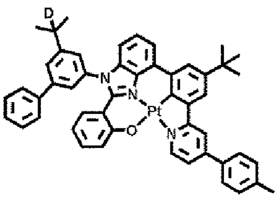
977
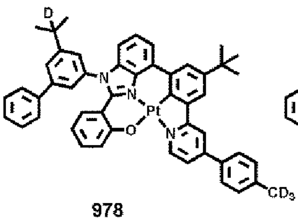
978
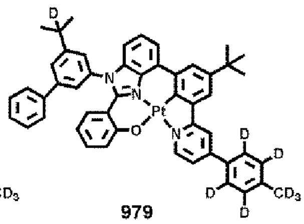
979
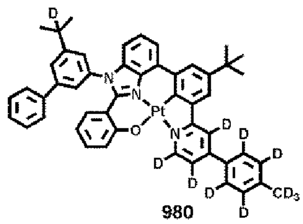
980

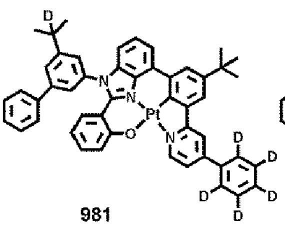
981
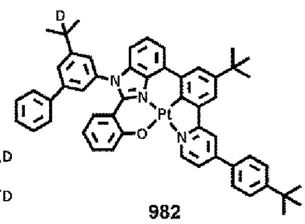
982
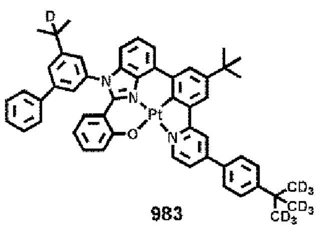
983
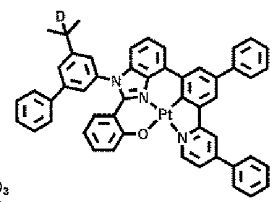
984

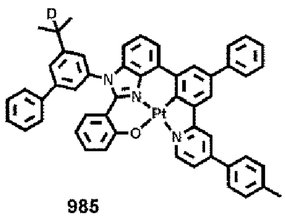
985

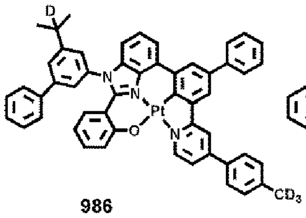
986

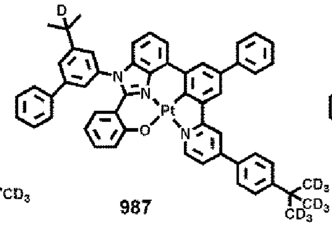
987

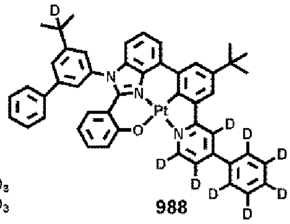
988

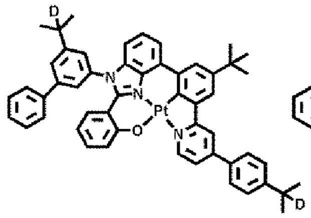
989

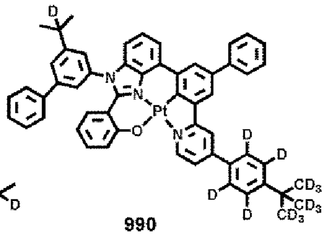
990

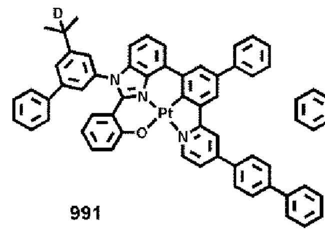
991

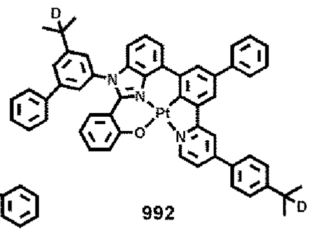
992

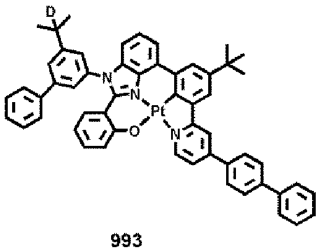
993

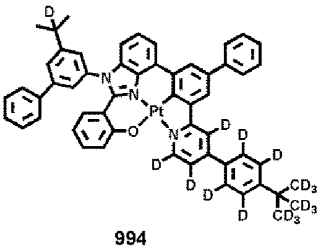
994

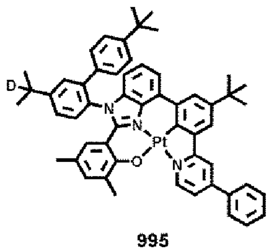
995

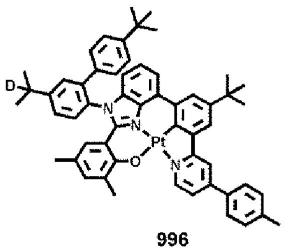
996

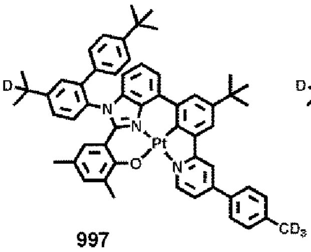
997

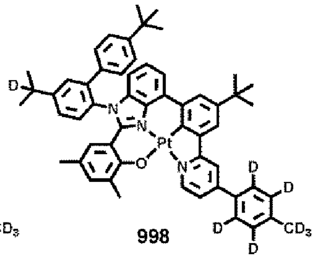
998

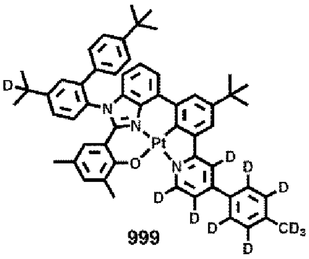
999

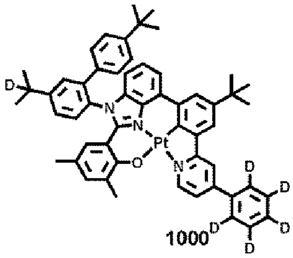
1000

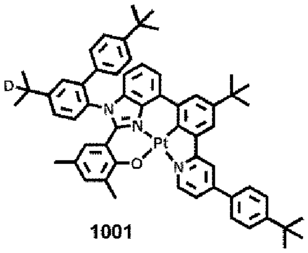
1001

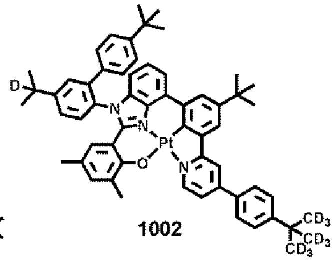
1002

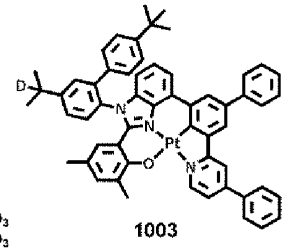
1003

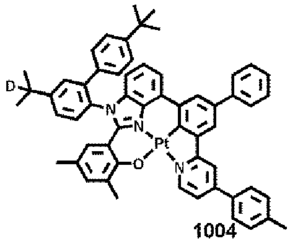
1004

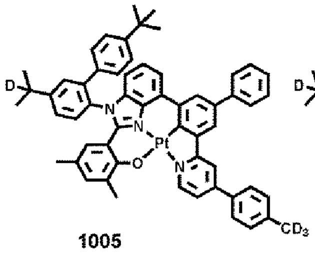
1005

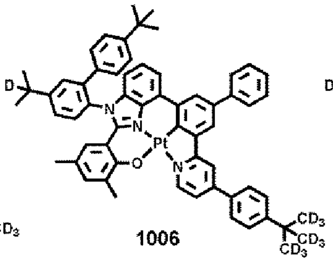
1006

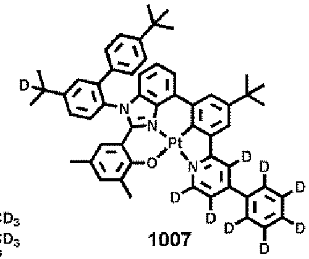
1007

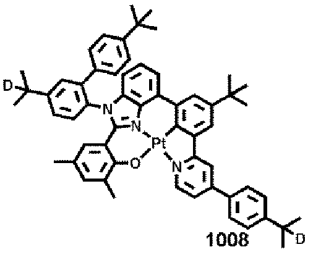
1008

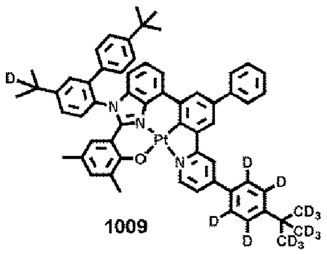
1009

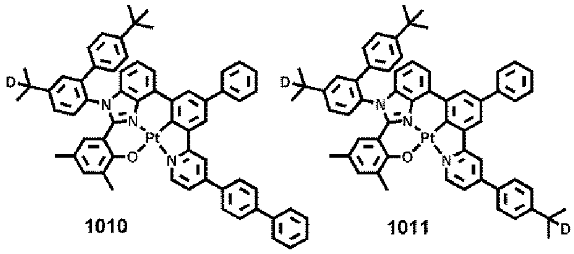
1010

1011

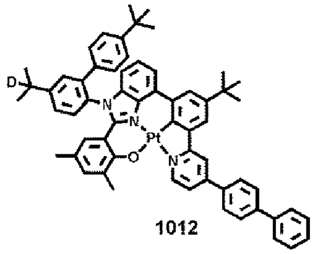
1012

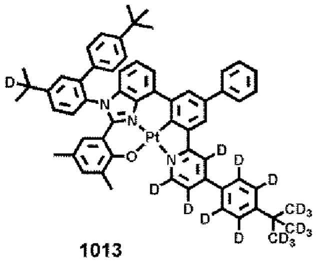
1013

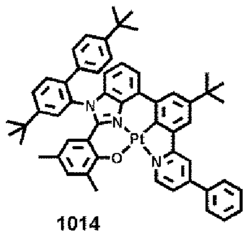
1014

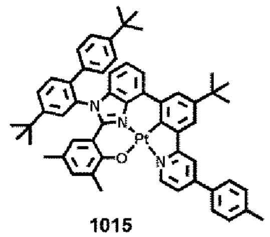
1015

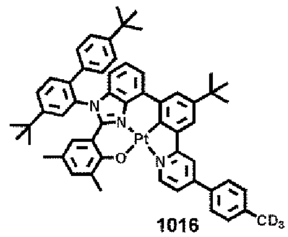
1016

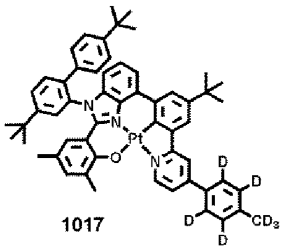
1017

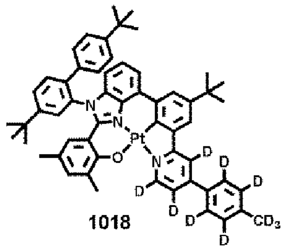
1018

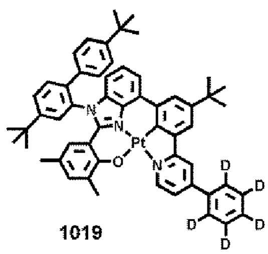
1019

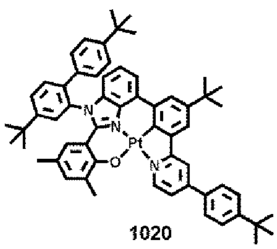
1020

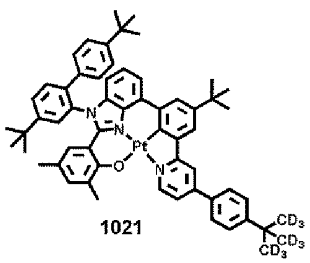
1021

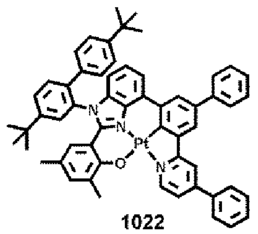
1022

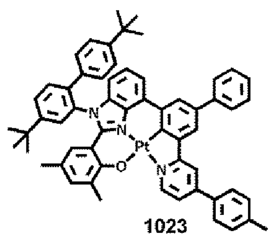
1023

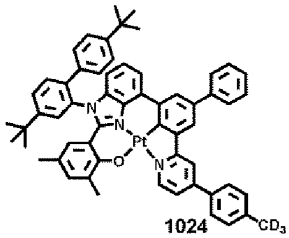
1024

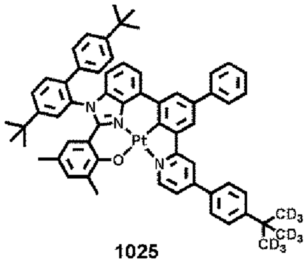
1025

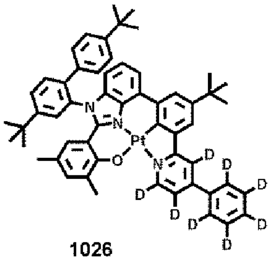
1026

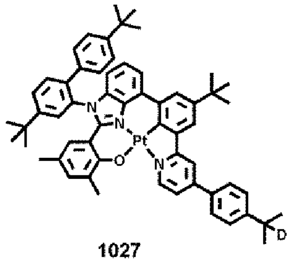
1027

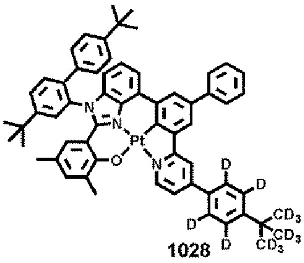
1028

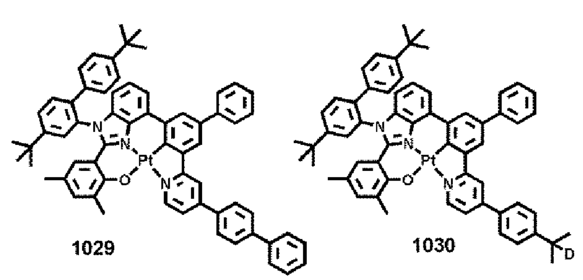
1029

1030

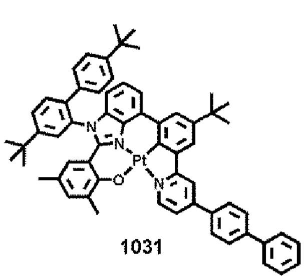
1031

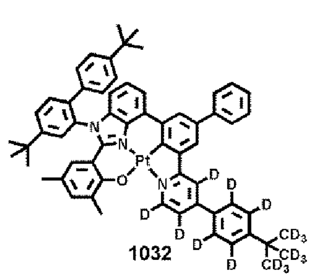
1032

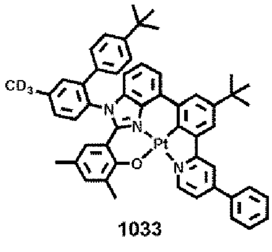
1033

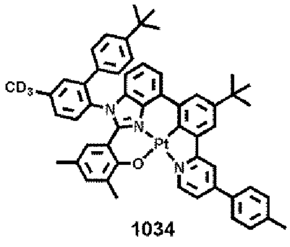
1034

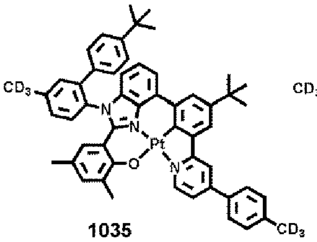
1035

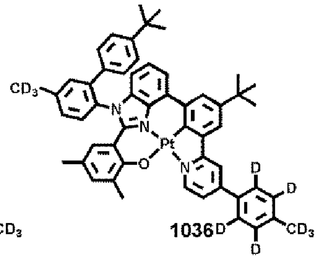
1036

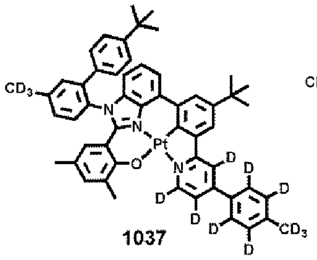
1037

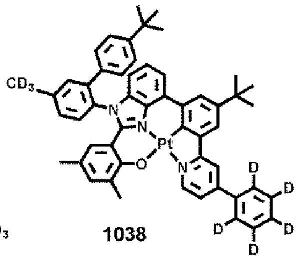
1038

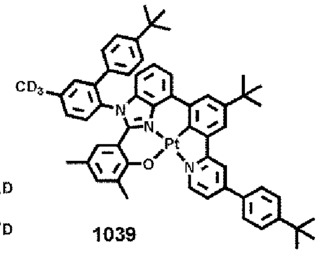
1039

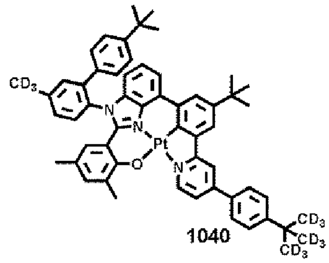
1040

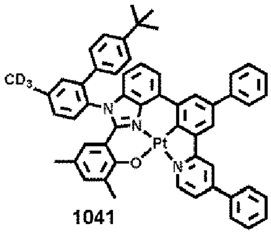
1041

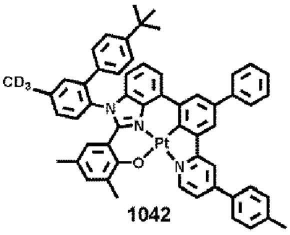
1042

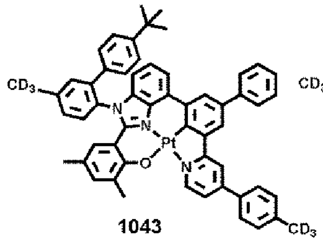
1043

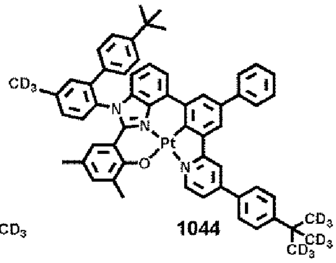
1044

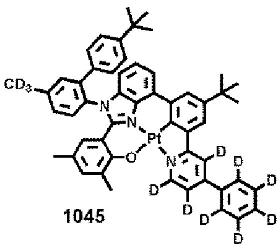
1045

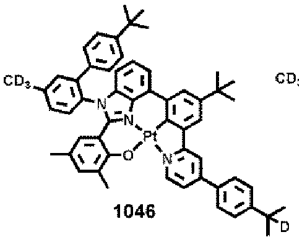
1046

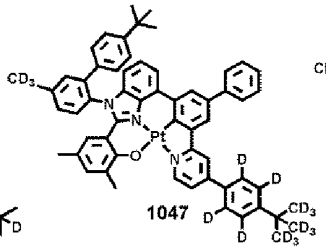
1047

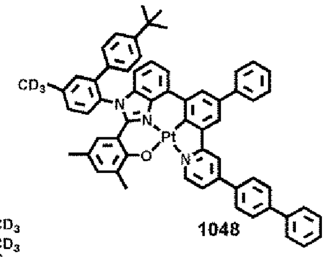
1048

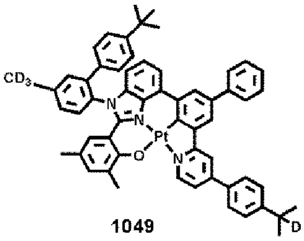
1049

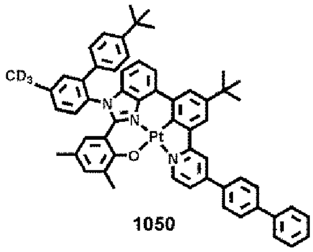
1050

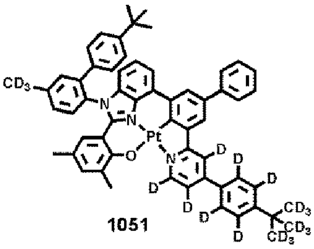
1051

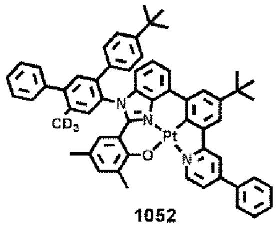
1052

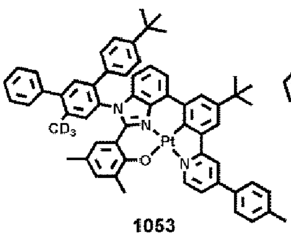
1053

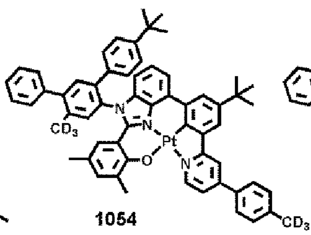
1054

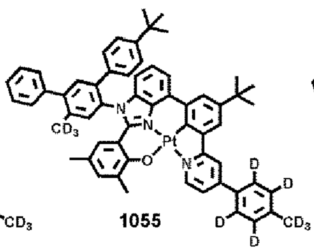
1055

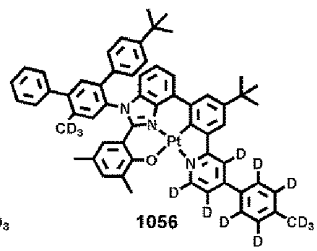
1056

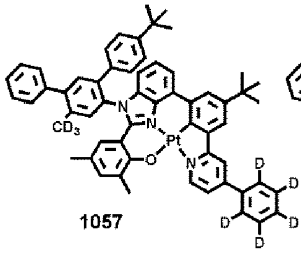

1057

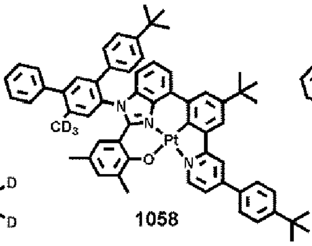

1058

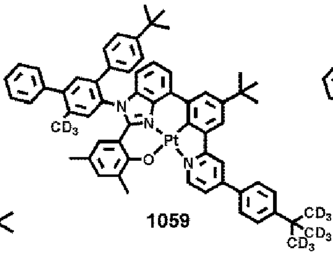

1059

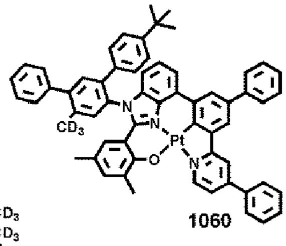

1060

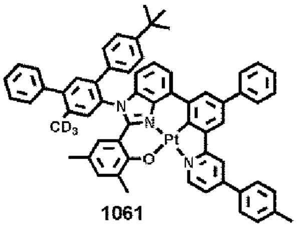

1061

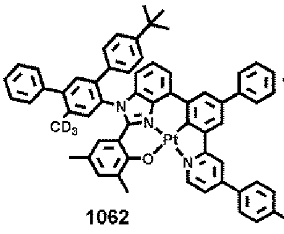

1062

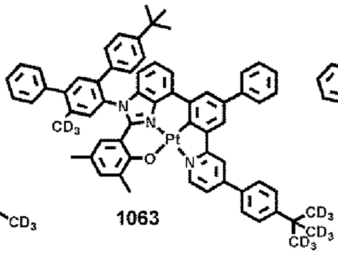

1063

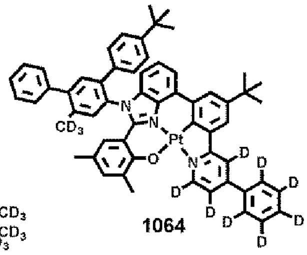

1064

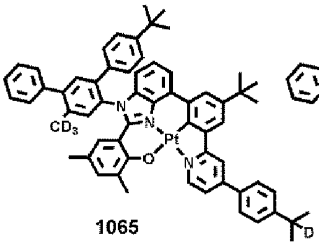

1065

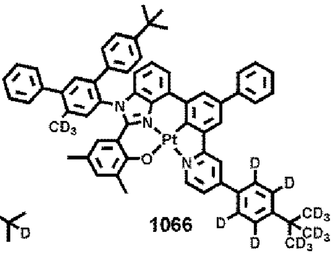

1066

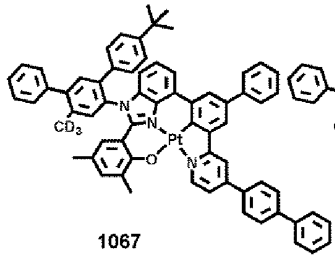

1067

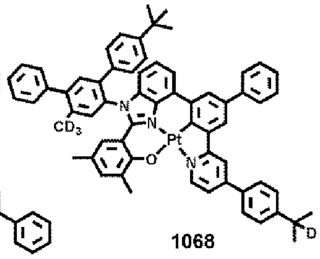

1068

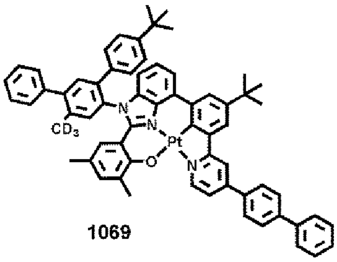

1069

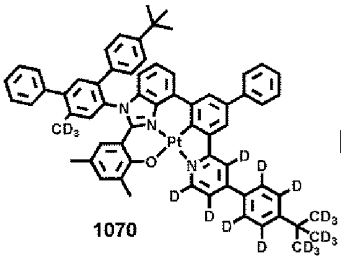

1070

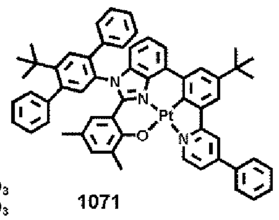

1071

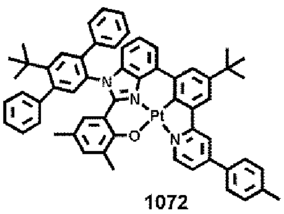

1072

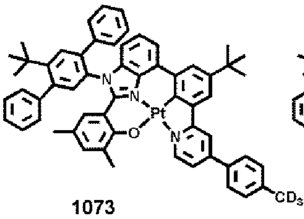

1073

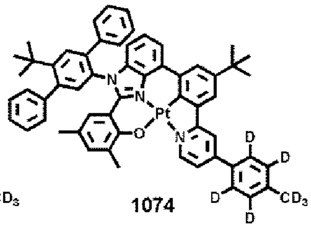

1074

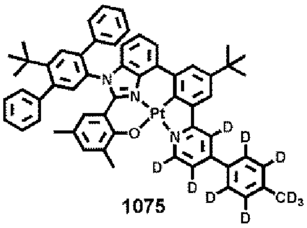

1075

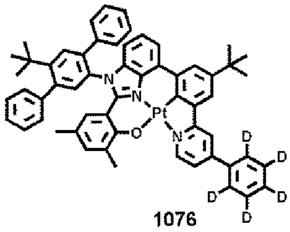

1076

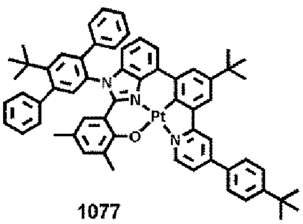

1077

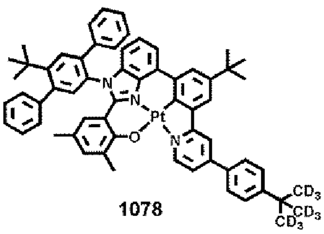

1078

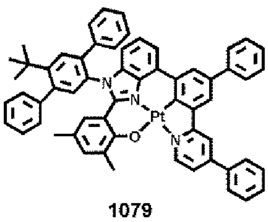

1079

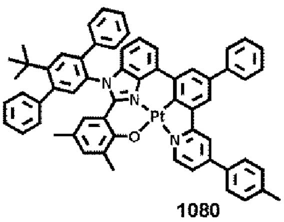

1080

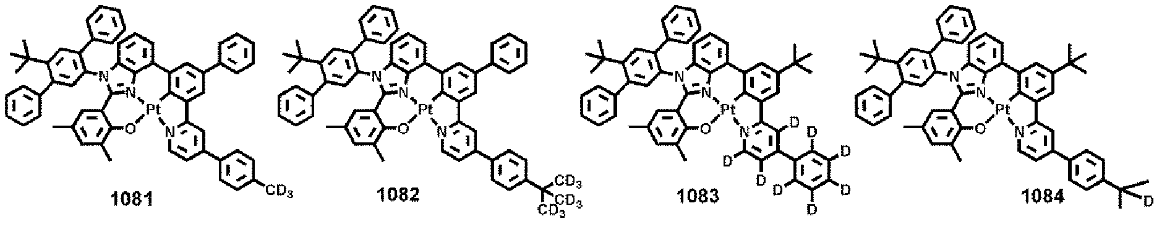

1081 1082 1083 1084

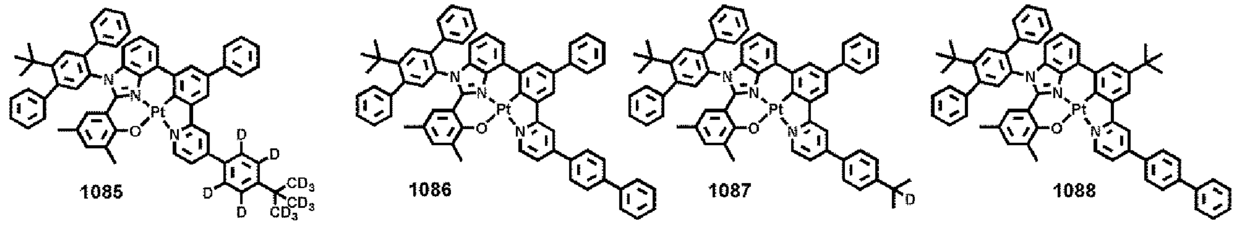

1085 1086 1087 1088

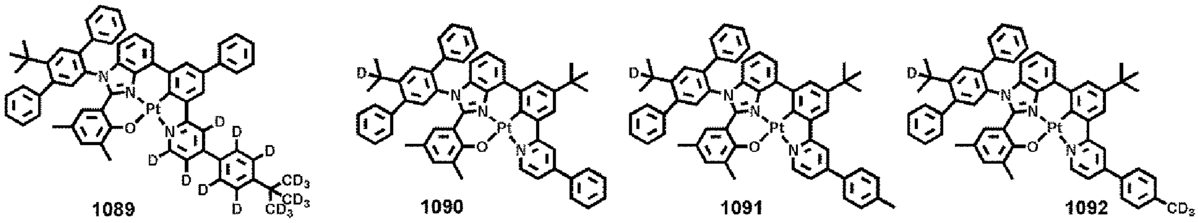

1089 1090 1091 1092

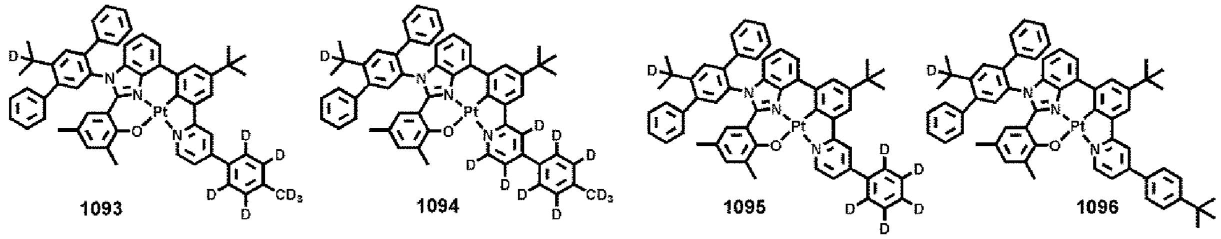

1093 1094 1095 1096

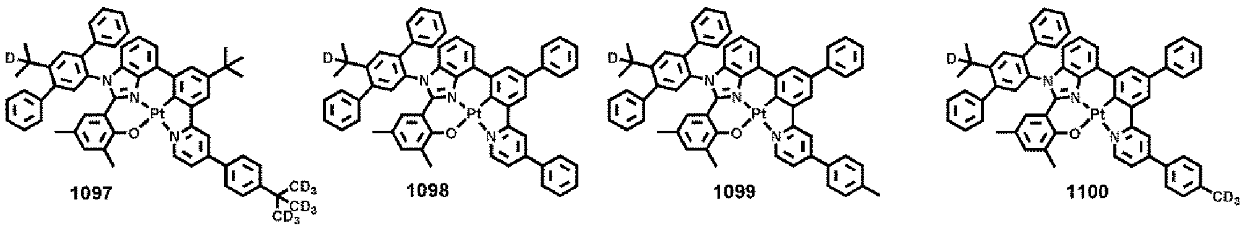

1097 1098 1099 1100

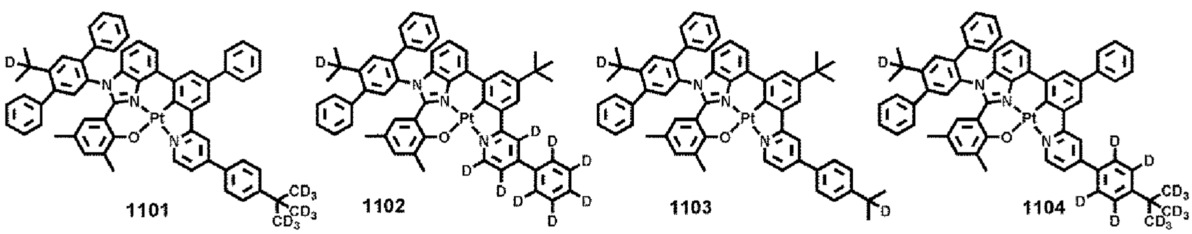

1101 1102 1103 1104

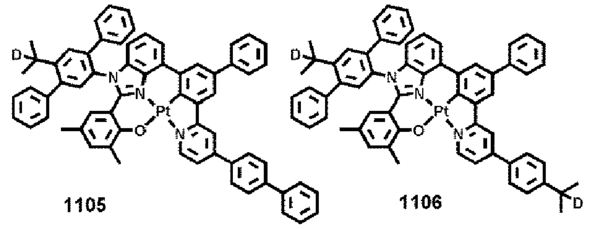

1105

1106

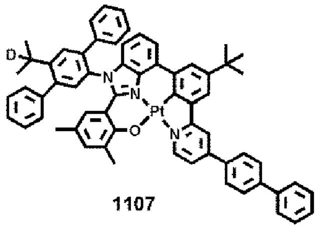

1107

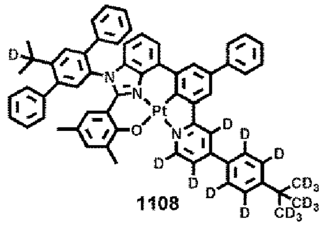

1108

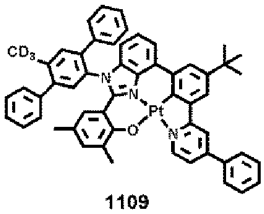

1109

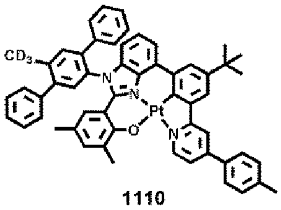

1110

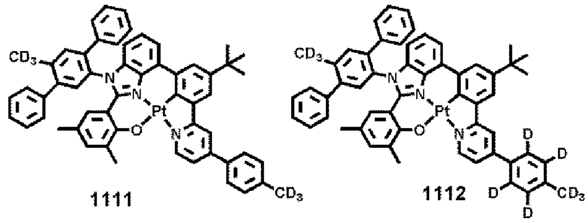

1111

1112

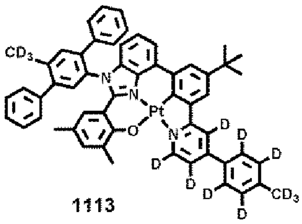

1113

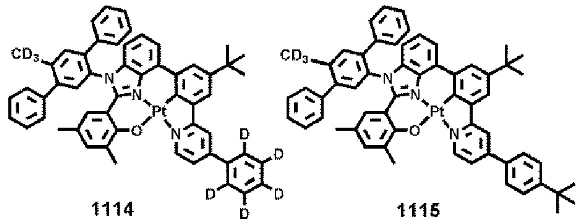

1114

1115

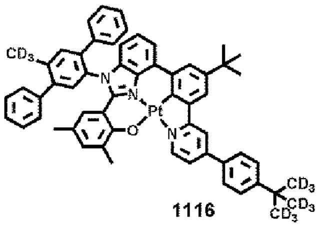

1116

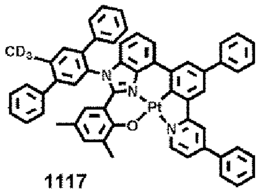

1117

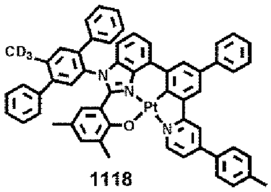

1118

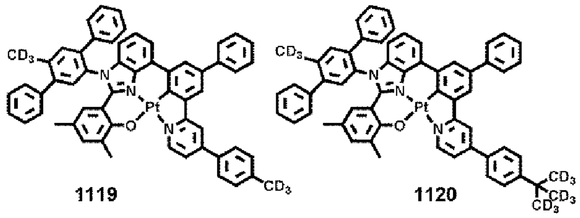

1119

1120

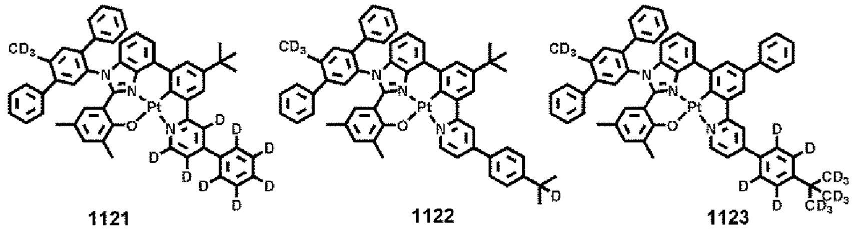

1121

1122

1123

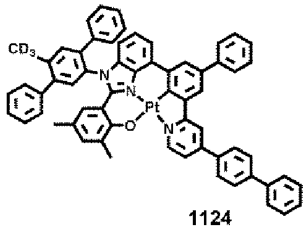

1124

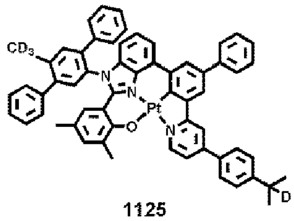

1125

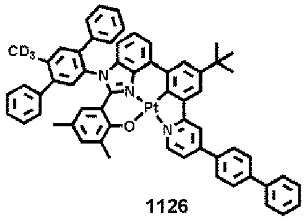

1126

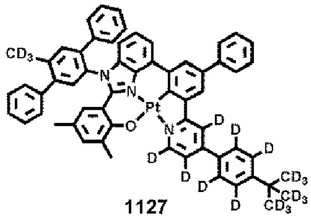

1127

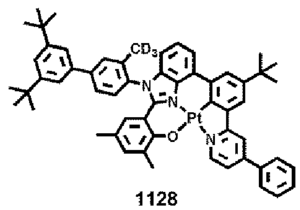

1128

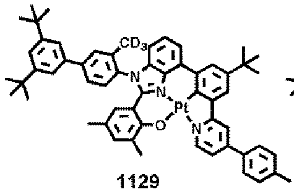

1129

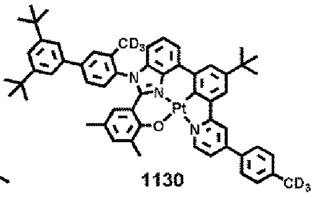

1130

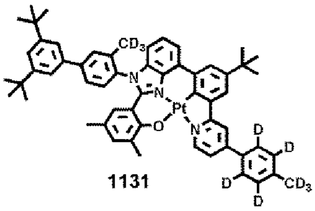

1131

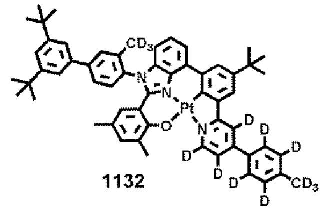

1132

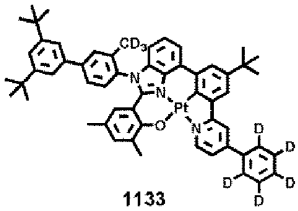

1133

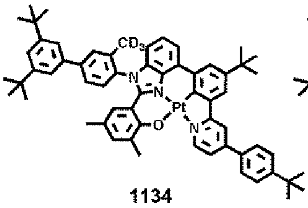

1134

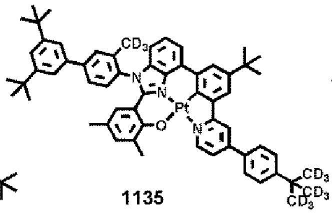

1135

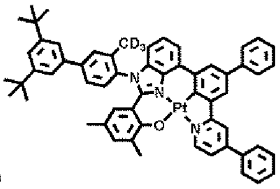

1136

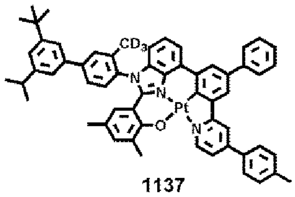

1137

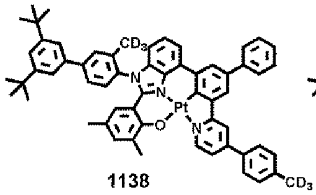

1138

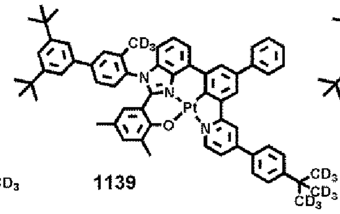

1139

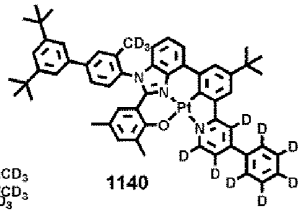

1140

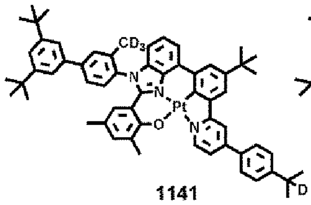

1141

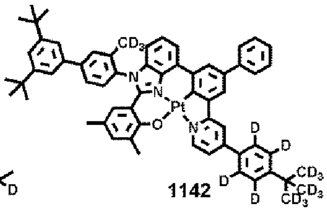

1142

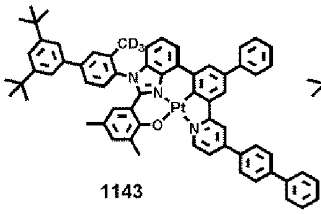

1143

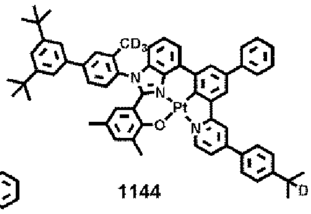

1144

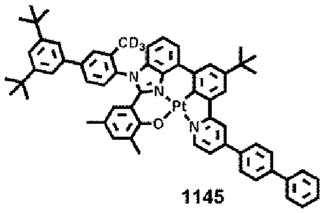

1145

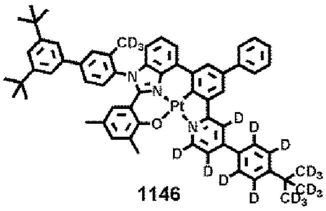

1146

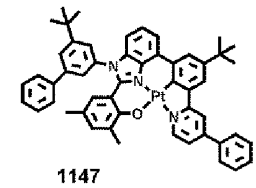

1147

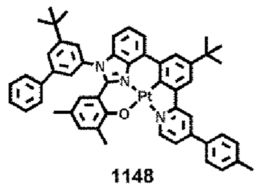

1148

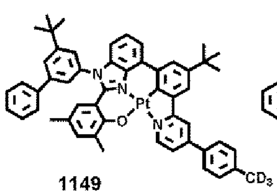

1149

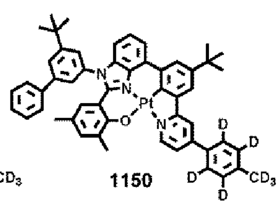

1150

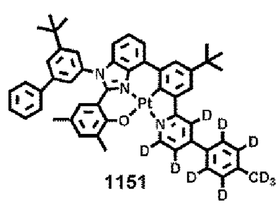

1151

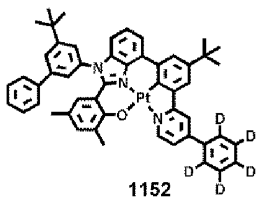

1152

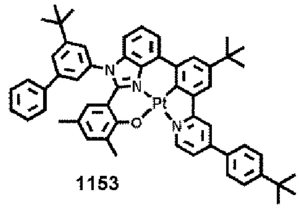
1153
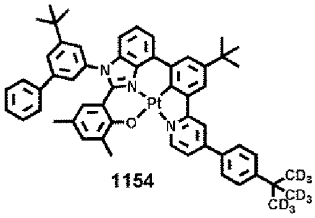
1154
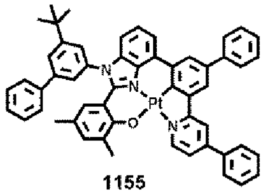
1155
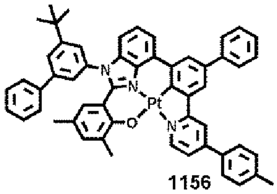
1156

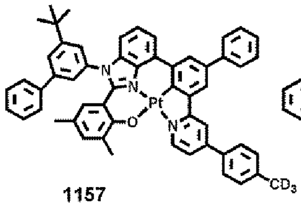
1157
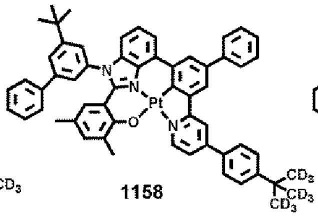
1158
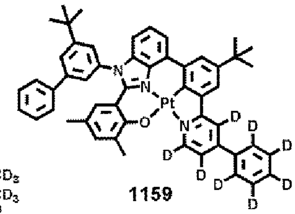
1159
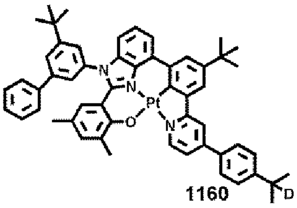
1160

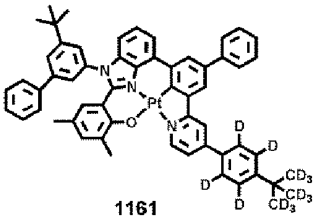
1161
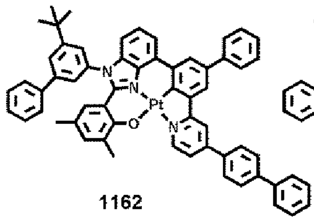
1162
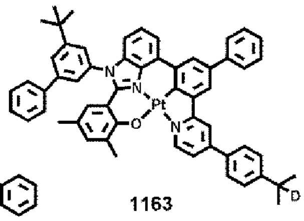
1163
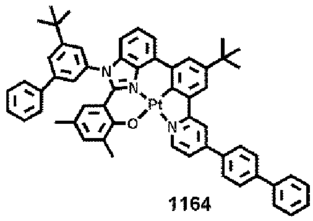
1164

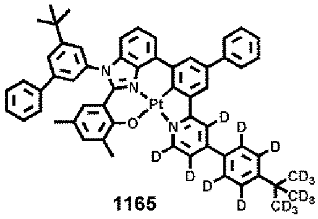
1165
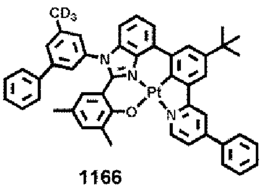
1166
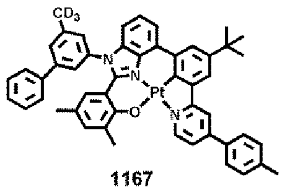
1167
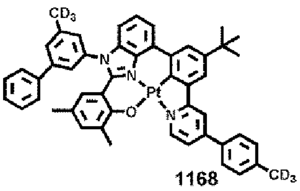
1168

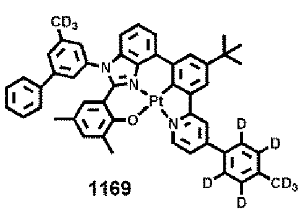
1169
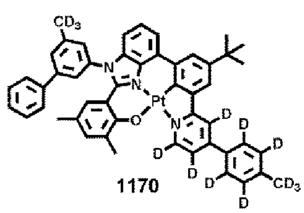
1170
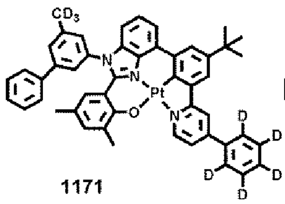
1171
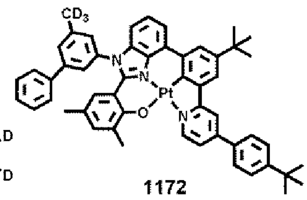
1172

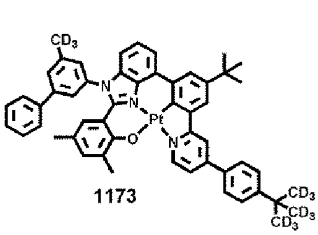
1173
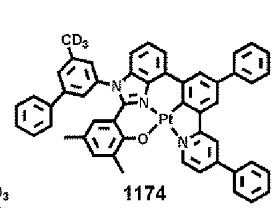
1174
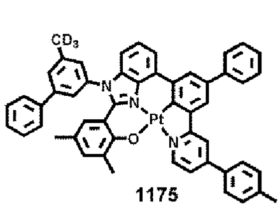
1175
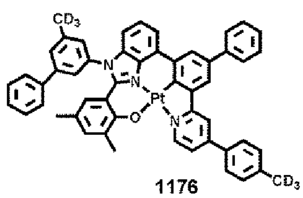
1176

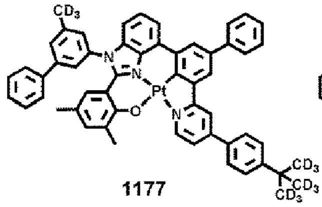
1177

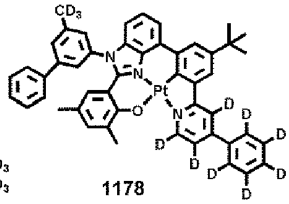
1178

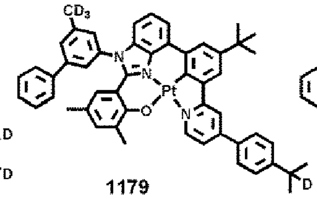
1179

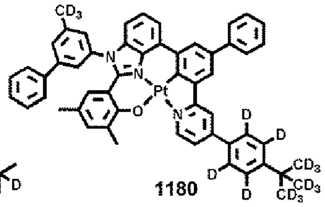
1180

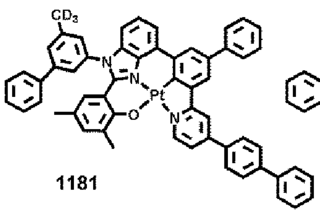
1181

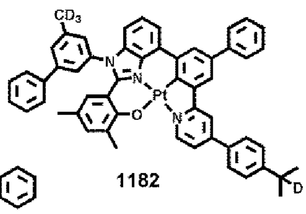
1182

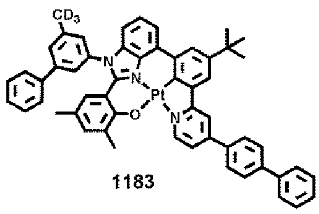
1183

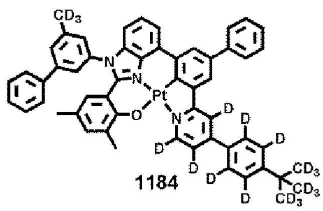
1184

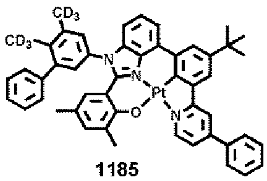
1185

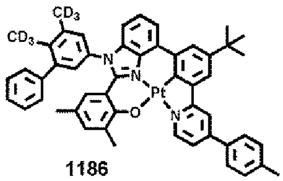
1186

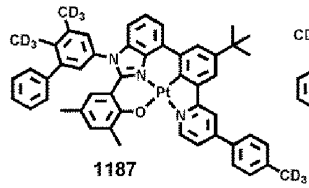
1187

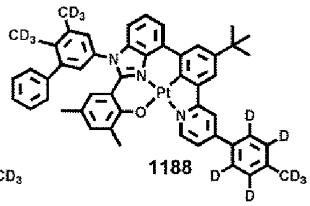
1188

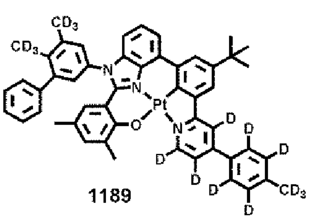
1189

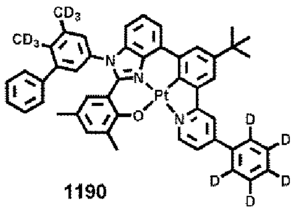
1190

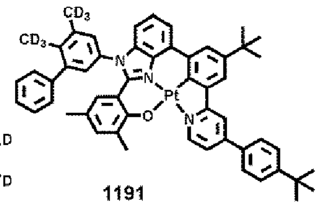
1191

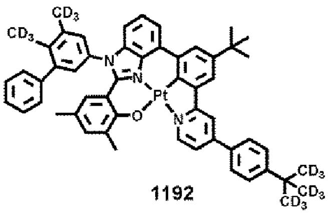
1192

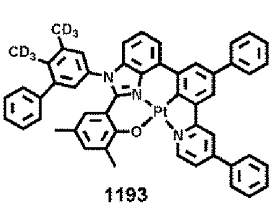
1193

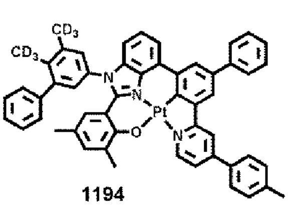
1194

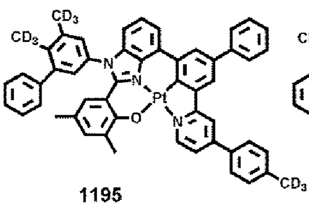
1195

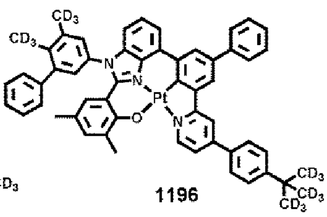
1196

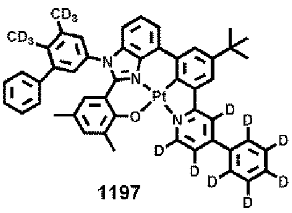
1197

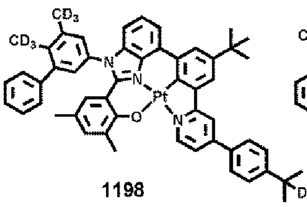
1198

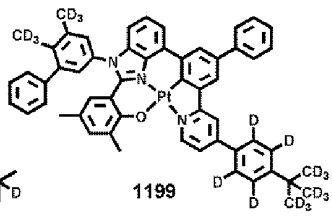
1199

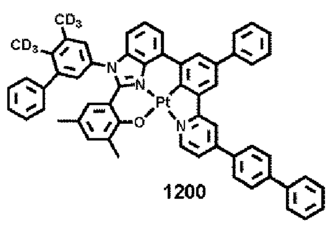
1200

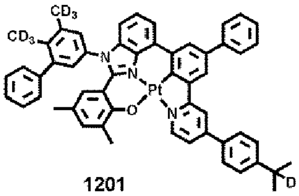
1201
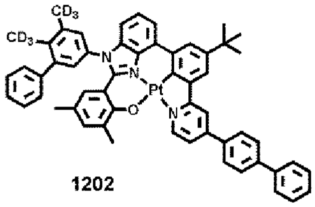
1202
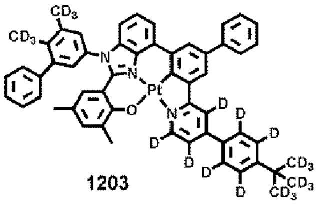
1203
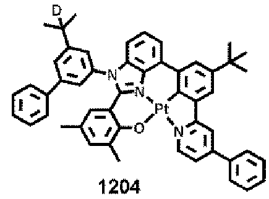
1204

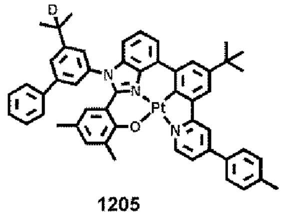
1205
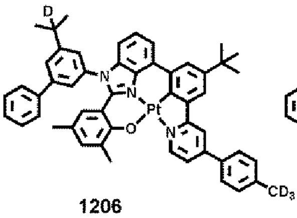
1206
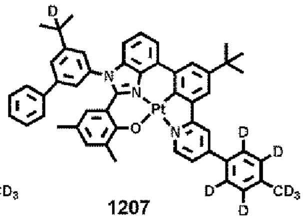
1207
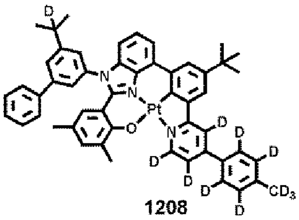
1208

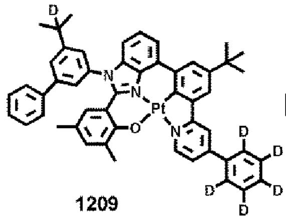
1209
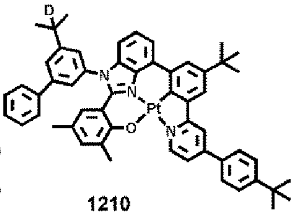
1210
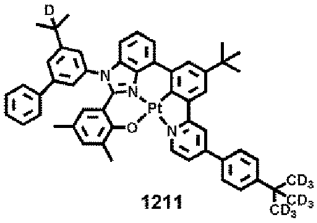
1211
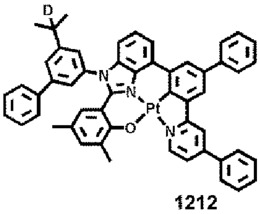
1212

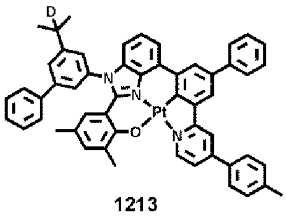
1213
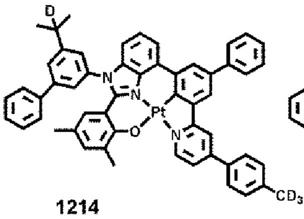
1214
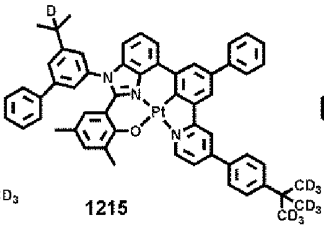
1215
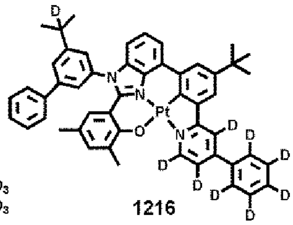
1216

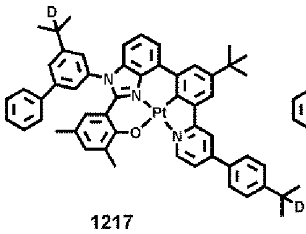
1217
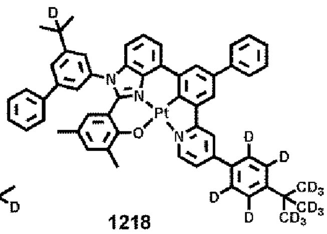
1218
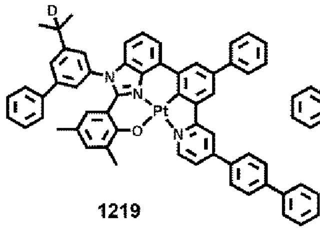
1219
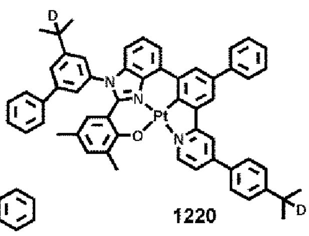
1220

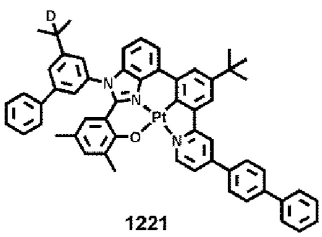
1221
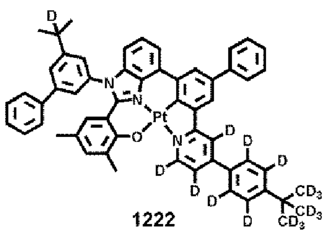
1222
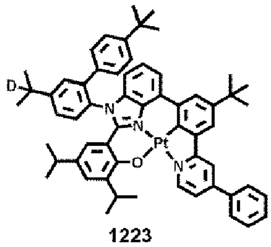
1223
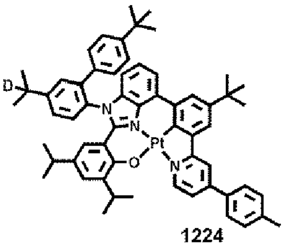
1224

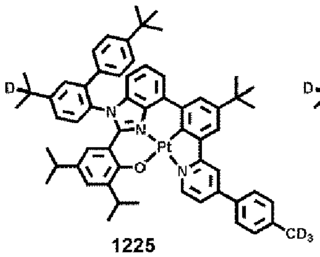
1225

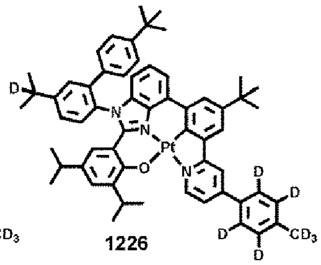
1226

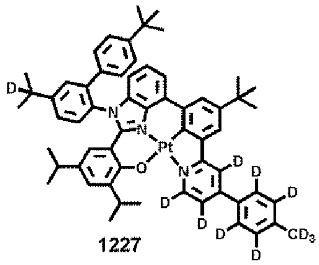
1227

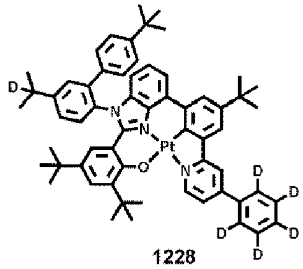
1228

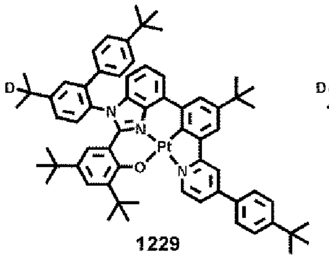
1229

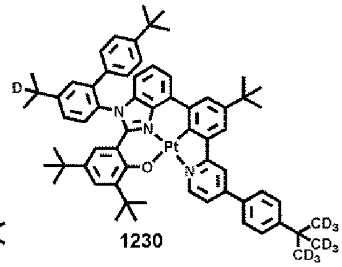
1230

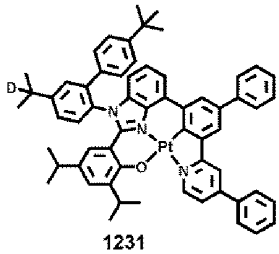
1231

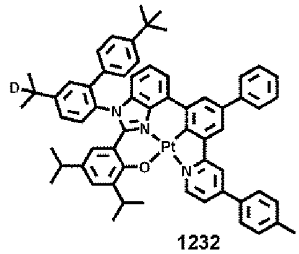
1232

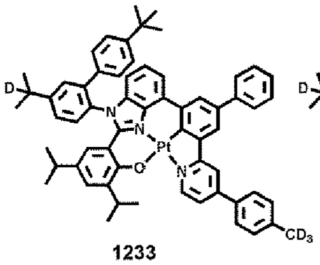
1233

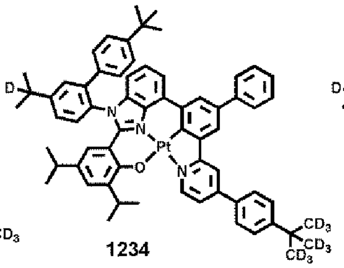
1234

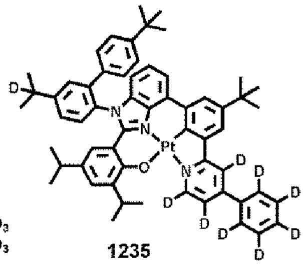
1235

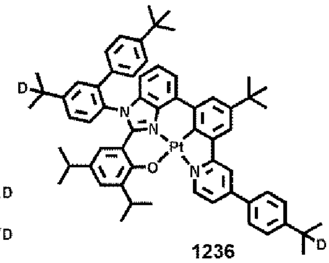
1236

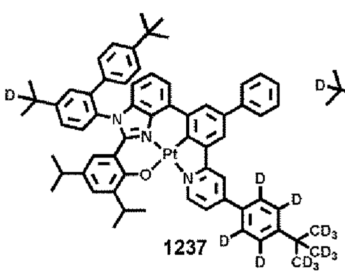
1237

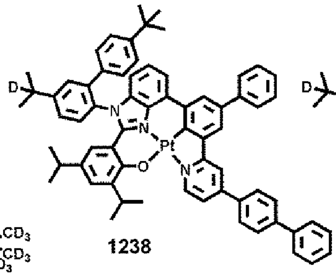
1238

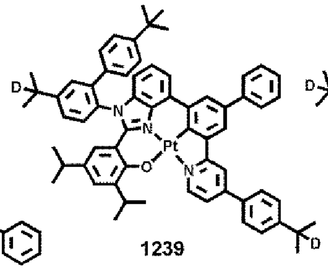
1239

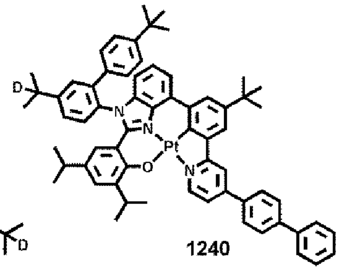
1240

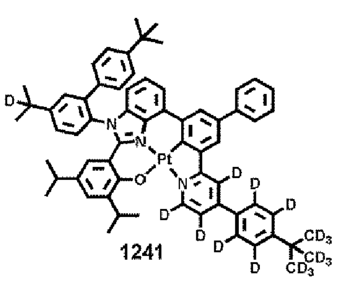
1241

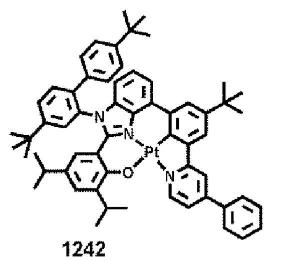
1242

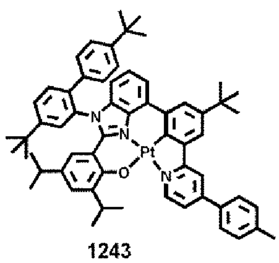
1243

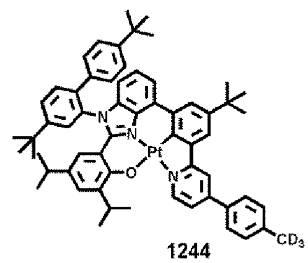
1244

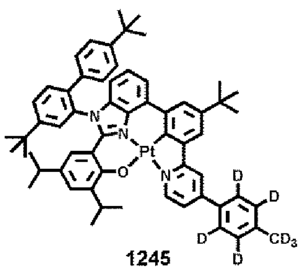
1245

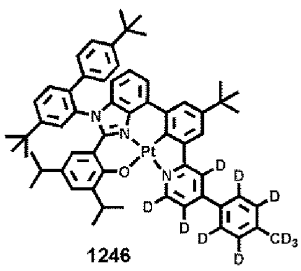
1246

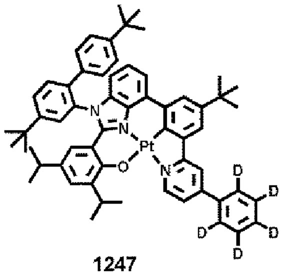
1247

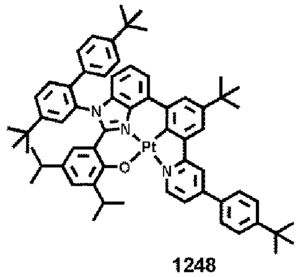
1248

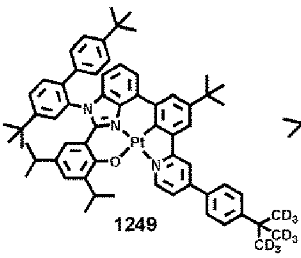
1249
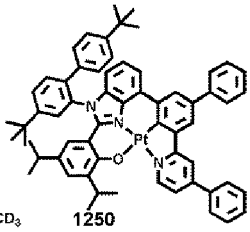
1250
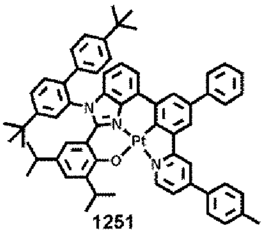
1251
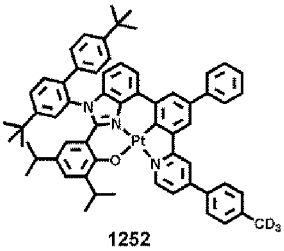
1252

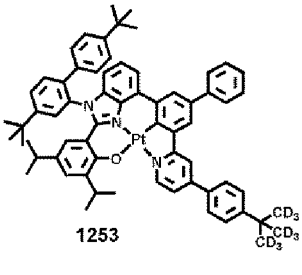
1253
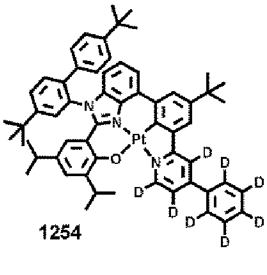
1254
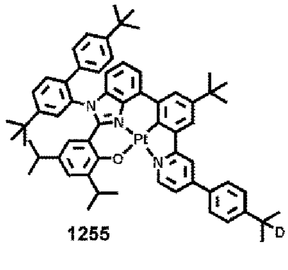
1255
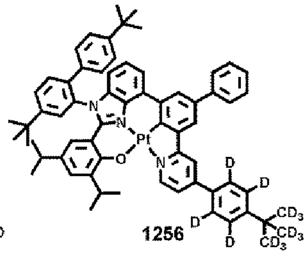
1256

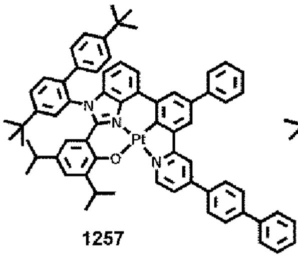
1257
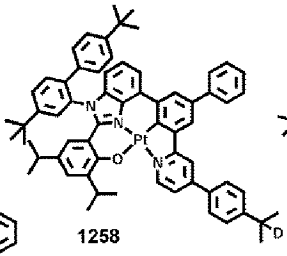
1258
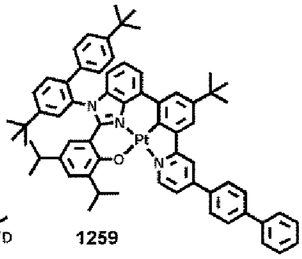
1259
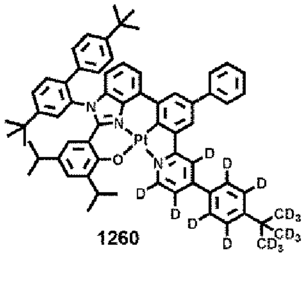
1260

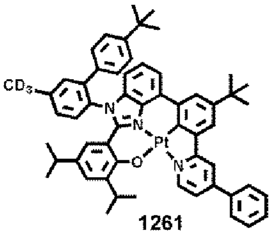
1261
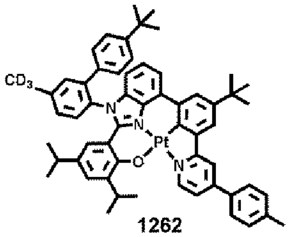
1262
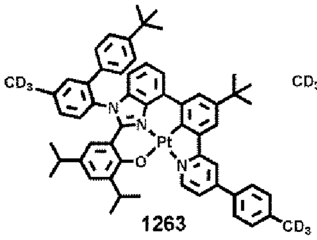
1263
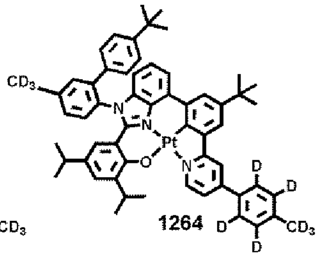
1264

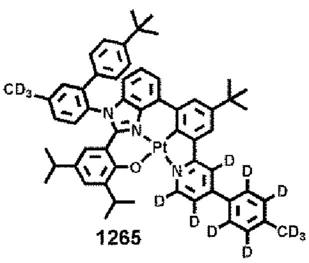
1265
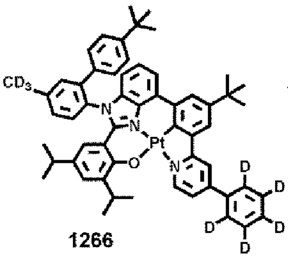
1266
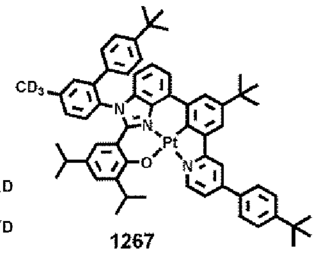
1267
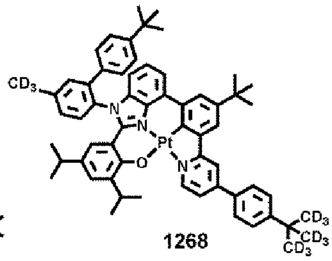
1268

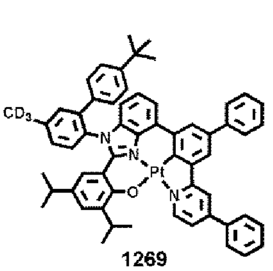
1269
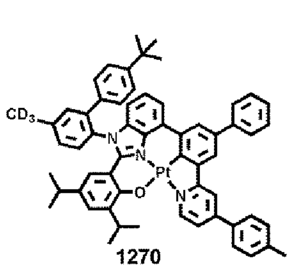
1270
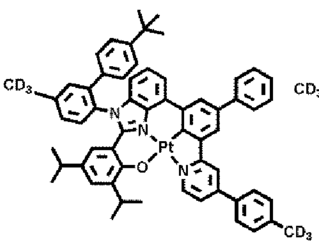
1271
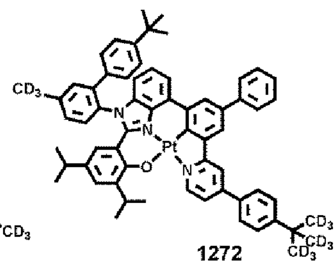
1272

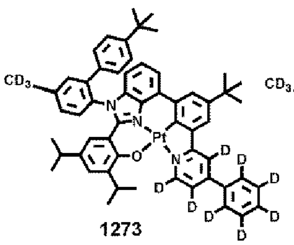
1273

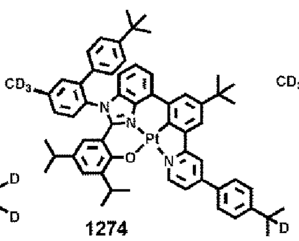
1274

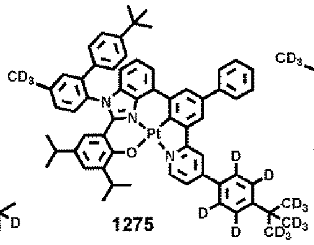
1275

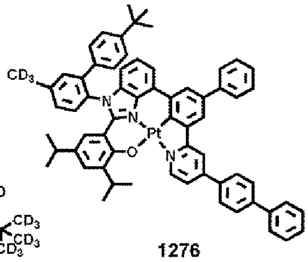
1276

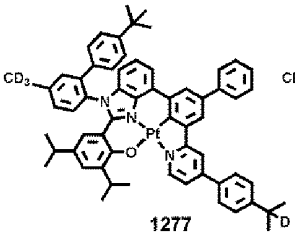
1277

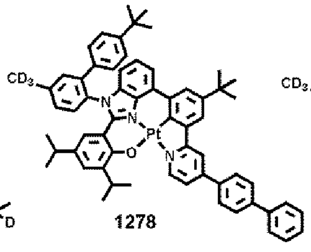
1278

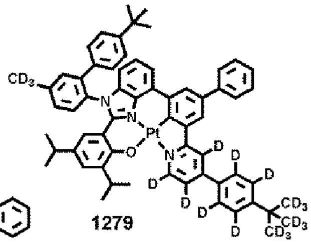
1279

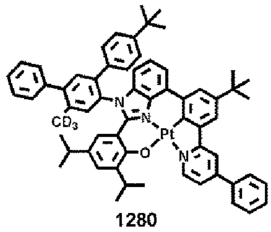
1280

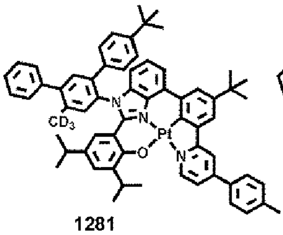
1281

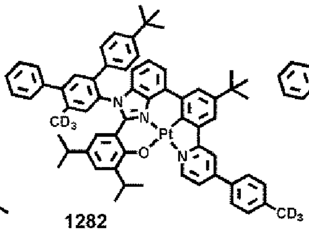
1282

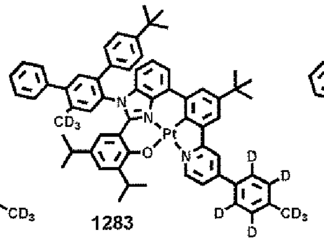
1283

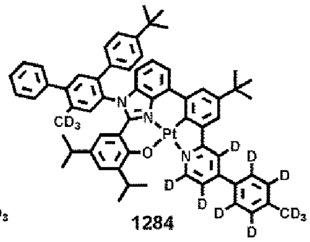
1284

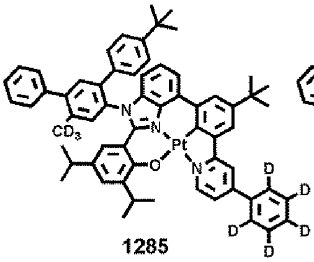
1285

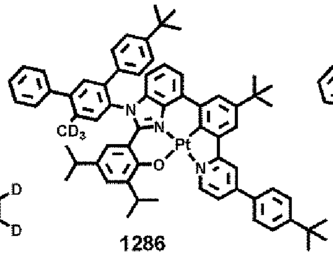
1286

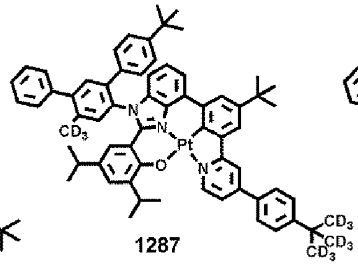
1287

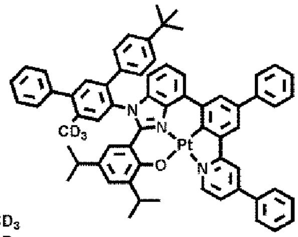
1288

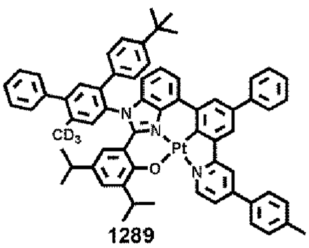
1289

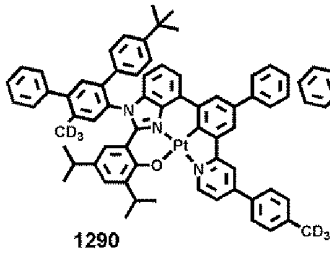
1290

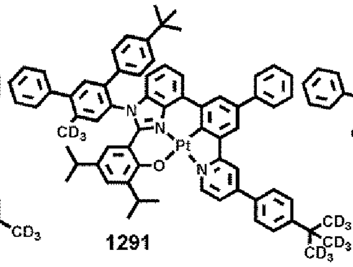
1291

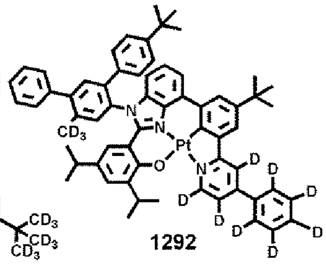
1292

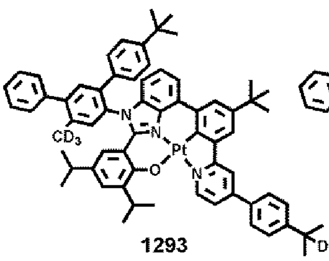
1293

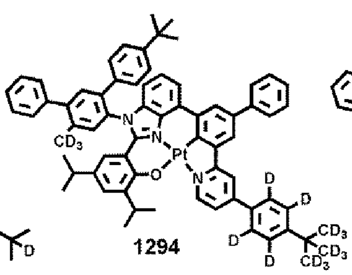
1294

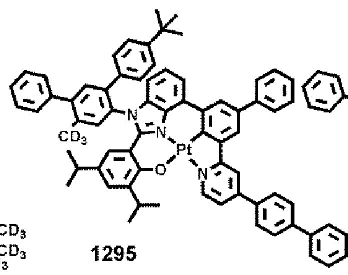
1295

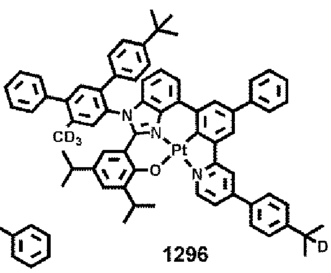
1296

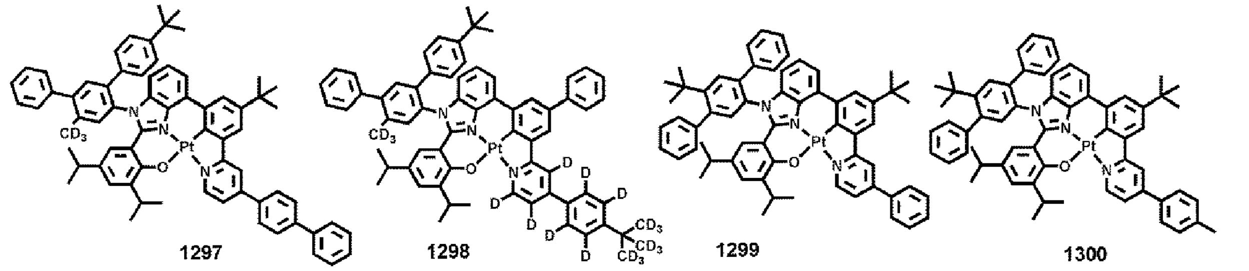

1297 1298 1299 1300

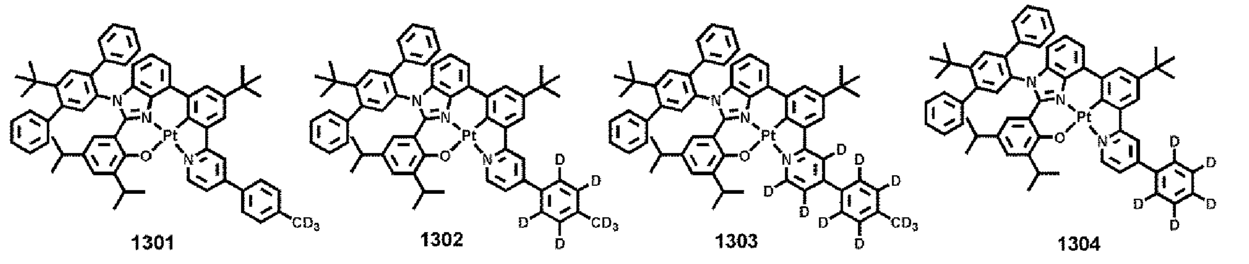

1301 1302 1303 1304

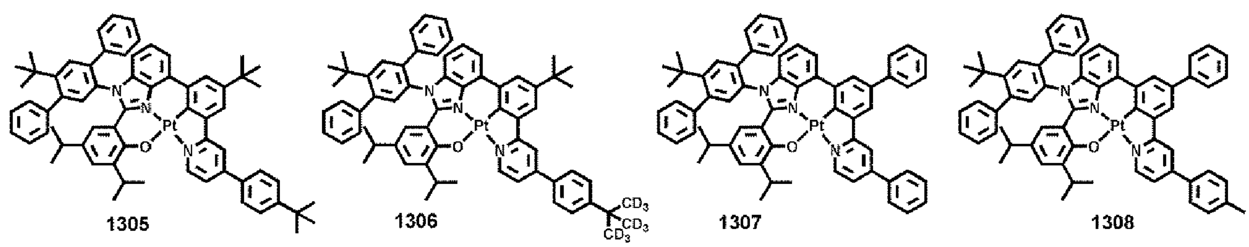

1305 1306 1307 1308

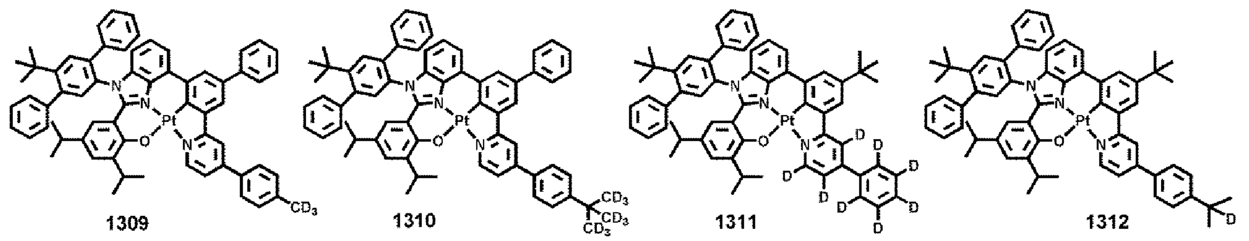

1309 1310 1311 1312

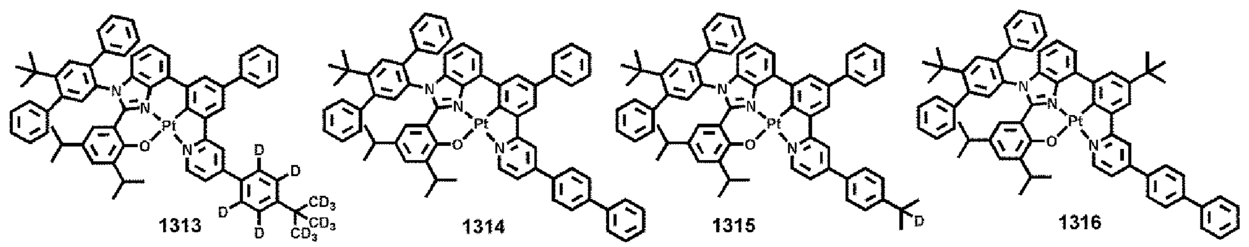

1313 1314 1315 1316

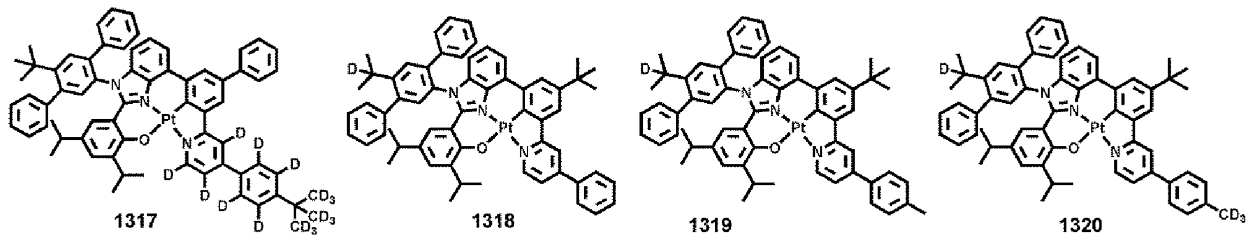

1317 1318 1319 1320

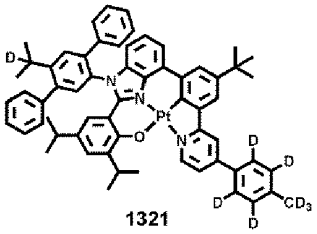
1321
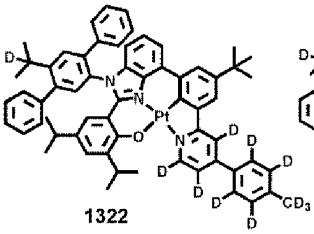
1322
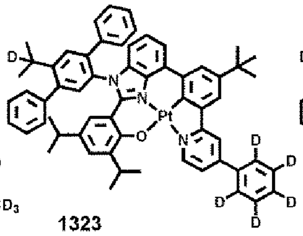
1323
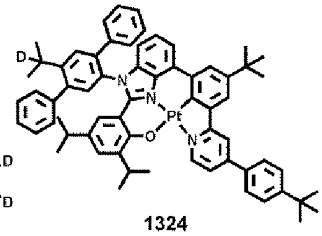
1324
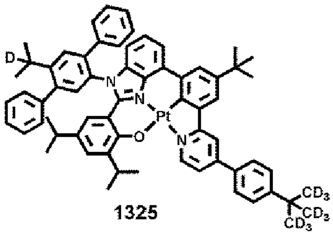
1325
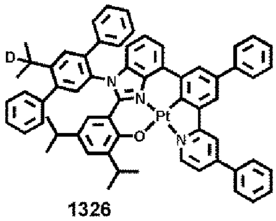
1326
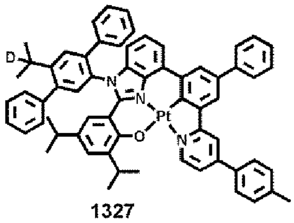
1327
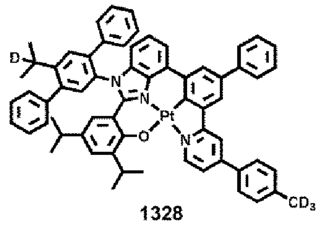
1328
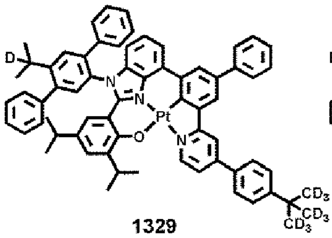
1329
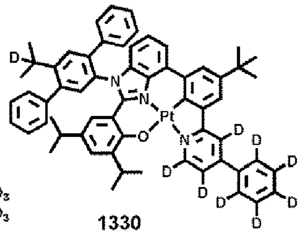
1330
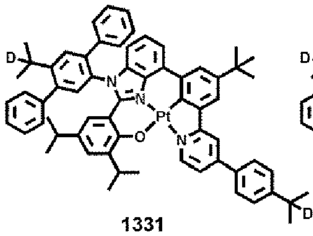
1331
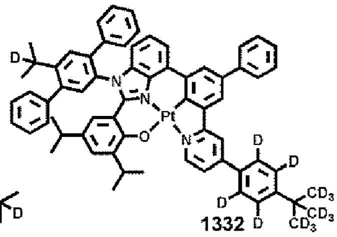
1332
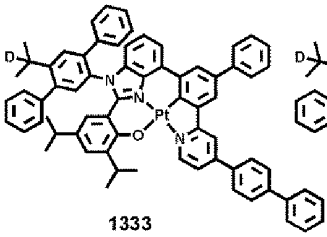
1333
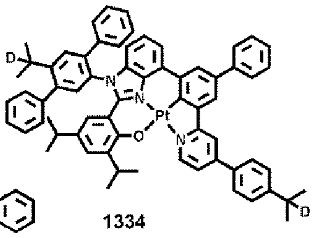
1334
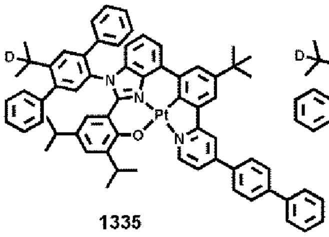
1335
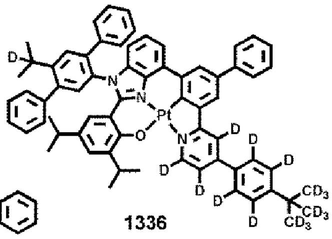
1336
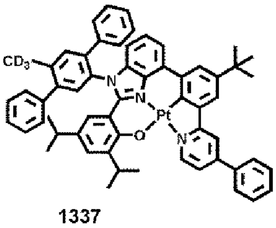
1337
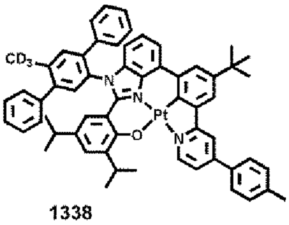
1338
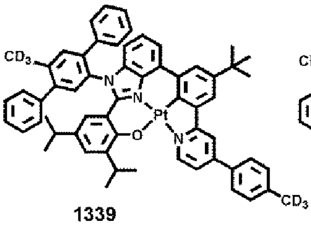
1339
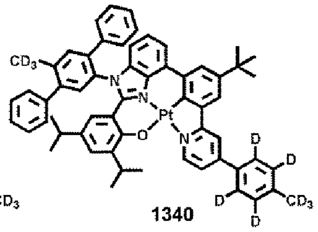
1340
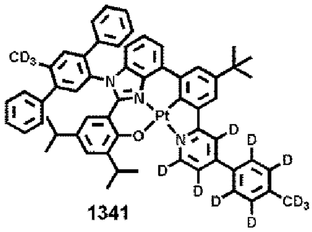
1341
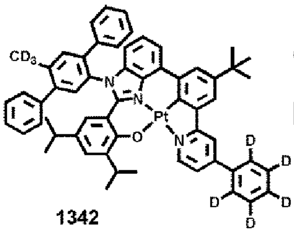
1342
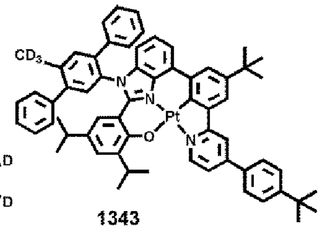
1343
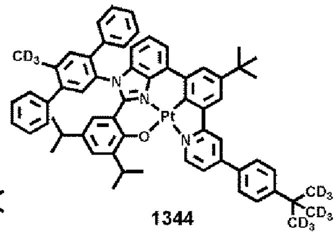
1344

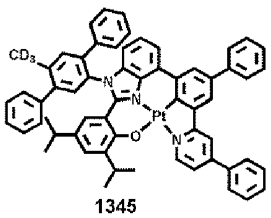
1345

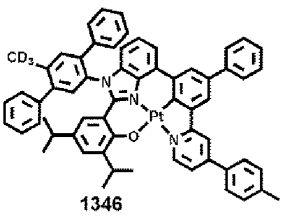
1346

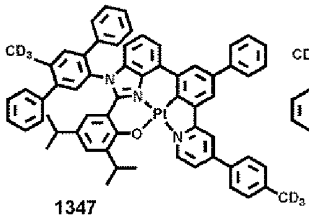
1347

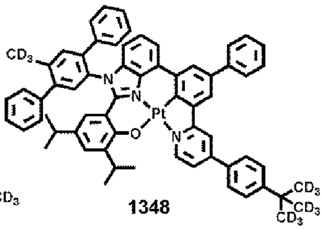
1348

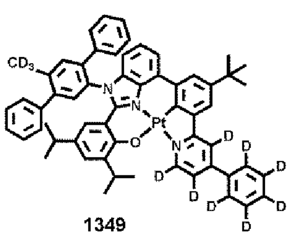
1349

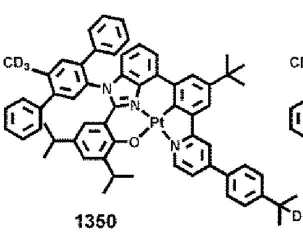
1350

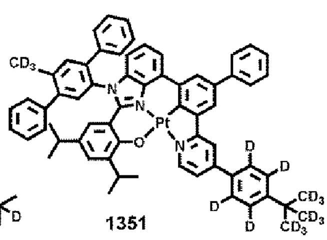
1351

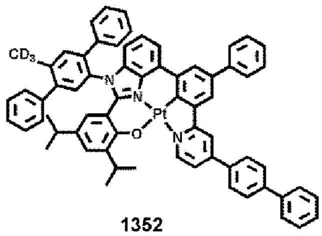
1352

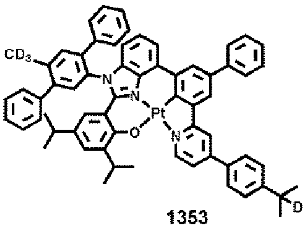
1353

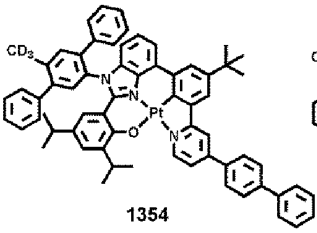
1354

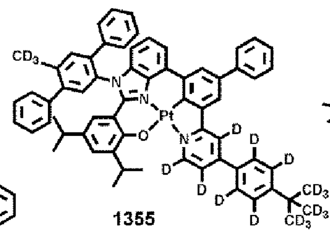
1355

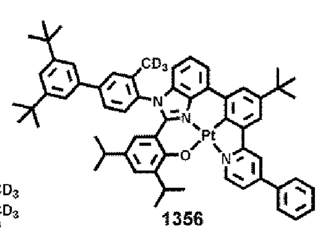
1356

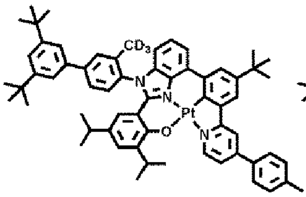
1357

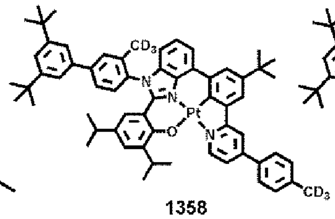
1358

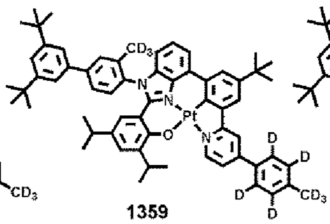
1359

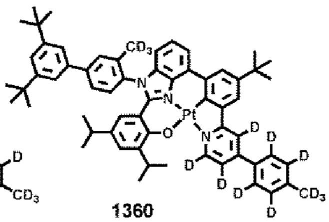
1360

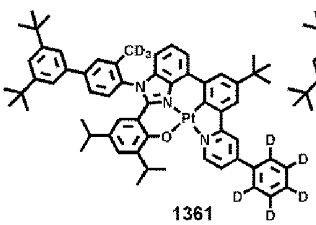
1361

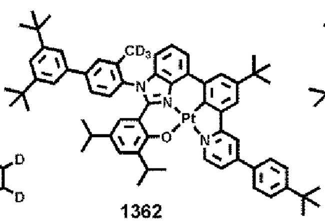
1362

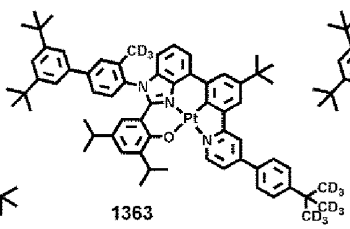
1363

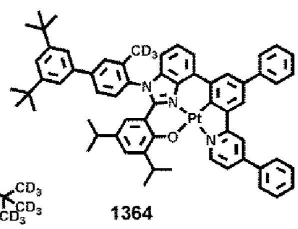
1364

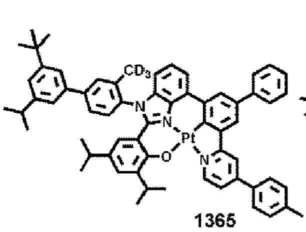
1365

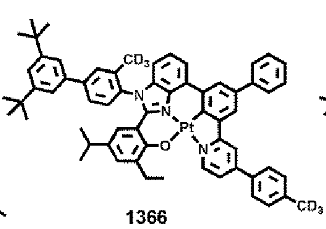
1366

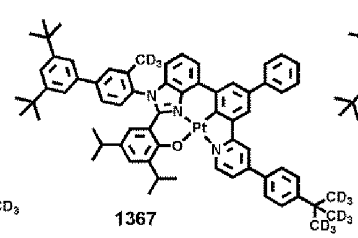
1367

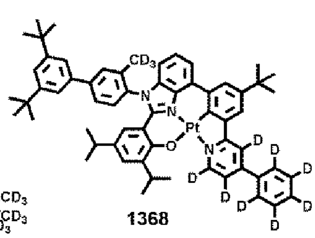
1368

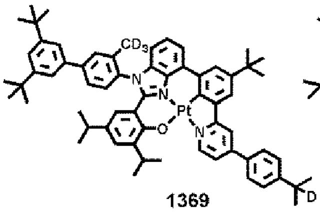
1369

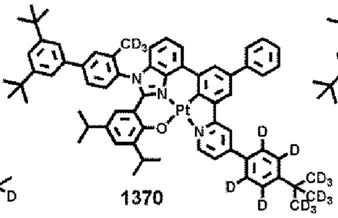
1370

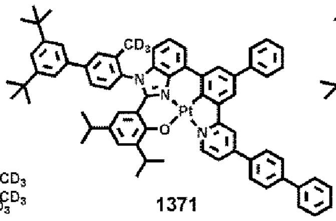
1371

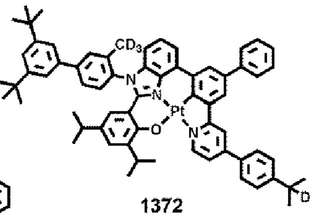
1372

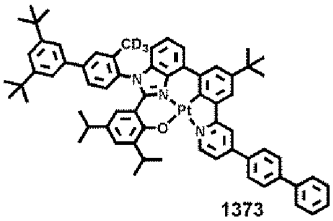
1373

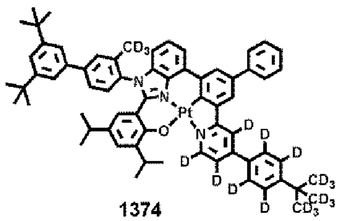
1374

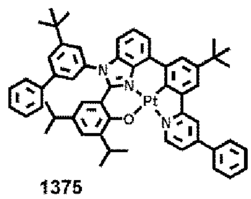
1375

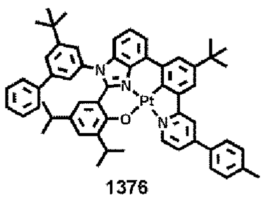
1376

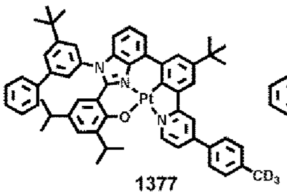
1377

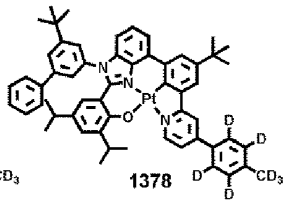
1378

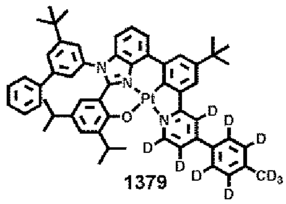
1379

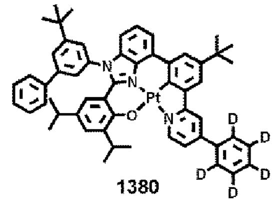
1380

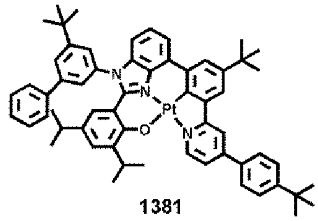
1381

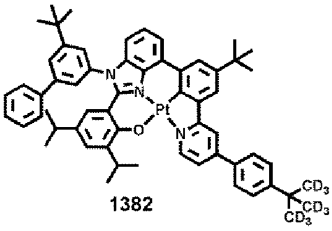
1382

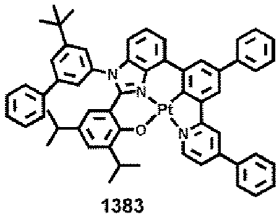
1383

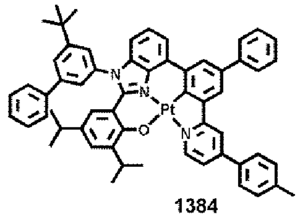
1384

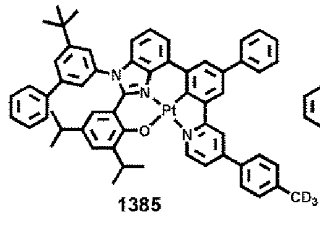
1385

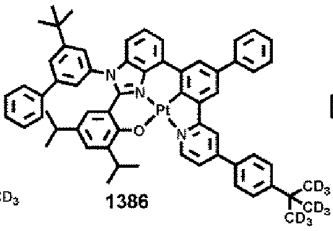
1386

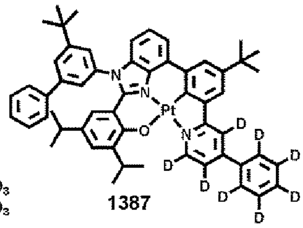
1387

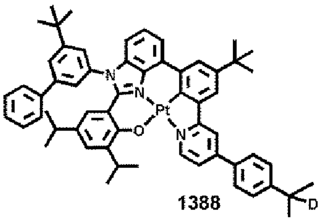
1388

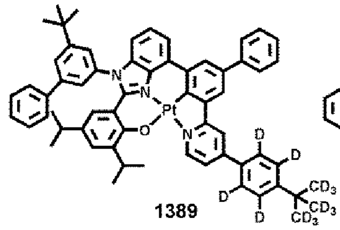
1389

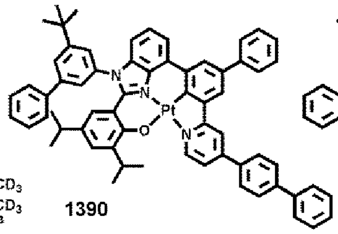
1390

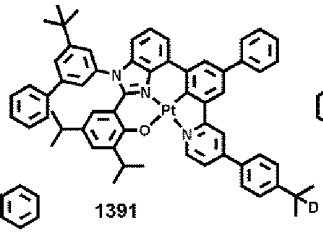
1391

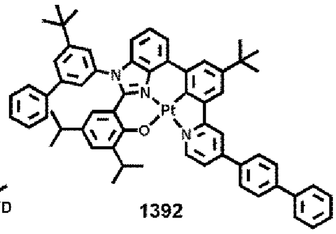
1392

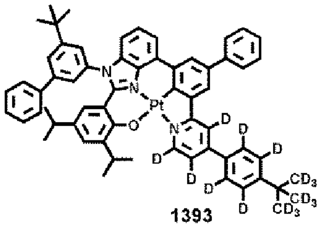
1393

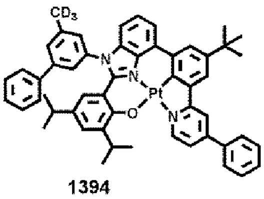
1394

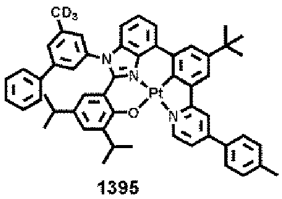
1395

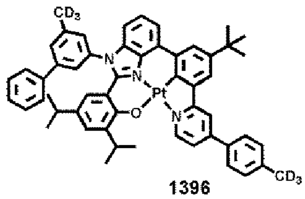
1396

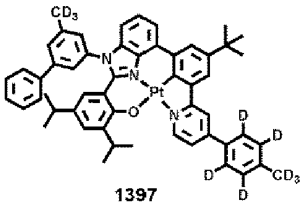
1397

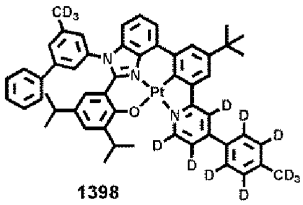
1398

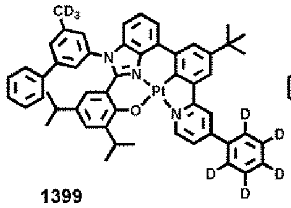
1399

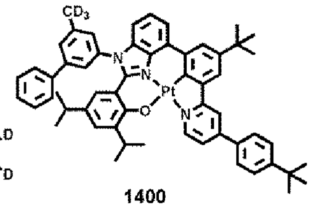
1400

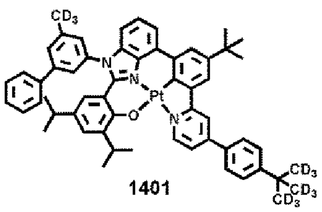
1401

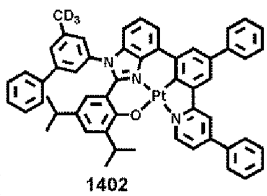
1402

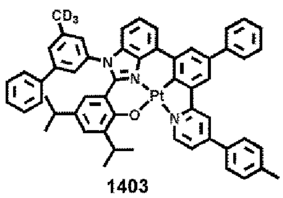
1403

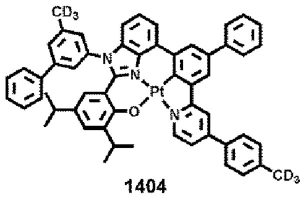
1404

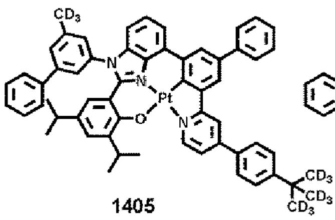
1405

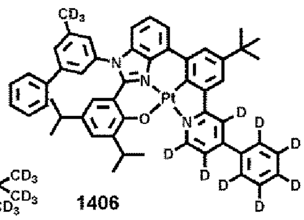
1406

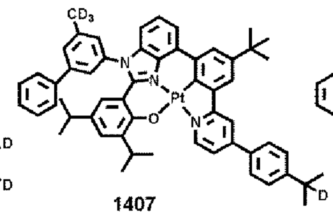
1407

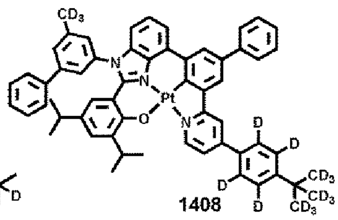
1408

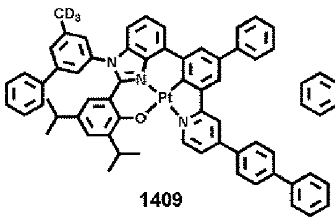
1409

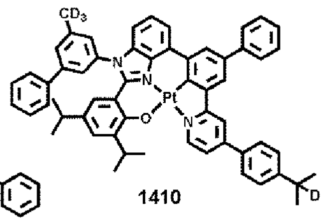
1410

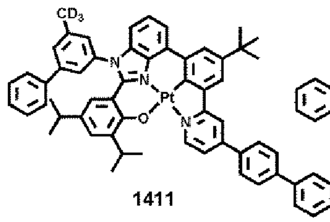
1411

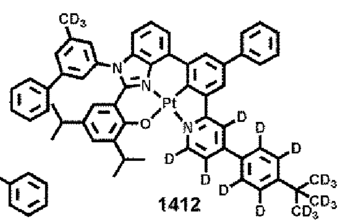
1412

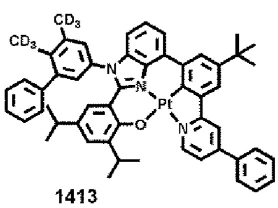
1413

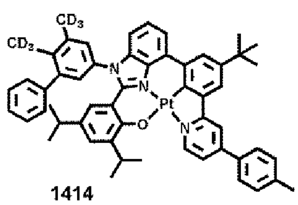
1414

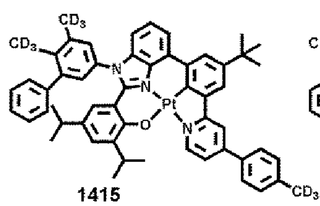
1415

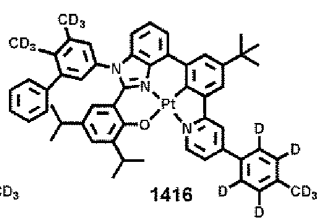
1416

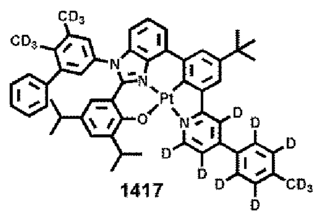
1417

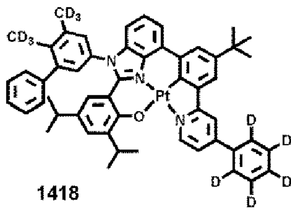
1418

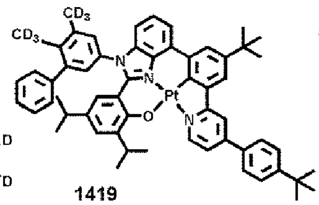
1419

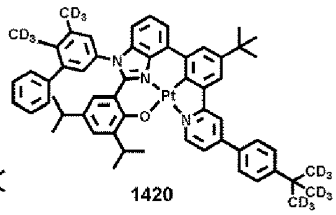
1420

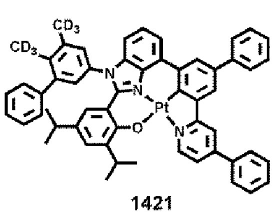
1421

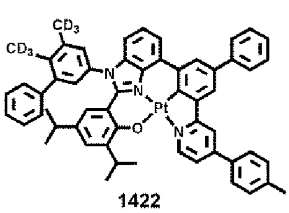
1422

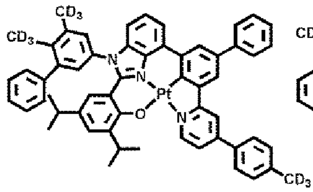
1423

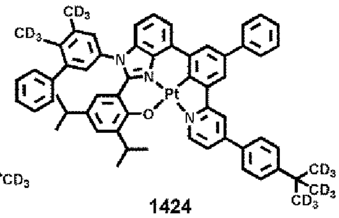
1424

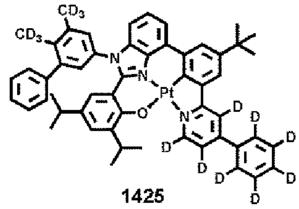
1425

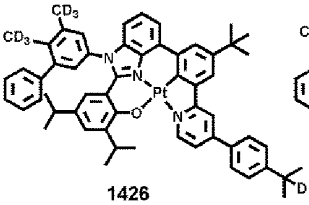
1426

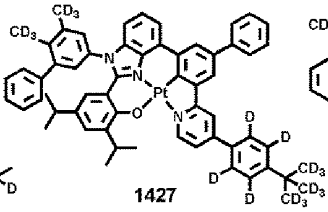
1427

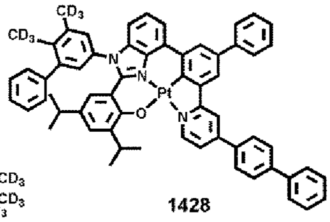
1428

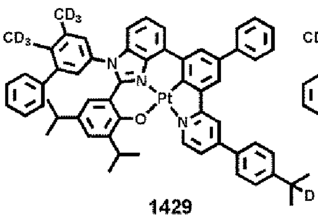
1429

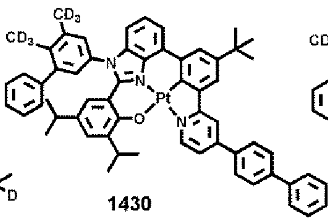
1430

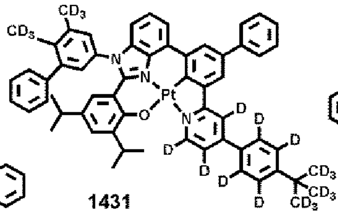
1431

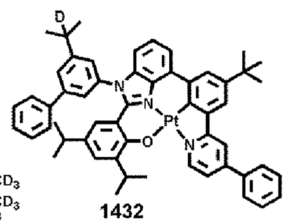
1432

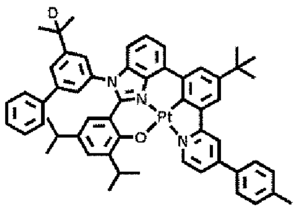
1433

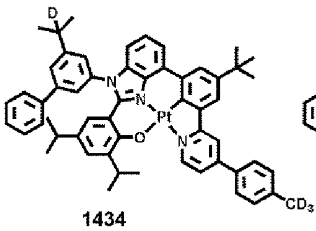
1434

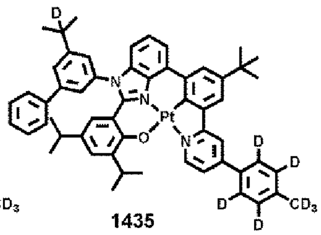
1435

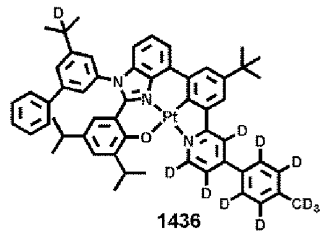
1436

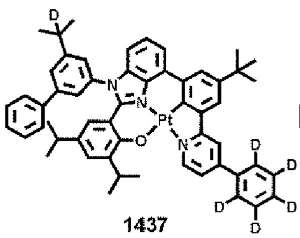
1437

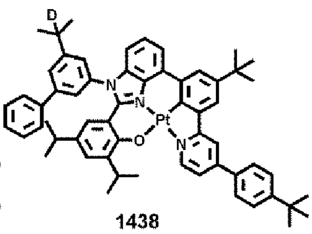
1438

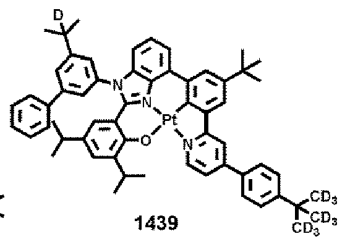
1439

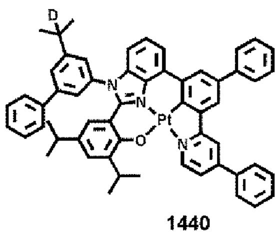
1440

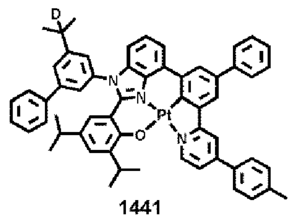
1441

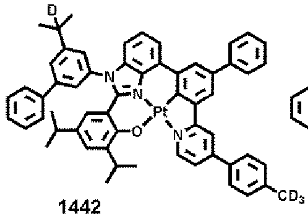
1442

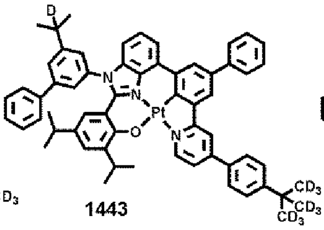
1443

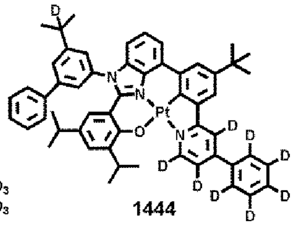
1444

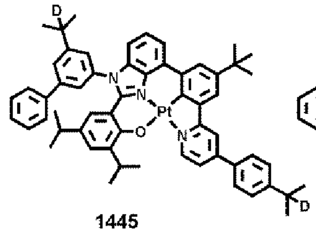
1445

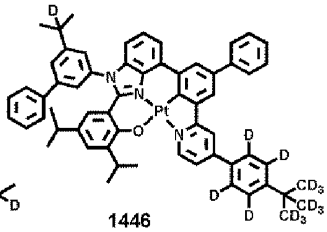
1446

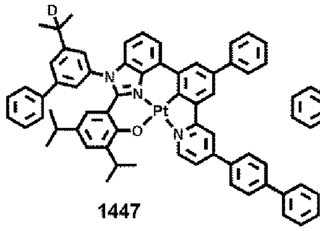
1447

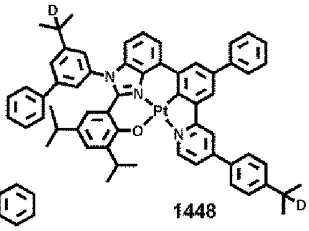
1448

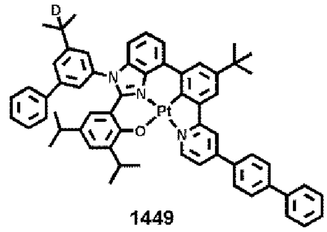
1449

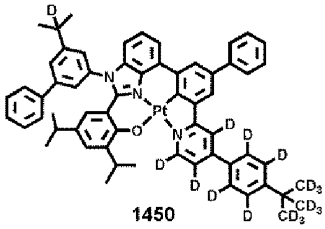
1450

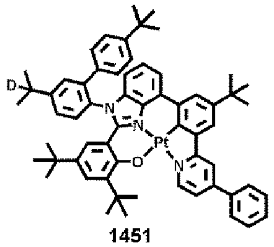
1451

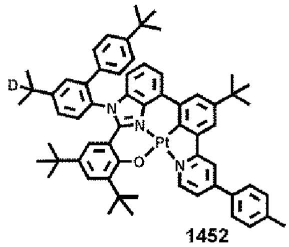
1452

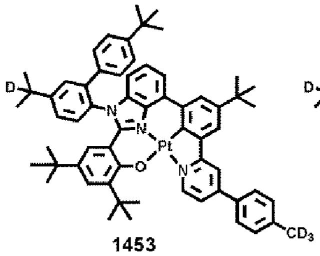
1453

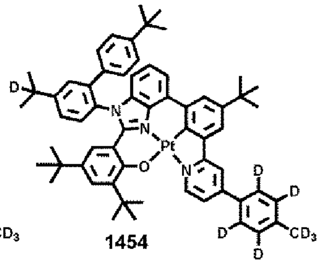
1454

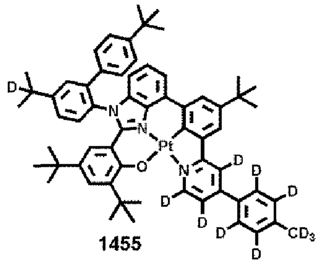
1455

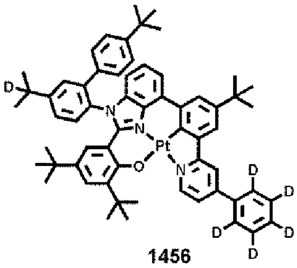
1456

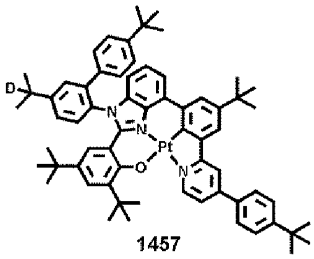
1457

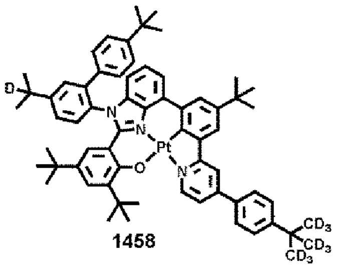
1458

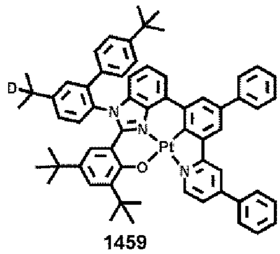
1459

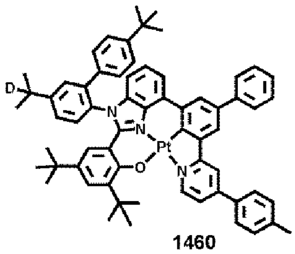
1460

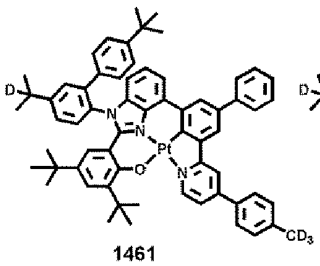
1461

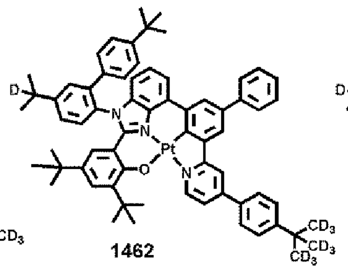
1462

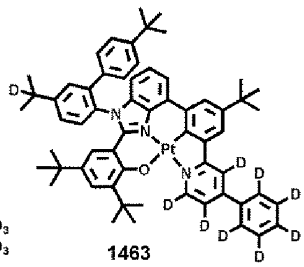
1463

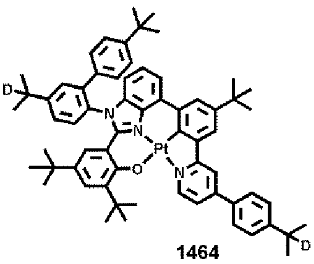
1464

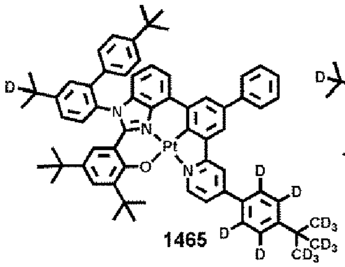

1465

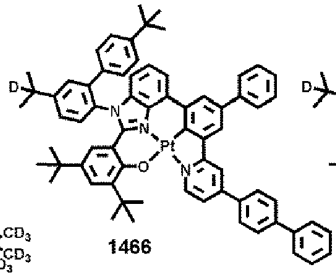

1466

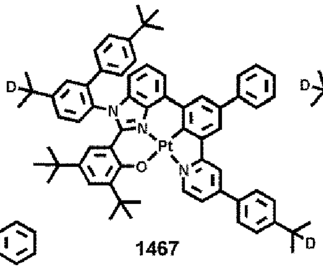

1467

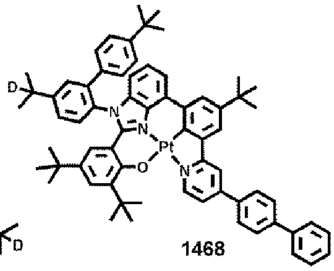

1468

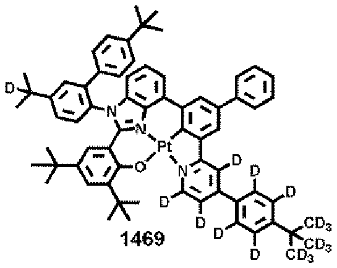

1469

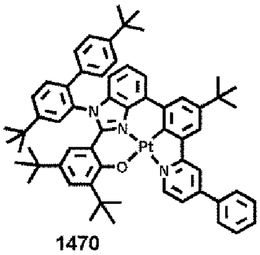

1470

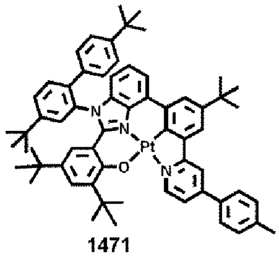

1471

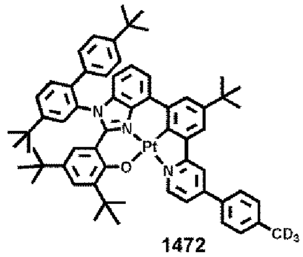

1472

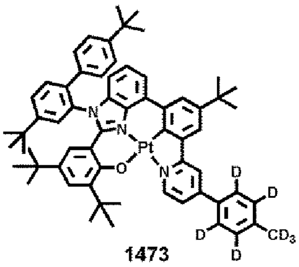

1473

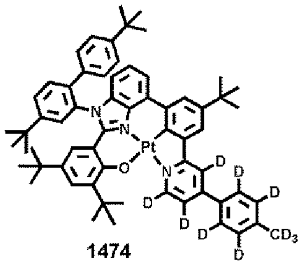

1474

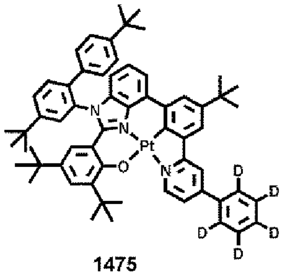

1475

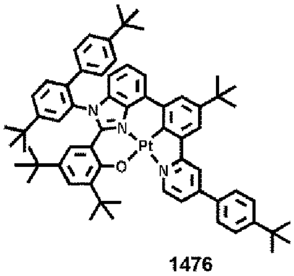

1476

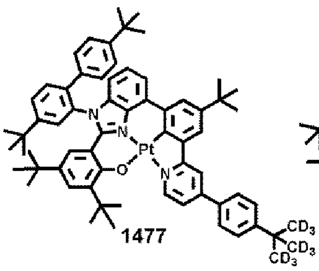

1477

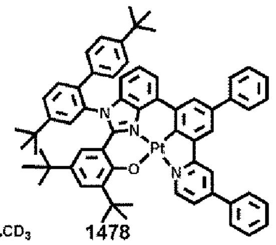

1478

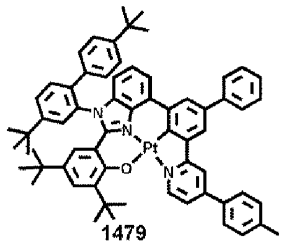

1479

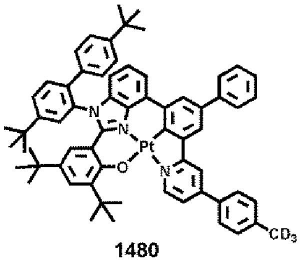

1480

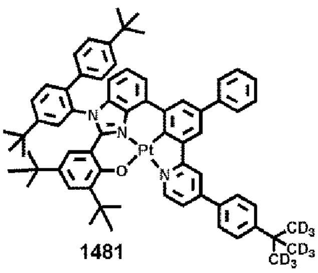

1481

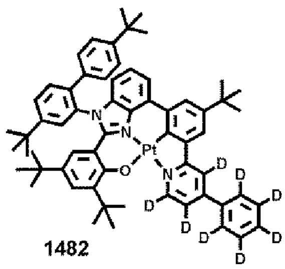

1482

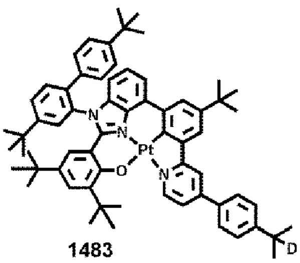

1483

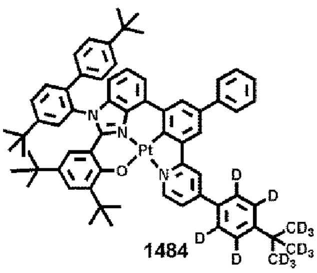

1484

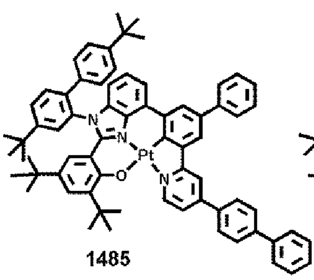

1485

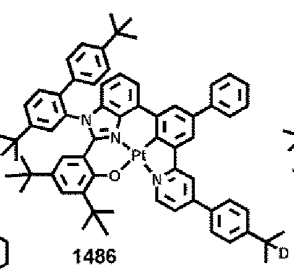

1486

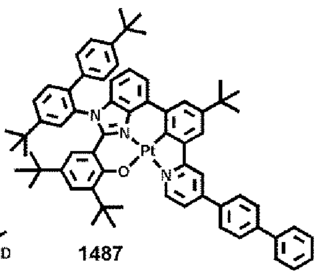

1487

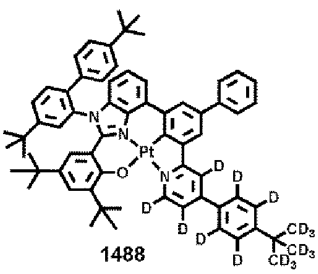

1488

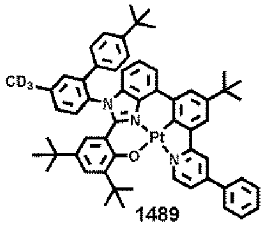
1489

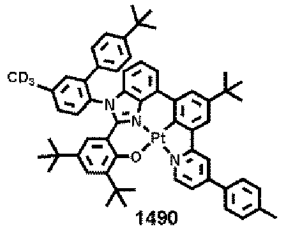
1490

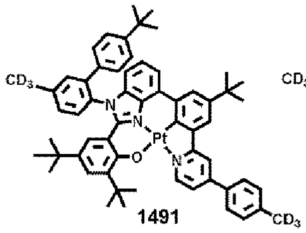
1491

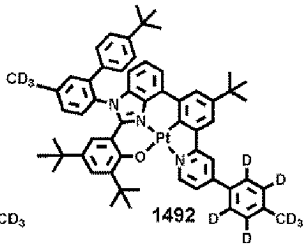
1492

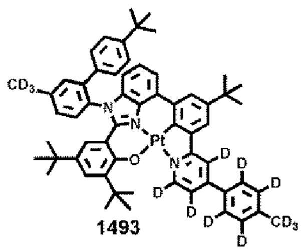
1493

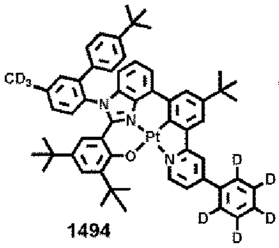
1494

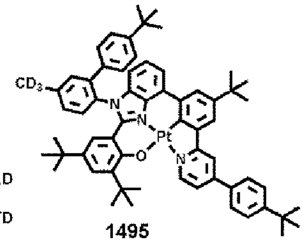
1495

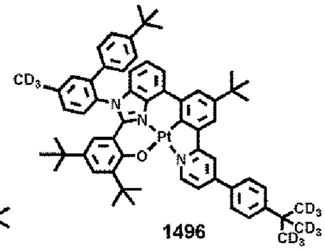
1496

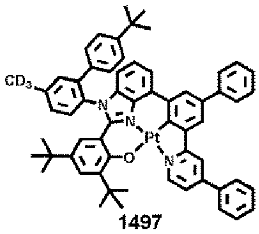
1497

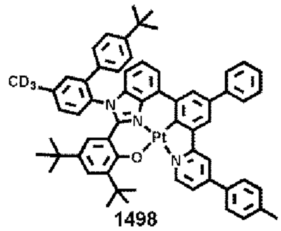
1498

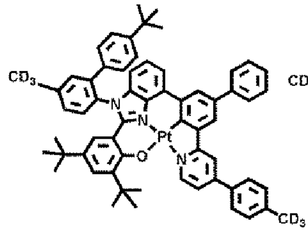
1499

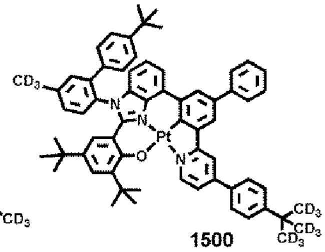
1500

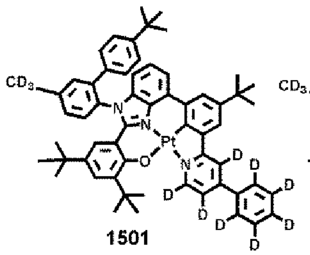
1501

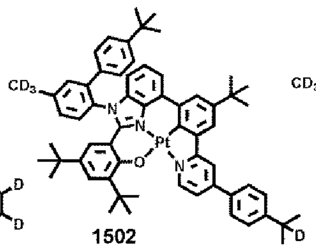
1502

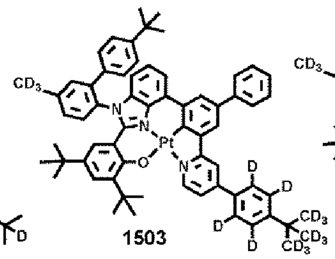
1503

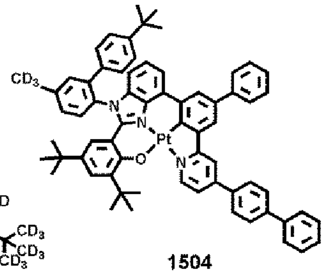
1504

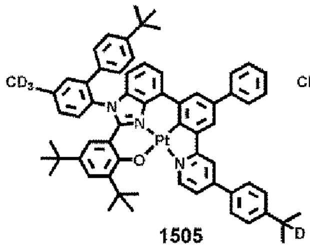
1505

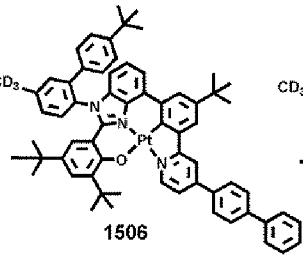
1506

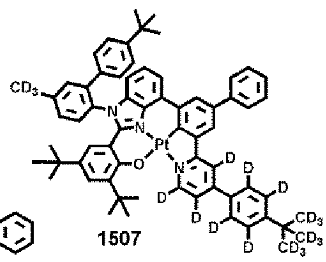
1507

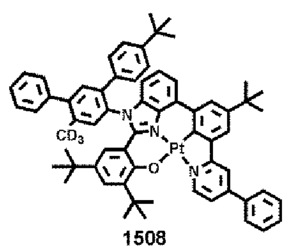
1508

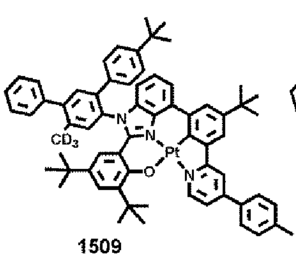
1509

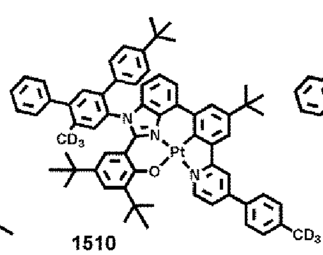
1510

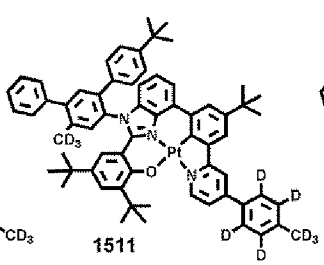
1511

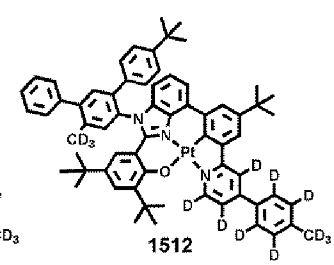
1512

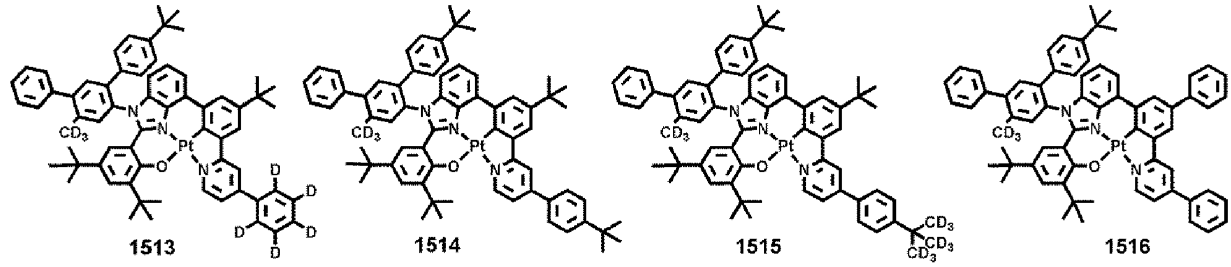

1513 1514 1515 1516

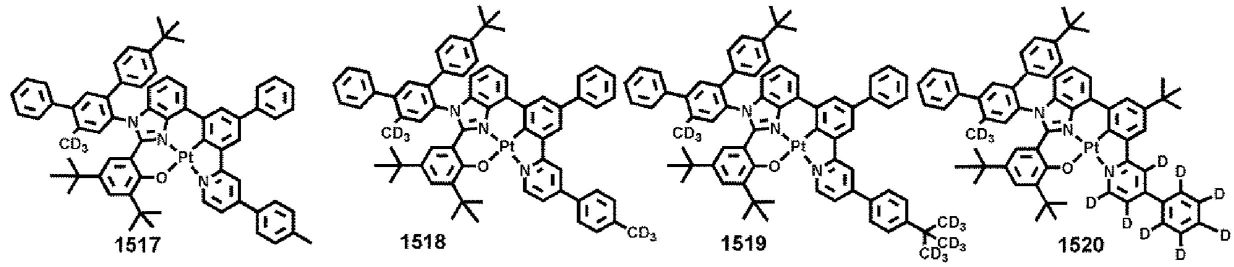

1517 1518 1519 1520

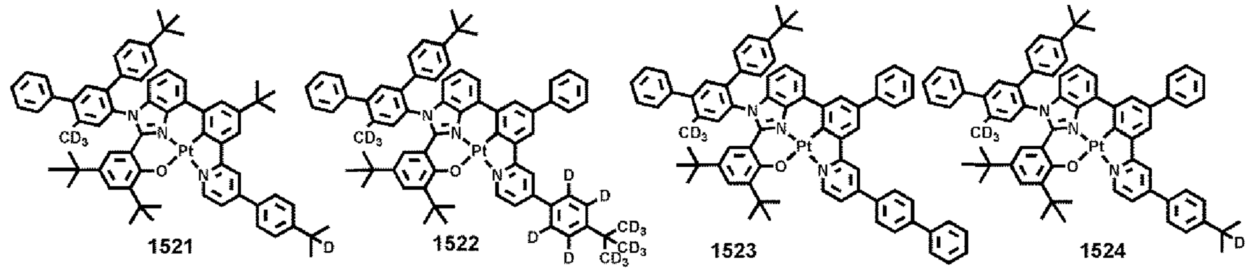

1521 1522 1523 1524

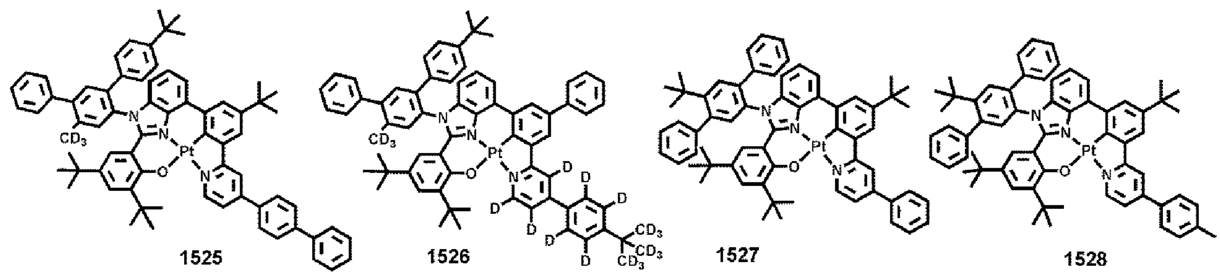

1525 1526 1527 1528

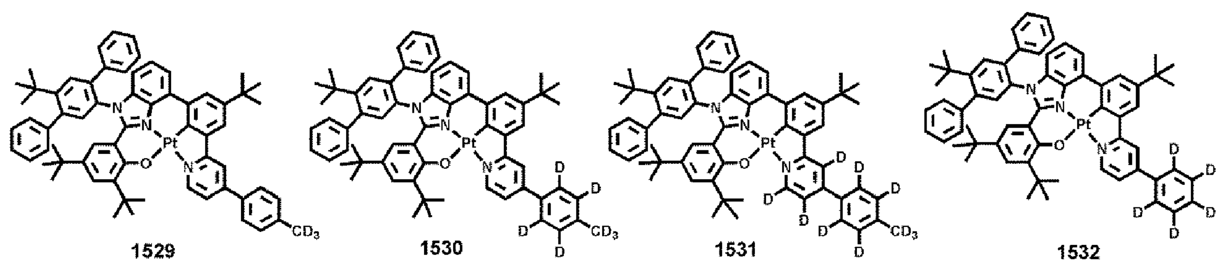

1529 1530 1531 1532

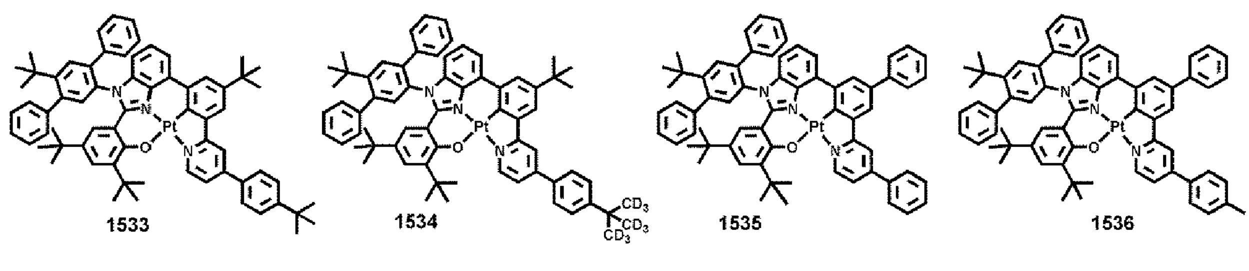

1533 1534 1535 1536

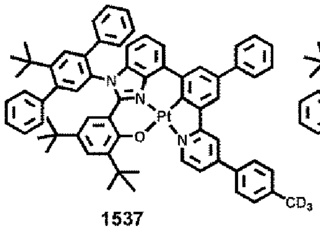
1537
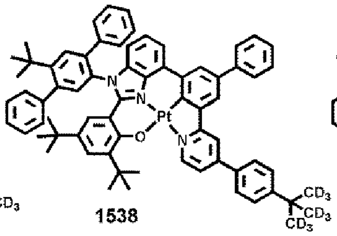
1538
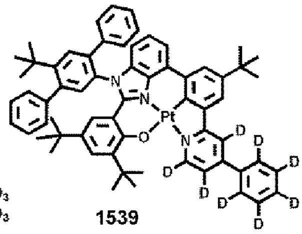
1539
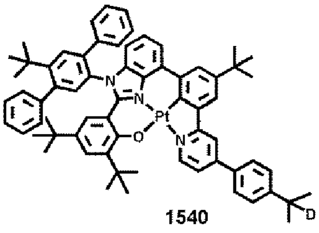
1540

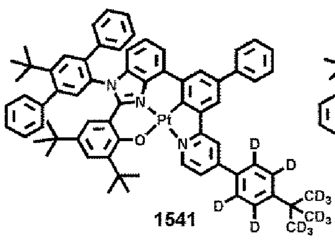
1541
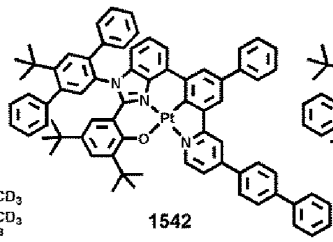
1542
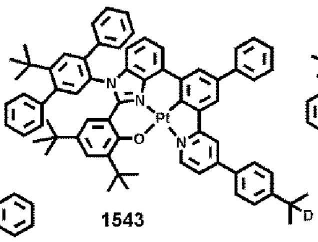
1543
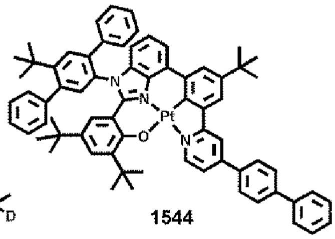
1544

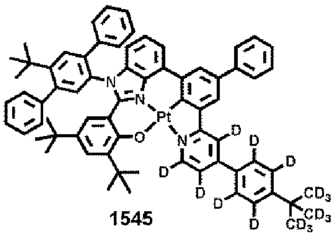
1545
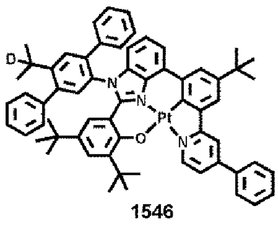
1546
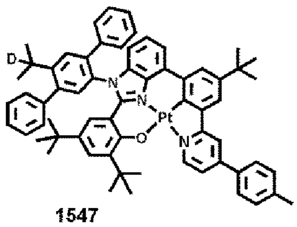
1547
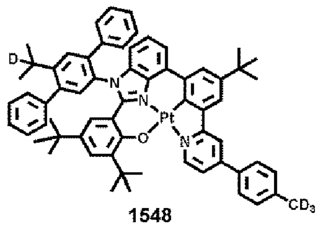
1548

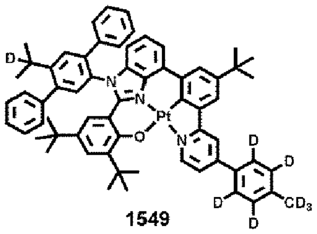
1549
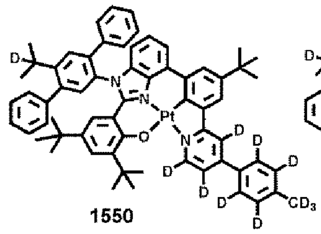
1550
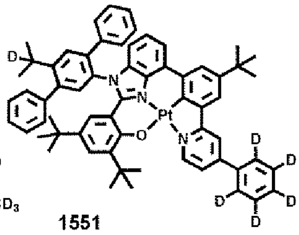
1551
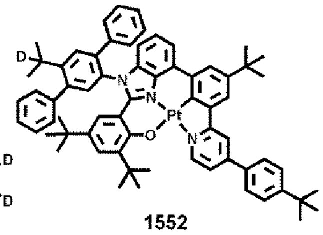
1552

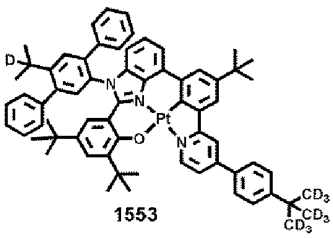
1553
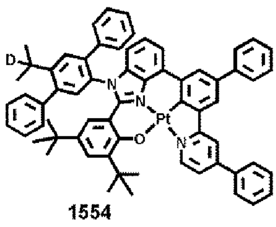
1554
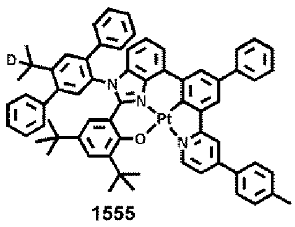
1555
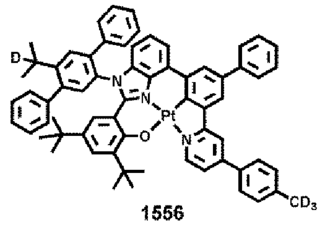
1556

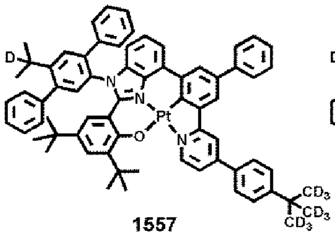
1557
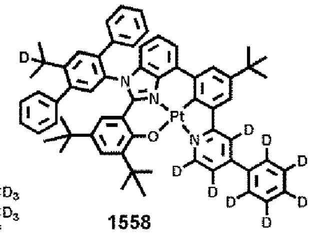
1558
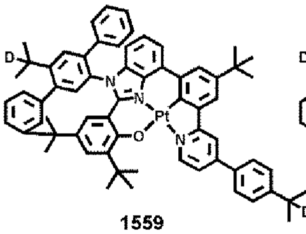
1559
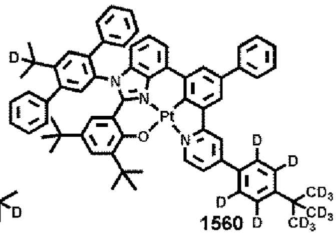
1560

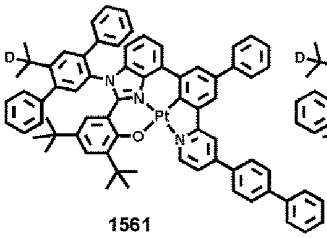

1561

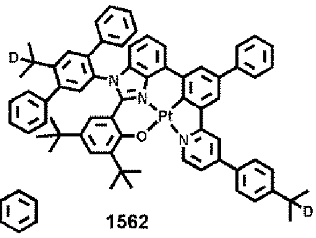

1562

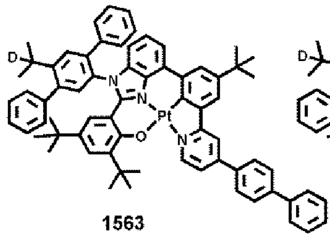

1563

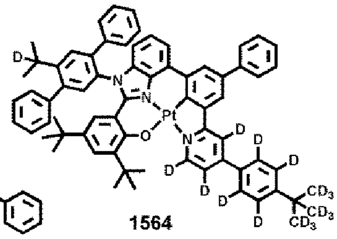

1564

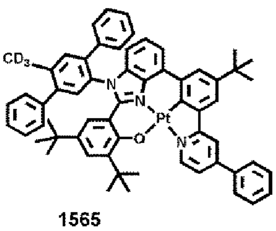

1565

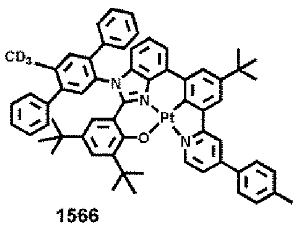

1566

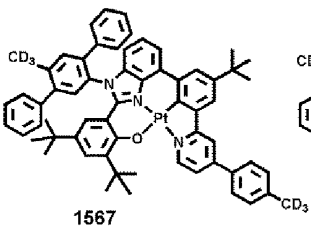

1567

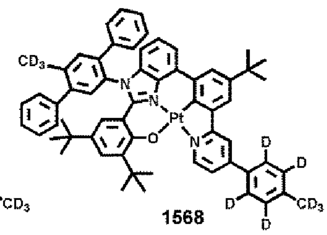

1568

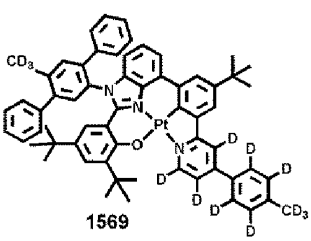

1569

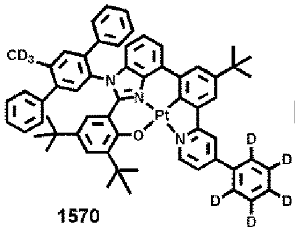

1570

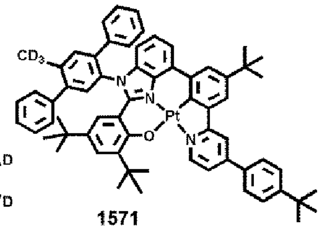

1571

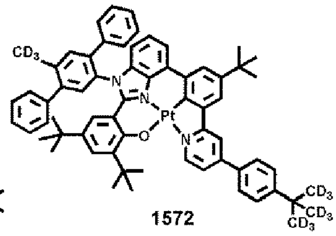

1572

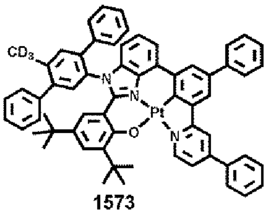

1573

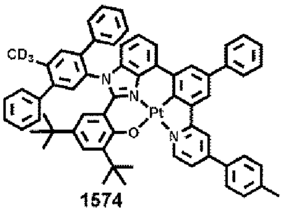

1574

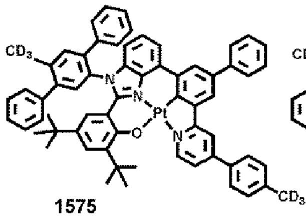

1575

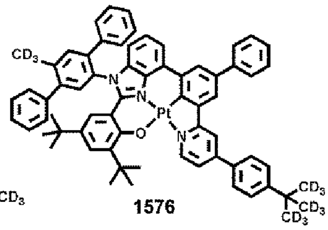

1576

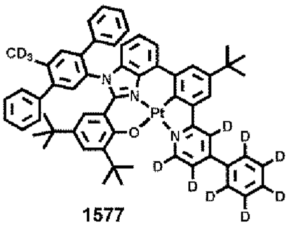

1577

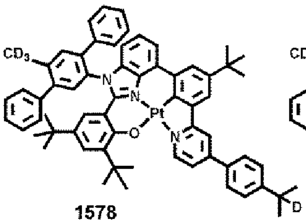

1578

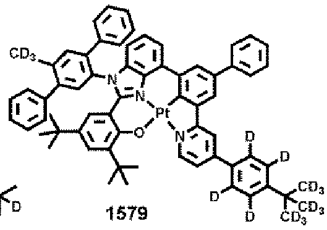

1579

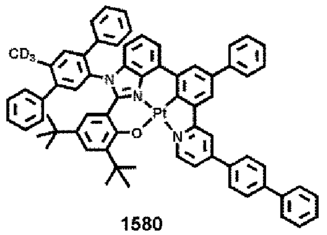

1580

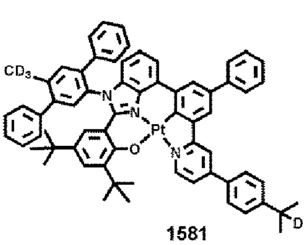

1581

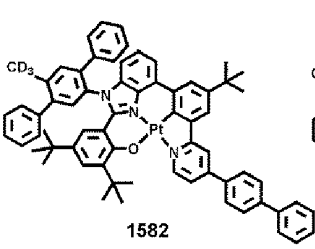

1582

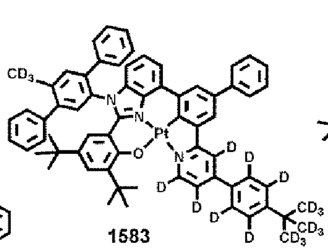

1583

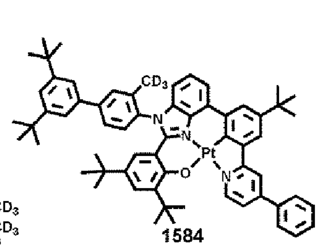

1584

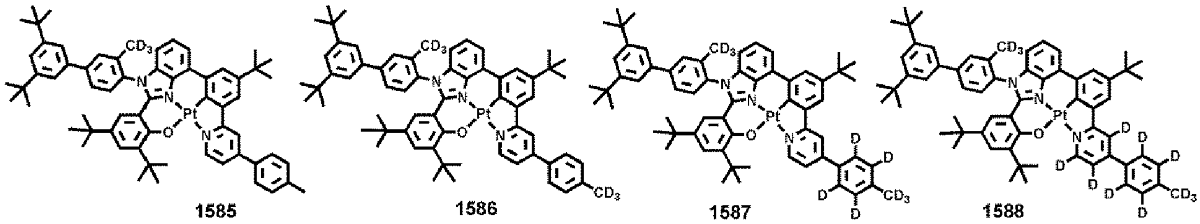

1585 1586 1587 1588

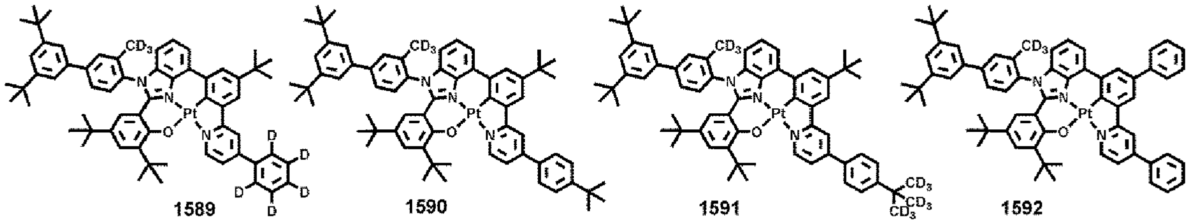

1589 1590 1591 1592

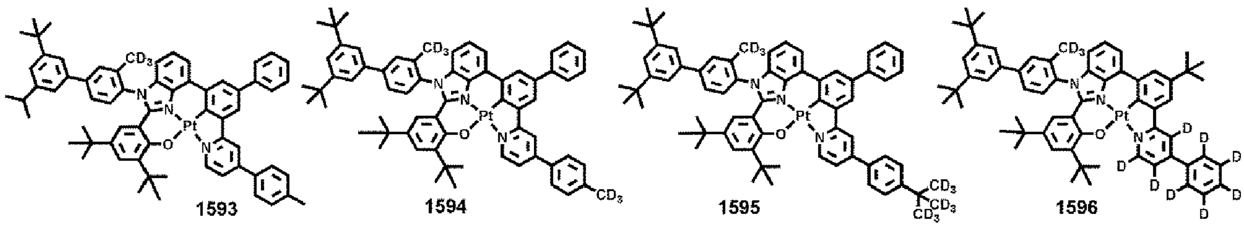

1593 1594 1595 1596

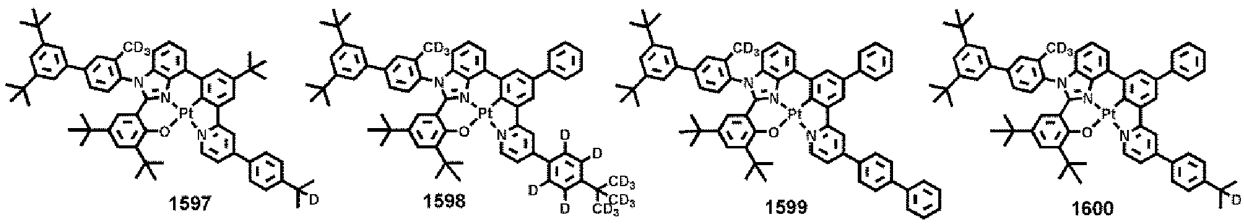

1597 1598 1599 1600

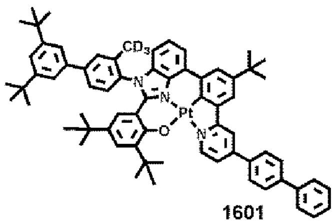

1601

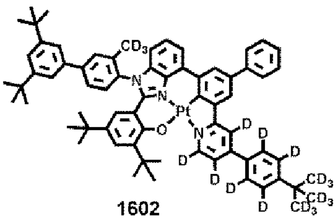

1602

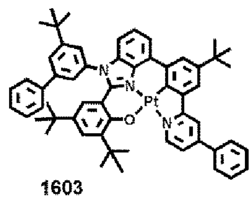

1603

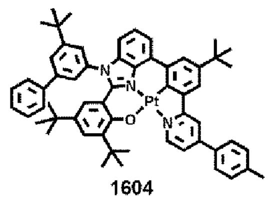

1604

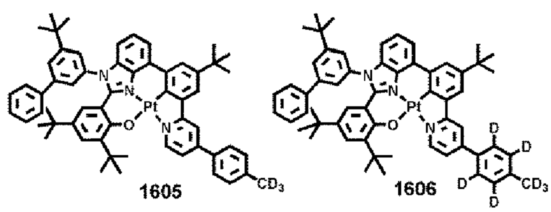

1605 1606

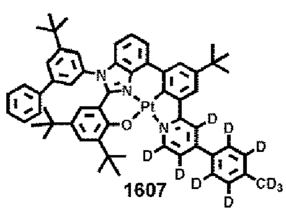

1607

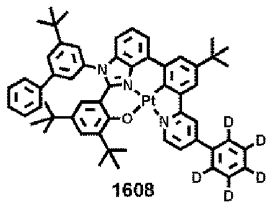

1608

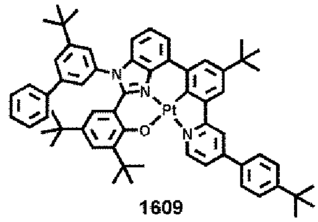
1609

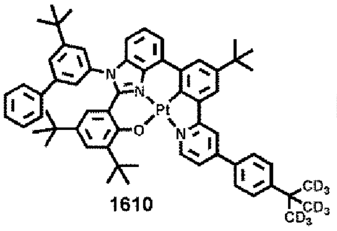
1610

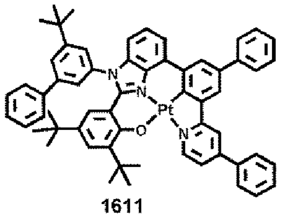
1611

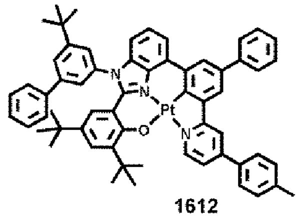
1612

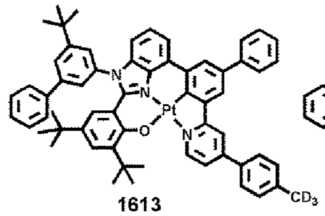
1613

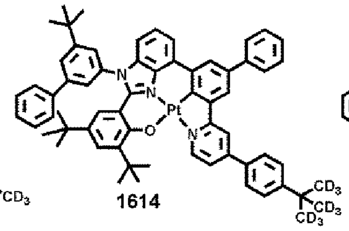
1614

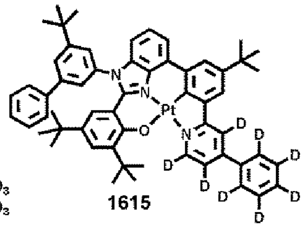
1615

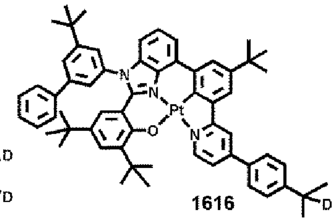
1616

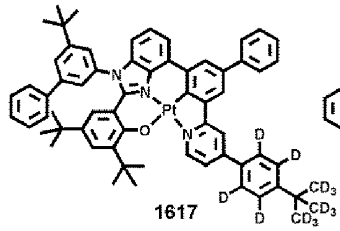
1617

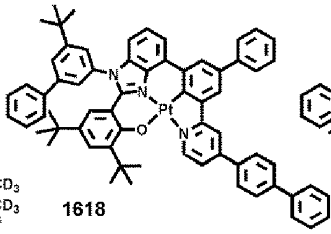
1618

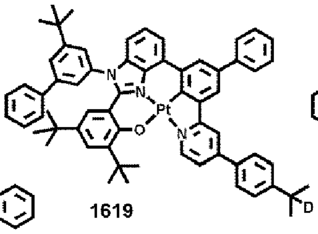
1619

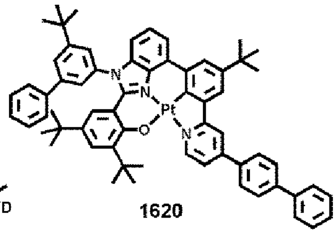
1620

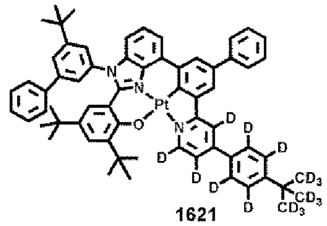
1621

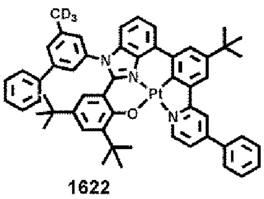
1622

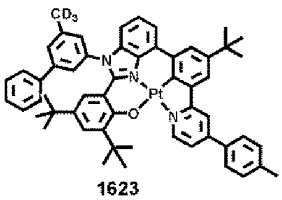
1623

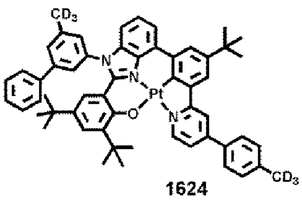
1624

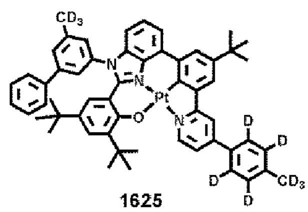
1625

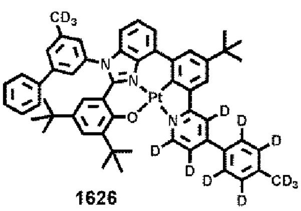
1626

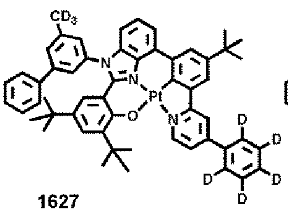
1627

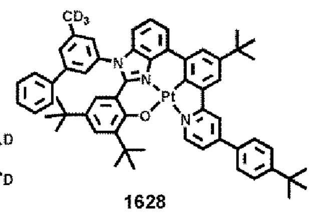
1628

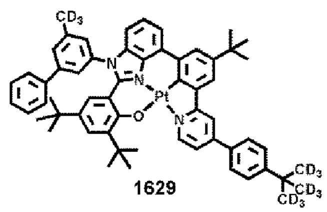
1629

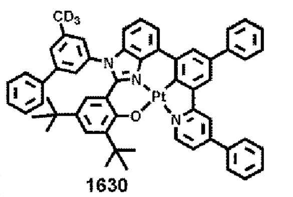
1630

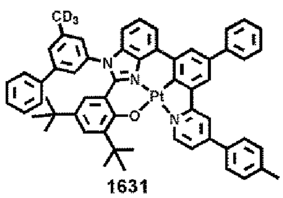
1631

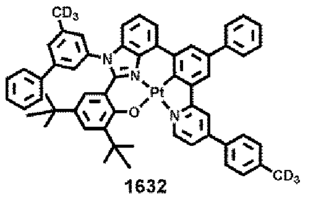
1632

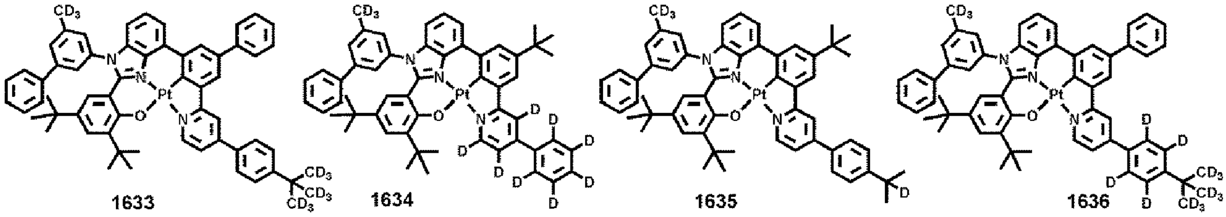

1633 1634 1635 1636

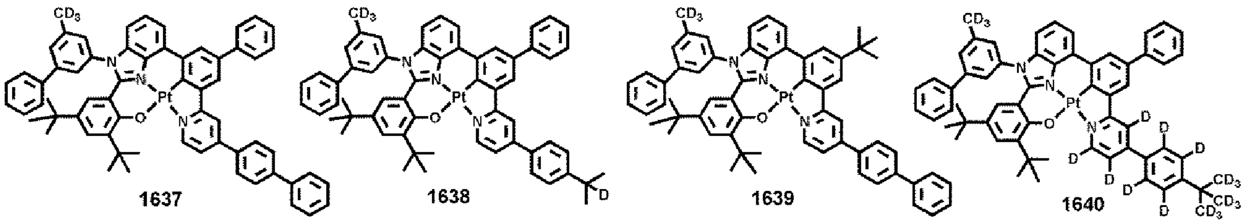

1637 1638 1639 1640

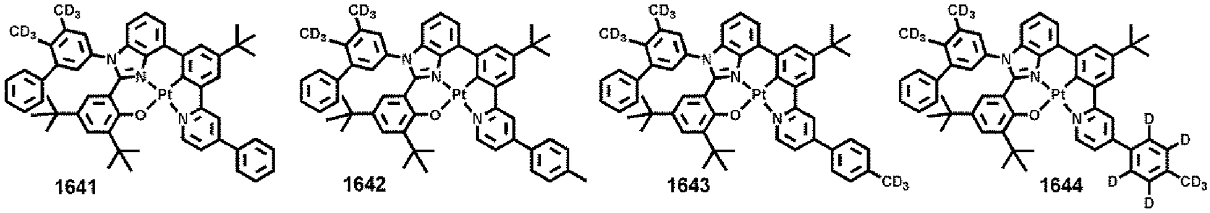

1641 1642 1643 1644

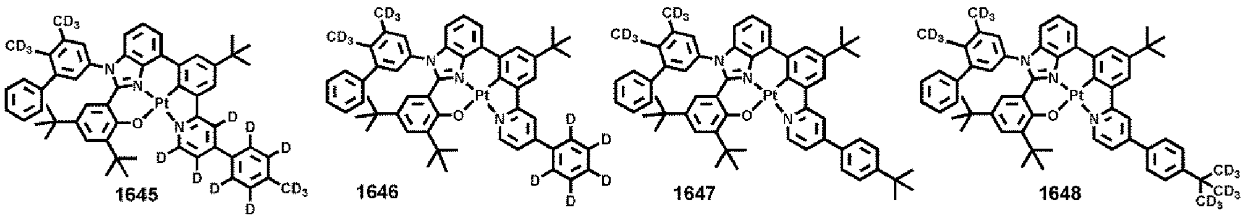

1645 1646 1647 1648

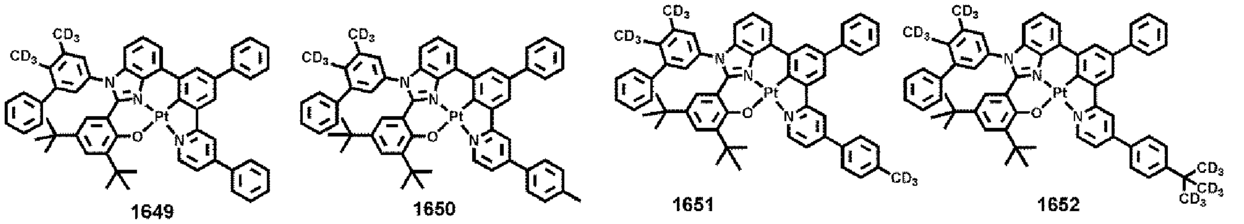

1649 1650 1651 1652

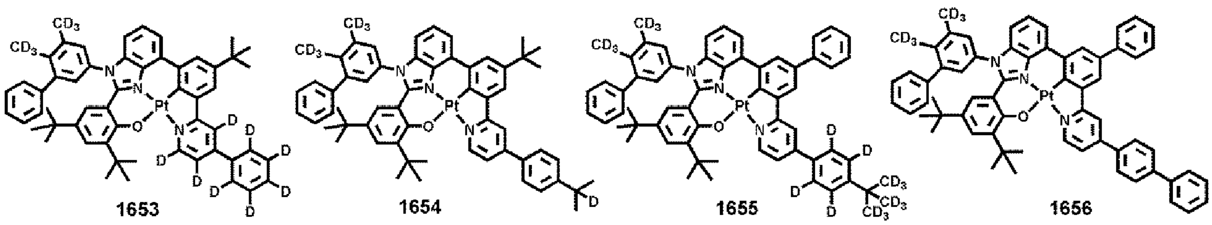

1653 1654 1655 1656

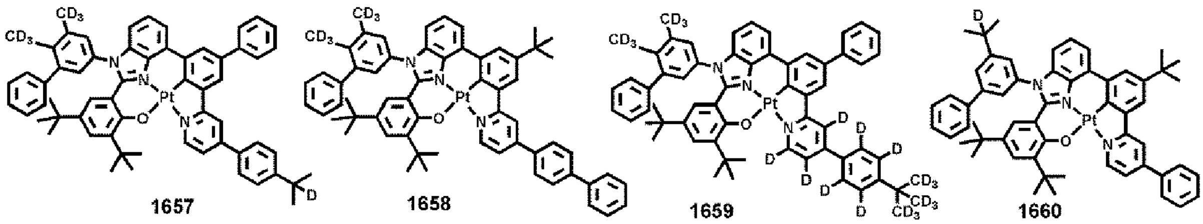

1657 1658 1659 1660

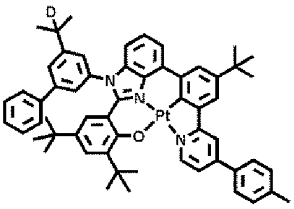

1661

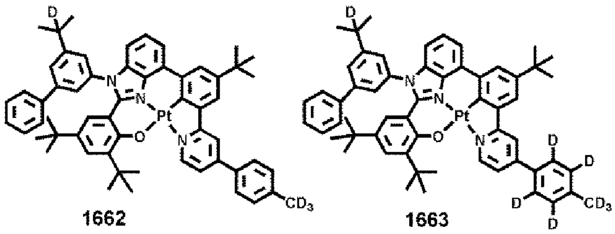

1662 1663

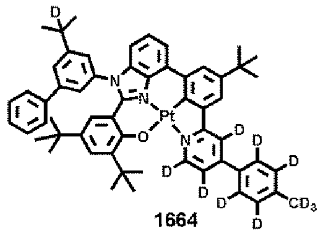

1664

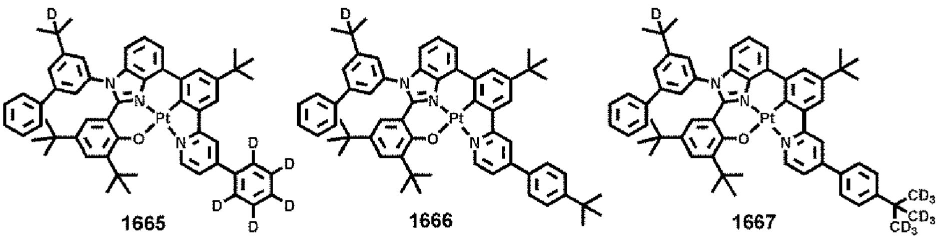

1665 1666 1667

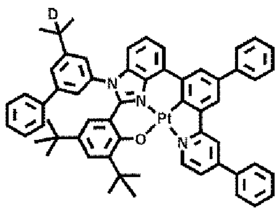

1668

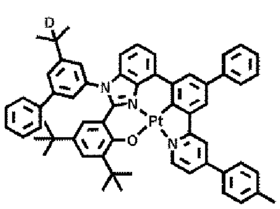

1669

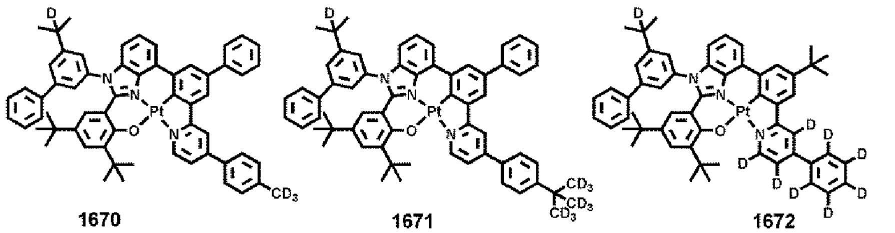

1670 1671 1672

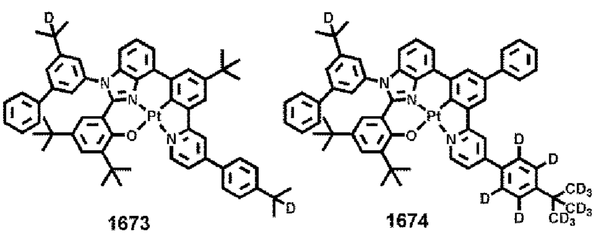

1673 1674

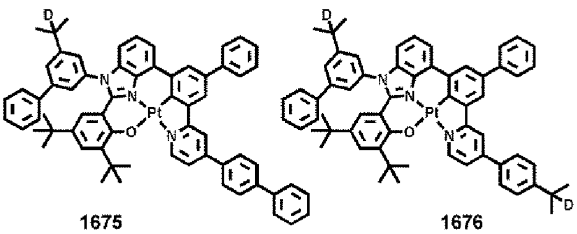

1675 1676

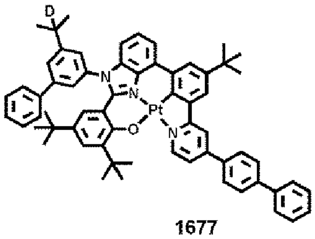

1677

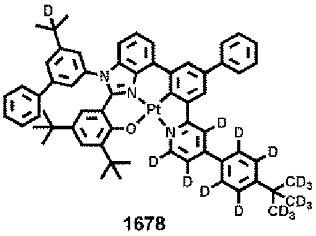

1678

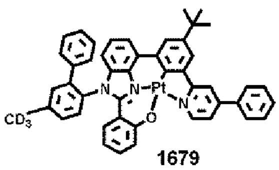
1679

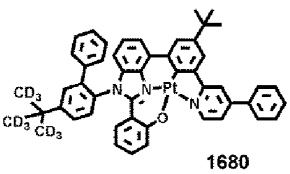
1680

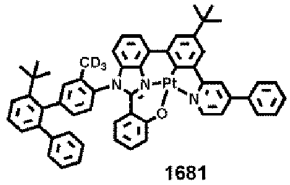
1681

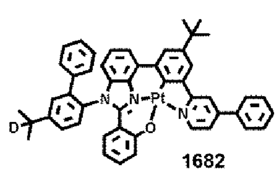
1682

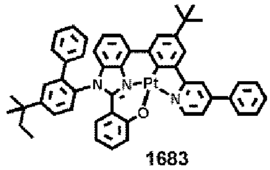
1683

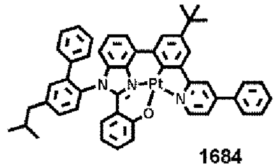
1684

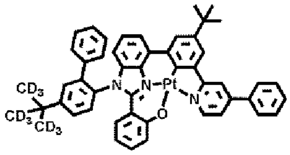
1685

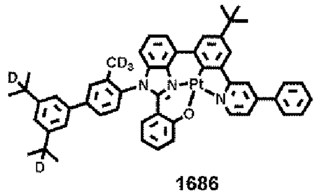
1686

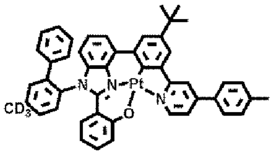
1687

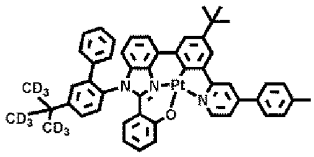
1688

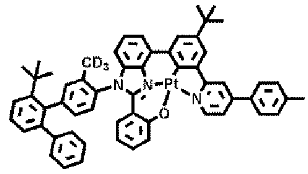
1689

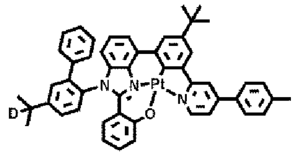
1690

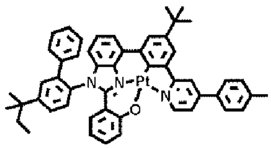
1691

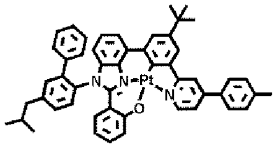
1692

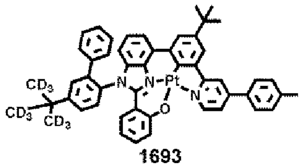
1693

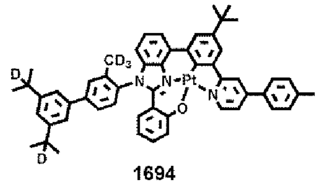
1694

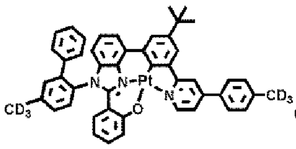
1695

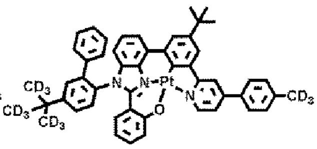
1696

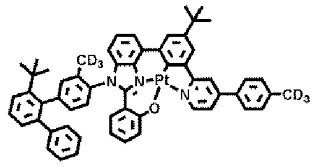
1697

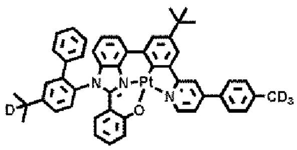
1698

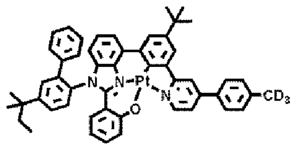
1699

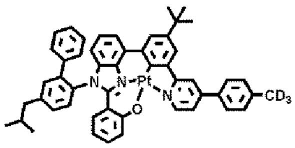
1700

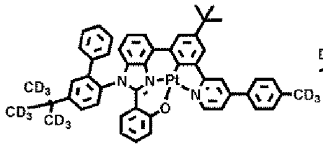
1701

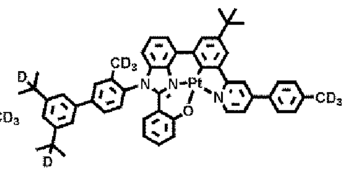
1702

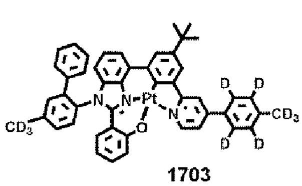
1703

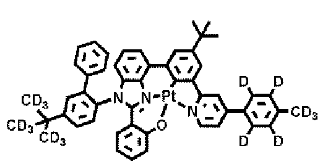
1704

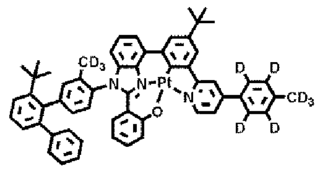
1705

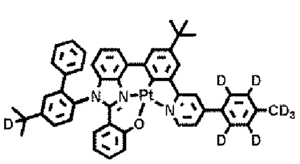
1706

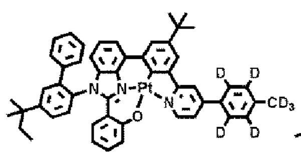
1707

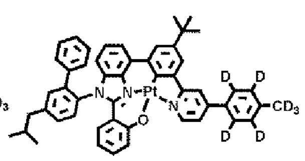
1708

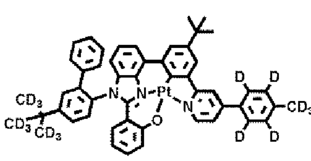
1709

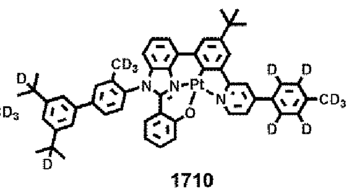
1710

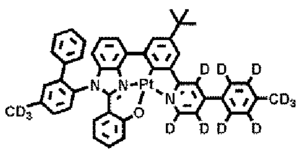
1711

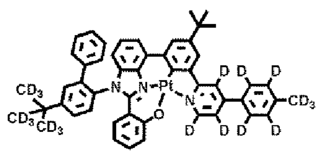
1712

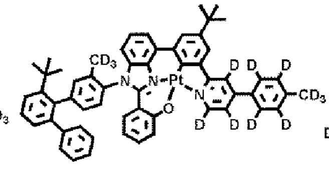
1713

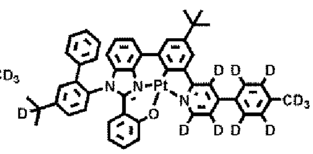
1714

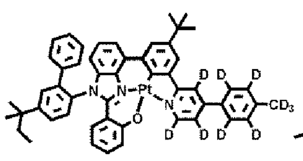
1715

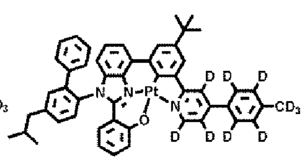
1716

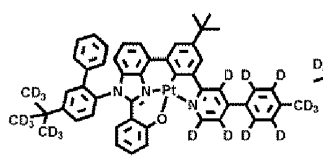
1717

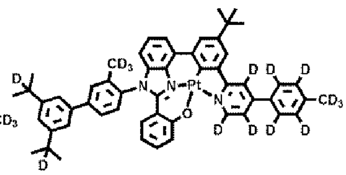
1718

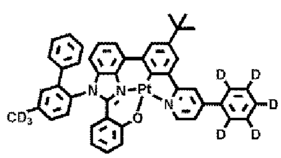
1719

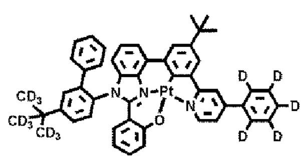
1720

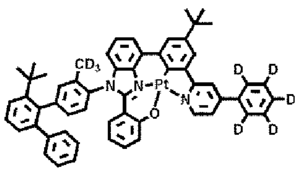
1721

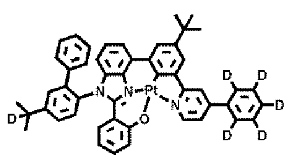
1722

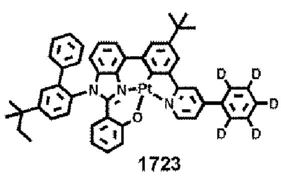
1723

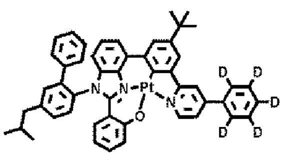
1724

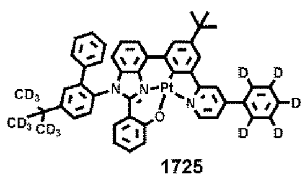
1725

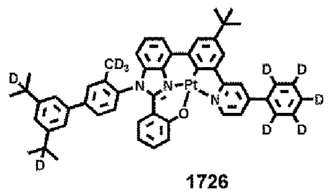
1726

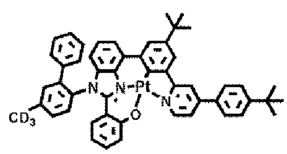
1727

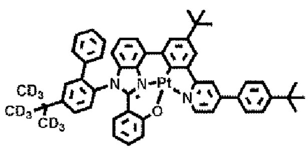
1728

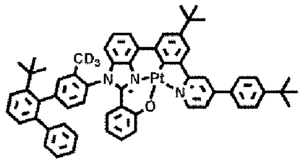
1729

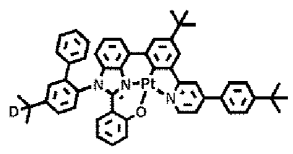
1730

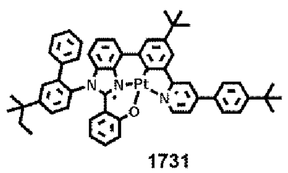
1731

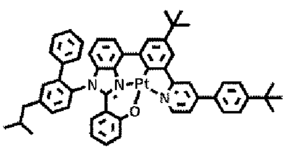
1732

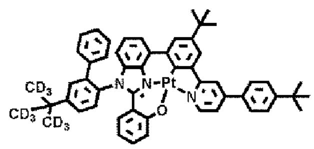
1733

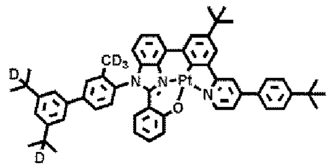
1734

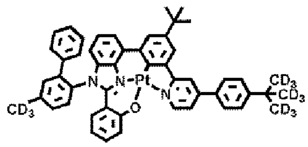
1735

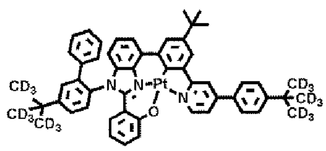
1736

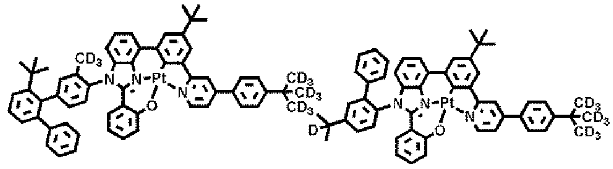
1737

1738

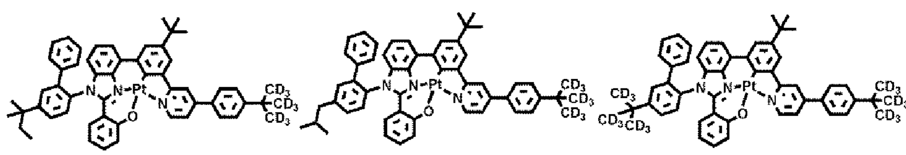
1739

1740

1741

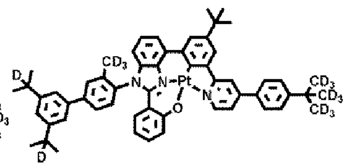
1742

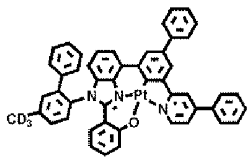
1743

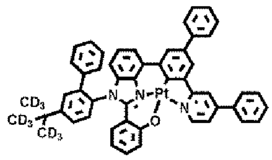
1744

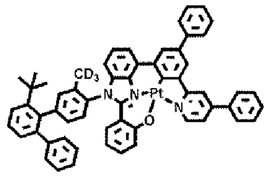
1745

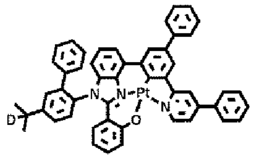
1746

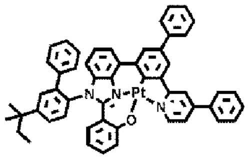
1747

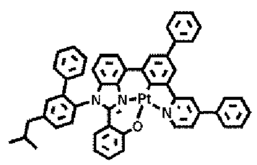
1748

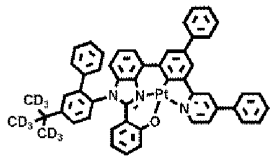
1749

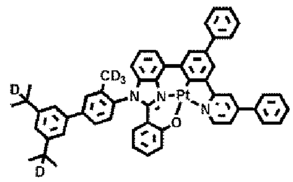
1750

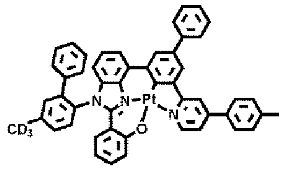
1751

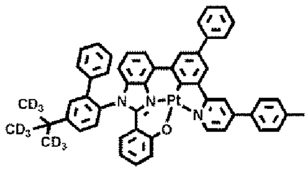
1752

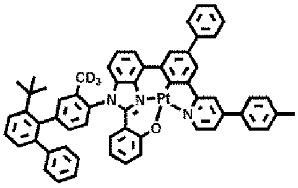
1753

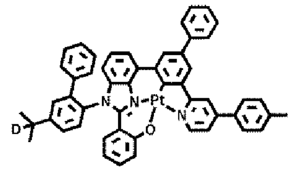
1754

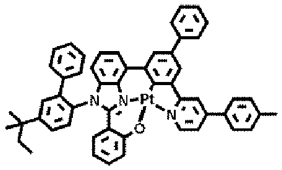
1755

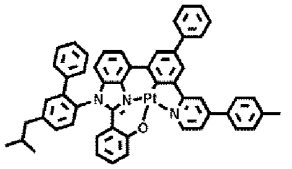
1756

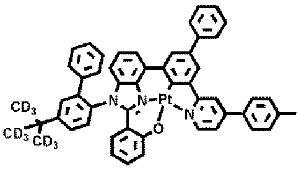
1757

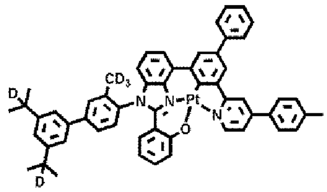
1758

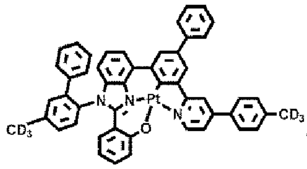
1759

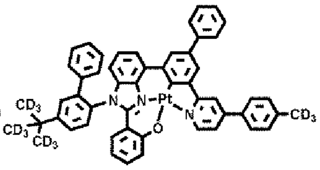
1760

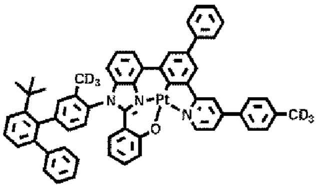
1761

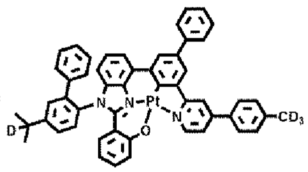
1762

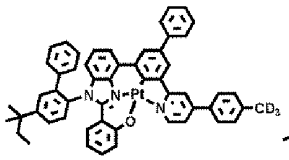
1763

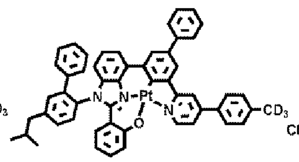
1764

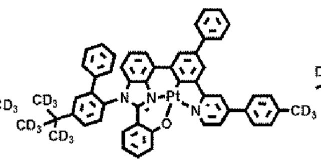
1765

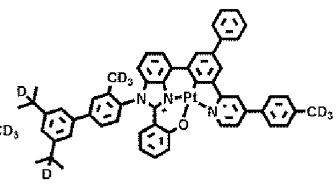
1766

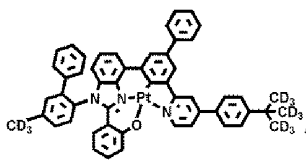
1767

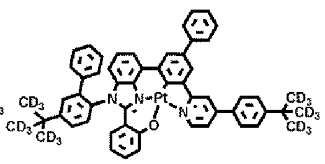
1768

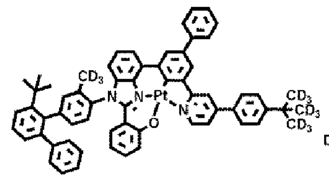
1769

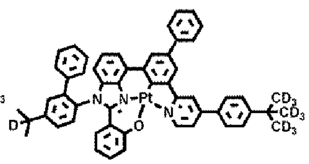
1770

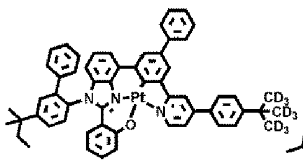
1771

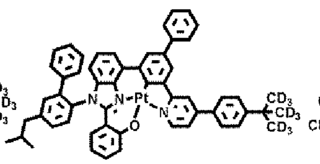
1772

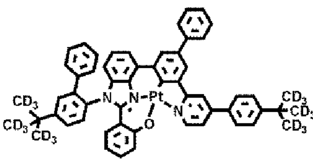
1773

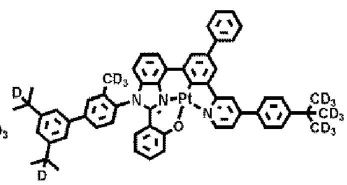
1774

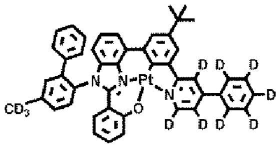
1775

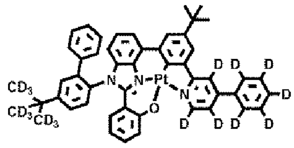
1776

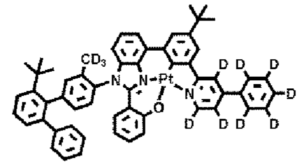
1777

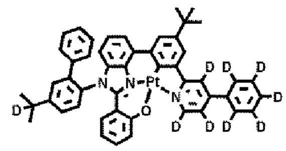
1778

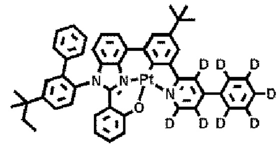
1779

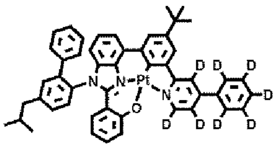
1780

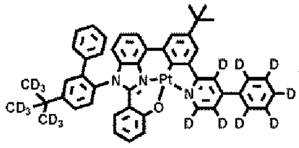
1781

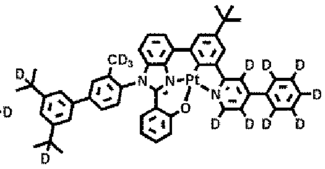
1782

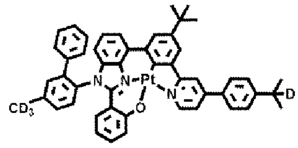
1783

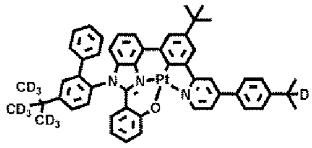
1784

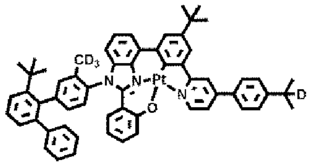
1785

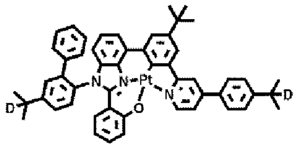
1786

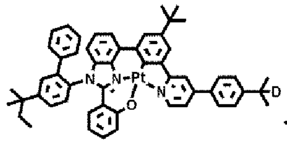
1787

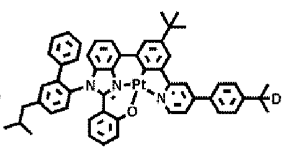
1788

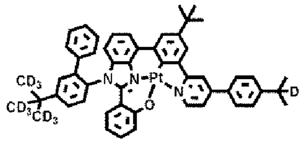
1789

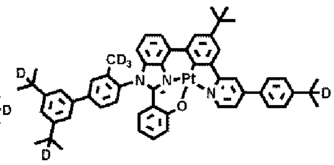
1790

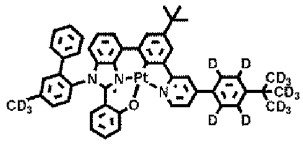
1791

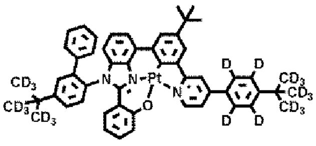
1792

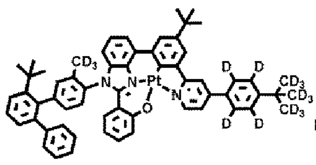
1793

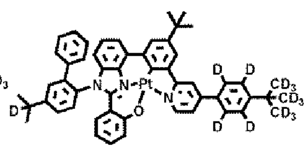
1794

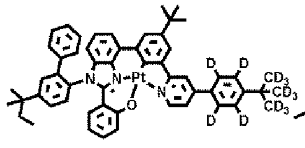
1795

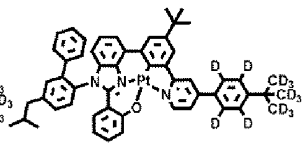
1796

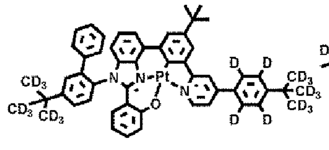
1797

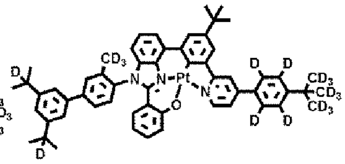
1798

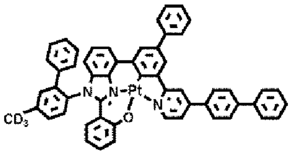
1799

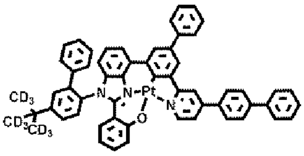
1800

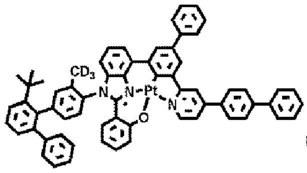
1801

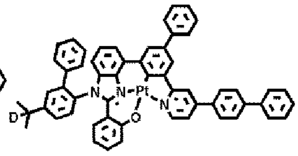
1802

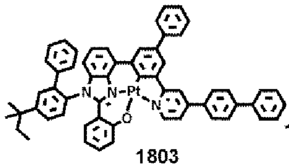
1803

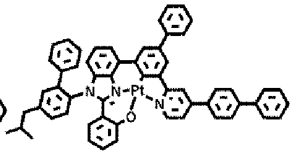
1804

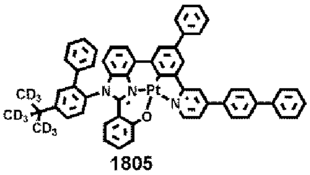
1805

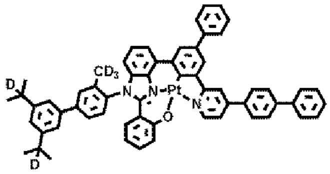
1806

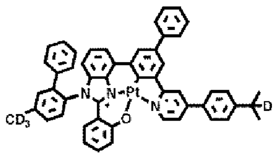
1807

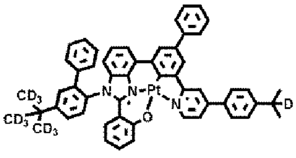
1808

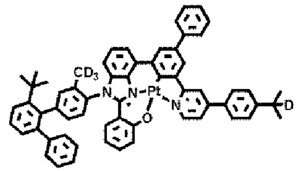
1809

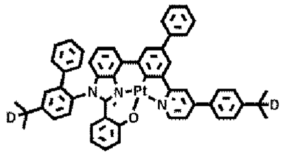
1810

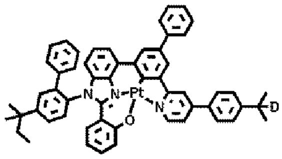
1811

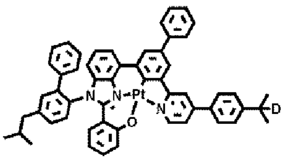
1812

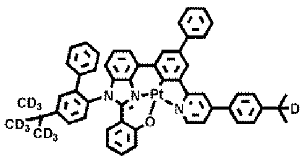
1813

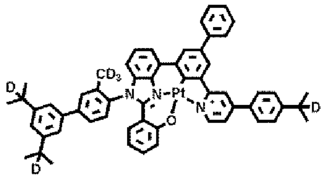
1814

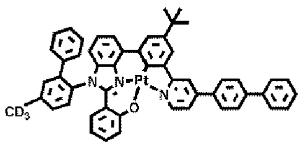
1815

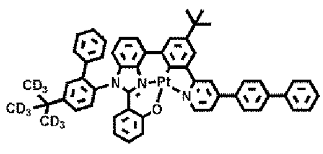
1816

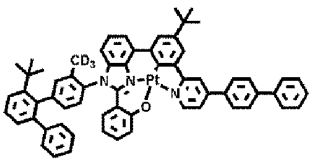
1817

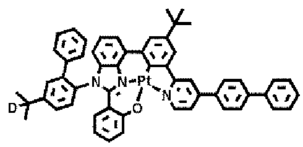
1818

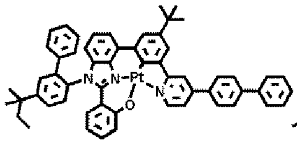
1819

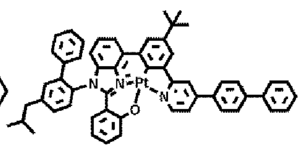
1820

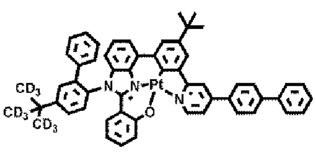
1821

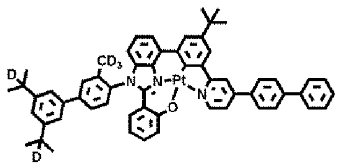
1822

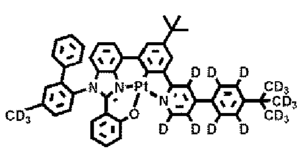

1823

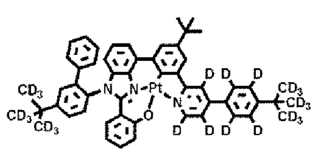

1824

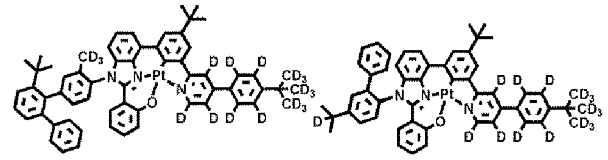

1825

1826

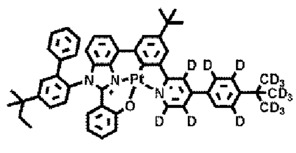

1827

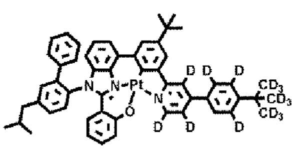

1828

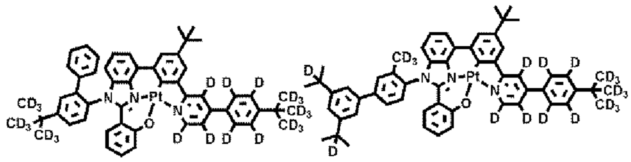

1829

1830

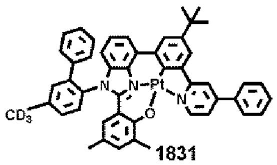

1831

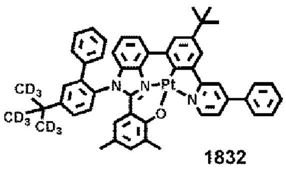

1832

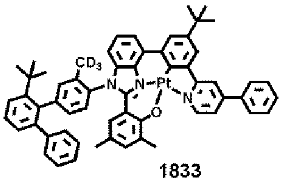

1833

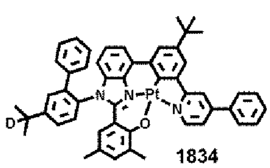

1834

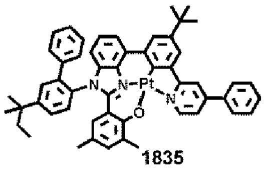

1835

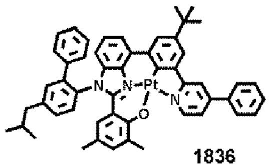

1836

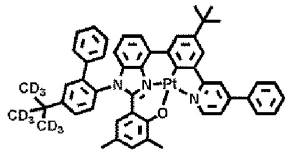

1837

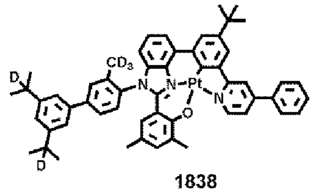

1838

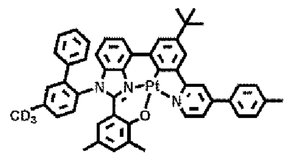

1839

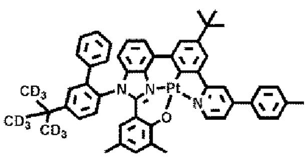

1840

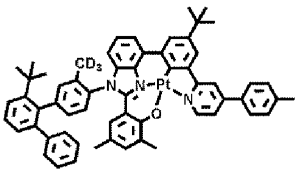

1841

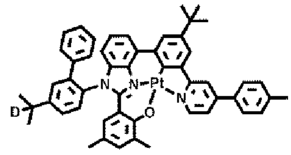

1842

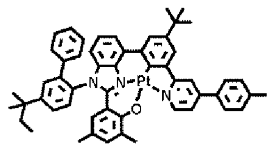

1843

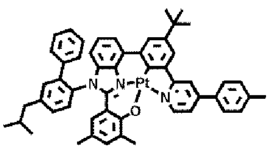

1844

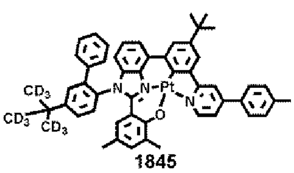

1845

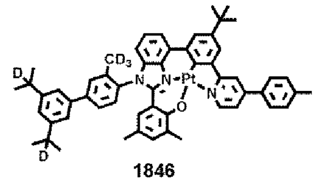

1846

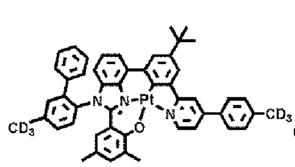

1847

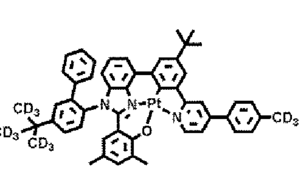

1848

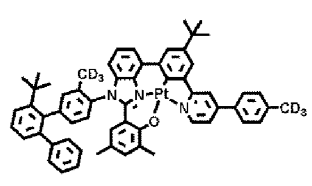

1849

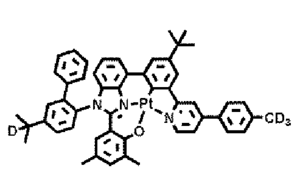

1850

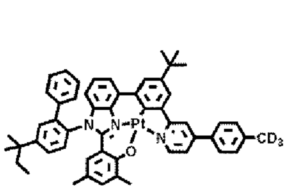

1851

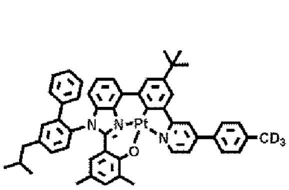

1852

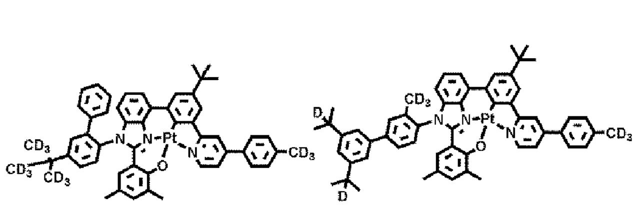

1853

1854

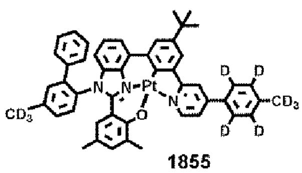
1855

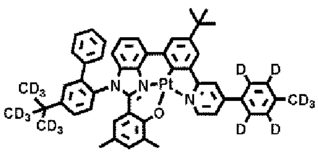
1856

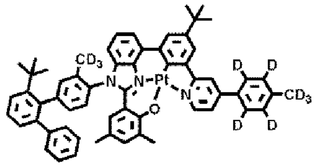
1857

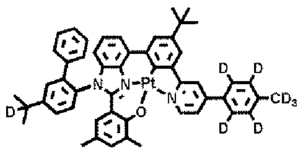
1858

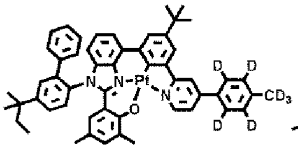
1859

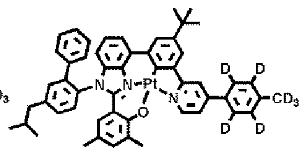
1860

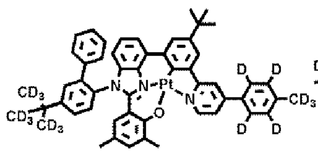
1861

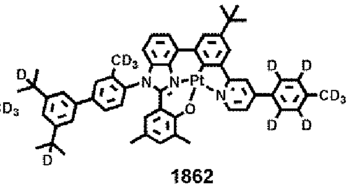
1862

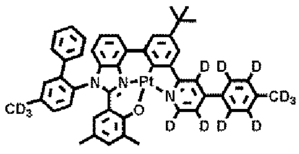
1863

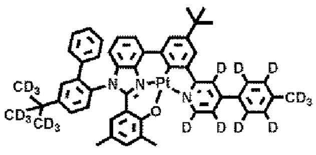
1864

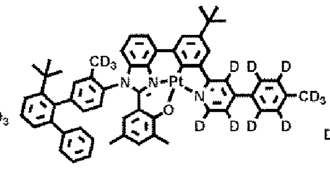
1865

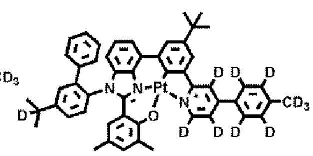
1866

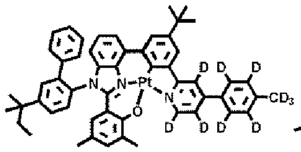
1867

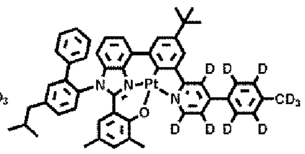
1868

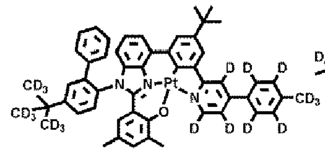
1869

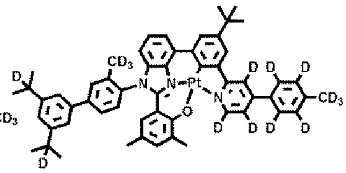
1870

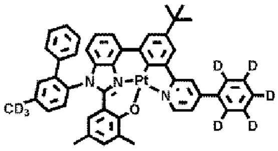
1871

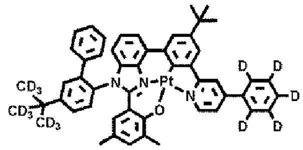
1872

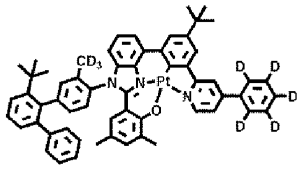
1873

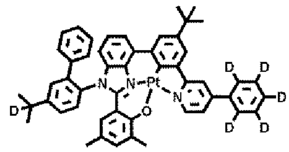
1874

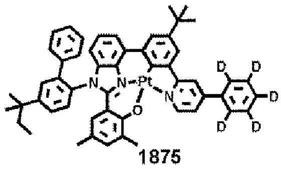
1875

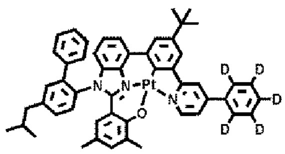
1876

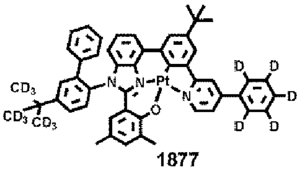
1877

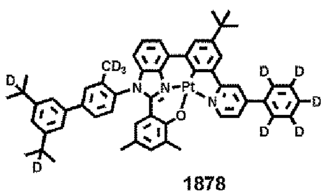
1878

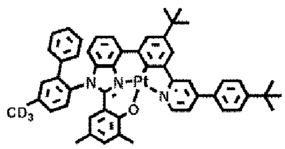
1879

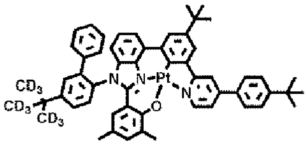
1880

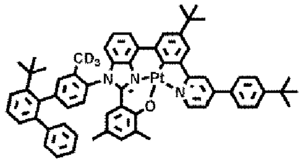
1881

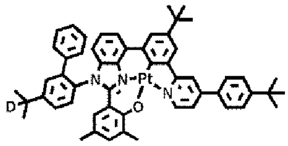
1882

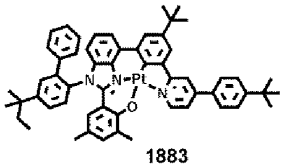
1883

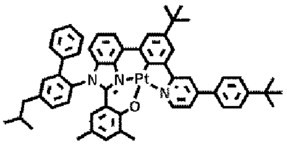
1884

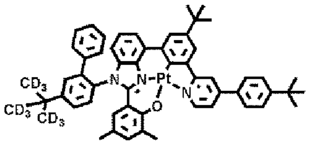
1885

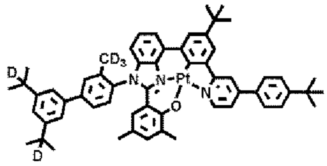
1886

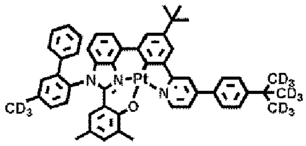
1887

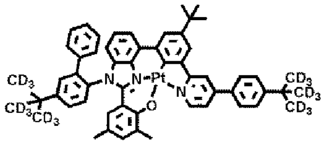
1888

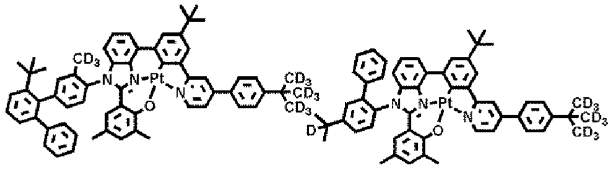
1889

1890

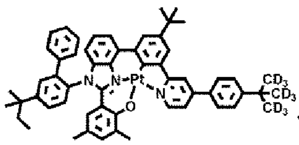
1891

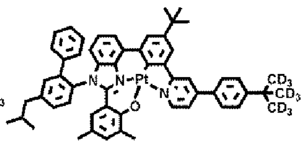
1892

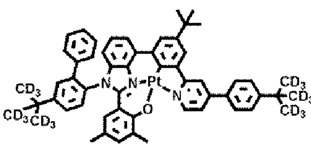
1893

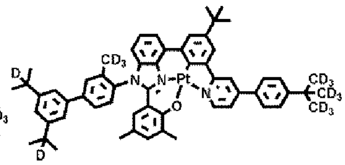
1894

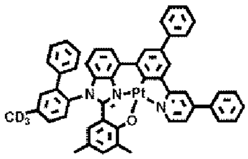
1895

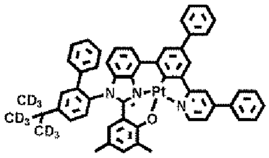
1896

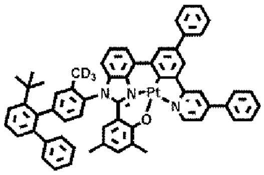
1897

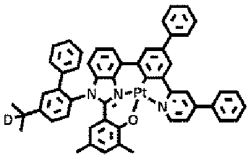
1898

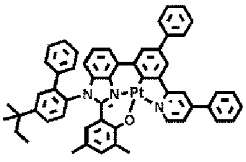
1899

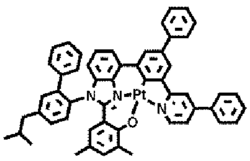
1900

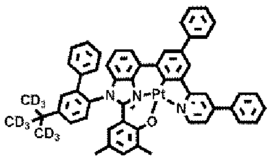
1901

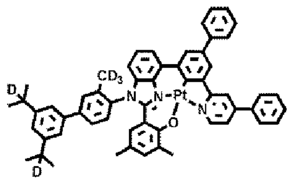
1902

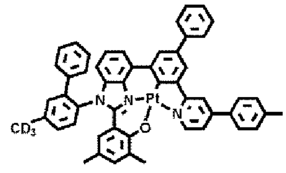
1903
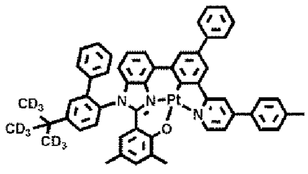
1904
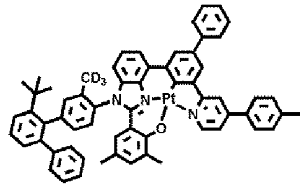
1905
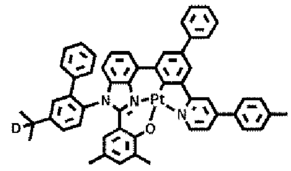
1906

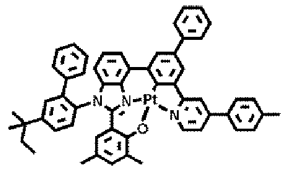
1907
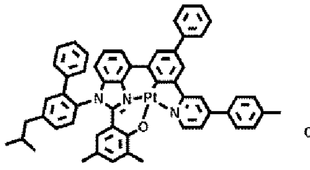
1908
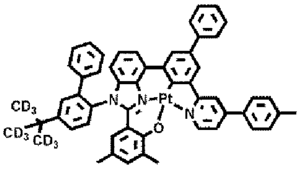
1909
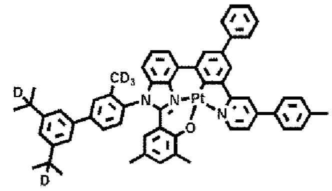
1910

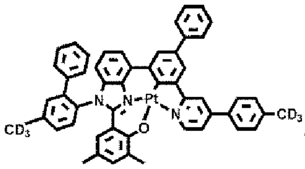
1911
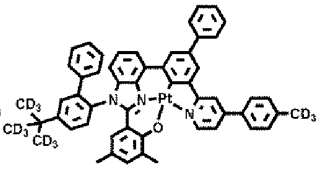
1912
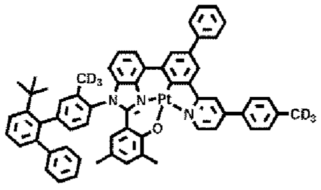
1913
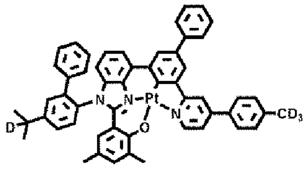
1914

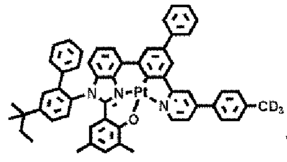
1915
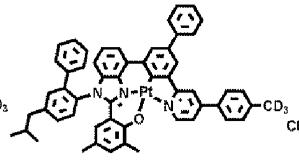
1916
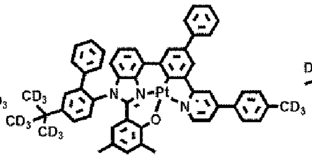
1917
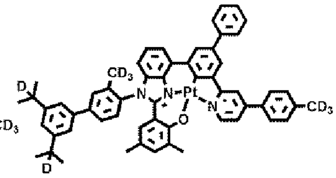
1918

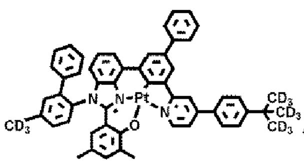
1919
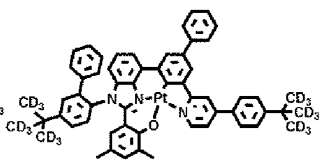
1920
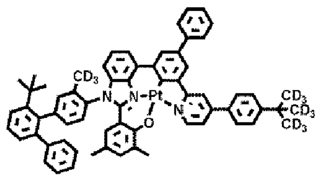
1921
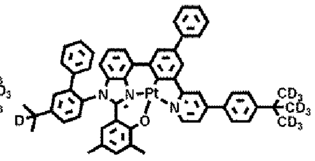
1922

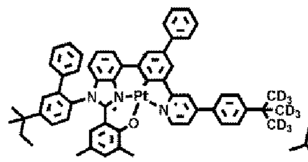
1923
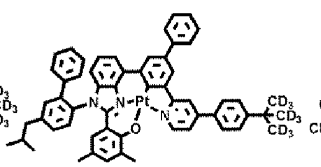
1924
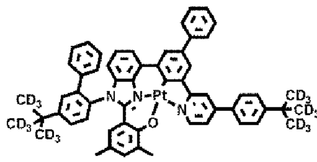
1925
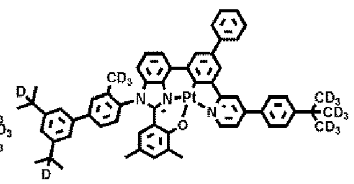
1926

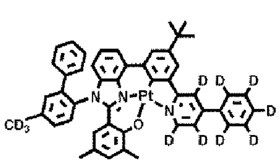
1927

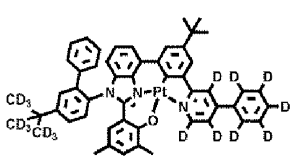
1928

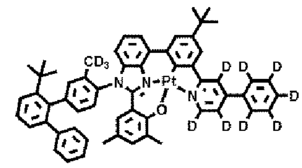
1929

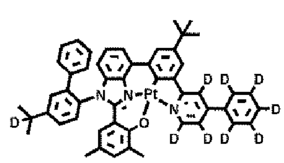
1930

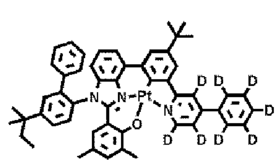
1931

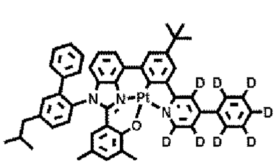
1932

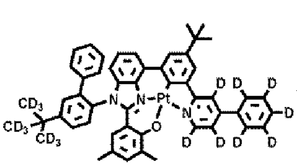
1933

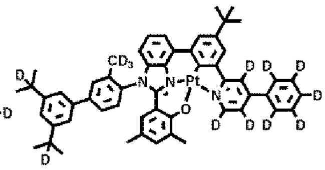
1934

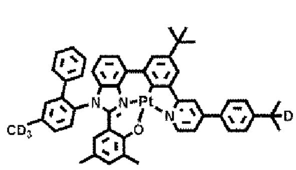
1935

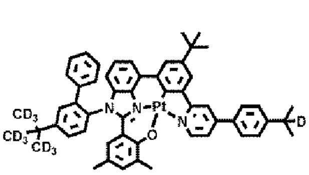
1936

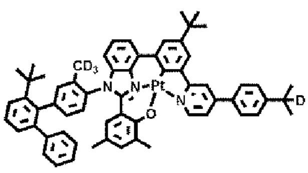
1937

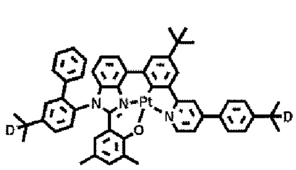
1938

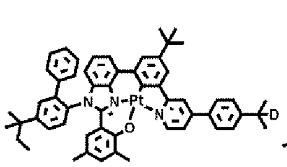
1939

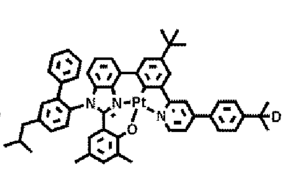
1940

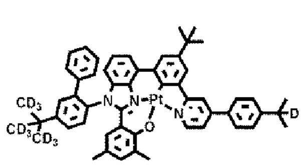
1941

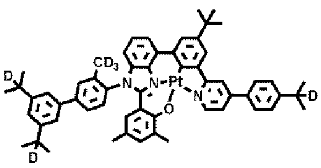
1942

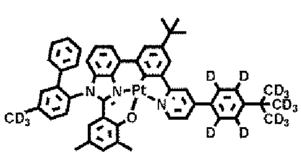
1943

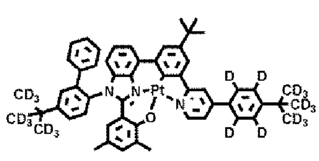
1944

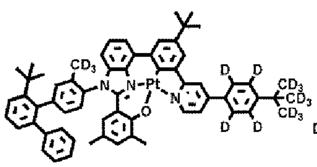
1945

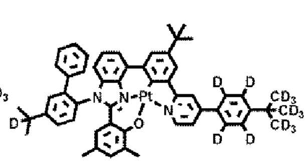
1946

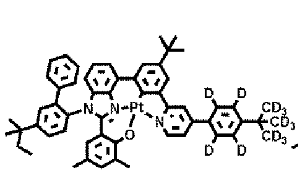
1947

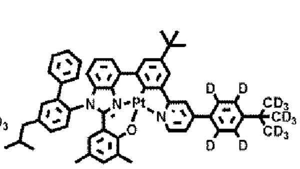
1948

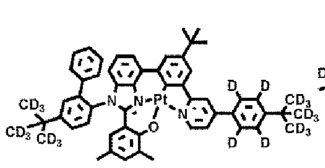
1949

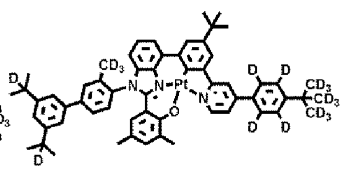
1950

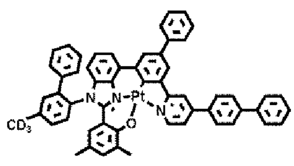
1951

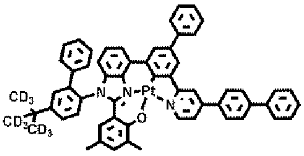
1952

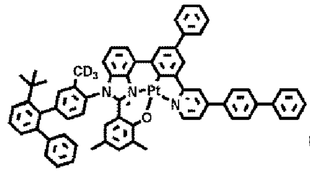
1953

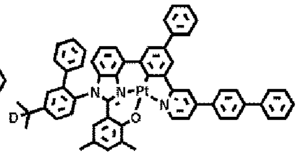
1954

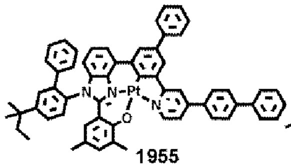
1955

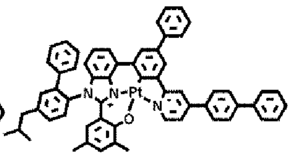
1956

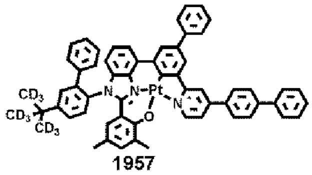
1957

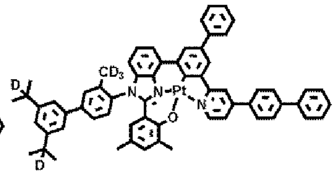
1958

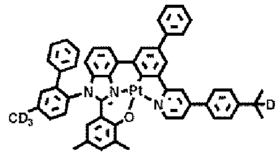
1959

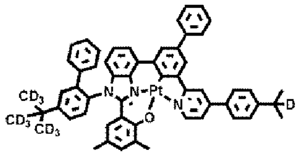
1960

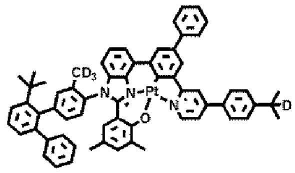
1961

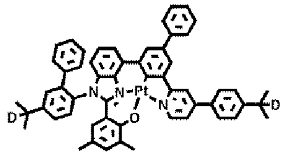
1962

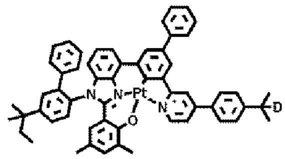
1963

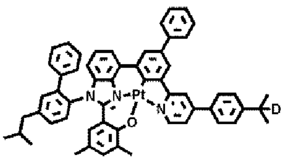
1964

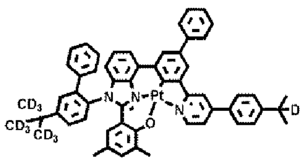
1965

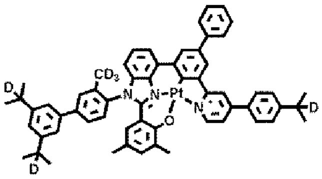
1966

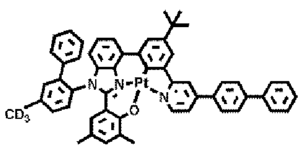
1967

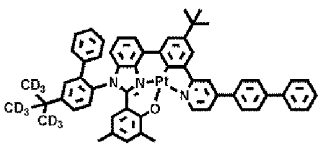
1968

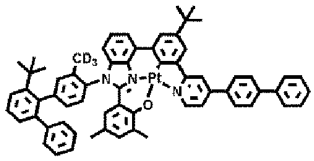
1969

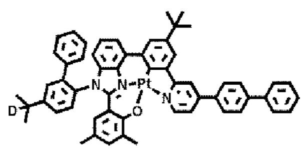
1970

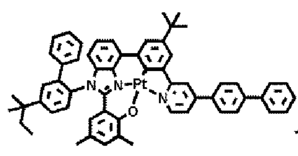
1971

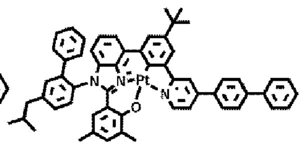
1972

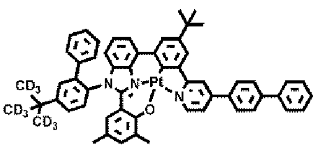
1973

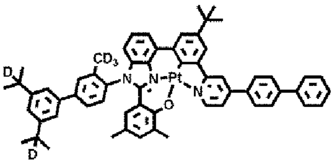
1974

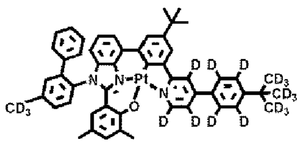
1975
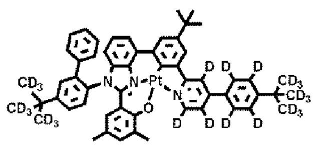
1976
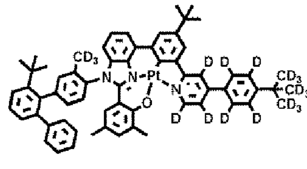
1977
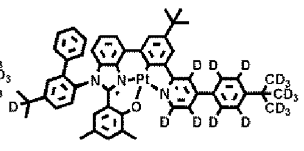
1978
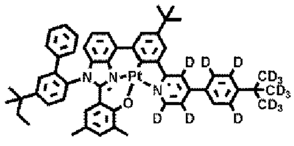
1979
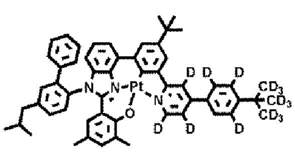
1980
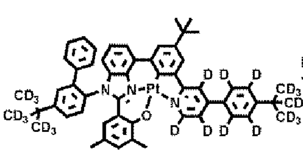
1981
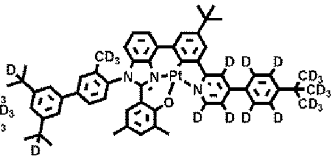
1982
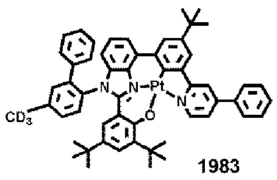
1983
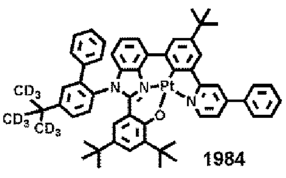
1984
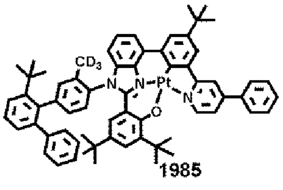
1985
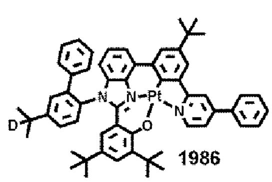
1986
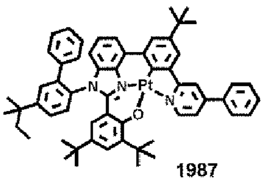
1987
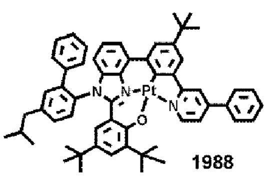
1988
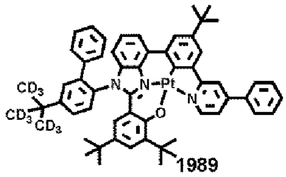
1989
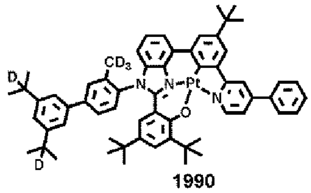
1990
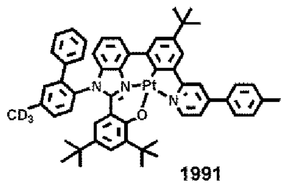
1991
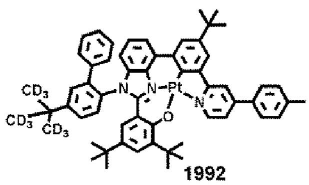
1992
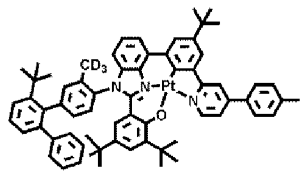
1993
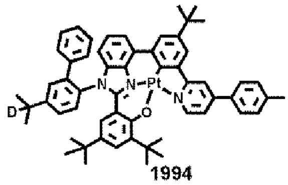
1994
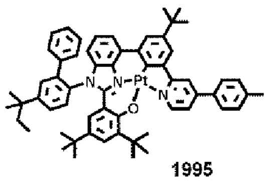
1995
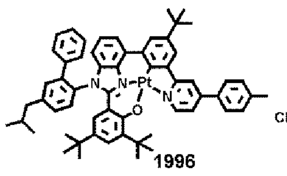
1996
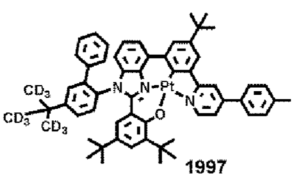
1997
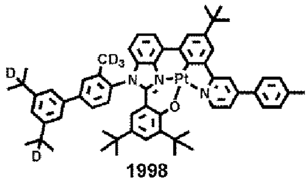
1998
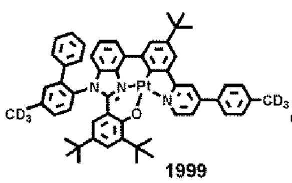
1999
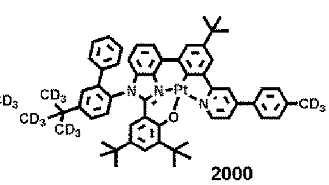
2000
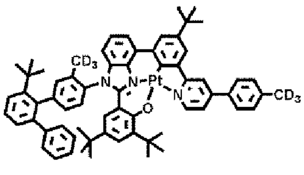
2001
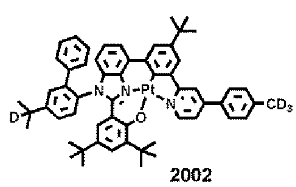
2002
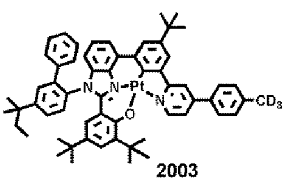
2003
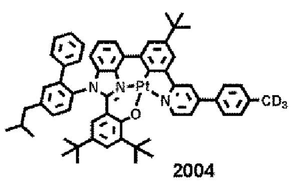
2004
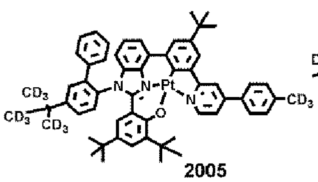
2005
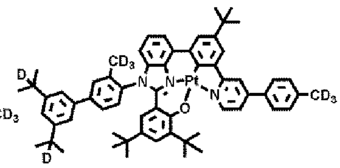
2006

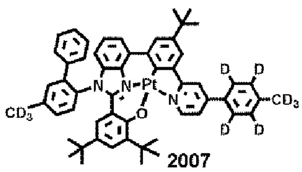
2007
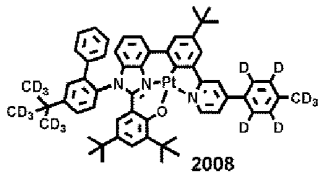
2008
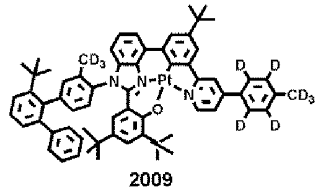
2009
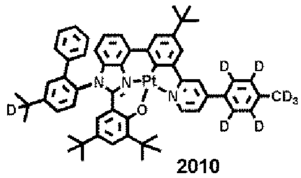
2010

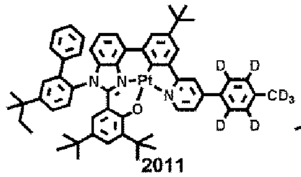
2011
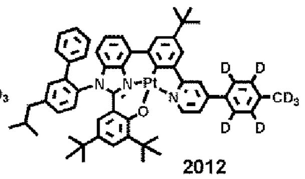
2012
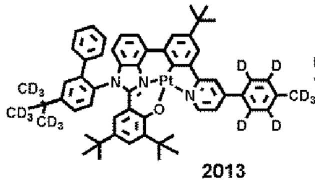
2013
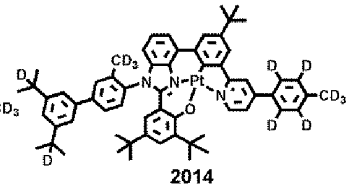
2014

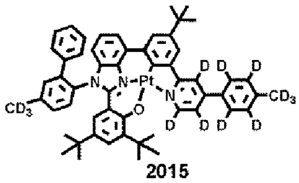
2015
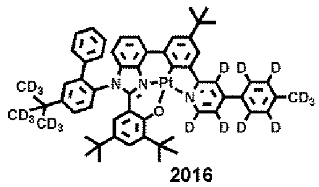
2016
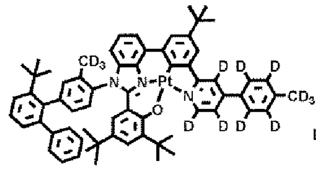
2017
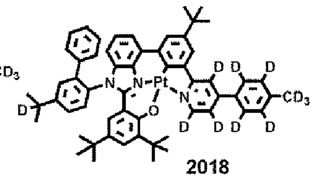
2018

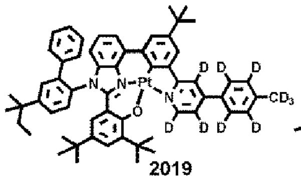
2019
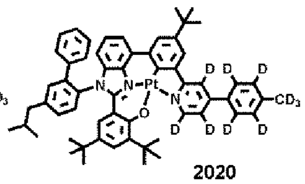
2020
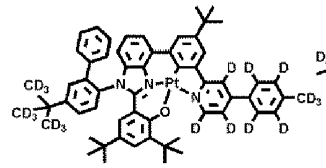
2021
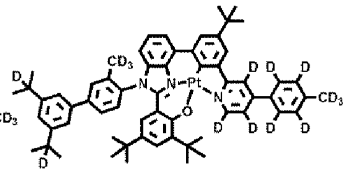
2022

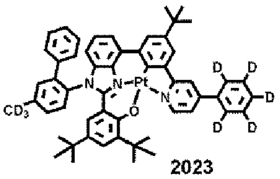
2023
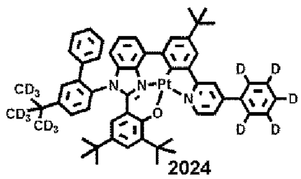
2024
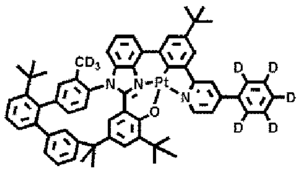
2025
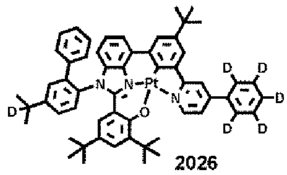
2026

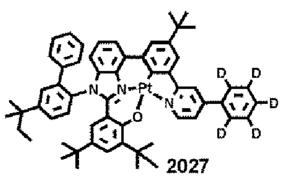
2027
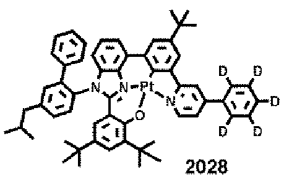
2028
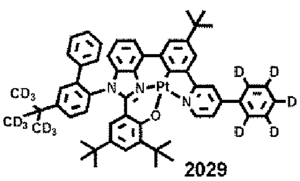
2029
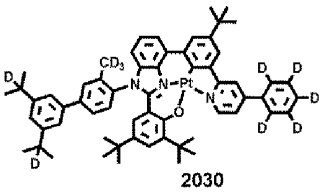
2030

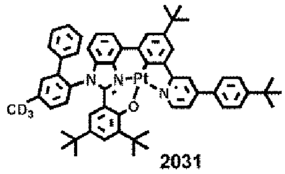
2031

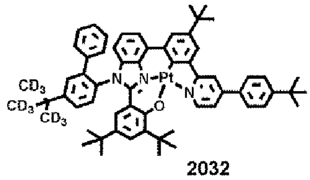
2032

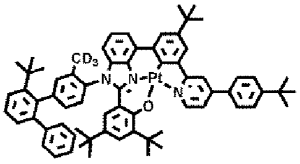
2033

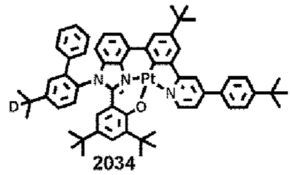
2034

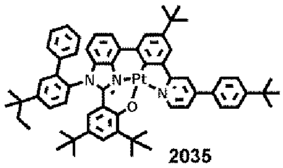
2035

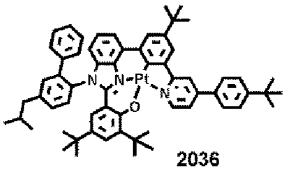
2036

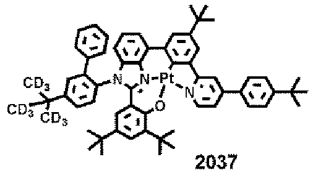
2037

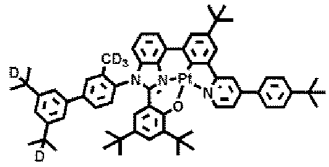
2038

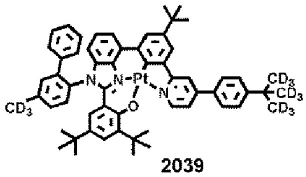
2039

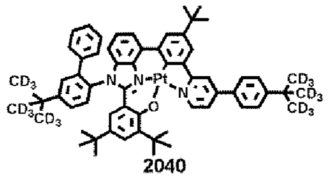
2040

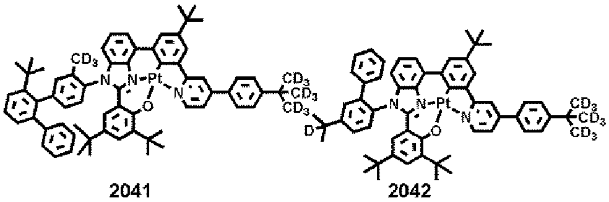
2041

2042

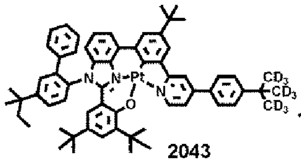
2043

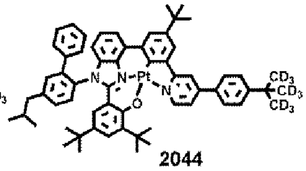
2044

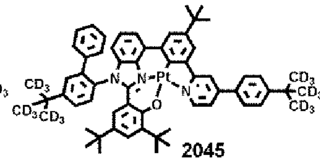
2045

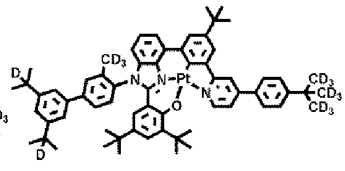
2046

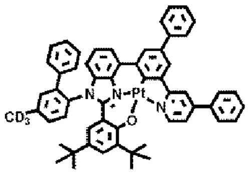
2047

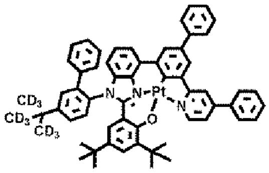
2048

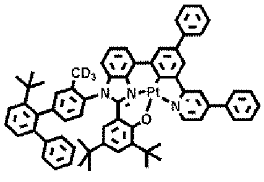
2049

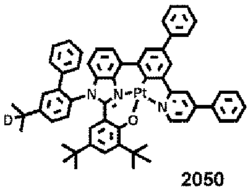
2050

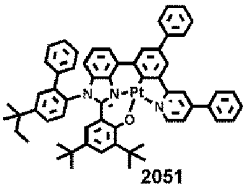
2051

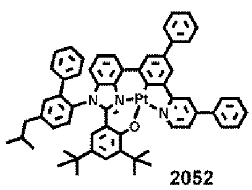
2052

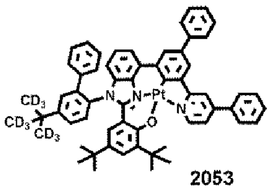
2053

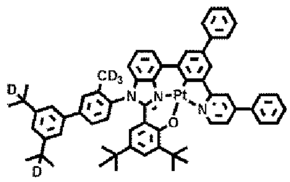
2054

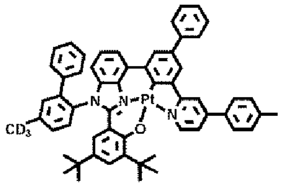
2055

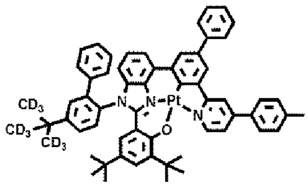
2056

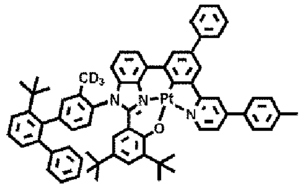
2057

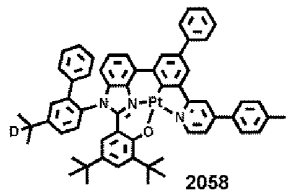
2058

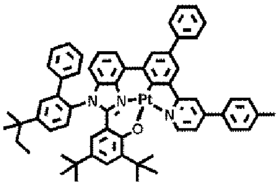
2059

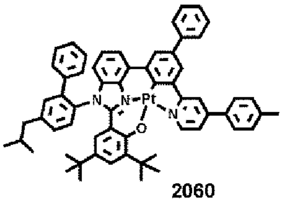
2060

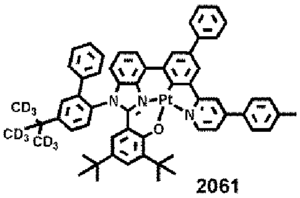
2061

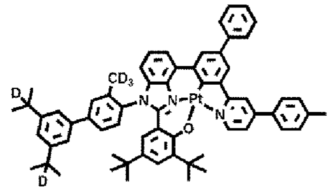
2062

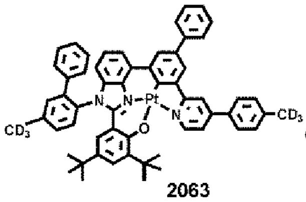
2063

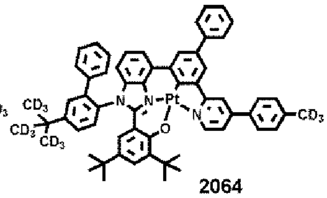
2064

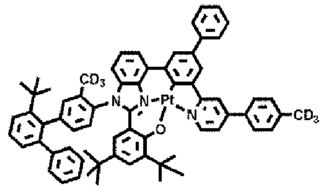
2065

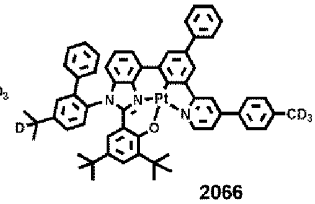
2066

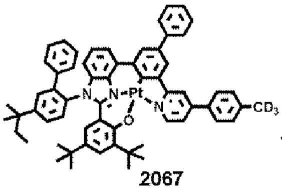
2067

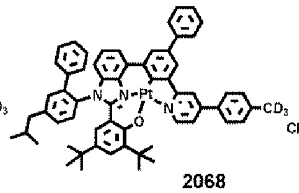
2068

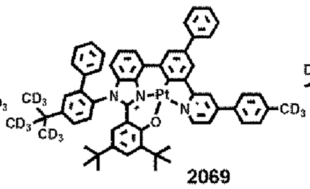
2069

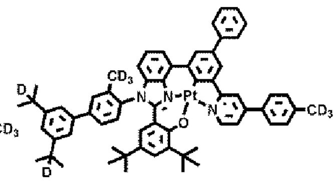
2070

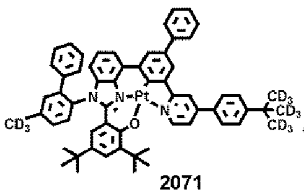
2071

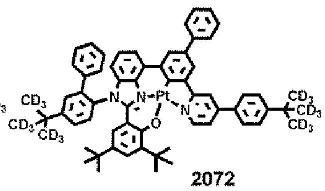
2072

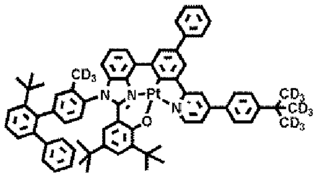
2073

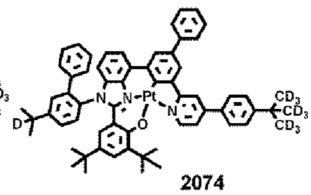
2074

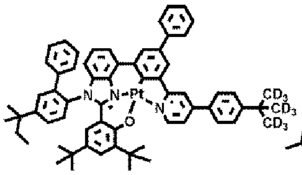
2075

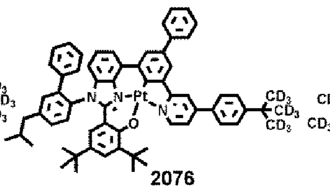
2076

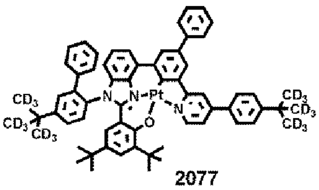
2077

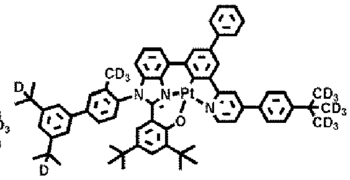
2078

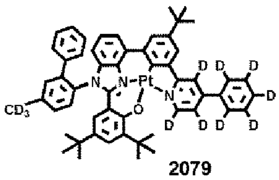
2079

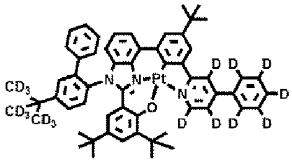
2080

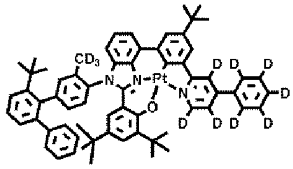
2081

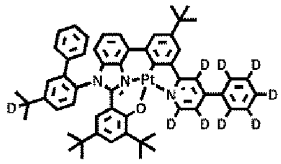
2082

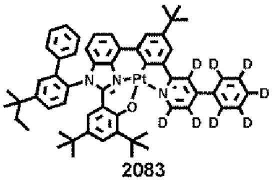
2083

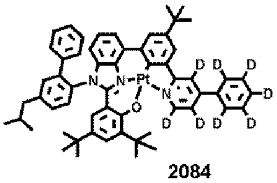
2084

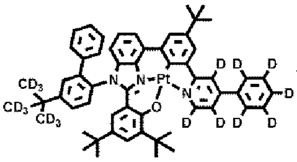
2085

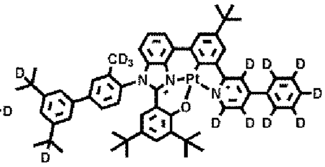
2086

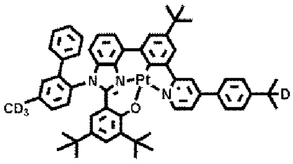
2087

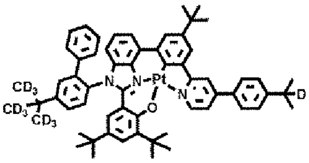
2088

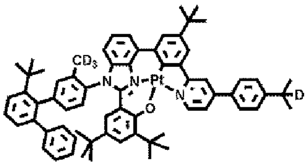
2089

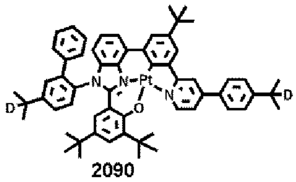
2090

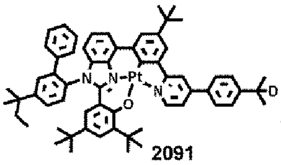
2091

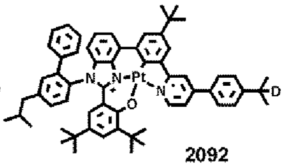
2092

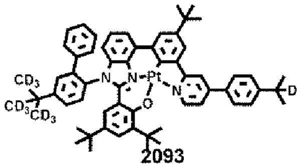
2093

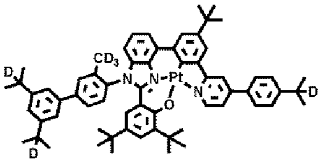
2094

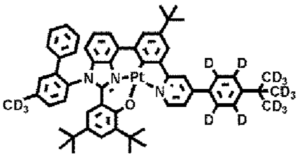
2095

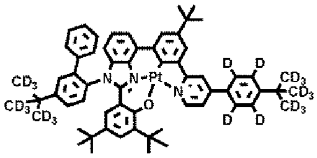
2096

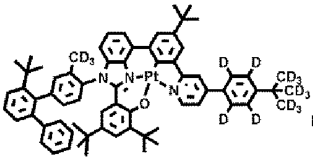
2097

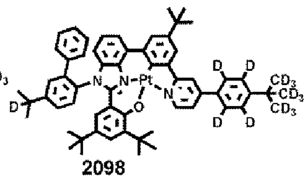
2098

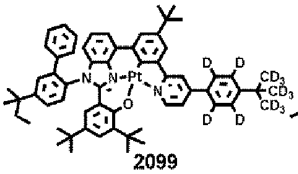
2099

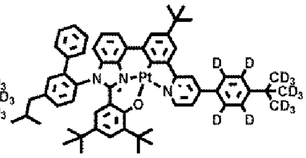
2100

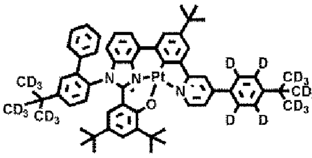
2101

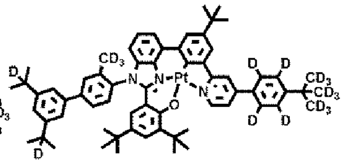
2102

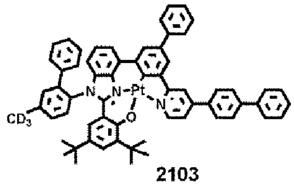
2103

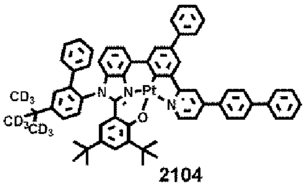
2104

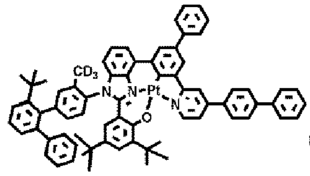
2105

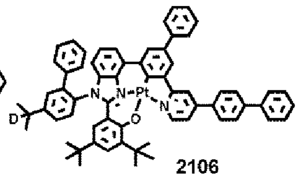
2106

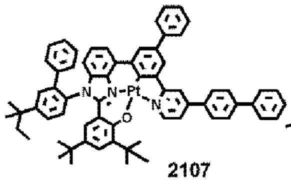
2107

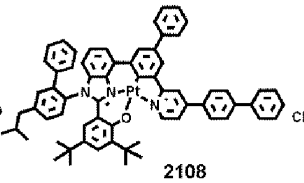
2108

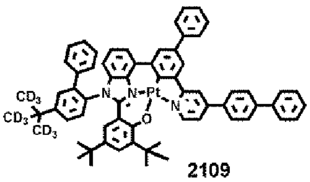
2109

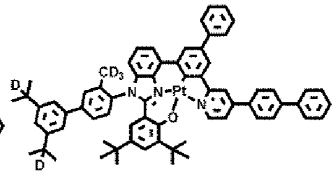
2110

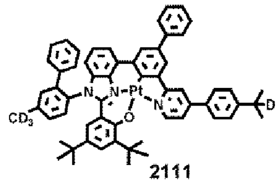
2111

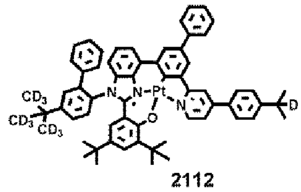
2112

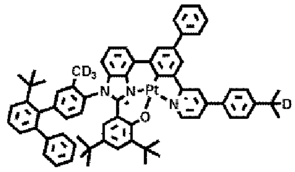
2113

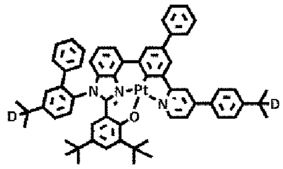
2114

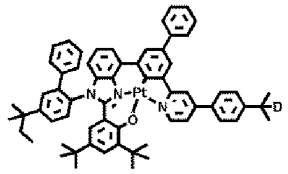
2115

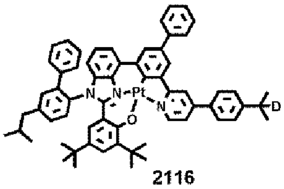
2116

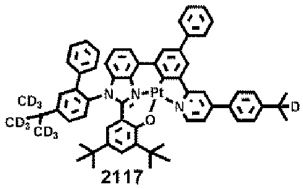
2117

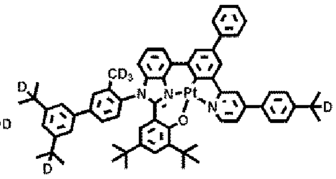
2118

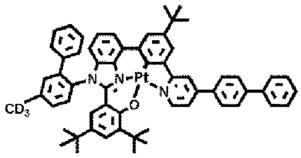
2119

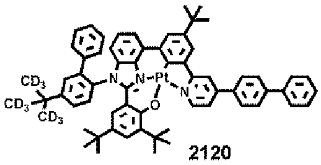
2120

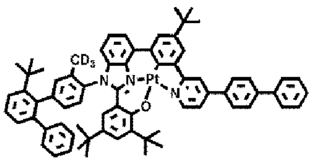
2121

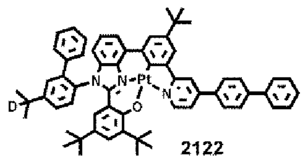
2122

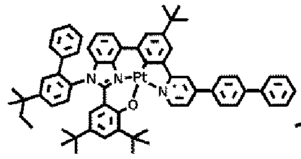
2123

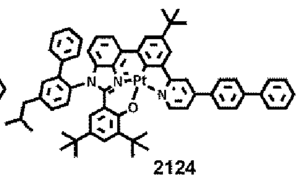
2124

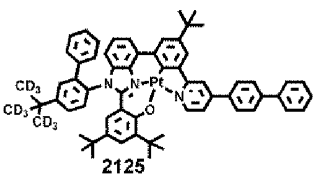
2125

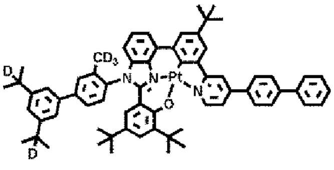
2126

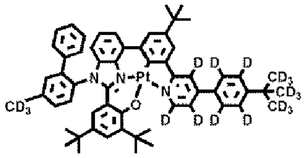
2127

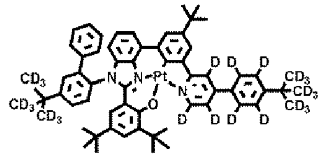
2128

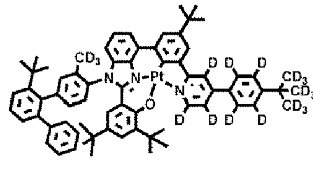
2129

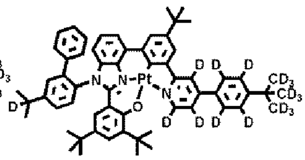
2130

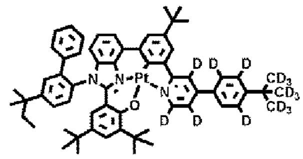
2131

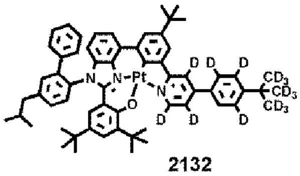
2132

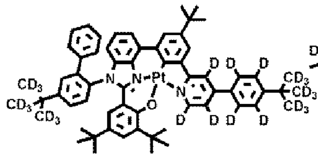
2133

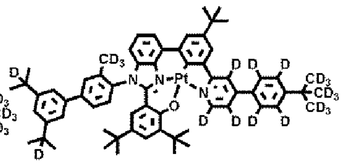
2134

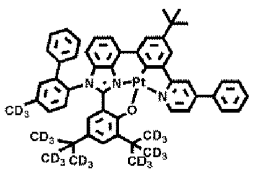
2135

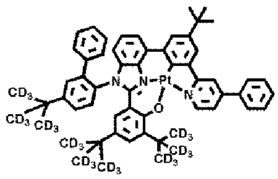
2136

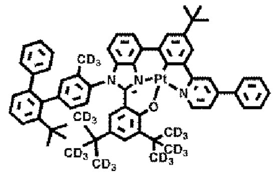
2137

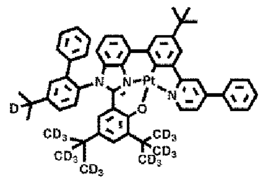
2138

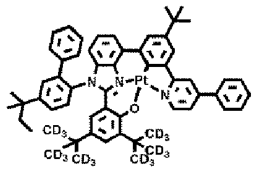
2139

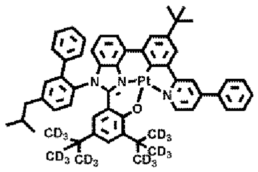
2140

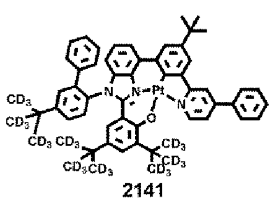
2141

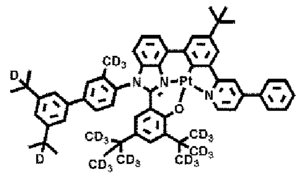
2142

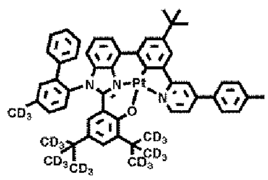
2143

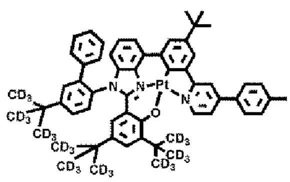
2144

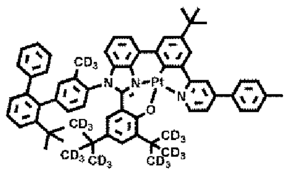
2145

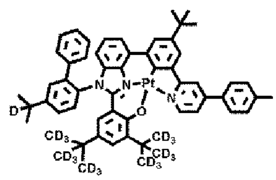
2146

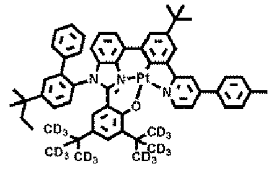
2147

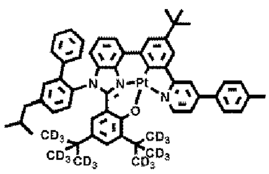
2148

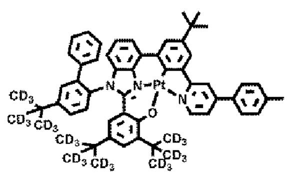
2149

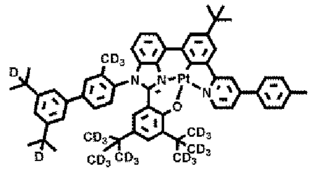
2150

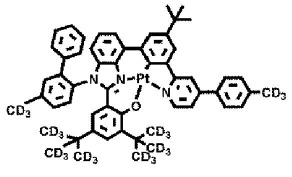
2151

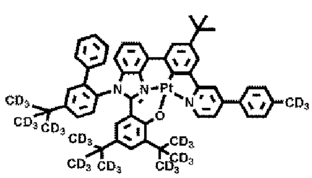
2152

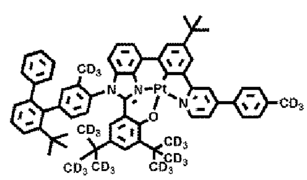
2153

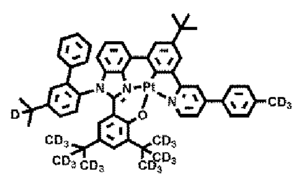
2154

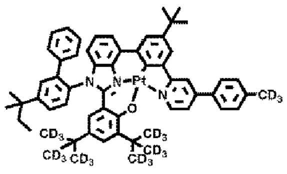
2155

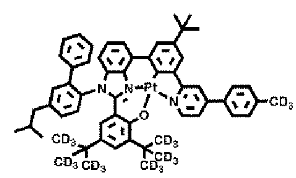
2156

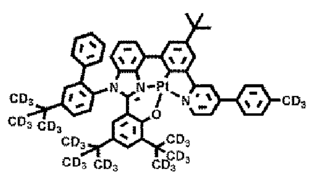
2157

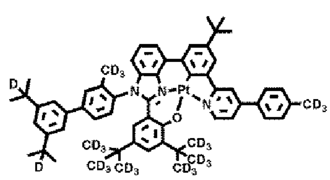
2158

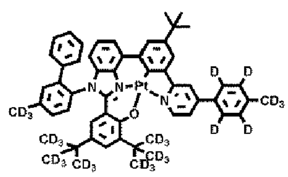
2159

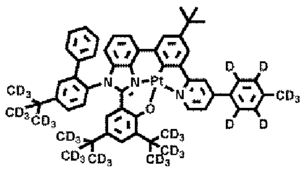
2160

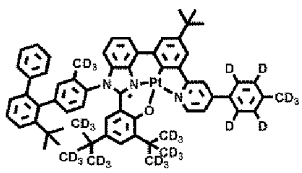
2161

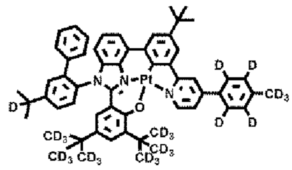
2162

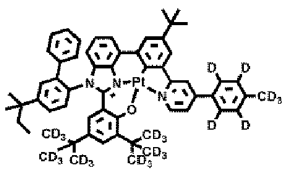
2163

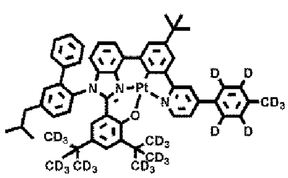
2164

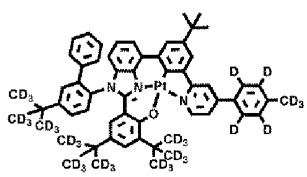
2165

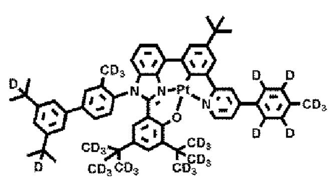
2166

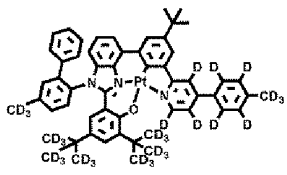
2167

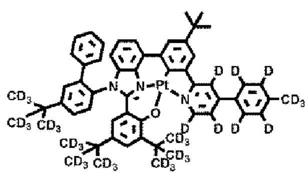
2168

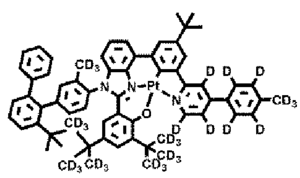
2169

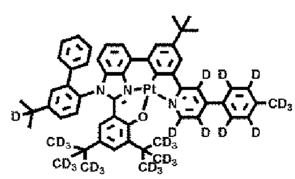
2170

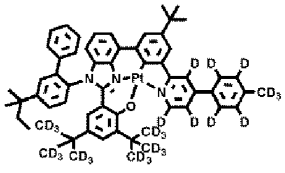
2171
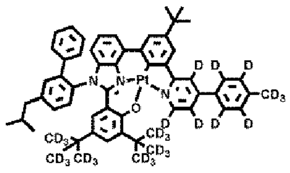
2172
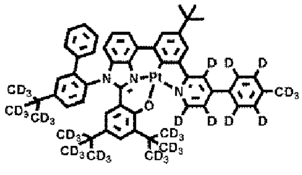
2173
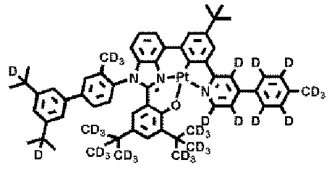
2174

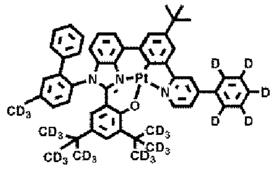
2175
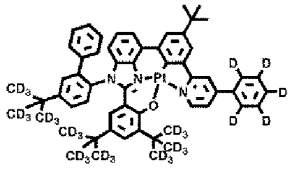
2176
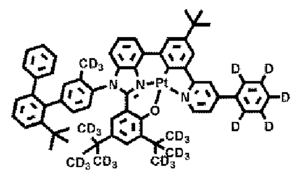
2177
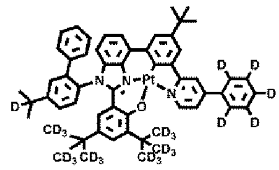
2178

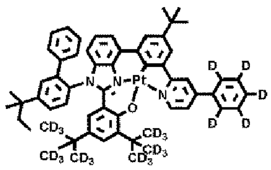
2179
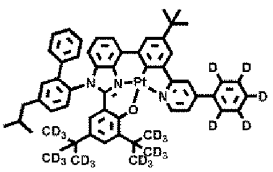
2180
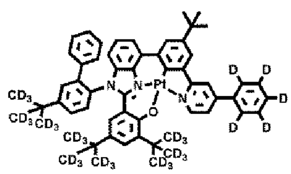
2181
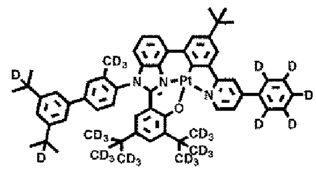
2182

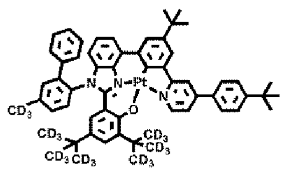
2183
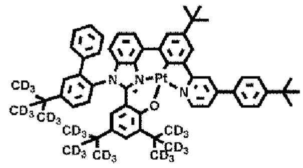
2184
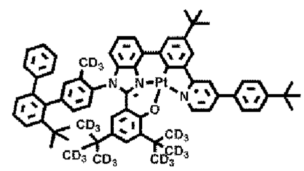
2185
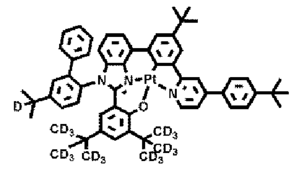
2186

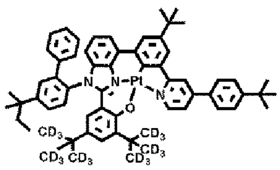
2187
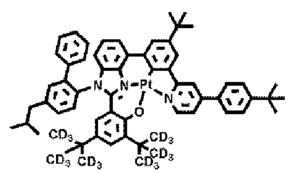
2188
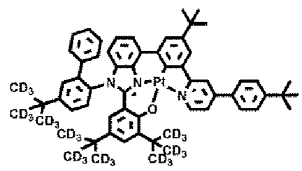
2189
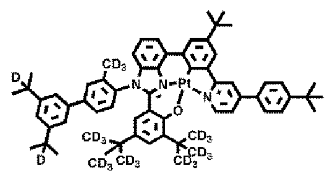
2190

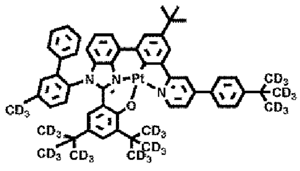
2191
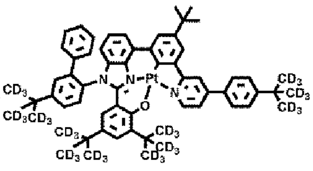
2192
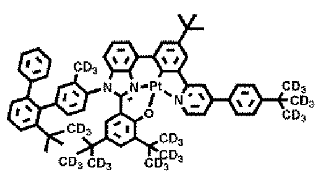
2193
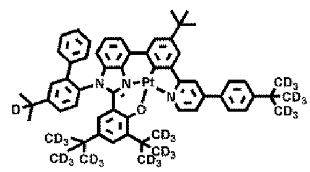
2194

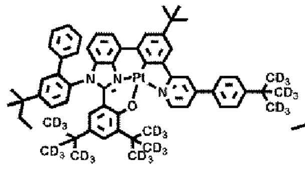

2195

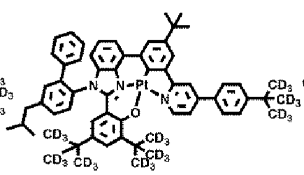

2196

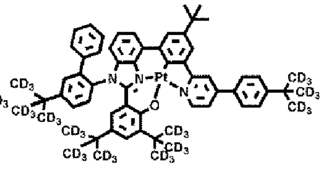

2197

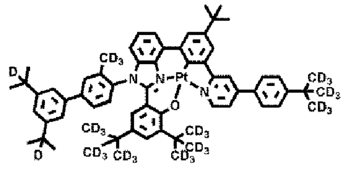

2198

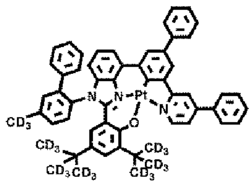

2199

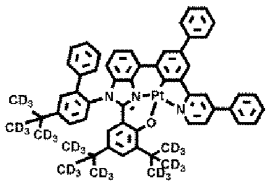

2200

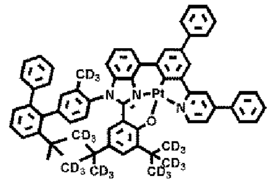

2201

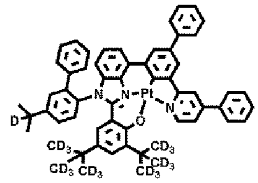

2202

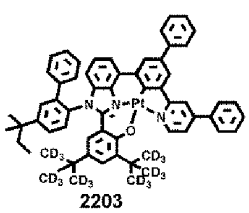

2203

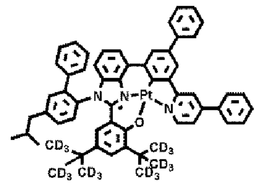

2204

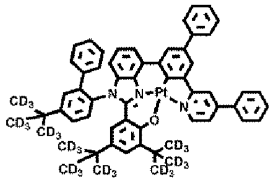

2205

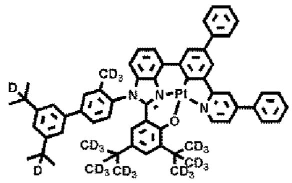

2206

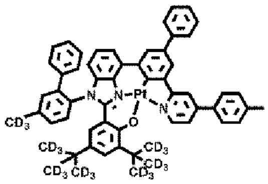

2207

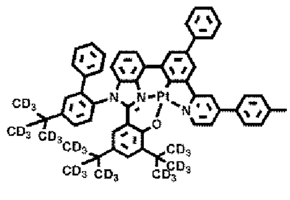

2208

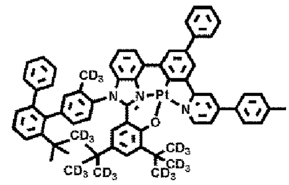

2209

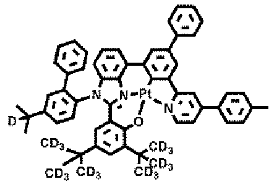

2210

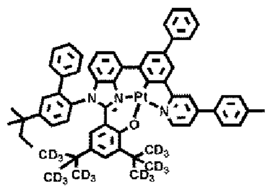

2211

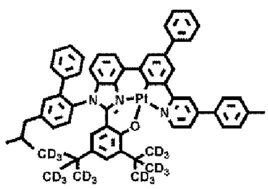

2212

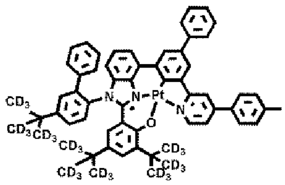

2213

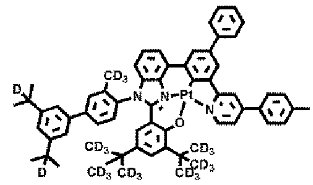

2214

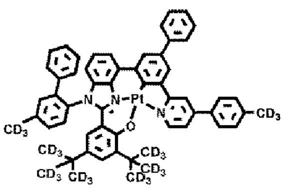

2215

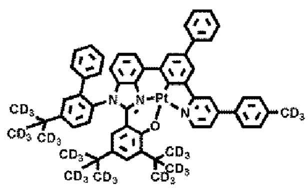

2216

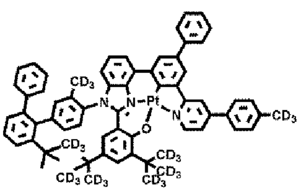

2217

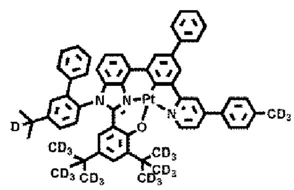

2218

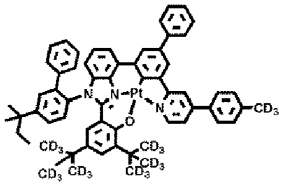

2219

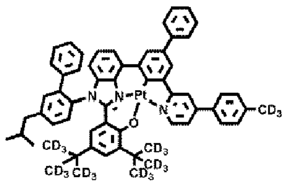

2220

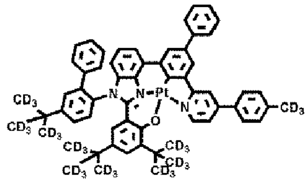

2221

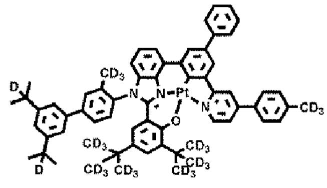

2222

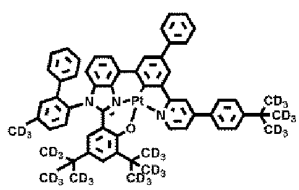

2223

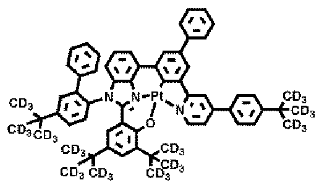

2224

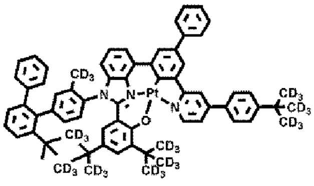

2225

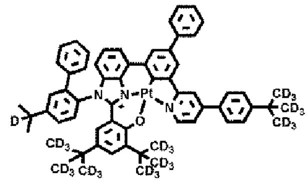

2226

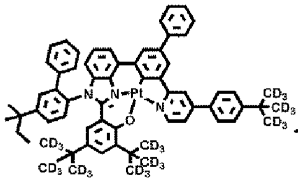

2227

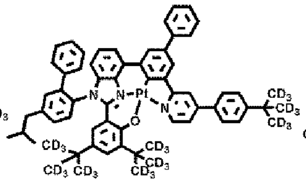

2228

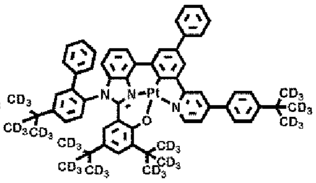

2229

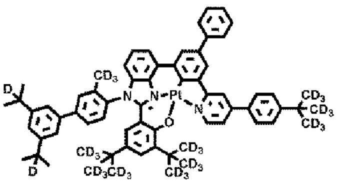

2230

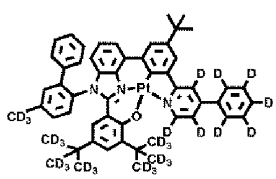

2231

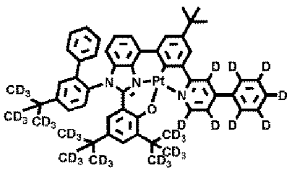

2232

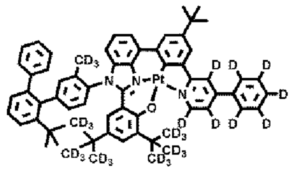

2233

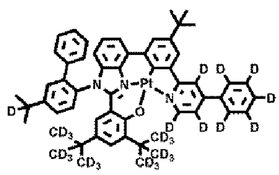

2234

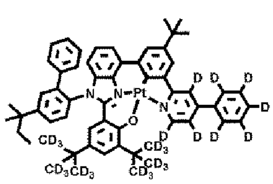

2235

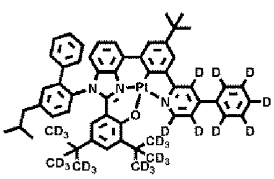

2236

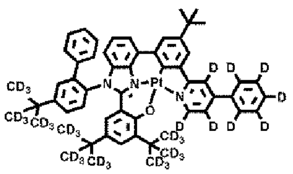

2237

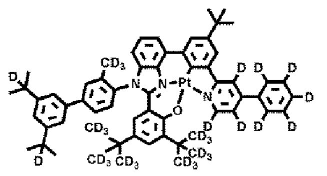

2238

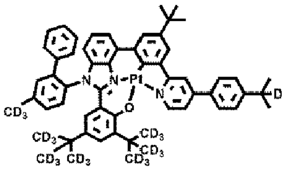

2239

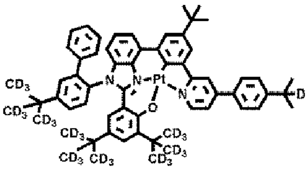

2240

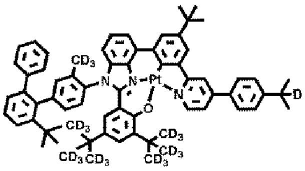

2241

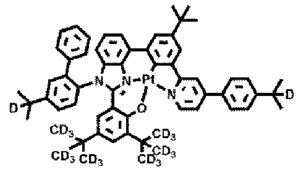

2242

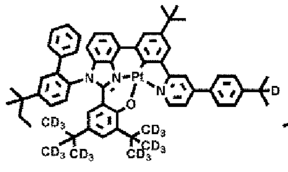
2243

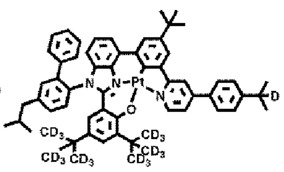
2244

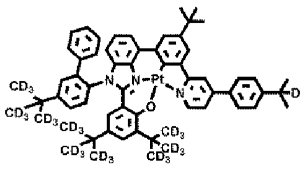
2245

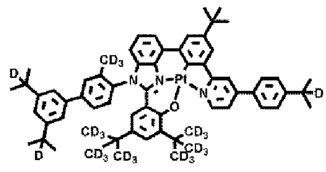
2246

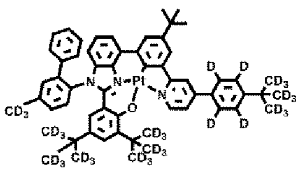
2247

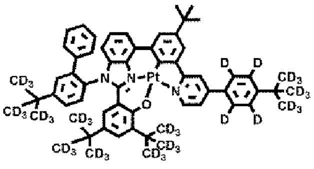
2248

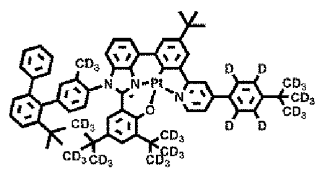
2249

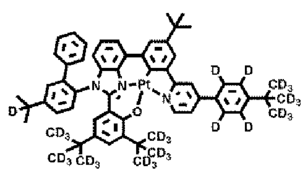
2250

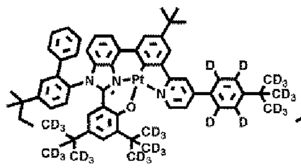
2251

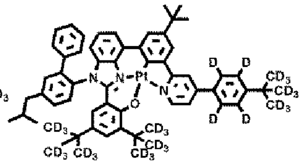
2252

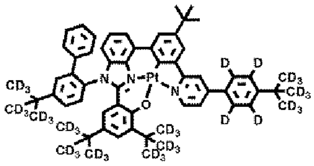
2253

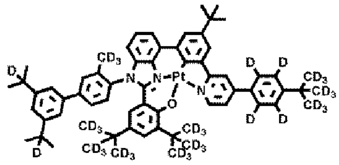
2254

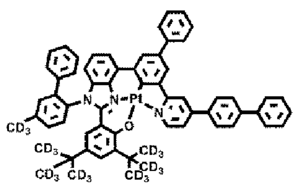
2255

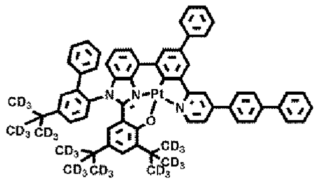
2256

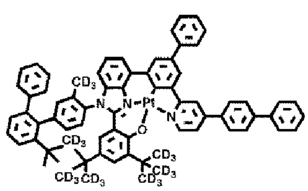
2257

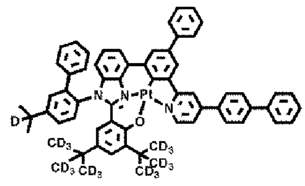
2258

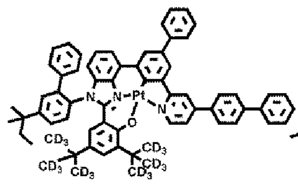
2259

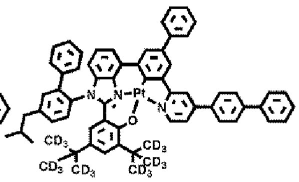
2260

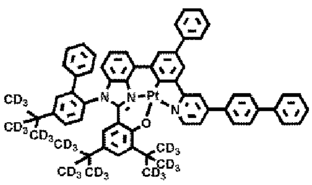
2261

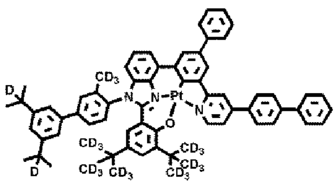
2262

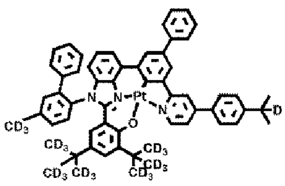
2263

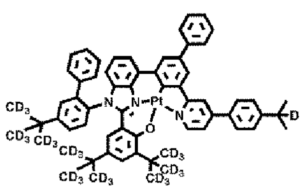
2264

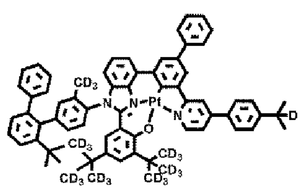
2265

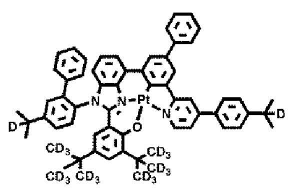
2266

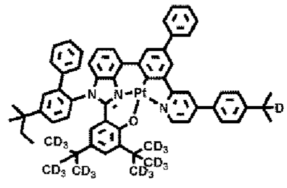

2267

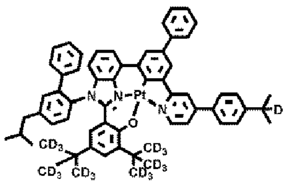

2268

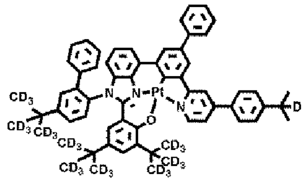

2269

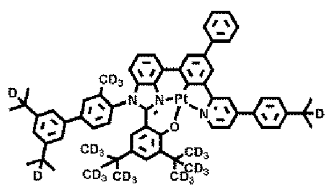

2270

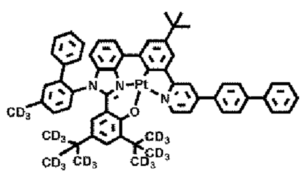

2271

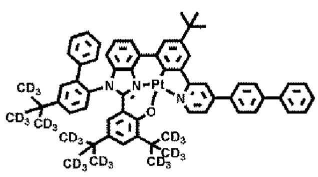

2272

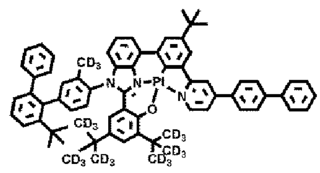

2273

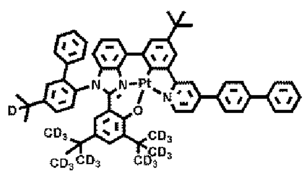

2274

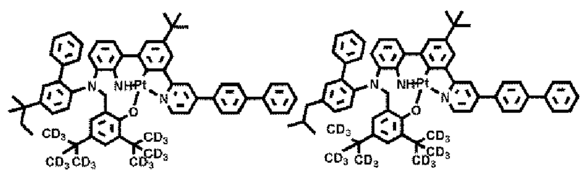

2275

2276

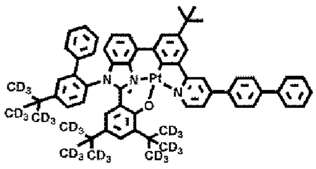

2277

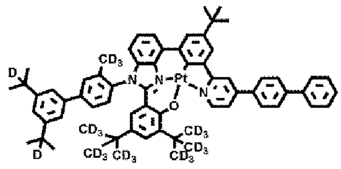

2278

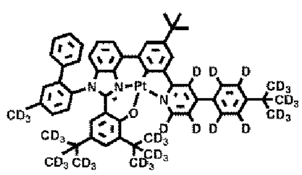

2279

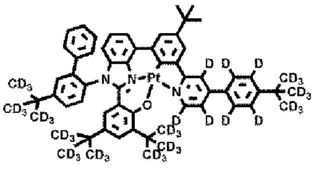

2280

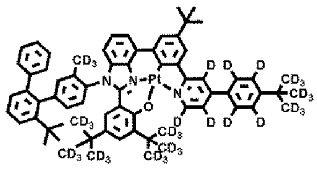

2281

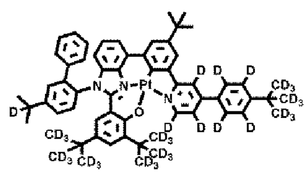

2282

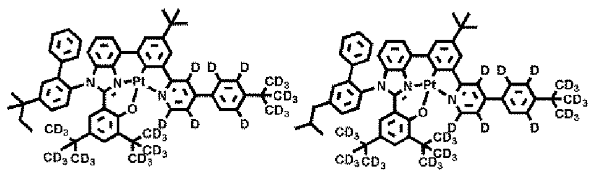

2283

2284

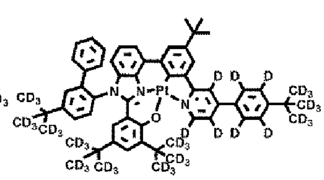

2285

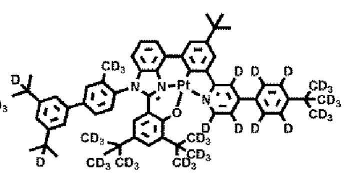

2286

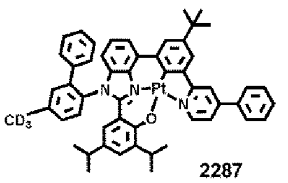
2287

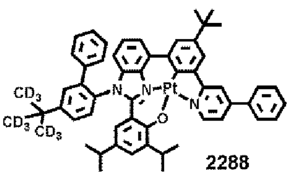
2288

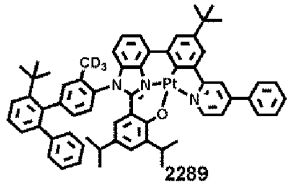
2289

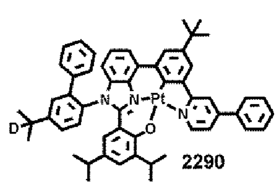
2290

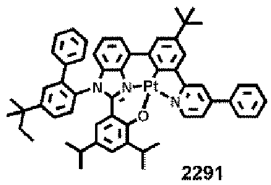
2291

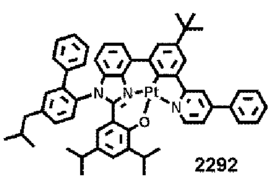
2292

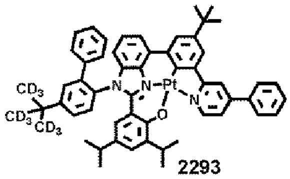
2293

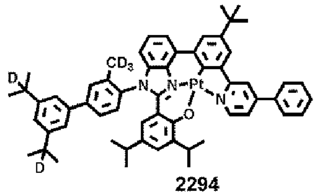
2294

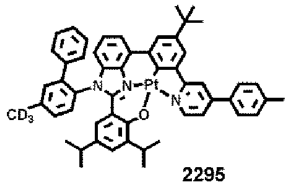
2295

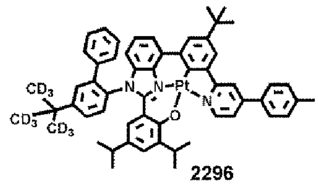
2296

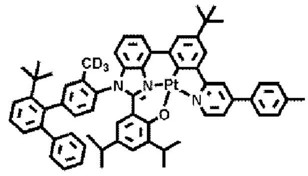
2297

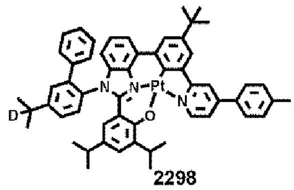
2298

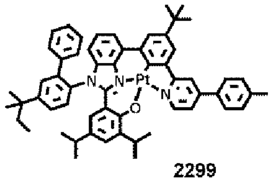
2299

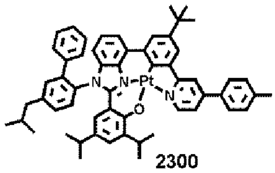
2300

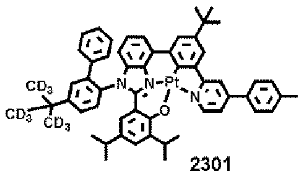
2301

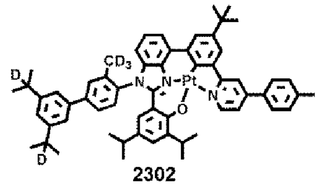
2302

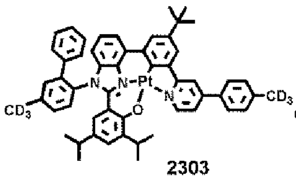
2303

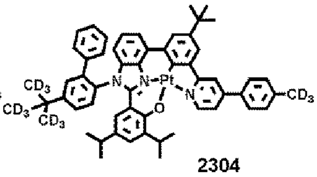
2304

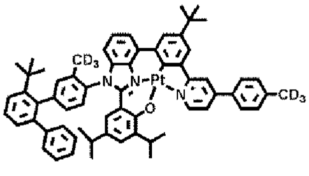
2305

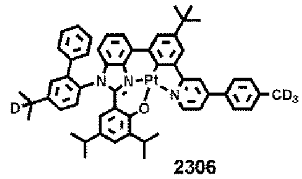
2306

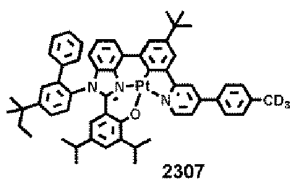
2307

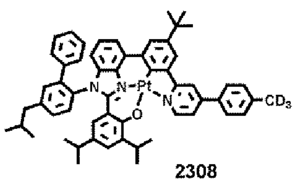
2308

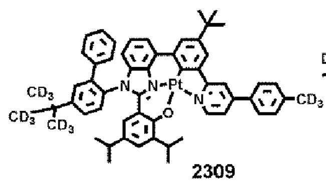
2309

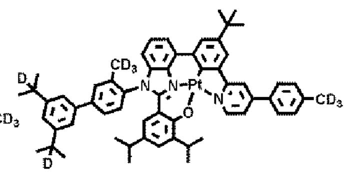
2310

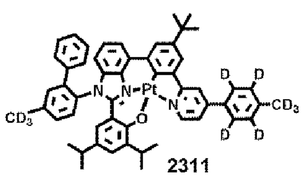
2311

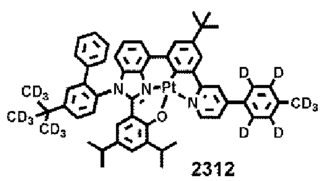
2312

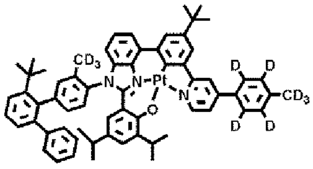
2313

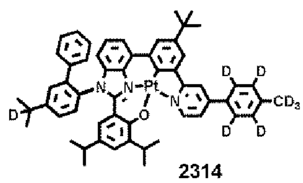
2314

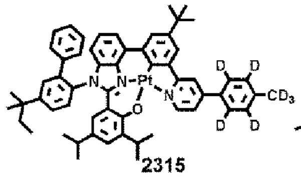
2315

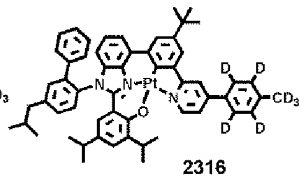
2316

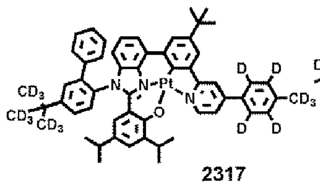
2317

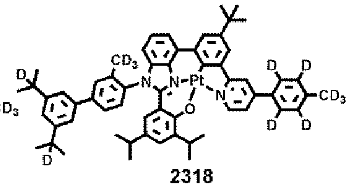
2318

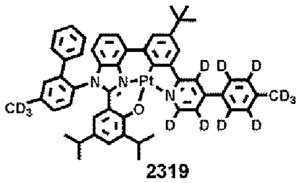
2319

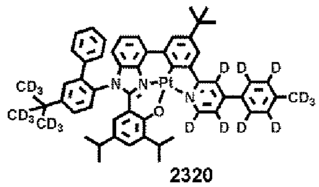
2320

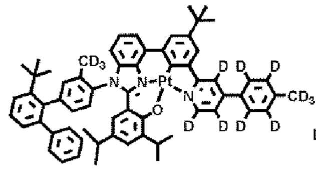
2321

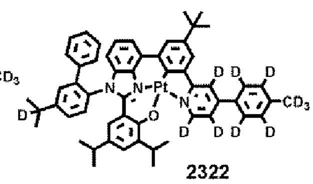
2322

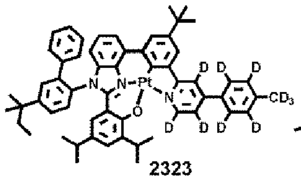
2323

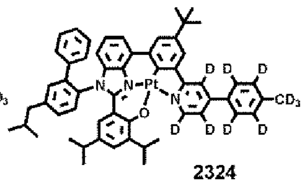
2324

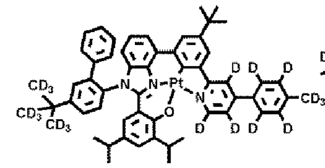
2325

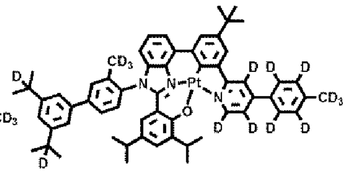
2326

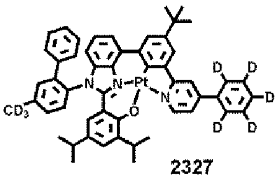
2327

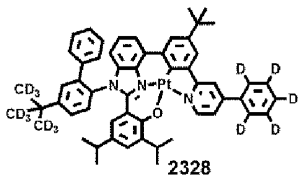
2328

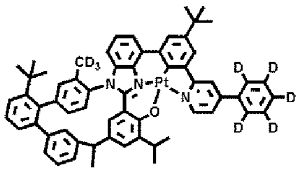
2329

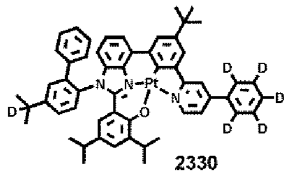
2330

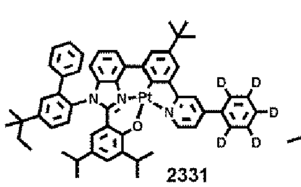
2331

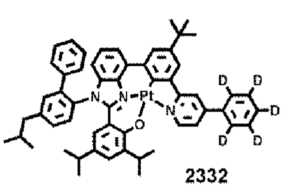
2332

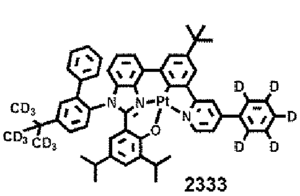
2333

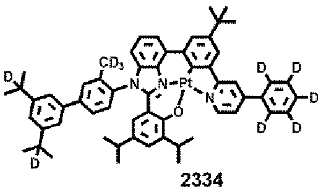
2334

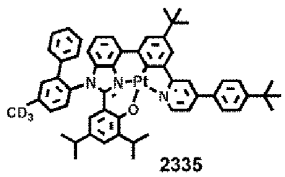
2335

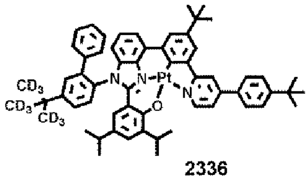
2336

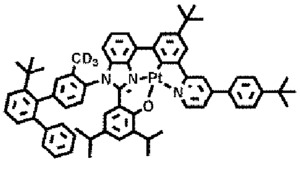
2337

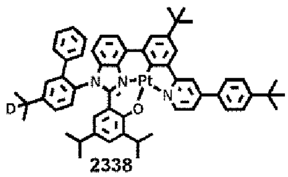
2338

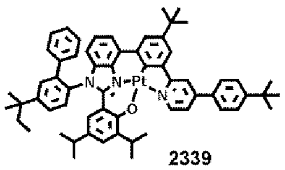
2339

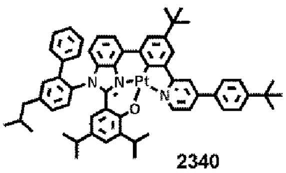
2340

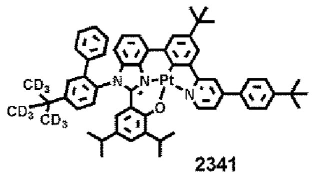
2341

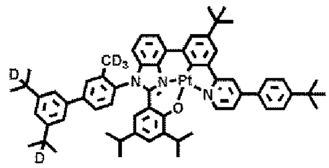
2342

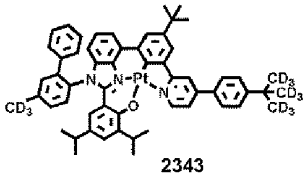
2343

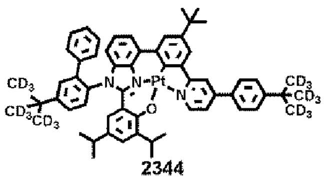
2344

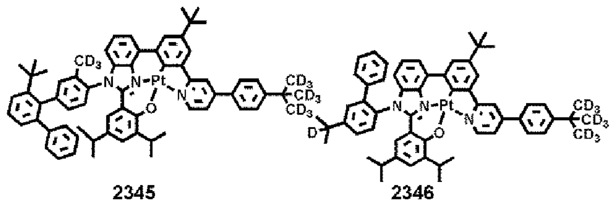
2345

2346

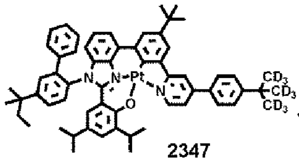
2347

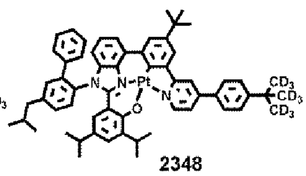
2348

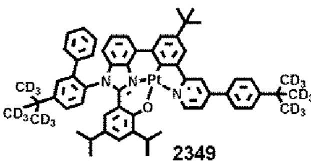
2349

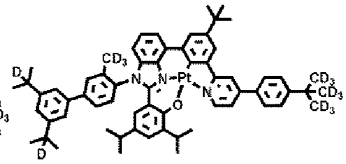
2350

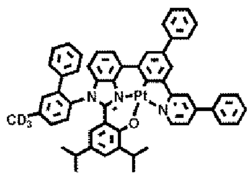
2351

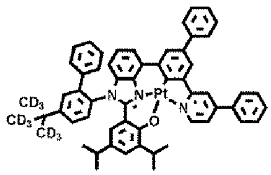
2352

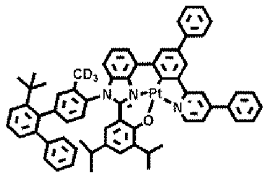
2353

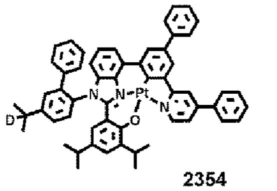
2354

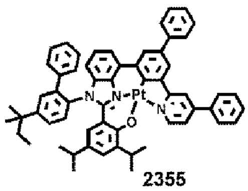
2355

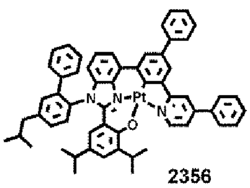
2356

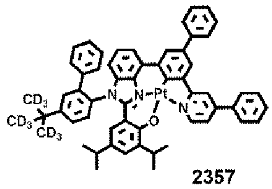
2357

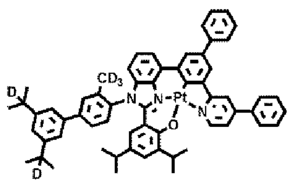
2358

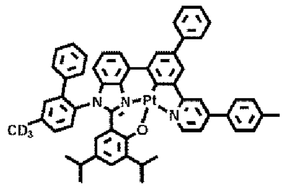

2359

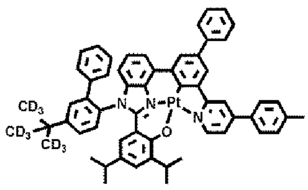

2360

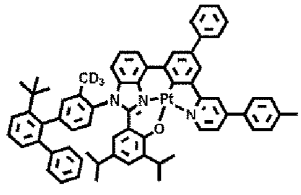

2361

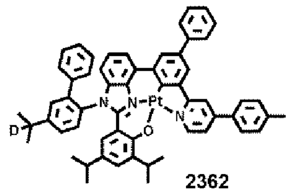

2362

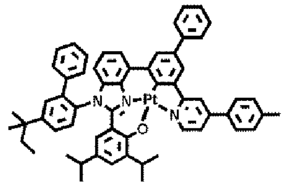

2363

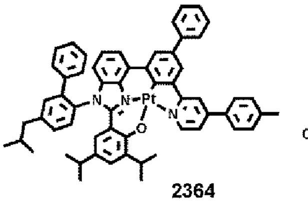

2364

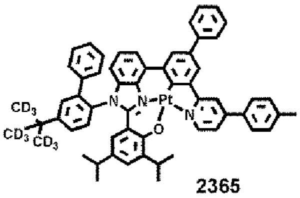

2365

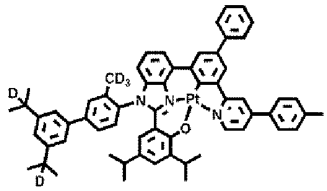

2366

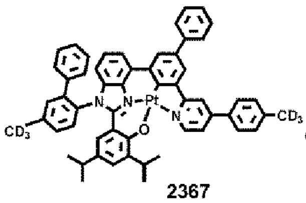

2367

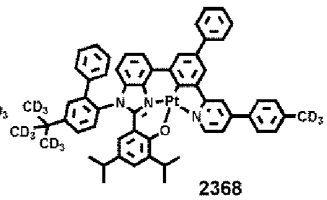

2368

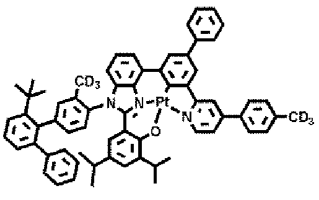

2369

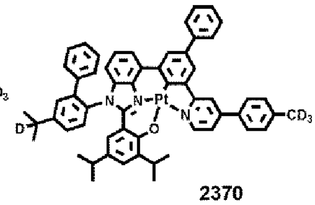

2370

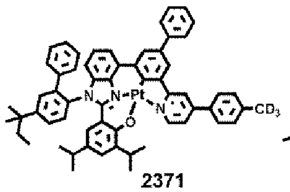

2371

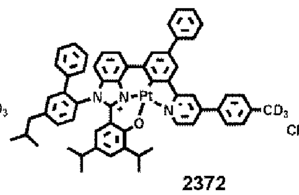

2372

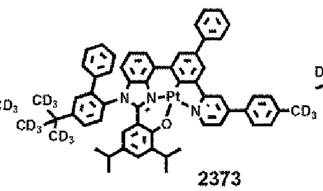

2373

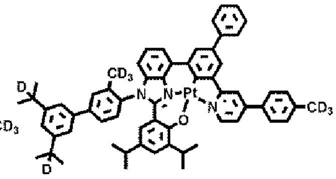

2374

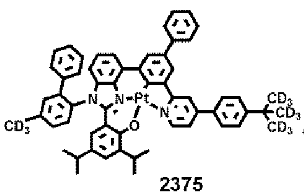

2375

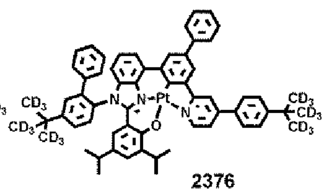

2376

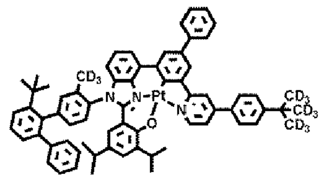

2377

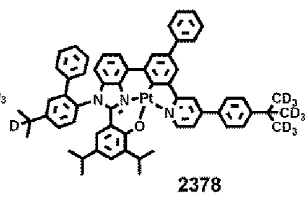

2378

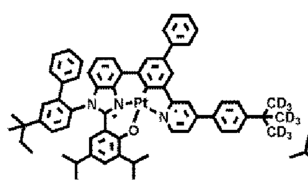

2379

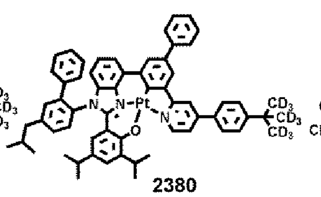

2380

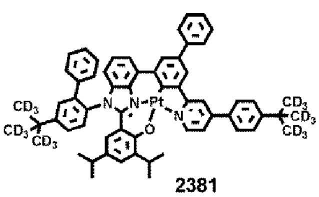

2381

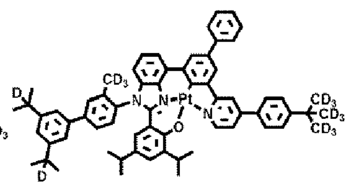

2382

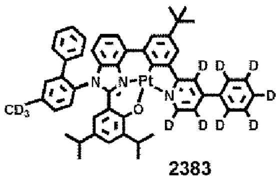
2383
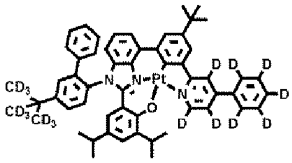
2384
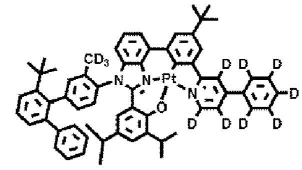
2385
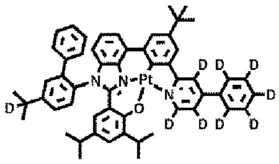
2386
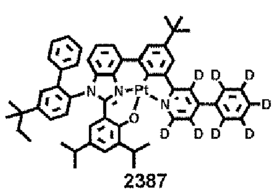
2387
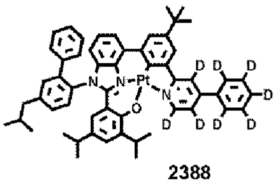
2388
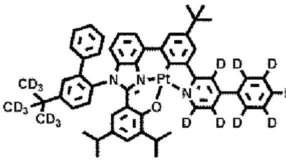
2389
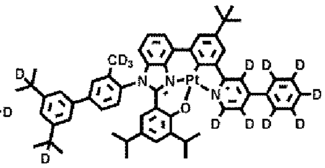
2390
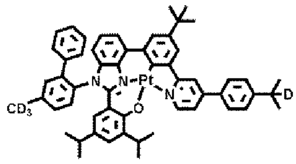
2391
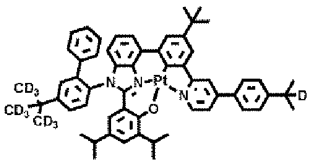
2392
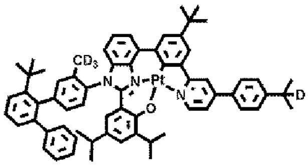
2393
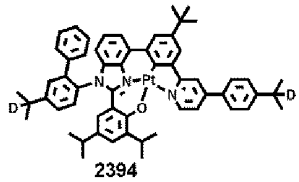
2394
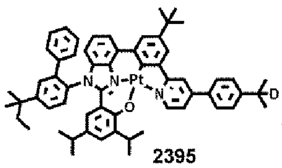
2395
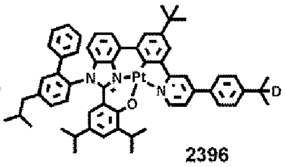
2396
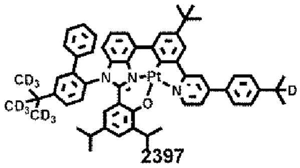
2397
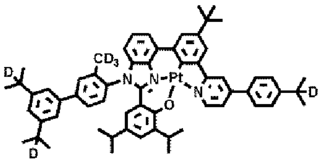
2398
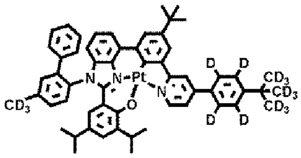
2399
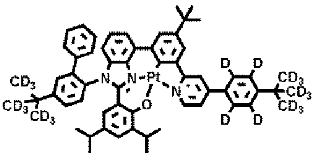
2400
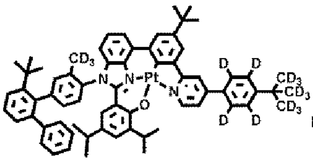
2401
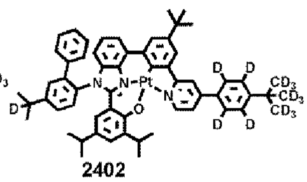
2402
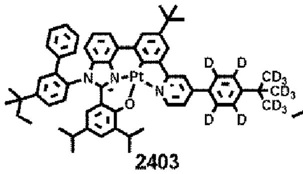
2403
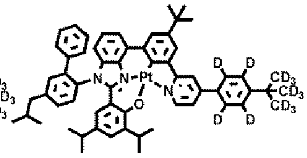
2404
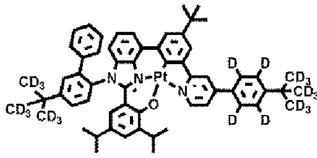
2405
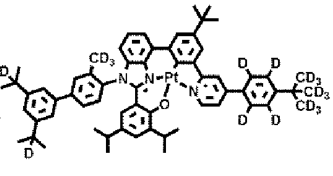
2406

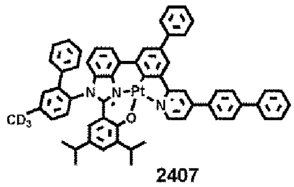
2407

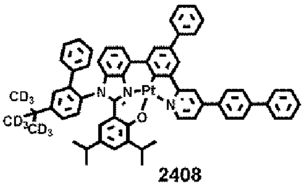
2408

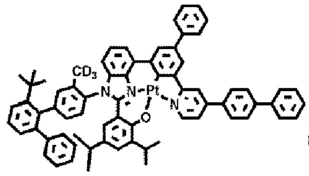
2409

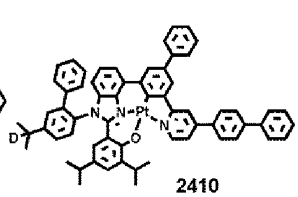
2410

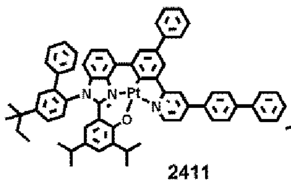
2411

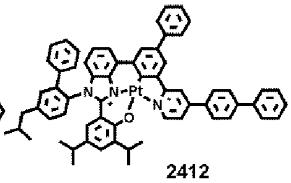
2412

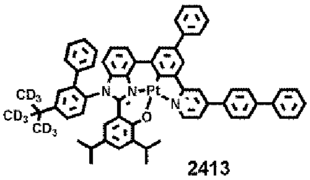
2413

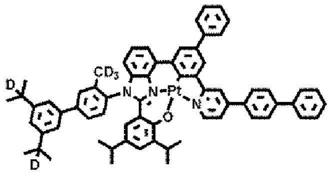
2414

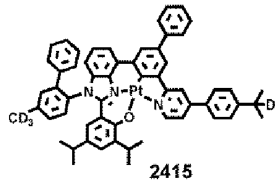
2415

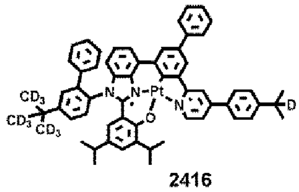
2416

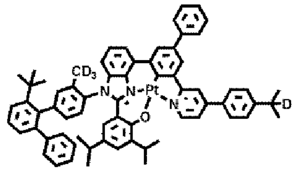
2417

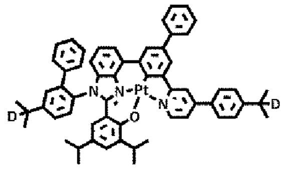
2418

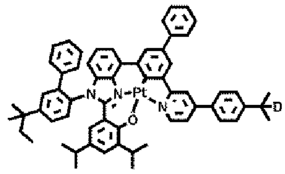
2419

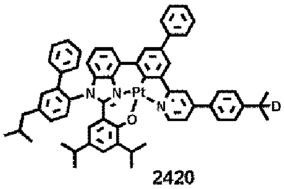
2420

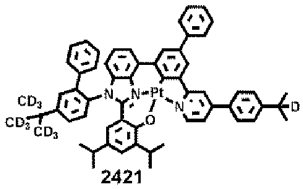
2421

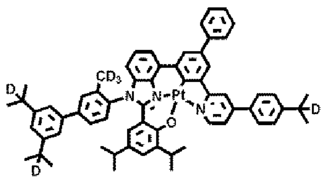
2422

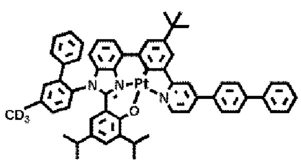
2423

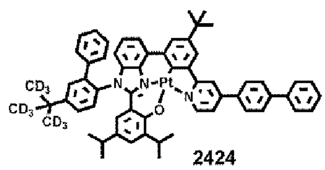
2424

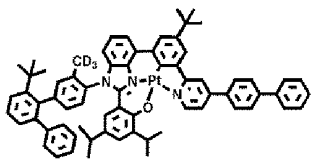
2425

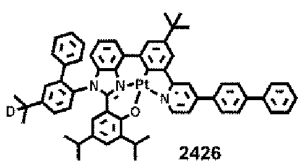
2426

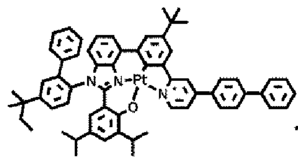
2427

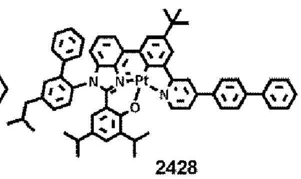
2428

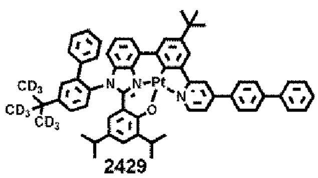
2429

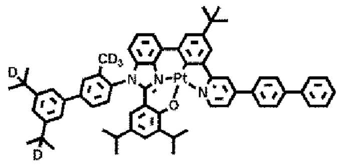
2430

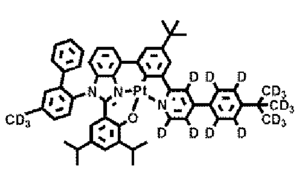
2431

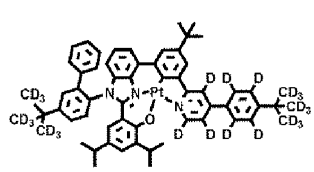
2432

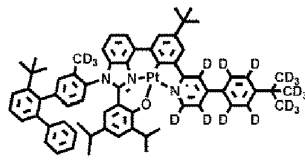
2433

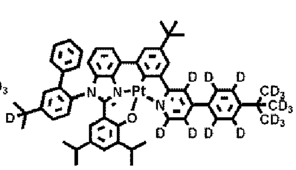
2434

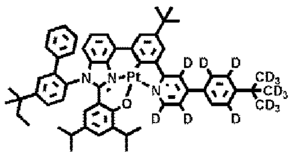
2435

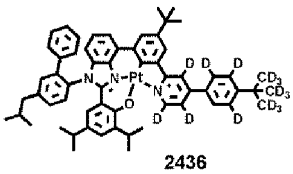
2436

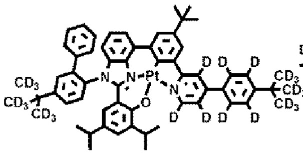
2437

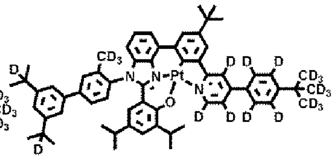
2438

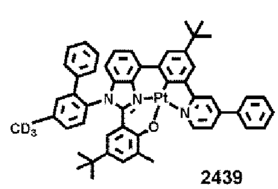
2439

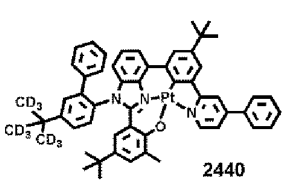
2440

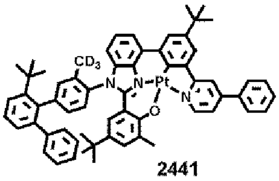
2441

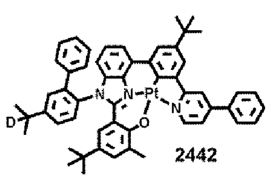
2442

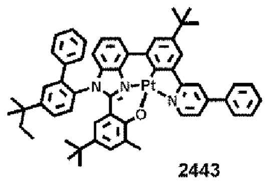
2443

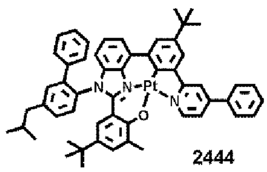
2444

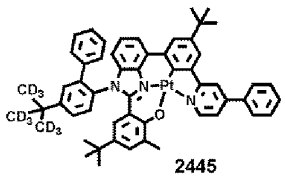
2445

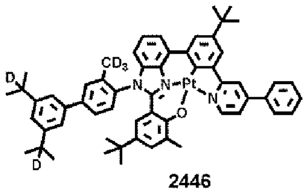
2446

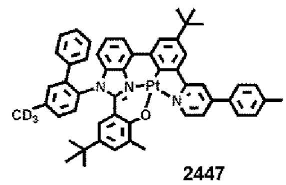
2447

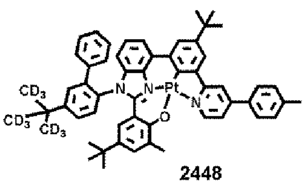
2448

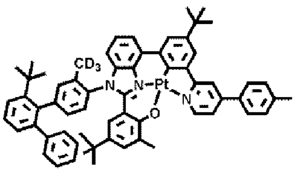
2449

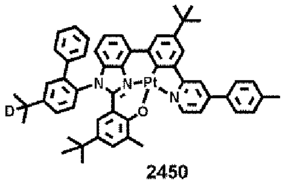
2450

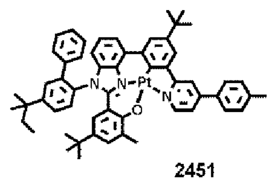
2451

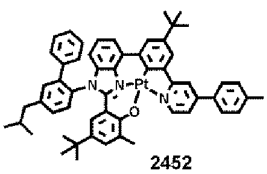
2452

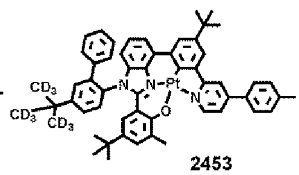
2453

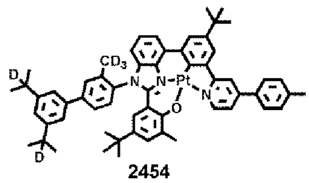
2454

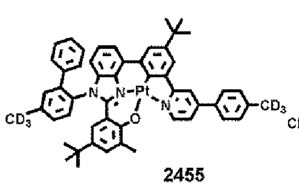
2455

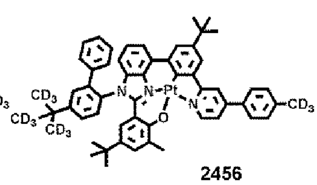
2456

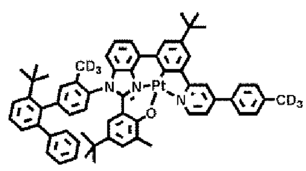
2457

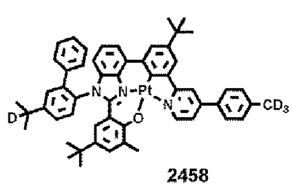
2458

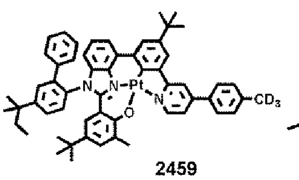
2459

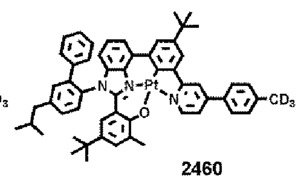
2460

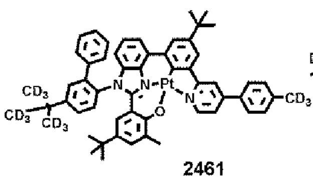
2461

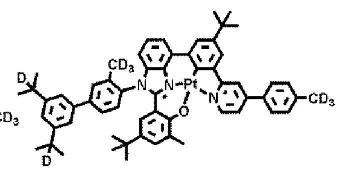
2462

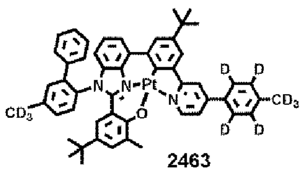
2463

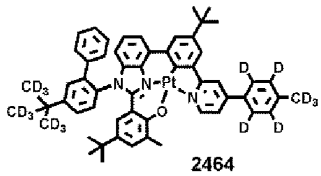
2464

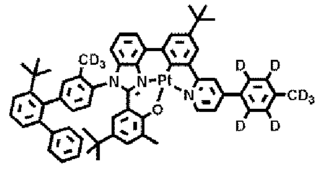
2465

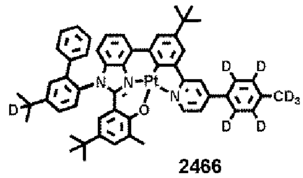
2466

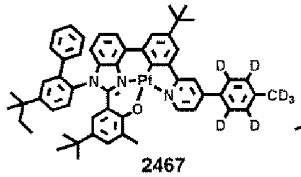
2467

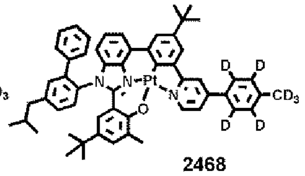
2468

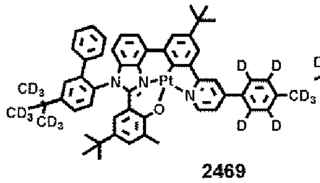
2469

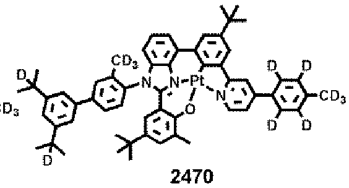
2470

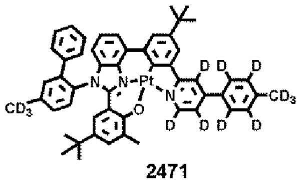
2471

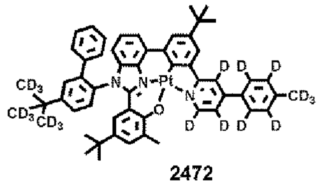
2472

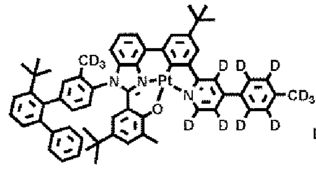
2473

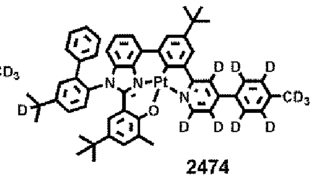
2474

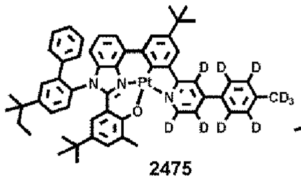
2475

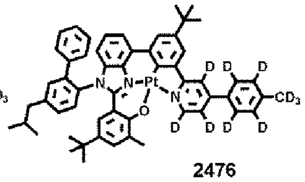
2476

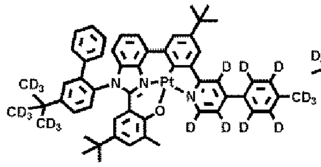
2477

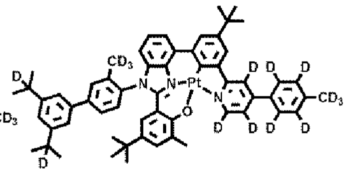
2478

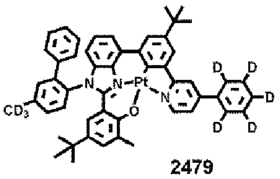
2479

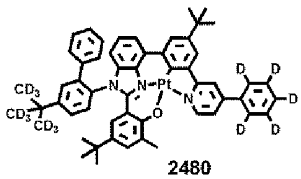
2480

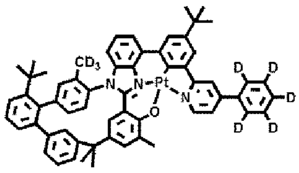
2481

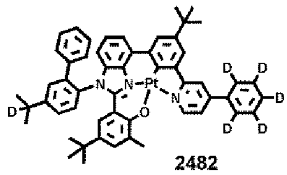
2482

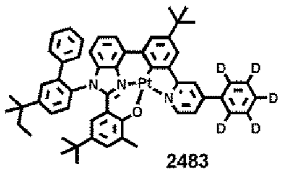
2483

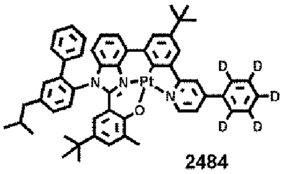
2484

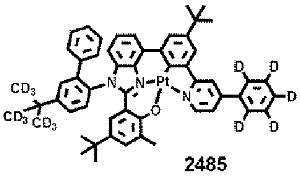
2485

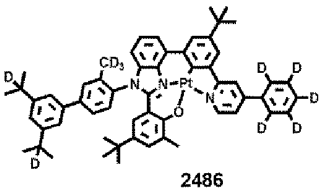
2486

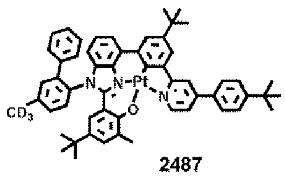
2487

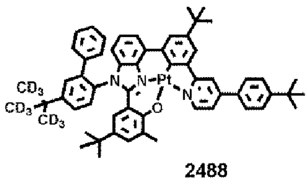
2488

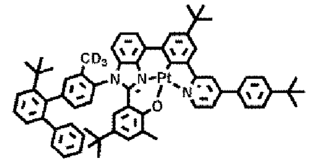
2489

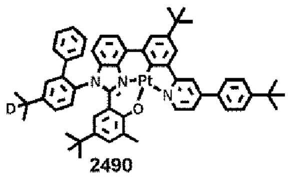
2490

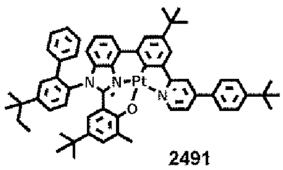
2491

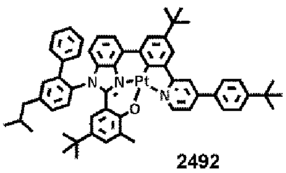
2492

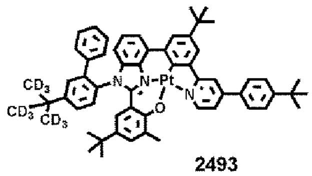
2493

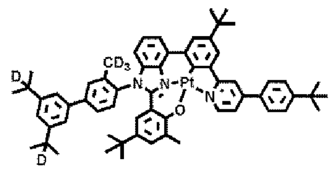
2494

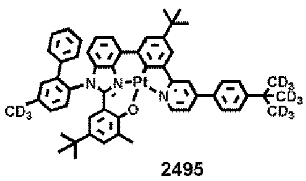
2495

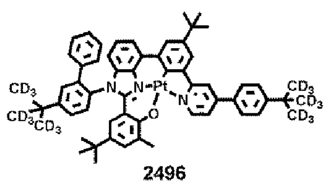
2496

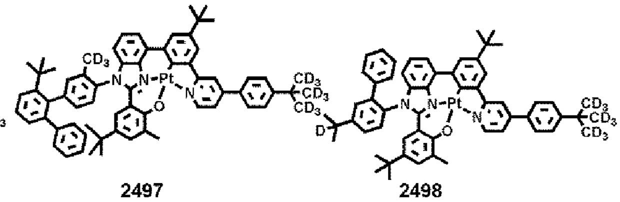
2497

2498

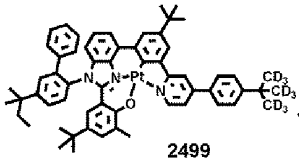
2499

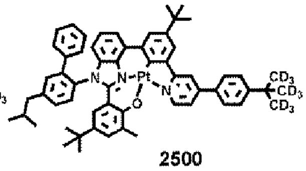
2500

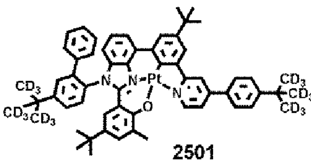
2501

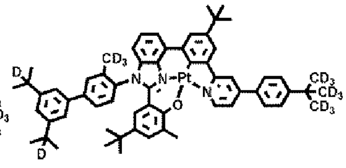
2502

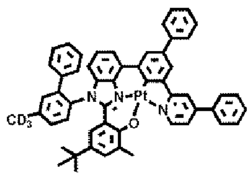
2503

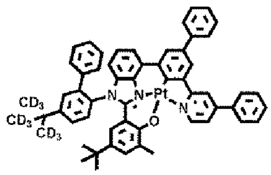
2504

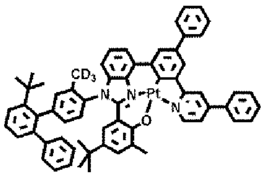
2505

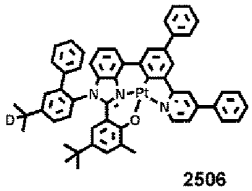
2506

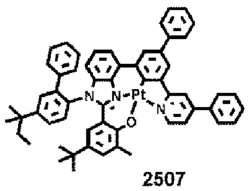
2507

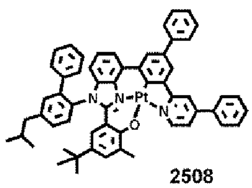
2508

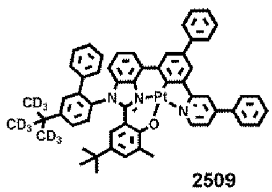
2509

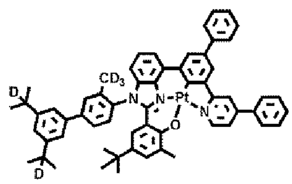
2510

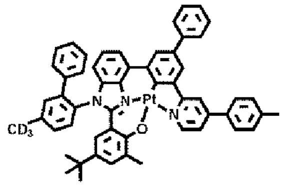

2511

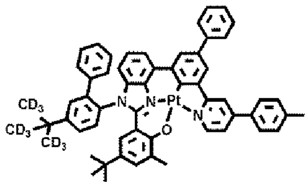

2512

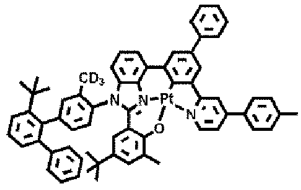

2513

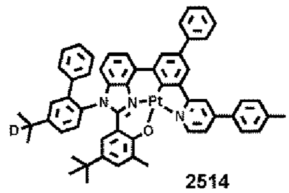

2514

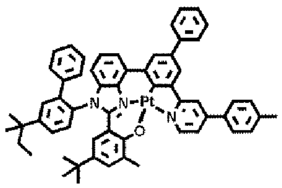

2515

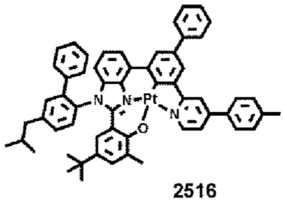

2516

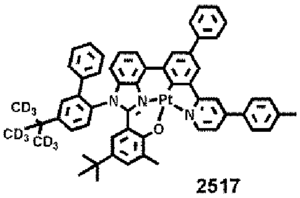

2517

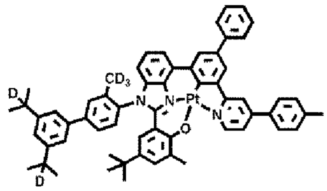

2518

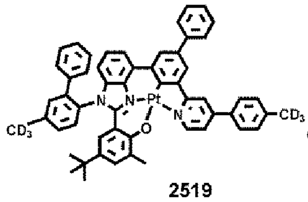

2519

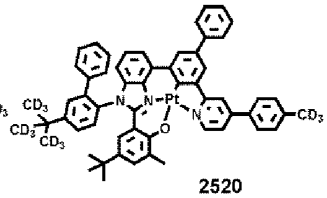

2520

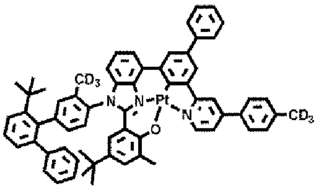

2521

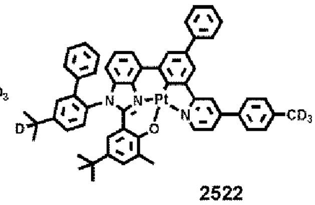

2522

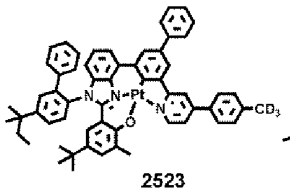

2523

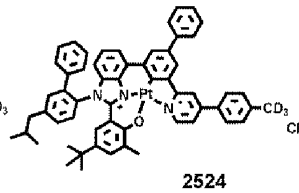

2524

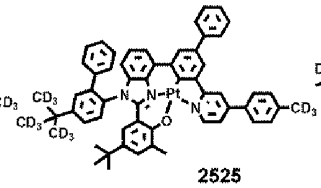

2525

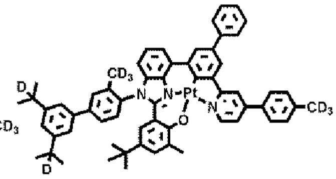

2526

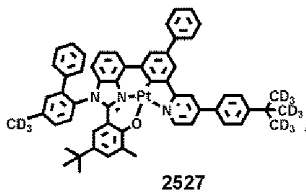

2527

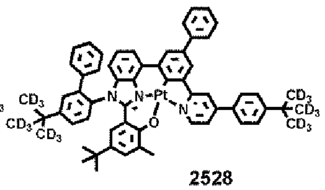

2528

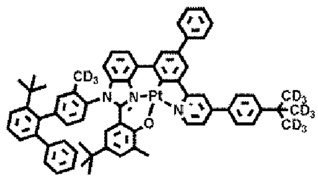

2529

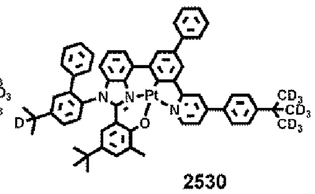

2530

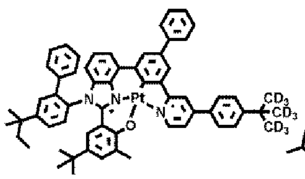

2531

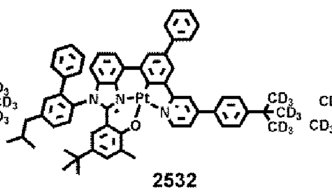

2532

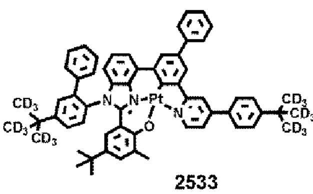

2533

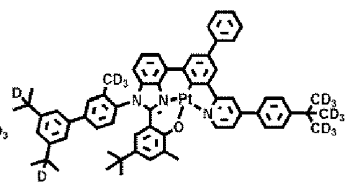

2534

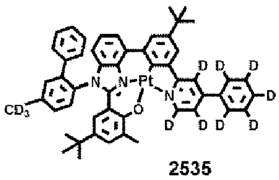
2535
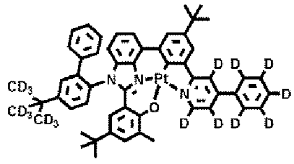
2536
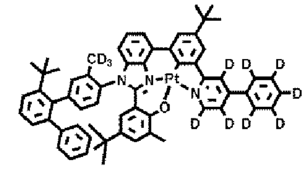
2537
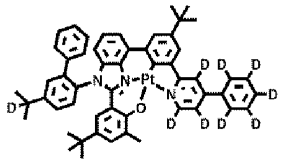
2538

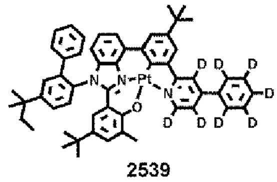
2539
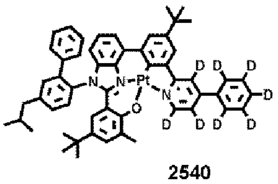
2540
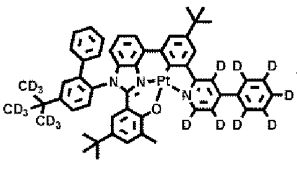
2541
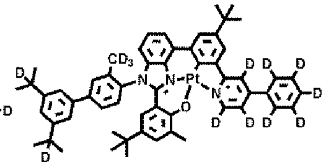
2542

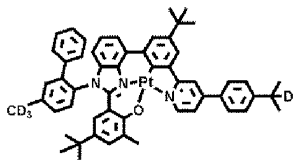
2543
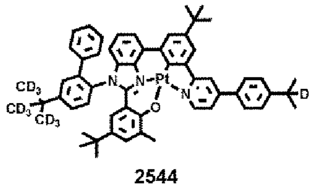
2544
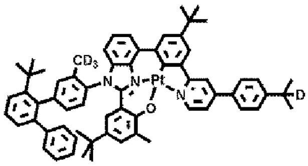
2545
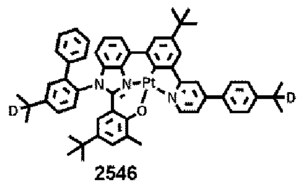
2546

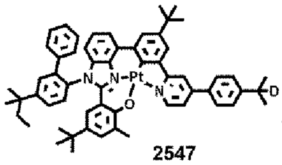
2547
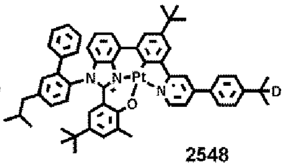
2548
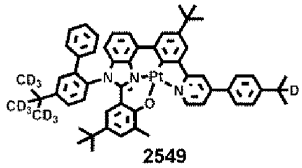
2549
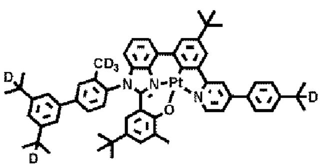
2550

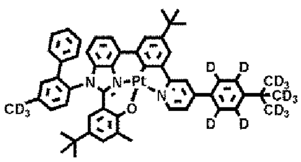
2551
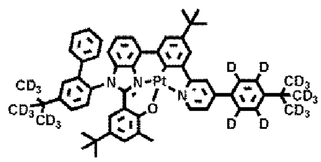
2552
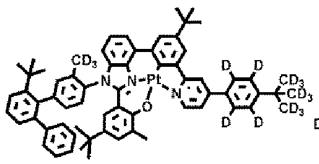
2553
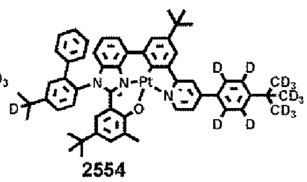
2554

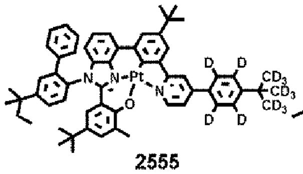
2555
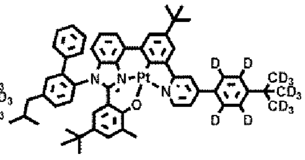
2556
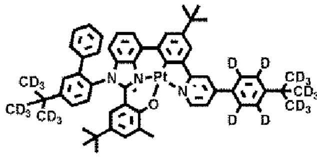
2557
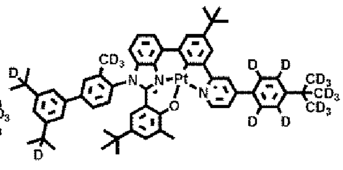
2558

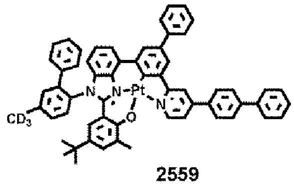
2559
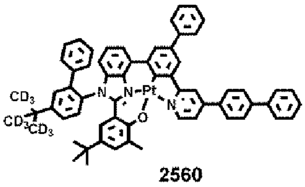
2560
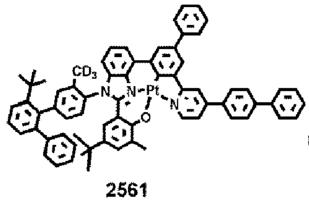
2561
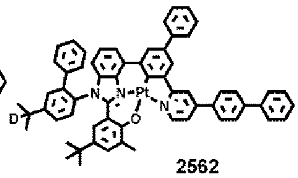
2562

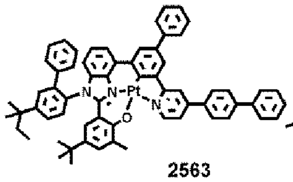
2563
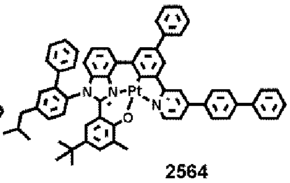
2564
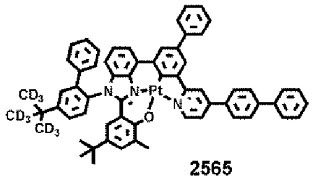
2565
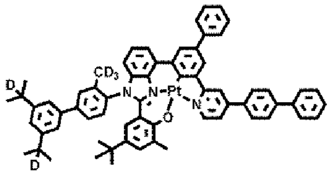
2566

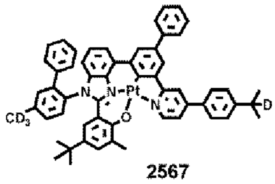
2567
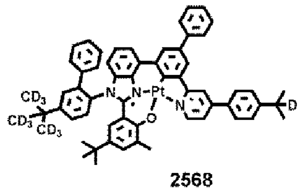
2568
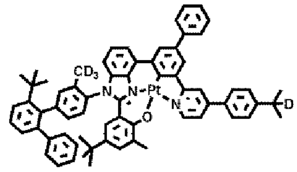
2569
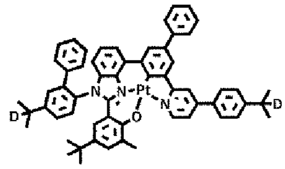
2570

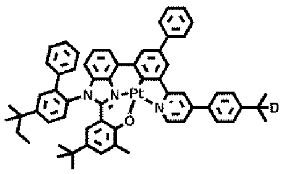
2571
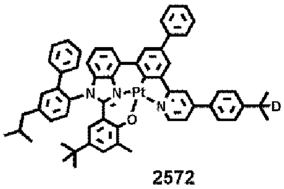
2572
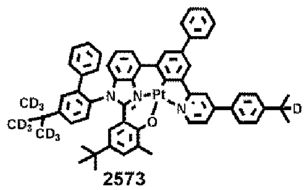
2573
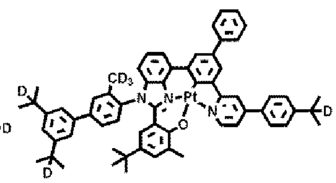
2574

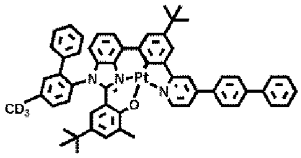
2575
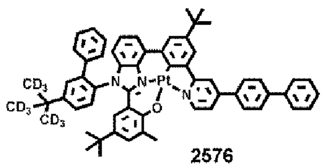
2576
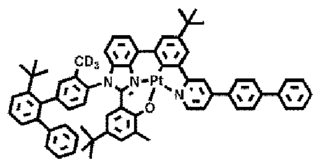
2577
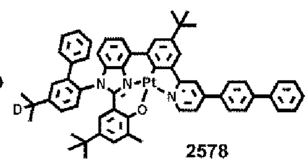
2578

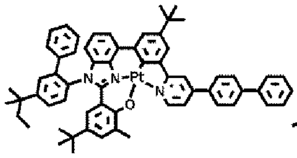
2579
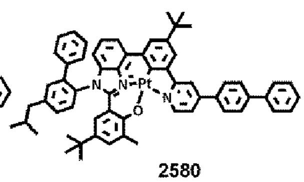
2580
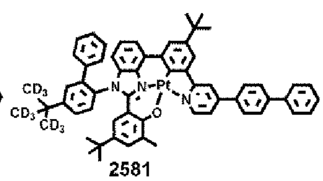
2581
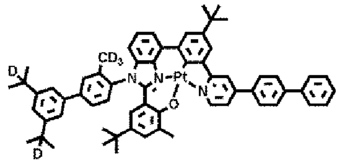
2582

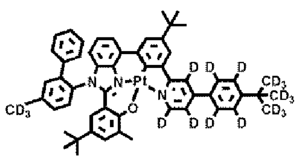
2583
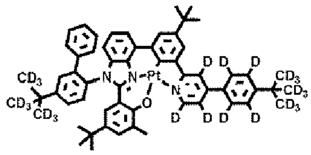
2584
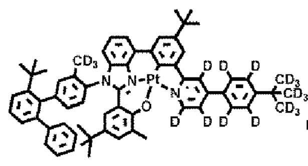
2585
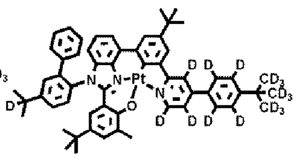
2586

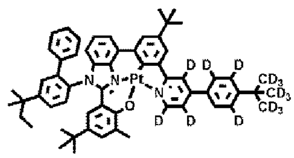
2587
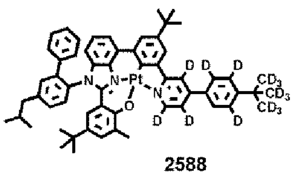
2588
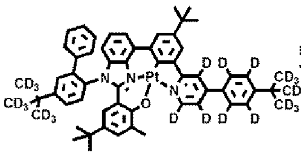
2589
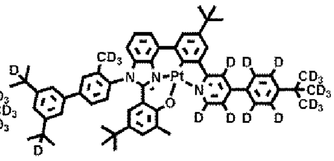
2590

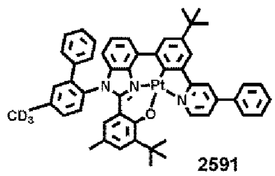
2591
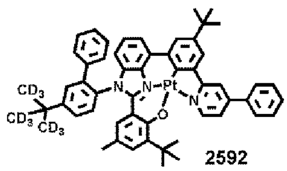
2592
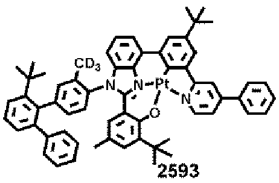
2593
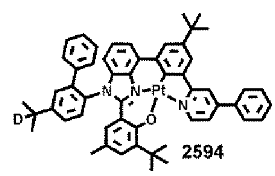
2594

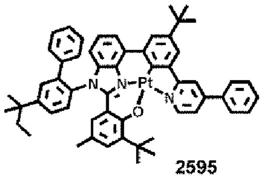
2595
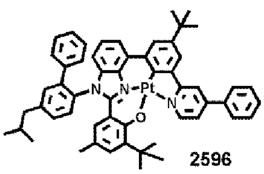
2596
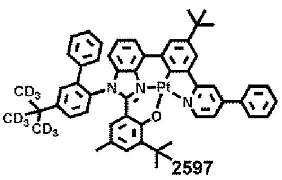
2597
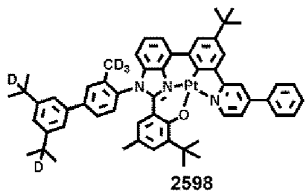
2598

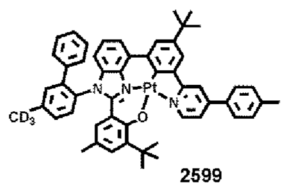
2599
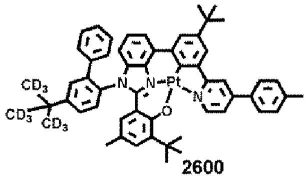
2600
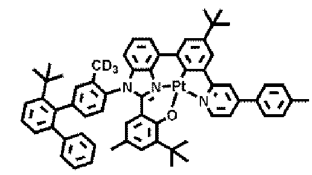
2601
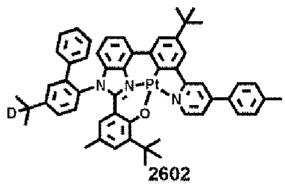
2602

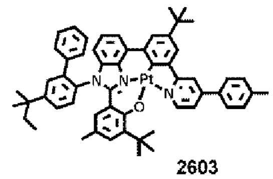
2603
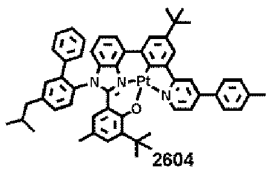
2604
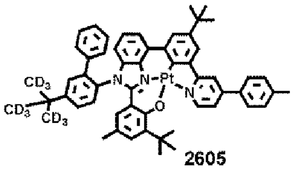
2605
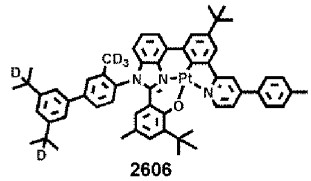
2606

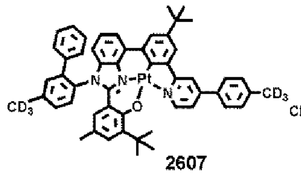
2607
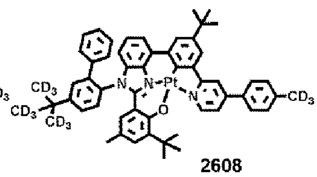
2608
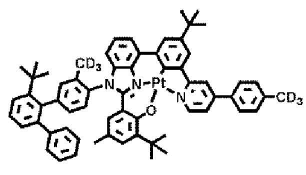
2609
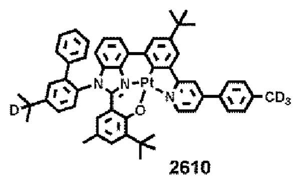
2610

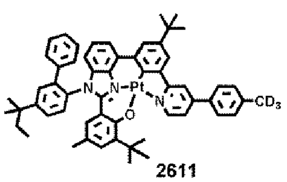
2611
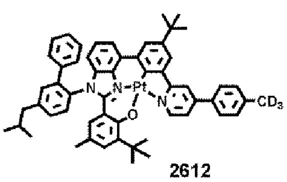
2612
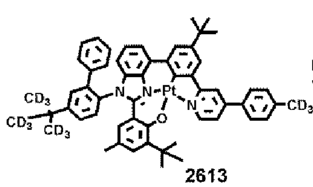
2613
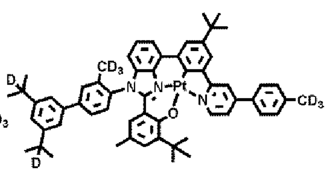
2614

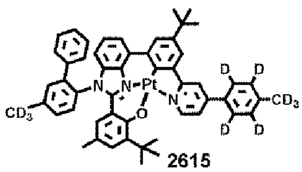
2615

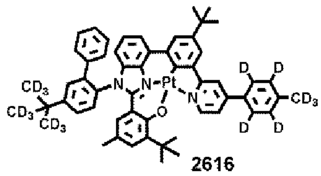
2616

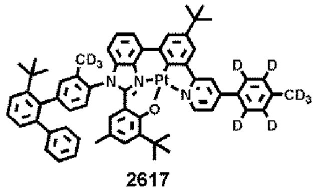
2617

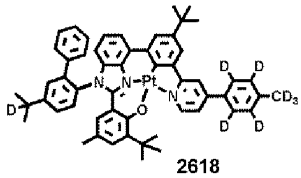
2618

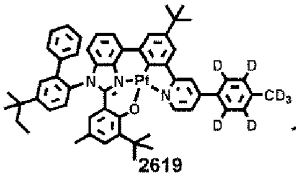
2619

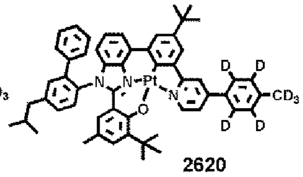
2620

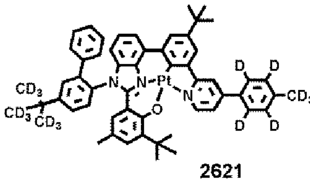
2621

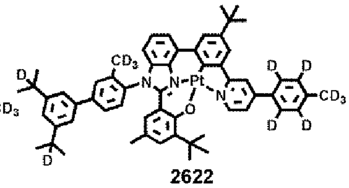
2622

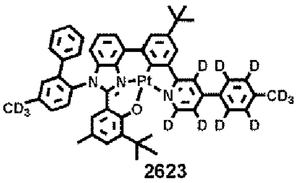
2623

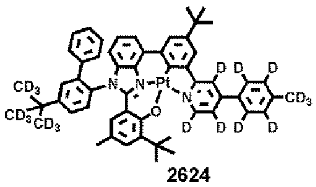
2624

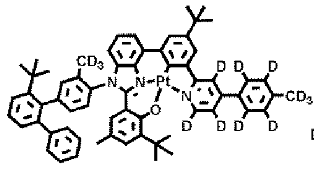
2625

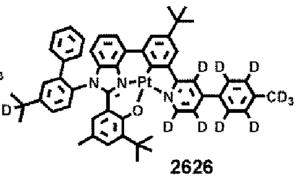
2626

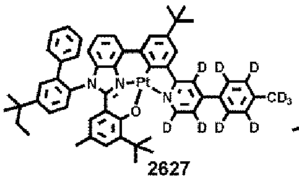
2627

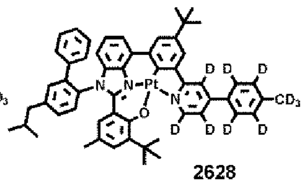
2628

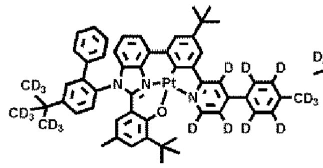
2629

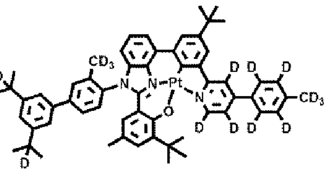
2630

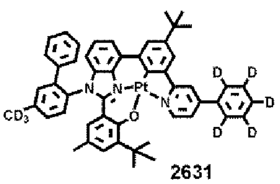
2631

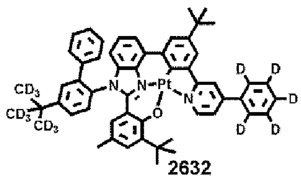
2632

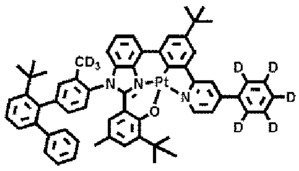
2633

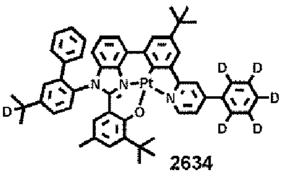
2634

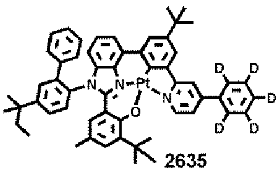
2635

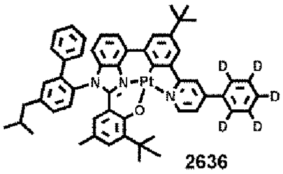
2636

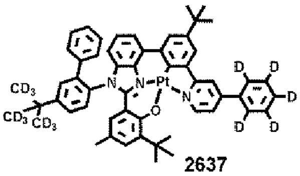
2637

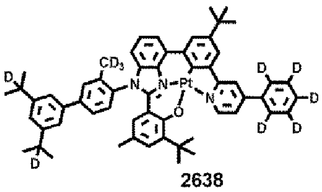
2638

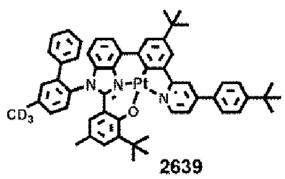
2639

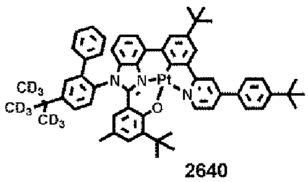
2640

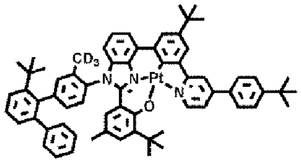
2641

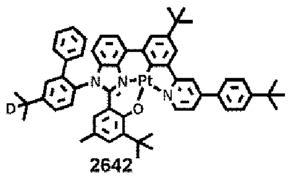
2642

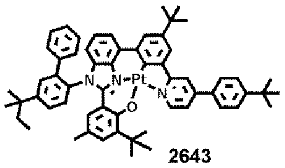
2643

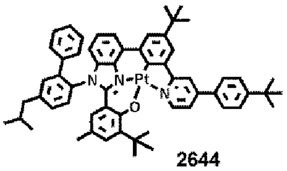
2644

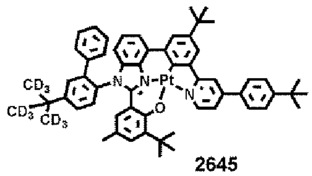
2645

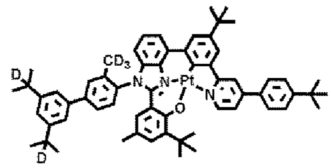
2646

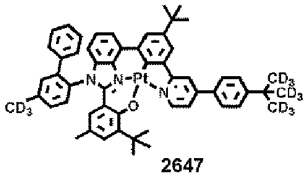
2647

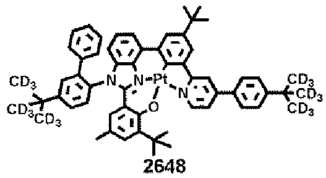
2648

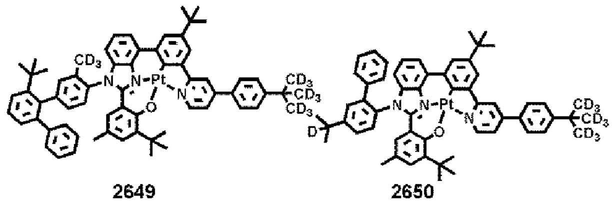
2649

2650

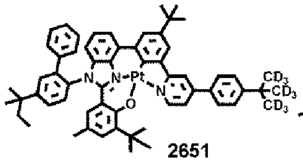
2651

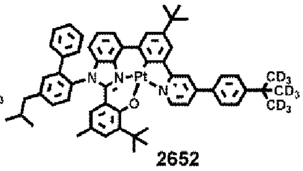
2652

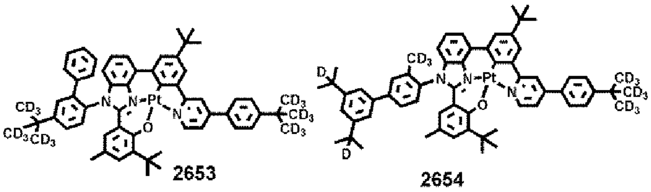
2653

2654

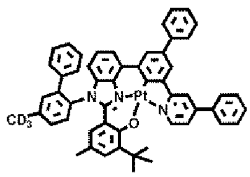
2655

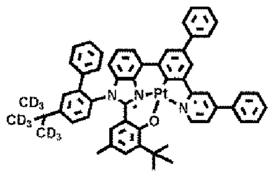
2656

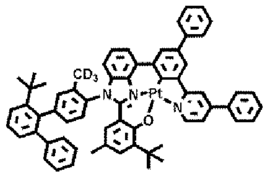
2657

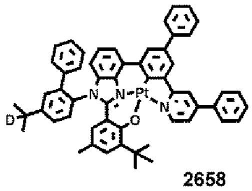
2658

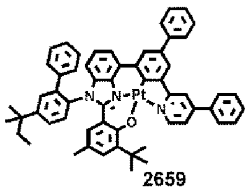
2659

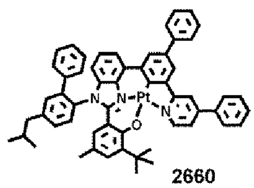
2660

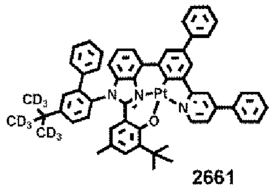
2661

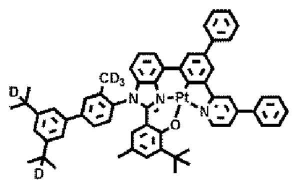
2662

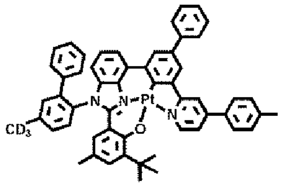
2663

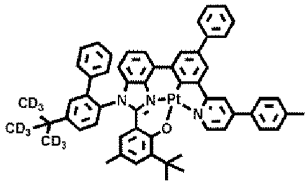
2664

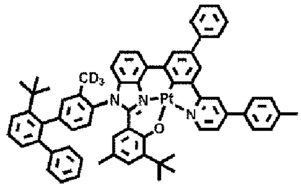
2665

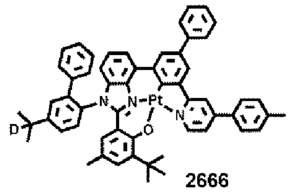
2666

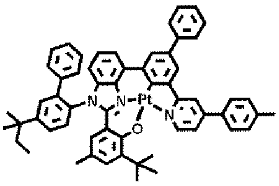
2667

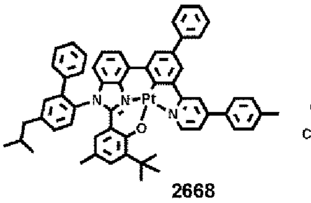
2668

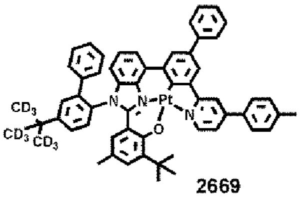
2669

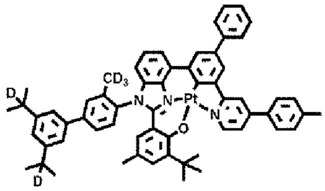
2670

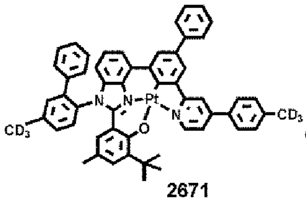
2671

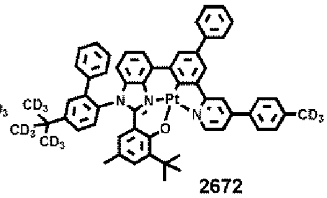
2672

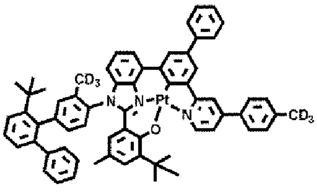
2673

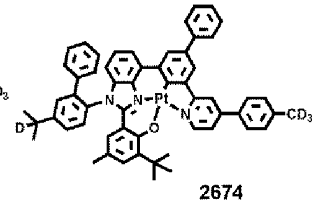
2674

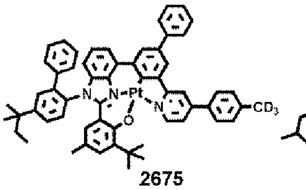
2675

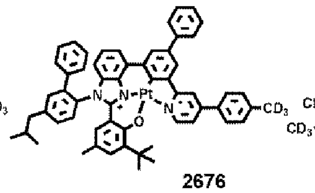
2676

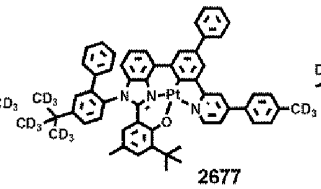
2677

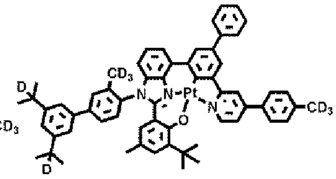
2678

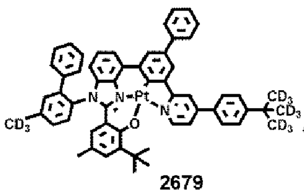
2679

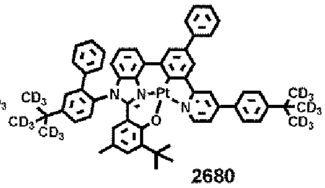
2680

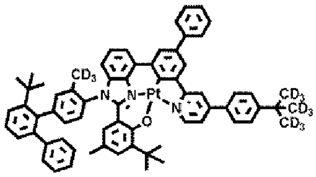
2681

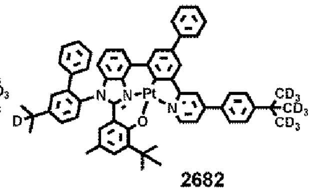
2682

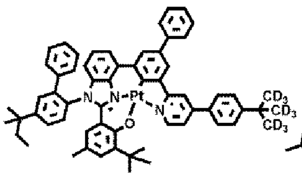
2683

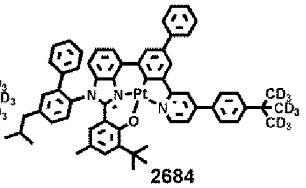
2684

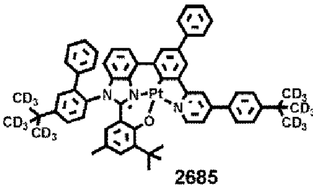
2685

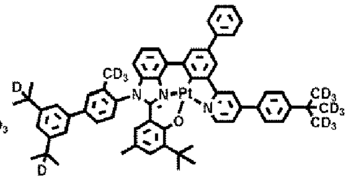
2686

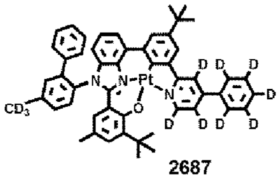
2687

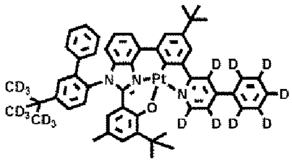
2688

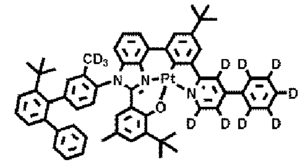
2689

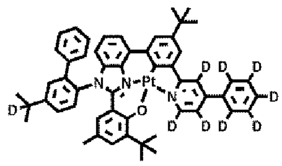
2690

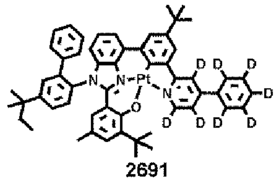
2691

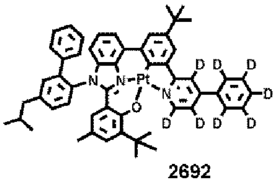
2692

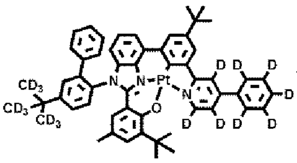
2693

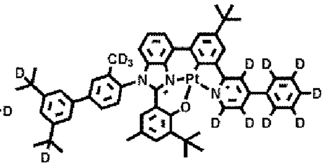
2694

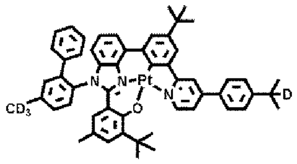
2695

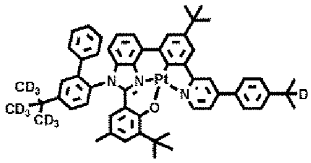
2696

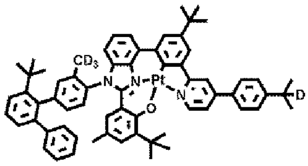
2697

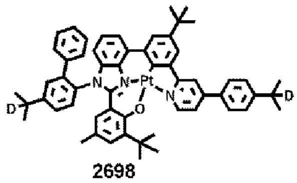
2698

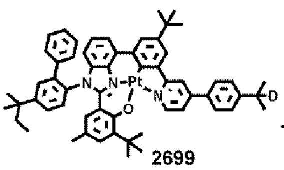
2699

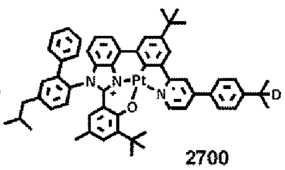
2700

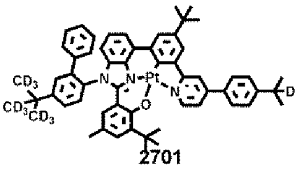
2701

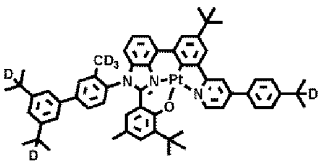
2702

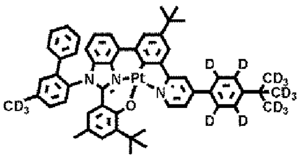
2703

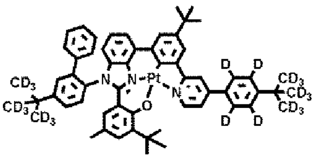
2704

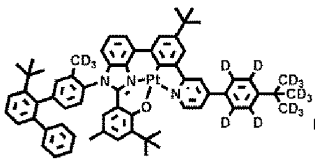
2705

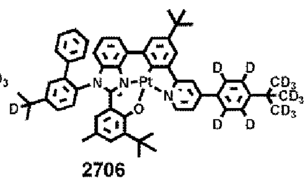
2706

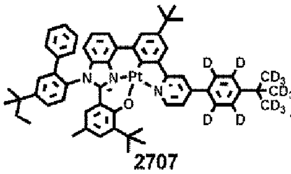
2707

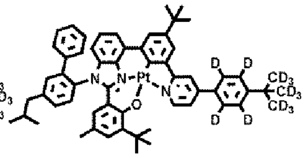
2708

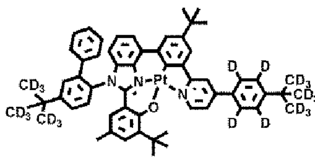
2709

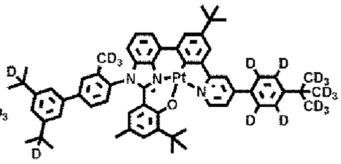
2710

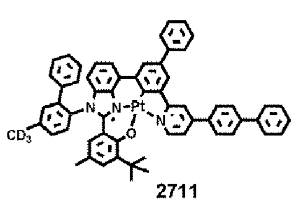
2711

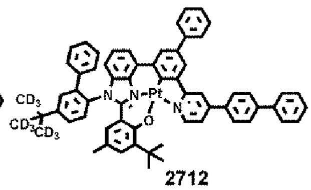
2712

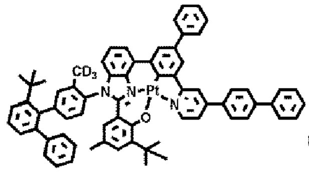
2713

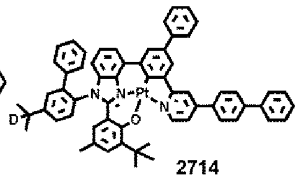
2714

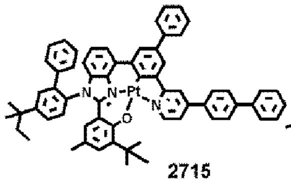
2715

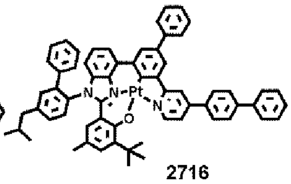
2716

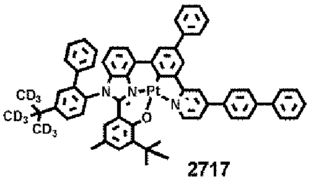
2717

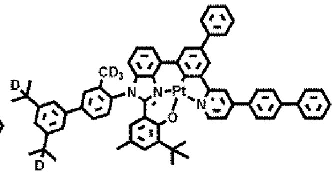
2718

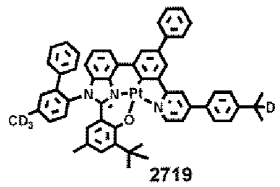
2719

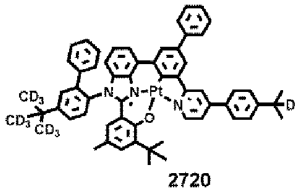
2720

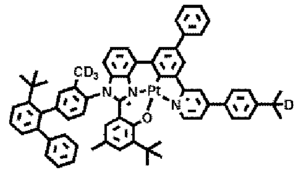
2721

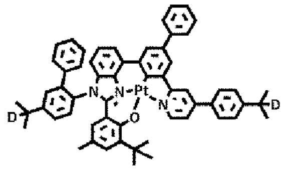
2722

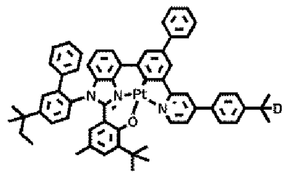
2723

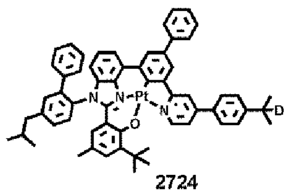
2724

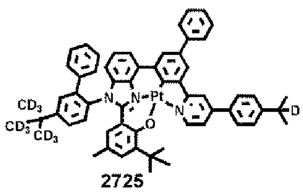
2725

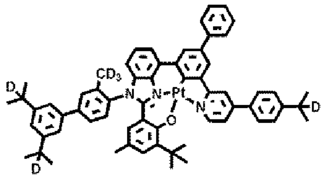
2726

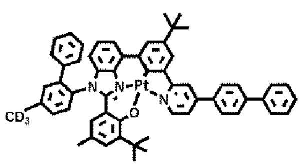
2727

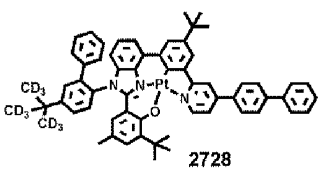
2728

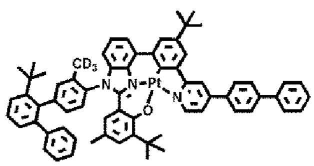
2729

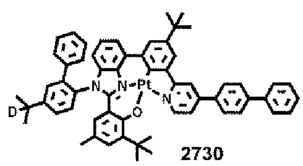
2730

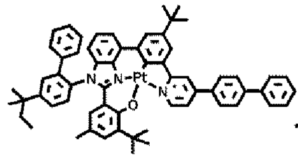
2731

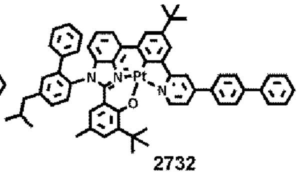
2732

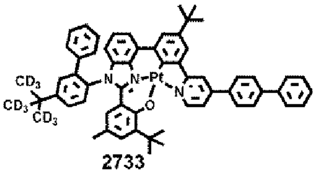
2733

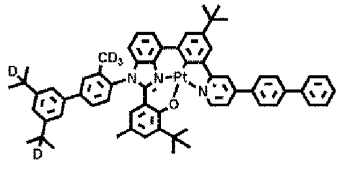
2734

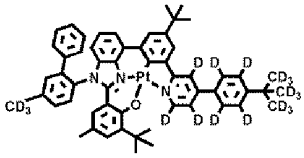
2735

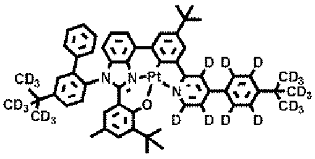
2736

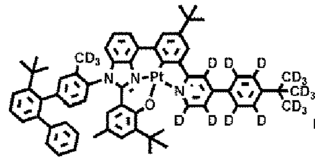
2737

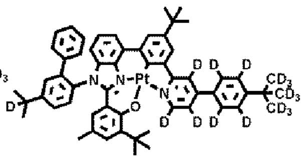
2738

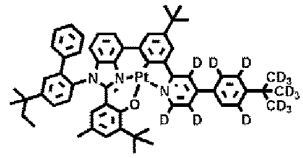
2739

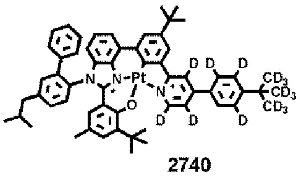
2740

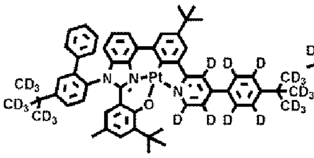
2741

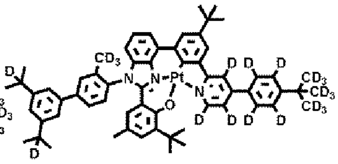
2742

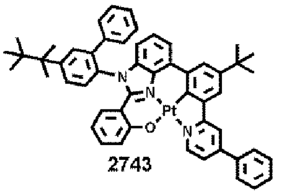
2743

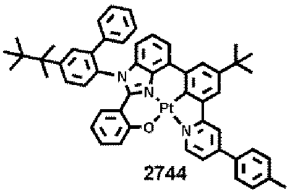
2744

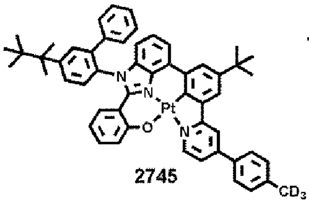
2745

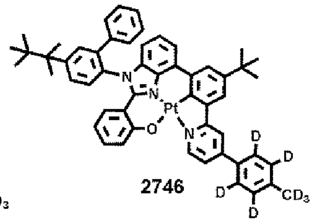
2746

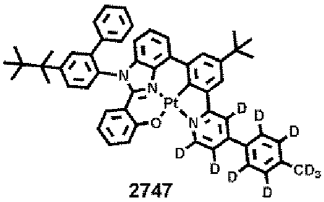
2747

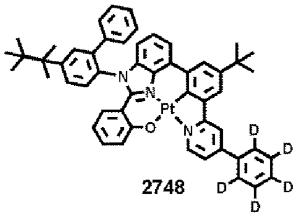
2748

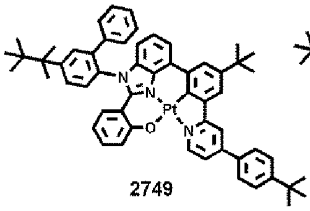
2749

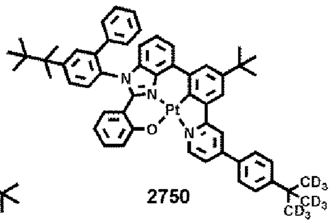
2750

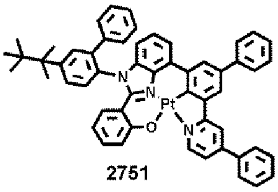
2751

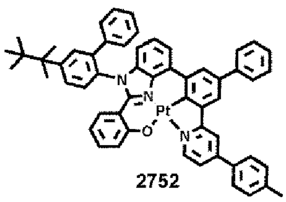
2752

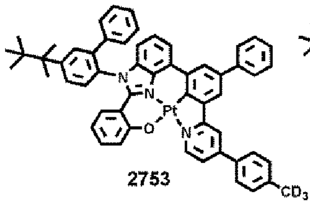
2753

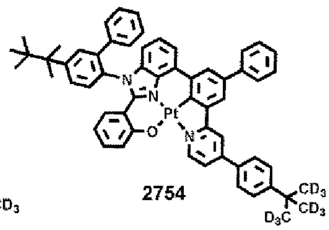
2754

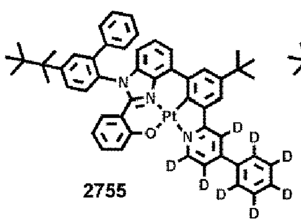
2755

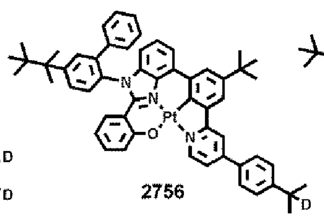
2756

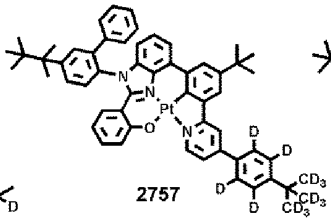
2757

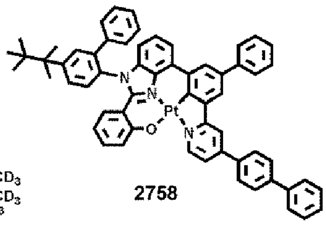
2758

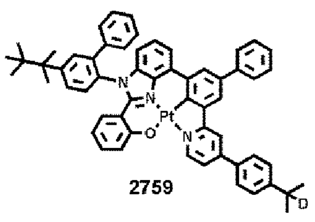
2759

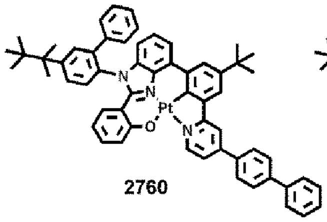
2760

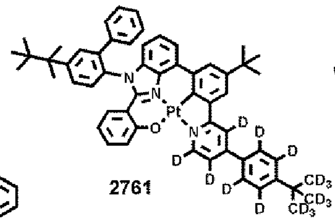
2761

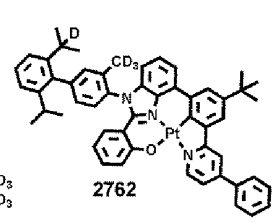
2762

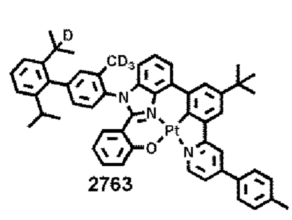
2763

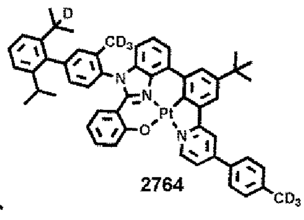
2764

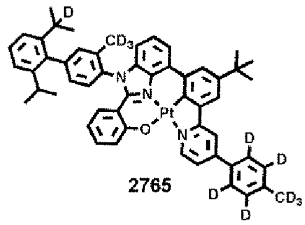
2765

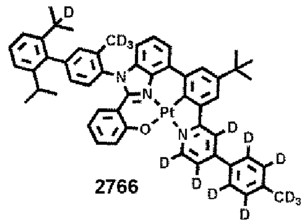
2766

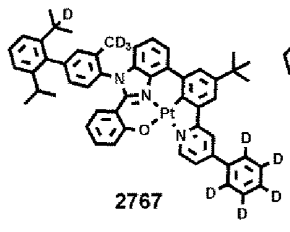
2767

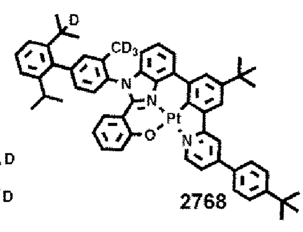
2768

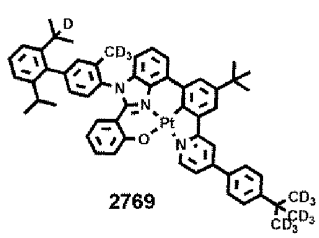
2769

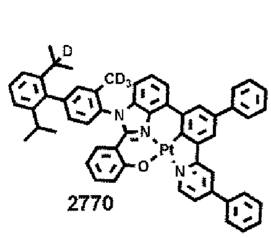
2770

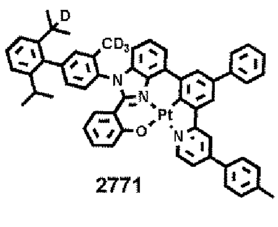
2771

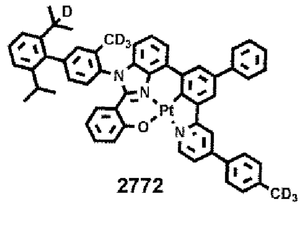
2772

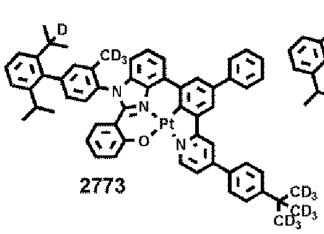
2773

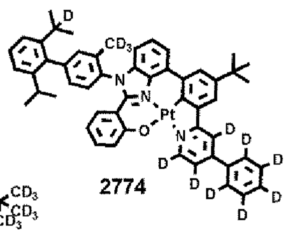
2774

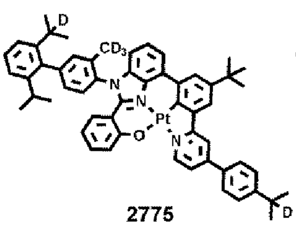
2775

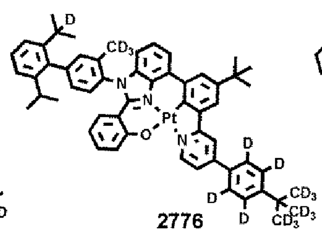
2776

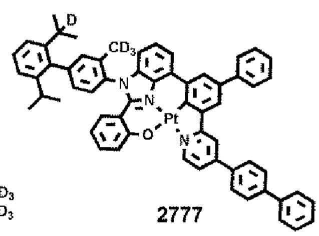
2777

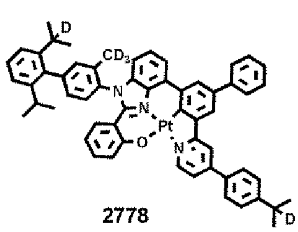
2778

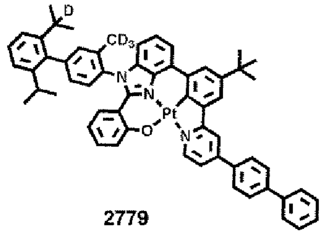
2779

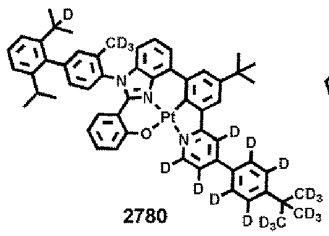
2780

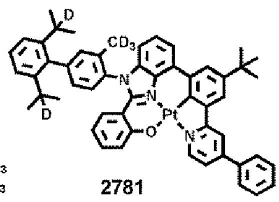
2781

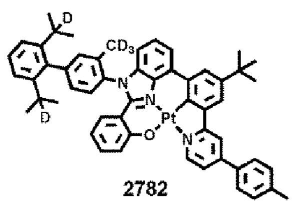
2782

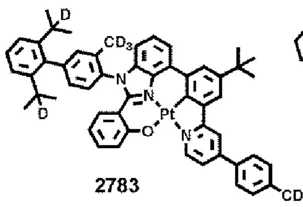
2783

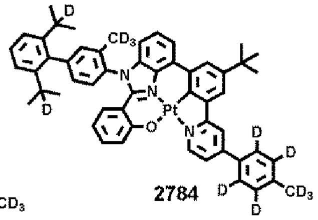
2784

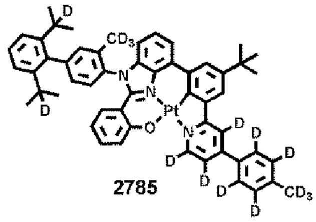
2785

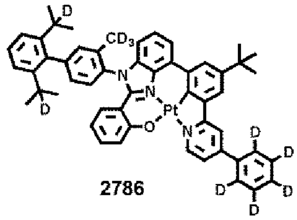
2786

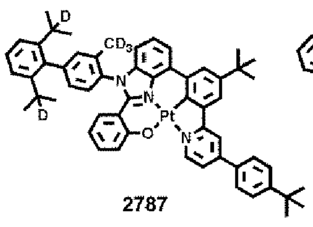
2787

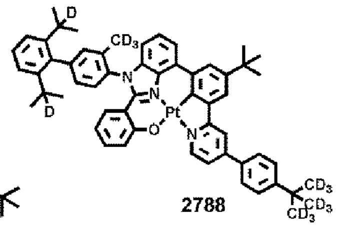
2788

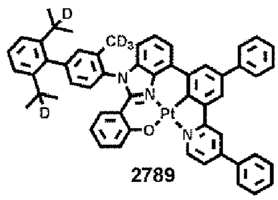
2789

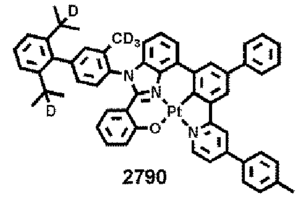
2790

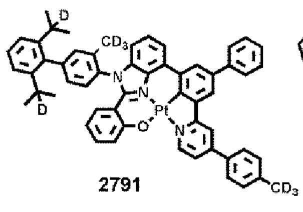
2791

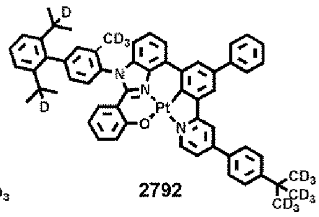
2792

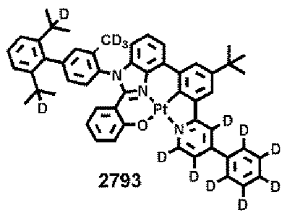
2793

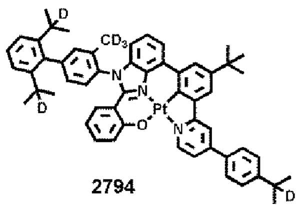
2794

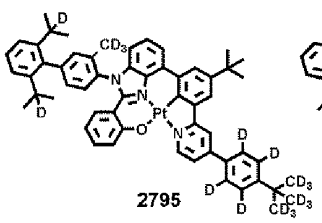
2795

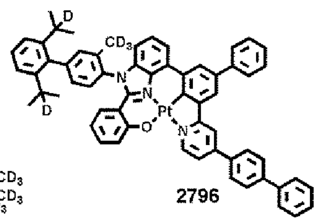
2796

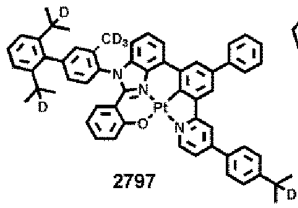
2797

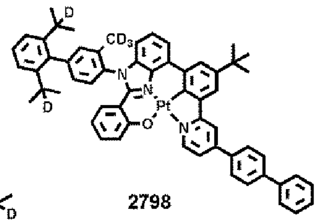
2798

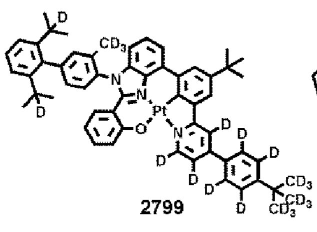
2799

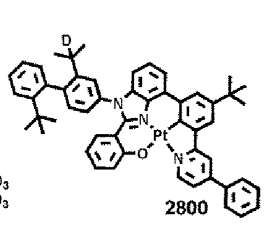
2800

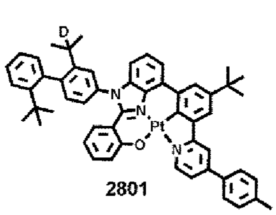
2801

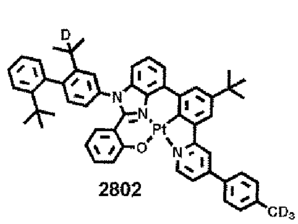
2802

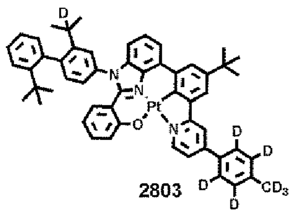
2803

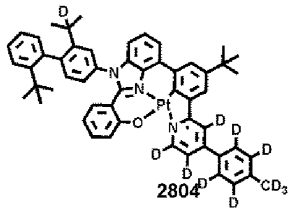
2804

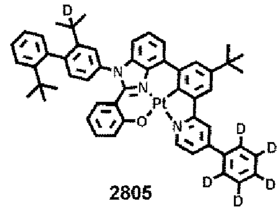
2805

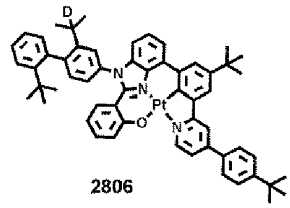
2806

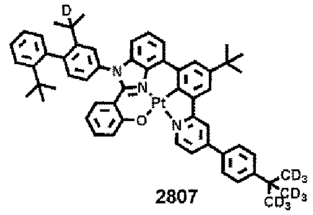
2807

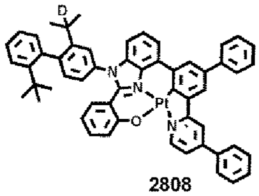
2808

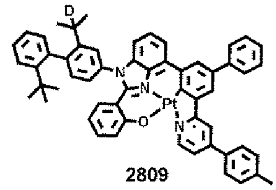
2809

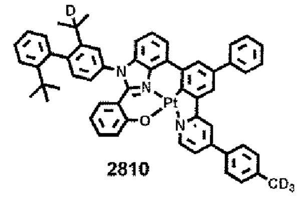
2810

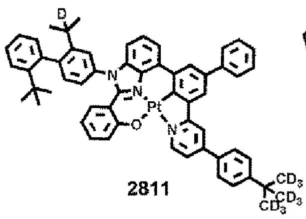
2811

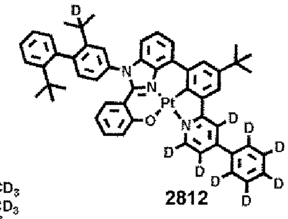
2812

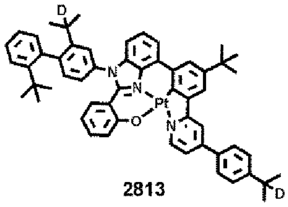
2813

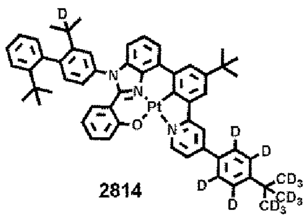
2814

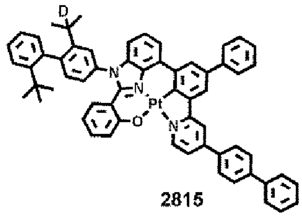
2815

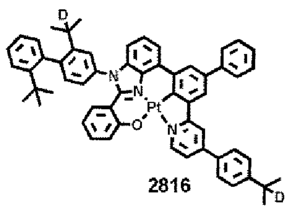
2816

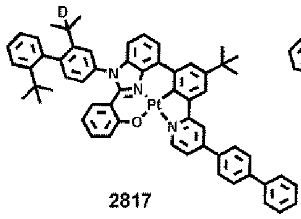
2817

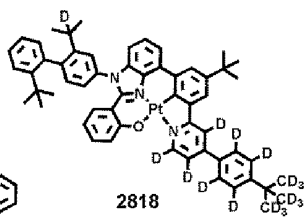
2818

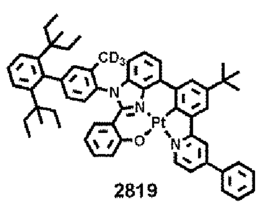
2819

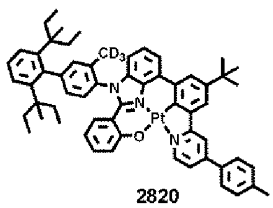
2820

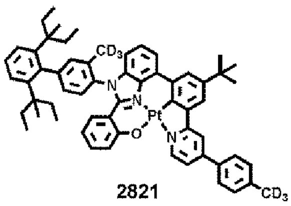
2821

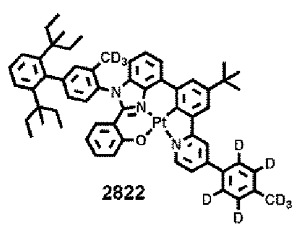
2822

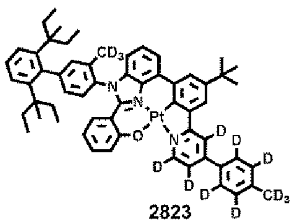
2823

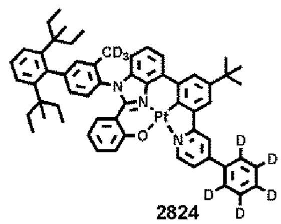
2824

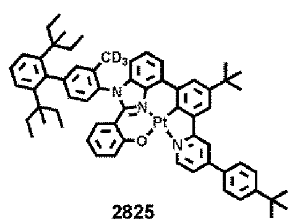
2825

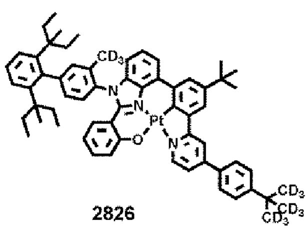
2826

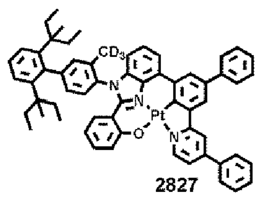
2827

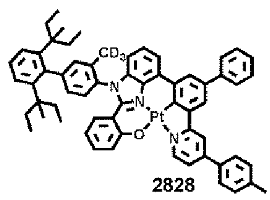
2828

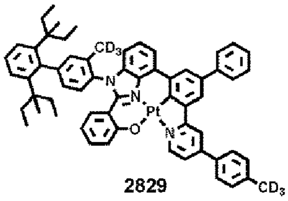
2829

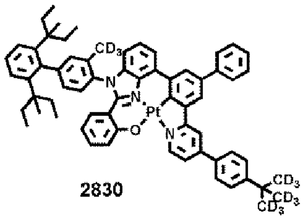
2830

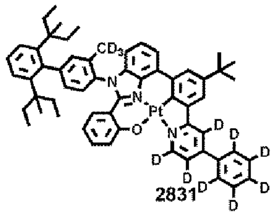
2831

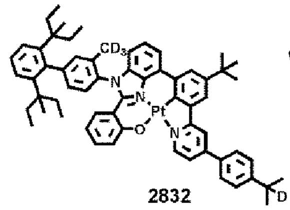
2832

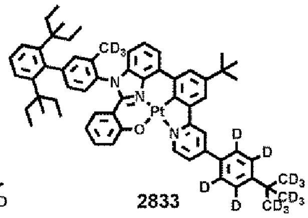
2833

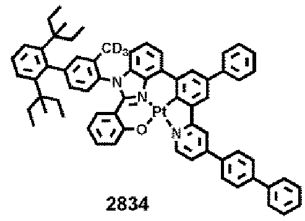
2834

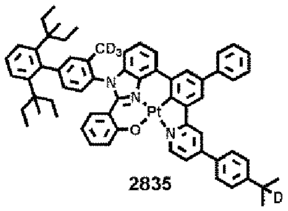
2835

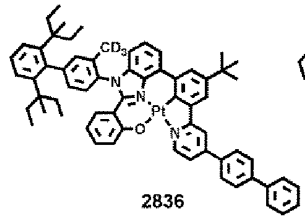
2836

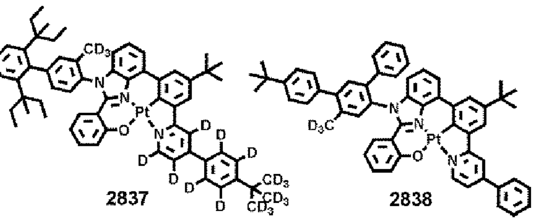
2837

2838

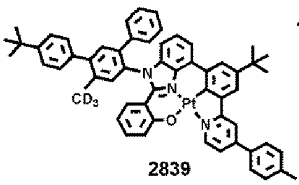
2839

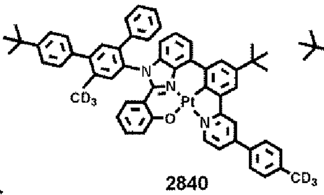
2840

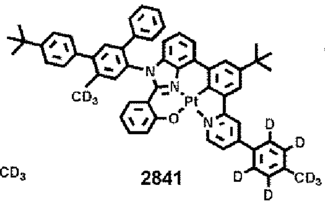
2841

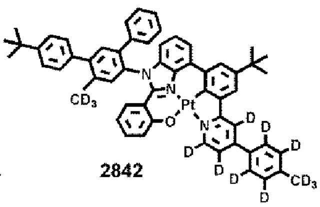
2842

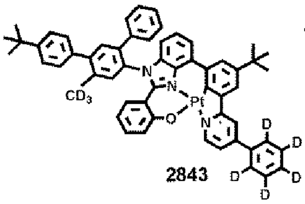
2843

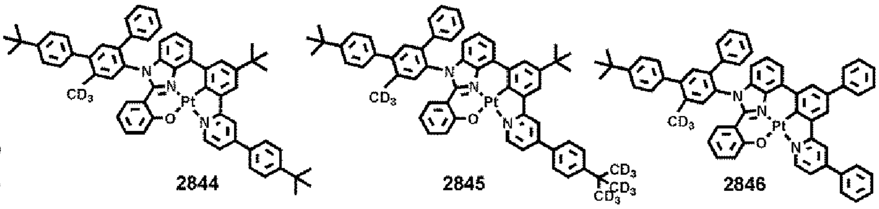
2844

2845

2846

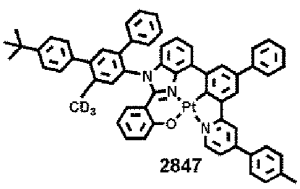
2847

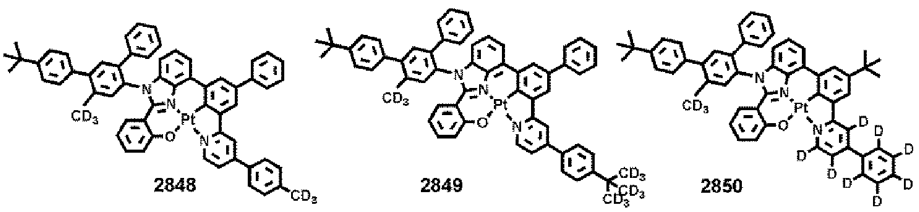
2848

2849

2850

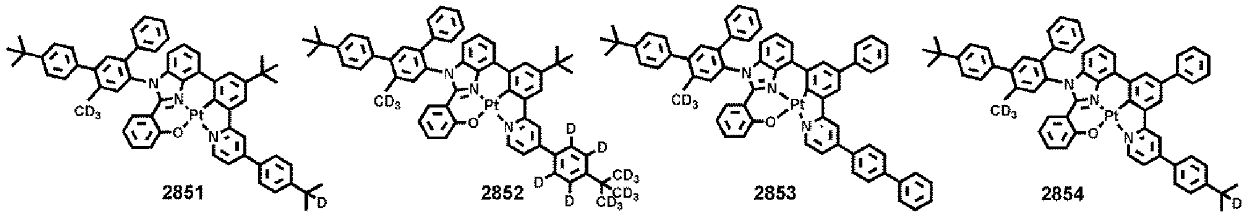

2851 2852 2853 2854

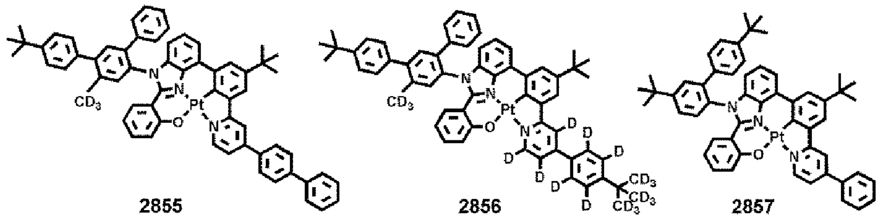

2855 2856 2857

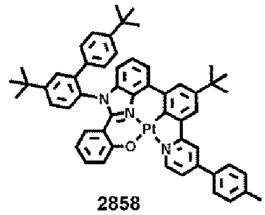

2858

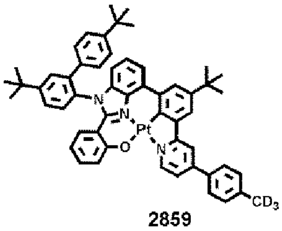

2859

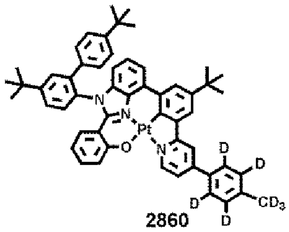

2860

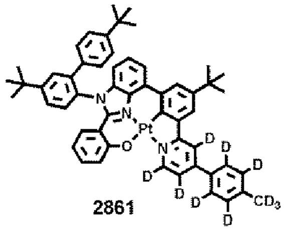

2861

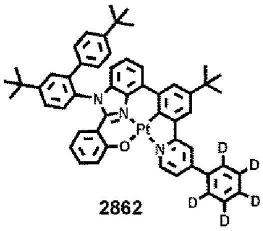

2862

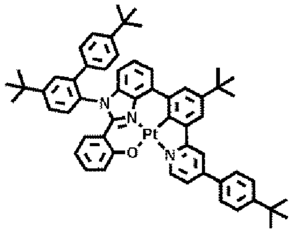

2863

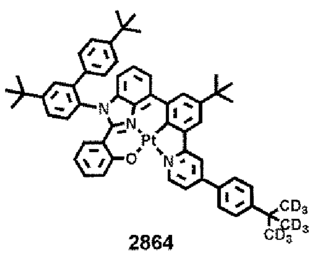

2864

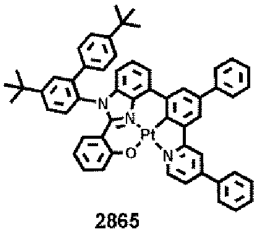

2865

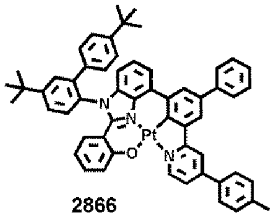

2866

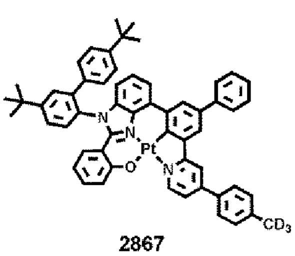

2867

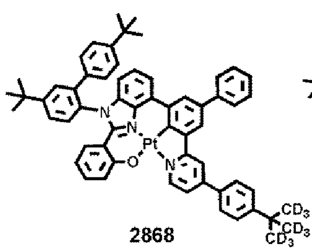

2868

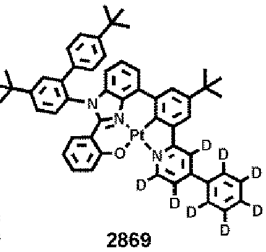

2869

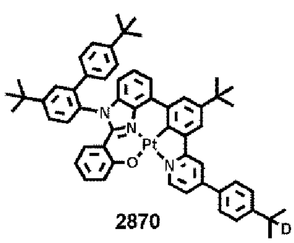

2870

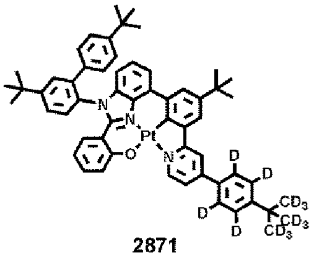

2871

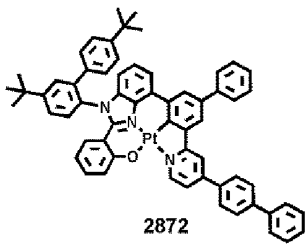

2872

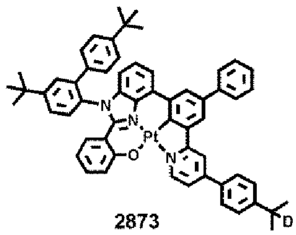

2873

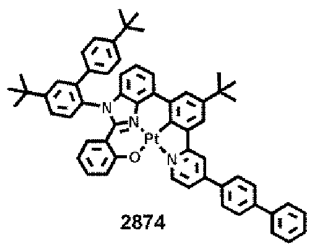

2874

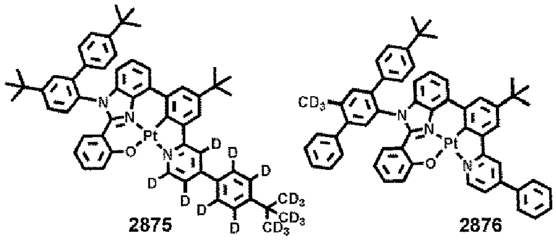

2875 2876

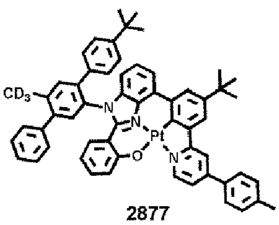

2877

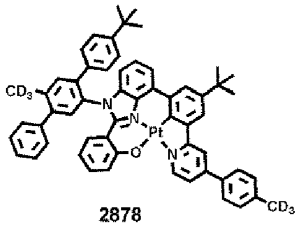

2878

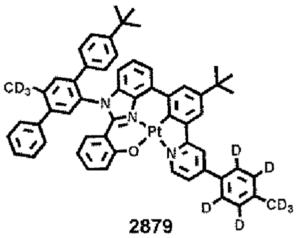

2879

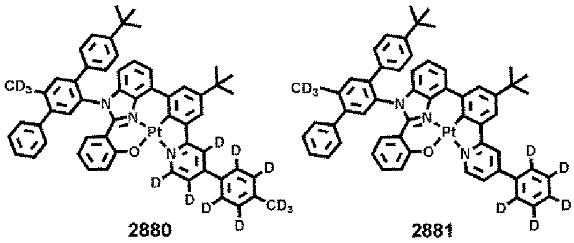

2880 2881

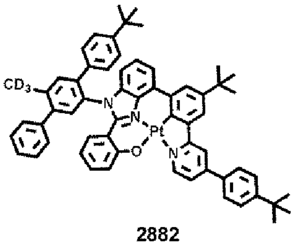

2882

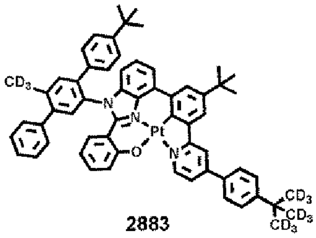

2883

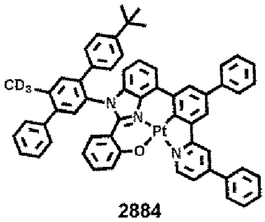

2884

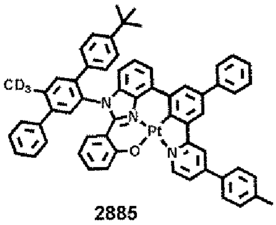

2885

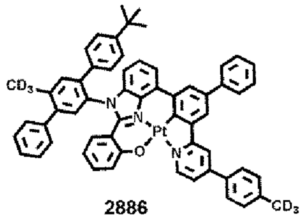

2886

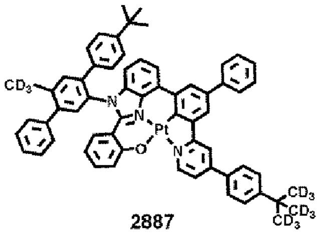

2887

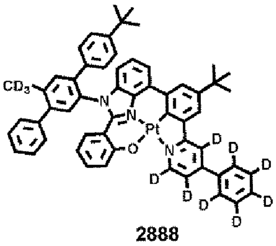

2888

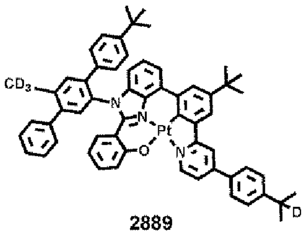

2889

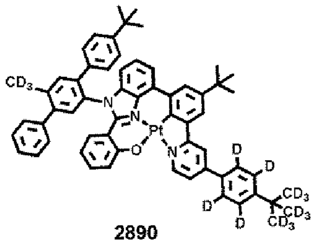

2890

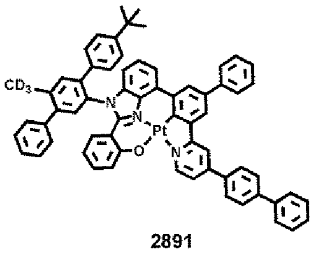

2891

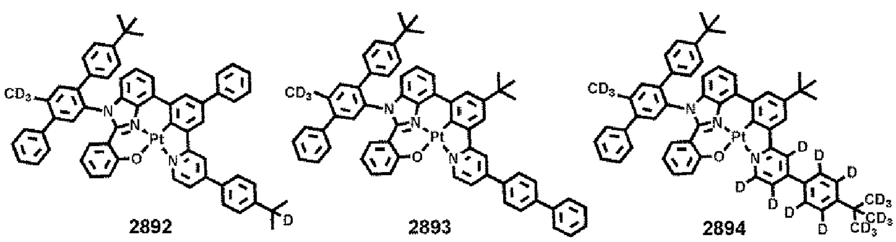

2892 2893 2894

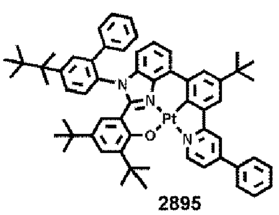

2895

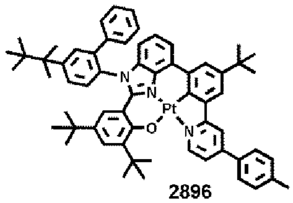

2896

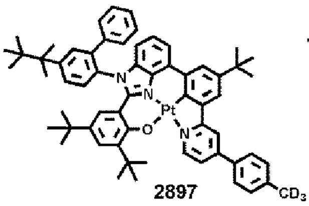

2897

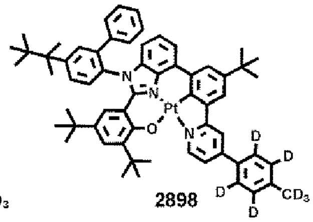

2898

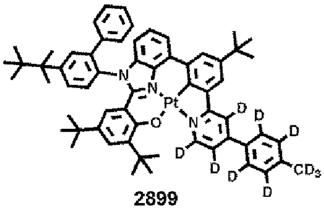

2899

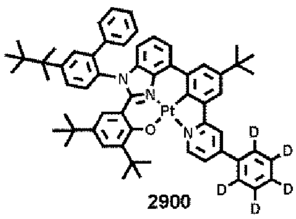

2900

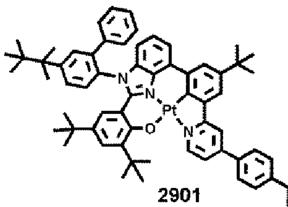

2901

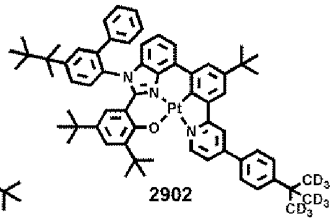

2902

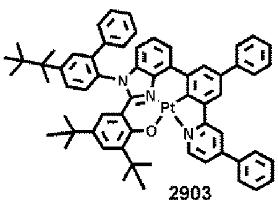

2903

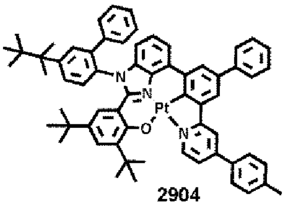

2904

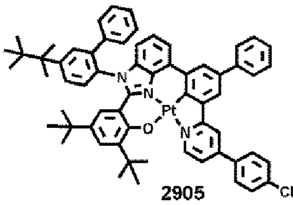

2905

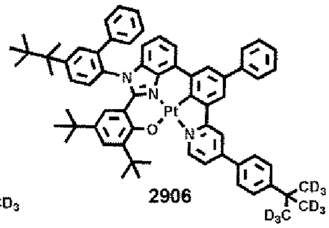

2906

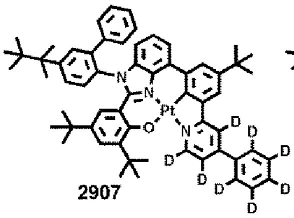

2907

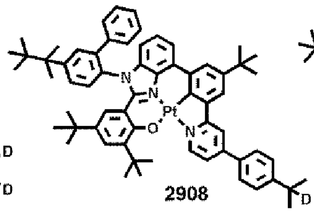

2908

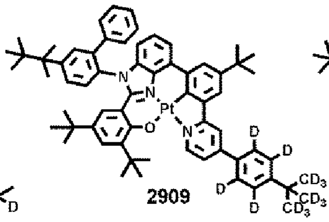

2909

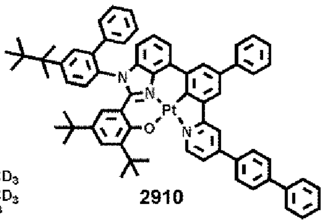

2910

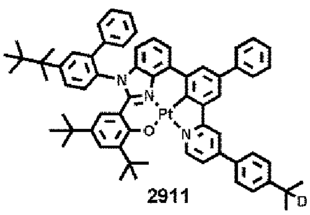

2911

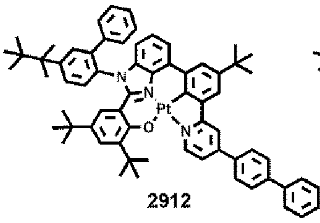

2912

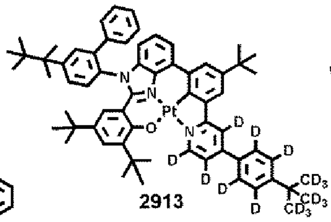

2913

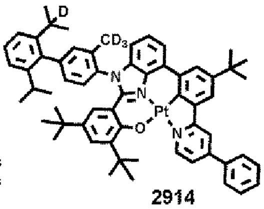

2914

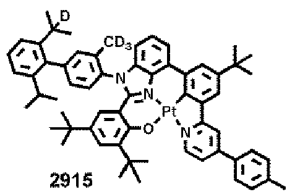

2915

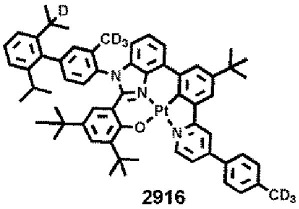

2916

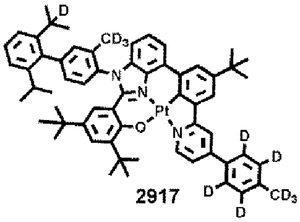

2917

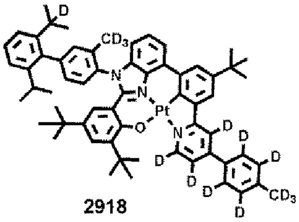

2918

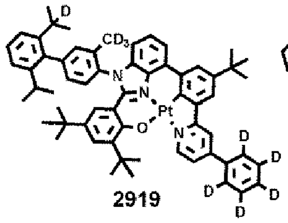
2919

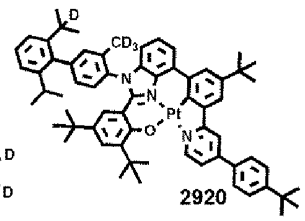
2920

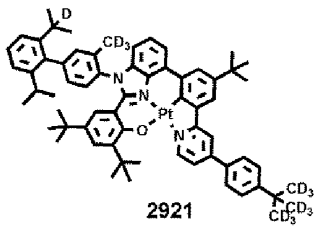
2921

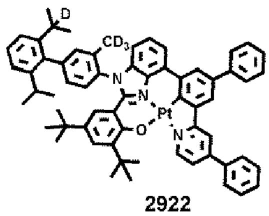
2922

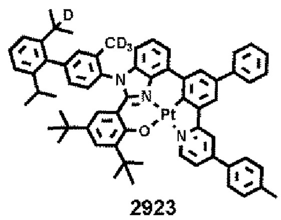
2923

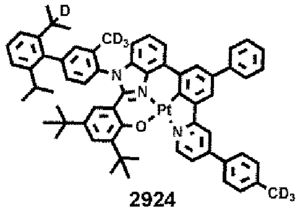
2924

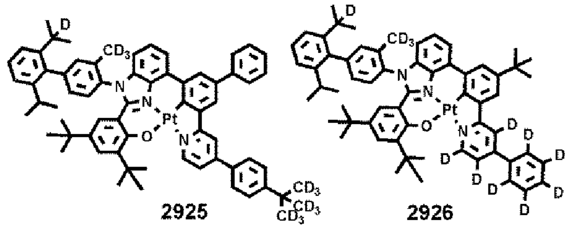
2925

2926

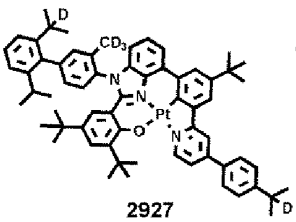
2927

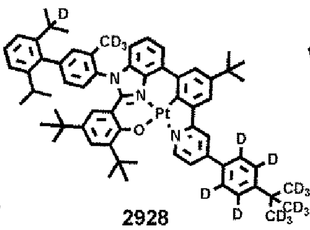
2928

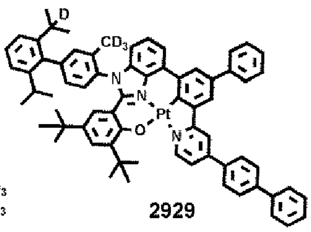
2929

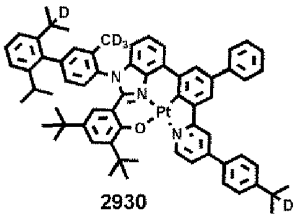
2930

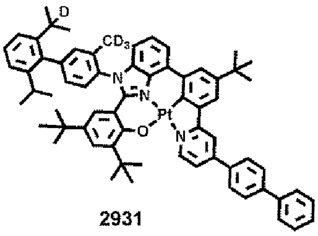
2931

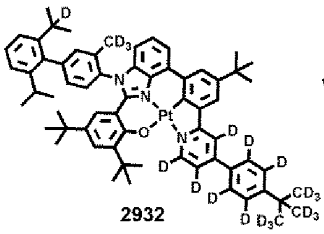
2932

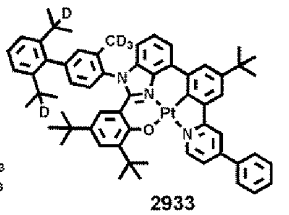
2933

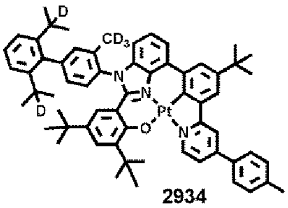
2934

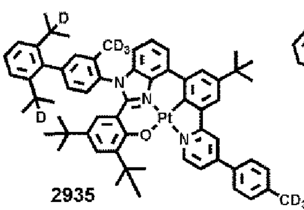
2935

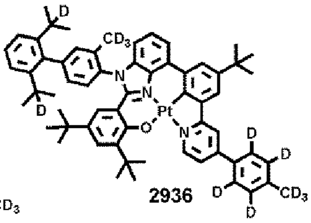
2936

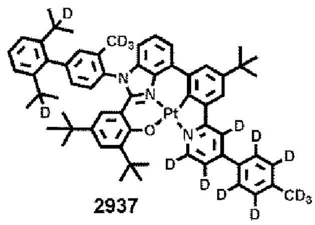
2937

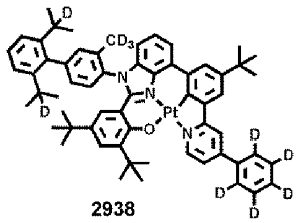
2938

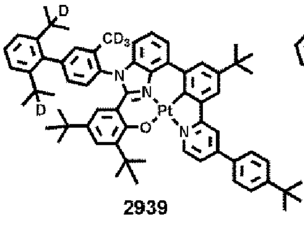
2939

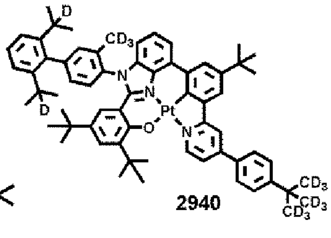
2940

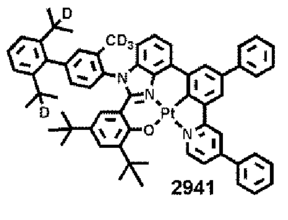
2941

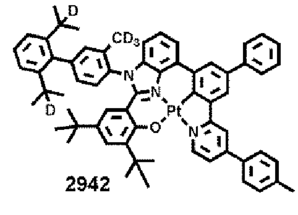
2942

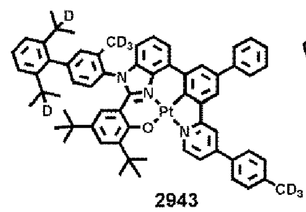
2943

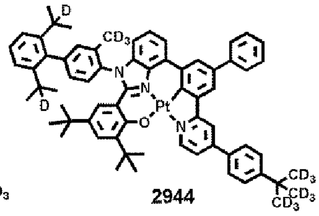
2944

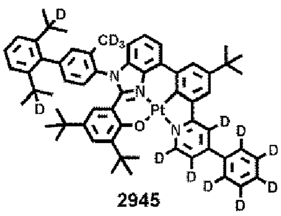
2945

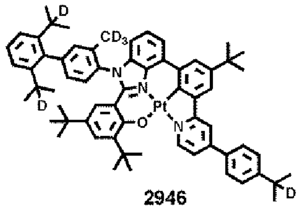
2946

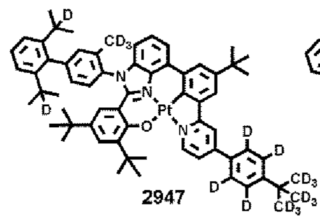
2947

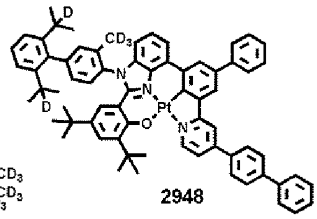
2948

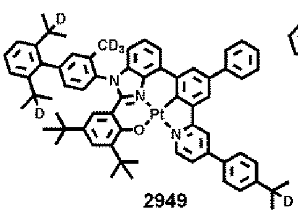
2949

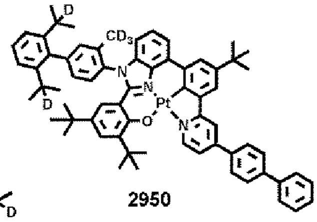
2950

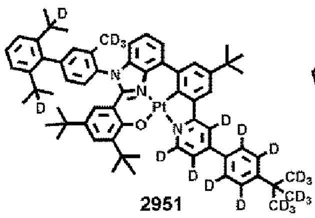
2951

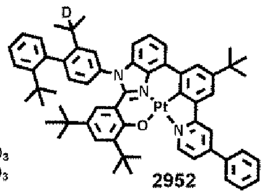
2952

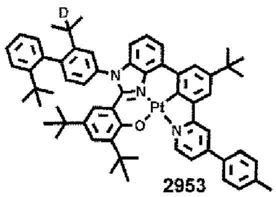
2953

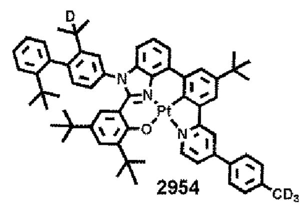
2954

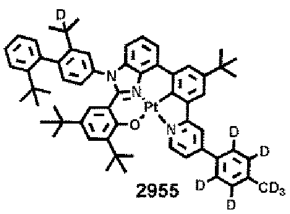
2955

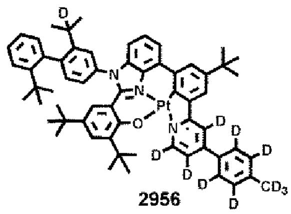
2956

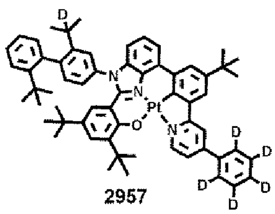
2957

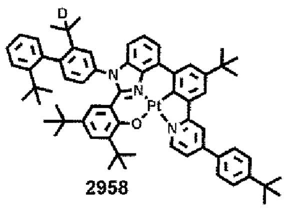
2958

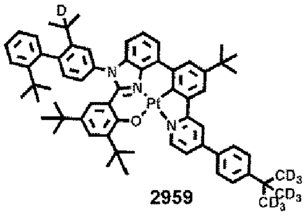
2959

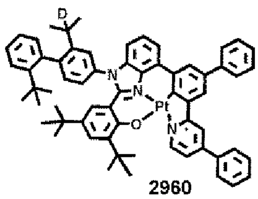
2960

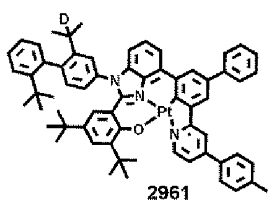
2961

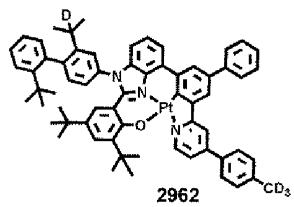
2962

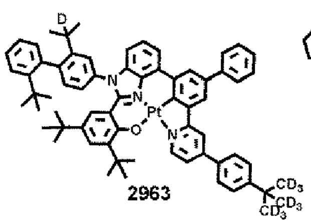
2963

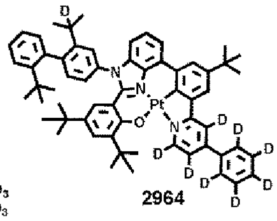
2964

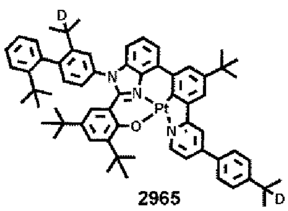
2965

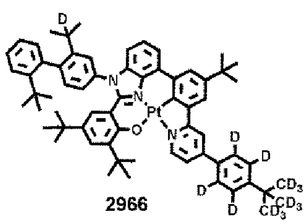
2966

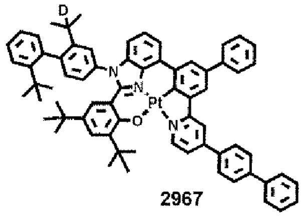
2967

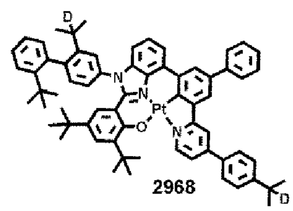
2968

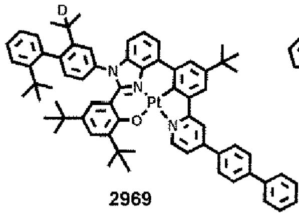
2969

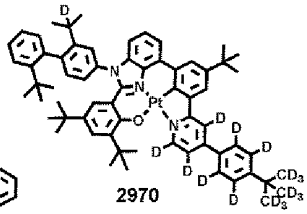
2970

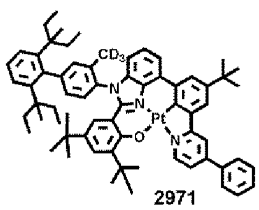
2971

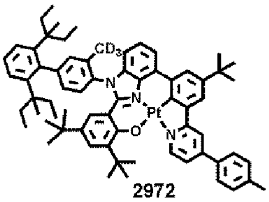
2972

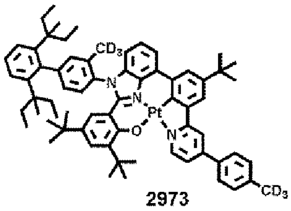
2973

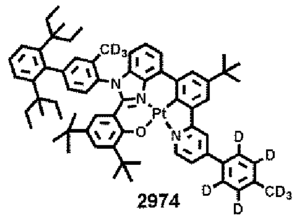
2974

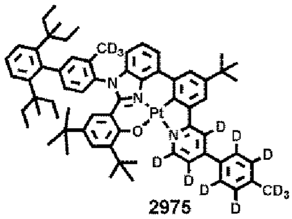
2975

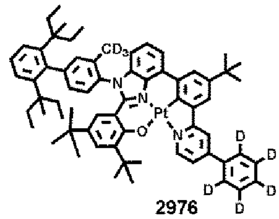
2976

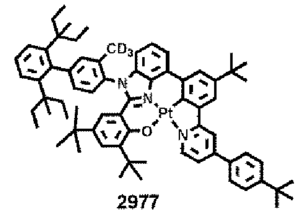
2977

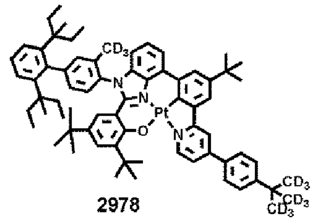
2978

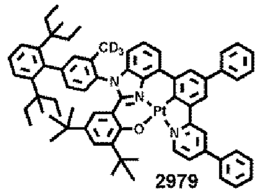
2979

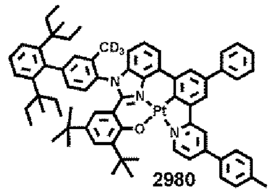
2980

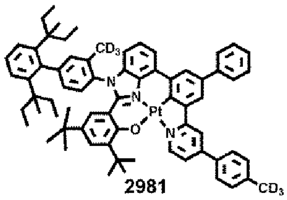
2981

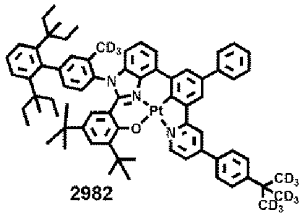
2982

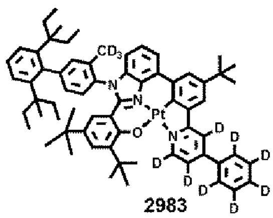
2983

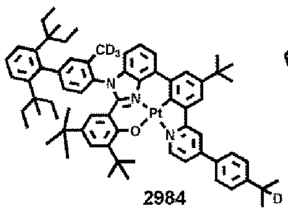
2984

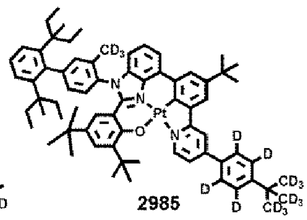
2985

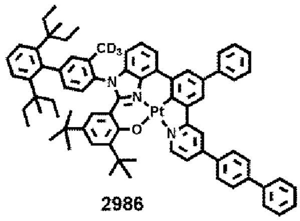
2986

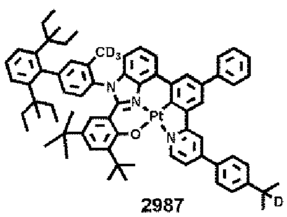
2987

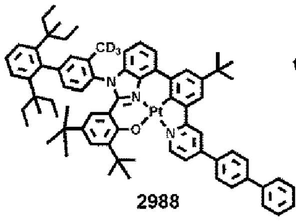
2988

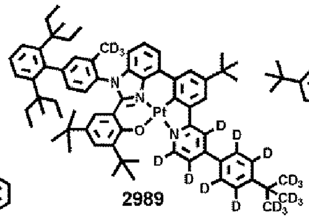
2989

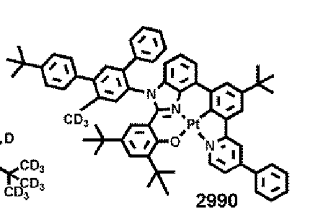
2990

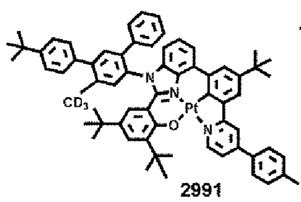
2991

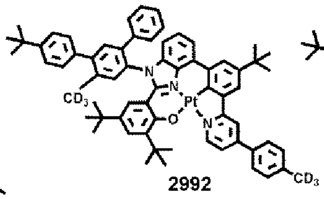
2992

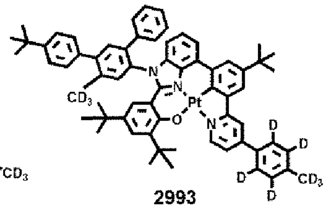
2993

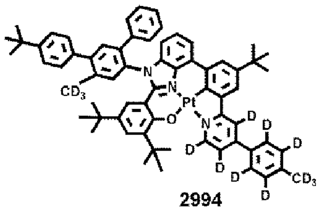
2994

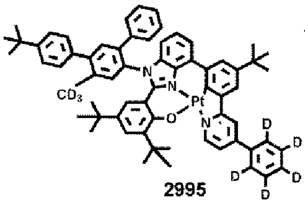
2995

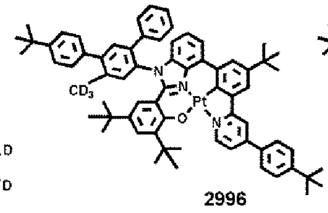
2996

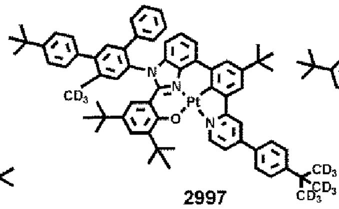
2997

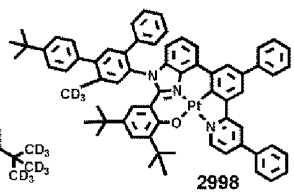
2998

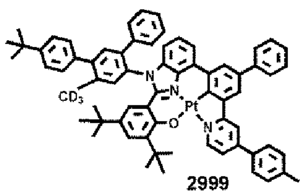
2999

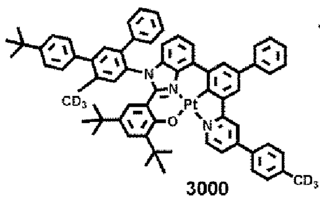
3000

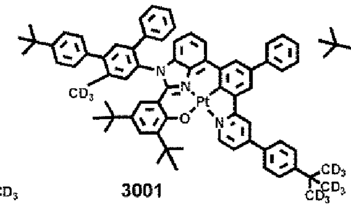
3001

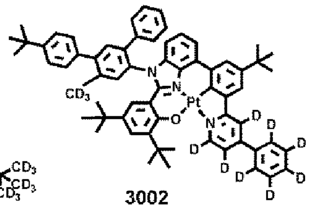
3002

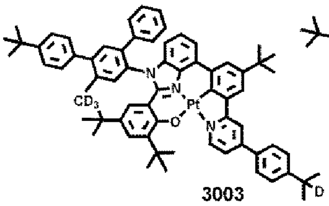
3003

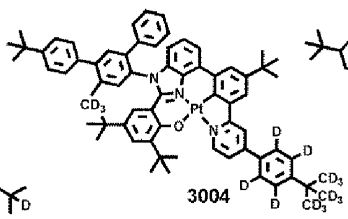
3004

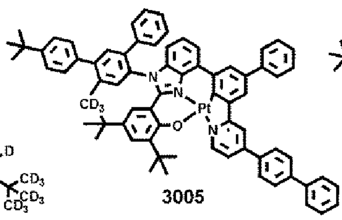
3005

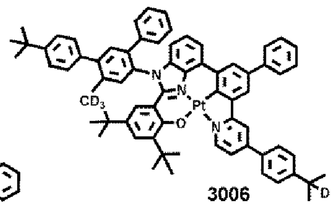
3006

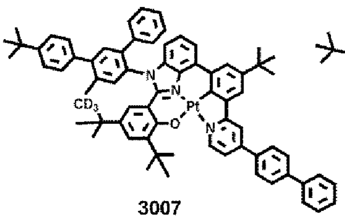
3007

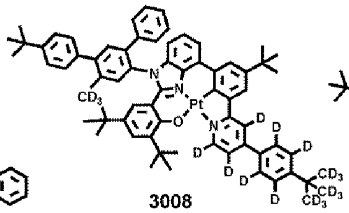
3008

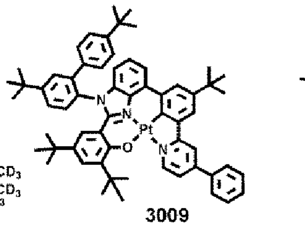
3009

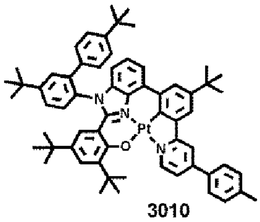
3010

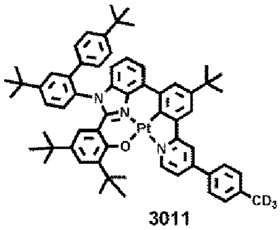
3011

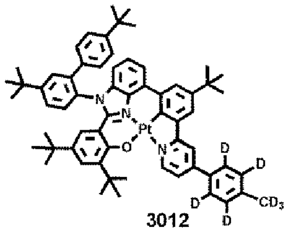
3012

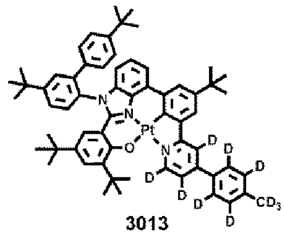
3013

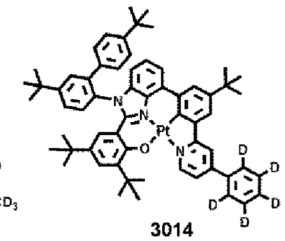
3014

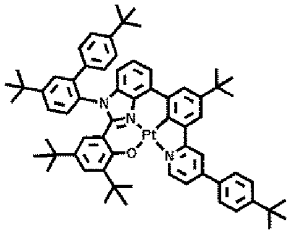
3015

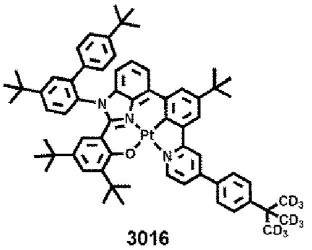
3016

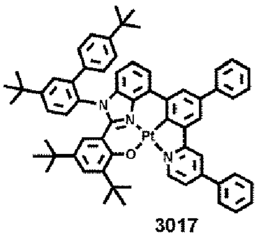
3017

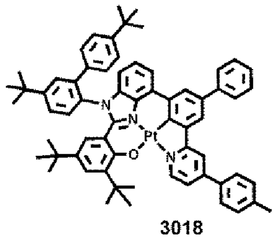
3018

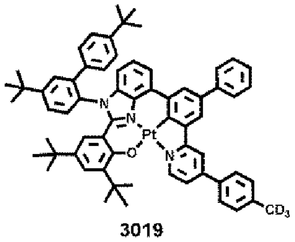
3019

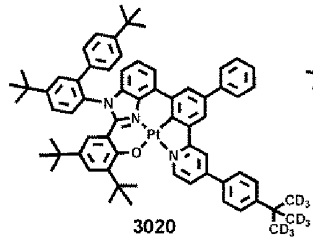
3020

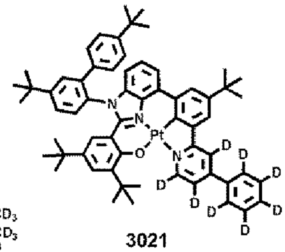
3021

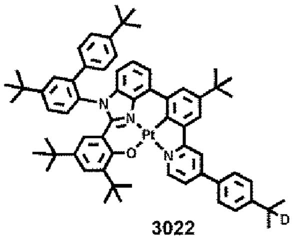
3022

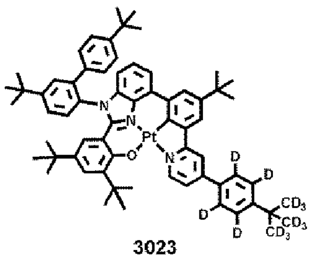
3023

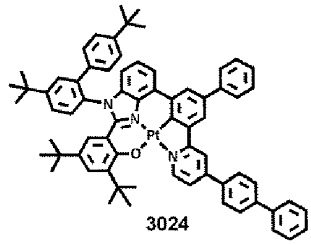
3024

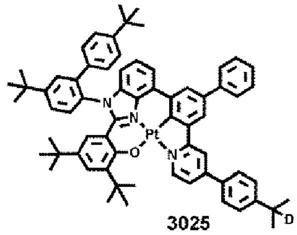
3025

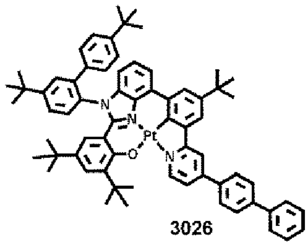
3026

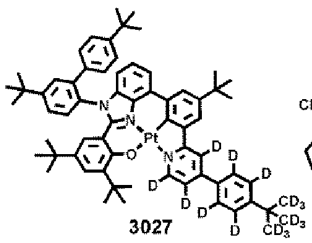
3027

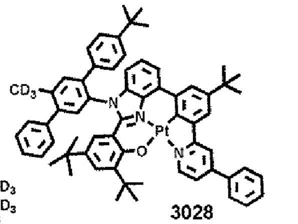
3028

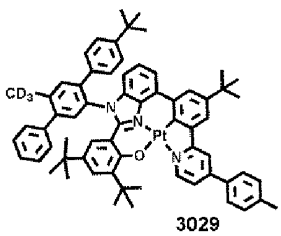
3029

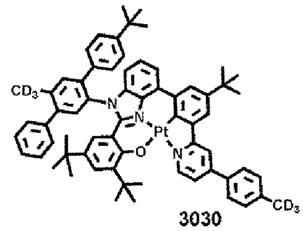
3030

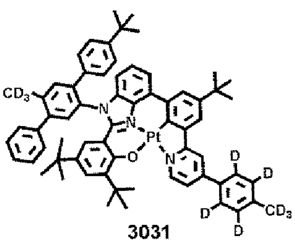
3031

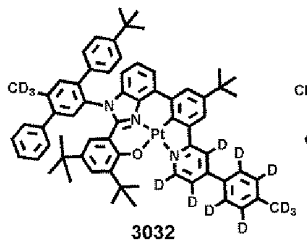
3032

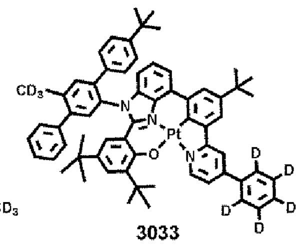
3033

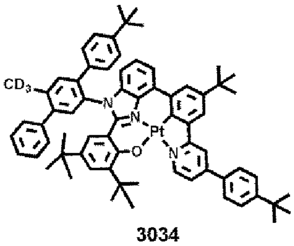
3034

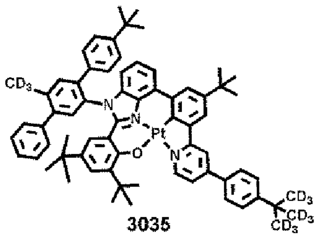
3035

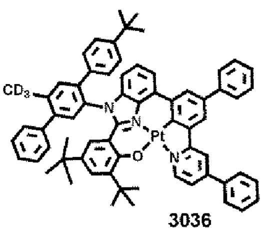
3036

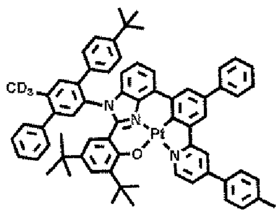
3037

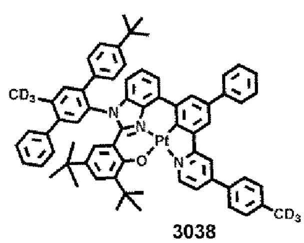
3038

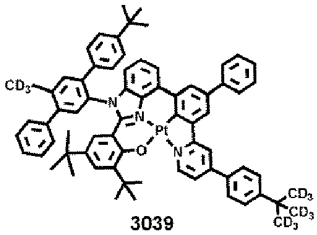
3039

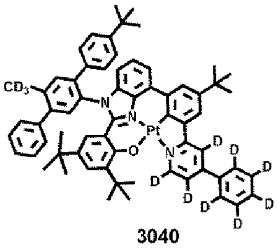
3040

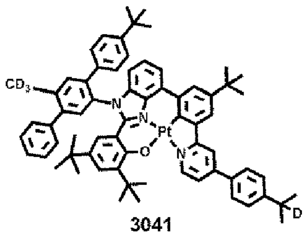
3041

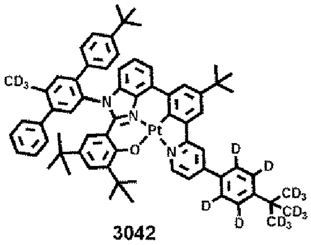
3042

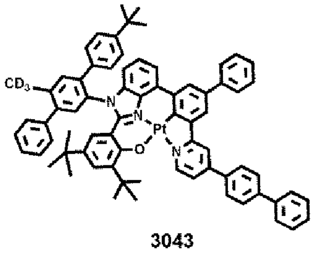
3043

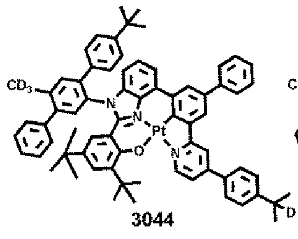
3044

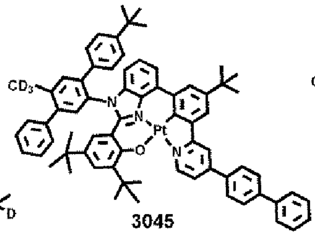
3045

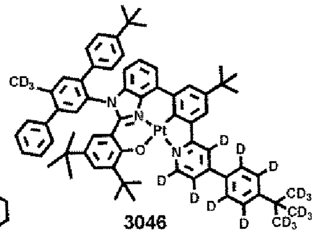
3046

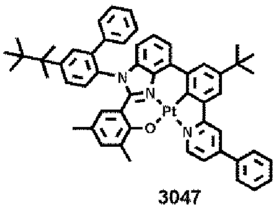
3047

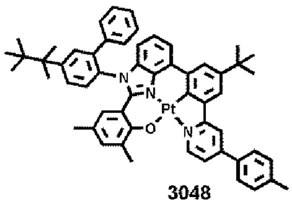
3048

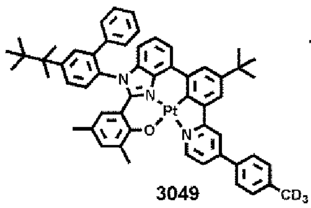
3049

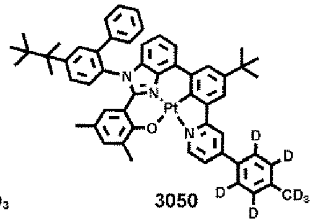
3050

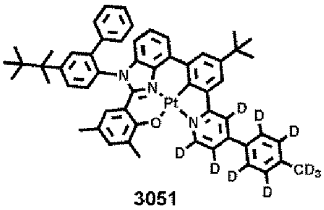
3051

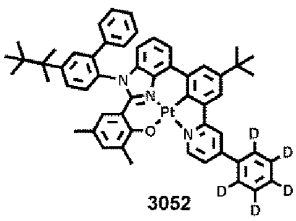
3052

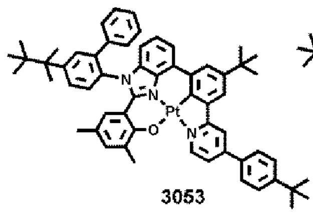
3053

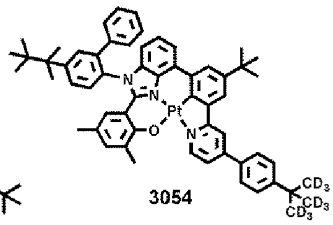
3054

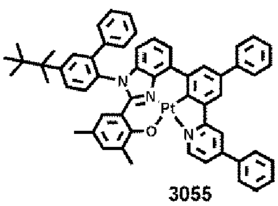
3055

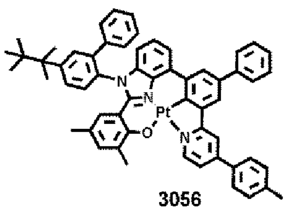
3056

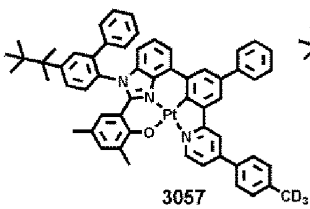
3057

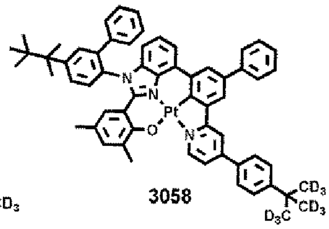
3058

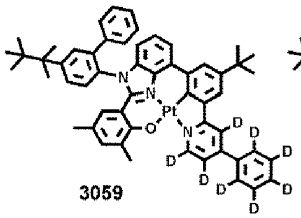
3059

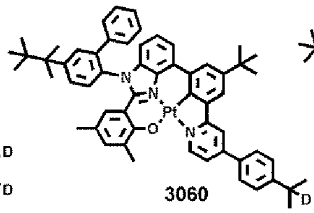
3060

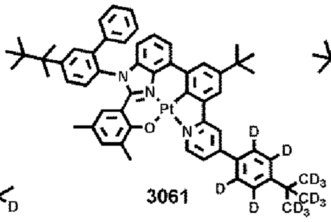
3061

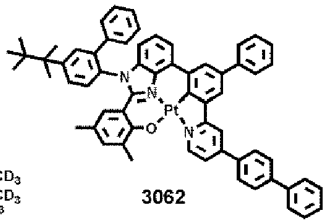
3062

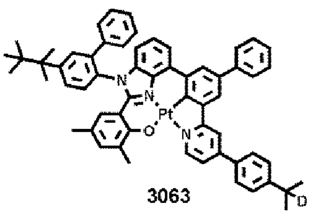
3063

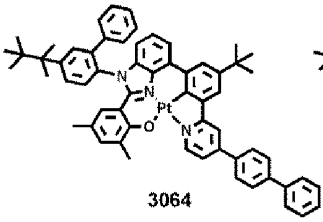
3064

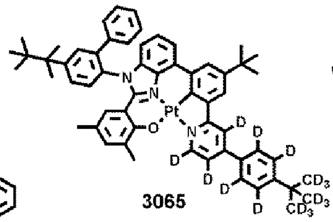
3065

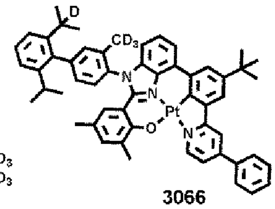
3066

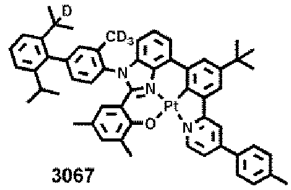
3067

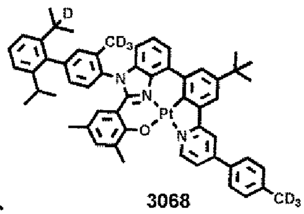
3068

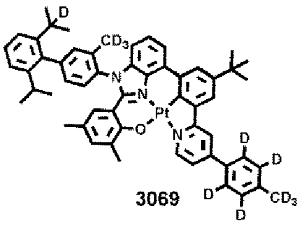
3069

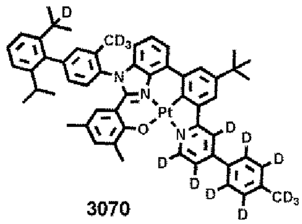
3070

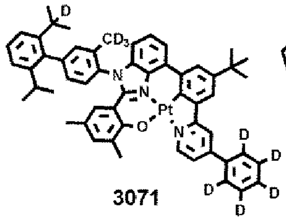
3071

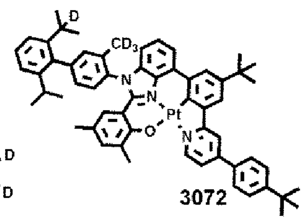
3072

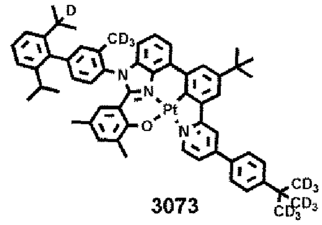
3073

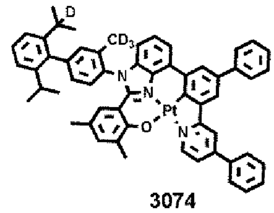
3074

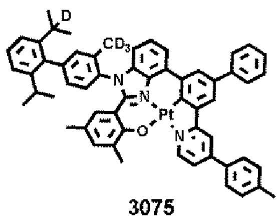
3075

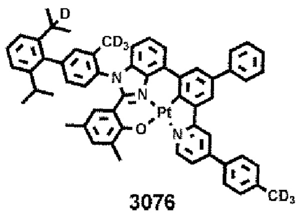
3076

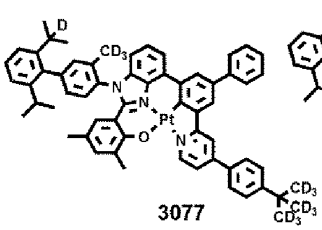
3077

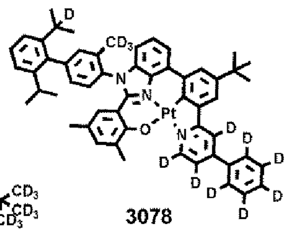
3078

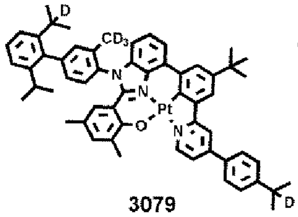
3079

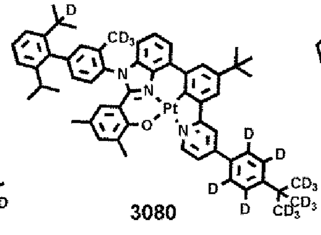
3080

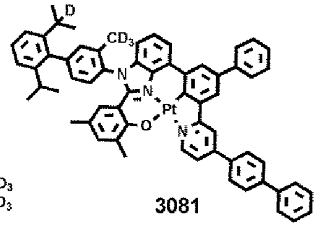
3081

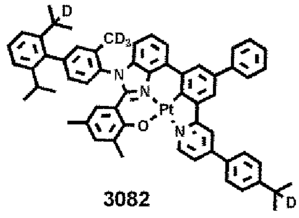
3082

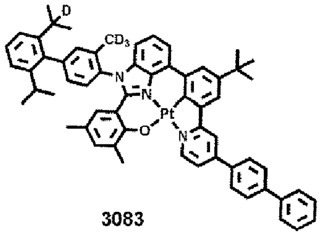
3083

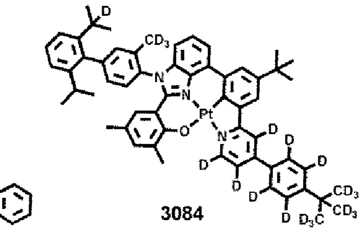
3084

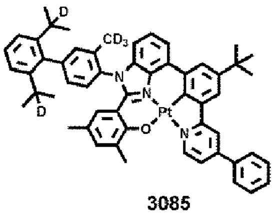
3085

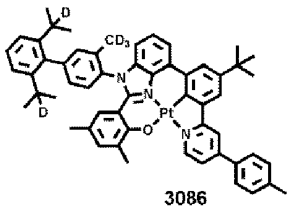
3086

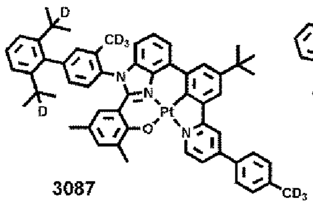
3087

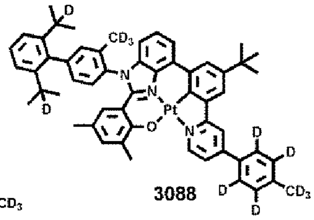
3088

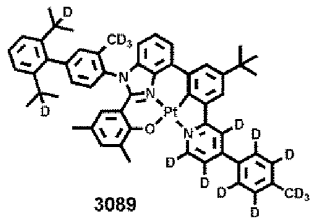
3089

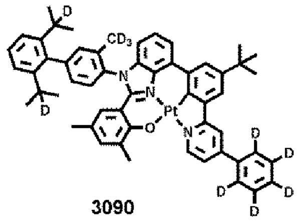
3090

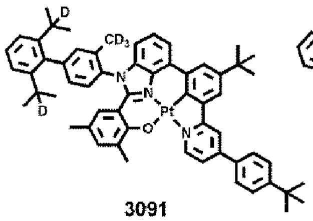
3091

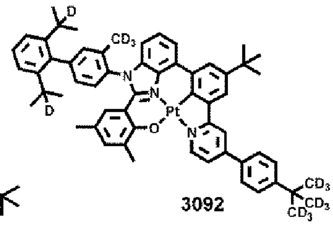
3092

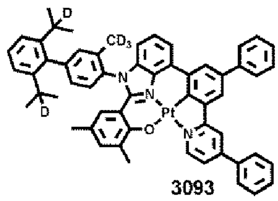
3093

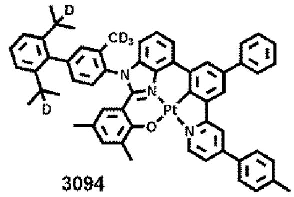
3094

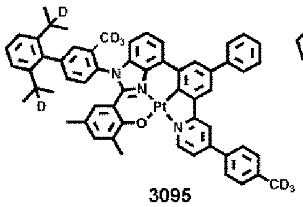
3095

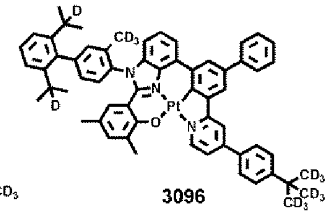
3096

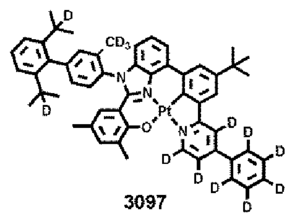
3097

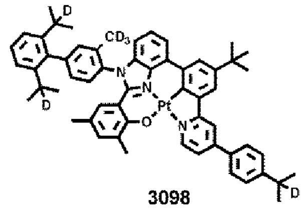
3098

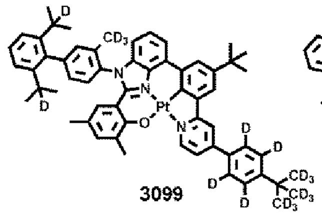
3099

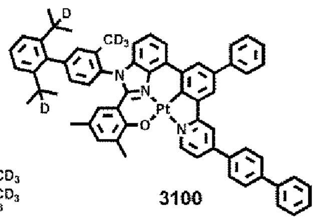
3100

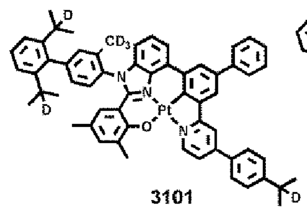
3101

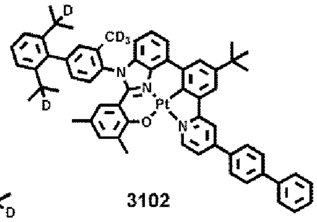
3102

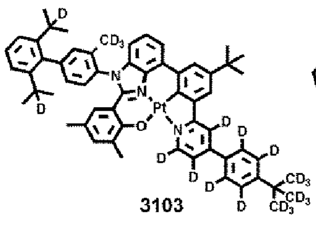
3103

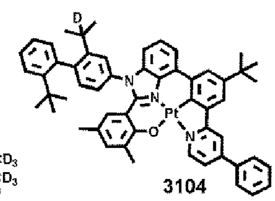
3104

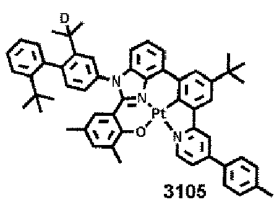
3105

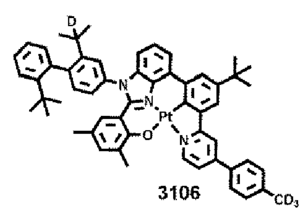
3106

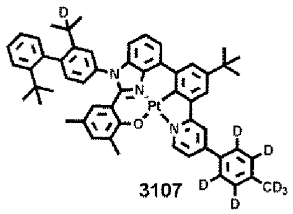
3107

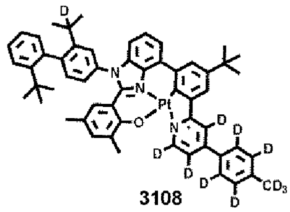
3108

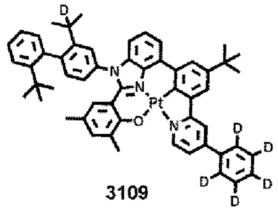
3109

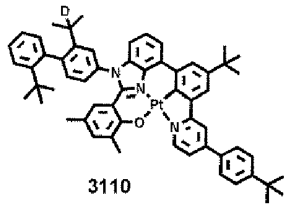
3110

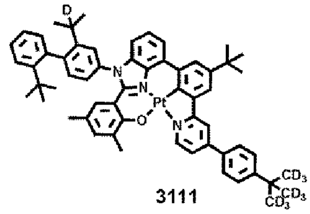
3111

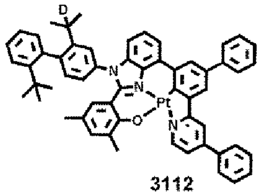
3112

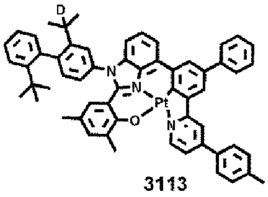
3113

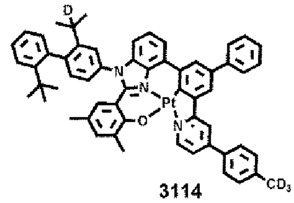
3114

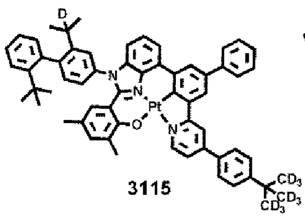
3115

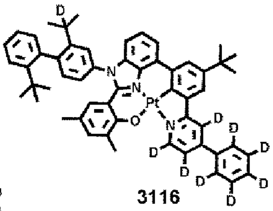
3116

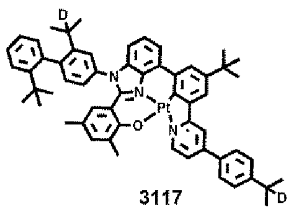
3117

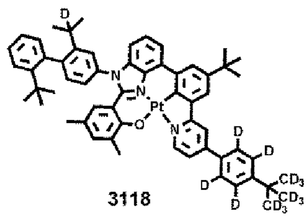
3118

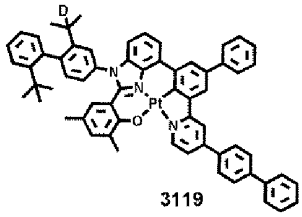
3119

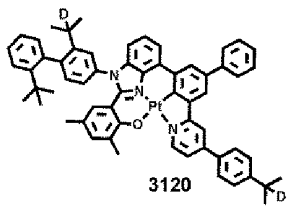
3120

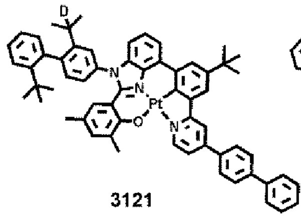
3121

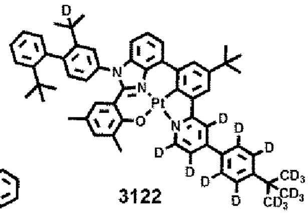
3122

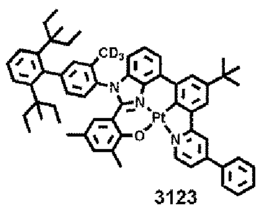
3123

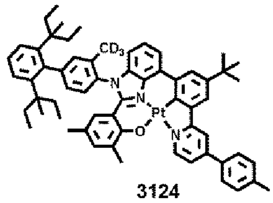
3124

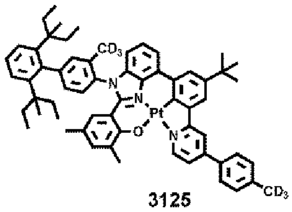
3125

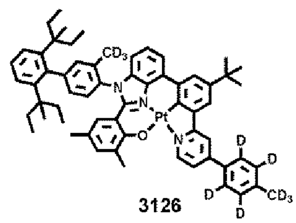
3126

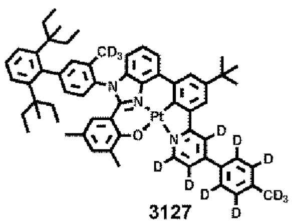
3127

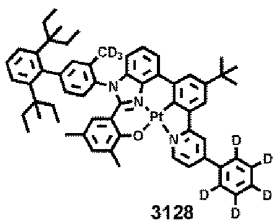
3128

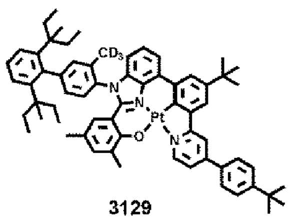
3129

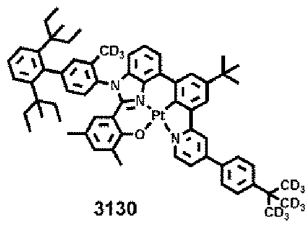
3130

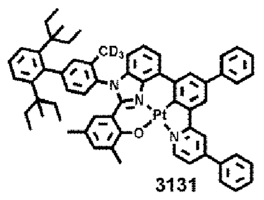
3131

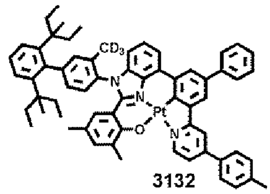
3132

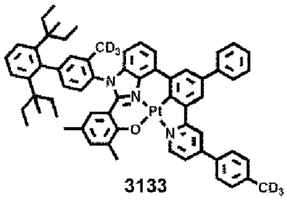
3133

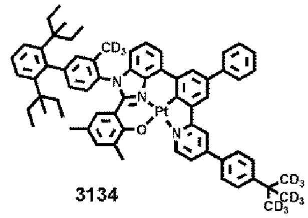
3134

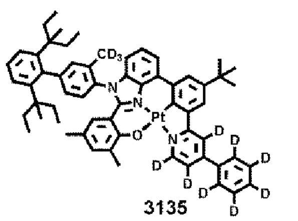
3135

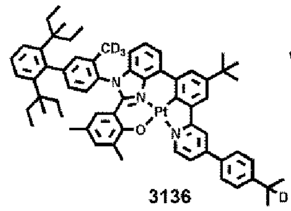
3136

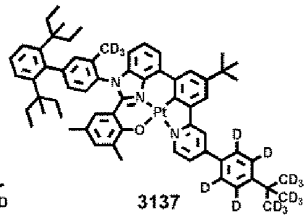
3137

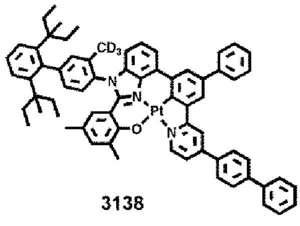
3138

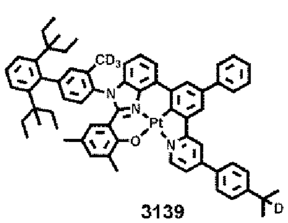
3139

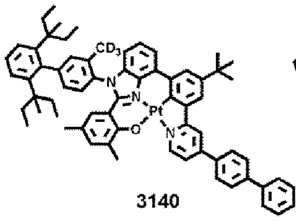
3140

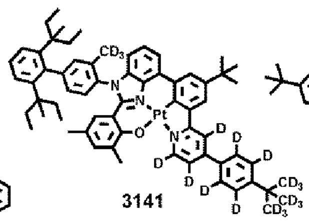
3141

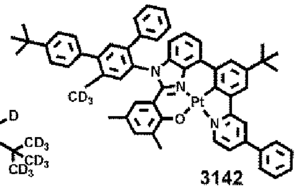
3142

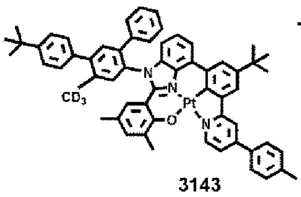
3143

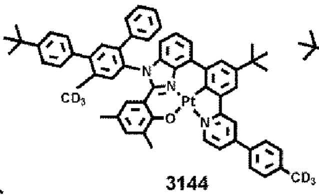
3144

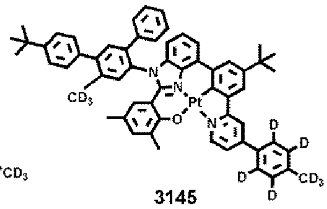
3145

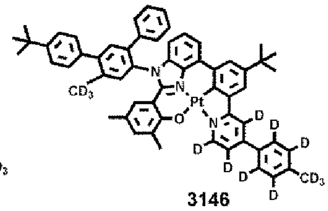
3146

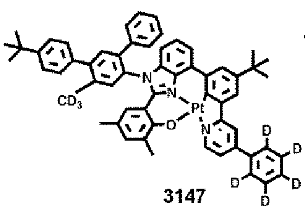
3147

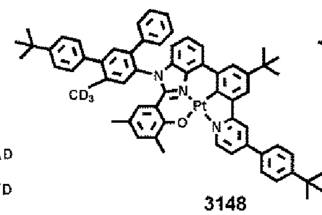
3148

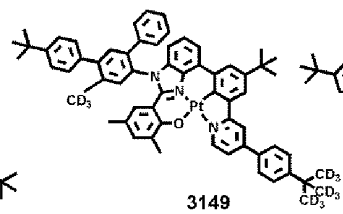
3149

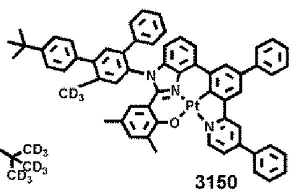
3150

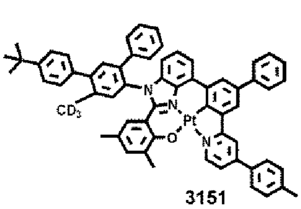
3151

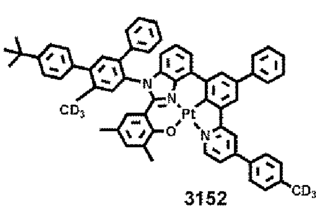
3152

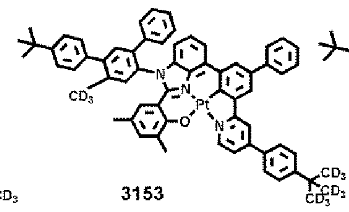
3153

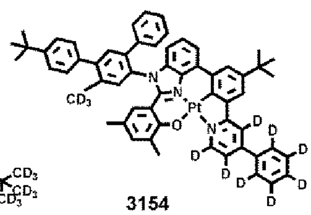
3154

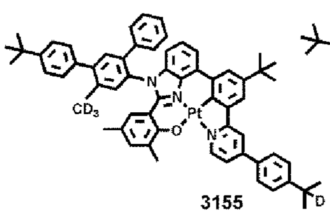
3155

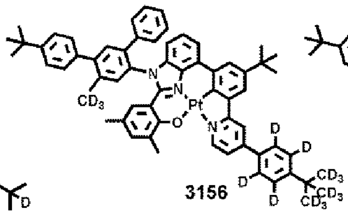
3156

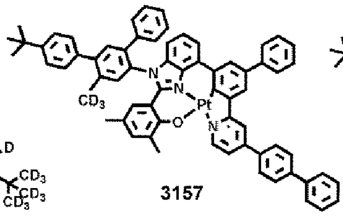
3157

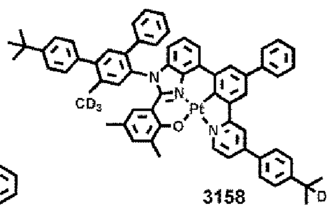
3158

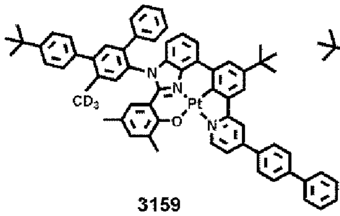
3159

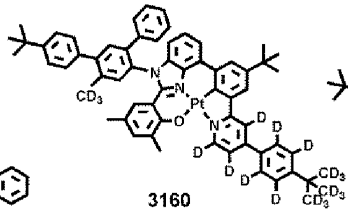
3160

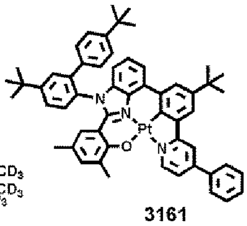
3161

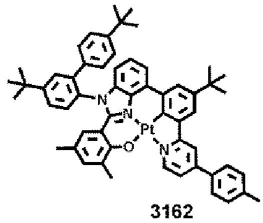
3162

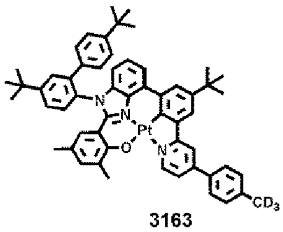
3163

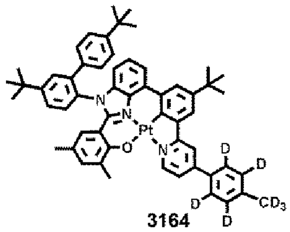
3164

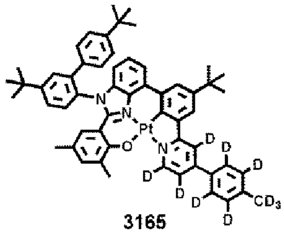
3165

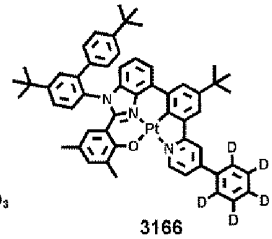
3166

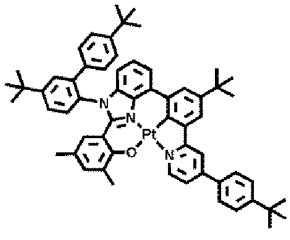
3167

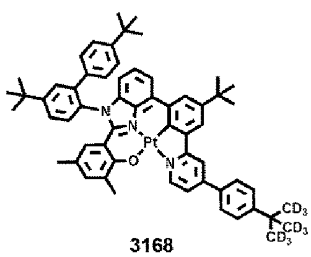
3168

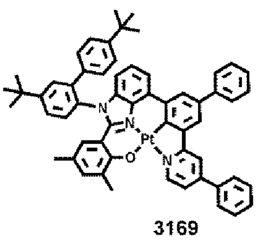
3169

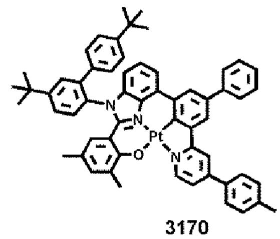
3170

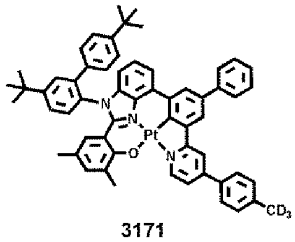
3171

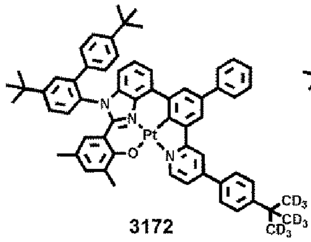
3172

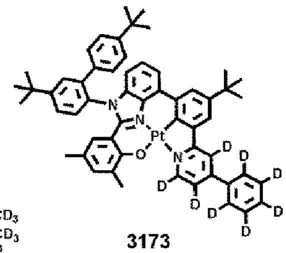
3173

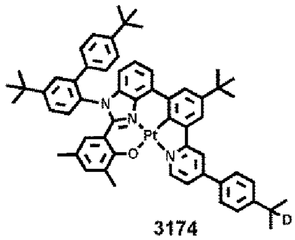
3174

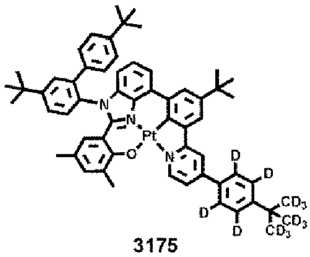
3175

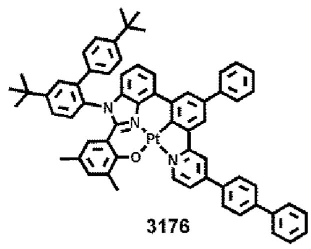
3176

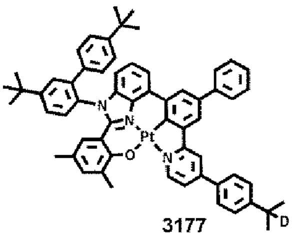
3177

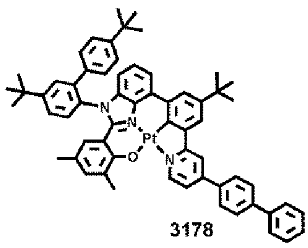
3178

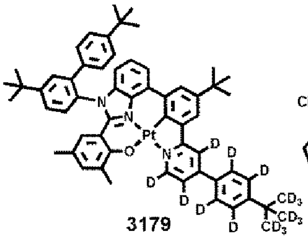

3179

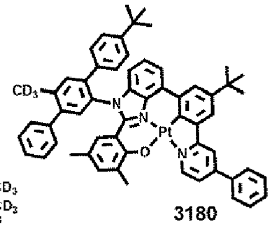

3180

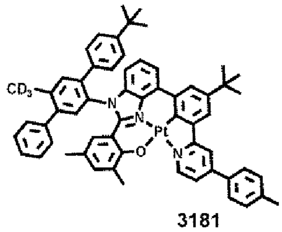

3181

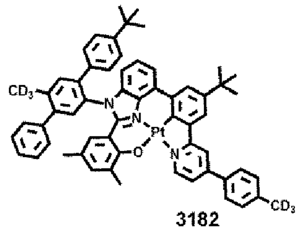

3182

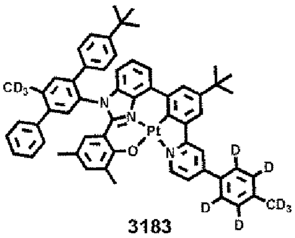

3183

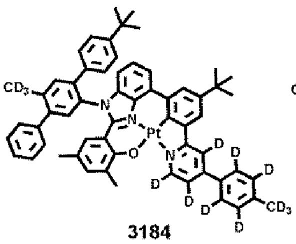

3184

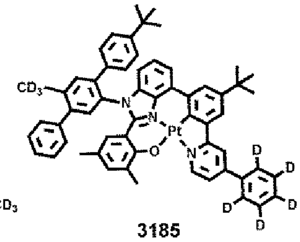

3185

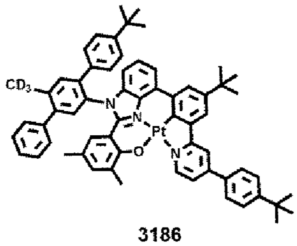

3186

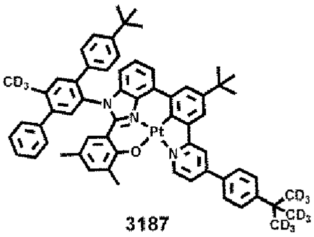

3187

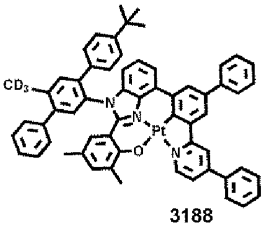

3188

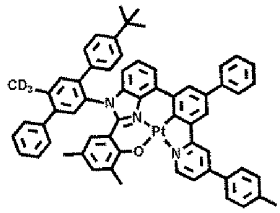

3189

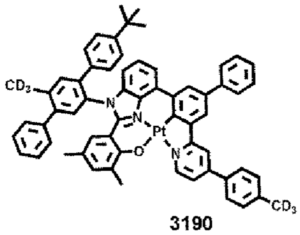

3190

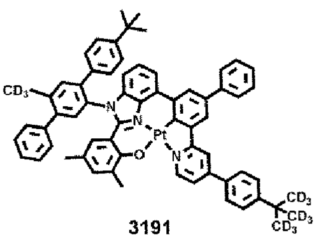

3191

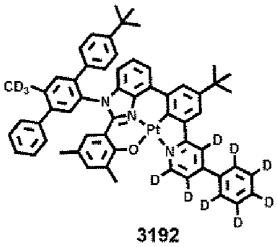

3192

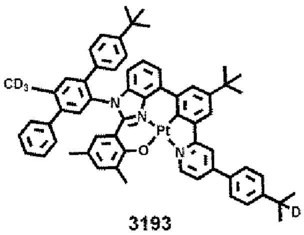

3193

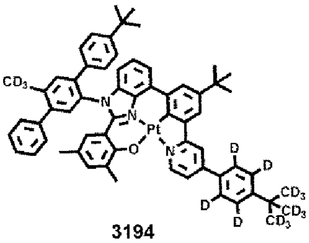

3194

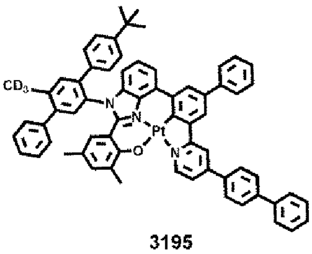

3195

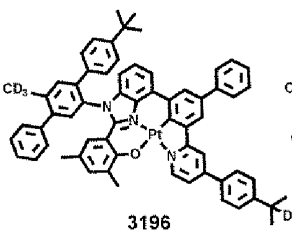

3196

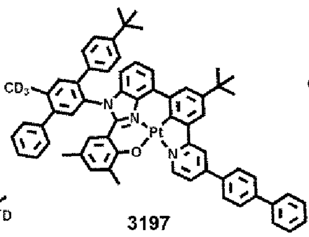

3197

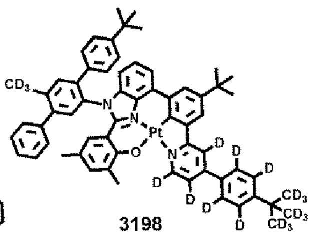

3198

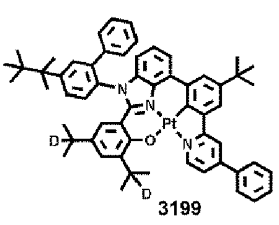
3199

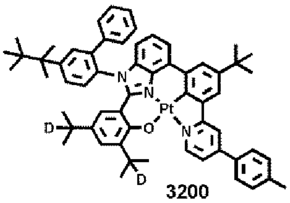
3200

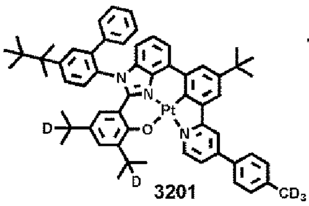
3201

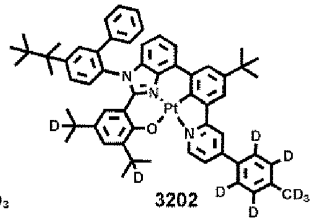
3202

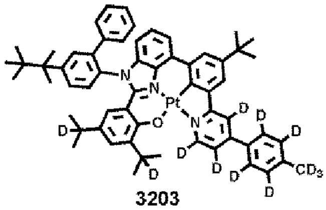
3203

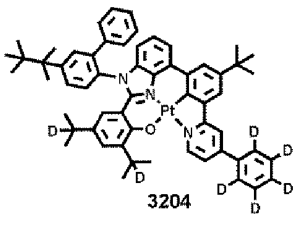
3204

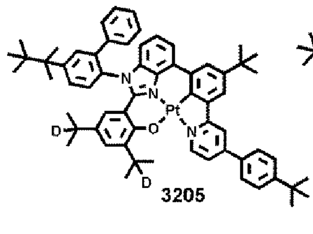
3205

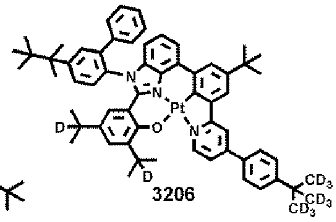
3206

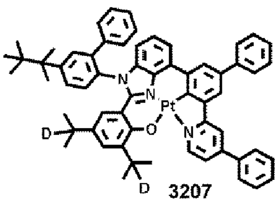
3207

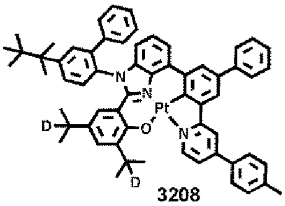
3208

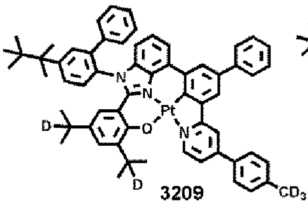
3209

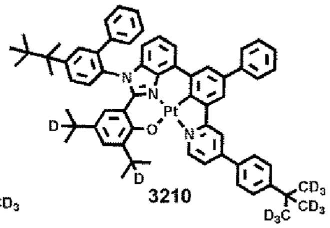
3210

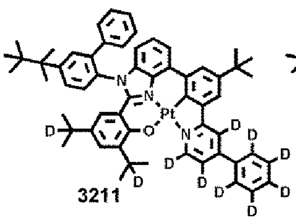
3211

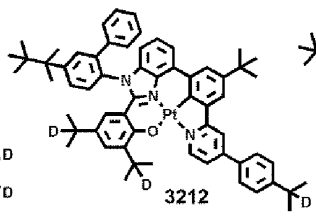
3212

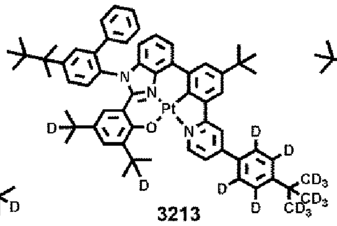
3213

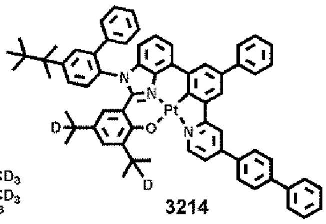
3214

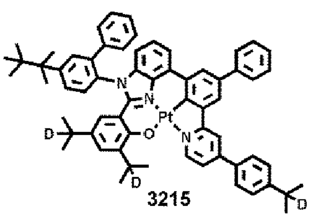
3215

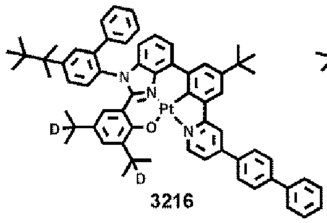
3216

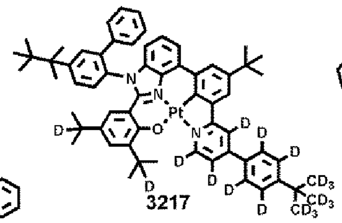
3217

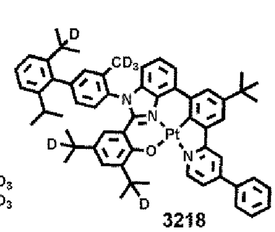
3218

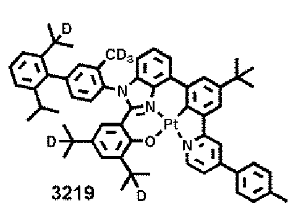
3219

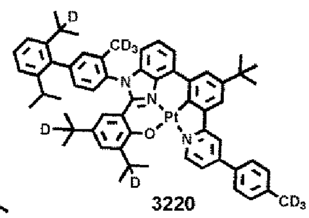
3220

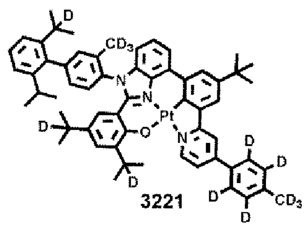
3221

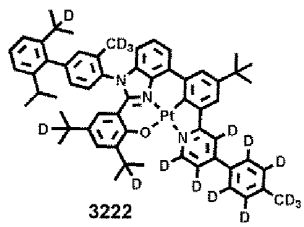
3222

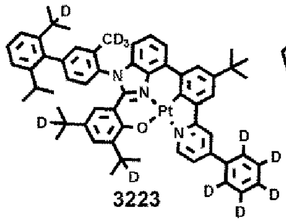

3223

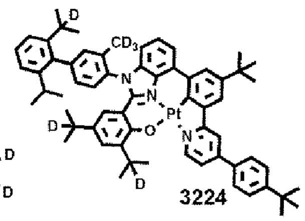

3224

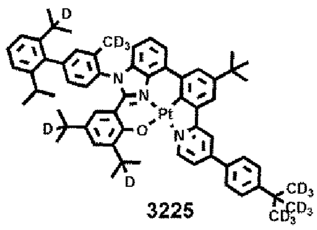

3225

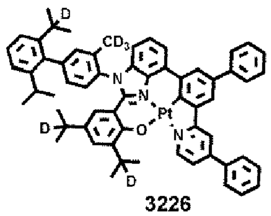

3226

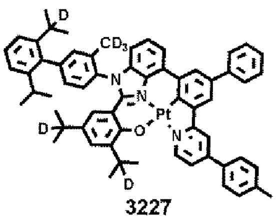

3227

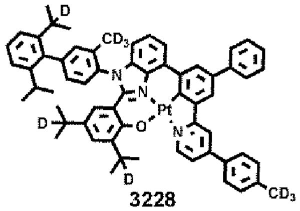

3228

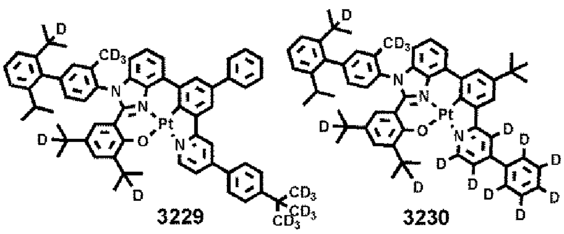

3229

3230

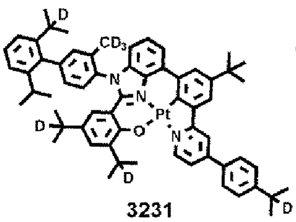

3231

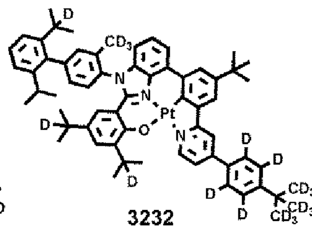

3232

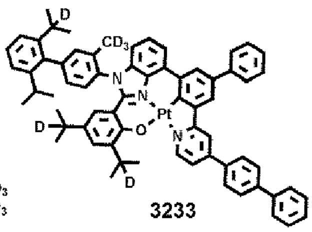

3233

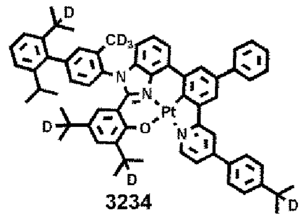

3234

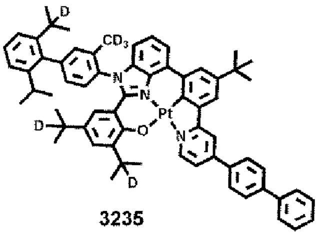

3235

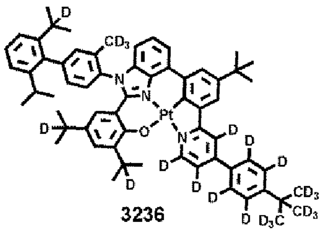

3236

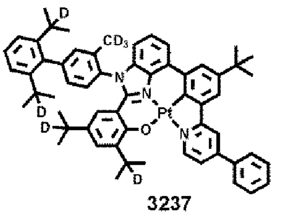

3237

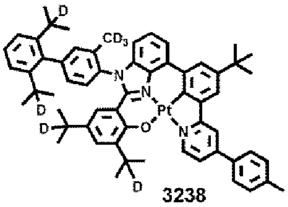

3238

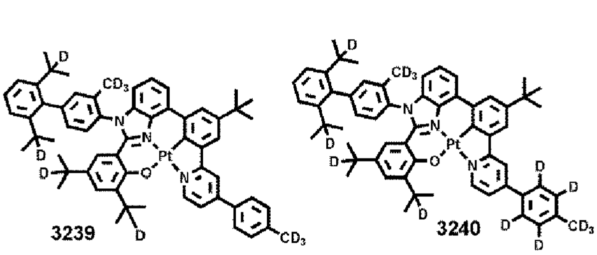

3239

3240

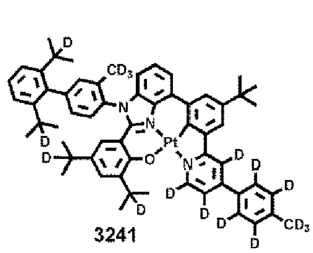

3241

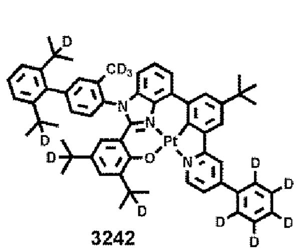

3242

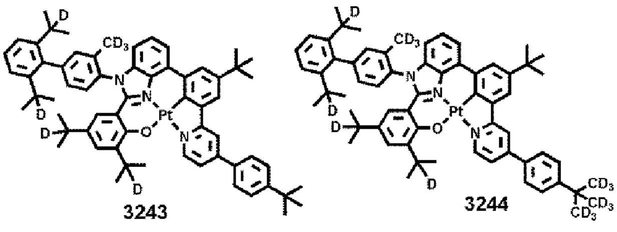

3243

3244

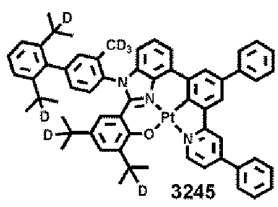

3245

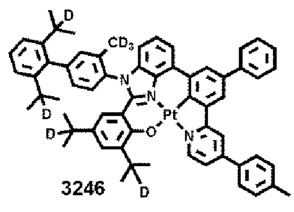

3246

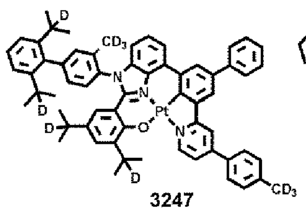
3247

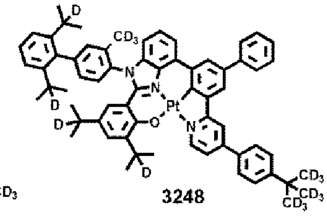
3248

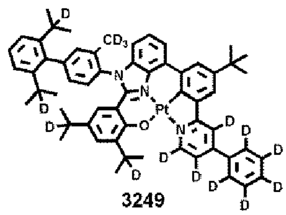
3249

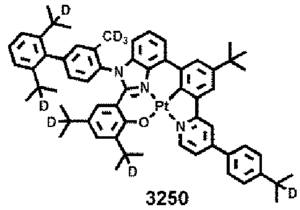
3250

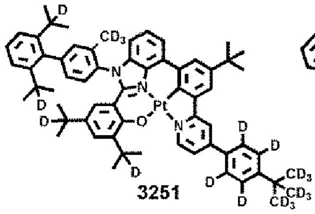
3251

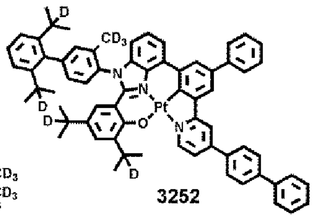
3252

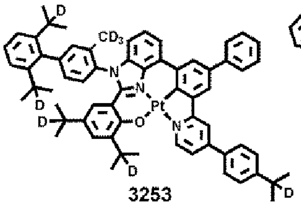
3253

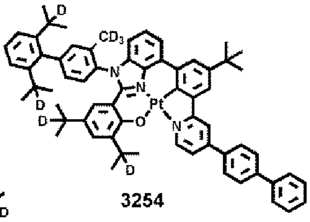
3254

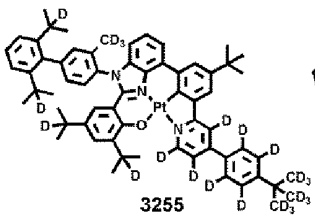
3255

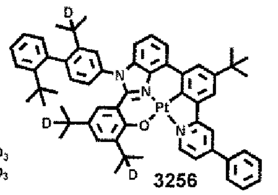
3256

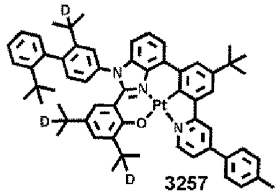
3257

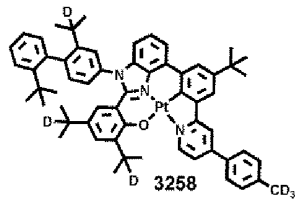
3258

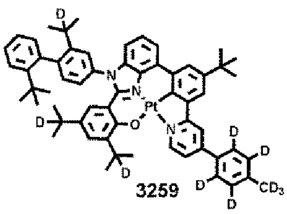
3259

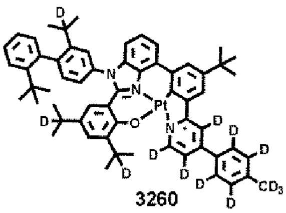
3260

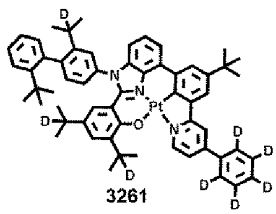
3261

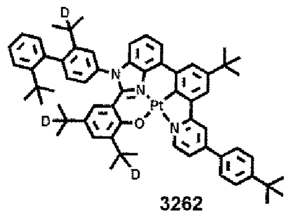
3262

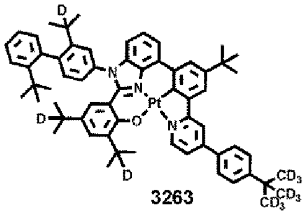
3263

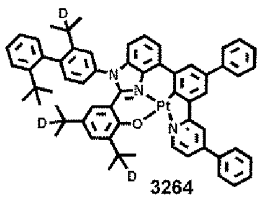
3264

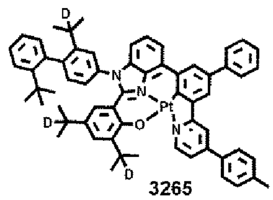
3265

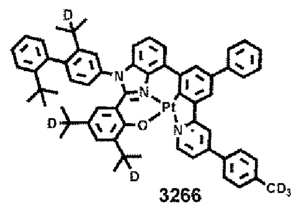
3266

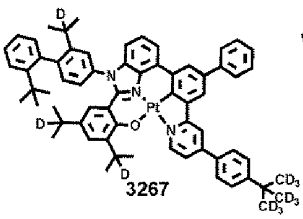
3267

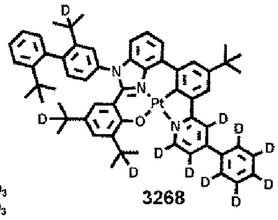
3268

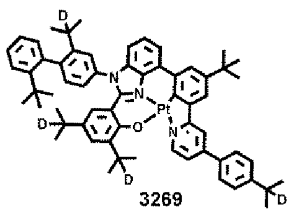
3269

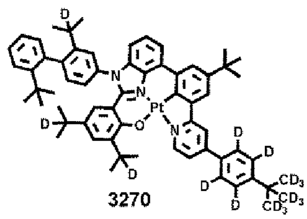
3270

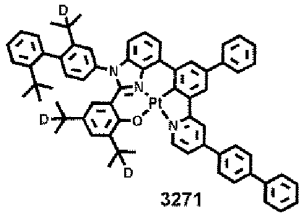
3271

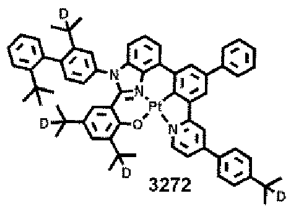
3272

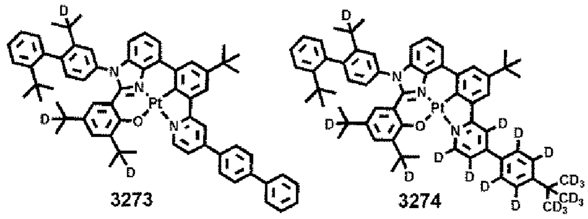
3273

3274

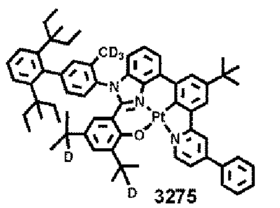
3275

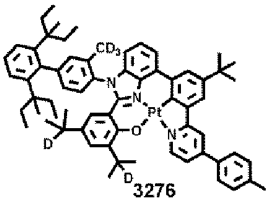
3276

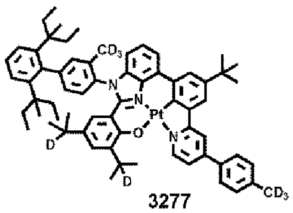
3277

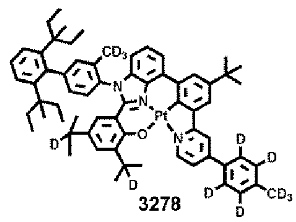
3278

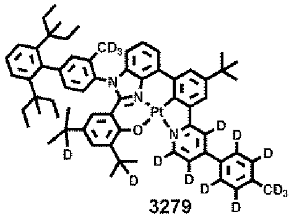
3279

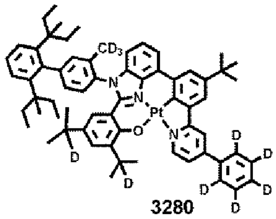
3280

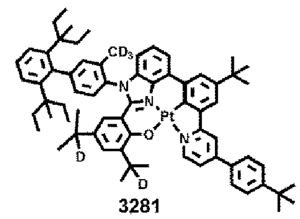
3281

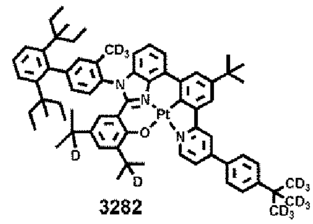
3282

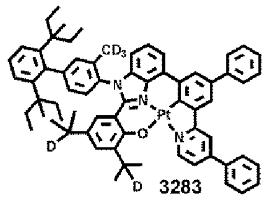
3283

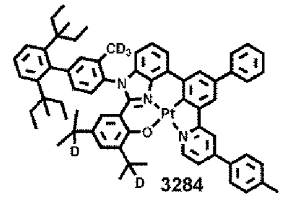
3284

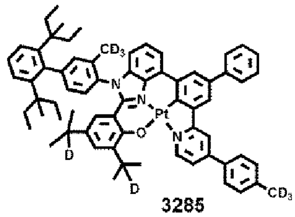
3285

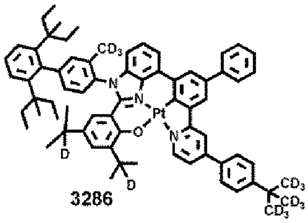
3286

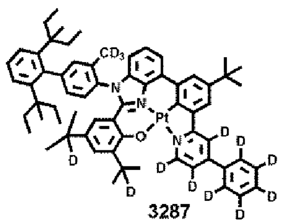
3287

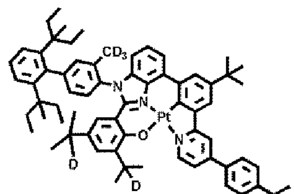
3288

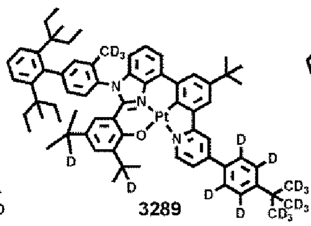
3289

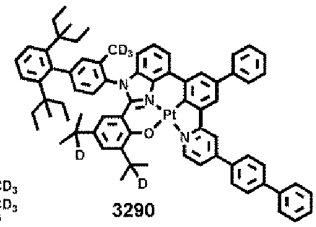
3290

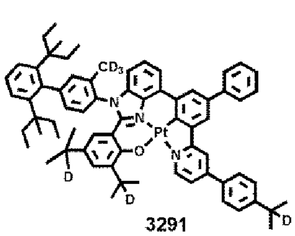
3291

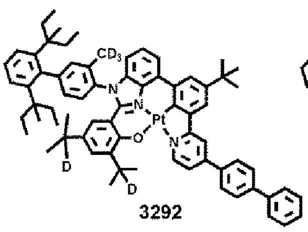
3292

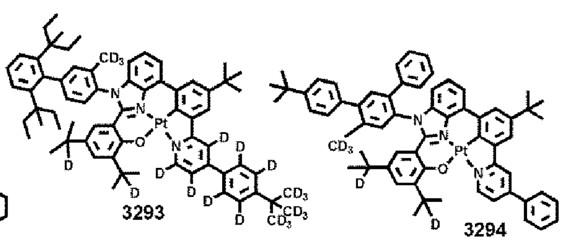
3293

3294

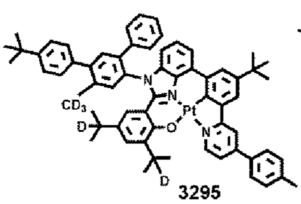
3295

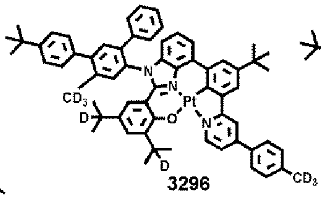
3296

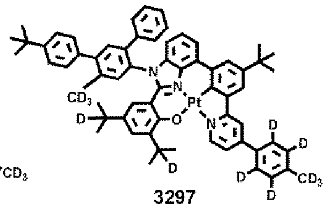
3297

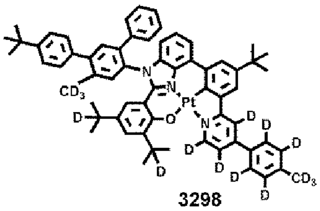
3298

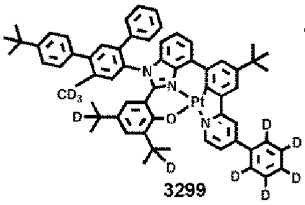
3299

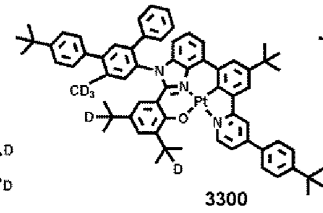
3300

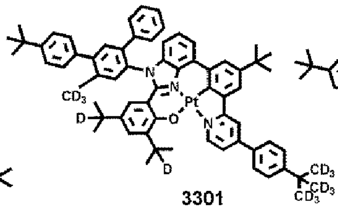
3301

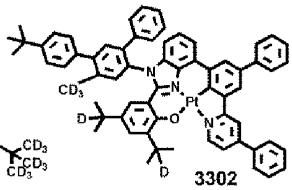
3302

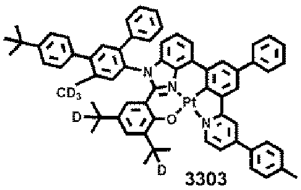
3303

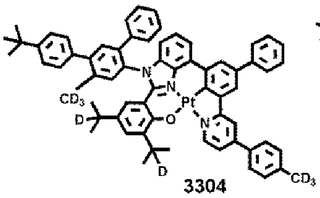
3304

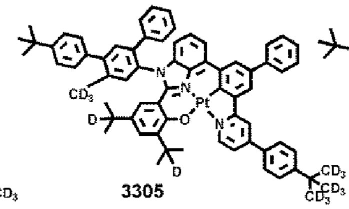
3305

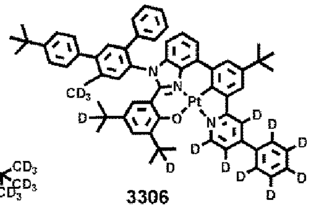
3306

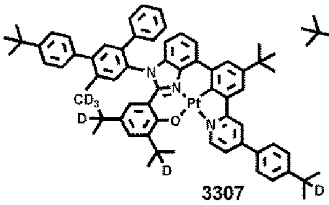
3307

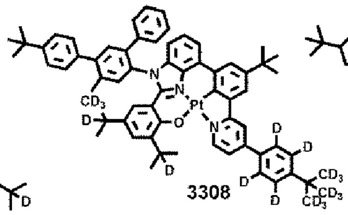
3308

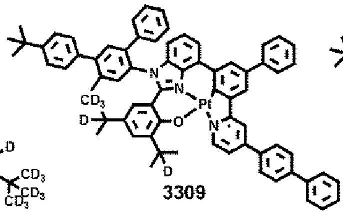
3309

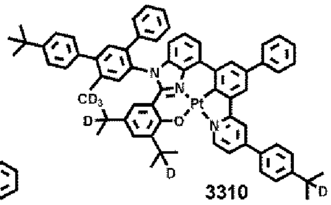
3310

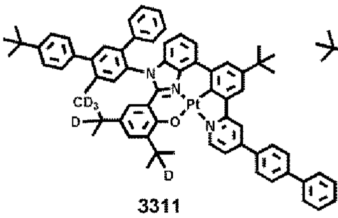
3311

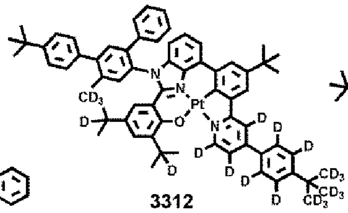
3312

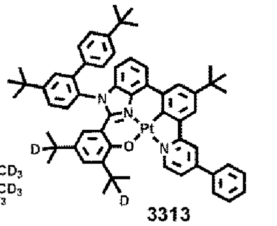
3313

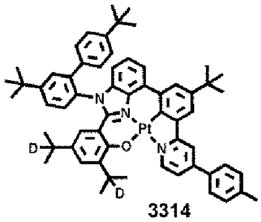
3314

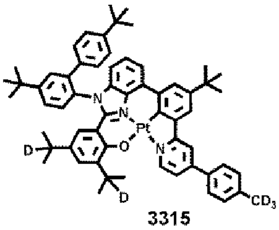
3315

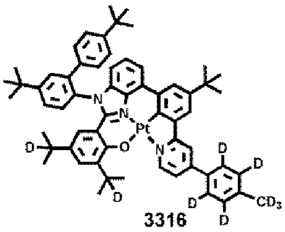
3316

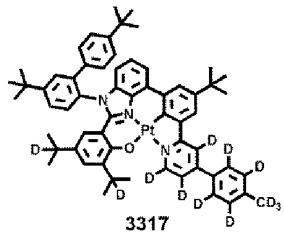
3317

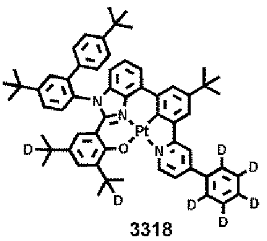
3318

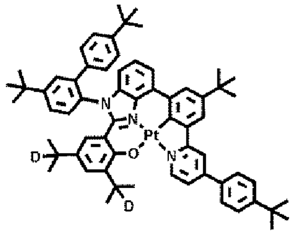
3319

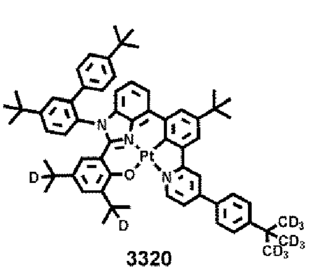
3320

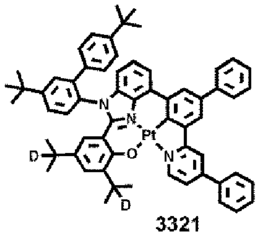
3321

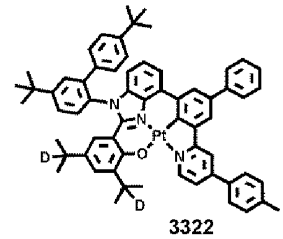
3322

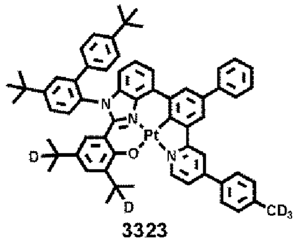
3323

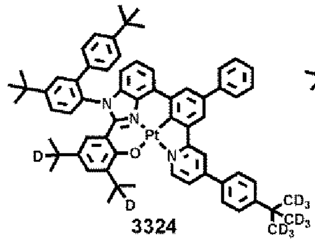
3324

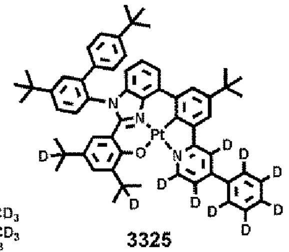
3325

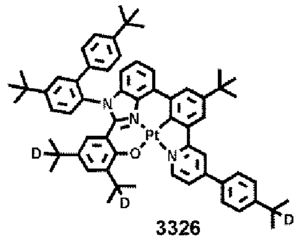
3326

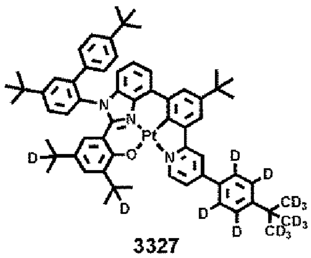
3327

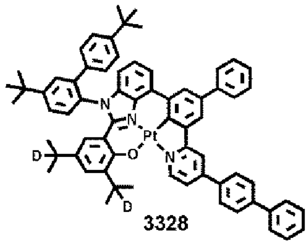
3328

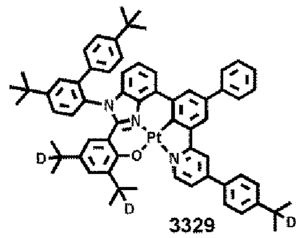
3329

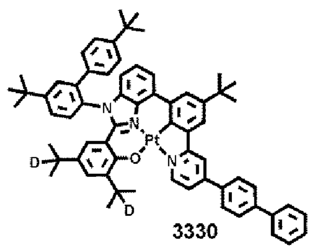
3330

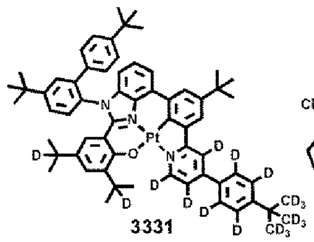
3331

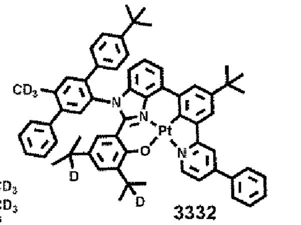
3332

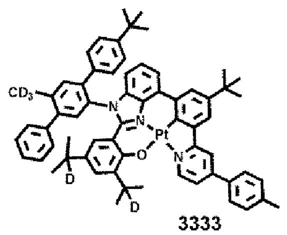
3333

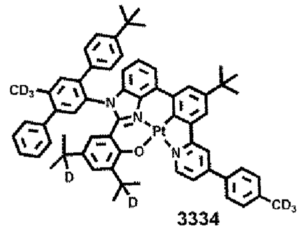
3334

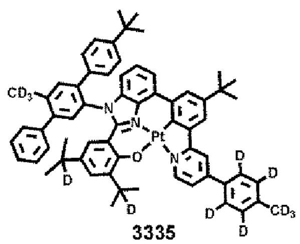
3335

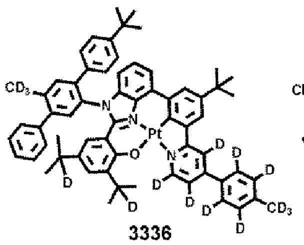
3336

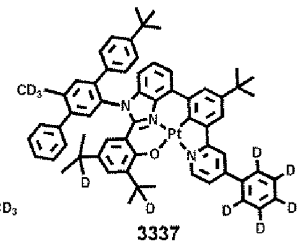
3337

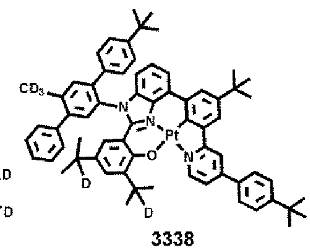
3338

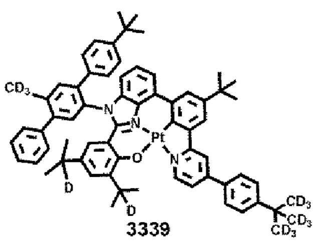
3339

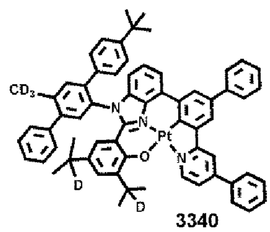
3340

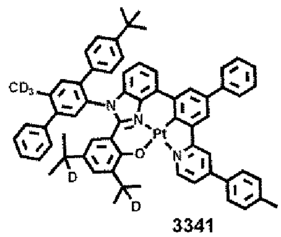
3341

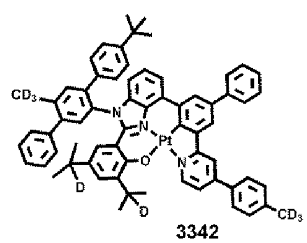
3342

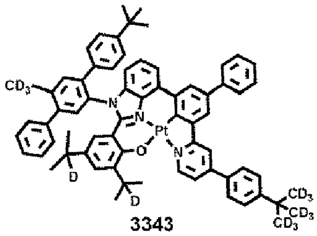
3343

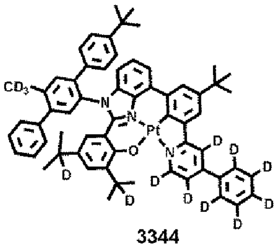
3344

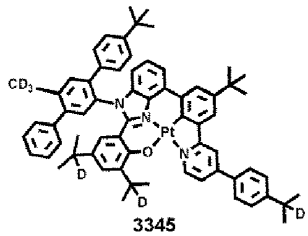
3345

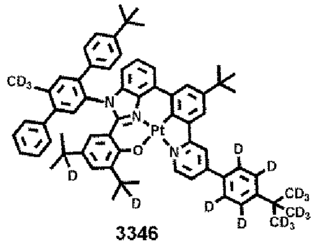
3346

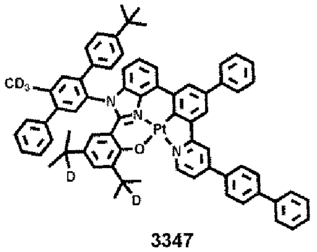
3347

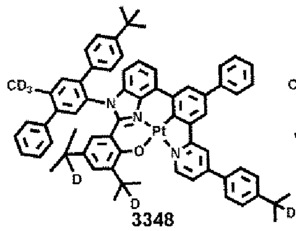
3348

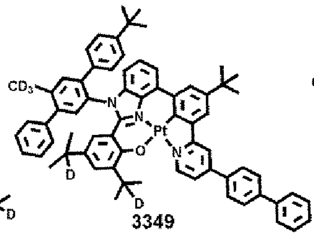
3349

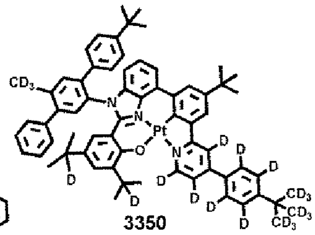
3350

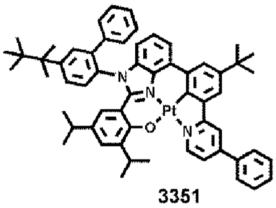
3351

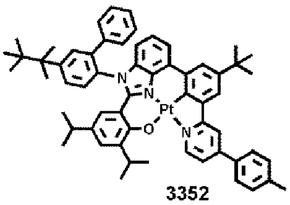
3352

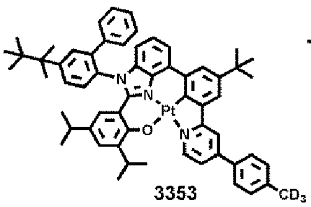
3353

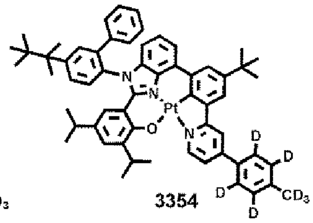
3354

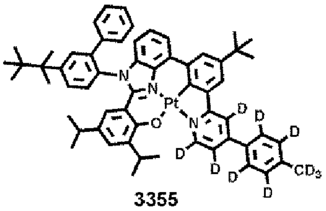
3355

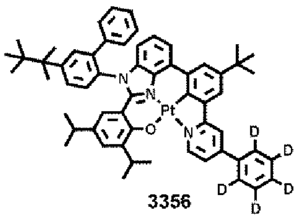
3356

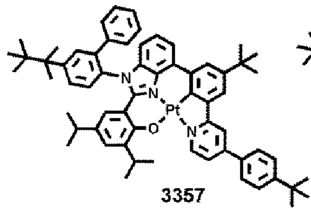
3357

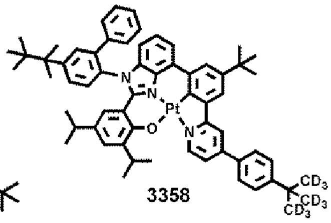
3358

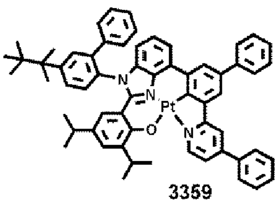
3359

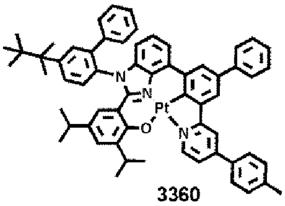
3360

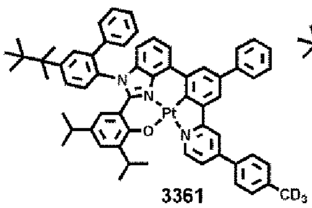
3361

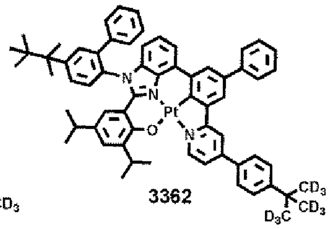
3362

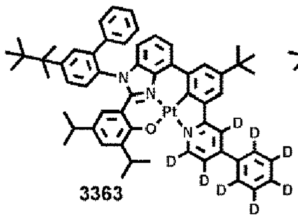
3363

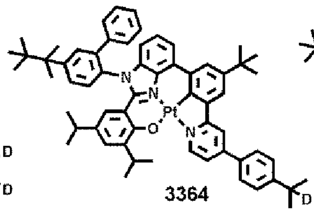
3364

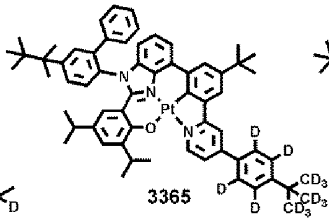
3365

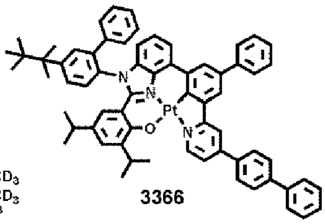
3366

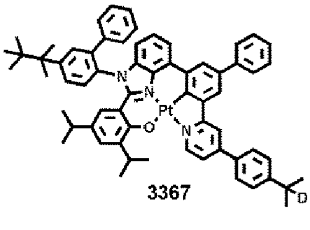
3367

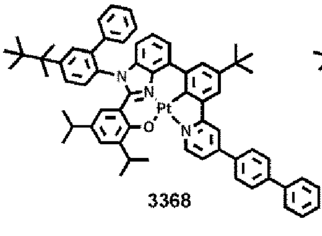
3368

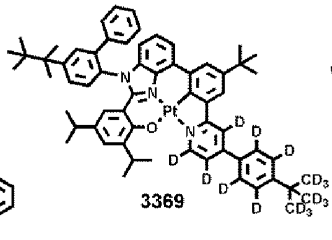
3369

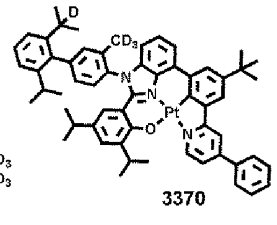
3370

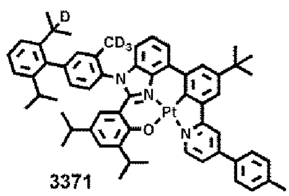
3371

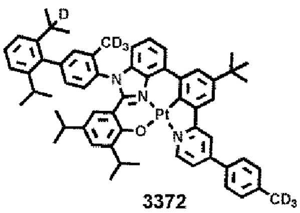
3372

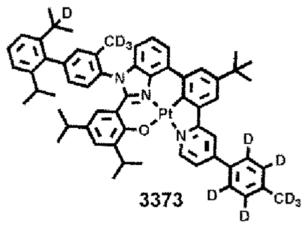
3373

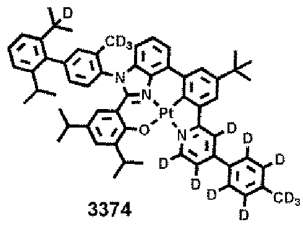
3374

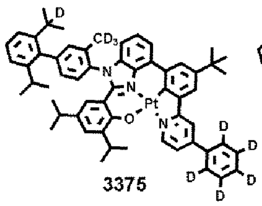
3375

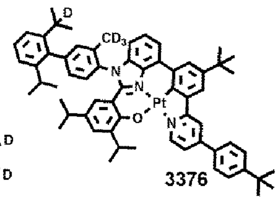
3376

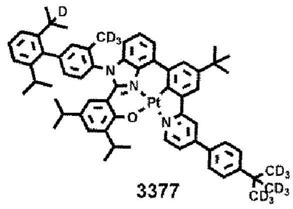
3377

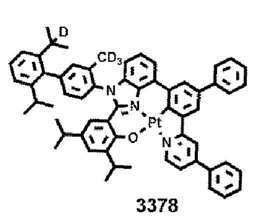
3378

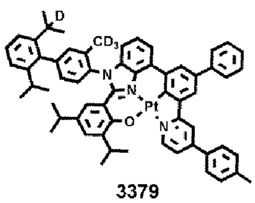
3379

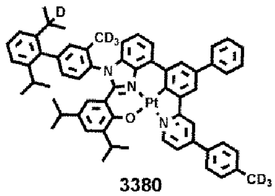
3380

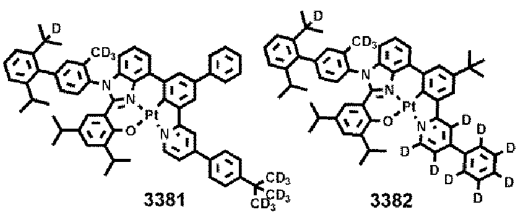
3381

3382

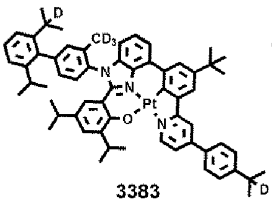
3383

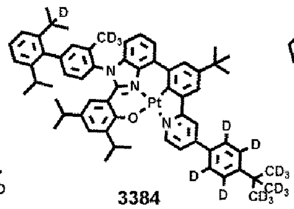
3384

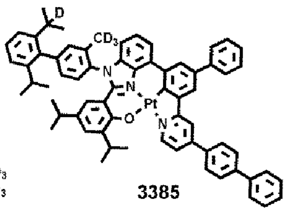
3385

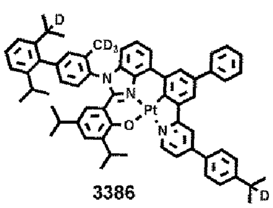
3386

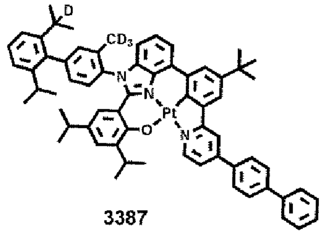

3387

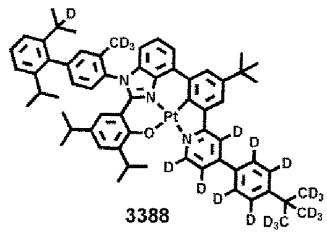

3388

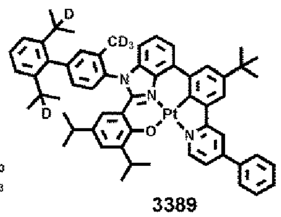

3389

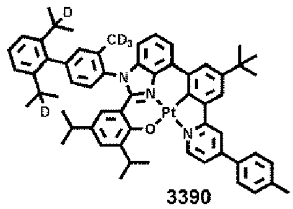

3390

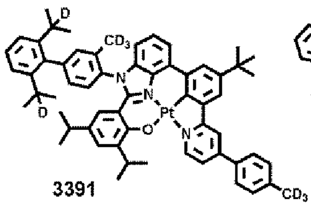

3391

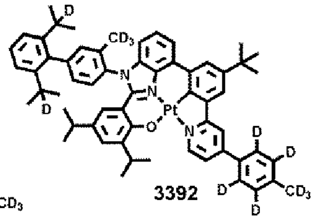

3392

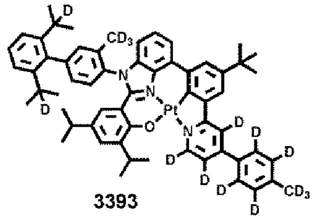

3393

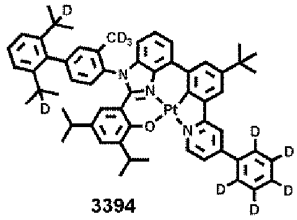

3394

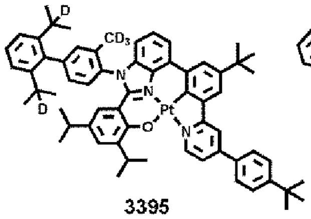

3395

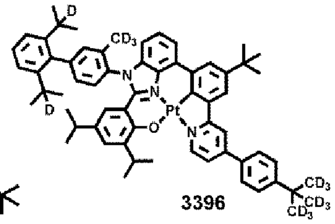

3396

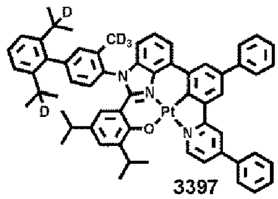

3397

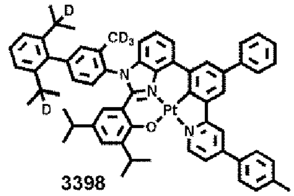

3398

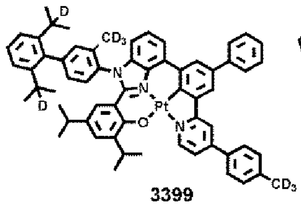

3399

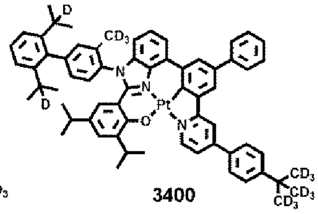

3400

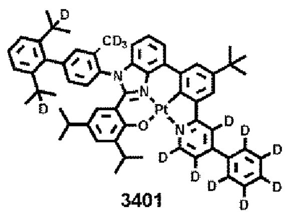

3401

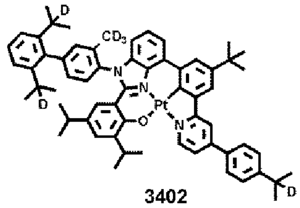

3402

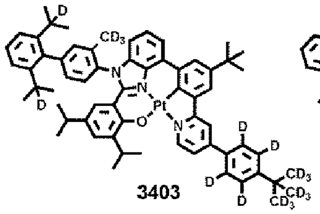

3403

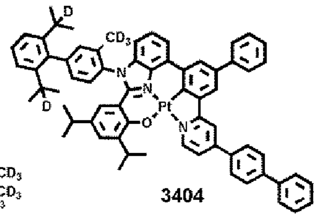

3404

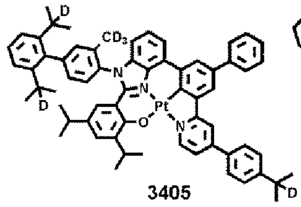

3405

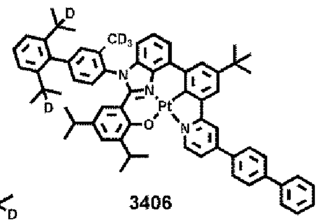

3406

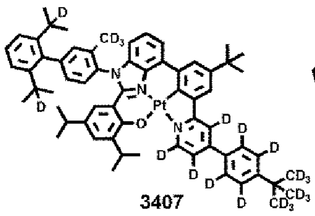

3407

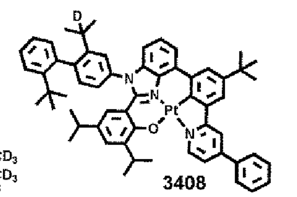

3408

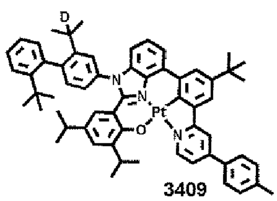

3409

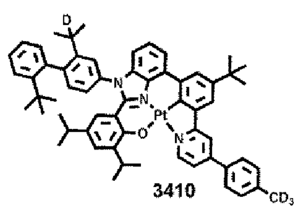

3410

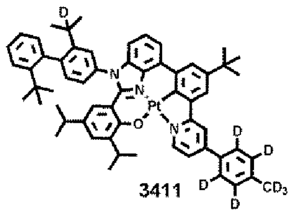
3411
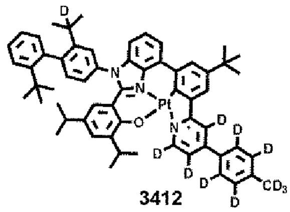
3412
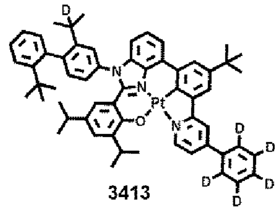
3413
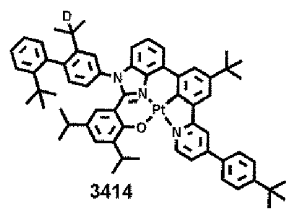
3414

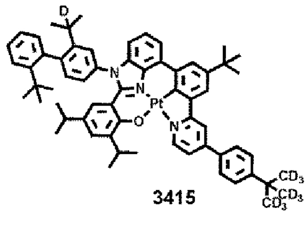
3415
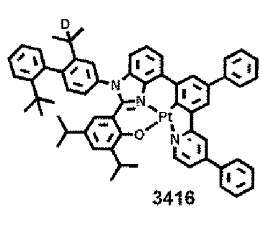
3416
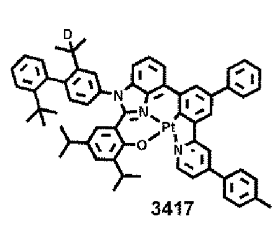
3417
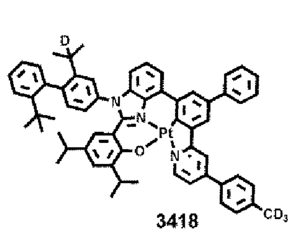
3418

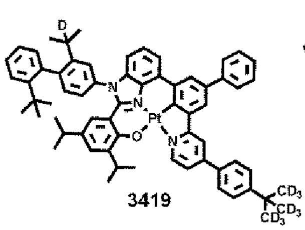
3419
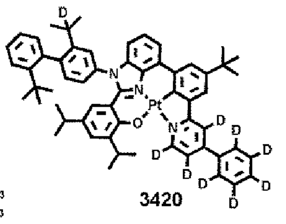
3420
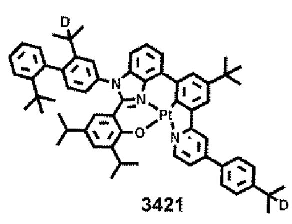
3421
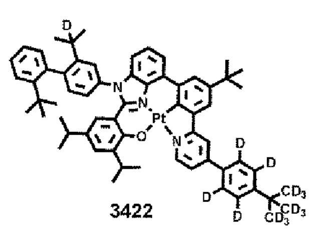
3422

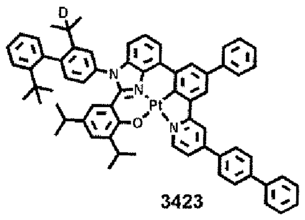
3423
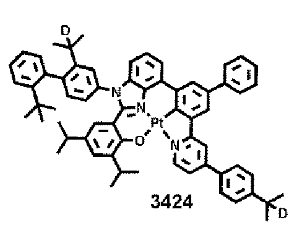
3424
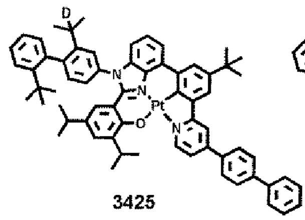
3425
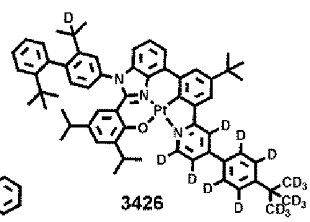
3426

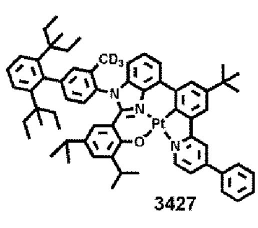
3427
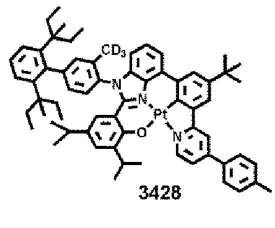
3428
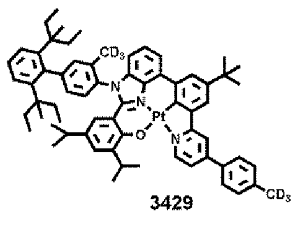
3429
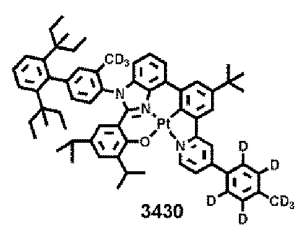
3430

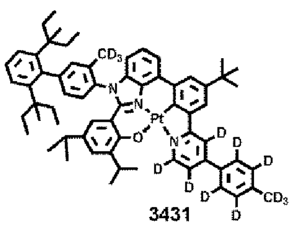
3431
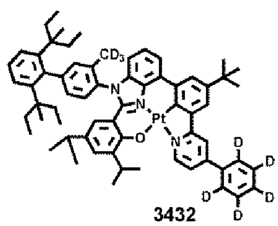
3432
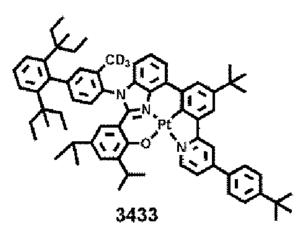
3433
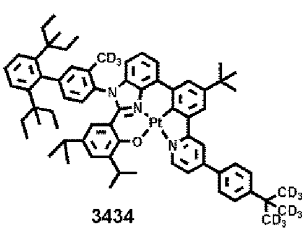
3434

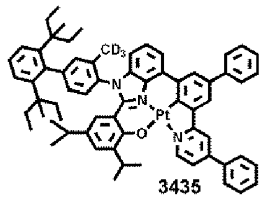
3435

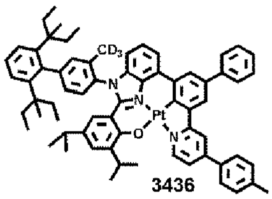
3436

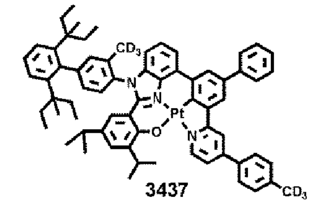
3437

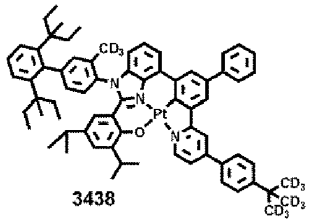
3438

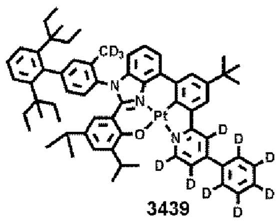
3439

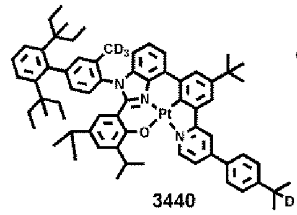
3440

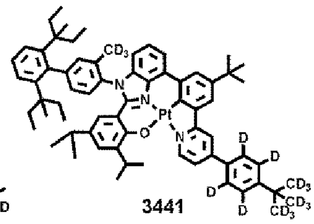
3441

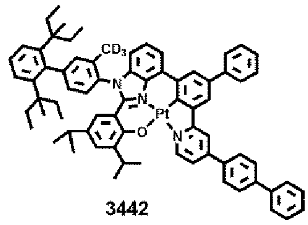
3442

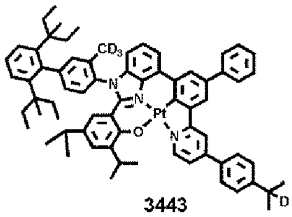
3443

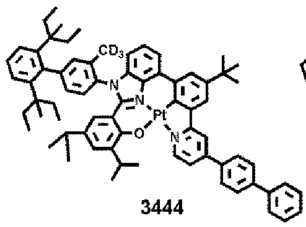
3444

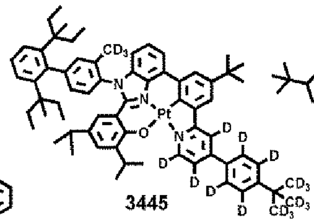
3445

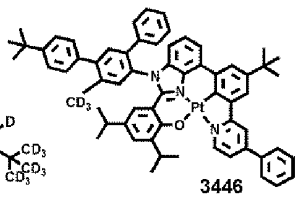
3446

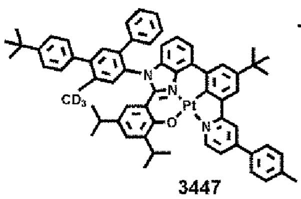
3447

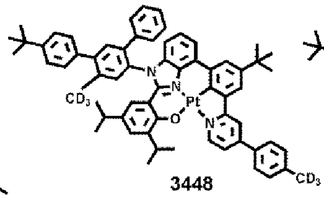
3448

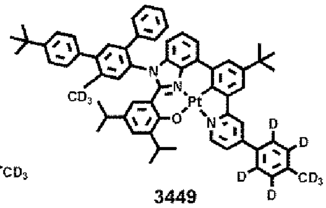
3449

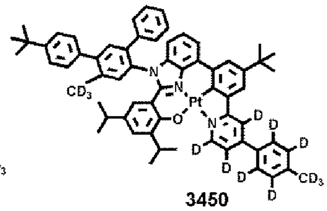
3450

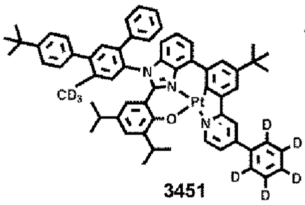
3451

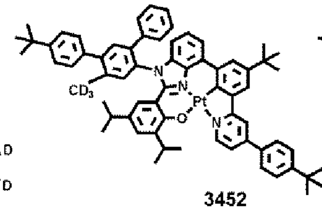
3452

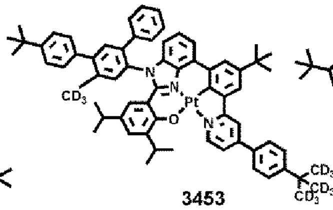
3453

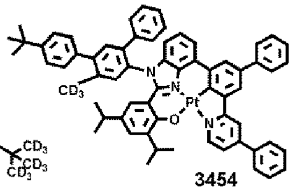
3454

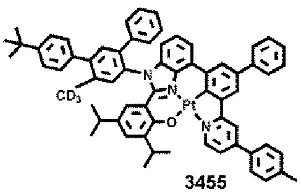
3455

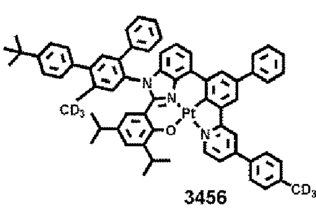
3456

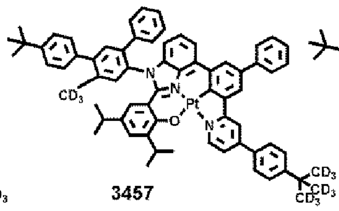
3457

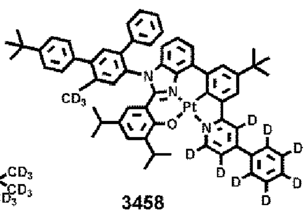
3458

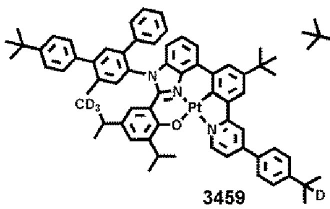
3459

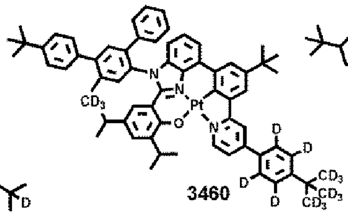
3460

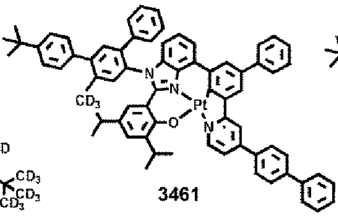
3461

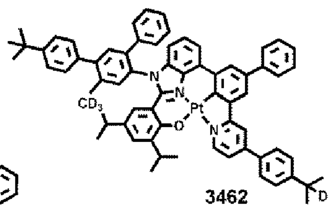
3462

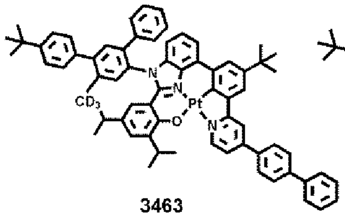
3463

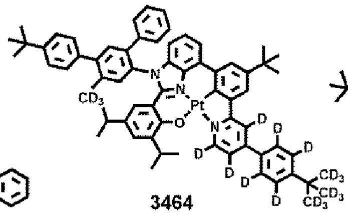
3464

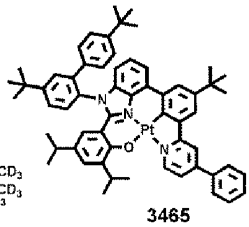
3465

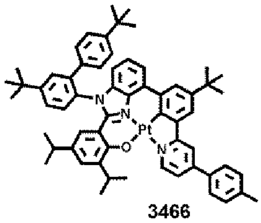
3466

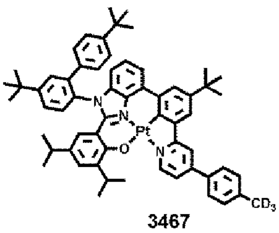
3467

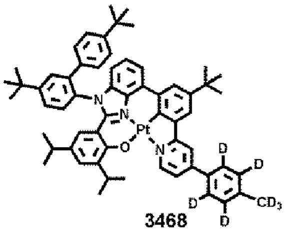
3468

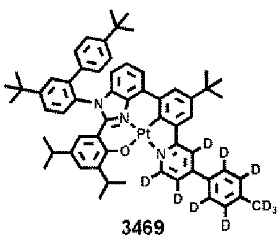
3469

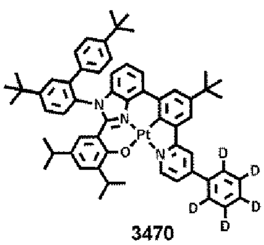
3470

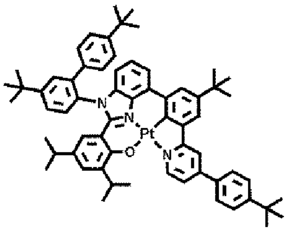
3471

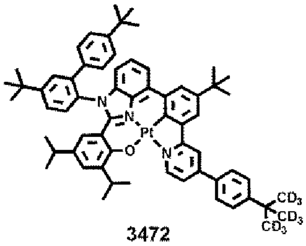
3472

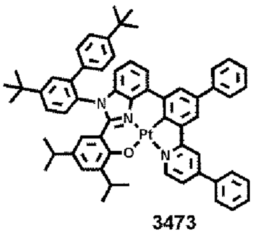
3473

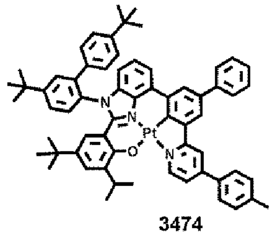
3474

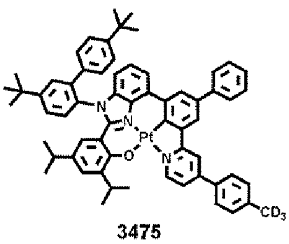
3475

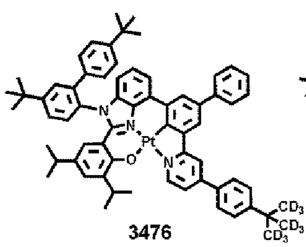
3476

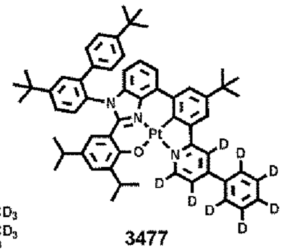
3477

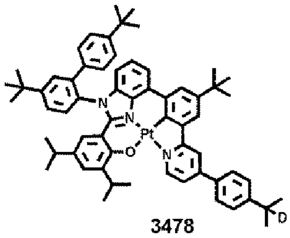
3478

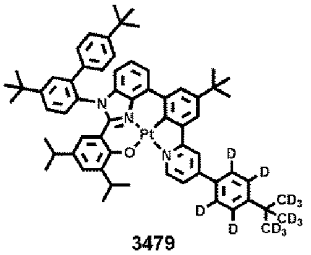
3479

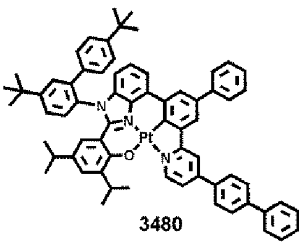
3480

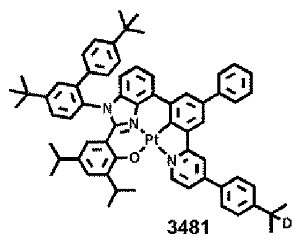
3481

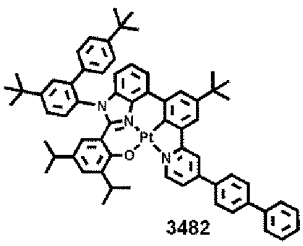
3482

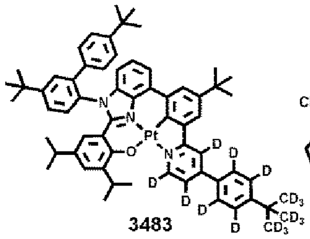
3483

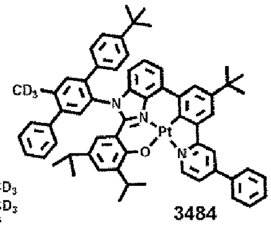
3484

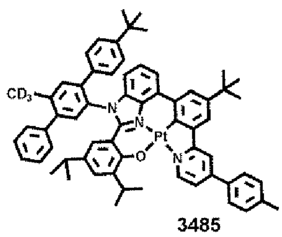
3485

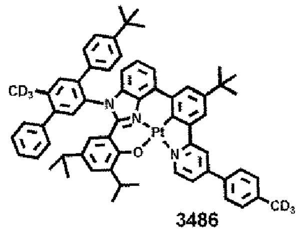
3486

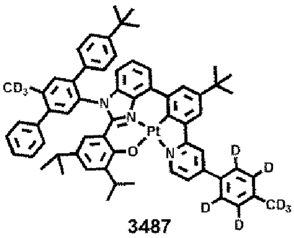
3487

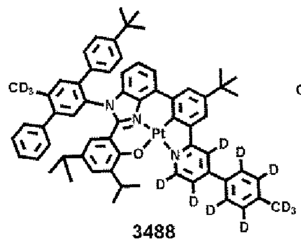
3488

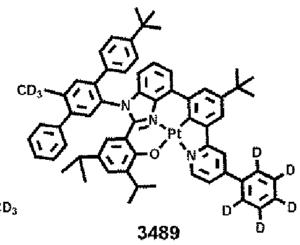
3489

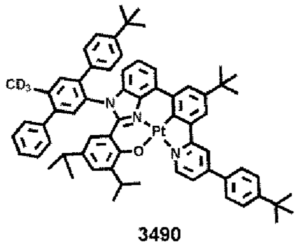
3490

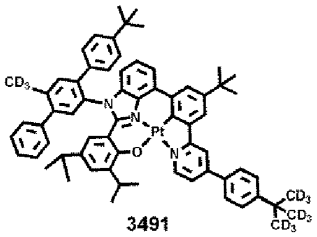
3491

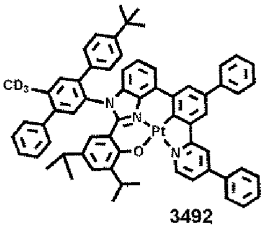
3492

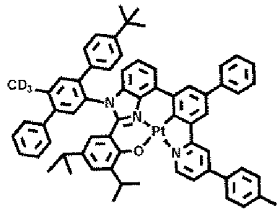
3493

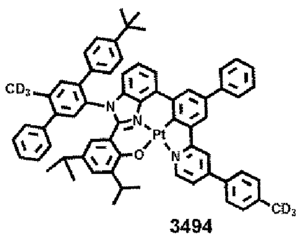
3494

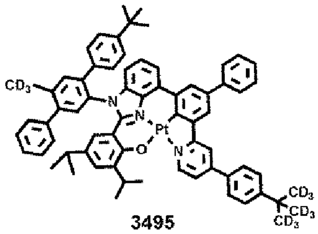
3495

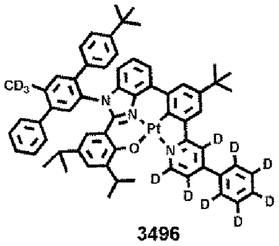
3496

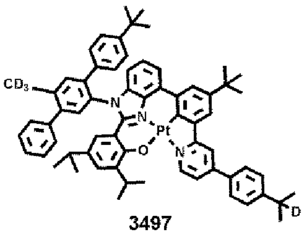
3497

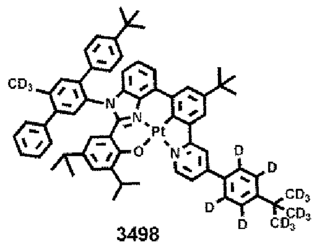
3498

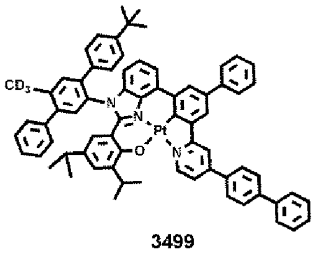
3499

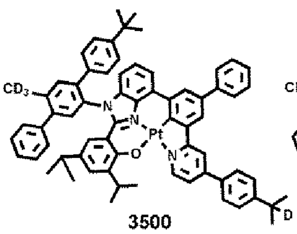
3500

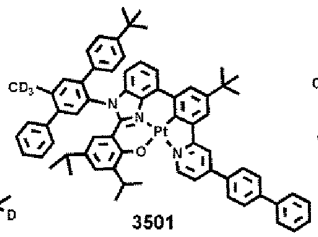
3501

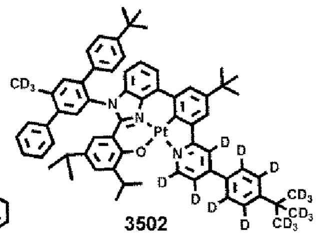
3502

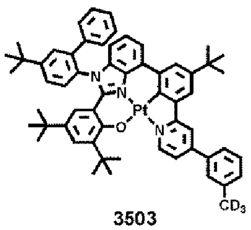

3503

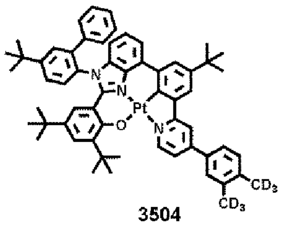

3504

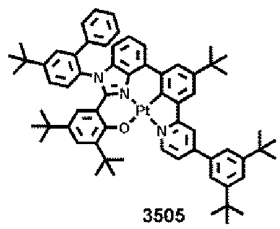

3505

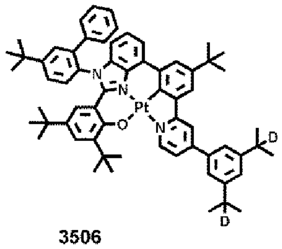

3506

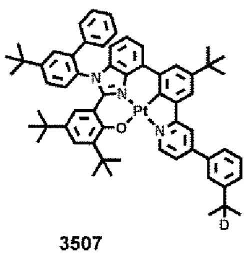

3507

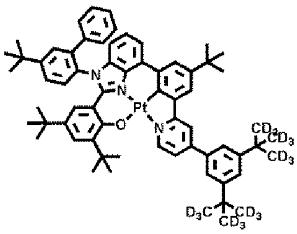

3508

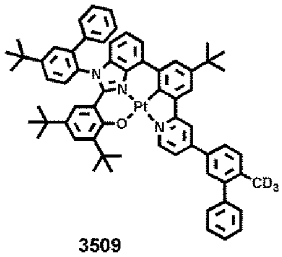

3509

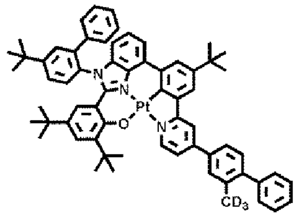

3510

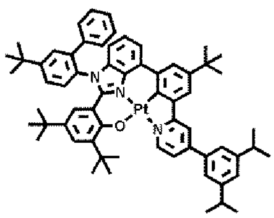

3511

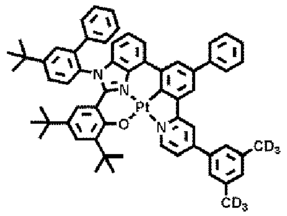

3512

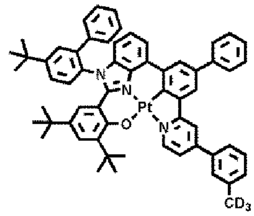

3513

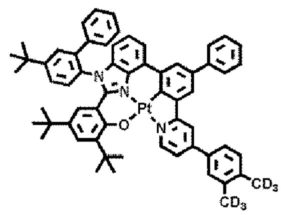

3514

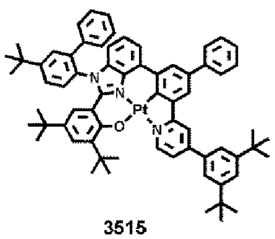

3515

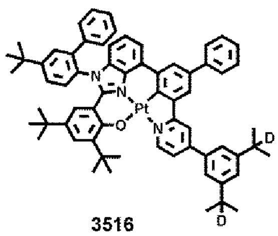

3516

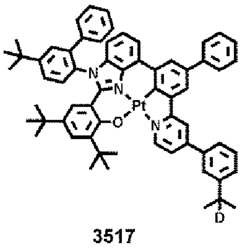

3517

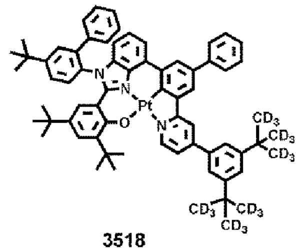

3518

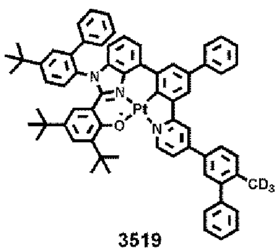

3519

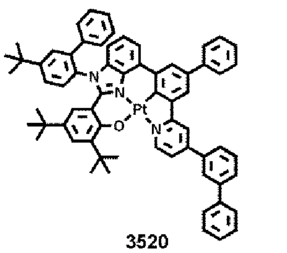

3520

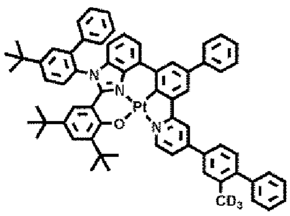

3521

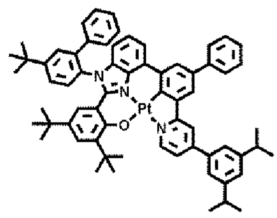

3522

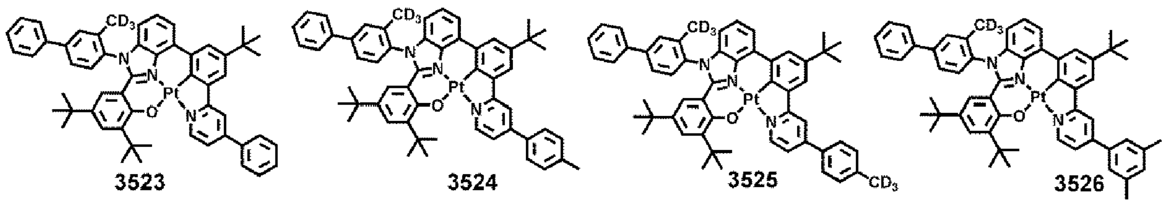

3523 3524 3525 3526

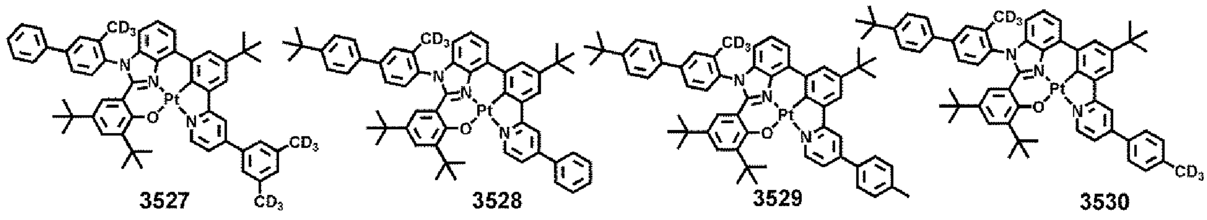

3527 3528 3529 3530

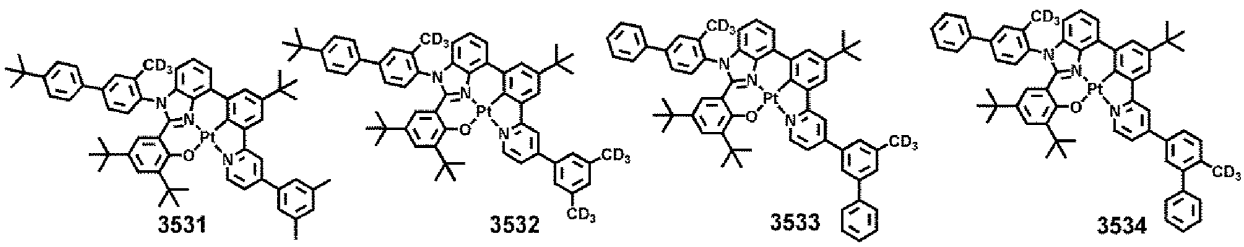

3531 3532 3533 3534

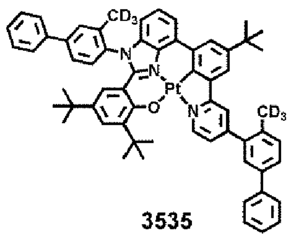

3535

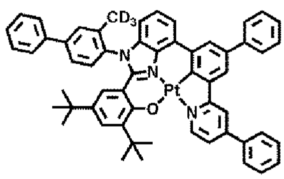

3536

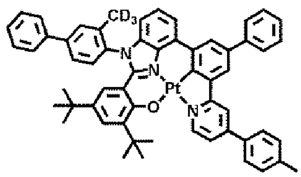

3537

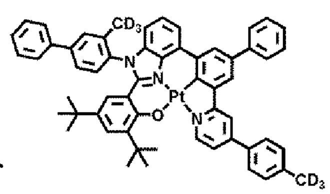

3538

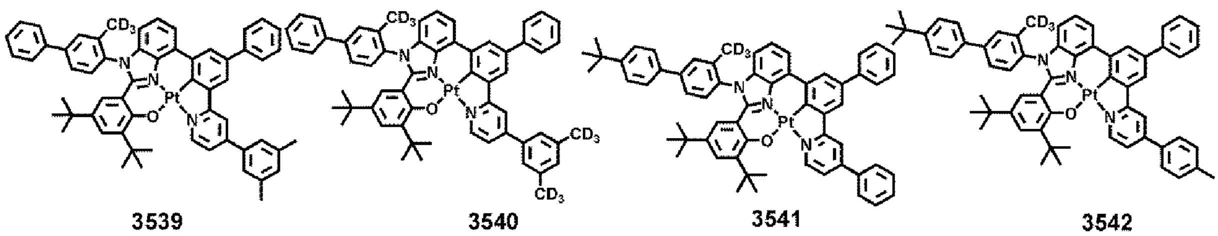

3539 3540 3541 3542

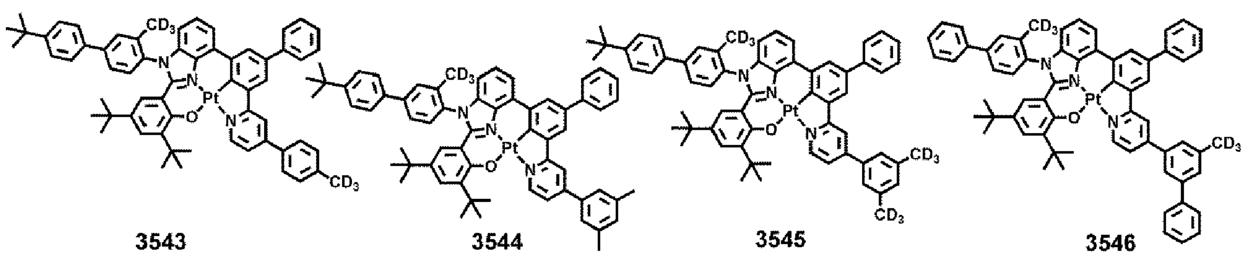

3543 3544 3545 3546

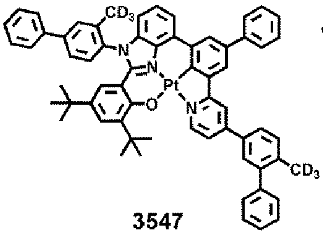
3547

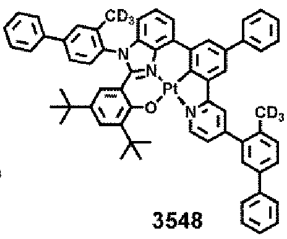
3548

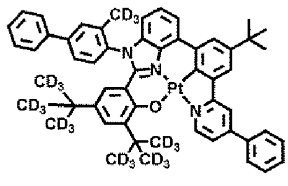
3549

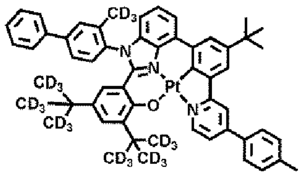
3550

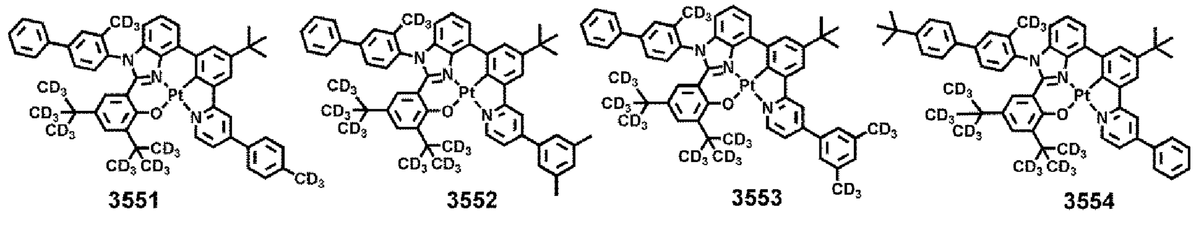
3551

3552

3553

3554

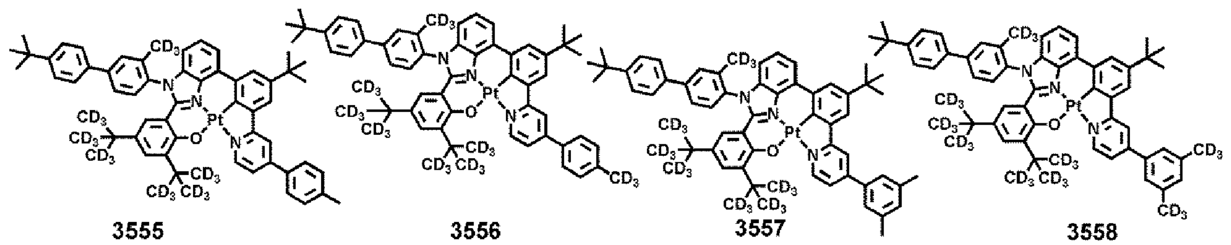
3555

3556

3557

3558

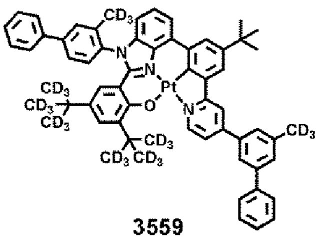
3559

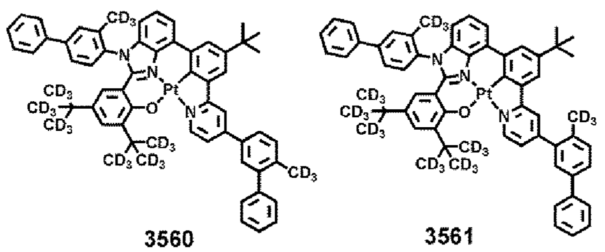
3560

3561

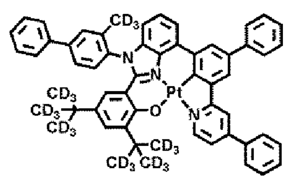
3562

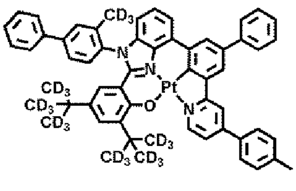
3563

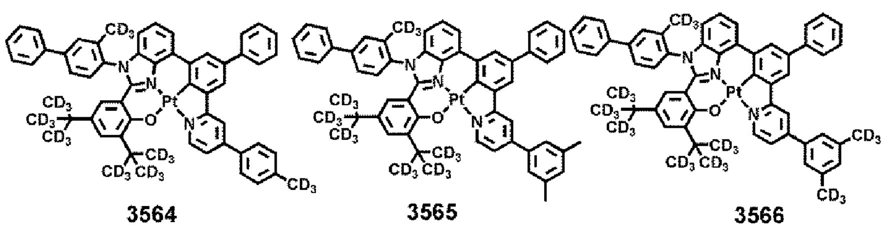
3564

3565

3566

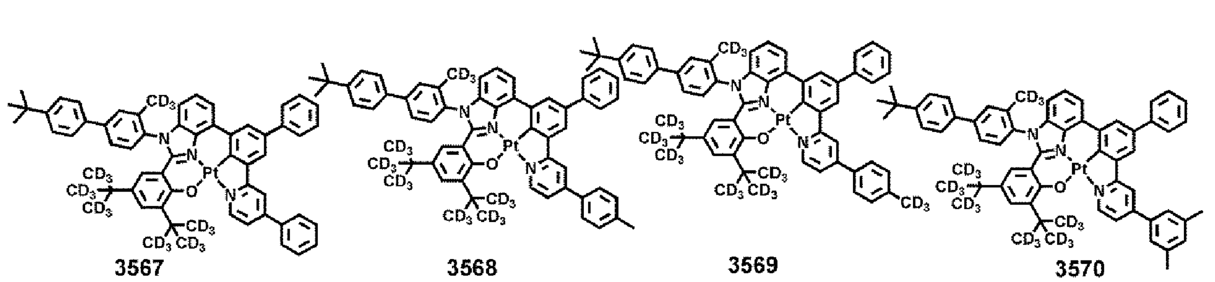
3567

3568

3569

3570

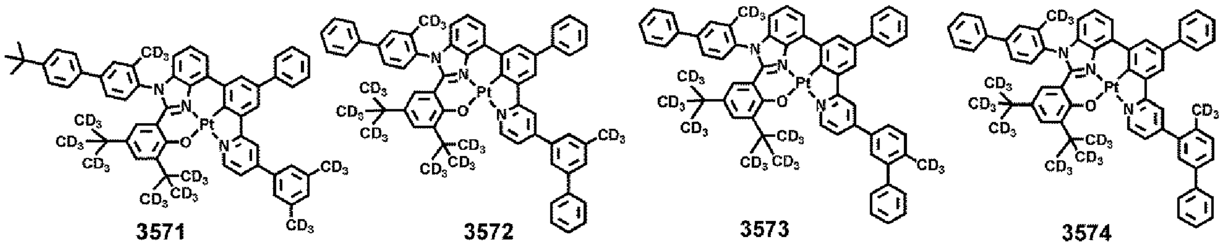

3571 3572 3573 3574

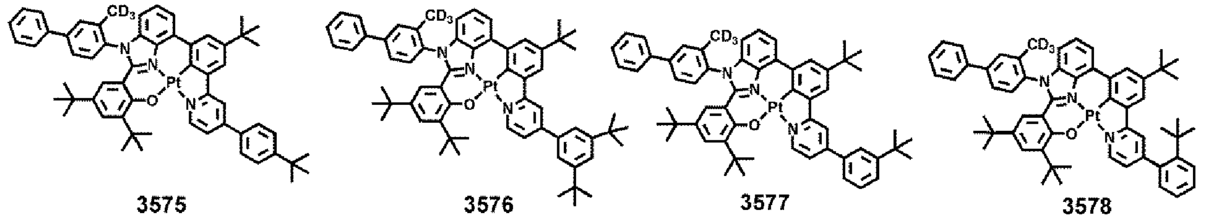

3575 3576 3577 3578

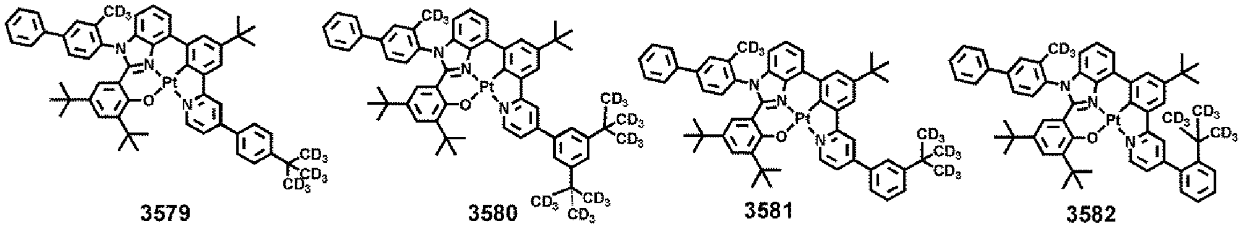

3579 3580 3581 3582

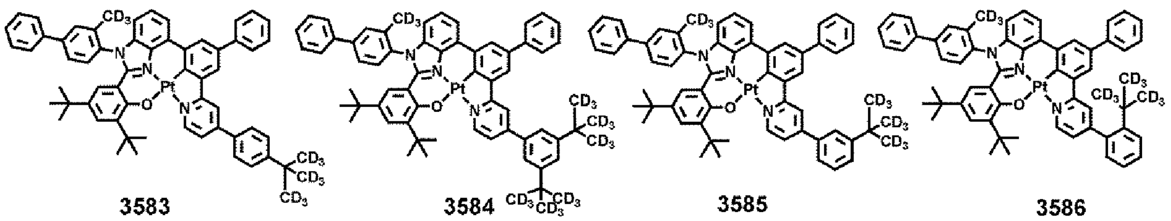

3583 3584 3585 3586

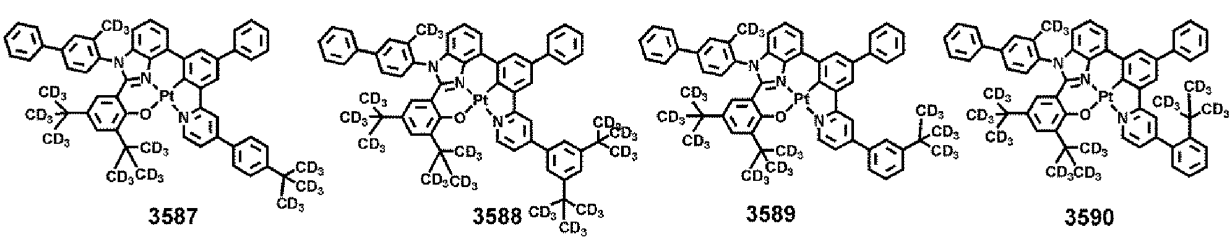

3587 3588 3589 3590

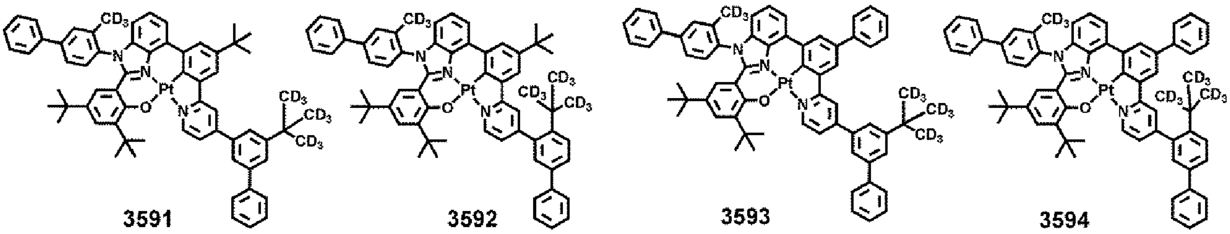

3591 3592 3593 3594

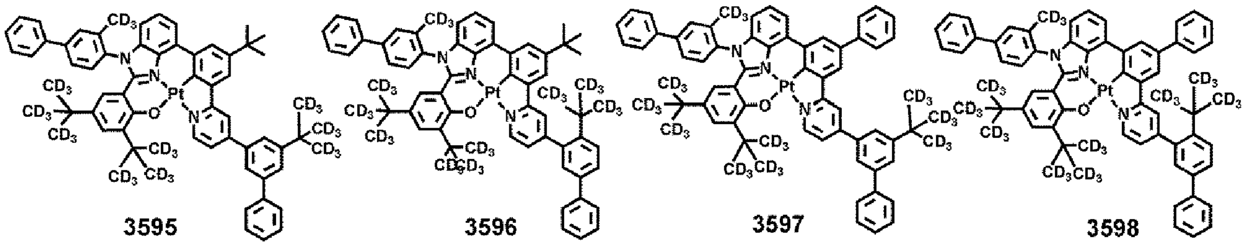

3595 3596 3597 3598

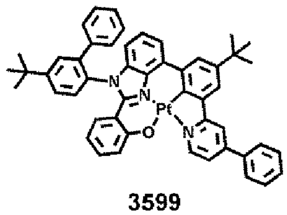

3599

Group 1-3

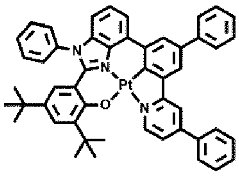
1

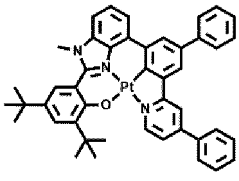
2

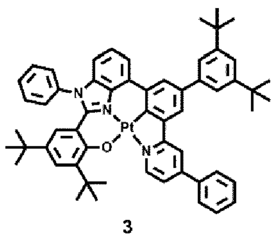
3

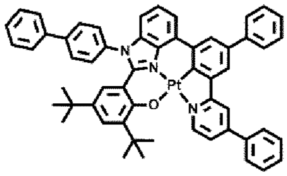
4

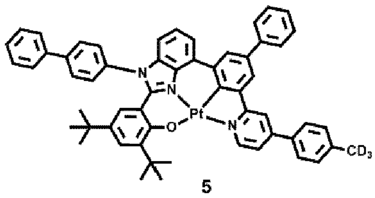
5

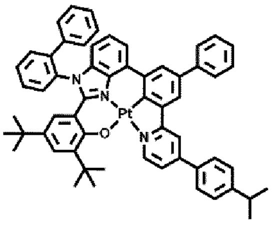
6

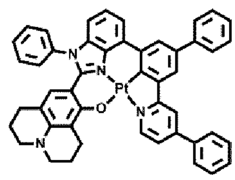
7

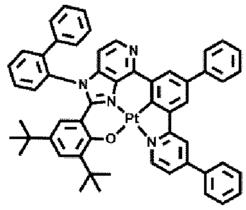
8

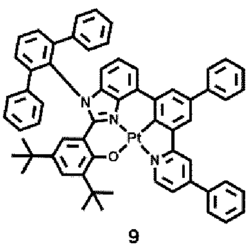
9

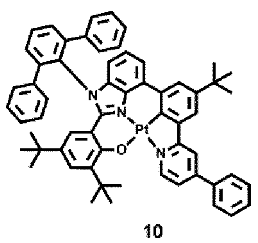
10

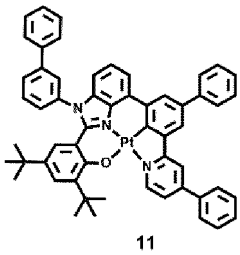
11

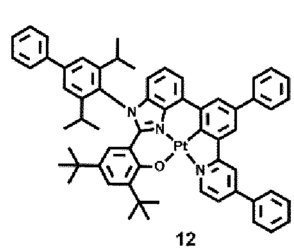
12

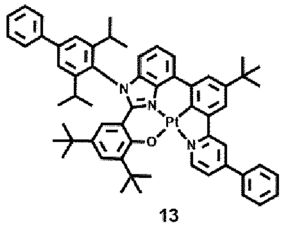
13

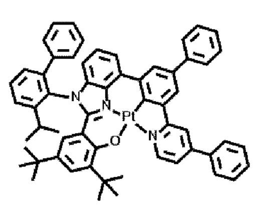
14

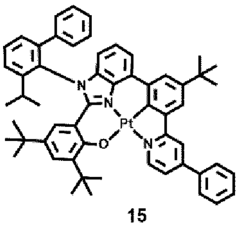
15

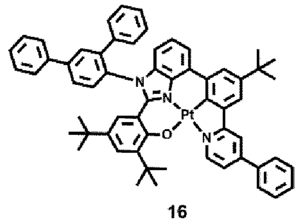
16

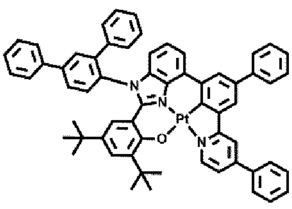
17

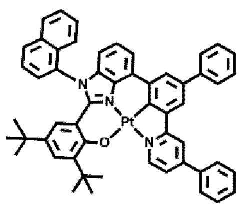
18

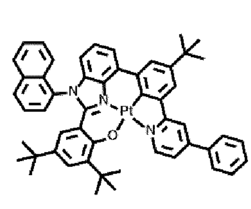
19

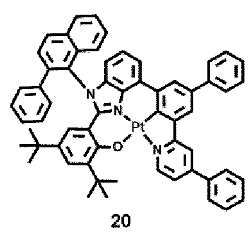
20

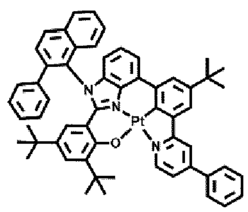
21

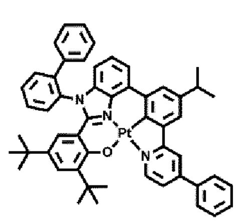
22

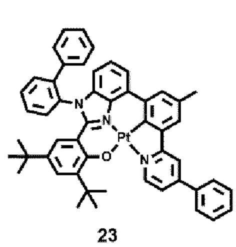
23

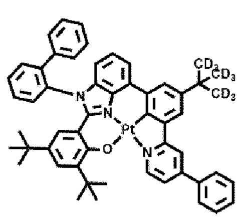
24

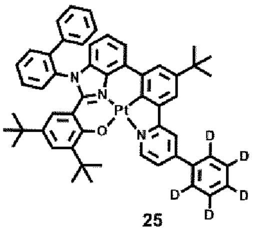
25

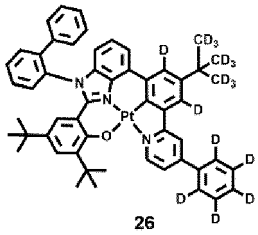
26

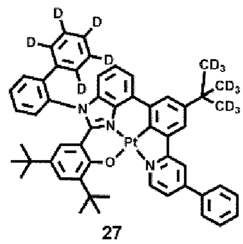
27

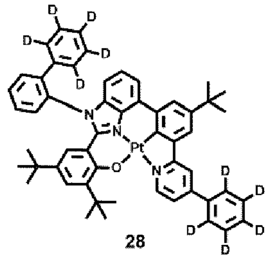
28

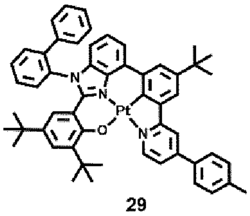
29

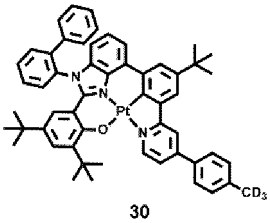
30

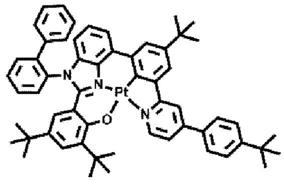
31

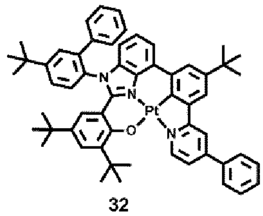
32

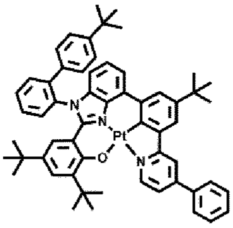
33

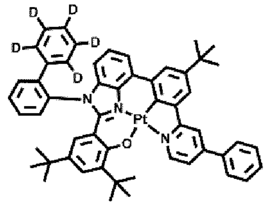
34

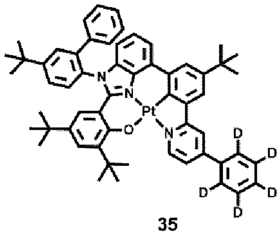
35

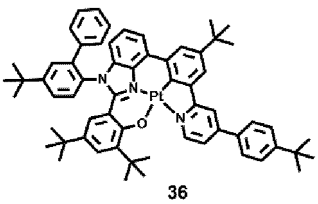
36

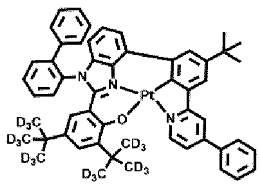
37

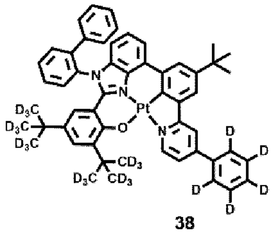
38

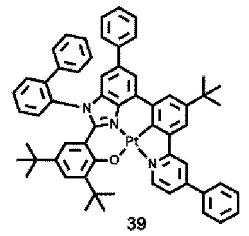
39

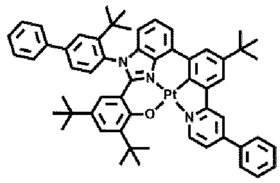
40

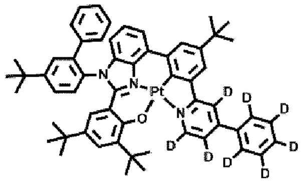
41

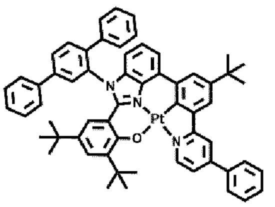
42

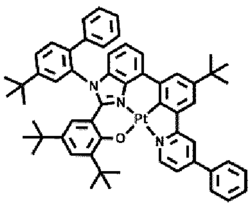
43

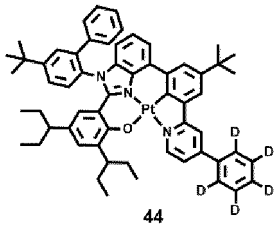
44

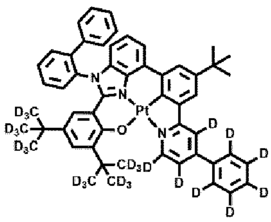
45

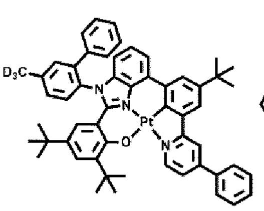
46

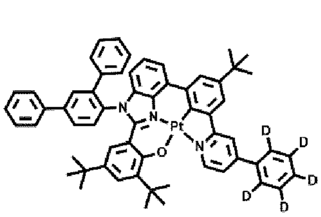
47

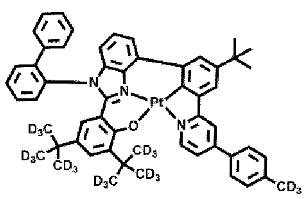
48

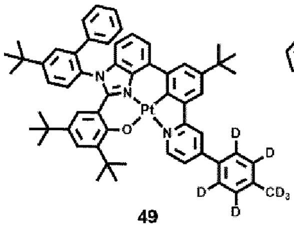
49
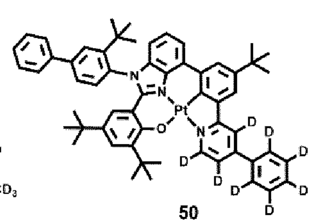
50
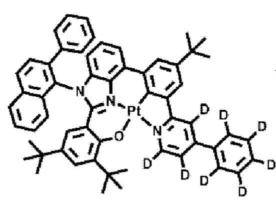
51
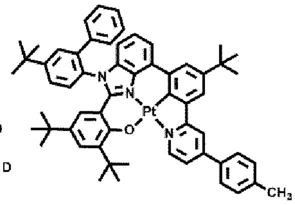
52

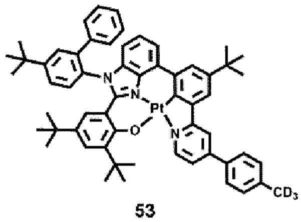
53
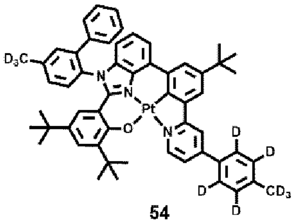
54
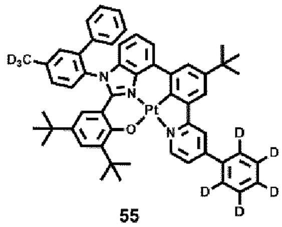
55
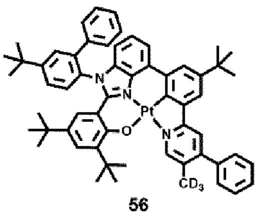
56

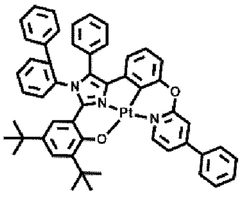
57
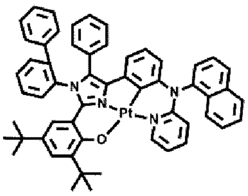
58
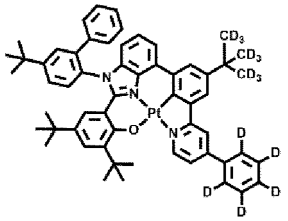
59
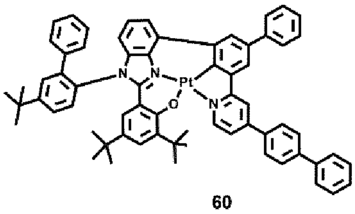
60

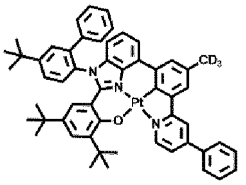
61
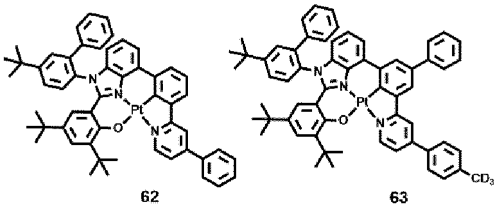
62

63
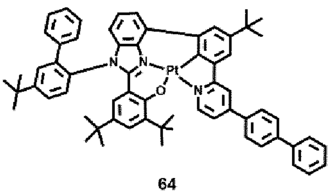
64

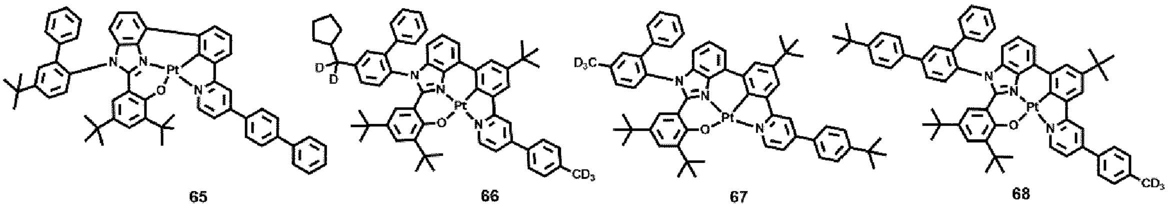
65

66

67

68

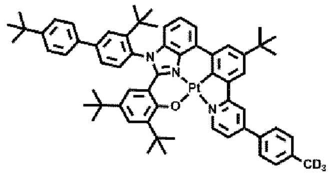
69
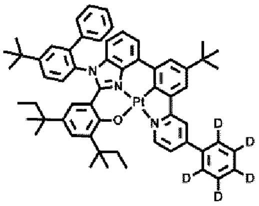
70
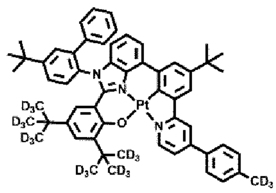
71
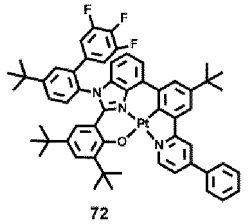
72

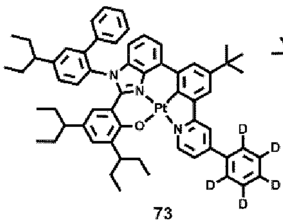

73

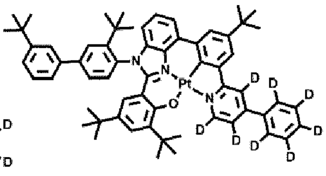

74

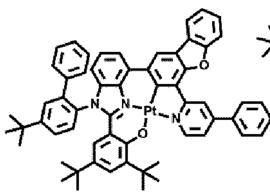

75

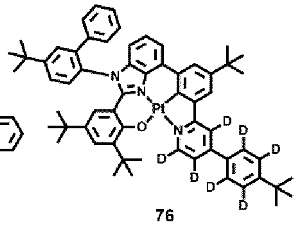

76

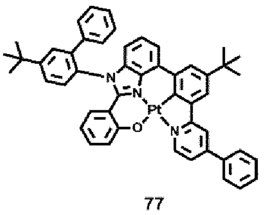

77

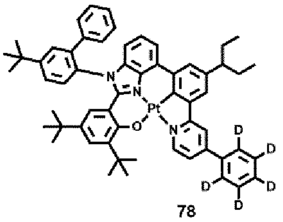

78

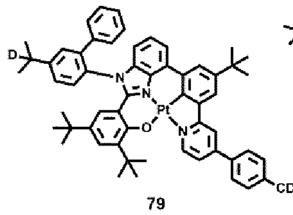

79

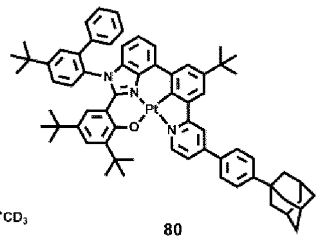

80

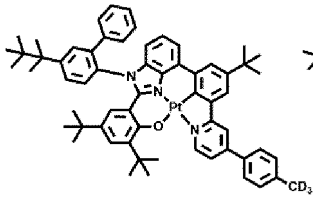

81

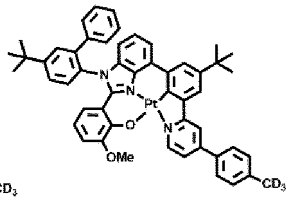

82

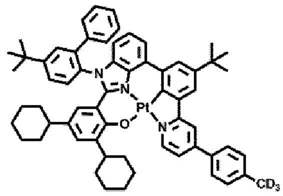

83

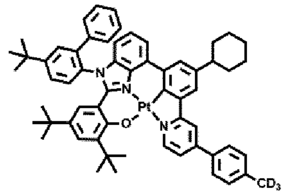

84

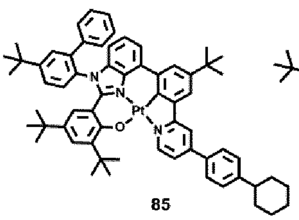

85

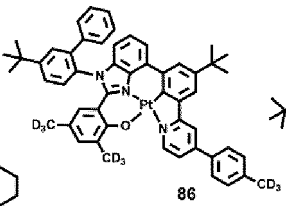

86

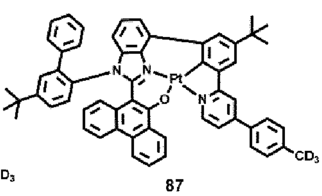

87

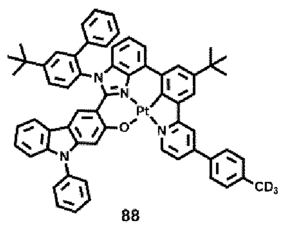

88

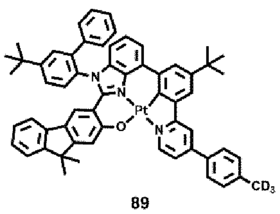

89

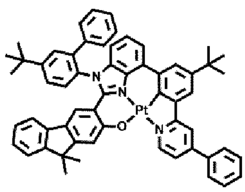

90

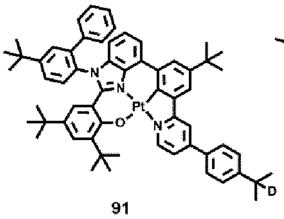

91

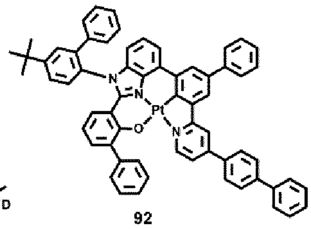

92

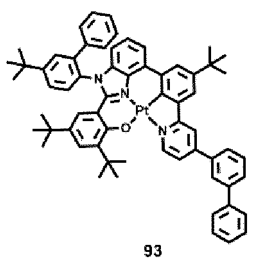

93

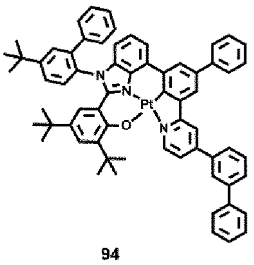

94

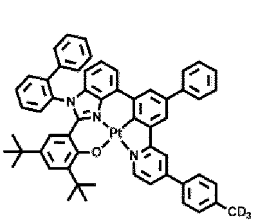

95

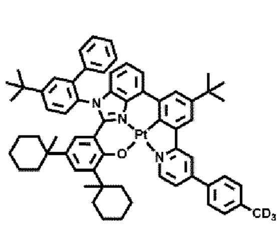

96

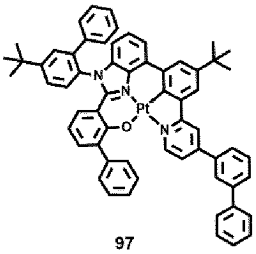
97

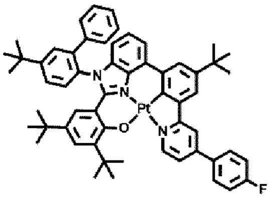
98

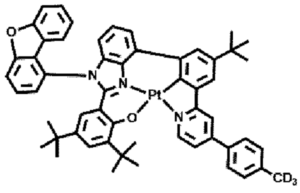
99

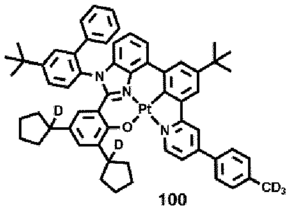
100

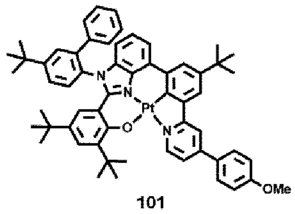
101

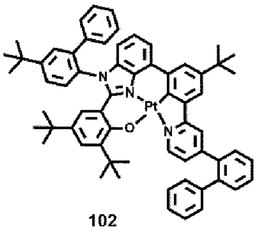
102

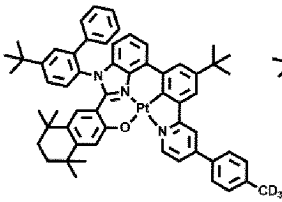
103

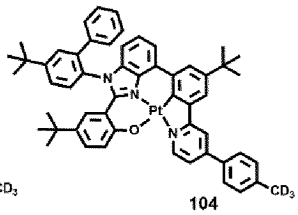
104

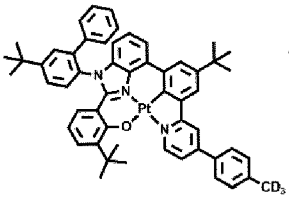
105

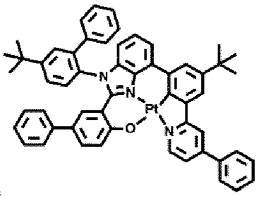
106

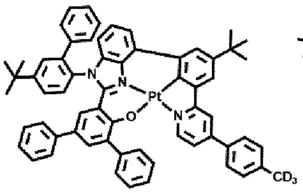
107

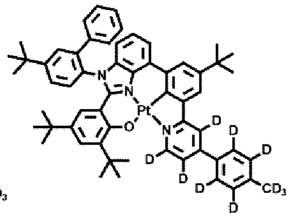
108

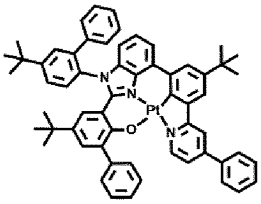
109

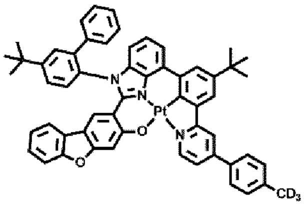
110

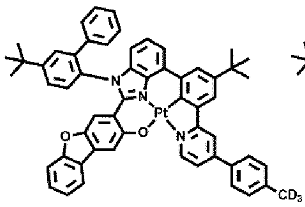
111

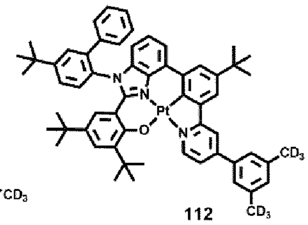
112

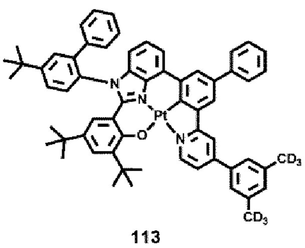
113

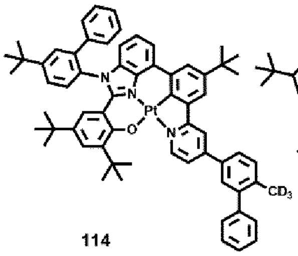
114

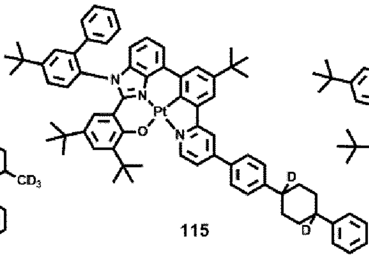
115

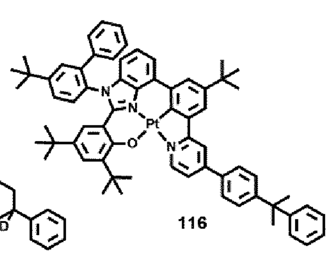
116

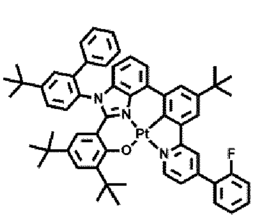
117

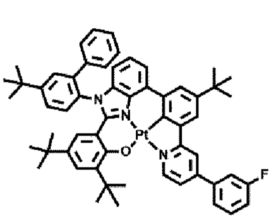
118

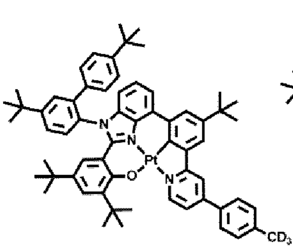
119

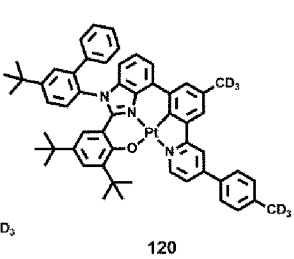
120

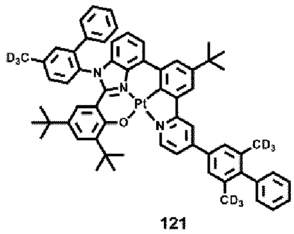
121

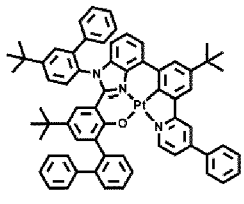
122

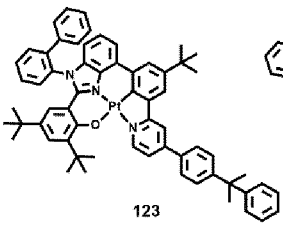
123

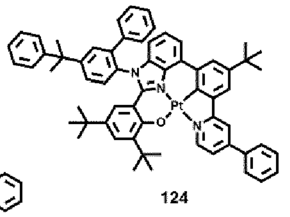
124

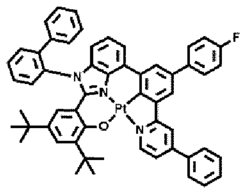
125

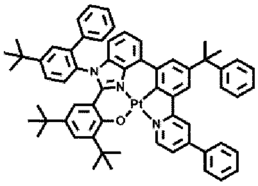
126

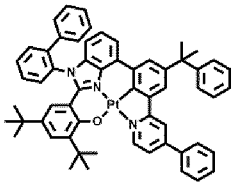
127

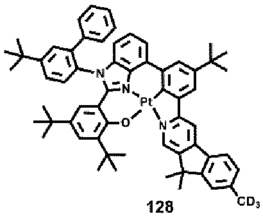
128

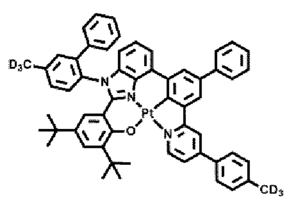
129

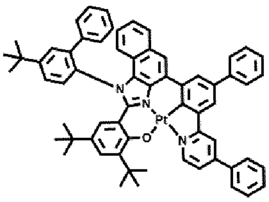
130

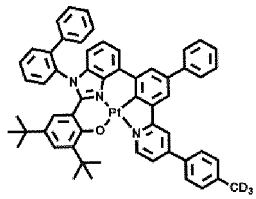
131

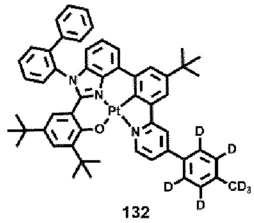
132

Group 1-4

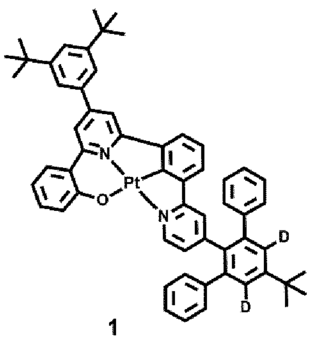
1

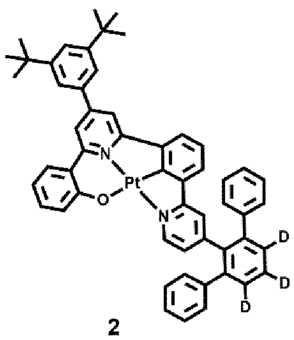
2

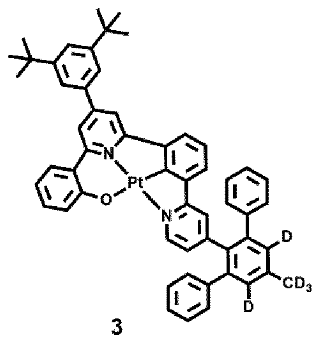
3

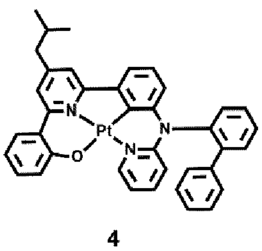
4

In one or more embodiments, the second compound may be a compound of Group 2-1 to Group 2-5:

Group 2-1

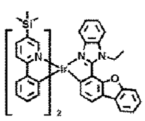
1
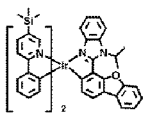
2
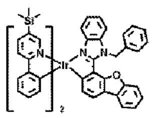
3
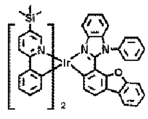
4
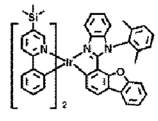
5
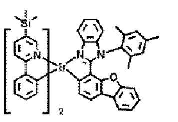
6
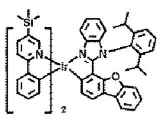
7
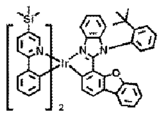
8
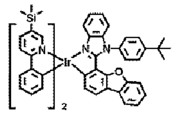
9
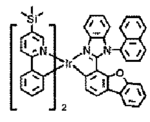
10
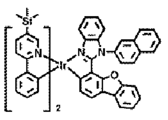
11
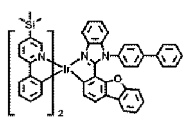
12
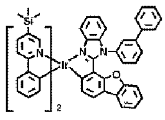
13
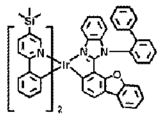
14
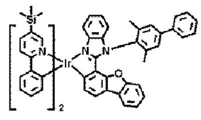
15
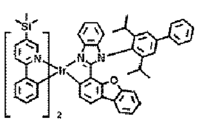
16
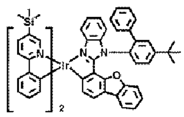
17
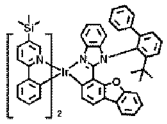
18
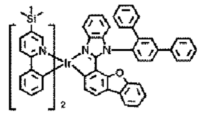
19
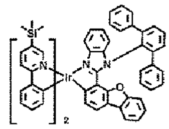
20
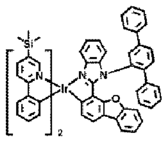
21
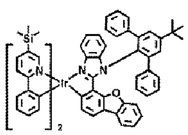
22
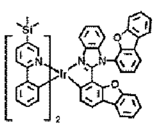
23
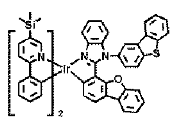
24
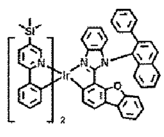
25
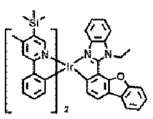
26
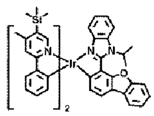
27
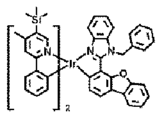
28
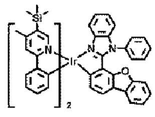
29
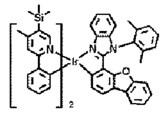
30
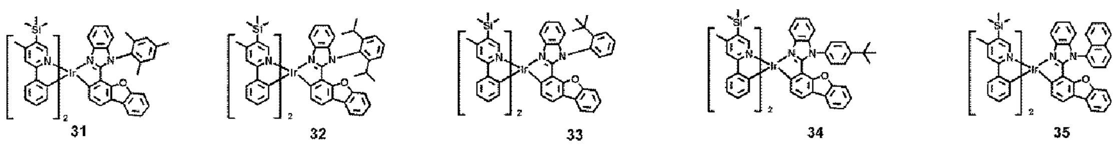
31 32 33 34 35
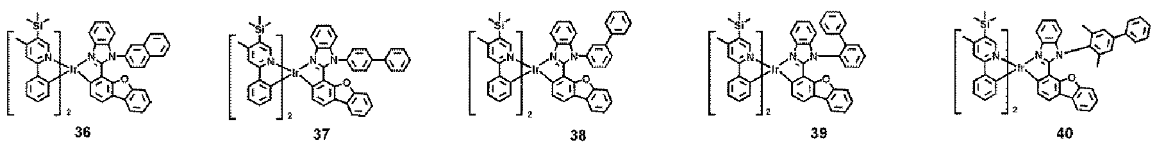
36 37 38 39 40
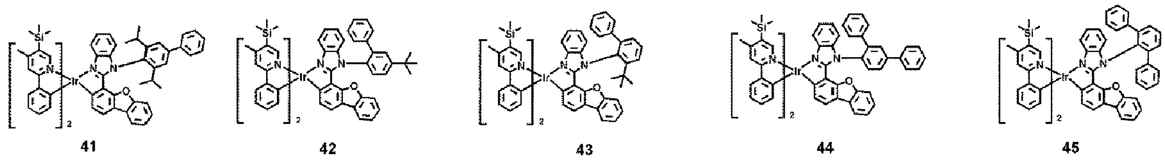
41 42 43 44 45
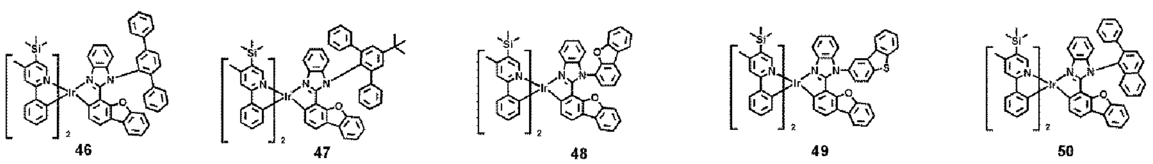
46 47 48 49 50

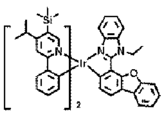
51
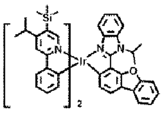
52
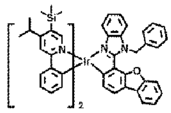
53
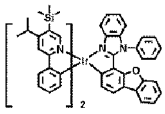
54
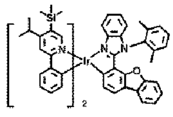
55

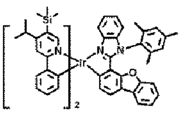
56
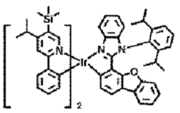
57
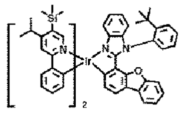
58
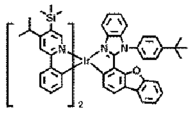
59
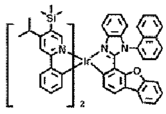
60

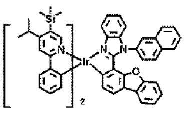
61
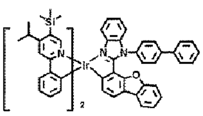
62
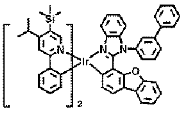
63
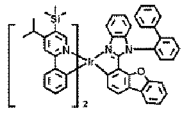
64
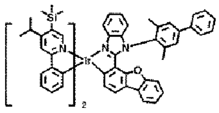
65

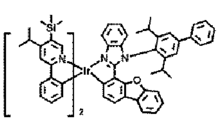
66
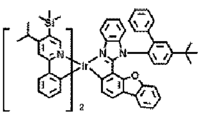
67
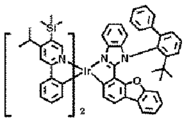
68
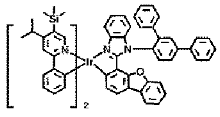
69
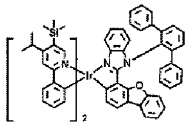
70

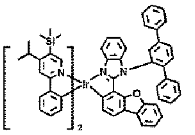
71
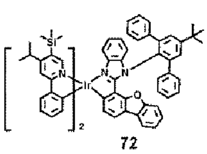
72
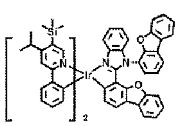
73
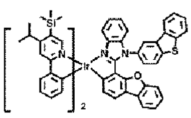
74
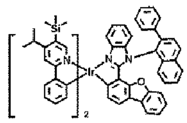
75

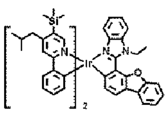
76
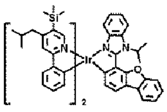
77
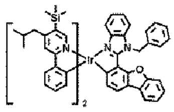
78
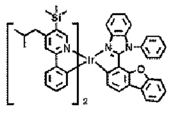
79
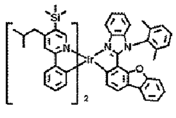
80

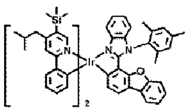
81
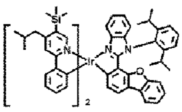
82
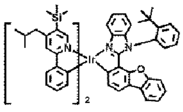
83
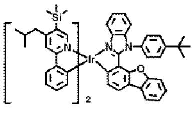
84
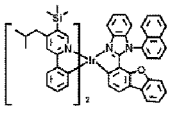
85

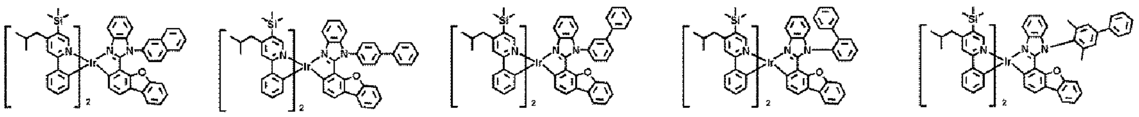
86 87 88 89 90

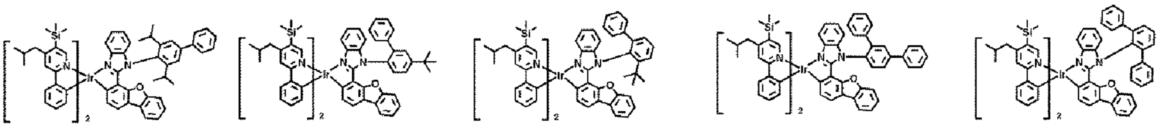
91 92 93 94 95

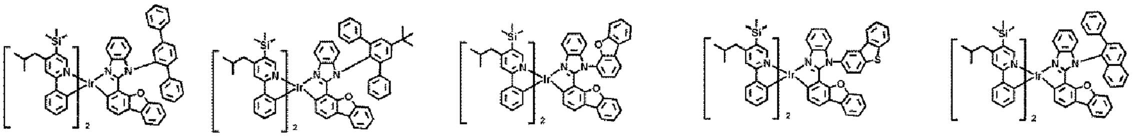
96 97 98 99 100

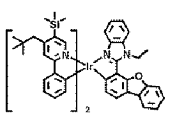
101
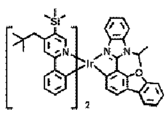
102
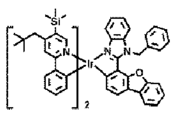
103
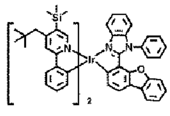
104
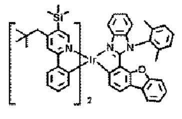
105

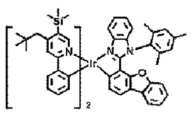
106
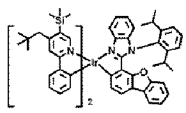
107
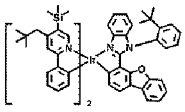
108
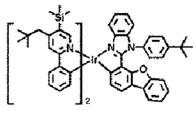
109
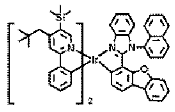
110

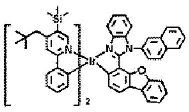
111
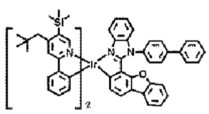
112
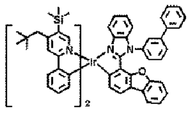
113
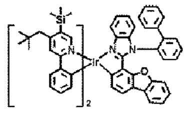
114
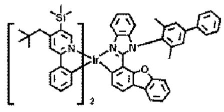
115

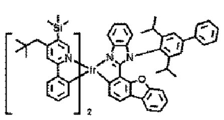
116
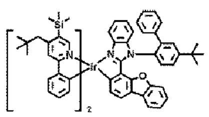
117
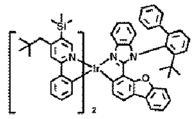
118
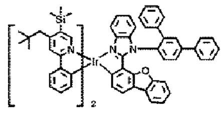
119
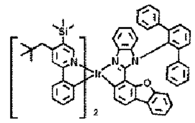
120

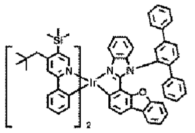
121
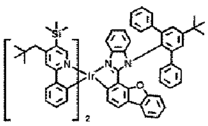
122
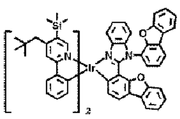
123
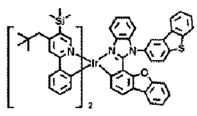
124
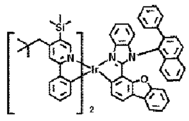
125

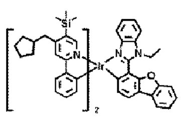
126
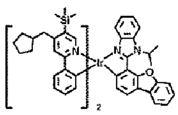
127
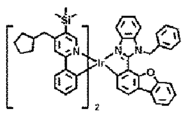
128
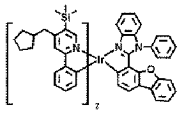
129
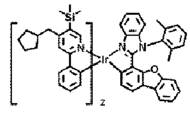
130

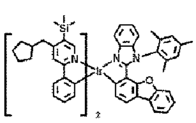
131
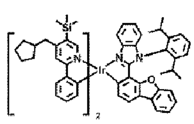
132
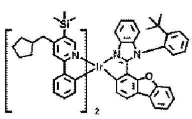
133
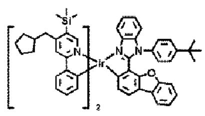
134
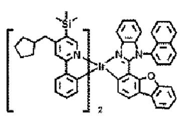
135

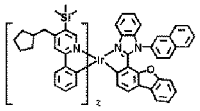
136
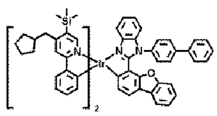
137
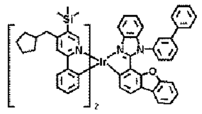
138
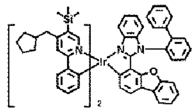
139
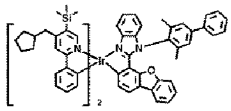
140

141
142
143
144
145

146
147
148
149
150

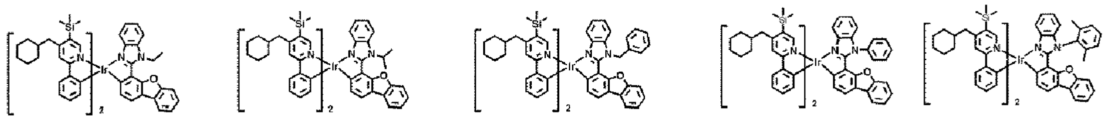
151 152 153 154 155

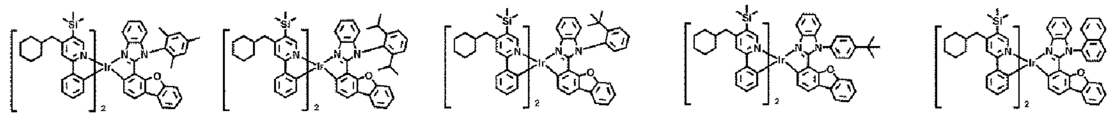
156 157 158 159 160

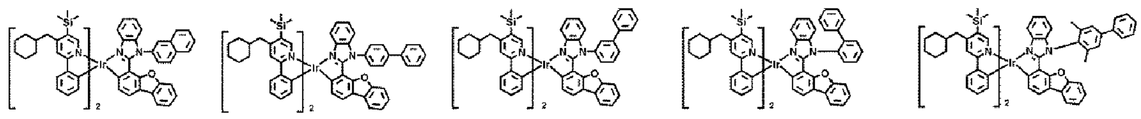
161 162 163 164 165

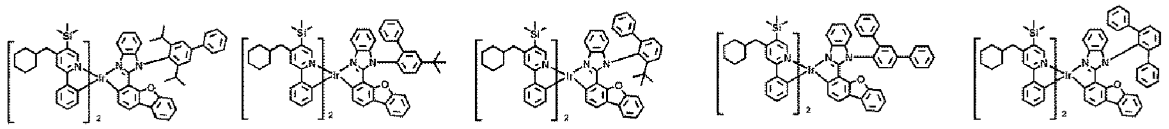
166 167 168 169 170

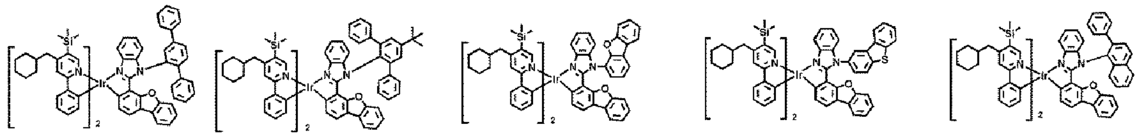
171 172 173 174 175

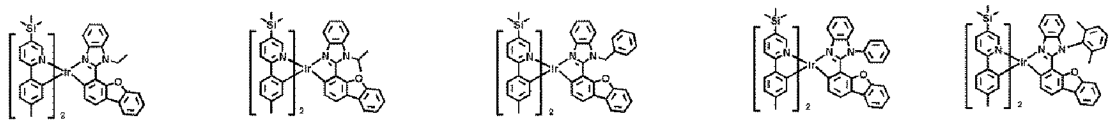
176 177 178 179 180

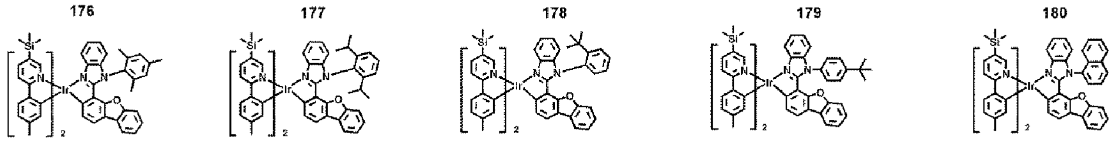
181 182 183 184 185

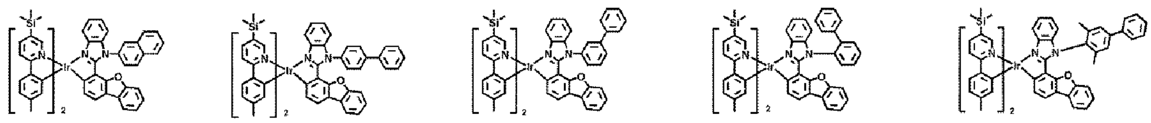
186 187 188 189 190

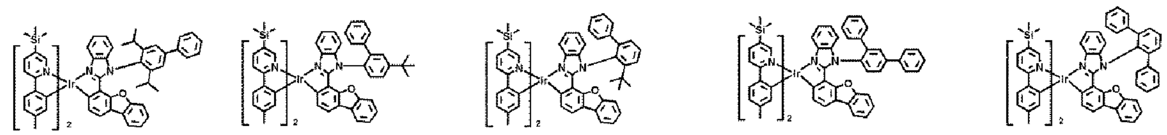
191 192 193 194 195

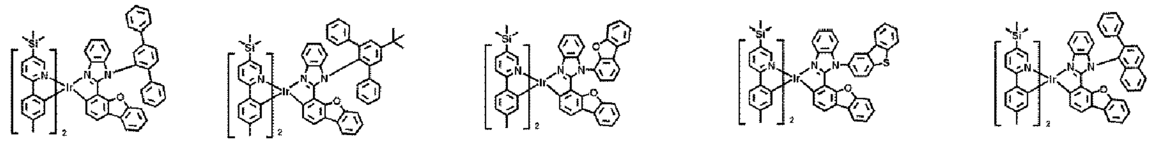
196 197 198 199 200

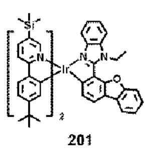
201

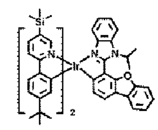
202

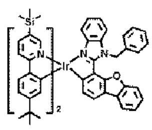
203

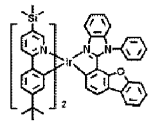
204

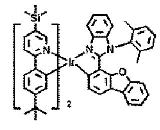
205

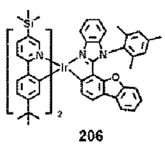
206

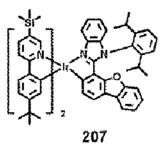
207

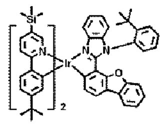
208

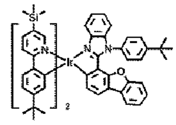
209

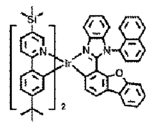
210

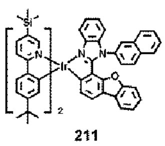
211

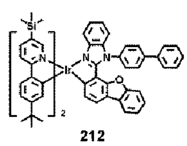
212

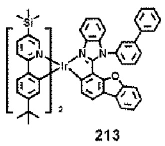
213

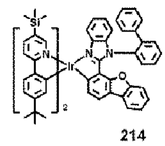
214

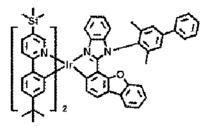
215

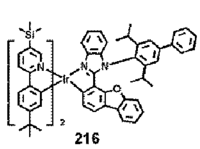
216

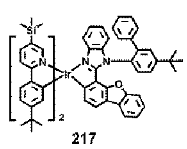
217

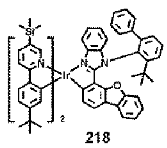
218

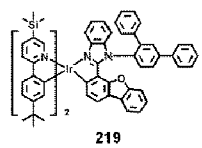
219

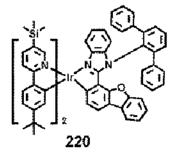
220

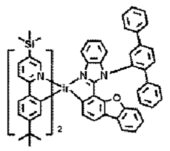
221

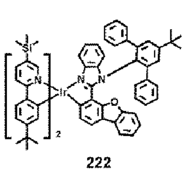
222

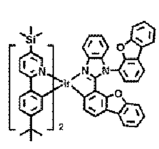
223

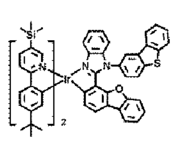
224

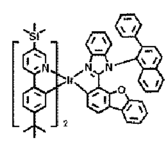
225

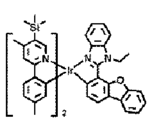
226

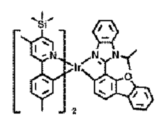
227

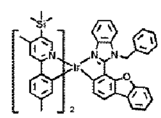
228

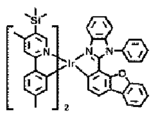
229

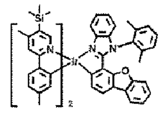
230

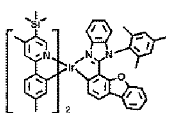
231

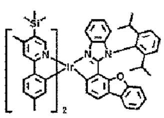
232

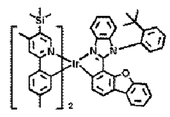
233

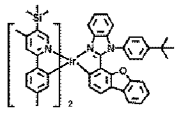
234

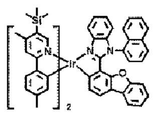
235

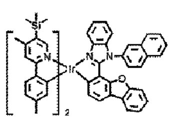
236

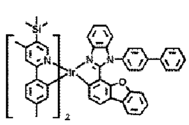
237

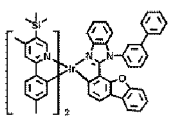
238

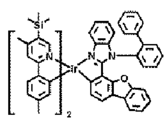
239

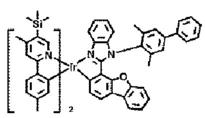
240

241

242

243

244

245

246

247

248

249

250

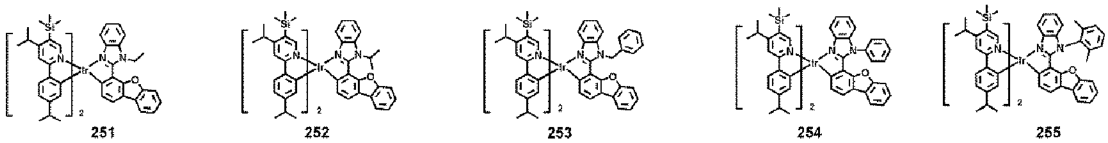
251 252 253 254 255

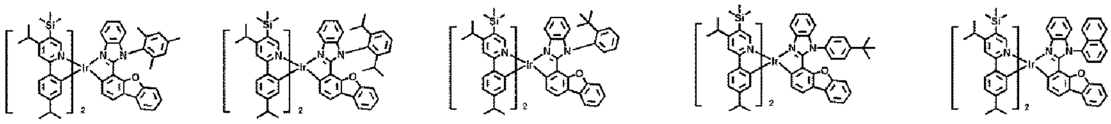
256 257 258 259 260

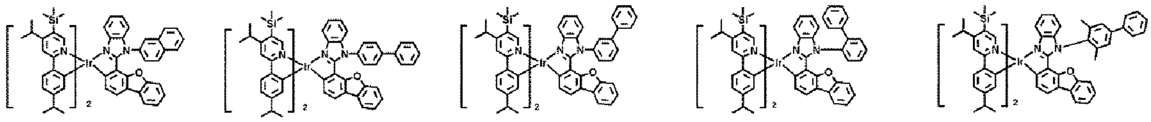
261 262 263 264 265

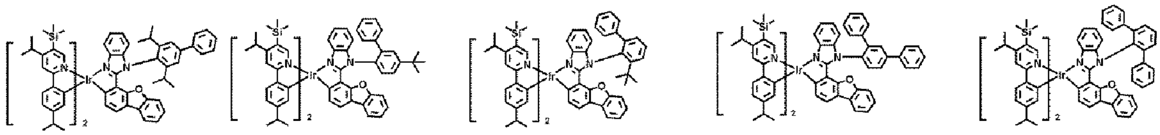
266 267 268 269 270

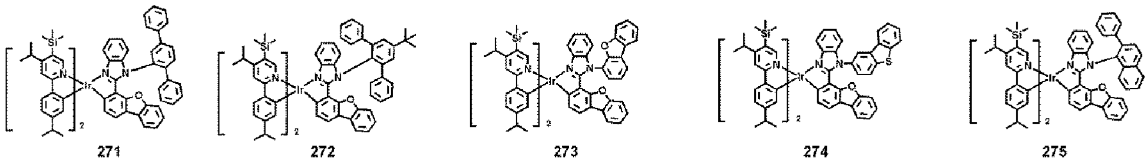
271 272 273 274 275

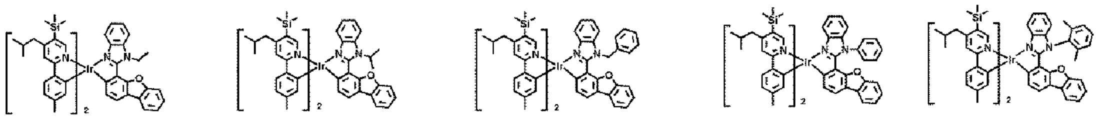
276 277 278 279 280

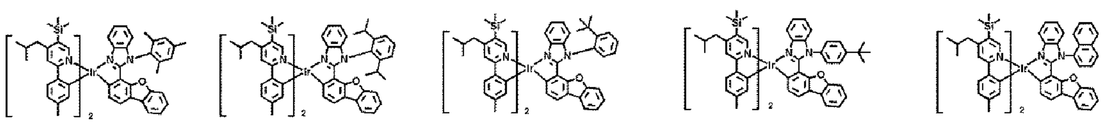
281 282 283 284 285

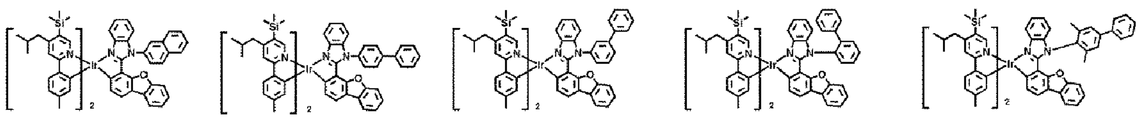
286 287 288 289 290

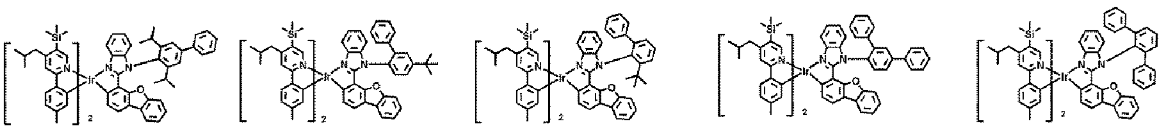
291 292 293 294 295

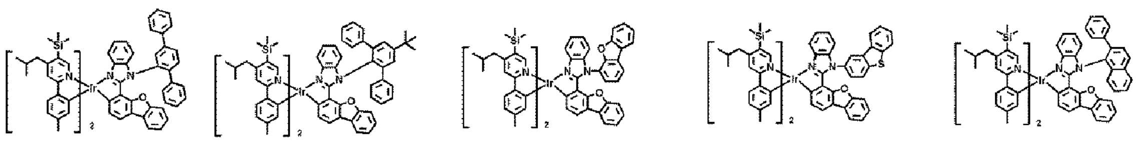
296 297 298 299 300

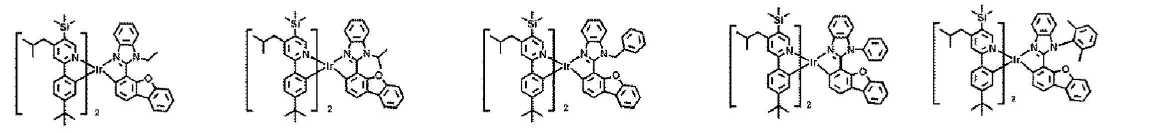

301 302 303 304 305

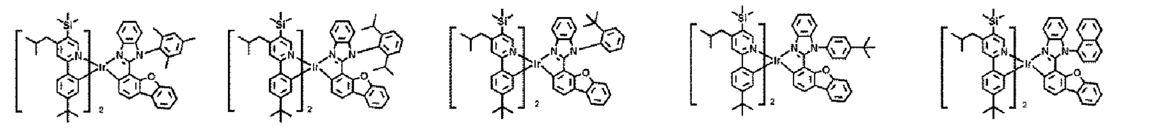

306 307 308 309 310

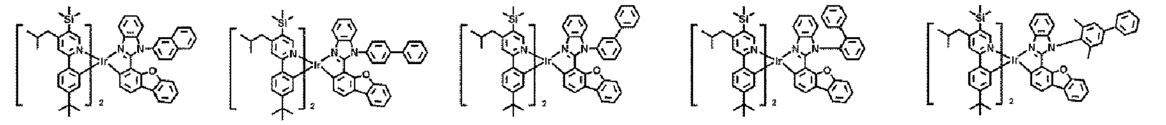

311 312 313 314 315

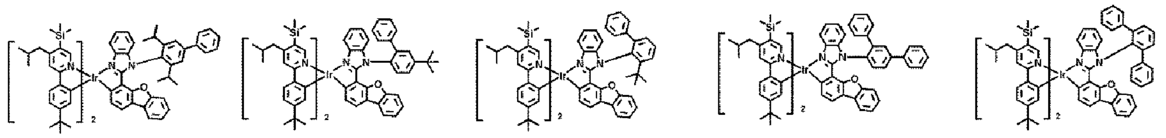

316 317 318 319 320

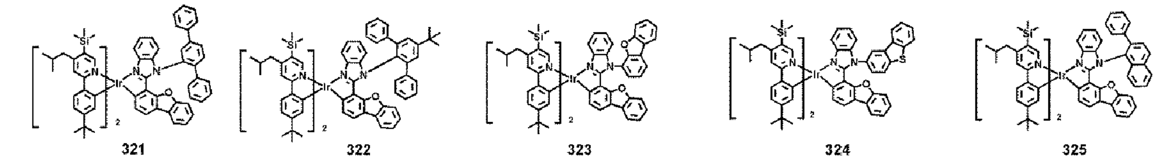

321 322 323 324 325

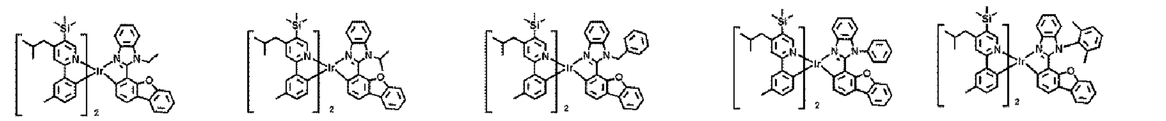

326 327 328 329 330

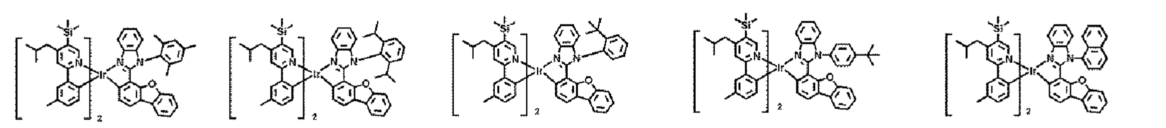

331 332 333 334 335

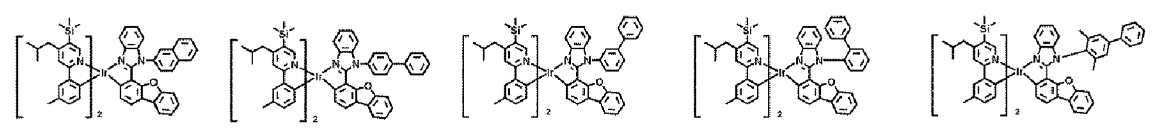

336 337 338 339 340

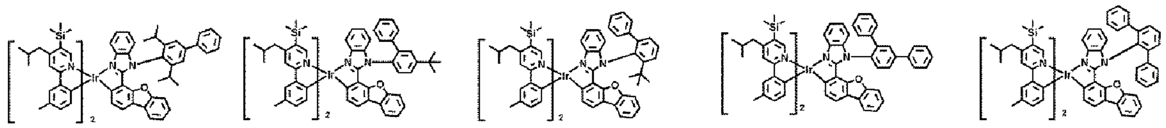

341 342 343 343 345

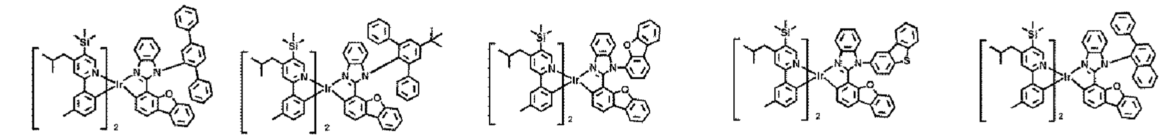

346 347 348 349 350

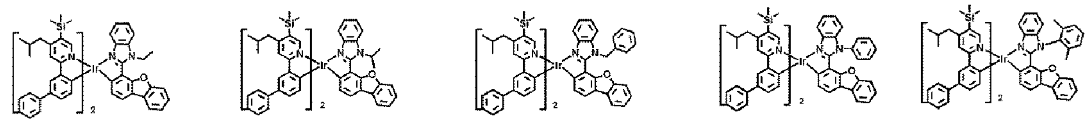
351 352 353 354 355

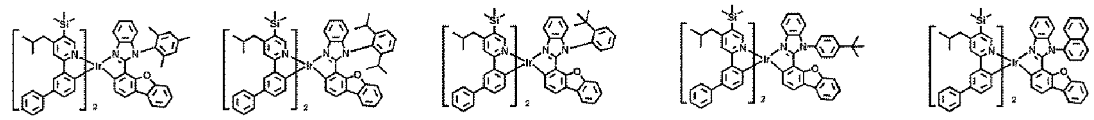
356 357 358 359 360

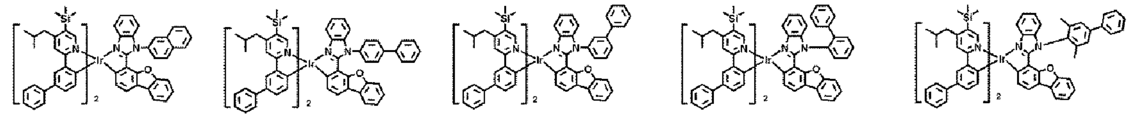
361 362 363 364 365

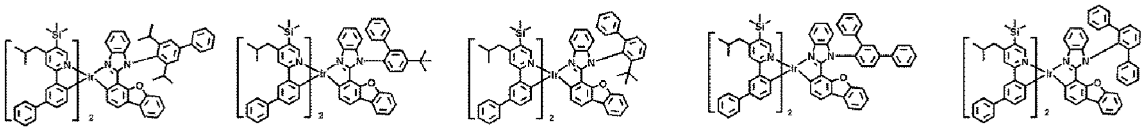
366 367 368 369 370

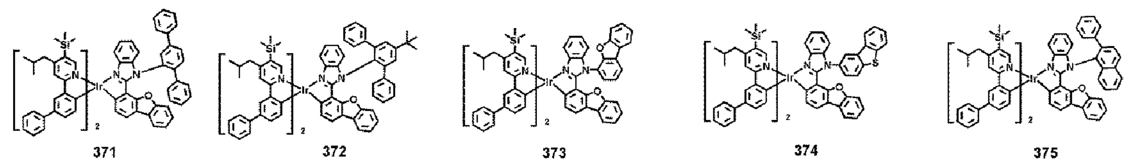
371 372 373 374 375

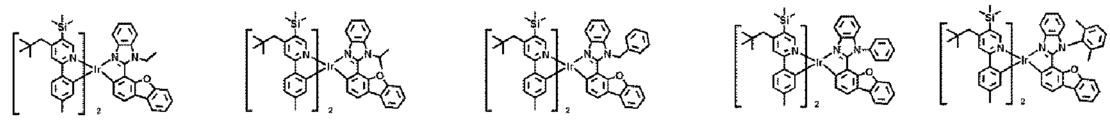
376 377 378 379 380

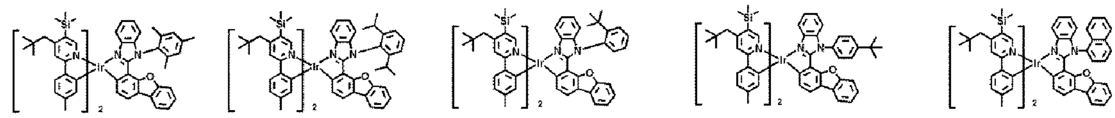
381 382 383 384 385

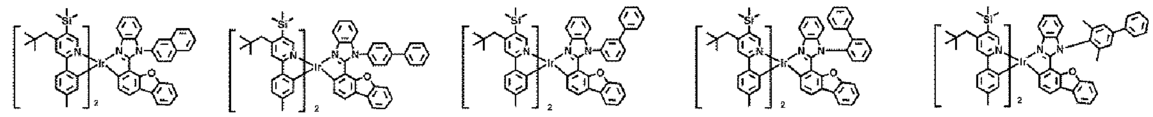
386 387 388 389 390

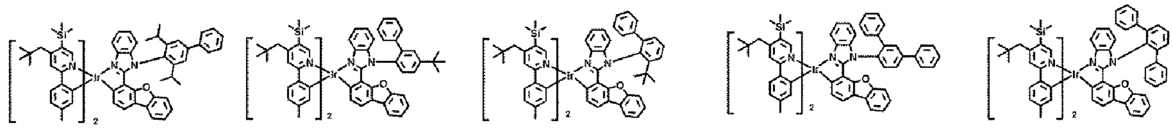
391 392 393 394 395

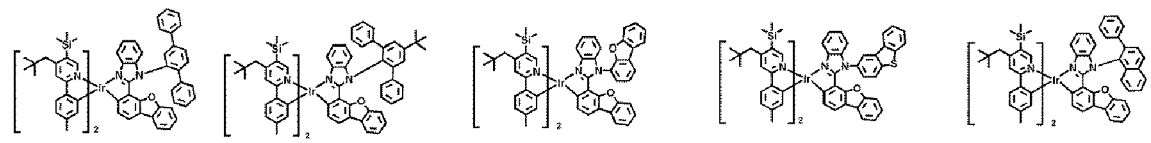
396 397 398 399 400

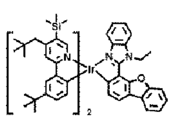
401
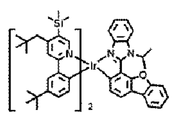
402
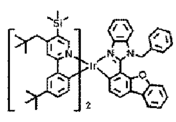
403
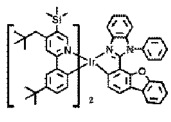
404
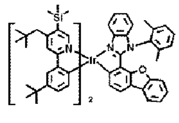
405

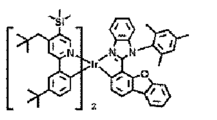
406
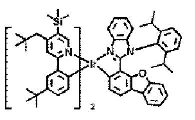
407
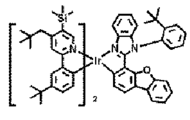
408
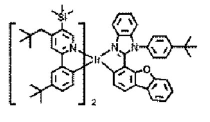
409
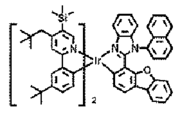
410

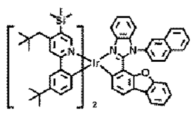
411
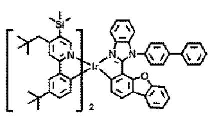
412
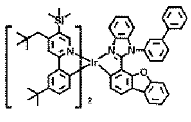
413
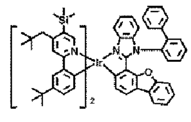
414
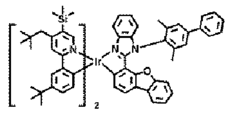
415

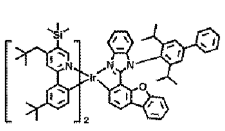
416
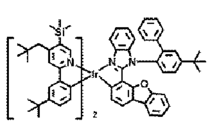
417
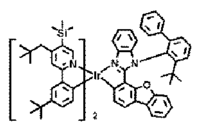
418
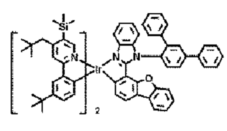
419
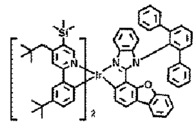
420

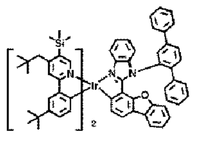
421
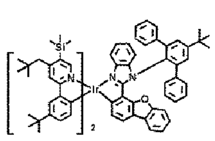
422
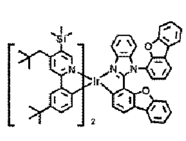
423
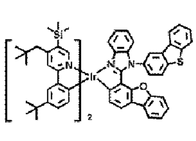
424
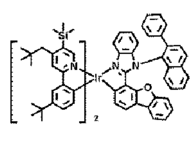
425

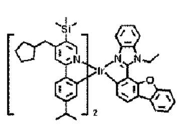
426
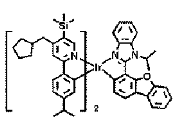
427
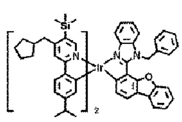
428
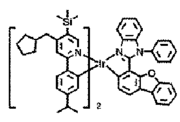
429
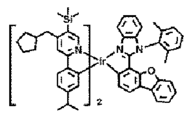
430

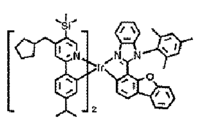
431
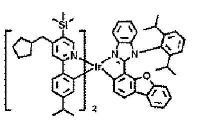
432
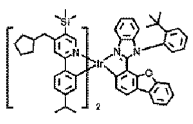
433
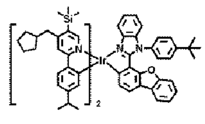
434
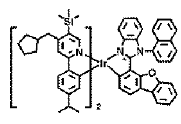
435

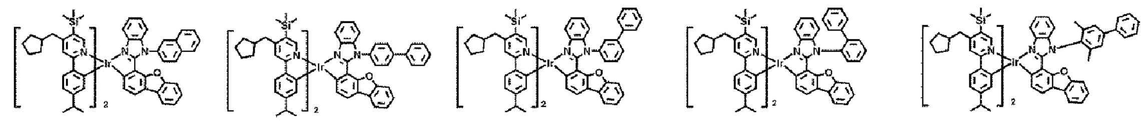
436 437 438 439 440

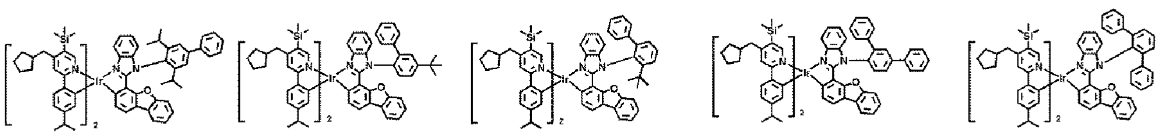
441 442 443 444 445

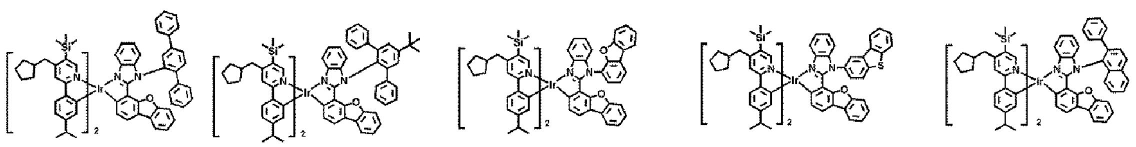
446 447 448 449 450

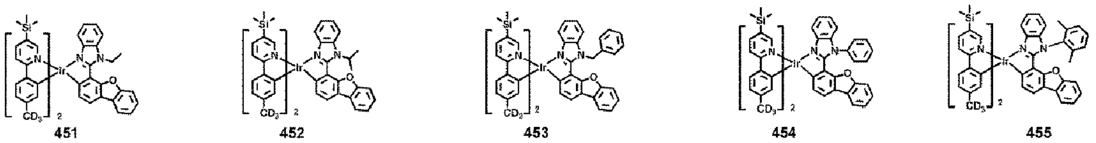
451 452 453 454 455

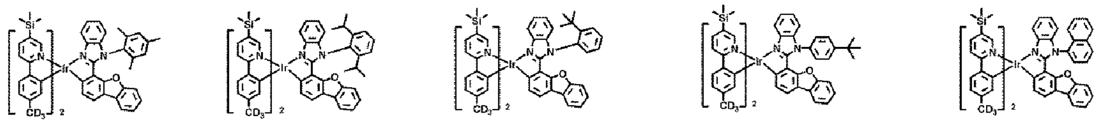
456 457 458 459 460

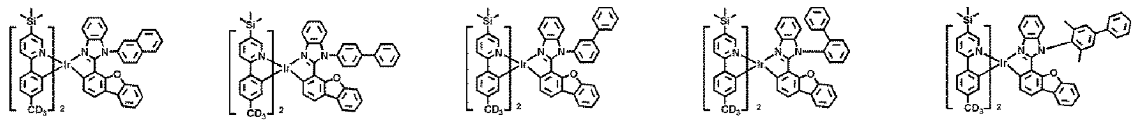
461 462 463 464 465

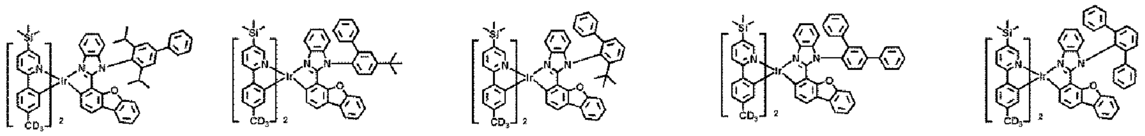
466 467 468 469 470

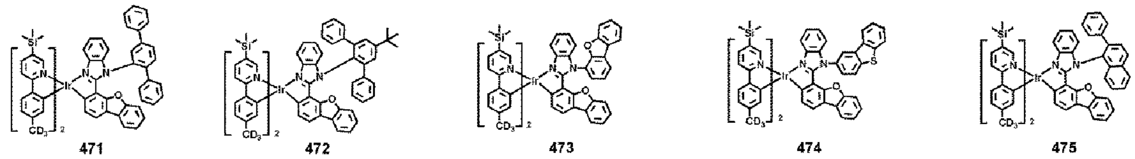
471 472 473 474 475

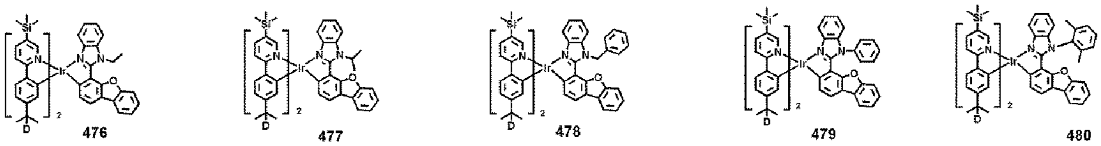
476 477 478 479 480

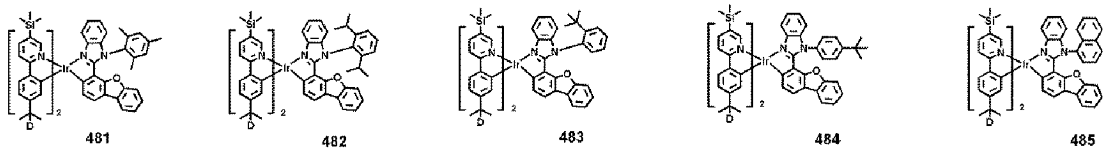
481 482 483 484 485

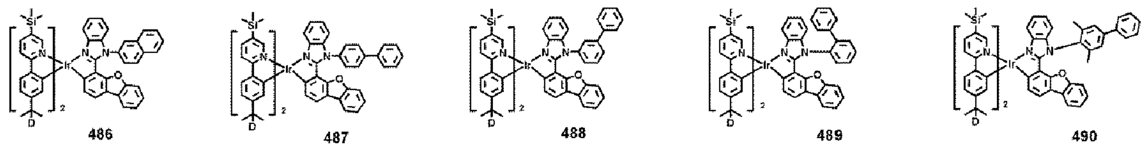
486 487 488 489 490

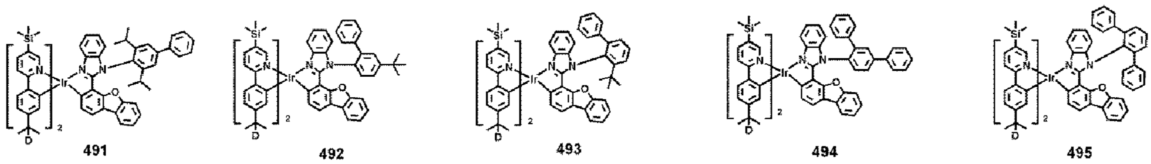
491 492 493 494 495

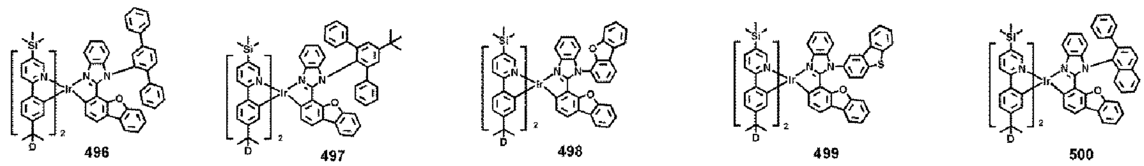
496 497 498 499 500

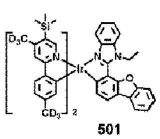
501
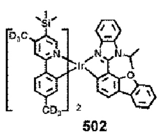
502
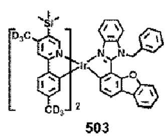
503
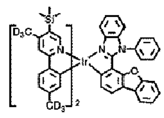
504
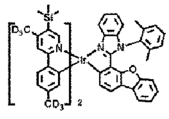
505

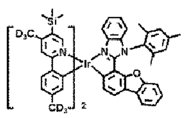
506
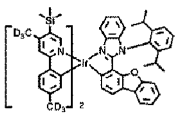
507
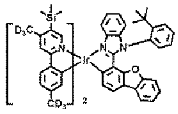
508
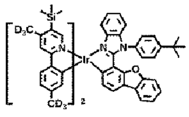
509
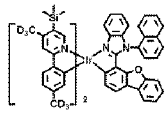
510

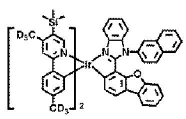
511
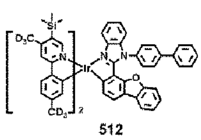
512
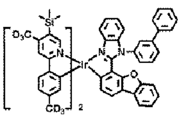
513
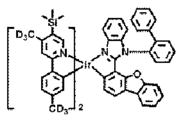
514
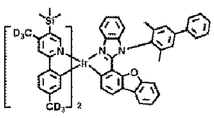
515

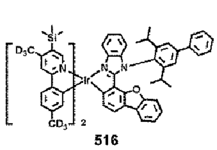
516
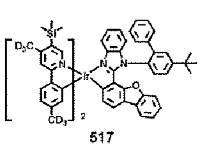
517
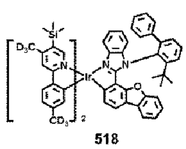
518
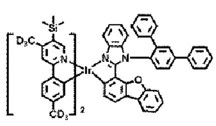
519
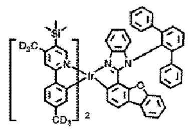
520

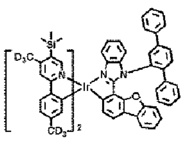
521
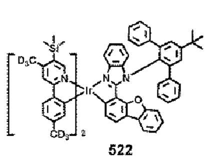
522
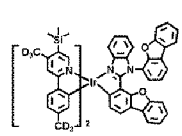
523
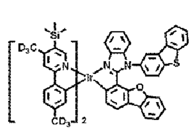
524
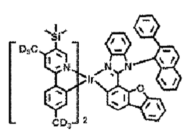
525

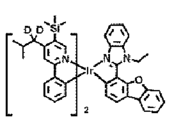
526
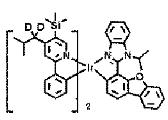
527
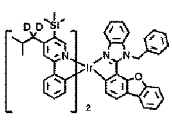
528
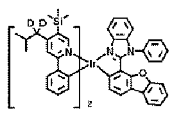
529
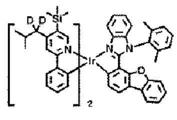
530

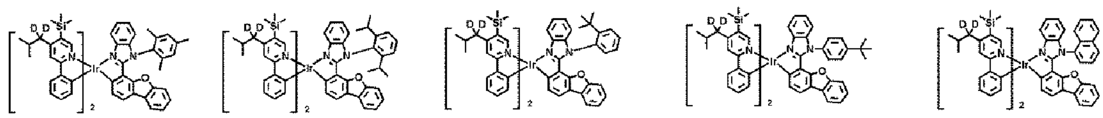
531 532 533 534 535

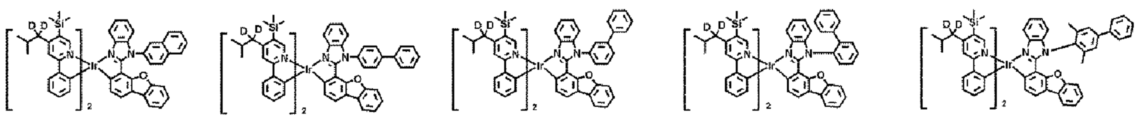
536 537 538 539 540

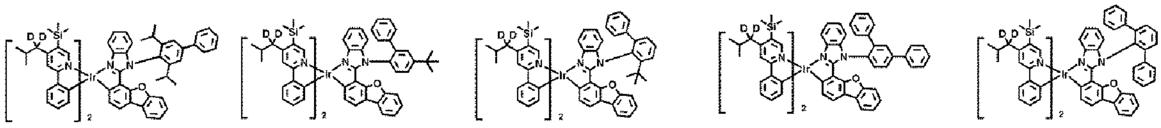
541 542 543 544 545

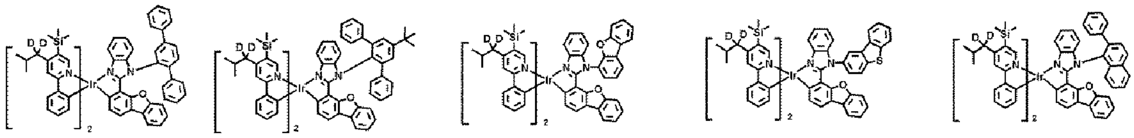
546 547 548 549 550

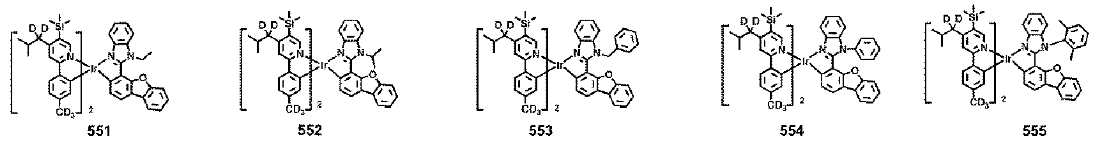
551 552 553 554 555

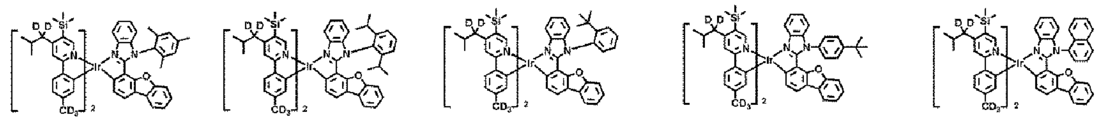
556 557 558 559 560

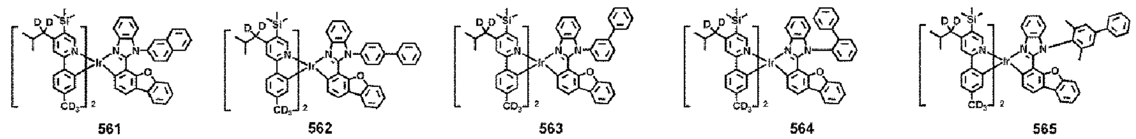
561 562 563 564 565

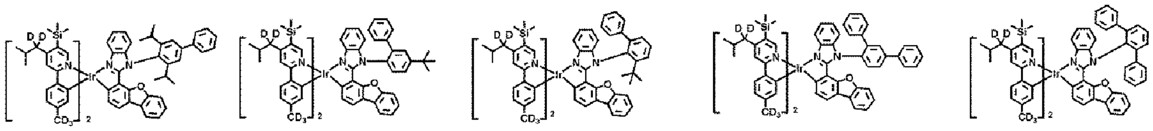
566 567 568 569 570

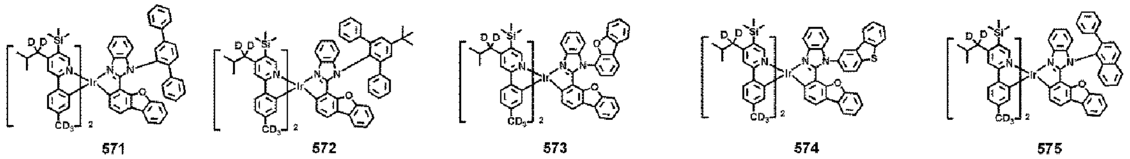
571 572 573 574 575

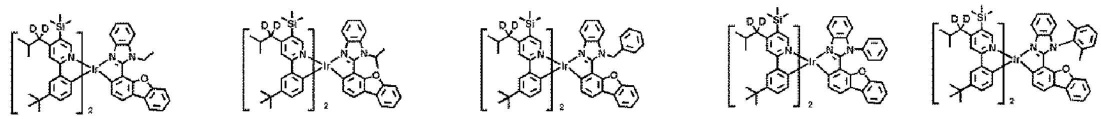
576 577 578 579 580

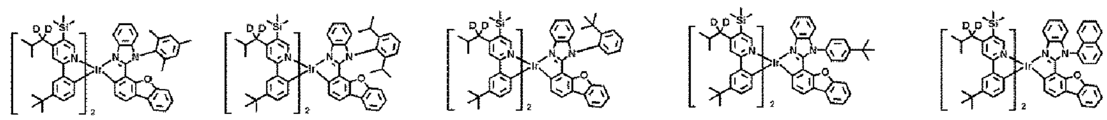
581 582 583 584 585

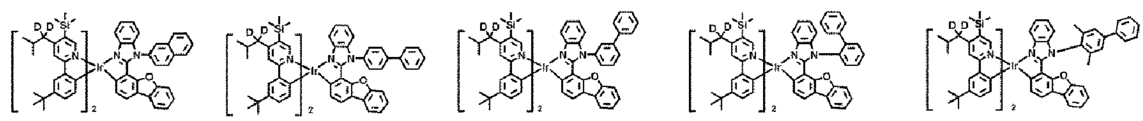
586 587 588 589 590

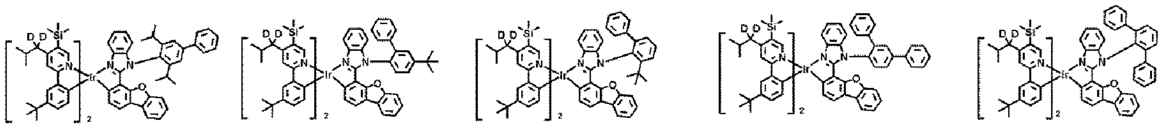
591 592 593 594 595

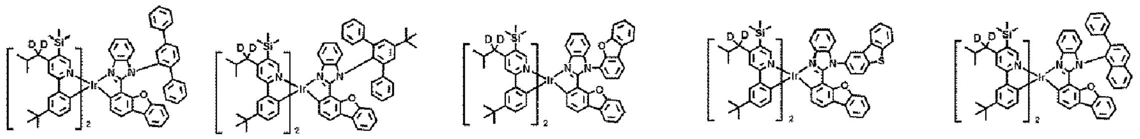
596 597 598 599 600

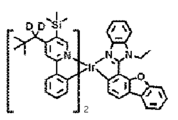
601
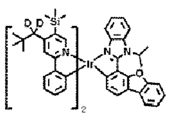
602
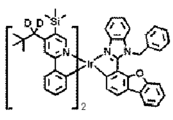
603
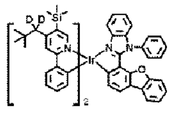
604
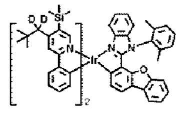
605
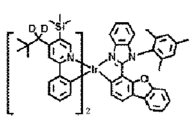
606
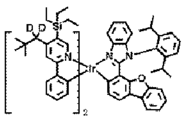
607
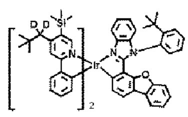
608
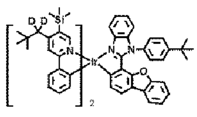
609
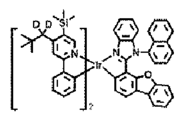
610
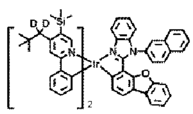
611
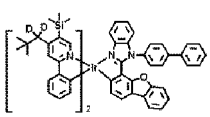
612
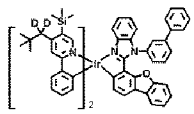
613
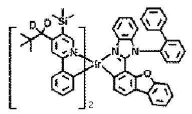
614
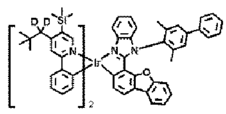
615
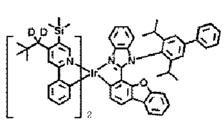
616
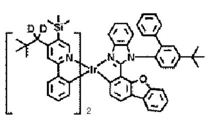
617
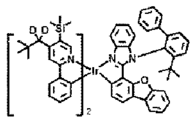
618
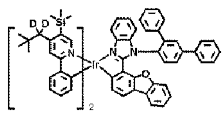
619
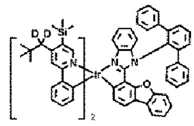
620
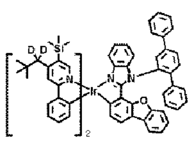
621
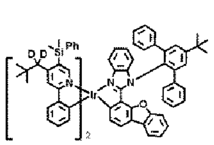
622
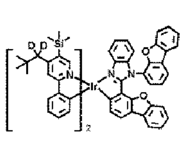
623
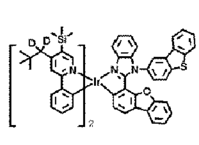
624
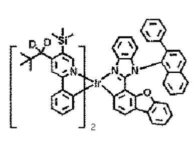
625
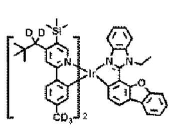
626
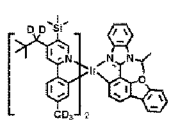
627
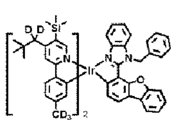
628
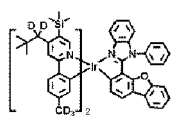
629
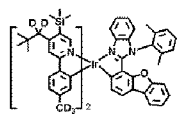
630
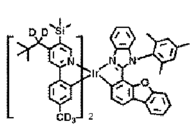
631
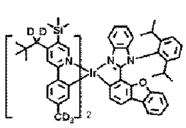
632
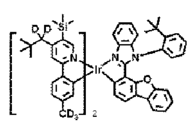
633
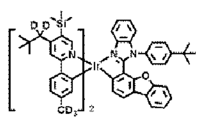
634
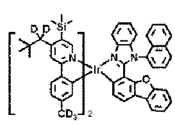
635
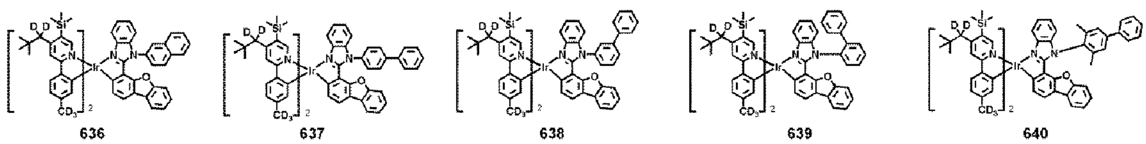
636 637 638 639 640
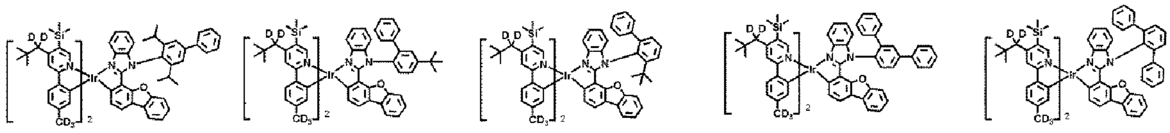
641 642 643 644 645
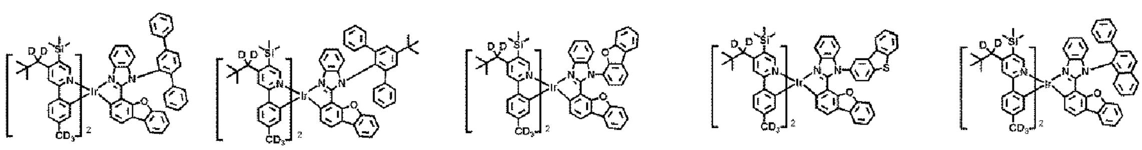
646 647 648 649 650

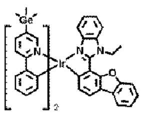
651

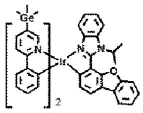
652

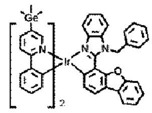
653

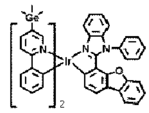
654

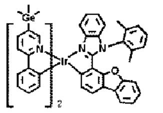
655

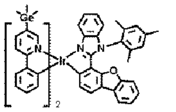
656

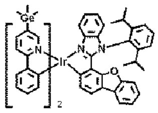
657

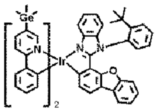
658

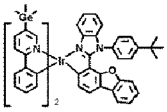
659

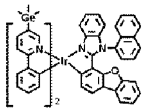
660

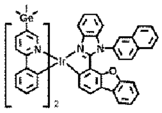
661

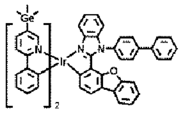
662

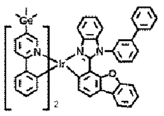
663

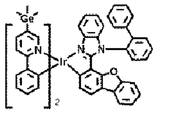
664

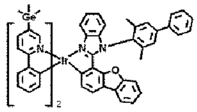
665

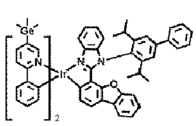
666

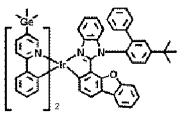
667

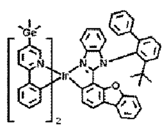
668

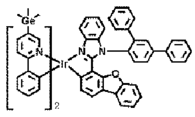
669

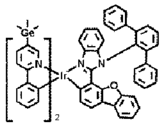
670

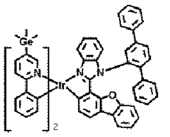
671

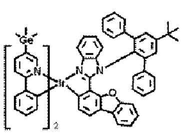
672

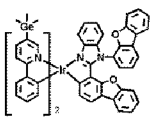
673

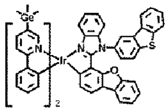
674

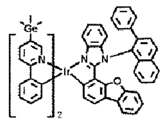
675

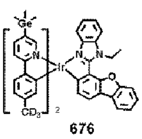
676

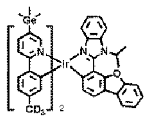
677

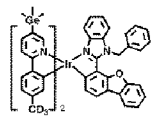
678

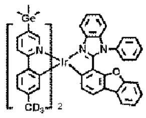
679

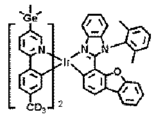
680

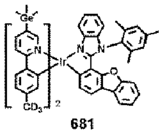
681

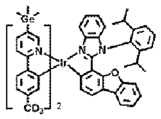
682

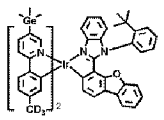
683

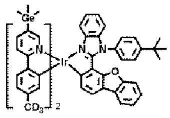
684

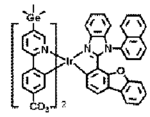
685

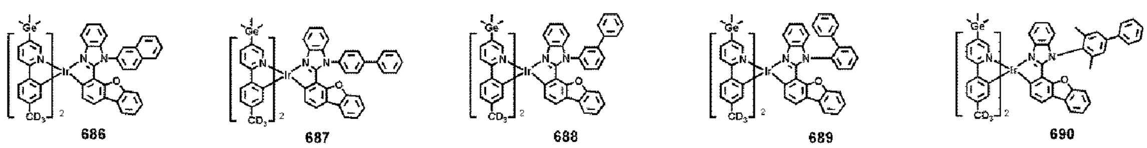
686 687 688 689 690

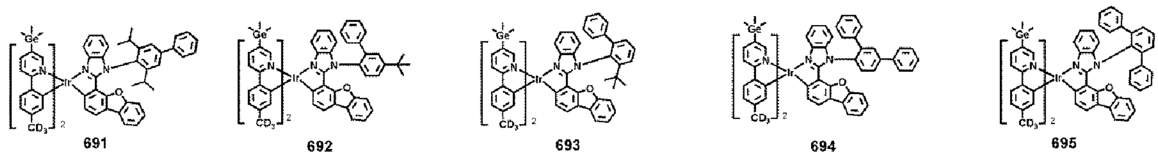
691 692 693 694 695

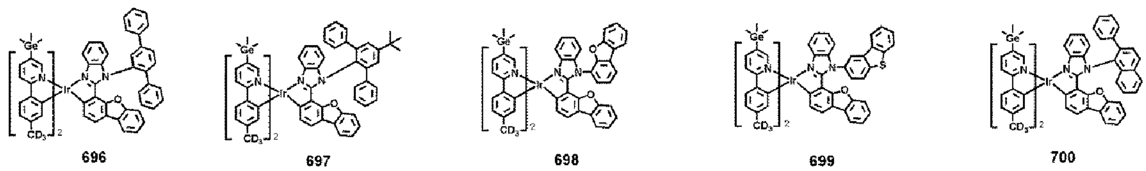
696 697 698 699 700

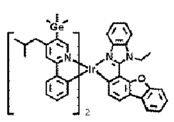
701
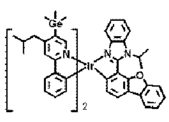
702
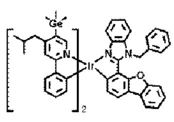
703
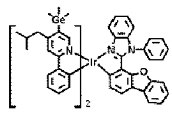
704
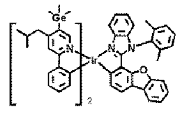
705
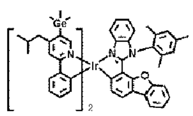
706
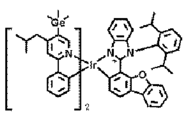
707
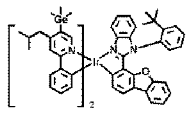
708
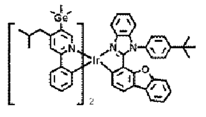
709
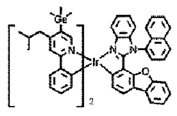
710
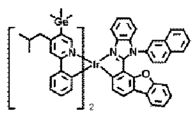
711
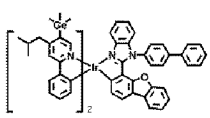
712
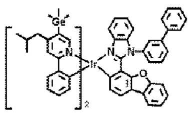
713
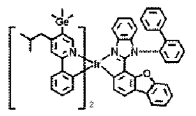
714
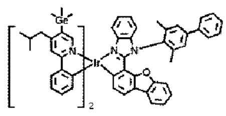
715
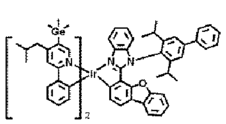
716
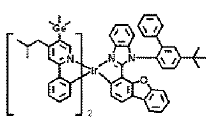
717
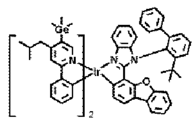
718
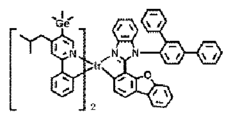
719
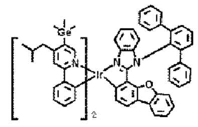
720
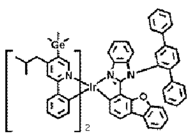
721
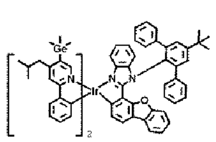
722
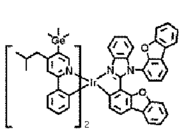
723
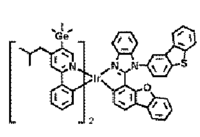
724
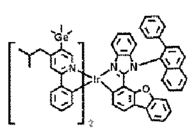
725
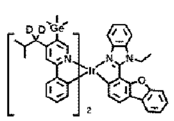
726
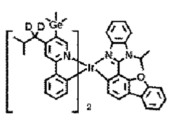
727
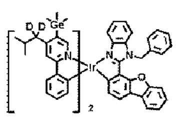
728
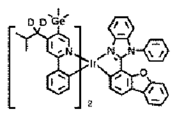
729
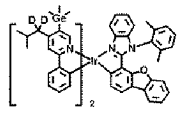
730
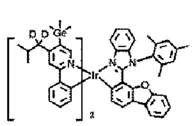
731
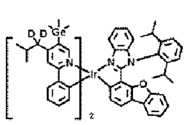
732
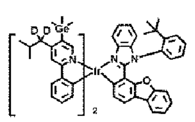
733
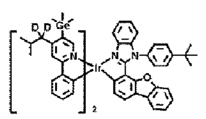
734
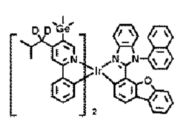
735
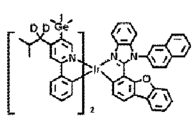
736
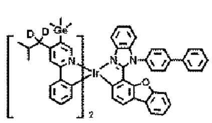
737
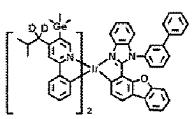
738
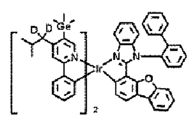
739
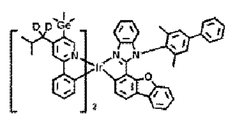
740
741
742
743
744
745
746
747
748
749
750

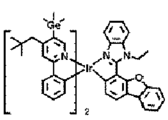
751
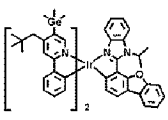
752
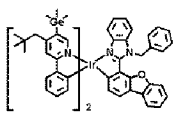
753
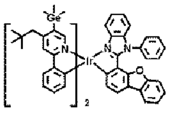
754
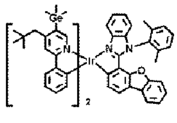
755
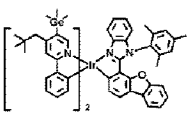
756
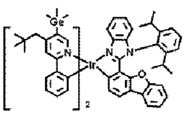
757
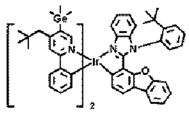
758
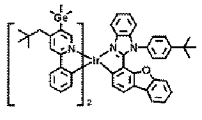
759
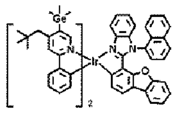
760
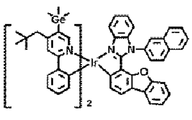
761
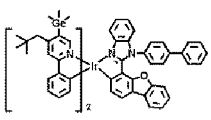
762
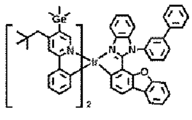
763
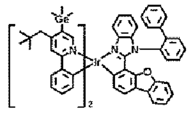
764
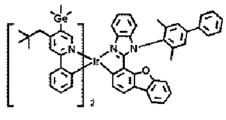
765
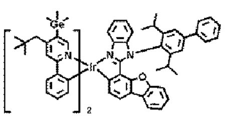
766
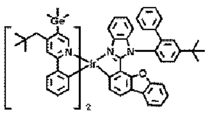
767
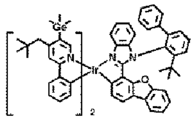
768
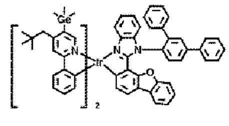
769
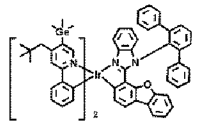
770
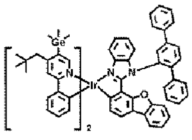
771
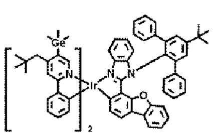
772
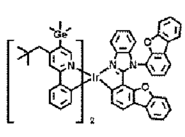
773
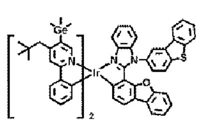
774
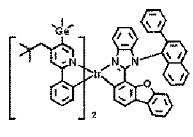
775
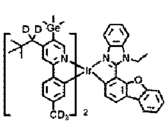
776
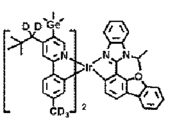
777
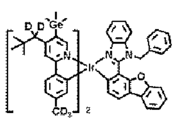
778
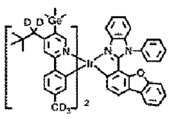
779
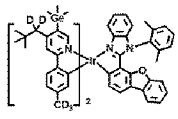
780
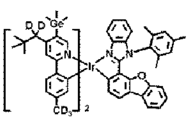
781
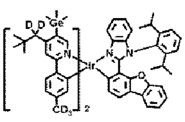
782
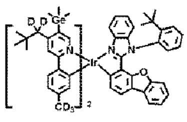
783
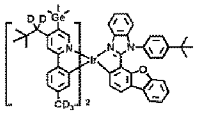
784
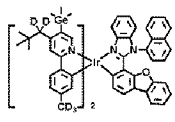
785
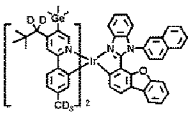
786
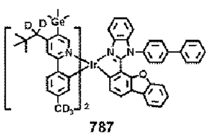
787
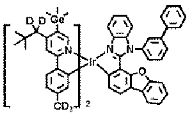
788
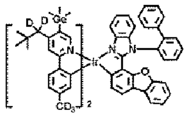
789
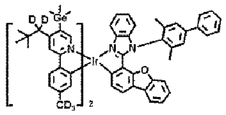
790
791
792
793
794
795
796
797
798
799
800

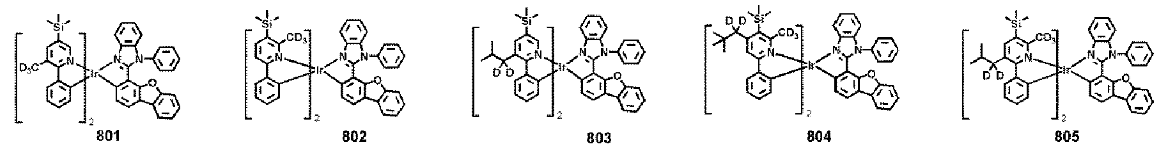
801 802 803 804 805

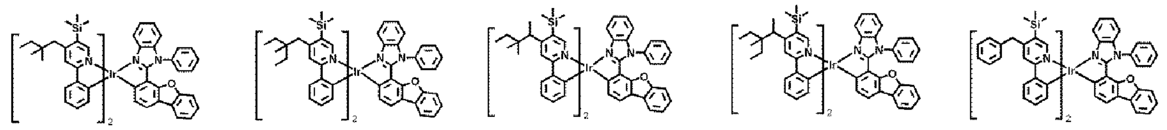
806 807 808 809 810

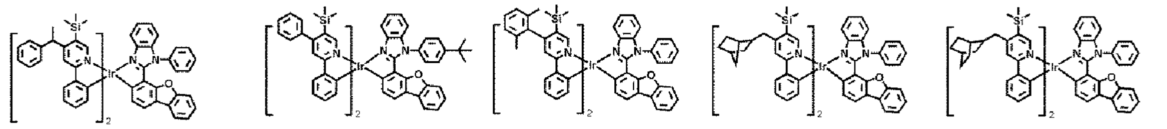
811 812 813 814 815

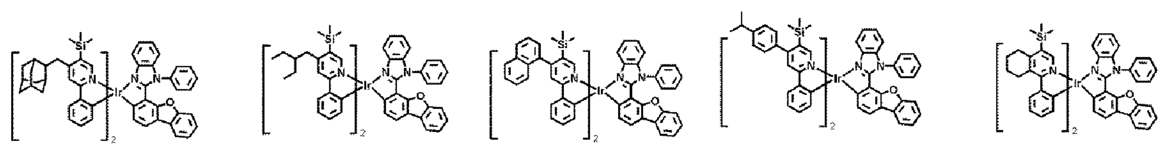
816 817 818 819 820

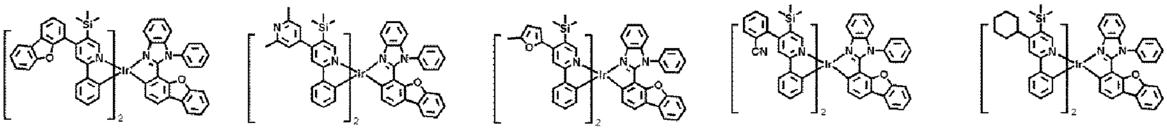
821 822 823 824 825

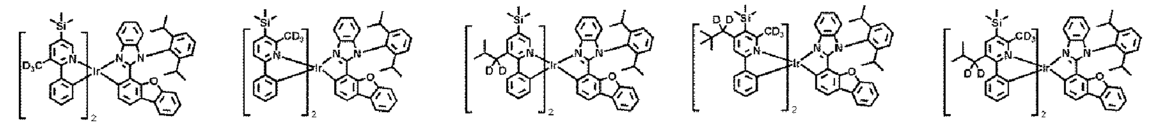
826 827 828 829 830

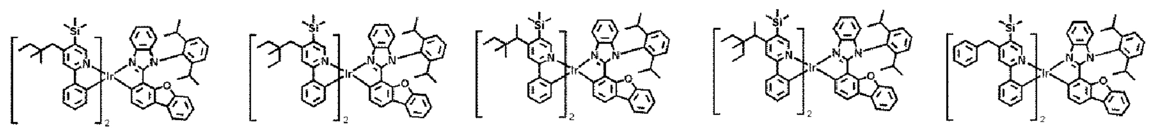
831 832 833 834 835

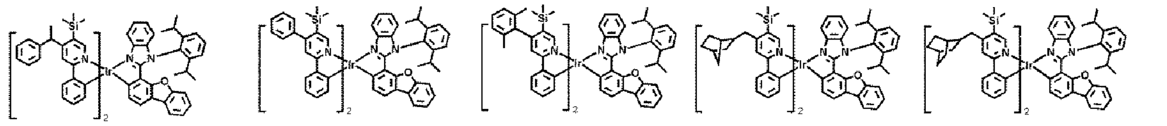
836 837 838 839 840

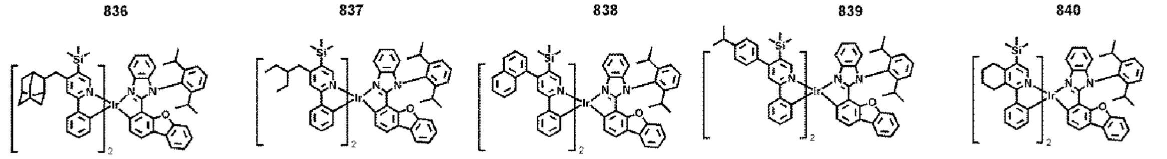
841 842 843 844 845

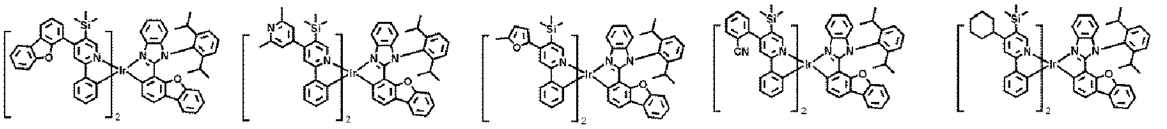
846 847 848 849 850

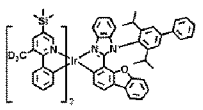
851
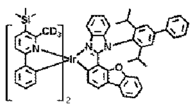
852
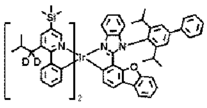
853
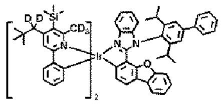
854
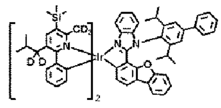
855

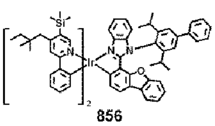
856
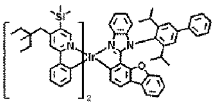
857
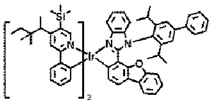
858
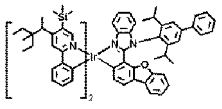
859
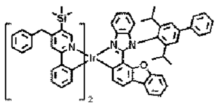
860

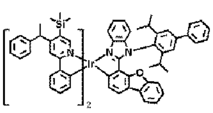
861
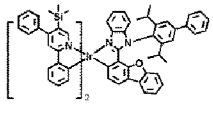
862
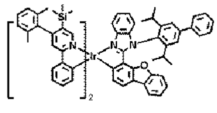
863
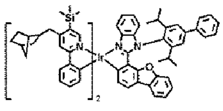
864
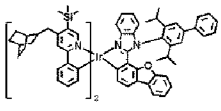
865

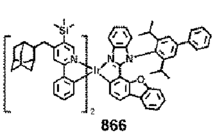
866
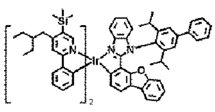
867
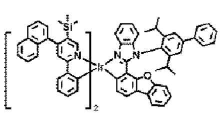
868
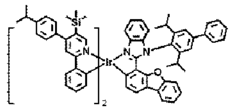
869
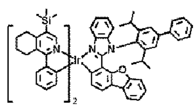
870

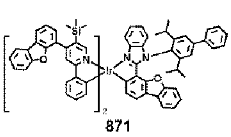
871
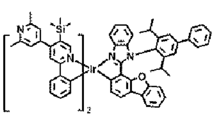
872
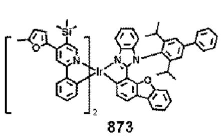
873
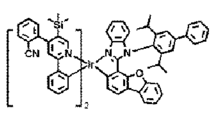
874
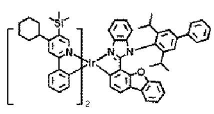
875

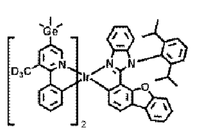
876
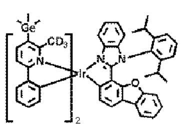
877
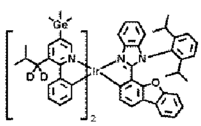
878
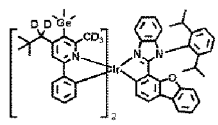
879
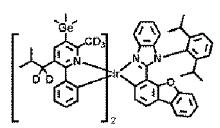
880

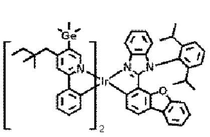
881
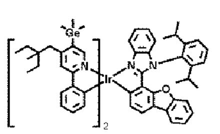
882
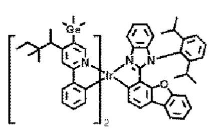
883
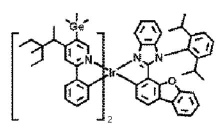
884
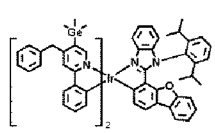
885

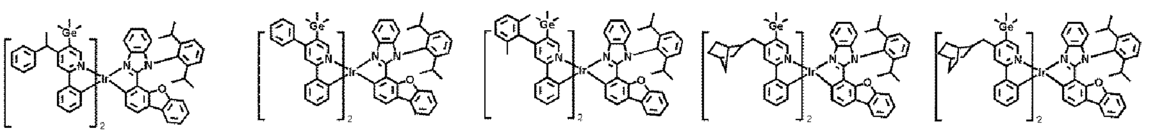
886 887 888 889 890

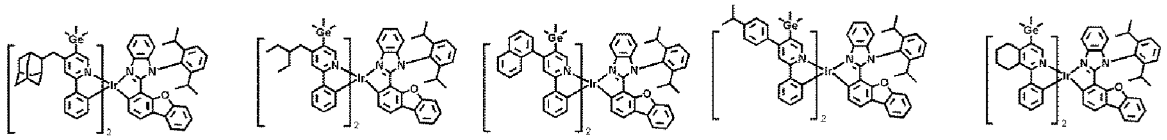
891 892 893 894 895

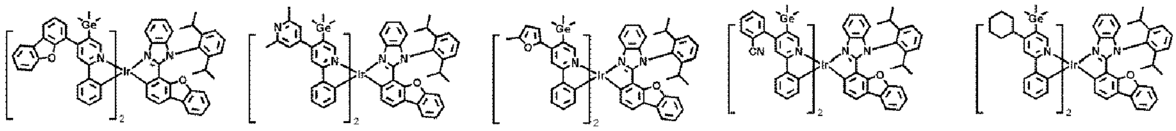
896 897 898 899 900

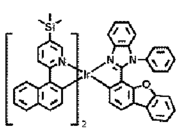
901
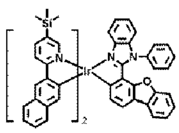
902
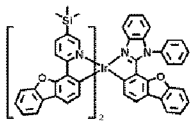
903
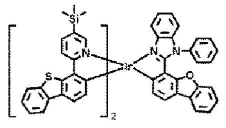
904
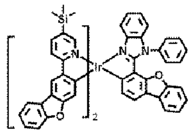
905
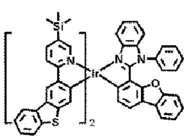
906
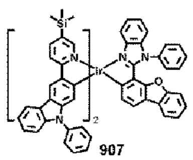
907
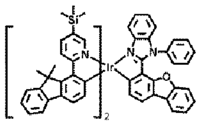
908
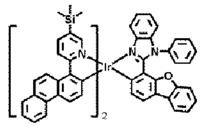
909
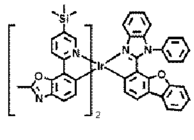
910
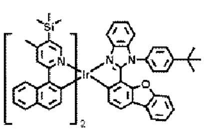
911
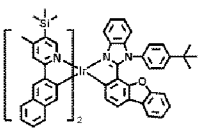
912
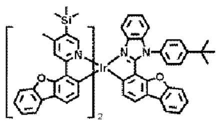
913
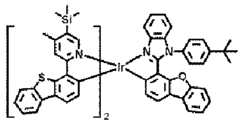
914
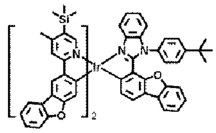
915
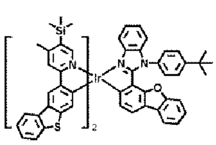
916
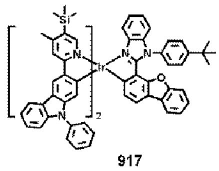
917
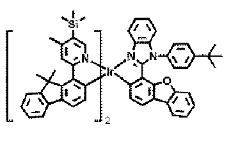
918
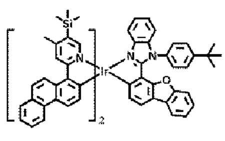
919
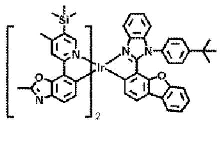
920
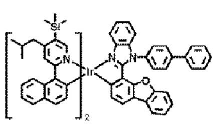
921
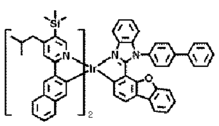
922
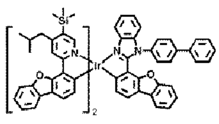
923
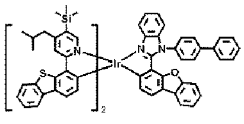
924
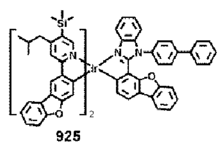
925
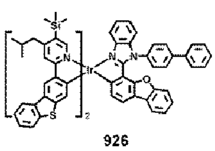
926
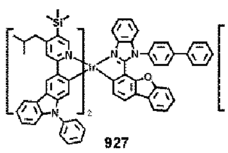
927
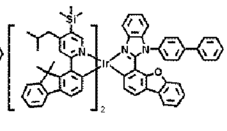
928
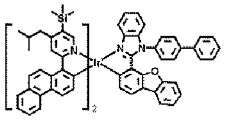
929
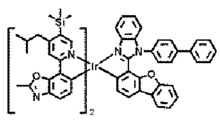
930
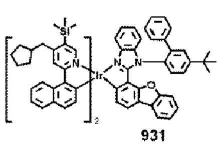
931
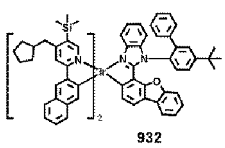
932
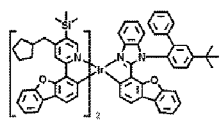
933
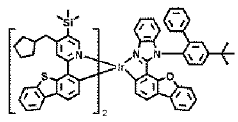
934
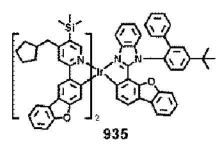
935
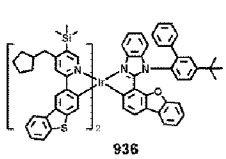
936
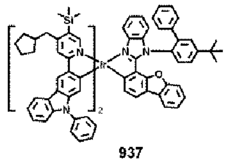
937
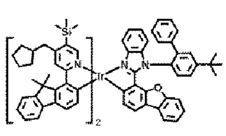
938
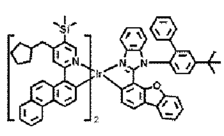
939
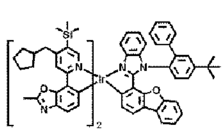
940

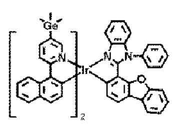
941

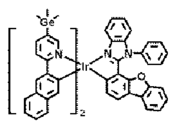
942

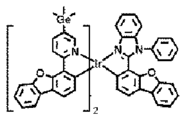
943

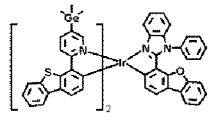
944

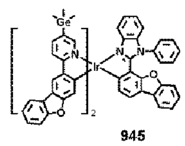
945

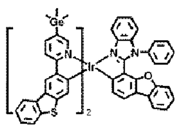
946

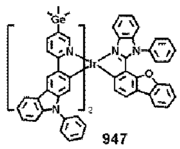
947

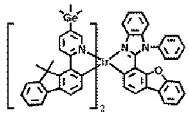
948

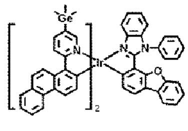
949

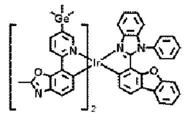
950

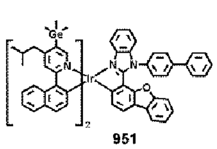
951

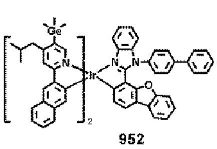
952

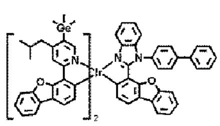
953

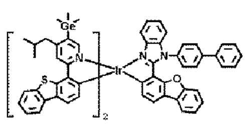
954

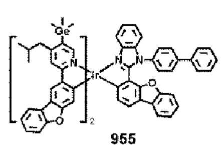
955

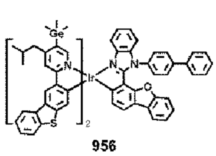
956

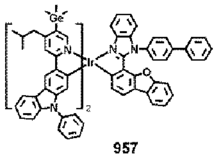
957

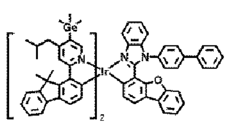
958

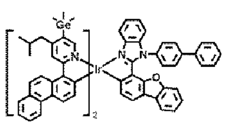
959

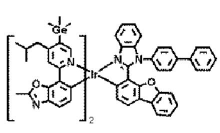
960

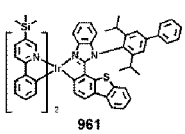
961

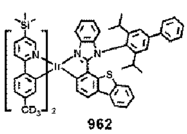
962

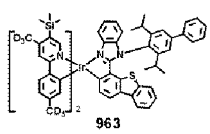
963

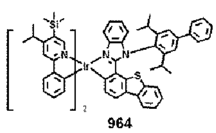
964

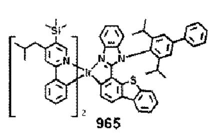
965

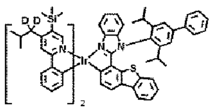
966

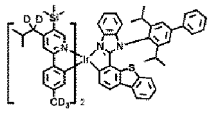
967

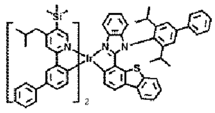
968

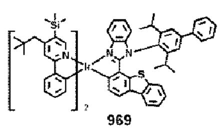
969

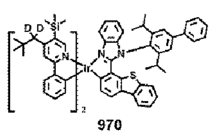
970

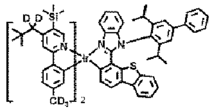
971

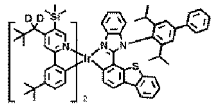
972

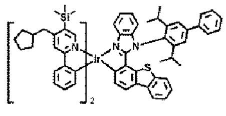
973

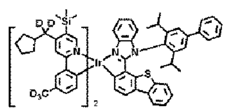
974

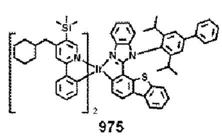
975

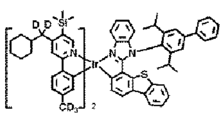
976

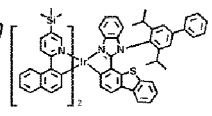
977

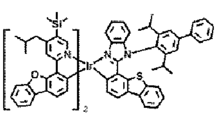
978

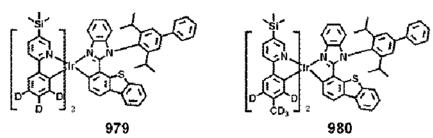
979

980

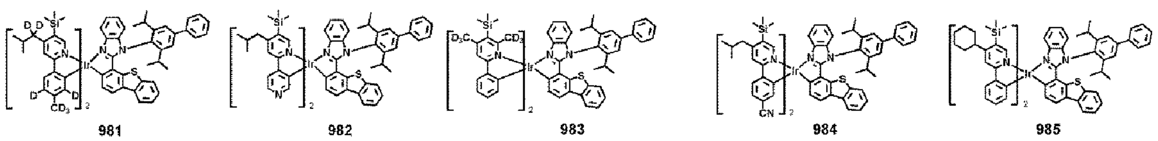
981

982

983

984

985

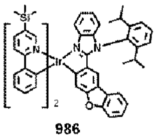
986
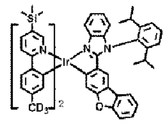
987
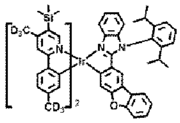
988
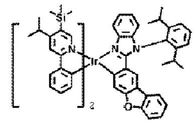
989
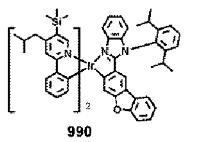
990
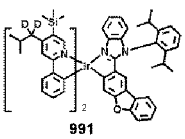
991
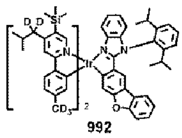
992
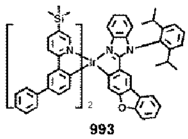
993
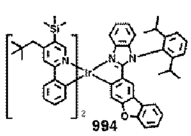
994
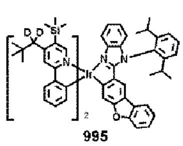
995
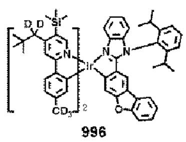
996
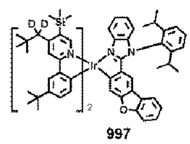
997
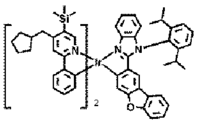
998
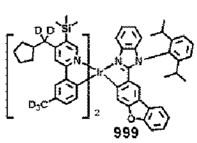
999
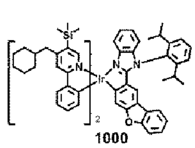
1000
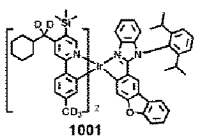
1001
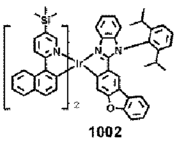
1002
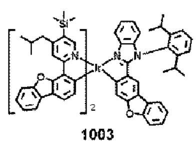
1003
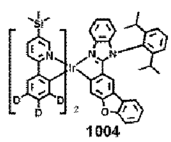
1004
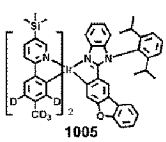
1005
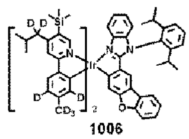
1006
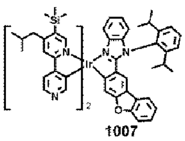
1007
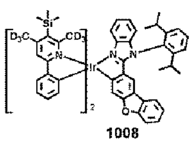
1008
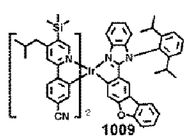
1009
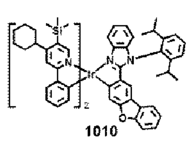
1010
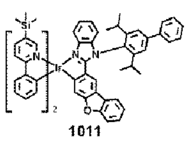
1011
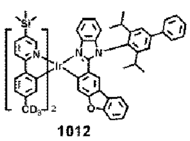
1012
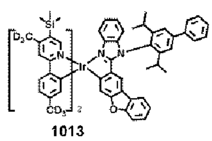
1013
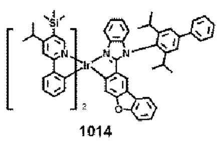
1014
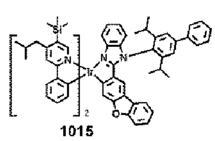
1015
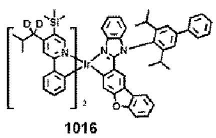
1016
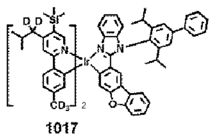
1017
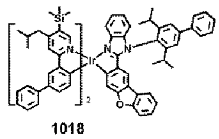
1018
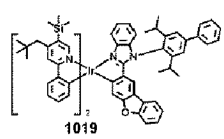
1019
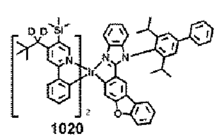
1020
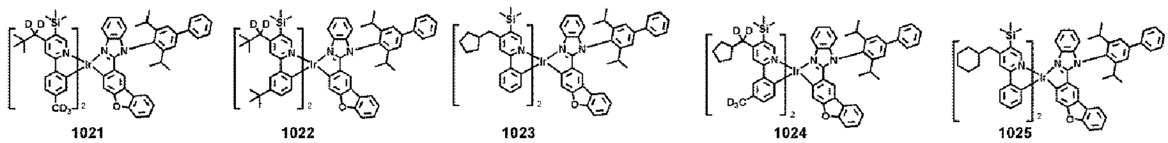
1021 1022 1023 1024 1025
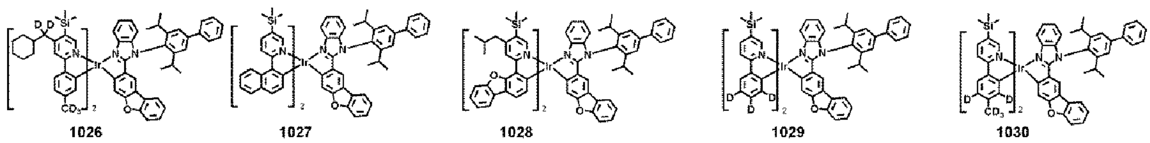
1026 1027 1028 1029 1030
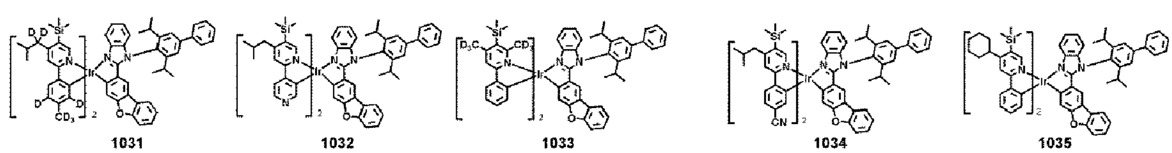
1031 1032 1033 1034 1035

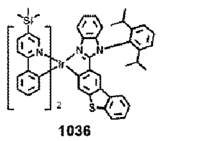
1036

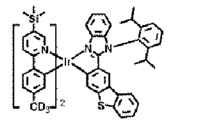
1037

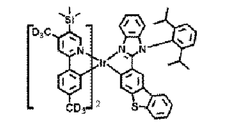
1038

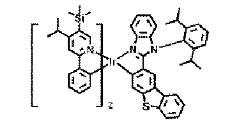
1039

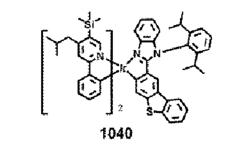
1040

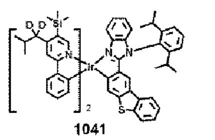
1041

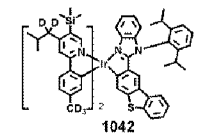
1042

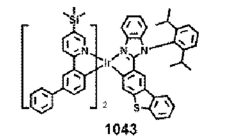
1043

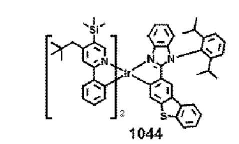
1044

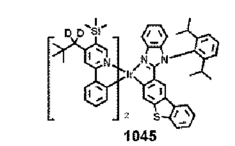
1045

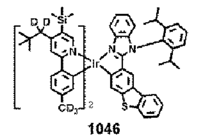
1046

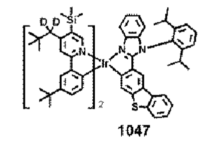
1047

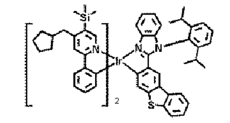
1048

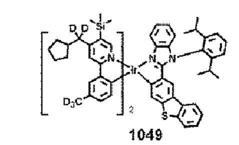
1049

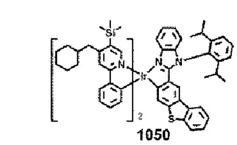
1050

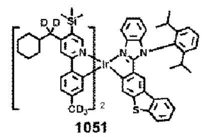
1051

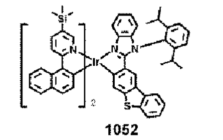
1052

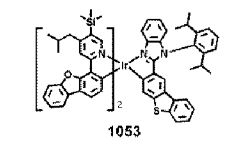
1053

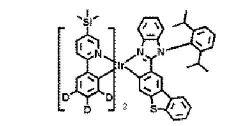
1054

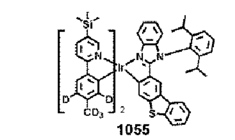
1055

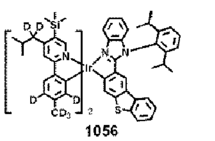
1056

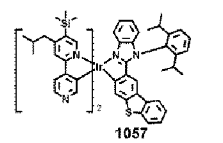
1057

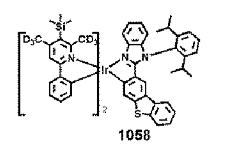
1058

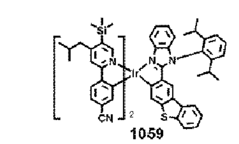
1059

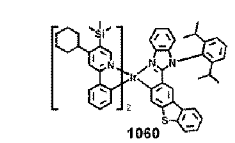
1060

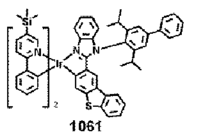
1061

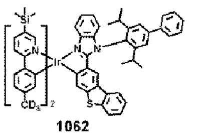
1062

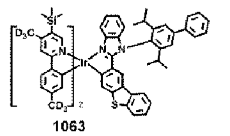
1063

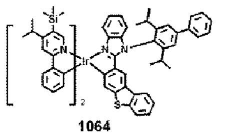
1064

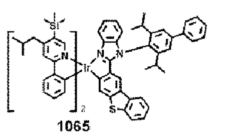
1065

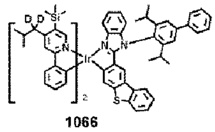
1066

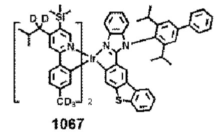
1067

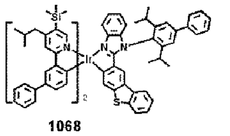
1068

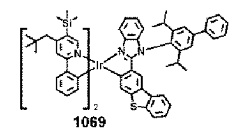
1069

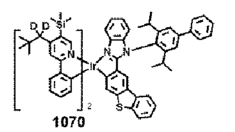
1070

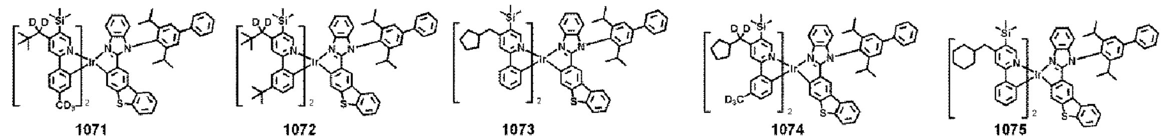
1071 1072 1073 1074 1075

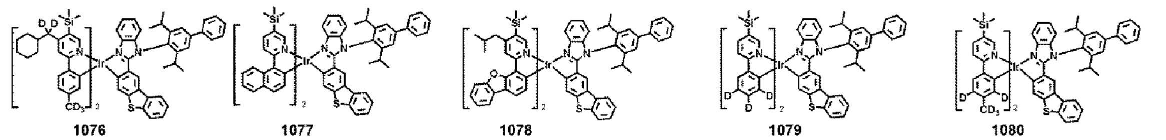
1076 1077 1078 1079 1080

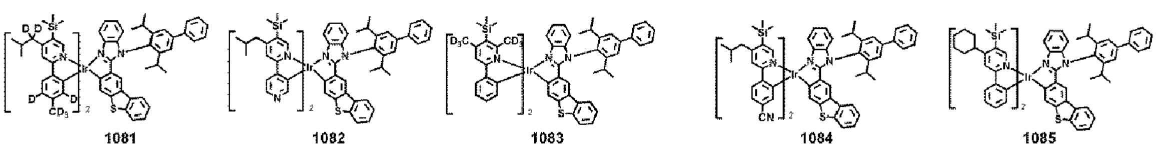
1081 1082 1083 1084 1085

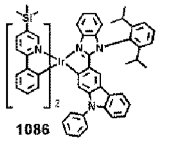
1086
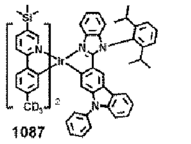
1087
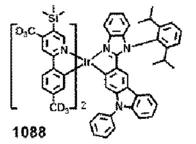
1088
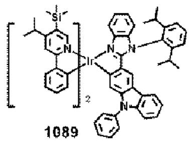
1089
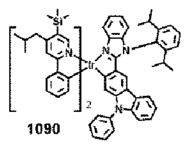
1090
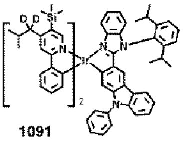
1091
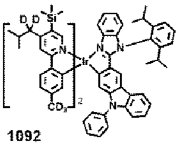
1092
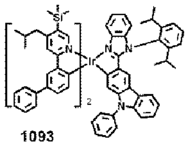
1093
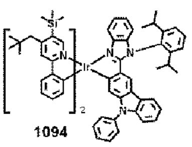
1094
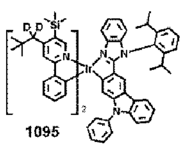
1095
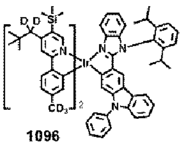
1096
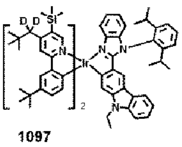
1097
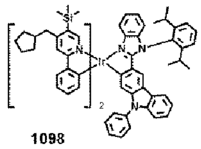
1098
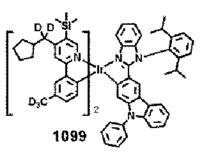
1099
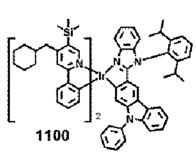
1100
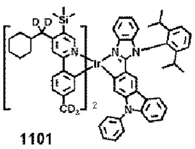
1101
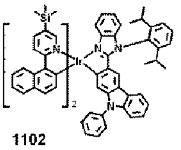
1102
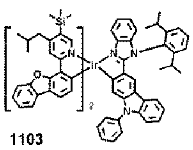
1103
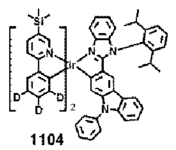
1104
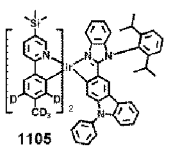
1105
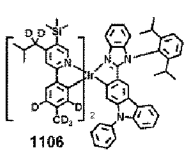
1106
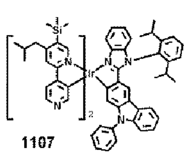
1107
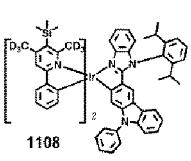
1108
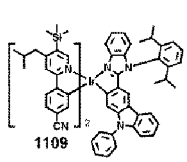
1109
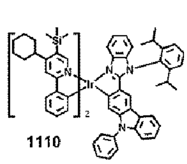
1110
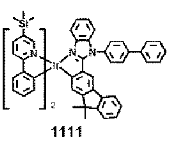
1111
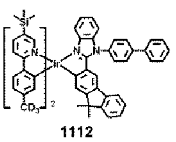
1112
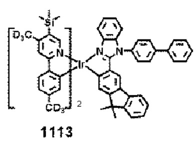
1113
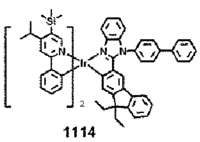
1114
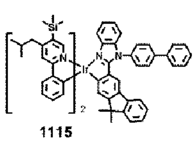
1115
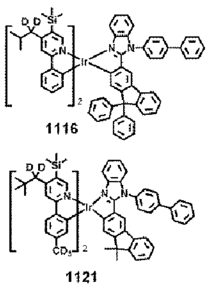
1116
1121
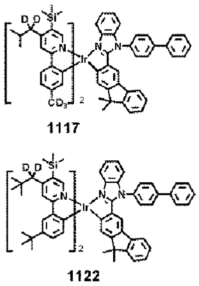
1117
1122
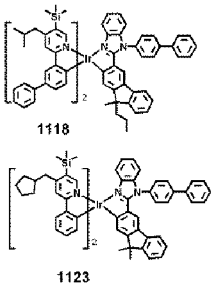
1118
1123
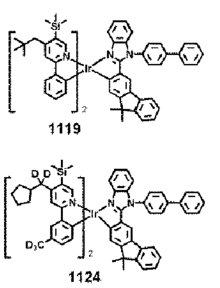
1119
1124
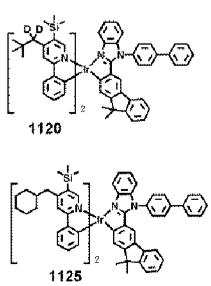
1120
1125
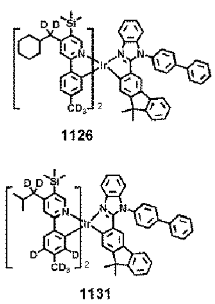
1126
1131
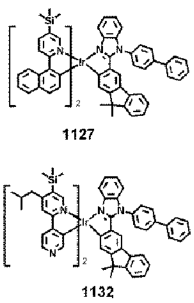
1127
1132
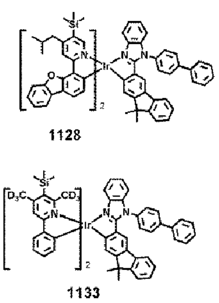
1128
1133
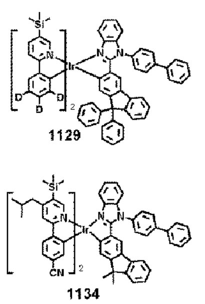
1129
1134
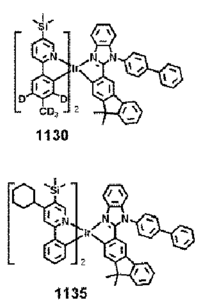
1130
1135

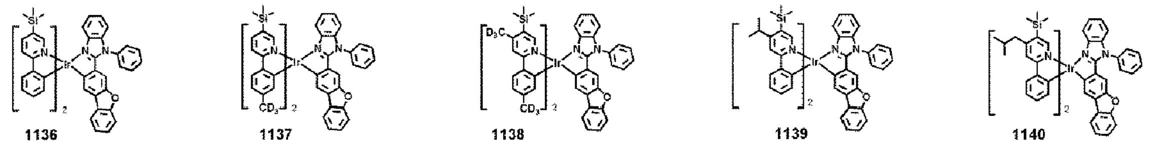
1136 1137 1138 1139 1140

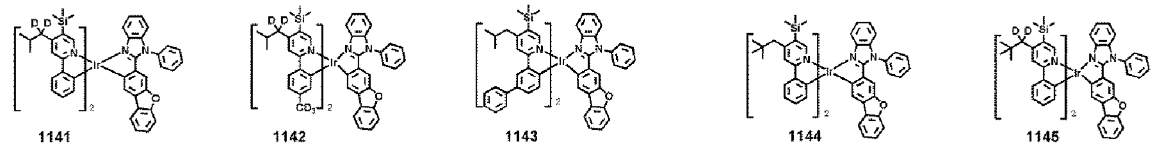
1141 1142 1143 1144 1145

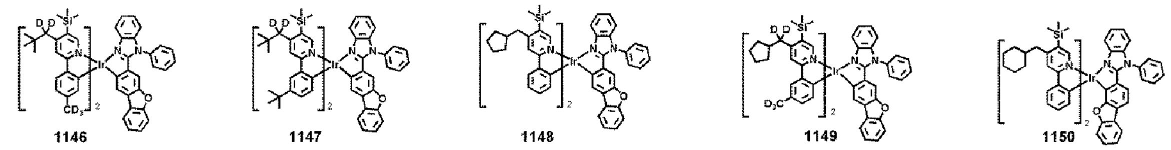
1146 1147 1148 1149 1150

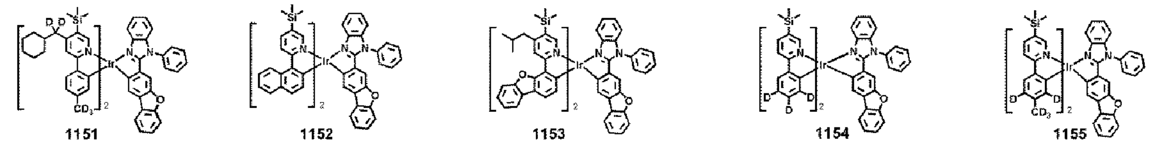
1151 1152 1153 1154 1155

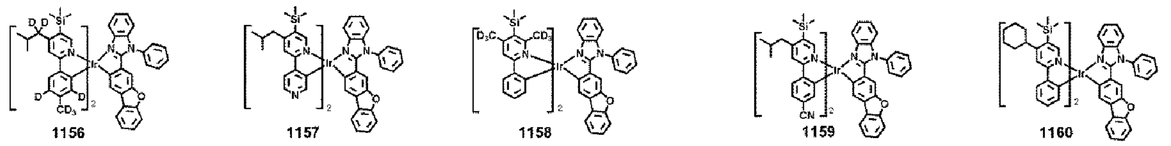
1156 1157 1158 1159 1160

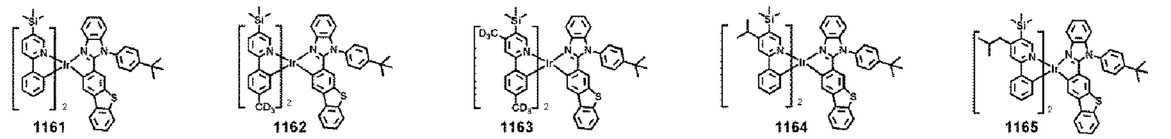
1161 1162 1163 1164 1165

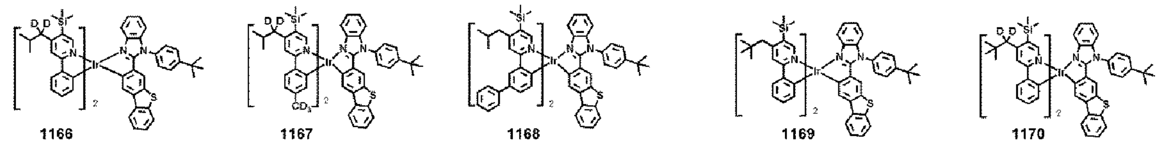
1166 1167 1168 1169 1170

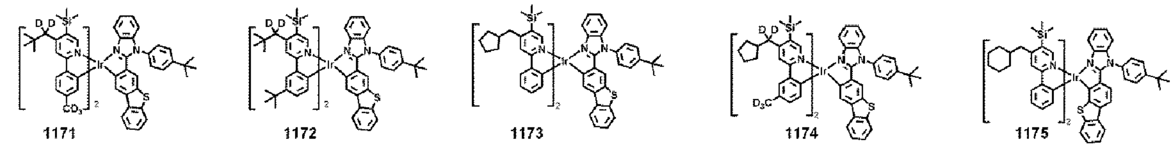
1171 1172 1173 1174 1175

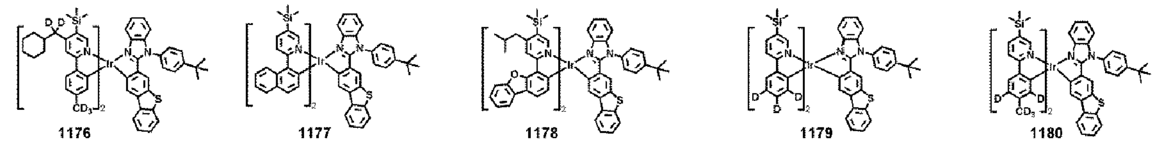
1176 1177 1178 1179 1180

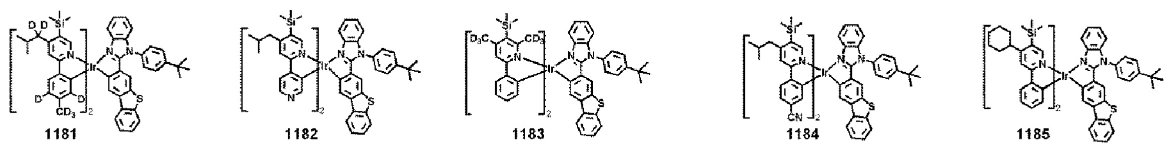
1181 1182 1183 1184 1185

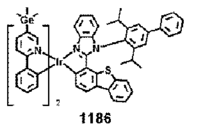
1186
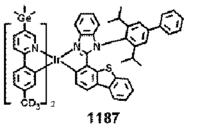
1187
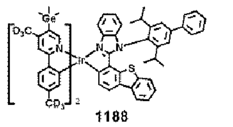
1188
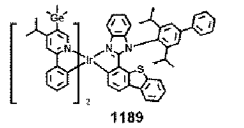
1189
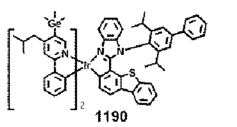
1190
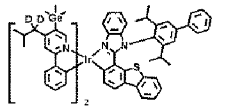
1191
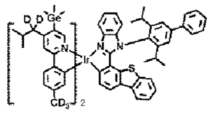
1192
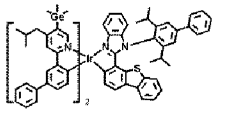
1193
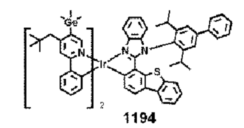
1194
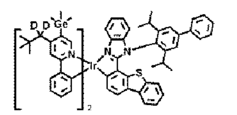
1195
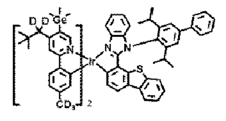
1196
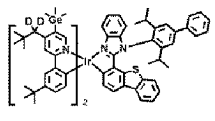
1197
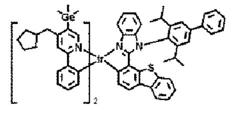
1198
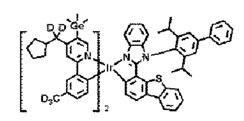
1199
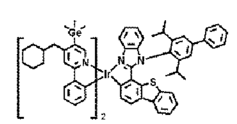
1200
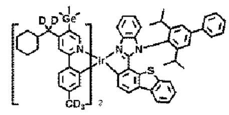
1201
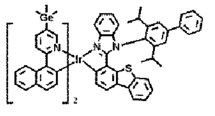
1202
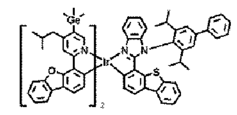
1203
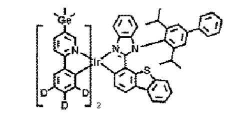
1204
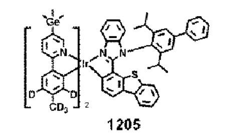
1205
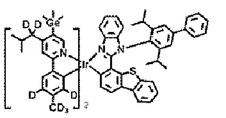
1206
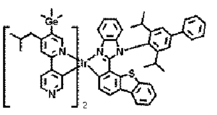
1207
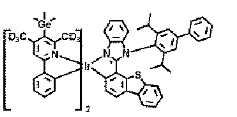
1208
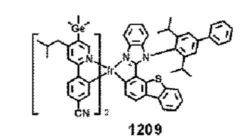
1209
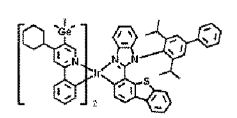
1210
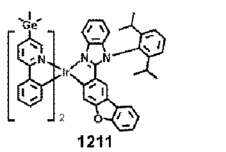
1211
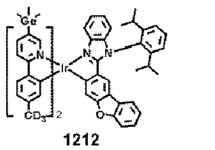
1212
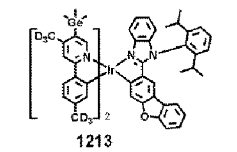
1213
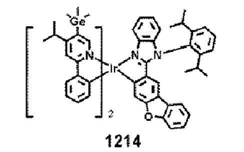
1214
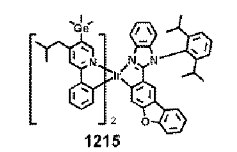
1215
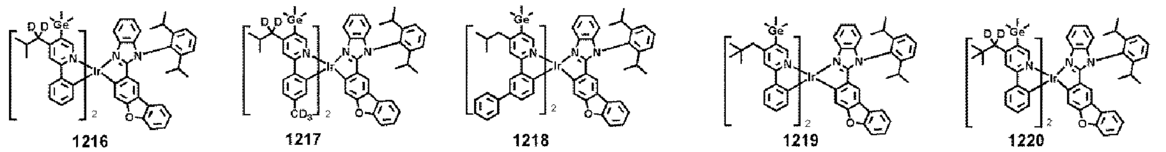
1216 1217 1218 1219 1220
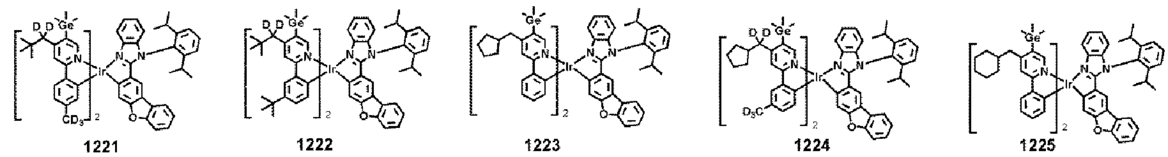
1221 1222 1223 1224 1225
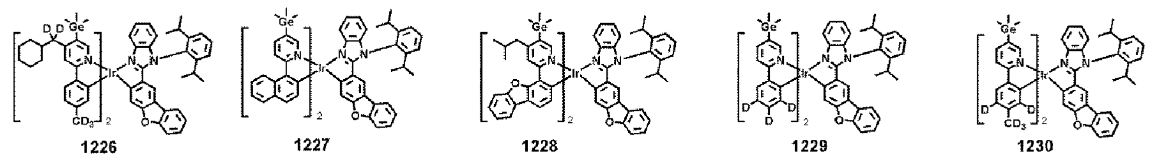
1226 1227 1228 1229 1230
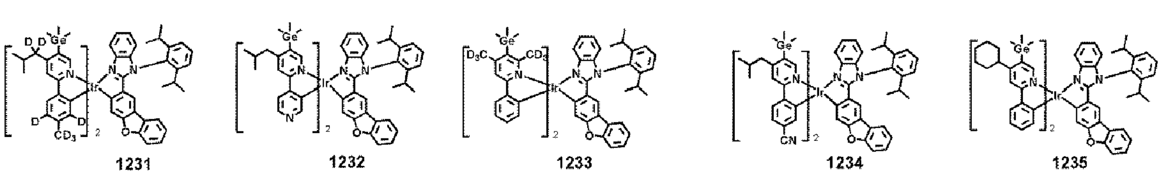
1231 1232 1233 1234 1235

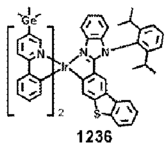
1236

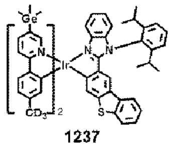
1237

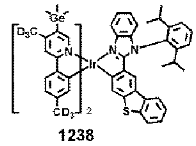
1238

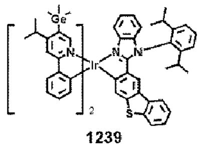
1239

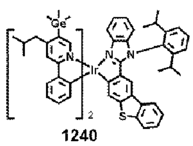
1240

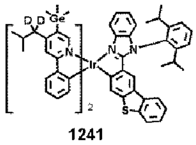
1241

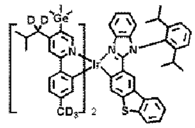
1242

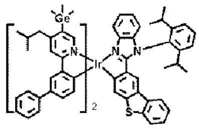
1243

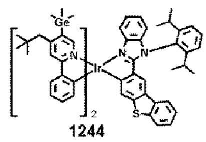
1244

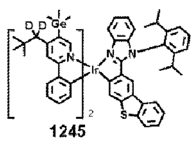
1245

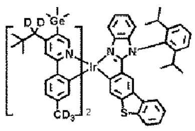
1246

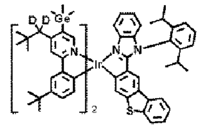
1247

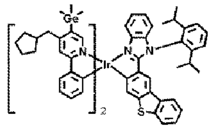
1248

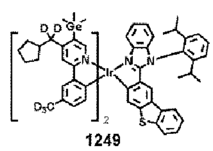
1249

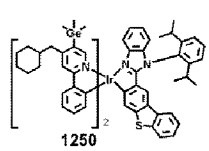
1250

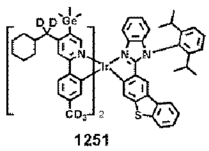
1251

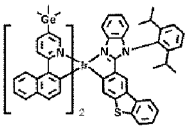
1252

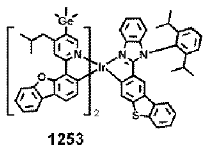
1253

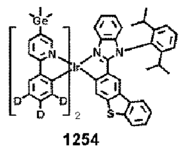
1254

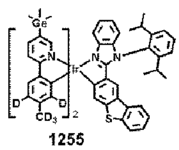
1255

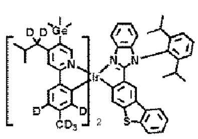
1256

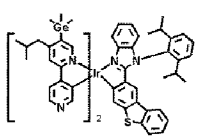
1257

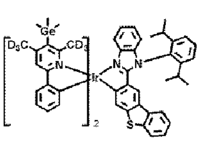
1258

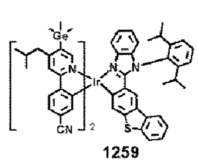
1259

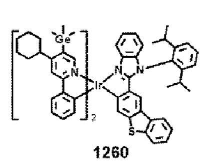
1260

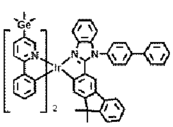
1261

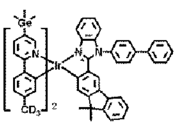
1262

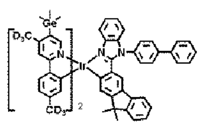
1263

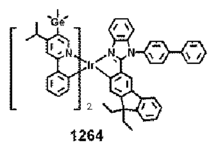
1264

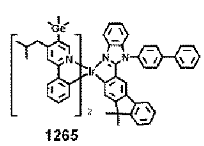
1265

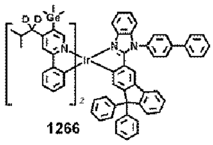
1266

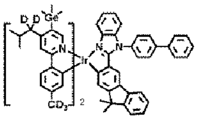
1267

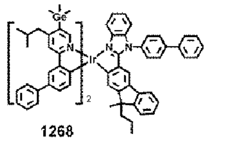
1268

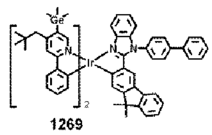
1269

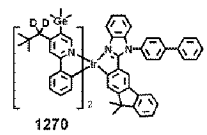
1270

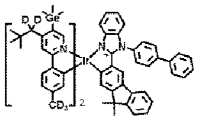
1271

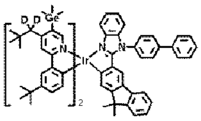
1272

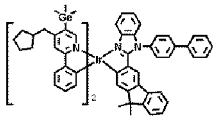
1273

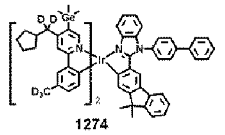
1274

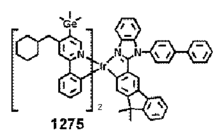
1275

1276

1277

1278

1279

1280

1281

1282

1283

1284

1285

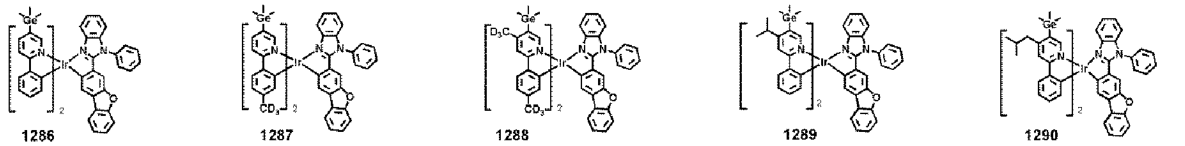
1286 1287 1288 1289 1290

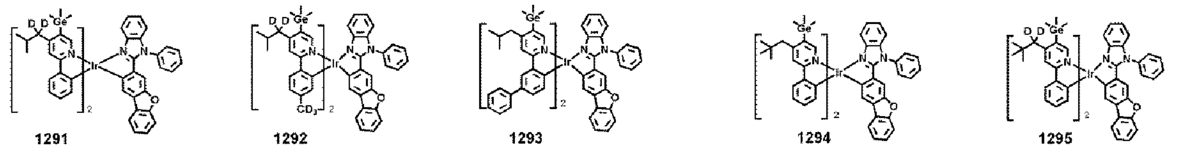
1291 1292 1293 1294 1295

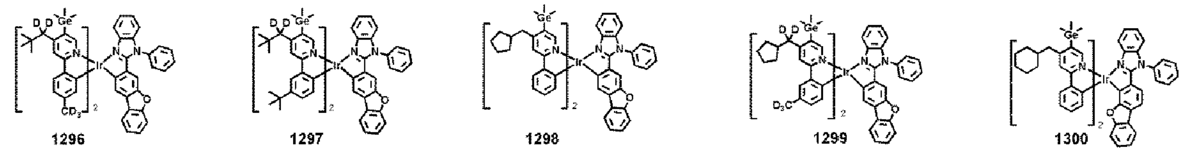
1296 1297 1298 1299 1300

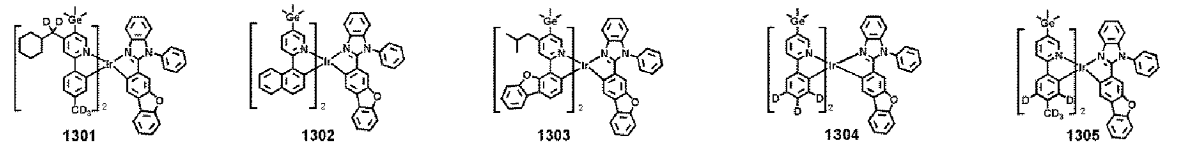
1301 1302 1303 1304 1305

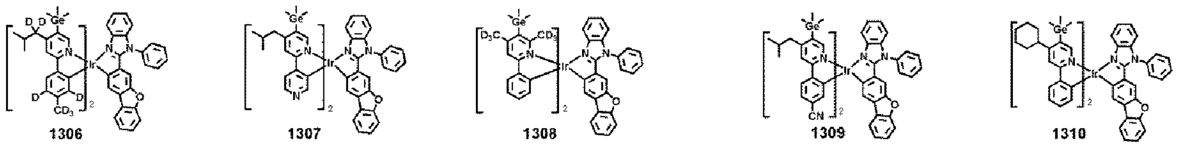
1306 1307 1308 1309 1310

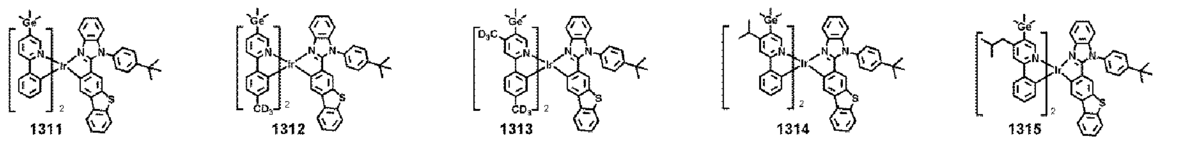
1311 1312 1313 1314 1315

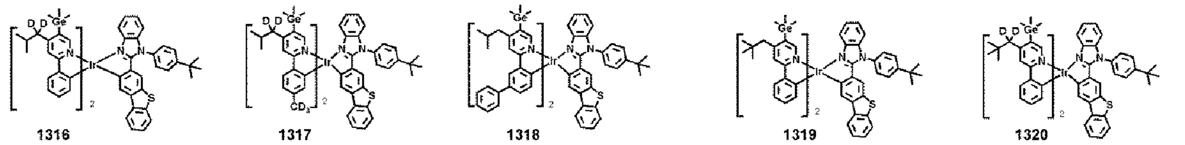
1316 1317 1318 1319 1320

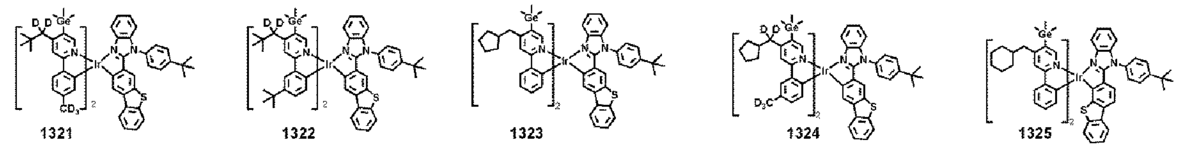
1321 1322 1323 1324 1325

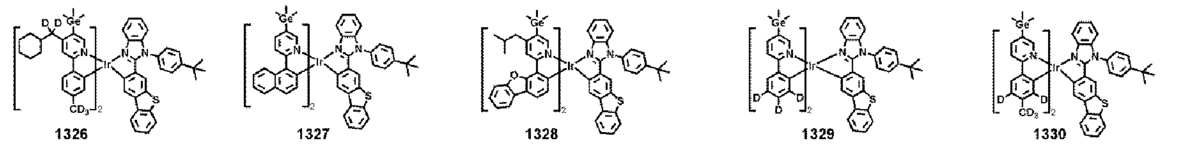
1326 1327 1328 1329 1330

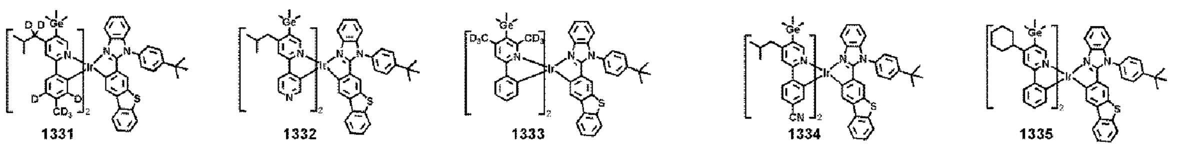
1331 1332 1333 1334 1335

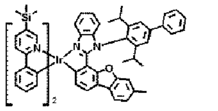
1336
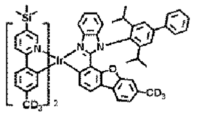
1337
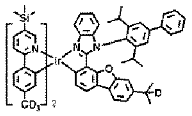
1338
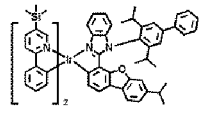
1339
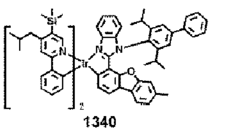
1340

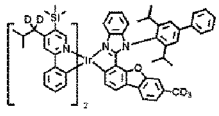
1341
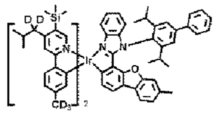
1342
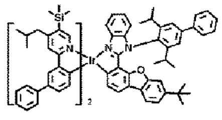
1343
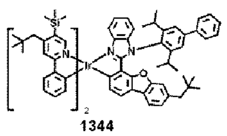
1344
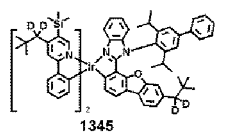
1345

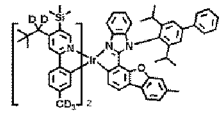
1346
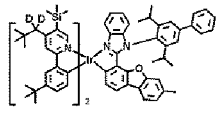
1347
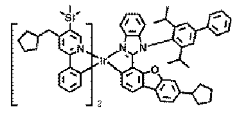
1348
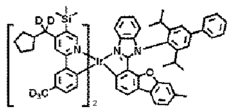
1349
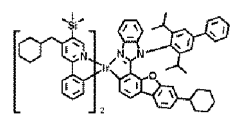
1350

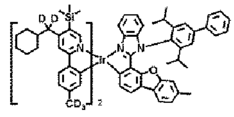
1351
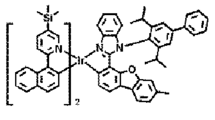
1352
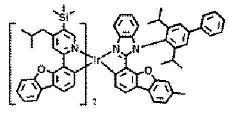
1353
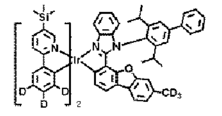
1354
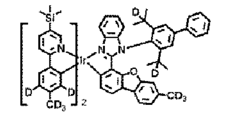
1355

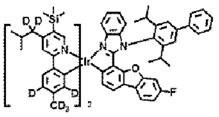
1356
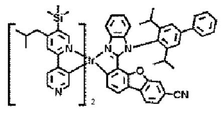
1357
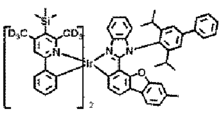
1358
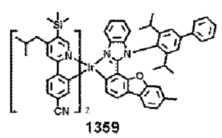
1359
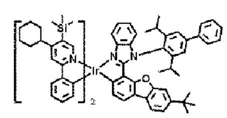
1360

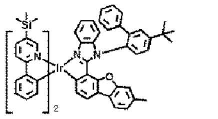
1361
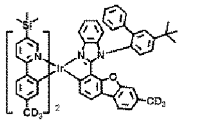
1362
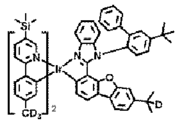
1363
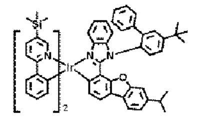
1364
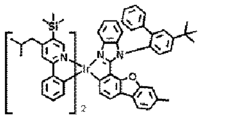
1365

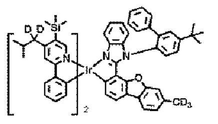
1366
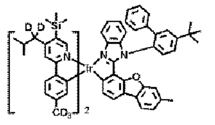
1367
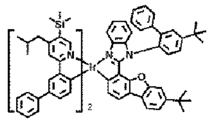
1368
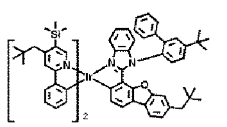
1369
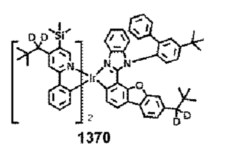
1370

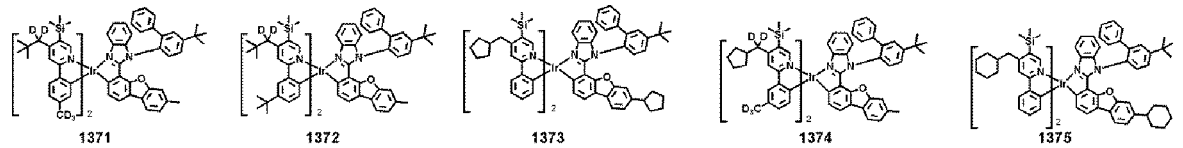
1371 1372 1373 1374 1375

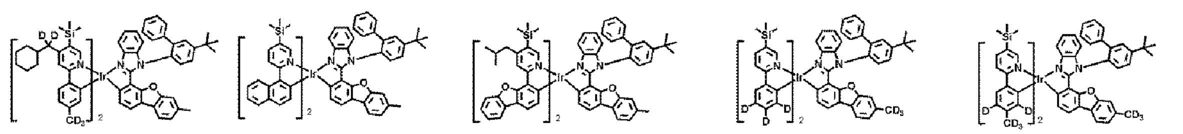
1376 1377 1378 1379 1380

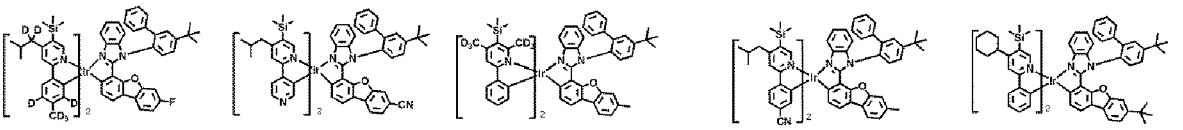
1381 1382 1383 1384 1385

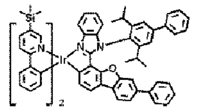
1386

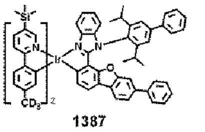
1387

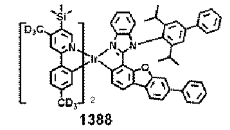
1388

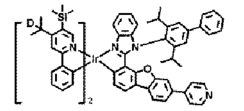
1389

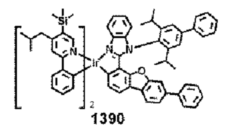
1390

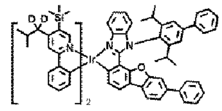
1391

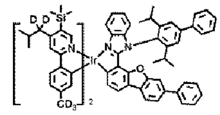
1392

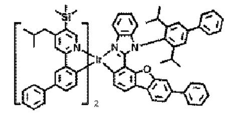
1393

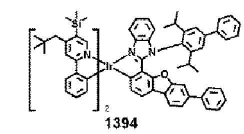
1394

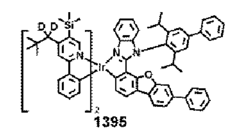
1395

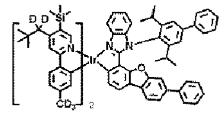
1396

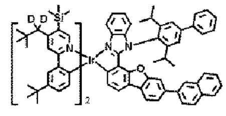
1397

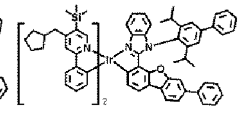
1398

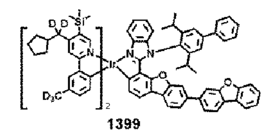
1399

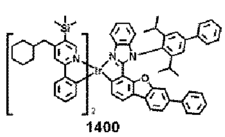
1400

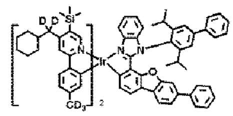
1401

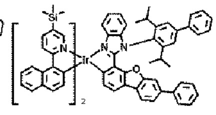
1402

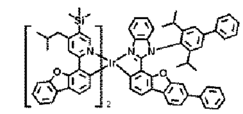
1403

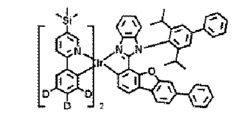
1404

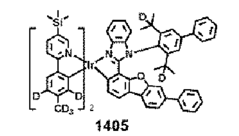
1405

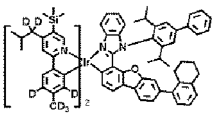
1406

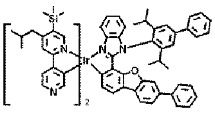
1407

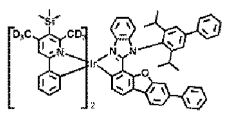
1408

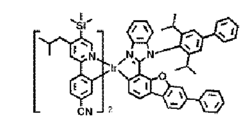
1409

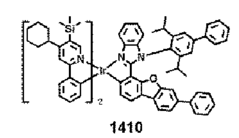
1410

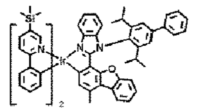
1411

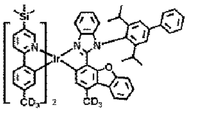
1412

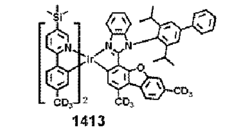
1413

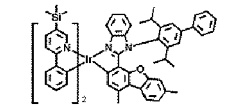
1414

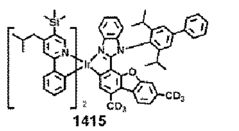
1415

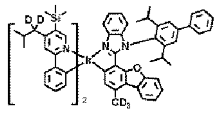
1416

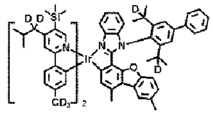
1417

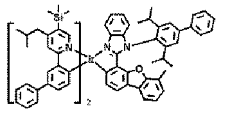
1418

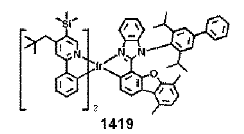
1419

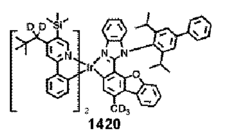
1420

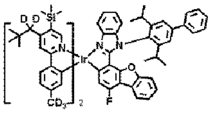
1421

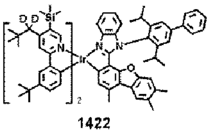
1422

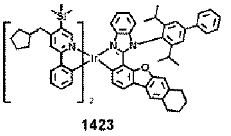
1423

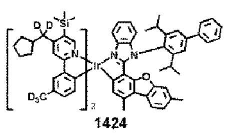
1424

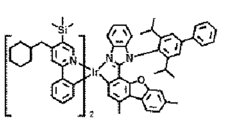
1425

1426

1427

1428

1429

1430

1431

1432

1433

1434

1435

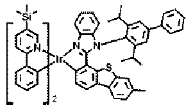
1436
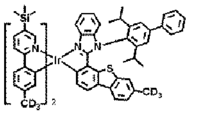
1437
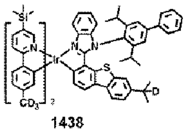
1438
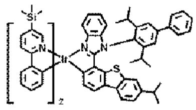
1439
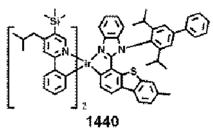
1440

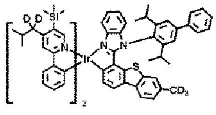
1441
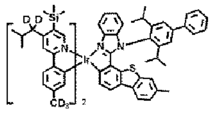
1442
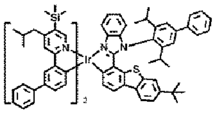
1443
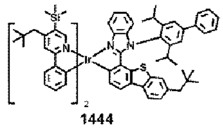
1444
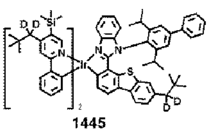
1445

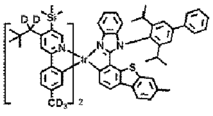
1446
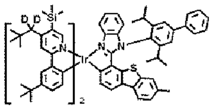
1447
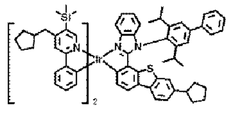
1448
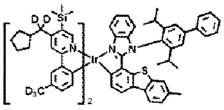
1449
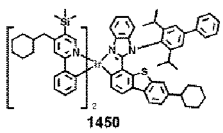
1450

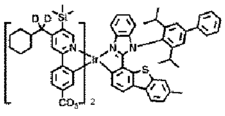
1451
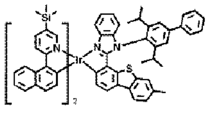
1452
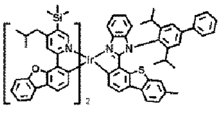
1453
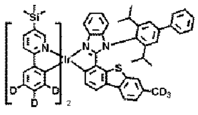
1454
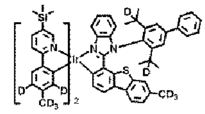
1455

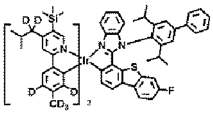
1456
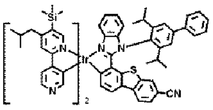
1457
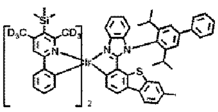
1458
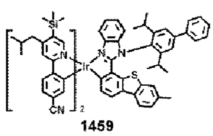
1459
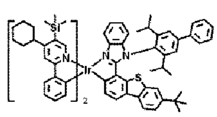
1460

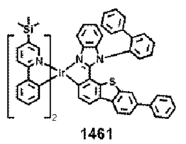
1461
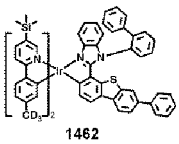
1462
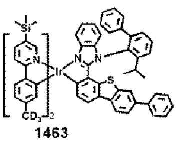
1463
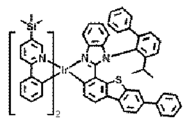
1464
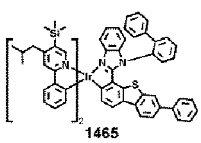
1465

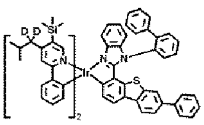
1466
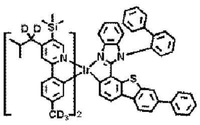
1467
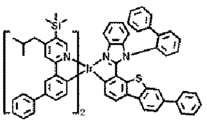
1468
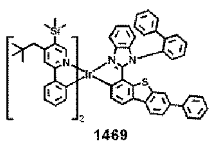
1469
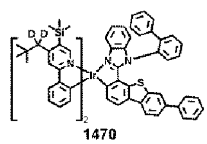
1470

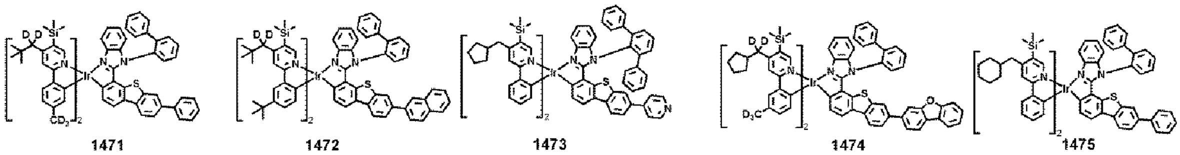
1471
1472
1473
1474
1475

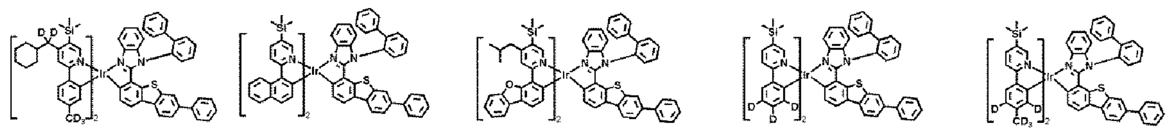
1476
1477
1478
1479
1480

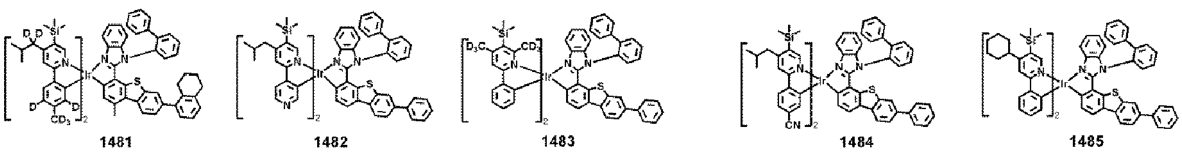
1481
1482
1483
1484
1485

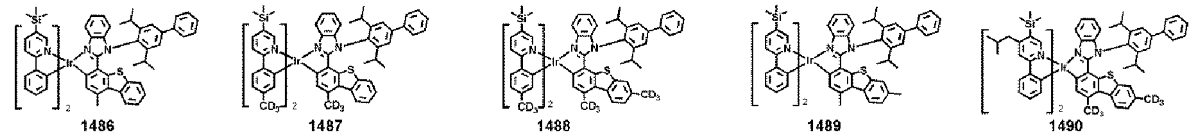
1486 1487 1488 1489 1490

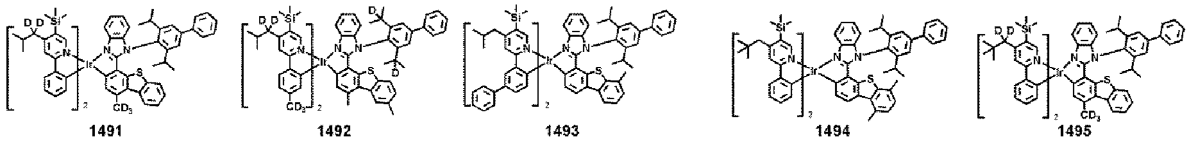
1491 1492 1493 1494 1495

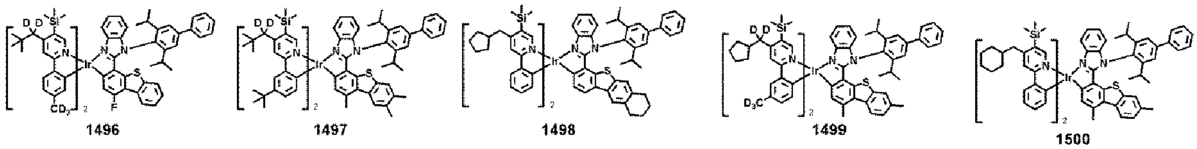
1496 1497 1498 1499 1500

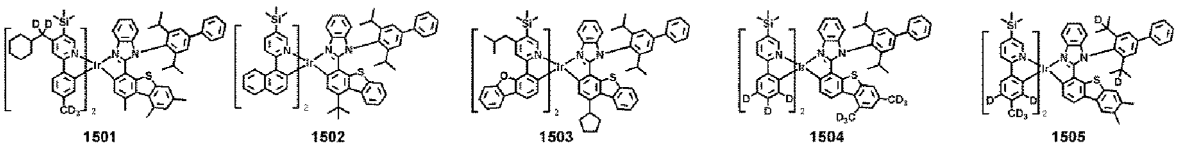
1501 1502 1503 1504 1505

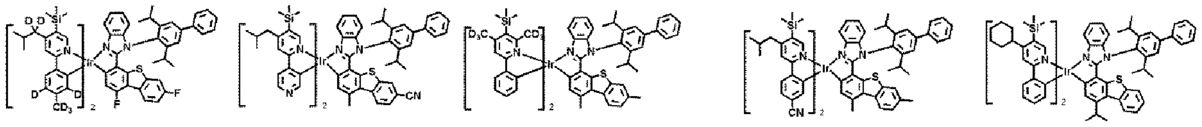
1506 1507 1508 1509 1510

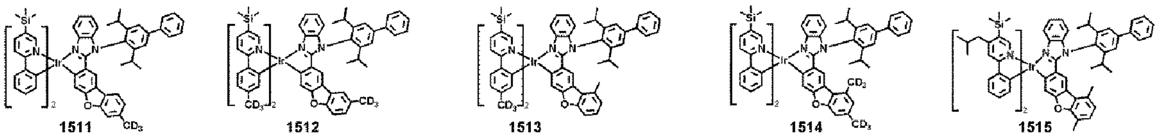
1511 1512 1513 1514 1515

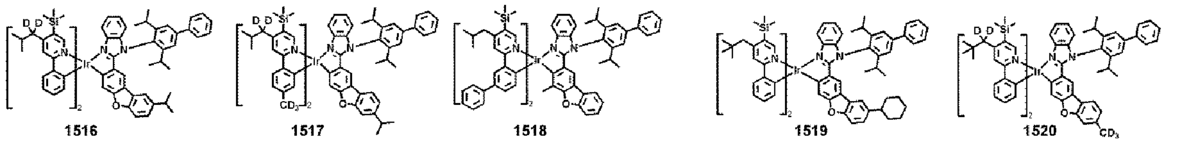
1516 1517 1518 1519 1520

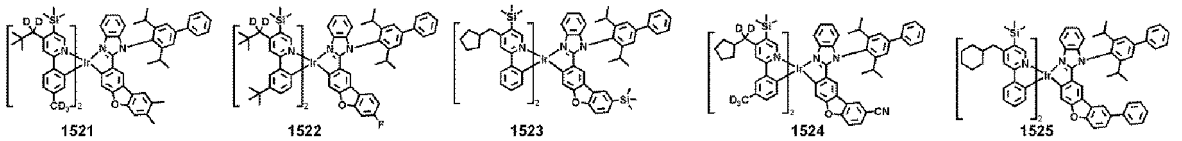
1521 1522 1523 1524 1525

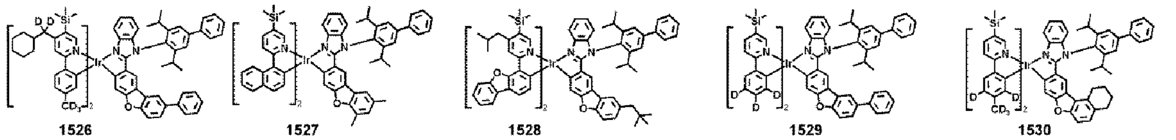
1526 1527 1528 1529 1530

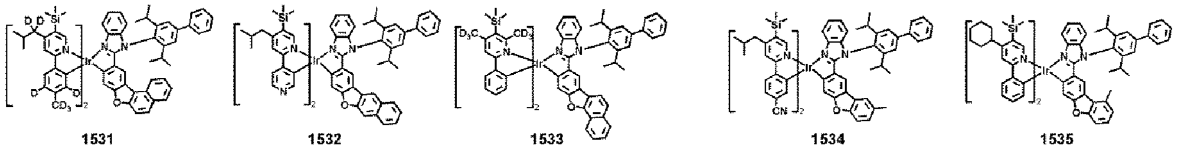
1531 1532 1533 1534 1535

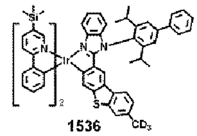
1536
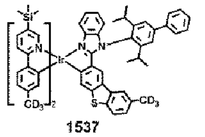
1537
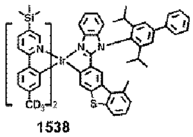
1538
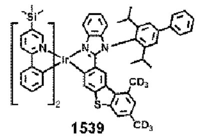
1539
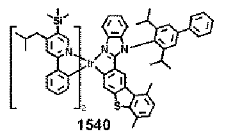
1540

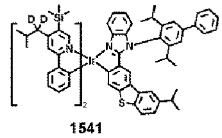
1541
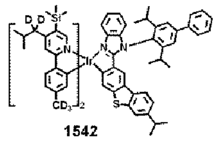
1542
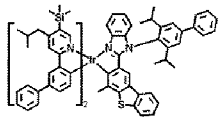
1543
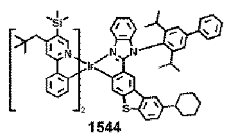
1544
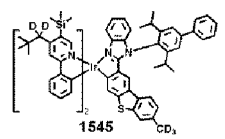
1545

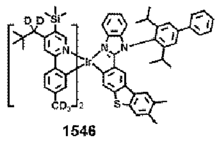
1546
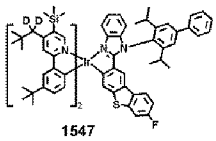
1547
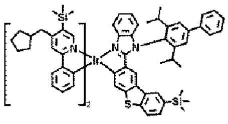
1548
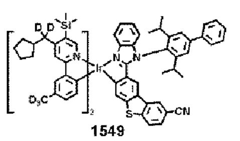
1549
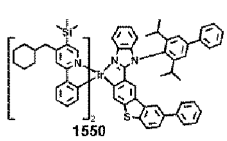
1550

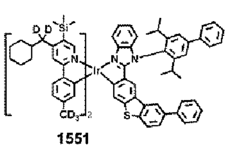
1551
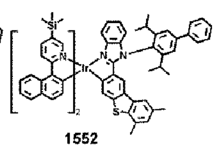
1552
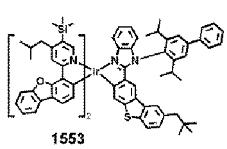
1553
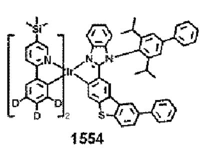
1554
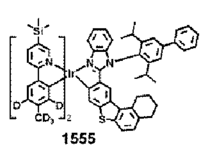
1555

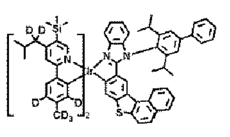
1556
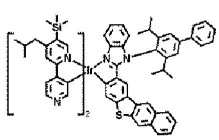
1557
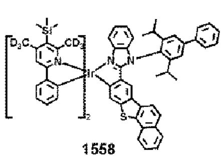
1558
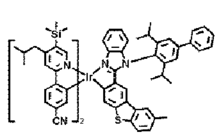
1559
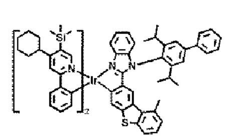
1560

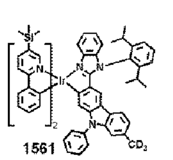
1561
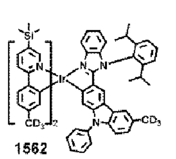
1562
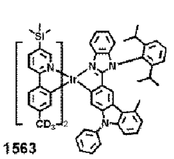
1563
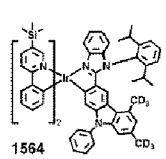
1564
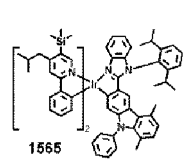
1565

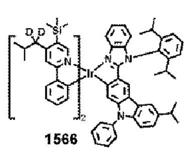
1566
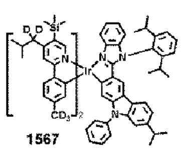
1567
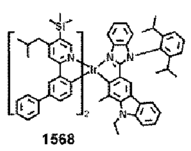
1568
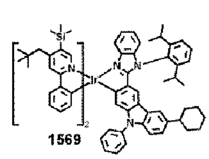
1569
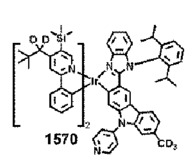
1570

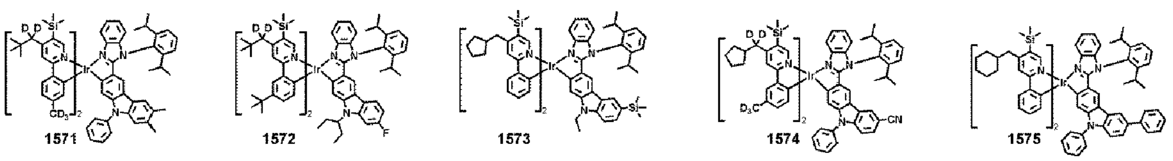
1571
1572
1573
1574
1575

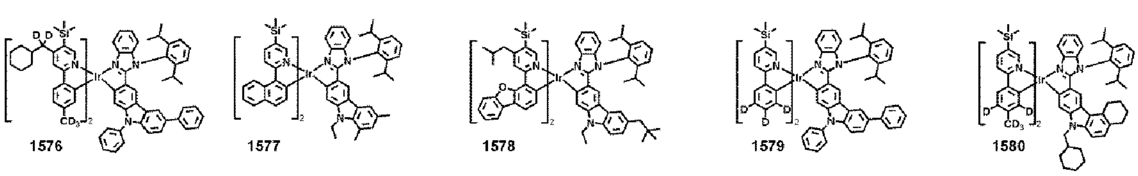
1576
1577
1578
1579
1580

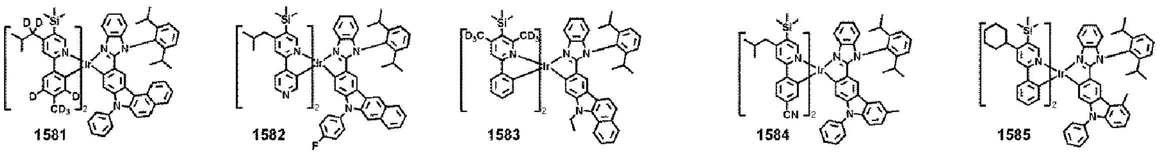
1581
1582
1583
1584
1585

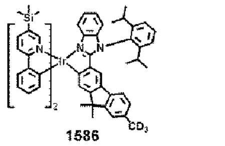
1586
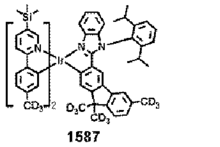
1587
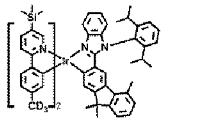
1588
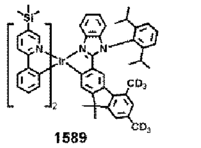
1589
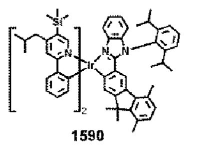
1590

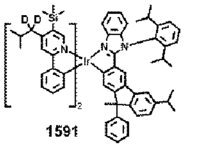
1591
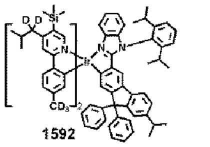
1592
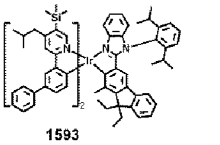
1593
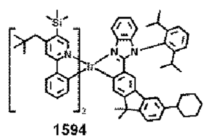
1594
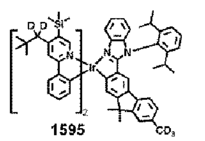
1595

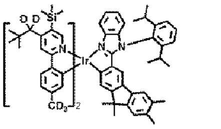
1596
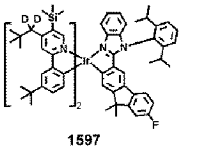
1597
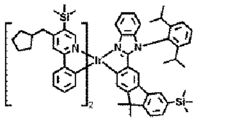
1598
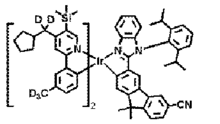
1599
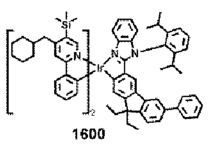
1600

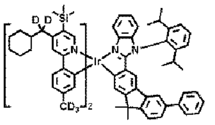
1601
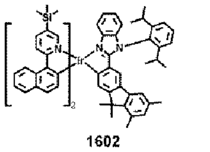
1602
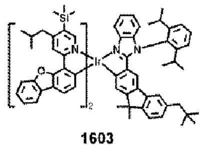
1603
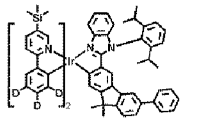
1604
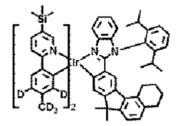
1605

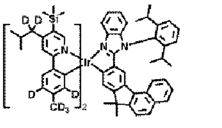
1606
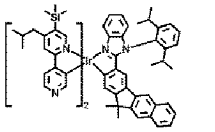
1607
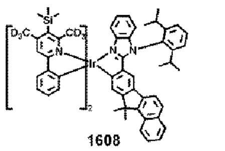
1608
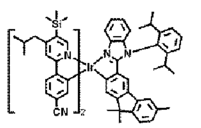
1609
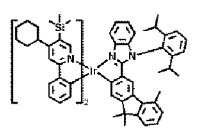
1610

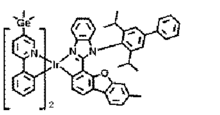
1611
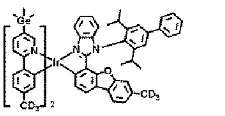
1612
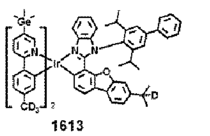
1613
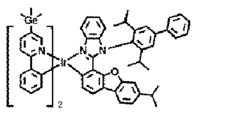
1614
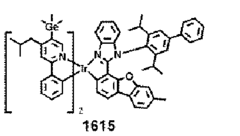
1615

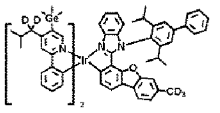
1616
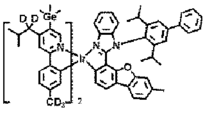
1617
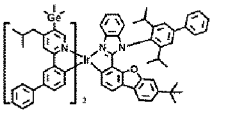
1618
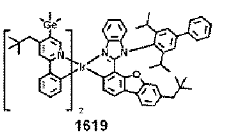
1619
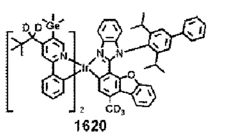
1620

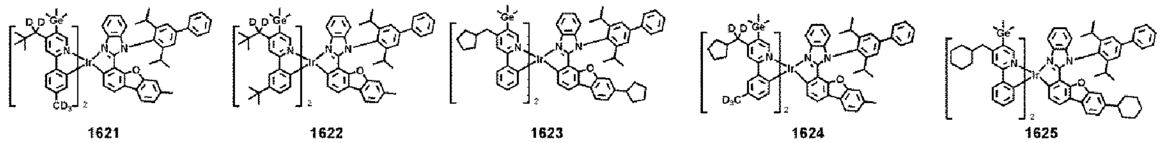
1621
1622
1623
1624
1625

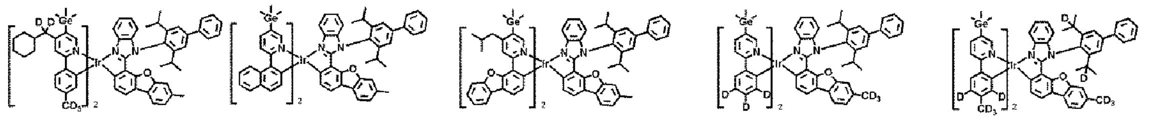
1626
1627
1628
1629
1630

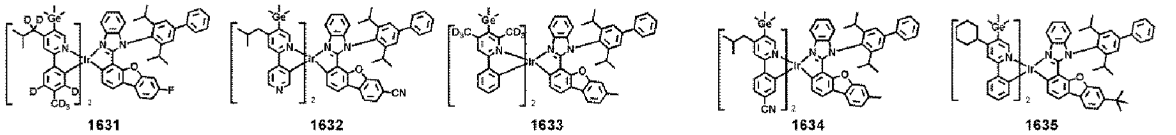
1631
1632
1633
1634
1635

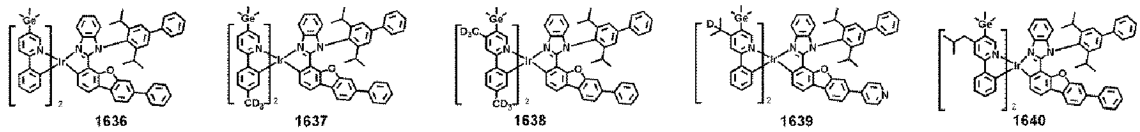

1636 1637 1638 1639 1640

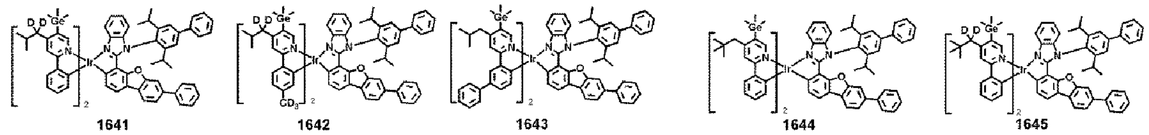

1641 1642 1643 1644 1645

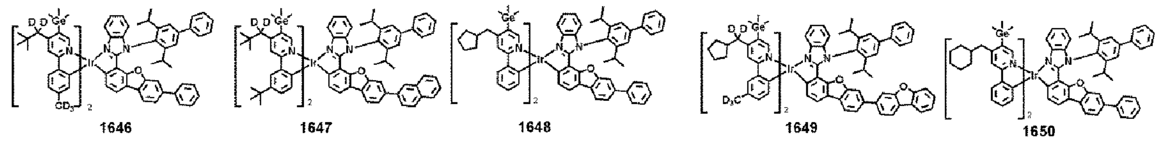

1646 1647 1648 1649 1650

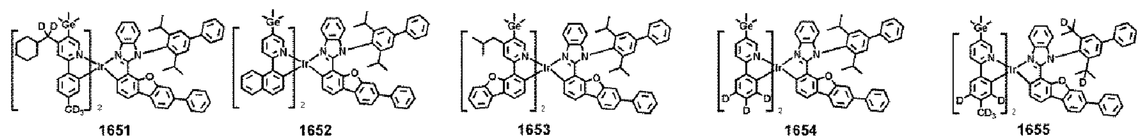

1651 1652 1653 1654 1655

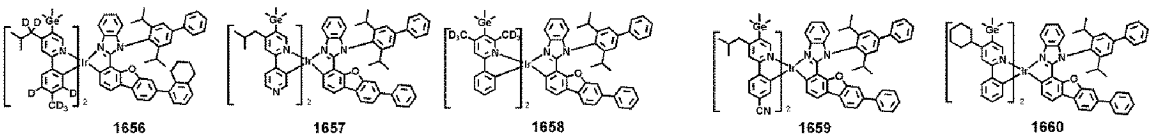

1656 1657 1658 1659 1660

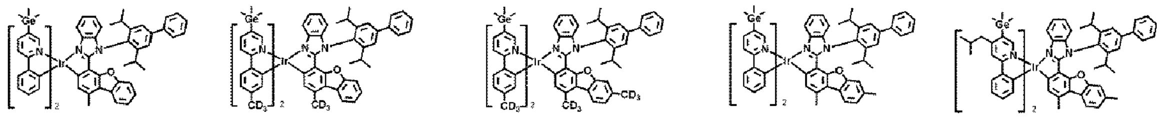

1661 1662 1663 1664 1665

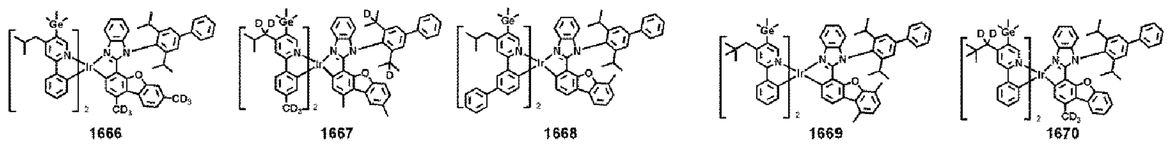

1666 1667 1668 1669 1670

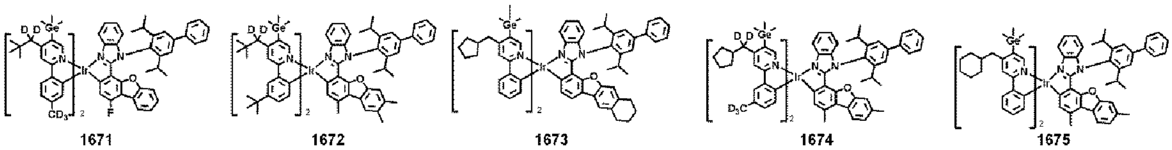

1671 1672 1673 1674 1675

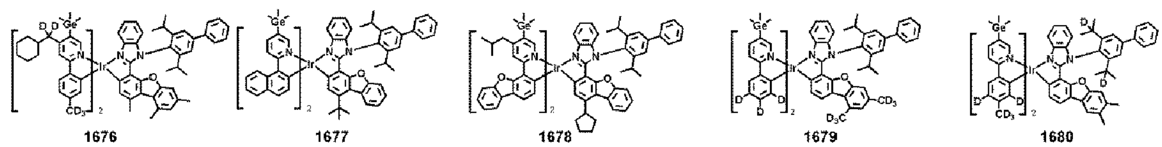

1676 1677 1678 1679 1680

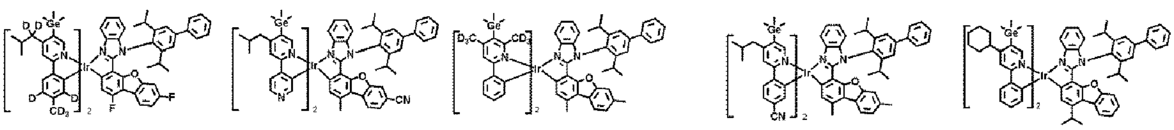

1681 1682 1683 1684 1685

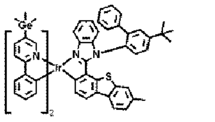
1686
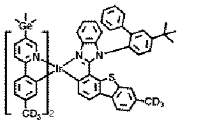
1687
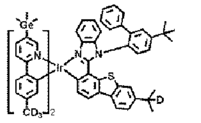
1688
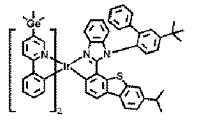
1689
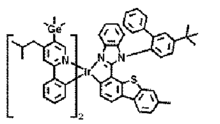
1690

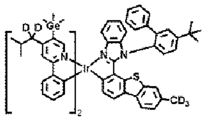
1691
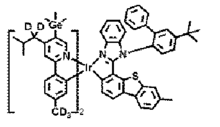
1692
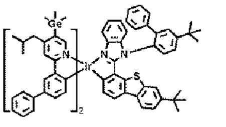
1693
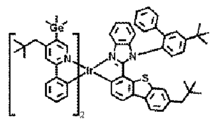
1694
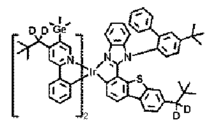
1695

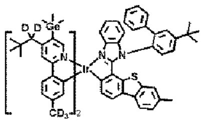
1696
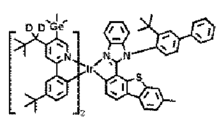
1697
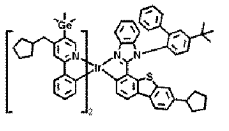
1698
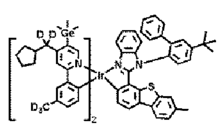
1699
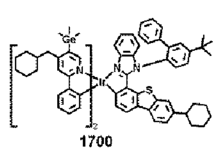
1700

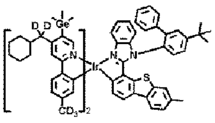
1701
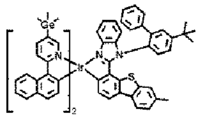
1702
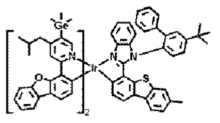
1703
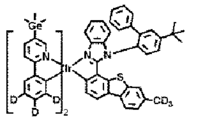
1704
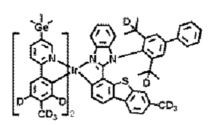
1705

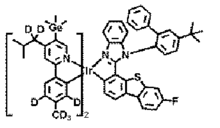
1706
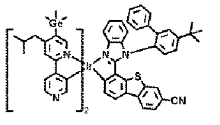
1707
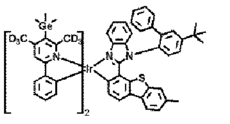
1708
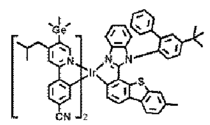
1709
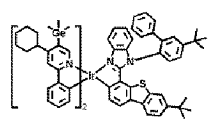
1710

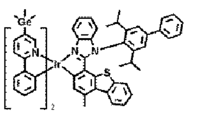
1711
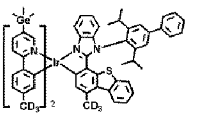
1712
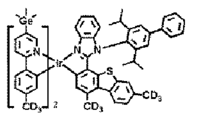
1713
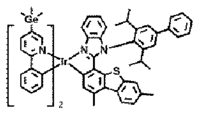
1714
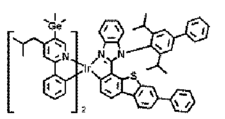
1715

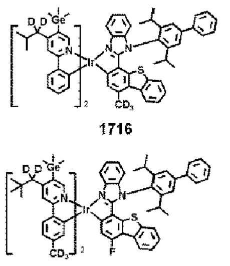
1716
1721
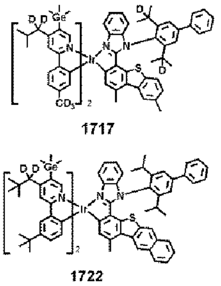
1717
1722
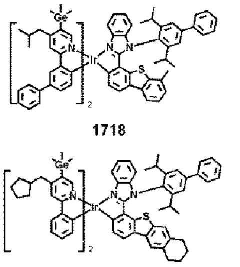
1718
1723
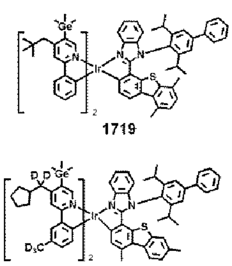
1719
1724
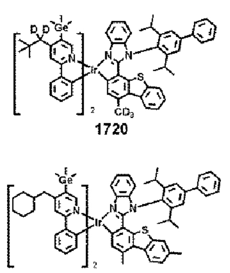
1720
1725

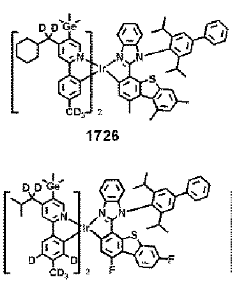
1726
1731
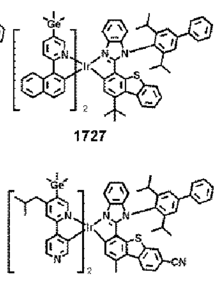
1727
1732
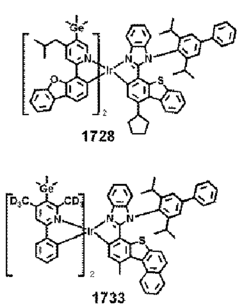
1728
1733
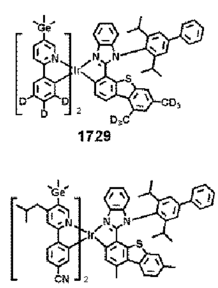
1729
1734
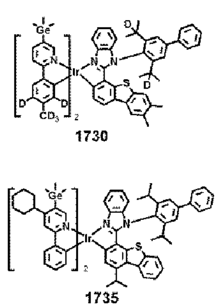
1730
1735

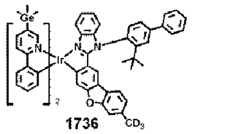
1736

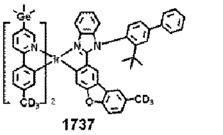
1737

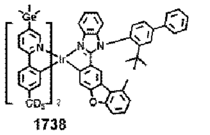
1738

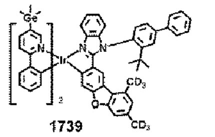
1739

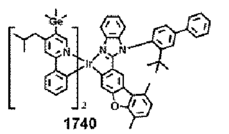
1740

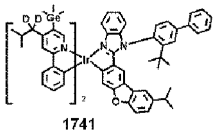
1741

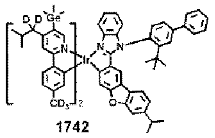
1742

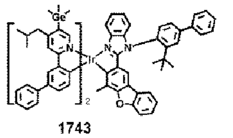
1743

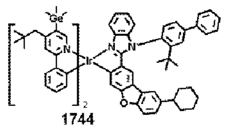
1744

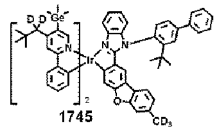
1745

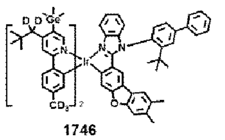
1746

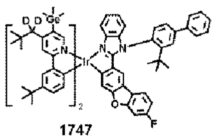
1747

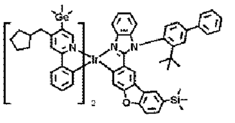
1748

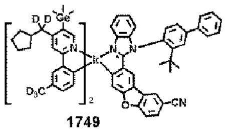
1749

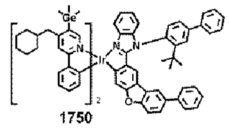
1750

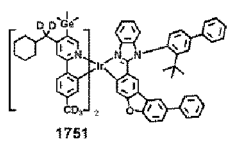
1751

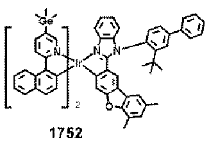
1752

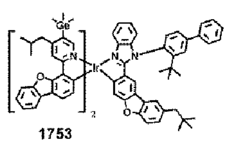
1753

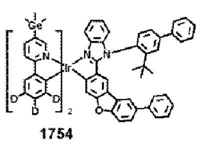
1754

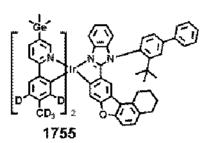
1755

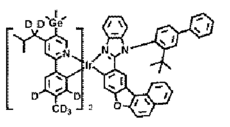
1756

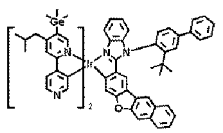
1757

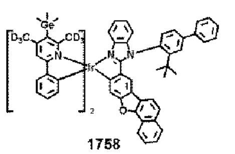
1758

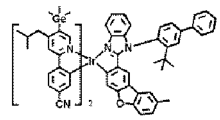
1759

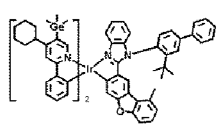
1760

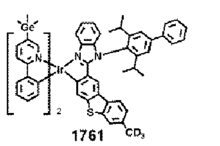
1761

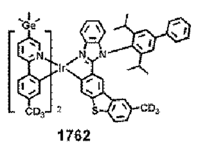
1762

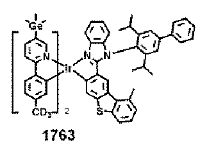
1763

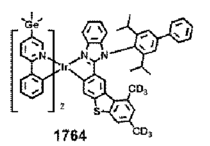
1764

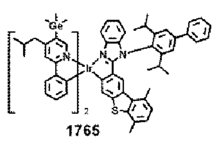
1765

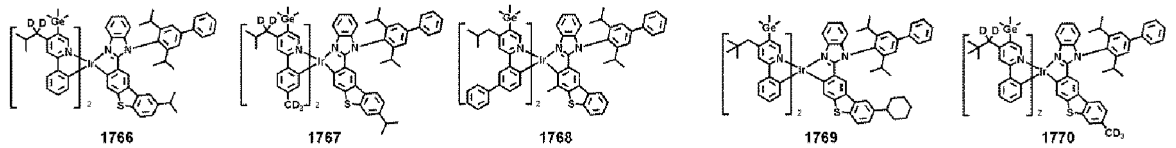
1766 1767 1768 1769 1770

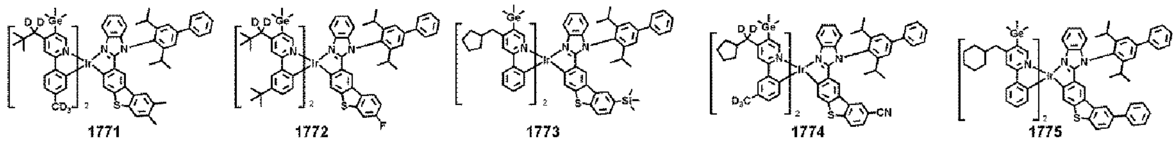
1771 1772 1773 1774 1775

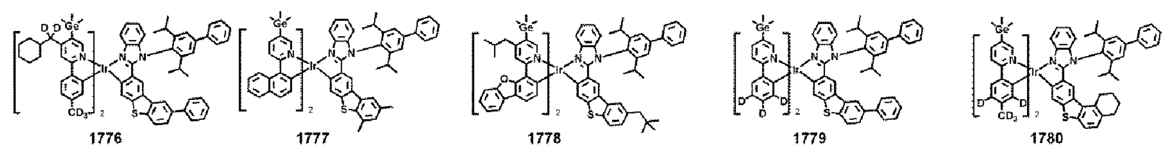
1776 1777 1778 1779 1780

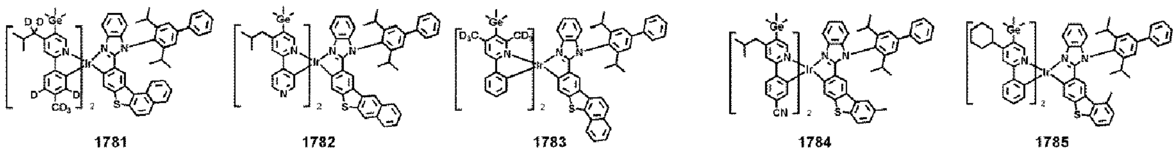
1781 1782 1783 1784 1785

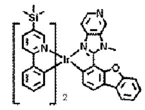
1786

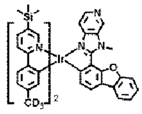
1787

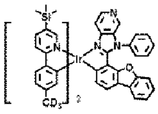
1788

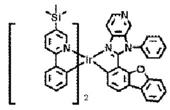
1789

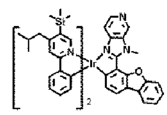
1790

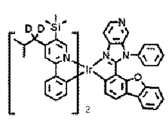
1791

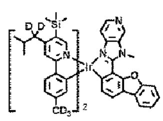
1792

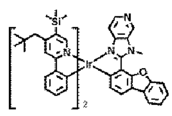
1793

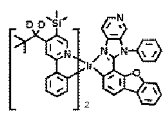
1794

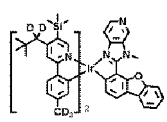
1795

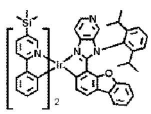
1796

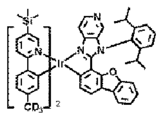
1797

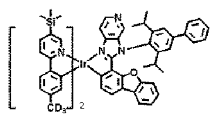
1798

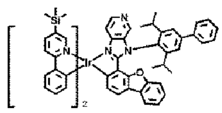
1799

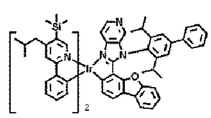
1800

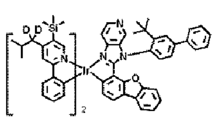
1801

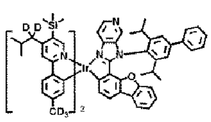
1802

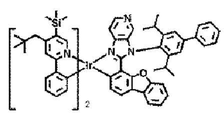
1803

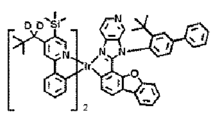
1804

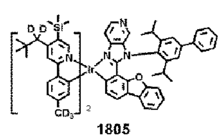
1805

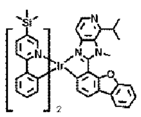
1806

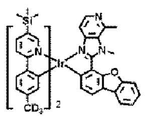
1807

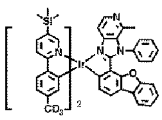
1808

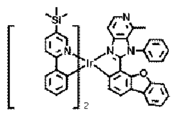
1809

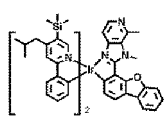
1810

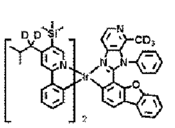
1811

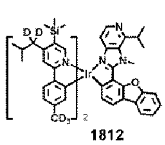
1812

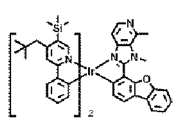
1813

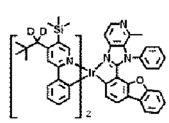
1814

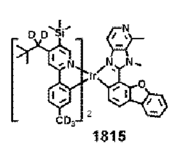
1815

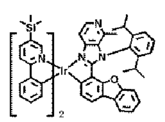
1816

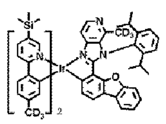
1817

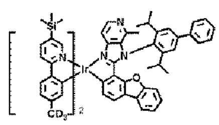
1818

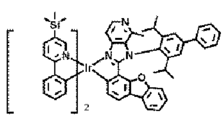
1819

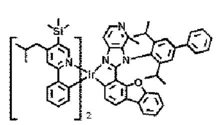
1820

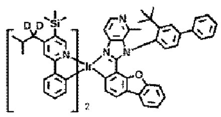
1821

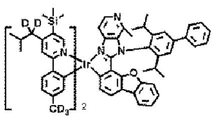
1822

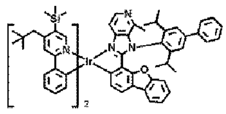
1823

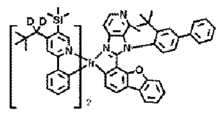
1824

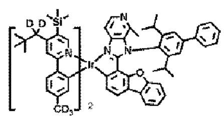
1825

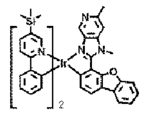
1826
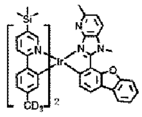
1827
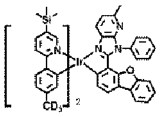
1828
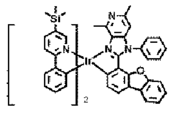
1829
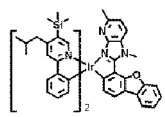
1830
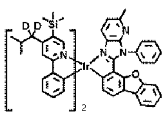
1831
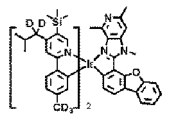
1832
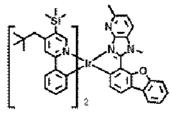
1833
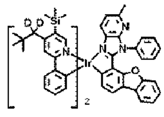
1834
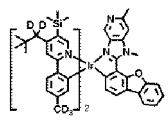
1835
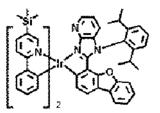
1836
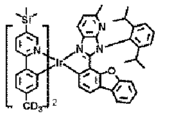
1837
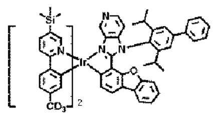
1838
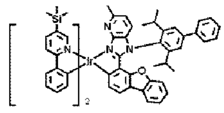
1839
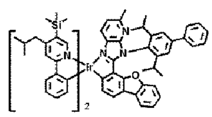
1840
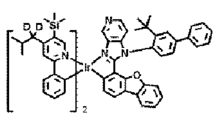
1841
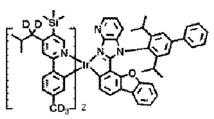
1842
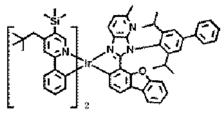
1843
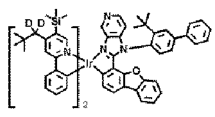
1844
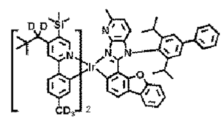
1845
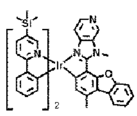
1846
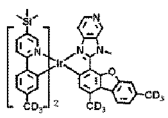
1847
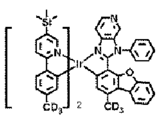
1848
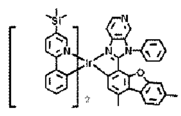
1849
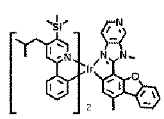
1850
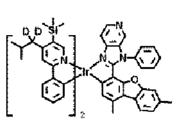
1851
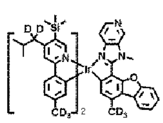
1852
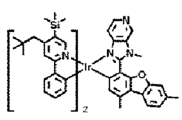
1853
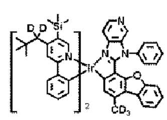
1854
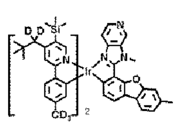
1855
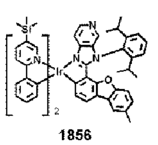
1856
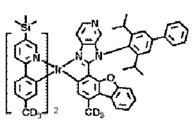
1857
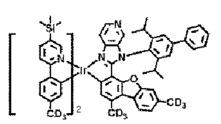
1858
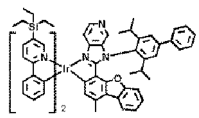
1859
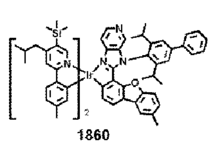
1860
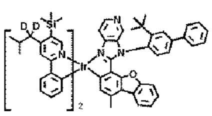
1861
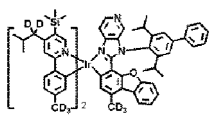
1862
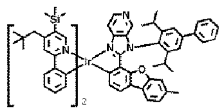
1863
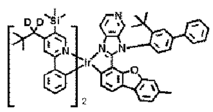
1864
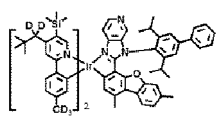
1865

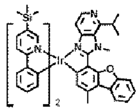
1866

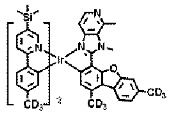
1867

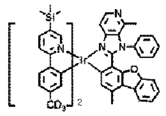
1868

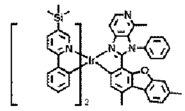
1869

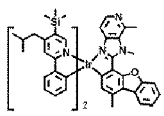
1870

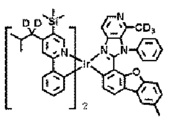
1871

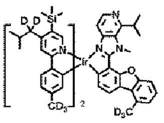
1872

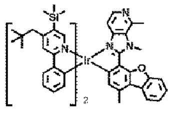
1873

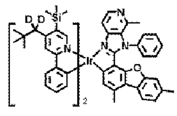
1874

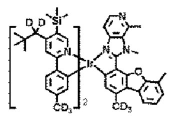
1875

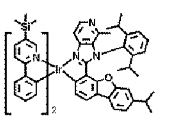
1876

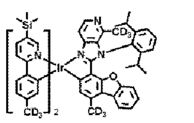
1877

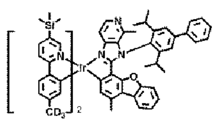
1878

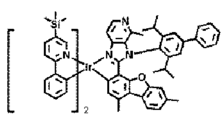
1879

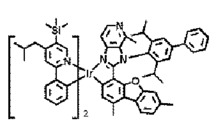
1880

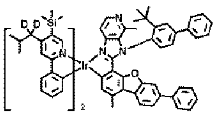
1881

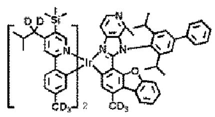
1882

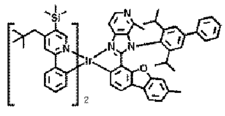
1883

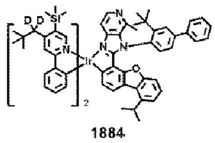
1884

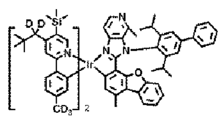
1885

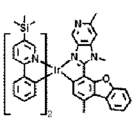
1886

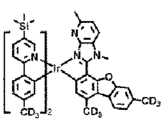
1887

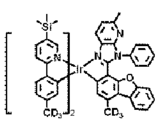
1888

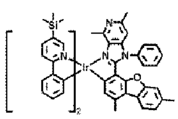
1889

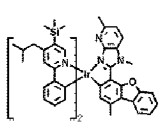
1890

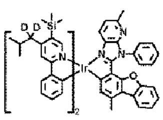
1891

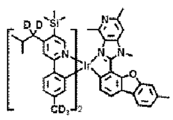
1892

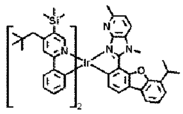
1893

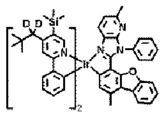
1894

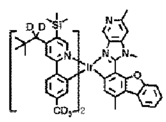
1895

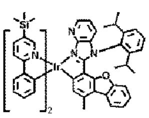
1896

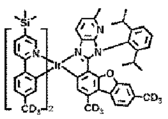
1897

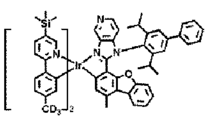
1898

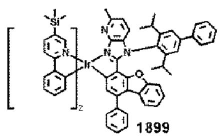
1899

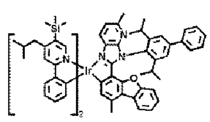
1900

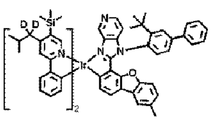
1901

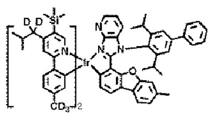
1902

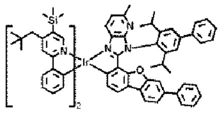
1903

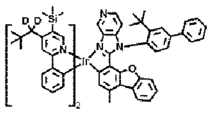
1904

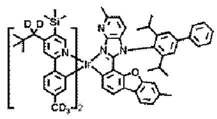
1905

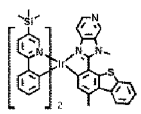
1906

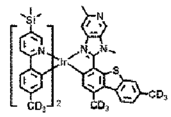
1907

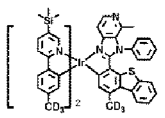
1908

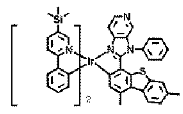
1909

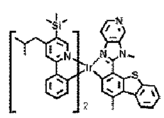
1910

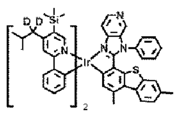
1911

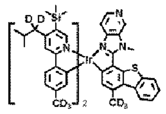
1912

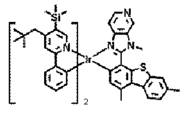
1913

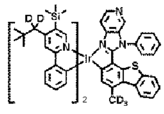
1914

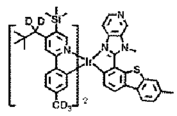
1915

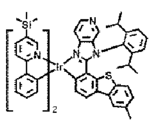
1916

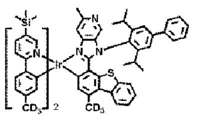
1917

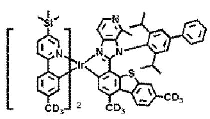
1918

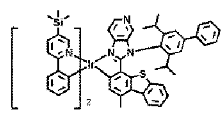
1919

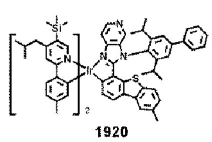
1920

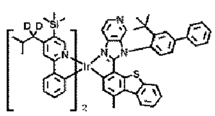
1921

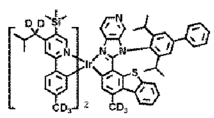
1922

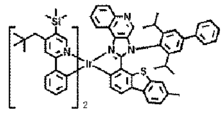
1923

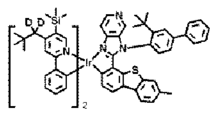
1924

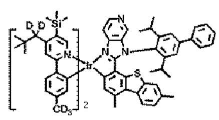
1925

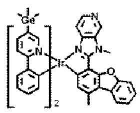
1926

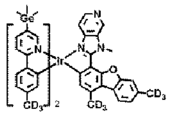
1927

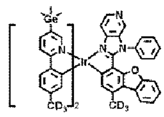
1928

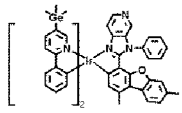
1929

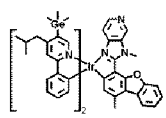
1930

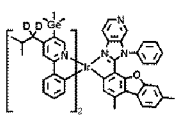
1931

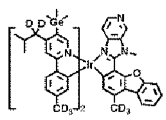
1932

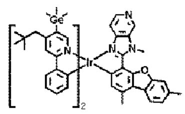
1933

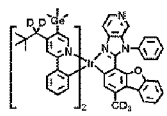
1934

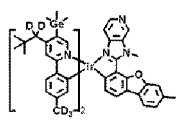
1935

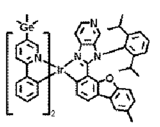
1936

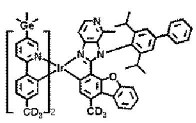
1937

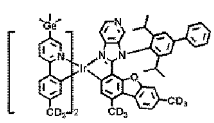
1938

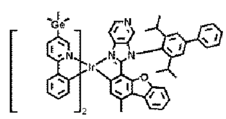
1939

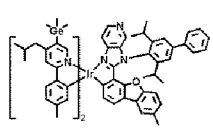
1940

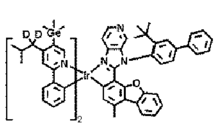
1941

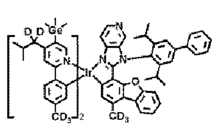
1942

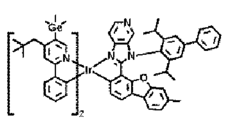
1943

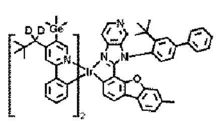
1944

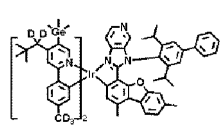
1945

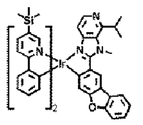
1946

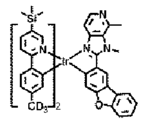
1947

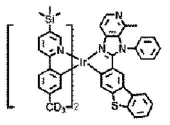
1948

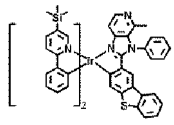
1949

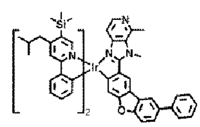
1950

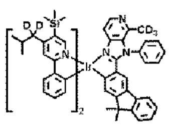
1951

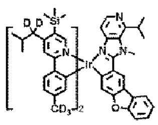
1952

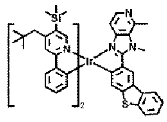
1953

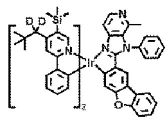
1954

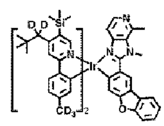
1955

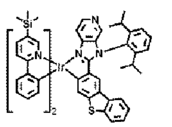
1956

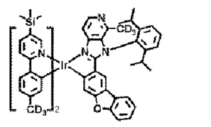
1957

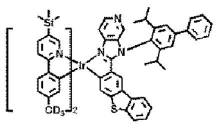
1958

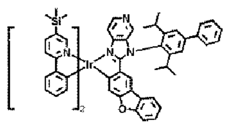
1959

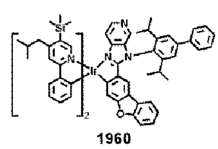
1960

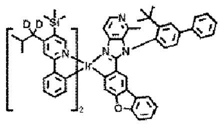
1961

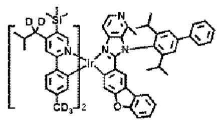
1962

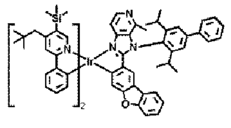
1963

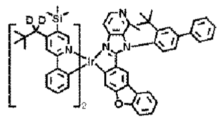
1964

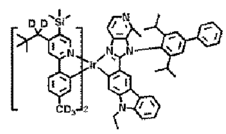
1965

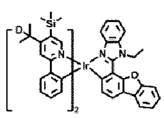
1966

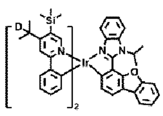
1967

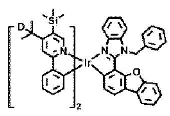
1968

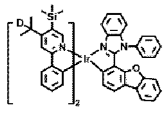
1969

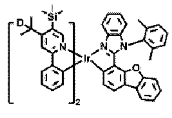
1970

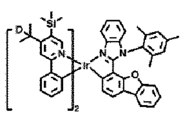
1971

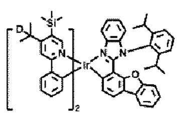
1972

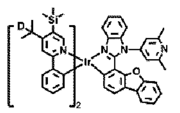
1973

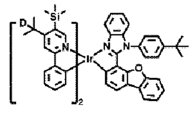
1974

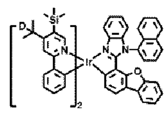
1975

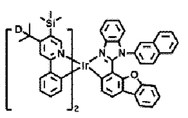
1976

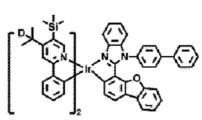
1977

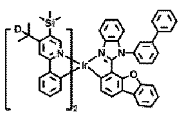
1978

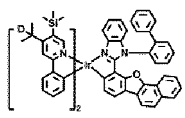
1979

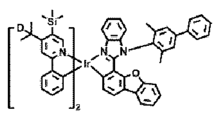
1980

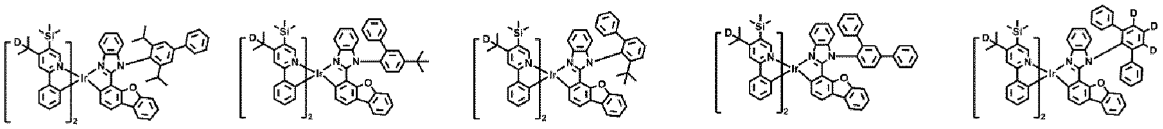
1981 1982 1983 1984 1985

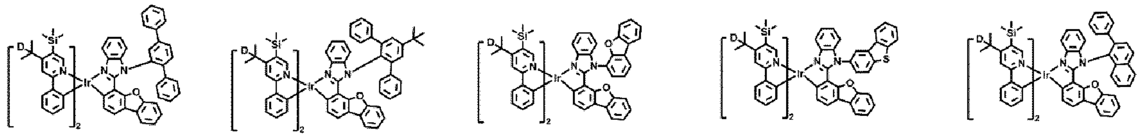
1986 1987 1988 1989 1990

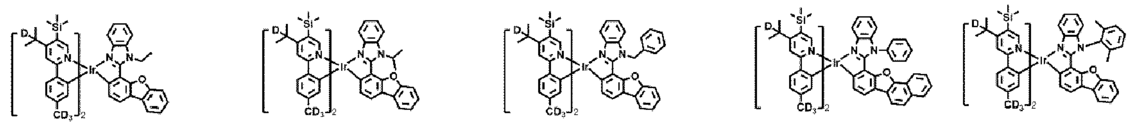
1991 1992 1993 1994 1995

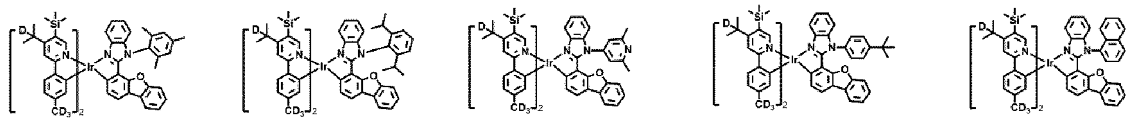
1996 1997 1998 1999 2000

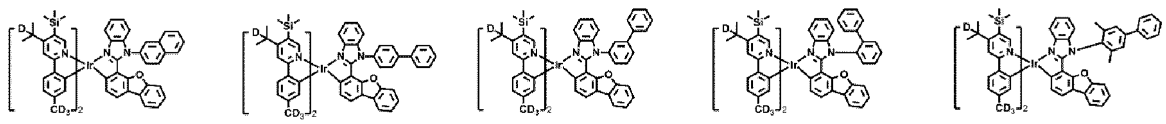
2001 2002 2003 2004 2005

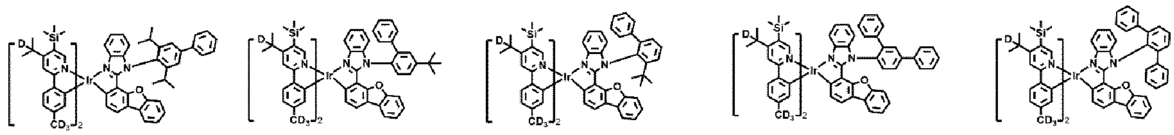
2006 2007 2008 2009 2010

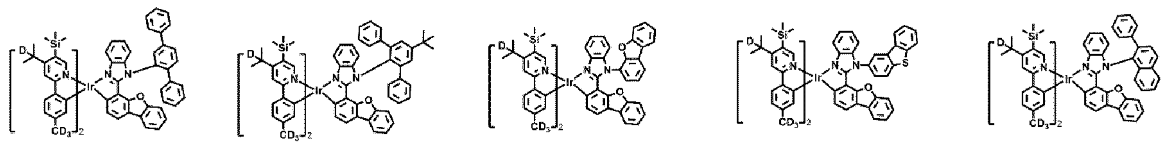
2011 2012 2013 2014 2015

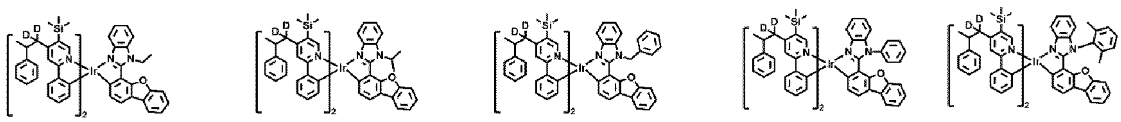
2016 2017 2018 2019 2020

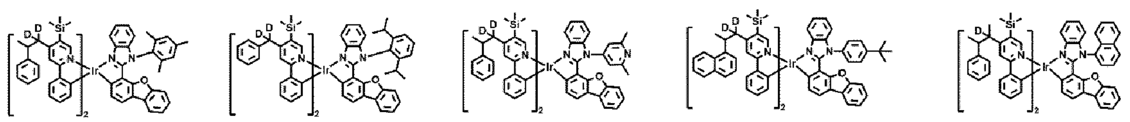
2021 2022 2023 2024 2025

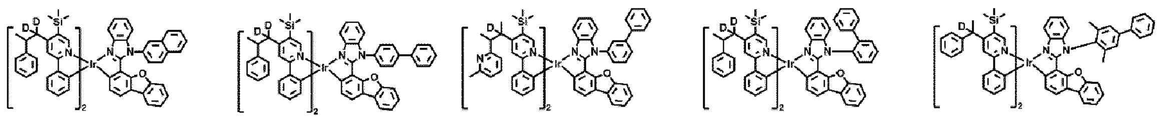
2026 2027 2028 2029 2030

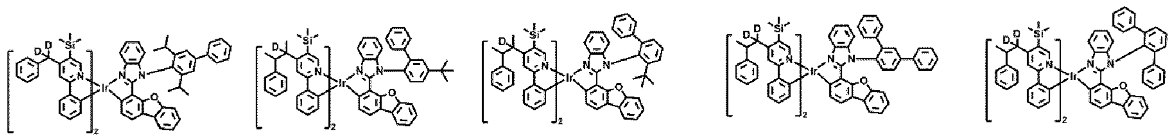
2031 2032 2033 2034 2035

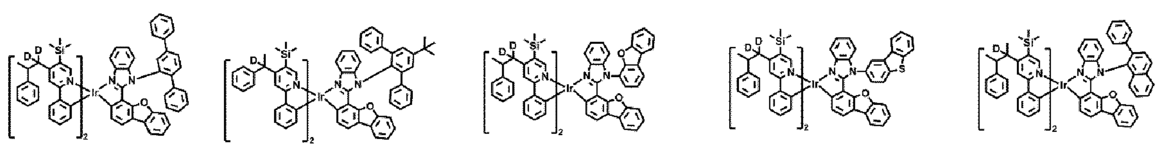
2036 2037 2038 2039 2040

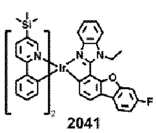
2041
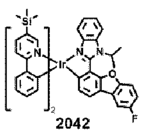
2042
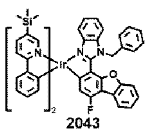
2043
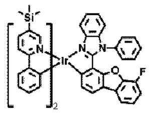
2044
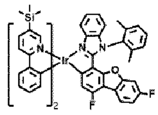
2045
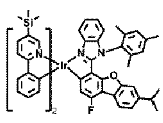
2046
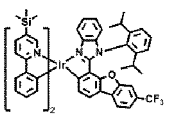
2047
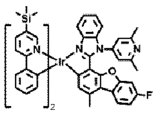
2048
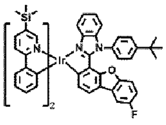
2049
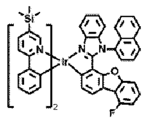
2050
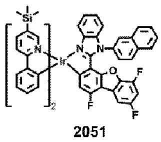
2051
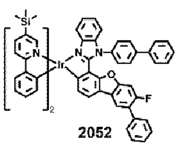
2052
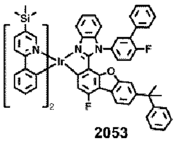
2053
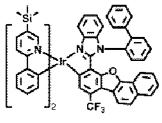
2054
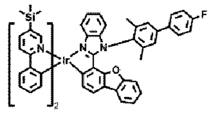
2055
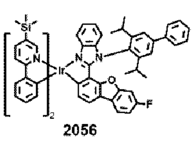
2056
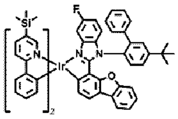
2057
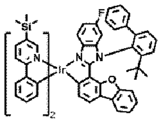
2058
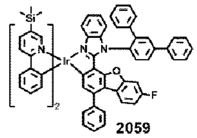
2059
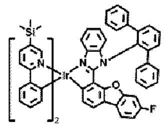
2060
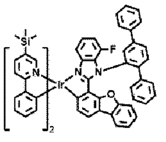
2061
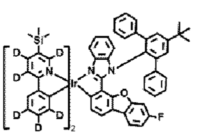
2062
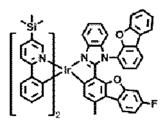
2063
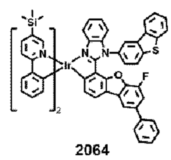
2064
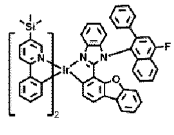
2065
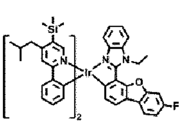
2066
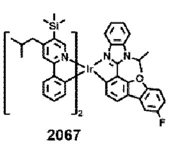
2067
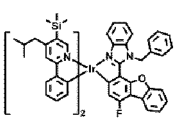
2068
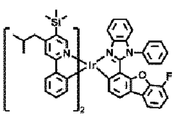
2069
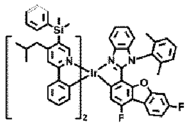
2070
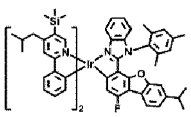
2071
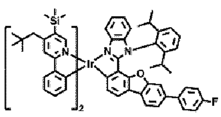
2072
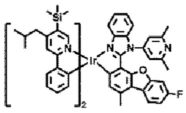
2073
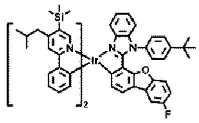
2074
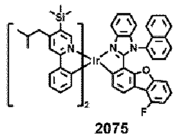
2075
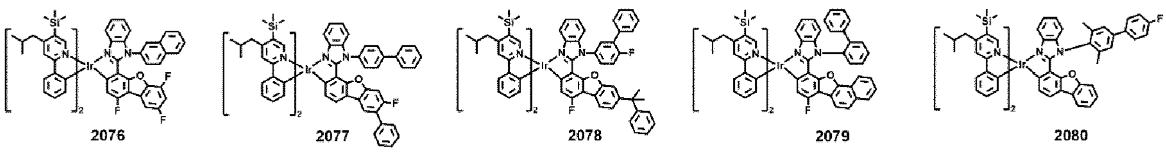
2076 2077 2078 2079 2080
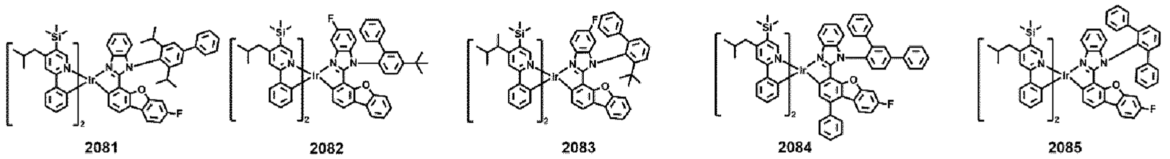
2081 2082 2083 2084 2085
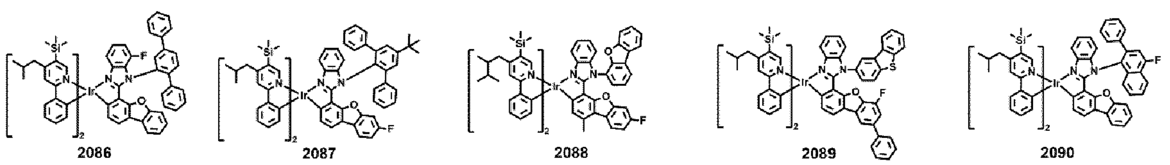
2086 2087 2088 2089 2090

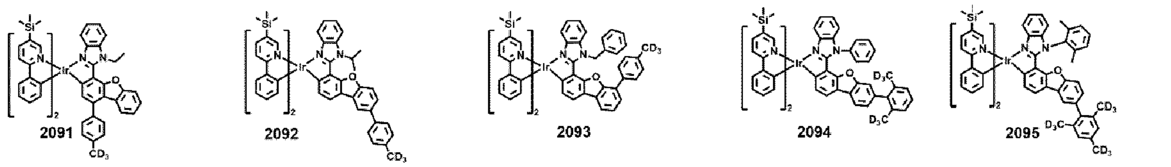

2091 2092 2093 2094 2095

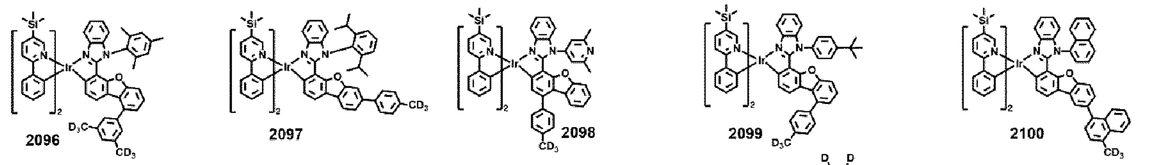

2096 2097 2098 2099 2100

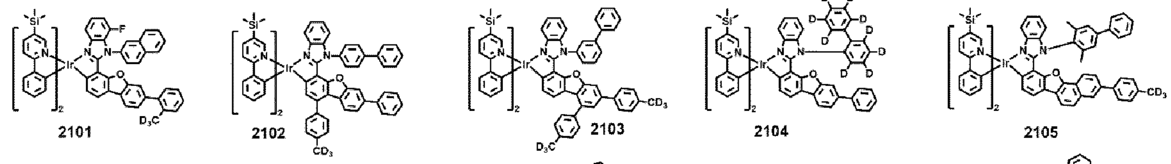

2101 2102 2103 2104 2105

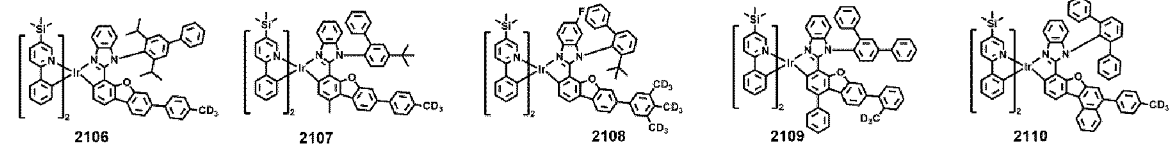

2106 2107 2108 2109 2110

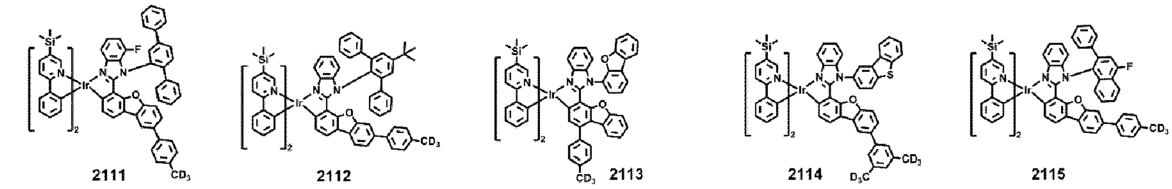

2111 2112 2113 2114 2115

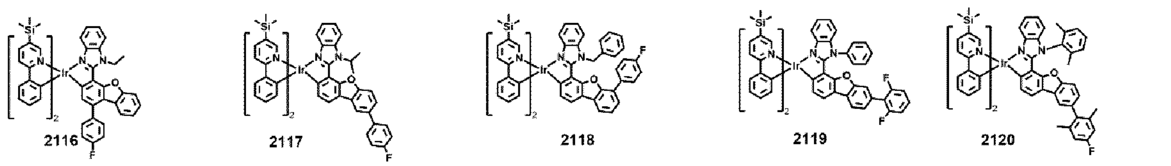

2116 2117 2118 2119 2120

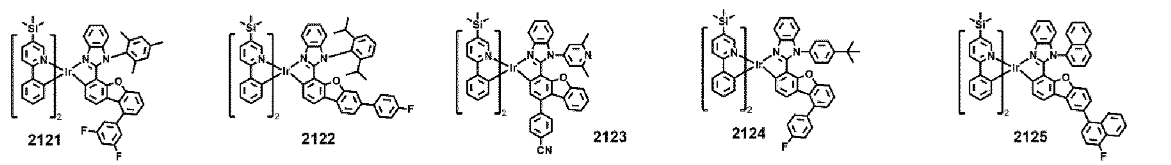

2121 2122 2123 2124 2125

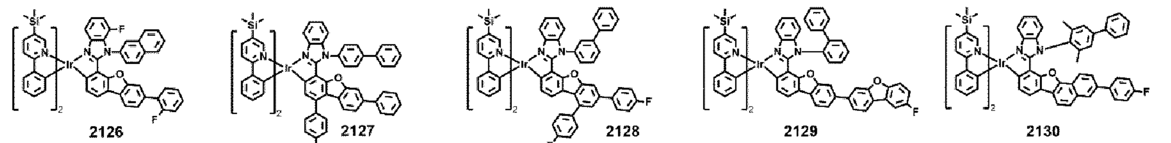

2126 2127 2128 2129 2130

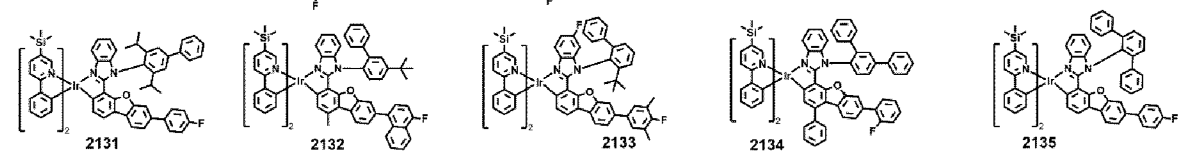

2131 2132 2133 2134 2135

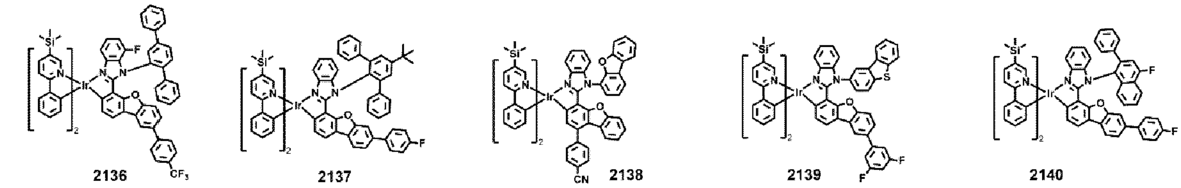

2136 2137 2138 2139 2140

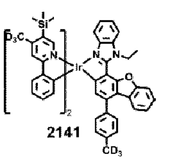
2141
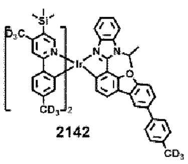
2142
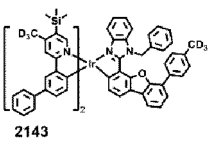
2143
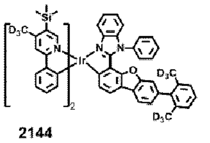
2144
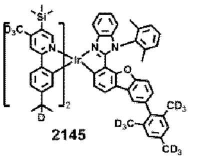
2145
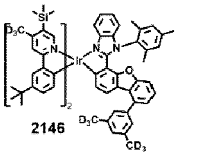
2146
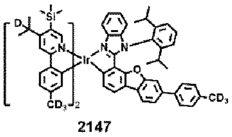
2147
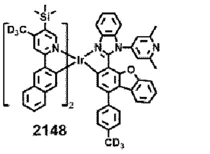
2148
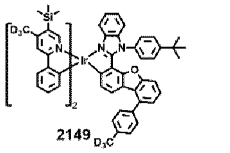
2149
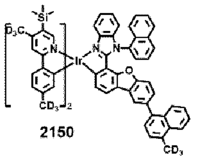
2150
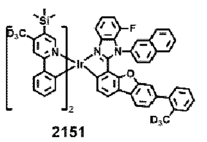
2151
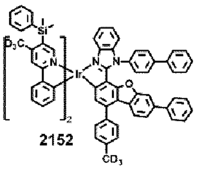
2152
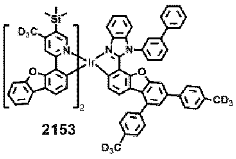
2153
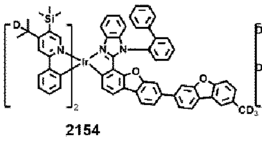
2154
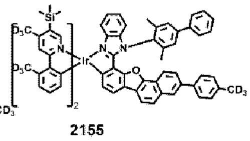
2155
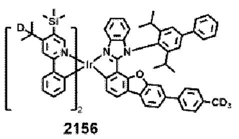
2156
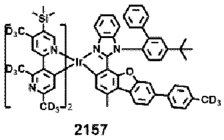
2157
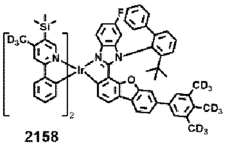
2158
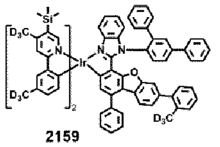
2159
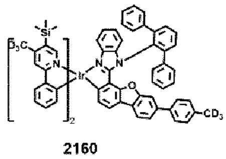
2160
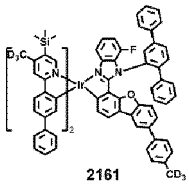
2161
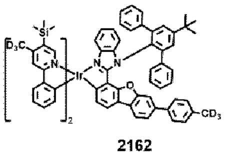
2162
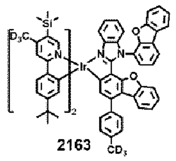
2163
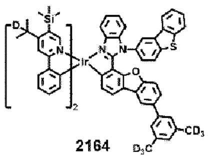
2164
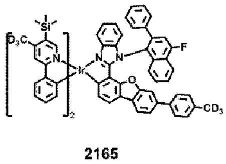
2165
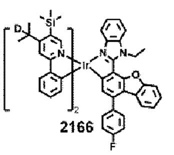
2166
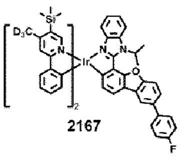
2167
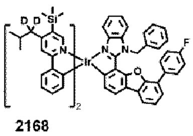
2168
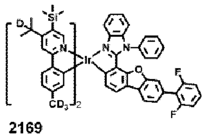
2169
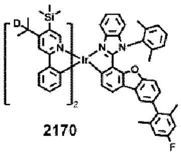
2170
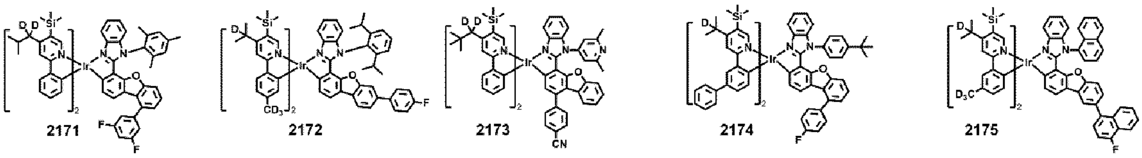
2171 2172 2173 2174 2175
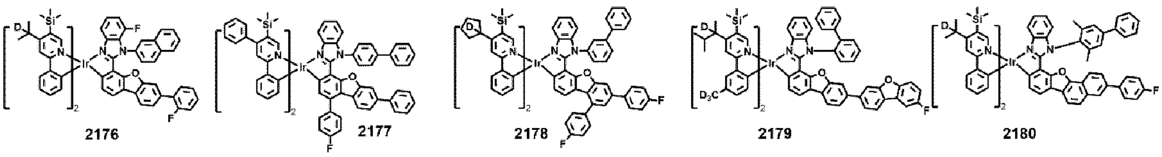
2176 2177 2178 2179 2180
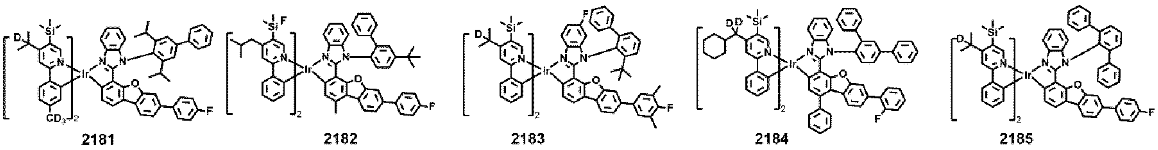
2181 2182 2183 2184 2185
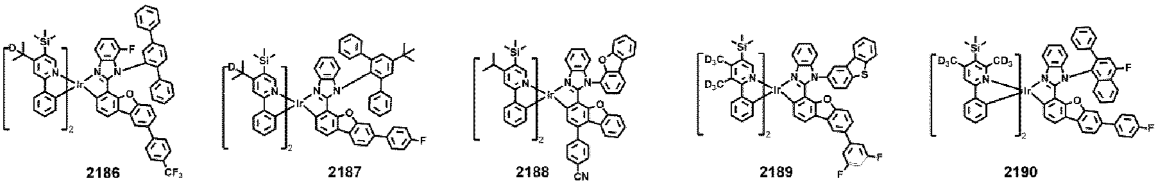
2186 2187 2188 2189 2190

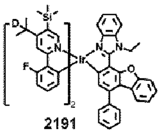
2191

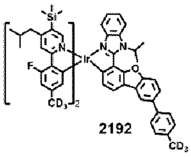
2192

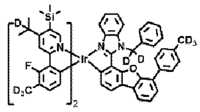
2193

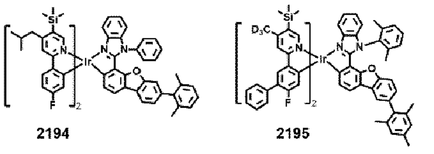
2194

2195

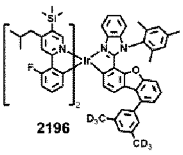
2196

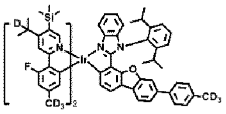
2197

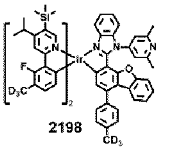
2198

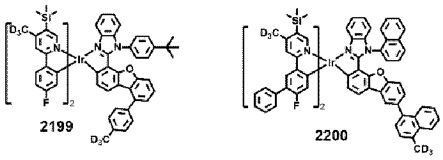
2199

2200

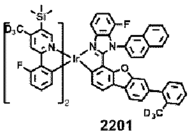
2201

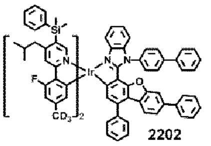
2202

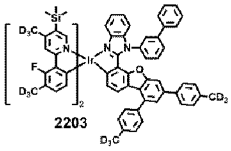
2203

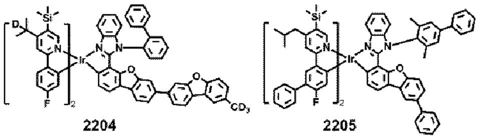
2204

2205

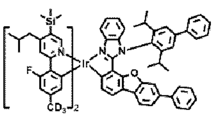
2206

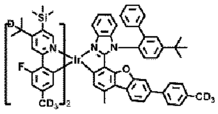
2207

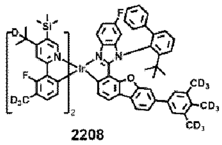
2208

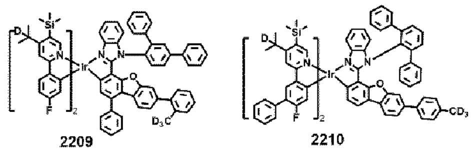
2209

2210

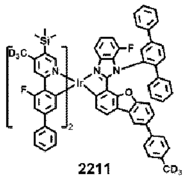
2211

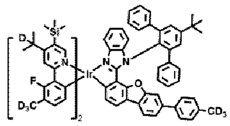
2212

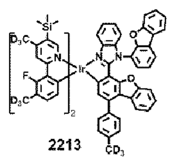
2213

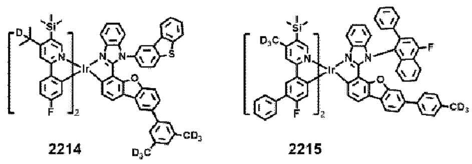
2214

2215

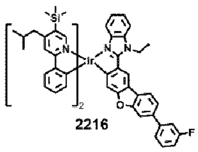
2216

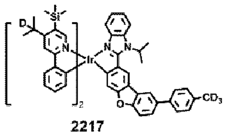
2217

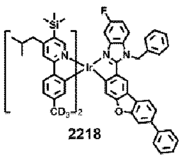
2218

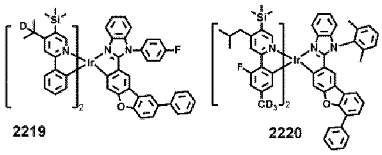
2219

2220

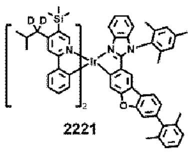
2221

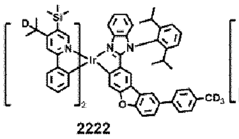
2222

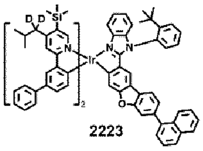
2223

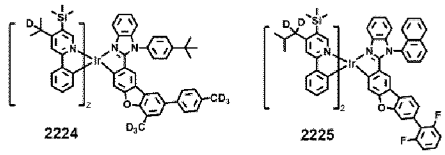
2224

2225

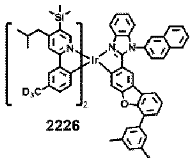
2226

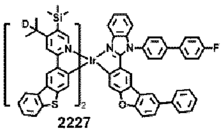
2227

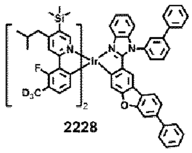
2228

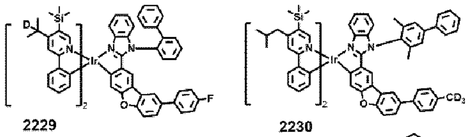
2229

2230

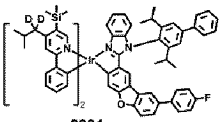
2231

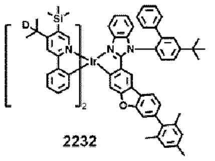
2232

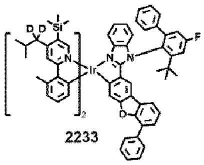
2233

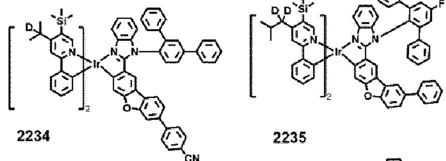
2234

2235

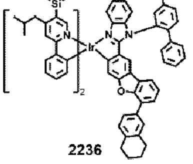
2236

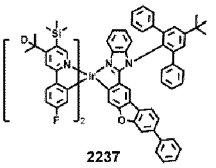
2237

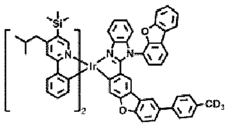
2238

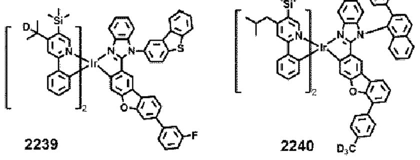
2239

2240

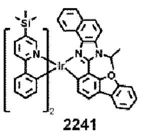
2241
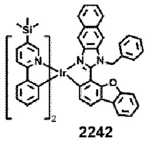
2242
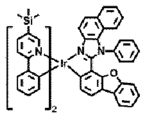
2243
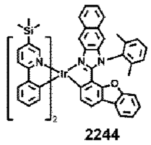
2244
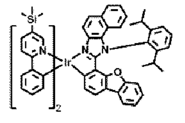
2245

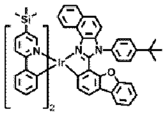
2246
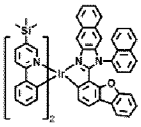
2247
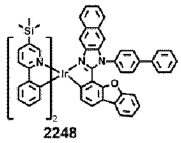
2248
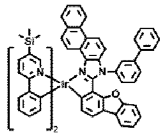
2249
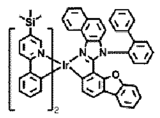
2250

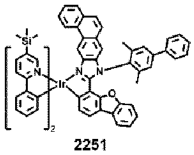
2251
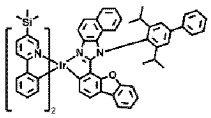
2252
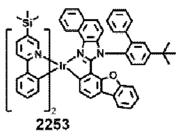
2253
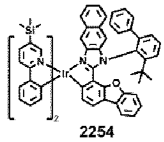
2254
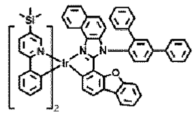
2255

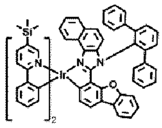
2256
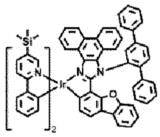
2257
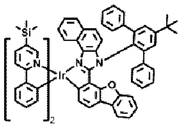
2258
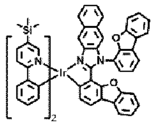
2259
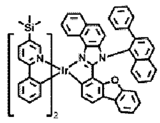
2260

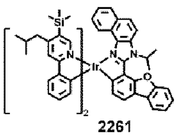
2261
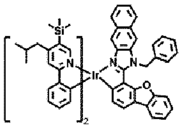
2262
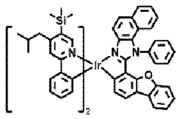
2263
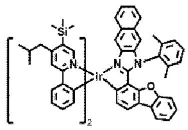
2264
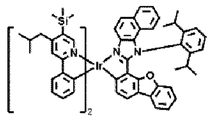
2265

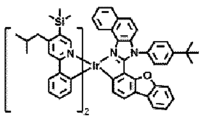
2266
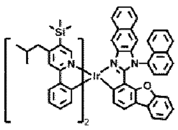
2267
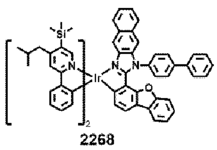
2268
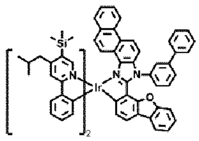
2269
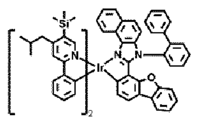
2270

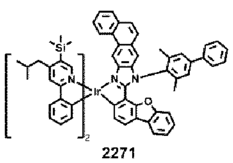
2271
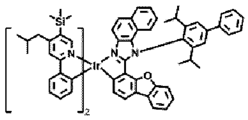
2272
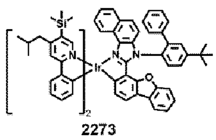
2273
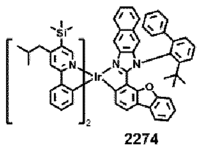
2274
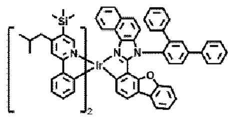
2275

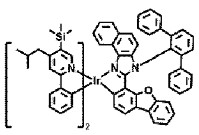
2276
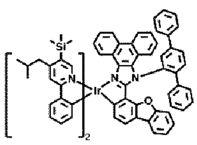
2277
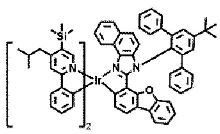
2278
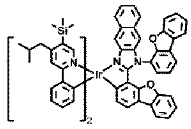
2279
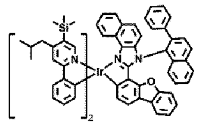
2280

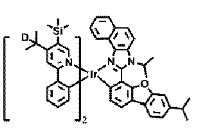
2281
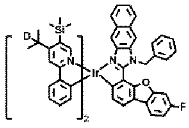
2282
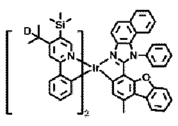
2283
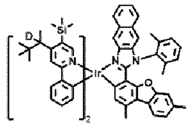
2284
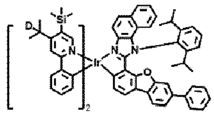
2285

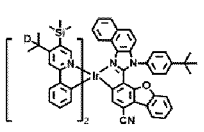
2286
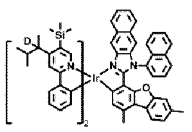
2287
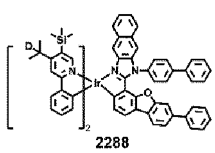
2288
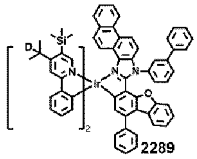
2289
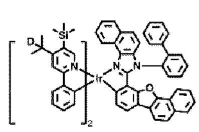
2290

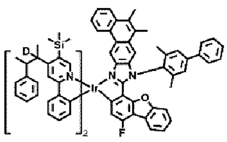
2291
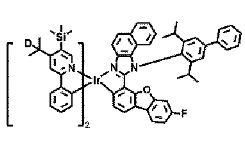
2292
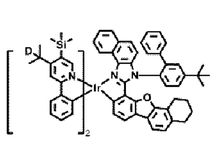
2293
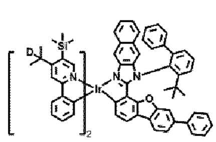
2294
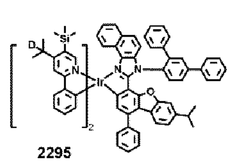
2295

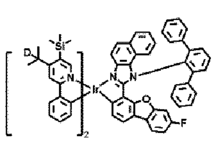
2296
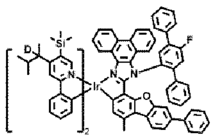
2297
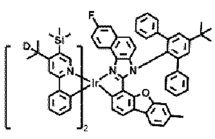
2298
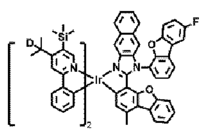
2299
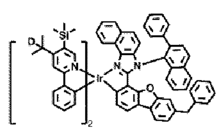
2300

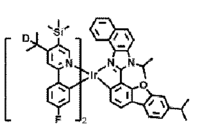
2301
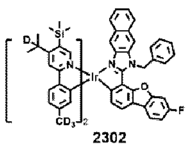
2302
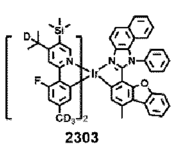
2303
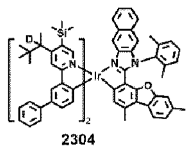
2304
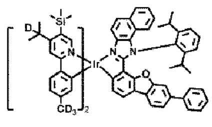
2305

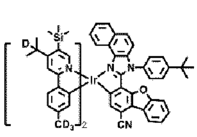
2306
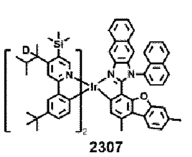
2307
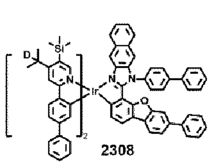
2308
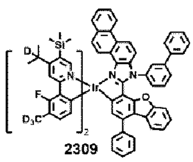
2309
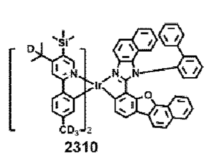
2310

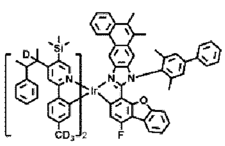
2311
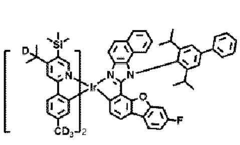
2312
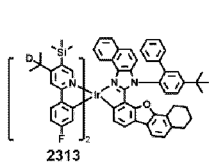
2313
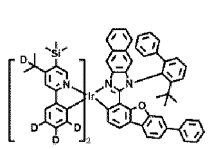
2314
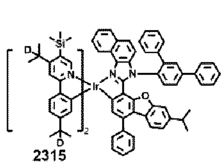
2315

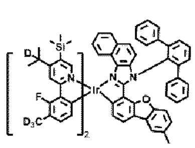
2316
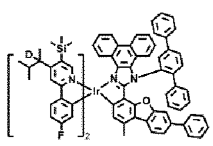
2317
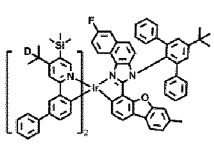
2318
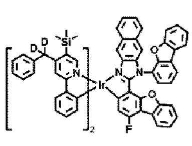
2319
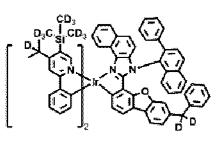
2320

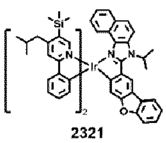
2321

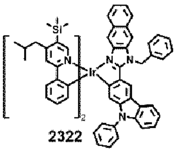
2322

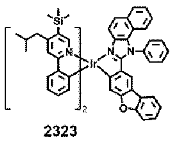
2323

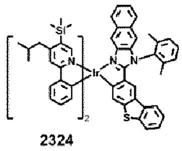
2324

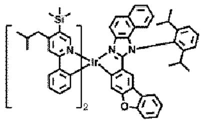
2325

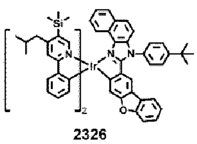
2326

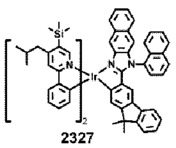
2327

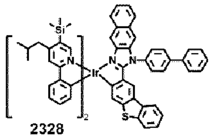
2328

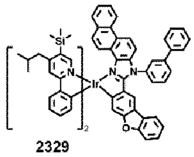
2329

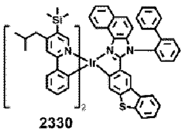
2330

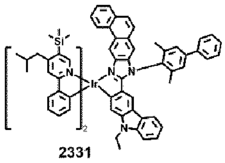
2331

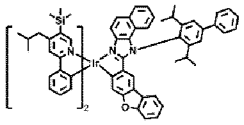
2332

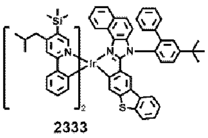
2333

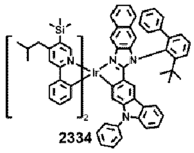
2334

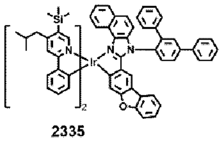
2335

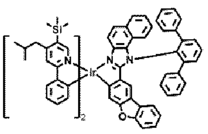
2336

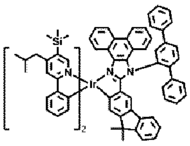
2337

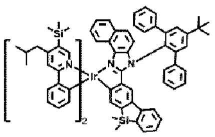
2338

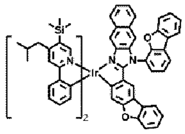
2339

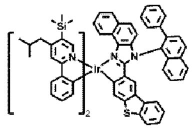
2340

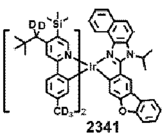
2341

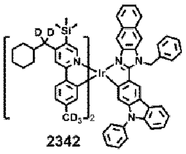
2342

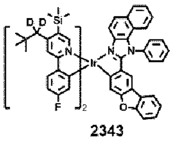
2343

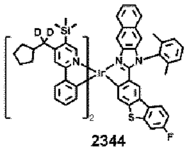
2344

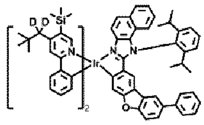
2345

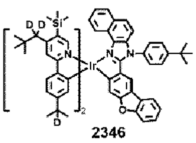
2346

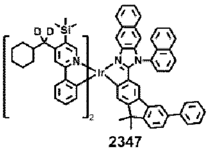
2347

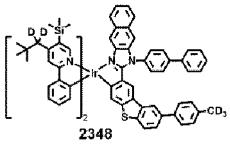
2348

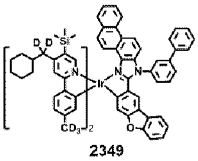
2349

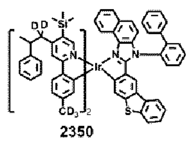
2350

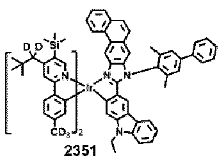
2351

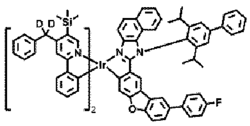
2352

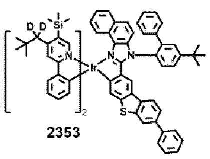
2353

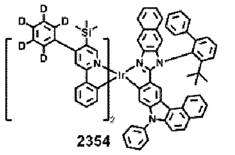
2354

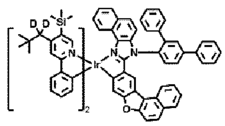
2355

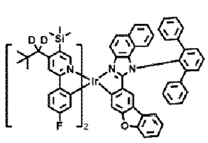
2356

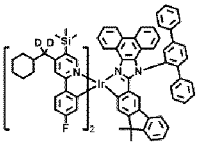
2357

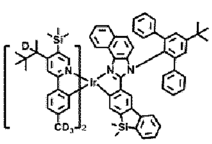
2358

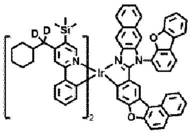
2359

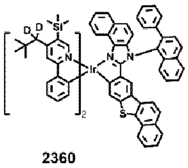
2360

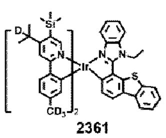
2361
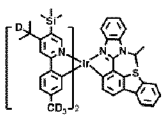
2362
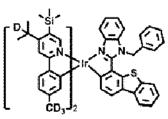
2363
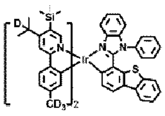
2364
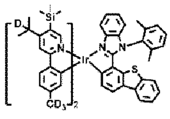
2365

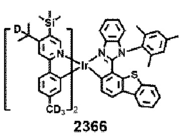
2366
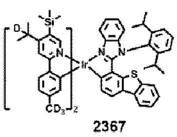
2367
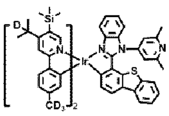
2368
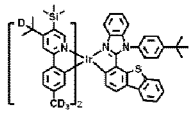
2369
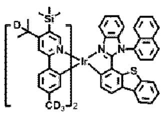
2370

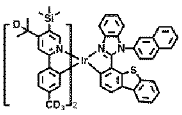
2371
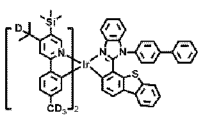
2372
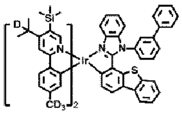
2373
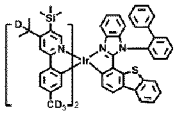
2374
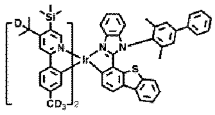
2375

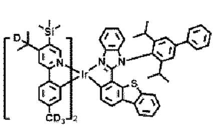
2376
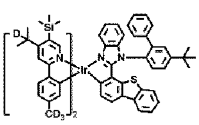
2377
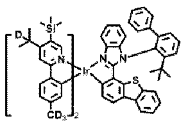
2378
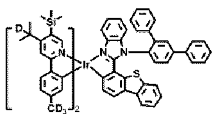
2379
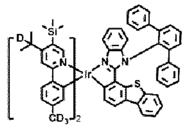
2380

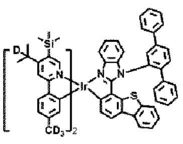
2381
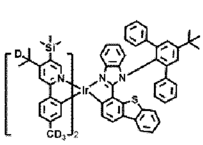
2382
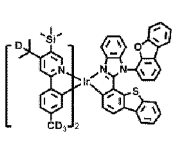
2383
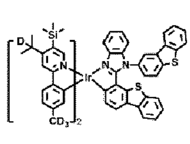
2384
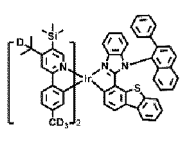
2385

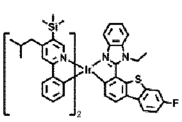
2386
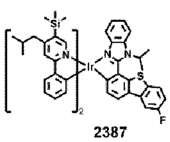
2387
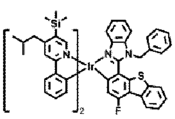
2388
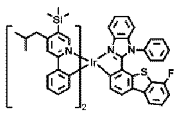
2389
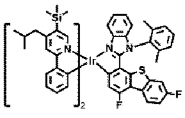
2390

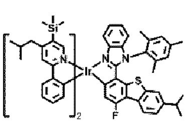
2391
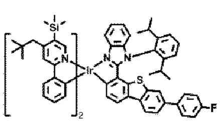
2392
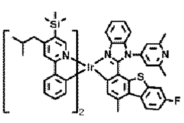
2393
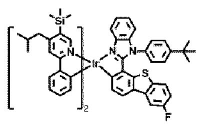
2394
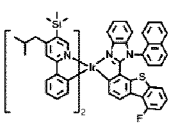
2395

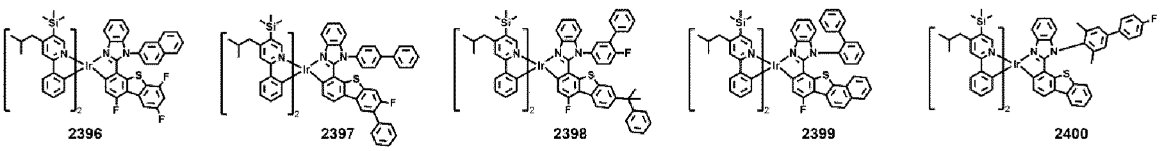
2396 2397 2398 2399 2400

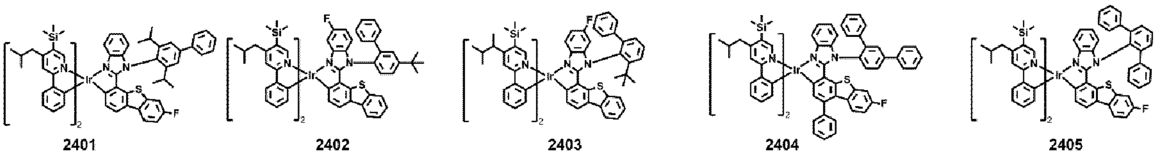
2401 2402 2403 2404 2405

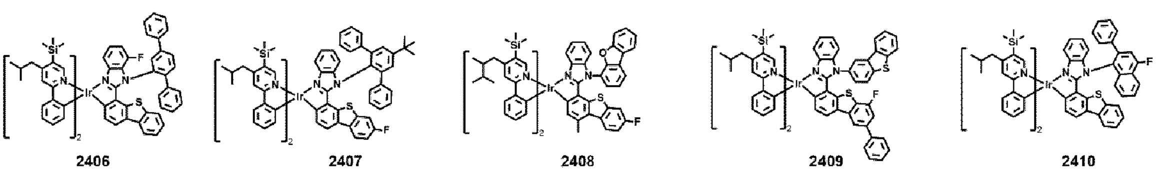
2406 2407 2408 2409 2410

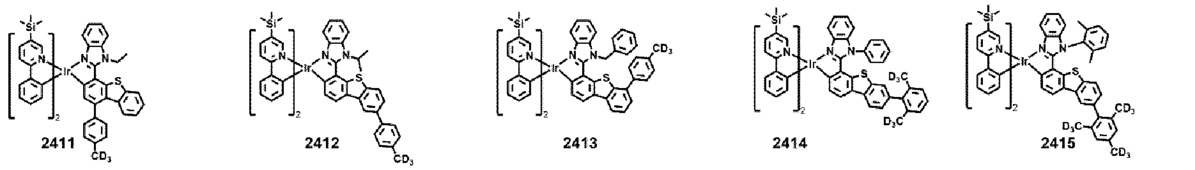

2411 2412 2413 2414 2415

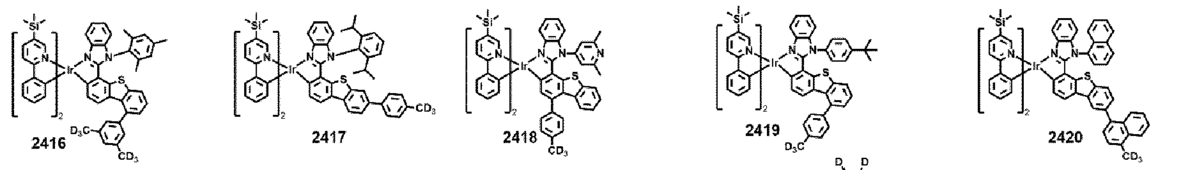

2416 2417 2418 2419 2420

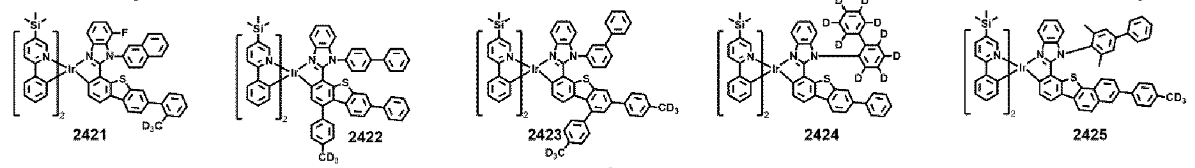

2421 2422 2423 2424 2425

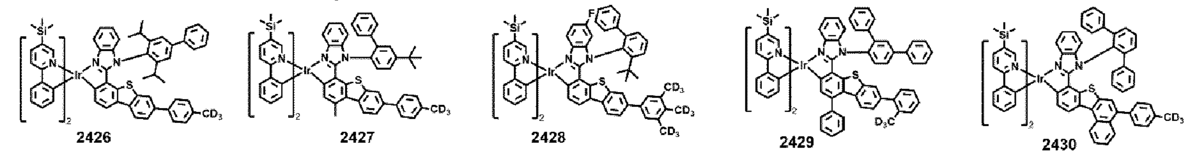

2426 2427 2428 2429 2430

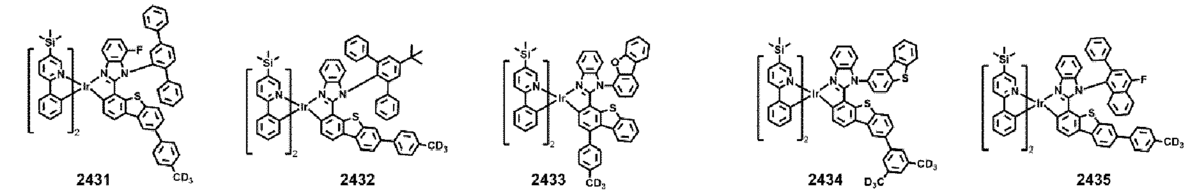

2431 2432 2433 2434 2435

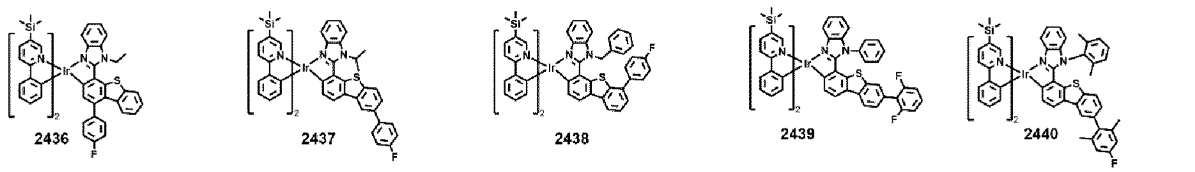

2436 2437 2438 2439 2440

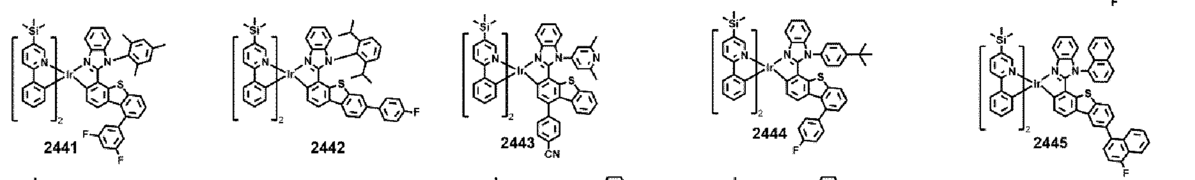

2441 2442 2443 2444 2445

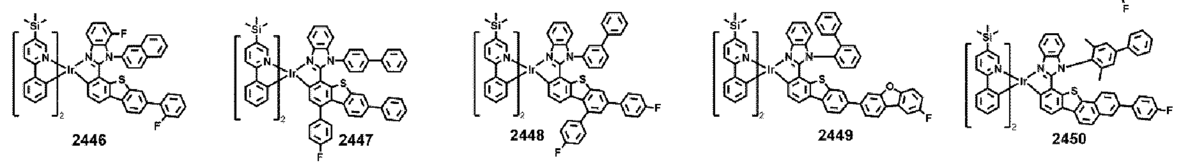

2446 2447 2448 2449 2450

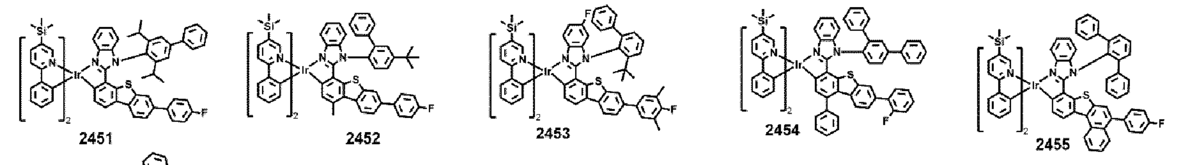

2451 2452 2453 2454 2455

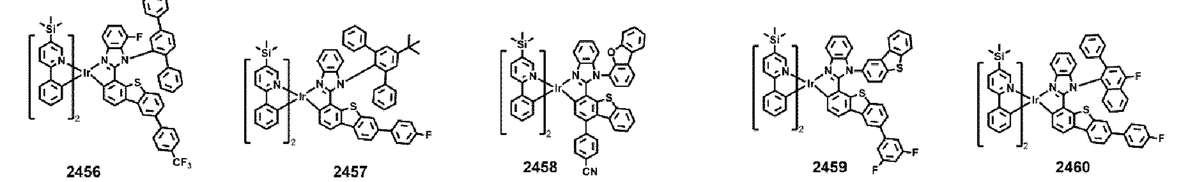

2456 2457 2458 2459 2460

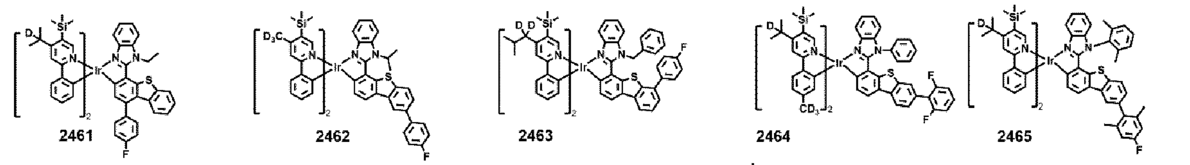
2461 2462 2463 2464 2465

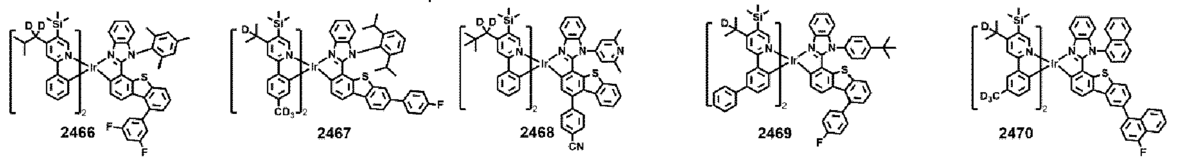
2466 2467 2468 2469 2470

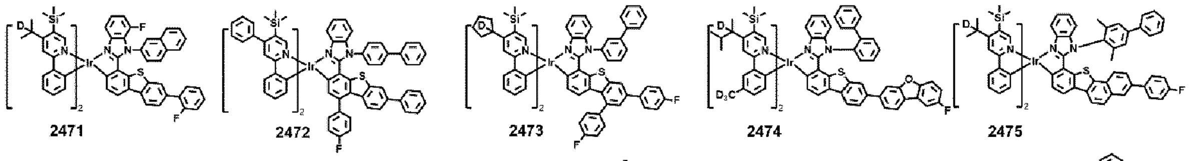
2471 2472 2473 2474 2475

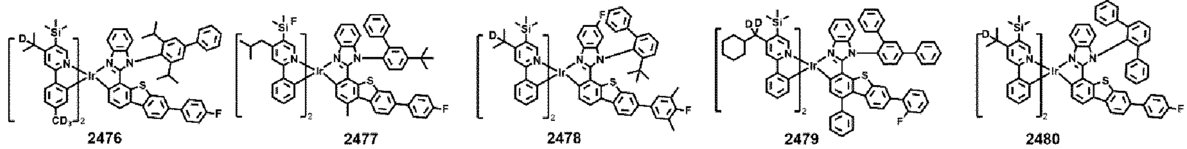
2476 2477 2478 2479 2480

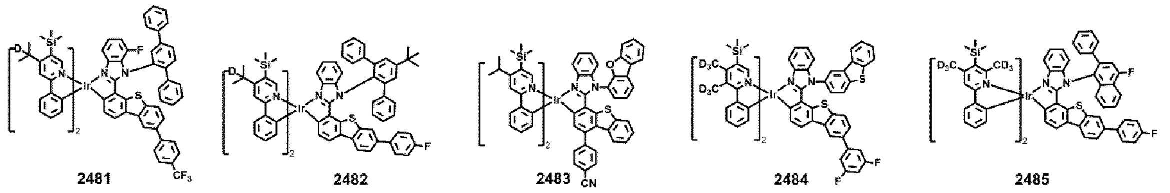
2481 2482 2483 2484 2485

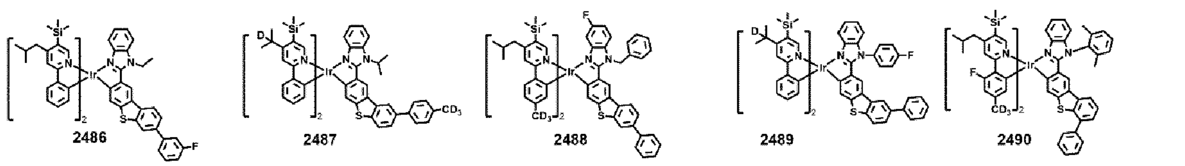
2486 2487 2488 2489 2490

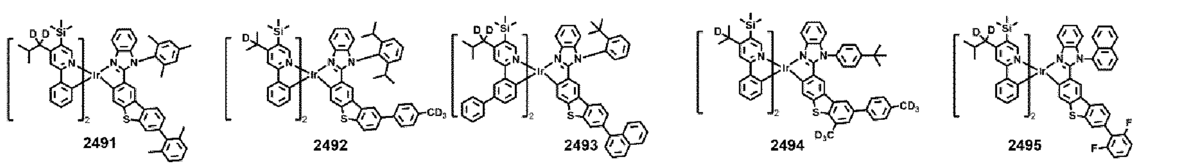
2491 2492 2493 2494 2495

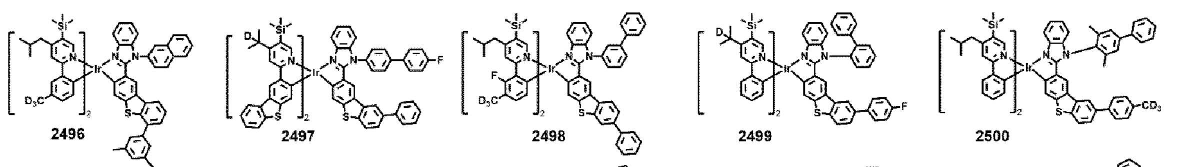
2496 2497 2498 2499 2500

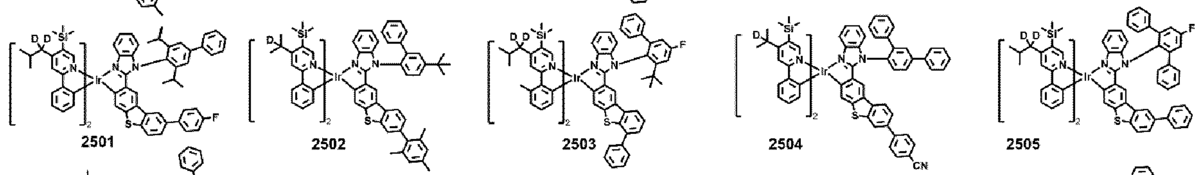
2501 2502 2503 2504 2505

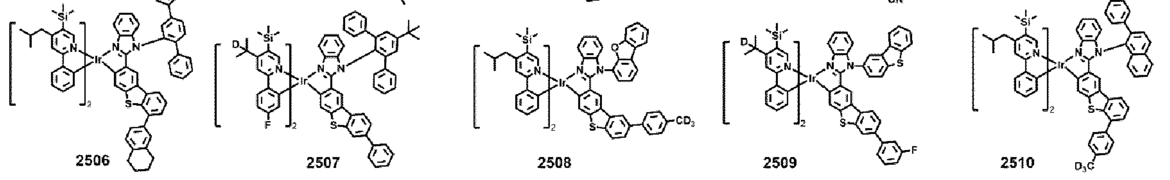
2506 2507 2508 2509 2510

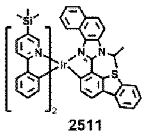
2511
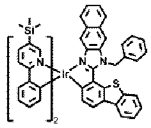
2512
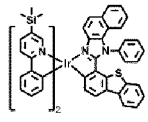
2513
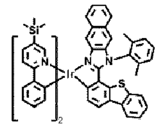
2514
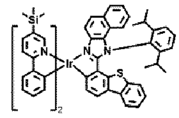
2515

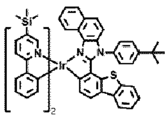
2516
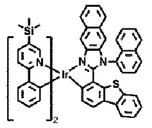
2517
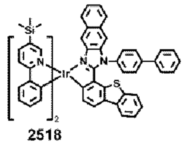
2518
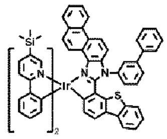
2519
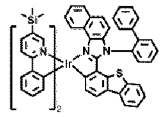
2520

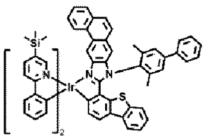
2521
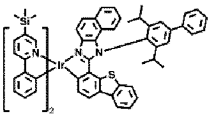
2522
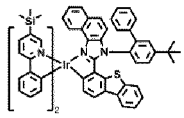
2523
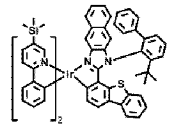
2524
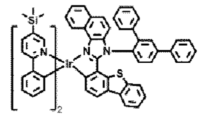
2525

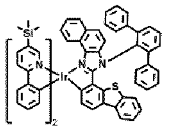
2526
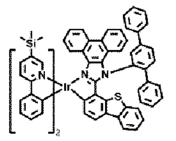
2527
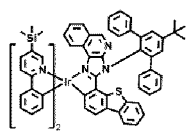
2528
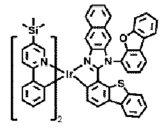
2529
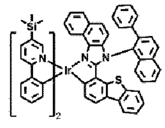
2530

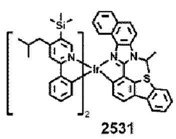
2531
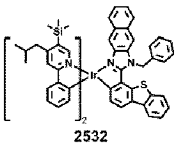
2532
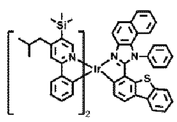
2533
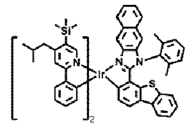
2534
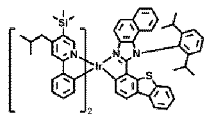
2535

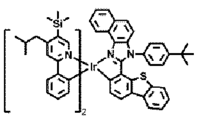
2536
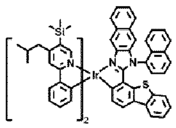
2537
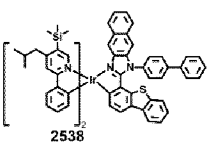
2538
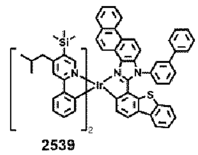
2539
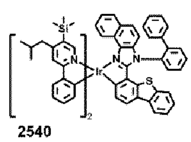
2540

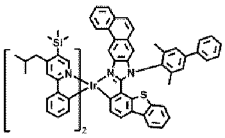
2541
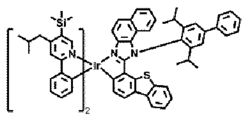
2542
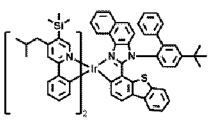
2543
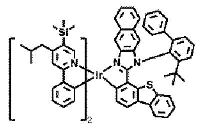
2544
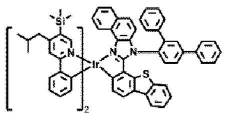
2545

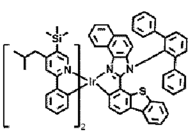
2546
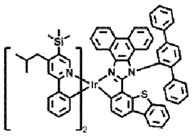
2547
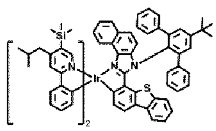
2548
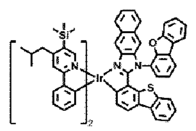
2549
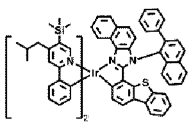
2550

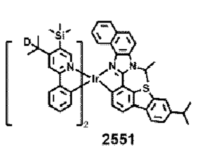
2551
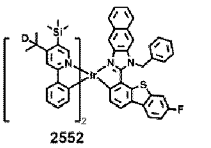
2552
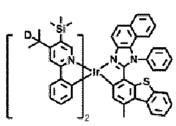
2553
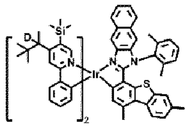
2554
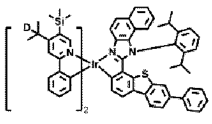
2555

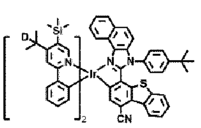
2556
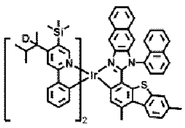
2557
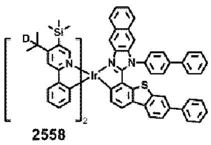
2558
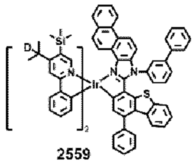
2559
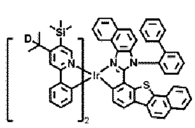
2560

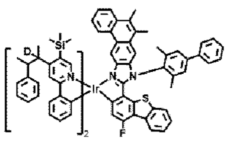
2561
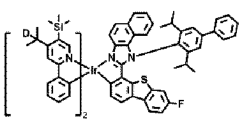
2562
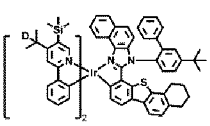
2563
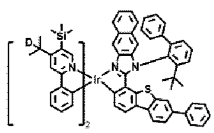
2564
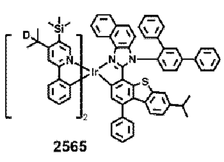
2565

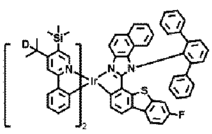
2566
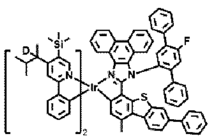
2567
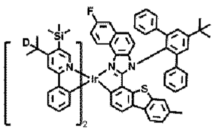
2568
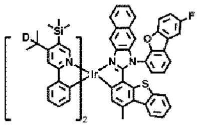
2569
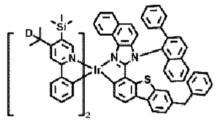
2570

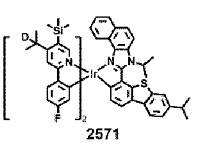
2571
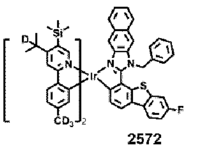
2572
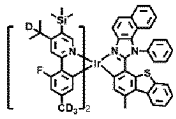
2573
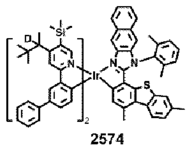
2574
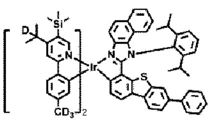
2575

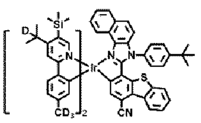
2576
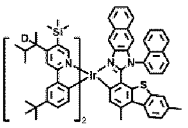
2577
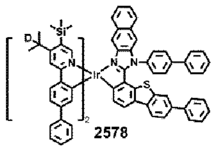
2578
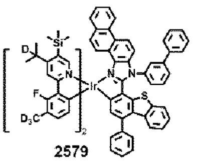
2579
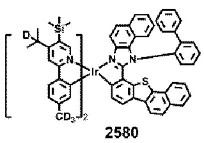
2580

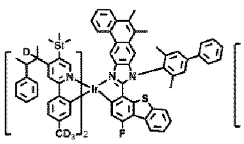
2581
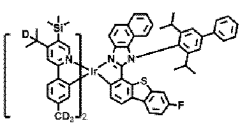
2582
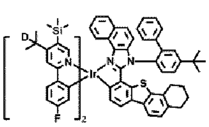
2583
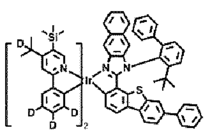
2584
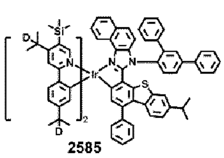
2585

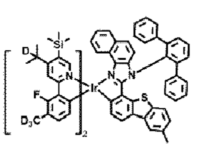
2586
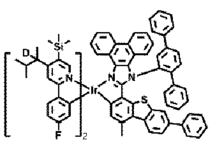
2587
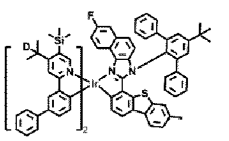
2588
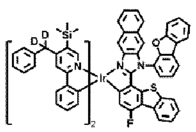
2589
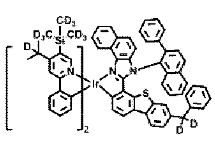
2590

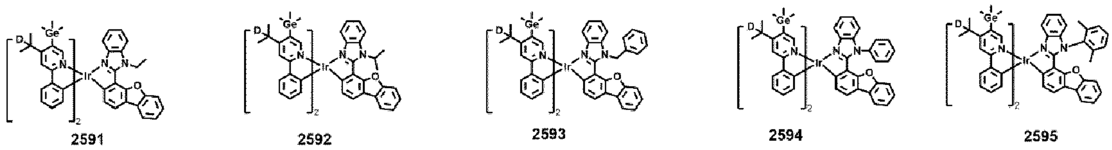
2591 2592 2593 2594 2595

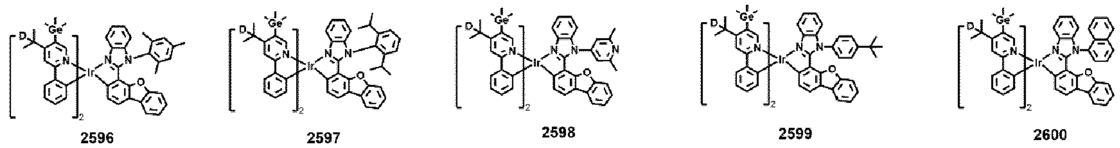
2596 2597 2598 2599 2600

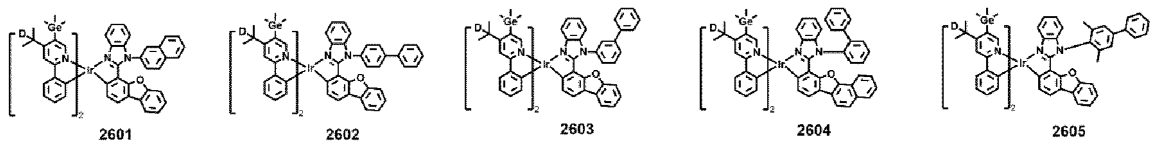
2601 2602 2603 2604 2605

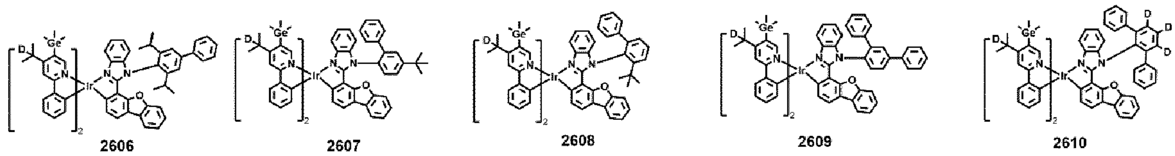
2606 2607 2608 2609 2610

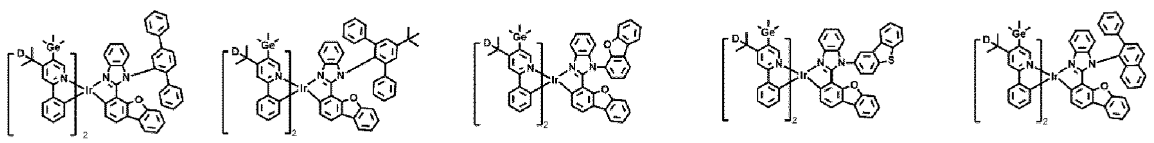
2611 2612 2613 2614 2615

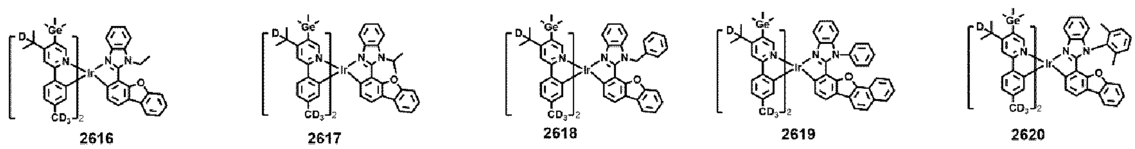
2616 2617 2618 2619 2620

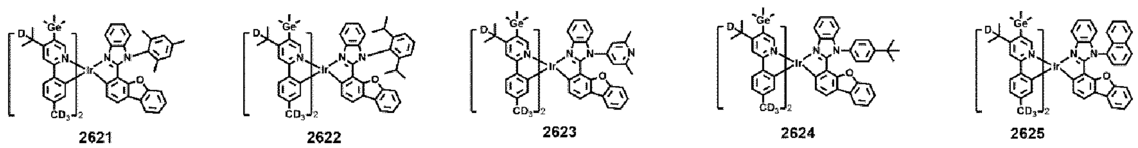
2621 2622 2623 2624 2625

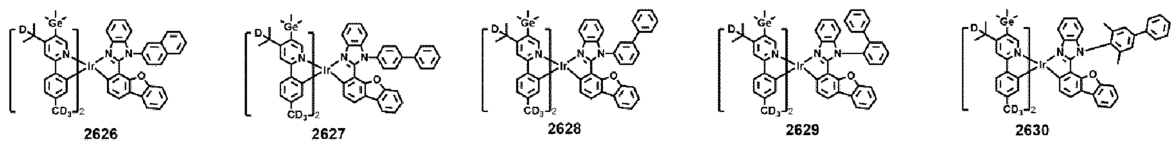
2626 2627 2628 2629 2630

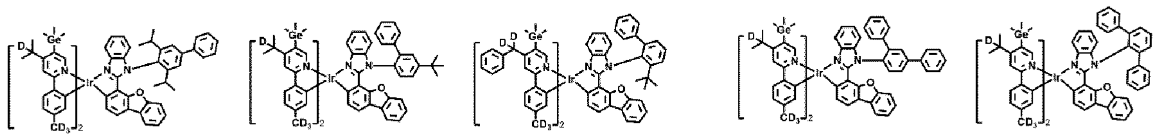
2631 2632 2633 2634 2635

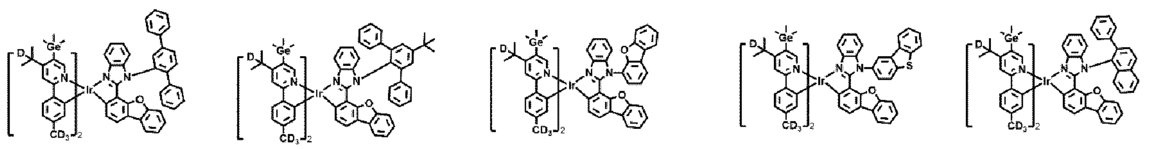
2636 2637 2638 2639 2640

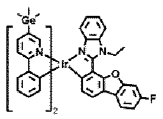
2641
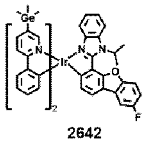
2642
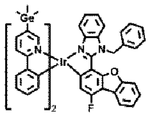
2643
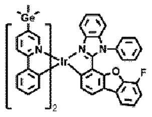
2644
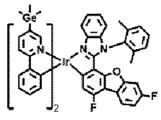
2645

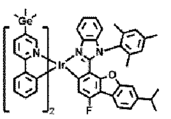
2646
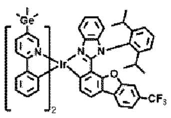
2647
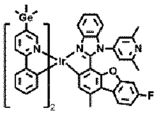
2648
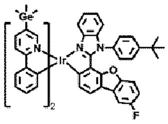
2649
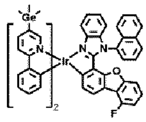
2650

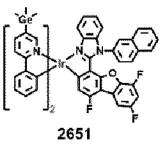
2651
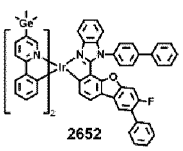
2652
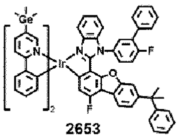
2653
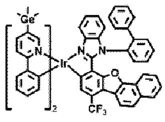
2654
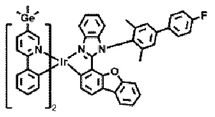
2655

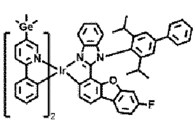
2656
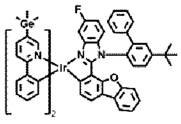
2657
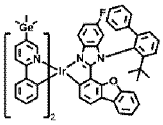
2658
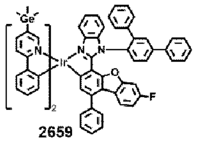
2659
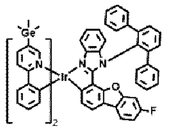
2660

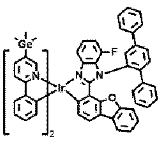
2661
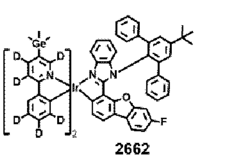
2662
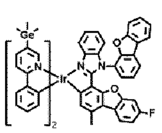
2663
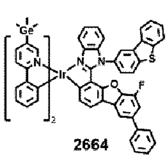
2664
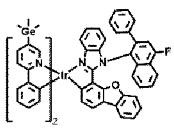
2665

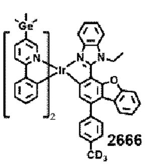
2666
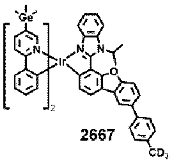
2667
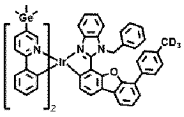
2668
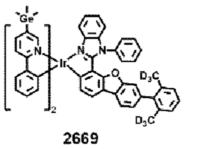
2669
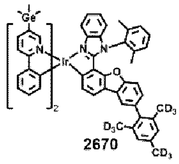
2670

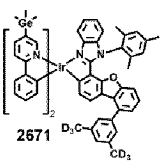
2671
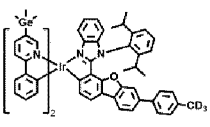
2672
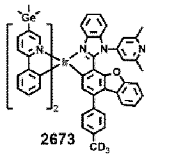
2673
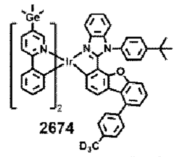
2674
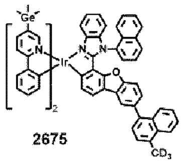
2675

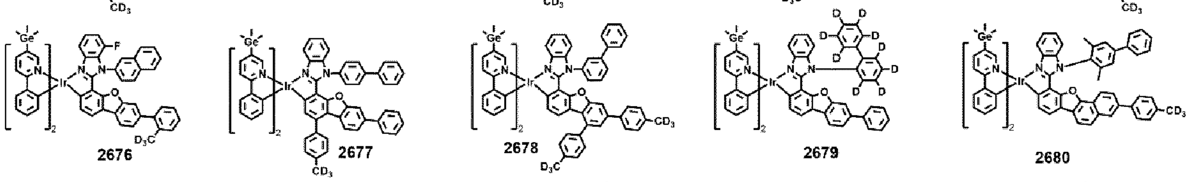
2676
2677
2678
2679
2680

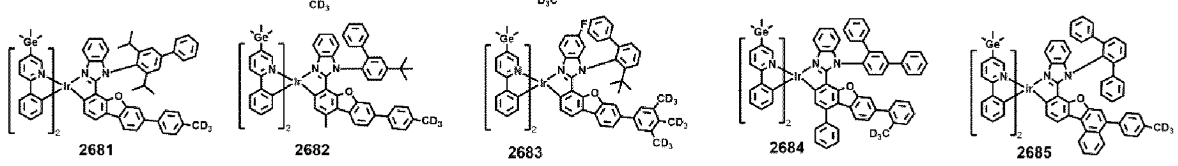
2681
2682
2683
2684
2685

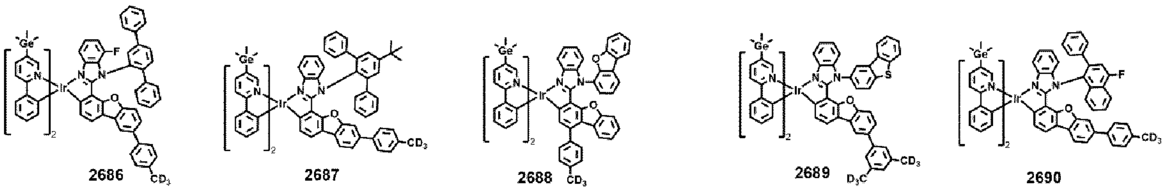
2686
2687
2688
2689
2690

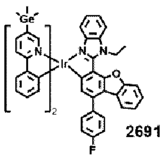
2691

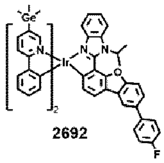
2692

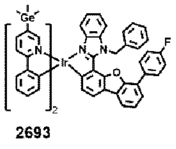
2693

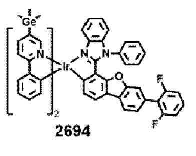
2694

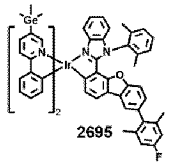
2695

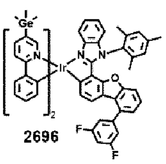
2696

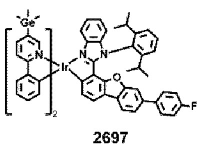
2697

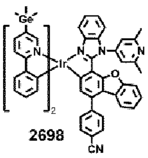
2698

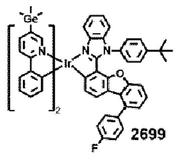
2699

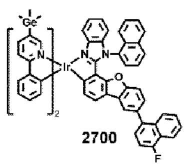
2700

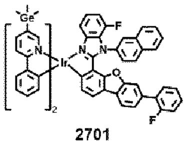
2701

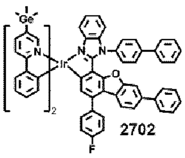
2702

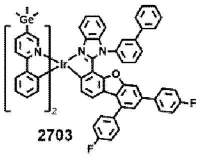
2703

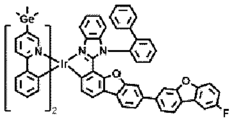
2704

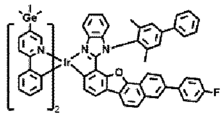
2705

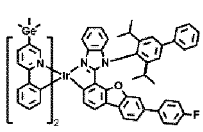
2706

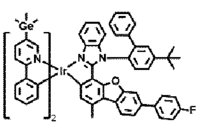
2707

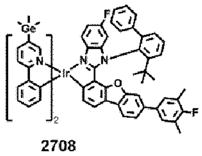
2708

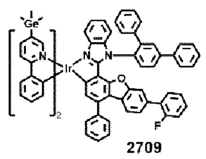
2709

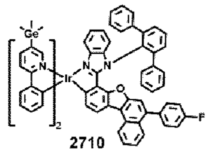
2710

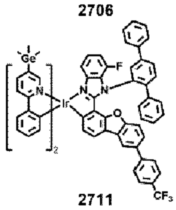
2711

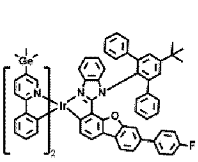
2712

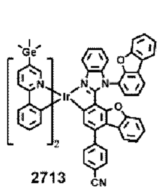
2713

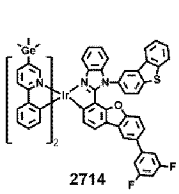
2714

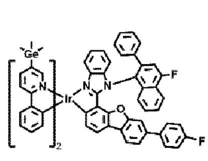
2715

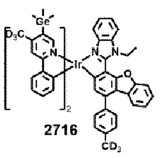
2716

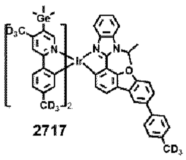
2717

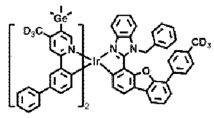
2718

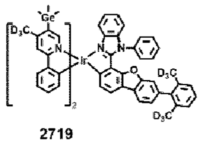
2719

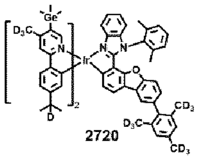
2720

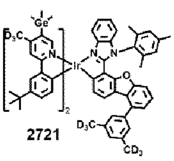
2721

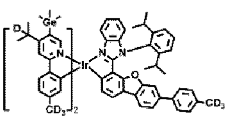
2722

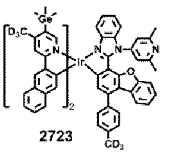
2723

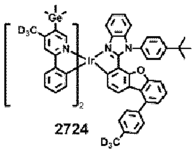
2724

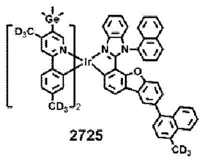
2725

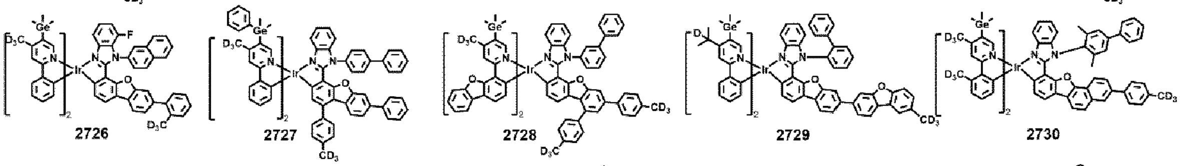
2726 2727 2728 2729 2730

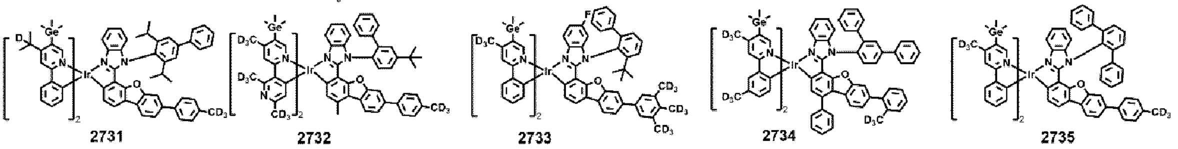
2731 2732 2733 2734 2735

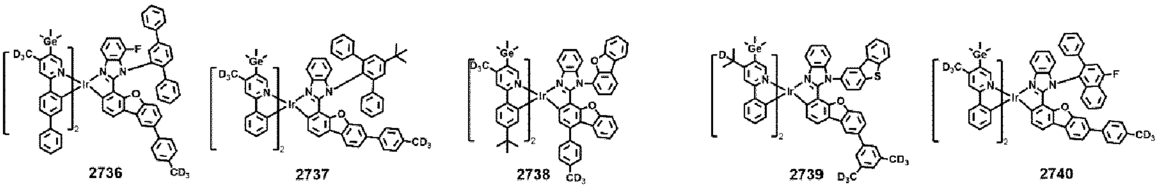
2736 2737 2738 2739 2740

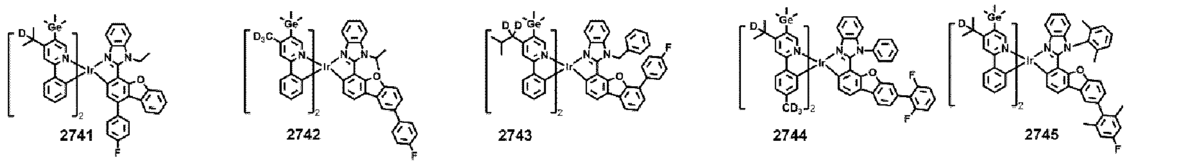

2741 2742 2743 2744 2745

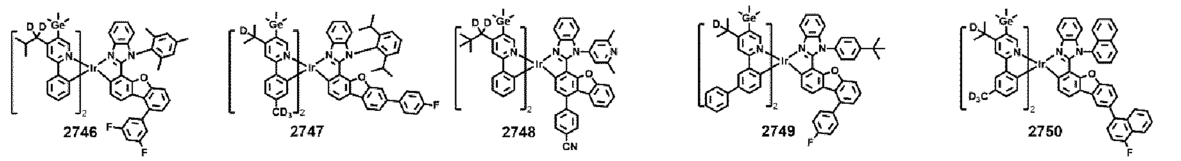

2746 2747 2748 2749 2750

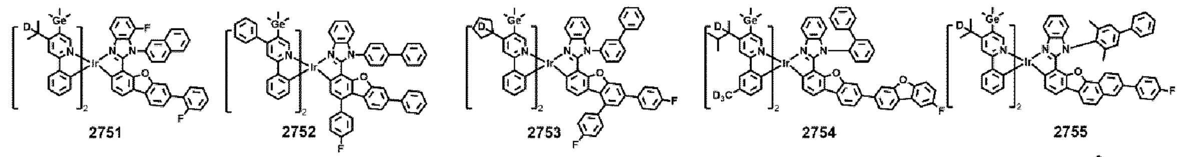

2751 2752 2753 2754 2755

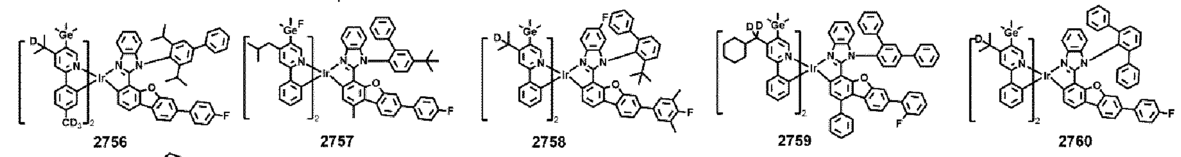

2756 2757 2758 2759 2760

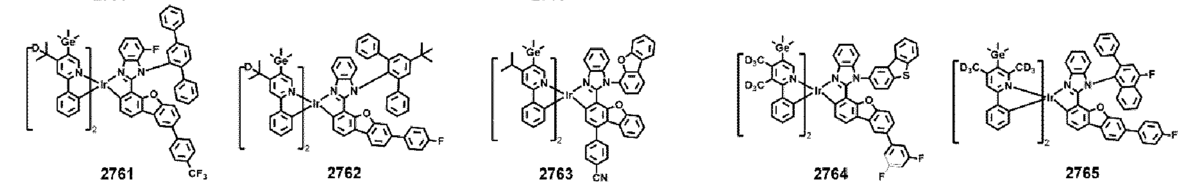

2761 2762 2763 2764 2765

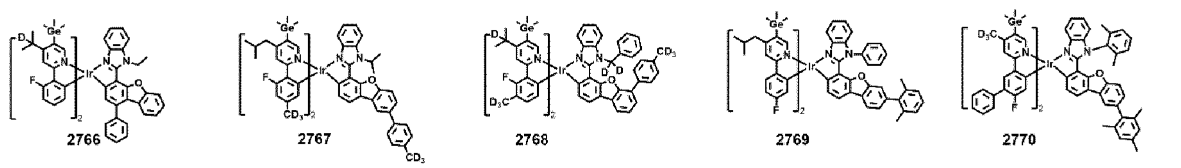

2766 2767 2768 2769 2770

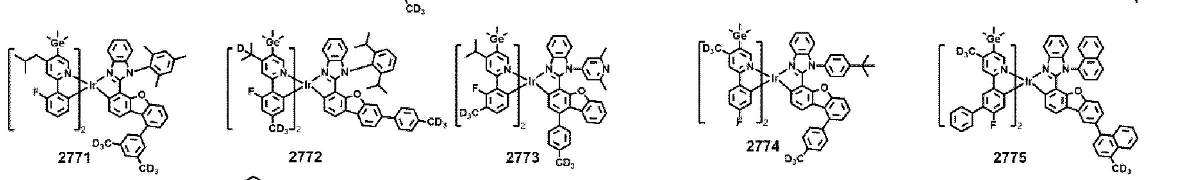

2771 2772 2773 2774 2775

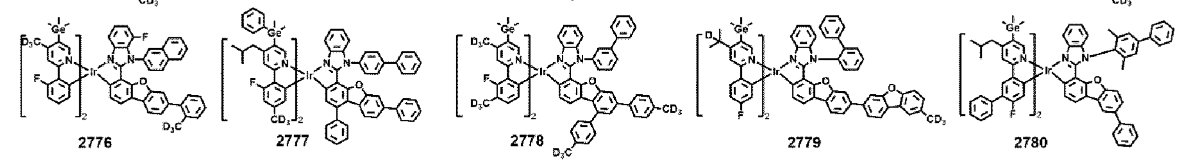

2776 2777 2778 2779 2780

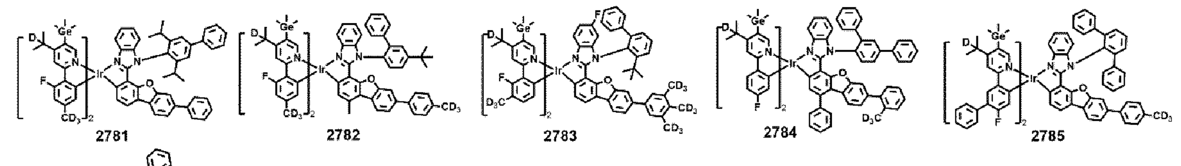

2781 2782 2783 2784 2785

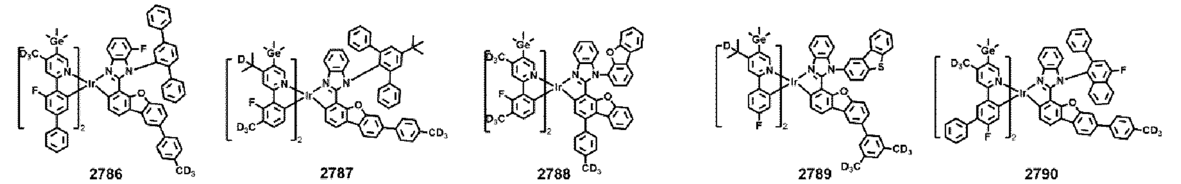

2786 2787 2788 2789 2790

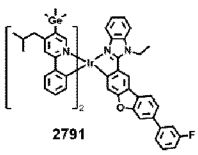
2791
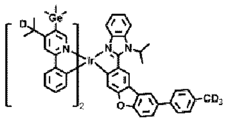
2792
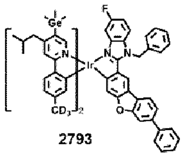
2793
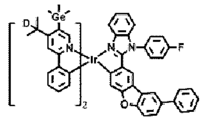
2794
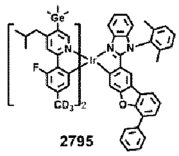
2795

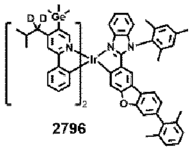
2796
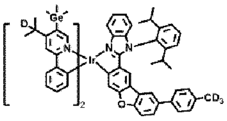
2797
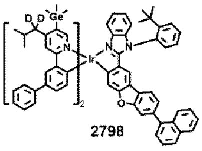
2798
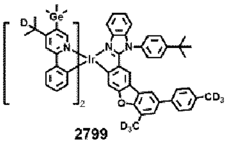
2799
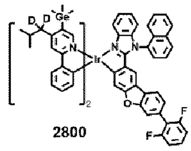
2800

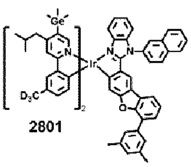
2801
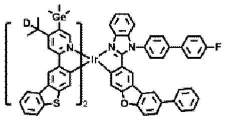
2802
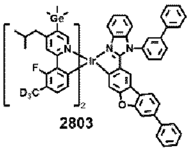
2803
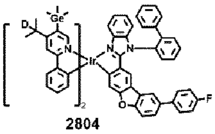
2804
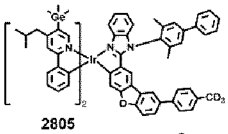
2805

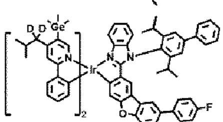
2806
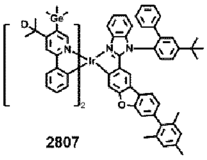
2807
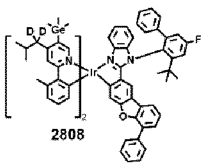
2808
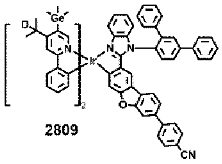
2809
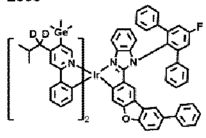
2810

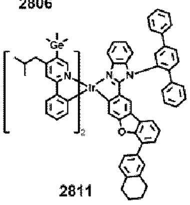
2811
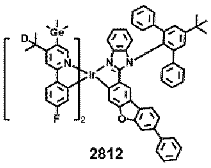
2812
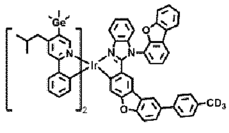
2813
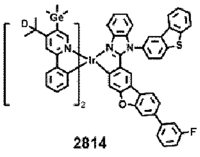
2814
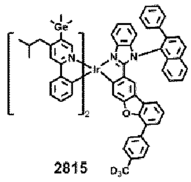
2815

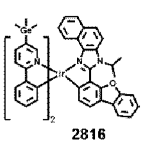
2816
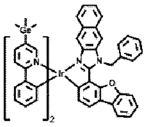
2817
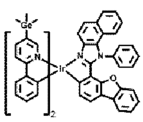
2818
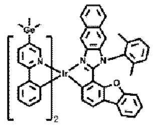
2819
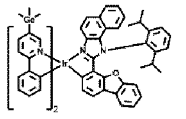
2820

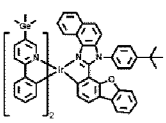
2821
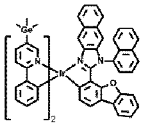
2822
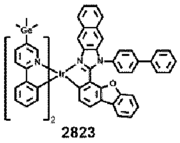
2823
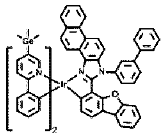
2824
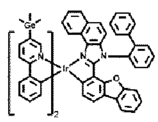
2825

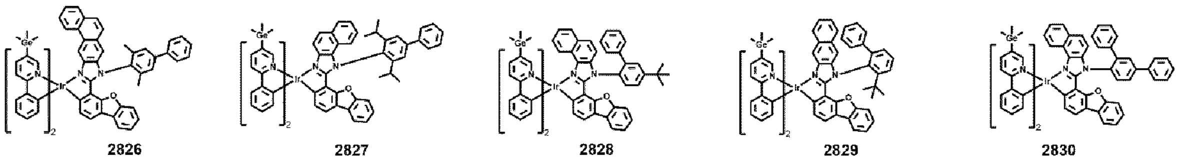
2826
2827
2828
2829
2830

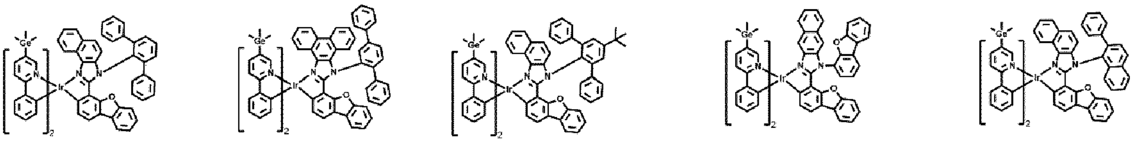
2831
2832
2833
2834
2835

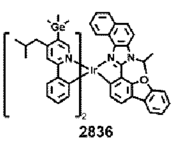
2836
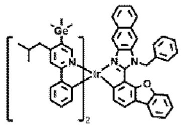
2837
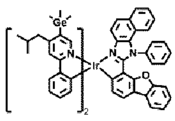
2838
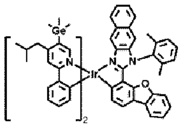
2839
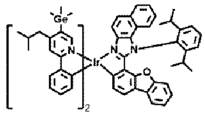
2840

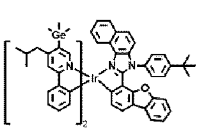
2841
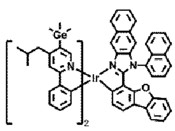
2842
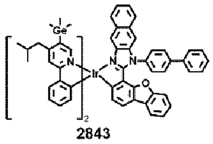
2843
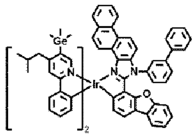
2844
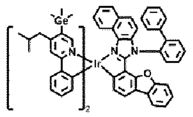
2845

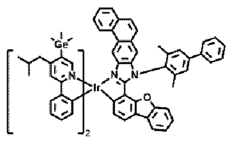
2846
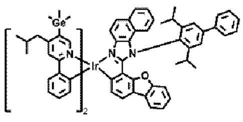
2847
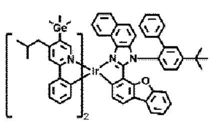
2848
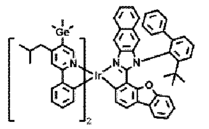
2849
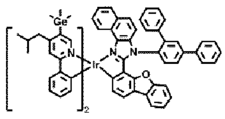
2850

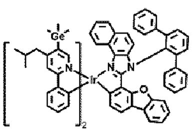
2851
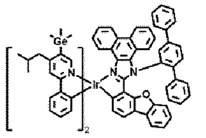
2852
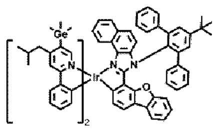
2853
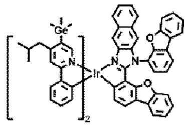
2854
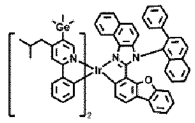
2855

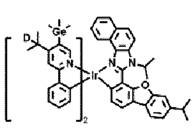
2856
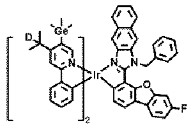
2857
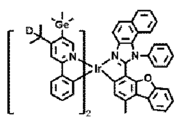
2858
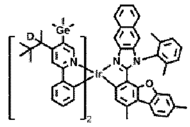
2859
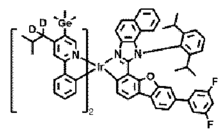
2860

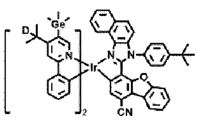
2861
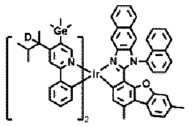
2862
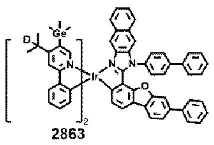
2863
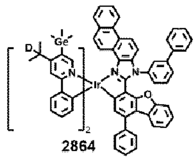
2864
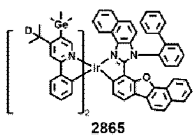
2865

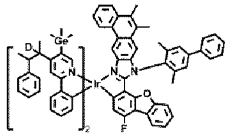
2866
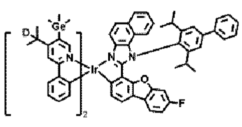
2867
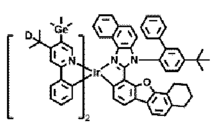
2868
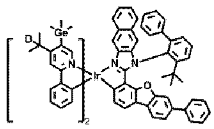
2869
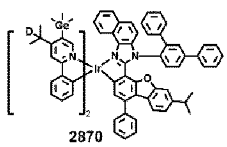
2870

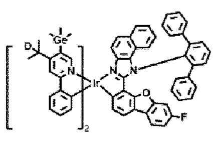
2871
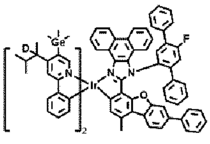
2872
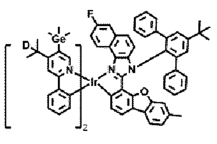
2873
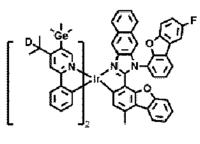
2874
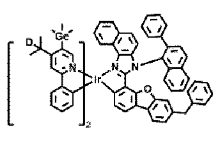
2875

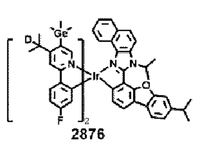
2876
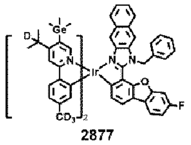
2877
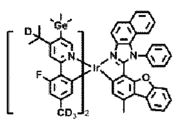
2878
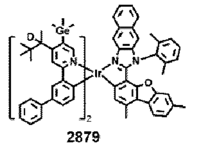
2879
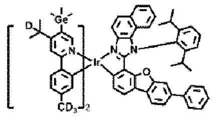
2880

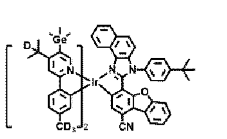
2881
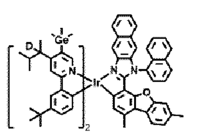
2882
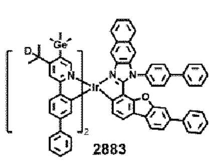
2883
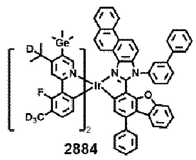
2884
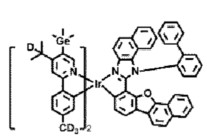
2885

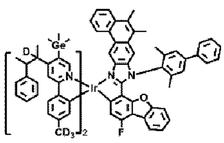
2886
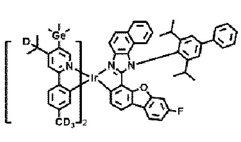
2887
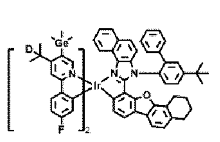
2888
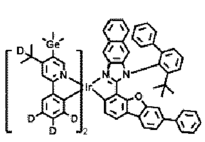
2889
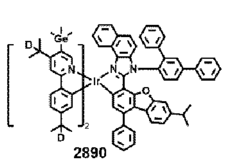
2890

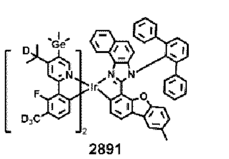
2891
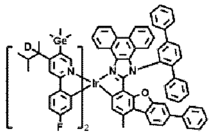
2892
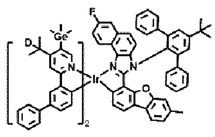
2893
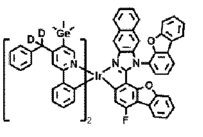
2894
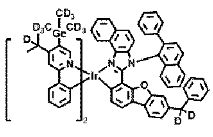
2895

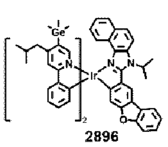
2896
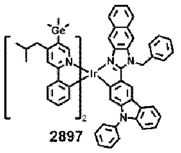
2897
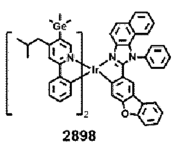
2898
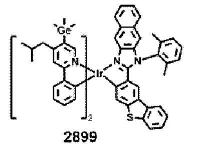
2899
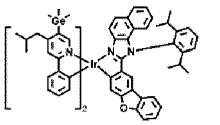
2900

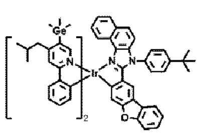
2901
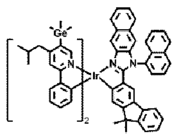
2902
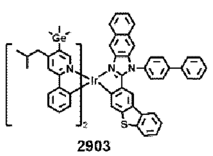
2903
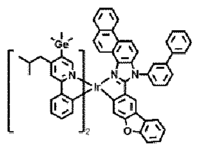
2904
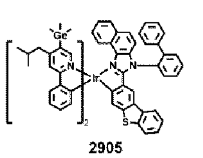
2905

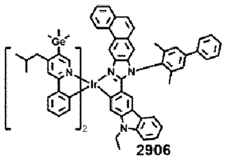
2906
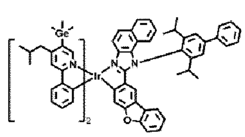
2907
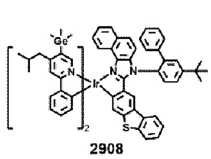
2908
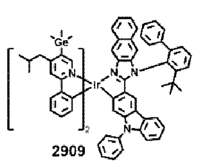
2909
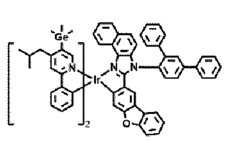
2910

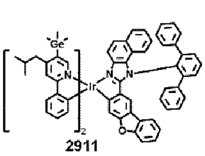
2911
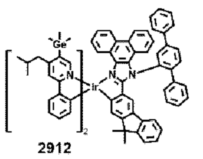
2912
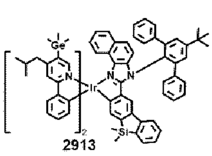
2913
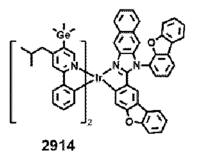
2914
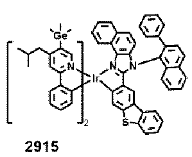
2915

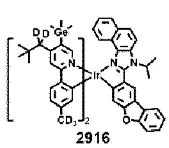
2916

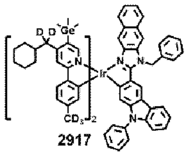
2917

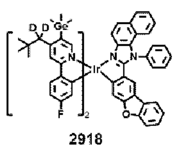
2918

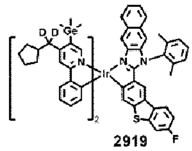
2919

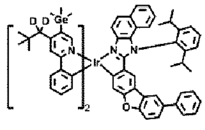
2920

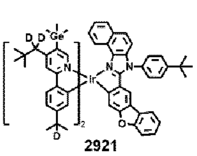
2921

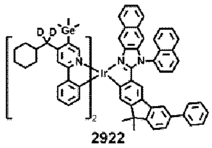
2922

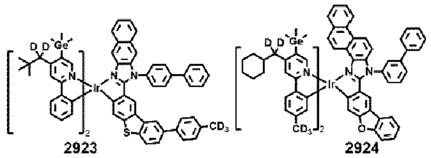
2923

2924

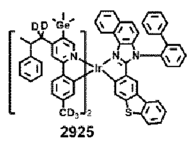
2925

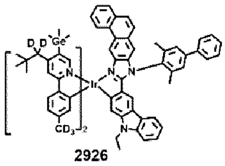
2926

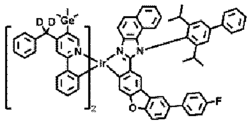
2927

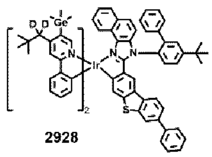
2928

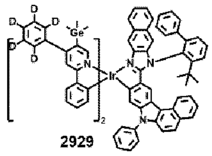
2929

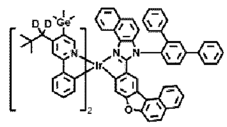
2930

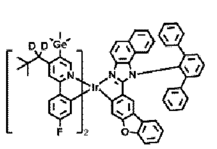
2931

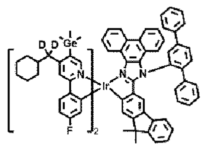
2932

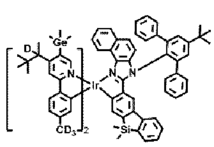
2933

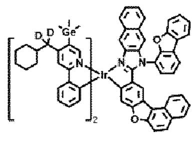
2934

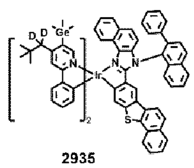
2935

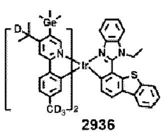
2936

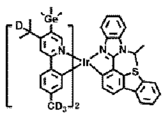
2937

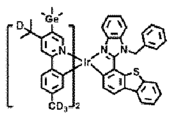
2938

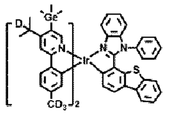
2939

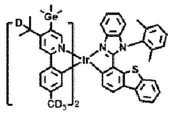
2940

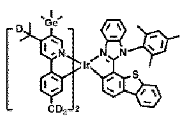
2941

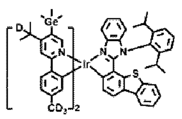
2942

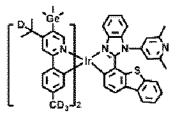
2943

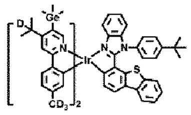
2944

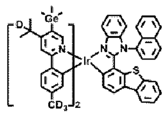
2945

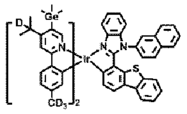
2946

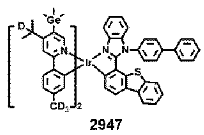
2947

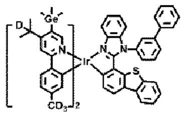
2948

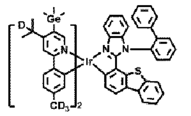
2949

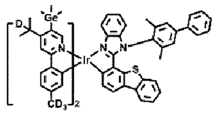
2950

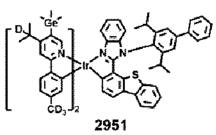
2951

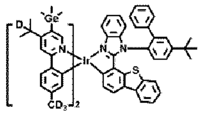
2952

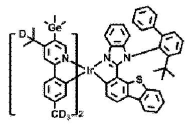
2953

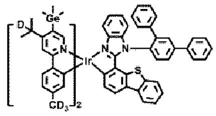
2954

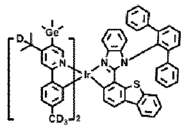
2955

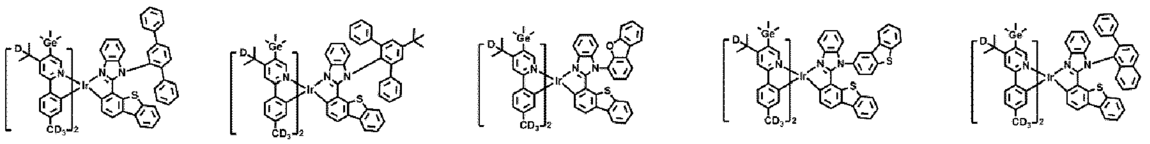
2956

2957

2958

2959

2960

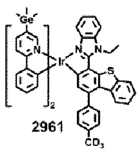
2961
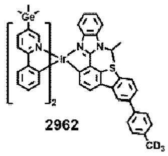
2962
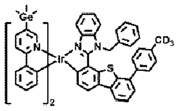
2963
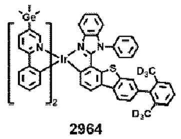
2964
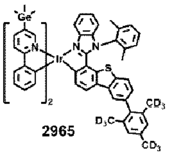
2965

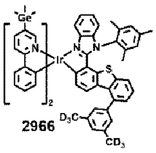
2966
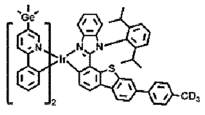
2967
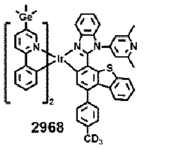
2968
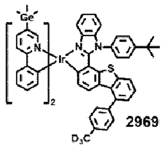
2969
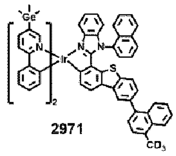
2971

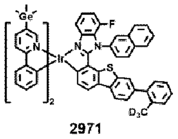
2971
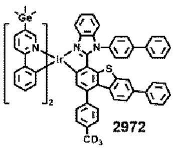
2972
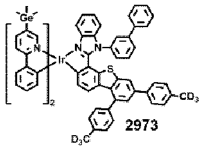
2973
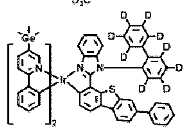
2974
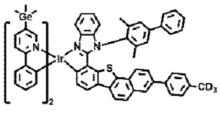
2975

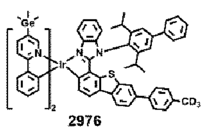
2976
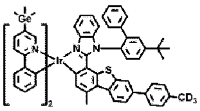
2977
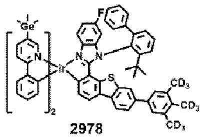
2978
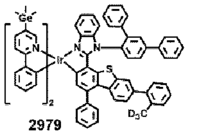
2979
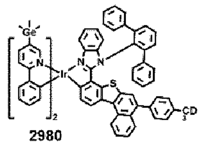
2980

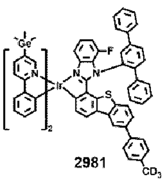
2981
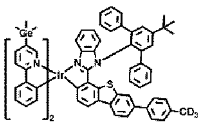
2982
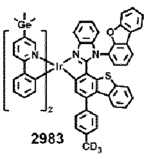
2983
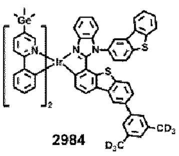
2984
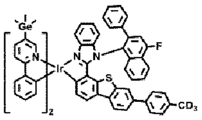
2985

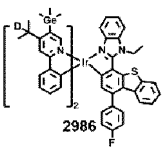
2986
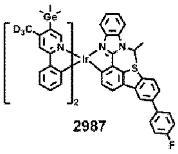
2987
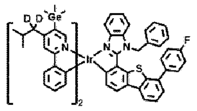
2988
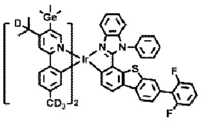
2989
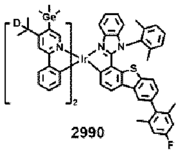
2990

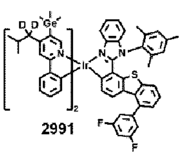
2991
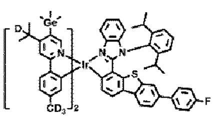
2992
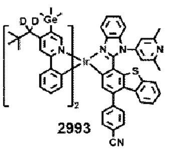
2993
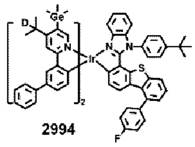
2994
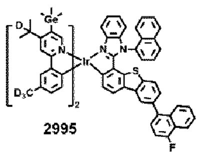
2995

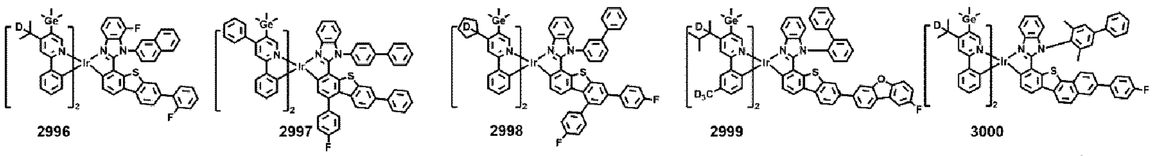
2996 2997 2998 2999 3000

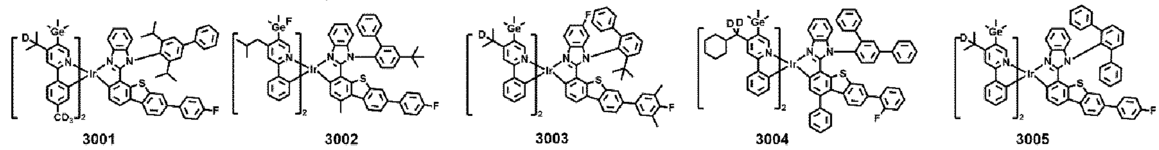
3001 3002 3003 3004 3005

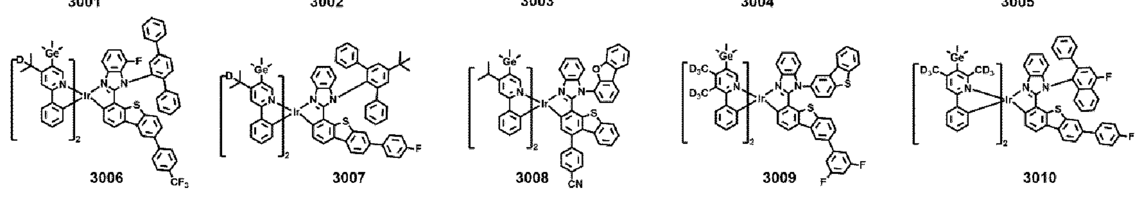
3006 3007 3008 3009 3010

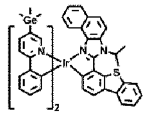
3011
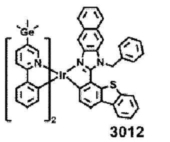
3012
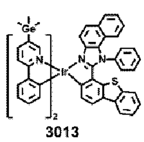
3013
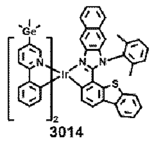
3014
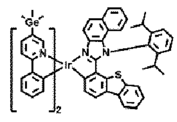
3015

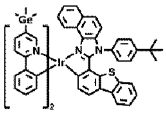
3016
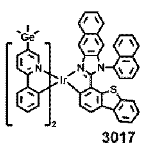
3017
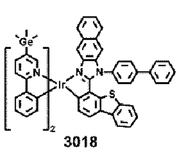
3018
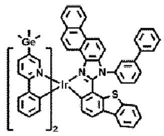
3019
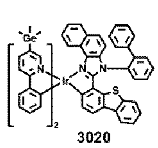
3020

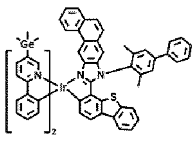
3021
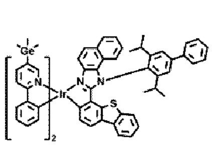
3022
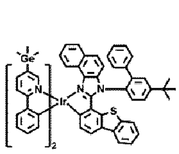
3023
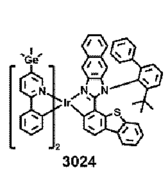
3024
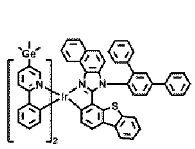
3025

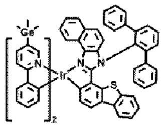
3026
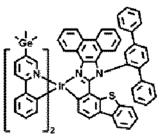
3027
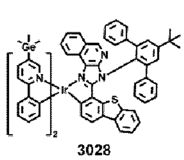
3028
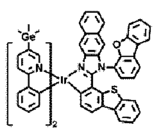
3029
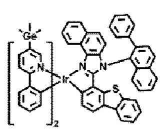
3030

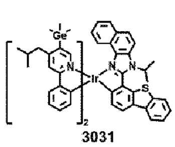
3031
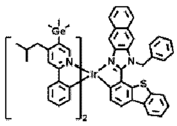
3032
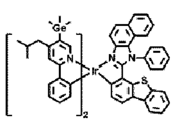
3033
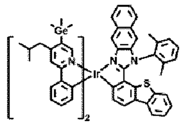
3034
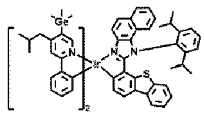
3035

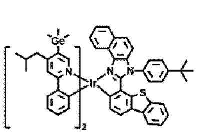
3036
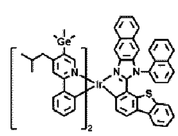
3037
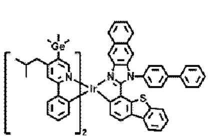
3038
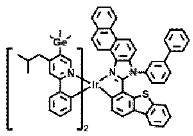
3039
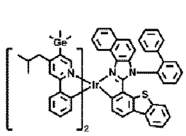
3040

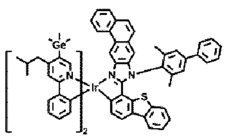
3041
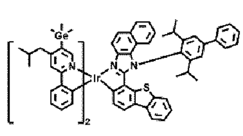
3042
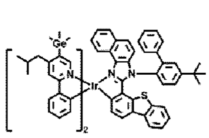
3043
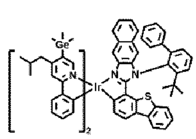
3044
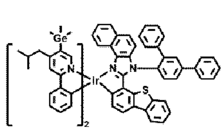
3045

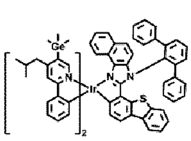
3046
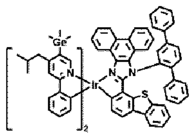
3047
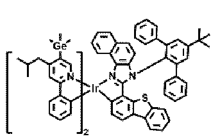
3048
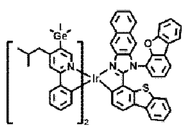
3049
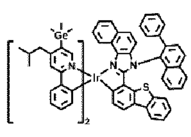
3050

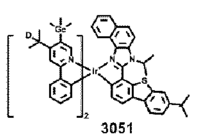
3051
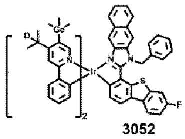
3052
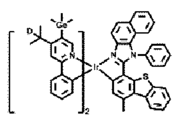
3053
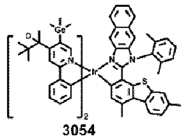
3054
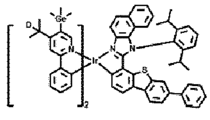
3055
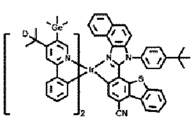
3056
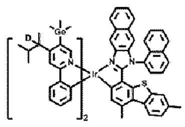
3057
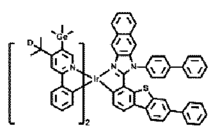
3058
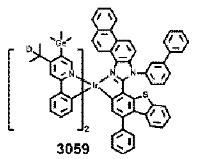
3059
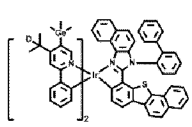
3060
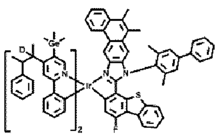
3061
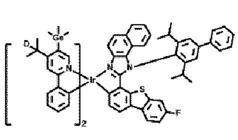
3062
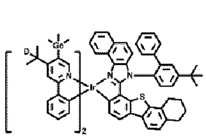
3063
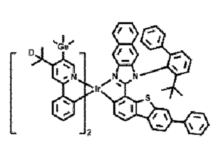
3064
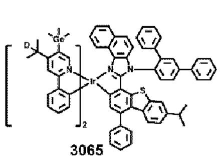
3065
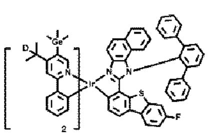
3066
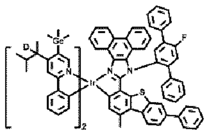
3067
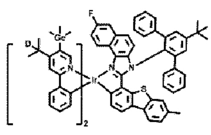
3068
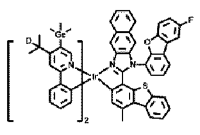
3069
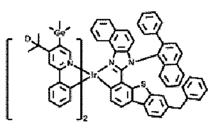
3070
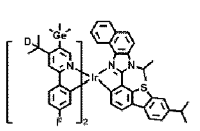
3071
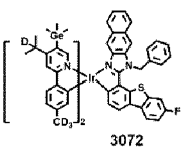
3072
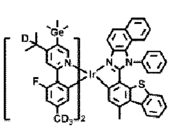
3073
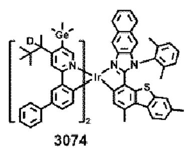
3074
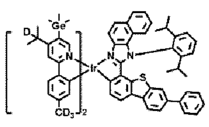
3075
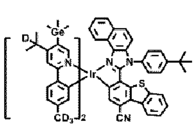
3076
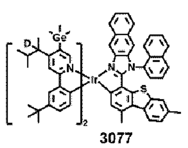
3077
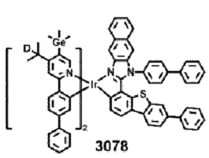
3078
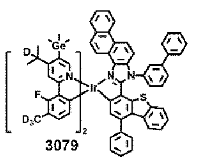
3079
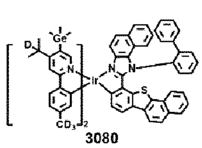
3080
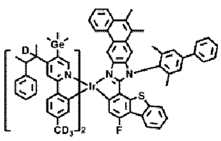
3081
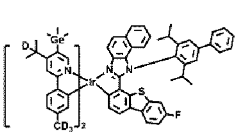
3082
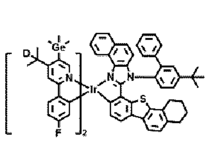
3083
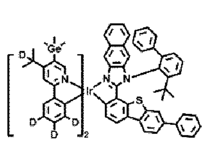
3084
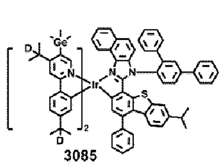
3085
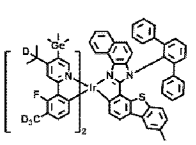
3086
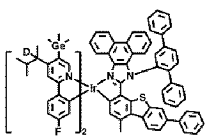
3087
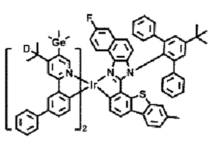
3088
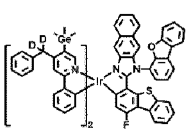
3089
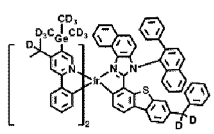
3090

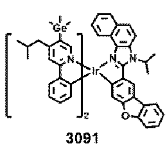
3091
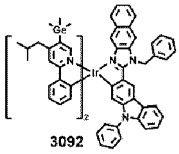
3092
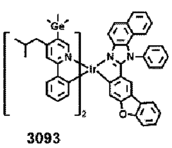
3093
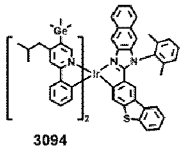
3094
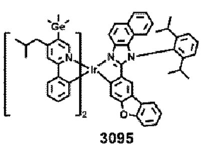
3095

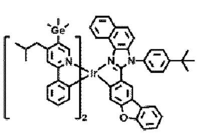
3096
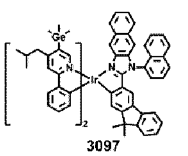
3097
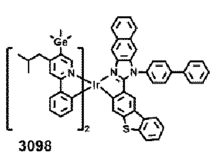
3098
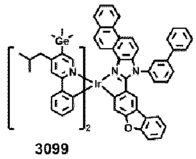
3099
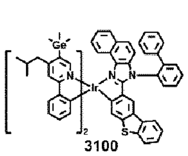
3100

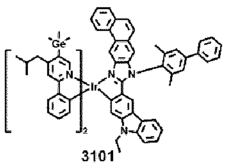
3101
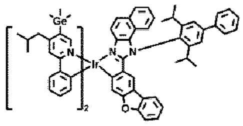
3102
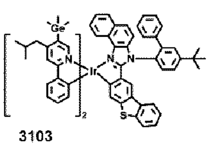
3103
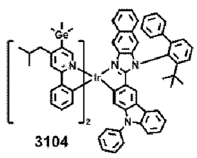
3104
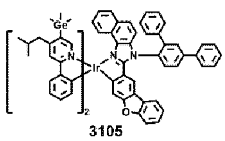
3105

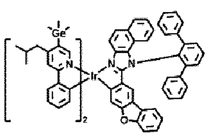
3106
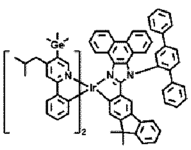
3107
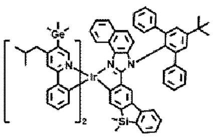
3108
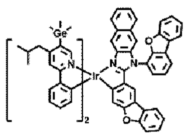
3109
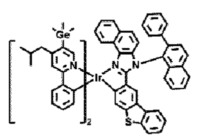
3110

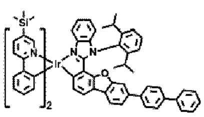
3111
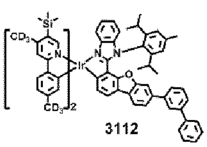
3112
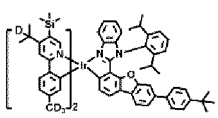
3113
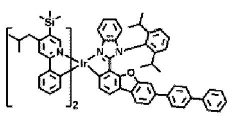
3114
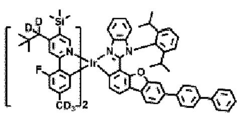
3115

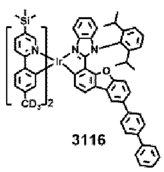
3116
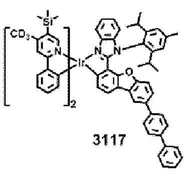
3117
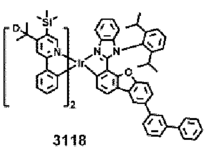
3118
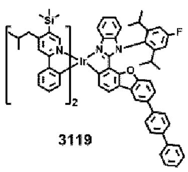
3119
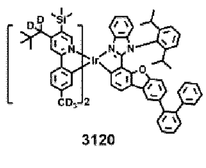
3120

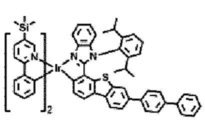
3121
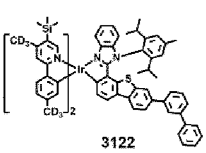
3122
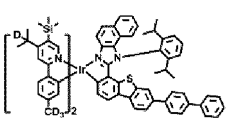
3123
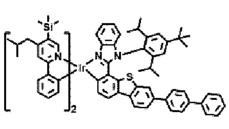
3124
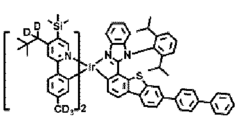
3125

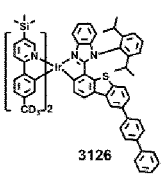
3126
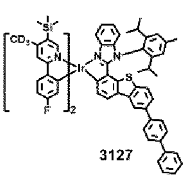
3127
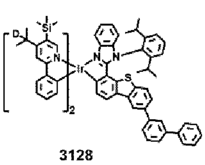
3128
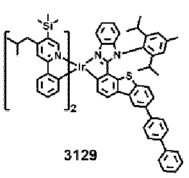
3129
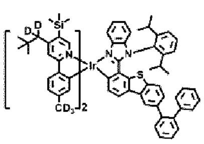
3130

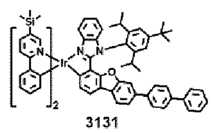
3131
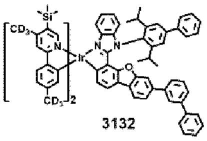
3132
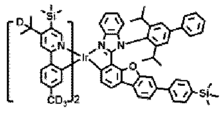
3133
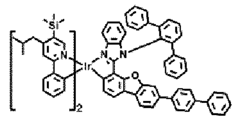
3134
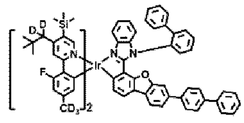
3135

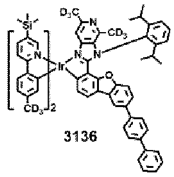
3136
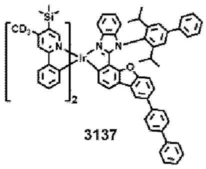
3137
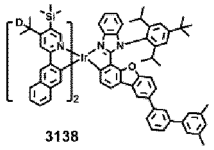
3138
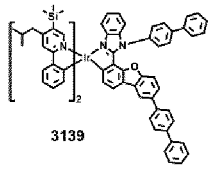
3139
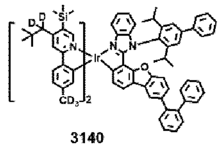
3140

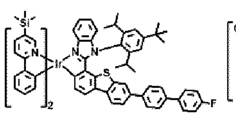
3141
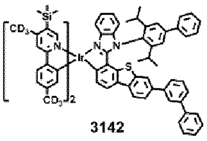
3142
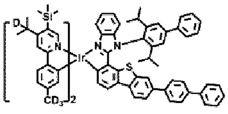
3143
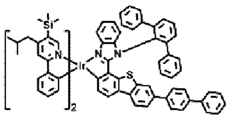
3144
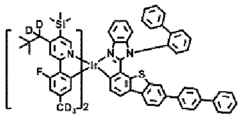
3145

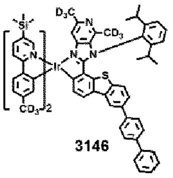
3146
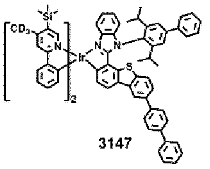
3147
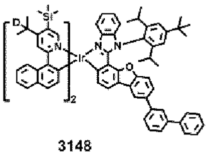
3148
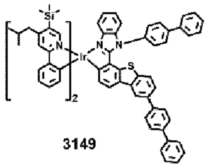
3149
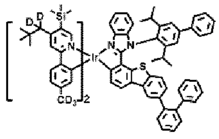
3150

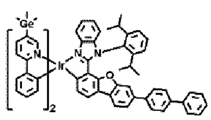
3151
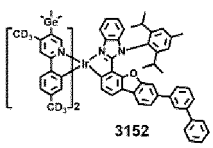
3152
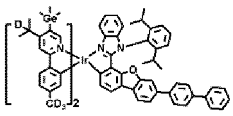
3153
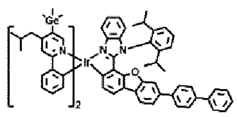
3154
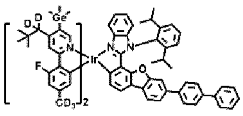
3155

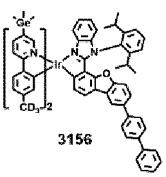
3156
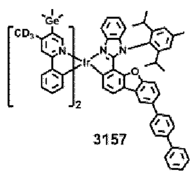
3157
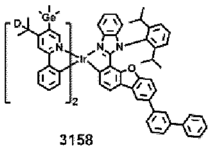
3158
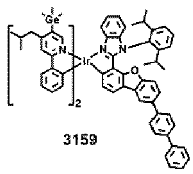
3159
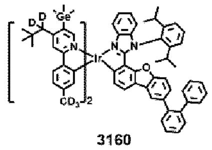
3160

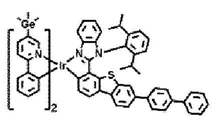
3161
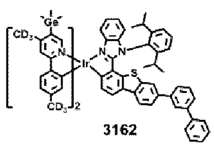
3162
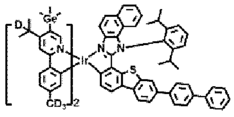
3163
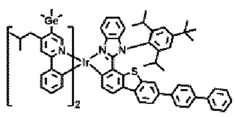
3164
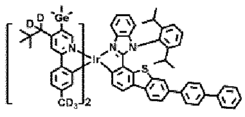
3165

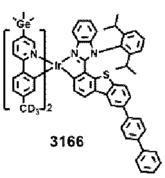
3166
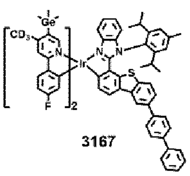
3167
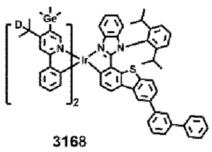
3168
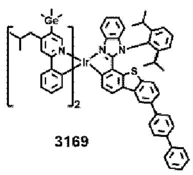
3169
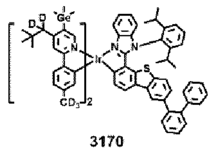
3170

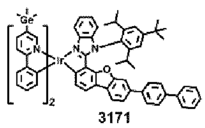
3171
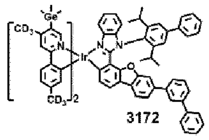
3172
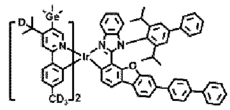
3173
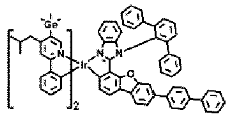
3174
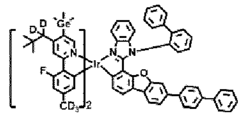
3175
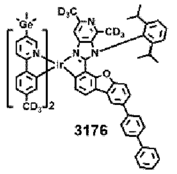
3176
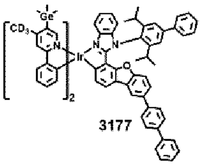
3177
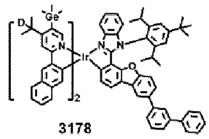
3178
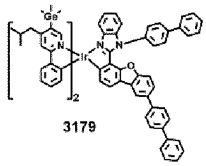
3179
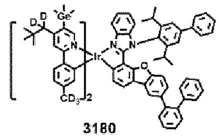
3180
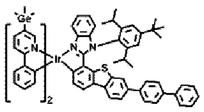
3181
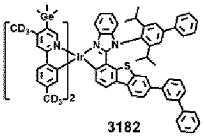
3182
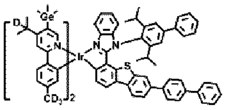
3183
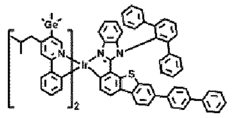
3184
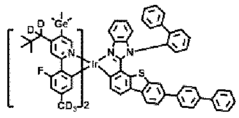
3185
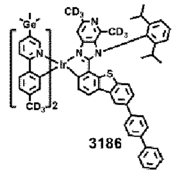
3186
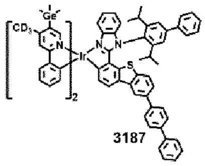
3187
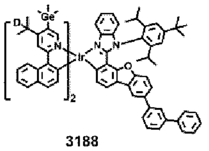
3188
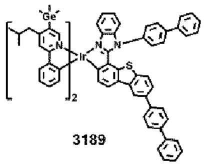
3189
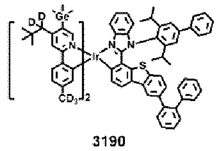
3190
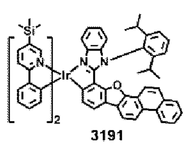
3191
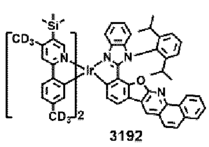
3192
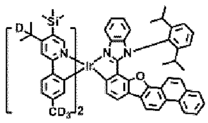
3193
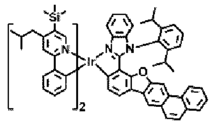
3194
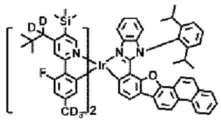
3195
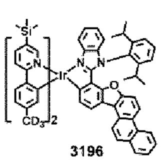
3196
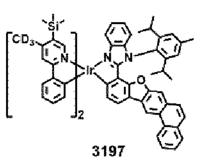
3197
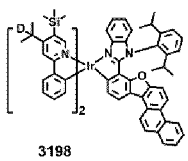
3198
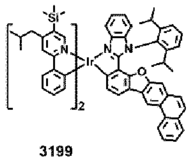
3199
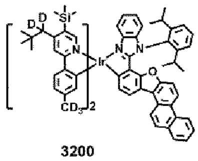
3200
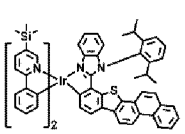
3201
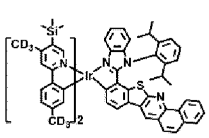
3202
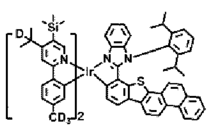
3203
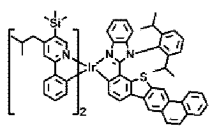
3204
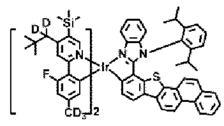
3205
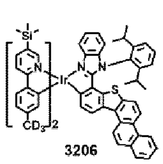
3206
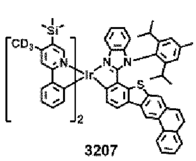
3207
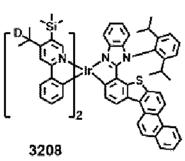
3208
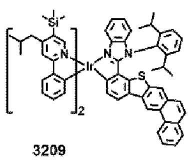
3209
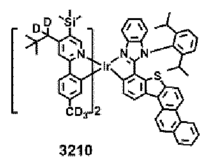
3210

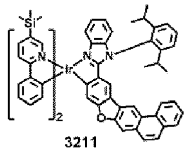
3211
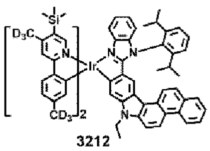
3212
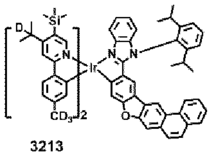
3213
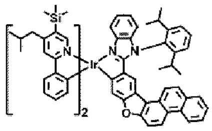
3214
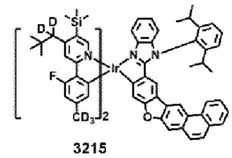
3215
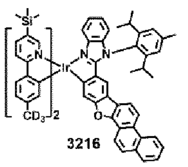
3216
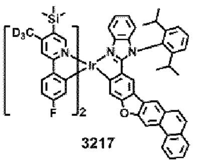
3217
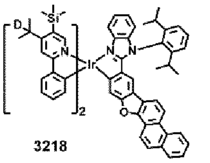
3218
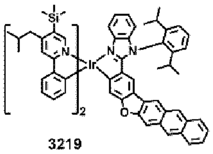
3219
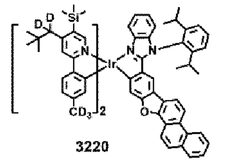
3220
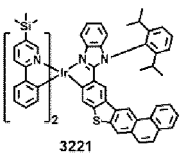
3221
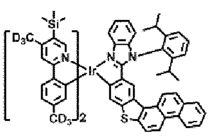
3222
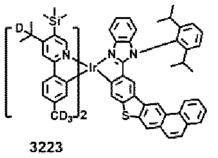
3223
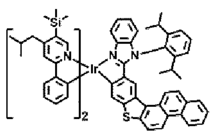
3224
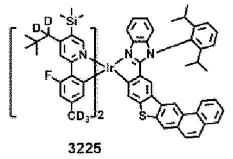
3225
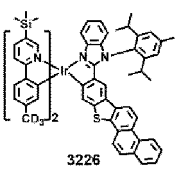
3226
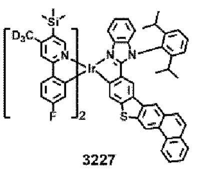
3227
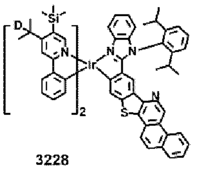
3228
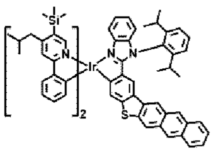
3229
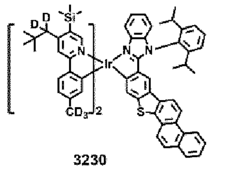
3230
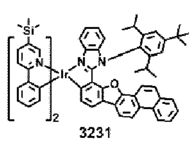
3231
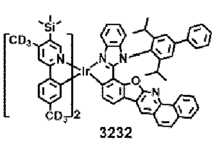
3232
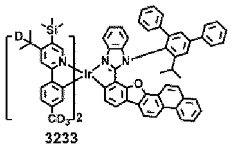
3233
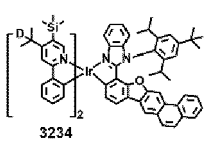
3234
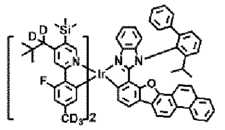
3235
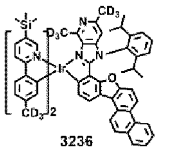
3236
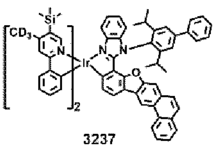
3237
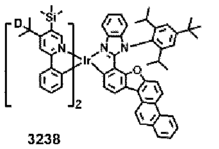
3238
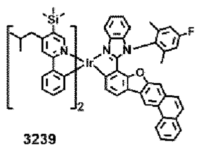
3239
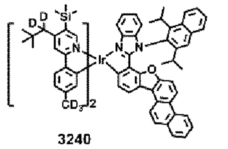
3240
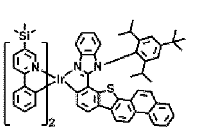
3241
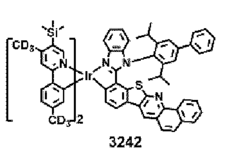
3242
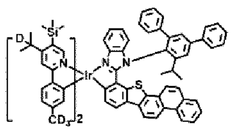
3243
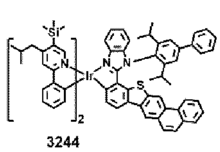
3244
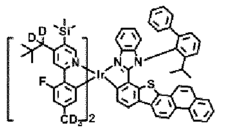
3245
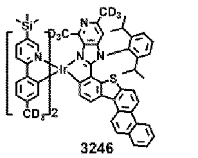
3246
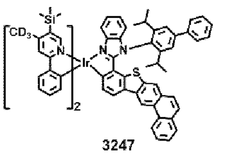
3247
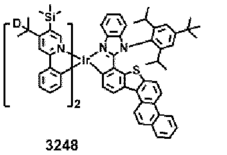
3248
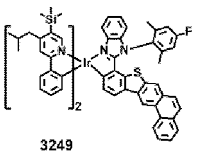
3249
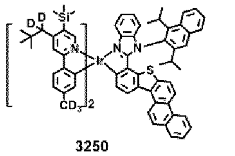
3250

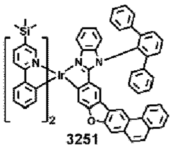
3251

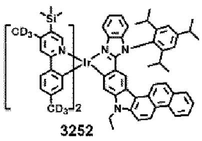
3252

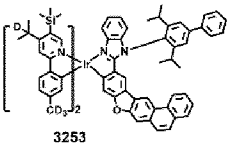
3253

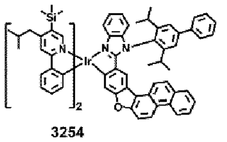
3254

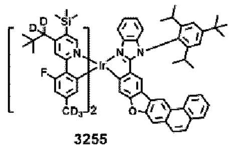
3255

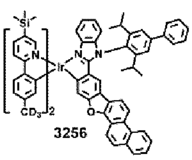
3256

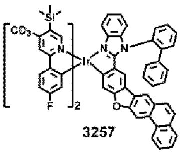
3257

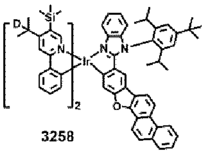
3258

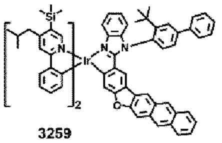
3259

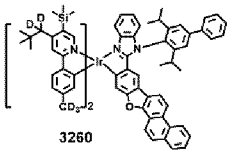
3260

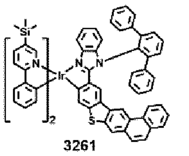
3261

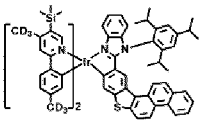
3262

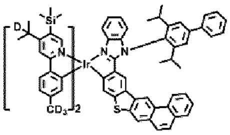
3263

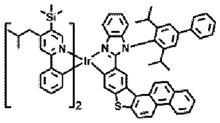
3264

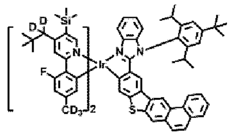
3265

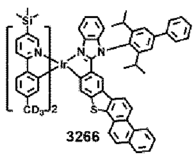
3266

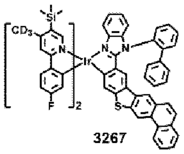
3267

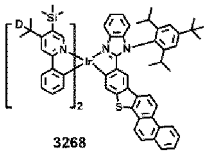
3268

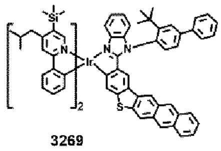
3269

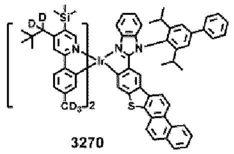
3270

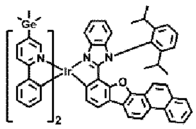
3271

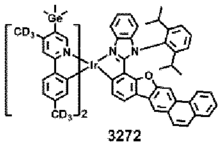
3272

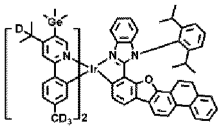
3273

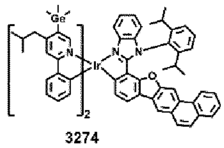
3274

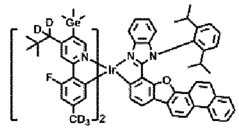
3275

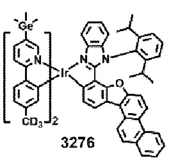
3276

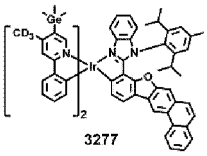
3277

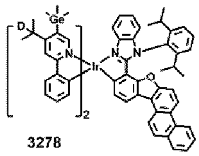
3278

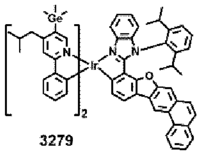
3279

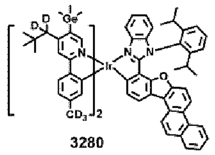
3280

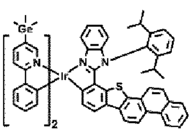
3281

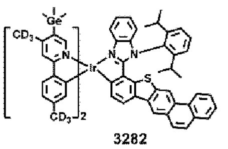
3282

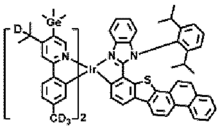
3283

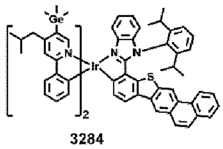
3284

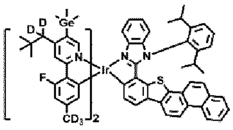
3285

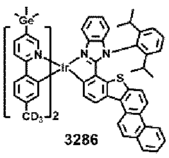
3286

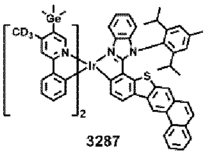
3287

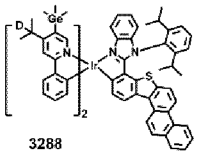
3288

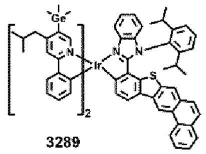
3289

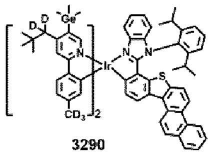
3290

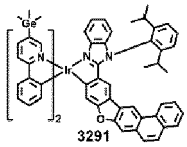
3291
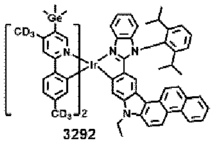
3292
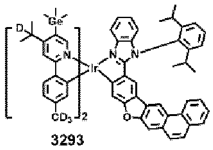
3293
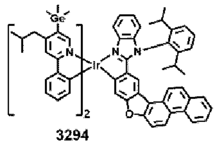
3294
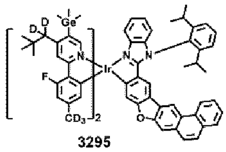
3295
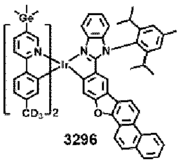
3296
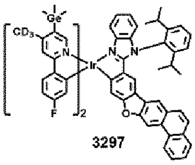
3297
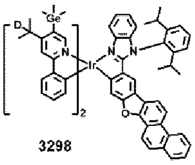
3298
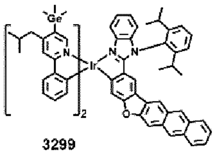
3299
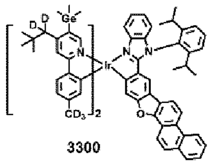
3300
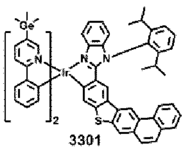
3301
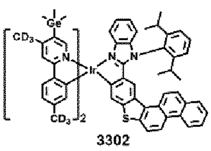
3302
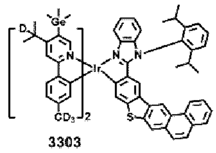
3303
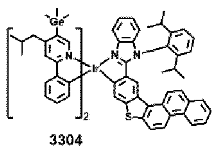
3304
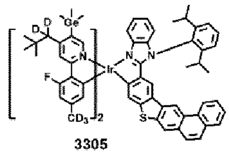
3305
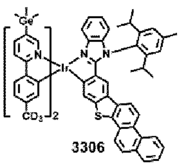
3306
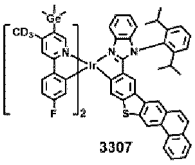
3307
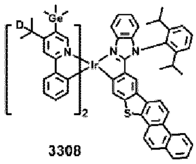
3308
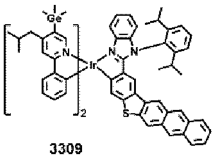
3309
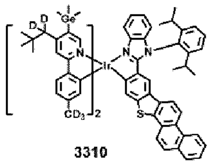
3310
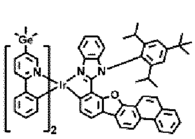
3311
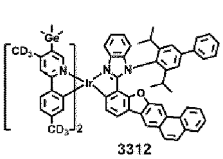
3312
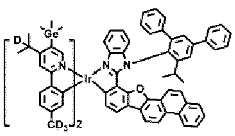
3313
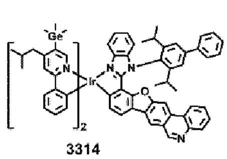
3314
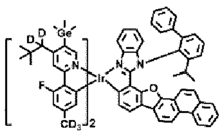
3315
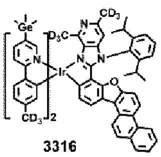
3316
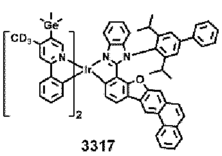
3317
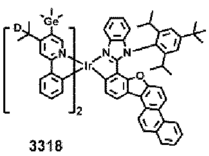
3318
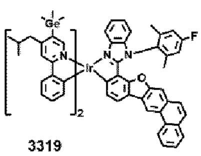
3319
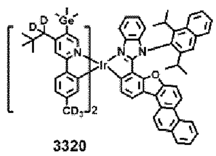
3320
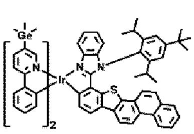
3321
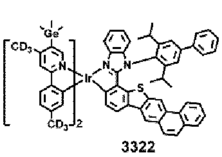
3322
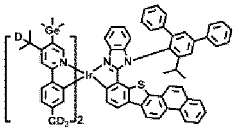
3323
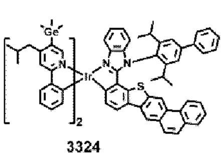
3324
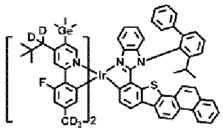
3325
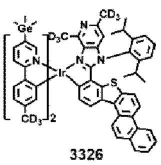
3326
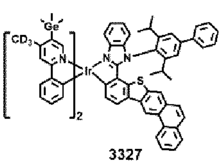
3327
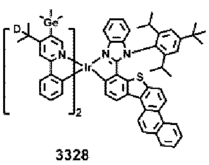
3328
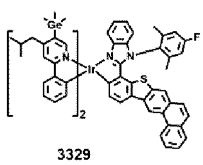
3329
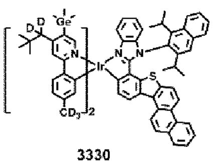
3330

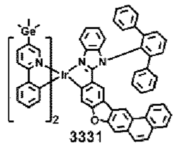
3331
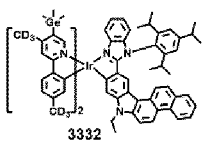
3332
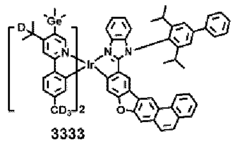
3333
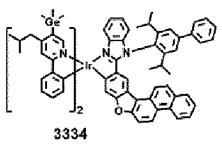
3334
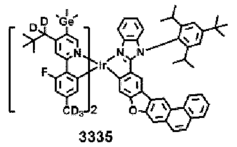
3335

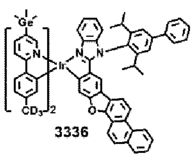
3336
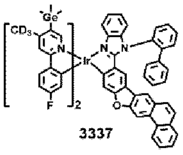
3337
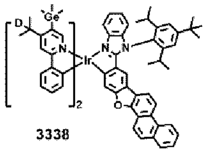
3338
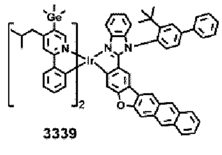
3339
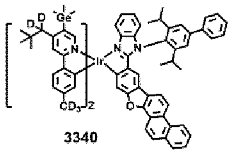
3340

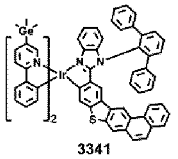
3341
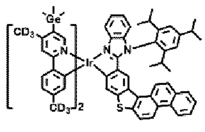
3342
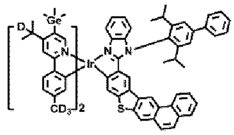
3343
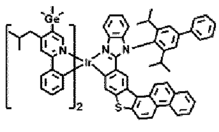
3344
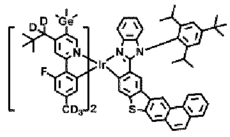
3345

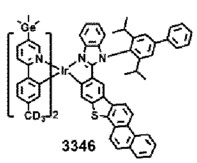
3346
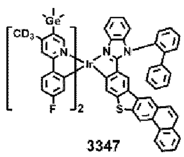
3347
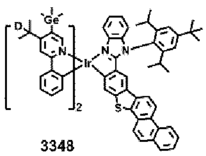
3348
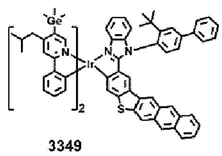
3349
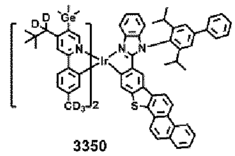
3350

## Group 2-2

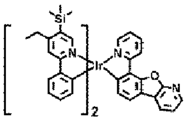
1
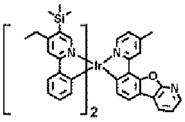
2
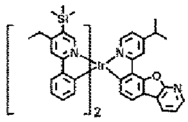
3
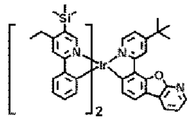
4
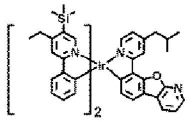
5

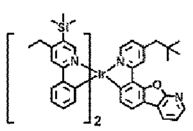
6
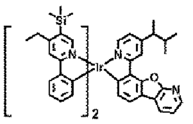
7
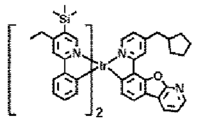
8
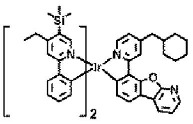
9
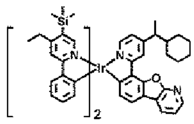
10

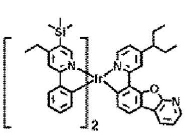
11
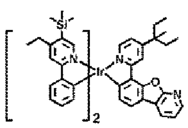
12
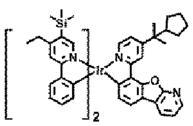
13
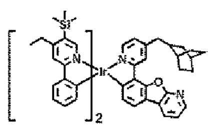
14
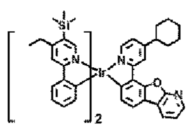
15

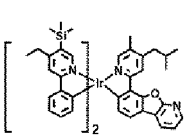
16
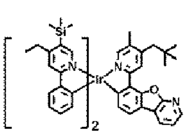
17
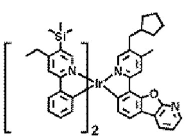
18
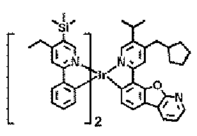
19
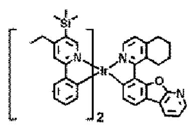
20

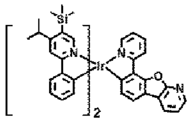
21
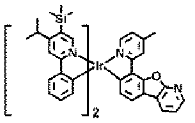
22
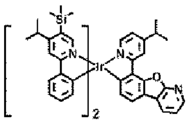
23
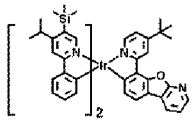
24
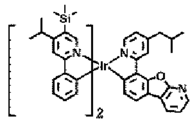
25
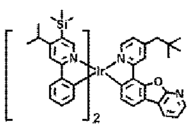
26
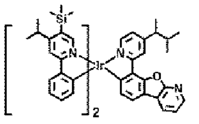
27
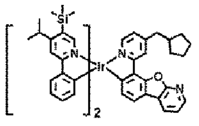
28
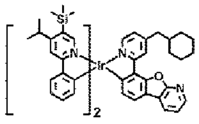
29
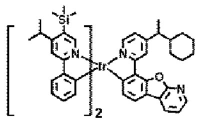
30
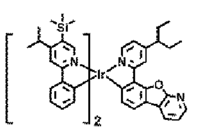
31
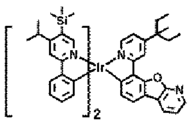
32
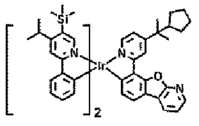
33
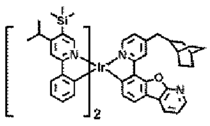
34
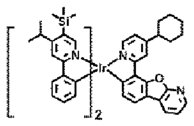
35
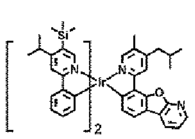
36
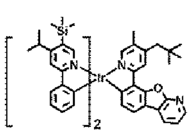
37
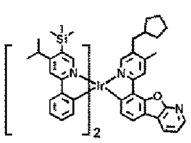
38
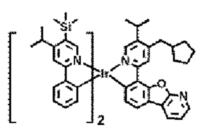
39
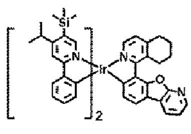
40
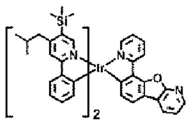
41
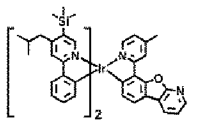
42
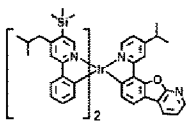
43
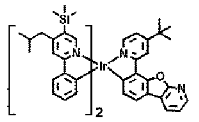
44
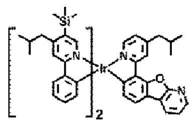
45
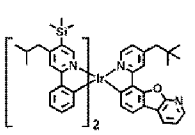
46
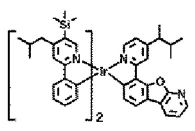
47
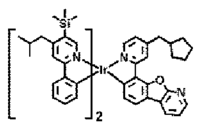
48
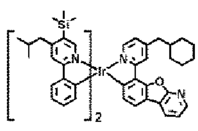
49
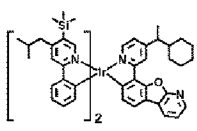
50
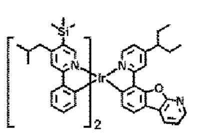
51
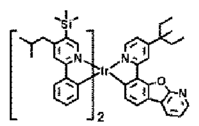
52
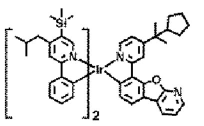
53
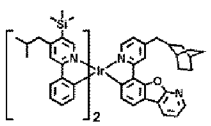
54
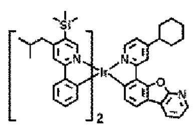
55
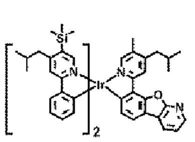
56
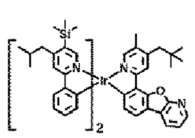
57
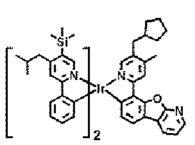
58
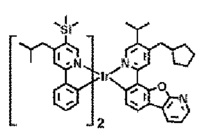
59
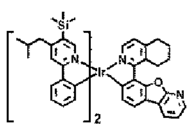
60

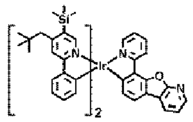
61
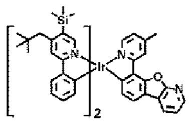
62
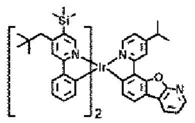
63
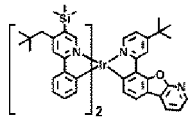
64
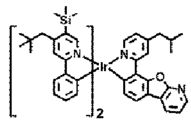
65

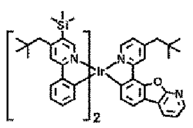
66
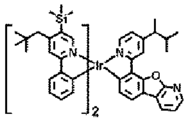
67
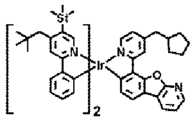
68
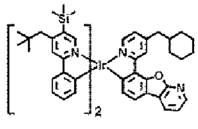
69
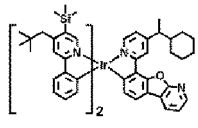
70

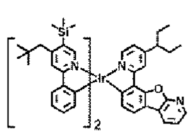
71
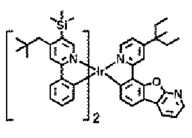
72
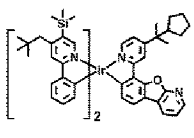
73
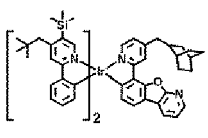
74
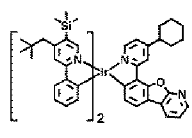
75

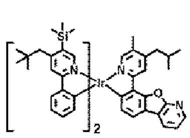
76
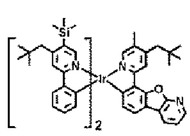
77
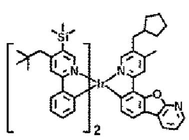
78
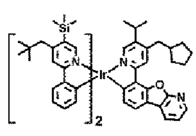
79
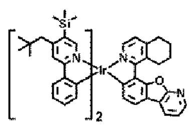
80

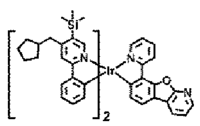
81
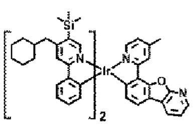
82
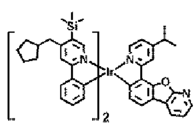
83
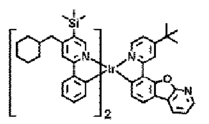
84
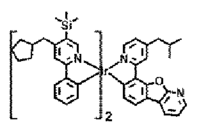
85

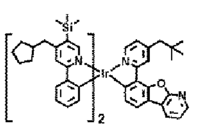
86
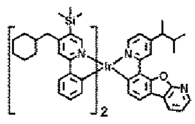
87
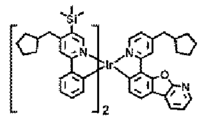
88
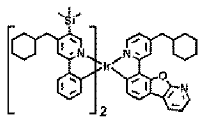
89
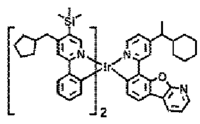
90

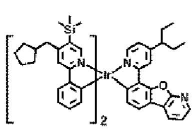
91
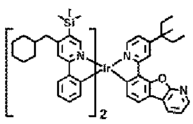
92
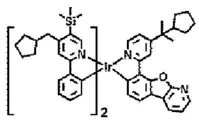
93
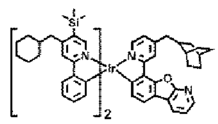
94
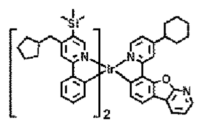
95

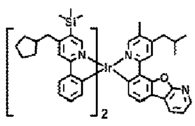
96
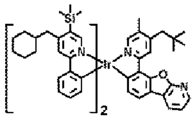
97
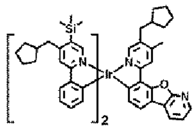
98
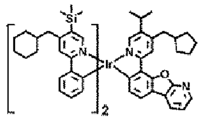
99
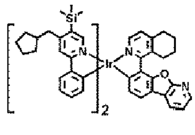
100

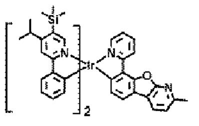
101

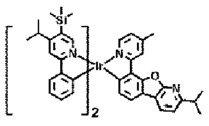
102

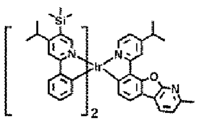
103

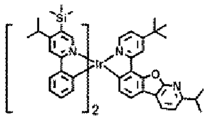
104

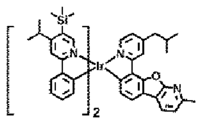
105

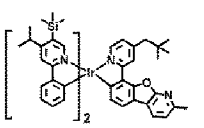
106

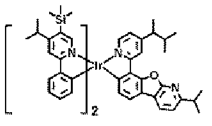
107

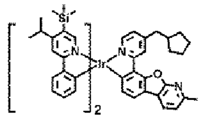
108

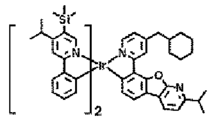
109

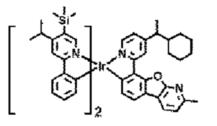
110

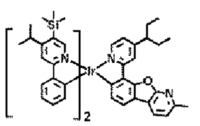
111

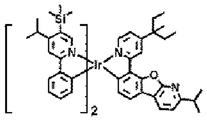
112

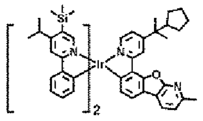
113

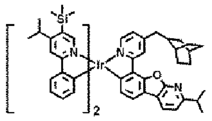
114

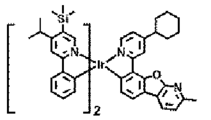
115

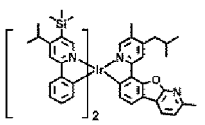
116

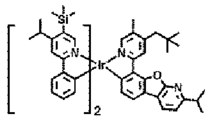
117

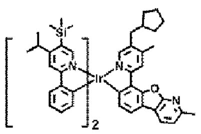
118

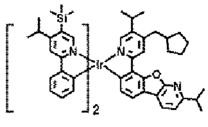
119

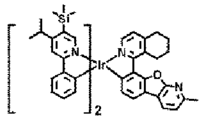
120

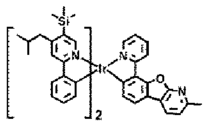
121

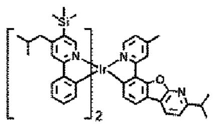
122

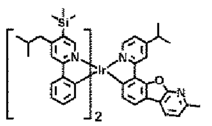
123

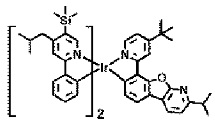
124

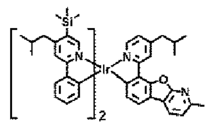
125

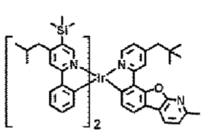
126

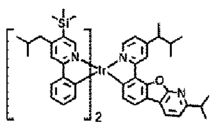
127

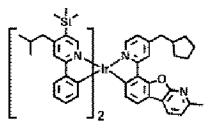
128

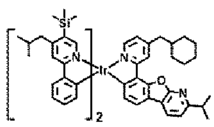
129

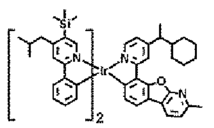
130

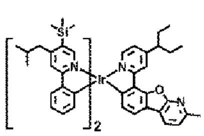
131

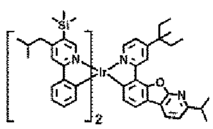
132

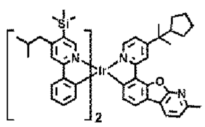
133

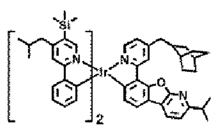
134

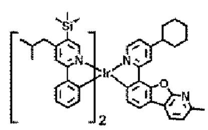
135

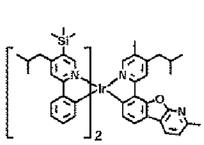
136

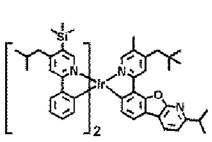
137

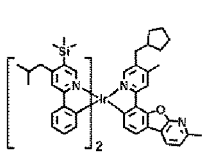
138

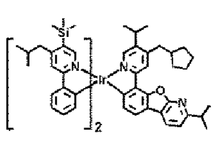
139

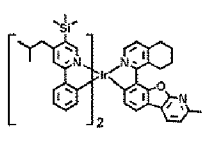
140

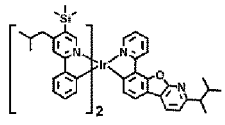
141
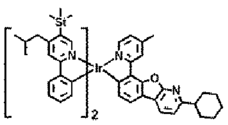
142
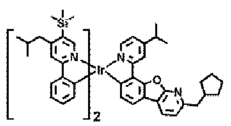
143
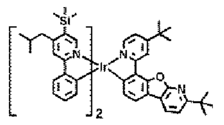
144
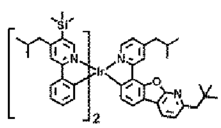
145

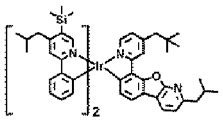
146
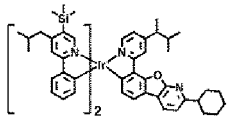
147
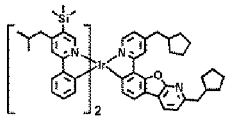
148
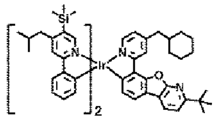
149
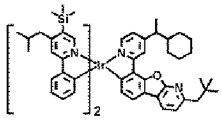
150

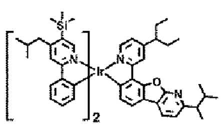
151
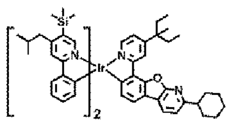
152
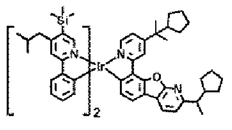
153
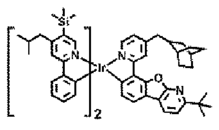
154
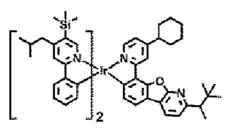
155

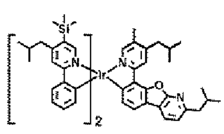
156
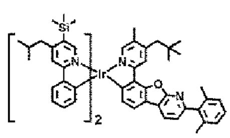
157
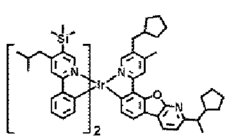
158
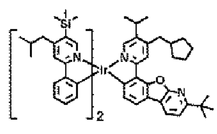
159
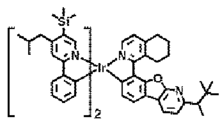
160

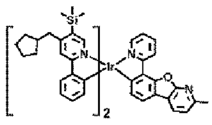
161
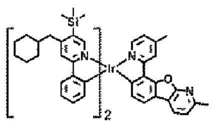
162
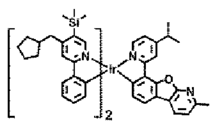
163
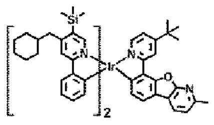
164
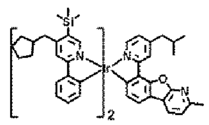
165

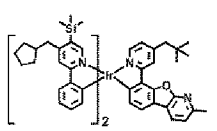
166
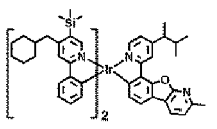
167
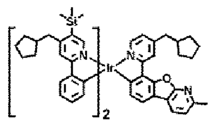
168
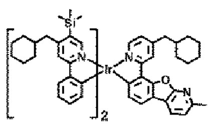
169
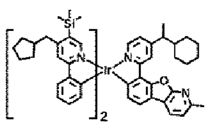
170

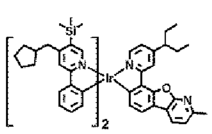
171
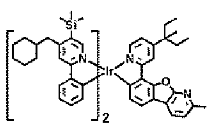
172
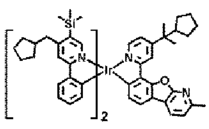
173
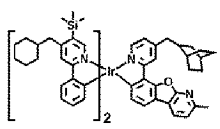
174
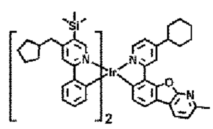
175

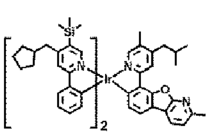
176
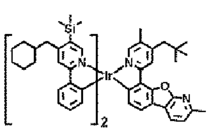
177
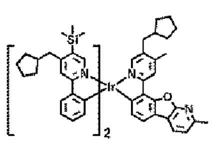
178
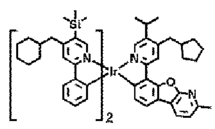
179
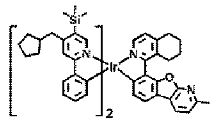
180

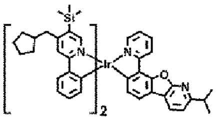
181
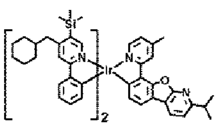
182
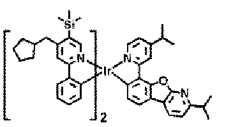
183
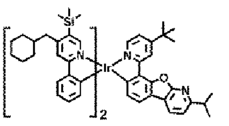
184
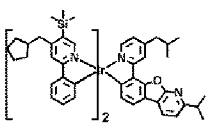
185

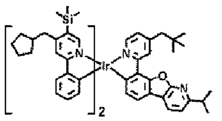
186
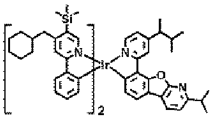
187
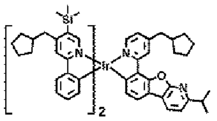
188
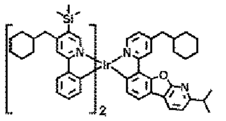
189
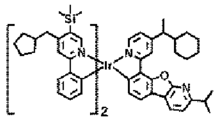
190

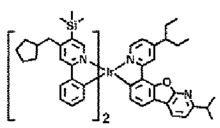
191
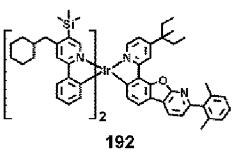
192
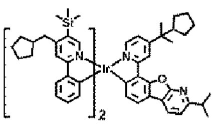
193
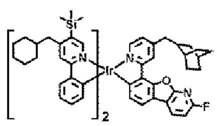
194
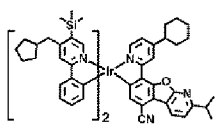
195

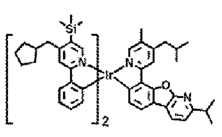
196
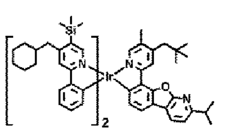
197
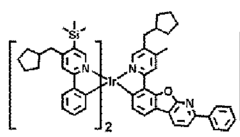
198
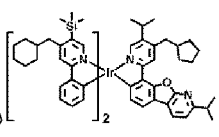
199
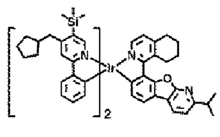
200

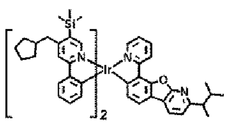
201
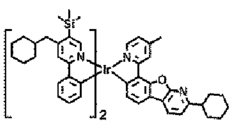
202
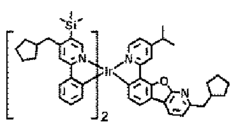
203
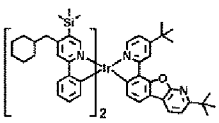
204
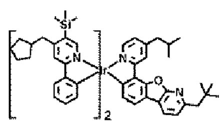
205

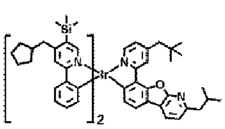
206
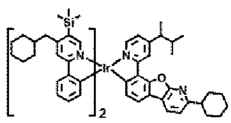
207
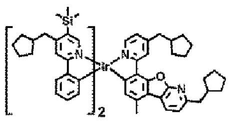
208
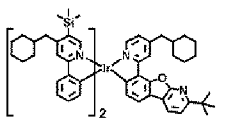
209
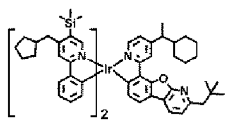
210

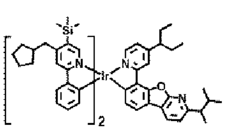
211
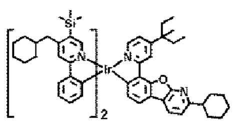
212
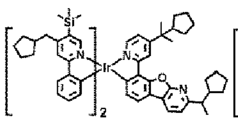
213
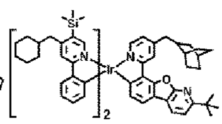
214
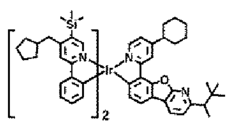
215

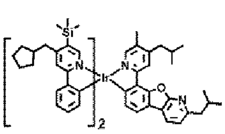
216
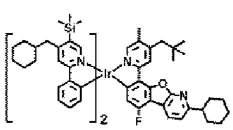
217
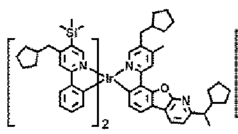
218
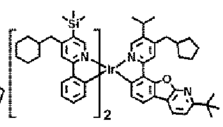
219
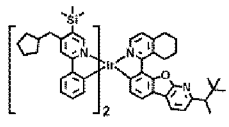
220

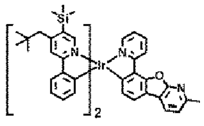
221
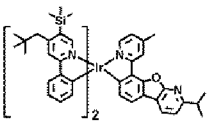
222
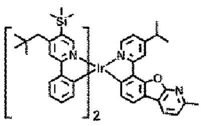
223
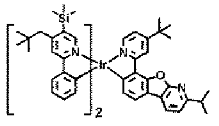
224
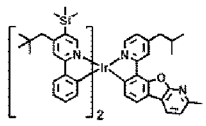
225

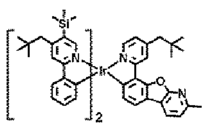
226
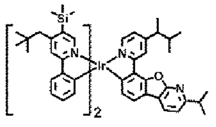
227
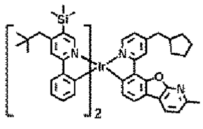
228
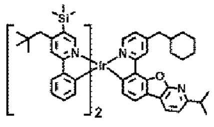
229
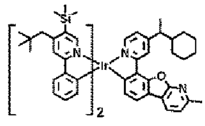
230

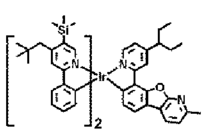
231
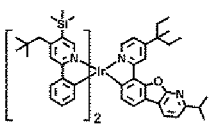
232
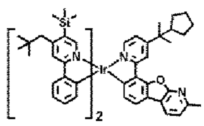
233
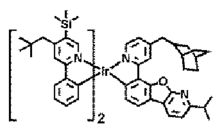
234
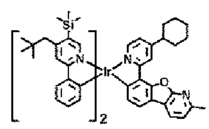
235

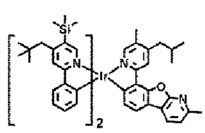
236
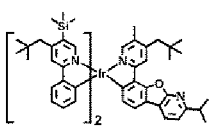
237
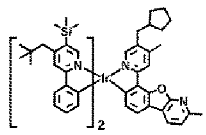
238
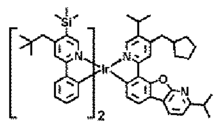
239
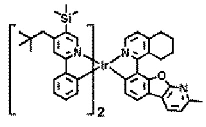
240

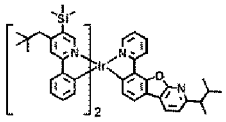
241
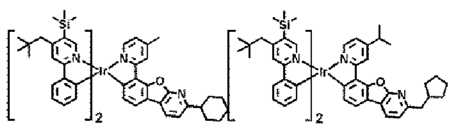
242
243
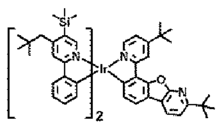
244
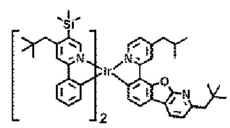
245

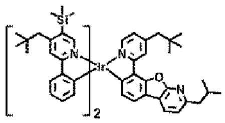
246
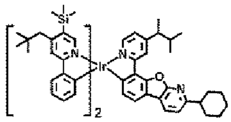
247
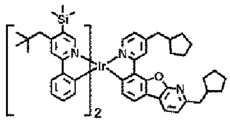
248
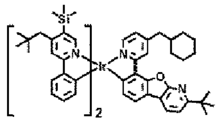
249
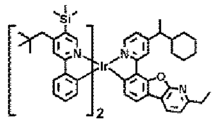
250

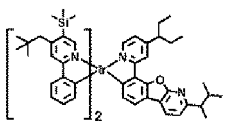
251
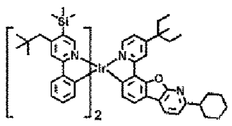
252
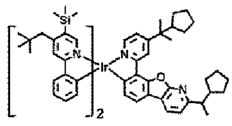
253
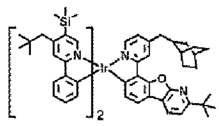
254
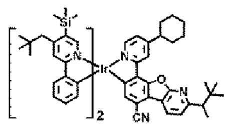
255

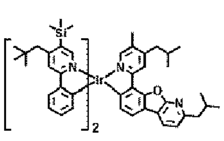
256
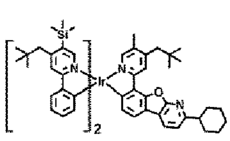
257
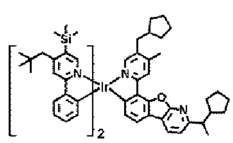
258
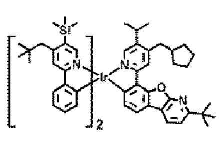
259
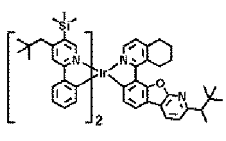
260

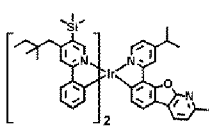
261
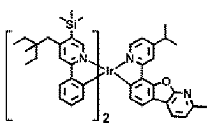
262
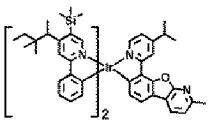
263
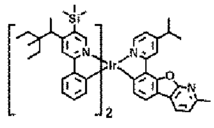
264
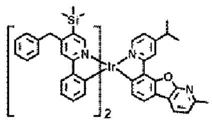
265

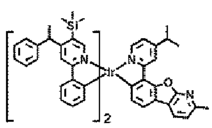
266
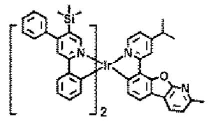
267
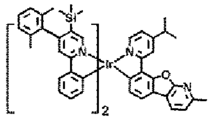
268
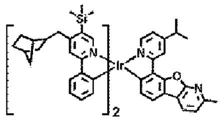
269
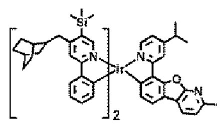
270

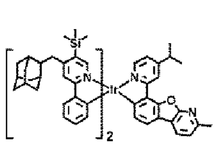
271
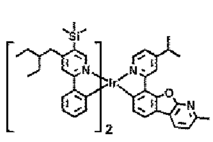
272
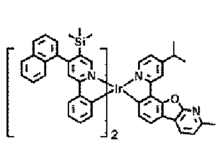
273
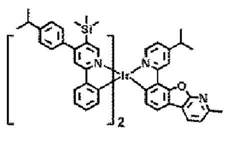
274
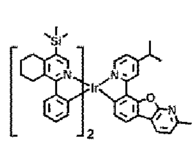
275

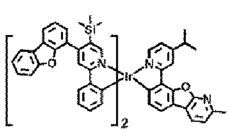
276
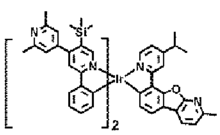
277
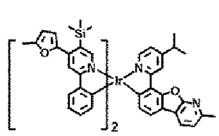
278
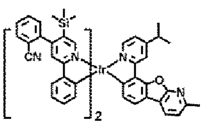
279
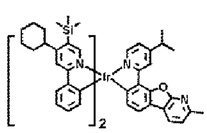
280

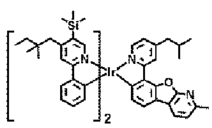
281
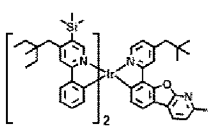
282
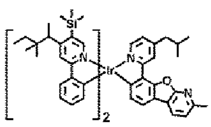
283
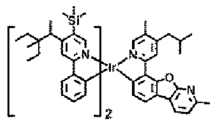
284
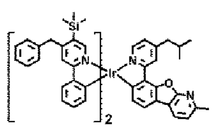
285

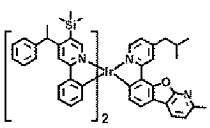
286
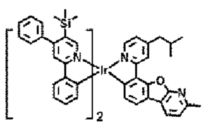
287
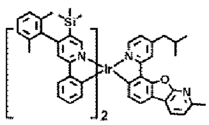
288
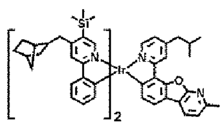
289
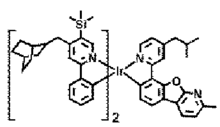
290

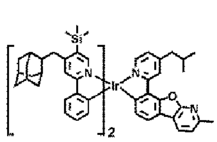
291
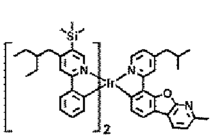
292
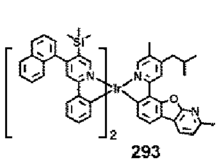
293
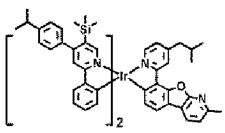
294
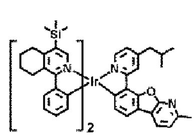
295

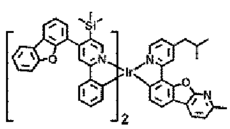
296
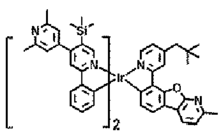
297
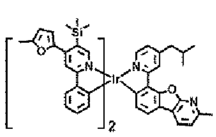
298
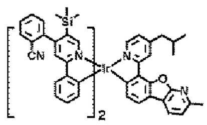
299
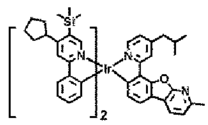
300

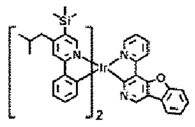
301
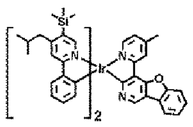
302
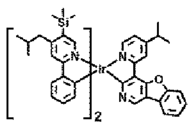
303
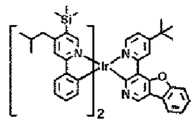
304
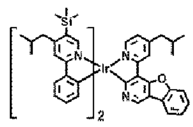
305

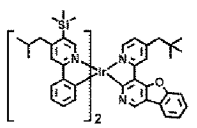
306
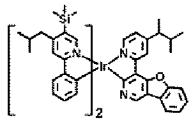
307
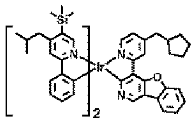
308
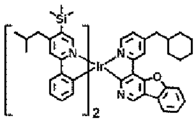
309
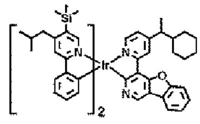
310

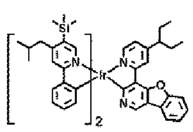
311
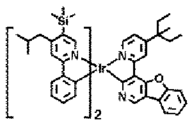
312
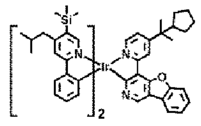
313
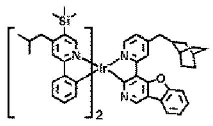
314
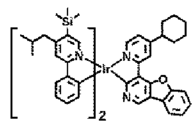
315

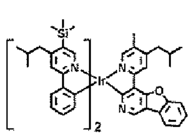
316
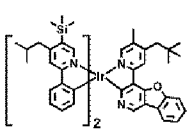
317
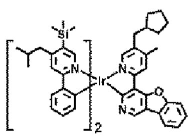
318
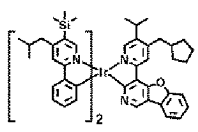
319
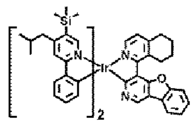
320

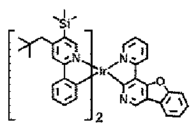
321
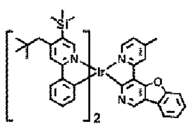
322
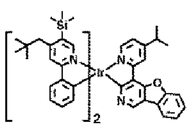
323
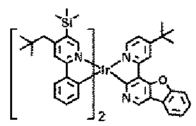
324
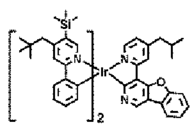
325

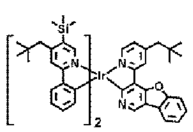
326
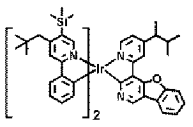
327
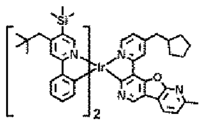
328
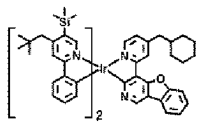
329
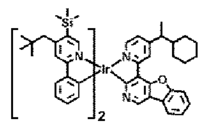
330

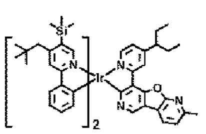
331
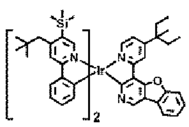
332
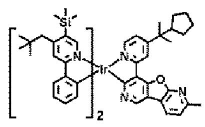
333
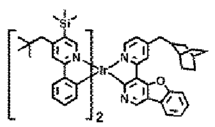
334
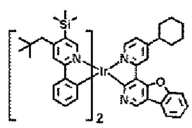
335

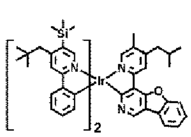
336
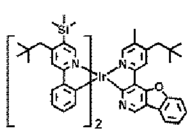
337
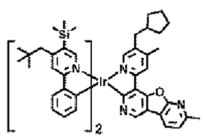
338
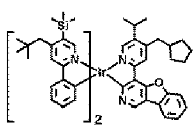
339
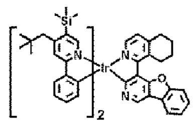
340

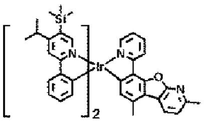
341
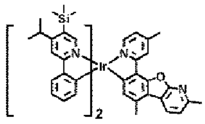
342
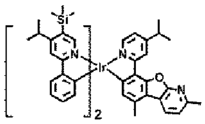
343
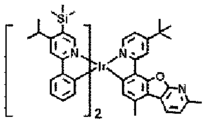
344
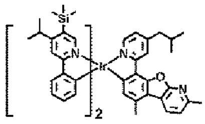
345

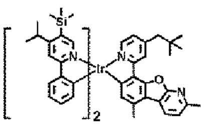
346
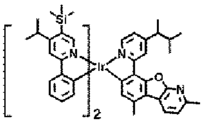
347
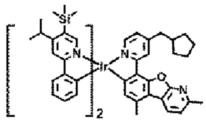
348
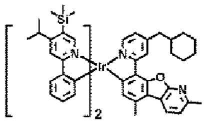
349
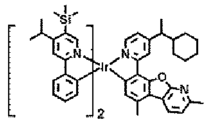
350

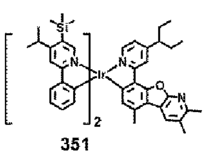
351
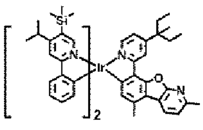
352
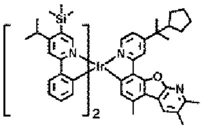
353
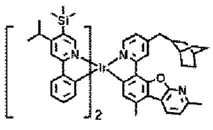
354
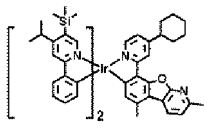
355

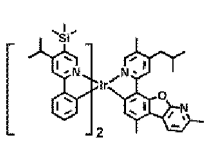
356
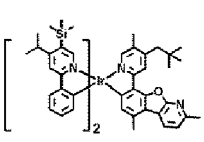
357
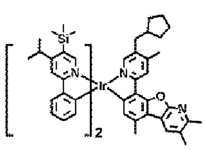
358
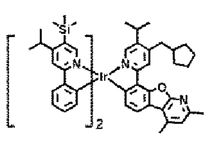
359
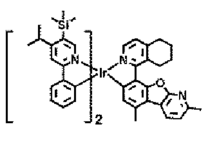
360

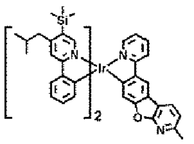
361
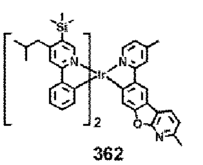
362
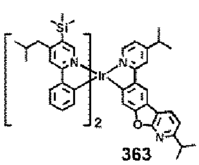
363
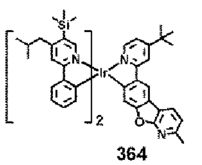
364
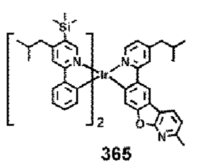
365

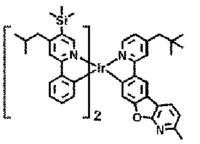
366
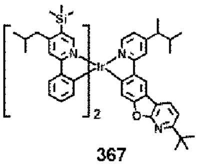
367
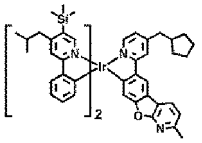
368
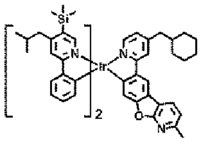
369
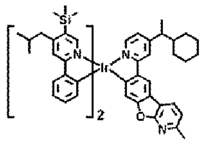
370

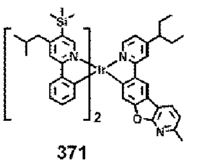
371
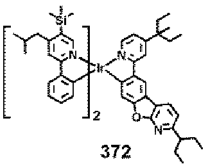
372
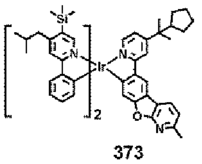
373
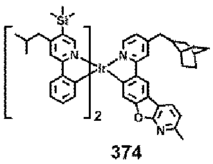
374
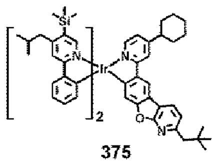
375

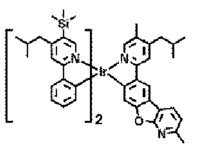
376
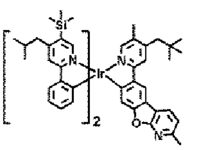
377
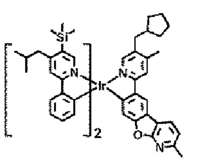
378
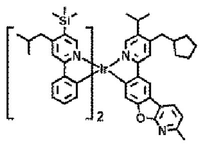
379
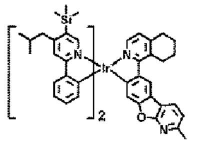
380

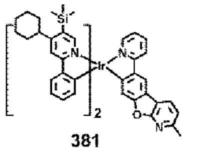
381
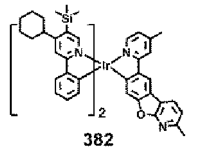
382
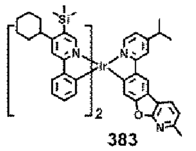
383
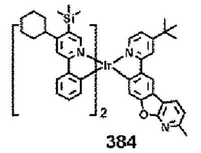
384
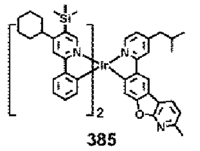
385

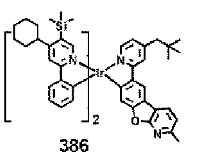
386
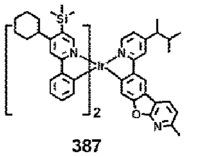
387
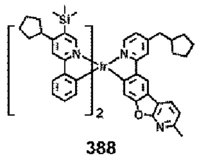
388
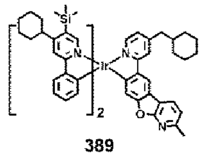
389
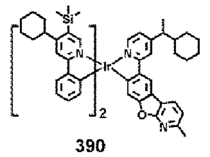
390

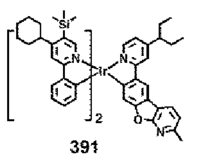
391
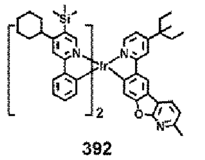
392
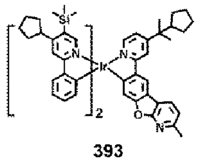
393
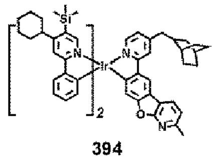
394
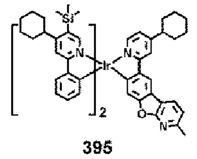
395

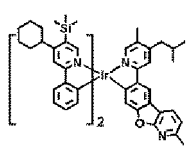
396
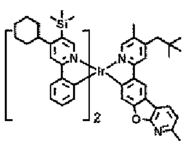
397
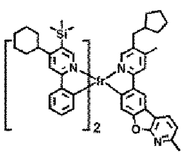
398
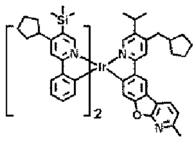
399
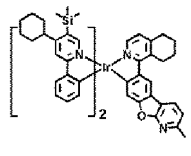
400

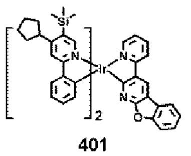
401
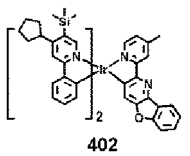
402
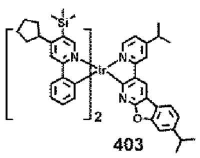
403
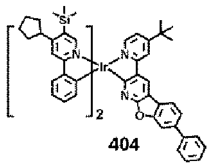
404
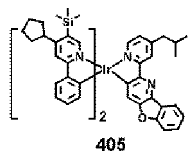
405

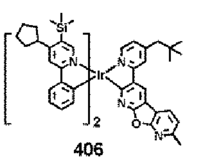
406
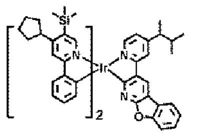
407
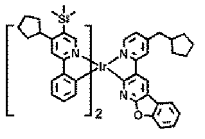
408
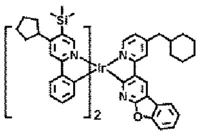
409
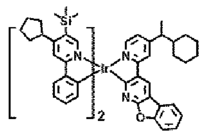
410

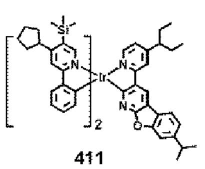
411
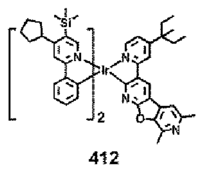
412
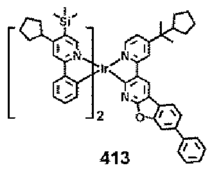
413
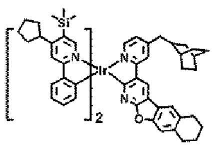
414
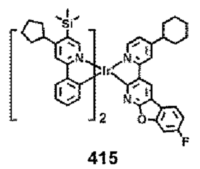
415

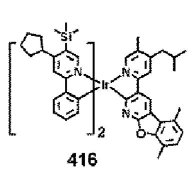
416
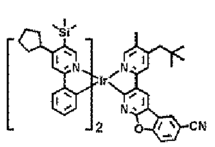
417
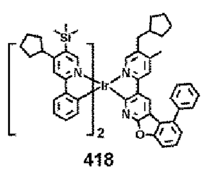
418
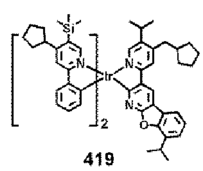
419
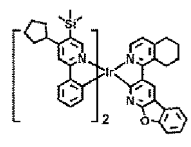
420

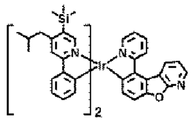
421

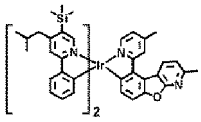
422

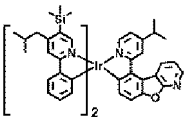
423

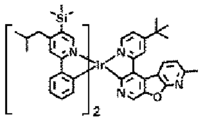
424

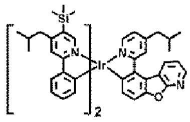
425

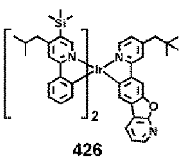
426

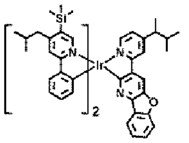
427

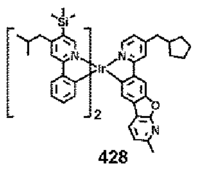
428

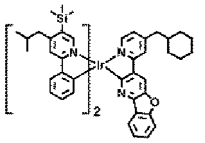
429

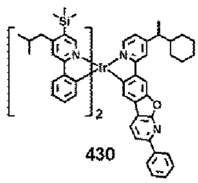
430

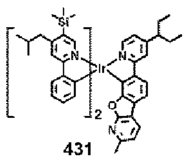
431

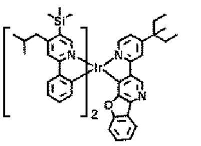
432

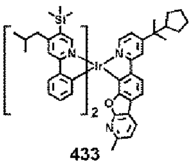
433

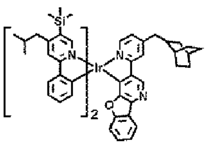
434

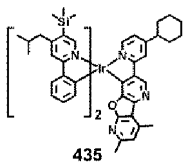
435

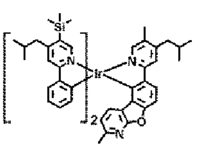
436

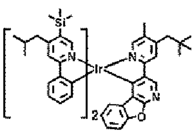
437

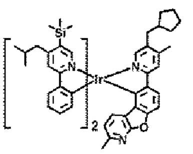
438

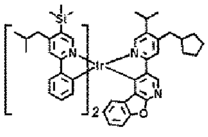
439

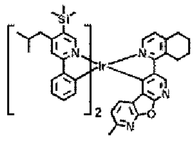
440

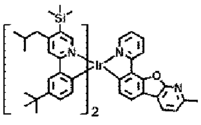
441

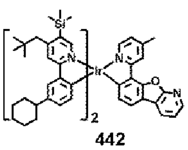
442

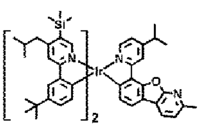
443

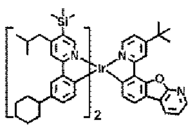
444

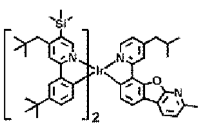
445

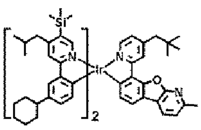
446

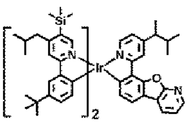
447

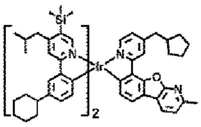
448

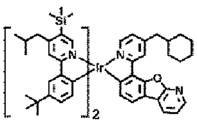
449

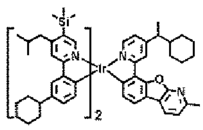
450

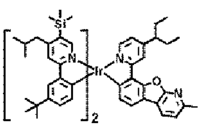
451

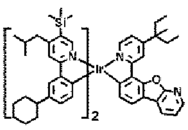
452

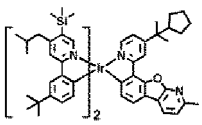
453

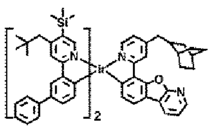
454

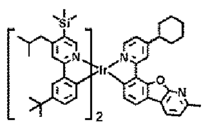
455

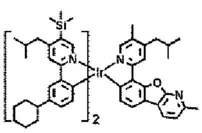
456

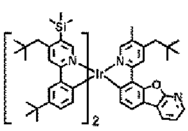
457

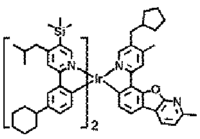
458

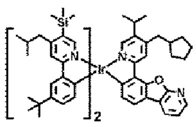
459

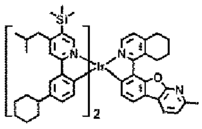
460

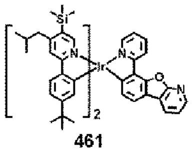 461
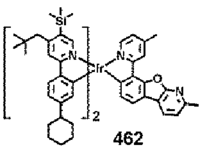 462
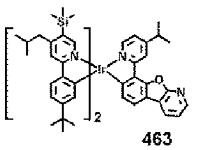 463
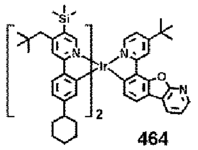 464
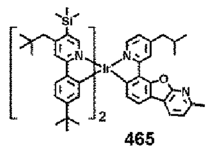 465

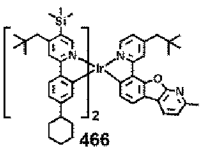 466
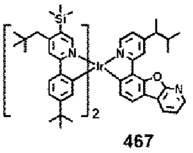 467
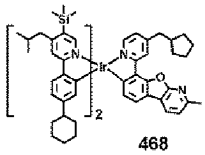 468
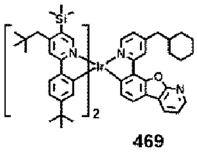 469
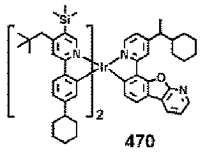 470

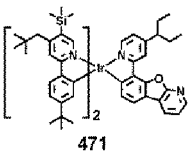 471
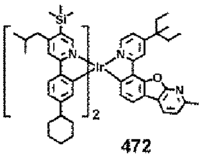 472
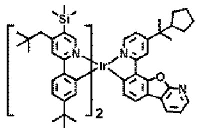 473
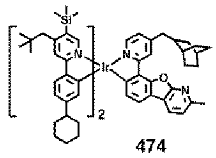 474
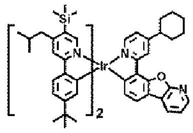 475

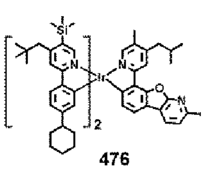 476
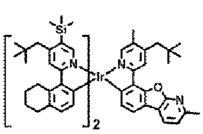 477
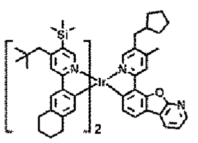 478
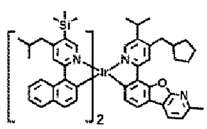 479
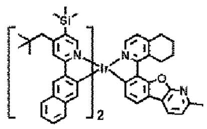 480

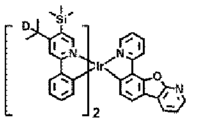 481
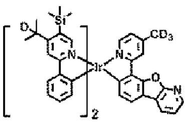 482
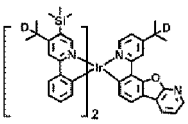 483
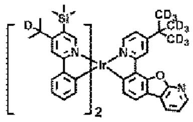 484
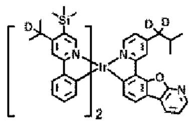 485

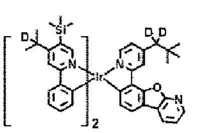 486
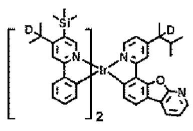 487
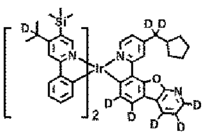 488
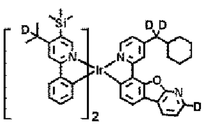 489
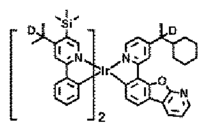 490

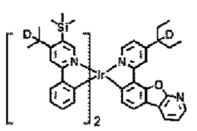 491
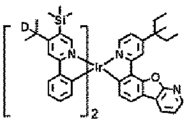 492
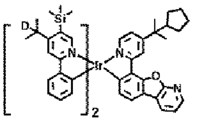 493
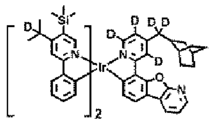 494
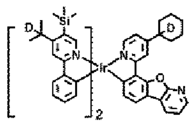 495

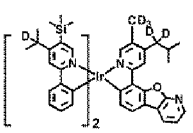 496
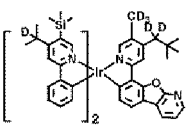 497
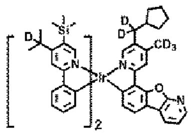 498
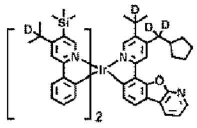 499
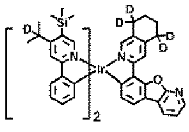 500

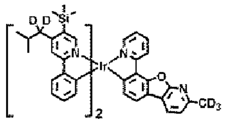 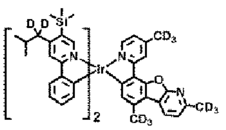 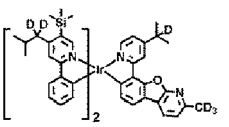 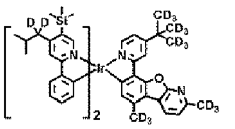 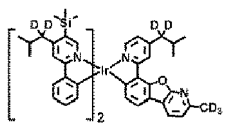

501 502 503 504 505

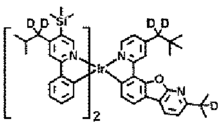 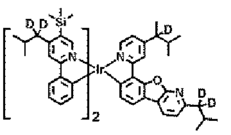 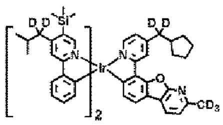 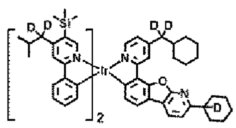 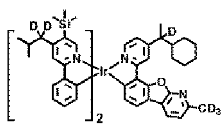

506 507 508 509 510

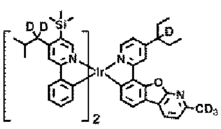 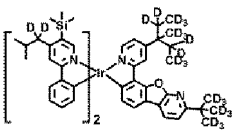 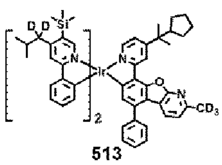 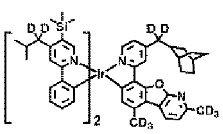 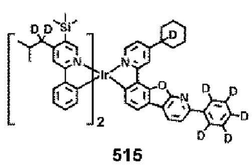

511 512 513 514 515

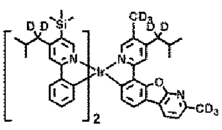 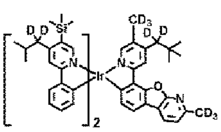 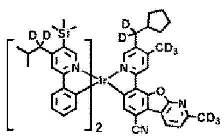 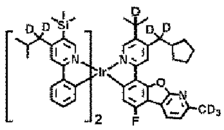 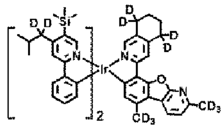

516 517 518 519 520

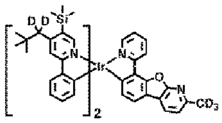 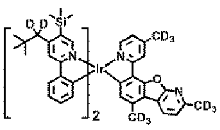 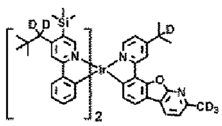 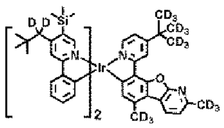 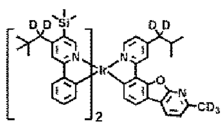

521 522 523 524 525

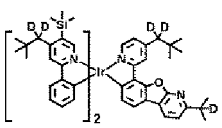 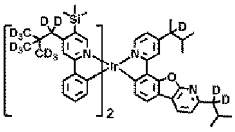 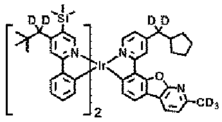 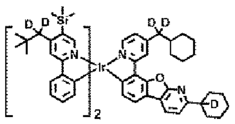 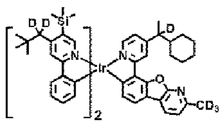

526 527 528 529 530

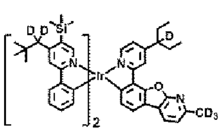 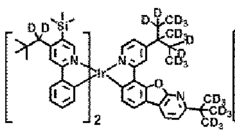 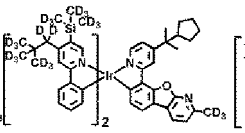 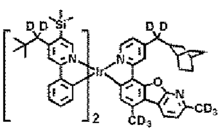 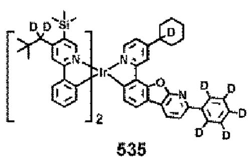

531 532 533 534 535

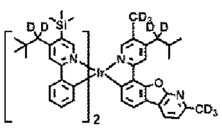 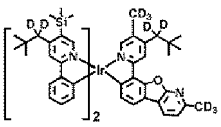 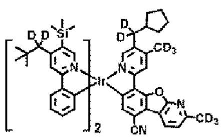 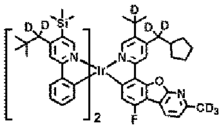 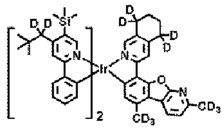

536 537 538 539 540

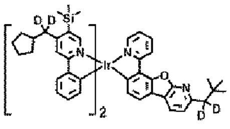
541

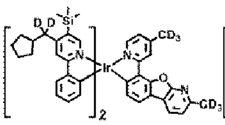
542

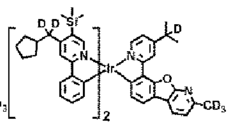
543

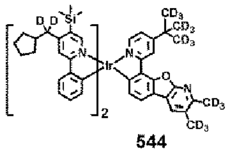
544

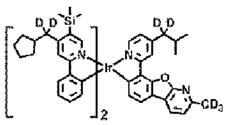
545

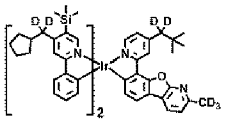
546

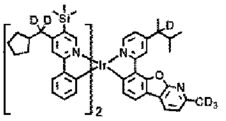
547

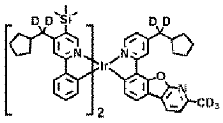
548

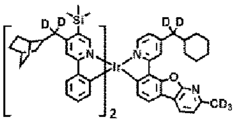
549

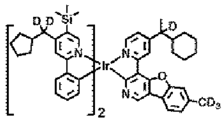
550

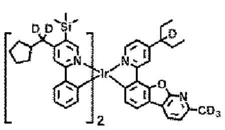
551

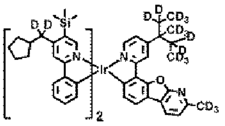
552

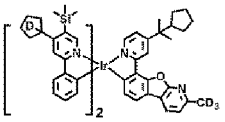
553

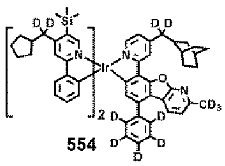
554

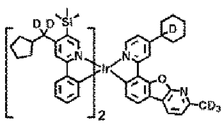
555

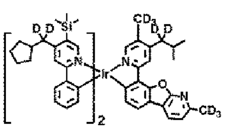
556

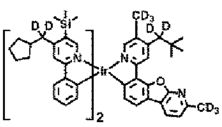
557

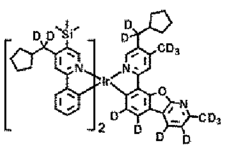
558

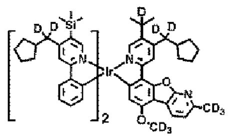
559

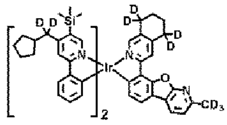
560

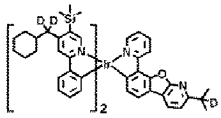
561

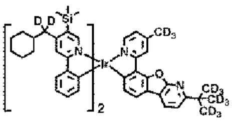
562

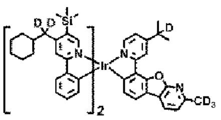
563

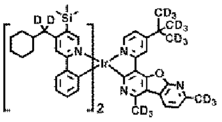
564

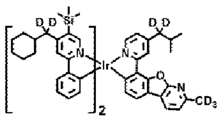
565

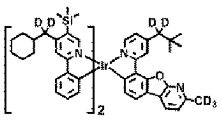
566

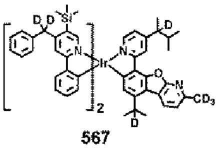
567

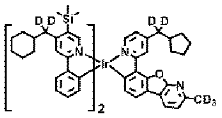
568

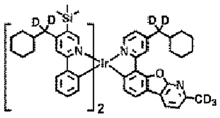
569

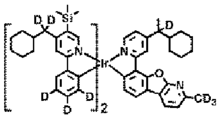
570

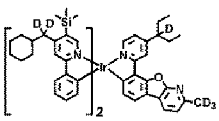
571

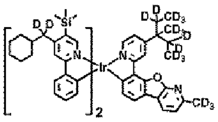
572

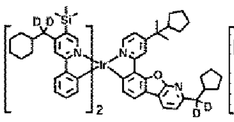
573

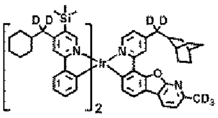
574

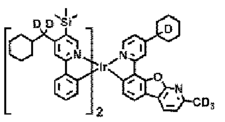
575

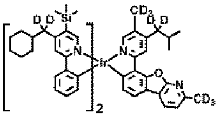
576

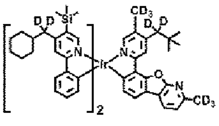
577

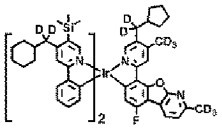
578

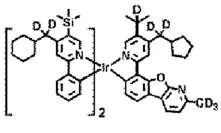
579

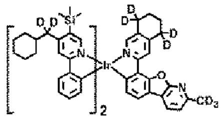
580

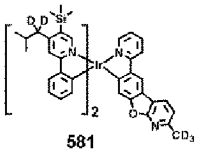
581

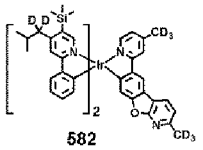
582

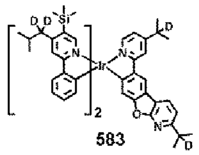
583

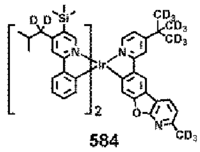
584

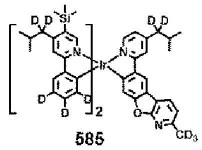
585

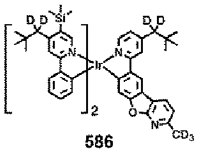
586

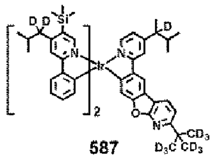
587

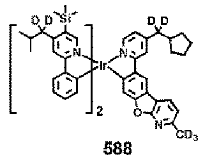
588

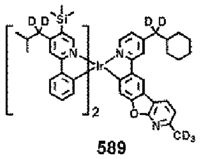
589

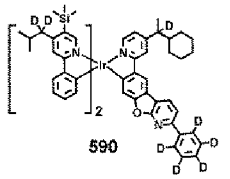
590

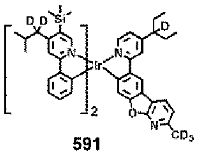
591

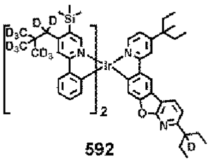
592

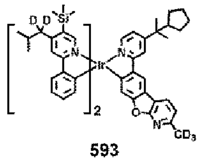
593

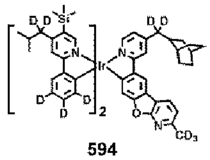
594

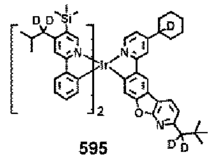
595

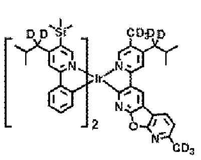
596

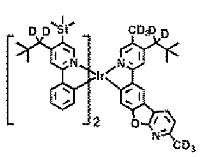
597

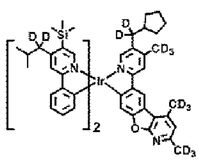
598

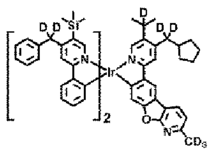
599

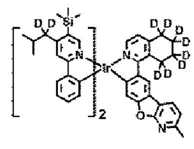
600

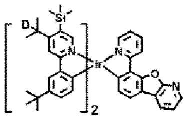
601

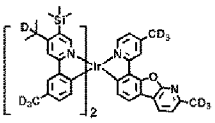
602

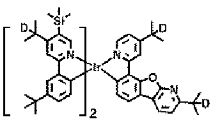
603

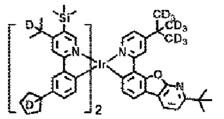
604

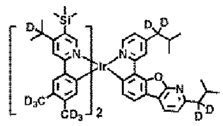
605

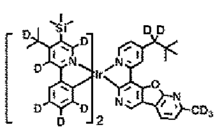
606

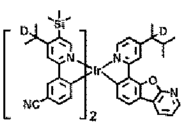
607

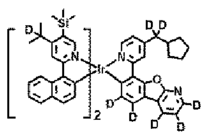
608

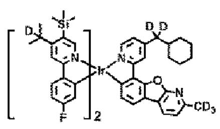
609

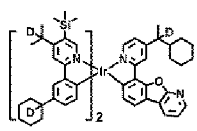
610

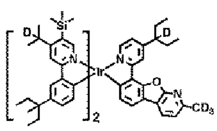
611

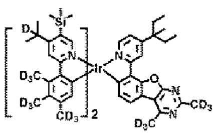
612

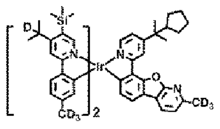
613

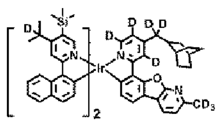
614

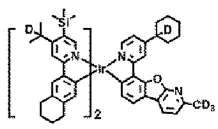
615

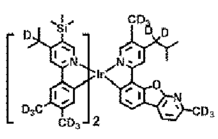
616

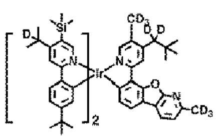
617

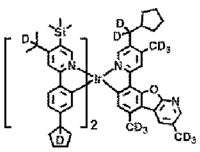
618

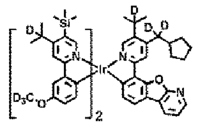
619

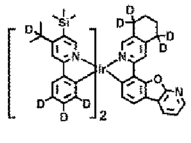
620

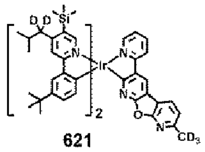
621
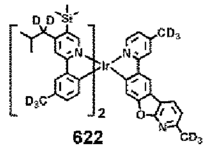
622
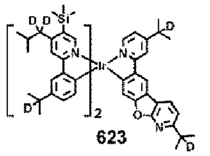
623
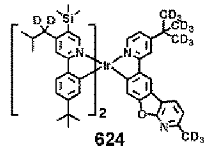
624
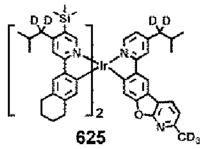
625

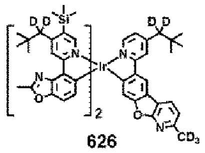
626
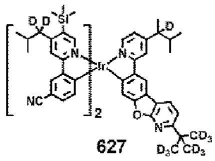
627
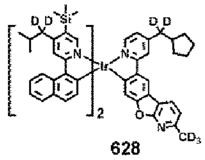
628
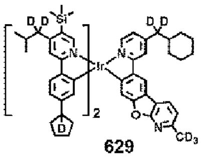
629
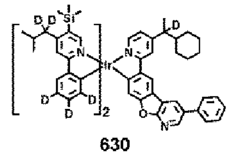
630

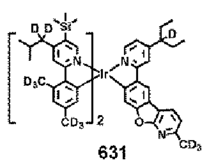
631
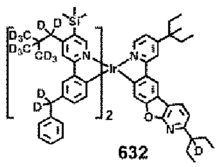
632
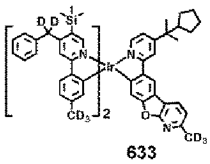
633
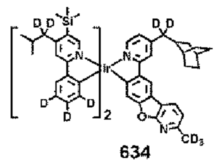
634
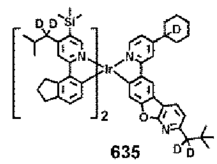
635

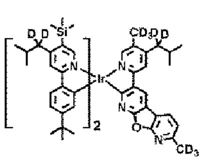
636
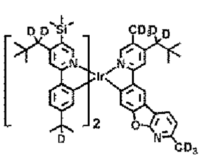
637
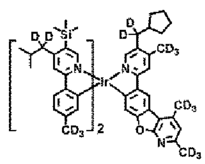
638
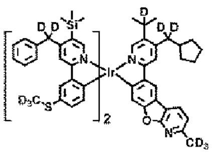
639
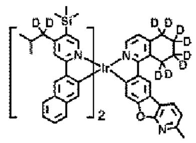
640

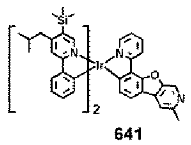
641
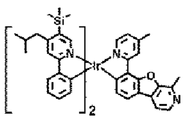
642
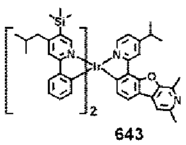
643
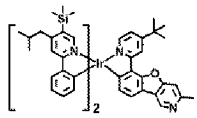
644
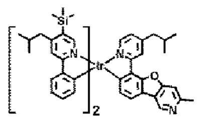
645

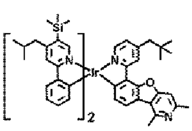
646
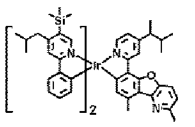
647
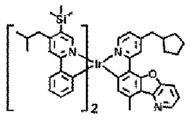
648
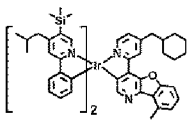
649
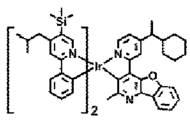
650

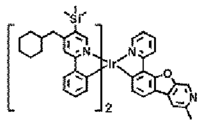
651
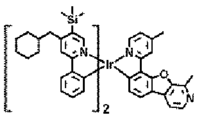
652
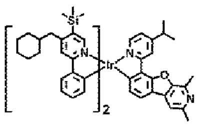
653
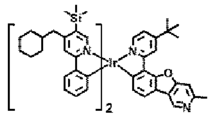
654
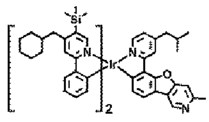
655

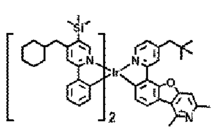
656
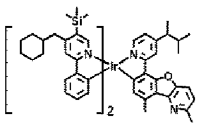
657
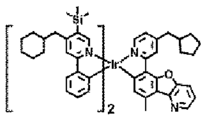
658
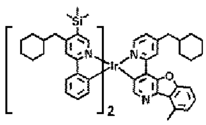
659
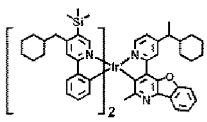
660

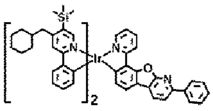
661
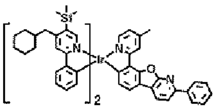
662
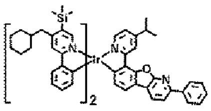
663
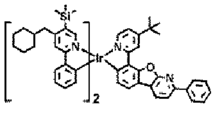
664
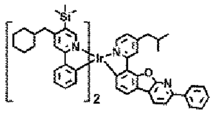
665

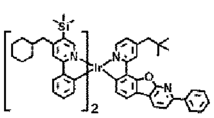
666
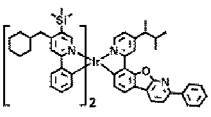
667
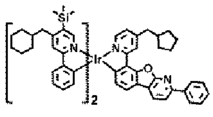
668
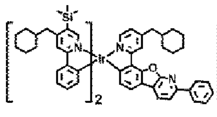
669
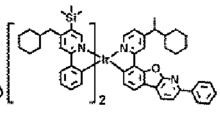
670

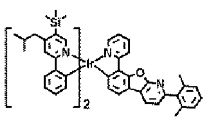
671
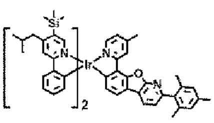
672
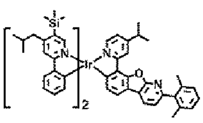
673
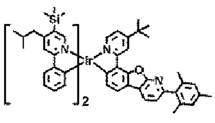
674
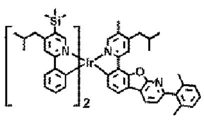
675

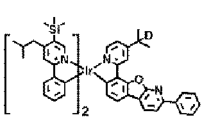
676
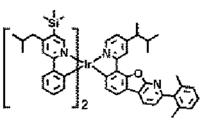
677
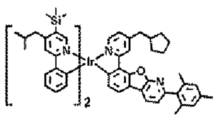
678
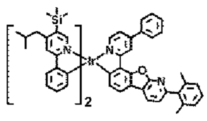
679
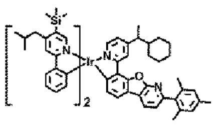
680

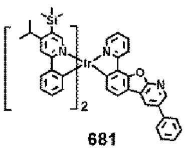
681
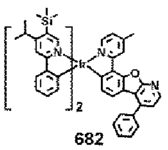
682
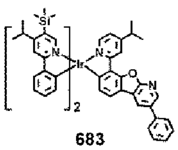
683
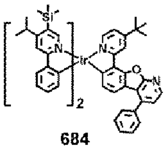
684
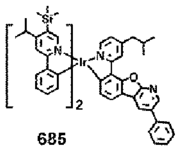
685

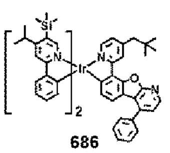
686
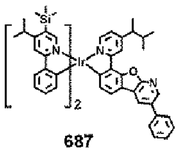
687
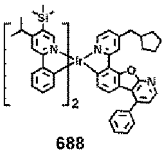
688
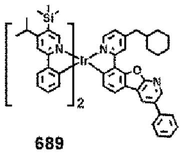
689
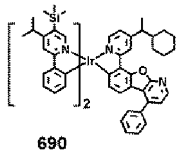
690

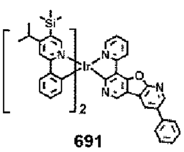
691
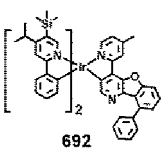
692
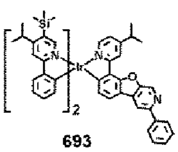
693
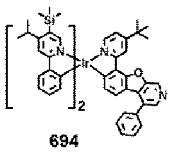
694
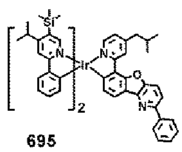
695

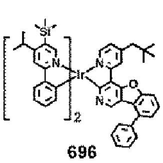
696
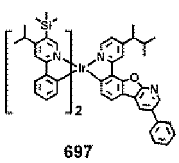
697
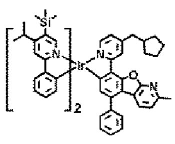
698
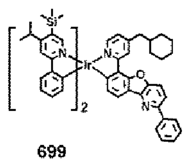
699
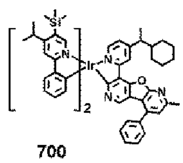
700

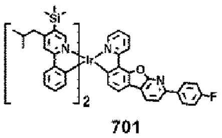
701

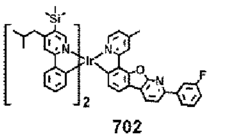
702

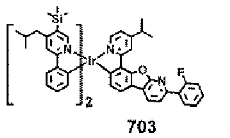
703

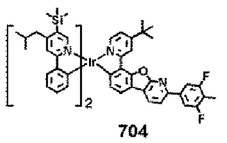
704

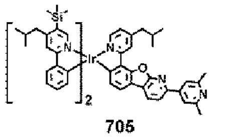
705

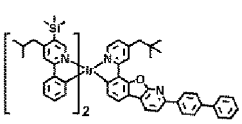
706

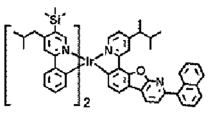
707

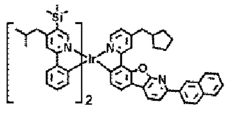
708

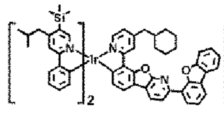
709

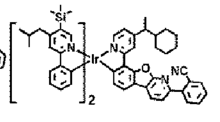
710

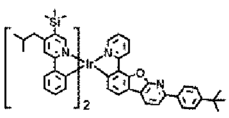
711

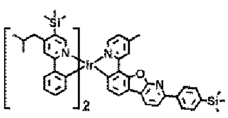
712

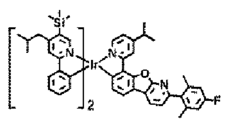
713

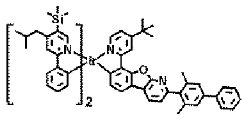
714

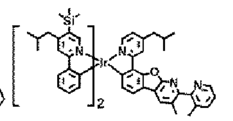
715

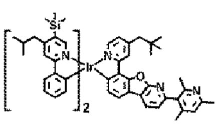
716

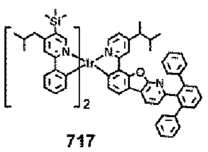
717

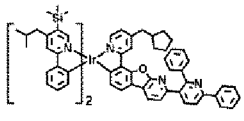
718

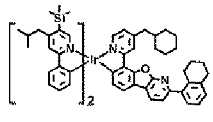
719

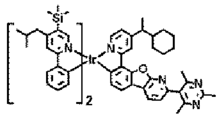
720

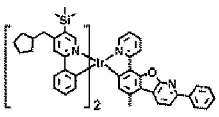
721

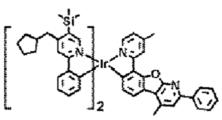
722

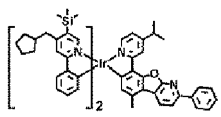
723

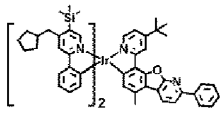
724

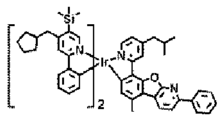
725

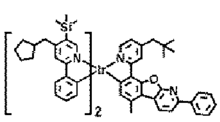
726

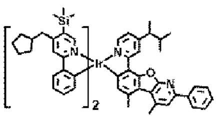
727

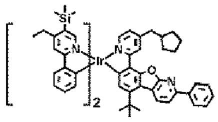
728

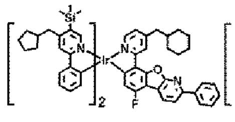
729

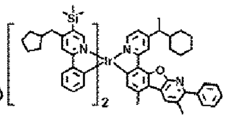
730

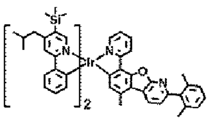
731

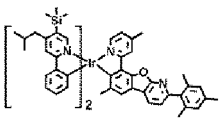
732

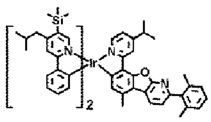
733

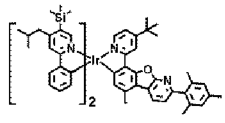
734

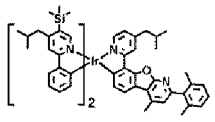
735

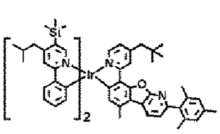
736

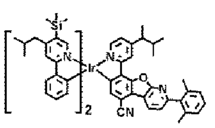
737

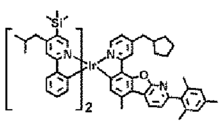
738

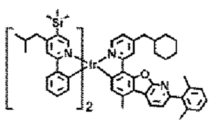
739

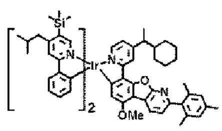
740

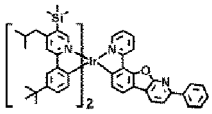
741
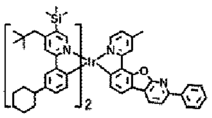
742
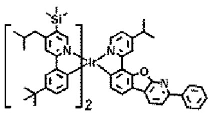
743
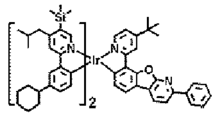
744
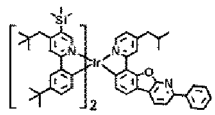
745

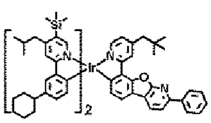
746
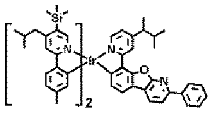
747
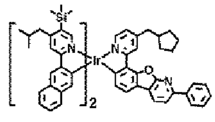
748
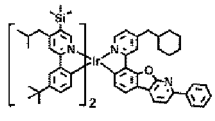
749
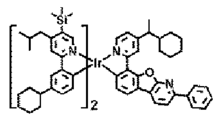
750

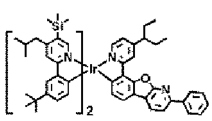
751
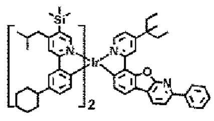
752
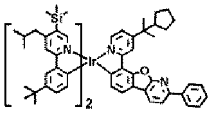
753
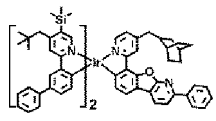
754
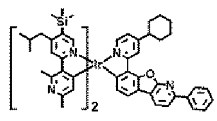
755

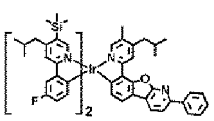
756
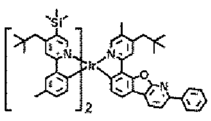
757
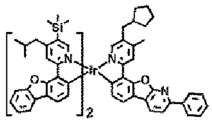
758
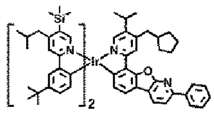
759
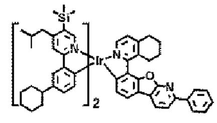
760

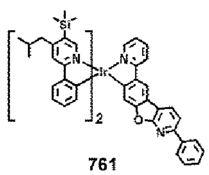
761
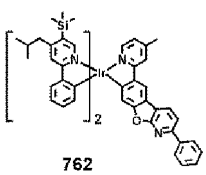
762
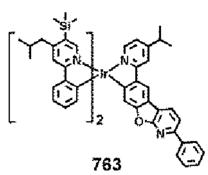
763
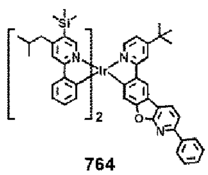
764
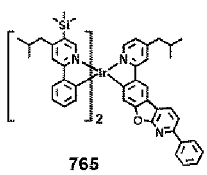
765

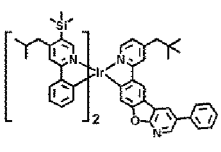
766
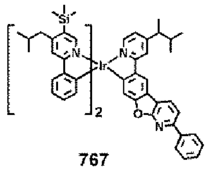
767
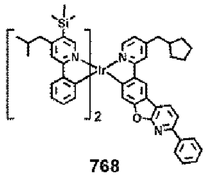
768
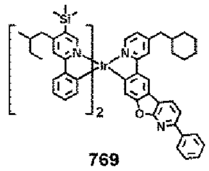
769
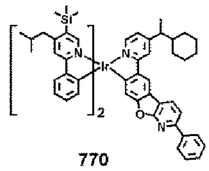
770

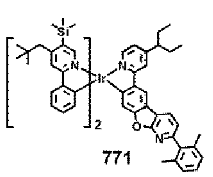
771
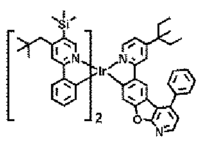
772
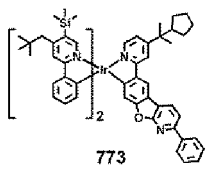
773
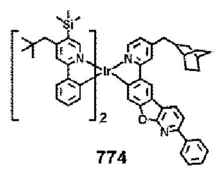
774
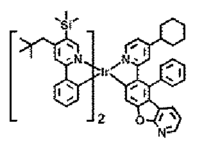
775

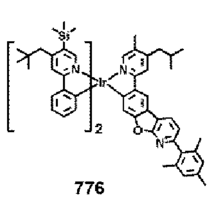
776
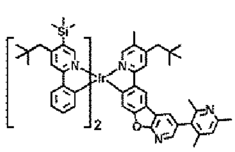
777
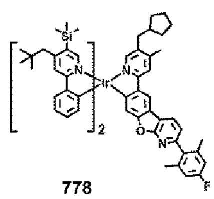
778
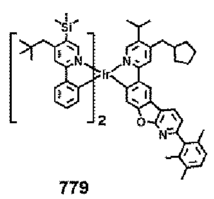
779
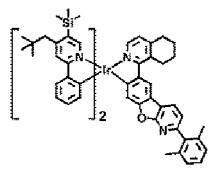
780

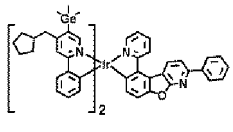
781
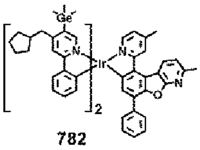
782
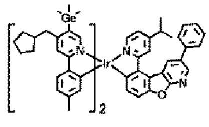
783
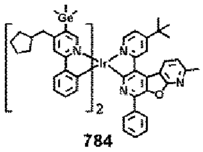
784
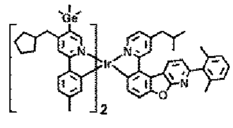
785

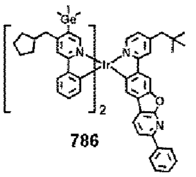
786
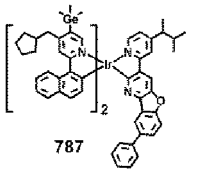
787
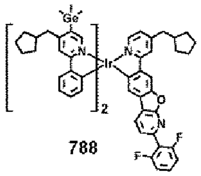
788
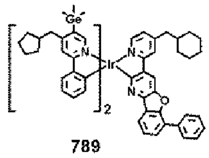
789
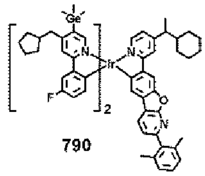
790

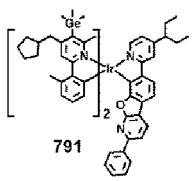
791
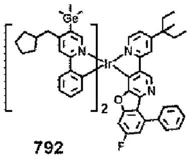
792
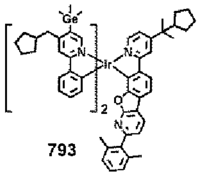
793
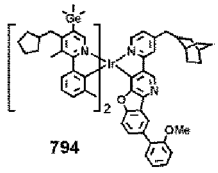
794
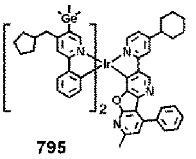
795

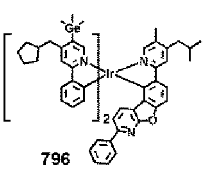
796
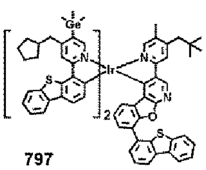
797
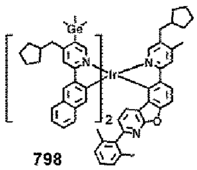
798
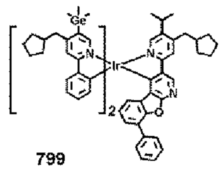
799
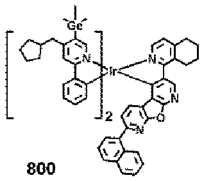
800

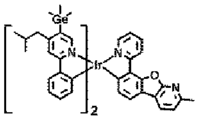
801
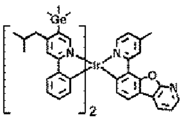
802
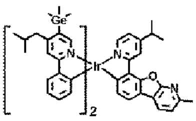
803
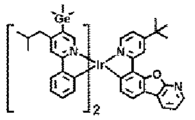
804
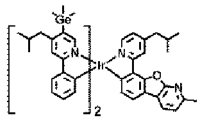
805

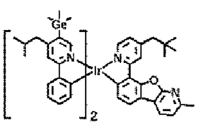
806
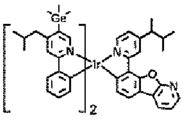
807
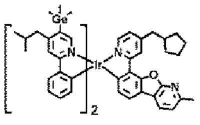
808
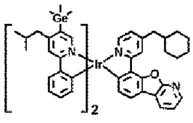
809
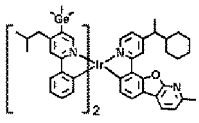
810

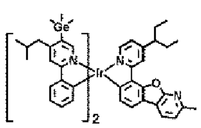
811
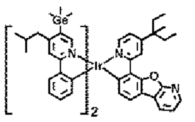
812
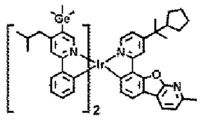
813
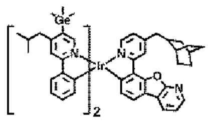
814
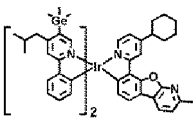
815

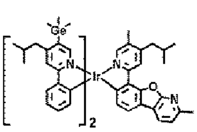
816
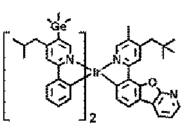
817
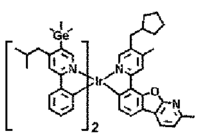
818
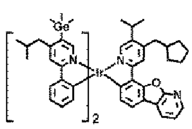
819
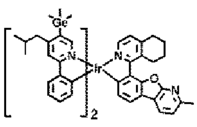
820

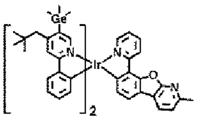
821
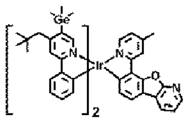
822
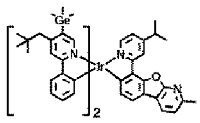
823
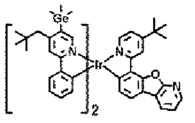
824
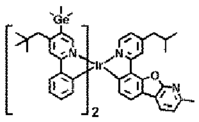
825

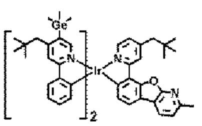
826
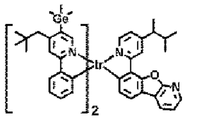
827
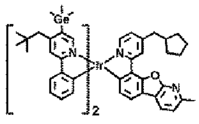
828
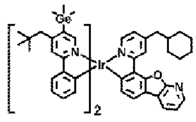
829
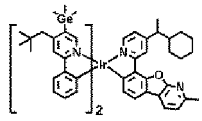
830

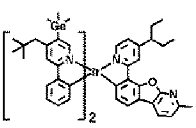
831
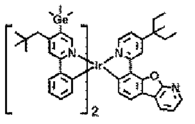
832
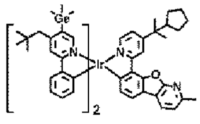
833
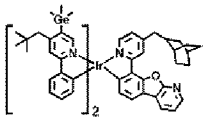
834
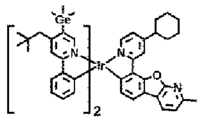
835

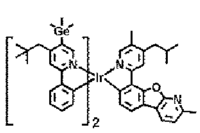
836
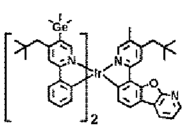
837
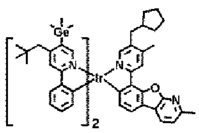
838
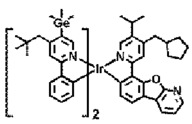
839
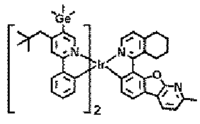
840

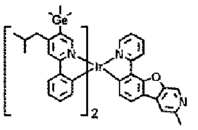
841
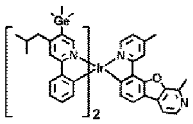
842
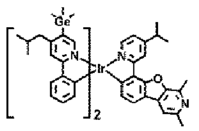
843
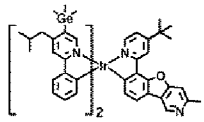
844
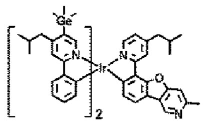
845

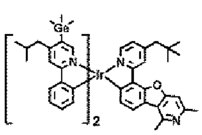
846
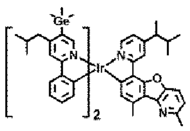
847
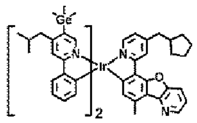
848
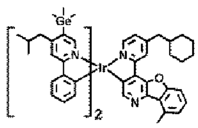
849
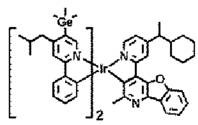
850

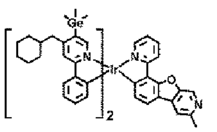
851
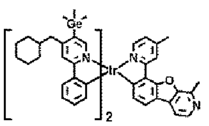
852
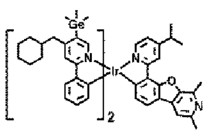
853
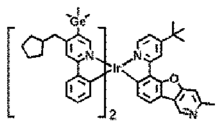
854
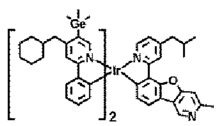
855

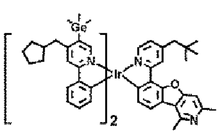
856
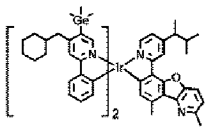
857
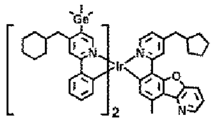
858
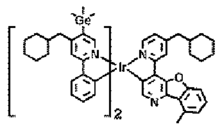
859
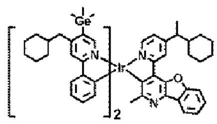
860

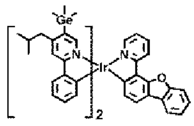
861
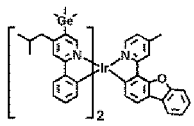
862
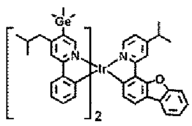
863
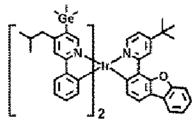
864
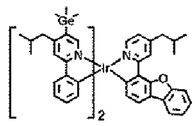
865

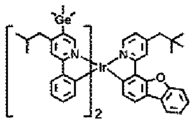
866
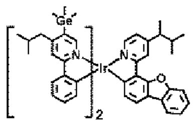
867
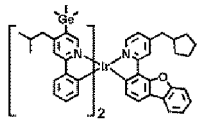
868
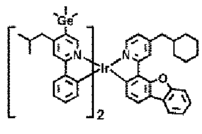
869
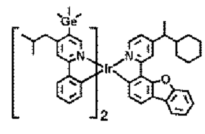
870

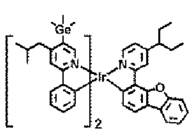
871
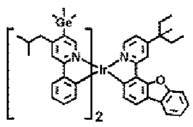
872
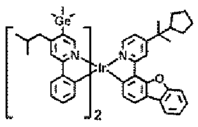
873
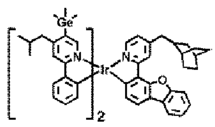
874
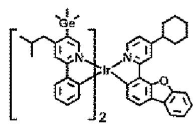
875

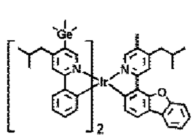
876
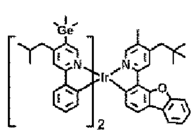
877
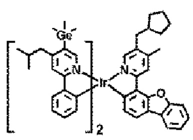
878
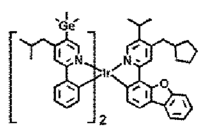
879
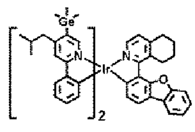
880

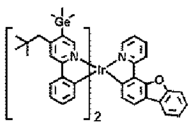
881
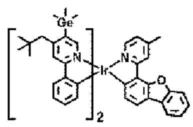
882
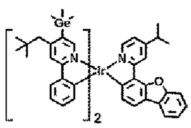
883
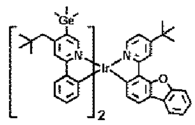
884
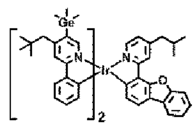
885

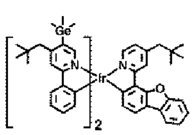
886
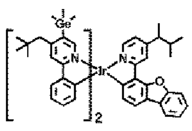
887
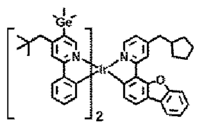
888
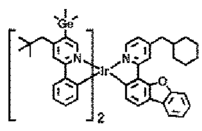
889
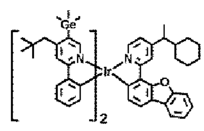
890

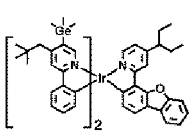
891
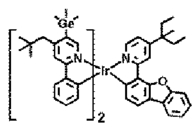
892
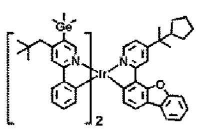
893
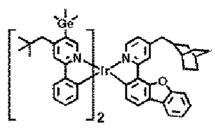
894
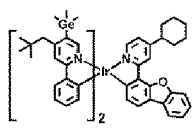
895

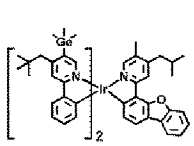
896
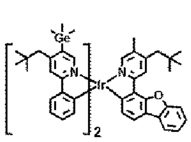
897
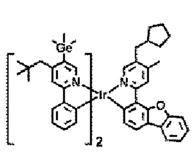
898
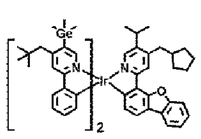
899
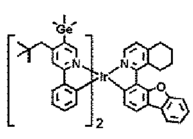
900

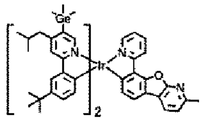
901

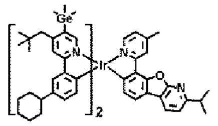
902

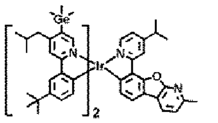
903

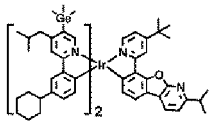
904

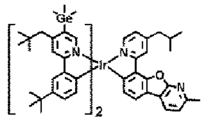
905

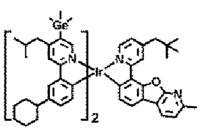
906

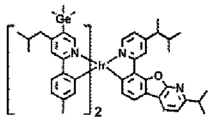
907

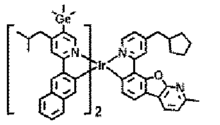
908

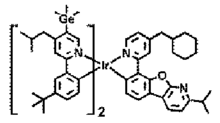
909

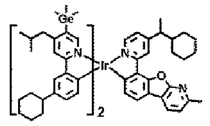
910

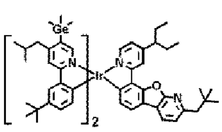
911

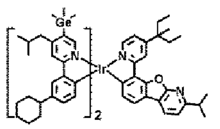
912

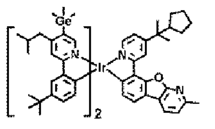
913

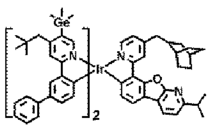
914

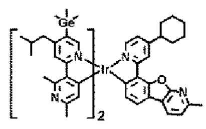
915

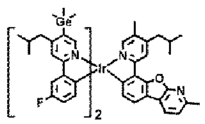
916

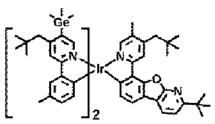
917

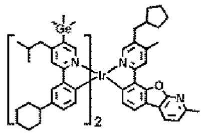
918

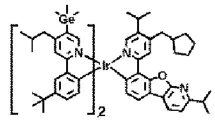
919

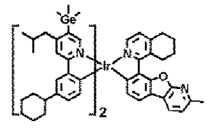
920

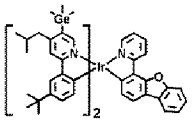
921

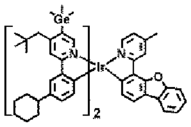
922

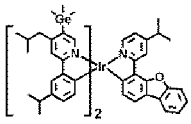
923

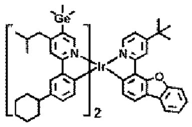
924

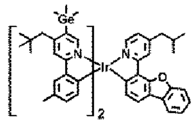
925

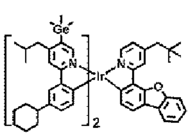
926

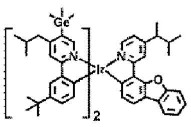
927

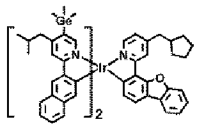
928

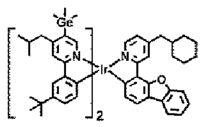
929

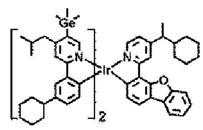
930

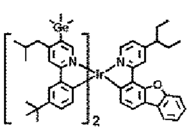
931

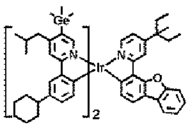
932

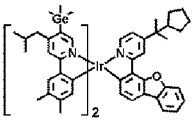
933

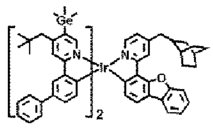
934

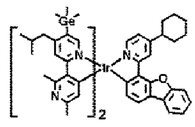
935

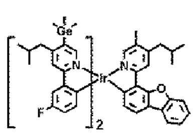
936

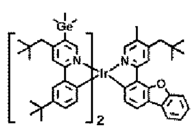
937

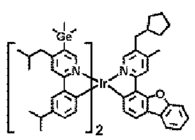
938

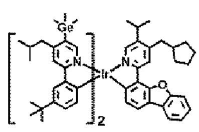
939

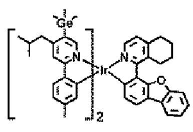
940

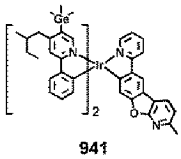
941
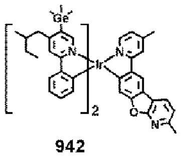
942
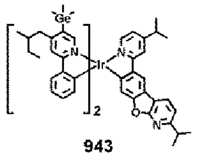
943
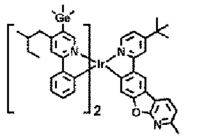
944
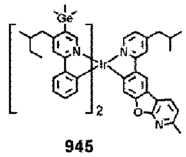
945

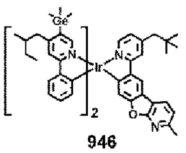
946
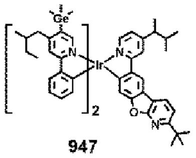
947
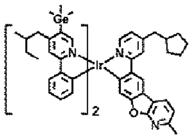
948
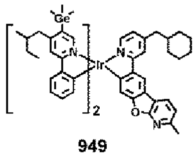
949
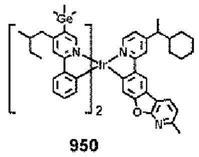
950

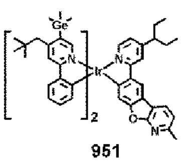
951
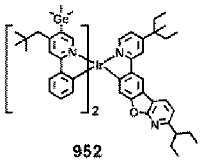
952
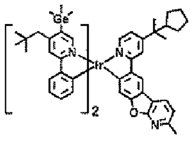
953
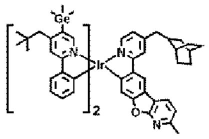
954
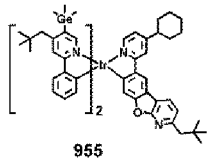
955

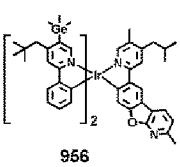
956
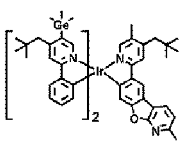
957
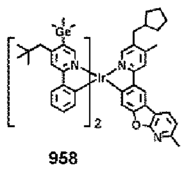
958
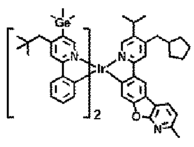
959
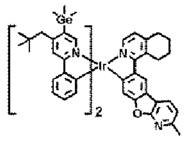
960

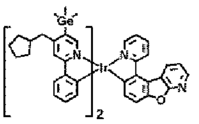
961
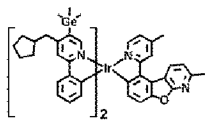
962
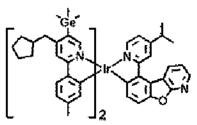
963
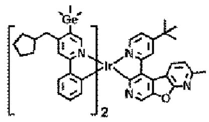
964
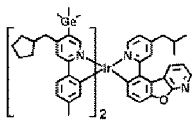
965

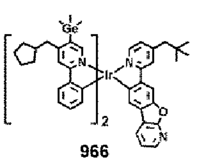
966
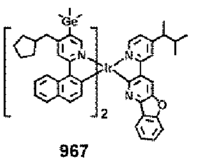
967
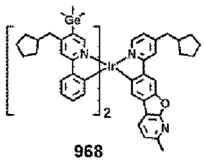
968
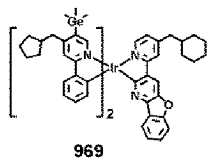
969
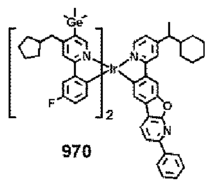
970

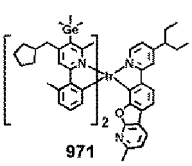
971
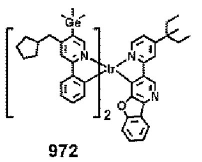
972
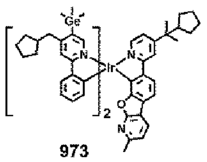
973
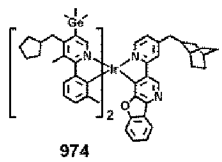
974
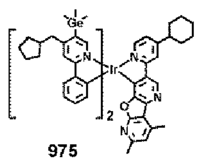
975

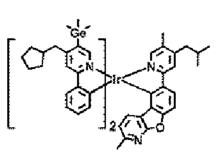
976
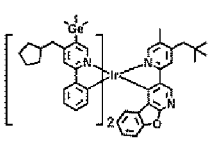
977
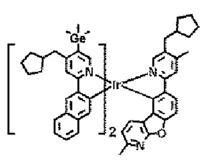
978
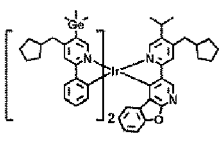
979
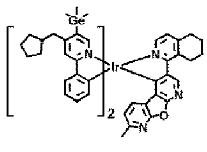
980

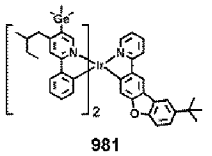
981
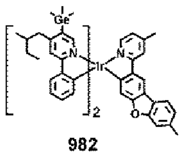
982
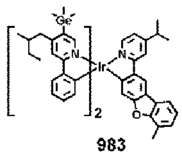
983
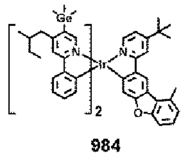
984
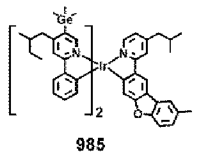
985

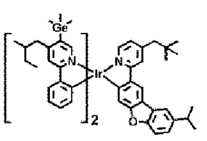
986
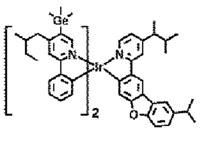
987
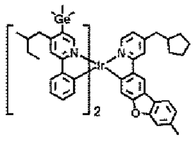
988
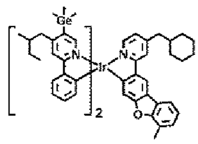
989
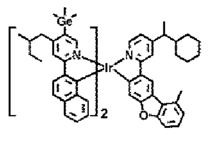
990

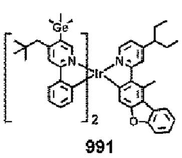
991
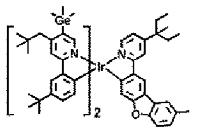
992
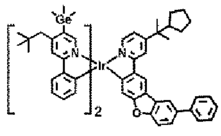
993
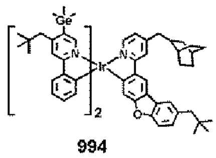
994
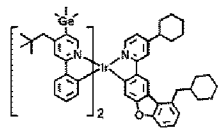
995

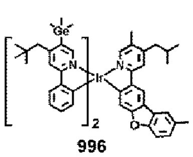
996
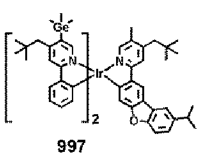
997
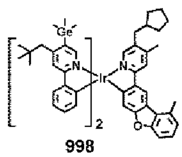
998
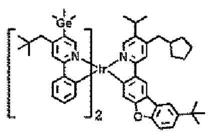
999
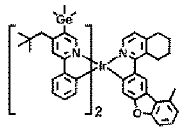
1000

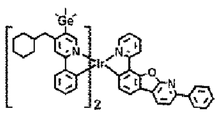
1001
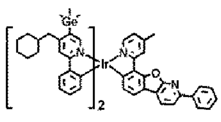
1002
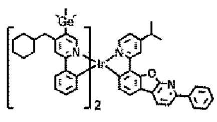
1003
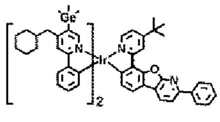
1004
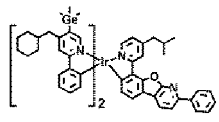
1005

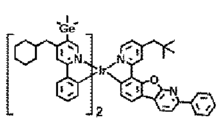
1006
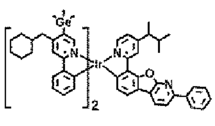
1007
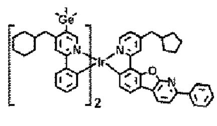
1008
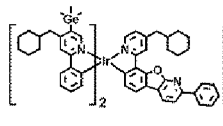
1009
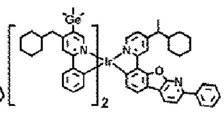
1010

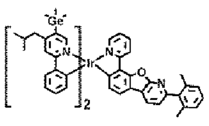
1011
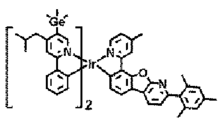
1012
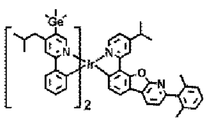
1013
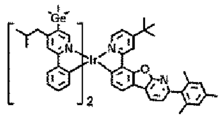
1014
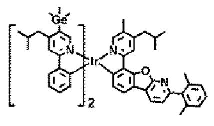
1015

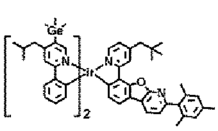
1016
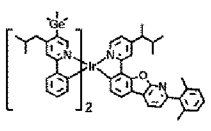
1017
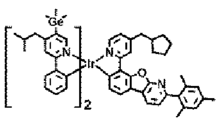
1018
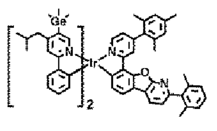
1019
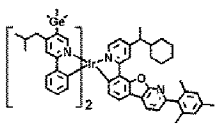
1020

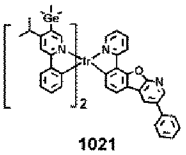
1021
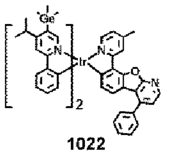
1022
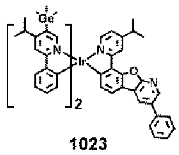
1023
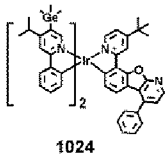
1024
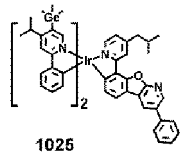
1025

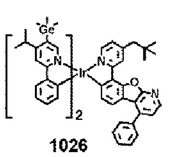
1026
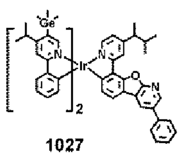
1027
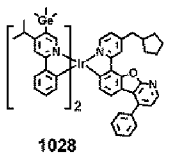
1028
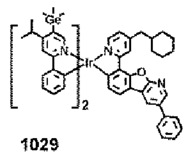
1029
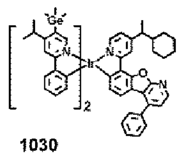
1030

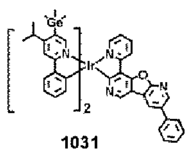
1031
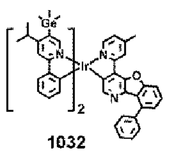
1032
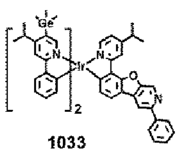
1033
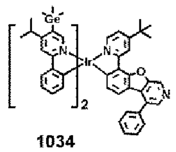
1034
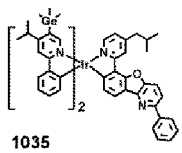
1035

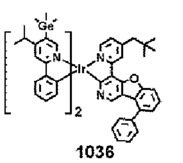
1036
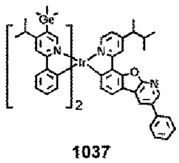
1037
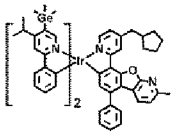
1038
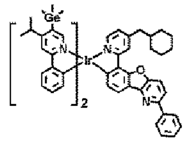
1039
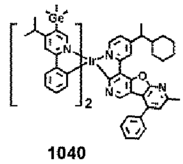
1040

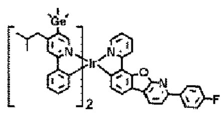
1041
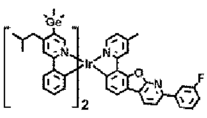
1042
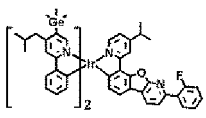
1043
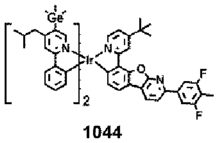
1044
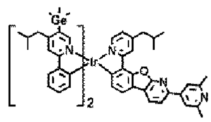
1045

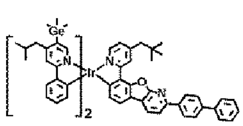
1046
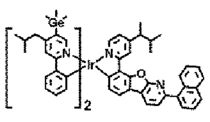
1047
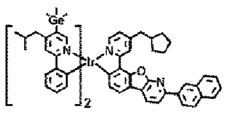
1048
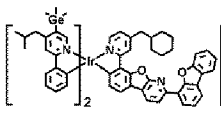
1049
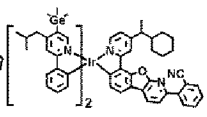
1050

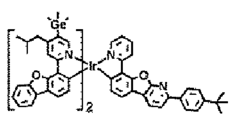
1051
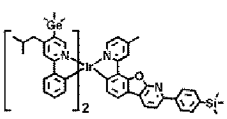
1052
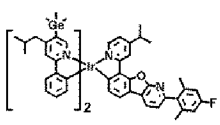
1053
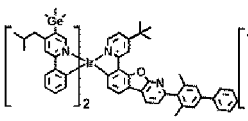
1054
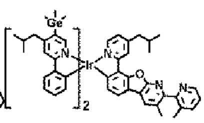
1055

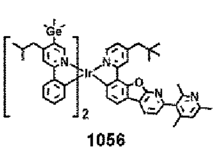
1056
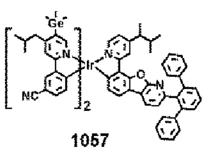
1057
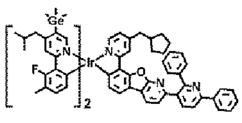
1058
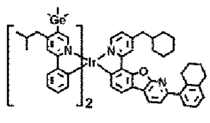
1059
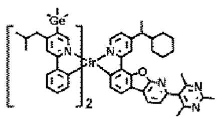
1060

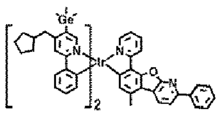
1061
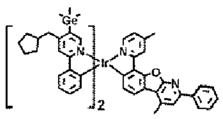
1062
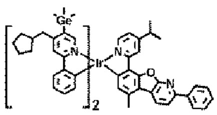
1063
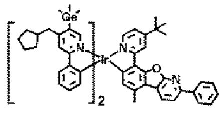
1064
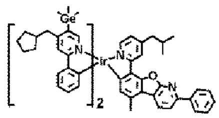
1065

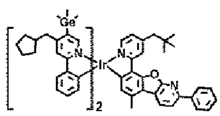
1066
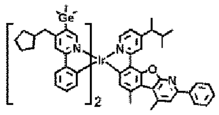
1067
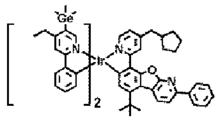
1068
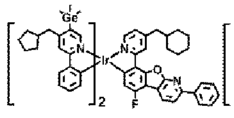
1069
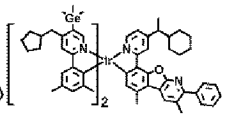
1070

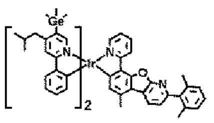
1071
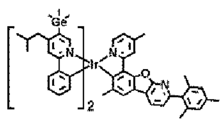
1072
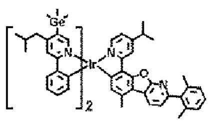
1073
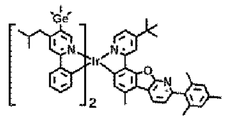
1074
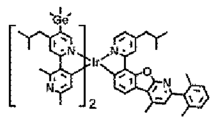
1075

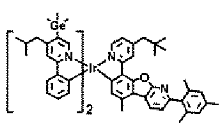
1076
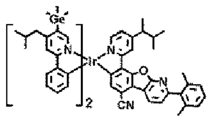
1077
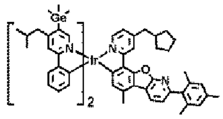
1078
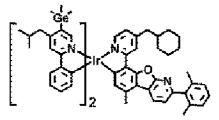
1079
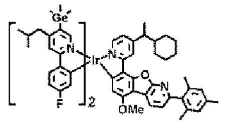
1080

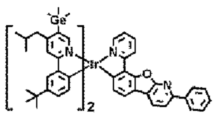
1081
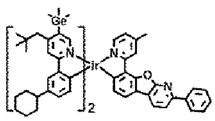
1082
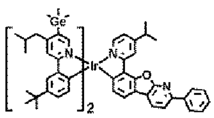
1083
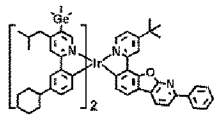
1084
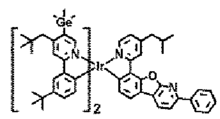
1085

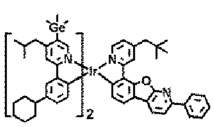
1086
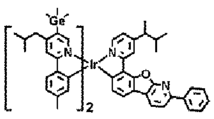
1087
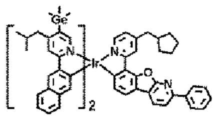
1088
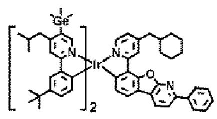
1089
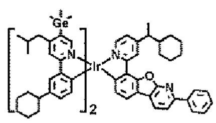
1090

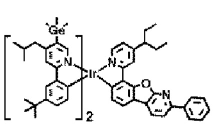
1091
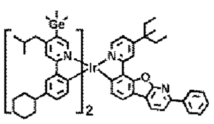
1092
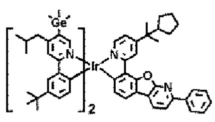
1093
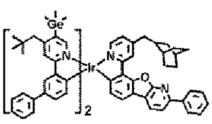
1094
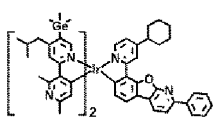
1095

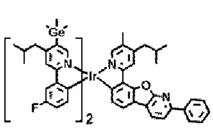
1096
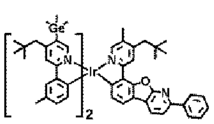
1097
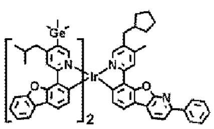
1098
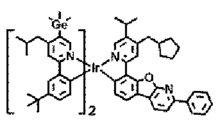
1099
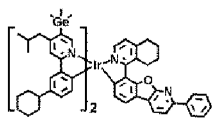
1100

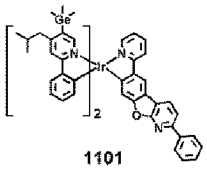
1101
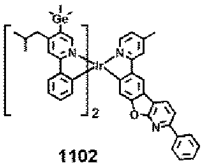
1102
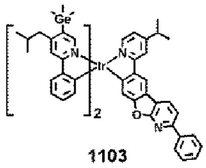
1103
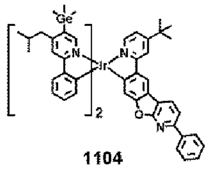
1104
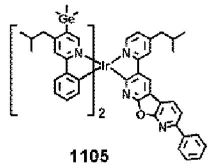
1105

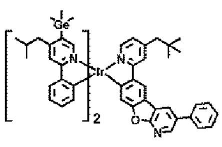
1106
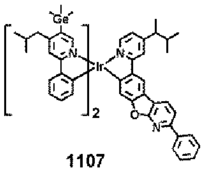
1107
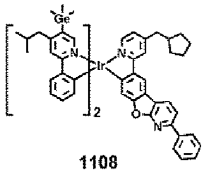
1108
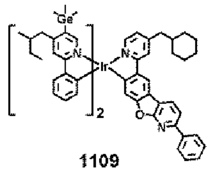
1109
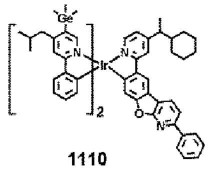
1110

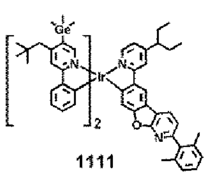
1111
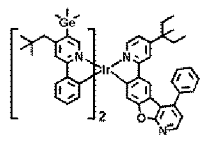
1112
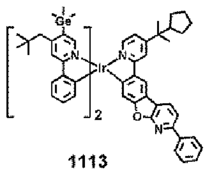
1113
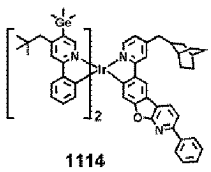
1114
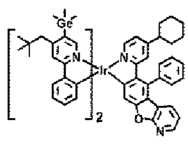
1115

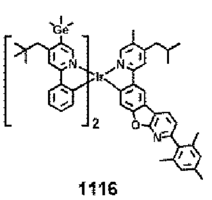
1116
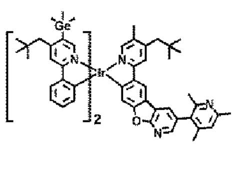
1117
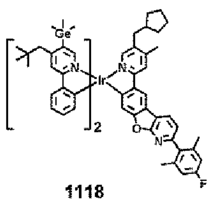
1118
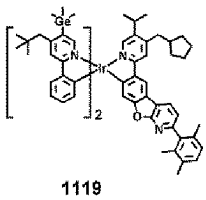
1119
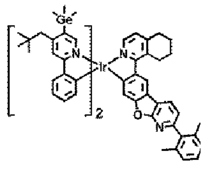
1120

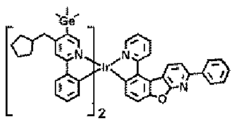
1121
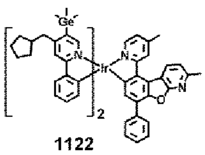
1122
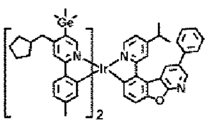
1123
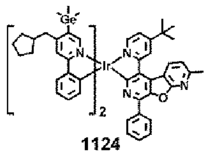
1124
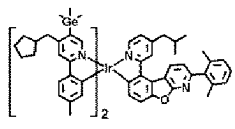
1125

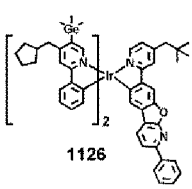
1126
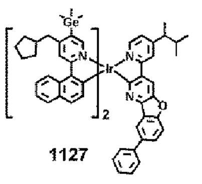
1127
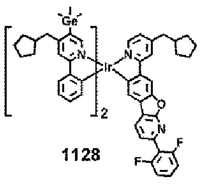
1128
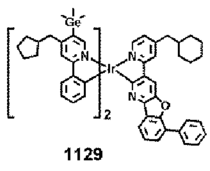
1129
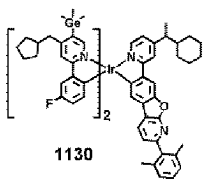
1130

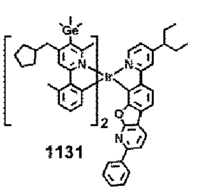
1131
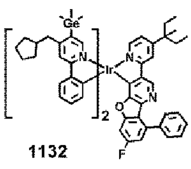
1132
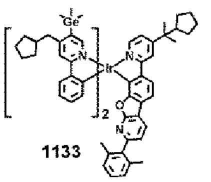
1133
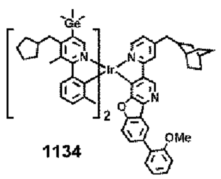
1134
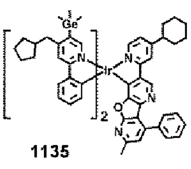
1135

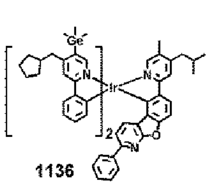
1136
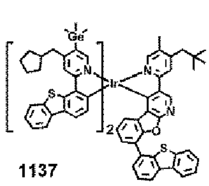
1137
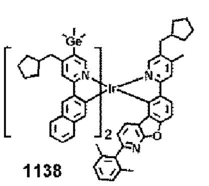
1138
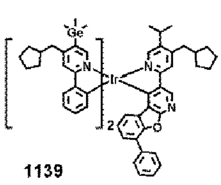
1139
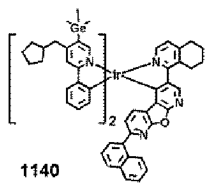
1140

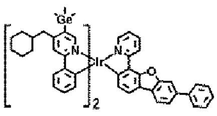
1141
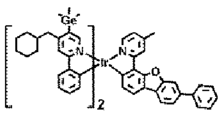
1142
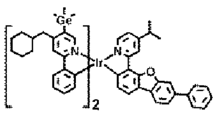
1143
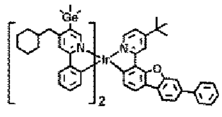
1144
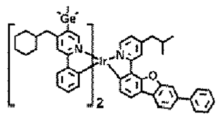
1145

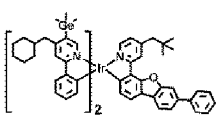
1146
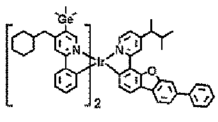
1147
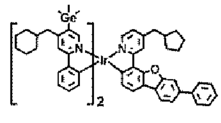
1148
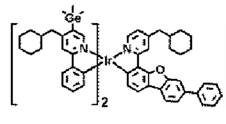
1149
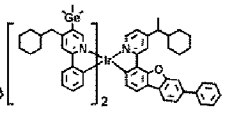
1150

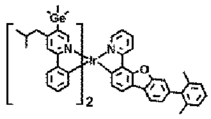
1151
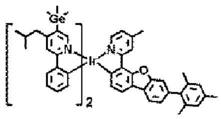
1152
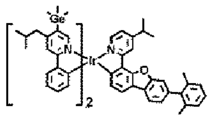
1153
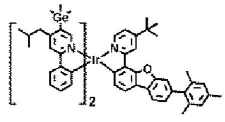
1154
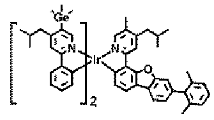
1155

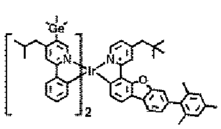
1156
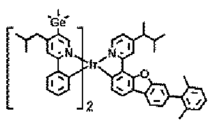
1157
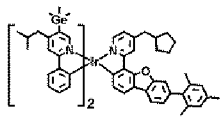
1158
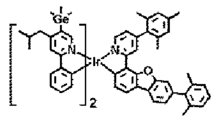
1159
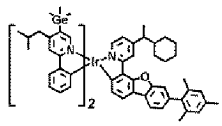
1160

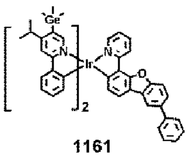
1161
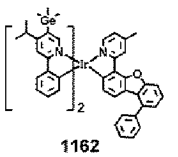
1162
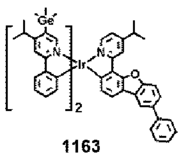
1163
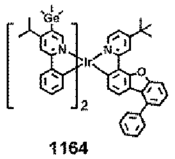
1164
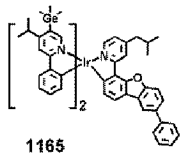
1165

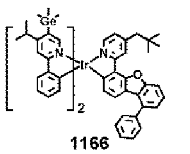
1166
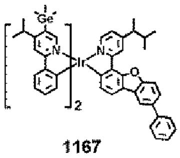
1167
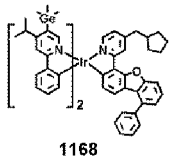
1168
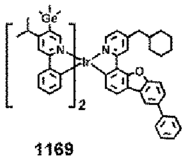
1169
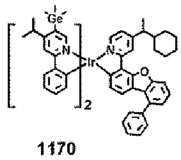
1170

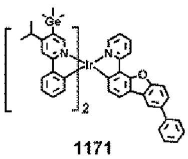
1171
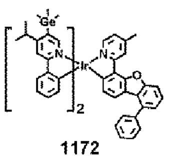
1172
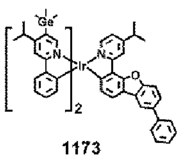
1173
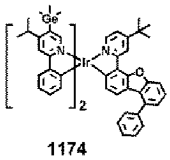
1174
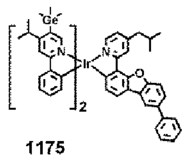
1175

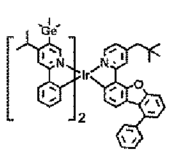
1176
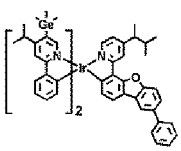
1177
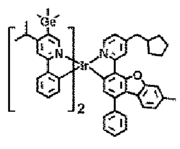
1178
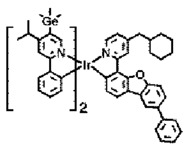
1179
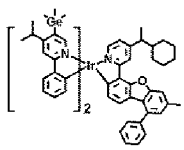
1180

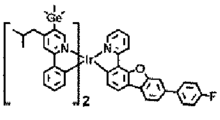
1181
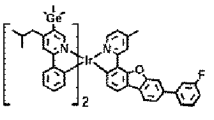
1182
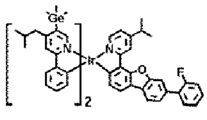
1183
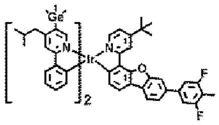
1184
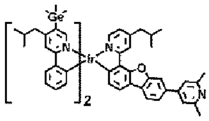
1185

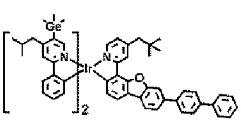
1186
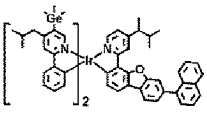
1187
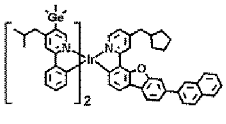
1188
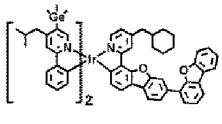
1189
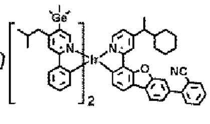
1190

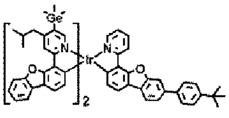
1191
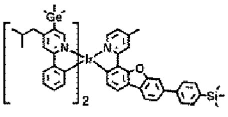
1192
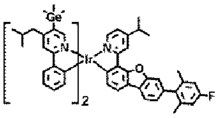
1193
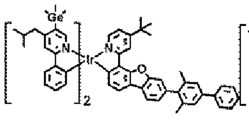
1194
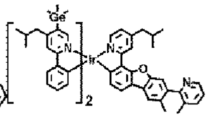
1195

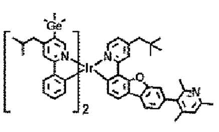
1196
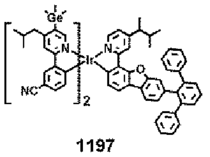
1197
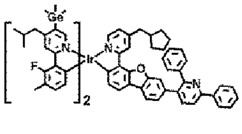
1198
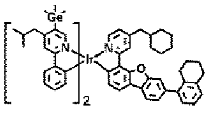
1199
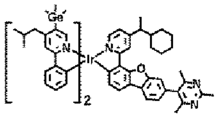
1200

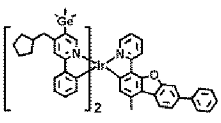
1201
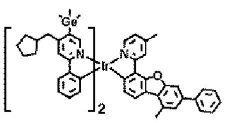
1202
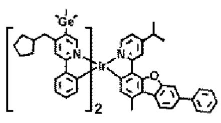
1203
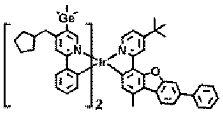
1204
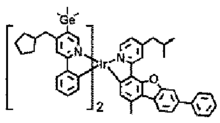
1205

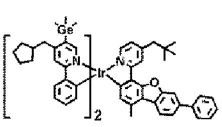
1206
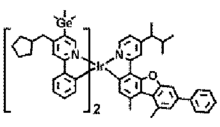
1207
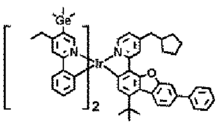
1208
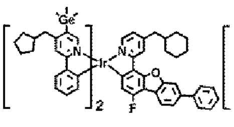
1209
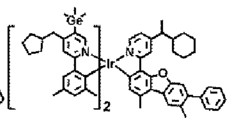
1210

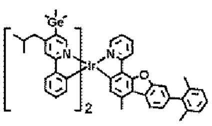
1211
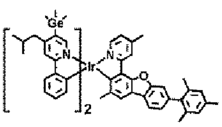
1212
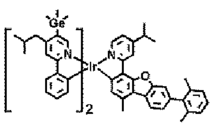
1213
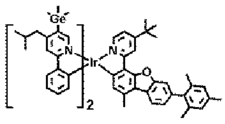
1214
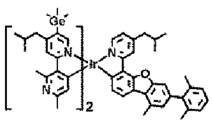
1215

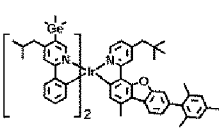
1216
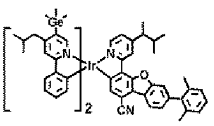
1217
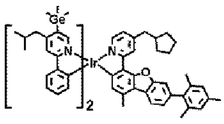
1218
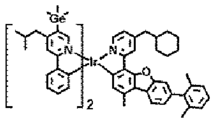
1219
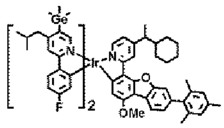
1220

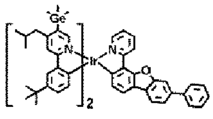
1221
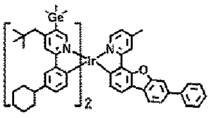
1222
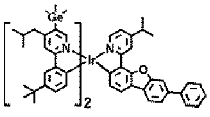
1223
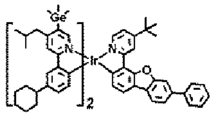
1224
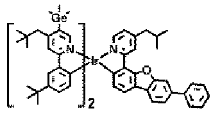
1225

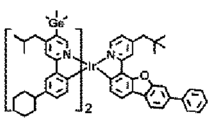
1226
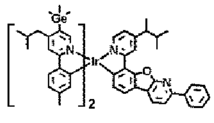
1227
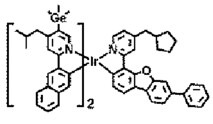
1228
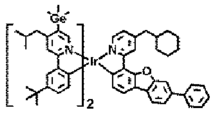
1229
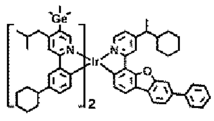
1230

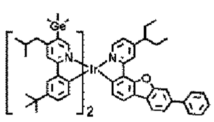
1231
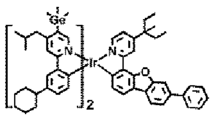
1232
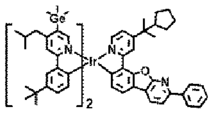
1233
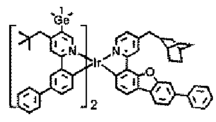
1234
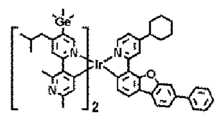
1235

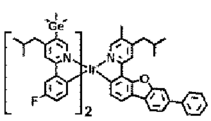
1236
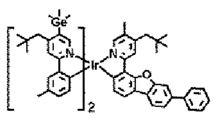
1237
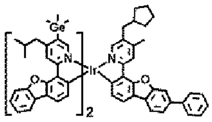
1238
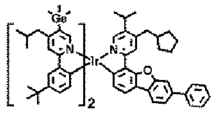
1239
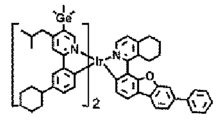
1240

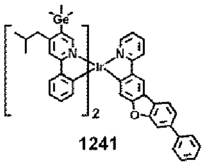
1241
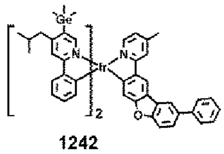
1242
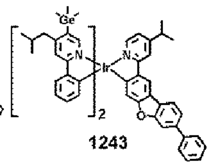
1243
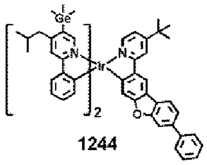
1244
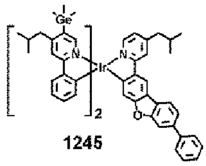
1245

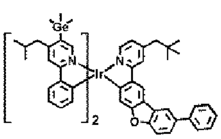
1246
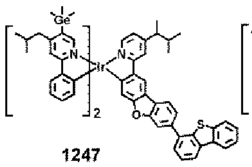
1247
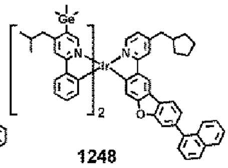
1248
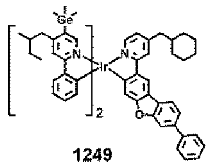
1249
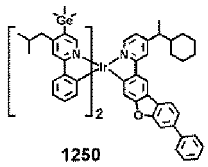
1250

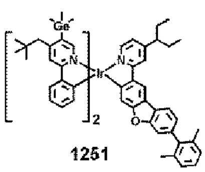
1251
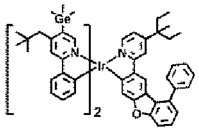
1252
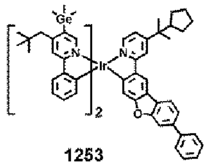
1253
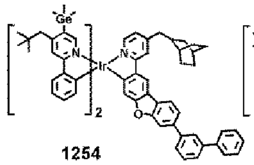
1254
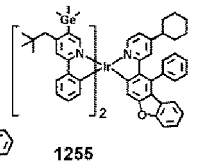
1255

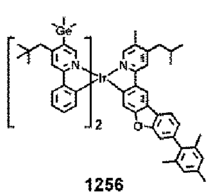
1256
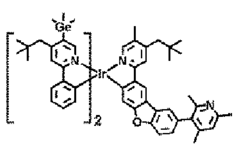
1257
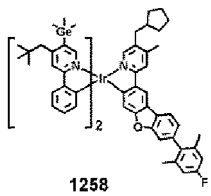
1258
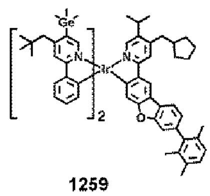
1259
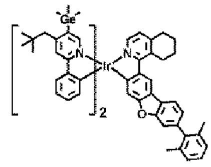
1260

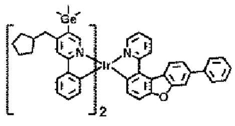
1261
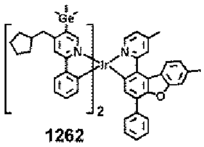
1262
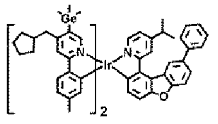
1263
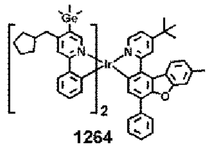
1264
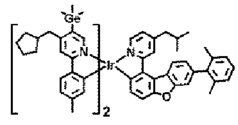
1265

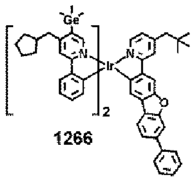
1266
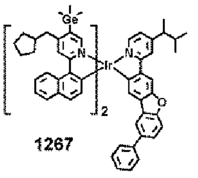
1267
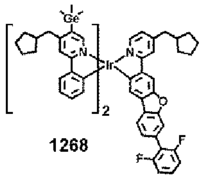
1268
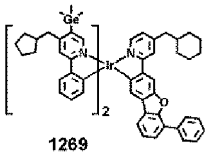
1269
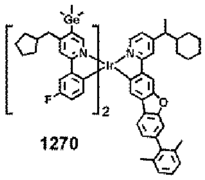
1270

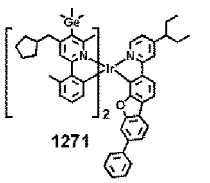
1271
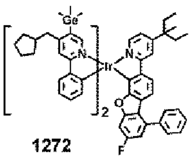
1272
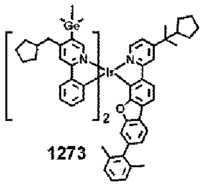
1273
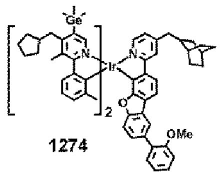
1274
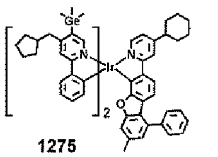
1275

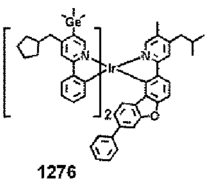
1276
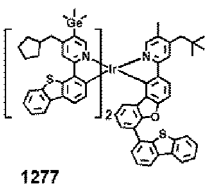
1277
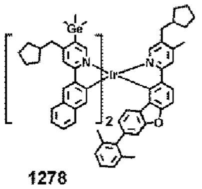
1278
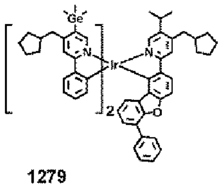
1279
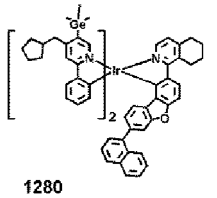
1280

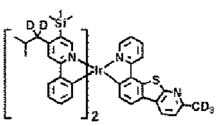
1281
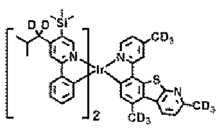
1282
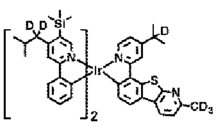
1283
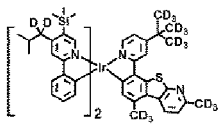
1284
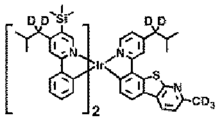
1285

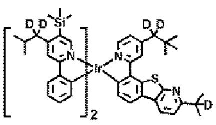
1286
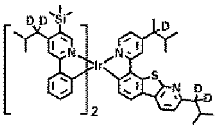
1287
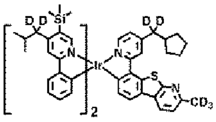
1288
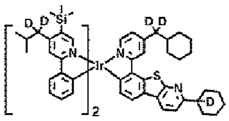
1289
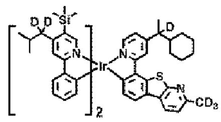
1290

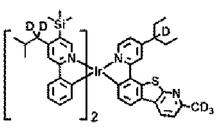
1291
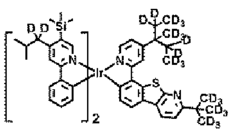
1292
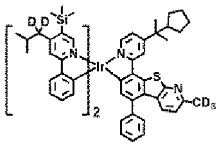
1293
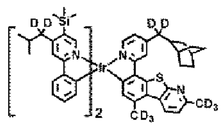
1294
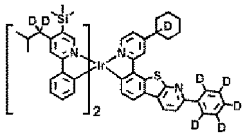
1295

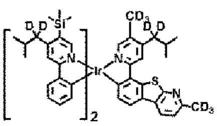
1296
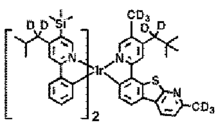
1297
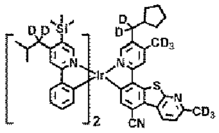
1298
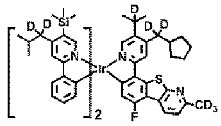
1299
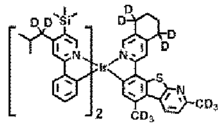
1300

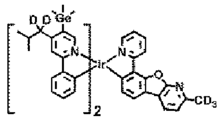
1301

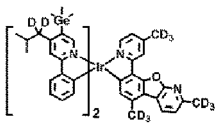
1302

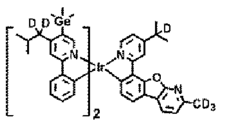
1303

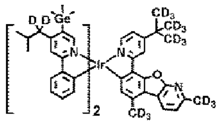
1304

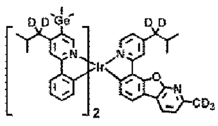
1305

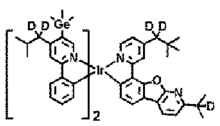
1306

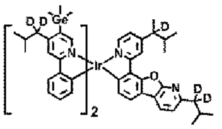
1307

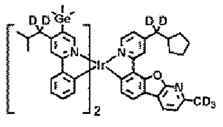
1308

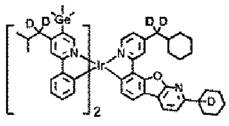
1309

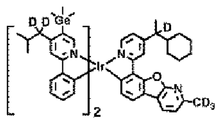
1310

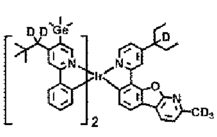
1311

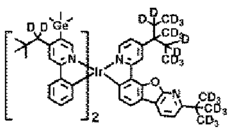
1312

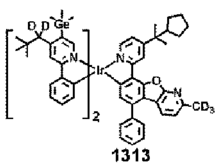
1313

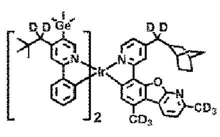
1314

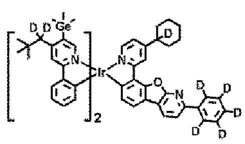
1315

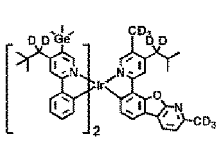
1316

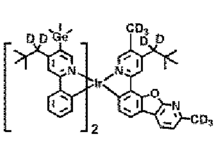
1317

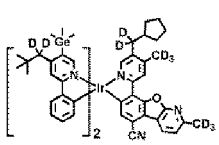
1318

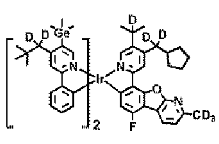
1319

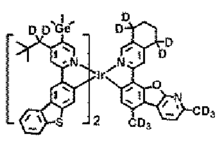
1320

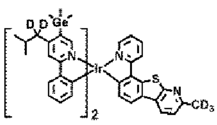
1321

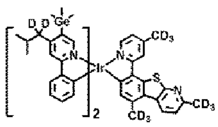
1322

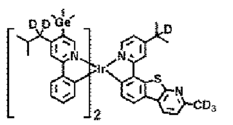
1323

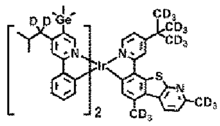
1324

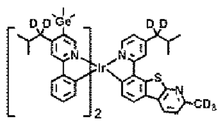
1325

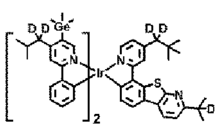
1326

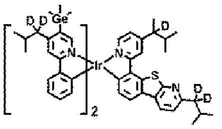
1327

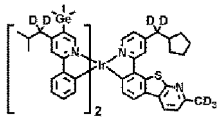
1328

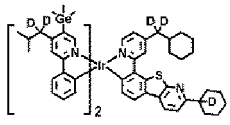
1329

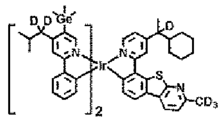
1330

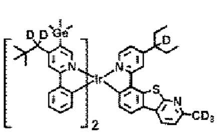
1331

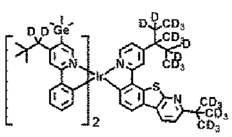
1332

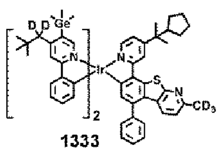
1333

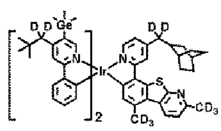
1334

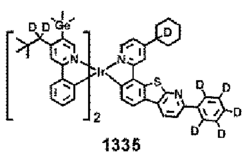
1335

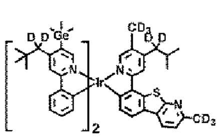
1336

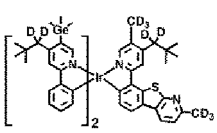
1337

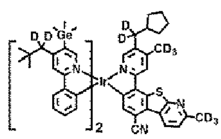
1338

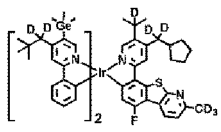
1339

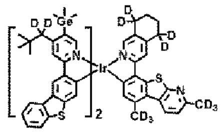
1340

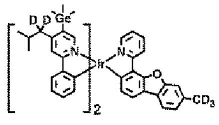 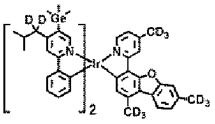 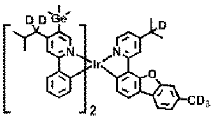 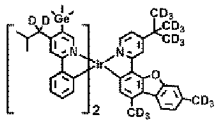 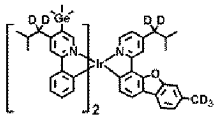

1341 1342 1343 1344 1345

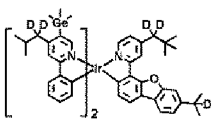 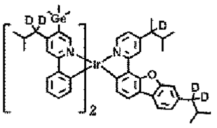 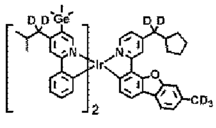 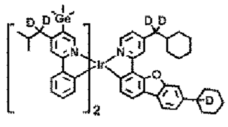 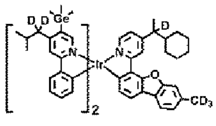

1346 1347 1348 1349 1350

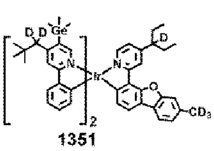 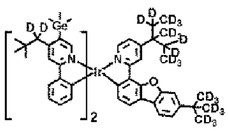 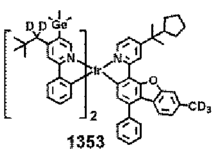 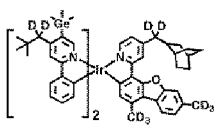 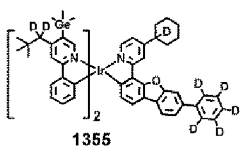

1351 1352 1353 1354 1355

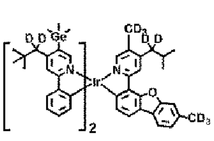 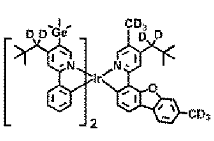 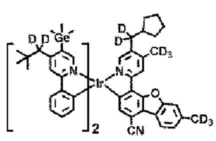 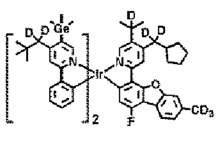 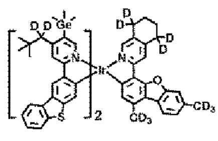

1356 1357 1358 1359 1360

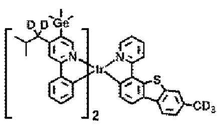 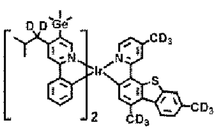 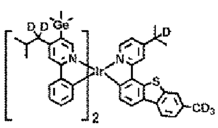 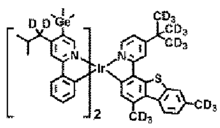 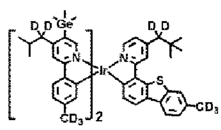

1361 1362 1363 1364 1365

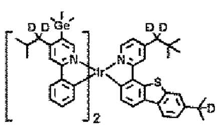 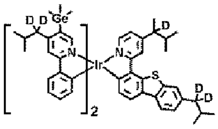 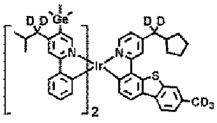 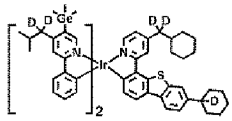 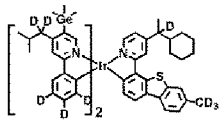

1366 1367 1368 1369 1370

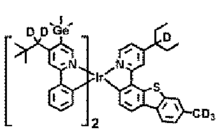 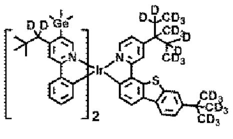 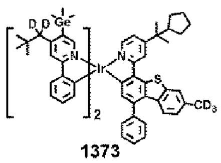 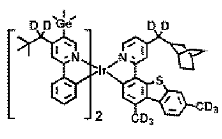 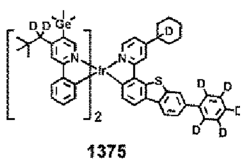

1371 1372 1373 1374 1375

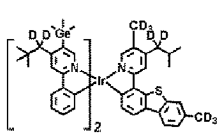 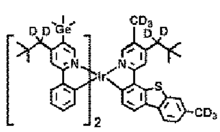 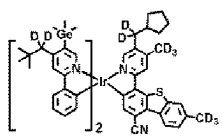 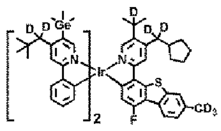 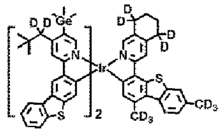

1376 1377 1378 1379 1380

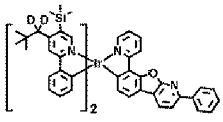
1381

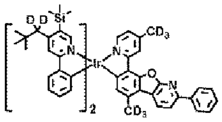
1382

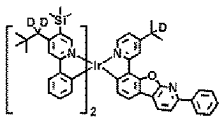
1383

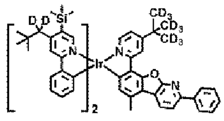
1384

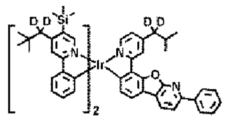
1385

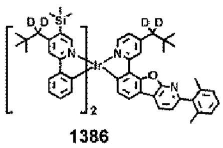
1386

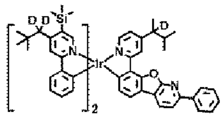
1387

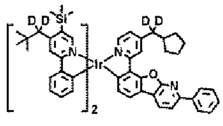
1388

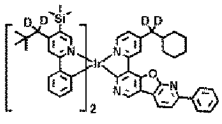
1389

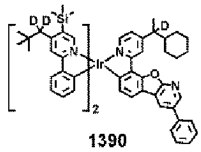
1390

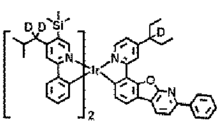
1391

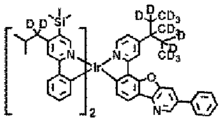
1392

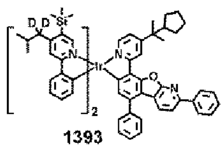
1393

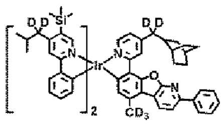
1394

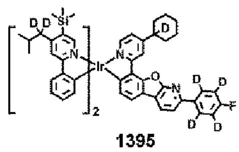
1395

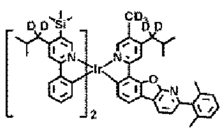
1396

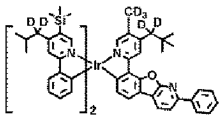
1397

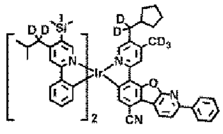
1398

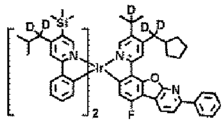
1399

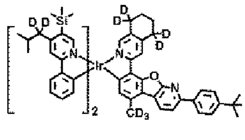
1400

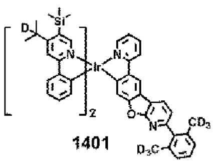
1401

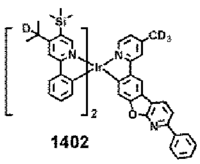
1402

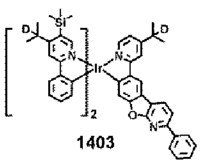
1403

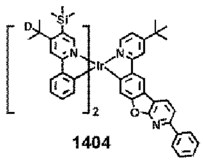
1404

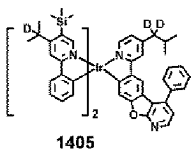
1405

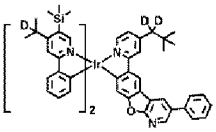
1406

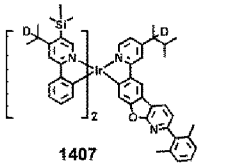
1407

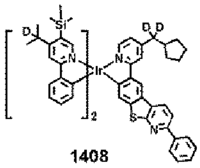
1408

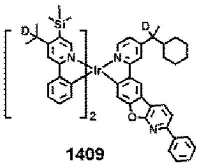
1409

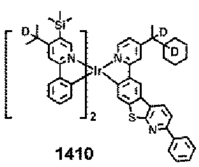
1410

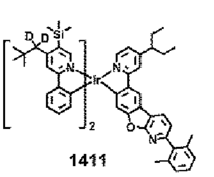
1411

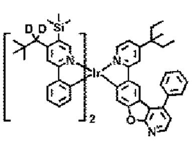
1412

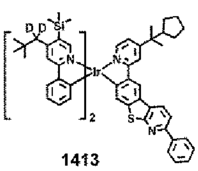
1413

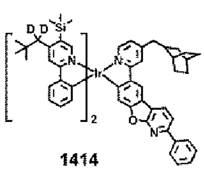
1414

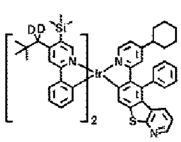
1415

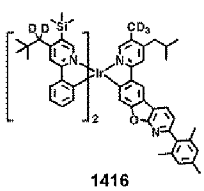
1416

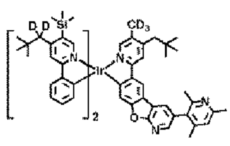
1417

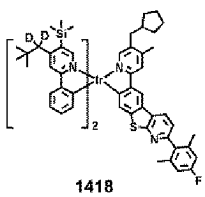
1418

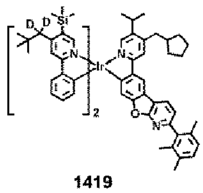
1419

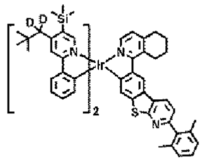
1420

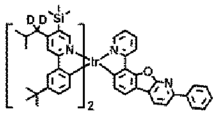 1421

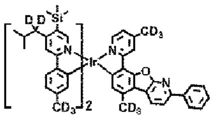 1422

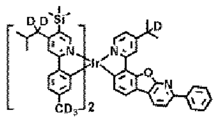 1423

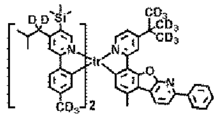 1424

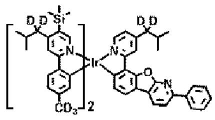 1425

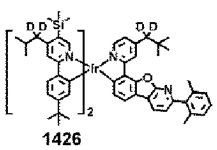 1426

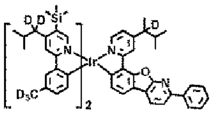 1427

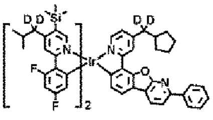 1428

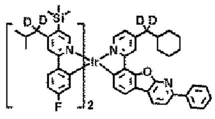 1429

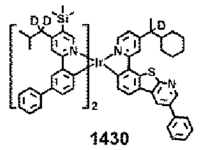 1430

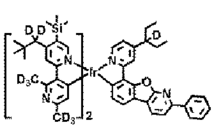 1431

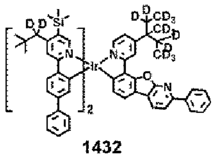 1432

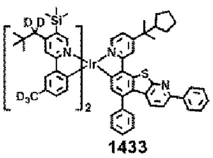 1433

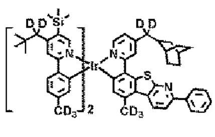 1434

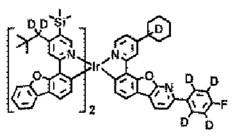 1435

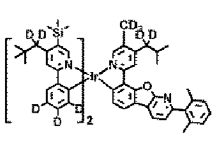 1436

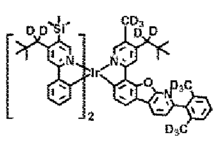 1437

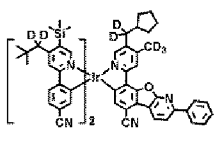 1438

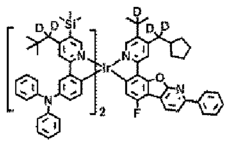 1439

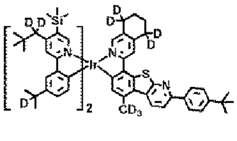 1440

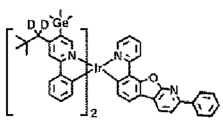 1441

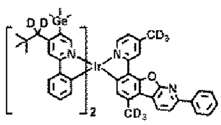 1442

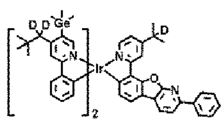 1443

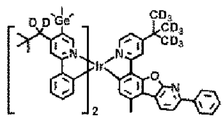 1444

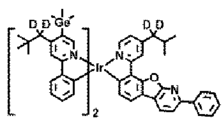 1445

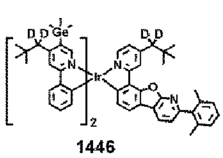 1446

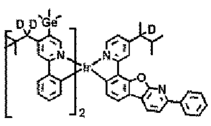 1447

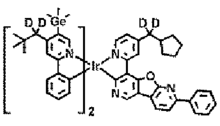 1448

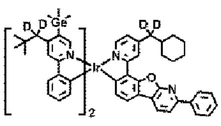 1449

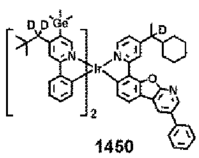 1450

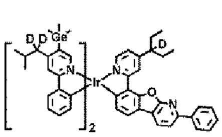 1451

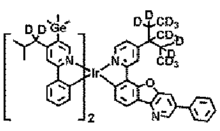 1452

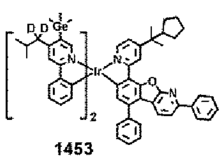 1453

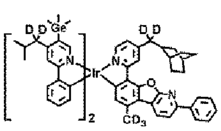 1454

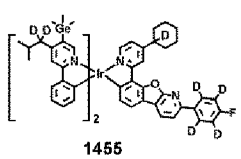 1455

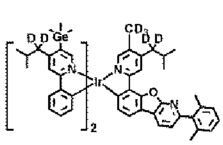 1456

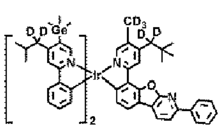 1457

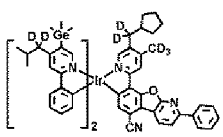 1458

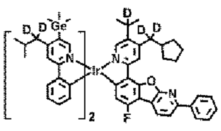 1459

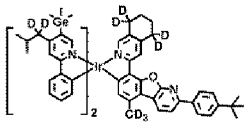 1460

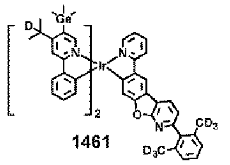
1461

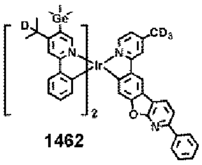
1462

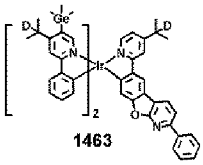
1463

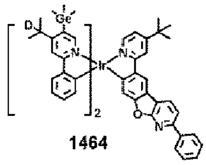
1464

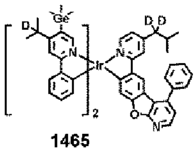
1465

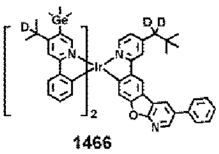
1466

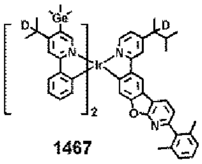
1467

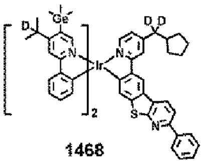
1468

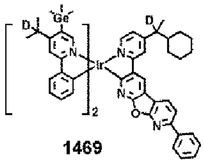
1469

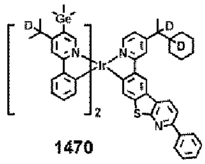
1470

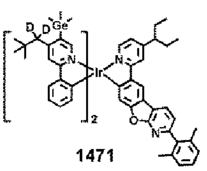
1471

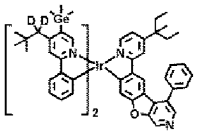
1472

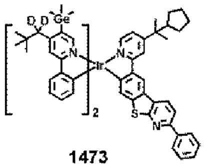
1473

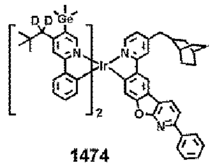
1474

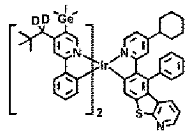
1475

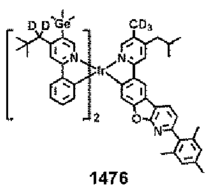
1476

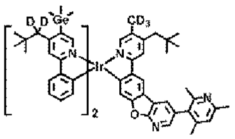
1477

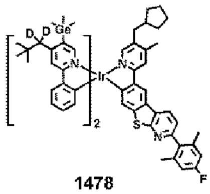
1478

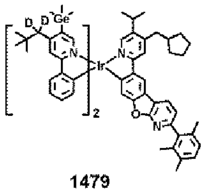
1479

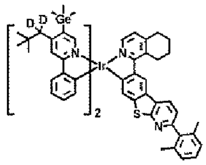
1480

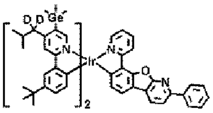
1481

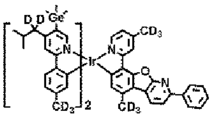
1482

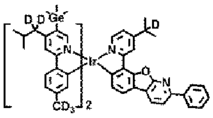
1483

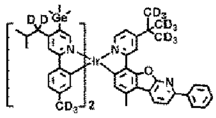
1484

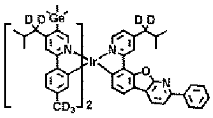
1485

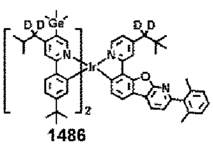
1486

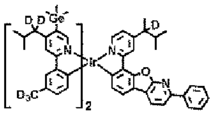
1487

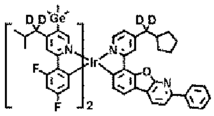
1488

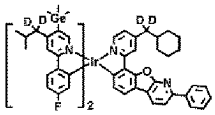
1489

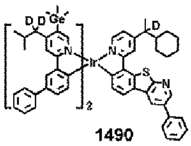
1490

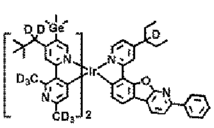
1491

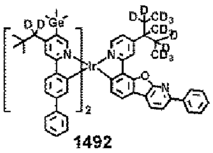
1492

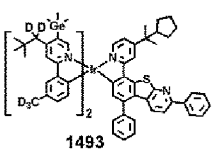
1493

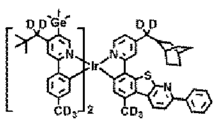
1494

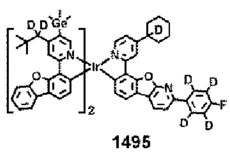
1495

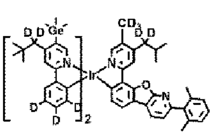
1496

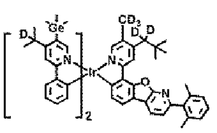
1497

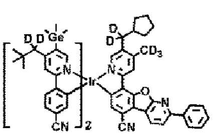
1498

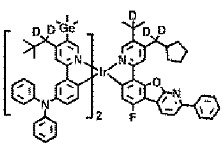
1499

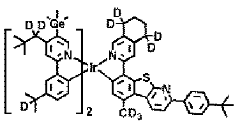
1500

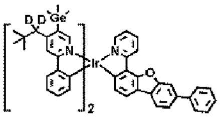
1501

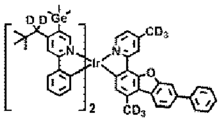
1502

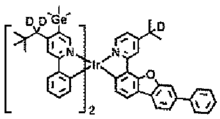
1503

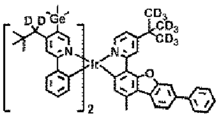
1504

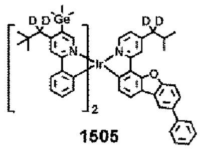
1505

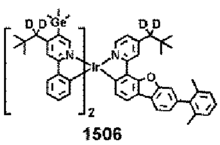
1506

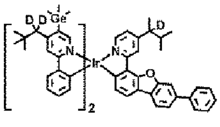
1507

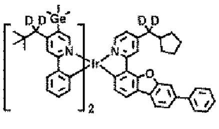
1508

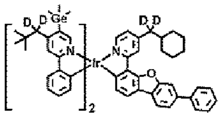
1509

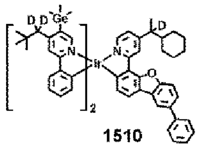
1510

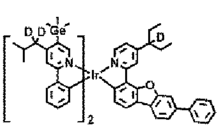
1511

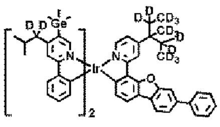
1512

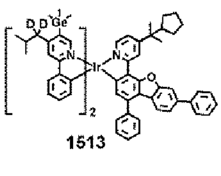
1513

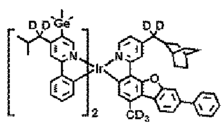
1514

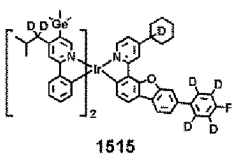
1515

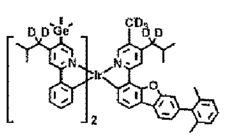
1516

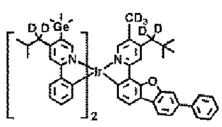
1517

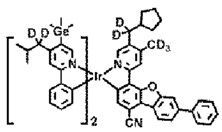
1518

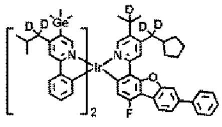
1519

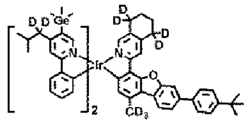
1520

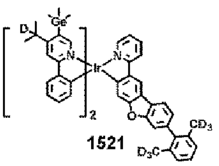
1521

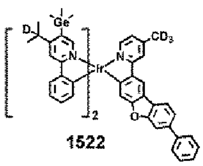
1522

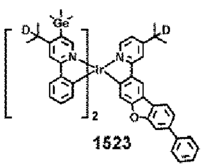
1523

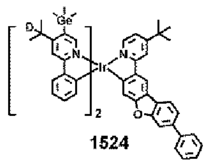
1524

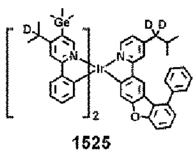
1525

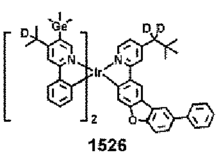
1526

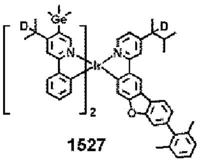
1527

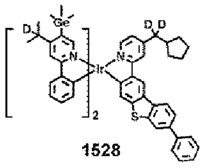
1528

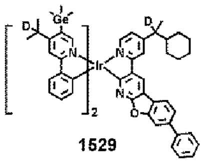
1529

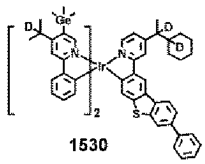
1530

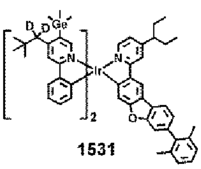
1531

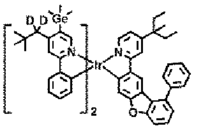
1532

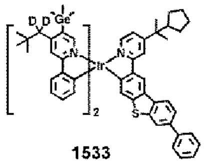
1533

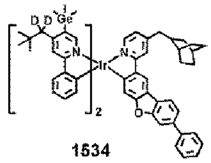
1534

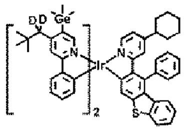
1535

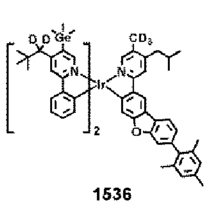
1536

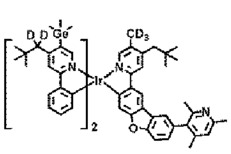
1537

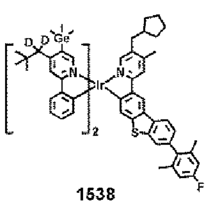
1538

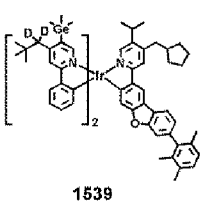
1539

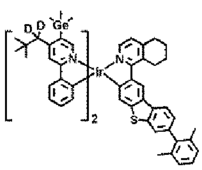
1540

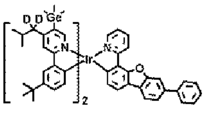
1541

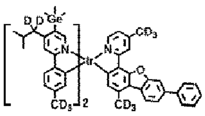
1542

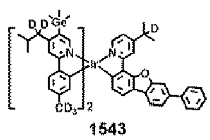
1543

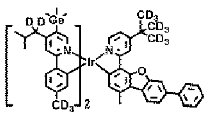
1544

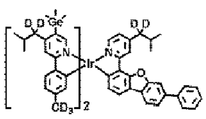
1545

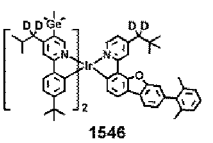
1546

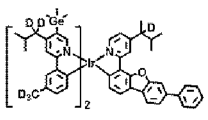
1547

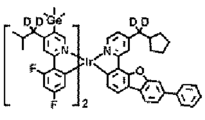
1548

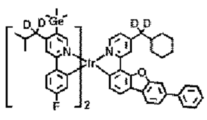
1549

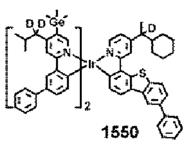
1550

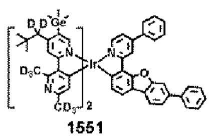
1551

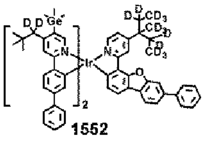
1552

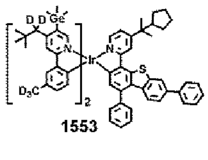
1553

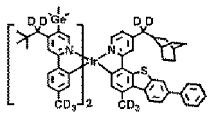
1554

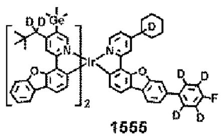
1555

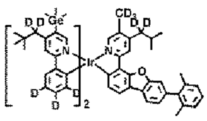
1556

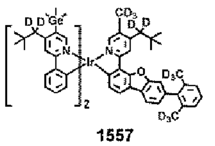
1557

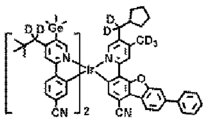
1558

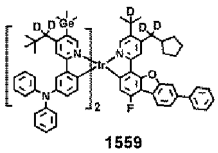
1559

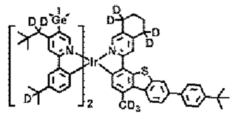
1560

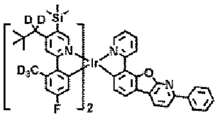
1561

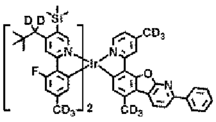
1562

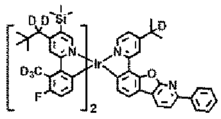
1563

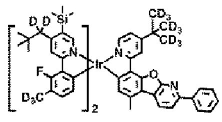
1564

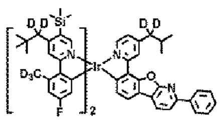
1565

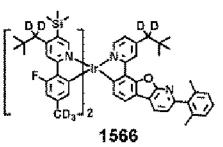
1566

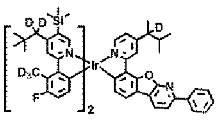
1567

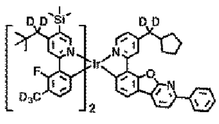
1568

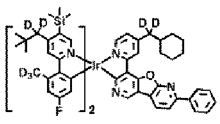
1569

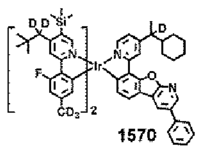
1570

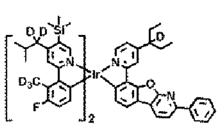
1571

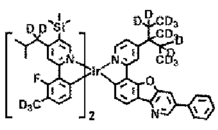
1572

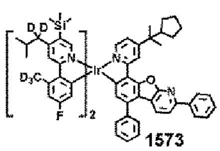
1573

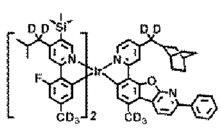
1574

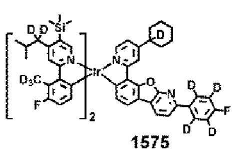
1575

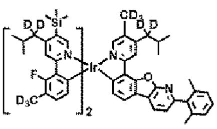
1576

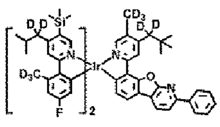
1577

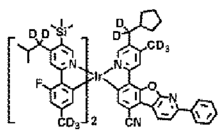
1578

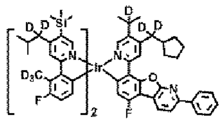
1579

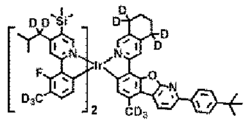
1580

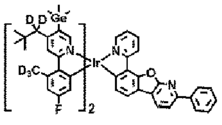 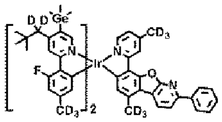 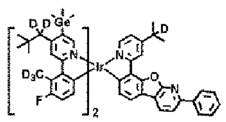 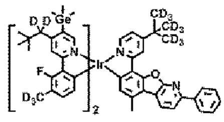 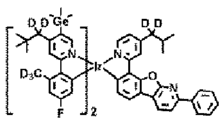

1581 1582 1583 1584 1585

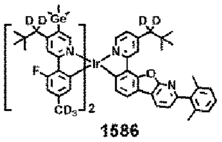 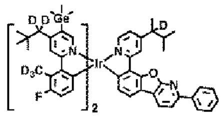 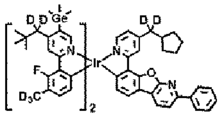 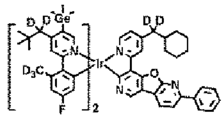 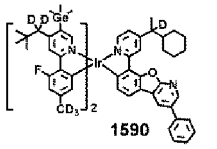

1586 1587 1588 1589 1590

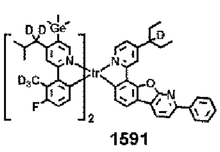 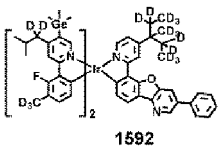 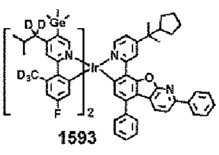 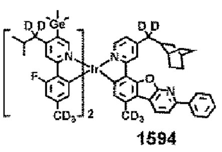 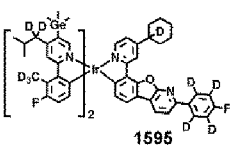

1591 1592 1593 1594 1595

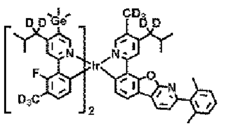 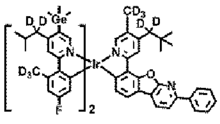 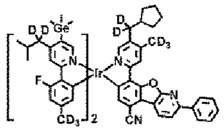 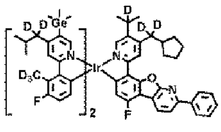 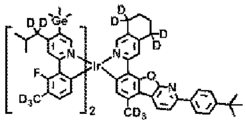

1596 1597 1598 1599 1600

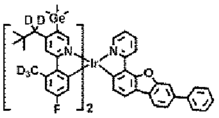 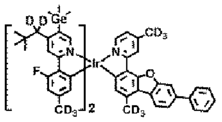 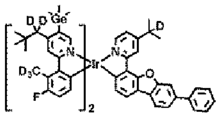 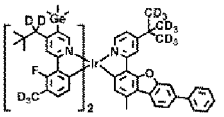 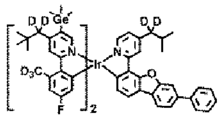

1601 1602 1603 1604 1605

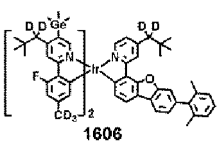 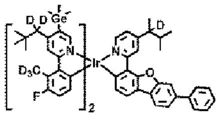 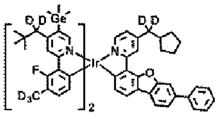 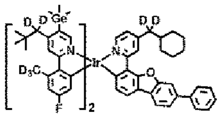 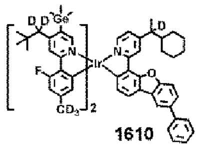

1606 1607 1608 1609 1610

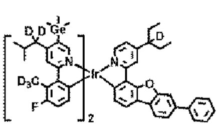 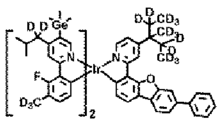 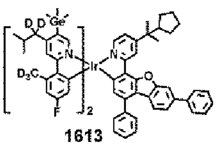 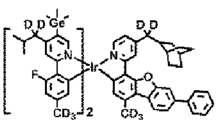 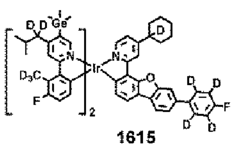

1611 1612 1613 1614 1615

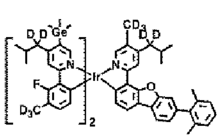 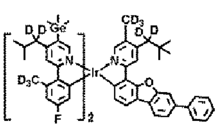 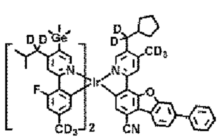 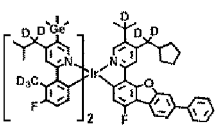 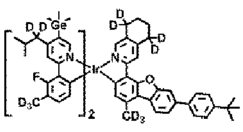

1616 1617 1618 1619 1620

Group 2-3

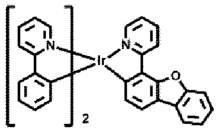
1

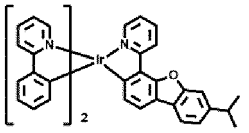
2

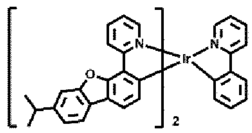
3

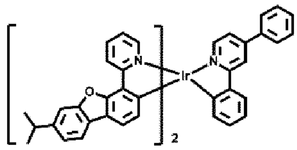
4

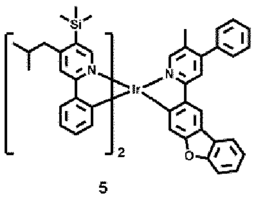
5

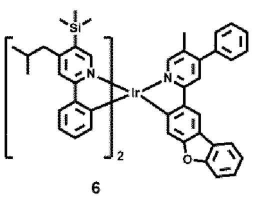
6

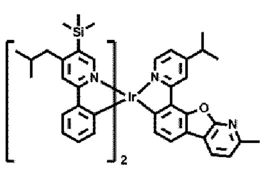
7

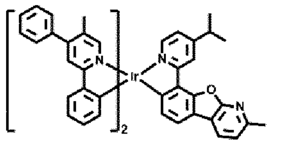
8

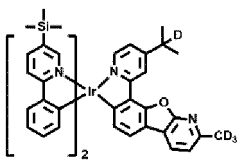
9

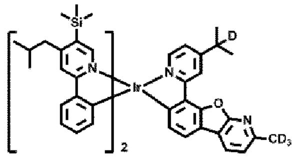
10

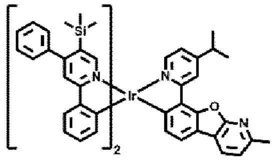
11

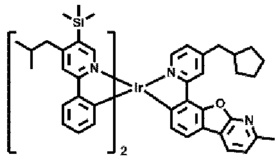
12

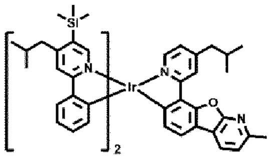
13

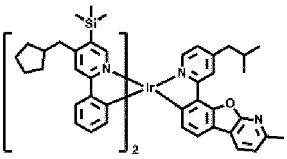
14

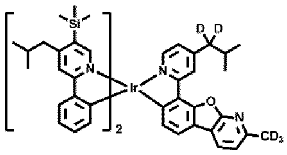
15

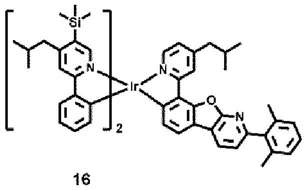
16

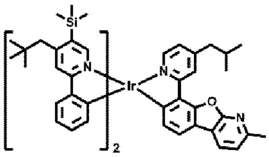
17

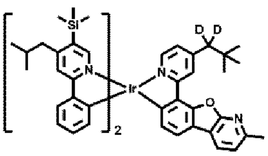
18

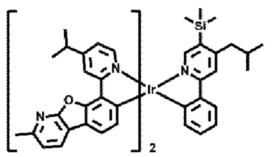
19

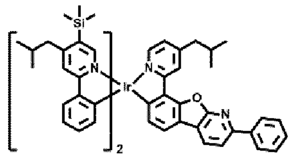
20

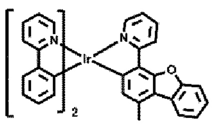
21

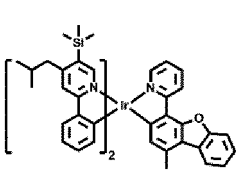
22

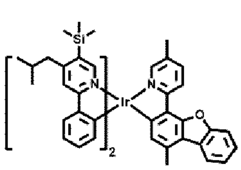
23

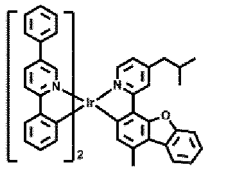
24

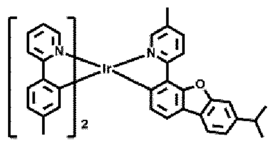
25
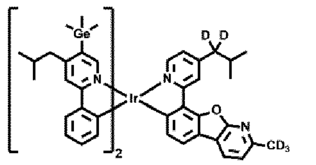
26
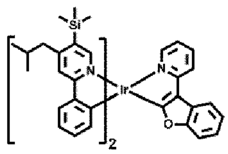
27
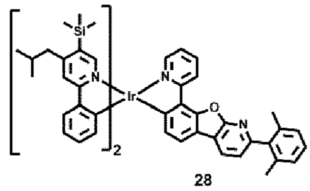
28
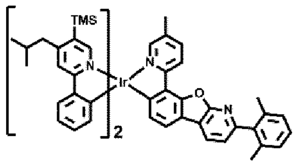
29
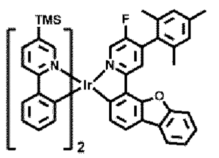
30
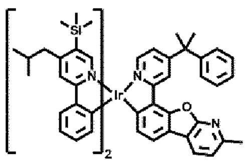
31
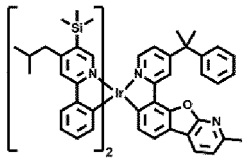
32
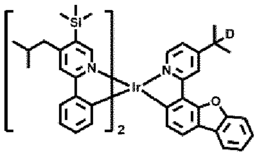
33
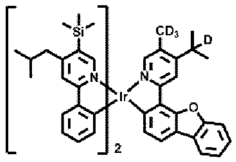
34
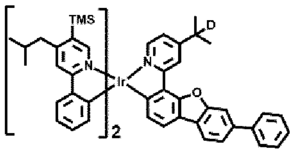
35
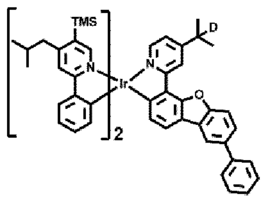
36
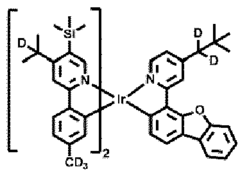
37
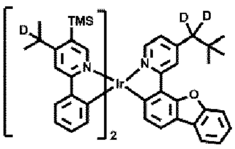
38
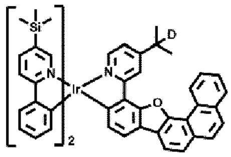
39
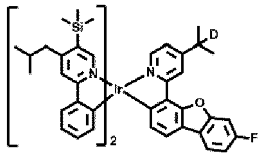
40
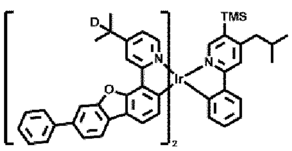
41
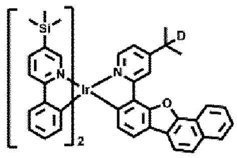
42
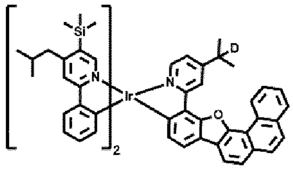
43
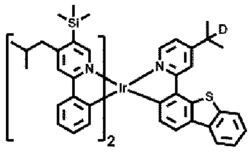
44
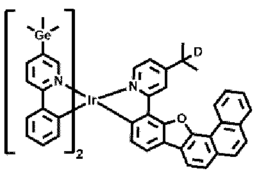
45
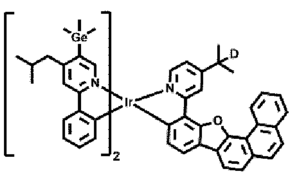
46
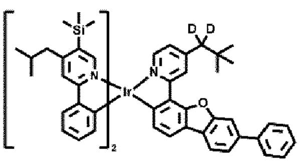
47
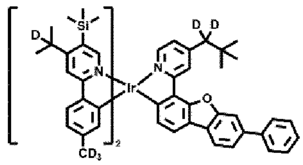
48

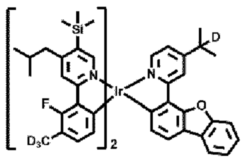
49
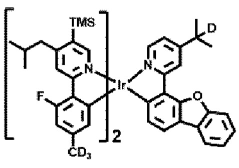
50
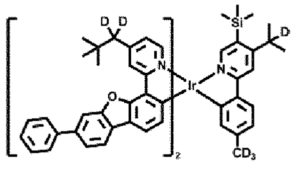
51
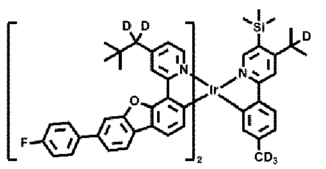
52

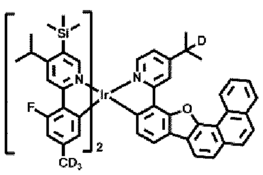
53
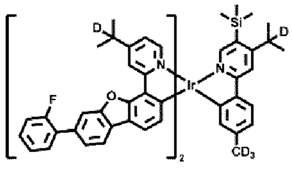
54
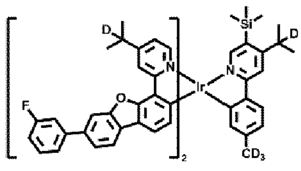
55
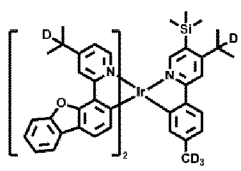
56

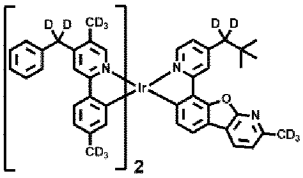
57
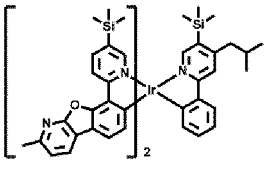
58
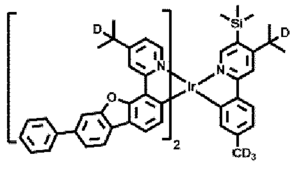
59
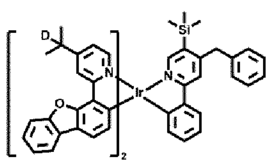
60

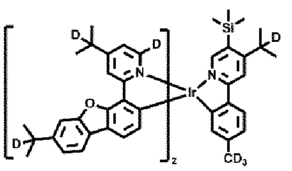
61
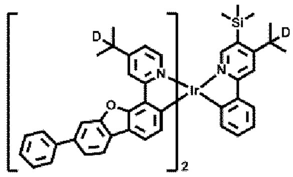
62
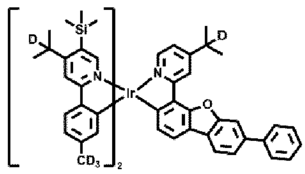
63
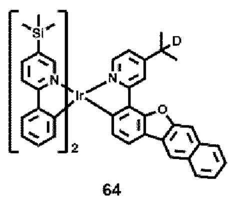
64

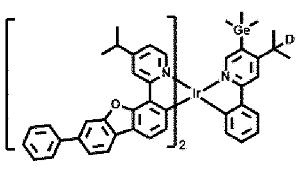
65
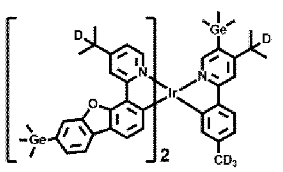
66
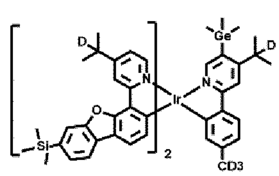
67
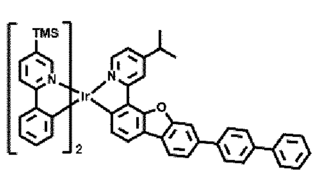
68

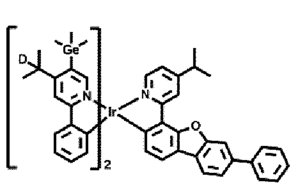
69
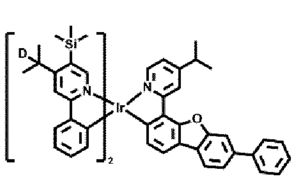
70
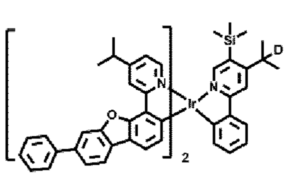
71
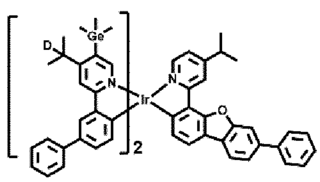
72

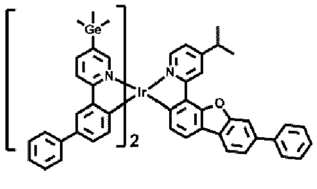

73

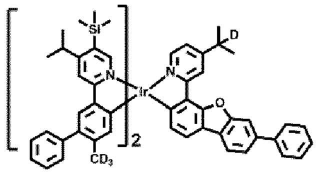

74

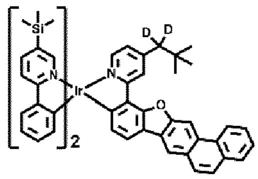

75

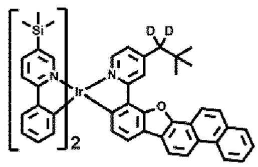

76

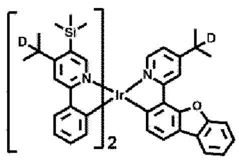

77

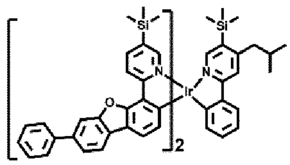

78

Group 2-4

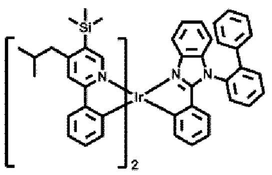

1

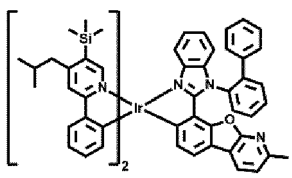

2

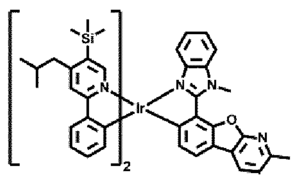

3

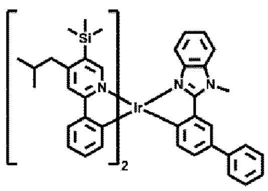

4

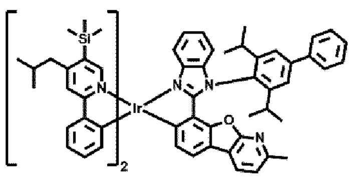

5

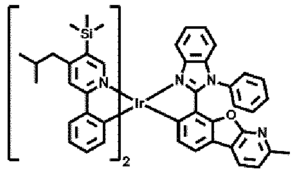

6

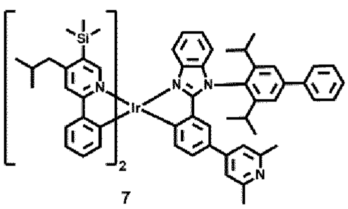

7

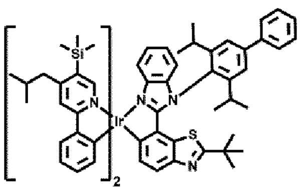

8

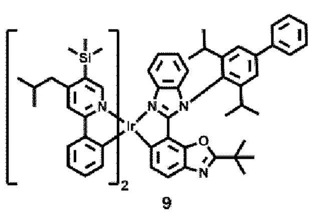

9

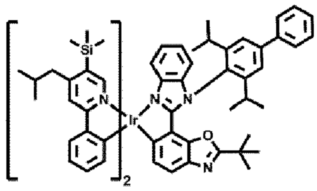

10

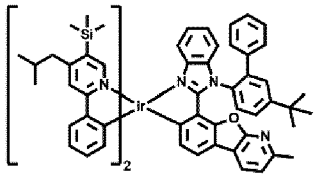

11

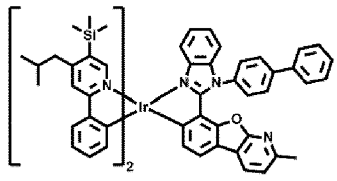

12

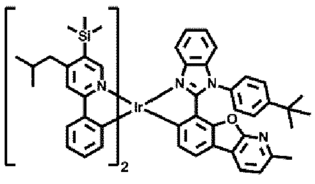

13

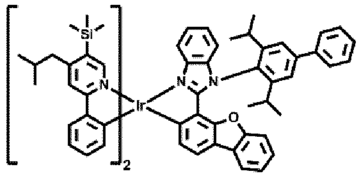

14

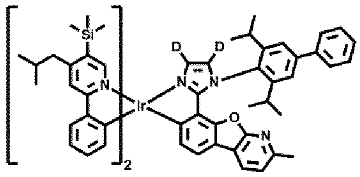

15

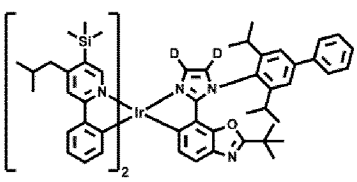

16

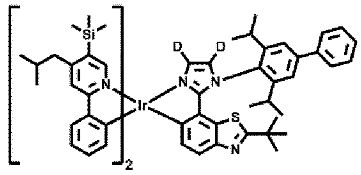

17

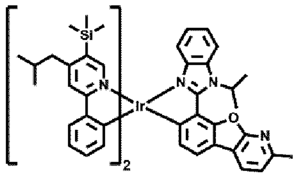

18

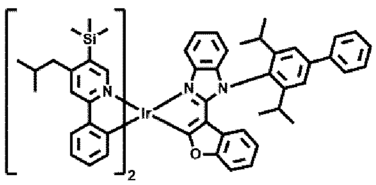

19

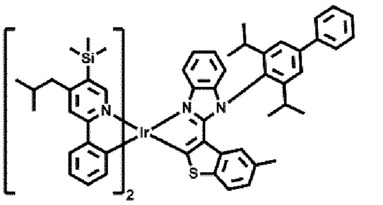

20

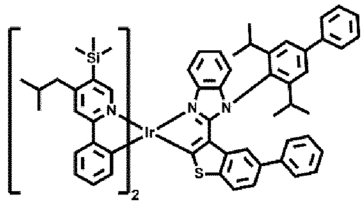

21

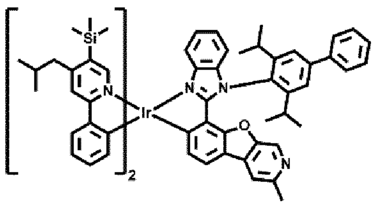

22

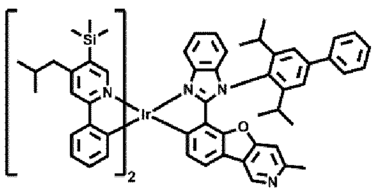

23

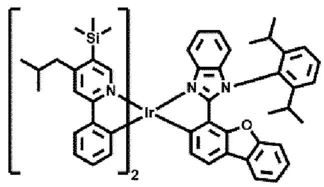

24

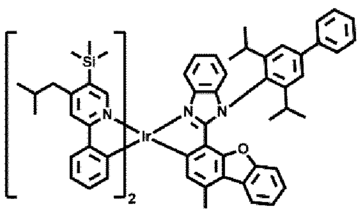

25

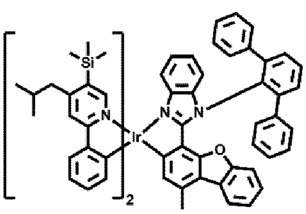

26

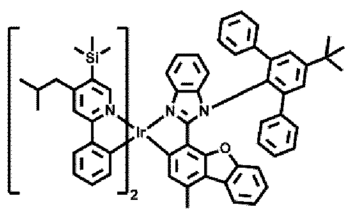

27

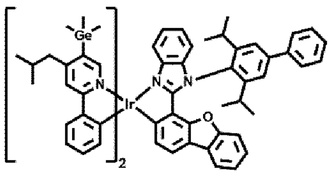
28

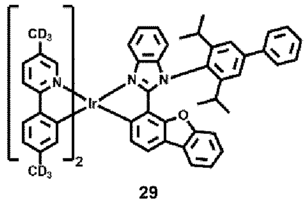
29

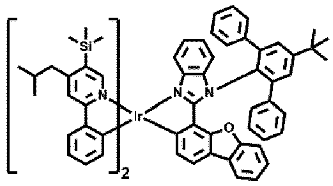
30

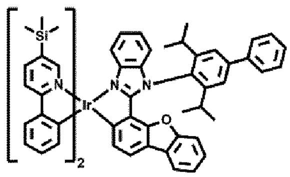
31

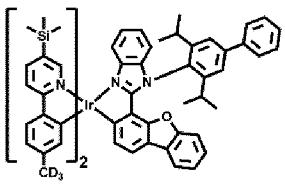
32

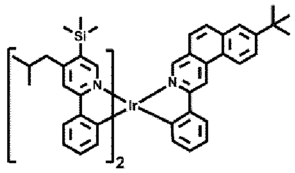
33

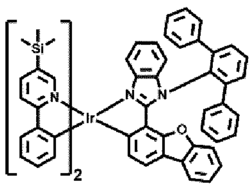
34

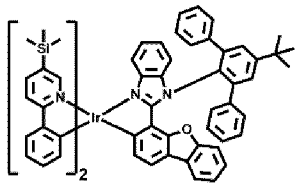
35

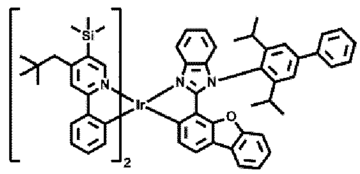
36

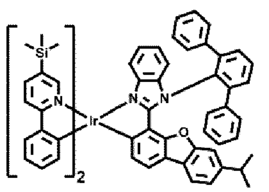
37

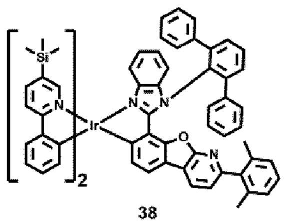
38

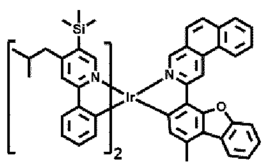
39

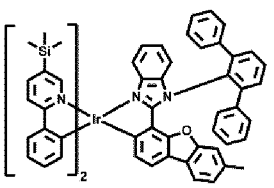
40

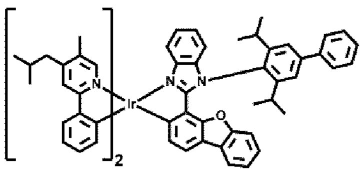
41

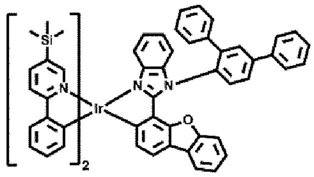
42

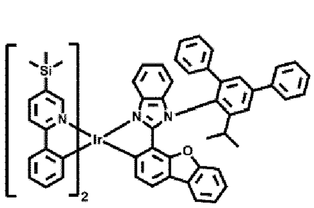
43

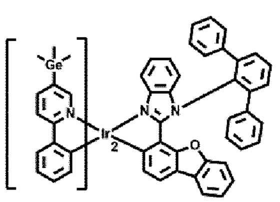
44

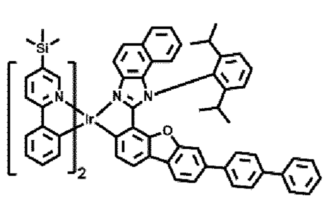
45

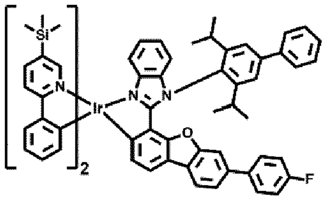

46

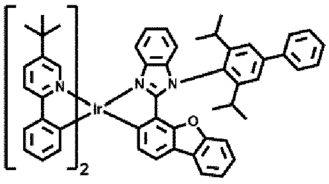

47

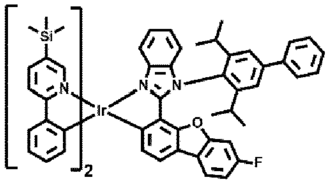

48

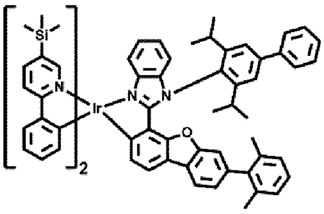

49

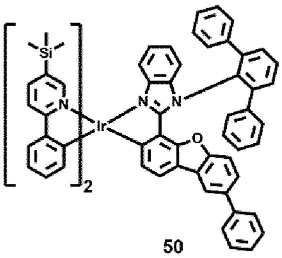

50

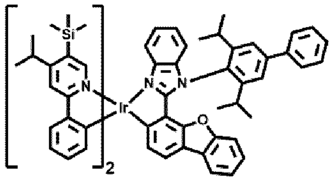

51

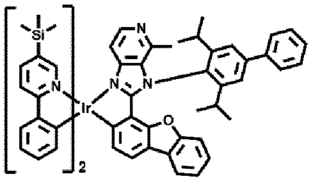

52

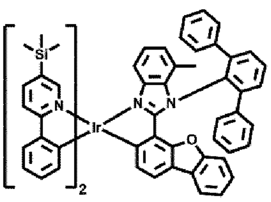

53

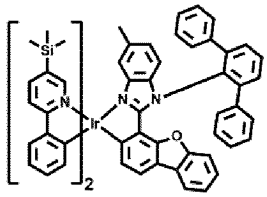

54

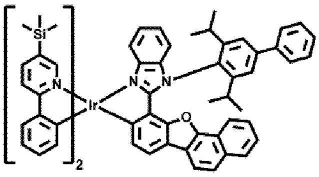

55

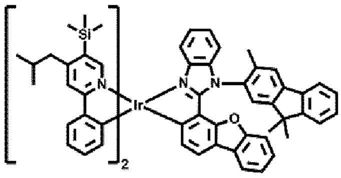

56

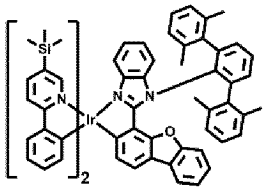

57

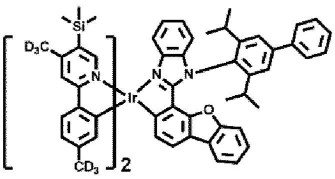

58

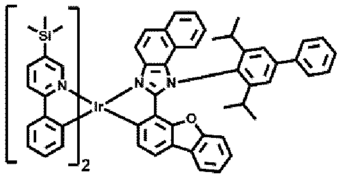

59

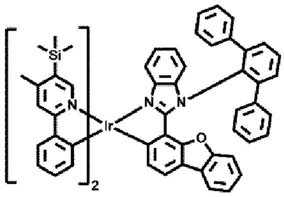

60

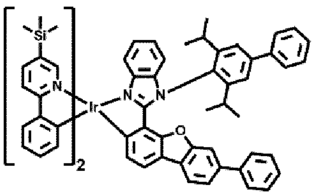

61

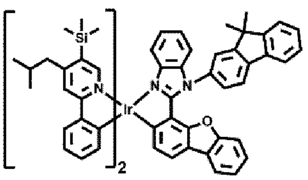

62

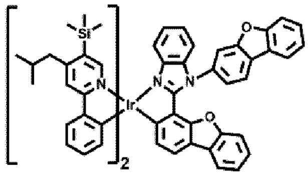

63

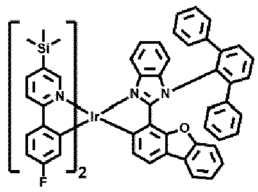
64

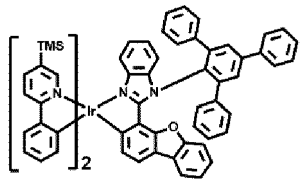
65

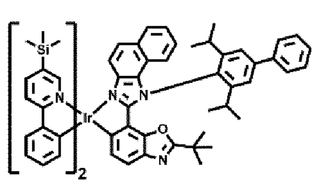
66

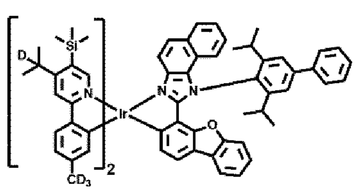
67

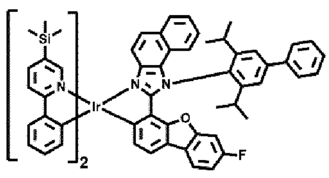
68

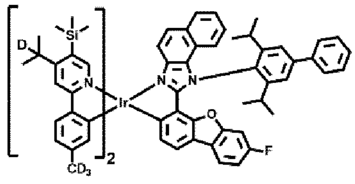
69

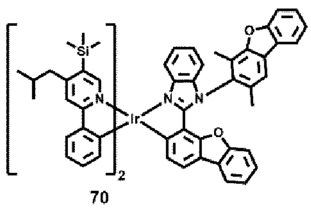
70

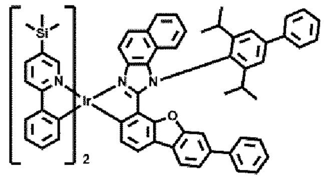
71

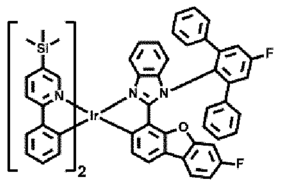
72

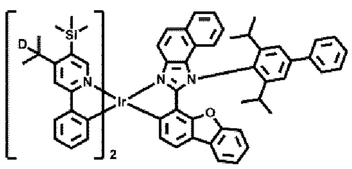
73

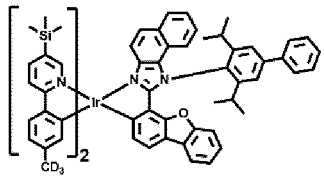
74

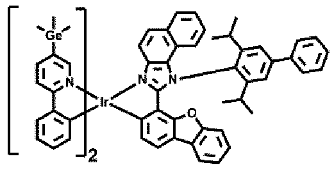
75

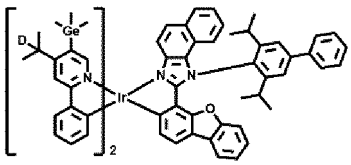
76

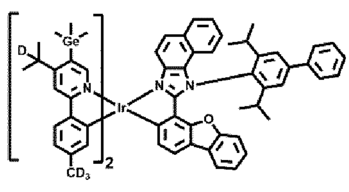
77

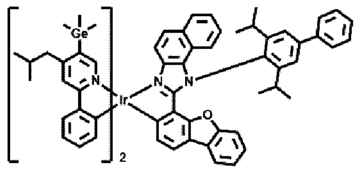
78

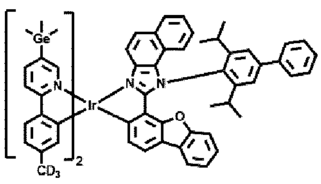
79

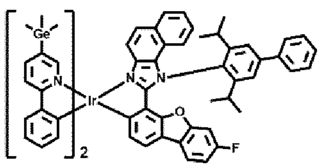
80

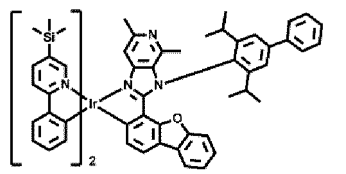
81

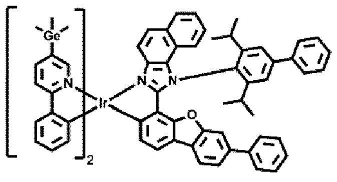

82

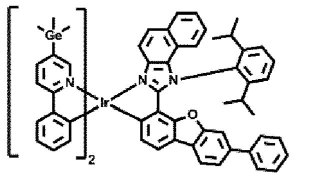

83

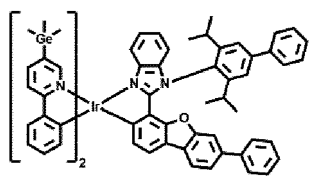

84

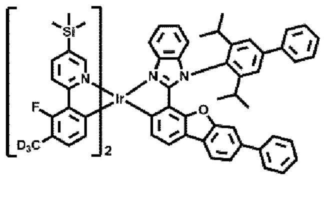

85

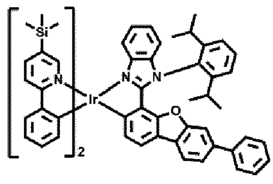

86

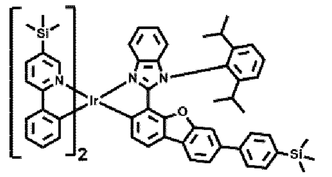

87

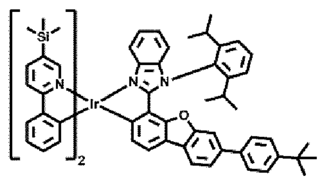

88

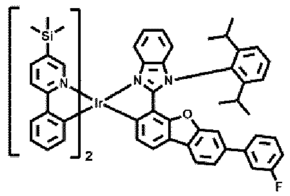

89

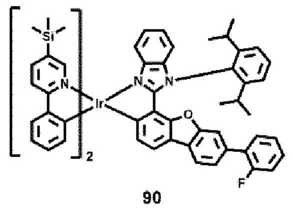

90

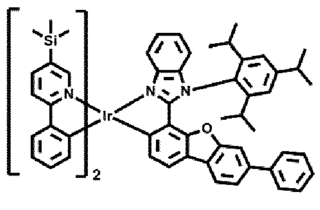

91

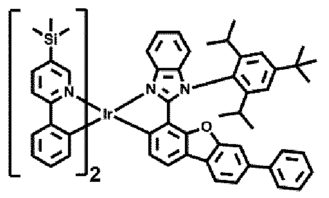

92

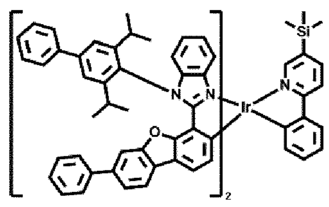

93

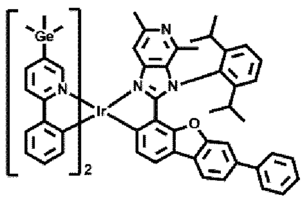

94

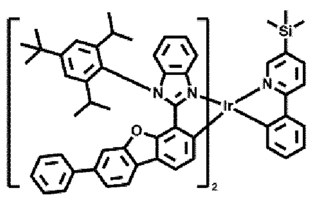

95

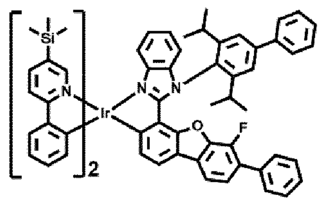

96

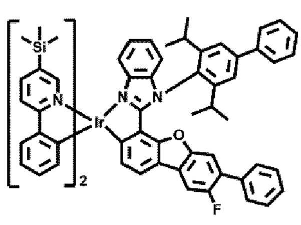

97

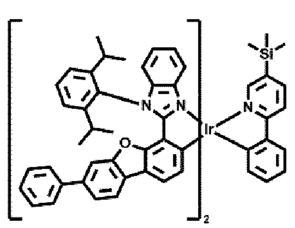

98

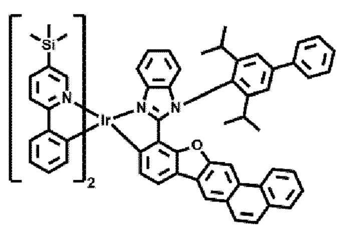

99

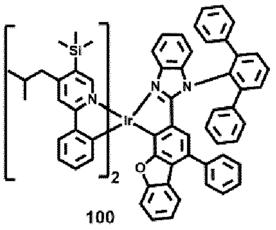

100

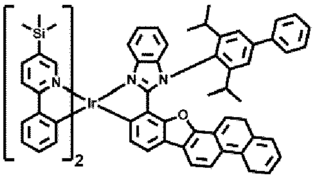

101

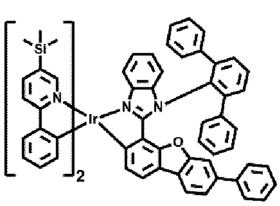

102

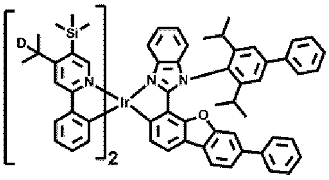

103

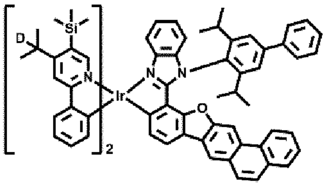

104

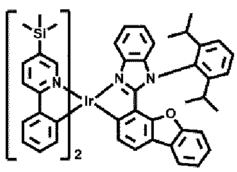

105

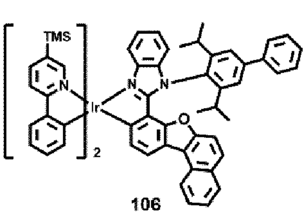

106

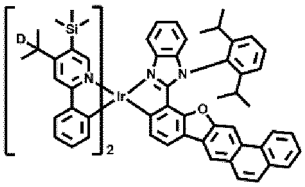

107

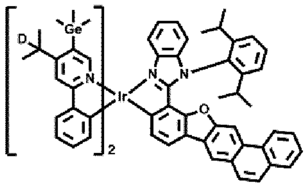

108

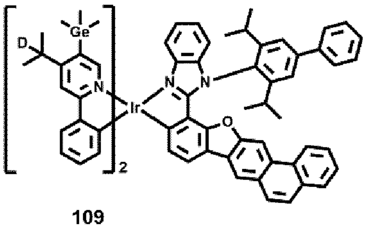

109

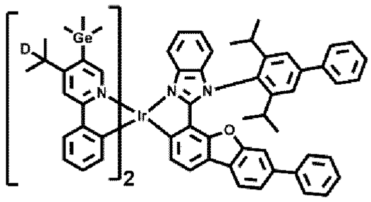

110

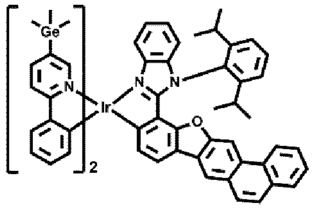

111

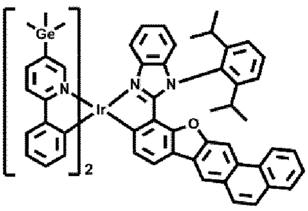

112

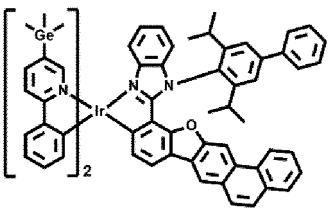

113

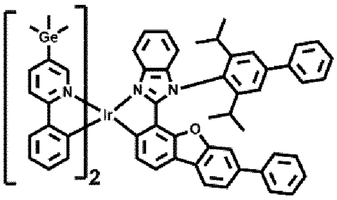

114

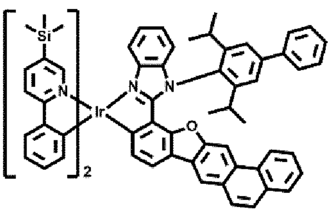

115

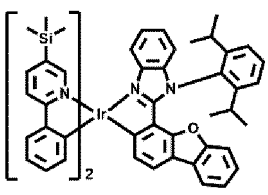

116

Group 2-5

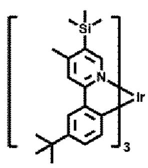

1

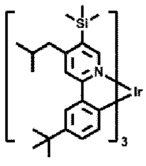

2

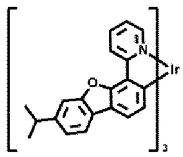

3

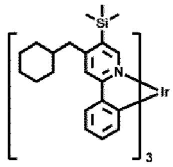

4

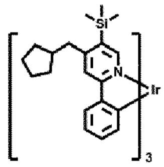

5

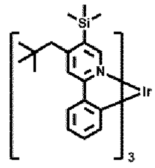

6

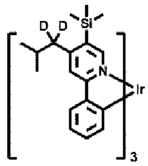

7

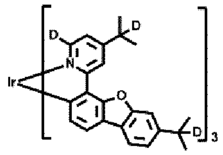

8

As used herein, "OMe" is a methoxy group, "TMS" is a trimethylsilyl group, and "TMG" is a trimethylgermyl group.

The composition including the first compound and the second compound as described herein may emit light having excellent luminescence efficiency and a long lifespan (for example, light having an emission peak wavelength of about 480 nm to about 580 nm or about 510 nm to about 570 nm, for example, green light, yellowish-green light, or yellow light). Accordingly, a layer including the composition, a light-emitting device including the composition, and an electronic device including the light-emitting device may be provided.

Another aspect provides a layer including the composition including the first compound and the second compound.

In one or more embodiments, the layer may emit light having an emission peak wavelength ofat about 480 nm to about 580 nm, for example, about 510 nm to about 570 nm.

In one or more embodiments, the layer may emit green light, yellowish-green light, or yellow light.

In one or more embodiments, the layer may emit light having an emission peak wavelength of about 510 nm to about 540 nm.

In one or more embodiments, the layer may emit light having an emission peak wavelength of about 540 nm to about 570 nm.

In one or more embodiments, a weight ratio of the first compound and the second compound included in the layer may be about 90:10 to about 10:90, about 80:20 to about 20:80, about 70:30 to about 30:70, or about 60:40 to about 40:60.

In one or more embodiments, the weight ratio of the first compound and the second compound included in the layer may be about 50:50, that is, 1:1.

In one or more embodiments, the layer may be formed by i) co-depositing the first compound and the second compound, or ii) using a first mixture including the first compound and the second compound.

In one or more embodiments, the layer may include a host and a dopant, wherein the host does not include a transition metal, and the dopant may include the composition including the first compound and the second compound. In one or more embodiments, the layer may be formed by i) co-depositing the host and the dopant, or ii) using a second mixture including the host and the dopant.

In the layer, an amount of the host may be greater than that of the dopant.

For example, a weight ratio of the host and the dopant in the layer may be about 99:1 to about 55:45, about 97:3 to about 60:40, or about 95:5 to about 70:30.

The host in the layer may include a hole-transporting compound, an electron-transporting compound, a bipolar compound, or a combination thereof.

Another aspect provides a light-emitting device including a first electrode; a second electrode; and an organic layer arranged between the first electrode and the second electrode, wherein the organic layer includes an emission layer, and wherein the organic layer includes the composition including the first compound and the second compound.

The light-emitting device may have excellent driving voltage, excellent external quantum efficiency, and excellent lifetime characteristics by including the composition including the first compound and the second compound as described above.

In one or more embodiments, the emission layer included in the organic layer of the light-emitting device may include the composition including the first compound and the second compound.

In one or more embodiments, the emission layer may include a host and a dopant, wherein the host may not include a transition metal, and the dopant may include the composition described herein.

The host included in the emission layer may include a hole-transporting compound, an electron-transporting compound, a bipolar compound, or a combination thereof.

For example, the host may include a hole-transporting compound and an electron-transporting compound, wherein the hole-transporting compound and the electron-transporting compound may be different from each other.

The emission layer may be formed by i) co-depositing the host and the dopant, or ii) using a second mixture including the host and the dopant.

The emission layer may emit a third light having a third spectrum, and λP(EML) is an emission peak wavelength (nm) of the third spectrum. For example, the λP(EML) may be evaluated from an electroluminescence spectrum of the light-emitting device.

The light-emitting device may emit a fourth light having a fourth spectrum and extracted to the outside of the light-emitting device through the first electrode and/or the second electrode of the light-emitting device, and λP(OLED) is an emission peak wavelength (nm) of the fourth spectrum. For example, the λP(OLED) may be evaluated from an electroluminescence spectrum of the light-emitting device.

For example, the λP(EML) and the λP(OLED) may each independently be about 480 nm to about 580 nm, for example, about 510 nm to about 570 nm.

In one or more embodiments, the λP(EML) and the λP(OLED) may each independently be about 510 nm to about 540 nm.

In one or more embodiments, the λP(EML) and the λP(OLED) may each independently be about 540 nm to about 570 nm.

In one or more embodiments, each of the third light and the fourth light may be green light, yellowish-green light or yellow light.

In one or more embodiments, each of the third light and the fourth light may not be white light.

In one or more embodiments, regarding the third spectrum, i) a main emission peak having the λP(EML) may be included; but ii) an additional emission peak having an emission peak wavelength of (λP(EML) + 50 nm) or greater, or (λP(EML) - 50 nm) or less may not be included.

In one or more embodiments, regarding the third spectrum, i) a main emission peak having the λP(EML) may be included; but ii) an additional emission peak having an emission peak wavelength in a red light region and/or a blue light region may not be included.

In one or more embodiments, regarding the fourth spectrum, i) a main emission peak having the λP(OLED) may be included; but ii) an additional emission peak having an emission peak wavelength of (λP(OLED) + 50 nm) or greater, or (λP(OLED) - 50 nm) or less may not be included.

In one or more embodiments, regarding the fourth spectrum, i) a main emission peak having the λP(EML) may be included; but ii) an additional emission peak having an emission peak wavelength in a red light region and/or a blue light region may not be included.

In the emission layer,

an absolute value of a difference between λP(Pt) and λP(Ir) is 0 nm to about 30 nm,
an absolute value of difference between λP(EML) and λP(Pt) (or an absolute value of the difference between λP(OLED) and λP(Pt)) may be 0 nm to about 30 nm, and
an absolute value of the difference between λP(EML) and λP(Ir) (or an absolute value of the difference between λP(OLED) and λP(Ir)) may be 0 nm to about 30 nm.

In one or more embodiments,

the absolute value of the difference between λP(Pt) and λP(Ir) may be 0 nm to about 10 nm,
the absolute value of the difference between λP(EML) and λP(Pt) (or the absolute value of the difference between λP(OLED) and λP(Pt)) may be 0 nm to about 10 nm, and
the absolute value of the difference between λP(EML) and λP(Ir) (or the absolute value of the difference between λP(OLED) and λP(Ir)) may be 0 nm to about 10 nm.

In one or more embodiments, in the emission layer,

$$\lambda P(Pt) = \lambda P(Ir) = \lambda P(EML),$$

$$\lambda P(Pt) \leq \lambda P(Ir) < \lambda P(EML),$$

$$\lambda P(Pt) < \lambda P(Ir) \leq \lambda P(EML),$$

$$\lambda P(Ir) \leq \lambda P(Pt) < \lambda P(EML),$$

or

$$\lambda P(Ir) < \lambda P(Pt) \leq \lambda P(EML).$$

In one or more embodiments, in the light-emitting device,

$$\lambda P(Pt) = \lambda P(Ir) = \lambda P(OLED),$$

$$\lambda P(Pt) \leq \lambda P(Ir) < \lambda P(OLED),$$

$$\lambda P(Pt) < \lambda P(Ir) \leq \lambda P(OLED),$$

$$\lambda P(Ir) \leq \lambda P(Pt) < \lambda P(OLED),$$

or

$$\lambda P(Ir) < \lambda P(Pt) \leq \lambda P(OLED).$$

Details on λP(Pt), λP(Ir), λP(EML), and λP(OLED) may be as described herein.

The first electrode may be an anode, which is a hole injection electrode, and the second electrode may be a cathode, which is an electron injection electrode; or the first electrode may be a cathode, which is an electron injection electrode, and the second electrode may be an anode, which is a hole injection electrode.

For example, in the light-emitting device, the first electrode may be an anode, and the second electrode may be a cathode, and the organic layer may further include a hole transport region arranged between the first electrode and the emission layer, and an electron transport region arranged between the emission layer and the second electrode, wherein the hole transport region may include a hole injection layer, a hole transport layer, an electron blocking layer, a buffer layer, or a combination thereof, and the electron transport region may include a hole blocking layer, an electron transport layer, an electron injection layer, or a combination thereof.

The term "organic layer" as used herein refers to a single layer and/or a plurality of layers arranged between the first electrode and the second electrode of the light-emitting device. The "organic layer" may include, in addition to an organic compound, an organometallic complex including a metal.

The FIGURE is a schematic cross-sectional view of a light-emitting device 10 according to one or more embodiments. Hereinafter, a structure and a manufacturing method of a light-emitting device according to one or more embodiments will be described in further detail in connection with the FIGURE. The light-emitting device 10 includes a first electrode 11, an organic layer 15, and a second electrode 19, which are sequentially stacked.

A substrate may be additionally arranged under the first electrode 11 or above the second electrode 19. For use as the substrate, any substrate that is used in light-emitting devices of the related art may be used, and the substrate may be a glass substrate or a transparent plastic substrate, each having excellent mechanical strength, thermal stability, transparency, surface smoothness, ease of handling, and/or water resistance.

The first electrode 11 may be, for example, formed by depositing or sputtering a material for forming the first electrode 11 on the substrate. The first electrode 11 may be an anode. The material for forming the first electrode 11 may include materials with a high work function to facilitate hole injection. The first electrode 11 may be a reflective electrode, a semi-transmissive electrode, or a transmissive electrode. In one or more embodiments, the material for forming the first electrode 11 may be indium tin oxide (ITO), indium zinc oxide (IZO), tin oxide ($SnO_2$), or zinc oxide (ZnO). In one or more embodiments, the material for forming the first electrode 11 may be metal, such as magnesium (Mg), aluminum (Al), silver (Ag), aluminum-lithium (Al-Li), calcium (Ca), magnesium-indium (Mg-In), or magnesium-silver (Mg-Ag).

The first electrode 11 may have a single-layered structure or a multi-layered structure including two or more layers. For example, the first electrode 11 may have a three-layered structure of ITO/Ag/ITO.

The organic layer 15 is arranged on the first electrode 11.

The organic layer 15 may include a hole transport region, an emission layer, and an electron transport region.

The hole transport region may be arranged between the first electrode 11 and the emission layer.

The hole transport region may include a hole injection layer, a hole transport layer, an electron blocking layer, a buffer layer, or a combination thereof.

The hole transport region may include only either a hole injection layer or a hole transport layer. The hole transport region may have a hole injection layer/hole transport layer structure, or a hole injection layer/hole transport layer/electron blocking layer structure, wherein, for each structure, constituting layers are sequentially stacked in this stated order from the first electrode 11.

When the hole-transporting region includes a hole injection layer, the hole injection layer may be formed on the first electrode 11 by using one or more suitable methods, for example, vacuum deposition, spin coating, casting, Langmuir-Blodgett (LB) deposition, and/or inkjet printing.

When the hole injection layer is formed by vacuum deposition, the deposition conditions may vary depending on a material for forming the hole injection layer, and the structure and thermal characteristics of the hole injection layer. For example, the deposition conditions may include a deposition temperature of about 100°C to about 500°C, a vacuum pressure of about $10^{-8}$ torr to about $10^{-3}$ torr, and a deposition rate of about 0.01 angstroms per second (Å/sec) to about 100 Å/sec.

When the hole injection layer is formed by spin coating, the coating conditions may vary depending on a material for forming the hole injection layer, and the structure and thermal characteristics of the hole injection layer. For example, the coating conditions may include a coating speed of about 2,000 revolutions per minute (rpm) to about 5,000 rpm and a heat treatment temperature of about 80°C to about 200°C for removing a solvent after coating.

Conditions for forming the hole transport layer and the electron blocking layer may be similar to or the same as the conditions for forming the hole injection layer.

The hole transport region may include4,4',4"-tris(3-methylphenylphenylamino)triphenylamine (m-MTDATA), 4,4',4"-tris(N,N-diphenylamino)triphenylamine (TDATA), 4,4',4"-tris{N-(2-naphthyl)-N-phenylamino}-triphenylamine (2-TNATA), N,N'-di(1-naphthyl)-N,N'-diphenylbenzidine (NPB), β-NPB, N,N'-bis(3-methylphenyl)-N,N'-diphenyl-[1,1-biphenyl]-4,4'-diamine (TPD), spiro-TPD, spiro-NPB, methylated NPB, 4,4'-cyclohexylidene bis[N,N-bis(4-methylphenyl)benzenamine] (TAPC), 4,4'-bis[N,N'-(3-tolyl)amino]-3,3'-dimethylbiphenyl (HMTPD), 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), a compound represented by Formula 201, a compound represented by Formula 202, or a combination thereof:

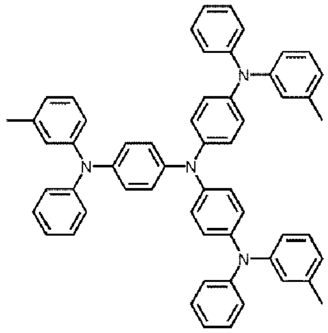

m-MTDATA

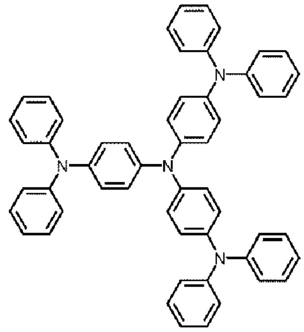

TDATA

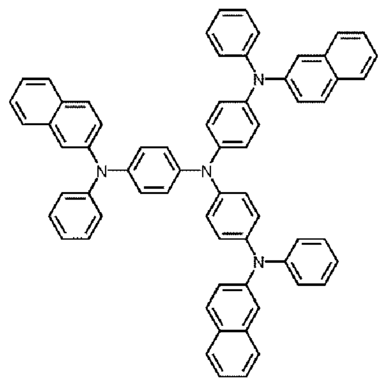

2-TNATA

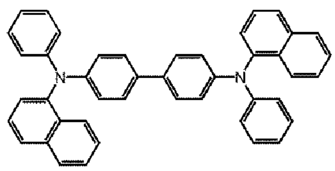

NPB

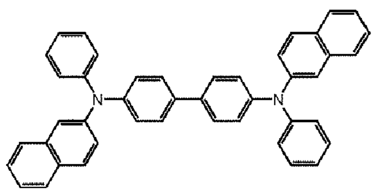

β-NPB

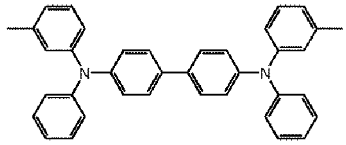

TPD

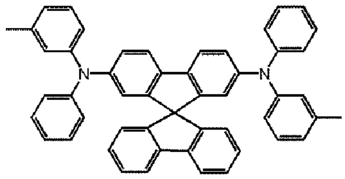

Spiro-TPD

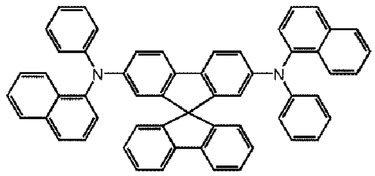

Spiro-NPB

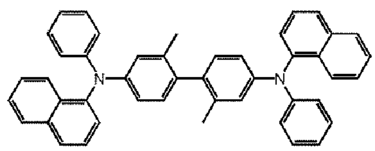

methylated NPB

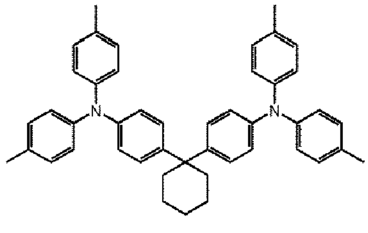

TAPC

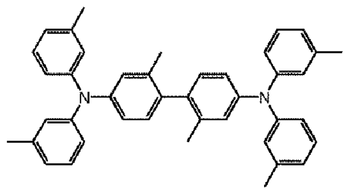

HMTPD

Formula 201

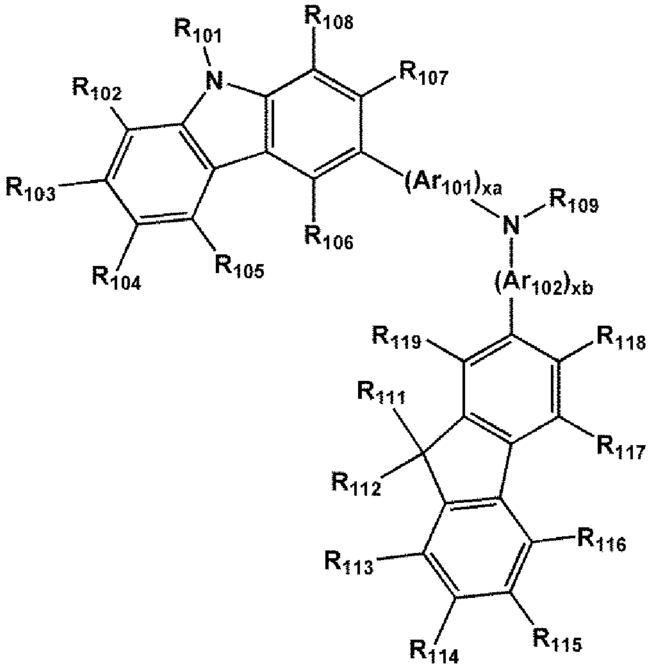

Formula 202

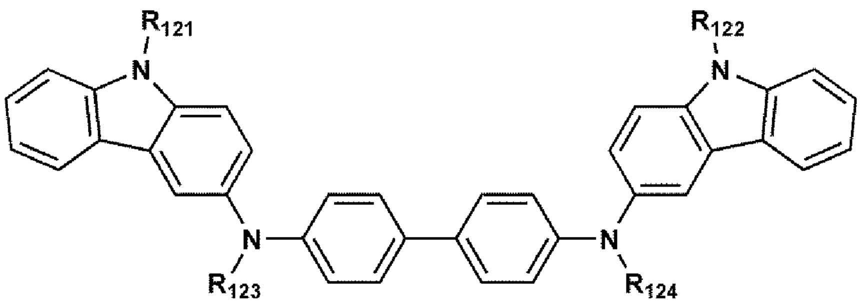

In Formula 201, $Ar_{101}$ and $Ar_{102}$ may each independently be a phenylene group, a pentalenylene group, an indenylene group, a naphthylene group, an azulenylene group, a heptalenylene group, an acenaphthylene group, a

fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group, each unsubstituted or substituted with at least one of deuterium, -F, -Cl, -Br, -I, - $SF_6$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_3$-$C_{10}$ cycloalkenyl group, a $C_1$-$C_{10}$ heterocycloalkyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ heteroaryl alkyl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, or a combination thereof.

In Formula 201, xa and xb may each independently be an integer from 0 to 5, or may be 0, 1, or 2. For example, in Formula 201, xa may be 1, and xb may be 0.

In Formulae 201 and 202, $R_{101}$ to $R_{108}$, $R_{111}$ to $R_{119}$, and $R_{121}$ to $R_{124}$ may each independently be:

hydrogen, deuterium, -F, -Cl, -Br, -I, -$SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group (for example, a methyl group, an ethyl group, a propyl group, a butyl group, a pentyl group, a hexyl group, or the like), a $C_1$-$C_{10}$ alkoxy group (for example, a methoxy group, an ethoxy group, a propoxy group, a butoxy group, a pentoxy group, or the like), or a $C_1$-$C_{10}$ alkylthio group;

a $C_1$-$C_{10}$ alkyl group, a $C_1$-$C_{10}$ alkoxy group, or a $C_1$-$C_{10}$ alkylthio group, each unsubstituted or substituted with at least one of deuterium, -F, -Cl, -Br, -I, -$SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, or a combination thereof; or

a phenyl group, a naphthyl group, an anthracenyl group, a fluorenyl group or a pyrenyl group, each unsubstituted or substituted with at least one of deuterium, -F, -Cl, - Br, -I, -$SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a $C_1$-$C_{10}$ alkoxy group, a $C_1$-$C_{10}$ alkylthio group, or a combination thereof.

In Formula 201, $R_{109}$ may be a phenyl group, a naphthyl group, an anthracenyl group, or a pyridinyl group, each substituted or unsubstituted with at least one of deuterium, -F, -Cl, -Br, -I, -SFs, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a $C_1$-$C_{20}$ alkylthio group, a phenyl group, a naphthyl group, an anthracenyl group, a pyridinyl group, or a combination thereof.

In one or more embodiments, the compound represented by Formula 201 may be represented by Formula 201A:

Formula 201A

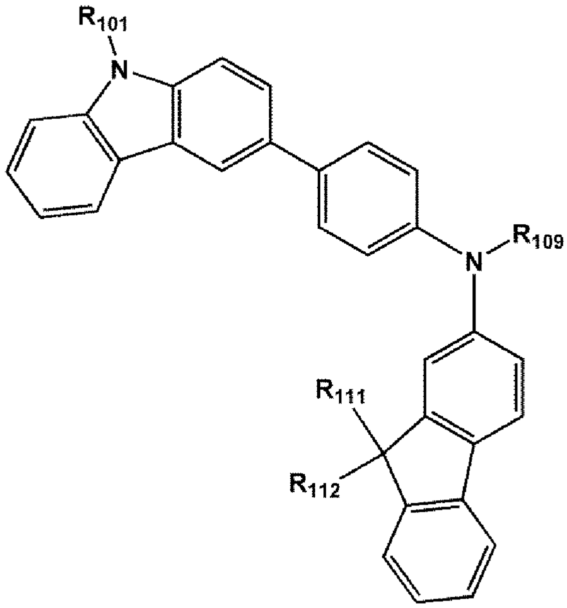

wherein, in Formula 201A, $R_{101}$, $R_{111}$, $R_{112}$, and $R_{109}$ may each be as described herein.

For example, the hole transport region may include one of Compounds HT1 to HT20, or a combination thereof:

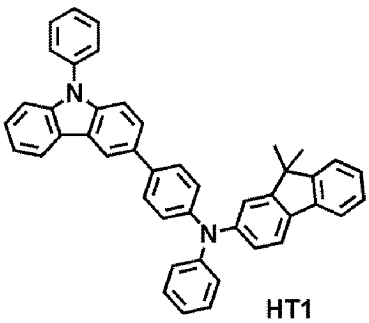

HT1

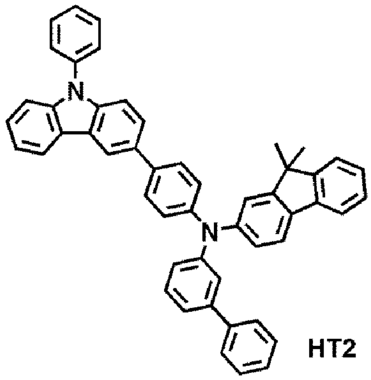

HT2

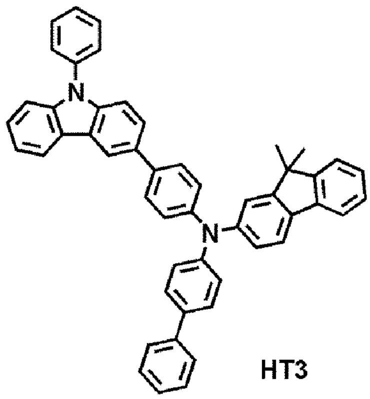

HT3

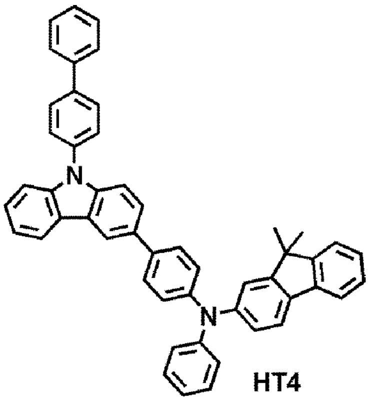

HT4

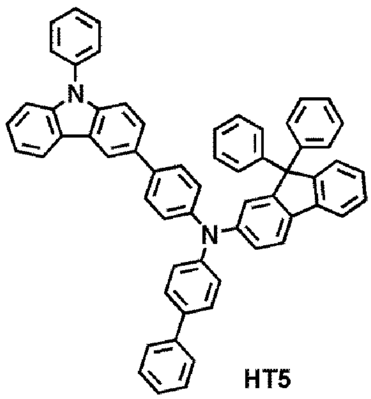

HT5

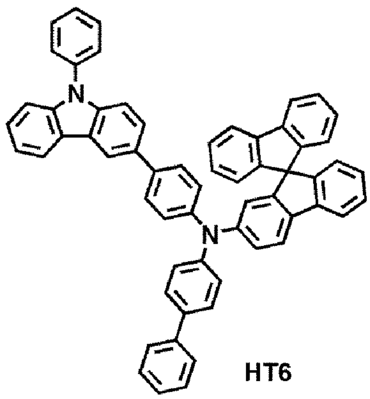

HT6

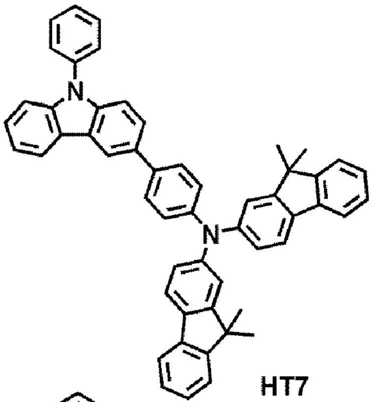

HT7

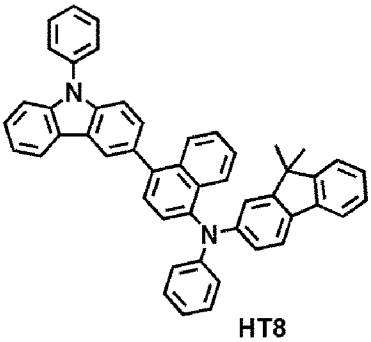

HT8

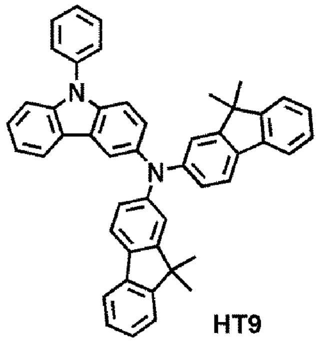

HT9

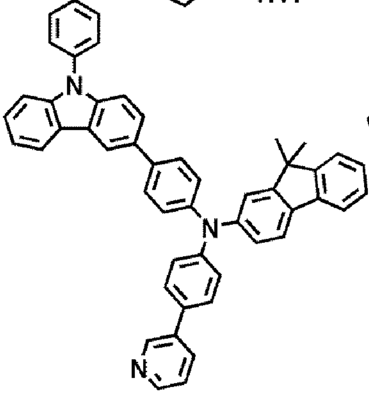

HT10

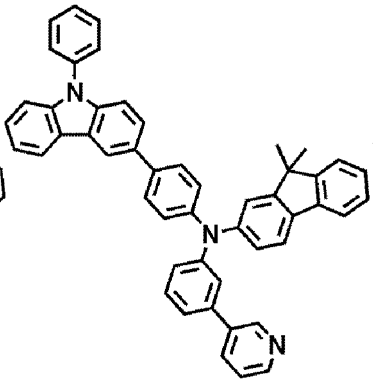

HT11

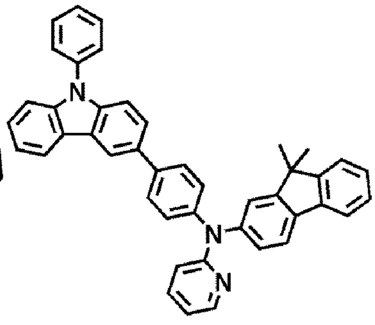

HT12

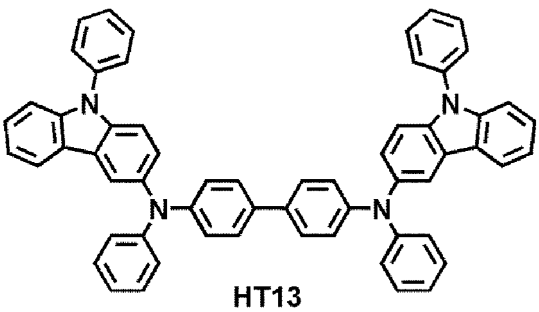

HT13

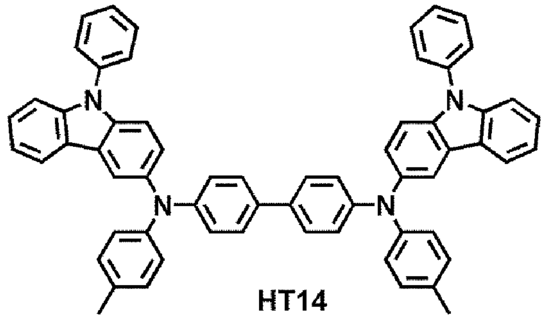

HT14

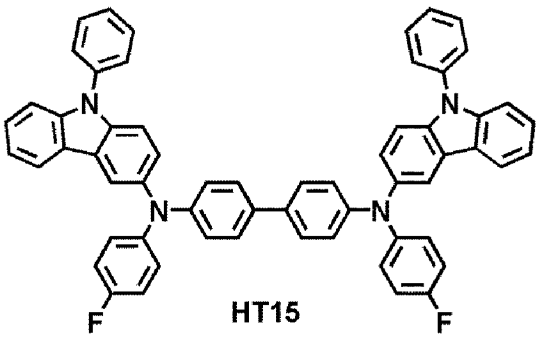

HT15

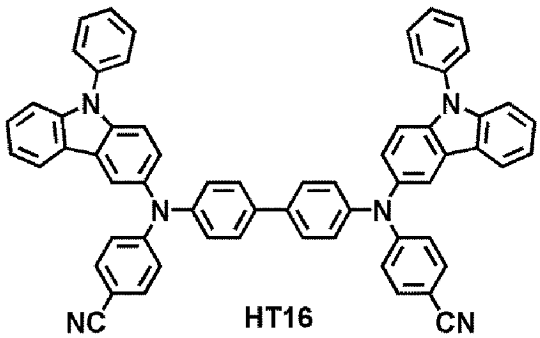

HT16

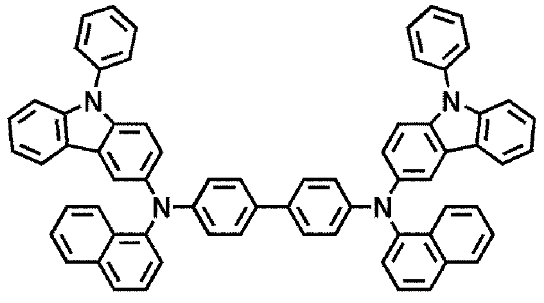

HT17

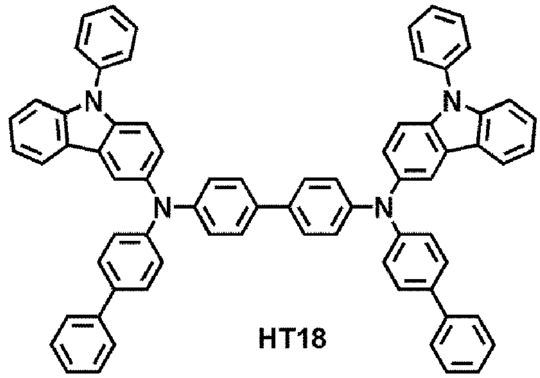

HT18

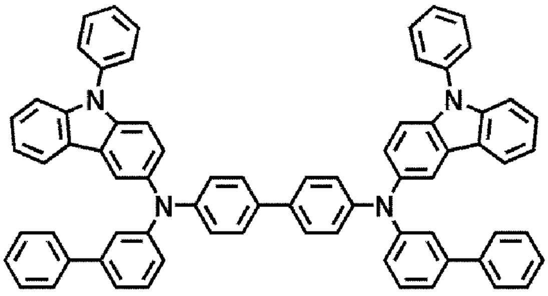

HT19

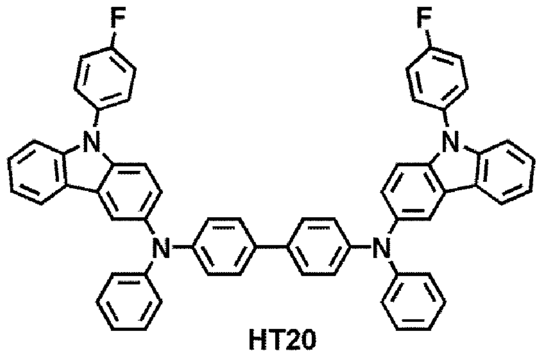

HT20

A thickness of the hole transport region may be about 100 angstroms (Å) to about 10,000 Å, for example, about 100 Å to about 1,000 Å. When the hole transport region includes a hole injection layer, a hole transport layer, an electron blocking layer, or a combination thereof, a thickness of the hole injection layer may be about 100 Å to about 10,000 Å, for example, about 100 Å to about 1,000 Å, and a thickness of the hole transport layer may be about 50 Å to about 2,000 Å, for example, about 100 Å to about 1,500 Å. When the thicknesses of the hole transport region, the hole injection layer, and the hole transport layer are within these ranges, satisfactory hole transporting characteristics may be obtained without a substantial increase in driving voltage.

The hole transport region may further include, in addition to these materials, a charge-generation material for the improvement of conductive properties. The charge-generation material may be homogeneously or non-homogeneously dispersed in the hole transport region.

The charge-generation material may be, for example, a p-dopant. The p-dopant may be a quinone derivative, a metal oxide, a cyano group-containing compound, or a combination thereof. For example, the p-dopant may be: a quinone derivative, such as tetracyanoquinodimethane (TCNQ), 2,3,5,6-tetrafluoro-tetracyano-1,4-benzoquinonedimethane (F4-TCNQ), F6-TCNNQ, or the like; metal oxide, such as tungsten oxide, molybdenum oxide, or the like; a cyano group-containing compound, such as Compound HT-D1 or the like; or a combination thereof:

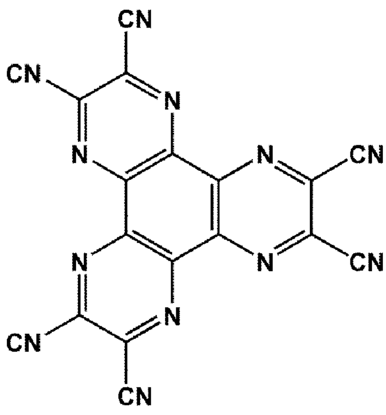

HT-D1

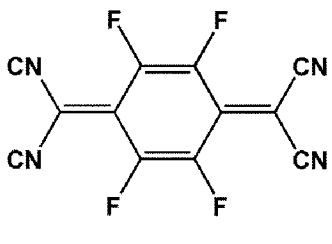

F4-TCNQ

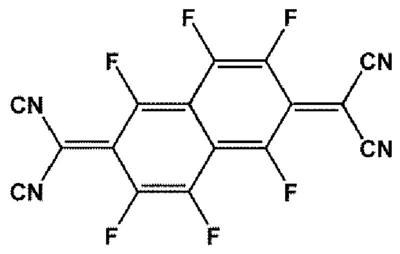

F6-TCNNQ

The hole transport region may further include a buffer layer.

The buffer layer may compensate for an optical resonance distance according to a wavelength of light emitted from the emission layer, and thus, efficiency of a formed light-emitting device may be improved.

Meanwhile, when the hole transport region includes an electron blocking layer, a material for forming the electron blocking layer may include a material that is used in the hole transport region as described above, a host material described below, or a combination thereof. For example, when the hole transport region includes an electron blocking layer, the material for forming the electron blocking layer may include mCP described below, Compound H-H1 described below, or a combination thereof.

Then, the emission layer 15 may be formed on the hole transport region by using methods, such as vacuum deposition, spin coating, casting, LB deposition, inkjet printing, or the like. When the emission layer is formed by vacuum deposition or spin coating, the deposition or coating conditions may be similar to those applied in forming the hole injection layer although the deposition or coating conditions may vary depending on a material that is used to form the emission layer.

In one or more embodiments, the emission layer may include the composition including the first compound and the second compound as described herein. In one or more embodiments, the emission layer may include a layer including the composition including the first compound and the second compound as described herein.

In one or more embodiments, the emission layer may include a host and a dopant, wherein the host does not include a transition metal, and the dopant includes the composition including the first compound and the second compound as described herein.

The host may include 1,3,5-tri(1-phenyl-1H-benzo[d]imidazol-2-yl)benzene (TPBi), 3-tert-butyl-9,10-di(naphth-2-yl)anthracene (TBADN), 9,10-di(naphthalen-2-yl)anthracene (ADN) (also referred to as "DNA"), 4,4'-bis(N-carbazolyl)-1,1'-biphenyl (CBP), 4,4'-bis(9-carbazolyl)-2,2'-dimethyl-biphenyl (CDBP), 1,3,5-tris(carbazole-9-yl) benzene (TCP), 1,3-bis(N-carbazolyl)benzene (mCP), Compound H50, Compound H51, Compound H52, Compound H-H1, Compound H-H2, or a combination thereof:

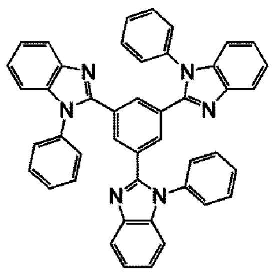

TPBi

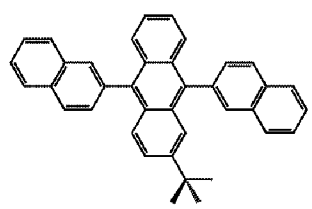

TBADN

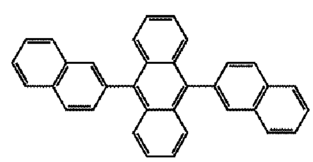

ADN

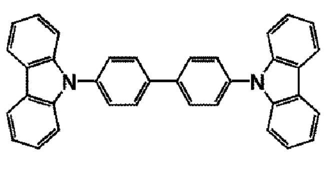

CBP

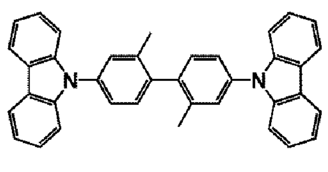

CDBP

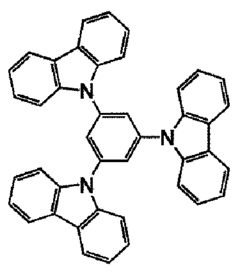

TCP

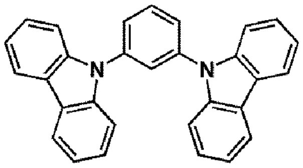

mCP

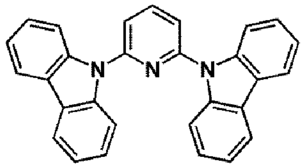

H50

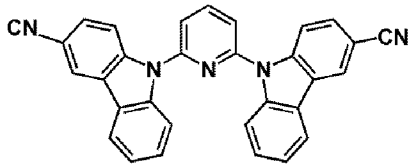

H51

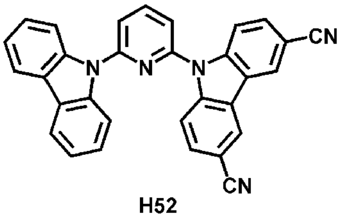

H52

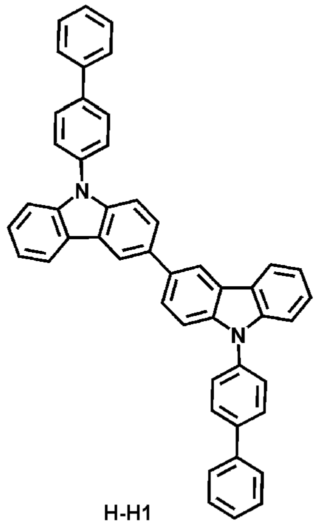

H-H1

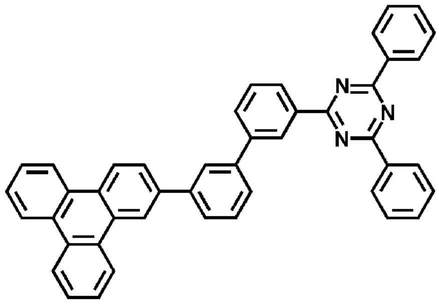

H-H2

When the light-emitting device 10 is a full-color light-emitting device, the emission layer may be patterned into a red emission layer, a green emission layer, and/or a blue emission layer.

A thickness of the emission layer may be about 100 Å to about 1,000 Å, for example, about 200 Å to about 600 Å. When the thickness of the emission layer is within these ranges, excellent light-emission characteristics may be obtained without a substantial increase in driving voltage.

Next, the electron transport region may be arranged on the emission layer.

The electron transport region may include a hole blocking layer, an electron transport layer, an electron injection layer, or a combination thereof.

For example, the electron transport region may have a hole blocking layer/electron transport layer/electron injection layer structure or an electron transport layer/electron injection layer structure. The electron transport layer may have a single-layered structure or a multi-layered structure including two or more different materials.

Conditions for forming a hole blocking layer, an electron transport layer, and an electron injection layer which constitute the electron transport region may be understood by referring to the conditions for forming the hole injection layer.

When the electron transport region includes a hole blocking layer, the hole blocking layer may include, for example, 2,9-dimethyl-4,7-diphenyl-1,10-phenanthroline (BCP), 4,7-diphenyl-1,10-phenanthroline (Bphen), bis(2-methyl-8-quinolinolato-N1,O8)-(1,1'-biphenyl-4-olato)aluminum (BAlq), or a combination thereof:

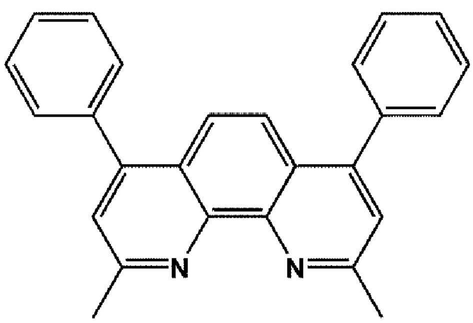

BCP

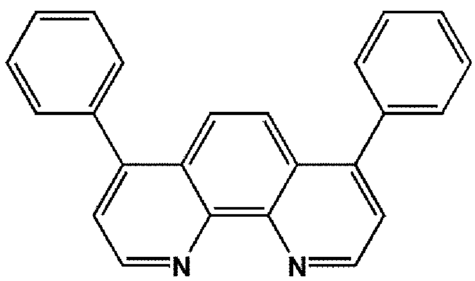

Bphen

A thickness of the hole blocking layer may be about 20 Å to about 1,000 Å, for example, about 30 Å to about 600 Å. When the thickness of the hole blocking layer is within these ranges, excellent hole blocking characteristics may be obtained without a substantial increase in driving voltage.

In one or more embodiments, the electron transport layer may include BCP, Bphen, TPBi, tris(8-hydroxyquinolinato)aluminum ($Alq_3$), BAlq, 3-(4-biphenylyl)-4-phenyl-5-tert-butylphenyl-1,2,4-triazole (TAZ), 4-(naphthalen-1-yl)-3,5-diphenyl-4H-1,2,4-triazole (NTAZ), or a combination thereof:

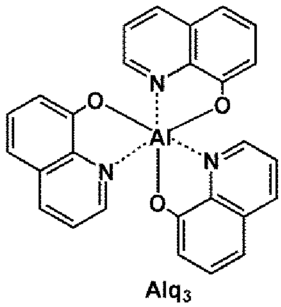

$Alq_3$

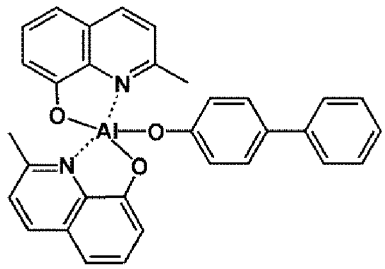

BAlq

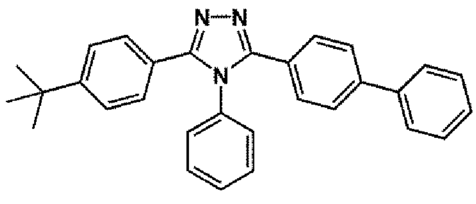

TAZ

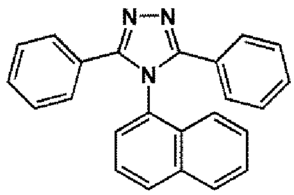

NTAZ

In one or more embodiments, the electron transport layer may include one of Compounds ET1 to ET25, or a combination thereof:

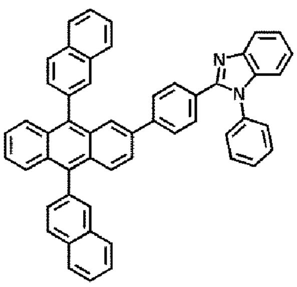

ET1

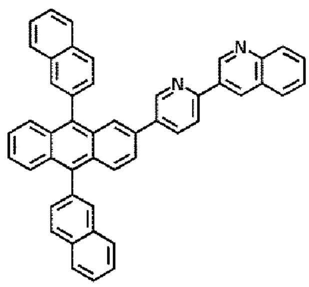

ET2

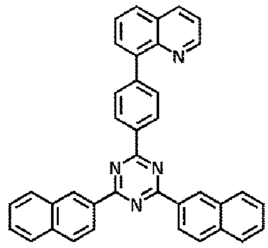

ET3

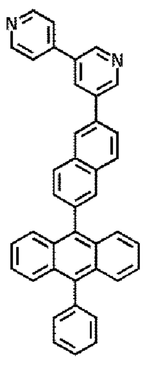

ET4

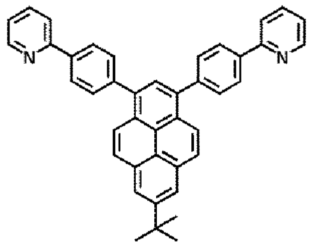

ET5

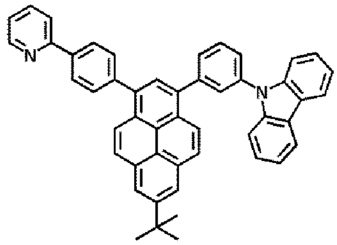

ET6

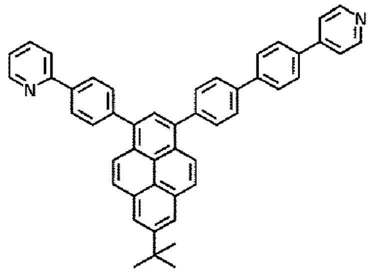

ET7

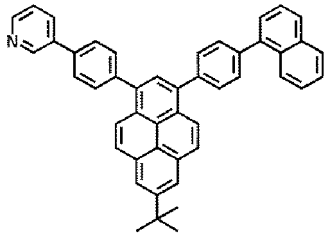

ET8

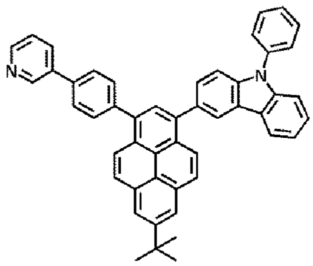

ET9

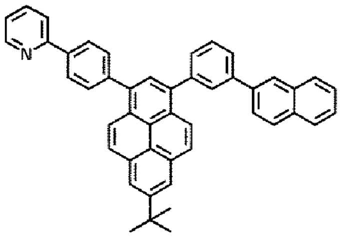

ET10

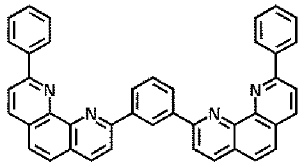

ET11

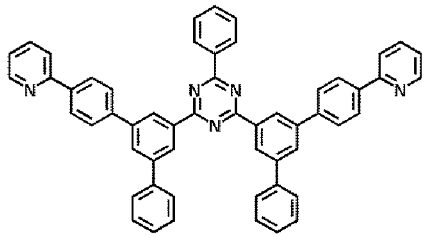

ET12

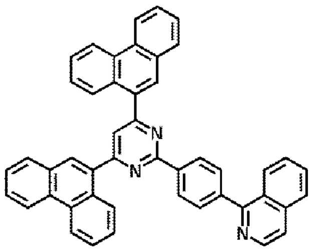

ET13

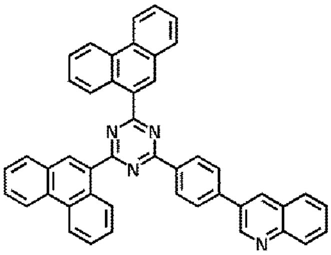

ET14

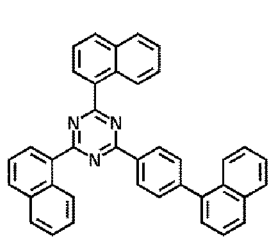

ET15

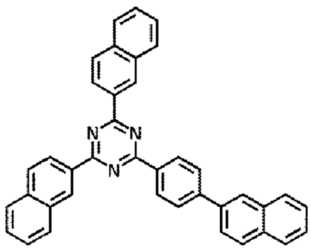

ET16

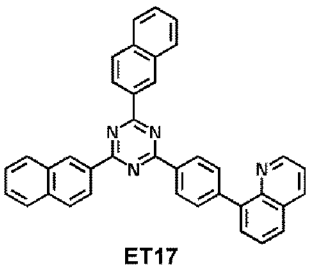

ET17

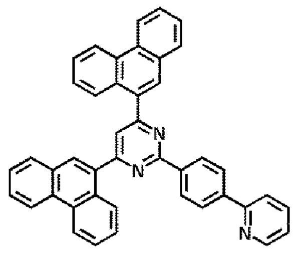

ET18

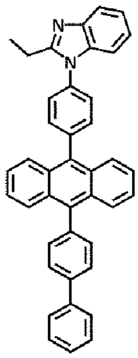

ET19

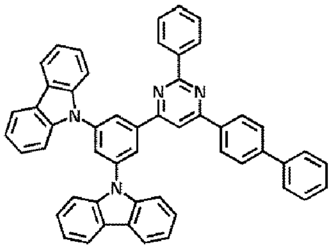

ET20

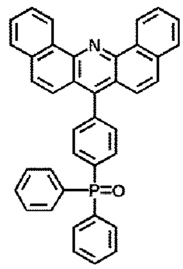

ET21

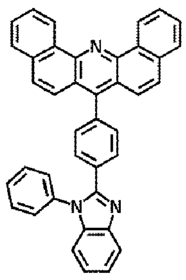

ET22

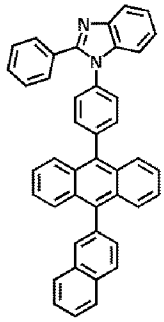

ET23

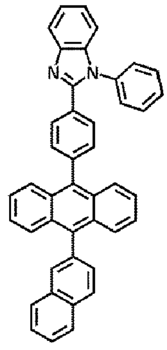

ET24

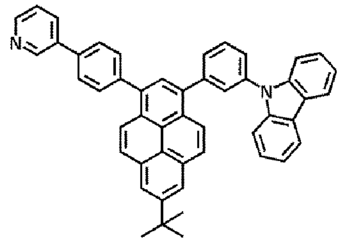

ET25

A thickness of the electron transport layer may be about 100 Å to about 1,000 Å, for example, about 150 Å to about 500 Å. When the thickness of the electron transport layer is within these ranges, satisfactory electron transporting characteristics may be obtained without a substantial increase in driving voltage.

The electron transport layer may include a metal-containing material in addition to the material as described above.

The metal-containing material may include a Li complex. The Li complex may include, for example, Compound ET-D1 or ET-D2:

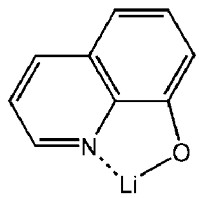

ET-D1

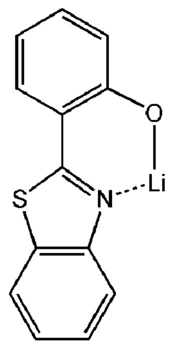

ET-D2

The electron transport region may also include an electron injection layer that promotes the flow of electrons from the second electrode 19 thereinto.

The electron injection layer may include LiF, NaCl, CsF, $Li_2O$, BaO, Yb, Compound ET-D1, Compound ET-D2, or a combination thereof.

A thickness of the electron injection layer may be about 1 Å to about 100 Å, and, for example, about 3 Å to about 90 Å. When the thickness of the electron injection layer is within these ranges, satisfactory electron injection characteristics may be obtained without a substantial increase in driving voltage.

The second electrode 19 may be arranged on the organic layer 15. The second electrode 19 may be a cathode. A material for forming the second electrode 19 may be metal, an alloy, an electrically conductive compound, or a combination thereof, which have a relatively low work function. For example, the material for forming the second electrode 19 may be Li, Mg, Al, Ag, Al-Li, Ca, Mg-In, Mg-Ag, or the like. To manufacture a top-emission type light-emitting device, various modifications are possible, and for example, a transmissive electrode formed using ITO or IZO may be used as the second electrode 19.

Hereinbefore, the light-emitting device 10 according to one or more embodiments has been described in connection with the FIGURE, but embodiments are not limited thereto.

For example, the light-emitting device may be included in an electronic apparatus. Thus, another aspect provides an electronic apparatus including the light-emitting device. The electronic apparatus may include, for example, a display, an illumination, a sensor, or the like.

The term "$C_1$-$C_{60}$ alkyl group" as used herein refers to a linear or branched saturated aliphatic hydrocarbons monovalent group having 1 to 60 carbon atoms, and the term "$C_1$-$C_{60}$ alkylene group" as used herein refers to a divalent group having the same structure as the $C_1$-$C_{60}$ alkyl group.

Non-limiting examples of the $C_1$-$C_{60}$ alkyl group, the $C_1$-$C_{20}$ alkyl group, and/or the $C_1$-$C_{10}$ alkyl group are a methyl group, an ethyl group, an n-propyl group, an isopropyl group, an n-butyl group, a sec-butyl group, an isobutyl group,

a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, or a tert-decyl group, each unsubstituted or substituted with at least one of methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, or a combination thereof. For example, Formula 9-33 is a branched $C_6$ alkyl group, and an example thereof is a tert-butyl group that is substituted with two methyl groups.

The term "$C_1$-$C_{60}$ alkoxy group" as used herein refers to a monovalent group represented by $-OA_{101}$ (wherein $A_{101}$ is the $C_1$-$C_{60}$ alkyl group), and non-limiting examples thereof are a methoxy group, an ethoxy group, a propoxy group, a butoxy group, and a pentoxy group.

The term "$C_1$-$C_{60}$ alkylthio group" as used herein refers to a monovalent group represented by $-SA_{101}$ (wherein $A_{101}$ is the $C_1$-$C_{60}$ alkyl group).

The term "$C_2$-$C_{60}$ alkenyl group" as used herein refers to a hydrocarbon group formed by substituting at least one carbon-carbon double bond in the middle or at the terminus of the $C_2$-$C_{60}$ alkyl group, and non-limiting examples thereof are an ethenyl group, a propenyl group, and a butenyl group. The term "$C_2$-$C_{60}$ alkenylene group" as used herein refers to a divalent group having the same structure as the $C_2$-$C_{60}$ alkenyl group.

The term "$C_2$-$C_{60}$ alkynyl group" as used herein refers to a hydrocarbon group formed by substituting at least one carbon-carbon triple bond in the middle or at the terminus of the $C_2$-$C_{60}$ alkyl group, and non-limiting examples thereof are an ethynyl group and a propynyl group. The term "$C_2$-$C_{60}$ alkynylene group" as used herein refers to a divalent group having the same structure as the $C_2$-$C_{60}$ alkynyl group.

The term "$C_3$-$C_{10}$ cycloalkyl group" as used herein refers to a monovalent saturated hydrocarbon cyclic group having 3 to 10 carbon atoms, and the term "$C_3$-$C_{10}$ cycloalkylene group" as used herein refers to a divalent group having the same structure as the $C_3$-$C_{10}$ cycloalkyl group.

Non-limiting examples of the $C_3$-$C_{10}$ cycloalkyl group are a cyclopropyl group, a cyclobutyl group, a cyclopentyl, cyclohexyl group, a cycloheptyl group, a cyclooctyl group, an adamantanyl group, a norbornanyl group (or a bicyclo[2.2.1] heptyl group), a bicyclo[1.1.1]pentyl group, a bicyclo[2.1.1]hexyl group, and a bicyclo[2.2.2]octyl group.

The term "$C_1$-$C_{10}$ heterocycloalkyl group" as used herein refers to a saturated monovalent cyclic group that includes at least one heteroatom selected from N, O, P, Si, S, Se, Ge, and B as a ring-forming atom(s) and 1 to 10 carbon atoms as ring forming atom(s), and the term $C_1$-$C_{10}$ heterocycloalkylene group" as used herein refers to a divalent group having the same structure as the $C_1$-$C_{10}$ heterocycloalkyl group.

Non-limiting examples of the $C_1$-$C_{10}$ heterocycloalkyl group are a silolanyl group, a silinanyl group, a tetrahydrofuranyl group, a tetrahydro-2H-pyranyl group, and a tetrahydrothiophenyl group.

The term "$C_3$-$C_{10}$ cycloalkenyl group" as used herein refers to a monovalent monocyclic group that includes 3 to 10 carbon atoms and at least one carbon-carbon double bond in the ring thereof and has no aromaticity, and non-limiting examples thereof are a cyclopentenyl group, a cyclohexenyl group, and a cycloheptenyl group. The term "$C_3$-$C_{10}$ cycloalkenylene group" as used herein refers to a divalent group having the same structure as the $C_3$-$C_{10}$ cycloalkenyl group.

The term "$C_1$-$C_{10}$ heterocycloalkenyl group" as used herein refers to a monovalent monocyclic group that includes at least one heteroatom selected from N, O, P, Si, S, Se, Ge, and B as a ring-forming atom, 1 to 10 carbon atoms as ring forming atom(s), and at least one carbon-carbon double bond in the ring thereof. Non-limiting examples of the $C_1$-$C_{10}$ heterocycloalkenyl group are a 2,3-dihydrofuranyl group and a 2,3-dihydrothiophenyl group. The term "$C_1$-$C_{10}$ heterocycloalkenylene group" as used herein refers to a divalent group having the same structure as the $C_1$-$C_{10}$ heterocycloalkenyl group.

The term "$C_6$-$C_{60}$ aryl group" as used herein refers to a monovalent group having a carbocyclic aromatic system having 6 to 60 carbon atoms, and the term "$C_6$-$C_{60}$ arylene group" as used herein refers to a divalent group having a carbocyclic aromatic system having 6 to 60 carbon atoms. Non-limiting examples of the $C_6$-$C_{60}$ aryl group are a phenyl group, a naphthyl group, an anthracenyl group, a phenanthrenyl group, a pyrenyl group, and a chrysenyl group. When the $C_6$-$C_{60}$ aryl group and the $C_6$-$C_{60}$ arylene group each include two or more rings, the rings may be fused to each other.

The term "$C_7$-$C_{60}$ alkyl aryl group" as used herein refers to a $C_6$-$C_{60}$ aryl group substituted with at least one $C_1$-$C_{60}$ alkyl group. The term "$C_7$-$C_{60}$ aryl alkyl group" as used herein refers to a $C_1$-$C_{60}$ alkyl group substituted with at least one $C_6$-$C_{60}$ aryl group.

The term "$C_1$-$C_{60}$ heteroaryl group" as used herein refers to a monovalent group that includes at least one heteroatom selected from N, O, P, Si, S, Se, Ge, and B as a ring-forming atom and a cyclic aromatic system having 1 to 60

carbon atoms as ring forming atom(s), and the term "$C_1$-$C_{60}$ heteroarylene group" as used herein refers to a divalent group having the same structure has the $C_1$-$C_{60}$ heteroaryl group described herein. Non-limiting examples of the $C_1$-$C_{60}$ heteroaryl group are a pyridinyl group, a pyrimidinyl group, a pyrazinyl group, a pyridazinyl group, a triazinyl group, a quinolinyl group, and an isoquinolinyl group. When the $C_6$-$C_{60}$ heteroaryl group and the $C_6$-$C_{60}$ heteroarylene group each include two or more rings, the rings may be fused to each other.

The term "$C_2$-$C_{60}$ alkyl heteroaryl group" as used herein refers to a $C_1$-$C_{60}$ heteroaryl group substituted with at least one $C_1$-$C_{60}$ alkyl group. The term "$C_2$-$C_{60}$ heteroaryl alkyl group" as used herein refers to a $C_1$-$C_{60}$ alkyl group substituted with at least one $C_1$-$C_{60}$ heteroaryl group.

The term "$C_6$-$C_{60}$ aryloxy group" as used herein indicates -$OA_{102}$ (wherein $A_{102}$ is the $C_6$-$C_{60}$ aryl group), and the term "$C_6$-$C_{60}$ arylthio group" as used herein indicates - $SA_{103}$ (wherein $A_{103}$ is the $C_6$-$C_{60}$ aryl group).

The term "$C_1$-$C_{60}$ heteroaryloxy group" as used herein indicates -$OA_{102'}$ (wherein $A_{102'}$ is the $C_1$-$C_{60}$ heteroaryl group), and the term "$C_1$-$C_{60}$ heteroarylthio group" as used herein indicates -$SA_{103'}$ (wherein $A_{103'}$ is the $C_1$-$C_{60}$ heteroaryl group).

The term "monovalent non-aromatic condensed polycyclic group" as used herein refers to a monovalent group (for example, having 8 to 60 carbon atoms) having two or more rings condensed to each other, only carbon atoms as ring-forming atoms, and no aromaticity in its entire molecular structure. A non-limiting example of the monovalent non-aromatic condensed polycyclic group is a fluorenyl group. The term "divalent non-aromatic condensed polycyclic group" as used herein refers to a divalent group having the same structure as the monovalent non-aromatic condensed polycyclic group described herein.

The term "monovalent non-aromatic condensed heteropolycyclic group" as used herein refers to a monovalent group (for example, having 1 to 60 carbon atoms) having two or more rings condensed to each other, at least one heteroatom selected from N, O, P, Si, S, Se, Ge, and B, other than carbon atoms, as a ring-forming atom(s), and no aromaticity in its entire molecular structure. A non-limiting example of the monovalent non-aromatic condensed heteropolycyclic group is a carbazolyl group. The term "divalent non-aromatic condensed heteropolycyclic group" as used herein refers to a divalent group having the same structure as the monovalent non-aromatic condensed heteropolycyclic group described above.

The term "$C_5$-$C_{30}$ carbocyclic group" as used herein refers to a saturated or unsaturated cyclic group having, as ring-forming atoms, 5 to 30 carbon atoms only and no heteroatoms in the cyclic group. The $C_5$-$C_{30}$ carbocyclic group may be a monocyclic group or a polycyclic group. Non-limiting examples of the "$C_5$-$C_{30}$ carbocyclic group (unsubstituted or substituted with at least one $R_{10a}$)" as used herein are an adamantane group, a norbornene group, a bicyclo[1.1.1]pentane group, a bicyclo[2.1.1]hexane group, a bicyclo[2.2.1]heptane(norbornane) group, a bicyclo[2.2.2]octane group, a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, and a fluorene group (each unsubstituted or substituted with at least one $R_{10a}$).

The term "$C_1$-$C_{30}$ heterocyclic group" as used herein refers to a saturated or unsaturated cyclic group having, as a ring-forming atom(s), at least one heteroatom selected from N, O, P, Si, S, Se, Ge, and B other than 1 to 30 carbon atom(s) as ring-forming atom(s). The $C_1$-$C_{30}$ heterocyclic group may be a monocyclic group or a polycyclic group. Non-limiting examples of the "$C_1$-$C_{30}$ heterocyclic group (unsubstituted or substituted with at least one $R_{10a}$)" as used herein are a thiophene group, a furan group, a pyrrole group, a silole group, borole group, a phosphole group, a selenophene group, a germole group, a benzothiophene group, a benzofuran group, an indole group, a benzosilole group, a benzoborole group, a benzophosphole group, a benzoselenophene group, a benzogermole group, a dibenzothiophene group, a dibenzofuran group, a carbazole group, a dibenzosilole group, a dibenzoborole group, a dibenzophosphole group, a dibenzoselenophene group, a dibenzogermole group, a dibenzothiophene 5-oxide group, a 9H-fluoren-9-one group, a dibenzothiophene 5,5-dioxide group, an azabenzothiophene group, an azabenzofuran group, an azaindole group, an azaindene group, an azabenzosilole group, an azabenzoborole group, an azabenzophosphole group, an azabenzoselenophene group, an azabenzogermole group, an azadibenzothiophene group, an azadibenzofuran group, an azacarbazole group, an azafluorene group, an azadibenzosilole group, an azadibenzoborole group, an azadibenzophosphole group, an azadibenzoselenophene group, an azadibenzogermole group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, or a 5,6,7,8-tetrahydroquinoline group (each unsubstituted or substituted with at least one $R_{10a}$).

Non-limiting examples of the "$C_5$-$C_{30}$ carbocyclic group" and "$C_1$-$C_{30}$ heterocyclic group" as used herein are i) a first ring, ii) a second ring, iii) a condensed ring in which two or more first rings are condensed with each other, iv) a condensed ring in which two or more second rings are condensed with each other, or v) a condensed ring in which at least

one first ring is condensed with at least one second ring,

wherein the first ring may be a cyclopentane group, a cyclopentene group, a furan group, a thiophene group, a pyrrole group, a silole group, a borole group, a phosphole group, a germole group, a selenophene group, an oxazole group, an oxadiazole group, an oxatriazole group, a thiazole group, a thiadiazole group, a thiatriazole group, a pyrazole group, an imidazole group, a triazole group, a tetrazole group, or an azasilole group, and
the second ring may be an adamantane group, a norbornane group, a norbornene group, a piperidine group, a cyclohexane group, a cyclohexene group, a benzene group, a pyridine group, a pyrimidine group, a pyrazine group, a pyridazine group, or a triazine group.

The terms "fluorinated $C_1$-$C_{60}$ alkyl group (or fluorinated $C_1$-$C_{20}$ alkyl group or the like)", "fluorinated $C_3$-$C_{10}$ cycloalkyl group", "fluorinated $C_1$-$C_{10}$ heterocycloalkyl group," and "fluorinated phenyl group" respectively indicate a $C_1$-$C_{60}$ alkyl group (or a $C_1$-$C_{20}$ alkyl group or the like), a $C_3$-$C_{10}$ cycloalkyl group, a $C_1$-$C_{10}$ heterocycloalkyl group, and a phenyl group, each substituted with at least one fluoro group. For example, the term "fluorinated $C_1$ alkyl group (that is, a fluorinated methyl group)" includes $-CF_3$, $-CF_2H$, and $-CFH_2$. The "fluorinated $C_1$-$C_{60}$ alkyl group (or fluorinated $C_1$-$C_{20}$ alkyl group or the like)", "the fluorinated $C_3$-$C_{10}$ cycloalkyl group", "the fluorinated $C_1$-$C_{10}$ heterocycloalkyl group", or "the fluorinated phenyl group" may be i) a fully fluorinated $C_1$-$C_{60}$ alkyl group (or a fully fluorinated $C_1$-$C_{20}$ alkyl group or the like), a fully fluorinated $C_3$-$C_{10}$ cycloalkyl group, a fully fluorinated $C_1$-$C_{10}$ heterocycloalkyl group, or a fully fluorinated phenyl group, wherein, in each group, all hydrogen included therein are substituted with a fluoro group, or ii) a partially fluorinated $C_1$-$C_{60}$ alkyl group (or, a partially fluorinated $C_1$-$C_{20}$ alkyl group, or the like), a partially fluorinated $C_3$-$C_{10}$ cycloalkyl group, a partially fluorinated $C_1$-$C_{10}$ heterocycloalkyl group, or partially fluorinated phenyl group, wherein, in each group, all hydrogen included therein are not substituted with a fluoro group.

The terms "deuterated $C_1$-$C_{60}$ alkyl group (or deuterated $C_1$-$C_{20}$ alkyl group or the like)", "deuterated $C_3$-$C_{10}$ cycloalkyl group", "deuterated $C_1$-$C_{10}$ heterocycloalkyl group," and "deuterated phenyl group" respectively indicate a $C_1$-$C_{60}$ alkyl group (or a $C_1$-$C_{20}$ alkyl group or the like), a $C_3$-$C_{10}$ cycloalkyl group, a $C_1$-$C_{10}$ heterocycloalkyl group, and a phenyl group, each substituted with at least one deuterium. For example, the "deuterated $C_1$ alkyl group (that is, deuterated methyl group)" may include $-CD_3$, $-CD_2H$, and $-CDH_2$, and examples of the "deuterated $C_3$-$C_{10}$ cycloalkyl group" are Formula 10-501 or the like. The "deuterated $C_1$-$C_{60}$ alkyl group (or deuterated $C_1$-$C_{20}$ alkyl group or the like)", "the deuterated $C_3$-$C_{10}$ cycloalkyl group", "the deuterated $C_1$-$C_{10}$ heterocycloalkyl group", or "the deuterated phenyl group" may be i) a fully deuterated $C_1$-$C_{60}$ alkyl group (or, a fully deuterated $C_1$-$C_{20}$ alkyl group or the like), a fully deuterated $C_3$-$C_{10}$ cycloalkyl group, a fully deuterated $C_1$-$C_{10}$ heterocycloalkyl group, or a fully deuterated phenyl group, in which, in each group, all hydrogen included therein are substituted with deuterium, or ii) a partially deuterated $C_1$-$C_{60}$ alkyl group (or, a partially deuterated $C_1$-$C_{20}$ alkyl group or the like), a partially deuterated $C_3$-$C_{10}$ cycloalkyl group, a partially deuterated $C_1$-$C_{10}$ heterocycloalkyl group, or a partially deuterated phenyl group, in which, in each group, all hydrogen included therein are not substituted with deuterium.

The term "($C_1$-$C_{20}$ alkyl)'X' group" as used herein refers to a 'X' group that is substituted with at least one $C_1$-$C_{20}$ alkyl group. For example, the term "($C_1$-$C_{20}$ alkyl)$C_3$-$C_{10}$ cycloalkyl group" as used herein refers to a $C_3$-$C_{10}$ cycloalkyl group substituted with at least one $C_1$-$C_{20}$ alkyl group, and the term "($C_1$-$C_{20}$ alkyl)phenyl group" as used herein refers to a phenyl group substituted with at least one $C_1$-$C_{20}$ alkyl group. An example of the term ($C_1$ alkyl)phenyl group is a toluyl group.

The terms "an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluoren-9-one group, and an azadibenzothiophene 5,5-dioxide group" respectively refer to heterocyclic groups having the same backbones as "an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluoren-9-one group, and a dibenzothiophene 5,5-dioxide group," in which, in each group, at least one carbon atom from among ring-forming carbon atoms is substituted with nitrogen.

At least one substituent of the substituted $C_5$-$C_{30}$ carbocyclic group, the substituted $C_1$-$C_{30}$ heterocyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_1$-$C_{60}$ alkylthio group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ hetero-cycloalkenyl group, the substituted $C_6$-$C_{60}$ aryl group, the substituted $C_7$-$C_{60}$ alkyl aryl group, the substituted $C_7$-$C_{60}$ aryl alkyl group, the substituted $C_6$-$C_{60}$ aryloxy group, the substituted $C_6$-$C_{60}$ arylthio group, the substituted $C_1$-$C_{60}$ heteroaryl

group, the substituted $C_2$-$C_{60}$ alkyl heteroaryl group, the substituted $C_2$-$C_{60}$ heteroaryl alkyl group, the substituted $C_1$-$C_{60}$ heteroaryloxy group, the substituted $C_1$-$C_{60}$ heteroarylthio group, the substituted monovalent non-aromatic condensed polycyclic group, and the substituted monovalent non-aromatic condensed heteropolycyclic group may be:

deuterium, -F, -Cl, -Br, -I, -SFs, $-CD_3$, $-CD_2H$, $-CDH_2$, $-CF_3$, $-CF_2H$, $-CFH_2$, a hydroxyl group, a cyano group, a nitro group, a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group;

a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group, each substituted with at least one of deuterium, -F, -Cl, -Br, -I, -SFs, $-CD_3$, $-CD_2H$, $-CDH_2$, $-CF_3$, $-CF_2H$, $-CFH_2$, a hydroxyl group, a cyano group, a nitro group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, $-N(Q_{11})(Q_{12})$, $-Si(Q_{13})(Q_{14})(Q_{15})$, $-Ge(Q_{13})(Q_{14})(Q_{15})$, $-B(Q_{16})(Q_{17})$, $-P(=O)(Q_{18})(Q_{19})$, $-P(Q_{18})(Q_{19})$, or a combination thereof;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group, each unsubstituted or substituted with at least one of deuterium, -F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, $-N(Q_{21})(Q_{22})$, $- Si(Q_{23})(Q_{24})(Q_{25})$, $-Ge(Q_{23})(Q_{24})(Q_{26})$, $-B(Q_{26})(Q_{27})$, $-P(=O)(Q_{28})(Q_{29})$, $-P(Q_{28})(Q_{29})$, or a combination thereof;

$-N(Q_{31})(Q_{32})$, $-Si(Q_{33})(Q_{34})(Q_{35})$, $-Ge(Q_{33})(Q_{34})(Q_{35})$, $-B(Q_{36})(Q_{37})$, $- P(=O)(Q_{38})(Q_{39})$, or $-P(Q_{38})(Q_{39})$, or a combination thereof

As used herein, and unless indicated otherwise, $Q_1$ to $Q_9$, $Q_{11}$ to $Q_{19}$, $Q_{21}$ to $Q_{29}$, and $Q_{31}$ to $Q_{39}$ may each independently be:
hydrogen, deuterium, -F, -Cl, -Br, -I, -SFs, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, or a substituted or unsubstituted monovalent non-aromatic condensed heteropolycyclic group.

For example, $Q_1$ to $Q_9$, $Q_{11}$ to $Q_{19}$, $Q_{21}$ to $Q_{29}$, and $Q_{31}$ to $Q_{39}$ as used herein may each independently be:

$-CH_3$, $-CD_3$, $-CD_2H$, $-CDH_2$, $-CH_2CH_3$, $-CH_2CD_3$, $-CH_2CD_2H$, $-CH_2CDH_2$, $- CHDCH_3$, $-CHDCD_2H$, $-CHDCDH_2$, $-CHDCD_3$, $-CD_2CD_3$, $-CD_2CD_2H$, or $-CD_2CDH_2$; or

an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with at least one of deuterium, a $C_1$-$C_{10}$ alkyl group, a phenyl group, or a combination thereof.

Hereinafter, a light-emitting device according to one or more embodiments are described in further detail with reference to Examples. However, the present subject matter is not limited thereto.

EXAMPLES

Synthesis Example 1 (Compound Pt(1) or Compound 25 of [Group 1-3])

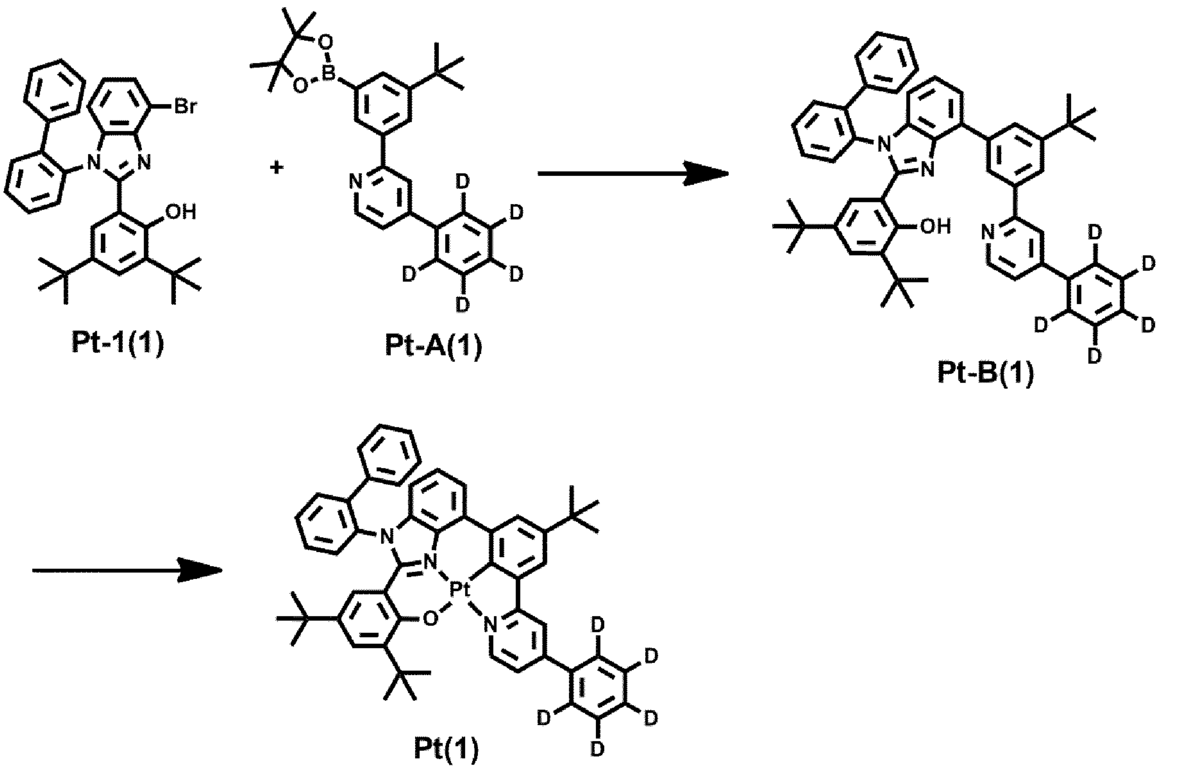

Pt-1(1) Pt-A(1) Pt-B(1)

Pt(1)

Synthesis of Compound Pt-B(1)

Compound Pt-A(1) (2.2 grams (g), 5.2 millimoles (mmol)), Compound Pt-1(1) (3.5 g, 6.3 mmol), tetrakis(triphenylphosphine)palladium(0) (0.4 g, 0.4 mmol), and potassium carbonate (2.2 g, 15.7 mmol) were mixed with 60 mL of a mixture including tetrahydrofuran (THF) and deionized (DI) water at a volume ratio of 3:1, and the resultant mixed solution was heated at reflux for 12 hours. The obtained result was allowed to cool to room temperature, and the precipitate was removed therefrom by filtration to obtain a filtrate. The filtrate was then washed with ethyl acetate (EA) and DI water, and purification was performed using column chromatography (EA / hexane (Hex) 8 %~12 %) to complete the production of Compound Pt-B(1) (3.4 g, yield of 85%).

Synthesis of Compound Pt(1)

Compound Pt-B(1) (3.2 g, 4.2 mmol) and $K_2PtCl_4$ (2.1 g, 5.0 mmol) were mixed with70 mL of a mixture including 60 mL of acetic acid and 10 mL of DI water, and the resultant mixed solution was heated at reflux for 6 hours. The obtained result was allowed to cool to room temperature, and the precipitate was removed therefrom by filtration to obtain a filtrate. The filtrate was dissolved in methylene chloride (MC) and then washed with DI water. Subsequently, purification using column chromatography (MC 35 %/Hex 65 %) was performed thereon to complete the production of Compound Pt(1) (1.53 g, yield of 38%).

High resolution mass spectrometry using matrix assisted laser desorption ionization (HRMS (MALDI)) calculated for $C_{54}H_{46}D_5N_3OPt$: m/z 957.3994 grams per mole (g/mol), found: 957.3988 g/mol.

Synthesis Example 2 (Compound Pt(2) or Compound 132 of [Group 1-3])

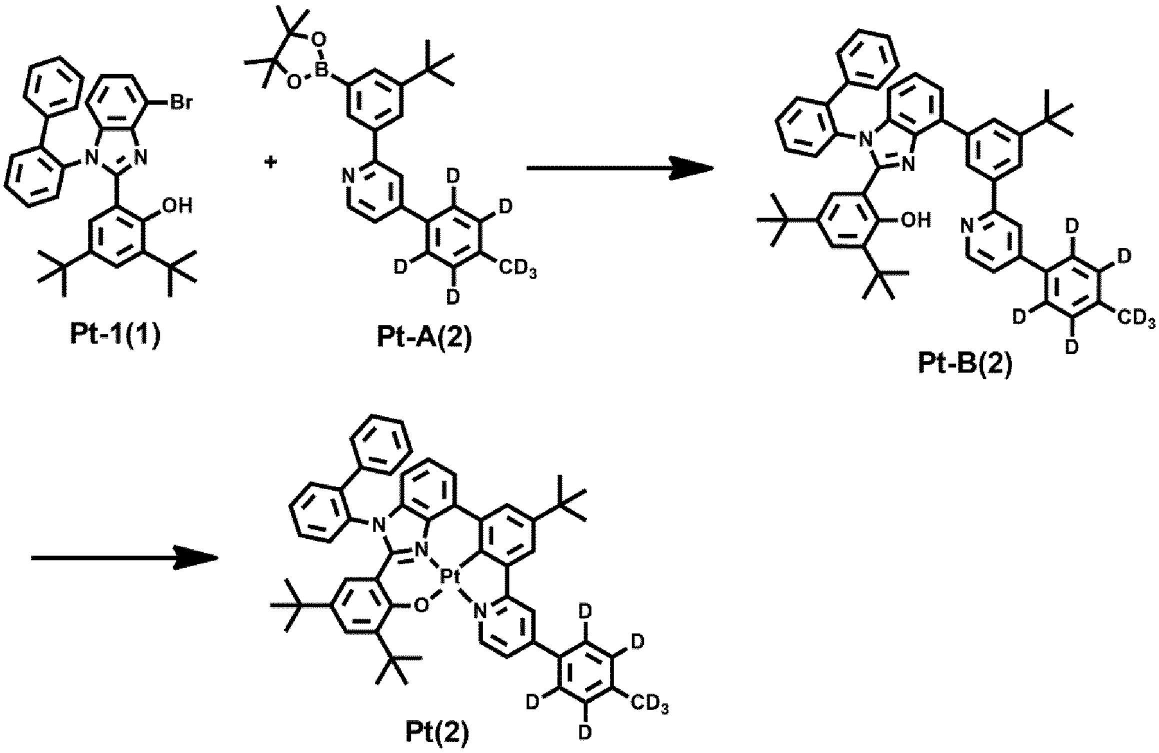

Pt-1(1) Pt-A(2) Pt-B(2)

Pt(2)

Synthesis of Compound Pt-B(2)

Compound Pt-B(2) (3.1 g, yield of 79 %) was obtained in a similar manner as in the synthesis of Compound Pt-B(1) of Synthesis Example 1, except that Compound Pt-A(2) was used instead of Compound Pt-A(1).

Synthesis of Compound Pt(2)

Compound Pt(2) (1.7 g, yield of 43 %) was obtained in a similar manner as in the synthesis of Compound Pt(1) of Synthesis Example 1, except that Compound Pt-B(2) was used instead of Compound Pt-B(1).

HRMS (MALDI) calculated for $C_{55}H_{46}D_7N_3OPt$: m/z 973.4276 g/mol, found: 973.4280 g/mol.

Synthesis Example 3 (Compound Pt(3) or Compound 4 of [Group 1-4])

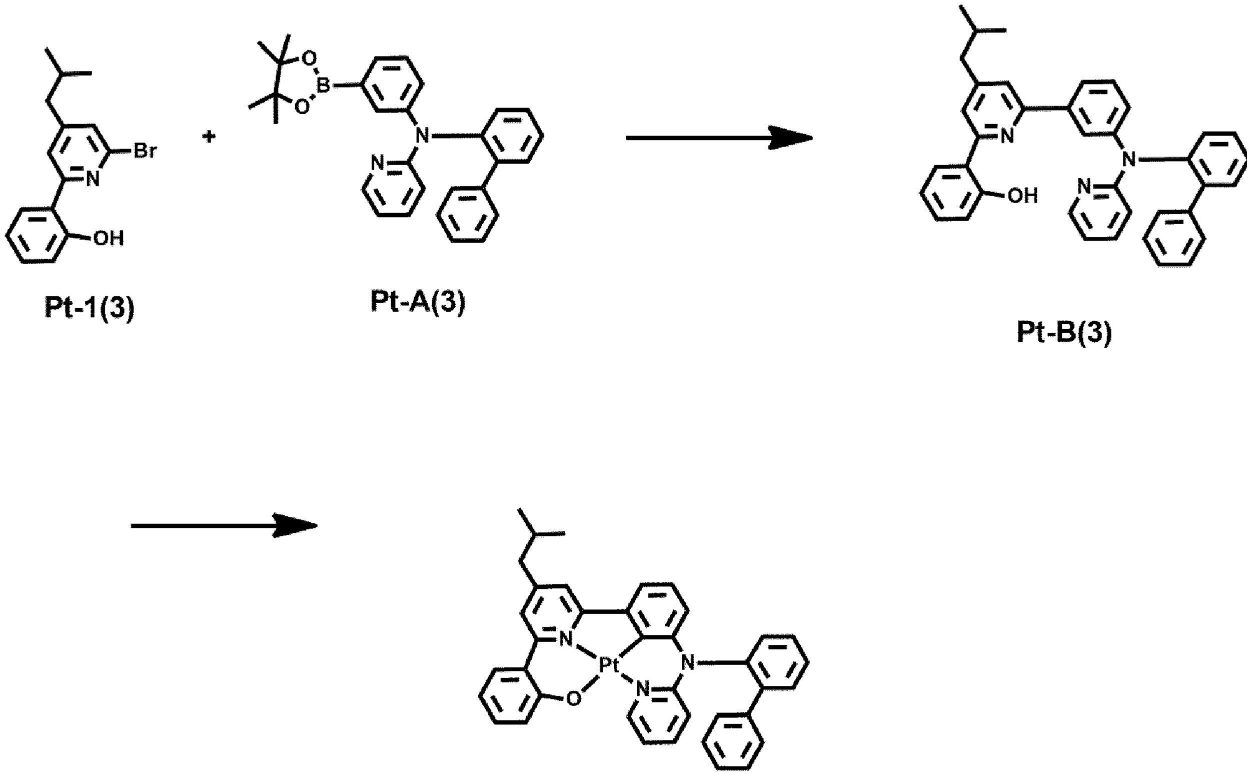

Pt-1(3)

Pt-A(3)

Pt-B(3)

Pt(3)

Synthesis of Compound Pt-B(3)

Compound Pt-B(3) (3.23 g, yield of 82 %) was obtained in a similar manner as in the synthesis of Compound Pt-B(1) of Synthesis Example 1, except that Compound Pt-1(3) was used instead of Compound Pt-1(1) and Compound Pt-A(3) was used instead of Compound Pt-A(1).

Synthesis of Compound Pt(3)

Compound Pt(3) (1.53 g, yield of 39 %) was obtained in a similar manner as in the synthesis of Compound Pt(1) of Synthesis Example 1, except that Compound Pt-B(3) was used instead of Compound Pt-B(1).

HRMS (MALDI) calculated for $C_{38}H_{31}$NsOPt: m/z 740.2115 g/mol, found: 740.2130 g/mol.

Synthesis Example 4 (Compound Ir-1 or Compound 16 of [Group 2-1])

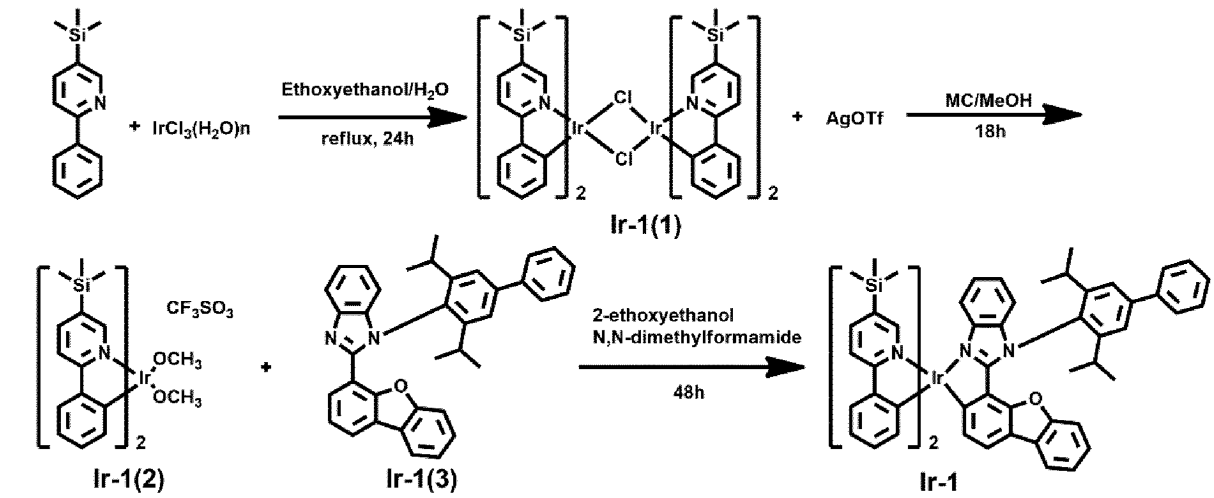


Ir-1(1)

Ir-1(2) Ir-1(3) Ir-1

Synthesis of Compound Ir-1(1)

2-phenyl-5-(trimethylsilyl)pyridine (7.5 g, 33.1 mmol) and iridium chloride hydrate (5.2 g, 14.7 mmol) were mixed with 120 mL of ethoxyethanol and 40 mL of DI water, and the resultant mixed solution was stirred and heated at reflux for 24 hours. Then, the temperature was allowed to lower to room temperature. The resulting solid was separated by filtration, washed sufficiently with DI water, methanol, and hexane, and the obtained solid was dried in a vacuum oven, to obtain 8.2 g (yield of 82%) of Compound Ir-1(1).

Synthesis of Compound Ir-1(2)

Compound Ir-1(1) (1.6 g, 1.2 mmol) and 45 mL of MC were mixed, and a mixture of silver trifluoromethanesulfonate (silver triflate, AgOTf, 0.6 g, 2.3 mmol) and 15 mL of methanol (MeOH) was added thereto. Afterwards, the resultant mixture was stirred for 18 hours at room temperature while light was blocked with aluminum foil, and then filtered through a Celite plug to remove the resulting solid, and the filtrate was subjected to a reduced pressure to obtain a solid (Compound Ir1-2). Compound Ir1-2 was used in the next reaction without an additional purification process.

Synthesis of Compound Ir-1

Compound Ir-1(2) (1.8 g, 2.15 mmol) and Compound Ir-1(3) (2-(dibenzo[b,d]furan-4-yl)-1-(3,5-diisopropyl-[1,1'-biphenyl]-4-yl)-1H-benzo[d]imidazole, 1.0 g, 2.04 mmol) were mixed with 10 mL of 2-ethoxyethanol and 10 mL of N,N-dimethylformamide, and the mixed solution was stirred and heated at reflux for 48 hours. Then, the temperature was allowed to lower to room temperature. The obtained mixture was subjected to a reduced pressure to obtain a solid, which was purified by column chromatography (eluents: MC and Hex) to obtain Compound Ir-1 (1.10 g, yield of 44%).

HRMS (MALDI) calculated for $C_{65}H_{63}IrNaOSi_2$: m/z 1164.4170 g/mol, found: 1164.4171 g/mol.

Synthesis Example 5 (Compound Ir-3 or Compound 116 of Group 2-4)

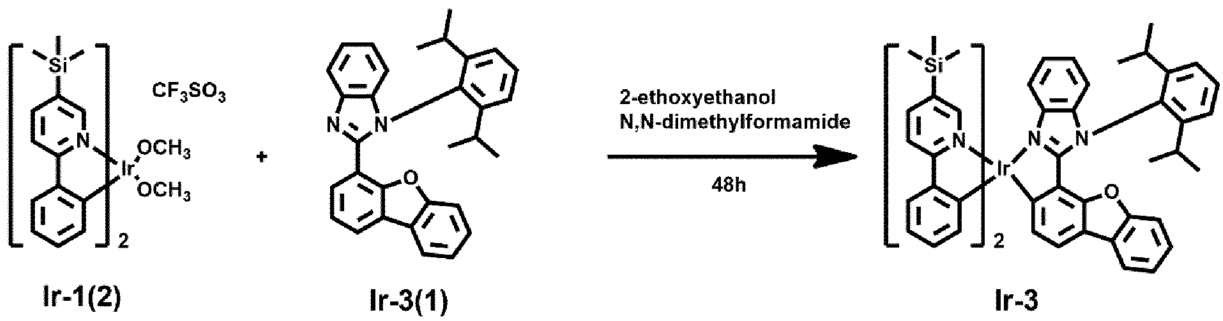


Ir-1(2) Ir-3(1) Ir-3

Compound Ir-1(2) (2.0 g, 2.3 mmol) and Compound Ir-3(1) (2-(dibenzo[b,d]furan-4-yl)-1-(2,6-diisopropylphenyl)-1H-benzo[d]imidazole, 1.0 g, 2.2 mmol) were mixed with 10 mL of 2-ethoxyethanol and 10 mL of N,N-dimethylformamide, and the mixed solution was stirred and heated at reflux for 48 hours. Then, the temperature was allowed to lower to room temperature. The obtained mixture was subjected to a reduced pressure to obtain a solid, which was purified by column chromatography (eluents: MC and Hex) to obtain Compound Ir-3 (1.20 g, yield of 48%).

HRMS (MALDI) calculated for $C_{59}H_{59}IrN_4OSi_2$: m/z 1088.3857 g/mol, found: 1088.3858 g/mol.

Evaluation Example 1

The dipole moment of Compound Pt(1) was calculated by optimizing the molecular structure of Compound Pt(1) by using the B3LYP/LanL2DZ function for the metal included in Compound Pt(1) and B3LYP/6-31G(D,P) function for the organic ligand and performing the DFT calculation using the Gaussian 16 program. Using a similar method as described above, the dipole moments of the remaining Pt-containing compounds and Ir-containing compounds in Table 1 were calculated, and the results are summarized in Table 1.

Table 1

| Compound No. | Dipole moment (debye) |
|---|---|
| Pt(1) | 2.0263 |
| Pt(2) | 2.470 |
| Pt(3) | 4.833 |
| Ir-1 | 5.3374 |
| Ir-3 | 5.4158 |
| Pt-C | 0.064 |
| Pt-D | 0.314 |
| Pt-E | 4.969 |
| Pt-F | 3.167 |
| Ir-C | 6.279 |
| Ir-D | 1.951 |

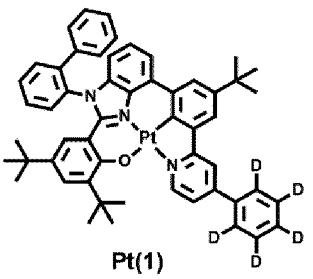
Pt(1)

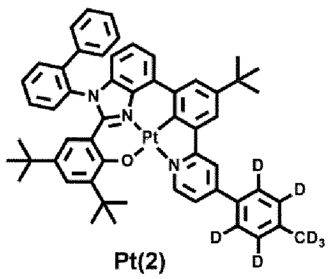
Pt(2)

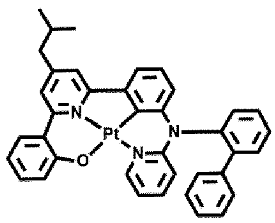
Pt(3)

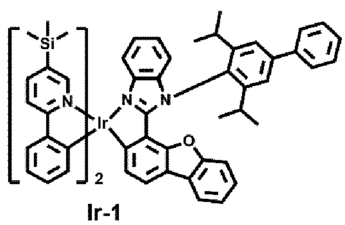
Ir-1

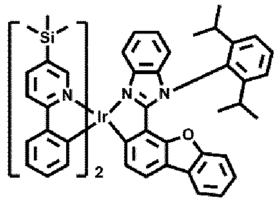
Ir-3

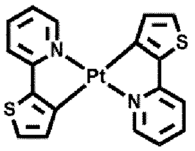

Pt-C

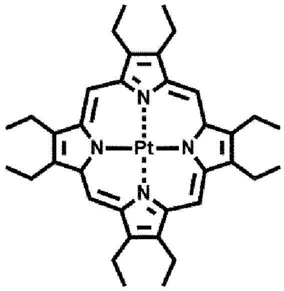

Pt-D

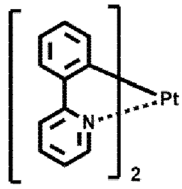

Pt-E

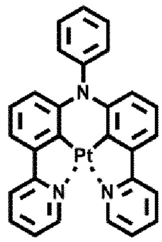

Pt-F

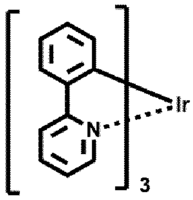

Ir-C

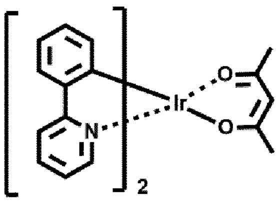

Ir-D

Evaluation Example 2

On a quartz substrate, the compounds shown in Table 2 were vacuum co-deposited (at a pressure of $10^{-7}$ torr) at the weight ratios shown in Table 2 to manufacture 40 nm-thick films of Compounds Pt(1), Pt(2), Pt(3), Ir- 1, Ir-3, Pt-C, Pt-D, Pt-E, Pt-F, Ir-C, and Ir-D.

Then, the emission spectrum for each of the films of Compounds Pt(1), Pt(2), Pt(3), Ir-1, Ir-3, Pt-C, Pt-D, Pt-E, Pt-F, Ir-C, and Ir-D was measured by using a Quantaurus-QY Absolute PL quantum yield spectrometer (produced by Hamamatsu Company, equipped with a xenon light source, a monochromator, a photonic multichannel analyzer, and an integrating sphere, and was programmed by the PLOY measurement software (Hamamatsu Photonics, Ltd., Shizuoka, Japan)). In the measurement, the excitation wavelength was scanned at 10 nm intervals between 320 nm and 380 nm, and a spectrum was measured using an excitation wavelength of 320 nm. Accordingly, Compounds Pt(1), Pt(2), Pt(3), Ir-1, Ir-3, Pt-C, Pt-D, Pt-E, Pt-F, Ir-C, and Ir-D were included in the corresponding Films Pt(1), Pt(2), Pt(3), Ir-1, Ir-3, Pt-C, Pt-D, Pt-E, Pt-F, Ir-C, and Ir-D, and were evaluated for the emission peak wavelength ($\lambda_{max}$, nm), and the results are shown in Table 2.

Table 2

| Film | Film composition (weight ratio) | $\lambda_{max}$ (nm) |
|---|---|---|
| Pt(1) | H-H1:H-H2:Pt(1) (47.5:47.5:5) | 526 |
| Pt(2) | H-H1:H-H2:Pt(2) (47.5:47.5:5) | 522 |
| Pt(3) | H-H1:H-H2:Pt(3) (47.5:47.5:5) | 528 |
| Ir-1 | H-H1:H-H2:Ir-1 (47.5:47.5:5) | 526 |
| Ir-3 | H-H1:H-H2:Ir-3 (47.5:47.5:5) | 525 |
| Pt-C | H-H1:H-H2:Pt-C (47.5:47.5:5) | 584 |
| Pt-D | H-H1:H-H2:Pt-D (47.5:47.5:5) | 650 |
| Pt-E | H-H1:H-H2:Pt-E (47.5:47.5:5) | 501 |
| Pt-F | H-H1:H-H2:Pt-F (47.5:47.5:5) | 614 |
| Ir-C | H-H1:H-H2:Ir-C (47.5:47.5:5) | 513 |
| Ir-D | H-H1:H-H2:Ir-D (47.5:47.5:5) | 524 |

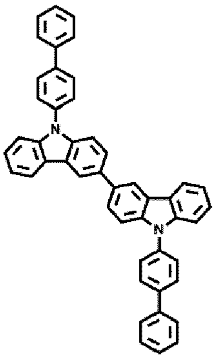

H-H1

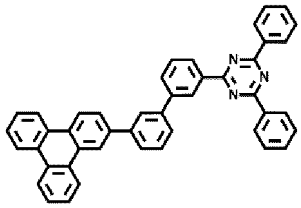

H-H2

Manufacture of OLED 1

An ITO(as an anode)-patterned glass substrate was cut to a size of 50 millimeters (mm) x 50 mm x 0.5 mm, sonicated with isopropyl alcohol and DI water, each for 5 minutes, and then cleaned by exposure to ultraviolet (UV) rays and ozone for 30 minutes. The resultant ITO-patterned glass substrate was loaded onto a vacuum deposition apparatus.

HT3 and F6-TCNNQ were vacuum-deposited on the anode at a weight ratio of 98:2 to form a hole injection layer having a thickness of 100 Å, and then, HT3 was vacuum-deposited on the hole injection layer to form a hole transport layer having a thickness of 1,350 Å. H-H1 was vacuum-deposited on the hole transport layer to form an electron blocking layer having a thickness of 300 Å.

Subsequently, a host and a dopant were co-deposited at a weight ratio of 88:12 on the electron blocking layer to form an emission layer having a thickness of 400 Å. As the host, H-H1 and H-H2 were used at a weight ratio of 1:1, and as the dopant, the first compound and the second compound shown in Table 3 were used at the weight ratio of 1:1.

Then, ET3 and ET-D1 were co-deposited at a volume ratio of 50:50 on the emission layer to form an electron transport layer having a thickness of 350 Å, ET-D1 was vacuum-deposited on the electron transport layer to form an electron injection layer having a thickness of 10 Å, and Al was vacuum-deposited on the electron injection layer to form a cathode having a thickness of 1,000 Å, thereby completing the manufacture of an organic light-emitting device.

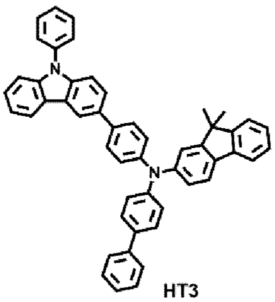

HT3

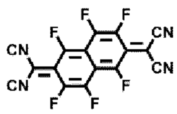

F6-TCNNQ

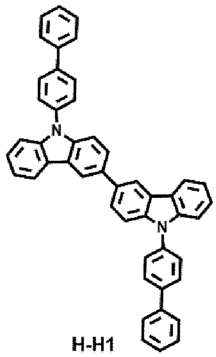

H-H1

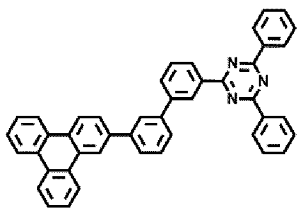

H-H2

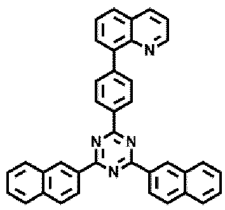

ET3

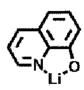

ET-D1

Manufacture of OLEDs 2 to 4 and comparative example OLEDs A to E

Organic Light-emitting devices were manufactured in a similar manner as in the manufacture of OLED 1, except those corresponding compounds shown in Table 3 were used as a dopant in forming an emission layer.

Evaluation Example 3

For the OLEDs 1 to 4 and A to E, the driving voltage (V), the emission peak wavelength ($\lambda_{max}$) (nm), the maximum value of external quantum efficiency (Max EQE) (%), and the lifespan ($LT_{97}$) (hr) were evaluated, and the results are shown in Table 3. A current-voltage meter (Keithley 2400) and a luminance meter (Topcon SR3) were used as apparatuses for evaluation, and the lifespan ($T_{97}$) (at 18,000 candela per square meter, cd/m$^2$ or nits) was obtained by measuring the amount of time that elapsed until luminance was reduced to 97% of the initial luminance of 100%, and the results are expressed as relative values. For reference, the dipole moments and the emission peak wavelengths ($\lambda_{max}$) of the compounds used as the dopants in OLEDs 1 to 4 and C to E are summarized in Table 4.

Table 3

| | Dopant in emission layer | | Driving voltage (V) | $\lambda_{max}$ (nm) | Max EQE (%) | $LT_{97}$ (Relative value, %) |
|---|---|---|---|---|---|---|
| | First compound | Second compound | | | | |
| OLED 1 | Pt(1) | Ir-1 | 4.3 | 531 | 26.7 | 150 |
| OLED 2 | Pt(2) | Ir-1 | 4.3 | 531 | 26.5 | 142 |
| OLED 3 | Pt(1) | Ir-3 | 4.32 | 530 | 26.0 | 131 |
| OLED 4 | Pt(3) | Ir-1 | 4.35 | 531 | 25.5 | 100 |
| OLED A | Ir-1 | | 4.6 | 531 | 24.6 | 100 |
| OLED B | Pt(1) | | 4.2 | 526 | 25.1 | 20 |
| OLED C | Pt-C | Ir-C | 5.5 | 584 | 5 | <1 |
| OLED D | Pt-D | Ir-C | 5.9 | 650 | 4 | <1 |
| OLED E | Pt-E | Ir-C | 5.2 | 515 | 10 | <1 |
| OLED F | Pt-F | Ir-D | 5.5 | 614 | 15.4 | <10 |

Table 4

| | Dopant in emission layer | | | | | |
|---|---|---|---|---|---|---|
| | First compound | | | Second compound | | |
| | No. | Dipole moment (debye) | $\lambda_{max}$ (nm) | No. | Dipole moment (debye) | Emission peak wavelength (nm) |
| OLED 1 | Pt(1) | 2.0263 | 526 | Ir-1 | 5.3374 | 526 |
| OLED 2 | Pt(2) | 2.470 | 522 | Ir-1 | 5.3374 | 526 |
| OLED 3 | Pt(1) | 2.0263 | 526 | Ir-3 | 5.4158 | 525 |
| OLED 4 | Pt(3) | 4.833 | 528 | Ir-1 | 5.3374 | 526 |
| OLED C | Pt-C | 0.064 | 584 | Ir-C | 6.279 | 513 |
| OLED D | Pt-D | 0.314 | 650 | Ir-C | 6.279 | 513 |
| OLED E | Pt-E | 4.969 | 501 | Ir-C | 6.279 | 513 |
| OLED F | Pt-F | 3.167 | 614 | Ir-D | 1.951 | 524 |

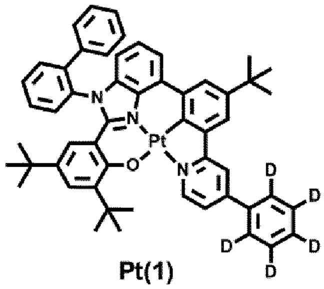

Pt(1)

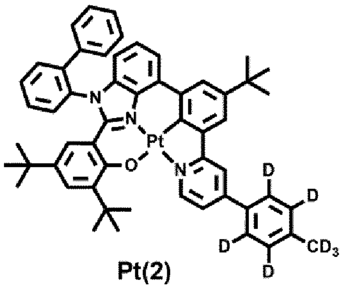

Pt(2)

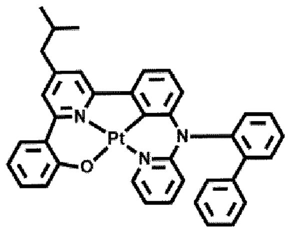

Pt(3)

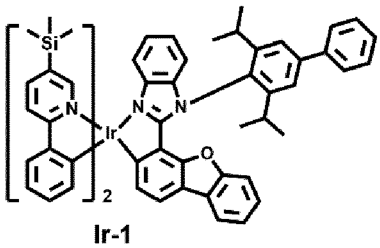

Ir-1

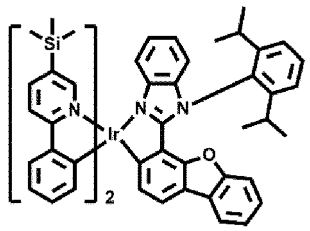

Ir-3

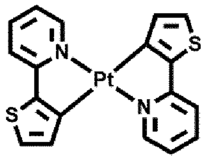

Pt-C

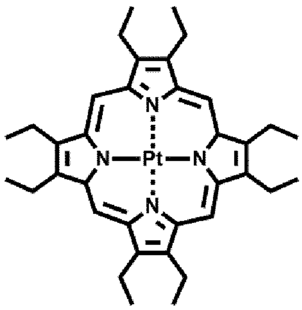

Pt-D

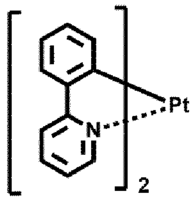

Pt-E

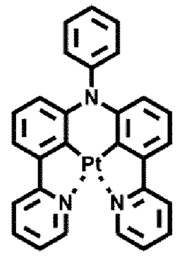

Pt-F

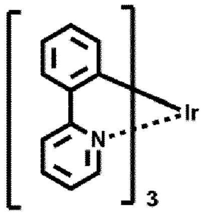

Ir-C

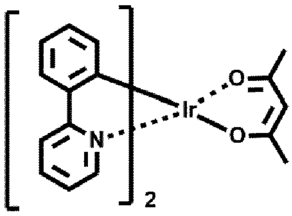

Ir-D

Referring to Table 3, it was confirmed that each of OLEDs 1 to 4 emitted green light and had improved driving voltage, improved EQE, and improved lifespan characteristics as compared to those of OLEDs A to E.

According to the one or more exemplary embodiments described herein, an electronic device, for example, a light-emitting device, employing a composition may have improved driving voltage, improved external quantum efficiency, and improved lifetime characteristics.

It should be understood that one or more exemplary embodiments described herein should be considered in a descriptive sense and not for purposes of limitation. Descriptions of features or aspects within each exemplary embodiment should typically be considered as available for other similar features or aspects in other exemplary embodiments. While one or more exemplary embodiments have been described, and in some cases are described with reference to the figure, it will be understood by those of ordinary skill in the art that various changes in form and details may be made therein without departing from the scope as defined by the following claims

## Claims

1. A composition, comprising:

   a first compound; and
   a second compound,
   wherein
   the first compound is an organometallic compound comprising platinum and a tetradentate ligand bound to the platinum,
   the second compound is an organometallic compound comprising iridium, **characterised in that**
   $\mu$(Pt) is 0.5 debye to 5.0 debye,
   $\mu$(Pt) is less than $\mu$(Ir),
   $\mu$(Pt) is a dipole moment of the first compound,
   $\mu$(Ir) is a dipole moment of the second compound,
   each of $\mu$(Pt) and $\mu$(Ir) is calculated based on density functional theory (DFT),
   the first compound emits a first light having a first spectrum, and $\lambda$P(Pt) is an emission peak wavelength of the first spectrum,
   the second compound emits a second light having a second spectrum, and $\lambda$P(Ir) is an emission peak wavelength of the second spectrum,
   $\lambda$P(Pt) is evaluated from a first photoluminescence spectrum measured for a first film,
   $\lambda$P(Ir) is evaluated from a second photoluminescence spectrum measured for a second film,
   the first film comprises the first compound, and
   the second film comprises the second compound,
   **characterised in that** an absolute value of a difference between $\lambda$P(Pt) and $\lambda$P(Ir) is 0 nanometers to 30 nanometers.

2. The composition of claim 1, wherein $\mu$(Pt) is 1.5 debye to 5.0 debye; and/or

   wherein $\mu$(Ir) is 4.0 debye to 9.0 debye; and/or
   wherein $\mu$(Ir) - $\mu$(Pt) is 0.3 debye to 4.0 debye.

3. The composition of claims 1 or 2, wherein the absolute value of the difference between $\lambda$P(Pt) and $\lambda$P(Ir) is 0 nanometers to 10 nanometers.

4. The composition of any of claims 1-3, wherein each of $\lambda$P(Pt) and $\lambda$P(Ir) is 510 nanometers to 540 nanometers; or wherein each of $\lambda$P(Pt) and $\lambda$P(Ir) is 540 nanometers to 570 nanometers.

5. The composition of any of claims 1-4, wherein the first compound is an organometallic compound comprising:

   a chemical bond between a carbon atom of the tetradentate ligand and platinum, and
   a chemical bond between an oxygen atom of the tetradentate ligand and platinum.

6. The composition of any of claims 1-5, wherein the second compound comprises a first ligand, a second ligand, and a third ligand,
   wherein:

   the first ligand, the second ligand, and the third ligand are identical to each other,
   the first ligand and the second ligand are identical to each other, and the

      second ligand and the third ligand are different from each other, or the first ligand, the second ligand, and the third ligand are different from each other, and

   each of the first ligand, the second ligand, and the third ligand comprises:

   a bidentate ligand bound to the iridium of the second compound via two nitrogen atoms;
   a bidentate ligand bound to iridium of the second compound via a nitrogen atom and a carbon atom; or

a bidentate ligand bound to iridium of the second compound via two carbon atoms.

**7.** A layer, comprising the composition of any of claims 1-6.

**8.** A light-emitting device (10), comprising:

a first electrode (11);
a second electrode (19); and
an organic layer (15) arranged between the first electrode and the second electrode,
wherein the organic layer comprises an emission layer, and
wherein the organic layer comprises the composition of any of claims 1-6.

**9.** The light-emitting device of claim 8, wherein the emission layer comprises the composition.

**10.** The light-emitting device of claim 9, wherein

the emission layer comprises a host and a dopant,
the host does not comprise a transition metal, and
the dopant comprises the composition
preferably wherein the host comprises a hole-transporting compound, an electron-transporting compound, a bipolar compound, or a combination thereof.

**11.** The light-emitting device of claims 9 or 10, wherein the emission layer emits a third light having a third spectrum, and λP(EML) is an emission peak wavelength of the third spectrum,

λP(EML) is evaluated from an electroluminescence spectrum of the light-emitting device, and
λP(EML) is 510 nanometers to 570 nanometers.

**12.** The light-emitting device of any of claims 9-11, wherein

the emission layer emits a third light having a third spectrum, and λP(EML) is an emission peak wavelength of the third spectrum, and
λP(EML) is evaluated from an electroluminescence spectrum of the light-emitting device, and
an absolute value of a difference between λP(EML) and λP(Pt) is 0 nanometers to 30 nanometers, and
an absolute value of a difference between λP(EML) and λP(Ir) is 0 nanometers to 30 nanometers;
preferably wherein an absolute value of the difference between λP(Pt) and λP(Ir) is 0 nanometers to 10 nanometers,
the absolute value of the difference between λP(EML) and λP(Pt) is 0 nanometers to 10 nanometers, and
the absolute value of the difference between λP(EML) and λP(Ir) is 0 nanometers to 10 nanometers.

**13.** The light-emitting device of claim 12, wherein

$$\lambda P(Pt) = \lambda P(Ir) = \lambda P(EML),$$

$$\lambda P(Pt) \leq \lambda P(Ir) < \lambda P(EML),$$

$$\lambda P(Pt) < \lambda P(Ir) \leq \lambda P(EML),$$

$$\lambda P(Ir) \leq \lambda P(Pt) < \lambda P(EML),$$

or

$$\lambda P(Ir) < \lambda P(Pt) \leq \lambda P(EML).$$

**14.** An electronic apparatus, comprising the light-emitting device of any of claims 8-13.

## Patentansprüche

**1.** Zusammensetzung, umfassend:

eine erste Verbindung; und
eine zweite Verbindung,
wobei
die erste Verbindung eine metallorganische Verbindung ist, die Platin und einen an das Platin gebundenen vierzähnigen Liganden umfasst,
die zweite Verbindung eine metallorganische Verbindung ist, die Iridium umfasst,
**dadurch gekennzeichnet, dass**
μ(Pt) 0,5 Debye bis 5,0 Debye beträgt,
μ(Pt) kleiner als μ(Ir) ist,
μ(Pt) ein Dipolmoment der ersten Verbindung ist,
μ(Ir) ein Dipolmoment der zweiten Verbindung ist,
jedes von μ(Pt) und μ(Ir) basierend auf der Dichtefunktionaltheorie (DFT) berechnet wird,
die erste Verbindung ein erstes Licht emittiert, das ein erstes Spektrum aufweist, und λP(Pt) eine Emissionsspitzenwellenlänge des ersten Spektrums ist,
die zweite Verbindung ein zweites Licht emittiert, das ein zweites Spektrum aufweist, und λP(Ir) eine Emissionsspitzenwellenlänge des zweiten Spektrums ist,
λP(Pt) aus einem ersten Photolumineszenzspektrum ermittelt wird, das für einen ersten Film gemessen wird,
λP(Ir) aus einem zweiten Photolumineszenzspektrum ermittelt wird, das für einen zweiten Film gemessen wird,
der erste Film die erste Verbindung umfasst, und
der zweite Film die zweite Verbindung umfasst,
**dadurch gekennzeichnet, dass** ein Absolutwert einer Differenz zwischen λP(Pt) und λP(Ir) 0 Nanometer bis 30 Nanometer beträgt.

**2.** Zusammensetzung nach Anspruch 1, wobei μ(Pt) 1,5 Debye bis 5,0 Debye beträgt; und/oder

wobei μ(Ir) 4,0 Debye bis 9,0 Debye beträgt; und/oder
wobei μ(Ir) - μ(Pt) 0,3 Debye bis 4,0 Debye beträgt.

**3.** Zusammensetzung nach Anspruch 1 oder 2, wobei der Absolutwert der Differenz zwischen λP(Pt) und λP(Ir) 0 Nanometer bis 10 Nanometer beträgt.

**4.** Zusammensetzung nach einem der Ansprüche 1-3, wobei jede von λP(Pt) und λP(Ir) 510 Nanometer bis 540 Nanometer beträgt; oder
wobei jede von λP(Pt) und λP(Ir) 540 Nanometer bis 570 Nanometer beträgt.

**5.** Zusammensetzung nach einem der Ansprüche 1-4, wobei die erste Verbindung eine metallorganische Verbindung ist, die Folgendes umfasst:

eine chemische Bindung zwischen einem Kohlenstoffatom des vierzähnigen Liganden und Platin und
eine chemische Bindung zwischen einem Sauerstoffatom des vierzähnigen Liganden und Platin.

**6.** Zusammensetzung nach einem der Ansprüche 1-5, wobei die zweite Verbindung einen ersten Liganden, einen zweiten Liganden und einen dritten Liganden umfasst,
wobei:

der erste Ligand, der zweite Ligand und der dritte Ligand miteinander identisch sind,
der erste Ligand und der zweite Ligand miteinander identisch sind und der zweite Ligand und der dritte Ligand voneinander verschieden sind, oder der erste Ligand, der zweite Ligand und der dritte Ligand voneinander verschieden sind, und
jeder von dem ersten Liganden, dem zweiten Liganden und dem dritten Liganden Folgendes umfasst:

einen zweizähnigen Liganden, der über zwei Stickstoffatome an das Iridium der zweiten Verbindung gebunden ist;
einen zweizähnigen Liganden, der über ein Stickstoffatom und ein Kohlenstoffatom an das Iridium der zweiten Verbindung gebunden ist;
einen zweizähnigen Liganden, der über zwei Kohlenstoffatome an das Iridium der zweiten Verbindung gebunden ist.

**7.** Schicht, umfassend die Zusammensetzung nach einem der Ansprüche 1-6.

**8.** Lichtemittierende Vorrichtung (10), umfassend:

eine erste Elektrode (11);
eine zweite Elektrode (19); und
eine organische Schicht (15), die zwischen der ersten Elektrode und der zweiten Elektrode angeordnet ist,
wobei die organische Schicht eine Emissionsschicht umfasst, und
wobei die organische Schicht die Zusammensetzung nach einem der Ansprüche 1-6 umfasst.

**9.** Lichtemittierende Vorrichtung nach Anspruch 8, wobei die Emissionsschicht die Zusammensetzung umfasst.

**10.** Lichtemittierende Vorrichtung nach Anspruch 9, wobei

die Emissionsschicht einen Wirt und einen Dotierstoff umfasst,
der Wirt kein Übergangsmetall umfasst und
der Dotierstoff die Zusammensetzung umfasst
vorzugsweise wobei der Wirt eine Lochleitungsverbindung, eine Elektronenleitungsverbindung, eine bipolare Verbindung oder eine Kombination davon umfasst.

**11.** Lichtemittierende Vorrichtung nach Anspruch 9 oder 10, wobei die Emissionsschicht ein drittes Licht emittiert, das ein drittes Spektrum aufweist, und λP(EML) eine Emissionsspitzenwellenlänge des dritten Spektrums ist,

λP(EML) aus einem Elektrolumineszenzspektrum der lichtemittierenden Vorrichtung ermittelt wird und
λP(EML) 510 Nanometer bis 570 Nanometer beträgt.

**12.** Lichtemittierende Vorrichtung nach einem der Ansprüche 9-11, wobei

die Emissionsschicht ein drittes Licht emittiert, das ein drittes Spektrum aufweist, und λP(EML) eine Emissionsspitzenwellenlänge des dritten Spektrums ist, und
λP(EML) aus einem Elektrolumineszenzspektrum der lichtemittierenden Vorrichtung ermittelt wird und
ein Absolutwert einer Differenz zwischen λP(EML) und λP(Pt) 0 Nanometer bis 30 Nanometer beträgt und
ein Absolutwert einer Differenz zwischen λP(EML) und λP(Ir) 0 Nanometer bis 30 Nanometer beträgt;
wobei vorzugsweise ein Absolutwert der Differenz zwischen λP(Pt) und λP(Ir) 0 Nanometer bis 10 Nanometer beträgt,
der Absolutwert der Differenz zwischen λP(EML) und λP(Pt) 0 Nanometer bis 10 Nanometer beträgt, und
der Absolutwert der Differenz zwischen λP(EML) und λP(Ir) 0 Nanometer bis 10 Nanometer beträgt.

**13.** Lichtemittierende Vorrichtung nach Anspruch 12, wobei

$$\lambda P(Pt) = \lambda P(Ir) = \lambda P(EML),$$

$$\lambda P(Pt) \leq \lambda P(Ir) < \lambda P(EML),$$

$$\lambda P(Pt) < \lambda P(Ir) \leq \lambda P(EML),$$

$$\lambda P(Ir) \leq \lambda P(Pt) < \lambda P(EML)$$

oder

$$\lambda P(Ir) < \lambda P(Pt) \leq \lambda P(EML).$$

**14.** Elektronisches Gerät, umfassend die lichtemittierende Vorrichtung nach einem der Ansprüche 8-13.

**Revendications**

**1.** Composition, comprenant :

un premier composé ; et
un deuxième composé,
dans laquelle
le premier composé est un composé organométallique comprenant du platine et un ligand tétradenté lié au platine,
le deuxième composé est un composé organométallique comprenant de l'iridium, **caractérisé en ce que**
$\mu$(Pt) est 0,5 debye à 5,0 debye,
$\mu$(Pt) est inférieur à $\mu$(Ir),
$\mu$(Pt) est un moment dipolaire du premier composé,
$\mu$(Ir) est un moment dipolaire du deuxième composé,
chacun de $\mu$(Pt) et $\mu$(Ir) est calculé sur la base de la théorie de la fonctionnelle de la densité (DFT),
le premier composé émet une première lumière comportant un premier spectre, et $\lambda$P(Pt) est une longueur d'onde pic d'émission du premier spectre,
le deuxième composé émet une deuxième lumière comportant un deuxième spectre, et $\lambda$P(Ir) est une longueur d'onde pic d'émission du deuxième spectre,
$\lambda$P(Pt) est évaluée d'après un premier spectre de photoluminescence mesuré pour un premier film,
$\lambda$P(Ir) est évaluée d'après un deuxième spectre de photoluminescence mesuré pour un deuxième film,
le premier film comprend le premier composé, et
le deuxième film comprend le deuxième composé,
**caractérisé en ce qu'**une valeur absolue d'une différence entre $\lambda$P(Pt) et $\lambda$P(Ir) est de 0 nanomètre à 30 nanomètres.

**2.** Composition selon la revendication 1, dans laquelle $\mu$(Pt) est de 1,5 debye à 5,0 debye ; et/ou

dans laquelle $\mu$(Ir) est de 4,0 debye à 9,0 debye ; et/ou
dans laquelle $\mu$(Ir) - $\mu$(Pt) est de 0,3 debye à 4,0 debye.

**3.** Composition selon la revendication 1 ou 2, dans laquelle la valeur absolue de la différence entre $\lambda$P(Pt) et $\lambda$P(Ir) est de 0 nanomètre à 10 nanomètres.

**4.** Composition selon l'une quelconque des revendications 1-3, dans laquelle chacun de $\lambda$P(Pt) et $\lambda$P(Ir) est de 510 nanomètres à 540 nanomètres ; ou
dans laquelle chacun de $\lambda$P(Pt) et $\lambda$P(Ir) est de 540 nanomètres à 570 nanomètres.

**5.** Composition selon l'une quelconque des revendications 1-4, dans laquelle le premier composé est un composé organométallique comprenant :

une liaison chimique entre un atome de carbone du ligand tétradenté et le platine, et
une liaison chimique entre un atome d'oxygène du ligand tétradenté et le platine.

**6.** Composition selon l'une quelconque des revendications 1-5, dans laquelle le deuxième composé comprend un premier ligand, un deuxième ligand et un troisième ligand,
dans laquelle :

le premier ligand, le deuxième ligand et le troisième ligand sont identiques l'un à l'autre,
le premier ligand et le deuxième ligand sont identiques l'un à l'autre, et le deuxième ligand et le troisième ligand

sont différents l'un de l'autre, ou le premier ligand, le deuxième ligand et le troisième ligand sont différents l'un de l'autre, et
chacun du premier ligand, du deuxième ligand et du troisième ligand comprend :

un ligand bidenté lié à l'iridium du deuxième composé par l'intermédiaire de deux atomes d'azote ;
un ligand bidenté lié à l'iridium du deuxième composé par l'intermédiaire d'un atome d'azote et d'un atome de carbone ; ou
un ligand bidenté lié à l'iridium du deuxième composé par l'intermédiaire de deux atomes de carbone.

**7.** Couche, comprenant la composition selon l'une quelconque des revendications 1-6.

**8.** Dispositif électroluminescent (10), comprenant :

une première électrode (11) ;
une deuxième électrode (19) ; et
une couche organique (15) disposée entre la première électrode et la deuxième électrode,
dans lequel la couche organique comprend une couche émissive, et
dans lequel la couche organique comprend la composition selon l'une quelconque des revendications 1-6.

**9.** Dispositif électroluminescent selon la revendication 8, dans lequel la couche émissive comprend la composition.

**10.** Dispositif électroluminescent selon la revendication 9, dans lequel

la couche émissive comprend un hôte et un dopant,
l'hôte ne comprend pas un métal de transition, et
le dopant comprend la composition
de préférence l'hôte comprend un composé de transport de trous, un composé de transport d'électrons, un composé bipolaire, ou une combinaison de ceux-ci.

**11.** Dispositif électroluminescent selon la revendication 9 ou 10, dans lequel la couche émissive émet une troisième lumière comportant un troisième spectre, et λP(EML) est une longueur d'onde pic d'émission du troisième spectre,

λP(EML) est évalué d'après un spectre d'électroluminescence du dispositif électroluminescent, et
λP(EML) est de 510 nanomètres à 570 nanomètres.

**12.** Dispositif électroluminescent selon l'une quelconque des revendications 9-11, dans lequel

la couche émissive émet une troisième lumière comportant un troisième spectre, et λP(EML) est une longueur d'onde pic d'émission du troisième spectre, et
λP(EML) est évalué d'après un spectre d'électroluminescence du dispositif électroluminescent, et
une valeur absolue d'une différence entre λP(EML) et λP(Pt) est de 0 nanomètre à 30 nanomètres, et
une valeur absolue d'une différence entre λP(EML) et λP(Ir) est de 0 nanomètre à 30 nanomètres ;
de préférence dans lequel une valeur absolue de la différence entre λP(Pt) et λP(Ir) est de 0 nanomètre à 10 nanomètres,
la valeur absolue de la différence entre λP(EML) et λP(Pt) est de 0 nanomètre à 10 nanomètres, et
la valeur absolue de la différence entre λP(EML) et λP(Ir) est de 0 nanomètre à 10 nanomètres.

**13.** Dispositif électroluminescent selon la revendication 12, dans lequel

$$\lambda P(Pt) = \lambda P(lr) = \lambda P(EML),$$

$$\lambda P(Pt) \leq \lambda P(lr) < \lambda P(EML),$$

$$\lambda P(Pt) < \lambda P(lr) \leq \lambda P(EML),$$

$$\lambda P(Ir) \leq \lambda P(Pt) < \lambda P(EML),$$

ou

$$\lambda P(Ir) < \lambda P(Pt) \leq \lambda P(EML).$$

**14.** Appareil électronique, comprenant le dispositif électroluminescent selon l'une quelconque des revendications 8-13.

# FIGURE